# EUROPEAN PATENT APPLICATION

(11) **EP 4 265 624 A1**
(43) Date of publication of application: **25.10.2023**
(21) Application number: 21911579.7
(22) Date of filing: 23.12.2021
(51) Int. Cl.: C07F 5/02, H01L 51/00, H01L 51/50, C09K 11/06

(54) **COMPOUND AND ORGANIC LIGHT EMITTING DEVICE COMPRISING SAME**

(30) Priority: 24.12.2020 KR 20200183776; 17.06.2021 KR 20210078639
(71) Applicant: Lg Chem, Ltd., Seoul 07336 (KR)
(72) Inventor: KIM, Moung Gon, Daejeon 34122 (KR); LEE, Woochul, Daejeon 34122 (KR); GEUM, Sujeong, Daejeon 34122 (KR); KIM, Kyunghee, Daejeon 34122 (KR); CHO, Hye Min, Daejeon 34122 (KR); LEE, Hojung, Daejeon 34122 (KR)
(74) Representative: Hoffmann Eitle
(86) International application number: PCT/KR2021/019747
(87) International publication number: WO 2022/139513

(57) **Abstract**

The present specification provides a compound of Chemical Formula 1, and an organic light emitting device including the same.

## Description

### [Technical Field]

This application claims priority to and the benefits of Korean Patent Application No. 10-2020-0183776, filed with the Korean Intellectual Property Office on December 24, 2020, and Korean Patent Application No. 10-2021-0078639, filed with the Korean Intellectual Property Office on June 17, 2021, the entire contents of which are incorporated herein by reference.

The present specification relates to a compound, and an organic light emitting device including the same.

### [Background]

An organic light emission phenomenon generally refers to a phenomenon converting electrical energy to light energy using an organic material. An organic light emitting device using an organic light emission phenomenon normally has a structure including an anode, a cathode, and an organic material layer therebetween. Herein, the organic material layer is often formed in a multilayer structure formed with different materials in order to increase efficiency and stability of the organic light emitting device, and for example, may be formed with a hole injection layer, a hole transfer layer, a light emitting layer, an electron transfer layer, an electron injection layer and the like. When a voltage is applied between the two electrodes in such an organic light emitting device structure, holes and electrons are injected to the organic material layer from the anode and the cathode, respectively, and when the injected holes and electrons meet, excitons are formed, and light emits when these excitons fall back to the ground state.

Development of new materials for such an organic light emitting device has been continuously required. Among these, a blue organic light emitting device essentially needs to have high color purity and long lifetime properties, however, technologies to obtain both at the same time is insufficient due to instability caused by high energy of a blue material. Recently, a thermally active delayed fluorescent material having a core structure including boron has been newly developed and received attention with its high efficiency and color purity, however, the material has disadvantages of having a short lifetime due to high triplet energy and slow reverse intersystem crossing rate. Accordingly, development of a blue organic light emitting material achieving high color purity and long lifetime properties at the same time has been required.

### [Disclosure]

### [Technical Problem]

The present specification is directed to providing a compound, and an organic light emitting device including the same.

### [Technical Solution]

One embodiment of the present specification provides a compound represented by the following Chemical Formula 1.

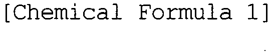

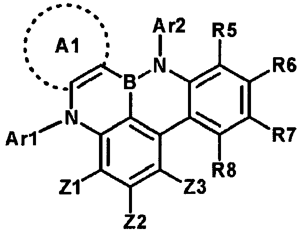

In Chemical Formula 1,
A1 is one selected from the group consisting of a substituted or unsubstituted aromatic hydrocarbon ring; a substituted or unsubstituted aliphatic hydrocarbon ring; a substituted or unsubstituted heteroring; and a fused ring thereof,
R5 to R8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or adjacent groups among R5 to R8 bond to each other to form a substituted or unsubstituted ring,
Ar1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to A1 to form one selected from the group consisting of an aromatic heteroring, an aliphatic heteroring and a fused ring thereof which is substituted or unsubstituted and including one or more selected from N, S, O and Si,
Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R5 to form one selected from the group consisting of an aromatic heteroring, an aliphatic heteroring and a fused ring thereof which is substituted or unsubstituted and including one or more selected from N, S, O and Si,
when Ar2 and R5 form a benzoxazine ring, the benzoxazine ring is an unsubstituted benzoxazine ring,
at least one of Z1 to Z3 is deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or adjacent groups among Z1 to Z3 bond to each other to form a substituted or unsubstituted ring, and the rest are hydrogen, and
when Ar1 is a phenyl group, and A1 is substituted or unsubstituted benzene, and R6 to R8 are hydrogen, and adjacent groups among Z1 to Z3 do not bond to each other to form a substituted or unsubstituted ring, and Ar2 and R5 form an indole group at the same time, the indole group is a substituted indole group.

Another embodiment of the present specification provides an organic light emitting device including a first electrode; a second electrode; and an organic material layer comprising one or more layers provided between the first electrode and the second electrode, wherein one or more layers of the organic material layer include the compound.

### [Advantageous Effects]

A compound according to one embodiment of the present specification can be used as a material of an organic material layer of an organic light emitting device, and by using the same, high color purity, high efficiency and/or enhanced lifetime properties are obtained in the organic light emitting device.

### [Description of Drawings]

FIG. 1 and FIG. 2 each illustrate an organic light emitting device according to one embodiment of the present specification.
FIG. 3 is a diagram illustrating a molecular model obtained by a simulation of a Dopant B and BH system of Example 2-1 of the present specification.
FIG. 4 is a diagram illustrating a molecular model obtained by a simulation of a BD1 and BH system of Comparative Example 2-1 of the present specification.
FIG. 5 is a diagram illustrating a molecular model obtained by a simulation of a BD2 and BH system of Comparative Example 2-2 of the present specification.
FIG. 6 is a diagram showing orbital distribution of HOMO and LUMO of BD1.

### [Reference Numeral]

- 1:: Substrate
- 2:: First Electrode
- 3:: Light Emitting Layer
- 4:: Second Electrode
- 5:: First Hole Injection Layer
- 6:: Second Hole Injection Layer
- 7:: Hole Transfer Layer
- 8:: Electron Blocking Layer
- 9:: First Electron Transfer Layer
- 10:: Second Electron Transfer Layer
- 11:: Electron Injection Layer

### [Mode for Disclosure]

Hereinafter, the present specification will be described in more detail.

One embodiment of the present specification relates to a compound represented by Chemical Formula 1.

An existing organic light emitting device using a boron-based compound has high efficiency compared to an organic light emitting device using a pyrene-based compound, but has a disadvantage of short lifetime. However, the compound represented by Chemical Formula 1 has a narrow full width at half maximum, and an organic light emitting device including the same has advantages of increasing efficiency and lifetime. A narrow full width at half maximum is maintained by the hexagonal ring of boron and amine, and by filling insufficient electrons of the boron through a direct bond of boron and amine on the opposite side, stability of the core in an unstable polaron state increases, which increases a lifetime, and by facilitating a transition of the polaron into an exciton state, an organic light emitting device including the same has increased efficiency.

Throughout the specification of the present application, a term "combination thereof" included in a Markush-type expression means a mixture or a combination of one or more selected from the group consisting of constituents described in the Markush-type expression, and means including one or more selected from the group consisting of the constituents.

Examples of substituents in the present specification are described below, however, the substituents are not limited thereto.

In the present specification, 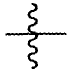 means a linked site.

The term "substitution" means a hydrogen atom bonding to a carbon atom of a compound being changed to another substituent, and the position of substitution is not limited as long as it is a position at which the hydrogen atom is substituted, that is, a position at which a substituent is capable of substituting, and when two or more substituents substitute, the two or more substituents may be the same as or different from each other.

In the present specification, a term "substituted or unsubstituted" means being substituted with one or more substituents selected from the group consisting of deuterium; a halogen group; a cyano group; an alkyl group; a cycloalkyl group; an alkoxy group; an aryloxy group; an alkylthioxy group; an arylthioxy group; an alkenyl group; a haloalkyl group; a haloalkoxy group; an arylalkyl group; a silyl group; a boron group; an amine group; an aryl group; and a heterocyclic group, or being substituted with a substituent linking two or more substituents among the substituents illustrated above, or having no substituents.

In the present specification, linking two or more substituents refers to linking hydrogen of any one substituent to another substituent. For example, linking two or more substituents may include a phenyl group and a naphthyl group being linked to become a substituent of 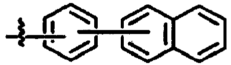 or 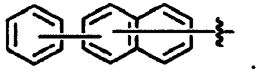 In addition, linking three substituents includes not only continuously linking (substituent 1)-(substituent 2)-(substituent 3), but also linking (substituent 2) and (substituent 3) to (substituent 1). For example, a phenyl group, a naphthyl group and an isopropyl group may be linked to become a substituent of 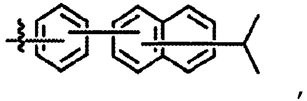 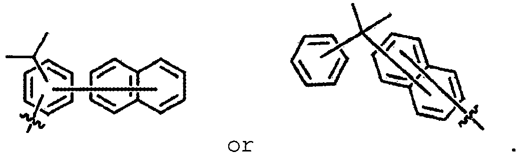 The same definition described above also applies when linking four or more substituents.

In the present specification, examples of the halogen group may include fluorine, chlorine, bromine or iodine.

In the present specification, the alkyl group may be linear or branched, and although not particularly limited thereto, the number of carbon atoms is preferably from 1 to 30. Specific examples thereof may include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl and the like, but are not limited thereto.

In the present specification, the cycloalkyl group is not particularly limited, but preferably has 3 to 30 carbon atoms. Specific examples thereof may include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, an adamantyl group, a bicyclo[2.2.1]heptyl group, a bicyclo[2.2.1]octyl group, a norbornyl group and the like, but are not limited thereto.

In the present specification, the alkoxy group may be linear, branched or cyclic. The number of carbon atoms of the alkoxy group is not particularly limited, but is preferably from 1 to 30. Specific examples thereof may include methoxy, ethoxy, n-propoxy, isopropoxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy and the like, but are not limited thereto.

In the present specification, the alkenyl group may be linear or branched, and although not particularly limited thereto, the number of carbon atoms is preferably from 2 to 30. Specific examples thereof may include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group and the like, but are not limited thereto.

In the present specification, the haloalkyl group means, in the definition of the alkyl group, hydrogen of the alkyl group being substituted with at least one halogen group.

In the present specification, the haloalkoxy group means, in the definition of the alkoxy group, hydrogen of the alkoxy group being substituted with at least one halogen group.

In the present specification, the aryl group is not particularly limited, but preferably has 6 to 30 carbon atoms, and the aryl group may be monocyclic or polycyclic.

When the aryl group is a monocyclic aryl group, the number of carbon atoms is not particularly limited, but is preferably from 6 to 30. Specific examples of the monocyclic aryl group may include a phenyl group, a biphenyl group, a terphenyl group and the like, but are not limited thereto.

When the aryl group is a polycyclic aryl group, the number of carbon atoms is not particularly limited, but is preferably from 10 to 30. Specific examples of the polycyclic aryl group may include a naphthyl group, an anthracene group, a phenanthrene group, a triphenylene group, a pyrene group, a phenalene group, a perylene group, a chrysene group, a fluorene group and the like, but are not limited thereto.

In the present specification, the fluorene group may be substituted, and adjacent groups may bond to each other to form a ring.

When the fluorene group is substituted, 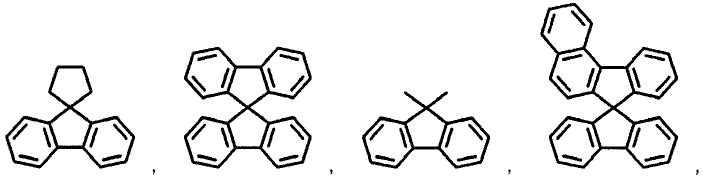 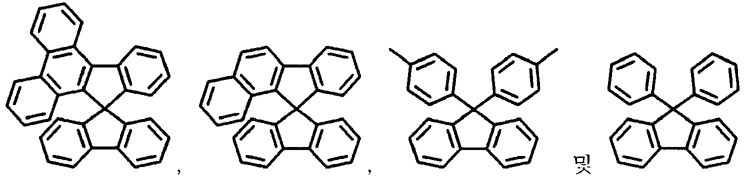 and the like may be included, however, the structure is not limited thereto.

In the present specification, an "adjacent" group may mean a substituent substituting an atom directly linked to an atom substituted by the corresponding substituent, a substituent sterically most closely positioned to the corresponding substituent, or another substituent substituting an atom substituted by the corresponding substituent. For example, two substituents substituting ortho positions in a benzene ring, and two substituents substituting the same carbon in an aliphatic ring may be interpreted as groups "adjacent" to each other.

In the present specification, the arylalkyl group means the alkyl group being substituted with an aryl group, and the examples of the aryl group and the alkyl group described above may be applied to the aryl group and the alkyl group in the arylalkyl group.

In the present specification, the aryloxy group means, in the definition of the alkoxy group, the alkyl group of alkoxy group is substituted with an aryl group, and examples of the aryloxy group may include a phenoxy group, a p-tolyloxy group, an m-tolyloxy group, a 3,5-dimethyl-phenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group and the like, but are not limited thereto.

In the present specification, the alkyl group in the alkylthioxy group is the same as the examples of the alkyl group described above. Specific examples of the alkylthioxy group may include a methylthioxy group, an ethylthioxy group, a tert-butylthioxy group, a hexylthioxy group, an octylthioxy group and the like, but are not limited thereto.

In the present specification, the aryl group in the arylthioxy group is the same as the examples of the aryl group described above. Specific examples of the arylthioxy group may include a phenylthioxy group, a 2-methylphenylthioxy group, a 4-tert-butylphenylthioxy group and the like, but are not limited thereto.

In the present specification, the heterocyclic group is a group including one or more atoms that are not carbon, that is, heteroatoms, and specifically, the heteroatom may include one or more atoms selected from the group consisting of O, N, Se, S and the like, and includes an aromatic heterocyclic group or an aliphatic heterocyclic group. The aromatic heterocyclic group may be expressed as a heteroaryl group. The number of carbon atoms of the heterocyclic group is not particularly limited, but is preferably from 2 to 30, and the heterocyclic group may be monocyclic or polycyclic. Examples of the heterocyclic group may include a thiophene group, a furan group, a pyrrole group, an imidazole group, a thiazole group, an oxazole group, an oxadiazole group, a pyridine group, a bipyridine group, a pyrimidine group, a triazine group, a triazole group, an acridine group, a pyridazine group, a pyrazine group, a quinoline group, a quinazoline group, a quinoxaline group, a phthalazine group, a pyridopyrimidine group, a pyridopyrazine group, a pyrazinopyrazine group, an isoquinoline group, an indole group, a carbazole group, a benzoxazole group, a benzimidazole group, a benzothiazole group, a benzocarbazole group, a benzothiophene group, a dibenzothiophene group, a benzofuran group, a phenanthridine group, a phenanthroline group, an isoxazole group, a thiadiazole group, a dibenzofuran group, dibenzosilole group, a phenoxanthine group, a phenoxazine group, a phenothiazine group, a decahydrobenzocarbazole group, a hexahydrocarbazole group, a dihydrobenzoazasiline group, a dihydroindenocarbazole group, a spirofluorenexanthene group, a spirofluorenethioxanthene group, a tetrahydronaphthothiophene group, a tetrahydronaphthofuran group, a tetrahydrobenzothiophene group, a tetrahydrobenzofuran group and the like, but are not limited thereto.

In the present specification, the silyl group may be an alkylsilyl group, an arylsilyl group, an alkylarylsilyl group, a heteroarylsilyl group or the like. As the alkyl group in the alkylsilyl group, the examples of the alkyl group described above may be applied, and as the aryl group in the arylsilyl group, the examples of the aryl group described above may be applied, and as the alkyl group and the aryl group in the alkylarylsilyl group, the examples of the alkyl group and the aryl group may be applied, and as the heteroaryl group in the heteroarylsilyl group, the examples of the heterocyclic group may be applied.

In the present specification, the boron group may be - BR₁₀₀R₁₀₁. R₁₀₀ and R₁₀₁ are the same as or different from each other, and may be each independently selected from the group consisting of hydrogen; deuterium; halogen; a nitrile group; a substituted or unsubstituted monocyclic or polycyclic cycloalkyl group having 3 to 30 carbon atoms; a substituted or unsubstituted linear or branched alkyl group having 1 to 30 carbon atoms; a substituted or unsubstituted monocyclic or polycyclic aryl group having 6 to 30 carbon atoms; and a substituted or unsubstituted monocyclic or polycyclic heterocyclic group having 2 to 30 carbon atoms. Specific examples of the boron group may include a dimethylboron group, a diethylboron group, a t-butylmethylboron group, a diphenylboron group and the like, but are not limited thereto.

In the present specification, the amine group may be selected from the group consisting of -NH₂, an alkylamine group, an N-alkylarylamine group, an arylamine group, an N-arylheteroarylamine group, an N-alkylheteroarylamine group and a heteroarylamine group, and although not particularly limited thereto, the number of carbon atoms is preferably from 1 to 30. Specific examples of the amine group may include a methylamine group, a dimethylamine group, an ethylamine group, a diethylamine group, a phenylamine group, a naphthylamine group, a biphenylamine group, an anthracenylamine group, a 9-methyl-anthracenylamine group, a diphenylamine group, a ditolylamine group, an N-phenyltolylamine group, a triphenylamine group, an N-phenylbiphenylamine group, an N-phenylnaphthylamine group, an N-biphenylnaphthylamine group, an N-naphthylfluorenylamine group, an N-phenylphenanthrenylamine group, an N-biphenylphenanthrenylamine group, an N-phenylfluorenylamine group, an N-phenylterphenylamine group, an N-phenanthrenylfluorenylamine group, an N-biphenylfluorenylamine group and the like, but are not limited thereto.

In the present specification, the N-alkylarylamine group means an amine group in which N of the amine group is substituted with an alkyl group and an aryl group. The alkyl group and the aryl group in the N-alkylarylamine group are the same as the examples of the alkyl group and the aryl group described above.

In the present specification, the N-arylheteroarylamine group means an amine group in which N of the amine group is substituted with an aryl group and a heteroaryl group. The aryl group and the heteroaryl group in the N-arylheteroarylamine group are the same as the examples of the aryl group and the heterocyclic group described above.

In the present specification, the N-alkylheteroarylamine group means an amine group in which N of the amine group is substituted with an alkyl group and a heteroaryl group. The alkyl group and the heteroaryl group in the N-alkylheteroarylamine group are the same as the examples of the alkyl group and the heterocyclic group described above.

In the present specification, examples of the alkylamine group include a substituted or unsubstituted monoalkylamine group, or a substituted or unsubstituted dialkylamine group. The alkyl group in the alkylamine group may be a linear or branched alkyl group. The alkylamine group including two or more alkyl groups may include linear alkyl groups, branched alkyl groups, or both linear alkyl groups and branched alkyl groups. For example, the alkyl group in the alkylamine group may be selected from among the examples of the alkyl group described above.

In the present specification, examples of the heteroarylamine group include a substituted or unsubstituted monoheteroarylamine group, or a substituted or unsubstituted diheteroarylamine group. The heteroarylamine group including two or more heteroaryl groups may include monocyclic heteroaryl groups, polycyclic heteroaryl groups, or both monocyclic heteroaryl groups and polycyclic heteroaryl groups. For example, the heteroaryl group in the heteroarylamine group may be selected from among the examples of the heterocyclic group described above.

In the present specification, the hydrocarbon ring group may be an aromatic hydrocarbon ring group, an aliphatic hydrocarbon ring group, or a fused ring group of an aromatic hydrocarbon ring and an aliphatic hydrocarbon ring, and may be selected from among the examples of the cycloalkyl group, the aryl group, and combinations thereof. Examples of the hydrocarbon ring group may include a phenyl group, a cyclohexyl group, an adamantyl group, a bicyclo[2.2.1]heptyl group, a bicyclo[2.2.1]octyl group, a tetrahydronaphthalene group, a tetrahydroanthracene group, a 1,2,3,4-tetrahydro-1,4-methanonaphthalene group, a 1,2,3,4-tetrahydro-1,4-ethanonaphthalene group and the like, but are not limited thereto.

In the present specification, the meaning of "adjacent" in the "bonding to adjacent groups to form a ring" is the same as the descriptions provided above, and the "ring" means a substituted or unsubstituted hydrocarbon ring; or a substituted or unsubstituted heteroring.

In the present specification, the hydrocarbon ring may be an aromatic hydrocarbon ring, an aliphatic hydrocarbon ring, or a fused ring of an aromatic hydrocarbon ring and an aliphatic hydrocarbon ring, and may be selected from among the examples of the cycloalkyl group, the aryl group, and combinations thereof except for those that are not monovalent. Examples of the hydrocarbon ring may include benzene, cyclohexane, adamantane, bicyclo[2.2.1]heptane, bicyclo[2.2.1]octane, tetrahydronaphthalene, tetrahydroanthracene, 1,2,3,4-tetrahydro-1,4-methanonaphthalene, 1,2,3,4-tetrahydro-1,4-ethanonaphthalene and the like, but are not limited thereto.

In addition, the aliphatic hydrocarbon ring includes all of a hydrocarbon ring including a single bond, a non-aromatic hydrocarbon ring including a multiple bond, or a ring having a form in which rings including a single bond and a multiple bond are fused. Accordingly, the ring formed with a single bond of the aliphatic hydrocarbon ring may be selected from among the examples of the cycloalkyl group except for those that are not a monovalent group, and the hydrocarbon ring including a single bond and a double bond but not an aromatic ring such as cyclopropene, cyclobutene, cyclopentene, cyclohexene, cycloheptene, cyclooctene, cyclononene, cyclodecene or cyclonorbornene also belongs to the aliphatic hydrocarbon ring.

In the present specification, the heteroring means a ring including one or more atoms that are that carbon, that is, heteroatoms, and specifically, the heteroatom may include one or more atoms selected form the group consisting of O, N, Se, S and the like. The heteroring may be monocyclic or polycyclic, and may be an aromatic heteroring; an aliphatic heteroring; a fused ring of an aromatic heteroring and an aliphatic heteroring; a fused ring of an aliphatic hydrocarbon ring, an aromatic hydrocarbon ring and an aromatic heterocyclic group, or a fused ring of an aliphatic hydrocarbon ring, an aromatic hydrocarbon ring and an aliphatic heterocyclic group, and the aromatic heteroring may be selected from among the examples of the heteroaryl group of the heterocyclic group except for those that are not monovalent.

In the present specification, the aliphatic heteroring means an aliphatic ring including one or more of heteroatoms. The aliphatic heteroring includes all of an aliphatic ring including a single bond, an aliphatic ring including a multiple bond, or an aliphatic ring having a form in which rings including a single bond and a multiple bond are fused. Examples of the aliphatic heteroring may include oxirane, tetrahydrofuran, 1,4-dioxane, pyrrolidine, piperidine, morpholine, oxepane, azokane, thiokane, tetrahydronaphthothiophene, tetrahydronaphthofuran, tetrahydrobenzothiophene, tetrahydrobenzofuran and the like, but are not limited thereto.

Unless defined otherwise in the present specification, all technical and scientific terms used in the present specification have the same meanings as terms commonly understood by those skilled in the art. Although methods and materials similar or equivalent to those described in the present specification may be used in implementing or experimenting embodiments of the present disclosure, suitable methods and materials are described later. All publications, patent applications, patents and other reference documents mentioned in the present specification are incorporated by reference in the present specification as a whole, and when conflicting, the present specification including definitions has priority unless specific passage is mentioned. Furthermore, materials, methods and examples are for illustrative purposes only, and not to limit the present specification.

According to one embodiment of the present specification, Chemical Formula 1 is represented by the following Chemical Formula 1-1.

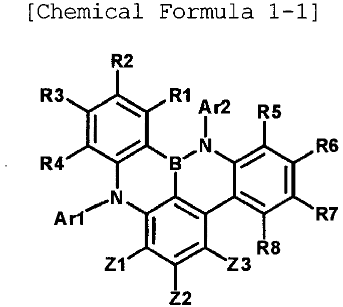

In Chemical Formula 1-1,
R5 to R8, Ar2 and Z1 to Z3 have the same definitions as in Chemical Formula 1,
R1 to R4 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups among R1 to R4 to form one selected from the group consisting of a substituted or unsubstituted aromatic hydrocarbon ring; a substituted or unsubstituted aliphatic hydrocarbon ring; a substituted or unsubstituted heteroring; and a fused ring thereof,
Ar1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R4 to form one selected from the group consisting of an aromatic heteroring, an aliphatic heteroring and a fused ring thereof which is substituted or unsubstituted and including one or more selected from N, S, O and Si, and
when Ar1 is a phenyl group, and R1 to R4 and R6 to R8 are hydrogen, and adjacent groups among Z1 to Z3 do not bond to each other to form a substituted or unsubstituted ring, and Ar2 and R5 form an indole group at the same time, the indole group is a substituted indole group.

According to one embodiment of the present specification, Chemical Formula 1 is represented by the following Chemical Formula 1-2.

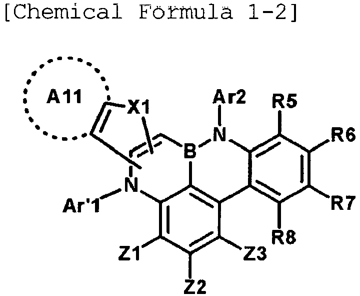

In Chemical Formula 1-2,
R5 to R8, Ar2 and Z1 to Z3 have the same definitions as in Chemical Formula 1,
X1 is CRR', O or S,
A11 is a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
Ar'1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, and
R and R' are the same as or different from each other, and each independently a substituted or unsubstituted alkyl group; a substituted or unsubstituted aryl group; or a substituted or unsubstituted heterocyclic group, or bond to each other to form a substituted or unsubstituted ring.

According to one embodiment of the present specification, Chemical Formula 1-1 is represented by one of the following Chemical Formulae 1-1-1 to 1-1-36.

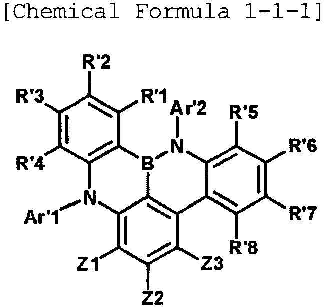

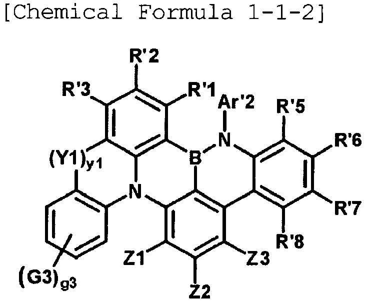

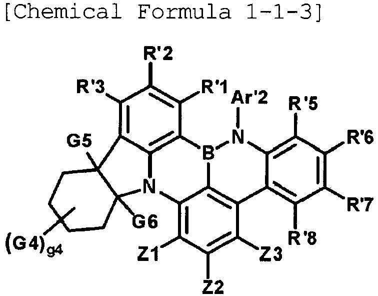

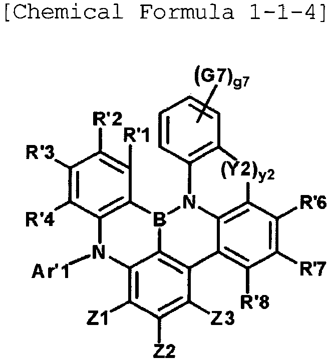

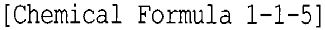

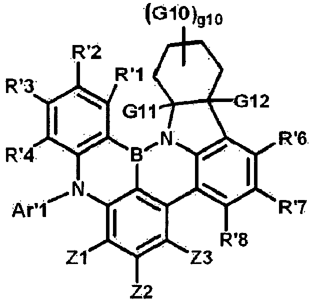

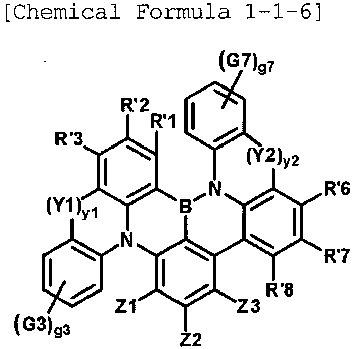

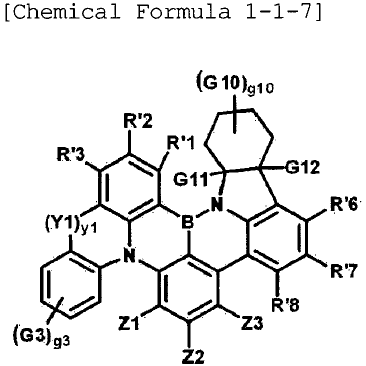

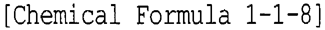

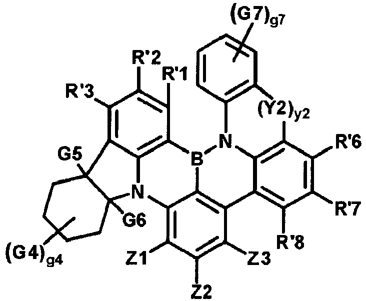

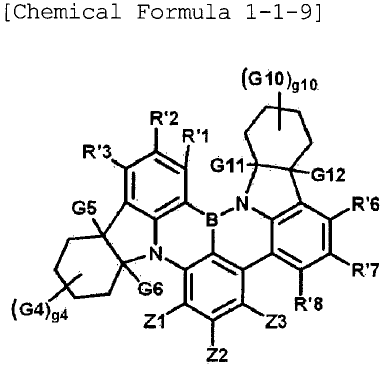

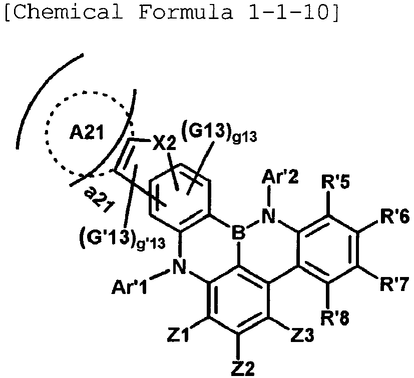

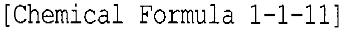

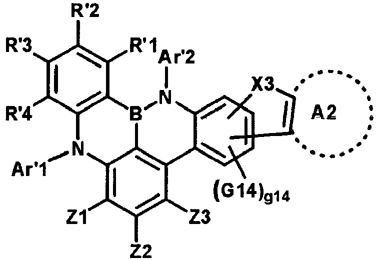

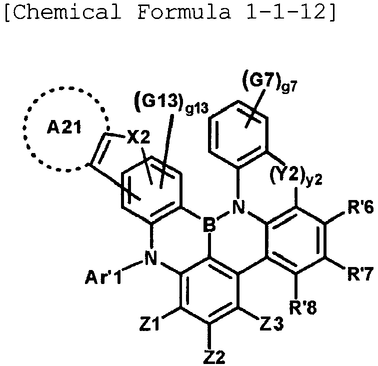

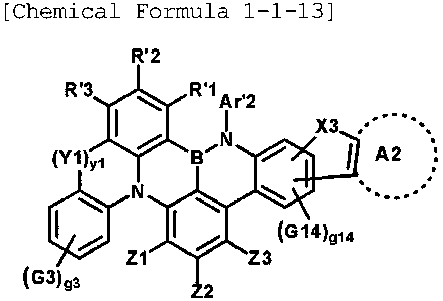

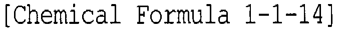

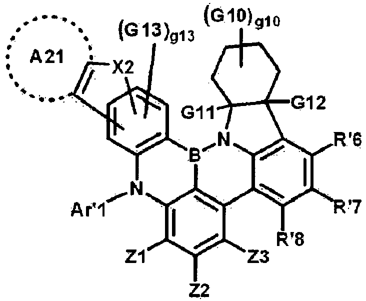

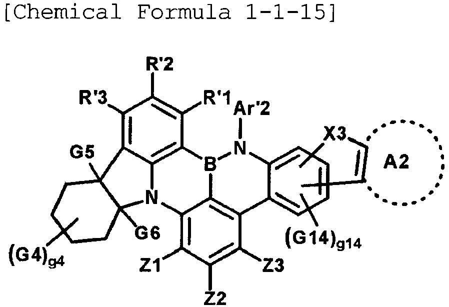

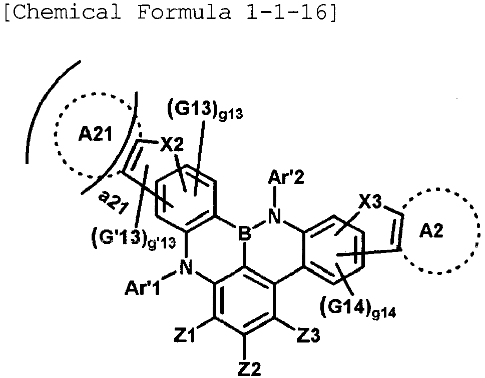

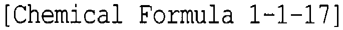

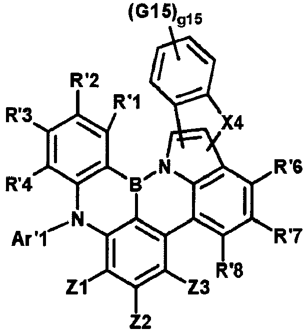

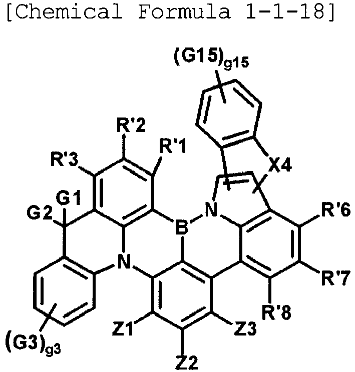

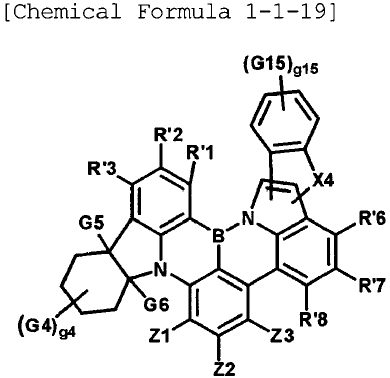

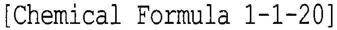

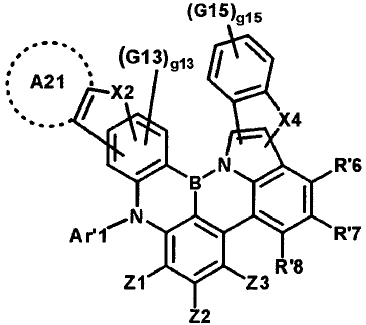

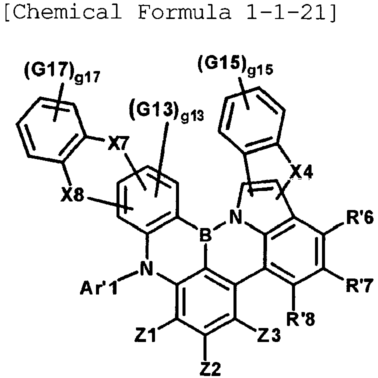

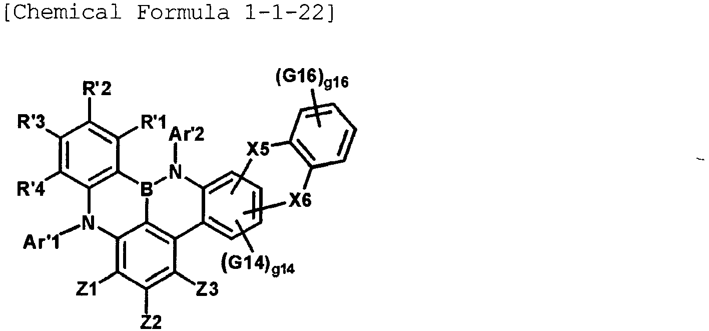

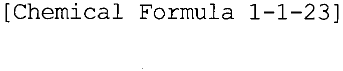

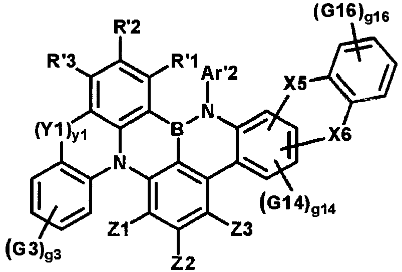

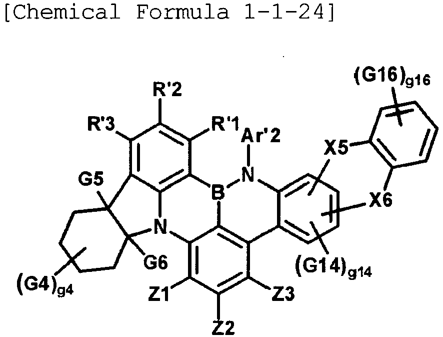

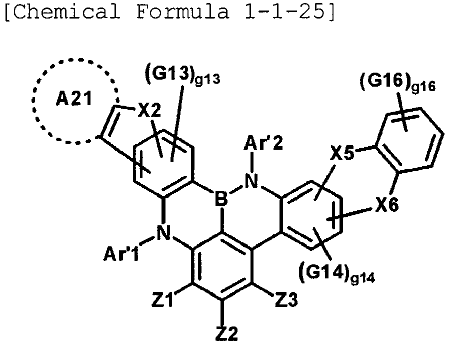

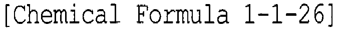

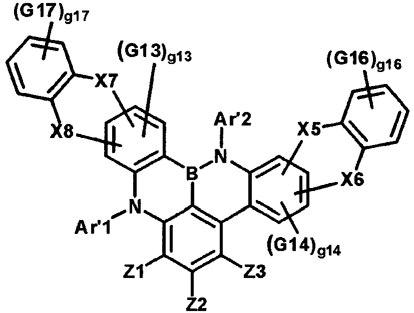

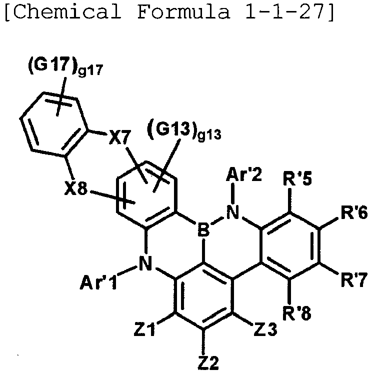

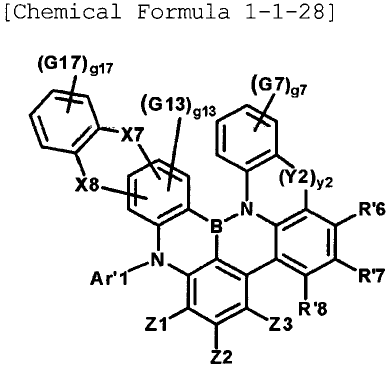

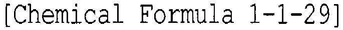

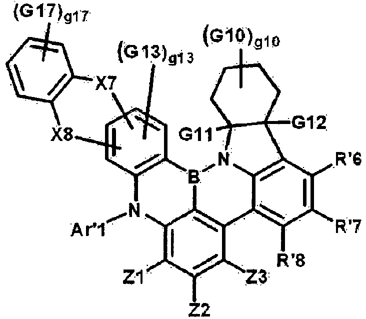

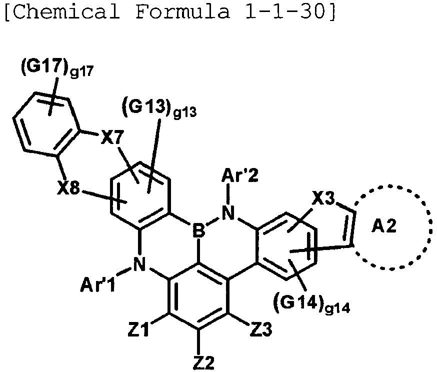

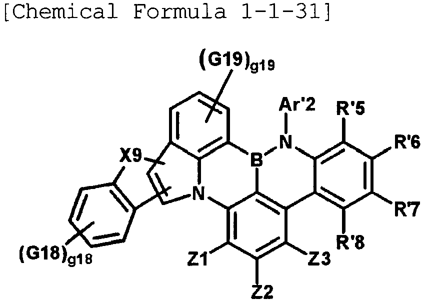

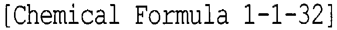

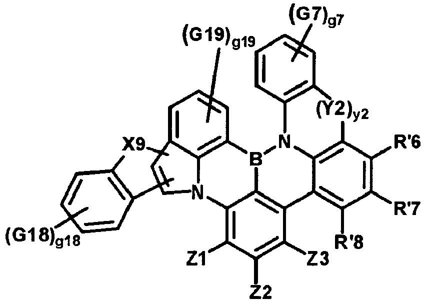

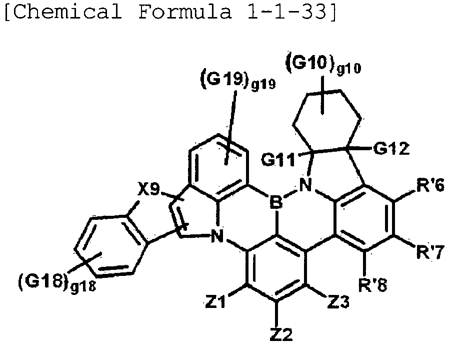

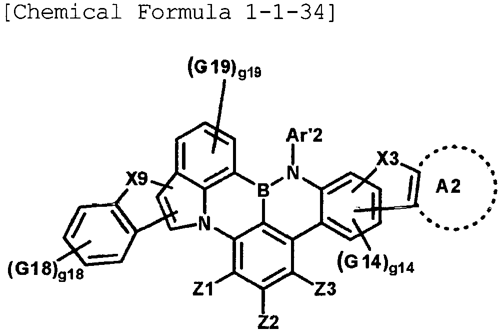

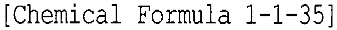

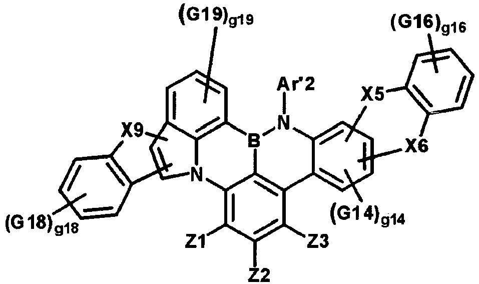

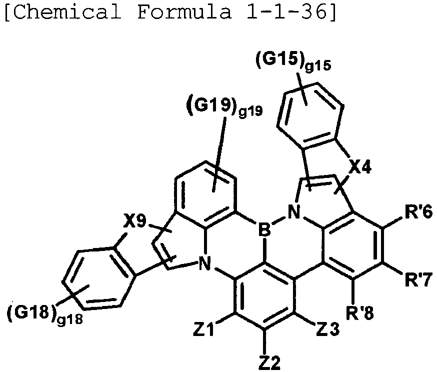

In Chemical Formulae 1-1-1 to 1-1-36,
X2 to X9 are the same as or different from each other, and each independently CRR', NR", O or S,
Y1 and Y2 are the same as or different from each other, and each independently CG1G2, SiG8G9, NG101, O or S,
y1 is 0 or 1, and when y1 is 0, Y1 is a direct bond,
y2 is 0 or 1, and when y2 is 0, Y2 is a direct bond,
R, R' and R" are the same as or different from each other, and each independently a substituted or unsubstituted alkyl group; a substituted or unsubstituted aryl group; or a substituted or unsubstituted heterocyclic group, or bond to each other to form a substituted or unsubstituted ring,
R'1 to R'8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group,
G1 to G19, G'13 and G101 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or adjacent groups bond to each other to form a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
g3, g7, and g15 to g18 are each an integer of 1 to 4,
g4 and g10 are each an integer of 1 to 8,
g13 and g14 are each 1 or 2,
g'13 is an integer of 0 to 2,
g19 is an integer of 1 to 3,
a21 is 0 or 1,
when g3, g4, g7, g10, and g15 to g19 are each 2 or greater, substituents in the two or more parentheses are the same as or different from each other,
when g13, g'13 and g14 are each 2, substituents in the two parentheses are the same as or different from each other,
Ar'1 and Ar'2 are the same as or different from each other, and each independently a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group,
A2 and A21 are the same as or different from each other, and each independently a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
at least one of Z1 to Z3 is deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to adjacent groups to form a substituted or unsubstituted ring, and the rest are hydrogen, and
in Chemical Formulae 1-1-4, 1-1-6, 1-1-8, 1-1-12, 1-1-28 and 1-1-32,
when y2 is 1 and Y2 is O, G7 and R'6 to R'8 are hydrogen.

According to one embodiment of the present specification, Chemical Formula 1-2 is represented by one of the following Chemical Formulae 1-2-1 to 1-2-6.

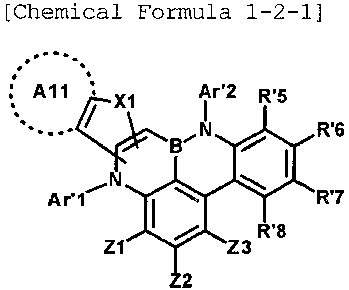

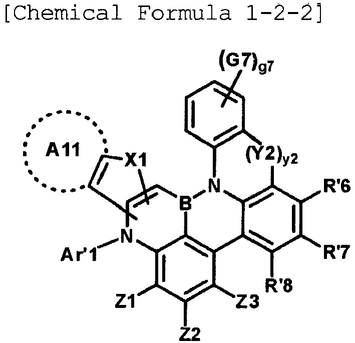

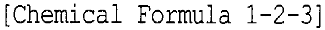

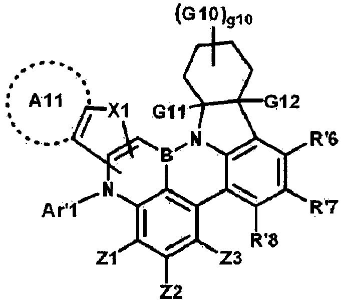

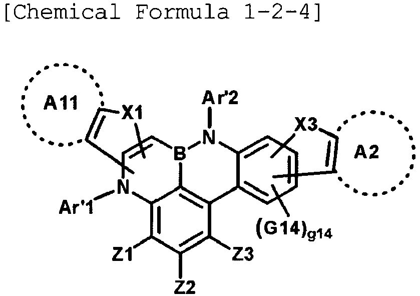

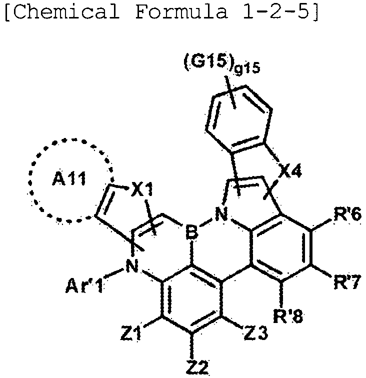

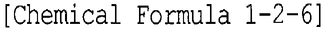

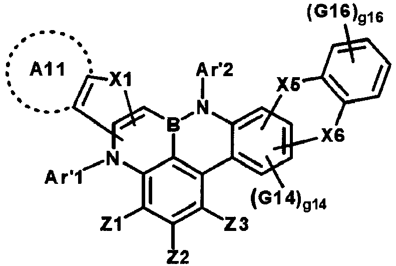

In Chemical Formulae 1-2-1 to 1-2-6,
X1, A11 and Z1 to Z3 have the same definitions as in Chemical Formula 1-2,
X3 to X6 are the same as or different from each other, and each independently CRR', NR", O or S,
Y2 is CG1G2, SiG8G9, NG101, O or S,
y2 is 0 or 1, and when y2 is 0, Y2 is a direct bond,
A2 is a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
Ar'1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group,
R, R' and R" are the same as or different from each other, and each independently a substituted or unsubstituted alkyl group; a substituted or unsubstituted aryl group; or a substituted or unsubstituted heterocyclic group, or bond to each other to form a substituted or unsubstituted ring,
R'5 to R'8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group,
G1, G2, G7 to G12, G14, G15, G16 and G101 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or adjacent groups bond to each other to form a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
g7, g15 and g16 are each an integer of 1 to 4,
g10 is an integer of 1 to 8,
g14 is 1 or 2,
when g7, g10, g15 and g16 are each 2 or greater, substituents in the two or more parentheses are the same as or different from each other,
when g14 is 2, substituents in the two parentheses are the same as or different from each other, and
Ar'1 and Ar'2 are the same as or different from each other, and each independently a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group.

According to one embodiment of the present specification, in Chemical Formula 1-1-4,
Y2 is CG1G2, SiG8G9, NG101, O or S, and y2 is 0 or 1,
when y2 is 0, Y2 is a direct bond,
R'1 to R'4 and R'6 to R'8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group,
G7s are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, and g7 is an integer of 1 to 4,
Ar'1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group,
at least one of Z1 to Z3 is deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, and
in Chemical Formula 1-2-2,
when y2 is 1 and Y2 is O, G7 and R'6 to R'8 are hydrogen.

According to one embodiment of the present specification, in Chemical Formula 1-1-4, a case of the substituents bonding to each other to form a substituted or unsubstituted ring is excluded.

According to one embodiment of the present specification, Chemical Formula 1 is represented by one of the following Chemical Formulae 1-3 to 1-5.

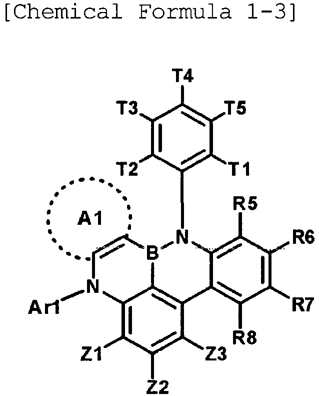

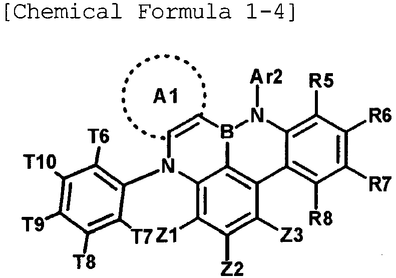

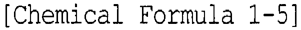

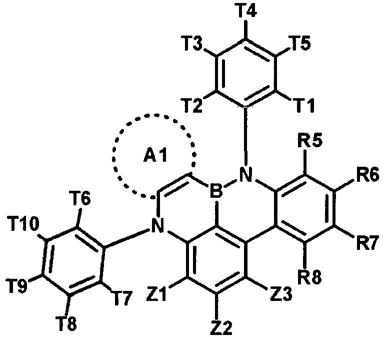

In Chemical Formulae 1-3 to 1-5,
Ar1, Ar2, A1, R5 to R8 and Z1 to Z3 have the same definitions as in Chemical Formula 1,
T1 to T10 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring,
at least one of T1 and T2 is a substituted or unsubstituted alkyl group; a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, and
at least one of T6 and T7 is a substituted or unsubstituted alkyl group; a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group.

According to one embodiment of the present specification, Chemical Formula 1 is represented by the following Chemical Formula 2.

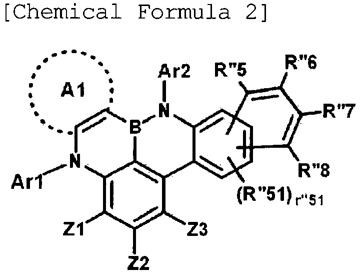

In Chemical Formula 2,
A1, Ar1 and Z1 to Z3 have the same definitions as in Chemical Formula 1,
Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R"51 to form one selected from the group consisting of an aromatic heteroring, an aliphatic heteroring, and a fused ring thereof, each of which is substituted or unsubstituted and includes one or more selected from N, S, O and Si,
R"51 and R"5 to R"8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring,
r"51 is 1 or 2, and
when r"51 is 2, the two R"51s are the same as or different from each other.

According to one embodiment of the present specification, Chemical Formula 1-1 is represented by the following Chemical Formula 2-1.

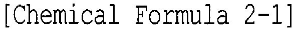

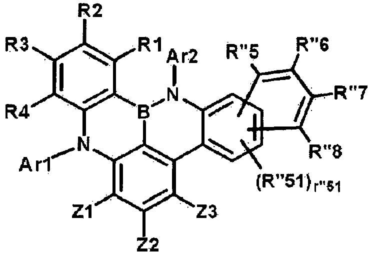

In Chemical Formula 2-1,
Ar1, R1 to R4 and Z1 to Z3 have the same definitions as in Chemical Formula 1-1,
Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R"51 to form one selected from the group consisting of an aromatic heteroring, an aliphatic heteroring, and a fused ring thereof, each of which an aliphatic heteroring, and a fused ring thereof, each of which is substituted or unsubstituted and includes one or more selected from N, S, O and Si,
R"51 and R"5 to R"8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring,
r"51 is 1 or 2, and
when r"51 is 2, the two R"51s are the same as or different from each other.

According to one embodiment of the present specification, Chemical Formula 1-2 is represented by the following Chemical Formula 2-2. 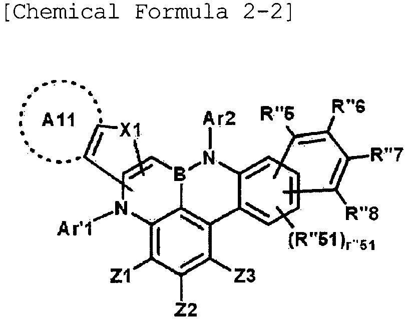
X1, A11, Ar'1 and Z1 to Z3 have the same definitions as in Chemical Formula 1-2,
Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R"51 to form one selected from the group consisting of an aromatic heteroring, an aliphatic heteroring, and a fused ring thereof, each of which is substituted or unsubstituted and includes one or more selected from N, S, O and Si,
R"51 and R"5 to R"8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring,
r"51 is 1 or 2, and
when r"51 is 2, the two R"51s are the same as or different from each other.

According to one embodiment of the present specification, adjacent groups among Z1 to Z3 bond to each other to form a ring represented by the following Chemical Formula C-1 or C-2.

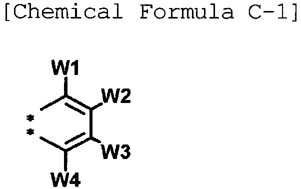

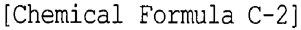

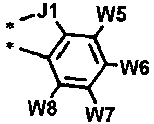

In Chemical Formulae C-1 and C-2,
J1 is O, S, NQ7, CQ8Q9 or SiQ10Q11,
W1 to W8 and Q7 to Q11 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring, and
* is a site bonding to Chemical Formula 1.

According to one embodiment of the present specification, adjacent groups among W1 to W8 bond to each other to form the ring represented by Chemical Formula C-1.

According to one embodiment of the present specification, Chemical Formula C-2 is one selected from the following structures.

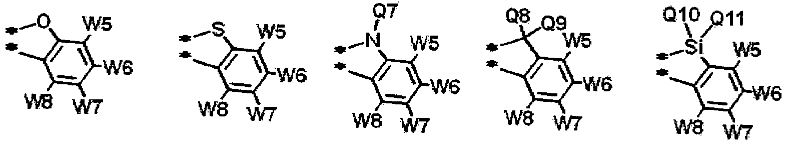

In the structures,
*, W1 to W8 and Q7 to Q11 have the same definitions as described above.

According to one embodiment of the present specification, A1 is a substituted or unsubstituted monocyclic or polycyclic aromatic hydrocarbon ring having 6 to 30 carbon atoms; a substituted or unsubstituted fused ring of a monocyclic or polycyclic aromatic hydrocarbon ring having 6 to 30 carbon atoms and a monocyclic or polycyclic aliphatic hydrocarbon ring having 3 to 30 carbon atoms; or a substituted or unsubstituted monocyclic or polycyclic heteroring having 2 to 30 carbon atoms.

According to one embodiment of the present specification, A1 is a monocyclic or polycyclic aromatic hydrocarbon ring having 6 to 30 carbon atoms unsubstituted or substituted with a linear or branched alkyl group having 1 to 30 carbon atoms, a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms, a monocyclic or polycyclic aryl group having 6 to 30 carbon atoms, or NQ1Q2; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms or a monocyclic or polycyclic aryl group having 6 to 30 carbon atoms.

According to one embodiment of the present specification, A1 is benzene unsubstituted or substituted with a linear or branched alkyl group having 1 to 30 carbon atoms, a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms, a monocyclic or polycyclic aryl group having 6 to 30 carbon atoms, or NQ1Q2; naphthalene; indene unsubstituted or substituted with a linear or branched alkyl group having 1 to 30 carbon atoms; fluorene unsubstituted or substituted with a linear or branched alkyl group having 1 to 30 carbon atoms; tetrahydronaphthalene unsubstituted or substituted with a linear or branched alkyl group having 1 to 30 carbon atoms; dibenzofuran unsubstituted or substituted with a linear or branched alkyl group having 1 to 30 carbon atoms; dibenzothiophene unsubstituted or substituted with a linear or branched alkyl group having 1 to 30 carbon atoms; benzofuran unsubstituted or substituted with a linear or branched alkyl group having 1 to 30 carbon atoms or a monocyclic or polycyclic aryl group having 6 to 30 carbon atoms; benzothiophene unsubstituted or substituted with a linear or branched alkyl group having 1 to 30 carbon atoms or a monocyclic or polycyclic aryl group having 6 to 30 carbon atoms; benzonaphthofuran; naphthofuran; benzonaphthothiophene unsubstituted or substituted with a linear or branched alkyl group having 1 to 30 carbon atoms; tetrahydrobenzonaphthofuran unsubstituted or substituted with a linear or branched alkyl group having 1 to 30 carbon atoms; tetrahydrobenzonaphthothiophene unsubstituted or substituted with a linear or branched alkyl group having 1 to 30 carbon atoms; tetrahydrobenzofluorene unsubstituted or substituted with a linear or branched alkyl group having 1 to 30 carbon atoms; tetrahydronaphthofuran unsubstituted or substituted with a linear or branched alkyl group having 1 to 30 carbon atoms; tetrahydronaphthothiophene unsubstituted or substituted with a linear or branched alkyl group having 1 to 30 carbon atoms; naphthothiophene unsubstituted or substituted with a linear or branched alkyl group having 1 to 30 carbon atoms; or tetrahydrobenzoindene unsubstituted or substituted with a linear or branched alkyl group having 1 to 30 carbon atoms.

According to one embodiment of the present specification, A1 is benzene unsubstituted or substituted with a methyl group, a tert-butyl group, a tetramethyltetrahydronaphthyl group, a phenyl group or NQ1Q2; naphthalene; indene unsubstituted or substituted with a methyl group; fluorene unsubstituted or substituted with a methyl group; tetrahydronaphthalene unsubstituted or substituted with a methyl group; dibenzofuran unsubstituted or substituted with a methyl group or a tert-butyl group; dibenzothiophene unsubstituted or substituted with a methyl group or a tert-butyl group; benzofuran unsubstituted or substituted with a methyl group, a phenyl group or a tert-butyl group; benzothiophene unsubstituted or substituted with a methyl group, a phenyl group or a tert-butyl group; benzonaphthofuran; naphthofuran; benzonaphthothiophene unsubstituted or substituted with a tert-butyl group; tetrahydrobenzonaphthofuran unsubstituted or substituted with a methyl group; tetrahydrobenzonaphthothiophene unsubstituted or substituted with a methyl group; tetrahydrobenzofluorene unsubstituted or substituted with a methyl group; tetrahydronaphthofuran unsubstituted or substituted with a methyl group; tetrahydronaphthothiophene unsubstituted or substituted with a methyl group; naphthothiophene unsubstituted or substituted with a methyl group; or tetrahydrobenzoindene unsubstituted or substituted with a methyl group.

According to one embodiment of the present specification, Q1 and Q2 are the same as or different from each other, and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms.

According to one embodiment of the present specification, Q1 and Q2 are the same as or different from each other, and each independently a methyl group; a tert-butyl group; a phenyl group unsubstituted or substituted with a methyl group or a tert-butyl group; a biphenyl group unsubstituted or substituted with a methyl group or a tert-butyl group; a fluorene group unsubstituted or substituted with a methyl group; a tetrahydronaphthyl group unsubstituted or substituted with a methyl group; a dibenzofuran group; or a dibenzothiophene group.

According to one embodiment of the present specification, R5 to R8 are the same as or different from each other, and each independently hydrogen; deuterium; a substituted or unsubstituted linear or branched alkyl group having 1 to 30 carbon atoms; a substituted or unsubstituted monocyclic or polycyclic aryl group having 6 to 30 carbon atoms; or NQ3Q4, or bond to adjacent groups to form a substituted or unsubstituted monocyclic or polycyclic aliphatic hydrocarbon ring having 3 to 30 carbon atoms; a substituted or unsubstituted monocyclic or polycyclic aromatic hydrocarbon ring having 6 to 30 carbon atoms; a substituted or unsubstituted fused ring of a monocyclic or polycyclic aromatic hydrocarbon ring having 6 to 30 carbon atoms and a monocyclic or polycyclic aliphatic hydrocarbon ring having 3 to 30 carbon atoms; or a substituted or unsubstituted monocyclic or polycyclic heteroring having 2 to 30 carbon atoms.

According to one embodiment of the present specification, R5 to R8 are the same as or different from each other, and each independently hydrogen; deuterium; a linear or branched alkyl group having 1 to 30 carbon atoms; a monocyclic or polycyclic aryl group having 6 to 30 carbon atoms; or NQ3Q4, or bond to adjacent groups to form a monocyclic or polycyclic aliphatic hydrocarbon ring having 3 to 30 carbon atoms unsubstituted or substituted with a linear or branched alkyl group having 1 to 30 carbon atoms; a monocyclic or polycyclic aromatic hydrocarbon ring having 6 to 30 carbon atoms unsubstituted or substituted with a linear or branched alkyl group having 1 to 30 carbon atoms, or a monocyclic or polycyclic diarylamine group having 6 to 30 carbon atoms unsubstituted or substituted with a linear or branched alkyl group having 1 to 30 carbon atoms; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms or a monocyclic or polycyclic aryl group having 6 to 30 carbon atoms.

According to one embodiment of the present specification, R5 to R8 are the same as or different from each other, and each independently hydrogen; deuterium; a methyl group; a tert-butyl group; a phenyl group; or NQ3Q4, or bond to adjacent groups to form cyclohexane unsubstituted or substituted with a linear or branched alkyl group having 1 to 30 carbon atoms; benzene; benzofuran unsubstituted or substituted with a linear or branched alkyl group having 1 to 30 carbon atoms, or a monocyclic or polycyclic diarylamine group having 6 to 30 carbon atoms unsubstituted or substituted with a linear or branched alkyl group having 1 to 30 carbon atoms; benzothiophene unsubstituted or substituted with a linear or branched alkyl group having 1 to 30 carbon atoms, or a monocyclic or polycyclic diarylamine group having 6 to 30 carbon atoms unsubstituted or substituted with a linear or branched alkyl group having 1 to 30 carbon atoms; naphthofuran; naphthothiophene; indene unsubstituted or substituted with a linear or branched alkyl group having 1 to 30 carbon atoms, or a monocyclic or polycyclic diarylamine group having 6 to 30 carbon atoms unsubstituted or substituted with a linear or branched alkyl group having 1 to 30 carbon atoms; indole unsubstituted or substituted with a monocyclic or polycyclic aryl group having 6 to 30 carbon atoms; indoloindene unsubstituted or substituted with a linear or branched alkyl group having 1 to 30 carbon atoms; indoloindole; tetrahydronaphthofuran unsubstituted or substituted with a linear or branched alkyl group having 1 to 30 carbon atoms; tetrahydronaphthothiophene unsubstituted or substituted with a linear or branched alkyl group having 1 to 30 carbon atoms; tetrahydrobenzoindene unsubstituted or substituted with a linear or branched alkyl group having 1 to 30 carbon atoms; benzodioxine; benzooxathiine; benzodithiine; thiochromene unsubstituted or substituted with a linear or branched alkyl group having 1 to 30 carbon atoms; chromene unsubstituted or substituted with a linear or branched alkyl group having 1 to 30 carbon atoms; or dihydronaphthalene unsubstituted or substituted with a linear or branched alkyl group having 1 to 30 carbon atoms.

According to one embodiment of the present specification, R5 to R8 are the same as or different from each other, and each independently hydrogen; deuterium; a methyl group; a tert-butyl group; a phenyl group; or NQ3Q4, or bond to adjacent groups to form cyclohexane unsubstituted or substituted with a methyl group; benzene; benzofuran unsubstituted or substituted with a methyl group, a tert-butyl group, or a diphenylamine group unsubstituted or substituted with a tert-butyl group; benzothiophene unsubstituted or substituted with a methyl group, a tert-butyl group, or a diphenylamine group unsubstituted or substituted with a tert-butyl group; naphthofuran; naphthothiophene; indene unsubstituted or substituted with a methyl group, or a diphenylamine group unsubstituted or substituted with a tert-butyl group; indole unsubstituted or substituted with a phenyl group; indoloindene unsubstituted or substituted with a methyl group; indoloindole; tetrahydronaphthofuran unsubstituted or substituted with a methyl group; tetrahydronaphthothiophene unsubstituted or substituted with a methyl group; tetrahydrobenzoindene unsubstituted or substituted with a methyl group; benzodioxine; benzooxathiine; benzodithiine; thiochromene unsubstituted or substituted with a methyl group; chromene unsubstituted or substituted with a methyl group; or dihydronaphthalene unsubstituted or substituted with a methyl group.

According to one embodiment of the present specification, Q3 and Q4 are the same as or different from each other, and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms.

According to one embodiment of the present specification, Q3 and Q4 are the same as or different from each other, and each independently a methyl group; a tert-butyl group; a phenyl group unsubstituted or substituted with a methyl group or a tert-butyl group; a biphenyl group unsubstituted or substituted with a methyl group or a tert-butyl group; a fluorene group unsubstituted or substituted with a methyl group; a tetrahydronaphthyl group unsubstituted or substituted with a methyl group; a dibenzofuran group; or a dibenzothiophene group.

According to one embodiment of the present specification, Ar1 is a substituted or unsubstituted monocyclic or polycyclic aryl group having 6 to 30 carbon atoms; a substituted or unsubstituted fused ring group of a monocyclic or polycyclic aromatic hydrocarbon ring having 6 to 30 carbon atoms and a monocyclic or polycyclic aliphatic hydrocarbon ring having 3 to 30 carbon atoms; or a substituted or unsubstituted monocyclic or polycyclic heterocyclic group having 2 to 30 carbon atoms, or bonds to A1 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof, each of which is substituted or unsubstituted and includes one or more selected from N, S, O and Si.

According to one embodiment of the present specification, Ar1 is a monocyclic or polycyclic aryl group having 6 to 30 carbon atoms unsubstituted or substituted with one or more selected from the group consisting of a linear or branched alkyl group having 1 to 30 carbon atoms, a monocyclic or polycyclic aryl group having 6 to 30 carbon atoms, and a combination thereof; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or bonds to A1 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof, each of which is unsubstituted or substituted with a linear or branched alkyl group having 1 to 30 carbon atoms, a monocyclic or polycyclic cycloalkyl group having 3 to 30 carbon atoms, or a monocyclic or polycyclic aryl group having 6 to 30 carbon atoms, and includes one or more selected from N, S, O and Si.

According to one embodiment of the present specification, Ar1 is a phenyl group unsubstituted or substituted with one or more selected from the group consisting of a linear or branched alkyl group having 1 to 30 carbon atoms, a monocyclic or polycyclic aryl group having 6 to 30 carbon atoms, and a combination thereof; a biphenyl group unsubstituted or substituted with a linear or branched alkyl group having 1 to 30 carbon atoms; a terphenyl group; a fluorene group unsubstituted or substituted with a linear or branched alkyl group having 1 to 30 carbon atoms; a tetrahydronaphthyl group unsubstituted or substituted with a linear or branched alkyl group having 1 to 30 carbon atoms; a dibenzofuran group; or a dibenzothiophene group, or bonds to A1 to form dihydroacridine unsubstituted or substituted with a linear or branched alkyl group having 1 to 30 carbon atoms or a monocyclic or polycyclic aryl group having 6 to 30 carbon atoms; spiroacridinefluorene; hexahydrocarbazole unsubstituted or substituted with a linear or branched alkyl group having 1 to 30 carbon atoms; dihydrobenzoacridine unsubstituted or substituted with a linear or branched alkyl group having 1 to 30 carbon atoms or a monocyclic or polycyclic aryl group having 6 to 30 carbon atoms; hexahydrobenzoacridine unsubstituted or substituted with a linear or branched alkyl group having 1 to 30 carbon atoms or a monocyclic or polycyclic aryl group having 6 to 30 carbon atoms; spirobenzoacridine; spirotetrahydrobenzoacridinefluorene; benzofuroindole; benzothienoindole; dihydrodibenzoazasiline unsubstituted or substituted with a linear or branched alkyl group having 1 to 30 carbon atoms or a monocyclic or polycyclic aryl group having 6 to 30 carbon atoms; spirodibenzosiloledibenzoazasiline; phenoxazine; phenothiazine; dihydroindenoindole unsubstituted or substituted with a linear or branched alkyl group having 1 to 30 carbon atoms or a monocyclic or polycyclic aryl group having 6 to 30 carbon atoms; benzocarbazole; or carbazole unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms.

According to one embodiment of the present specification, Ar1 is a phenyl group unsubstituted or substituted with one or more selected from the group consisting of a methyl group, an iso-propyl group, a tert-butyl group, a phenyl group and a combination thereof; a biphenyl group unsubstituted or substituted with a methyl group or a tert-butyl group; a terphenyl group; a fluorene group unsubstituted or substituted with a methyl group; a tetrahydronaphthyl group unsubstituted or substituted with a methyl group; a dibenzofuran group; or a dibenzothiophene group, or bonds to A1 to form dihydroacridine unsubstituted or substituted with a methyl group or a phenyl group; spiroacridinefluorene; hexahydrocarbazole unsubstituted or substituted with one or more selected from the group consisting of a methyl group and a tert-butyl group; dihydrobenzoacridine unsubstituted or substituted with a methyl group or a phenyl group; hexahydrobenzoacridine unsubstituted or substituted with a methyl group or a phenyl group; spirobenzoacridine; spirotetrahydrobenzoacridinefluorene; benzofuroindole; benzothienoindole; dihydrodibenzoazasiline unsubstituted or substituted with a methyl group or a phenyl group; spirodibenzosiloledibenzoazasiline; phenoxazine; phenothiazine; dihydroindenoindole unsubstituted or substituted with a methyl group or a phenyl group; benzocarbazole; or carbazole unsubstituted or substituted with a tert-butyl group, an adamantyl group or a phenyl group.

According to one embodiment of the present specification, Ar2 is a substituted or unsubstituted monocyclic or polycyclic aryl group having 6 to 30 carbon atoms; a substituted or unsubstituted fused ring group of a monocyclic or polycyclic aromatic hydrocarbon ring having 6 to 30 carbon atoms and a monocyclic or polycyclic aliphatic hydrocarbon ring having 3 to 30 carbon atoms; or a substituted or unsubstituted monocyclic or polycyclic heterocyclic group having 2 to 30 carbon atoms, or bonds to R5 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof, each of which is substituted or unsubstituted and includes one or more selected from N, S, O and Si.

According to one embodiment of the present specification, Ar2 is a monocyclic or polycyclic aryl group having 6 to 30 carbon atoms unsubstituted or substituted with one or more selected from the group consisting of a linear or branched alkyl group having 1 to 30 carbon atoms, a monocyclic or polycyclic aryl group having 6 to 30 carbon atoms, and a combination thereof; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or bonds to R5 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof, each of which is unsubstituted or substituted with a linear or branched alkyl group having 1 to 30 carbon atoms, a monocyclic or polycyclic cycloalkyl group having 3 to 30 carbon atoms, or a monocyclic or polycyclic aryl group having 6 to 30 carbon atoms, and includes one or more selected from N, S, O and Si.

According to one embodiment of the present specification, Ar2 is a phenyl group unsubstituted or substituted with one or more selected from the group consisting ofa linear or branched alkyl group having 1 to 30 carbon atoms, a monocyclic or polycyclic aryl group having 6 to 30 carbon atoms, and a combination thereof; a biphenyl group unsubstituted or substituted with a linear or branched alkyl group having 1 to 30 carbon atoms; a terphenyl group; a fluorene group unsubstituted or substituted with a linear or branched alkyl group having 1 to 30 carbon atoms; a tetrahydronaphthyl group unsubstituted or substituted with a linear or branched alkyl group having 1 to 30 carbon atoms; a dibenzofuran group; or a dibenzothiophene group, or bonds to R5 to form dihydroquinoline unsubstituted or substituted with a linear or branched alkyl group having 1 to 30 carbon atoms or a monocyclic or polycyclic aryl group having 6 to 30 carbon atoms; spiroquinolinefluorene; hexahydroindene unsubstituted or substituted with a linear or branched alkyl group having 1 to 30 carbon atoms; dihydrobenzoquinoline unsubstituted or substituted with a linear or branched alkyl group having 1 to 30 carbon atoms or a monocyclic or polycyclic aryl group having 6 to 30 carbon atoms; hexahydrobenzoquinoline unsubstituted or substituted with a linear or branched alkyl group having 1 to 30 carbon atoms or a monocyclic or polycyclic aryl group having 6 to 30 carbon atoms; spirobenzoquinoline; spirotetrahydrobenzoquinolinefluorene; benzofuropyrrole; benzothienopyrrole; dihydrobenzoazasiline unsubstituted or substituted with a linear or branched alkyl group having 1 to 30 carbon atoms or a monocyclic or polycyclic aryl group having 6 to 30 carbon atoms; spirodibenzosilolebenzoazasiline; benzoxazine; benzothiazine; dihydroindenopyrrole unsubstituted or substituted with a linear or branched alkyl group having 1 to 30 carbon atoms or a monocyclic or polycyclic aryl group having 6 to 30 carbon atoms; benzindole; or indole unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms.

According to one embodiment of the present specification, Ar2 is a phenyl group unsubstituted or substituted with one or more selected from the group consisting ofa methyl group, an iso-propyl group, a tert-butyl group, a phenyl group and a combination thereof; a biphenyl group unsubstituted or substituted with a methyl group or a tert-butyl group; a terphenyl group; a fluorene group unsubstituted or substituted with a methyl group; a tetrahydronaphthyl group unsubstituted or substituted with a methyl group; a dibenzofuran group; or a dibenzothiophene group, or bonds to R5 to form dihydroquinoline unsubstituted or substituted with a methyl group or a phenyl group; spiroacridinequinoline; hexahydroindene unsubstituted or substituted with one or more selected from the group consisting ofa methyl group and a tert-butyl group; dihydrobenzoquinoline unsubstituted or substituted with a methyl group or a phenyl group; hexahydrobenzoquinoline unsubstituted or substituted with a methyl group or a phenyl group; spirobenzoquinoline; spirotetrahydrobenzoquinolinefluorene; benzofuropyrrole; benzothienopyrrole; dihydrobenzoazasiline unsubstituted or substituted with a methyl group or a phenyl group; spirobenzosiloledibenzoazasiline; benzoxazine; benzothiazine; dihydroindenopyrrole unsubstituted or substituted with a methyl group or a phenyl group; benzindole; or indole unsubstituted or substituted with a tert-butyl group, an adamantyl group or a phenyl group.

According to one embodiment of the present specification, at least one of Z1 to Z3 is a substituted or unsubstituted linear or branched alkyl group having 1 to 30 carbon atoms; a substituted or unsubstituted monocyclic or polycyclic cycloalkyl group having 3 to 30 carbon atoms; a substituted or unsubstituted monocyclic or polycyclic aryl group having 6 to 30 carbon atoms; or NQ5Q6, or forms a substituted or unsubstituted monocyclic or polycyclic aromatic hydrocarbon ring having 6 to 30 carbon atoms; or a substituted or unsubstituted monocyclic or polycyclic heteroring having 2 to 30 carbon atoms, and the rest are hydrogen.

According to one embodiment of the present specification, at least one of Z1 to Z3 is deuterium; a linear or branched alkyl group having 1 to 30 carbon atoms; a monocyclic or polycyclic cycloalkyl group having 3 to 30 carbon atoms; a monocyclic or polycyclic aryl group having 6 to 30 carbon atoms unsubstituted or substituted with deuterium, or a linear or branched alkyl group having 1 to 30 carbon atoms; or NQ5Q6, or bonds to adjacent groups to form a monocyclic or polycyclic aromatic hydrocarbon ring having 6 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with one or more substituents selected from among a linear or branched alkyl group having 1 to 30 carbon atoms, a monocyclic or polycyclic aryl group having 6 to 30 carbon atoms, a fused ring group of an aromatic hydrocarbon ring and an aliphatic hydrocarbon ring, and a combination thereof, and the rest are hydrogen.

According to one embodiment of the present specification, at least one of Z1 to Z3 is deuterium; a methyl group; an iso-propyl group; a tert-butyl group; a cyclohexyl group; a phenyl group unsubstituted or substituted with deuterium, or a linear or branched alkyl group having 1 to 30 carbon atoms; or NQ5Q6, or bonds to adjacent groups to form benzene; indene unsubstituted or substituted with a linear or branched alkyl group having 1 to 30 carbon atoms; benzofuran unsubstituted or substituted with a linear or branched alkyl group having 1 to 30 carbon atoms; naphthofuran; tetrahydronaphthofuran unsubstituted or substituted with a linear or branched alkyl group having 1 to 30 carbon atoms; benzothiophene; or indole unsubstituted or substituted with one or more substituents selected from among a linear or branched alkyl group having 1 to 30 carbon atoms, a monocyclic or polycyclic aryl group having 6 to 30 carbon atoms, a fused ring group of an aromatic hydrocarbon ring and an aliphatic hydrocarbon ring, and a combination thereof, and the rest are hydrogen.

According to one embodiment of the present specification, at least one of Z1 to Z3 is deuterium; a methyl group; an iso-propyl group; a tert-butyl group; a cyclohexyl group; a phenyl group unsubstituted or substituted with deuterium or a methyl group; or NQ5Q6, or bonds to adjacent groups to form benzene; indene unsubstituted or substituted with a methyl group; benzofuran unsubstituted or substituted with a tert-butyl group; naphthofuran; tetrahydronaphthofuran unsubstituted or substituted with a methyl group; benzothiophene; or indole unsubstituted or substituted with a phenyl group, or a tetrahydronaphthyl group substituted with a methyl group, and the rest are hydrogen.

According to one embodiment of the present specification, Z2 is deuterium; a substituted or unsubstituted linear or branched alkyl group having 1 to 30 carbon atoms; a substituted or unsubstituted monocyclic or polycyclic cycloalkyl group having 3 to 30 carbon atoms; a substituted or unsubstituted monocyclic or polycyclic aryl group having 6 to 30 carbon atoms; or NQ5Q6.

According to one embodiment of the present specification, Z2 is deuterium; a linear or branched alkyl group having 1 to 30 carbon atoms; a monocyclic or polycyclic cycloalkyl group having 3 to 30 carbon atoms; a monocyclic or polycyclic aryl group having 6 to 30 carbon atoms unsubstituted or substituted with deuterium, or a linear or branched alkyl group having 1 to 30 carbon atoms; or NQ5Q6.

According to one embodiment of the present specification, Z2 is deuterium; a methyl group; an iso-propyl group; a tert-butyl group; a cyclohexyl group; a phenyl group unsubstituted or substituted with deuterium, or a linear or branched alkyl group having 1 to 30 carbon atoms; or NQ5Q6.

According to one embodiment of the present specification, Z2 is deuterium; a methyl group; an iso-propyl group; a tert-butyl group; a cyclohexyl group; a phenyl group unsubstituted or substituted with deuterium or a methyl group; or NQ5Q6.

According to one embodiment of the present specification, Z1 and Z3 are hydrogen.

According to one embodiment of the present specification, Z1 and Z3 are deuterium.

According to one embodiment of the present specification, Q5 and Q6 are the same as or different from each other, and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms.

According to one embodiment of the present specification, Q5 and Q6 are the same as or different from each other, and each independently a phenyl group unsubstituted or substituted with a linear or branched alkyl group having 1 to 30 carbon atoms; a biphenyl group unsubstituted or substituted with a linear or branched alkyl group having 1 to 30 carbon atoms; a fluorene group unsubstituted or substituted with a linear or branched alkyl group having 1 to 30 carbon atoms; a tetrahydronaphthyl group unsubstituted or substituted with a linear or branched alkyl group having 1 to 30 carbon atoms; a dibenzofuran group; or a dibenzothiophene group.

According to one embodiment of the present specification, Q5 and Q6 are the same as or different from each other, and each independently a phenyl group unsubstituted or substituted with a methyl group; a biphenyl group unsubstituted or substituted with a methyl group or a biphenyl group; a fluorene group unsubstituted or substituted with a methyl group; a tetrahydronaphthyl group unsubstituted or substituted with a methyl group; a dibenzofuran group; or a dibenzothiophene group.

According to one embodiment of the present specification, Z1 and G3 bond to each other to form a substituted or unsubstituted monocyclic or polycyclic heteroring having 2 to 30 carbon atoms.

According to one embodiment of the present specification, Z1 and G3 bond to each other to form a monocyclic or polycyclic heteroring having 2 to 30 carbon atoms unsubstituted or substituted with one or more substituents selected from among a linear or branched alkyl group having 1 to 30 carbon atoms, a monocyclic or polycyclic aryl group having 6 to 30 carbon atoms, a fused ring group of an aromatic hydrocarbon ring and an aliphatic hydrocarbon ring, and a combination thereof.

According to one embodiment of the present specification, Z1 and G3 bond to each other to form indole unsubstituted or substituted with one or more substituents selected from among a linear or branched alkyl group having 1 to 30 carbon atoms, a monocyclic or polycyclic aryl group having 6 to 30 carbon atoms, a fused ring group of an aromatic hydrocarbon ring and an aliphatic hydrocarbon ring, and a combination thereof.

According to one embodiment of the present specification, Z1 and G3 bond to each other to form indole unsubstituted or substituted with a phenyl group, or a tetrahydronaphthyl group substituted with a methyl group.

According to one embodiment of the present specification, A1 is a monocyclic or polycyclic aromatic hydrocarbon ring having 6 to 30 carbon atoms unsubstituted or substituted with a linear or branched alkyl group having 1 to 30 carbon atoms, a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms, a monocyclic or polycyclic aryl group having 6 to 30 carbon atoms, or NQ1Q2; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms or a monocyclic or polycyclic aryl group having 6 to 30 carbon atoms, Q1 and Q2 are the same as or different from each other and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, R5 to R8 are the same as or different from each other and each independently hydrogen; deuterium; a linear or branched alkyl group having 1 to 30 carbon atoms; a monocyclic or polycyclic aryl group having 6 to 30 carbon atoms; or NQ3Q4, or bond to adjacent groups to form a monocyclic or polycyclic aliphatic hydrocarbon ring having 3 to 30 carbon atoms unsubstituted or substituted with a linear or branched alkyl group having 1 to 30 carbon atoms; a monocyclic or polycyclic aromatic hydrocarbon ring having 6 to 30 carbon atoms unsubstituted or substituted with a linear or branched alkyl group having 1 to 30 carbon atoms, or a monocyclic or polycyclic diarylamine group having 6 to 30 carbon atoms unsubstituted or substituted with a linear or branched alkyl group having 1 to 30 carbon atoms; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms, a monocyclic or polycyclic aryl group having 6 to 30 carbon atoms, or a monocyclic or polycyclic diarylamine group having 6 to 30 carbon atoms unsubstituted or substituted with a linear or branched alkyl group having 1 to 30 carbon atoms, Q3 and Q4 are the same as or different from each other and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, Ar1 is a monocyclic or polycyclic aryl group having 6 to 30 carbon atoms unsubstituted or substituted with one or more selected from the group consisting of a linear or branched alkyl group having 1 to 30 carbon atoms, a monocyclic or polycyclic aryl group having 6 to 30 carbon atoms, and a combination thereof; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or bonds to A1 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof, each of which is unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms and includes one or more selected from N, S, 0 and Si, Ar2 is a monocyclic or polycyclic aryl group having 6 to 30 carbon atoms unsubstituted or substituted with one or more selected from the group consisting of a linear or branched alkyl group having 1 to 30 carbon atoms, a monocyclic or polycyclic aryl group having 6 to 30 carbon atoms, and a combination thereof; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or bonds to R5 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof, each of which is unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms and includes one or more selected from N, S, O and Si, at least one of Z1 to Z3 is deuterium; a linear or branched alkyl group having 1 to 30 carbon atoms; a monocyclic or polycyclic cycloalkyl group having 3 to 30 carbon atoms; a monocyclic or polycyclic aryl group having 6 to 30 carbon atoms unsubstituted or substituted with deuterium, or a linear or branched alkyl group having 1 to 30 carbon atoms; or NQ5Q6, or bonds to adjacent groups to form a monocyclic or polycyclic aromatic hydrocarbon ring having 6 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with one or more substituents selected from among a linear or branched alkyl group having 1 to 30 carbon atoms, a monocyclic or polycyclic aryl group having 6 to 30 carbon atoms, a fused ring group of an aromatic hydrocarbon ring and an aliphatic hydrocarbon ring, and a combination thereof, and the rest are hydrogen, Q5 and Q6 are the same as or different from each other and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, when Ar2 and R5 form a benzoxazine ring, the benzoxazine ring is an unsubstituted benzoxazine ring, and when Ar1 is a phenyl group, and A1 is substituted or unsubstituted benzene, and R6 to R8 are hydrogen, and adjacent groups among Z1 to Z3 do not bond to each other to form a substituted or unsubstituted ring, and Ar2 and R5 form an indole group at the same time, the indole group is a substituted indole group.

According to one embodiment of the present specification, R1 to R4 are the same as or different from each other, and each independently hydrogen; a substituted or unsubstituted linear or branched alkyl group having 1 to 30 carbon atoms; a substituted or unsubstituted monocyclic or polycyclic aryl group having 6 to 30 carbon atoms; or NQ3Q4, or bond to adjacent groups to form a substituted or unsubstituted monocyclic or polycyclic aliphatic hydrocarbon ring having 3 to 30 carbon atoms; a substituted or unsubstituted monocyclic or polycyclic aromatic hydrocarbon ring having 6 to 30 carbon atoms; a substituted or unsubstituted fused ring of a monocyclic or polycyclic aromatic hydrocarbon ring having 6 to 30 carbon atoms and a monocyclic or polycyclic aliphatic hydrocarbon ring having 3 to 30 carbon atoms; or a substituted or unsubstituted monocyclic or polycyclic heteroring having 2 to 30 carbon atoms.

According to one embodiment of the present specification, R1 to R4 are the same as or different from each other, and each independently hydrogen; a linear or branched alkyl group having 1 to 30 carbon atoms; a monocyclic or polycyclic aryl group having 6 to 30 carbon atoms; or NQ3Q4, or bond to adjacent groups to form a monocyclic or polycyclic aliphatic hydrocarbon ring having 3 to 30 carbon atoms unsubstituted or substituted with a linear or branched alkyl group having 1 to 30 carbon atoms; a monocyclic or polycyclic aromatic hydrocarbon ring having 6 to 30 carbon atoms unsubstituted or substituted with a linear or branched alkyl group having 1 to 30 carbon atoms; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms or a monocyclic or polycyclic aryl group having 6 to 30 carbon atoms.

According to one embodiment of the present specification, R1 to R4 are the same as or different from each other, and each independently hydrogen; a methyl group; a tert-butyl group; a phenyl group; or NQ3Q4, or bond to adjacent groups to form cyclohexane unsubstituted or substituted with a linear or branched alkyl group having 1 to 30 carbon atoms; benzene; benzofuran unsubstituted or substituted with a linear or branched alkyl group having 1 to 30 carbon atoms; benzothiophene unsubstituted or substituted with a linear or branched alkyl group having 1 to 30 carbon atoms; naphthofuran; naphthothiophene; indene unsubstituted or substituted with a linear or branched alkyl group having 1 to 30 carbon atoms; indole unsubstituted or substituted with a monocyclic or polycyclic aryl group having 6 to 30 carbon atoms; indoloindene unsubstituted or substituted with a linear or branched alkyl group having 1 to 30 carbon atoms; indoloindole; tetrahydronaphthofuran unsubstituted or substituted with a linear or branched alkyl group having 1 to 30 carbon atoms; tetrahydronaphthothiophene unsubstituted or substituted with a linear or branched alkyl group having 1 to 30 carbon atoms; tetrahydrobenzoindene unsubstituted or substituted with a linear or branched alkyl group having 1 to 30 carbon atoms; benzodioxine; benzooxathiine; benzodithiine; thiochromene unsubstituted or substituted with a linear or branched alkyl group having 1 to 30 carbon atoms; chromene unsubstituted or substituted with a linear or branched alkyl group having 1 to 30 carbon atoms; or dihydronaphthalene unsubstituted or substituted with a linear or branched alkyl group having 1 to 30 carbon atoms.

According to one embodiment of the present specification, R1 to R4 are the same as or different from each other, and each independently hydrogen; a methyl group; a tert-butyl group; a phenyl group; or NQ3Q4, or bond to adjacent groups to form cyclohexane unsubstituted or substituted with a methyl group; benzene; benzofuran unsubstituted or substituted with a methyl group or a tert-butyl group; benzothiophene unsubstituted or substituted with a methyl group or a tert-butyl group; naphthofuran; naphthothiophene; indene unsubstituted or substituted with a methyl group; indole unsubstituted or substituted with a phenyl group; indoloindene unsubstituted or substituted with a methyl group; indoloindole; tetrahydronaphthofuran unsubstituted or substituted with a methyl group; tetrahydronaphthothiophene unsubstituted or substituted with a methyl group; tetrahydrobenzoindene unsubstituted or substituted with a methyl group; benzodioxine; benzooxathiine; benzodithiine; thiochromene unsubstituted or substituted with a methyl group; chromene unsubstituted or substituted with a methyl group; or dihydronaphthalene unsubstituted or substituted with a methyl group.

According to one embodiment of the present specification, Q3 and Q4 have the same definitions as described above.

According to one embodiment of the present specification, R4 bonds to Ar1 to form one selected from the group consisting of a monocyclic or polycyclic aromatic heteroring having 2 to 30 carbon atoms, a monocyclic or polycyclic aliphatic heteroring having 2 to 30 carbon atoms and a fused ring thereof which is substituted or unsubstituted and including one or more selected from N, S, O and Si.

According to one embodiment of the present specification, R4 bonds to Ar1 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof, each of which is unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms and includes one or more selected from N, S, O and Si.

According to one embodiment of the present specification, R4 bonds to Ar1 to form dihydroquinoline unsubstituted or substituted with a linear or branched alkyl group having 1 to 30 carbon atoms or a monocyclic or polycyclic aryl group having 6 to 30 carbon atoms; spiroquinolinefluorene; hexahydroindene unsubstituted or substituted with a linear or branched alkyl group having 1 to 30 carbon atoms; dihydrobenzoquinoline unsubstituted or substituted with a linear or branched alkyl group having 1 to 30 carbon atoms or a monocyclic or polycyclic aryl group having 6 to 30 carbon atoms; hexahydrobenzoquinoline unsubstituted or substituted with a linear or branched alkyl group having 1 to 30 carbon atoms or a monocyclic or polycyclic aryl group having 6 to 30 carbon atoms; spirobenzoquinoline; spirotetrahydrobenzoquinolinefluorene; benzofuropyrrole; benzothienopyrrole; dihydrobenzoazasiline unsubstituted or substituted with a linear or branched alkyl group having 1 to 30 carbon atoms or a monocyclic or polycyclic aryl group having 6 to 30 carbon atoms; spirodibenzosilolebenzoazasiline; benzoxazine; benzothiazine; dihydroindenopyrrole unsubstituted or substituted with a linear or branched alkyl group having 1 to 30 carbon atoms or a monocyclic or polycyclic aryl group having 6 to 30 carbon atoms; benzindole; or indole unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms.

According to one embodiment of the present specification, R4 bonds to Ar1 to form dihydroquinoline unsubstituted or substituted with a methyl group or a phenyl group; spiroacridinequinoline; hexahydroindene unsubstituted or substituted with one or more selected from the group consisting of a methyl group and a tert-butyl group; dihydrobenzoquinoline unsubstituted or substituted with a methyl group or a phenyl group; hexahydrobenzoquinoline unsubstituted or substituted with a methyl group or a phenyl group; spirobenzoquinoline; spirotetrahydrobenzoquinolinefluorene; benzofuropyrrole; benzothienopyrrole; dihydrobenzoazasiline unsubstituted or substituted with a methyl group or a phenyl group; spirobenzosiloledibenzoazasiline; benzoxazine; benzothiazine; dihydroindenopyrrole unsubstituted or substituted with a methyl group or a phenyl group; benzindole; or indole unsubstituted or substituted with a tert-butyl group, an adamantyl group or a phenyl group.

According to one embodiment of the present specification, Chemical Formula 1 is one selected from the following compounds. 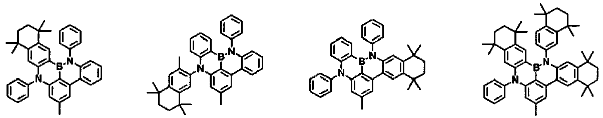 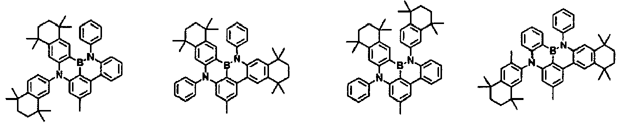 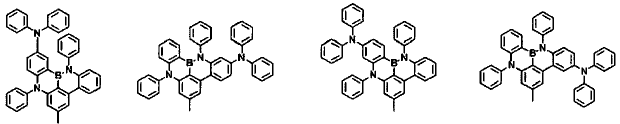 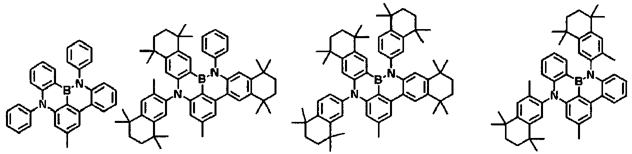 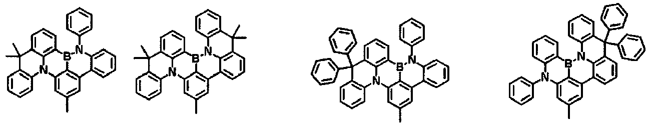 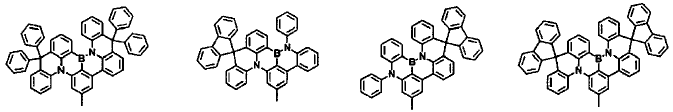 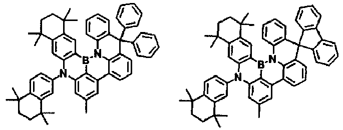 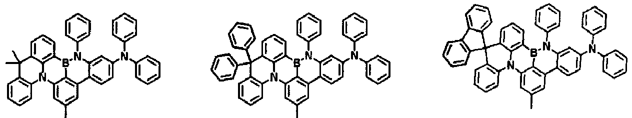 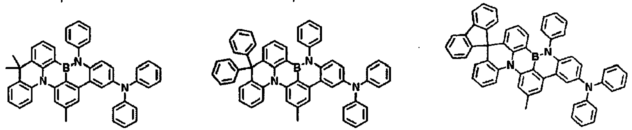 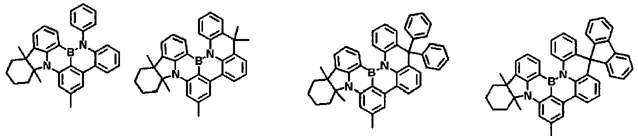 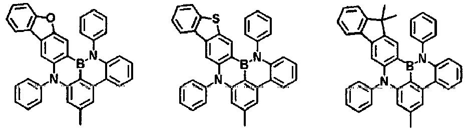 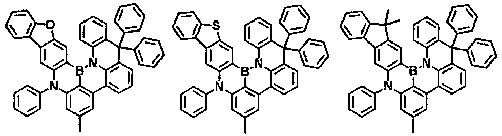 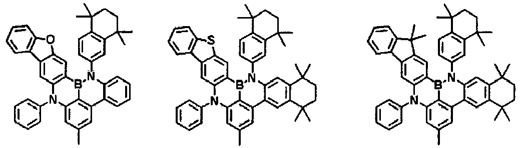 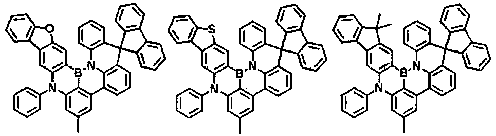 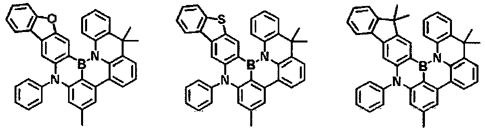 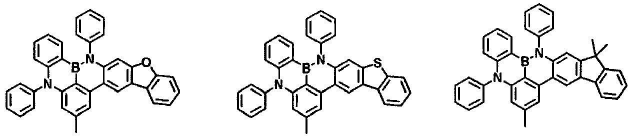 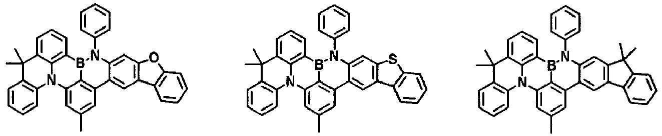 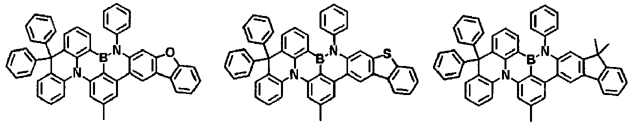 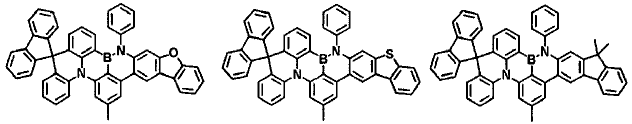 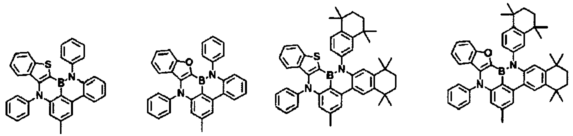 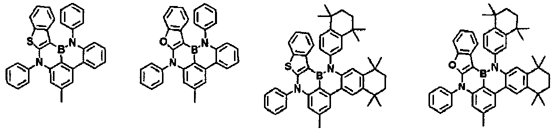 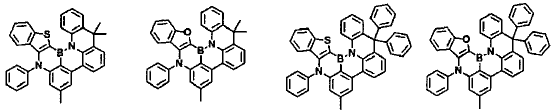 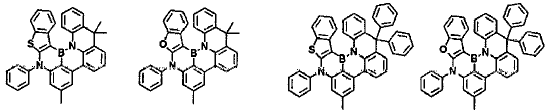 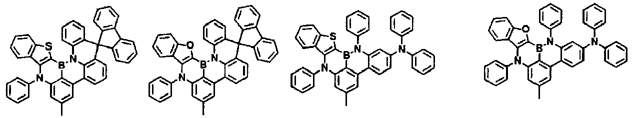 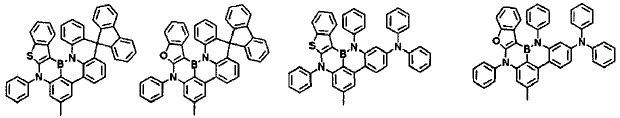 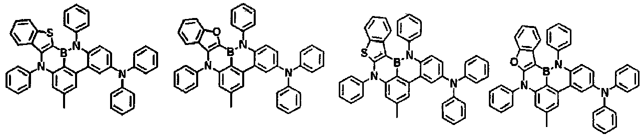 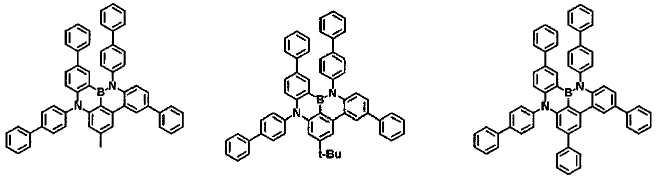 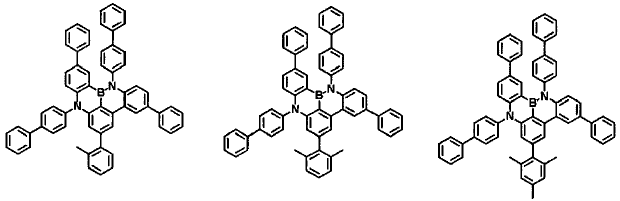 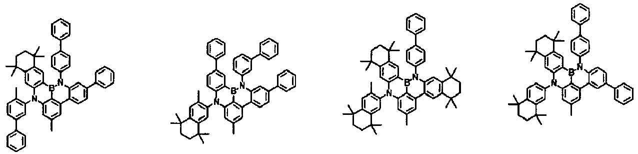 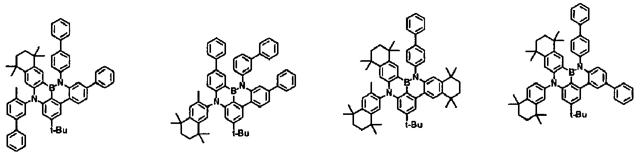 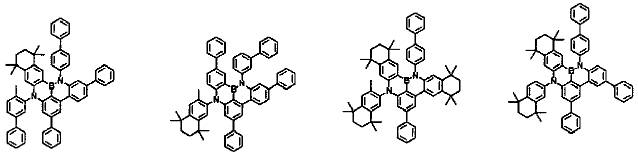 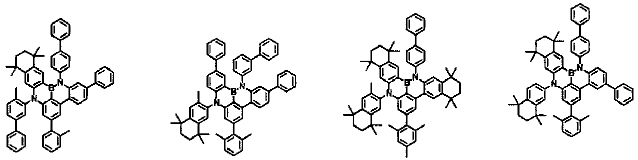 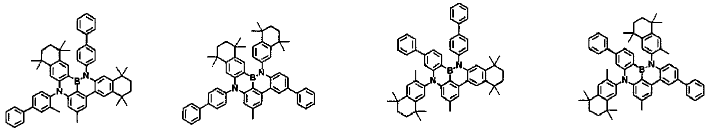 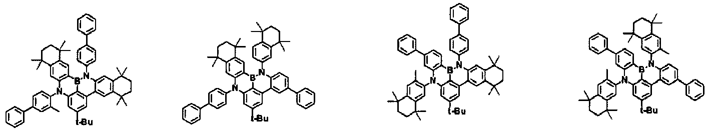 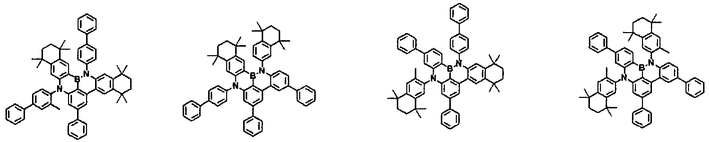 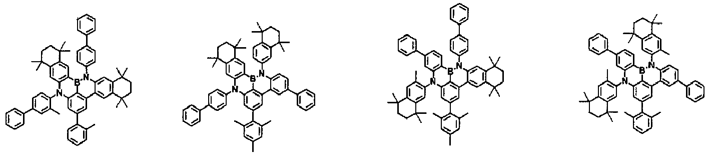 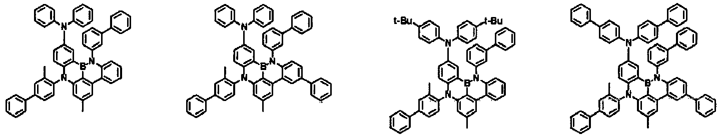 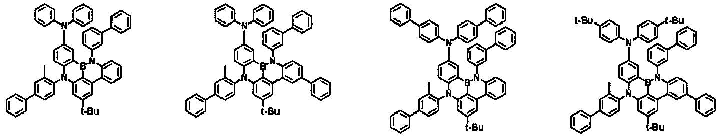 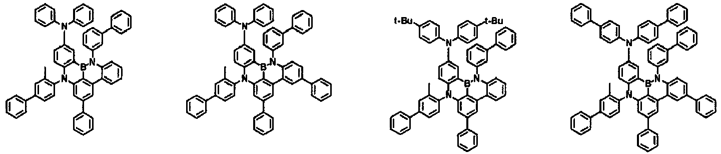 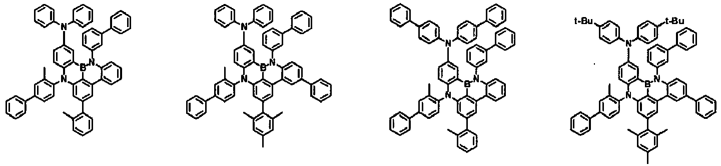 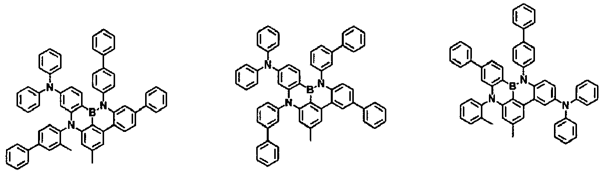 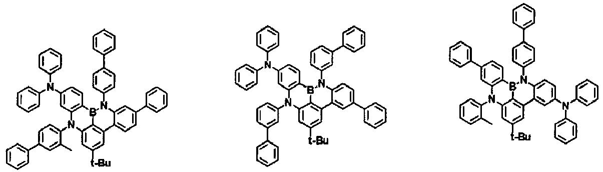 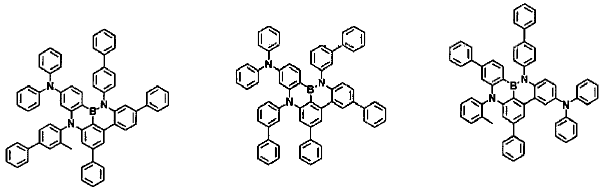 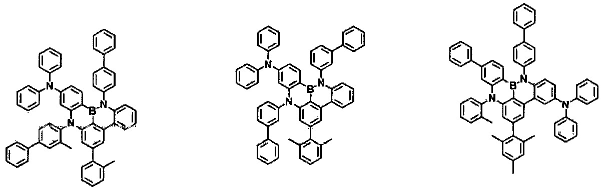 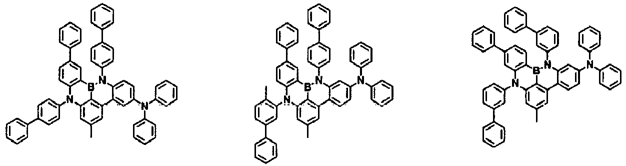 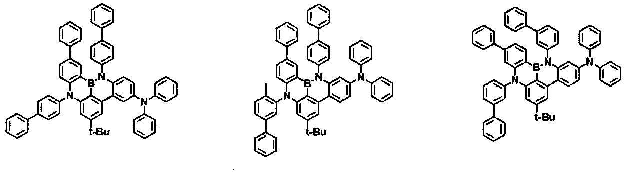 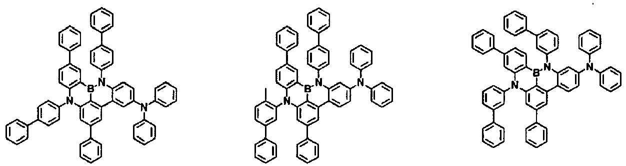 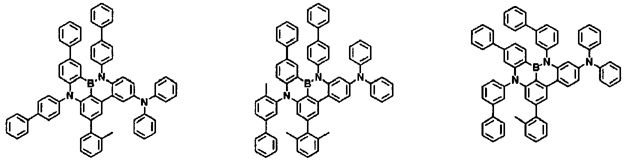 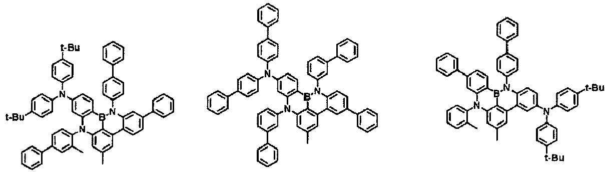 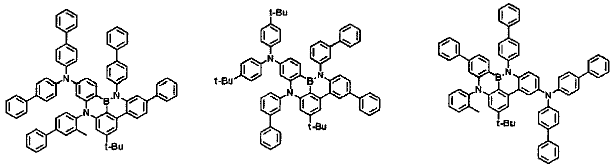 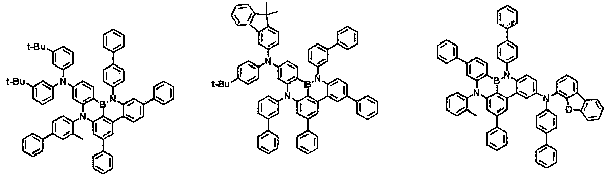 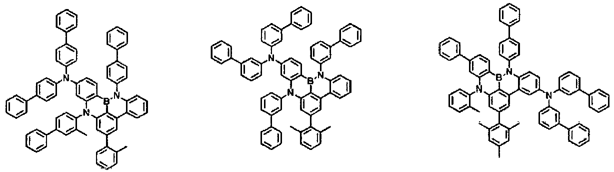 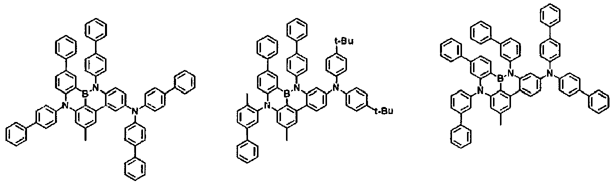 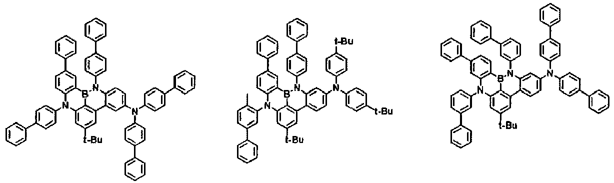 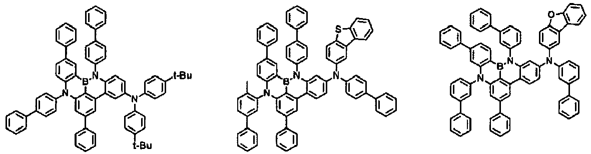 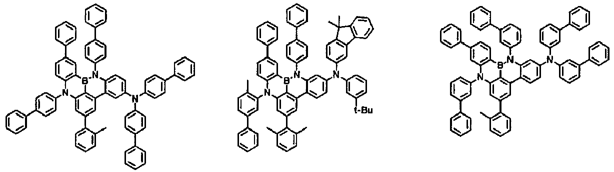 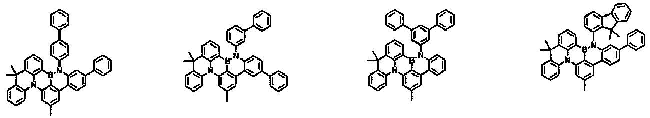 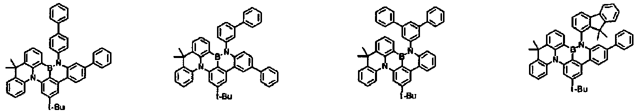 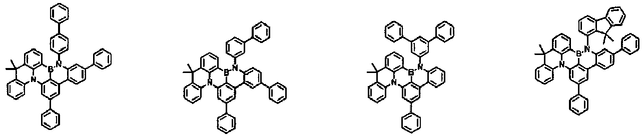 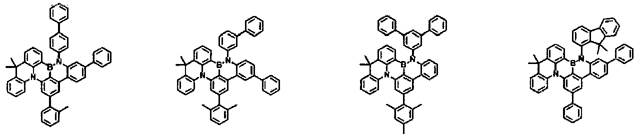 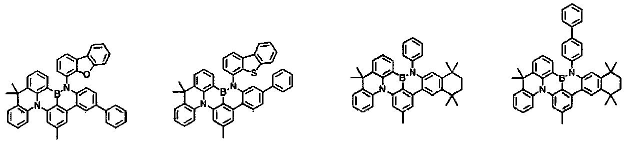 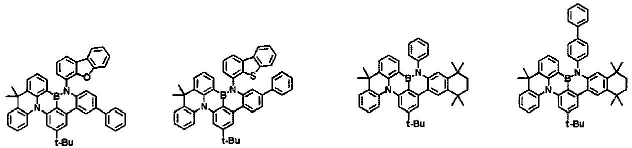 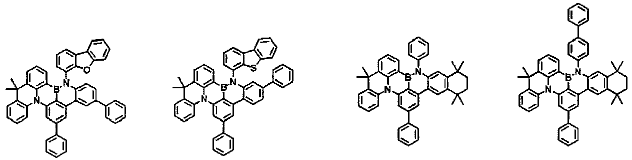 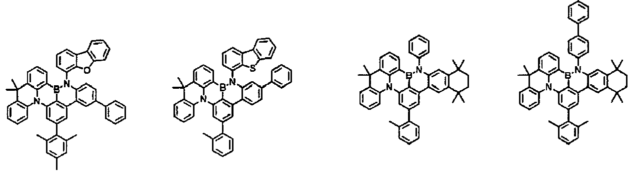 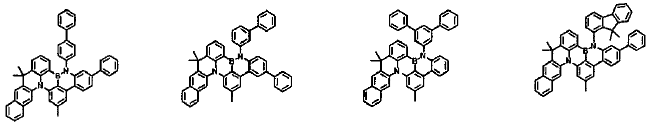 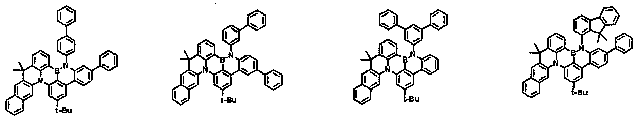 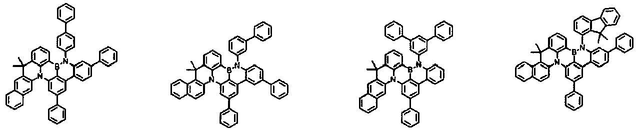 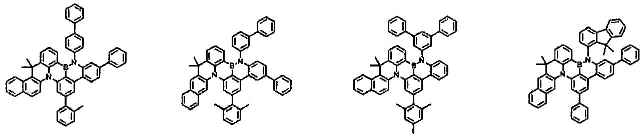 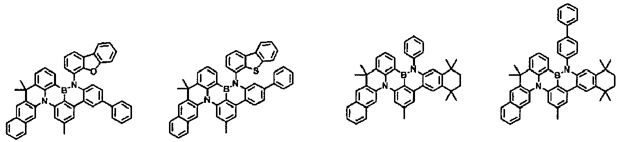 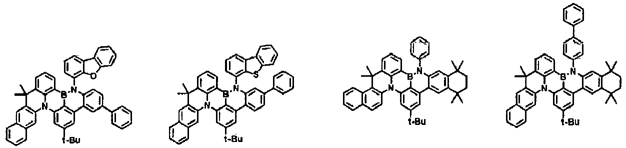 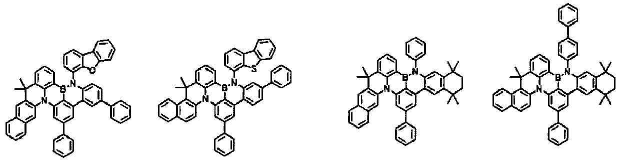 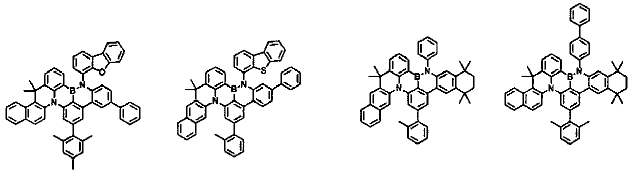 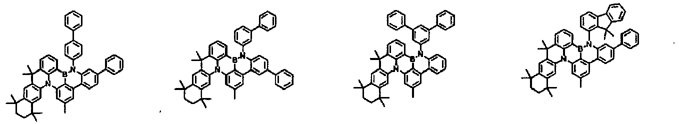 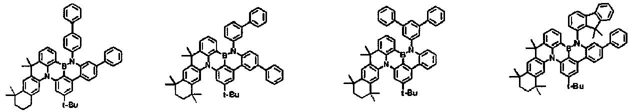 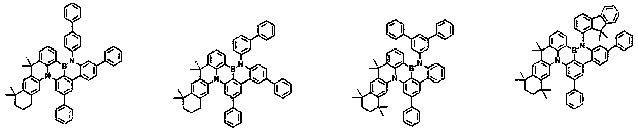 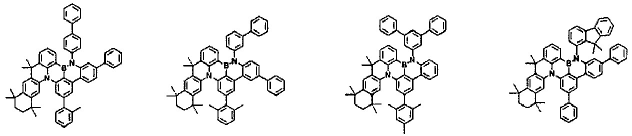 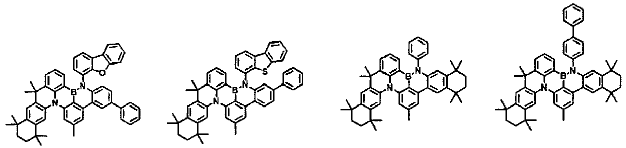 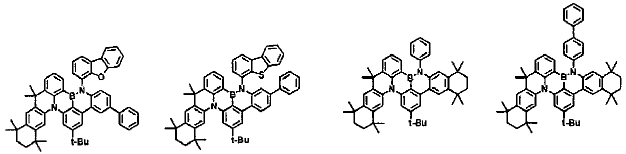 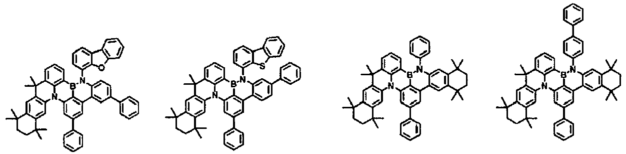 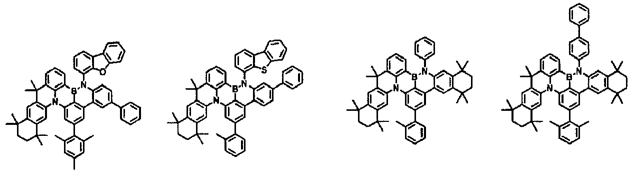 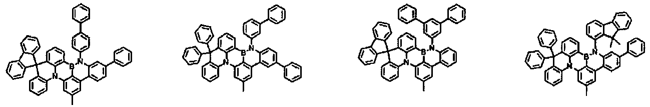 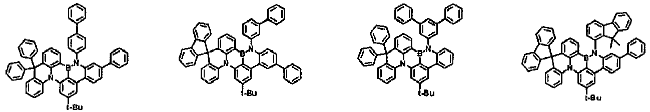 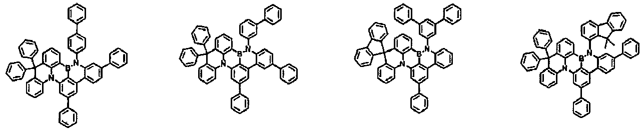 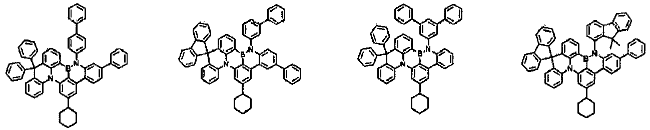 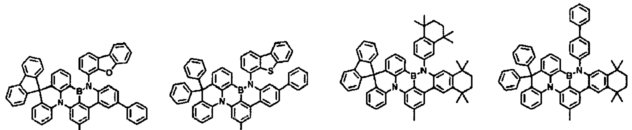 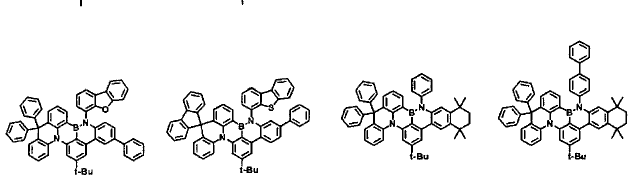 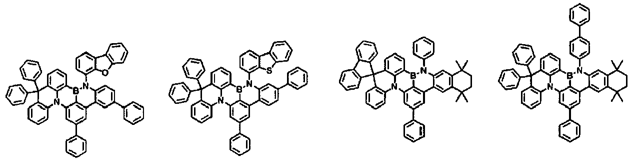 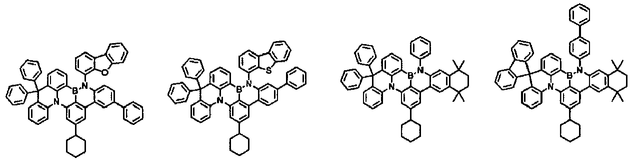 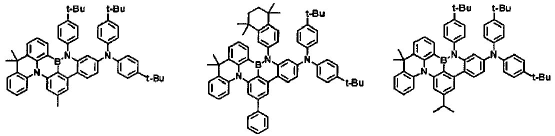 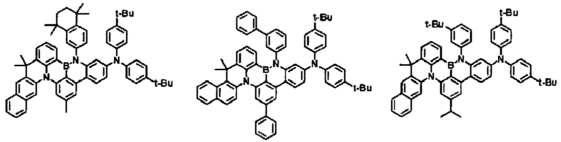 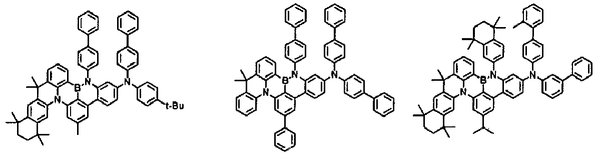 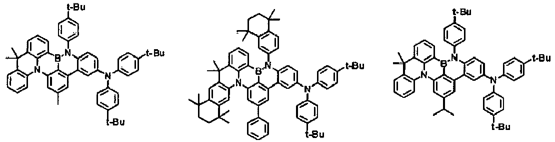 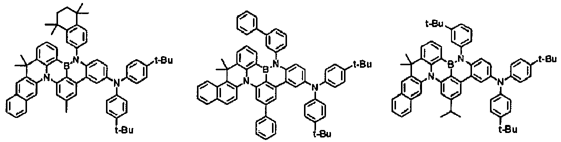 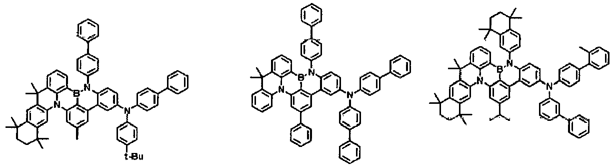 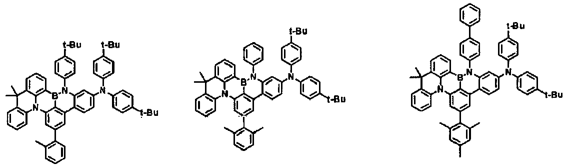 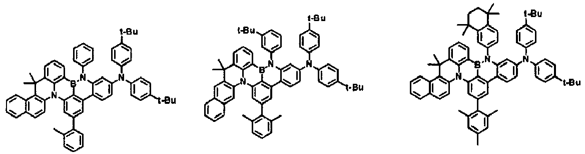 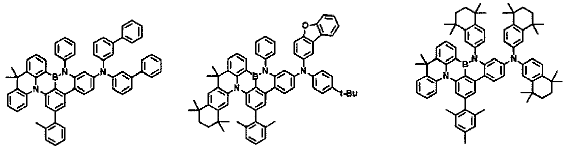 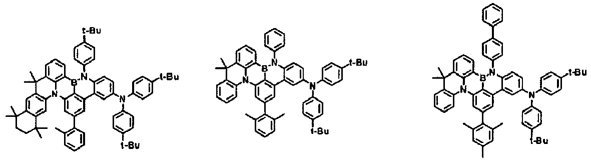 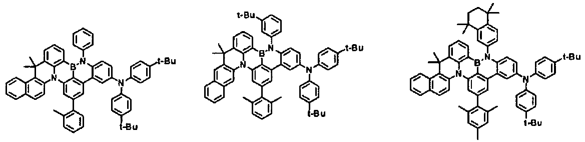 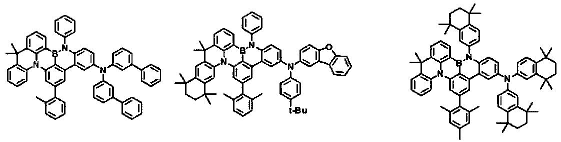 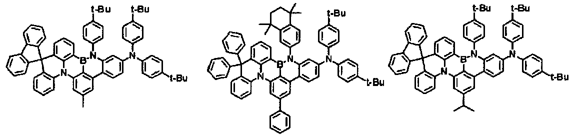 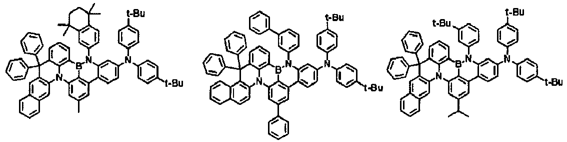 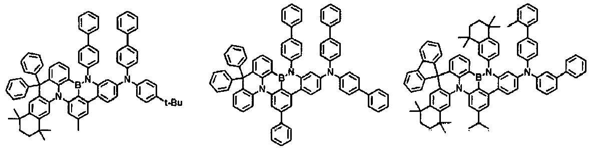 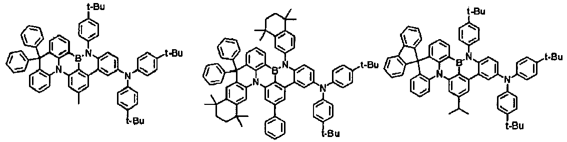 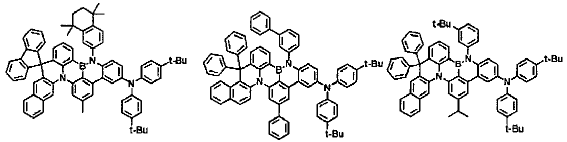 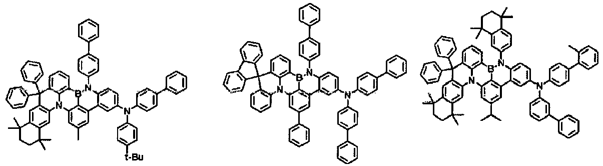 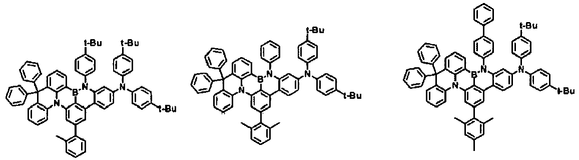 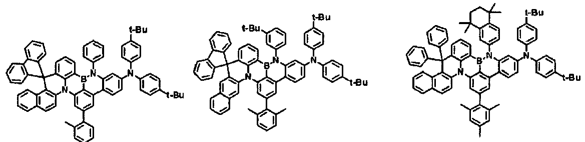 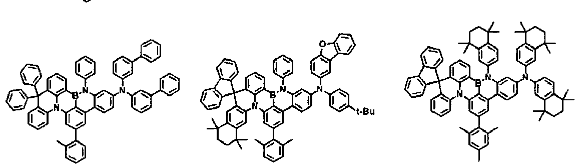 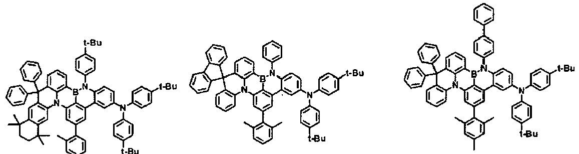 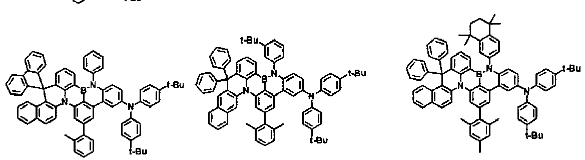 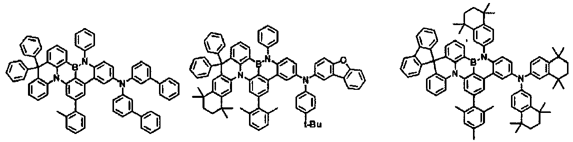 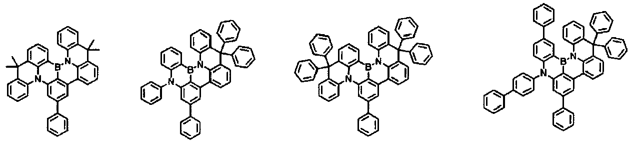 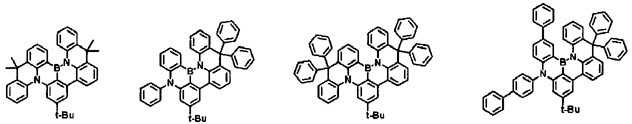 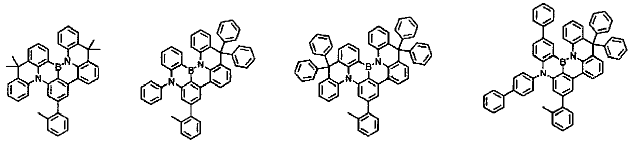 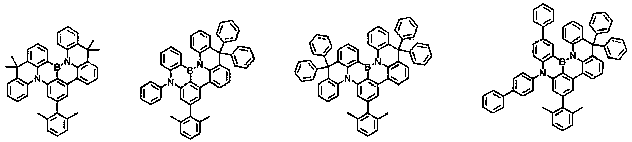 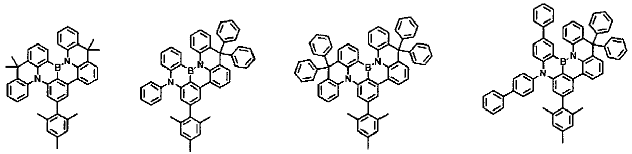 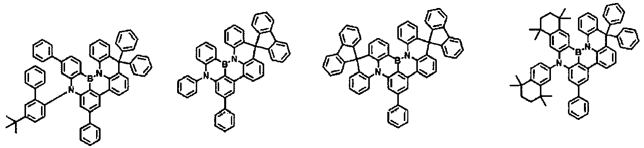 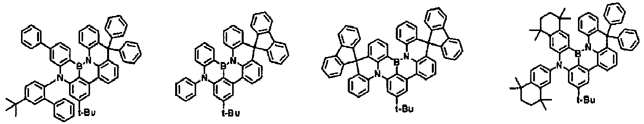 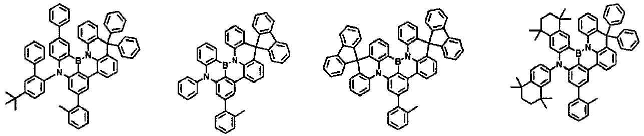 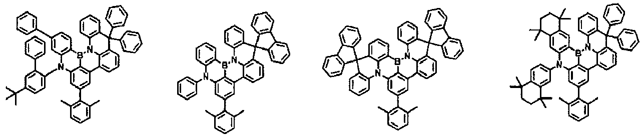 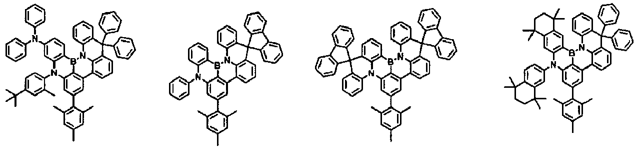 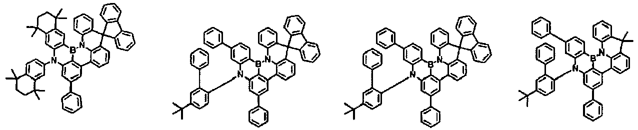 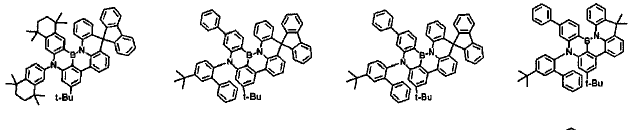 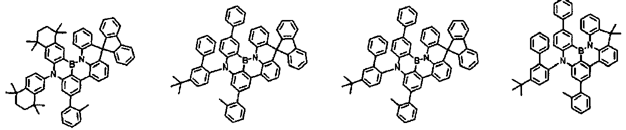 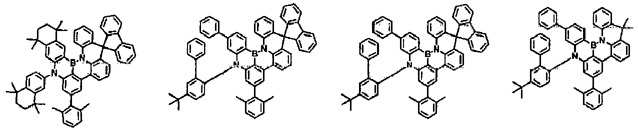 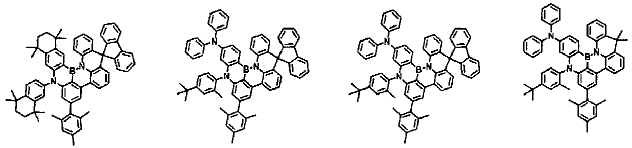 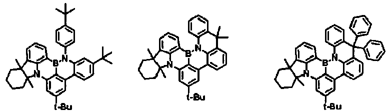 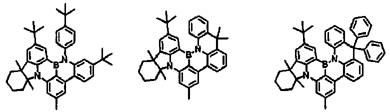 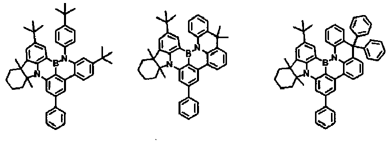 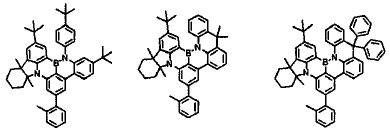 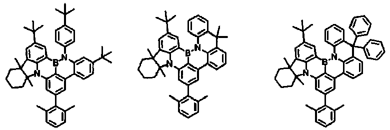 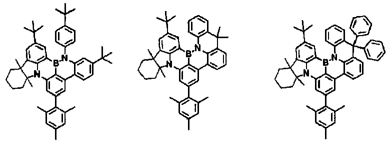 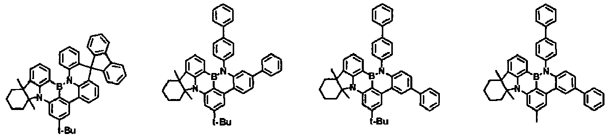 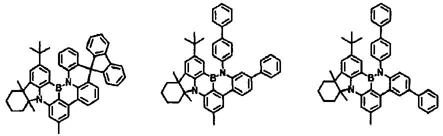 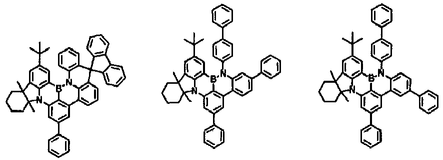 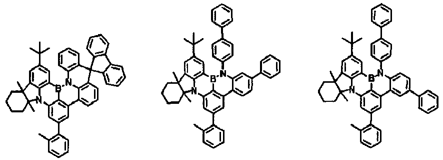 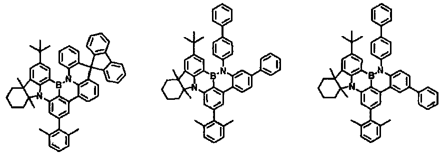 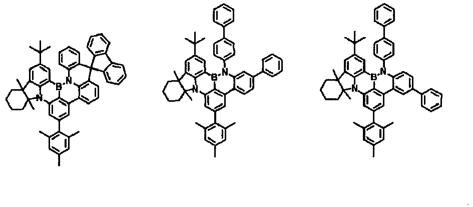 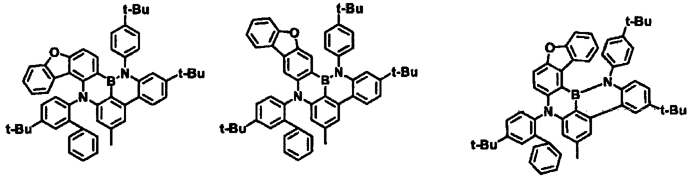 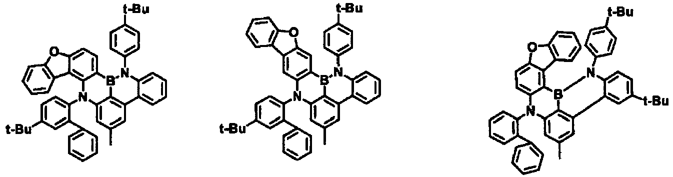 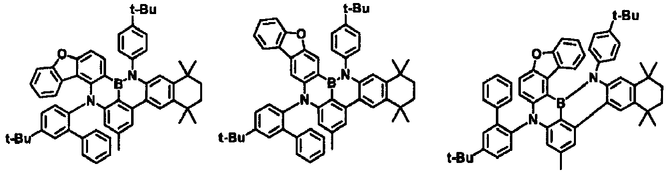 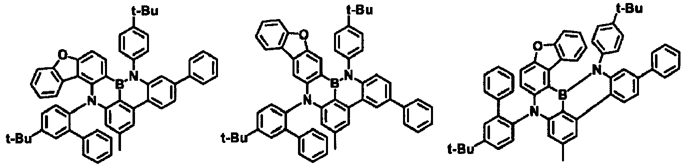 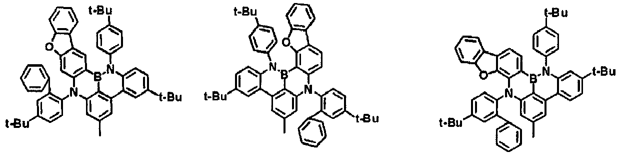 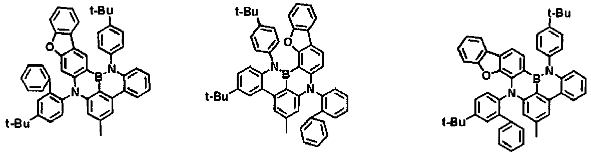 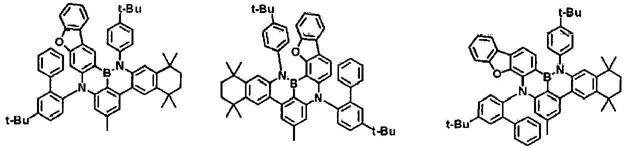 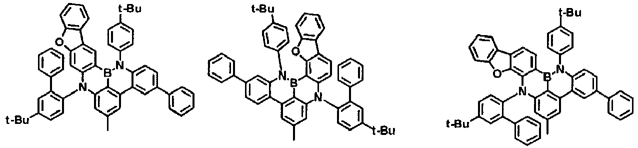 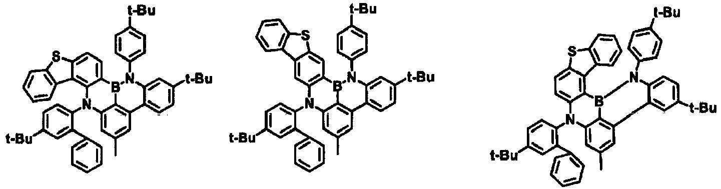 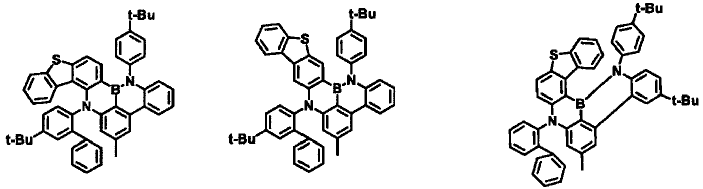 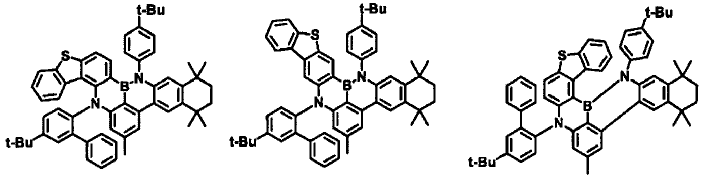 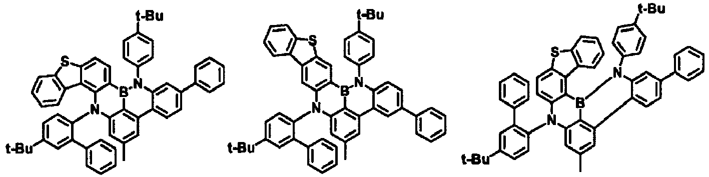 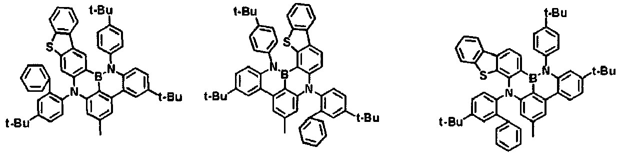 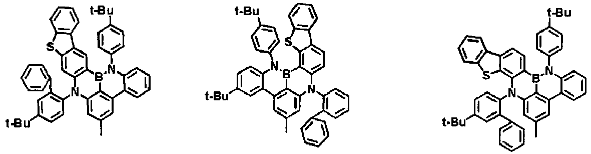 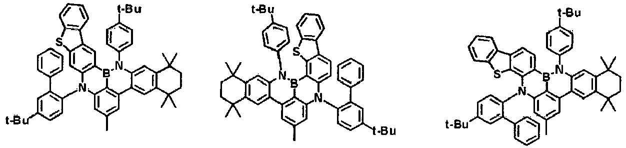 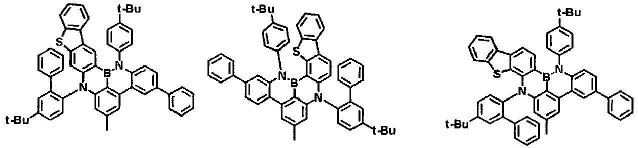 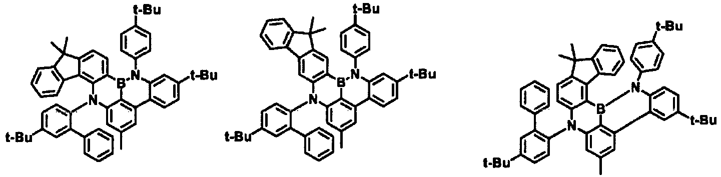 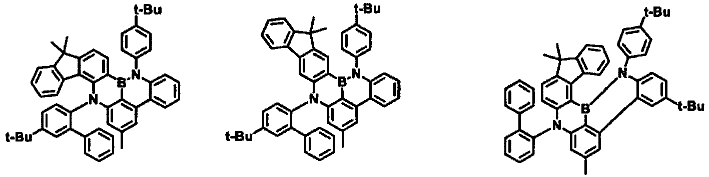 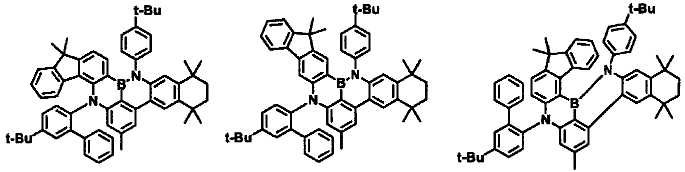 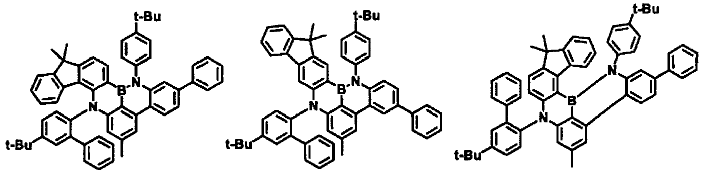 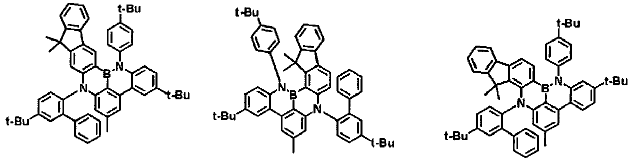 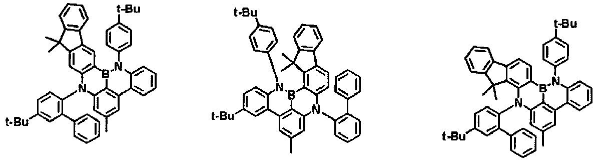 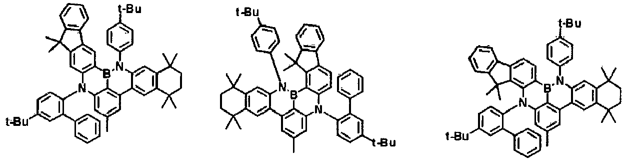 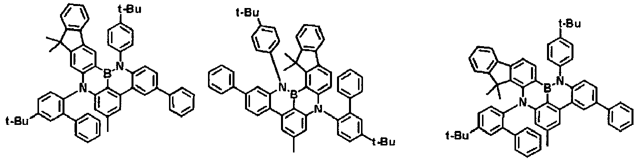 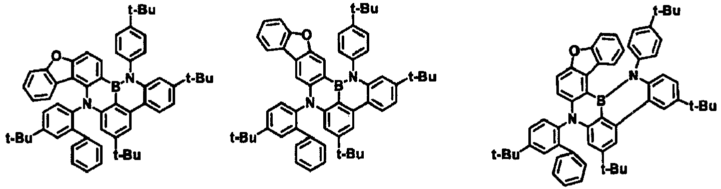 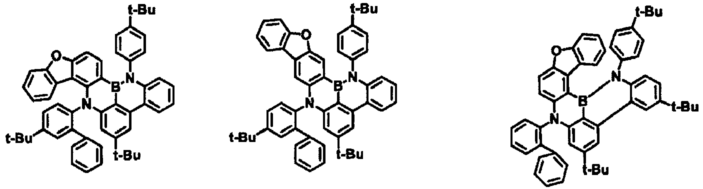 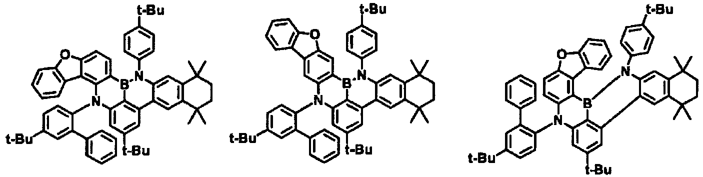 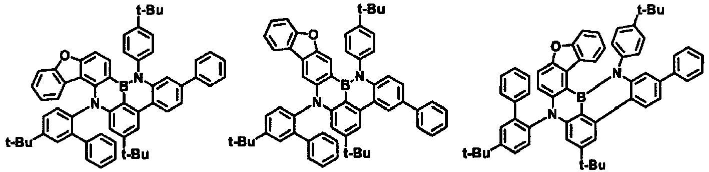 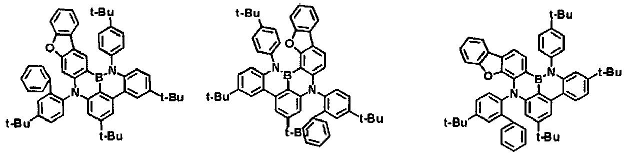 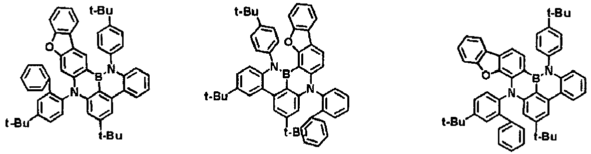 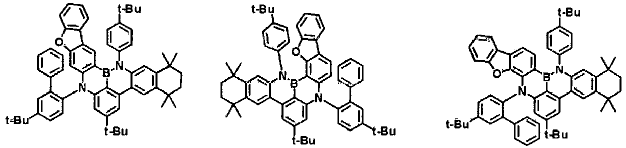 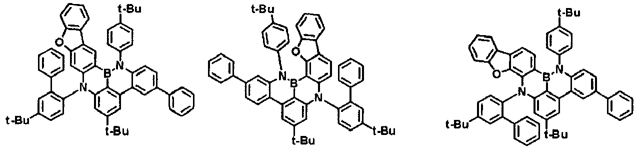 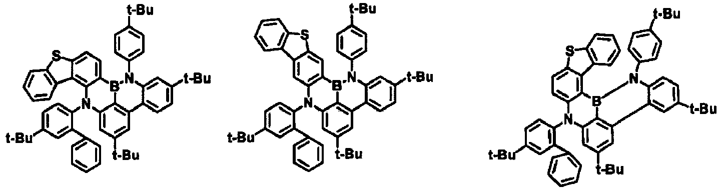 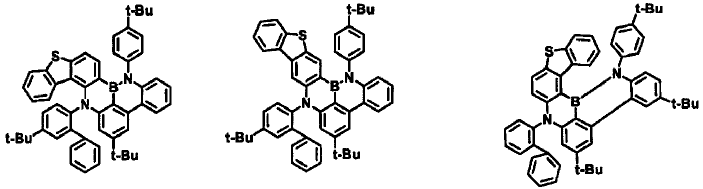 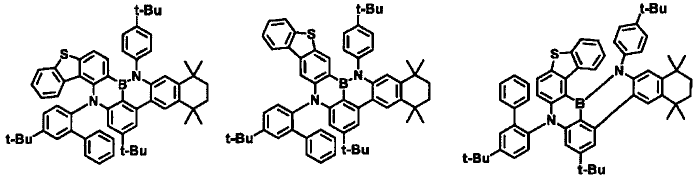 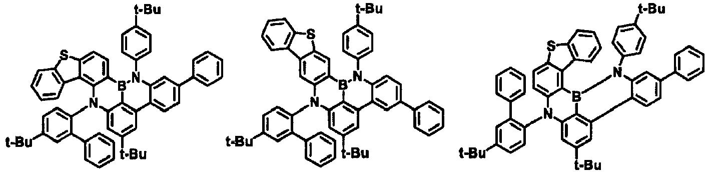 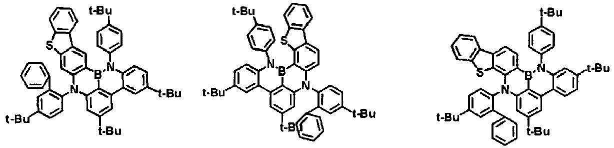 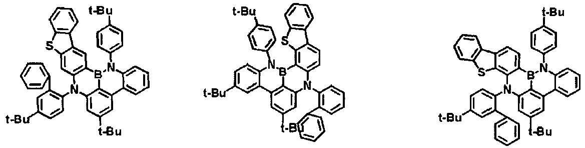 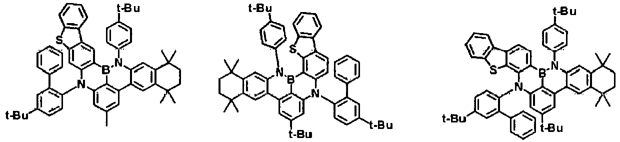 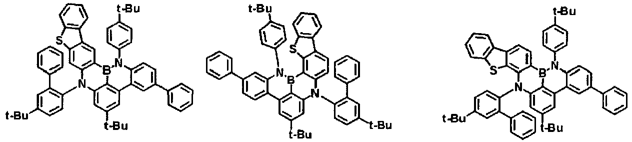 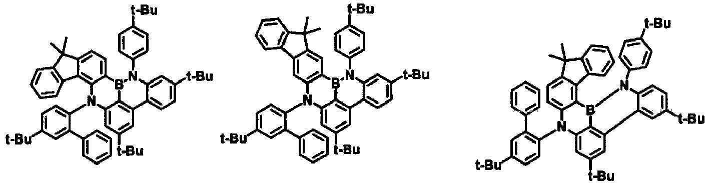 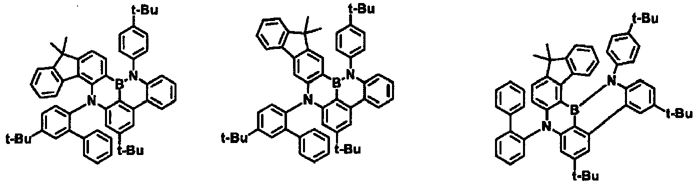 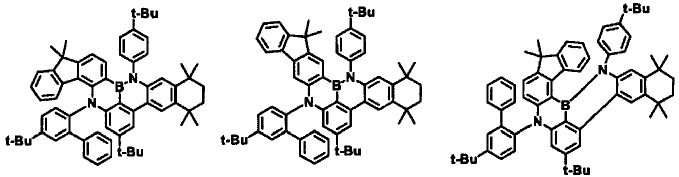 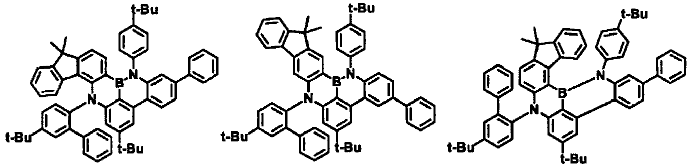 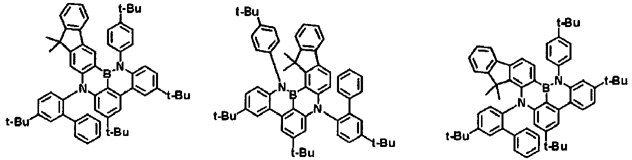 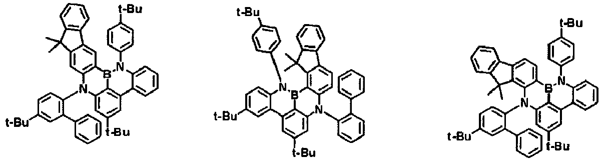 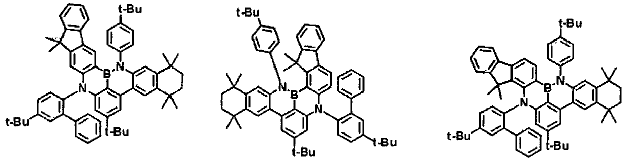 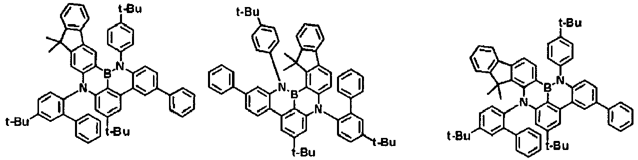 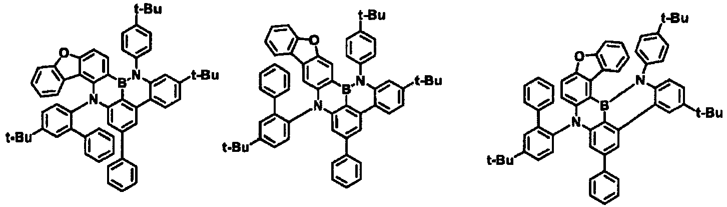 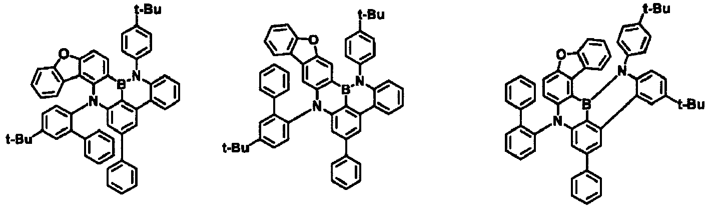 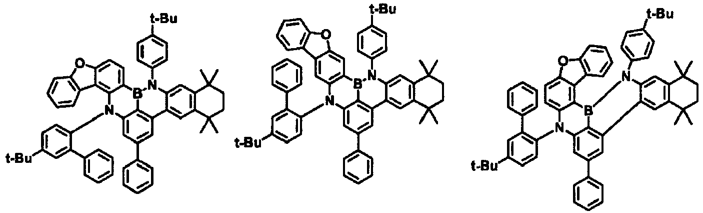 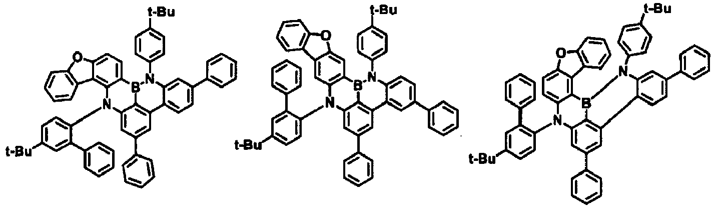 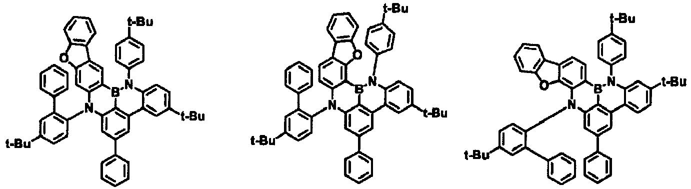 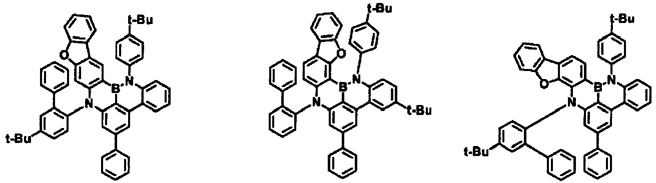 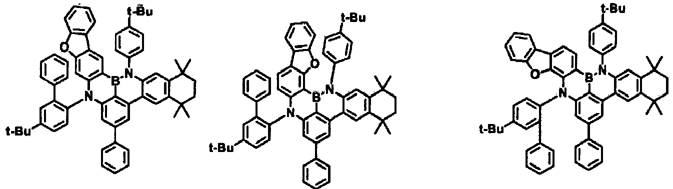 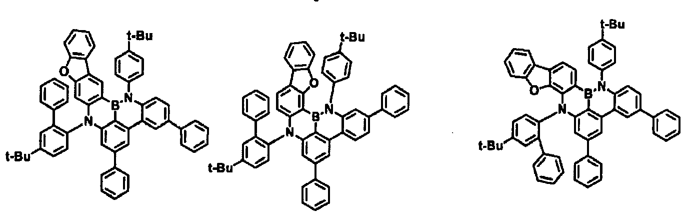 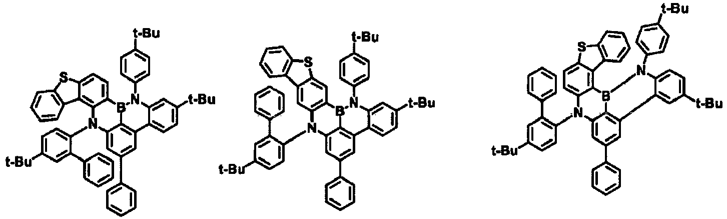 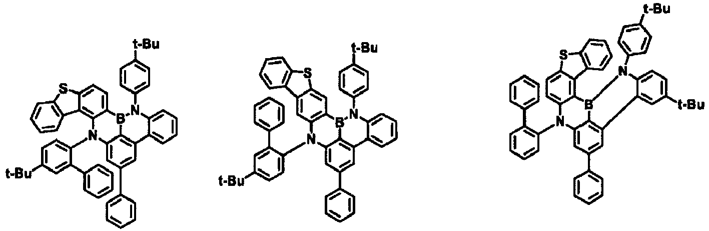 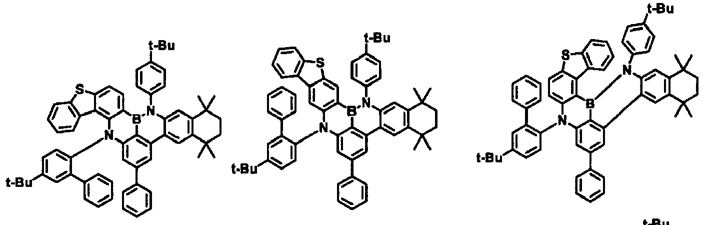 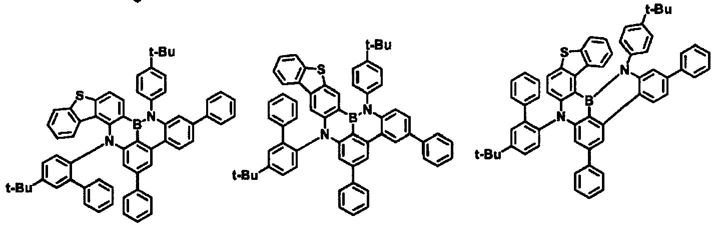 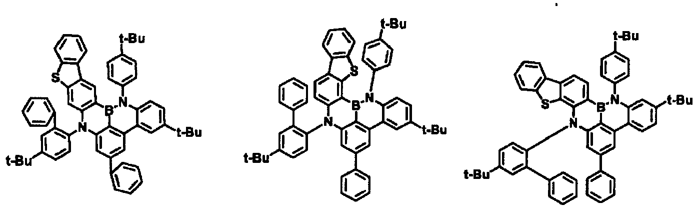 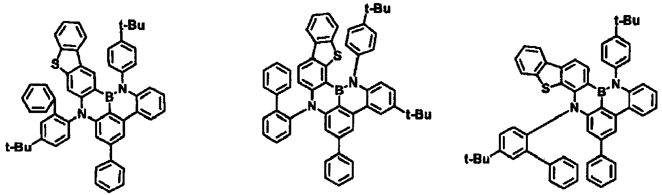 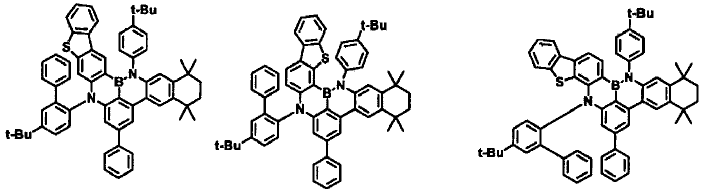 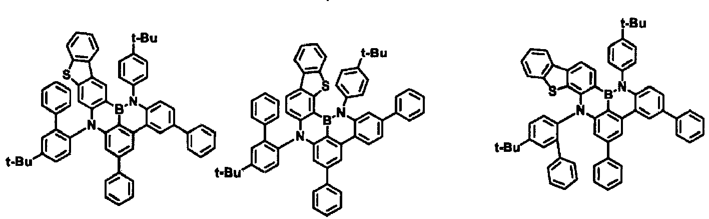 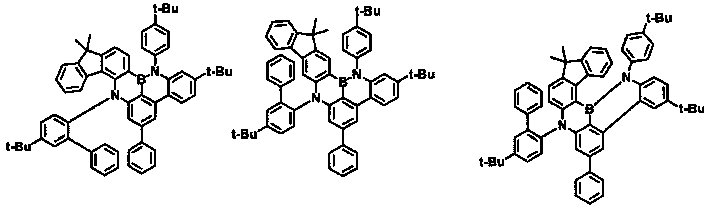 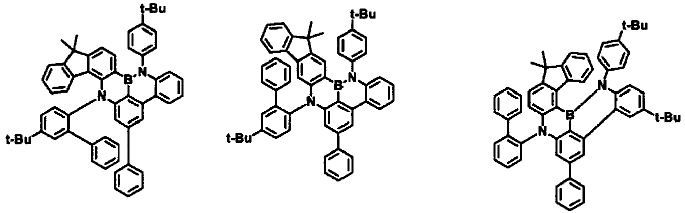 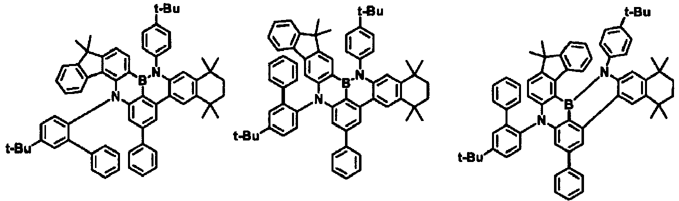 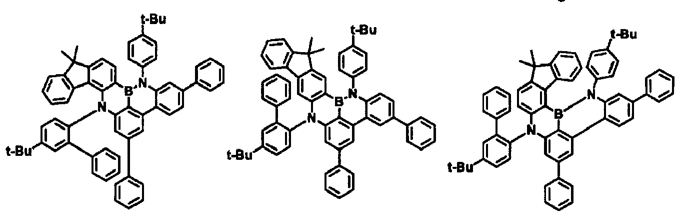 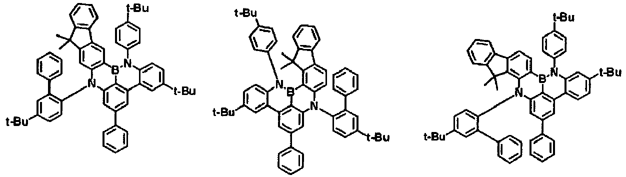 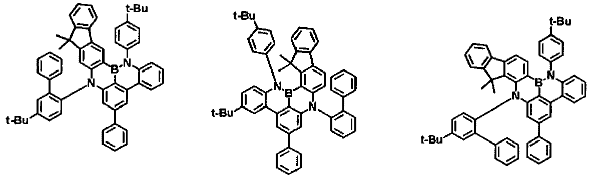 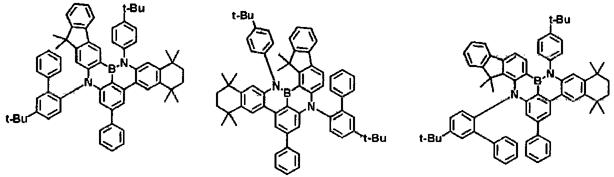 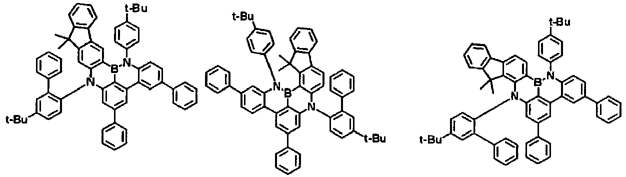 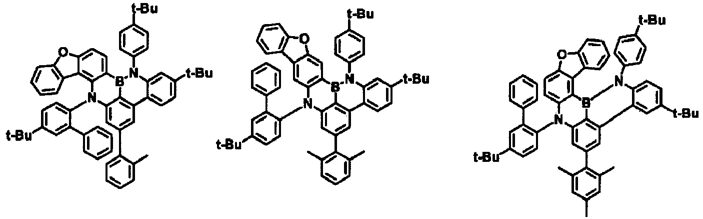 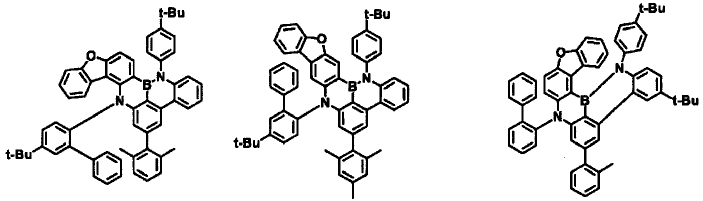 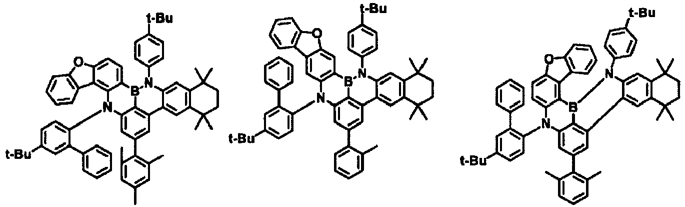 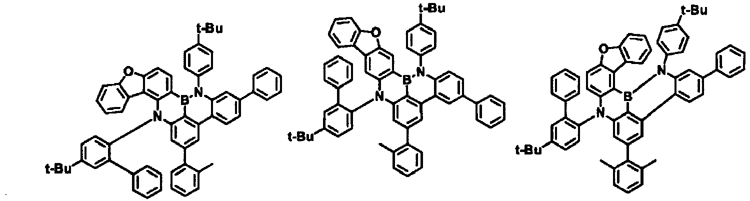 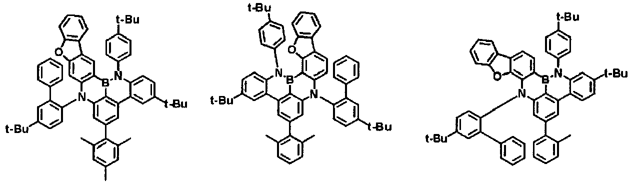 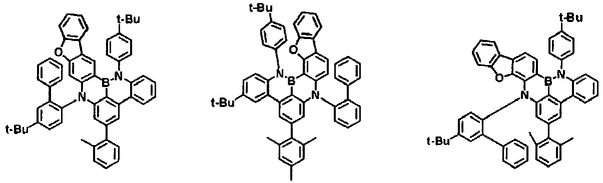 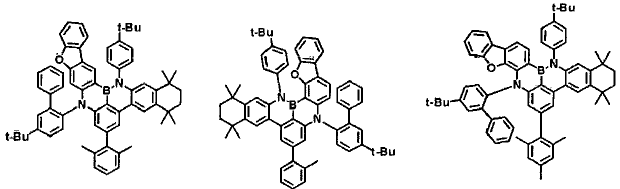 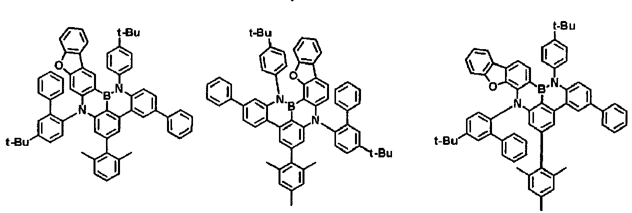 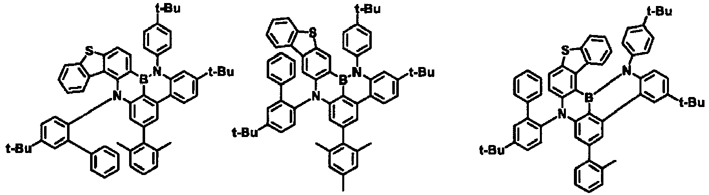 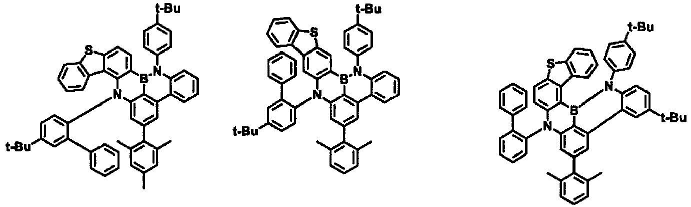 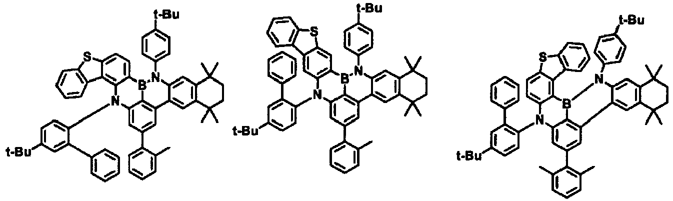 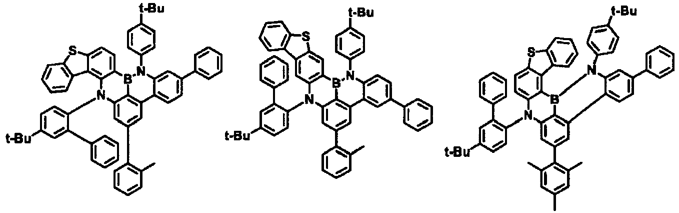 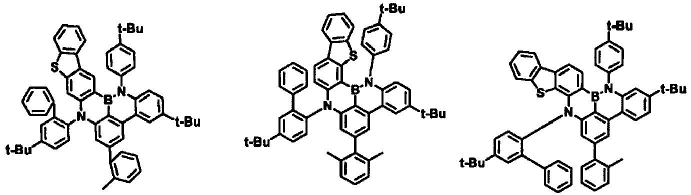 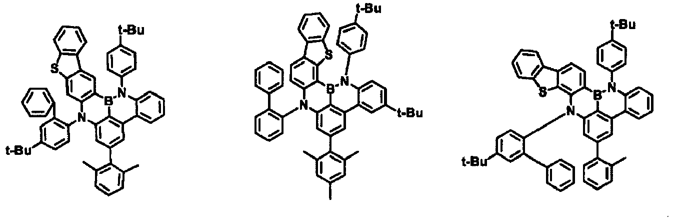 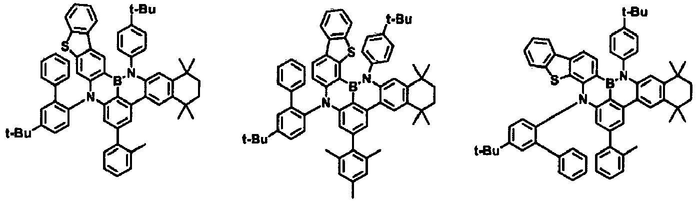 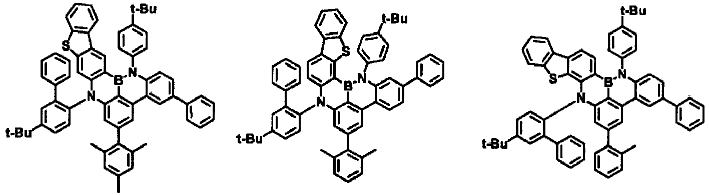 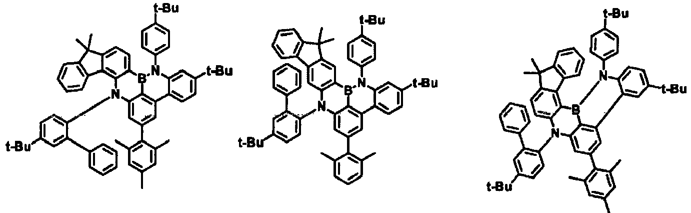 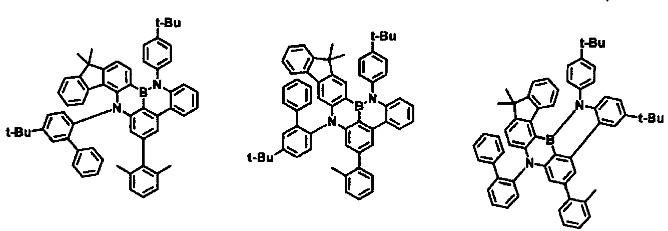 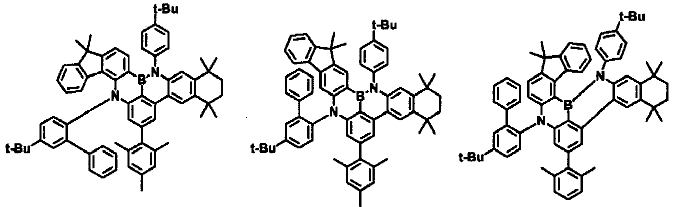 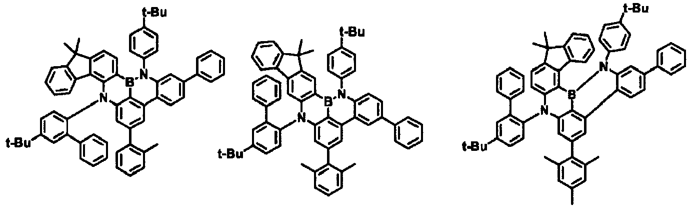 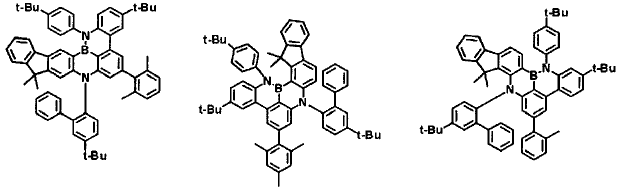 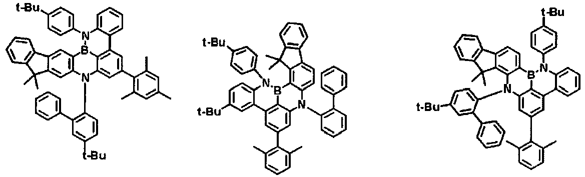 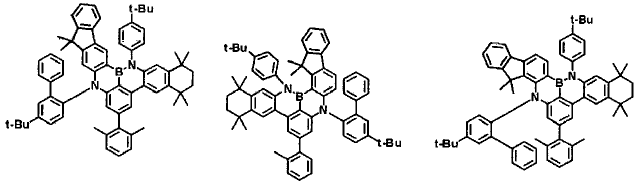 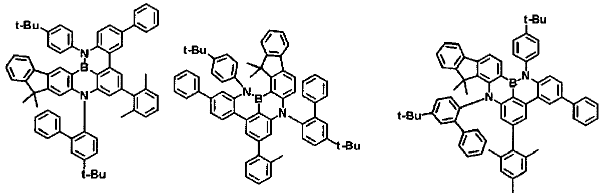 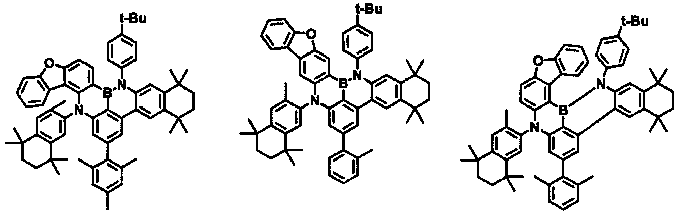 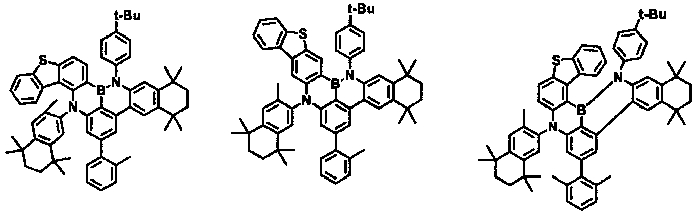 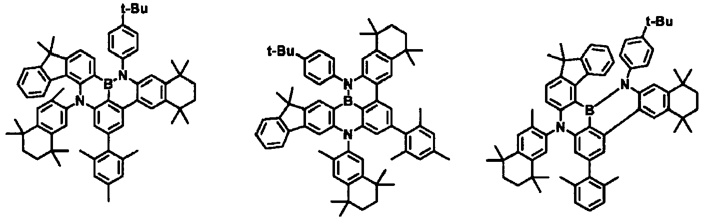 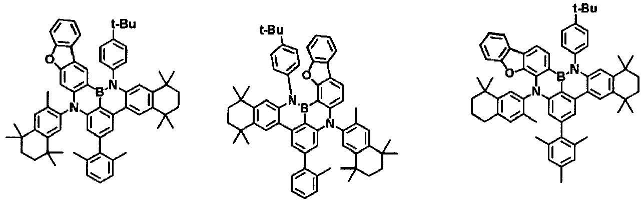 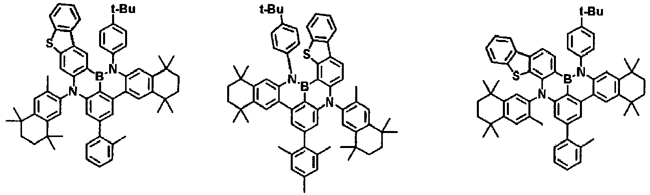 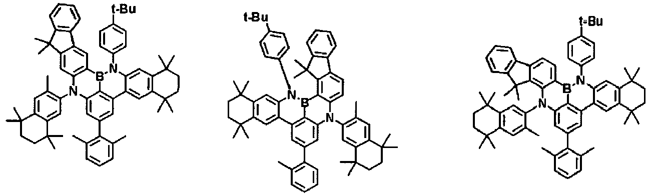 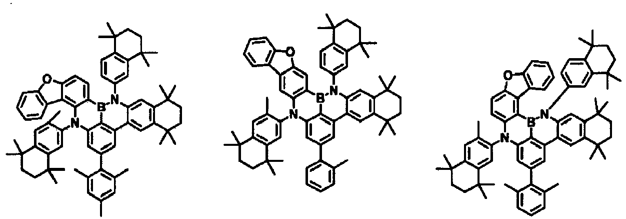 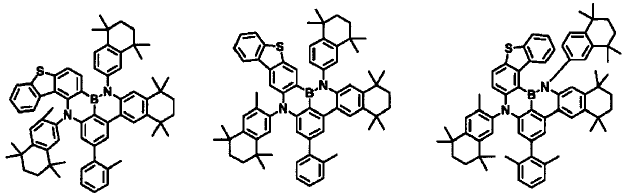 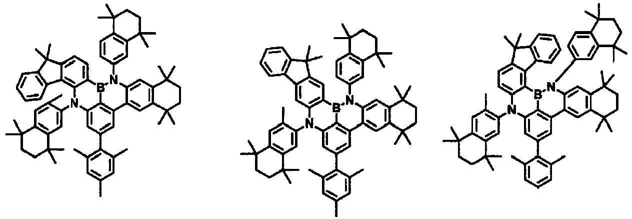 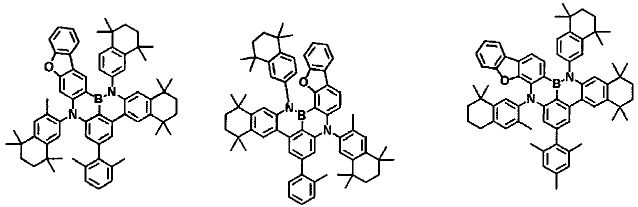 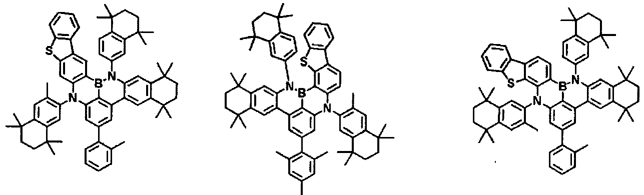 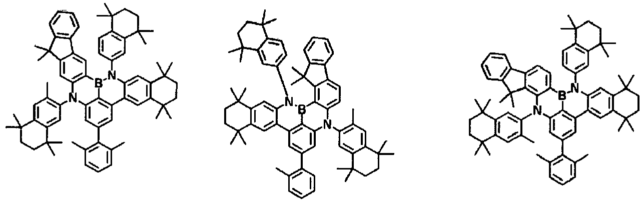 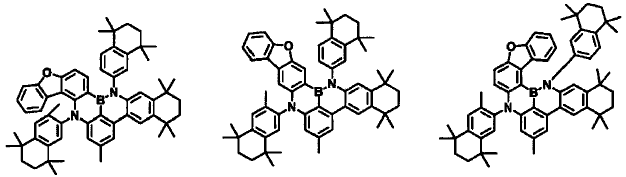 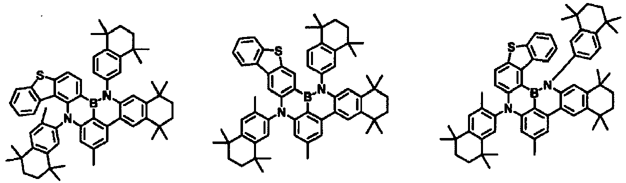 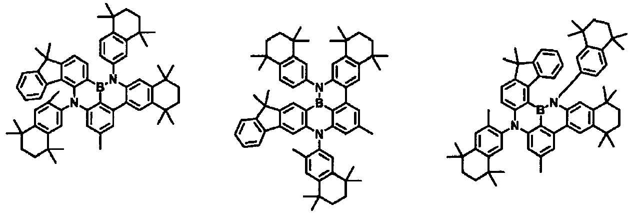 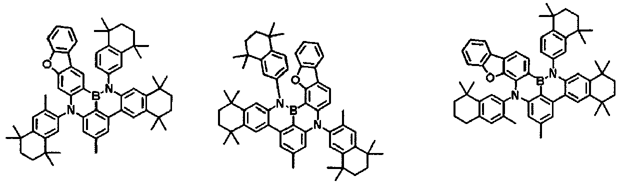 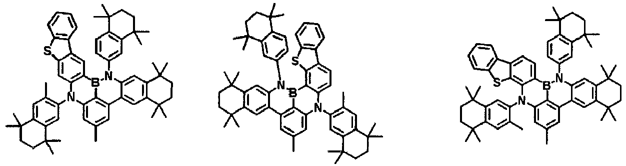 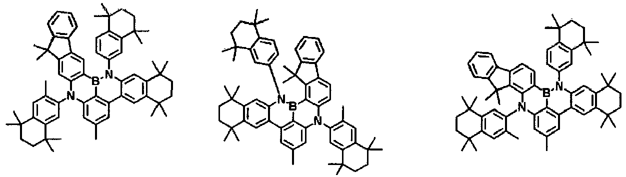 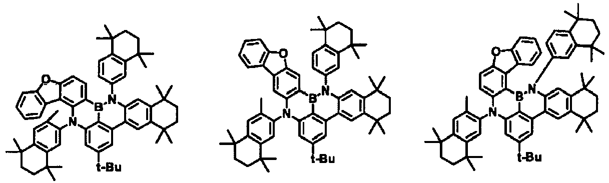 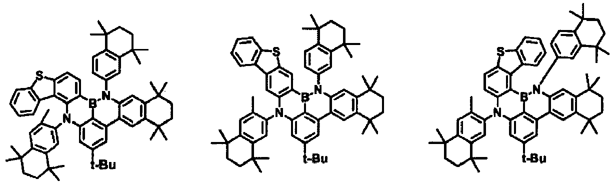 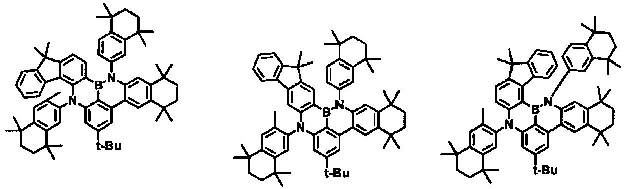 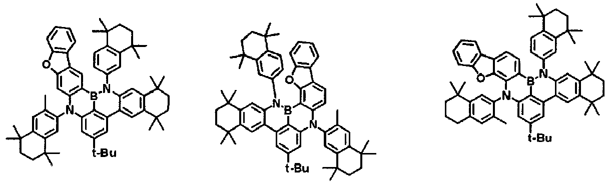 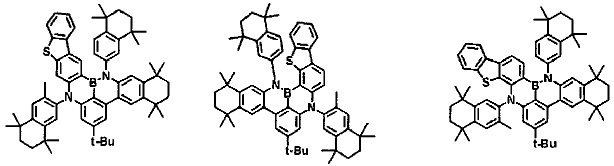 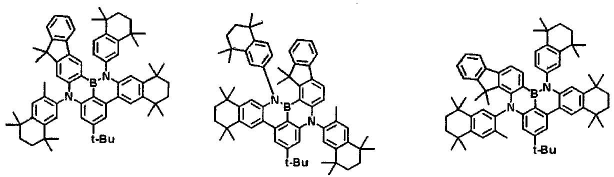 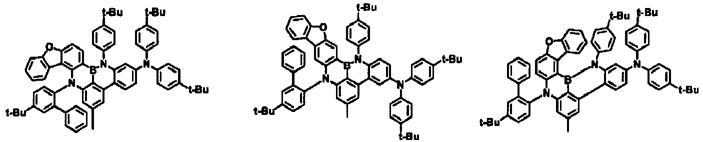 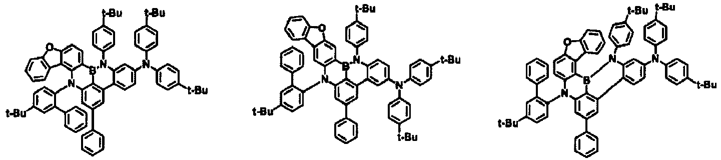 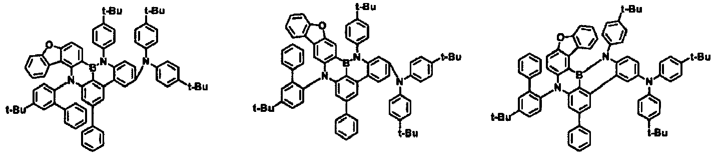 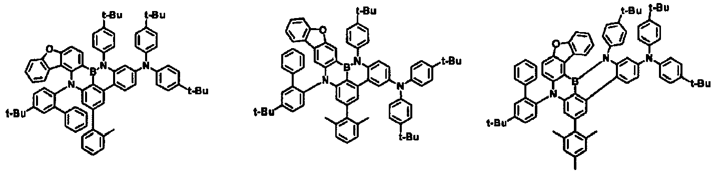 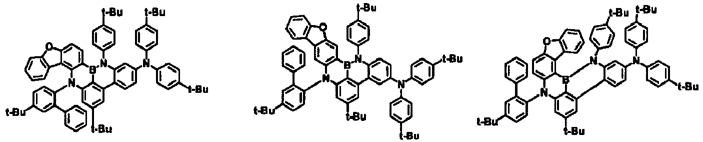 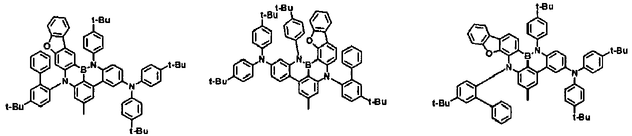 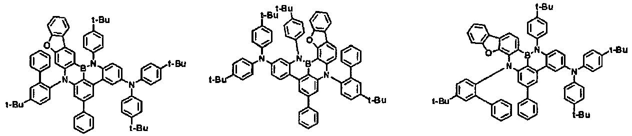 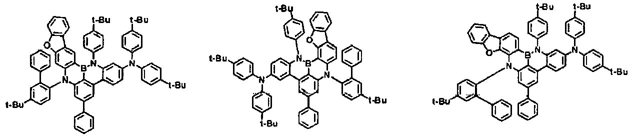 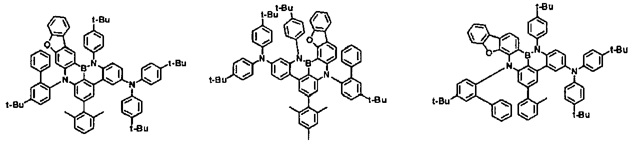 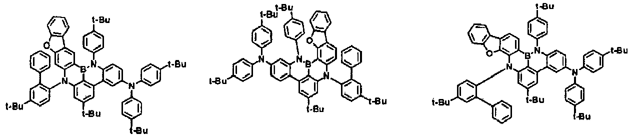 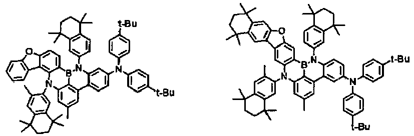 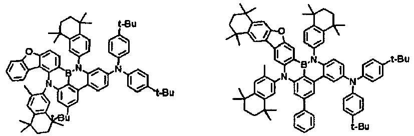 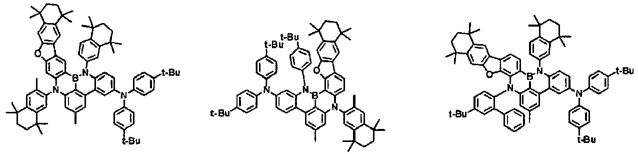 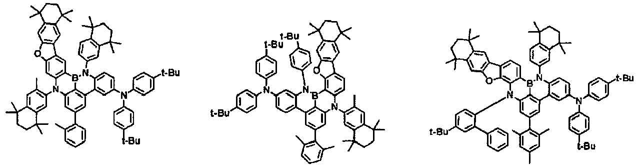 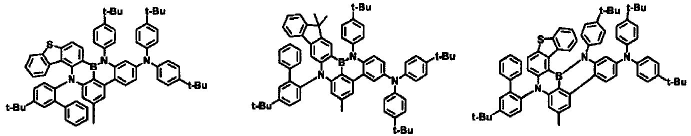 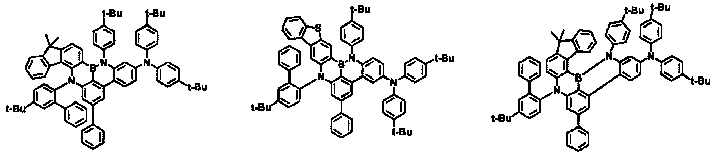 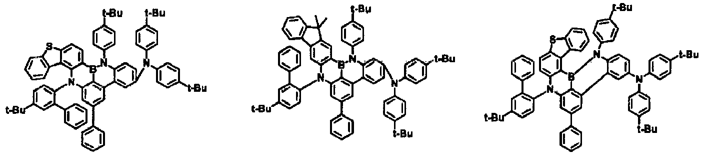 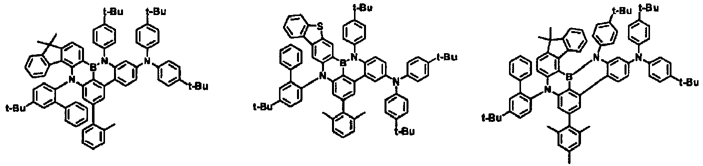 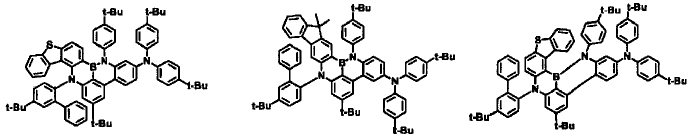 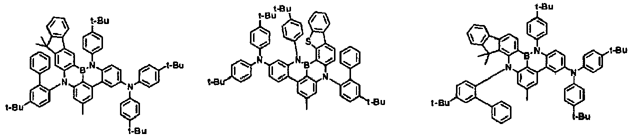 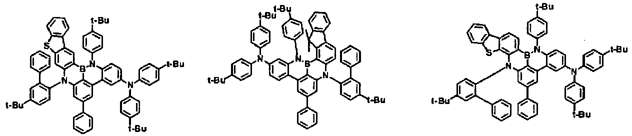 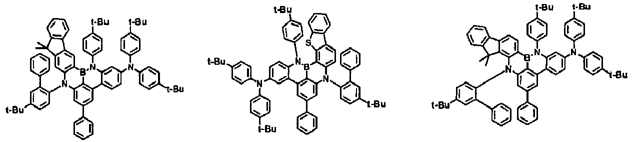 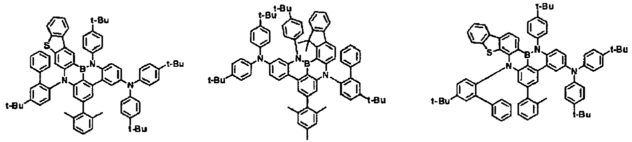 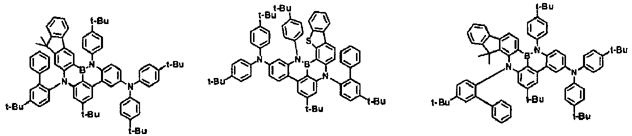 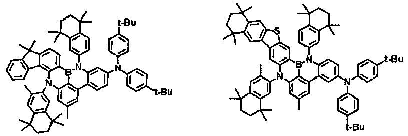 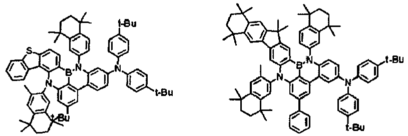 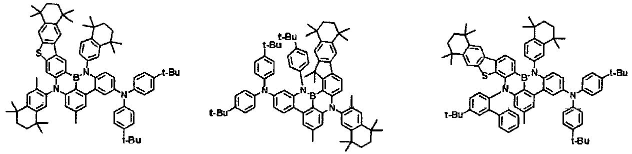 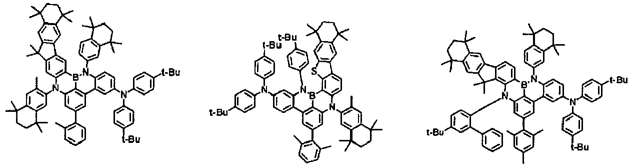 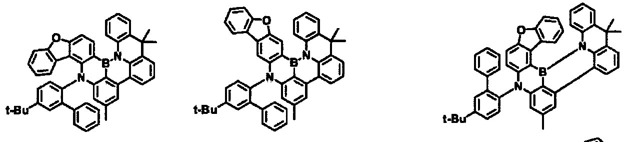 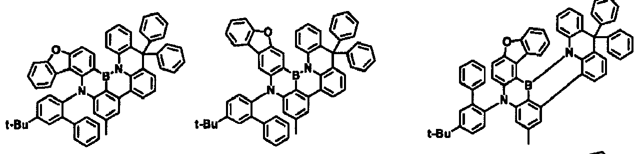 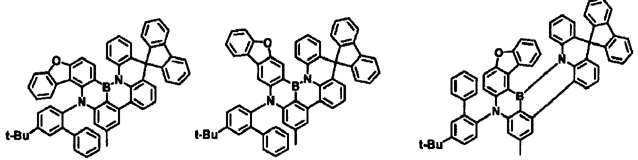 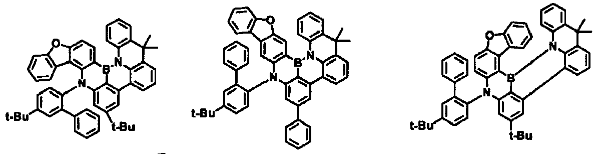 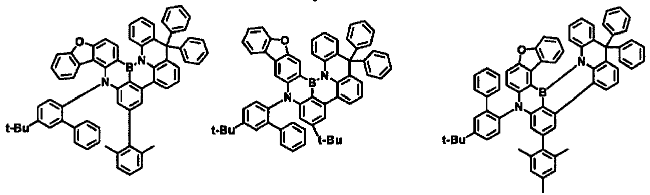 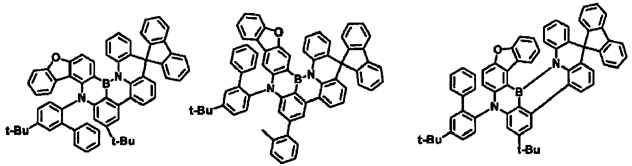 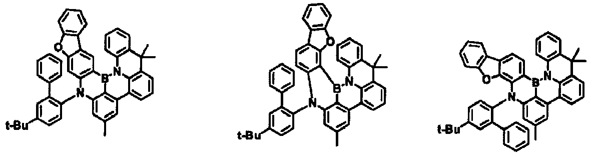 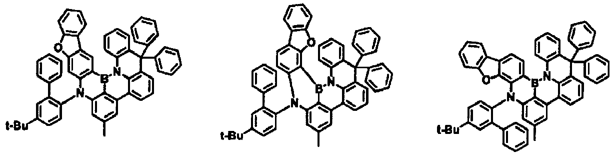 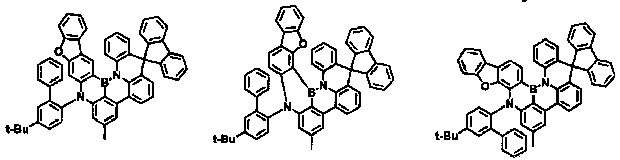 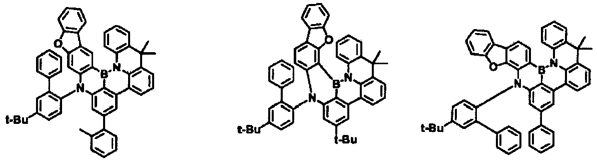 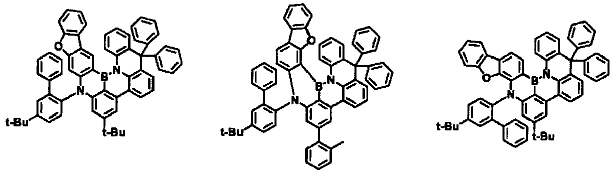 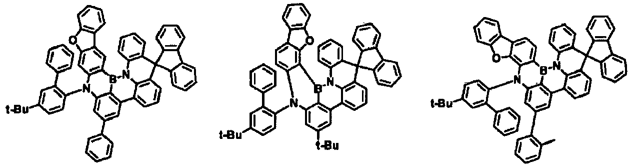 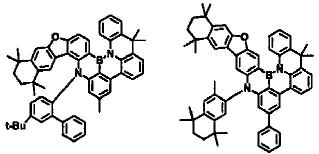 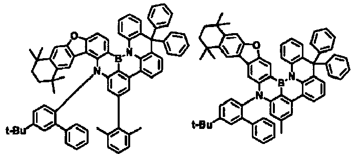 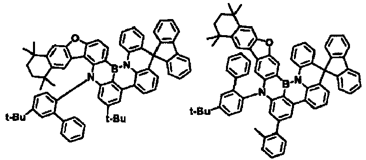 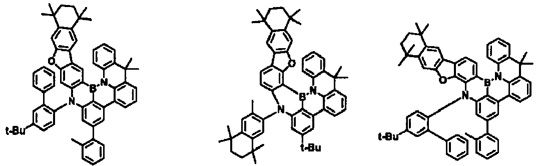 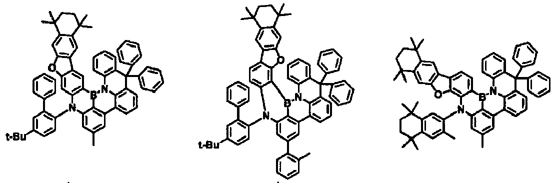 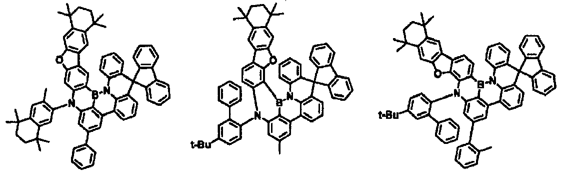 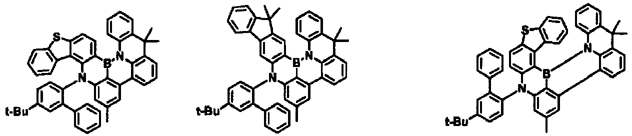 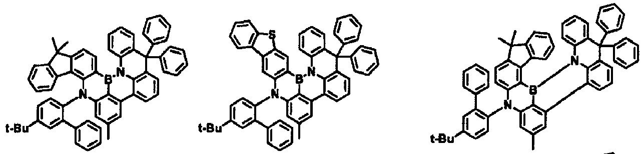 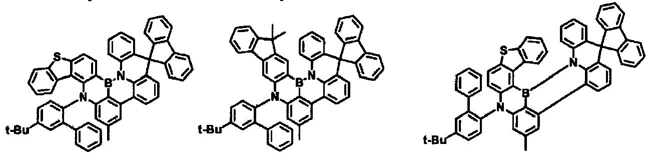 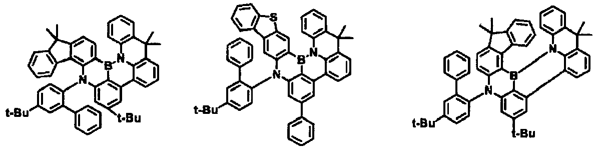 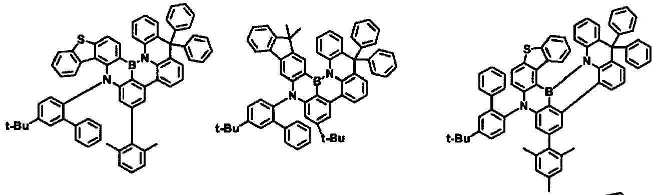 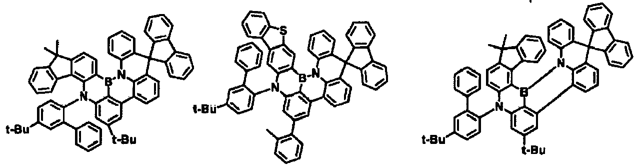 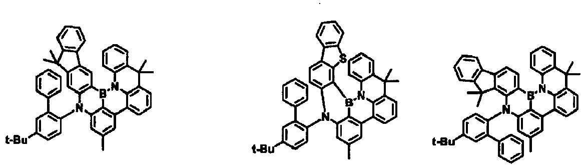 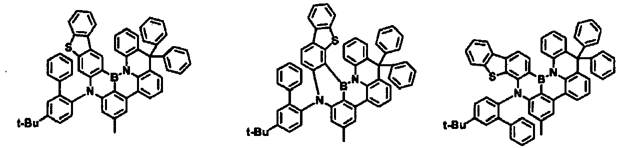 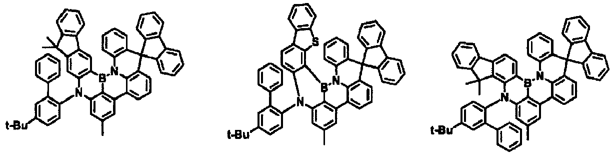 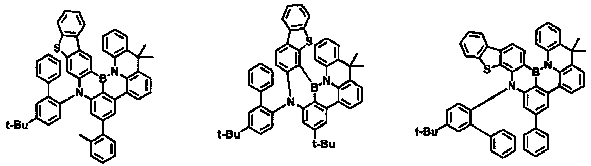 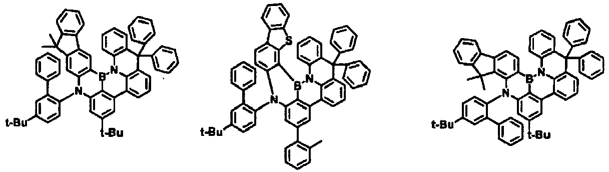 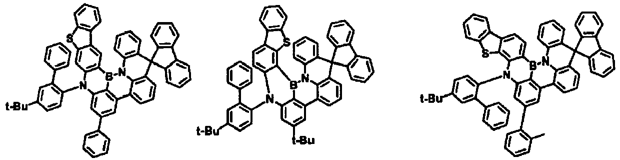 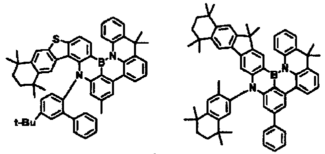 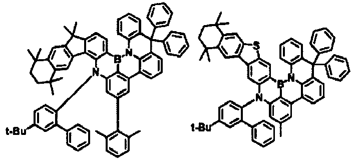 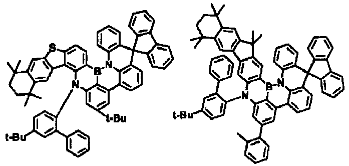 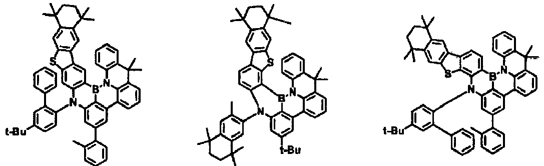 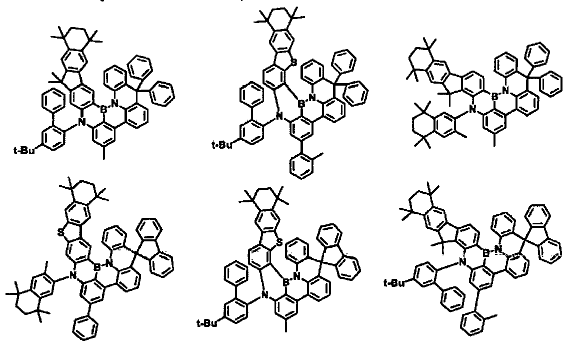 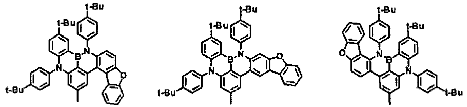 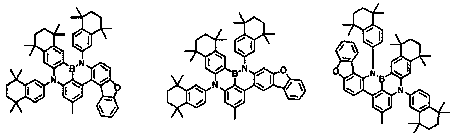 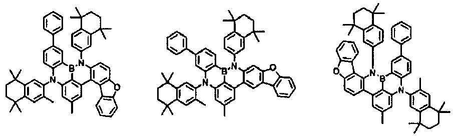 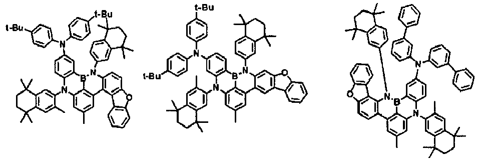 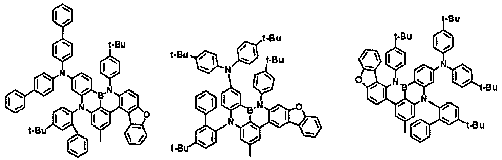 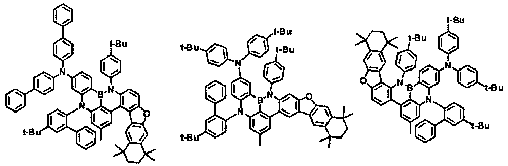 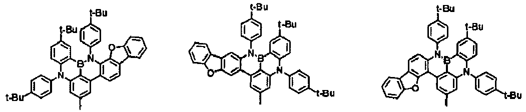 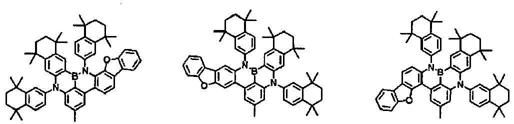 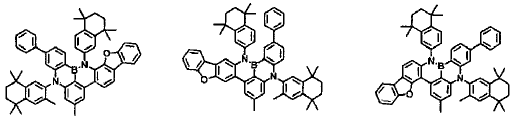 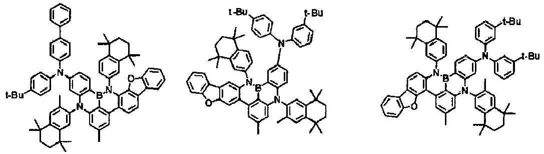 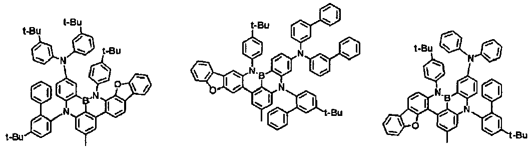 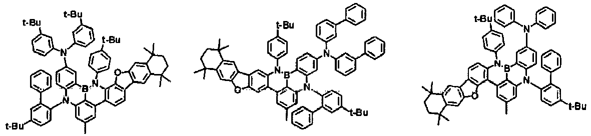 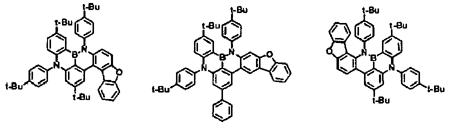 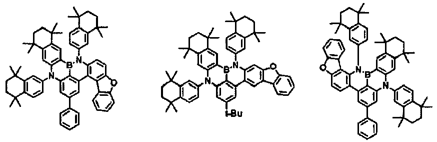 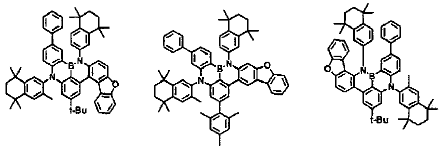 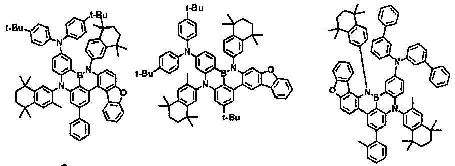 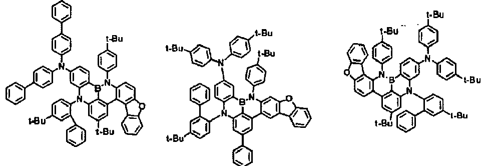 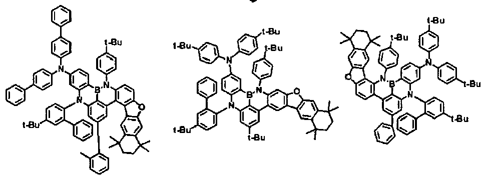 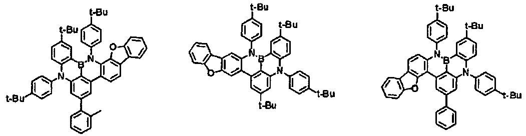 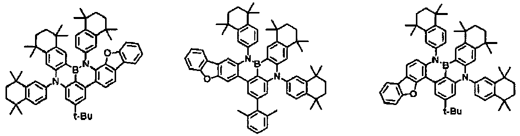 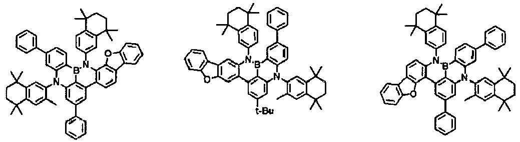 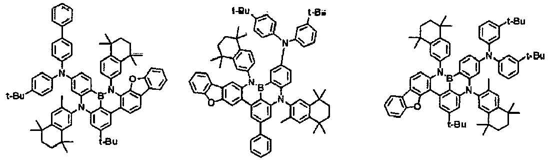 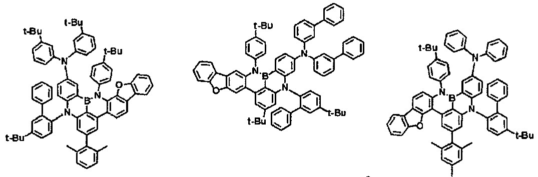 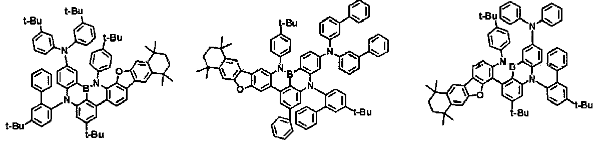 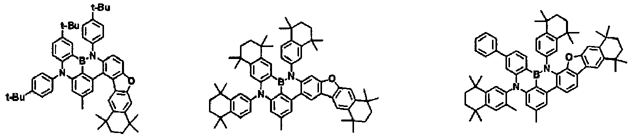 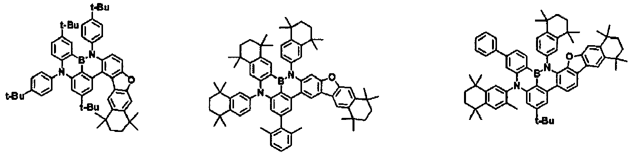 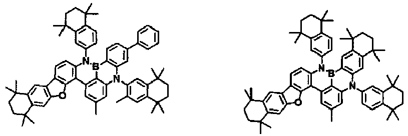 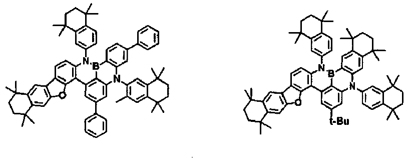 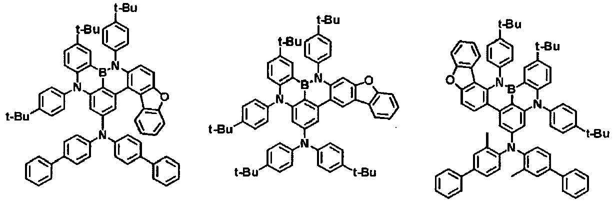 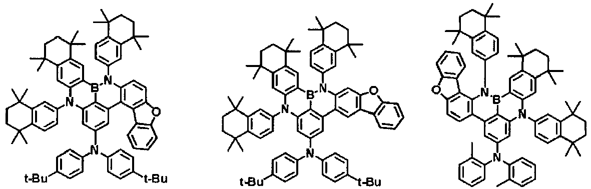 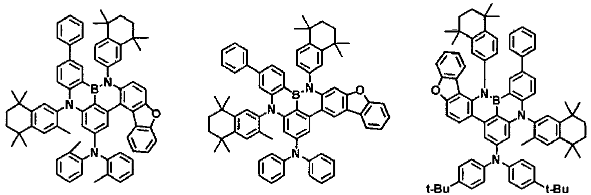 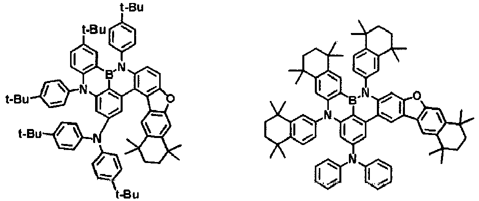 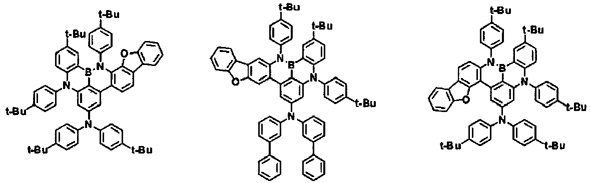 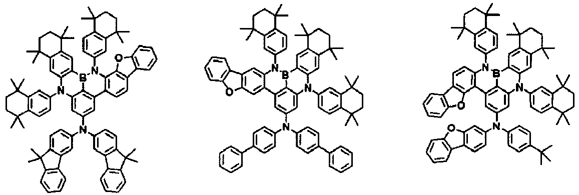 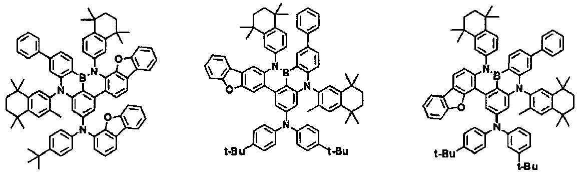 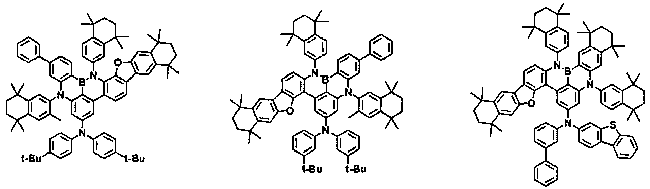 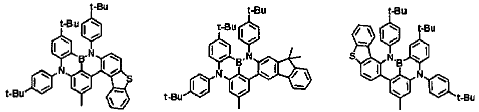 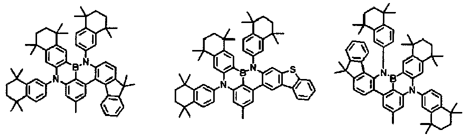 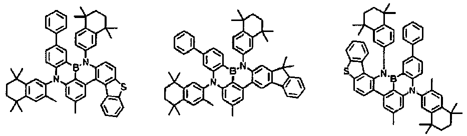 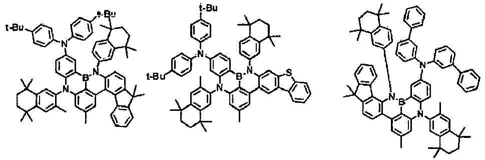 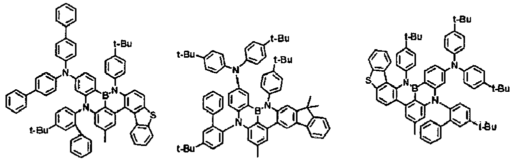 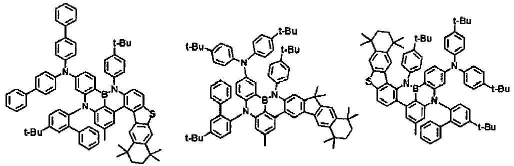 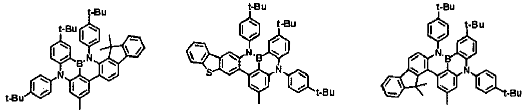 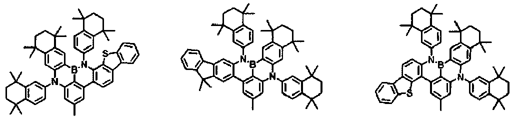 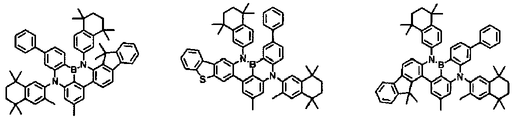 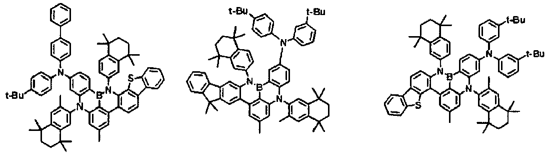 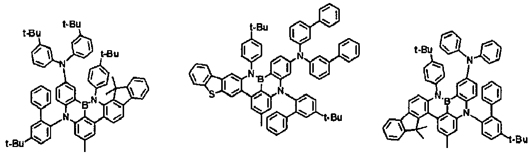 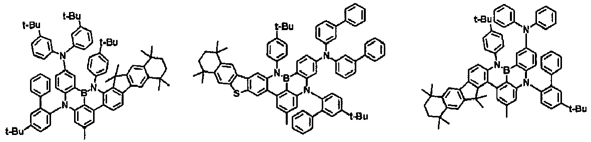 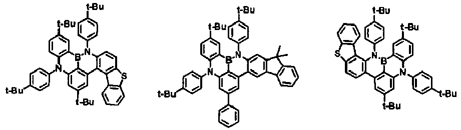 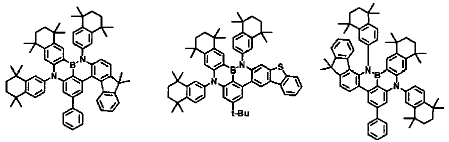 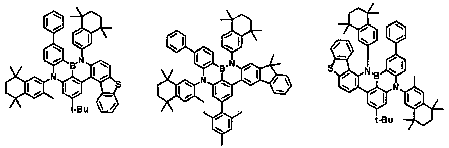 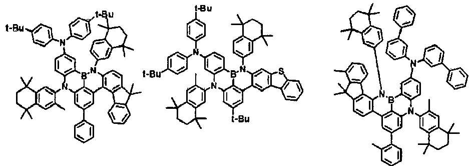 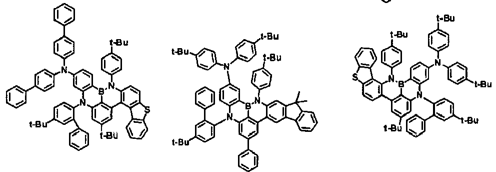 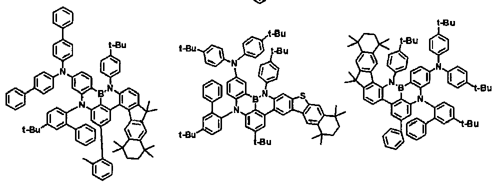 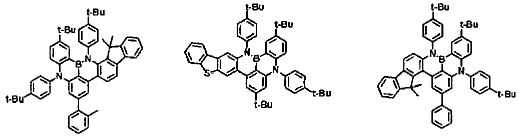 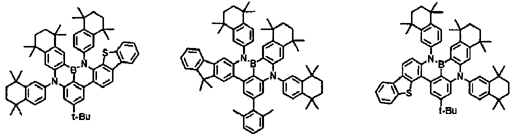 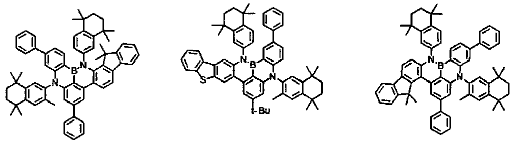 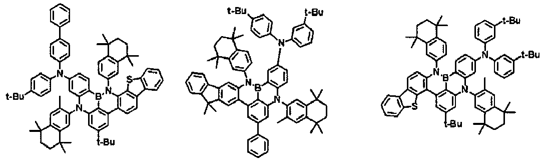 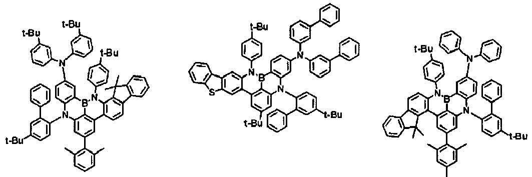 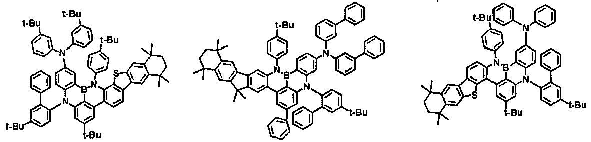 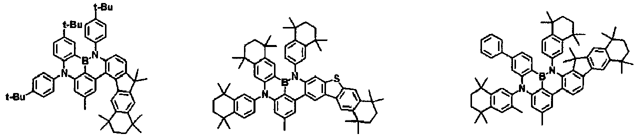 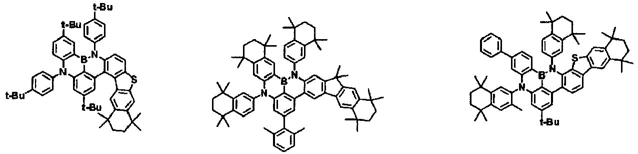 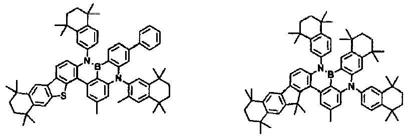 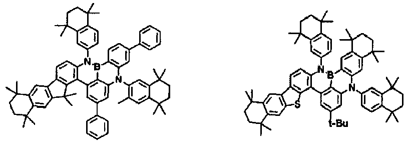 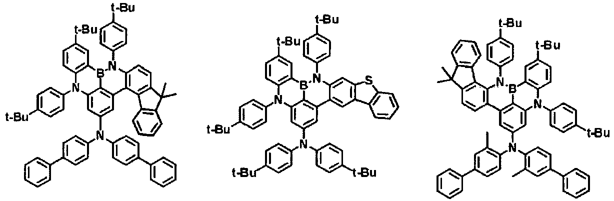 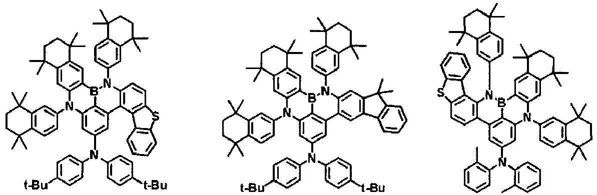 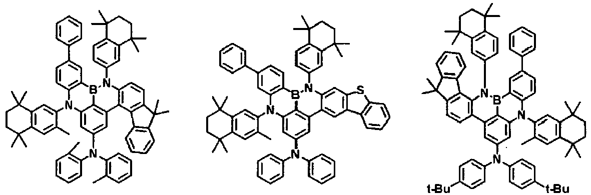 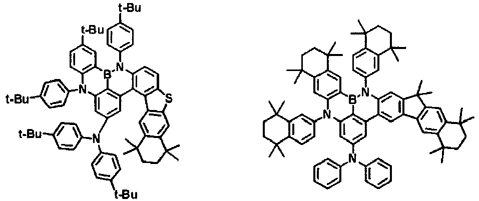 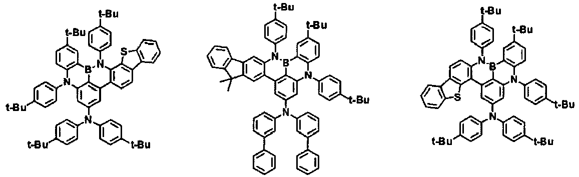 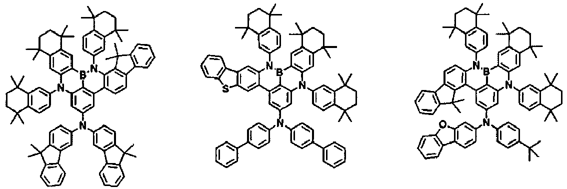 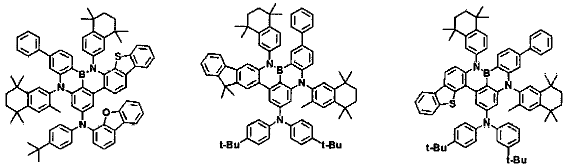 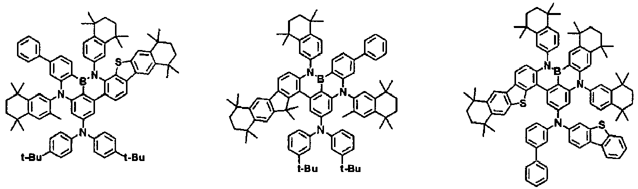 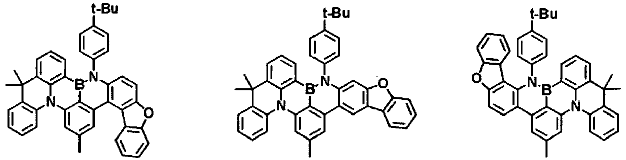 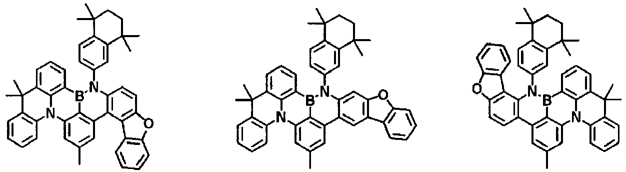 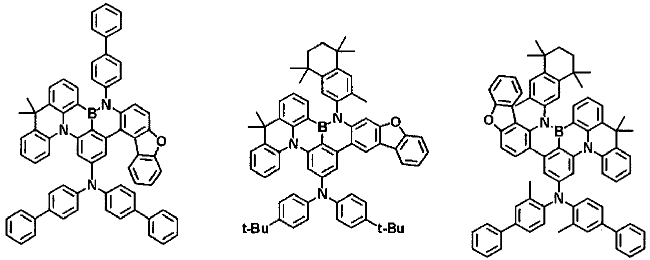 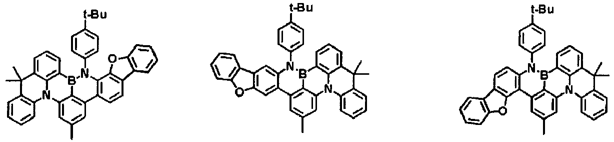 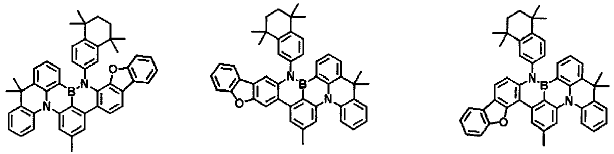 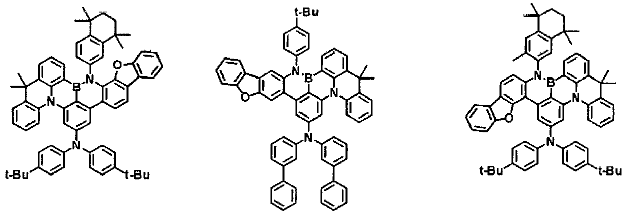 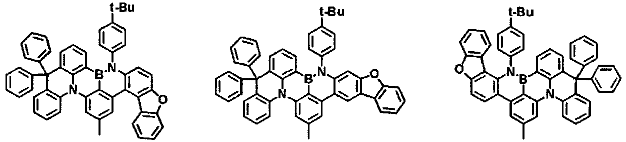 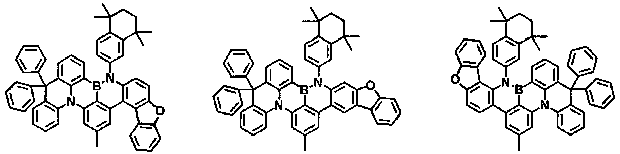 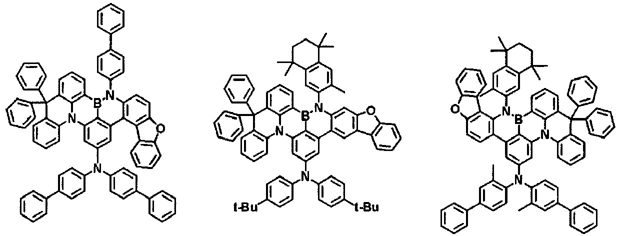 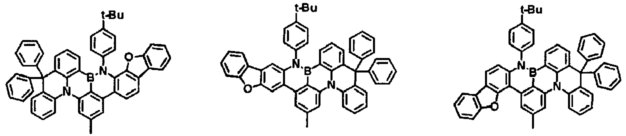 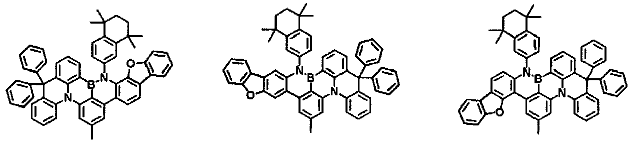 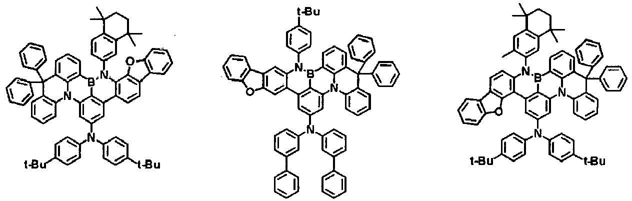 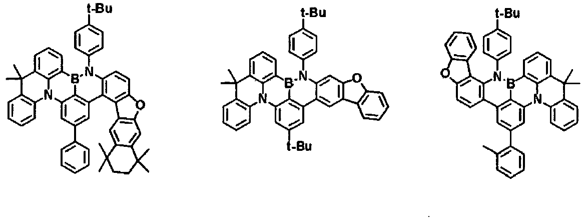 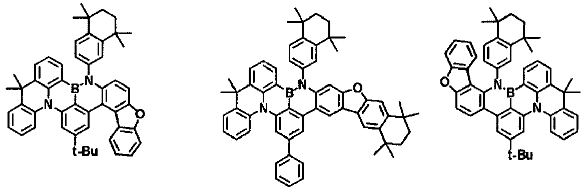 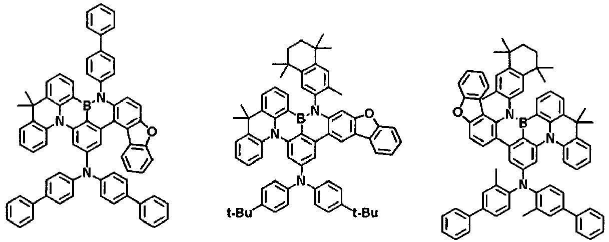 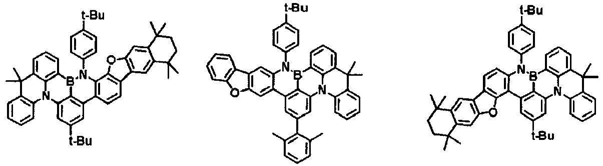 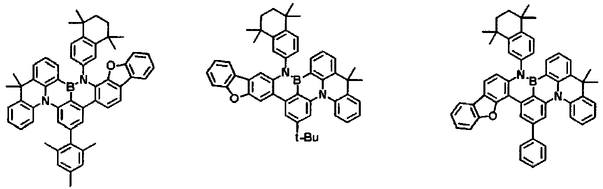 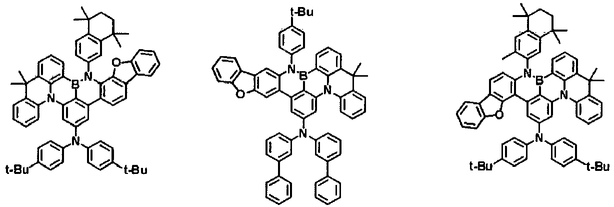 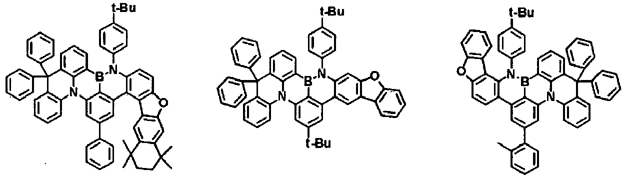 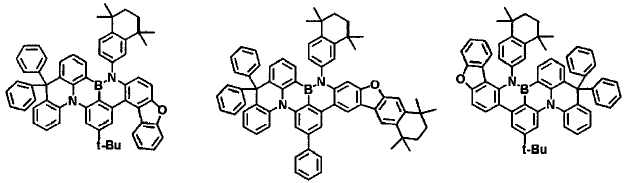 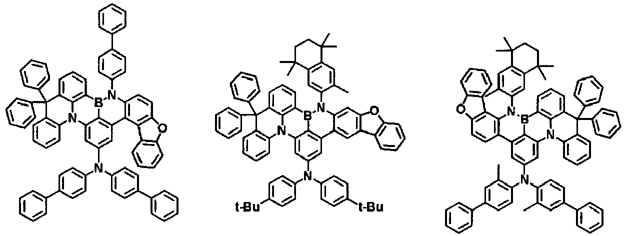 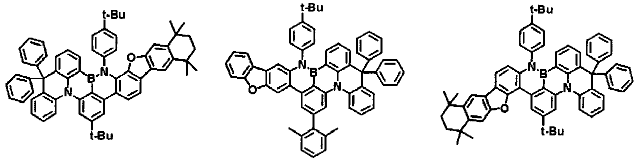 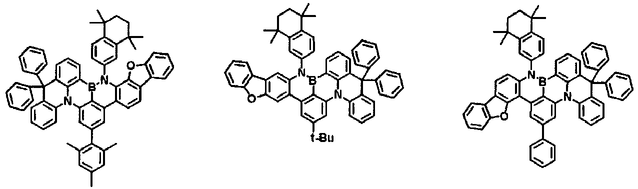 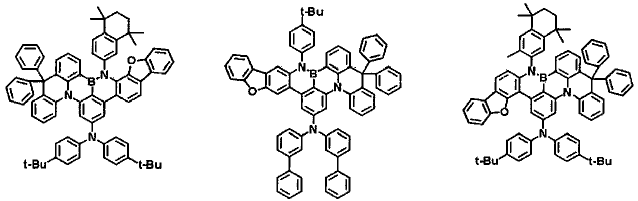 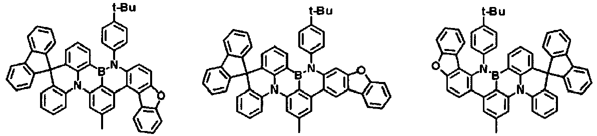 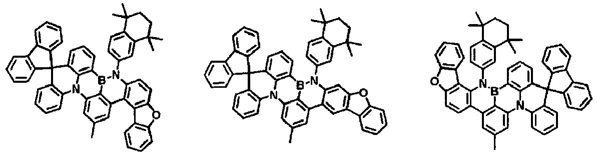 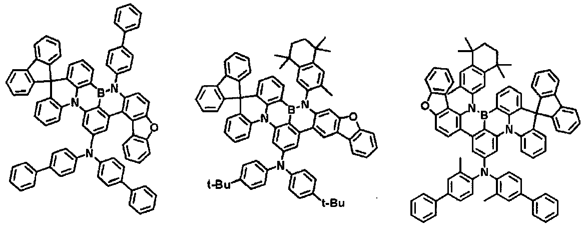 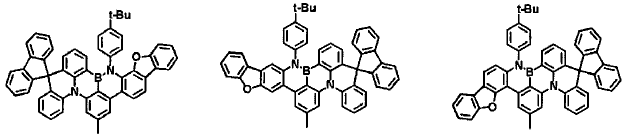 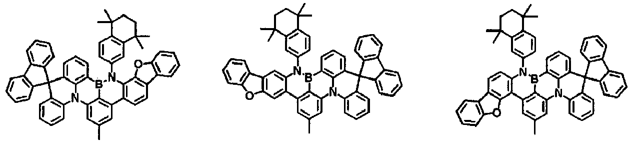 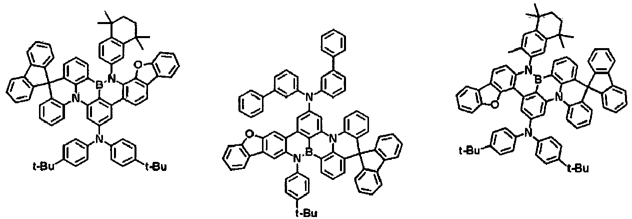 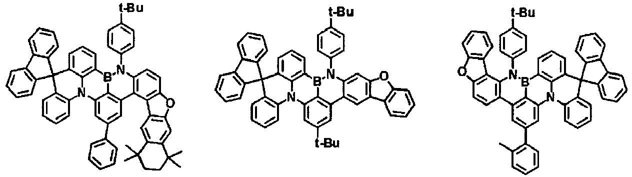 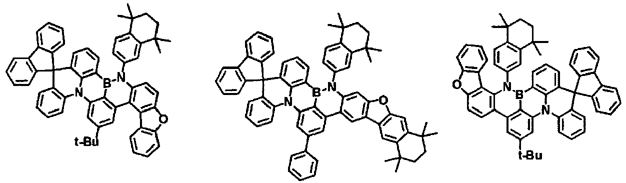 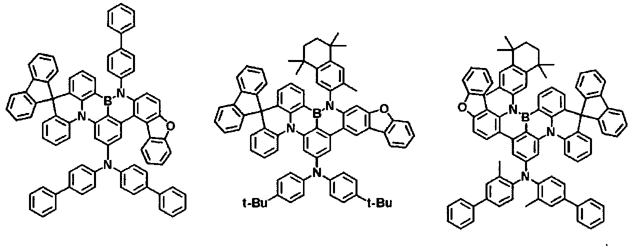 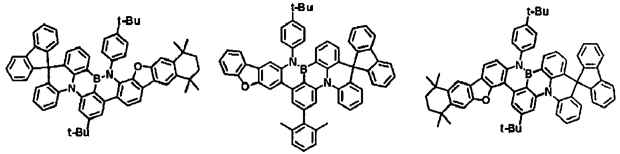 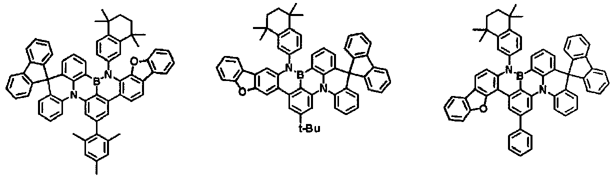 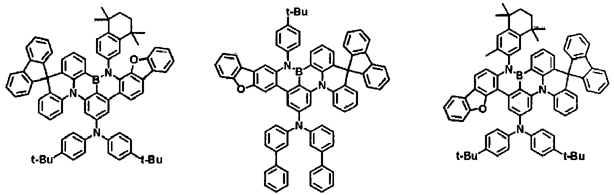 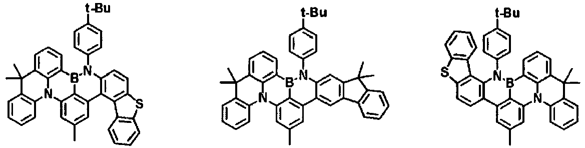 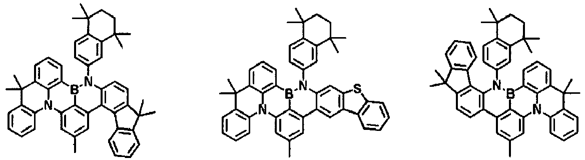 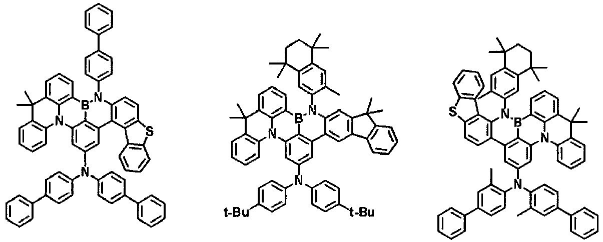 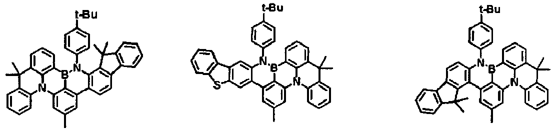 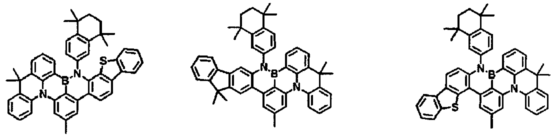 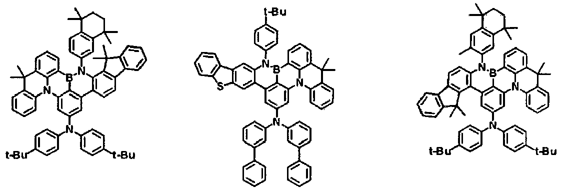 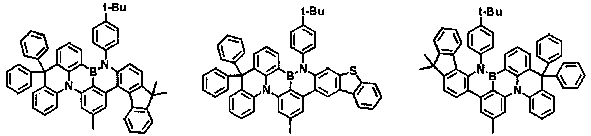 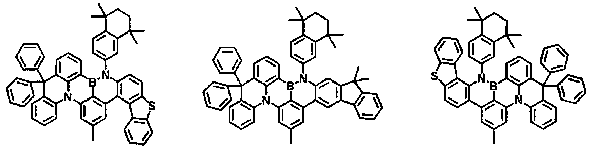 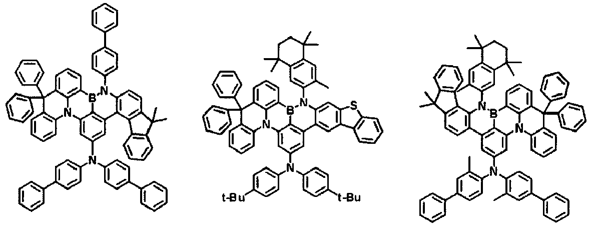 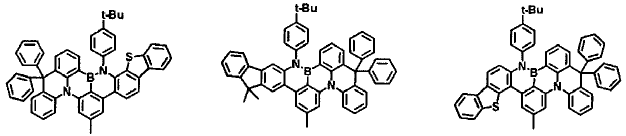 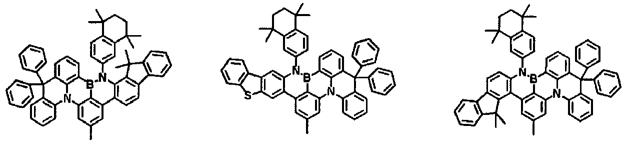 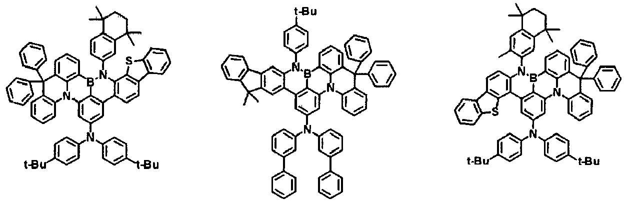 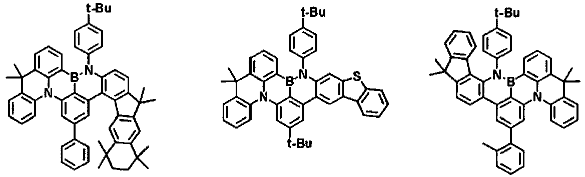 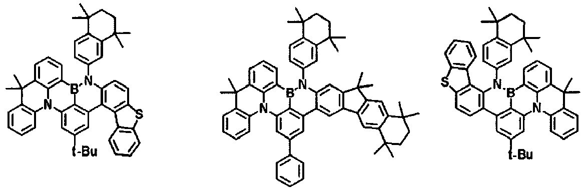 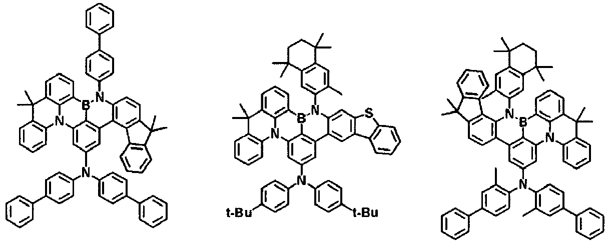 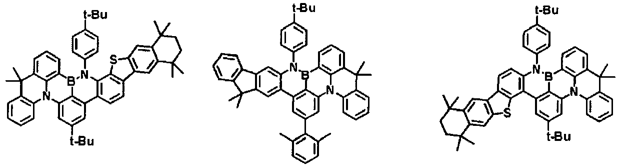 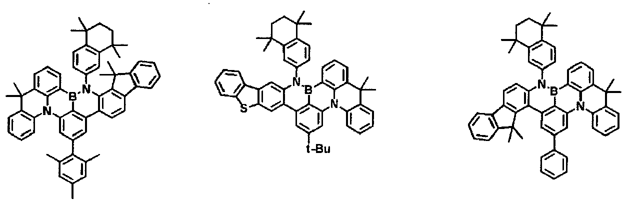 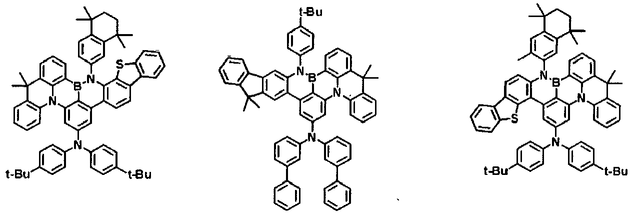 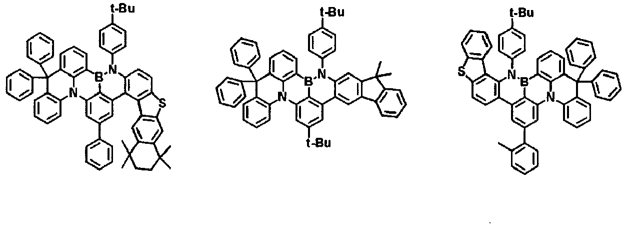 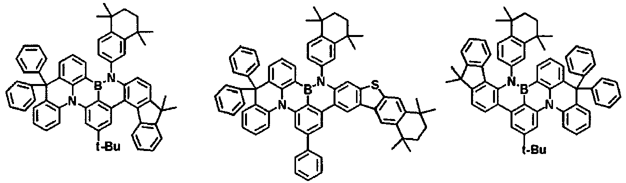 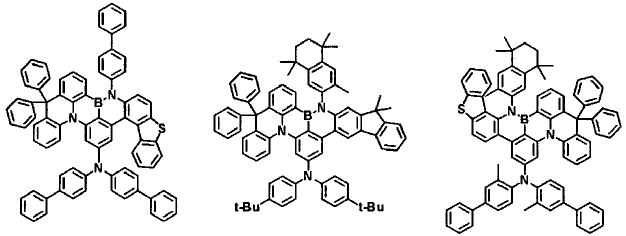 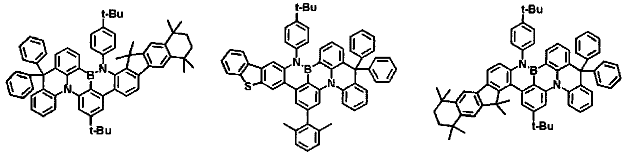 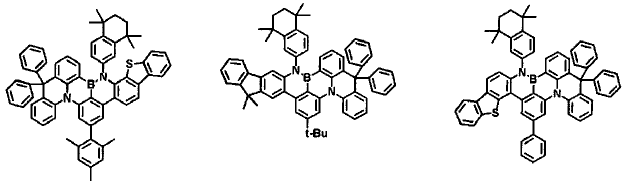 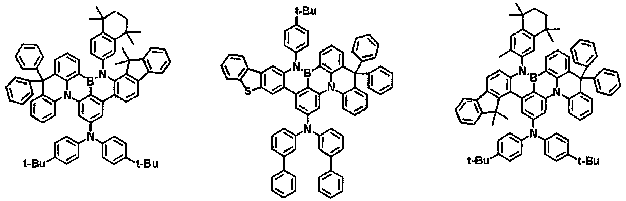 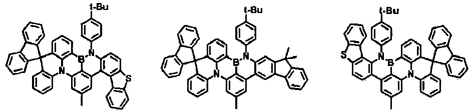 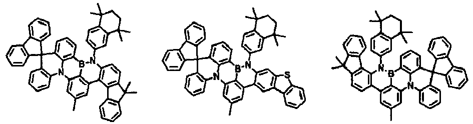 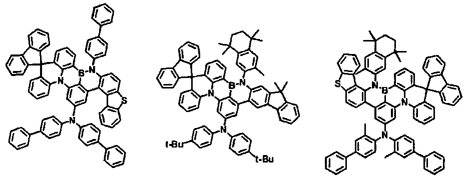 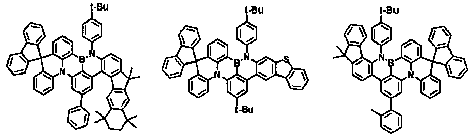 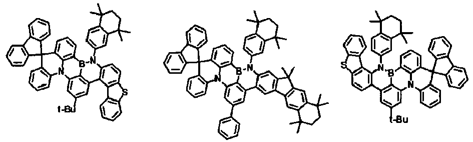 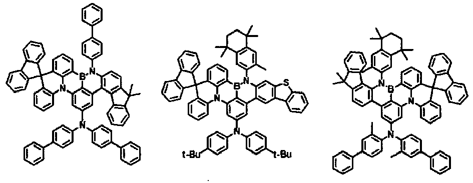 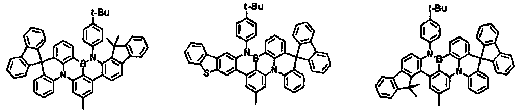 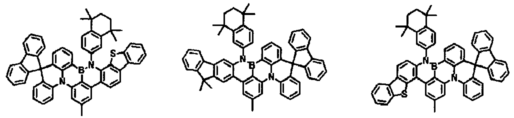 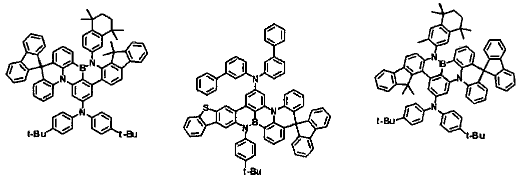 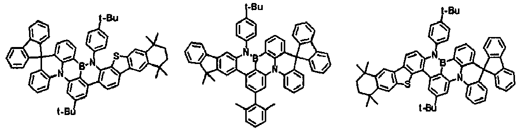 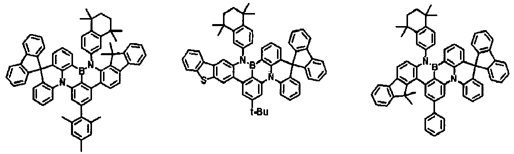 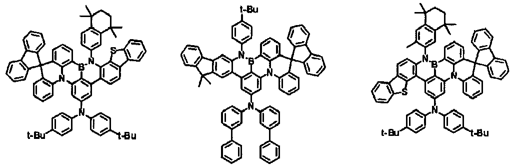 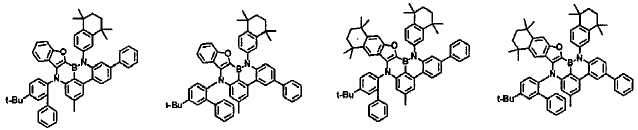 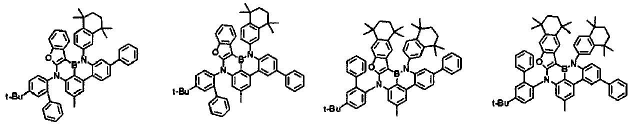 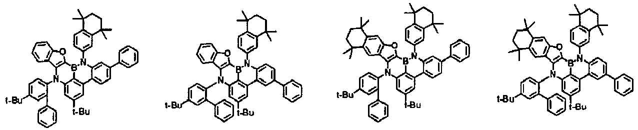 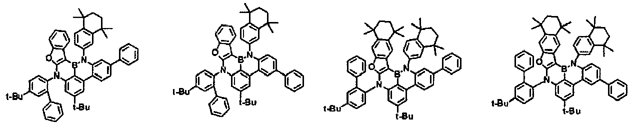 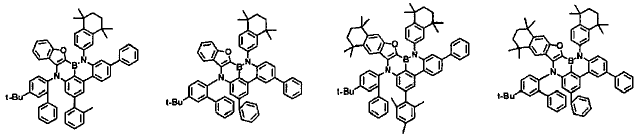 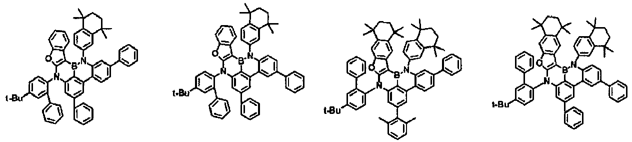 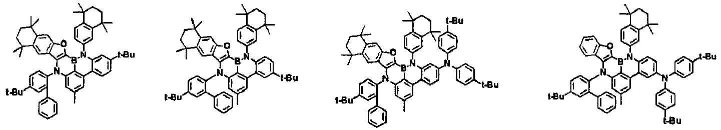 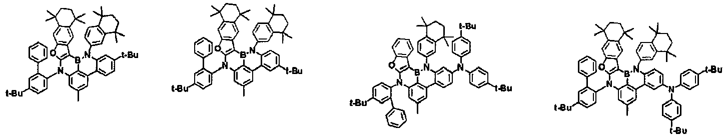 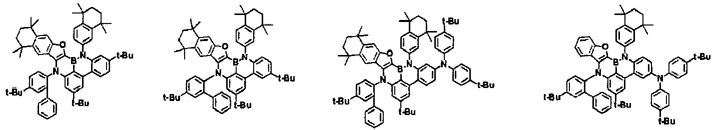 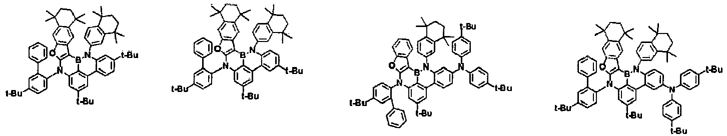 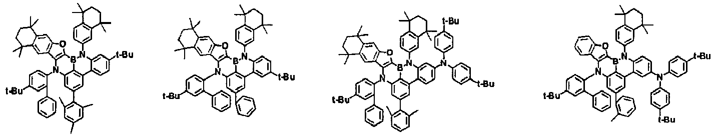 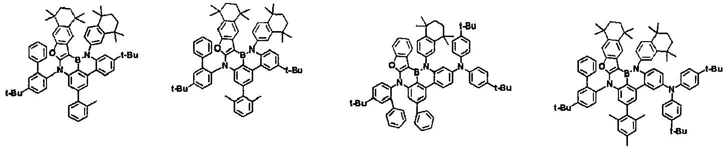 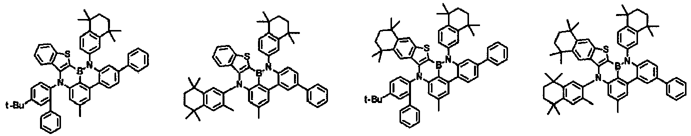 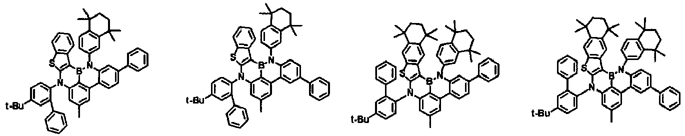 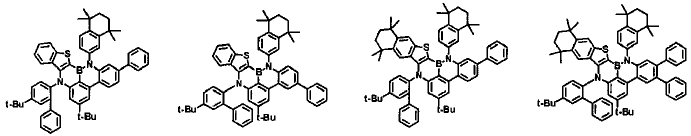 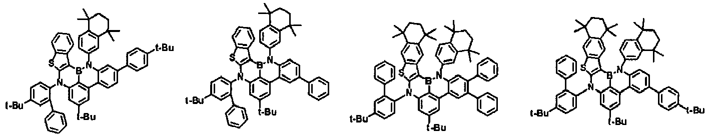 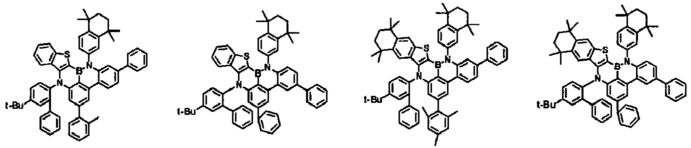 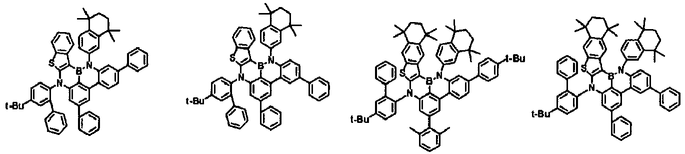 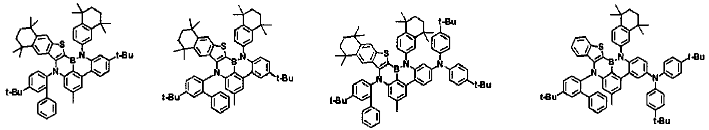 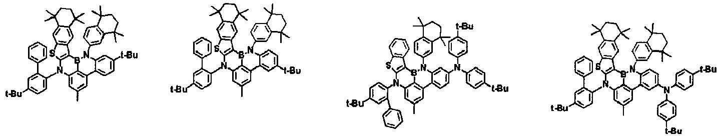 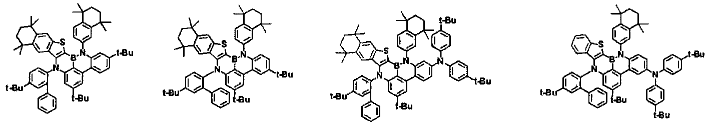 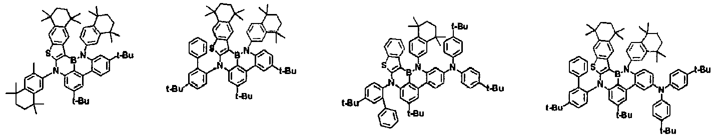 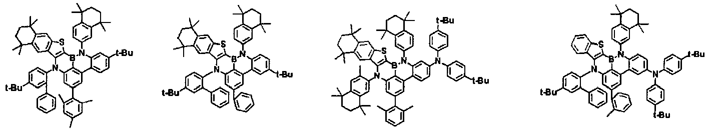 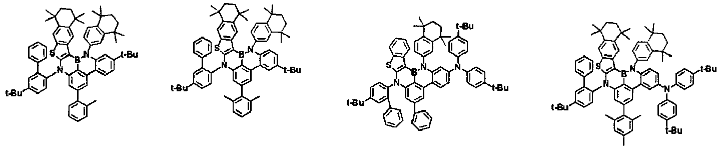 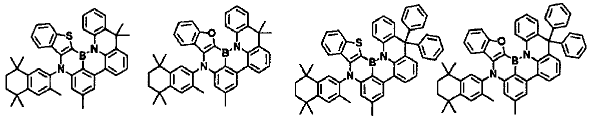 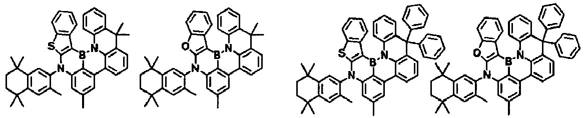 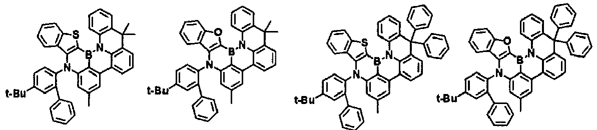 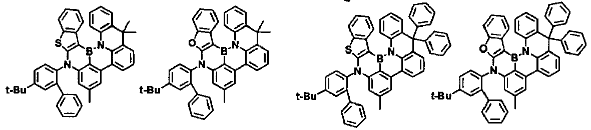 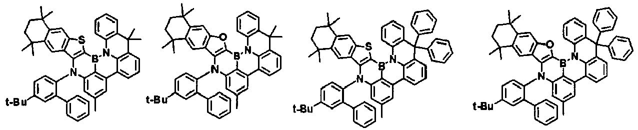 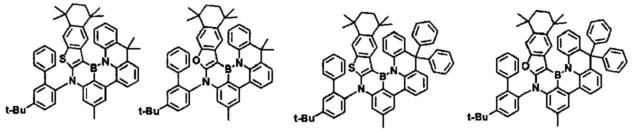 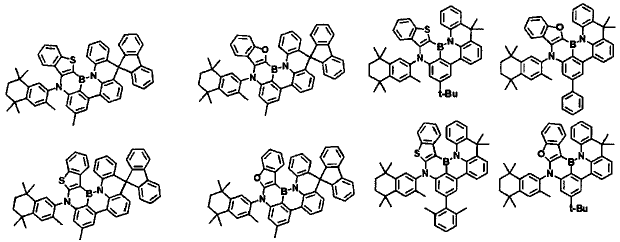 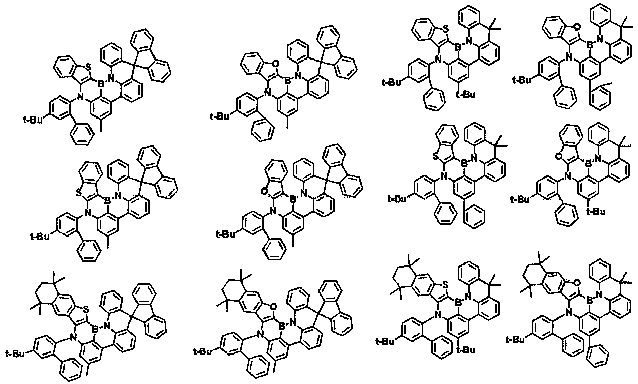 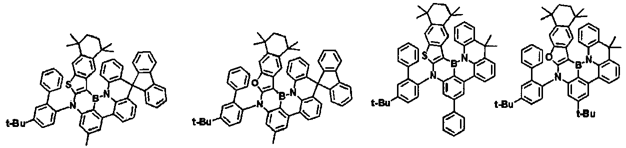 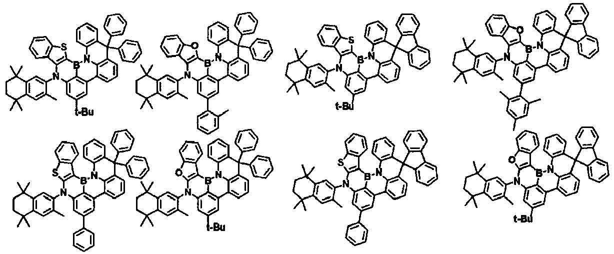 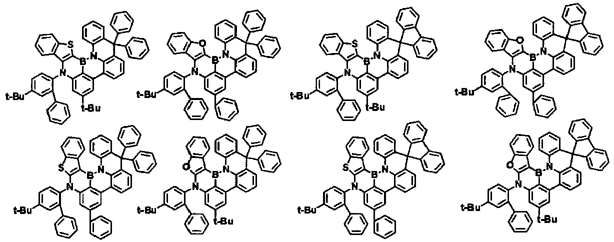 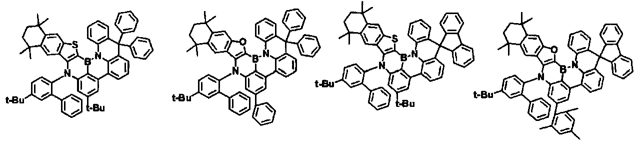 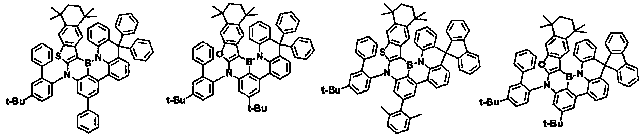 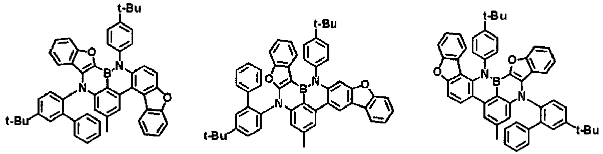 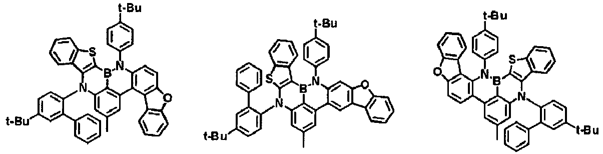 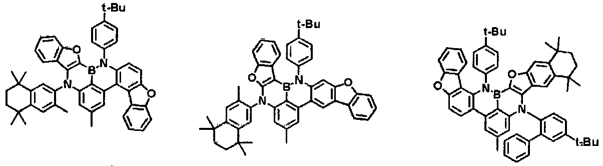 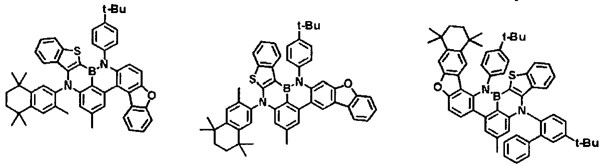 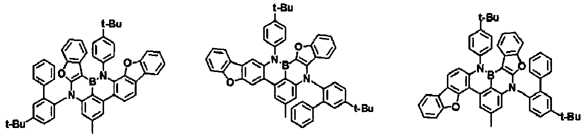 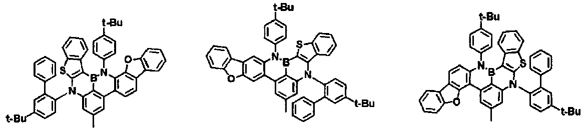 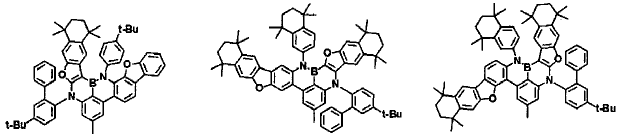 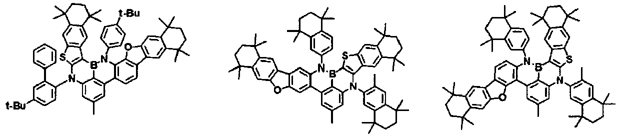 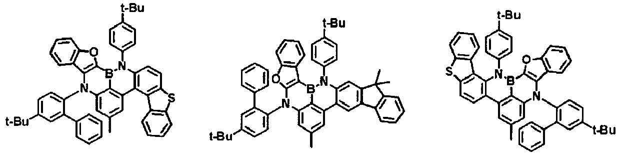 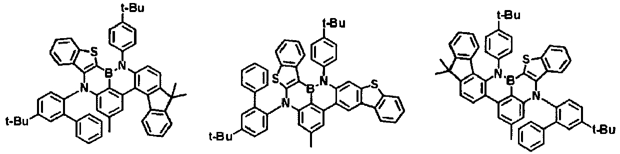 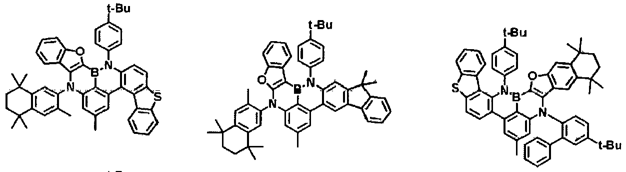 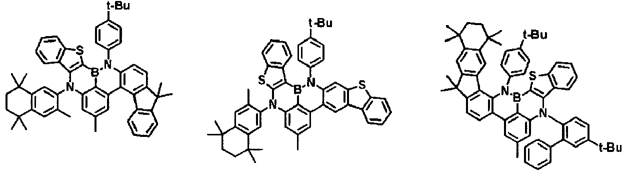 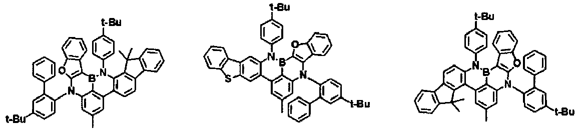 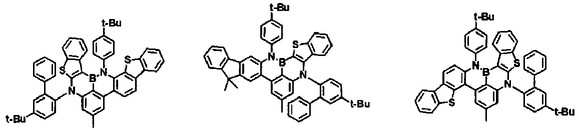 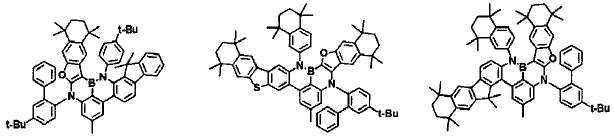 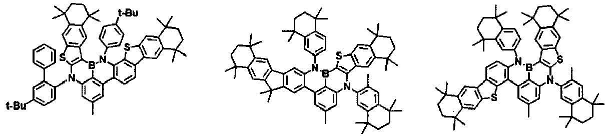 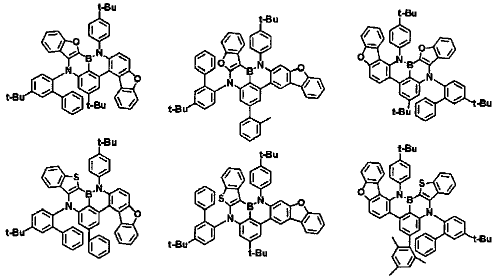 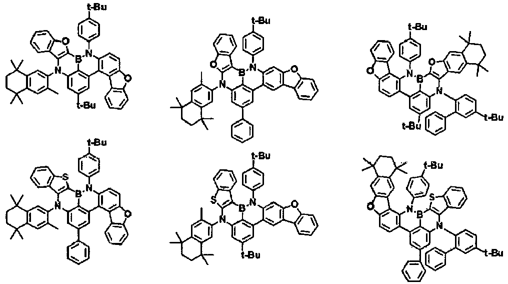 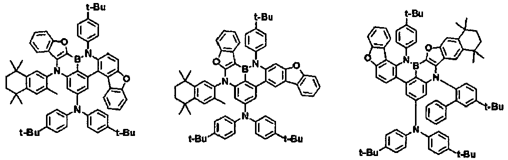 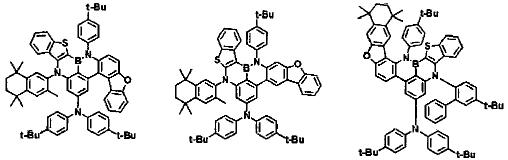 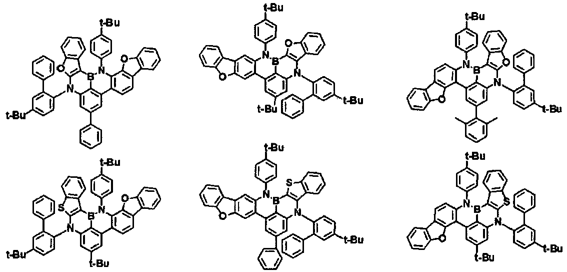 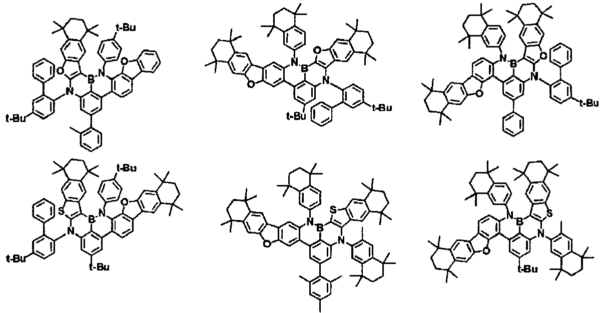 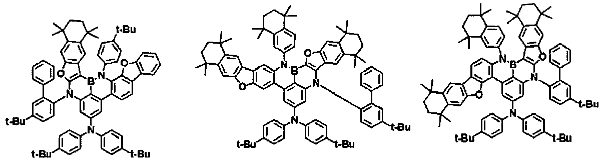 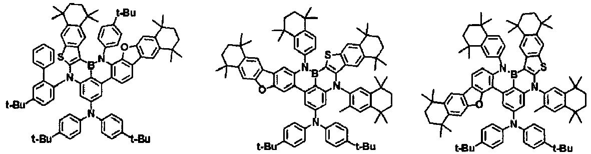 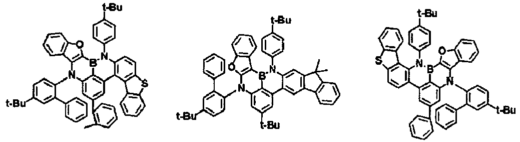 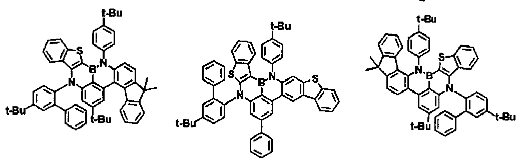 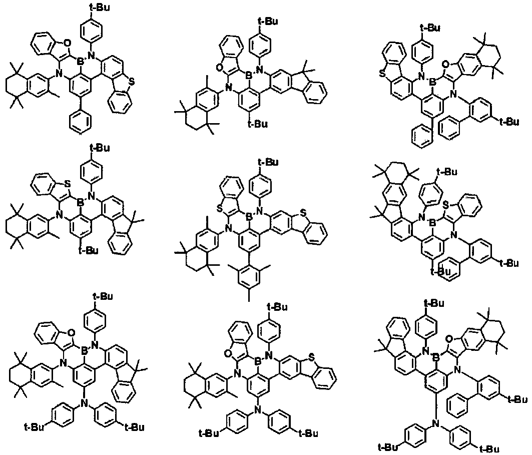 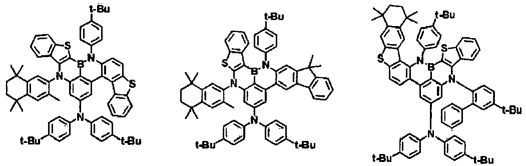 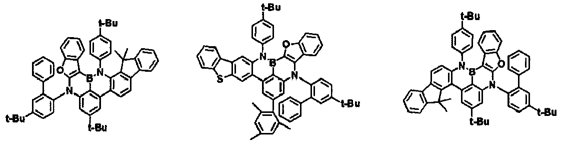 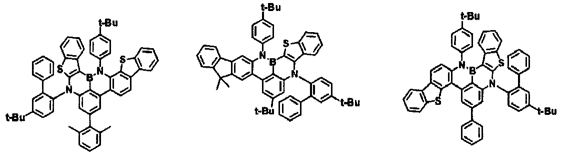 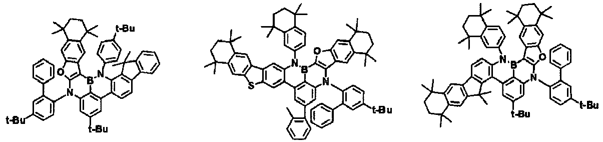 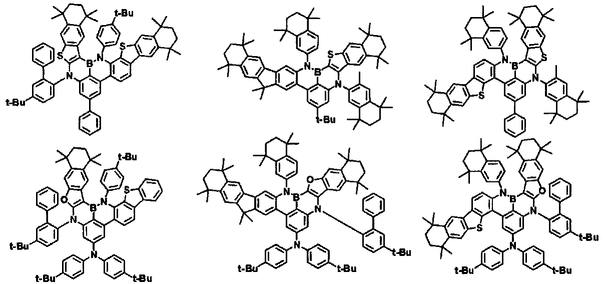 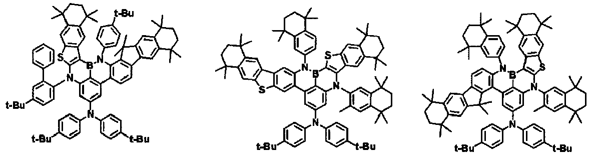 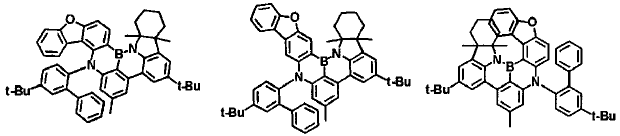 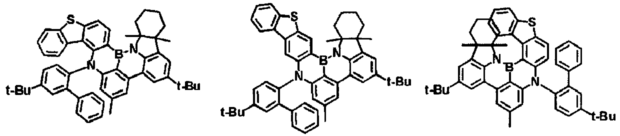 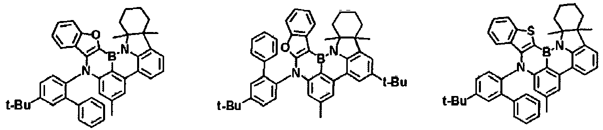 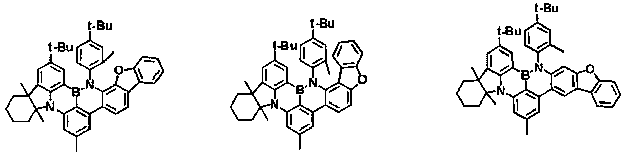 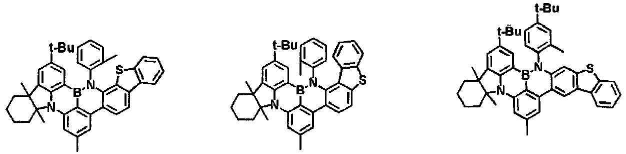 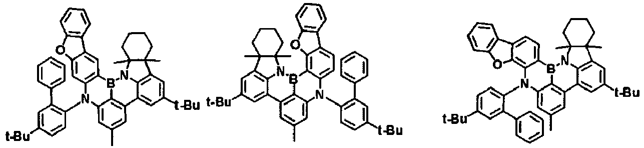 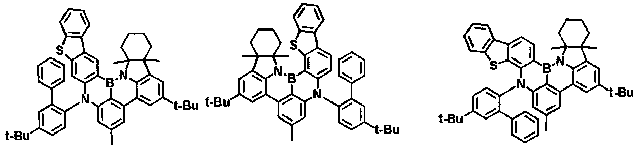 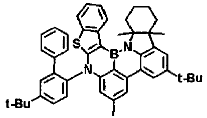 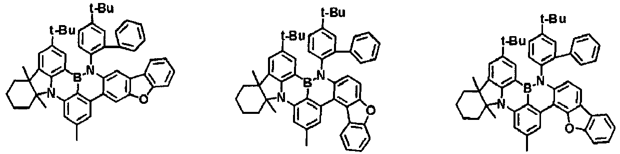 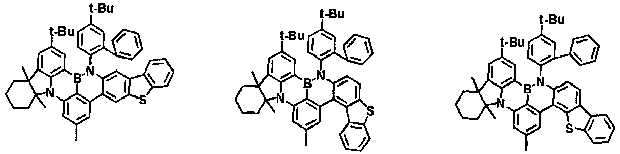 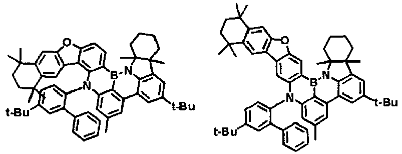 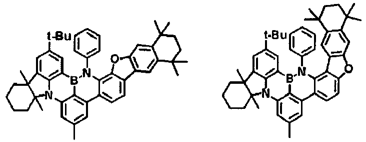 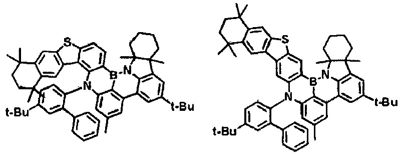 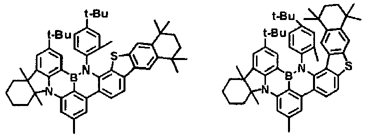 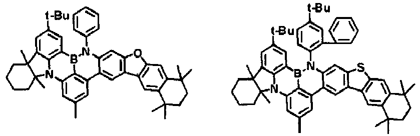 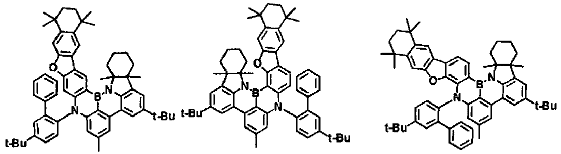 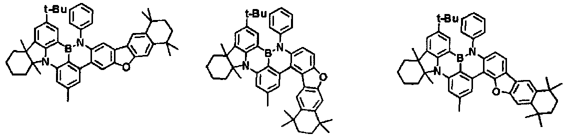 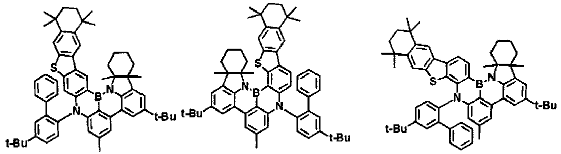 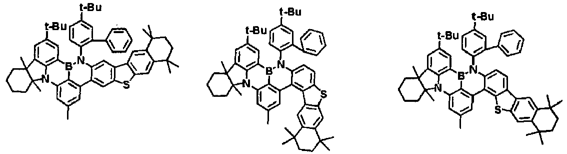 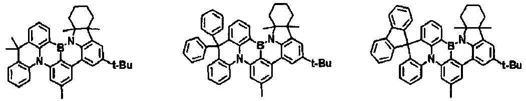 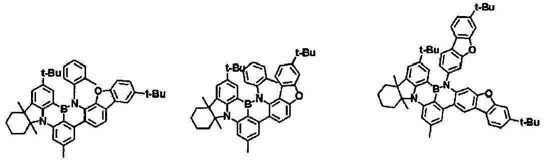 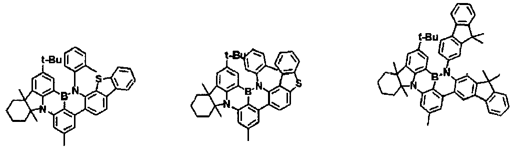 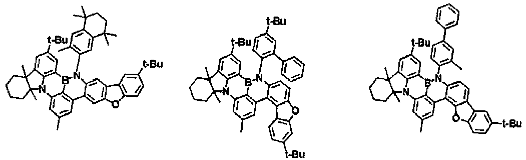 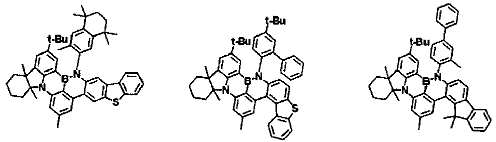 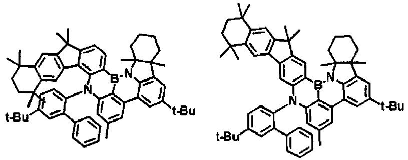 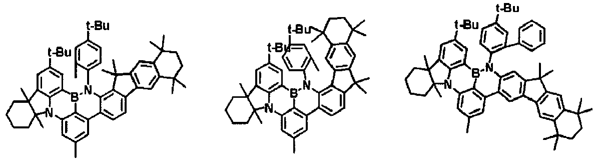 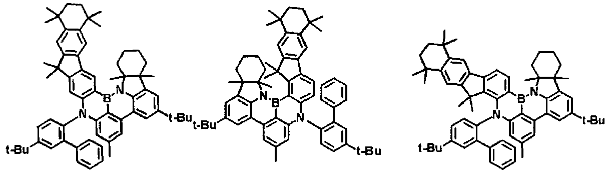 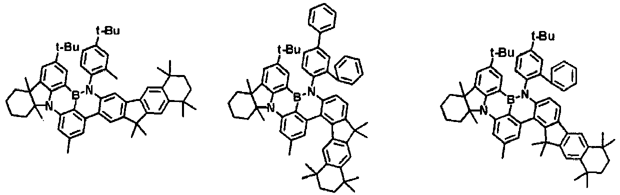 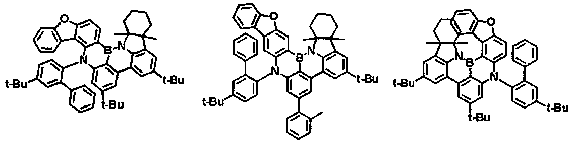 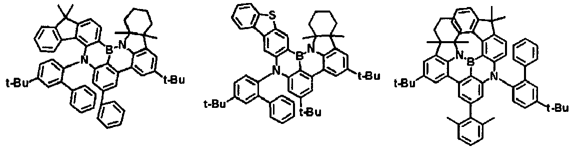 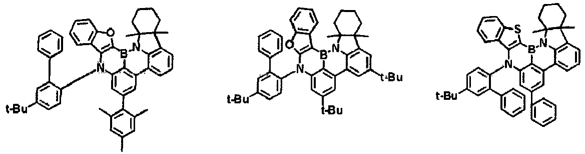 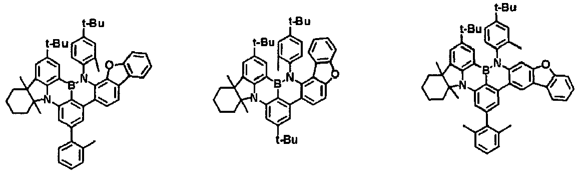 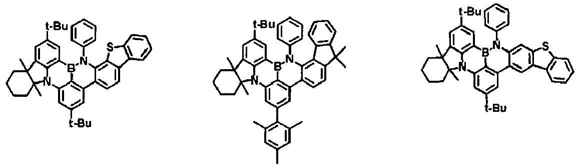 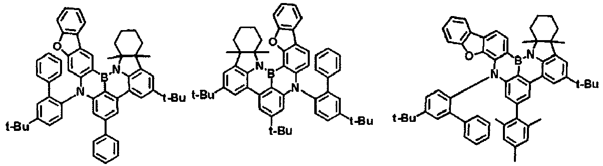 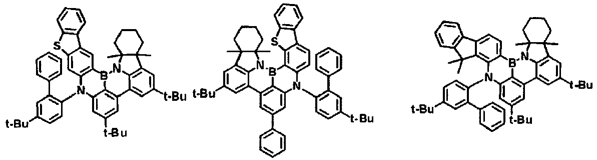 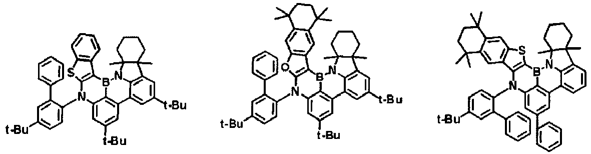 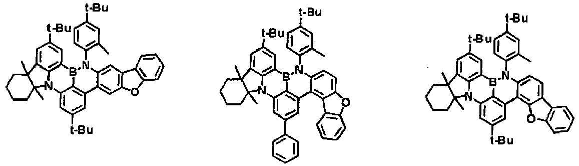 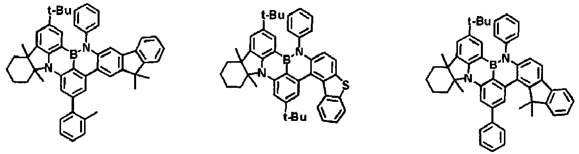 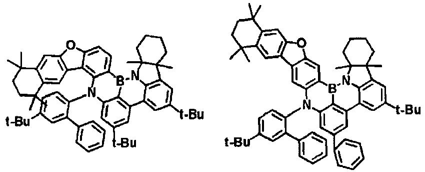 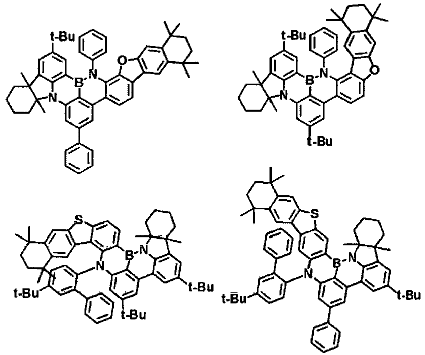 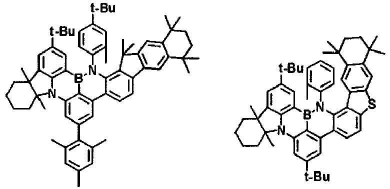 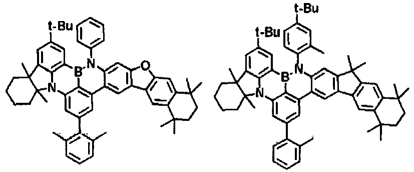 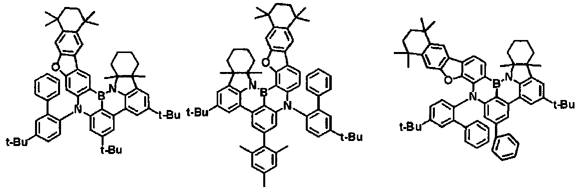 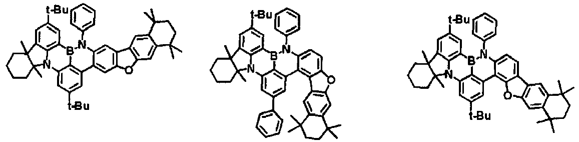 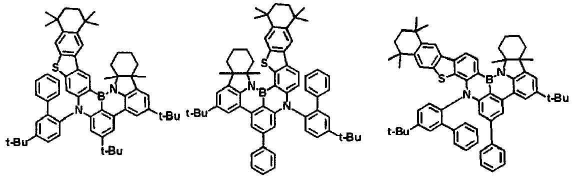 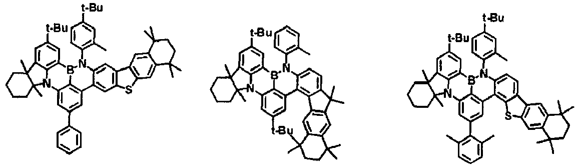 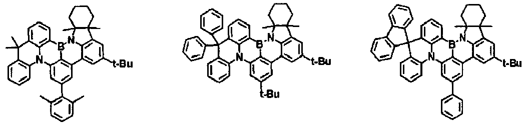 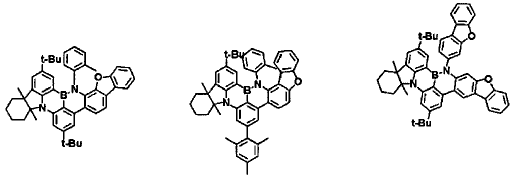 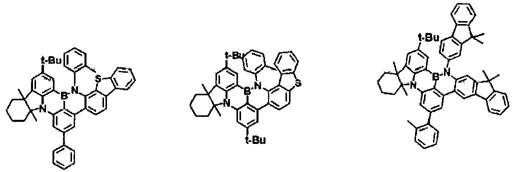 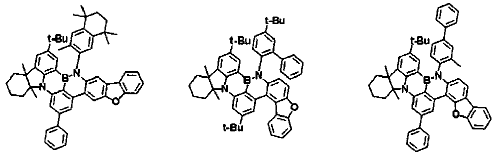 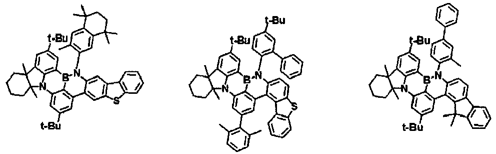 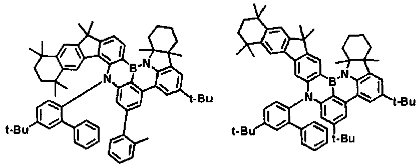 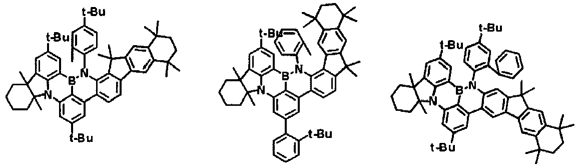 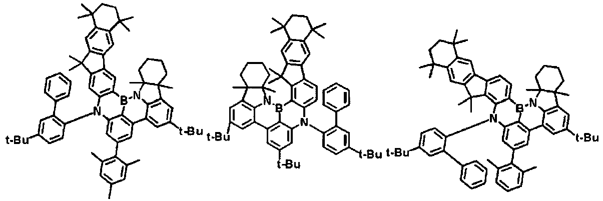 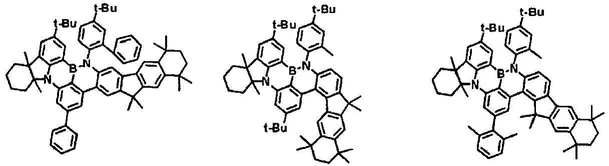 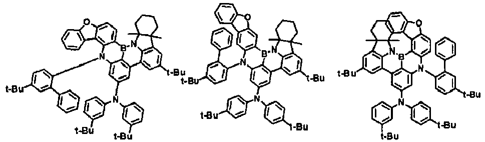 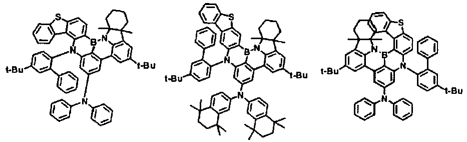 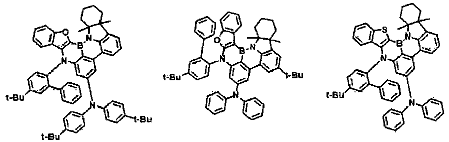 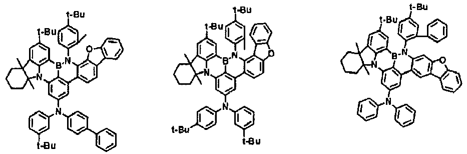 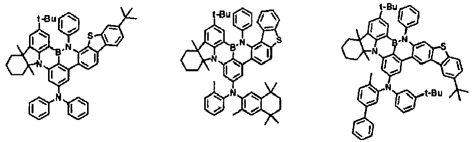 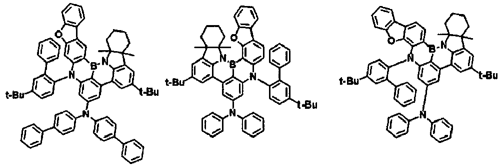 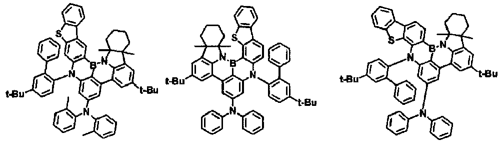 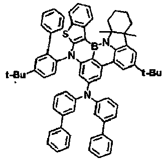 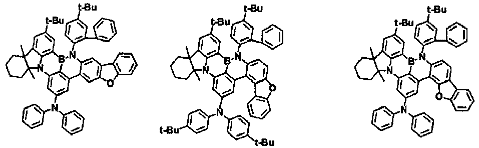 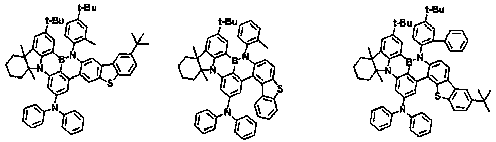 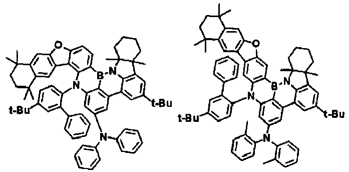 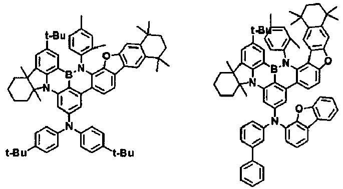 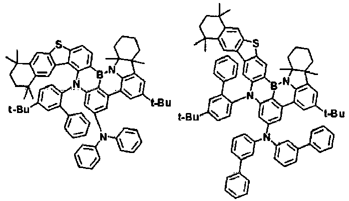 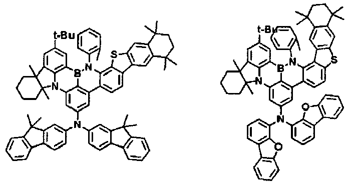 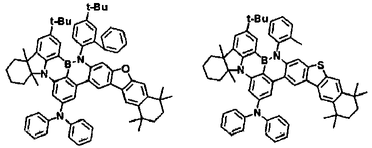 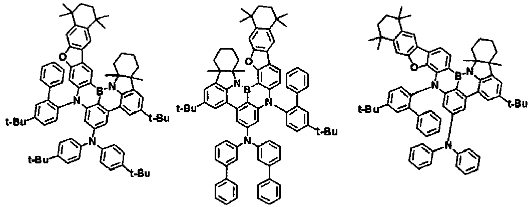 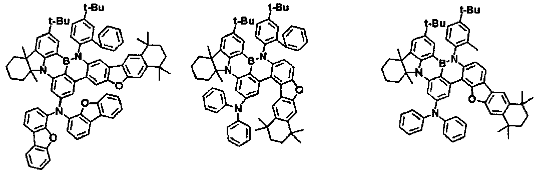 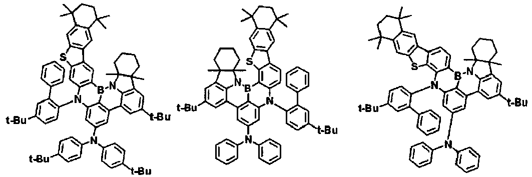 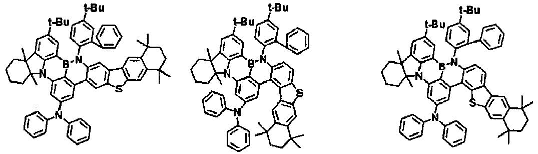 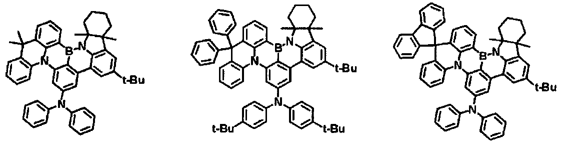 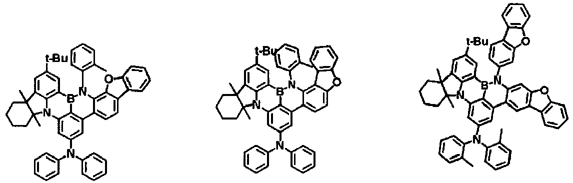 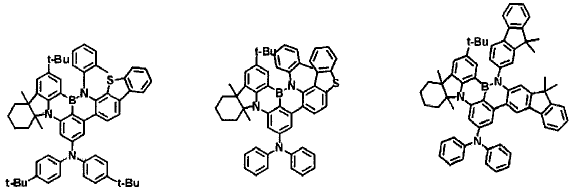 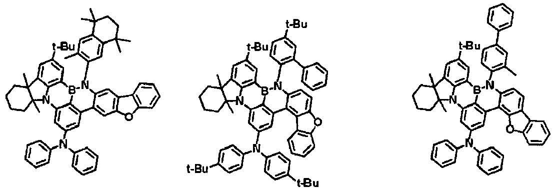 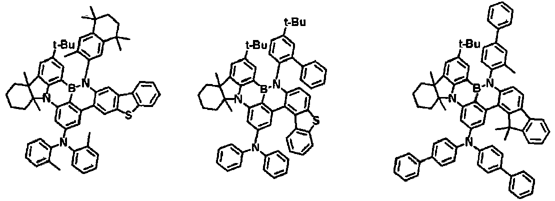 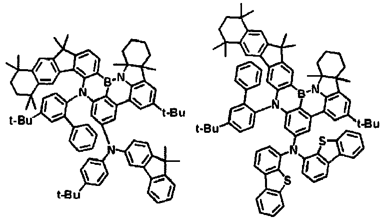 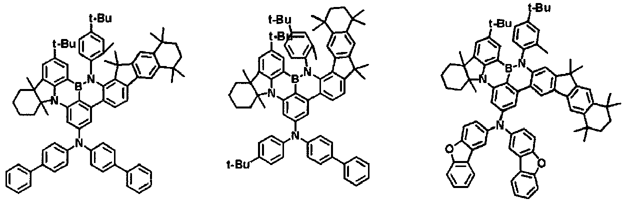 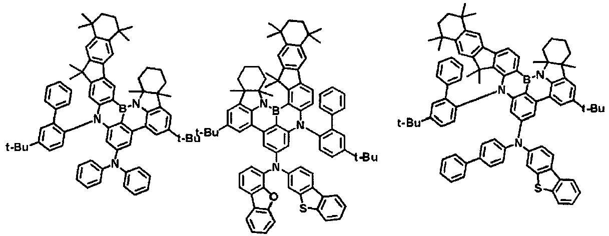 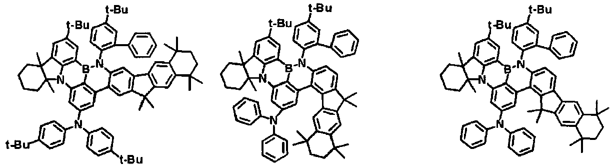 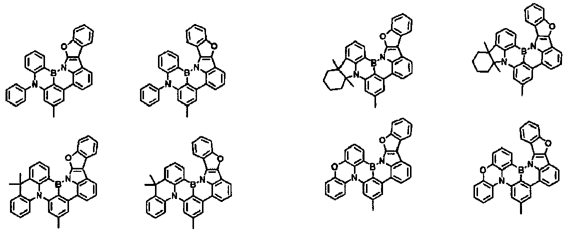 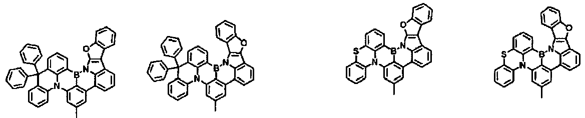 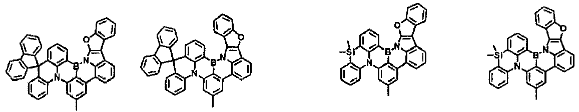 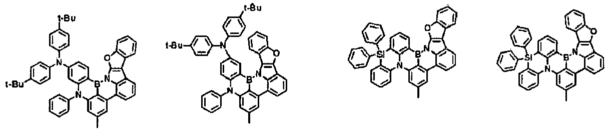 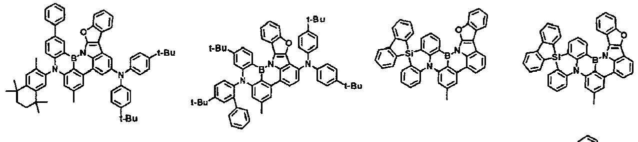 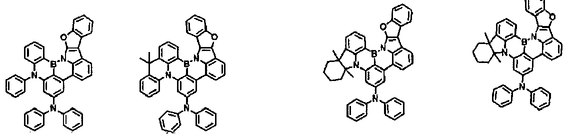 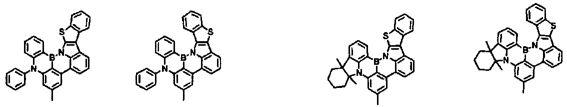 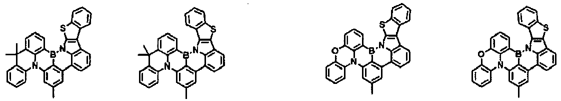 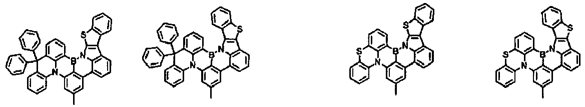 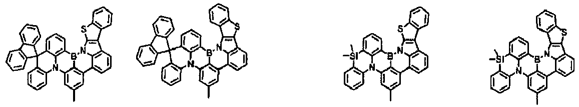 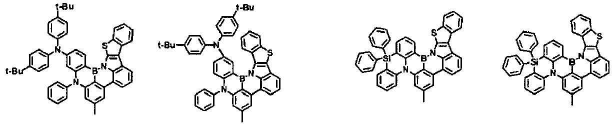 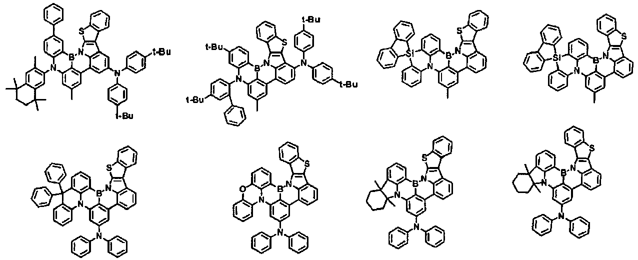 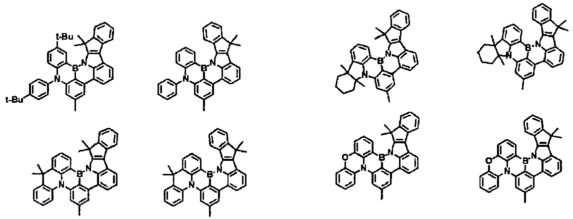 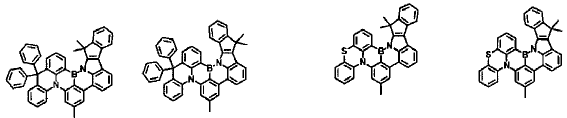 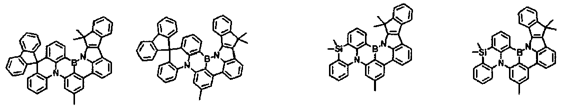 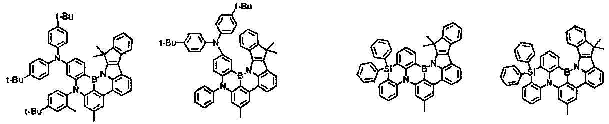 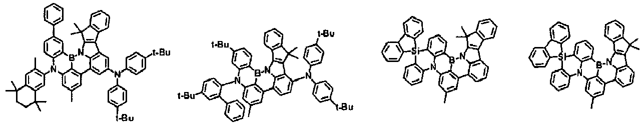 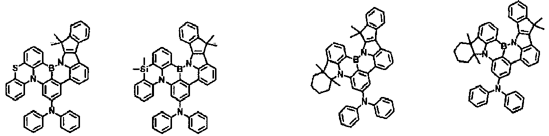 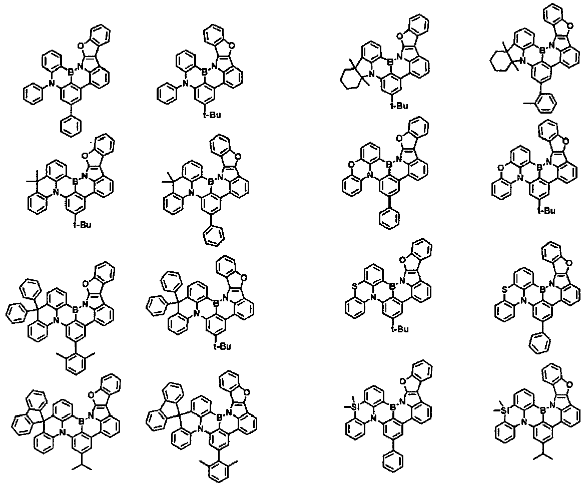 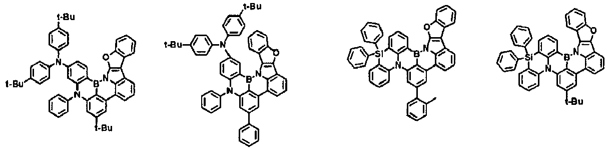 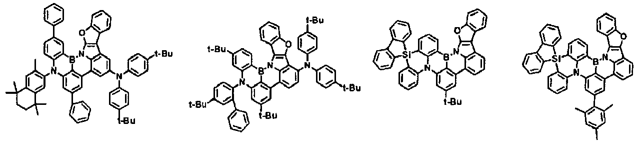 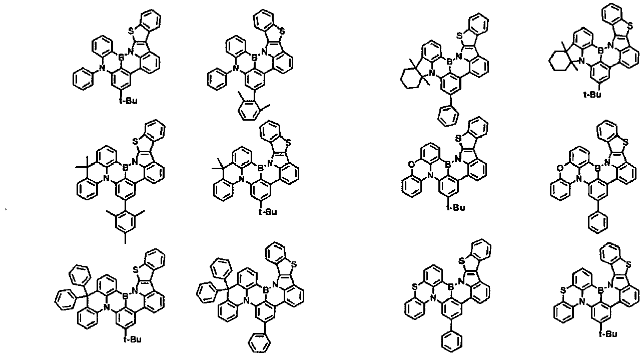 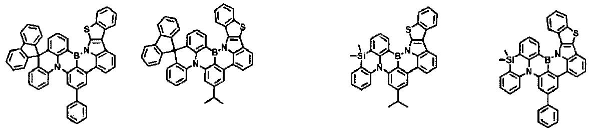 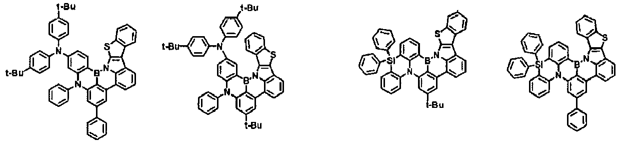 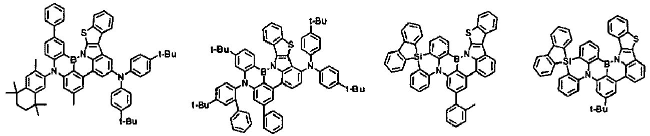 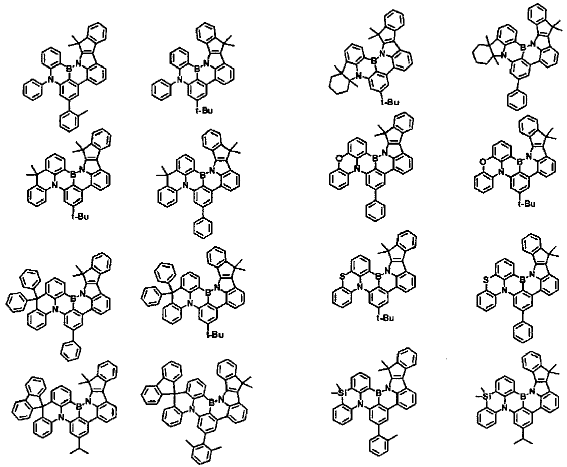 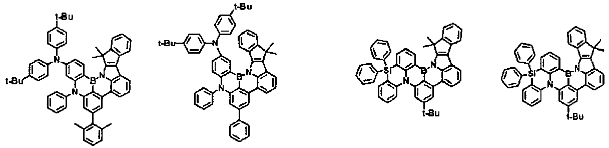 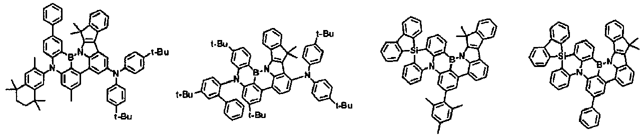 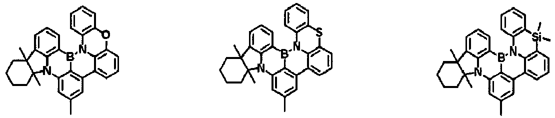 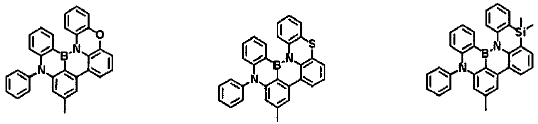 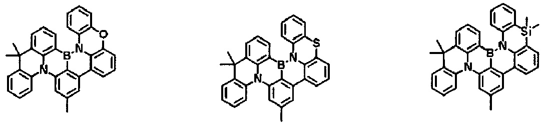 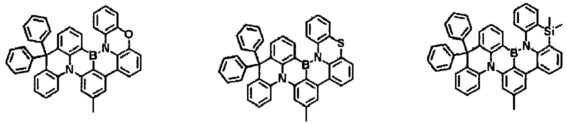 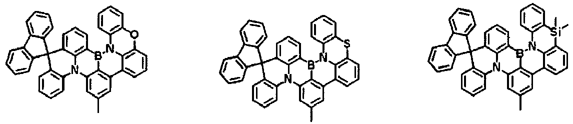 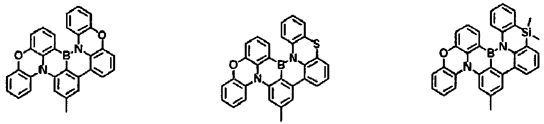 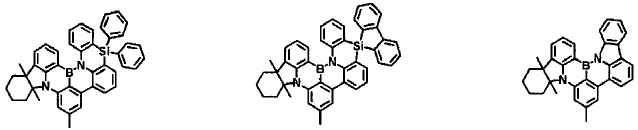 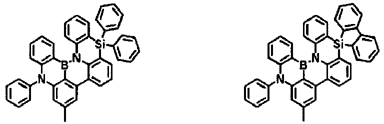 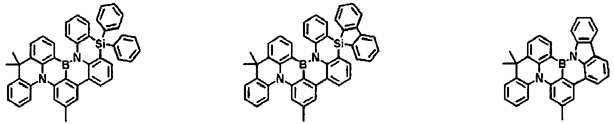 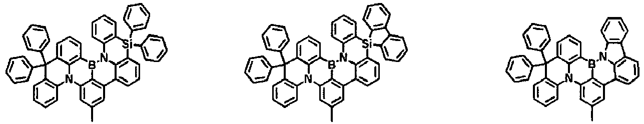 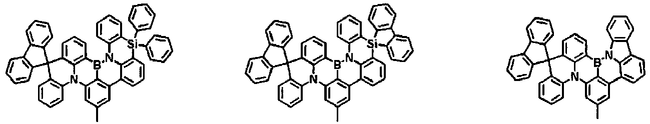 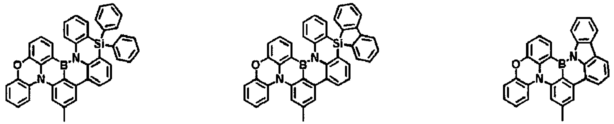 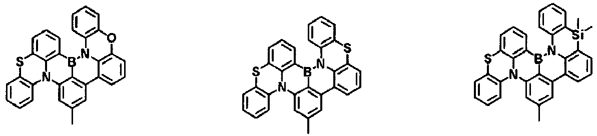 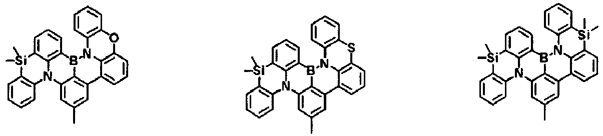 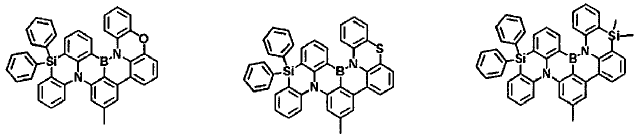 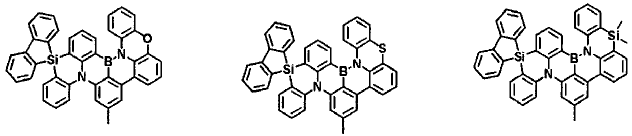 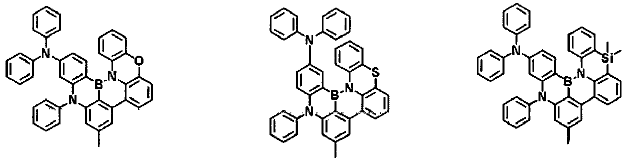 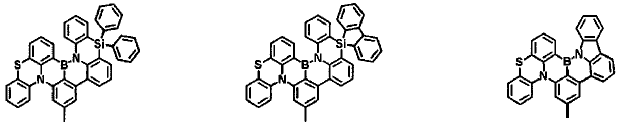 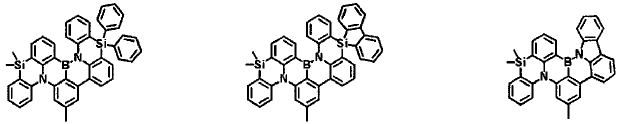 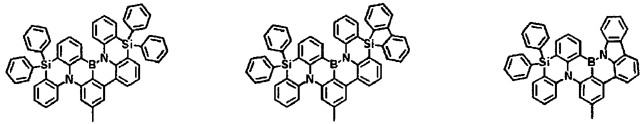 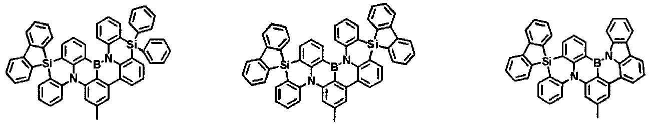 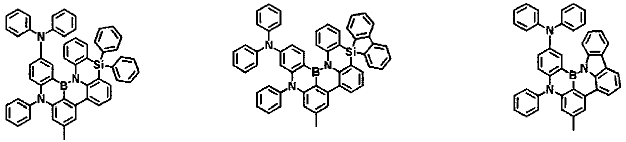 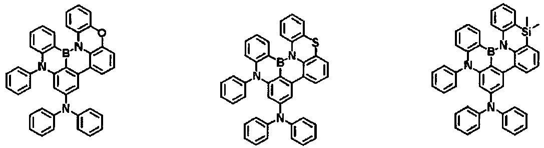 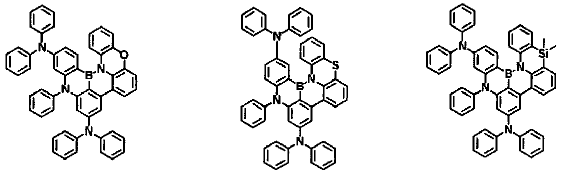 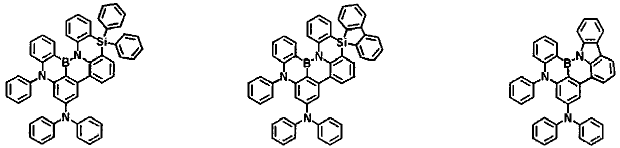 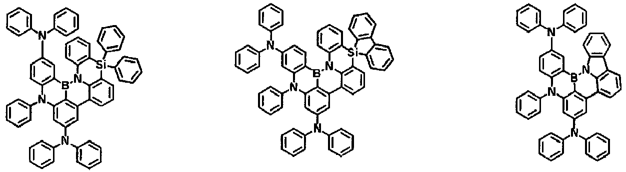 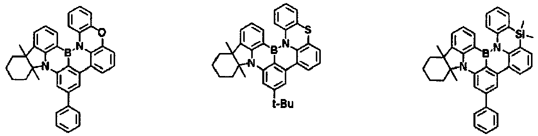 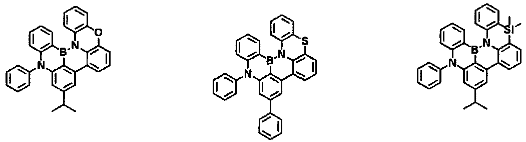 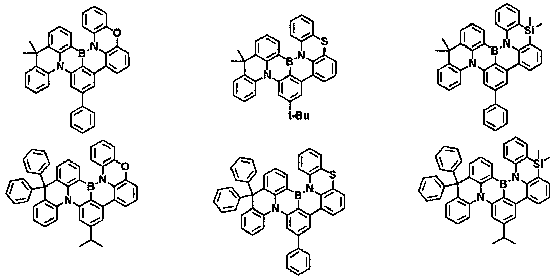 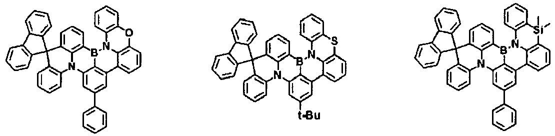 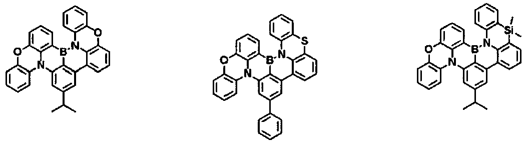 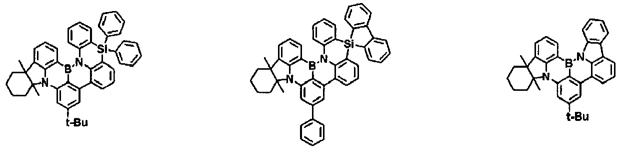 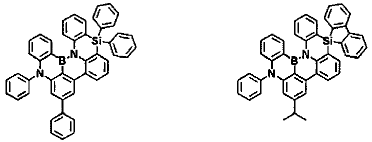 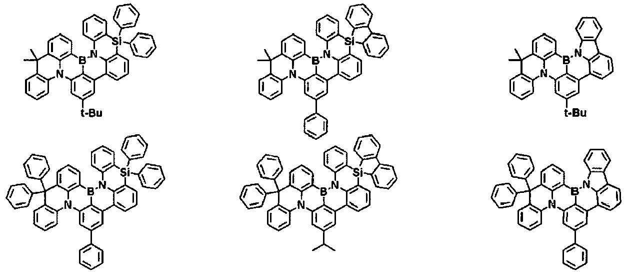 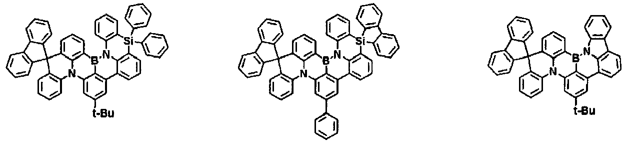 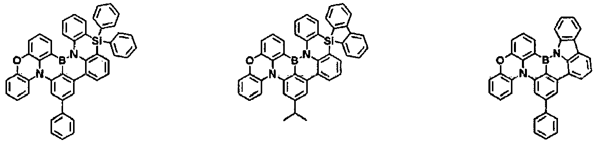 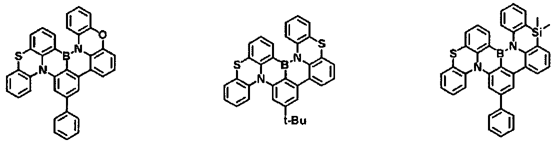 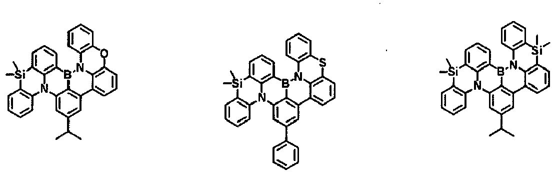 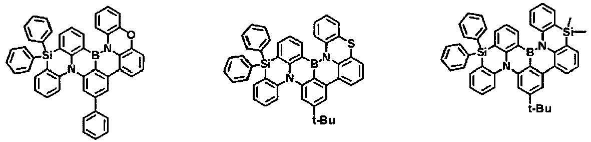 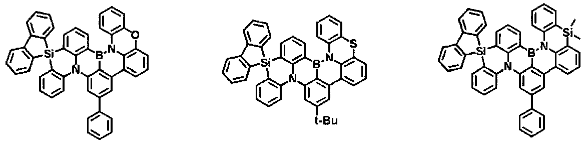 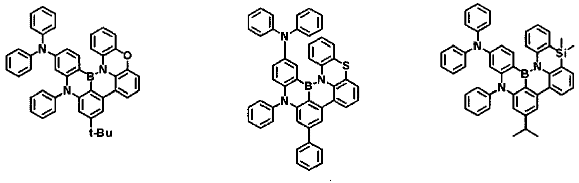 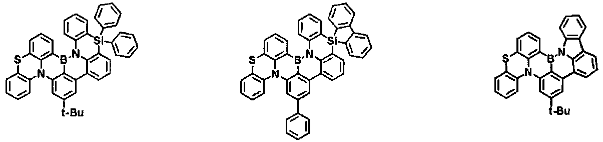 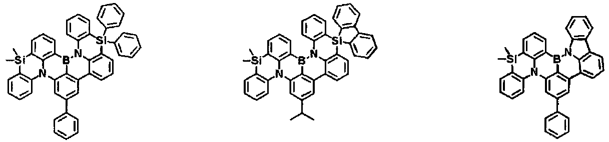 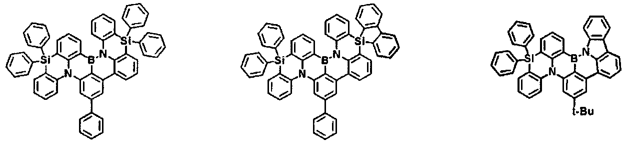 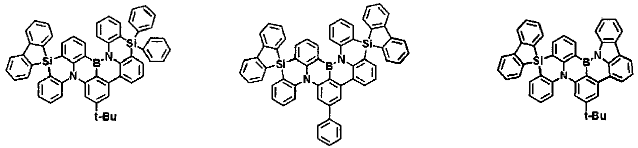 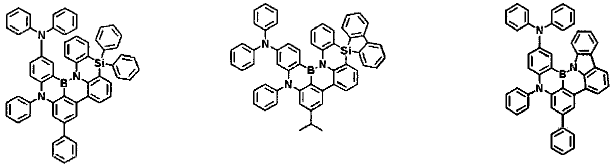 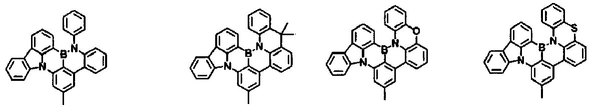 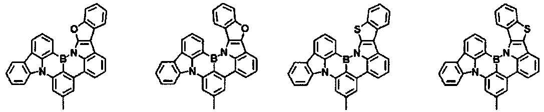 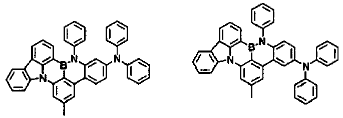 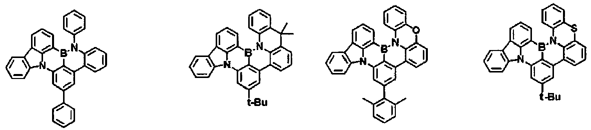 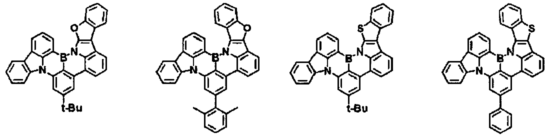 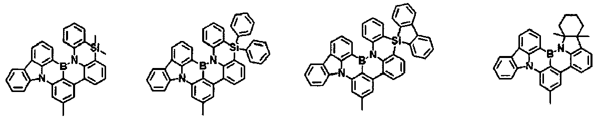 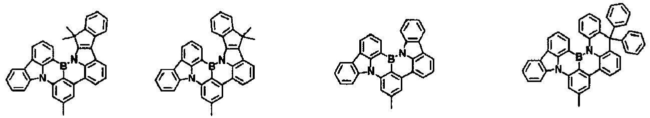 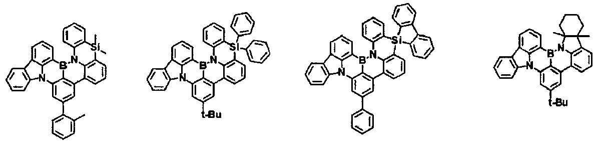 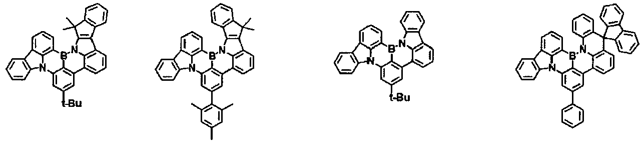 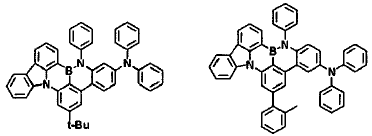 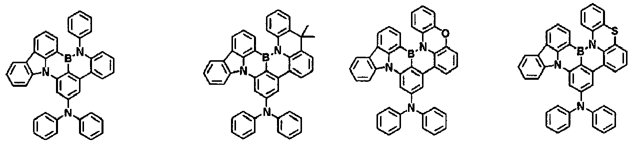 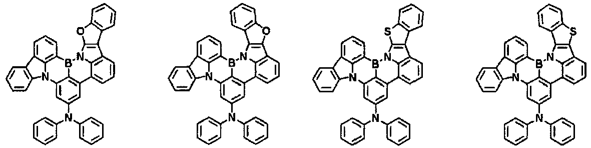 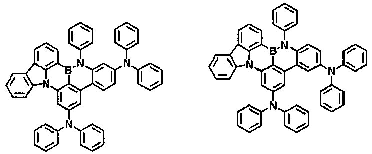 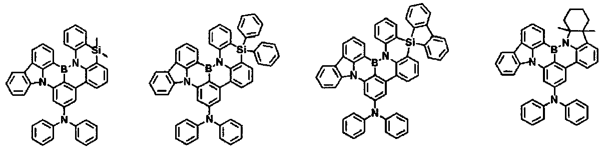 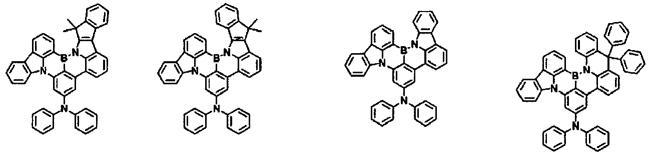 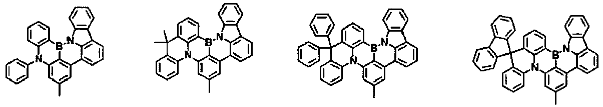 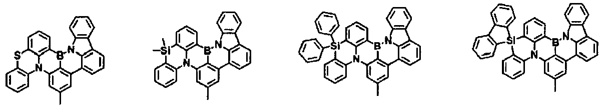 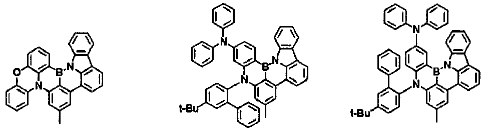 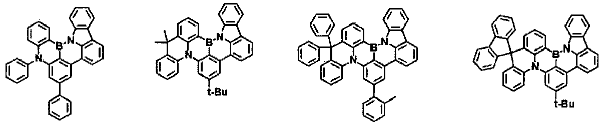 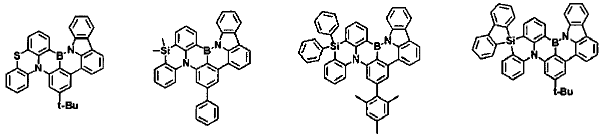 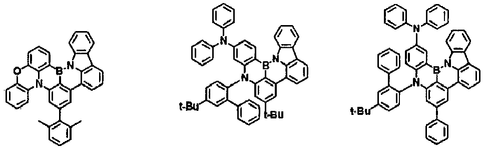 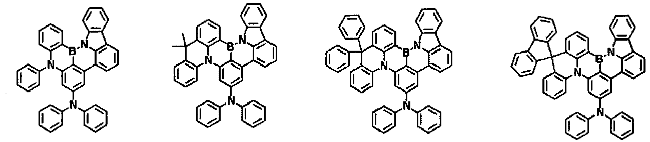 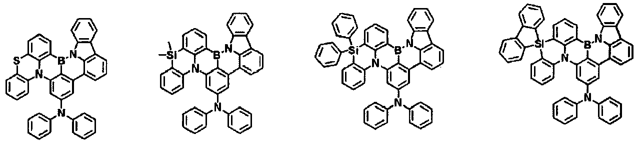 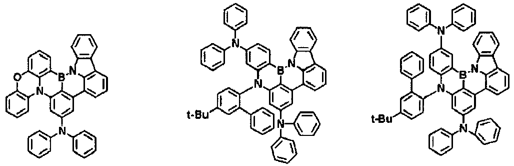 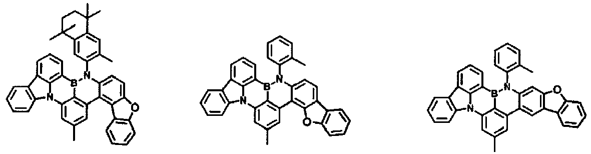 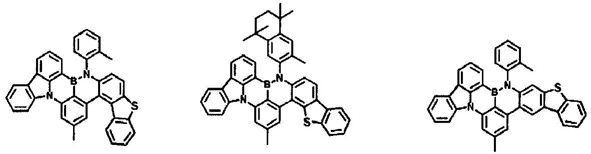 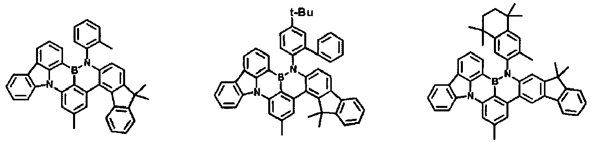 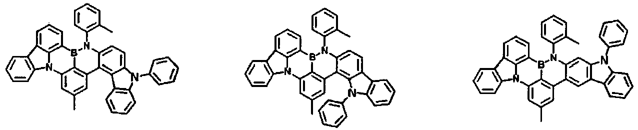 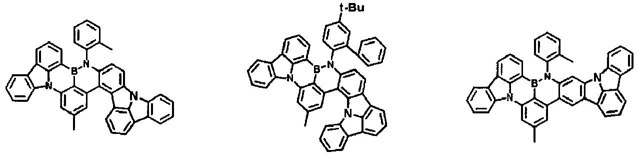 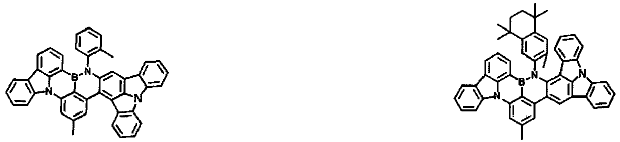 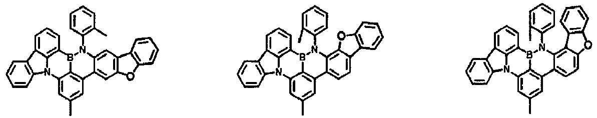 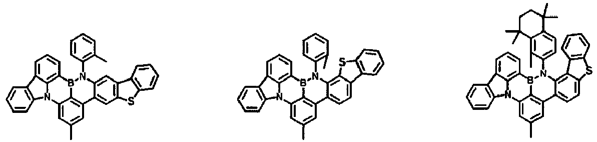 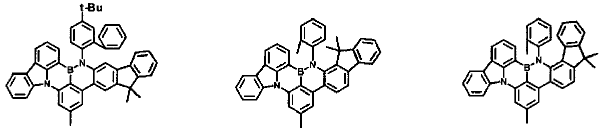 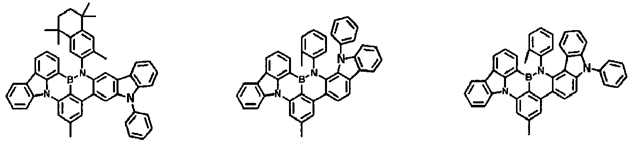 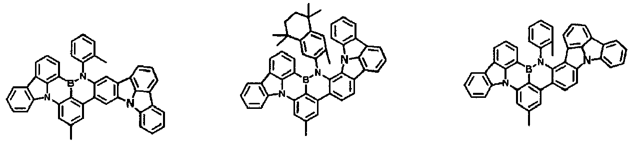 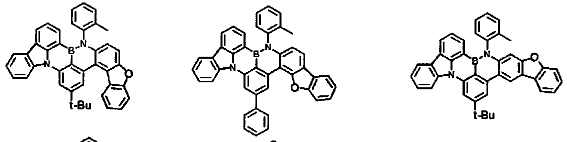 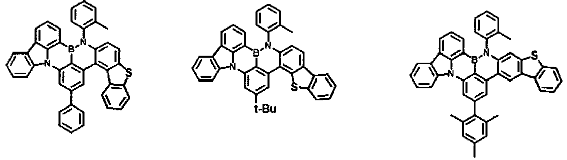 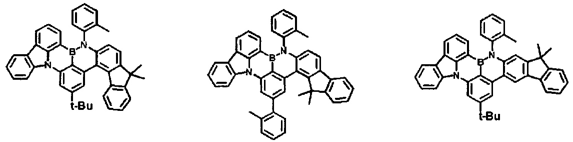 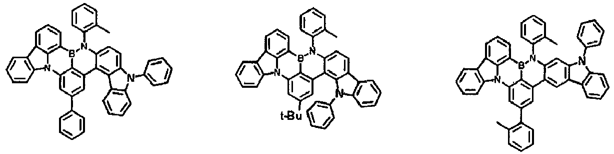 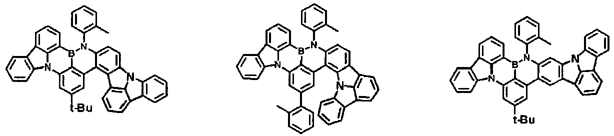 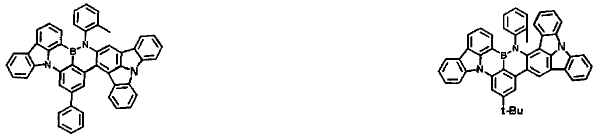 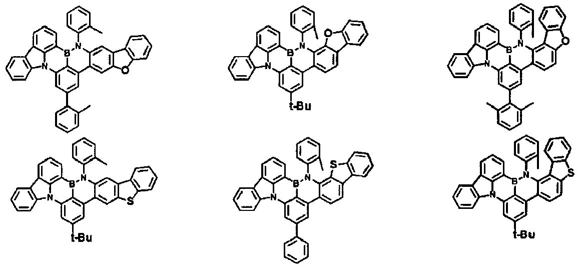 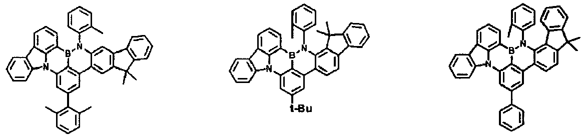 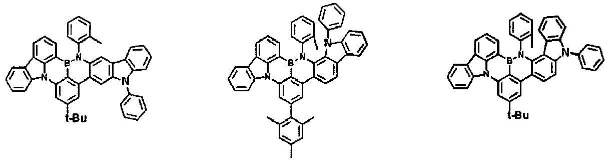 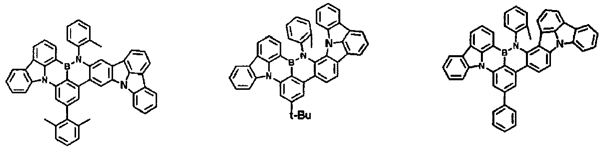 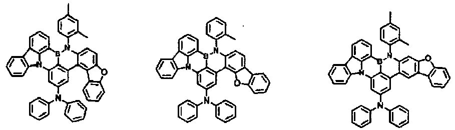 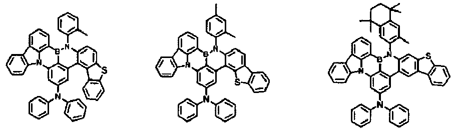 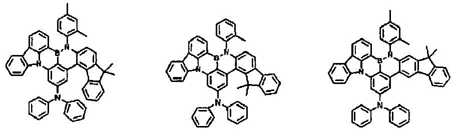 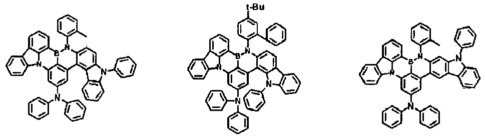 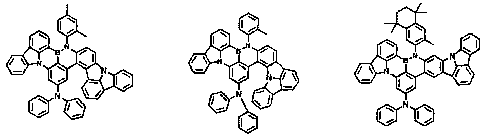 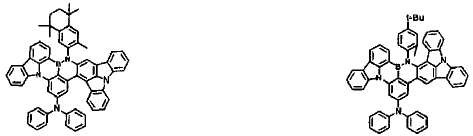 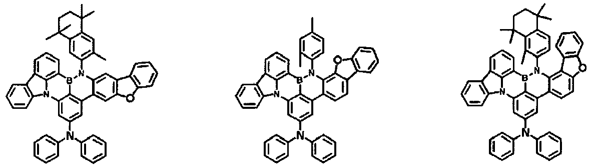 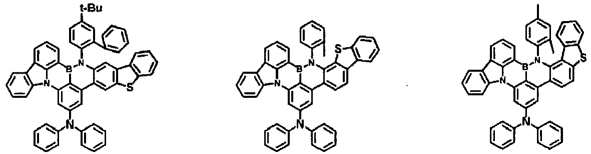 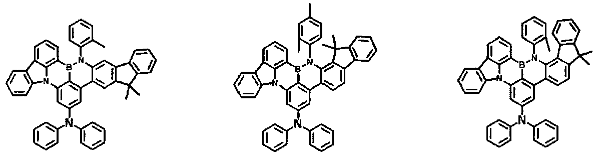 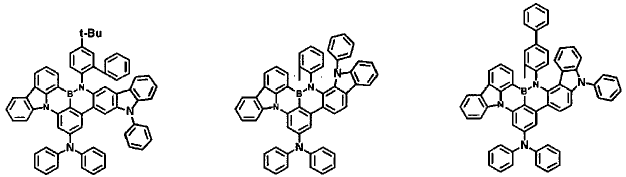 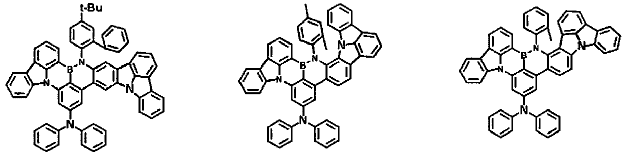 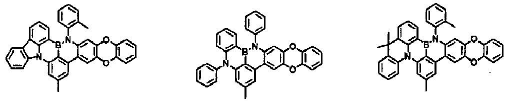 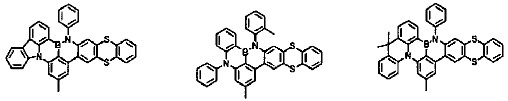 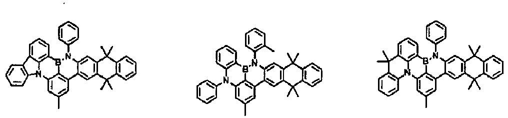 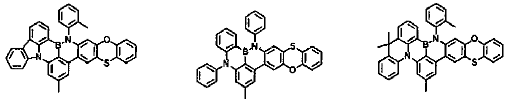 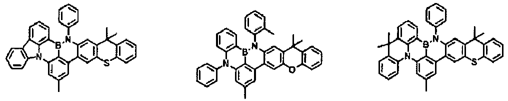 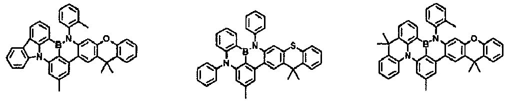 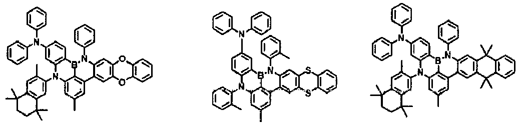 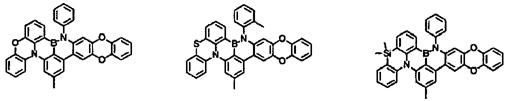 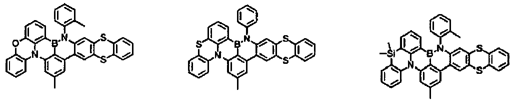 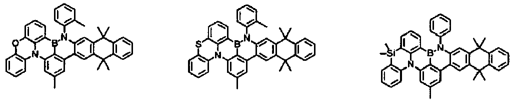 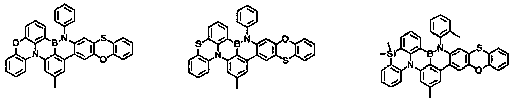 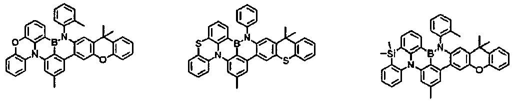 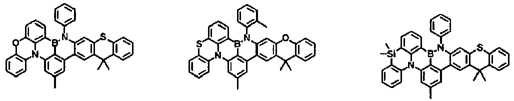 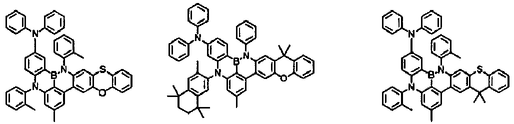 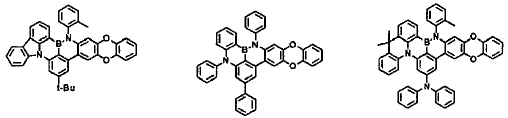 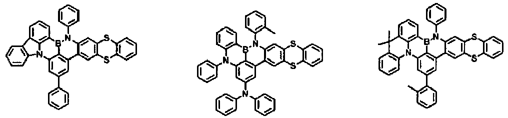 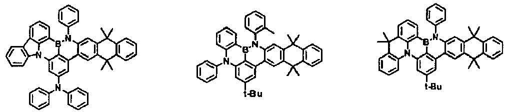 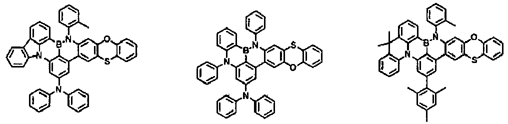 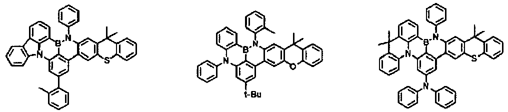 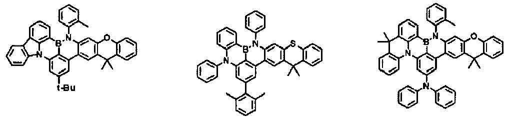 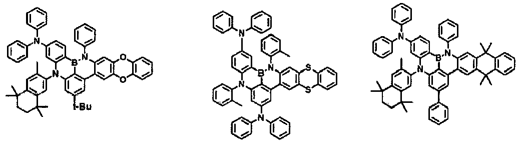 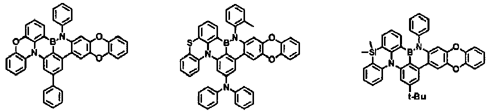 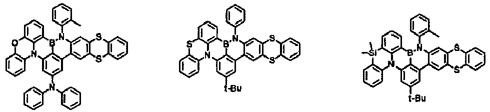 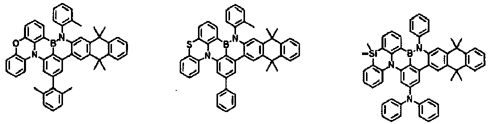 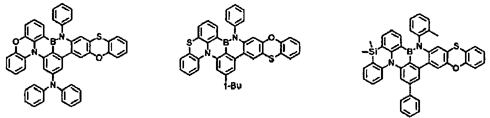 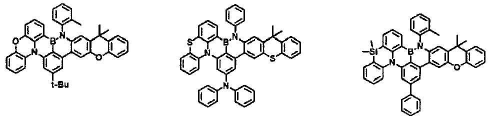 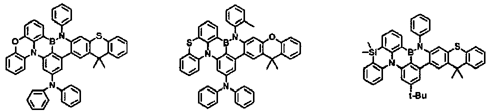 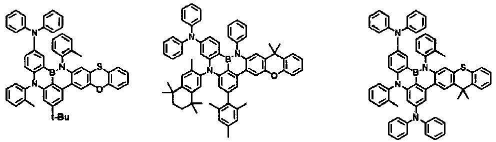 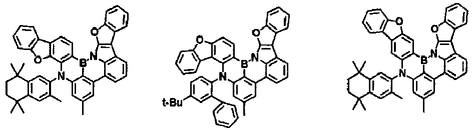 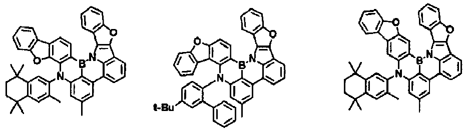 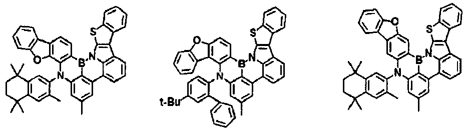 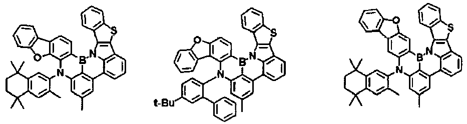 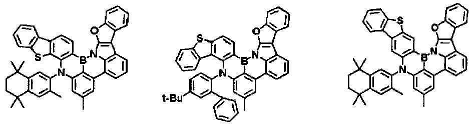 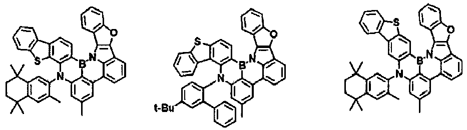 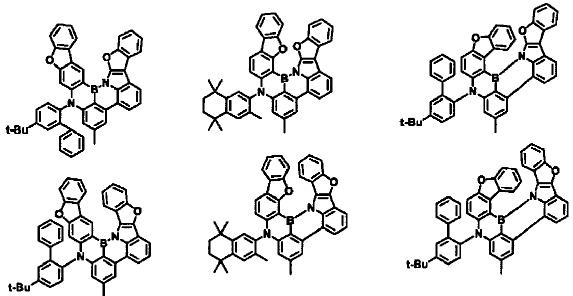 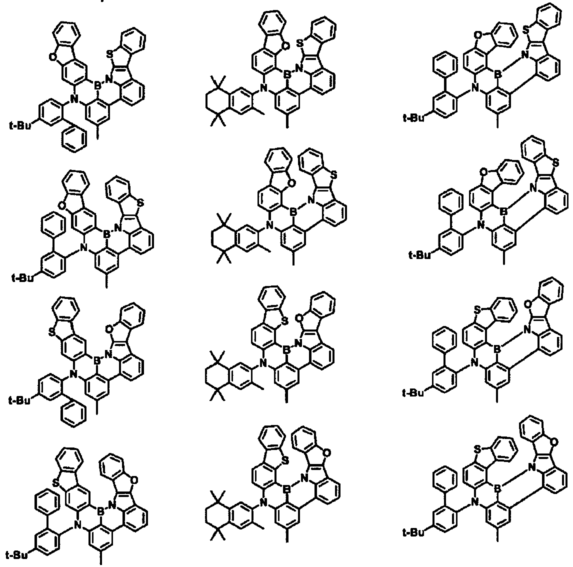 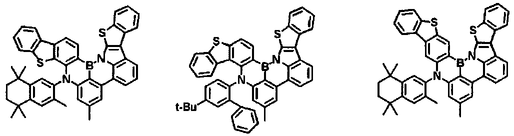 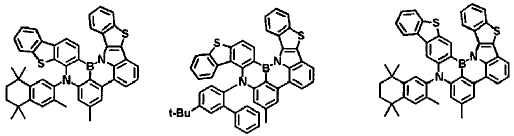 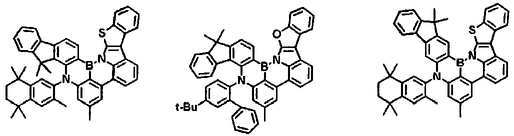 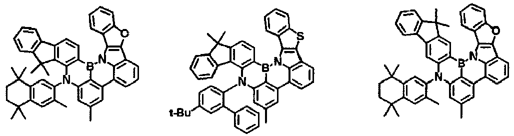 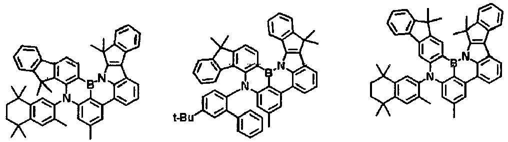 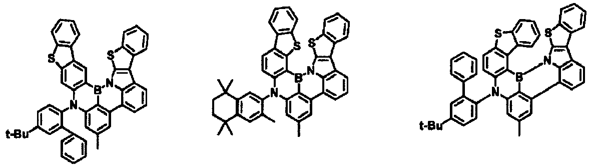 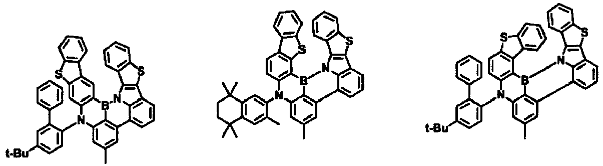 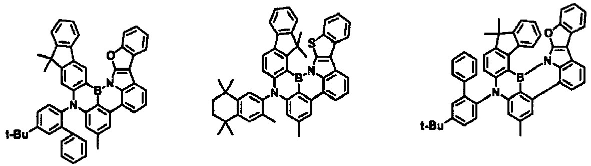 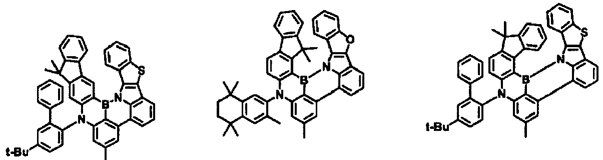 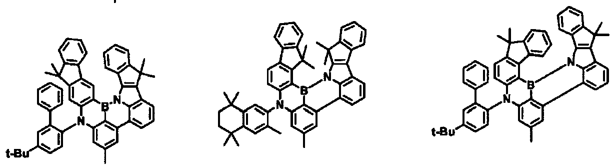 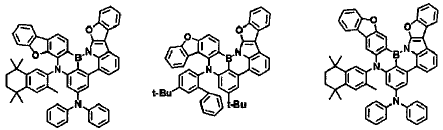 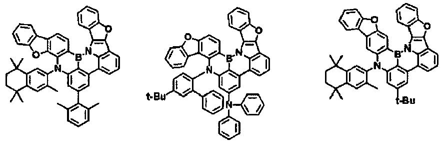 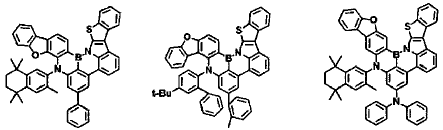 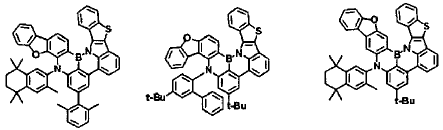 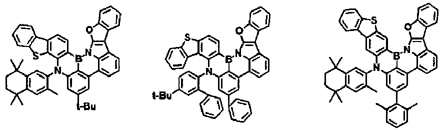 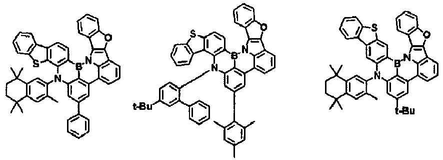 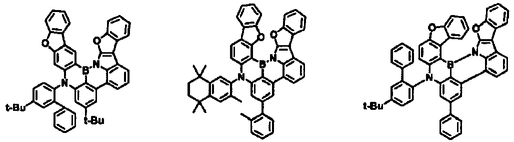 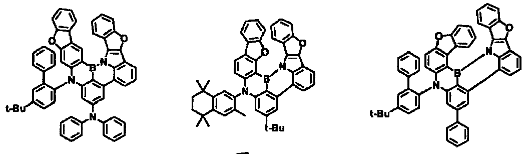 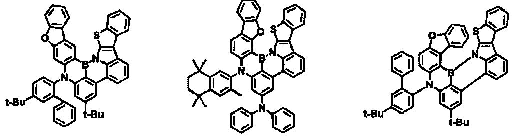 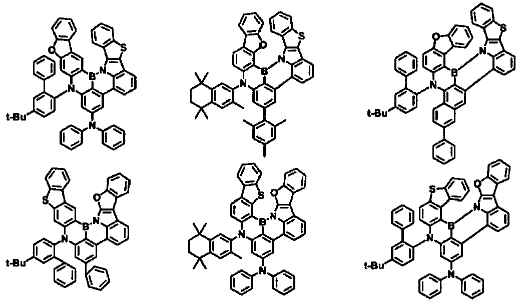 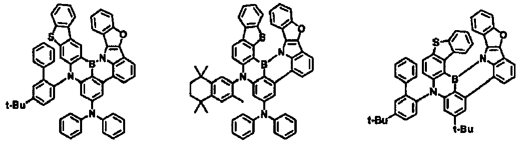 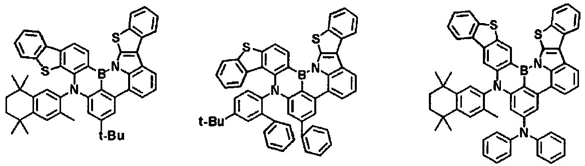 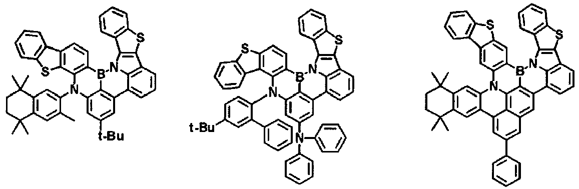 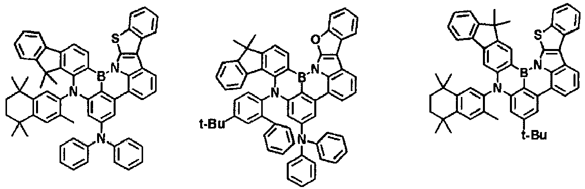 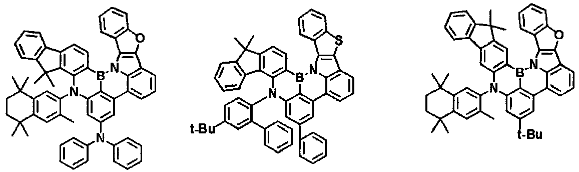 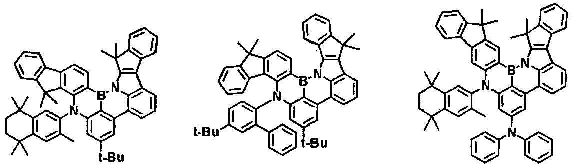 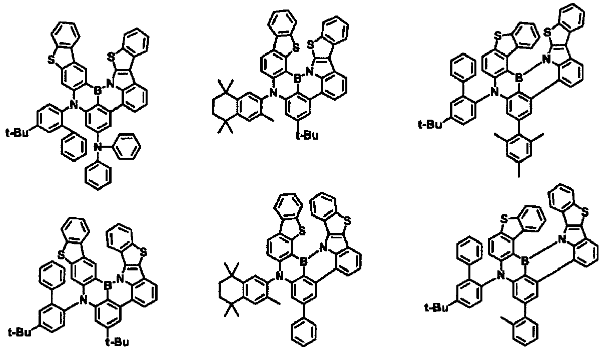 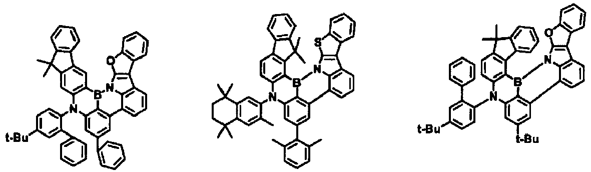 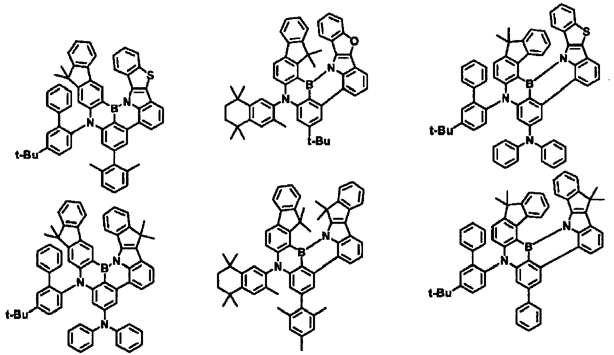 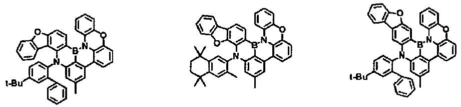 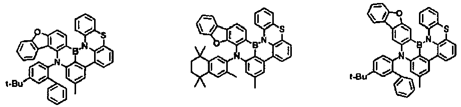 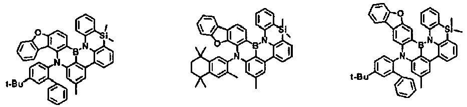 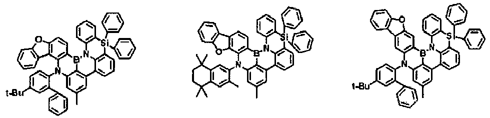 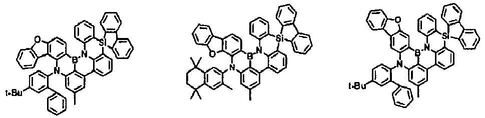 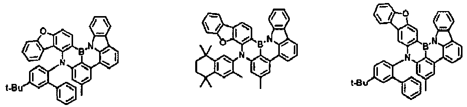 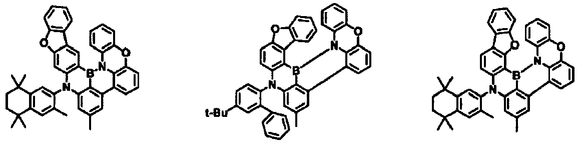 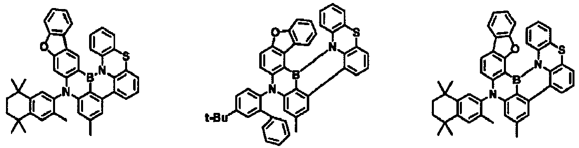 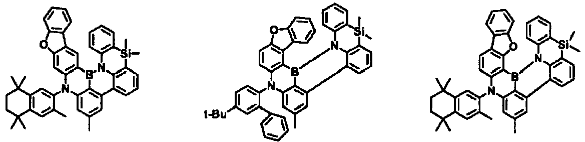 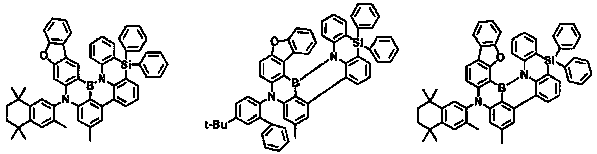 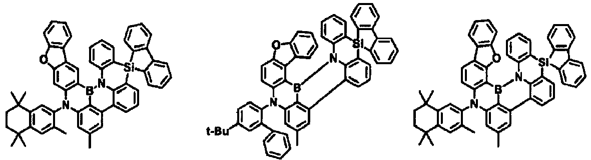 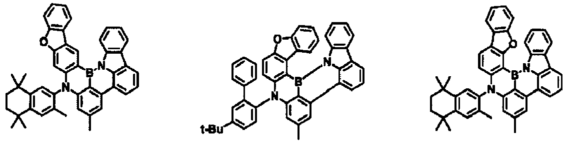 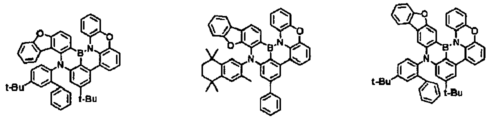 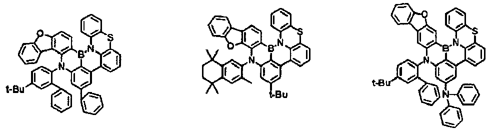 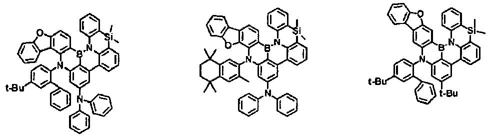 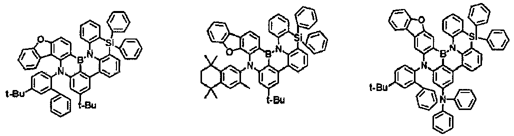 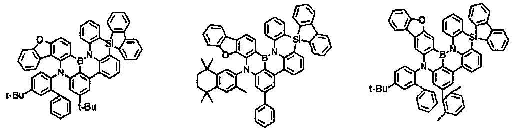 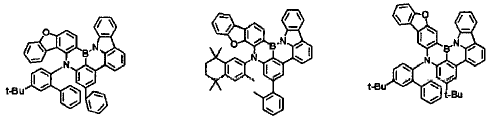 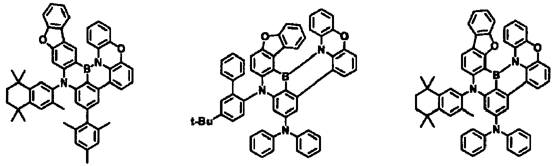 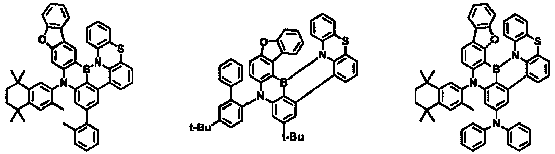 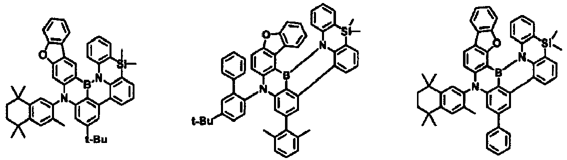 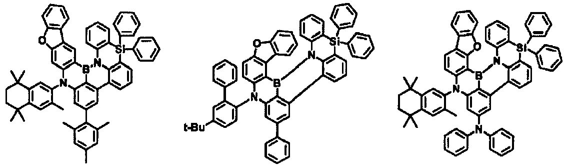 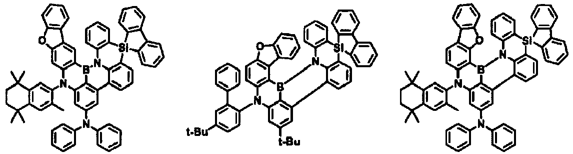 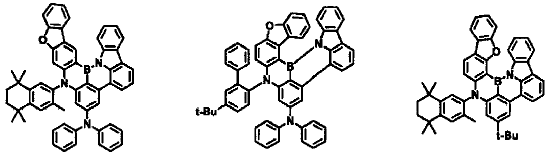 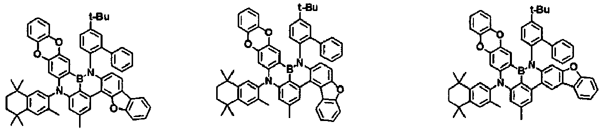 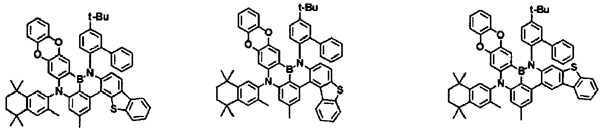 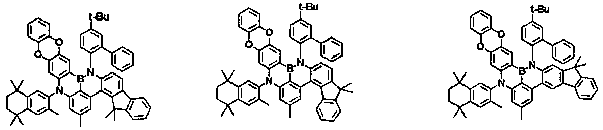 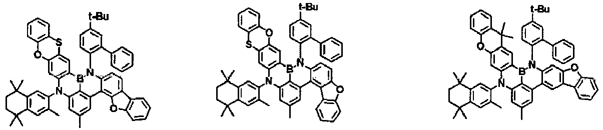 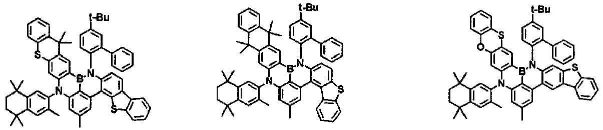 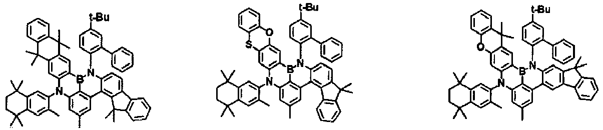 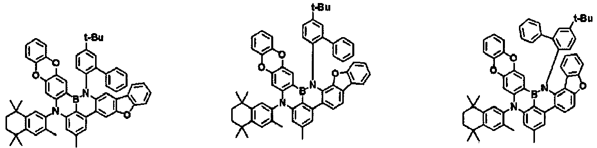 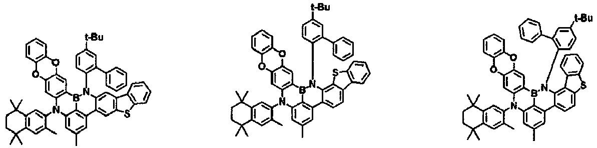 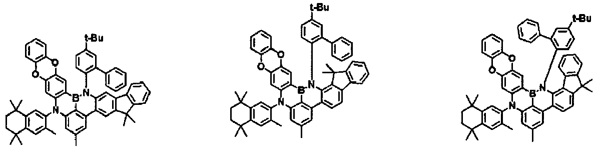 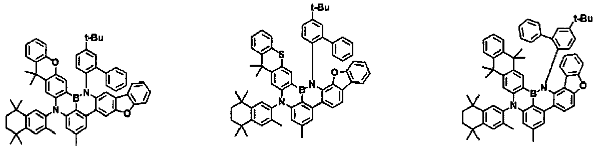 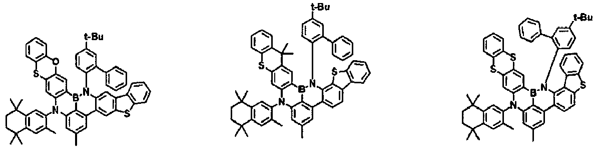 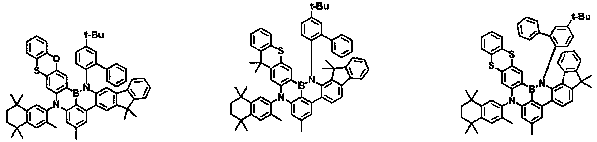 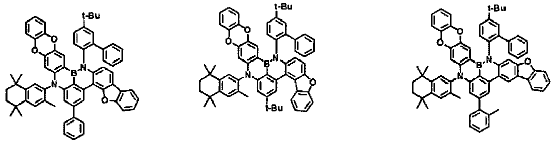 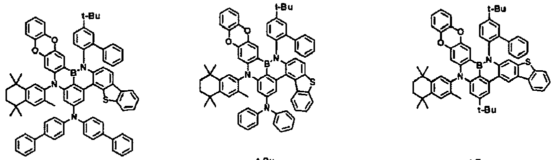 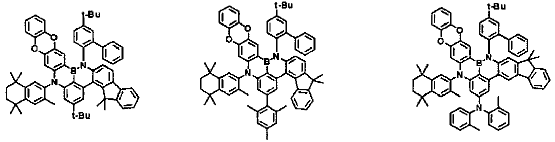 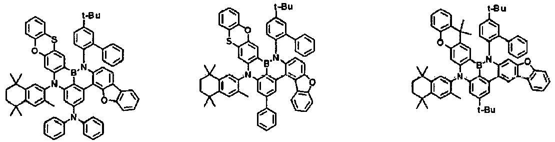 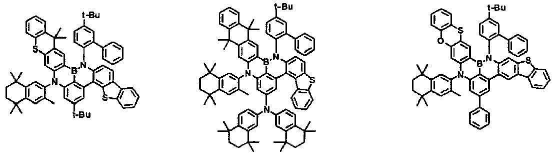 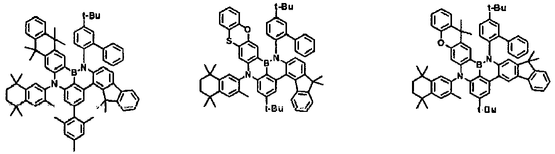 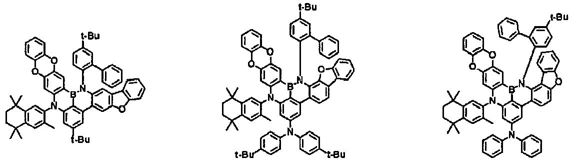 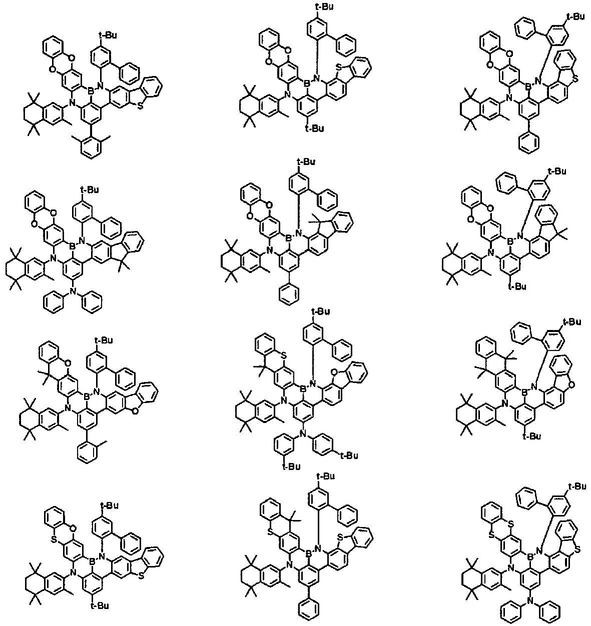 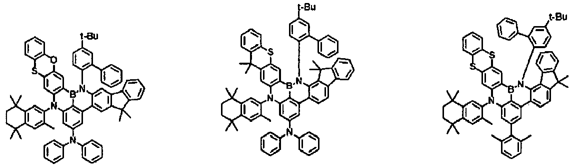 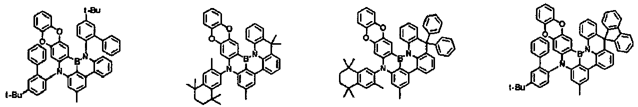 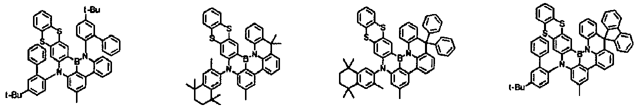 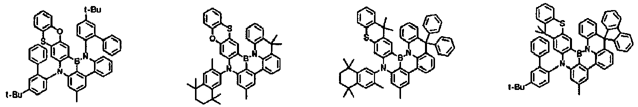 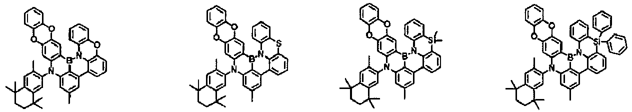 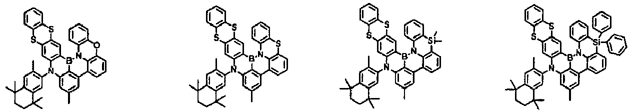 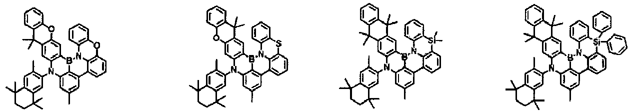 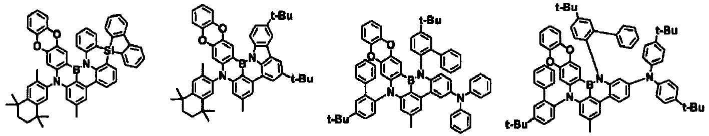 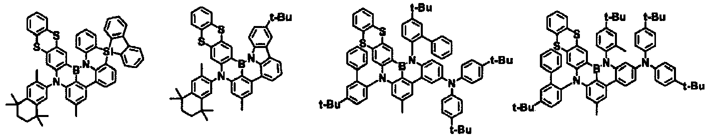 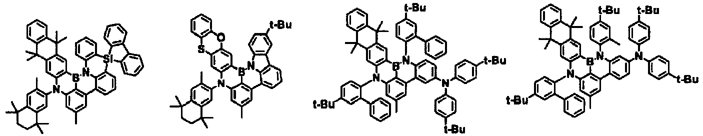 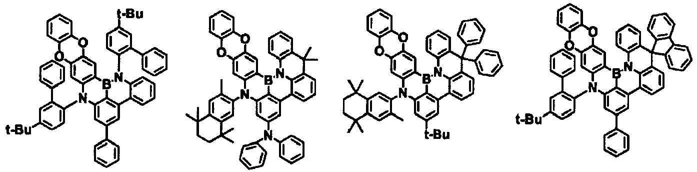 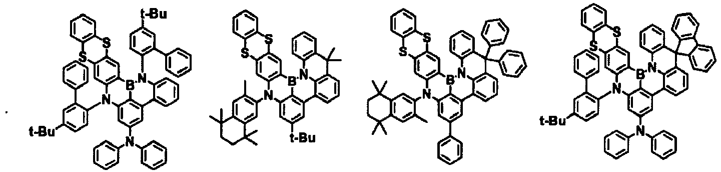 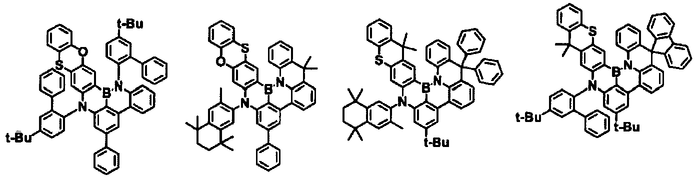 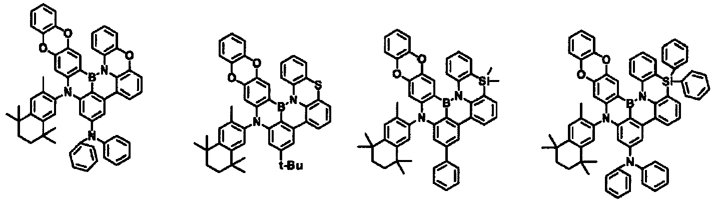 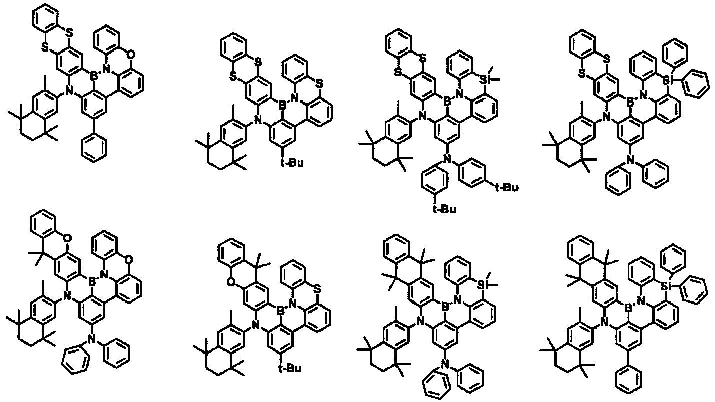 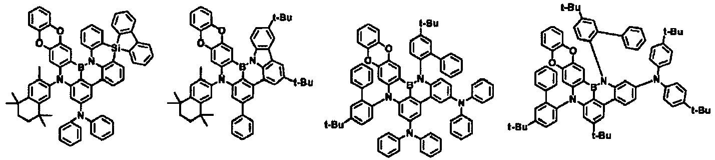 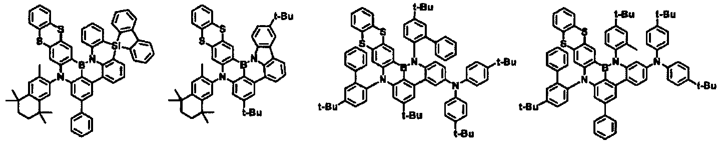 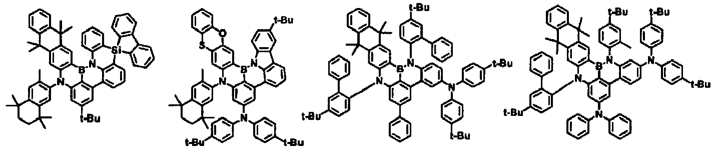 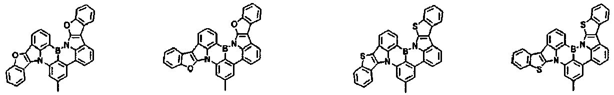 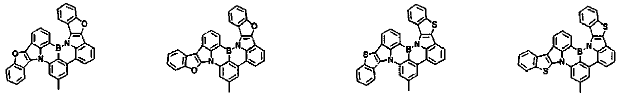 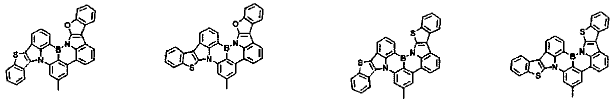 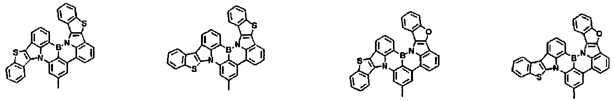 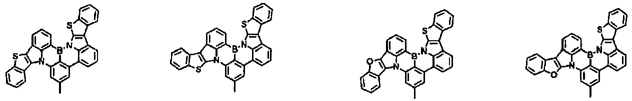 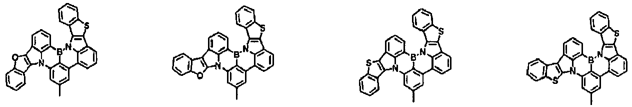 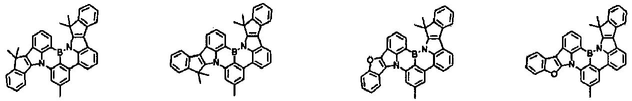 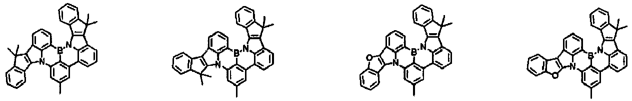 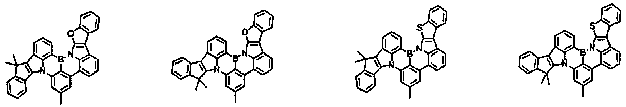 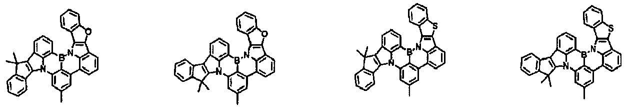 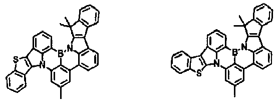 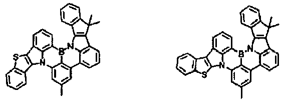 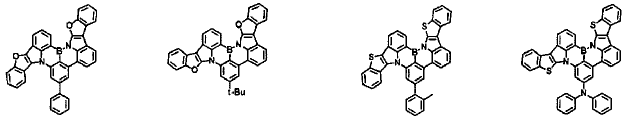 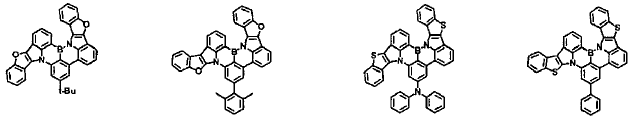 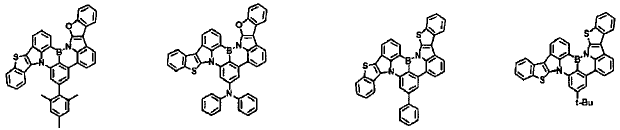 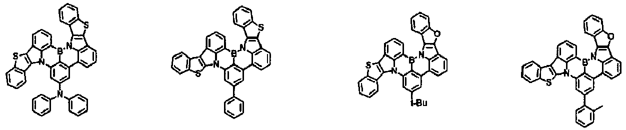 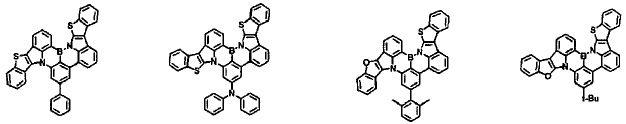 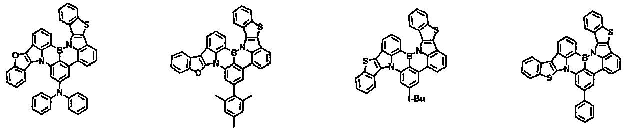 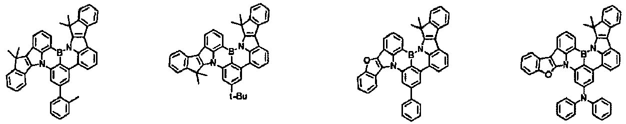 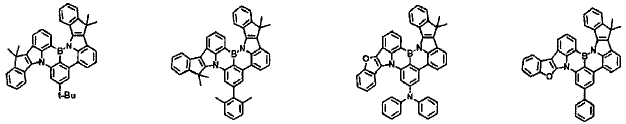 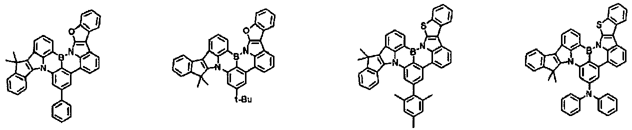 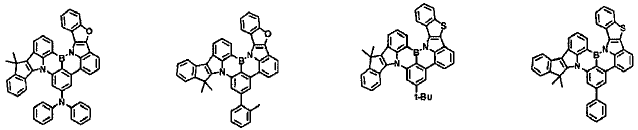 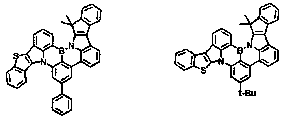 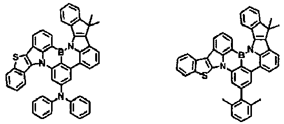 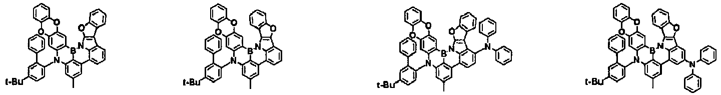 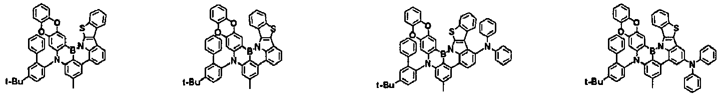 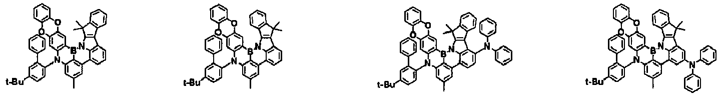 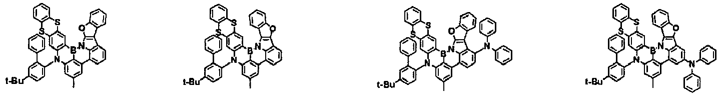 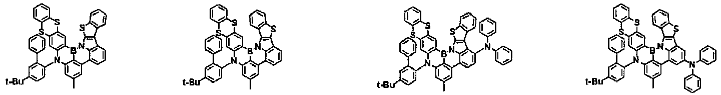 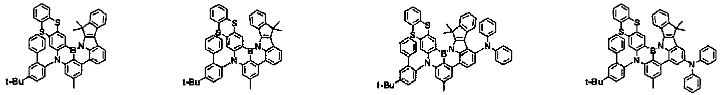 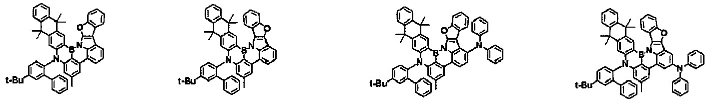 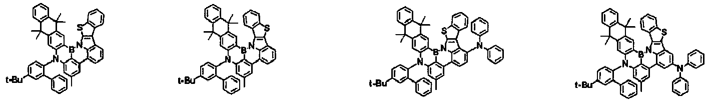 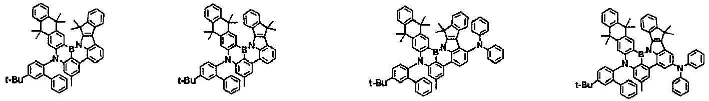 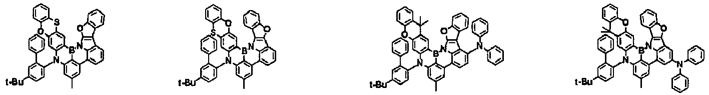 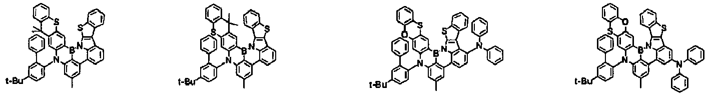 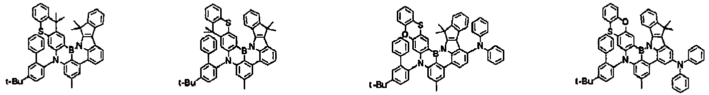 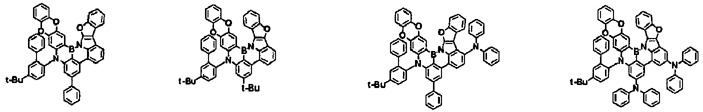 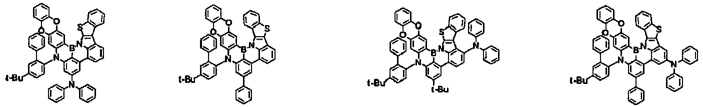 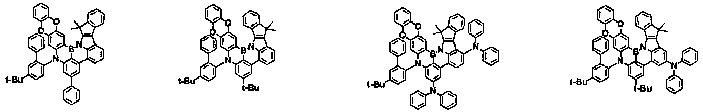 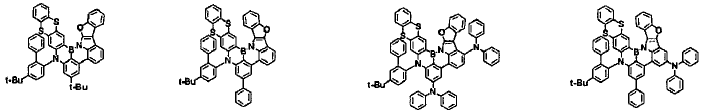 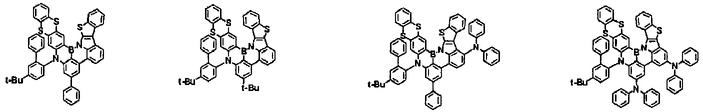 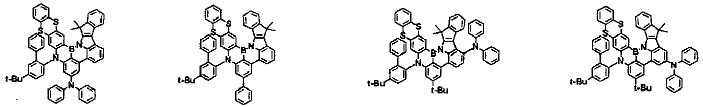 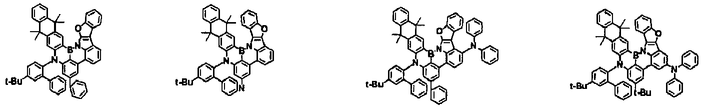 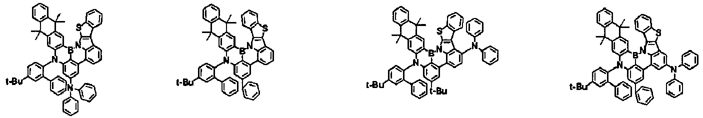 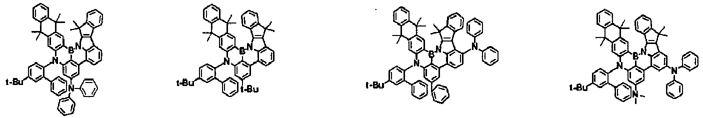 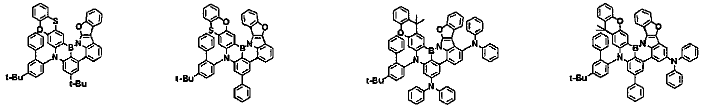 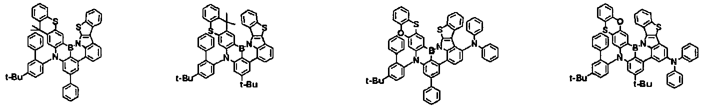 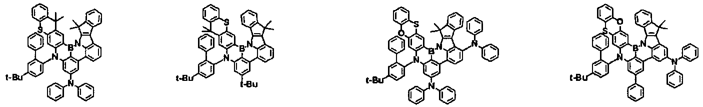 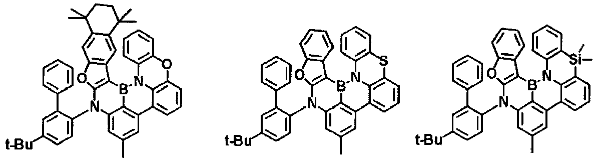 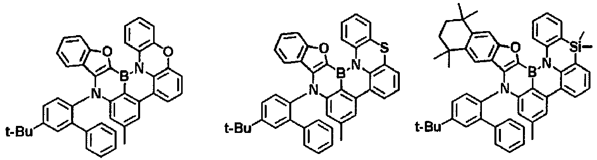 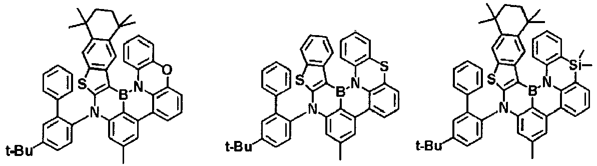 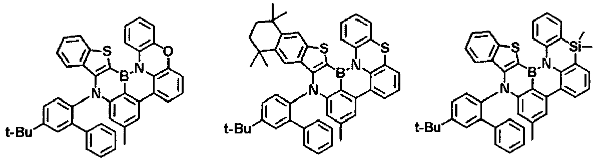 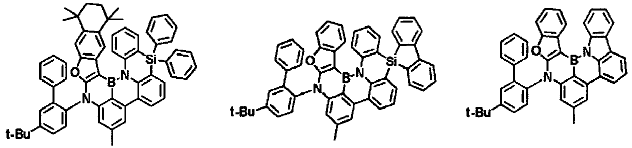 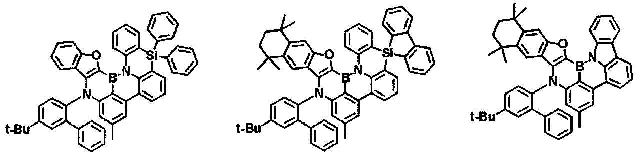 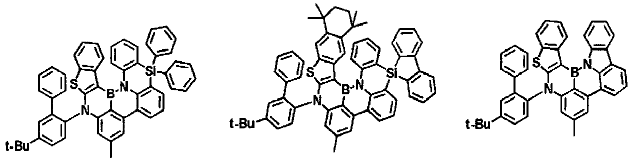 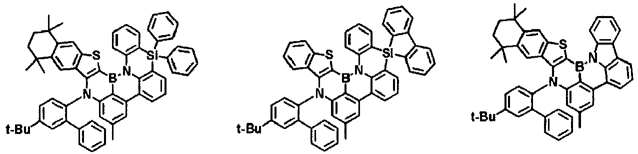 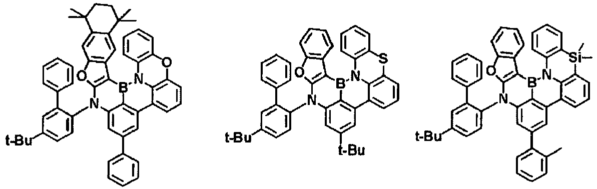 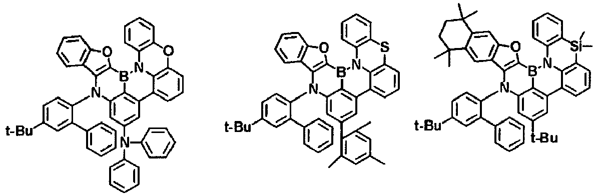 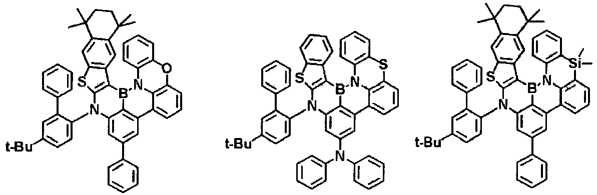 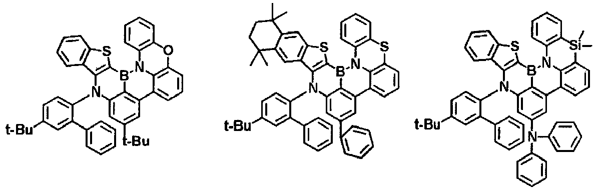 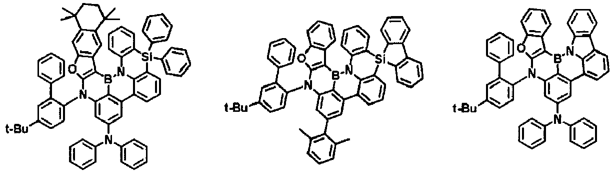 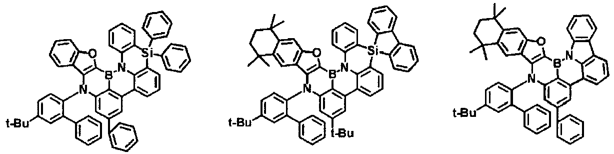 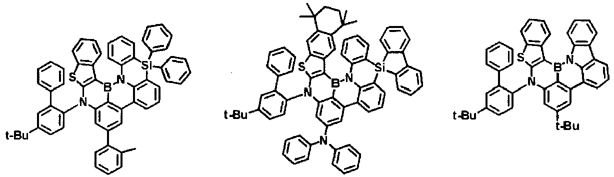 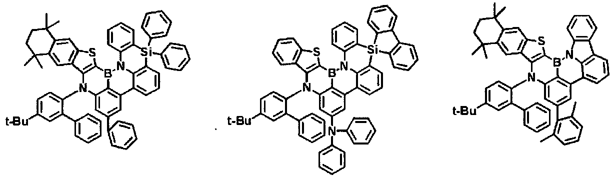 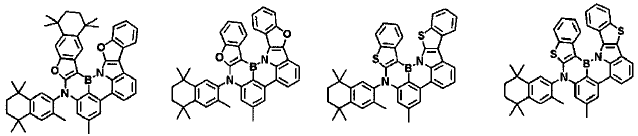 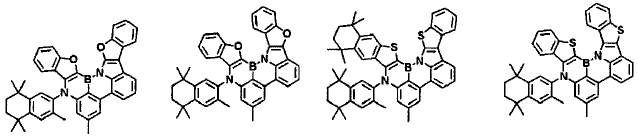 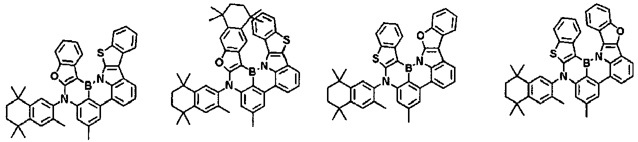 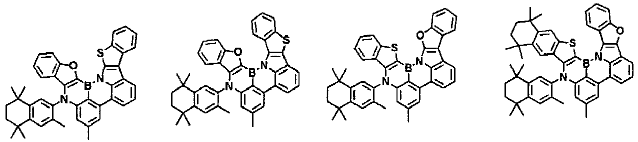 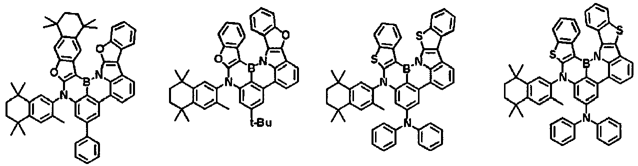 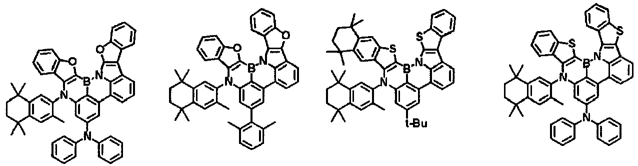 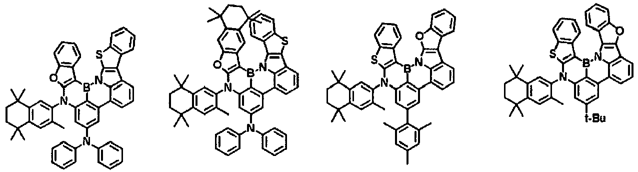 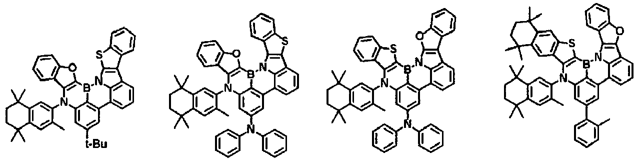 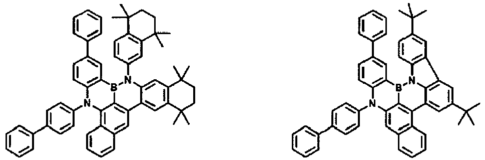 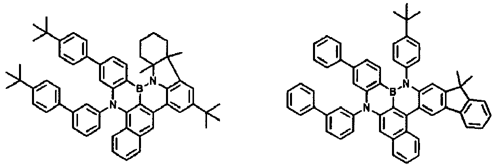 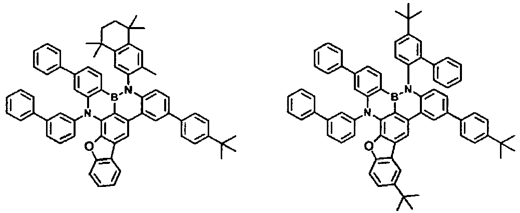 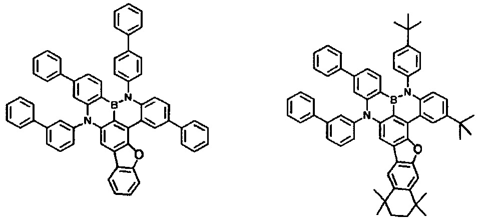 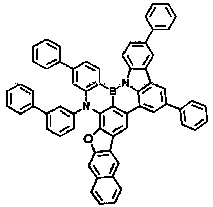 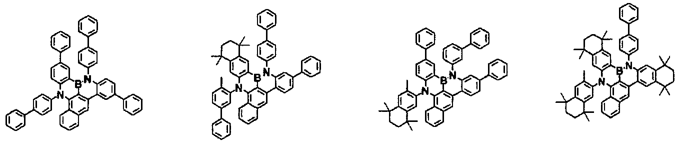 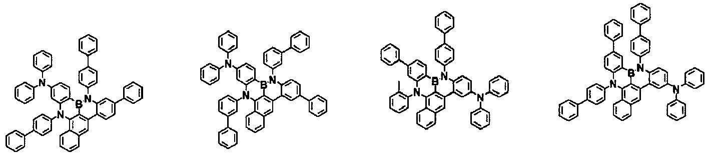 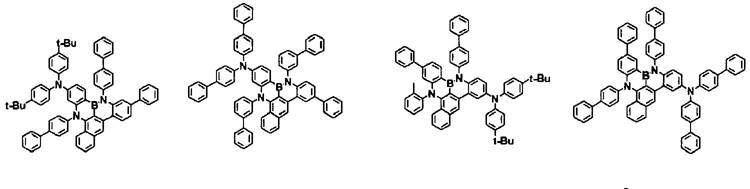 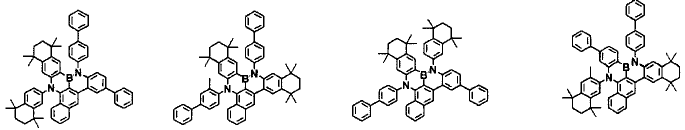 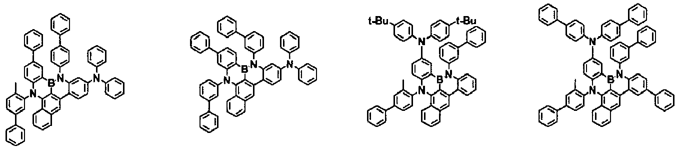 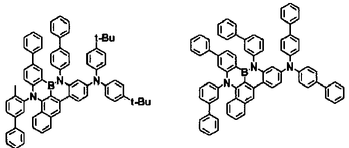 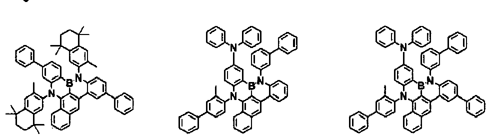 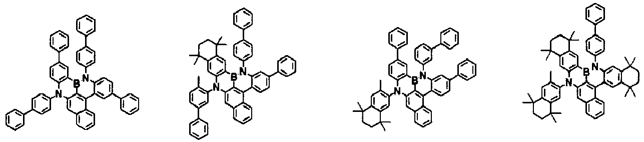 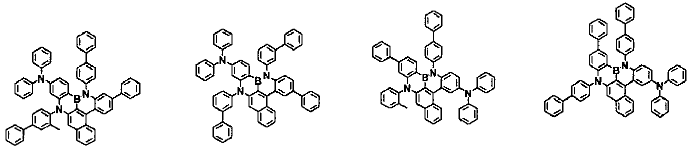 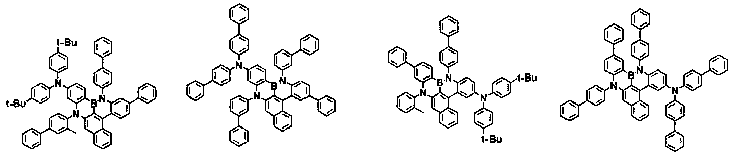 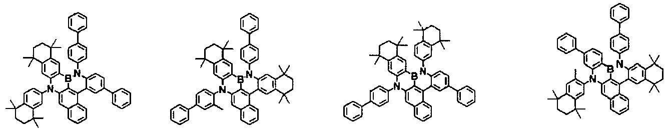 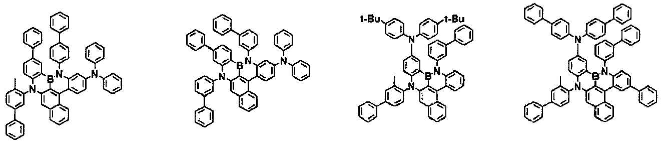 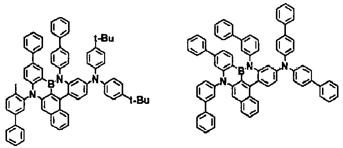 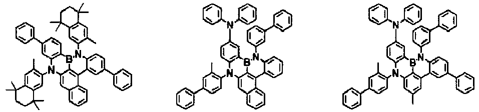 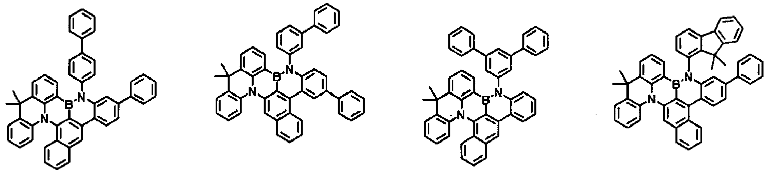 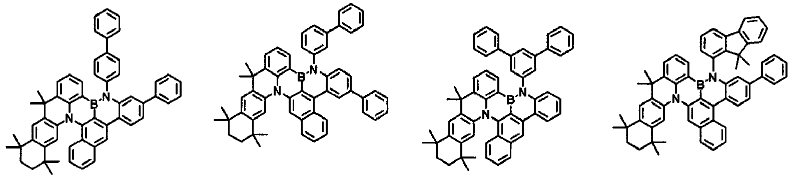 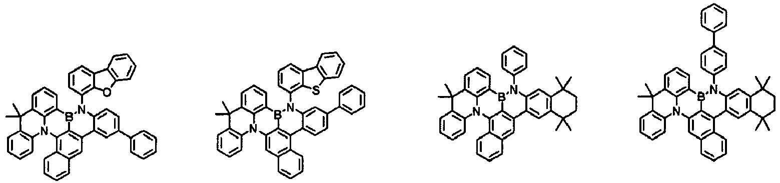 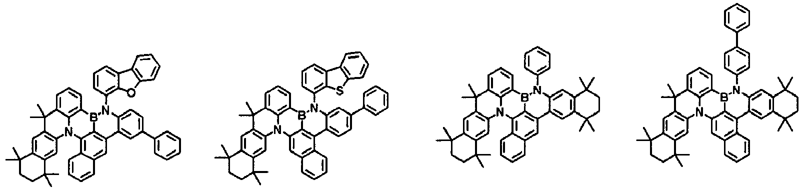 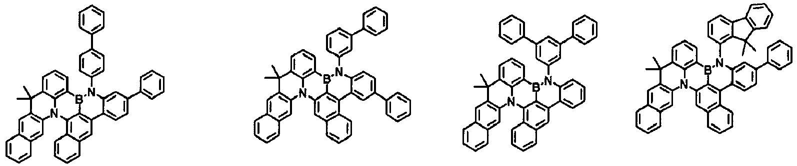 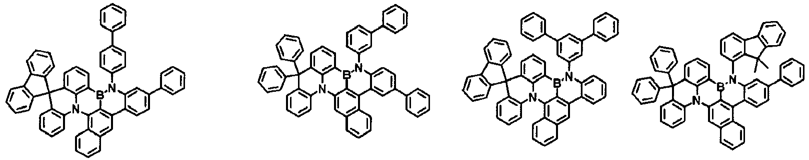 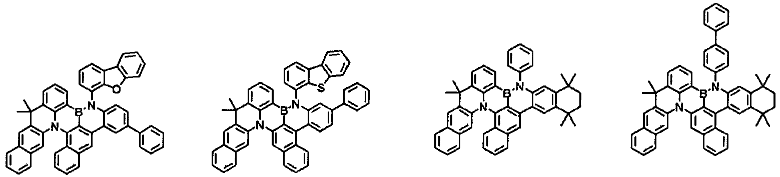 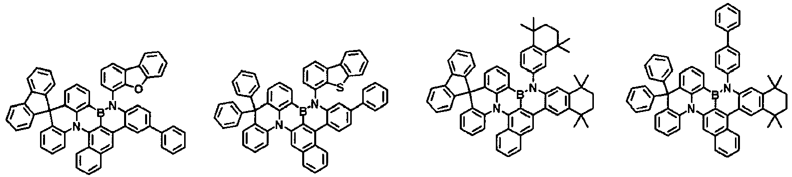 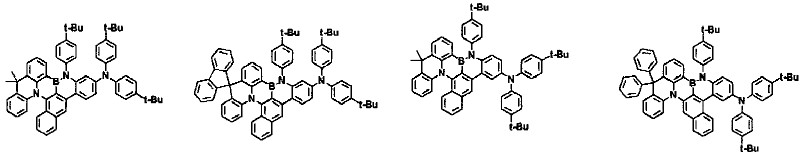 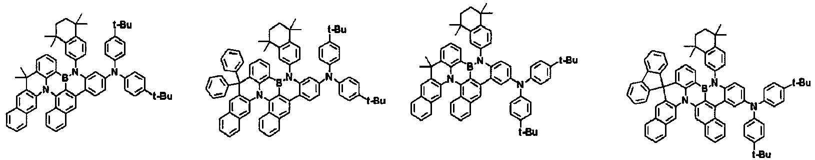 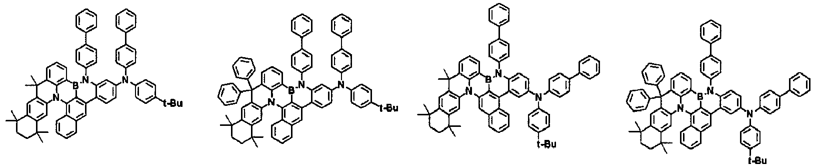 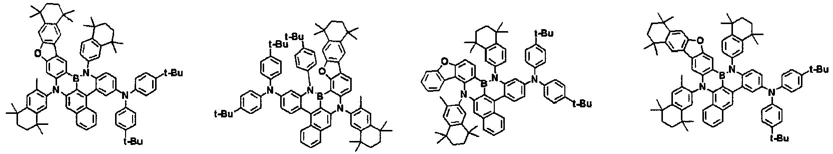 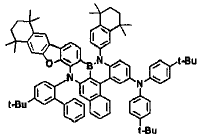 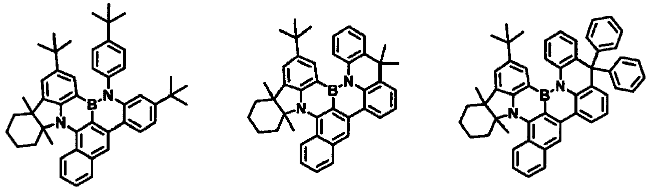 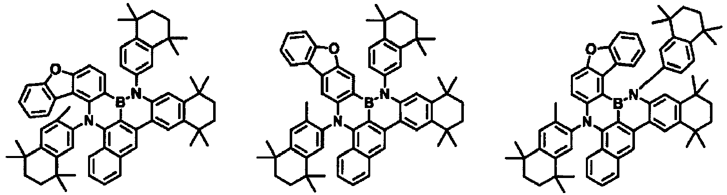 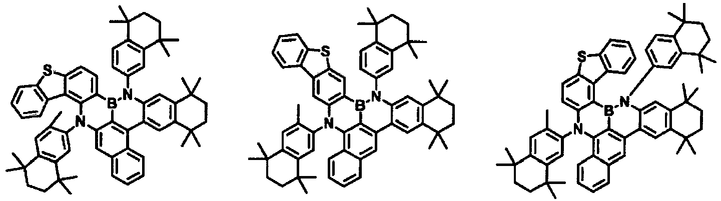 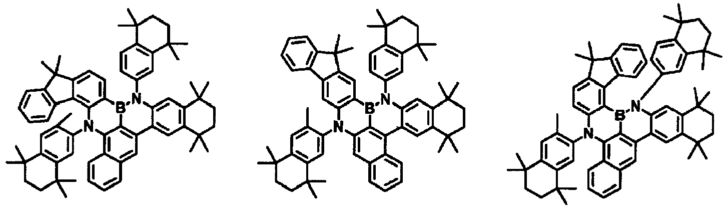 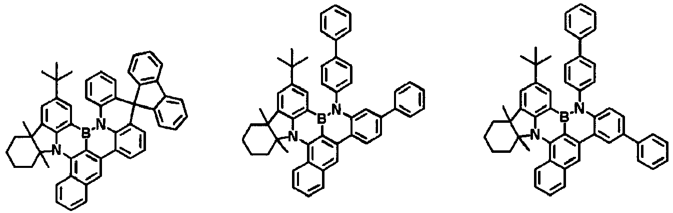 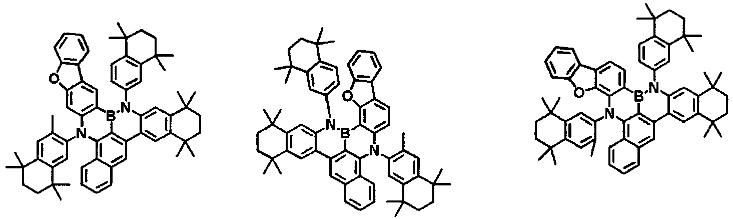 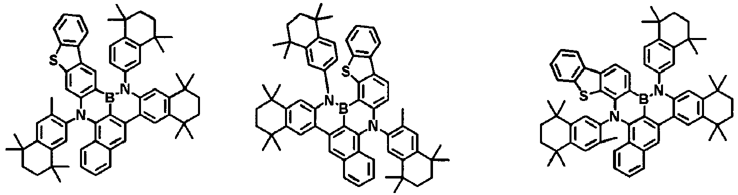 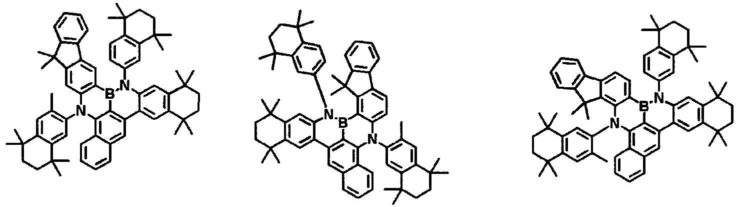 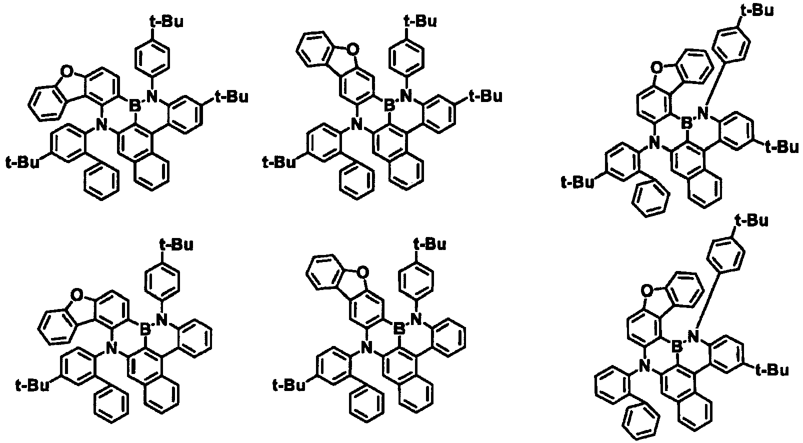 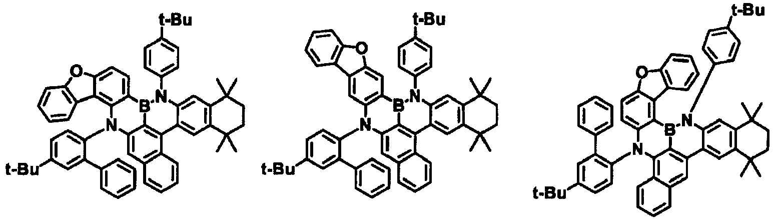 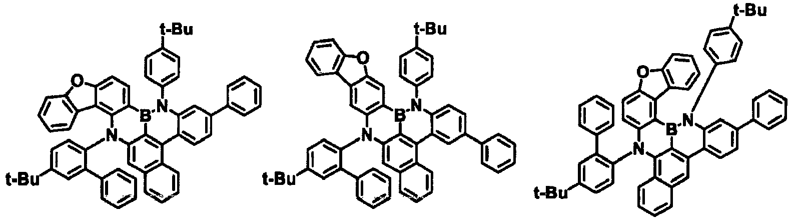 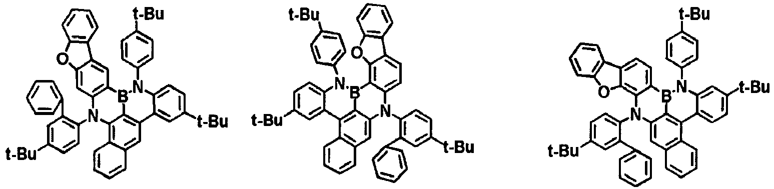 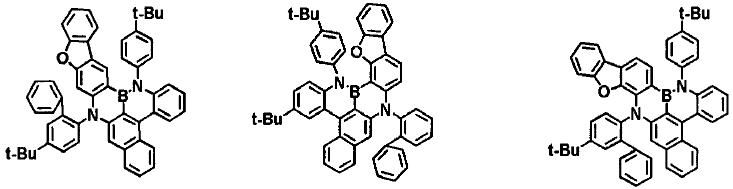 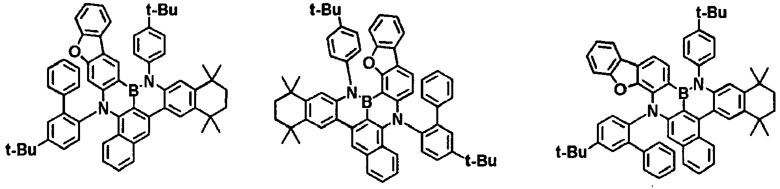 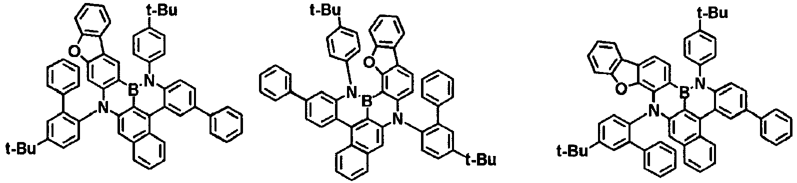 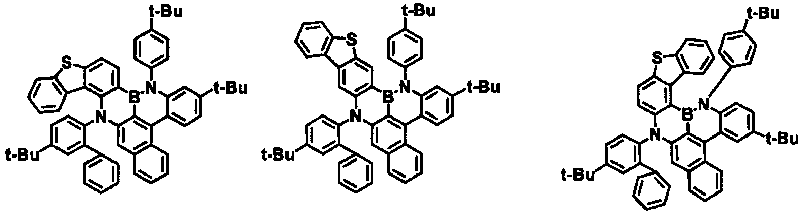 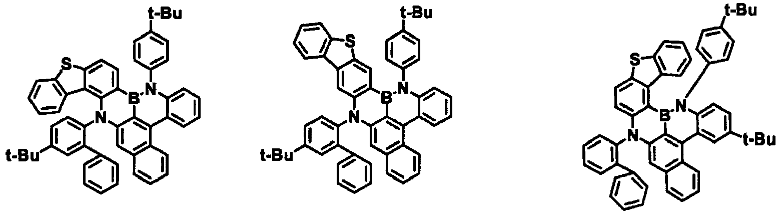 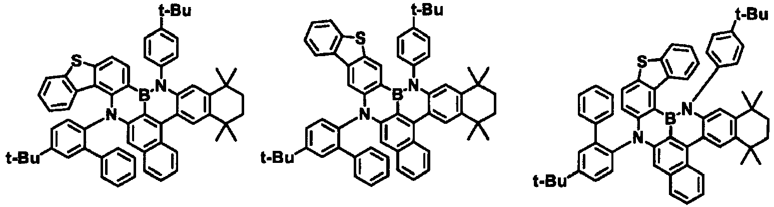 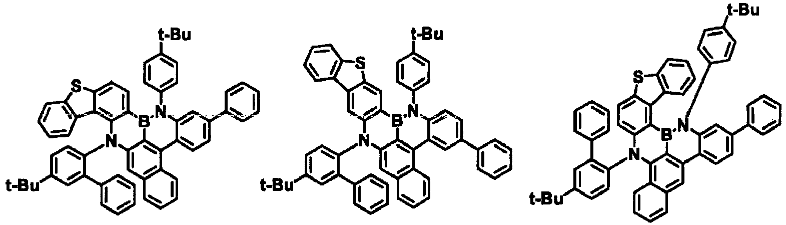 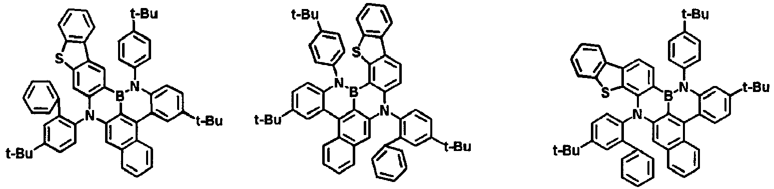 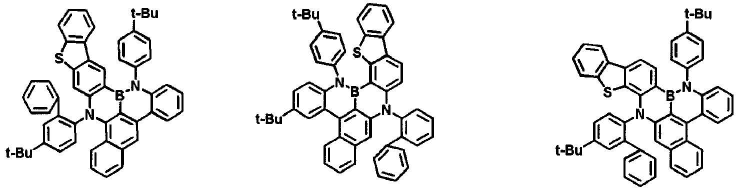 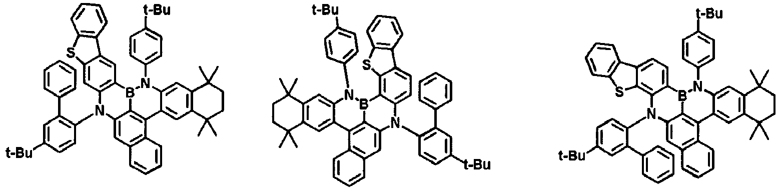 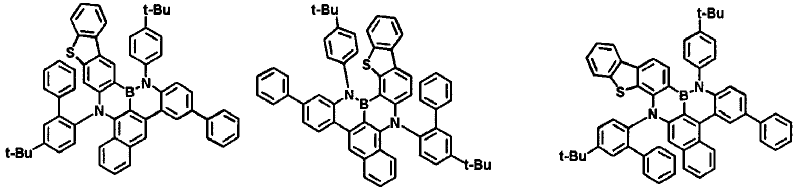 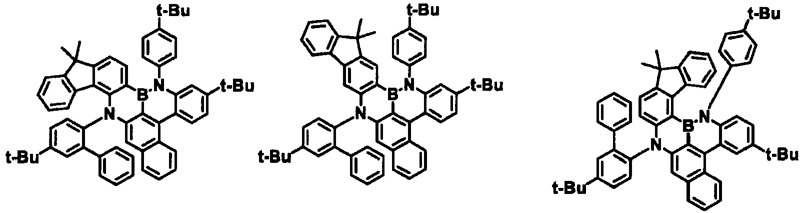 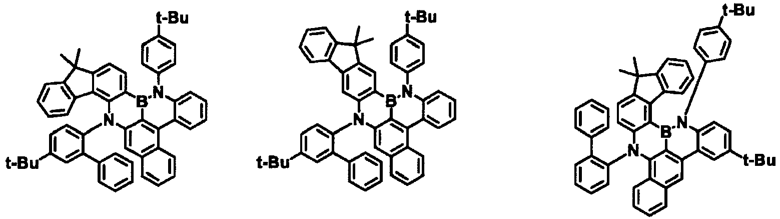 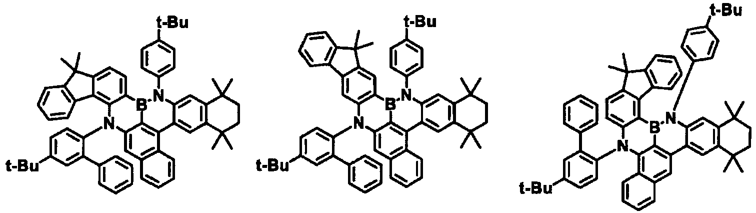 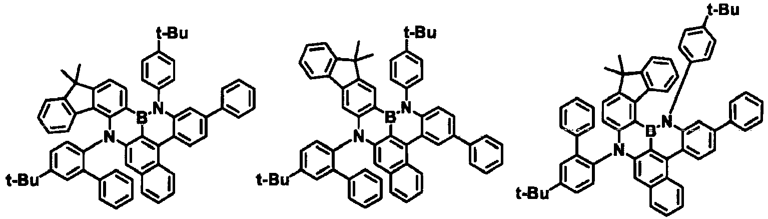 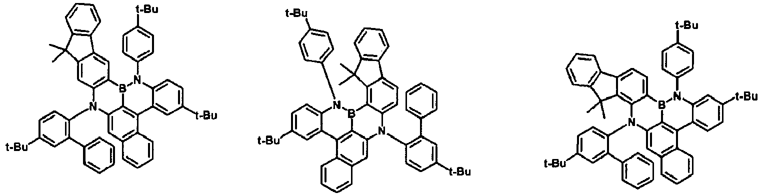 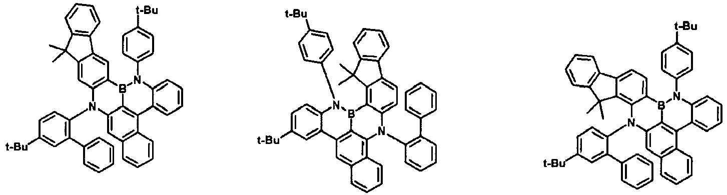 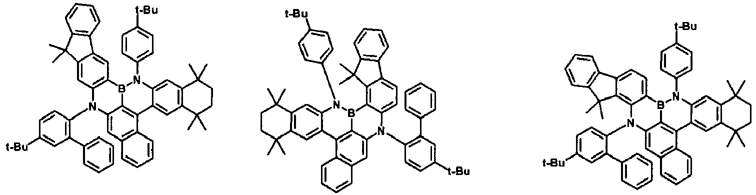 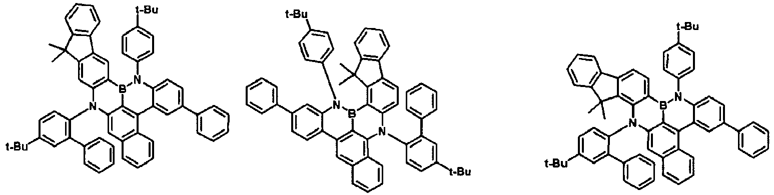 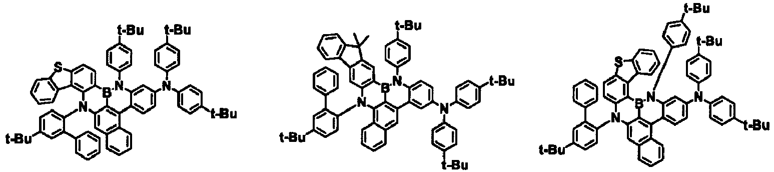 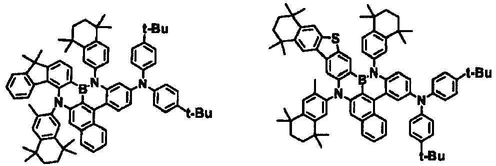 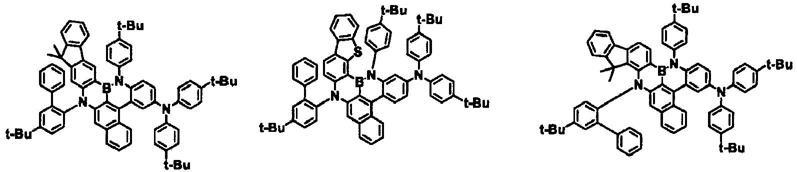 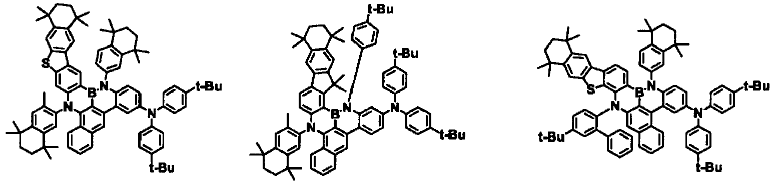 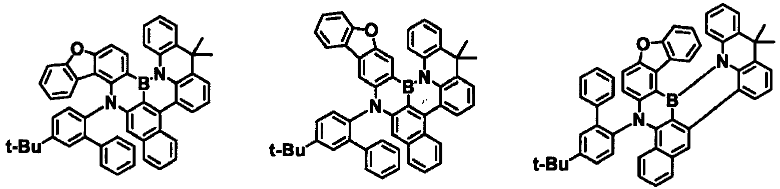 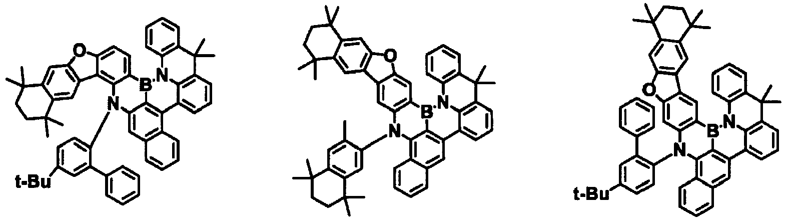 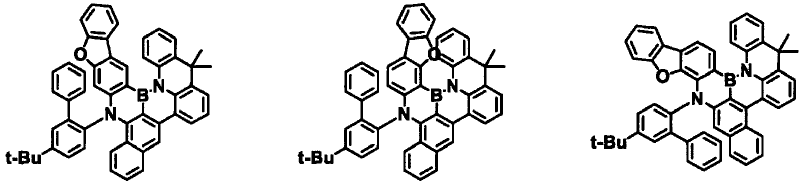 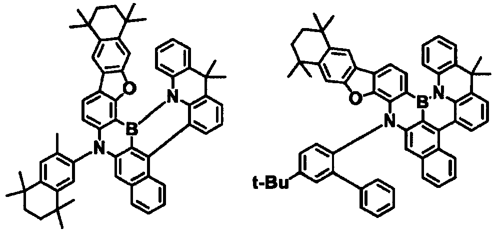 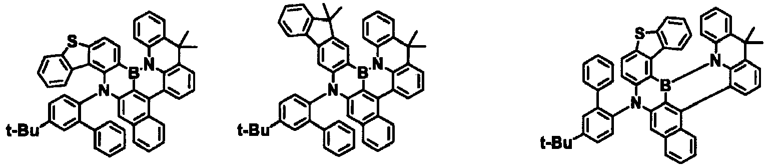 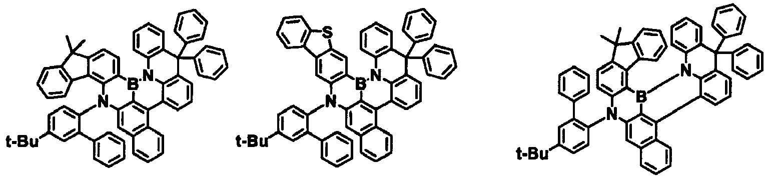 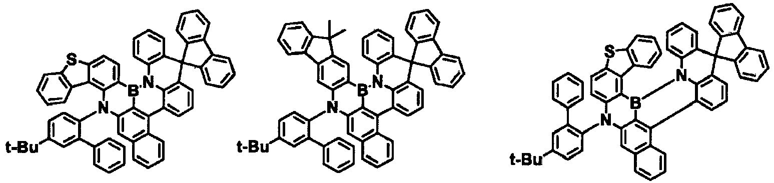 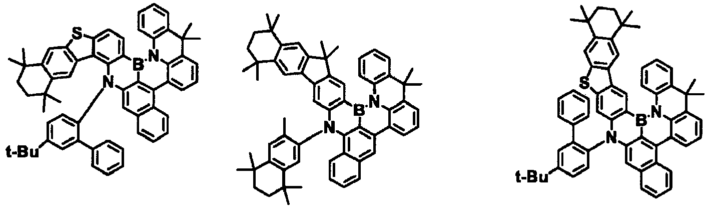 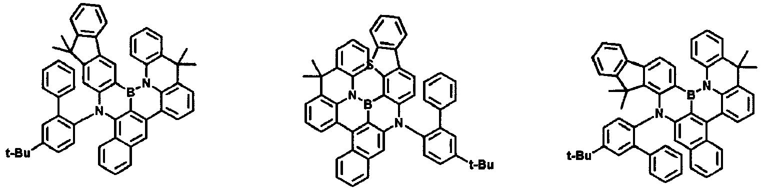 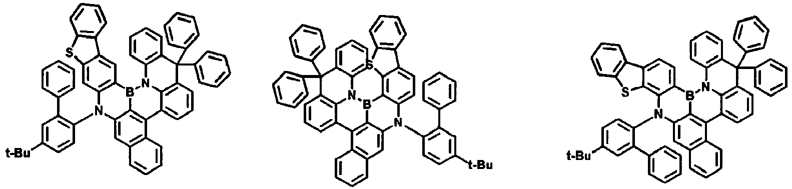 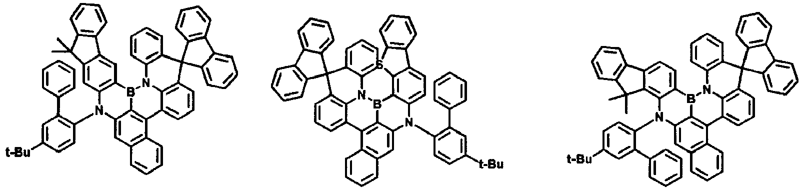 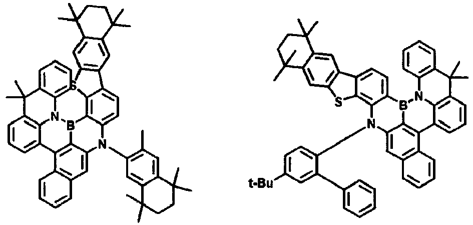 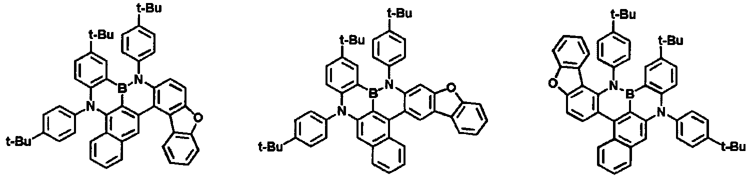 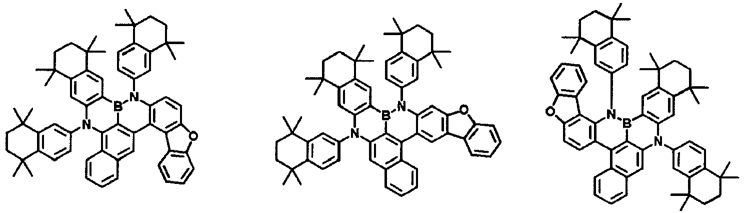 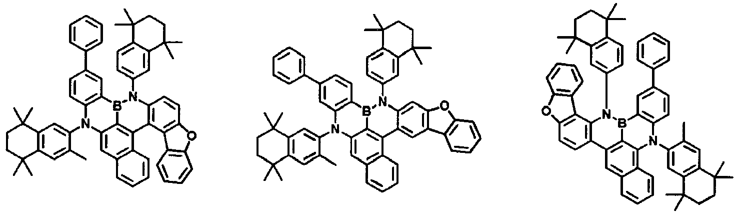 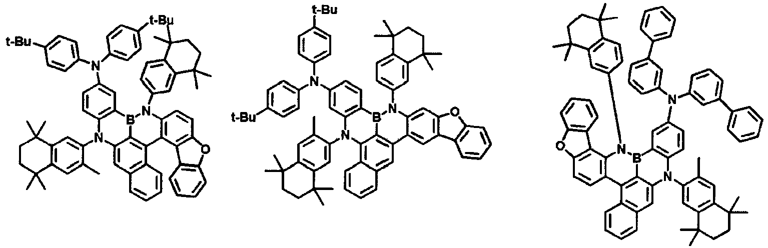 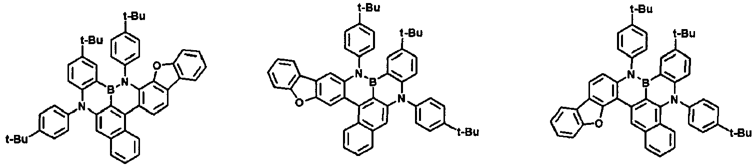 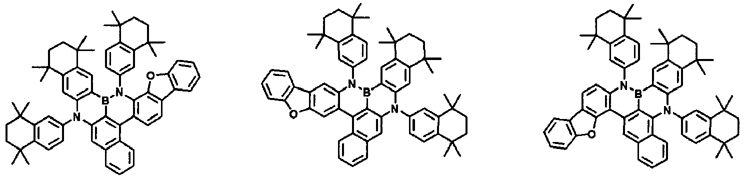 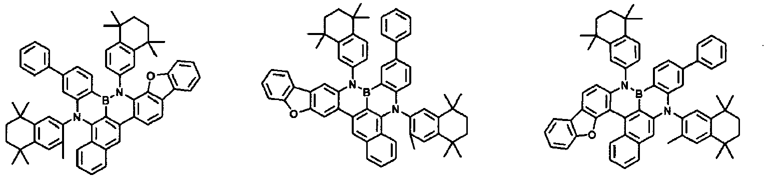 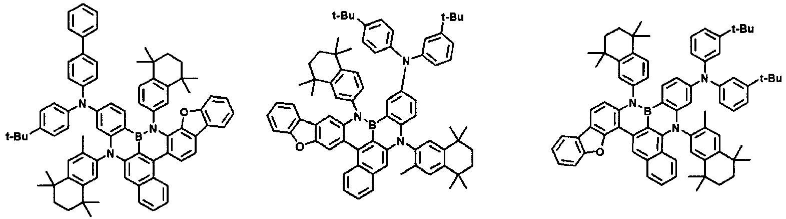 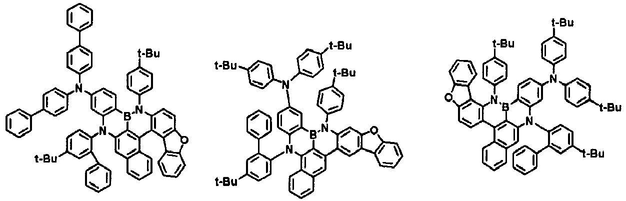 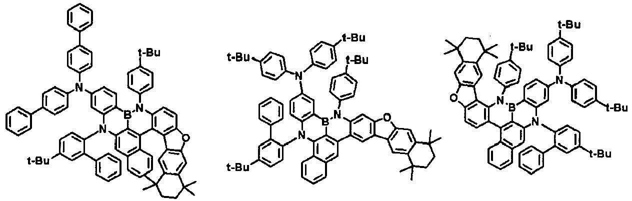 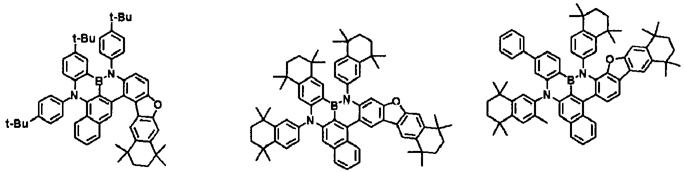 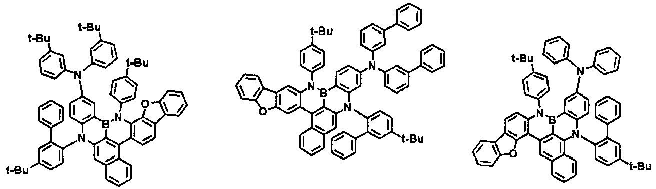 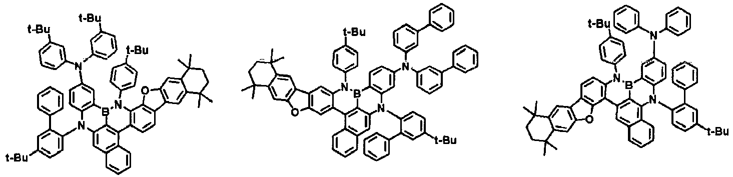 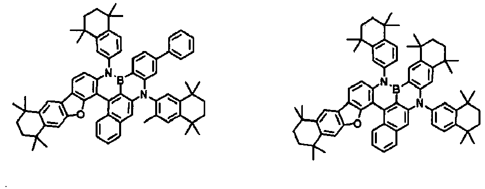 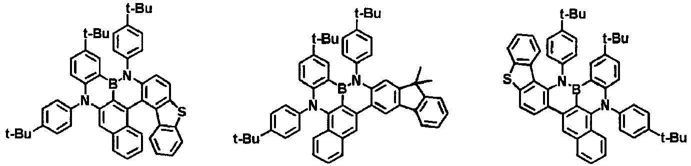 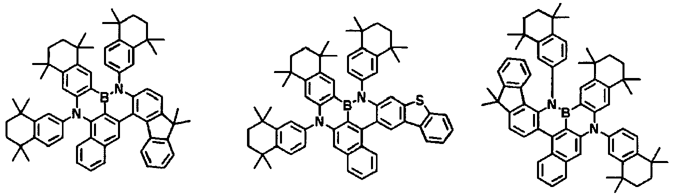 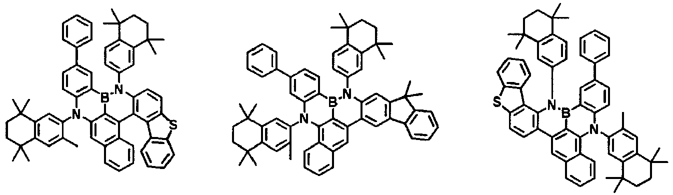 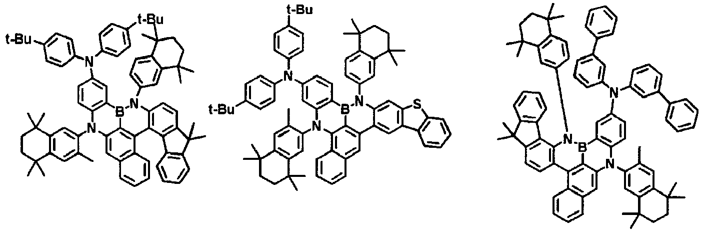 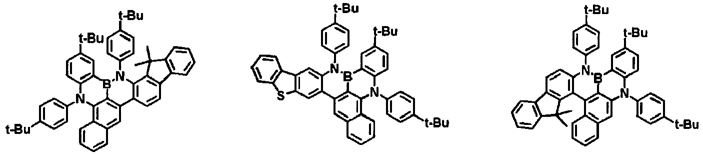 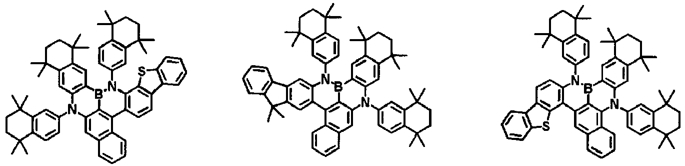 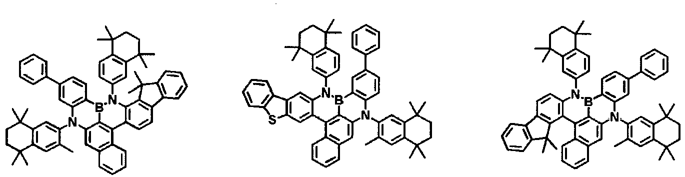 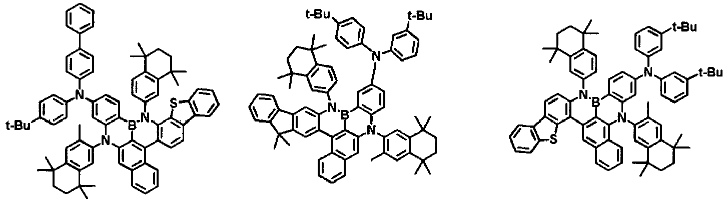 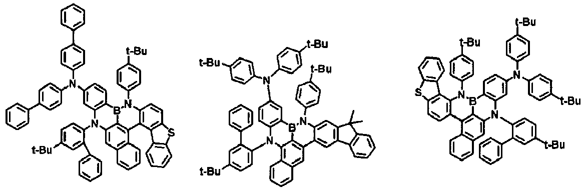 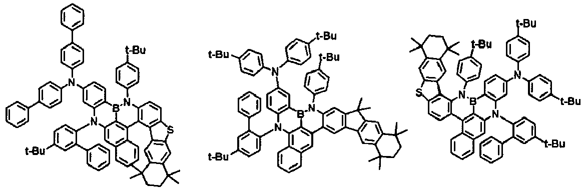 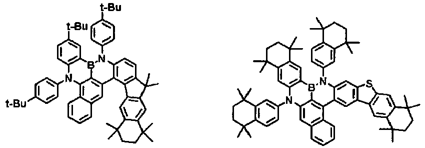 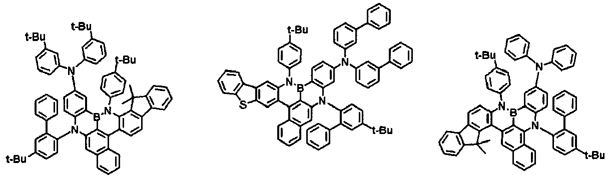 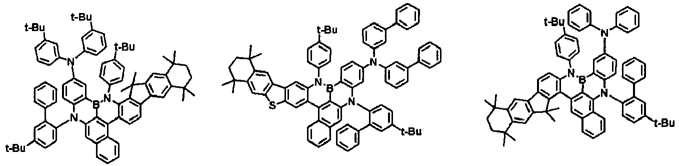 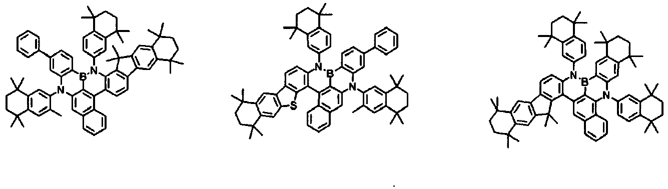 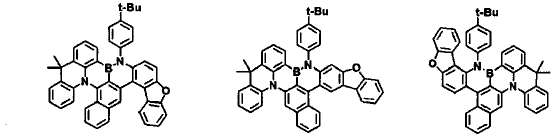 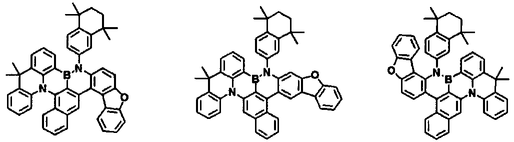 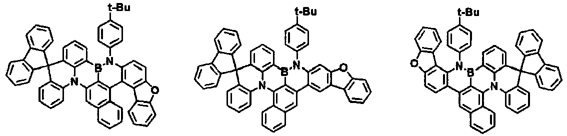 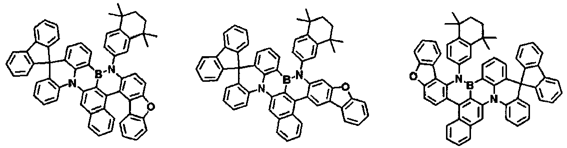 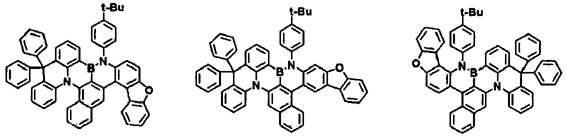 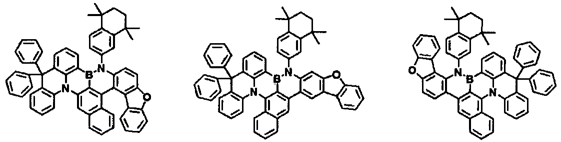 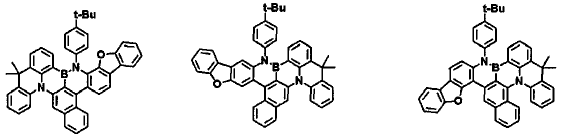 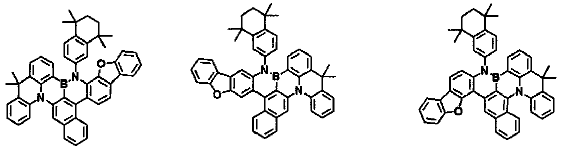 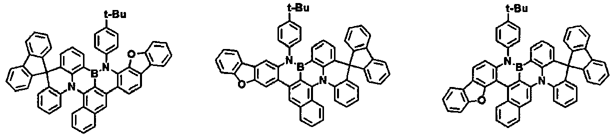 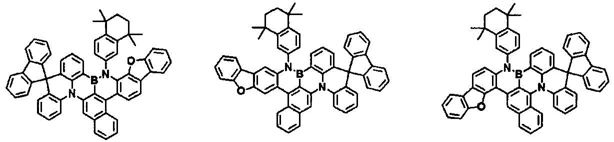 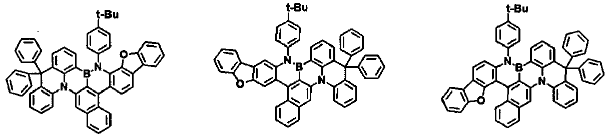 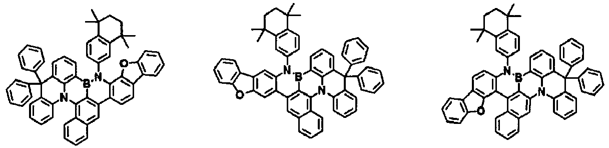 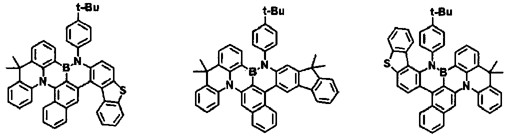 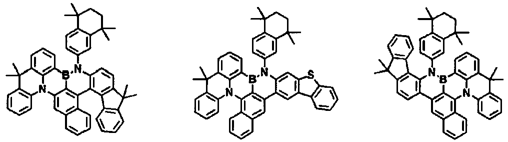 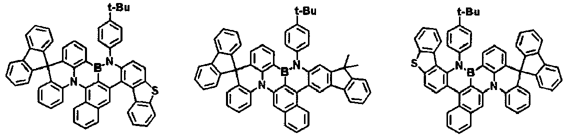 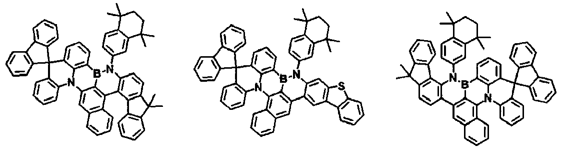 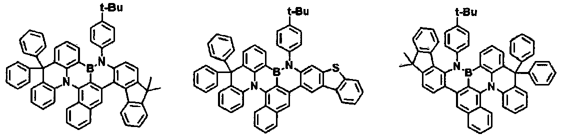 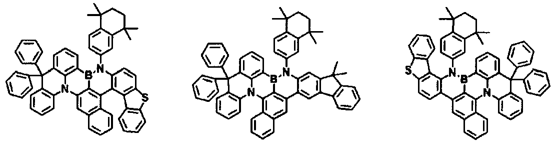 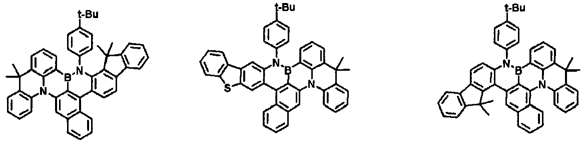 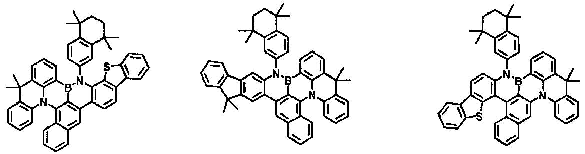 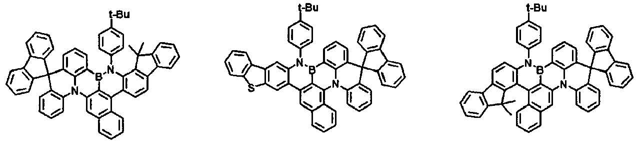 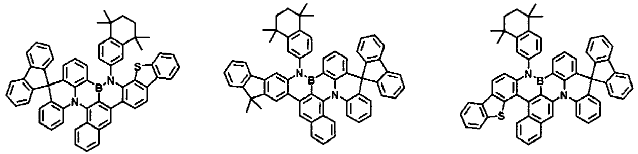 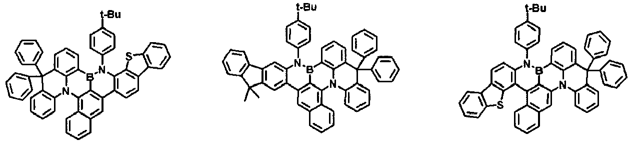 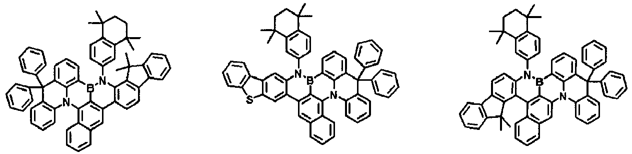 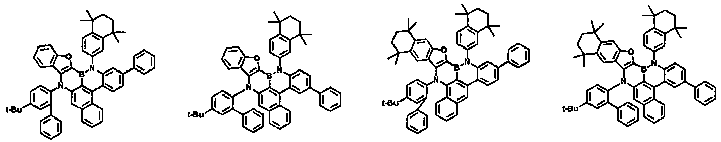 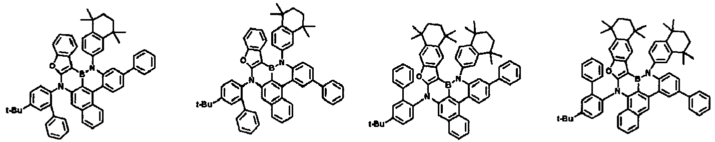 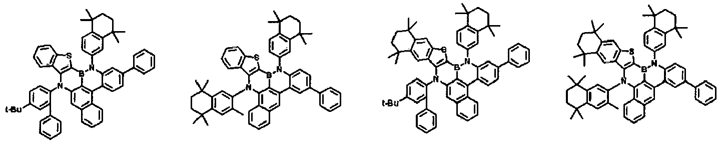 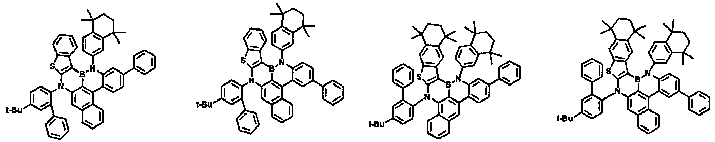 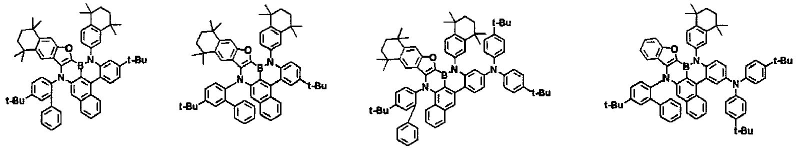 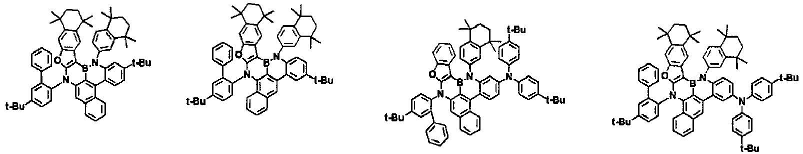 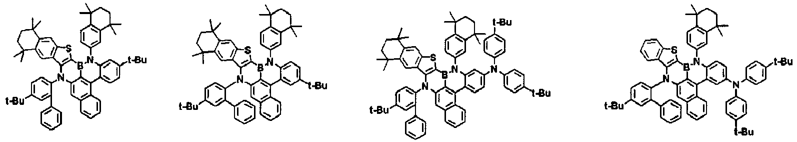 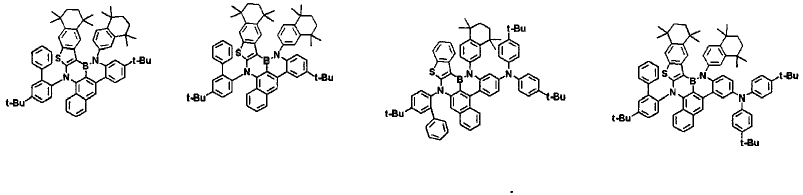 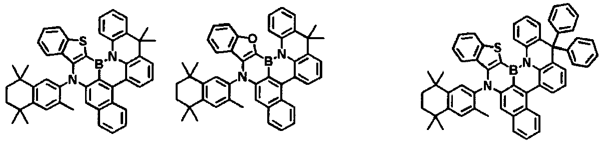 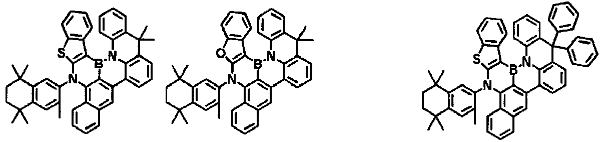 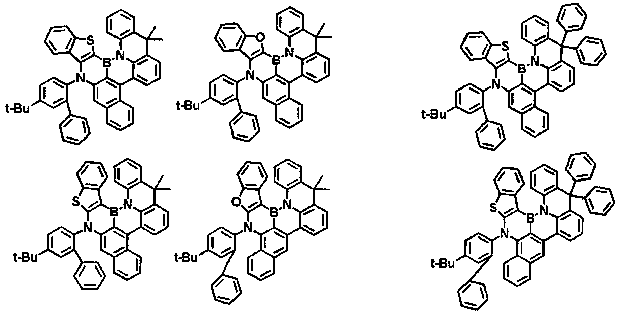 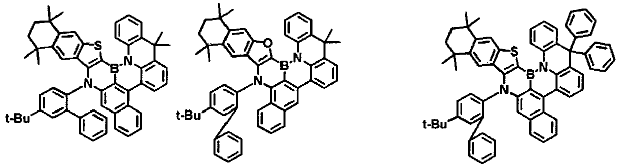 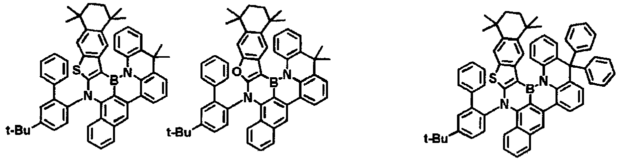 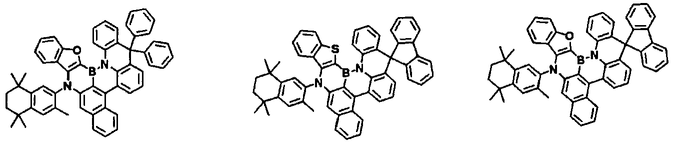 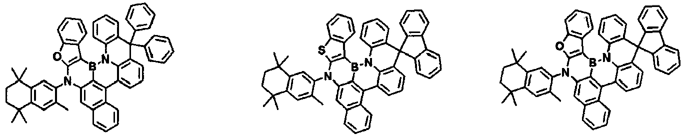 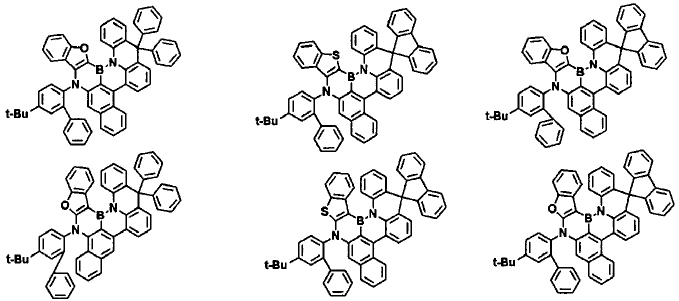 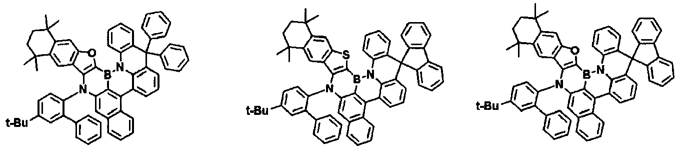 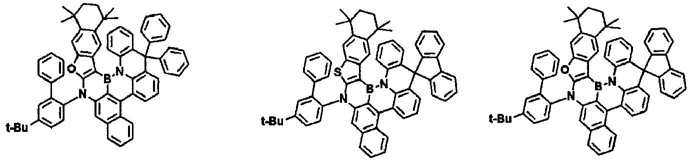 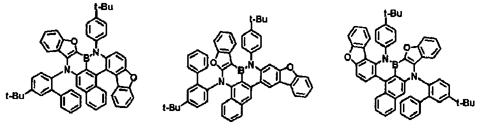 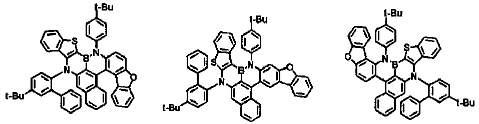 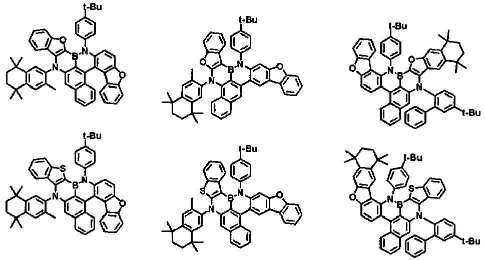 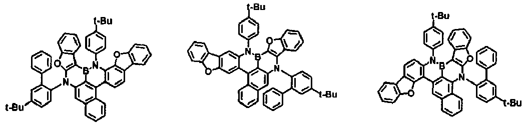 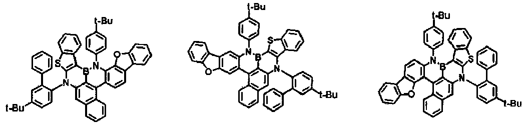 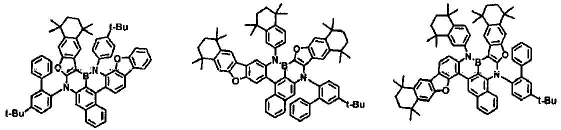 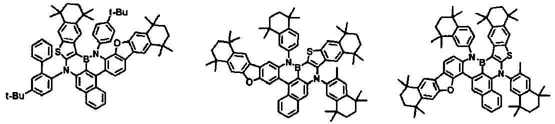 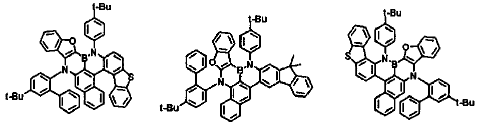 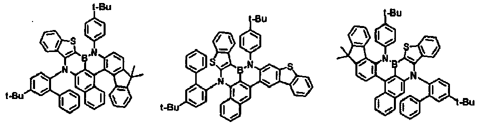 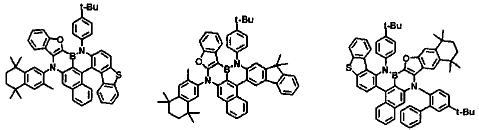 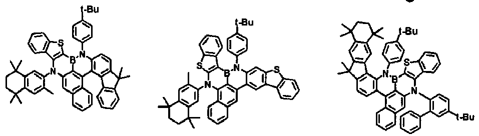 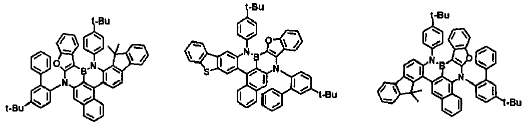 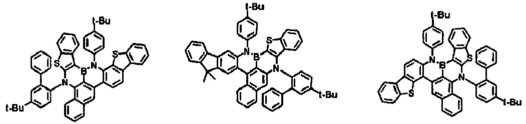 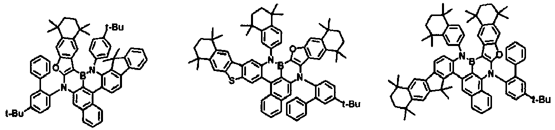 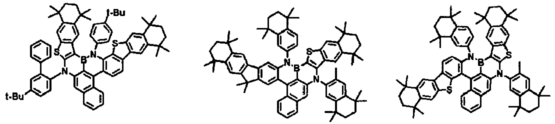 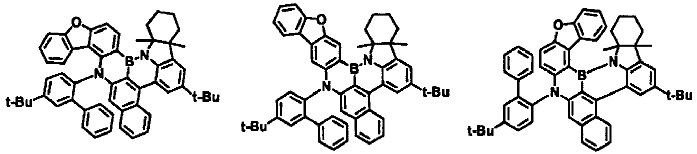 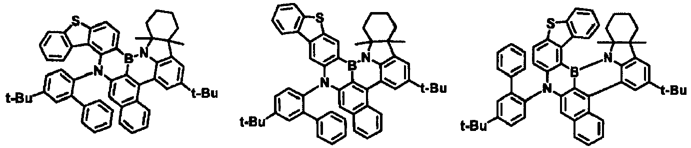 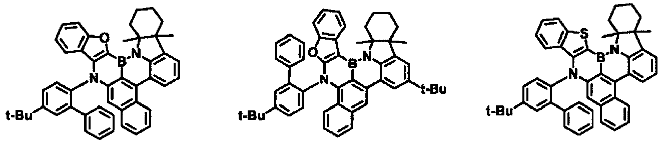 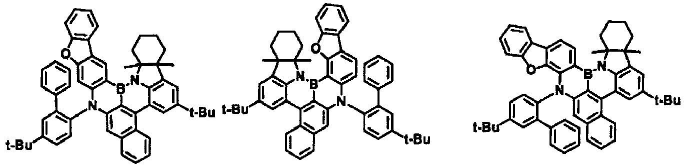 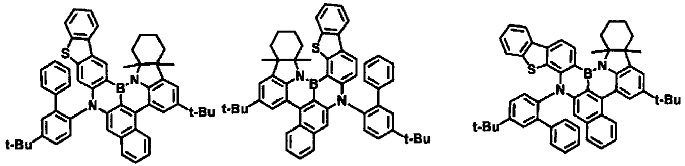 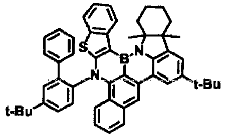 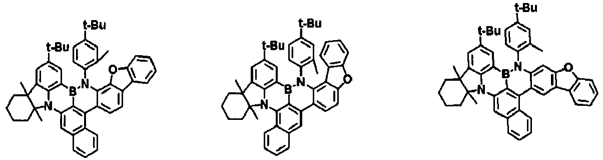 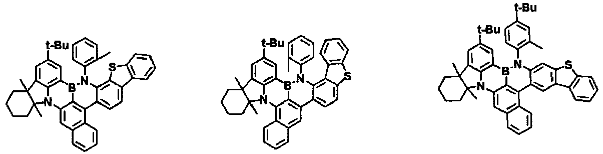 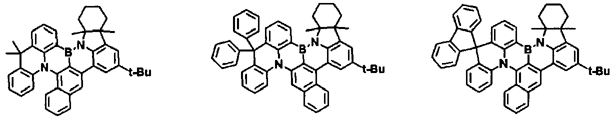 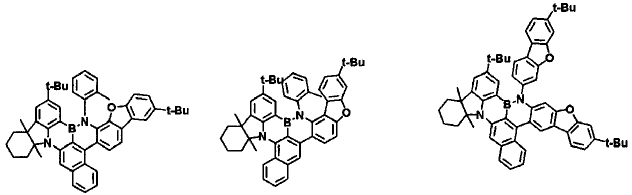 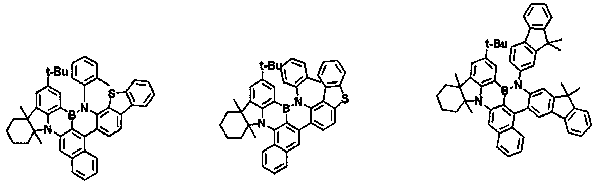 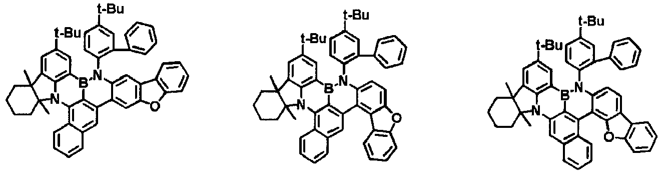 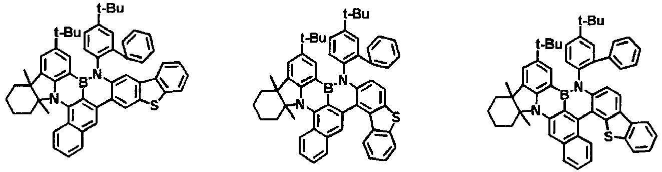 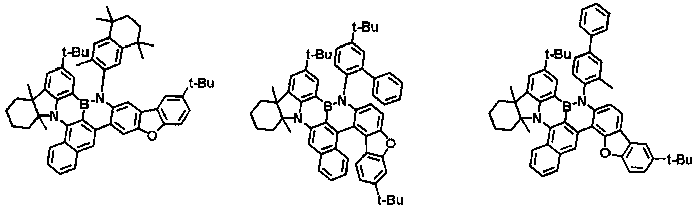 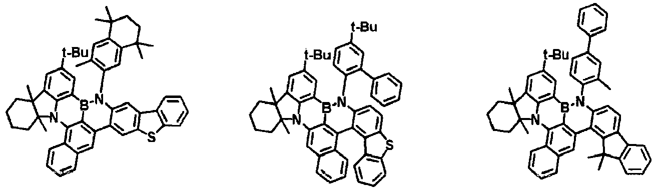 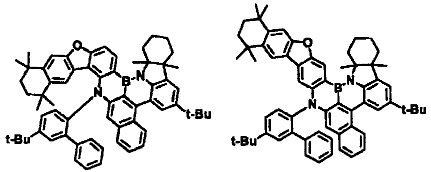 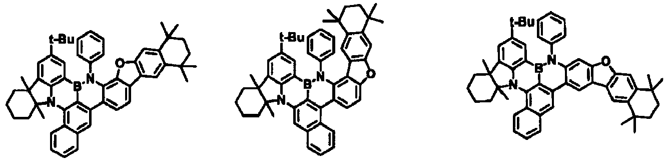 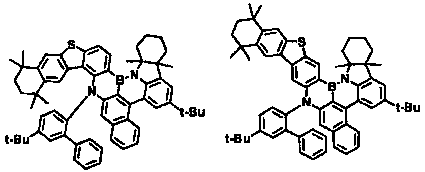 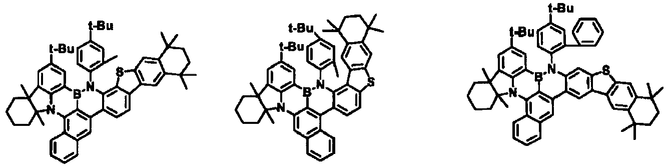 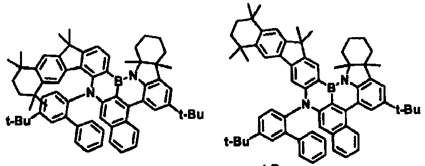 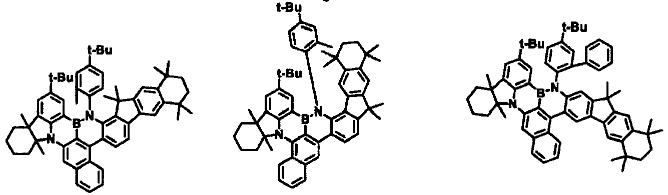 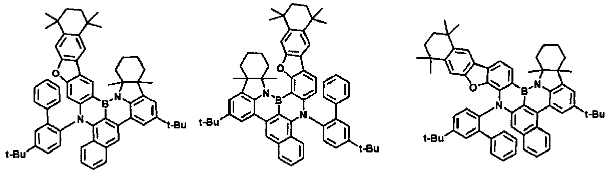 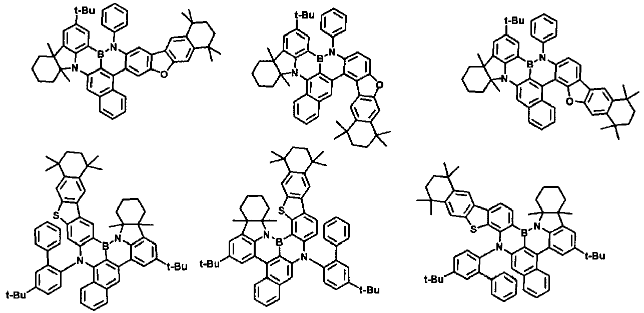 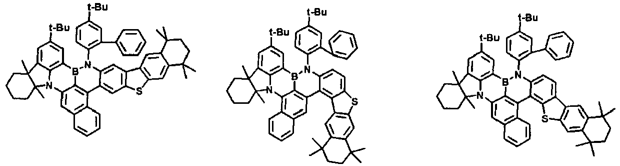 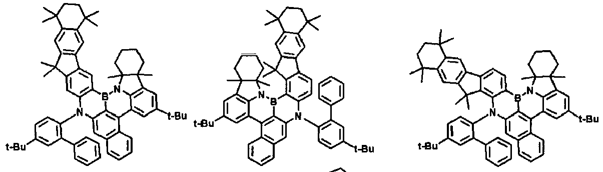 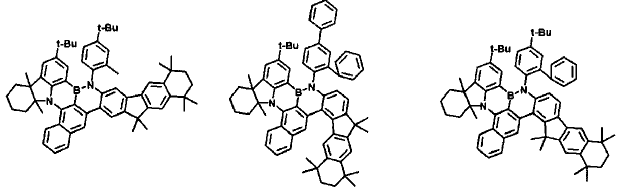 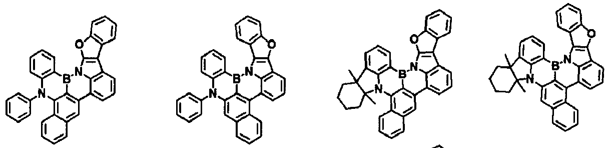 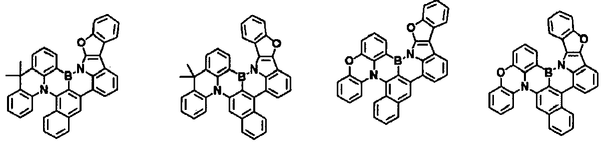 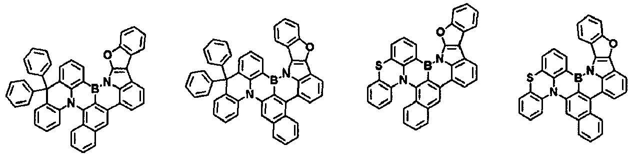 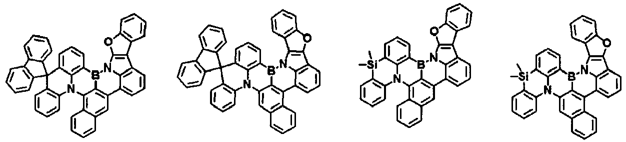 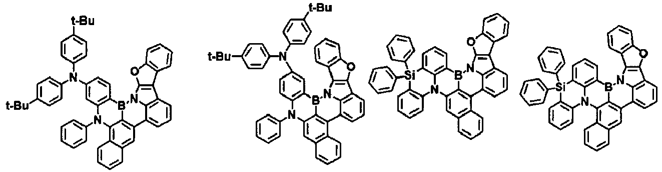 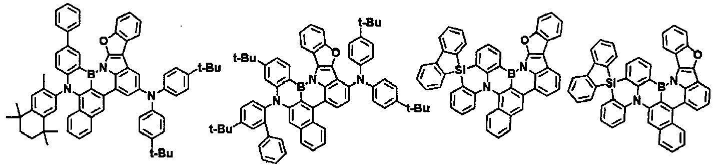 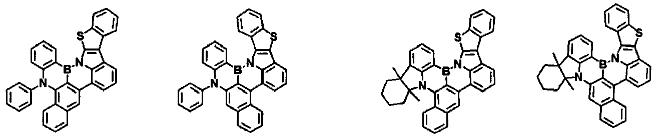 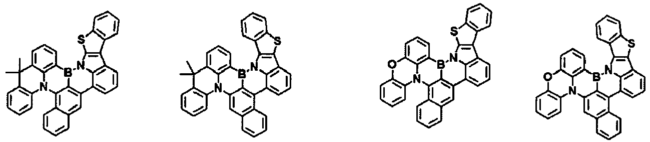 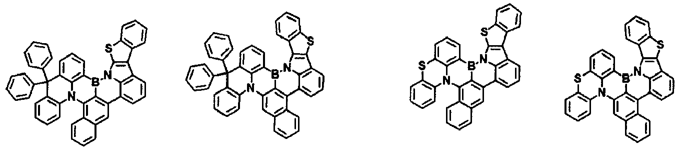 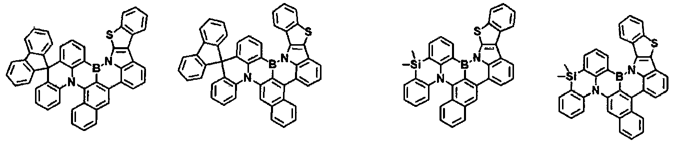 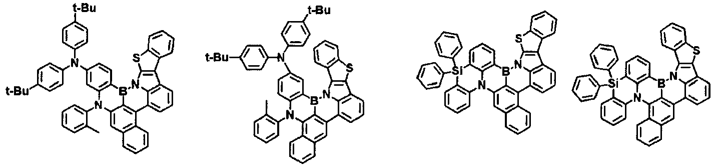 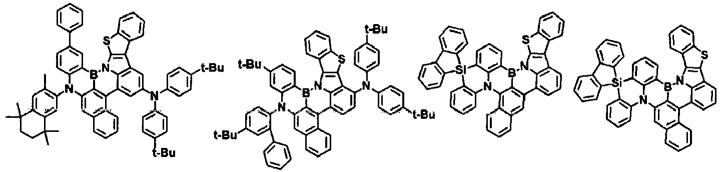 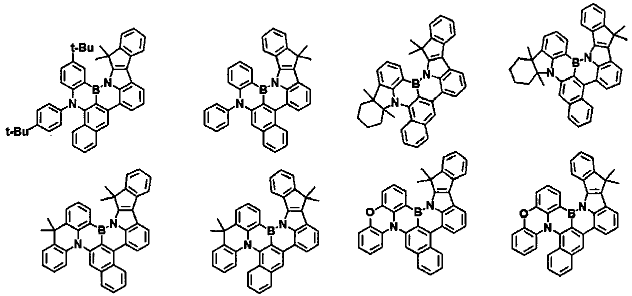 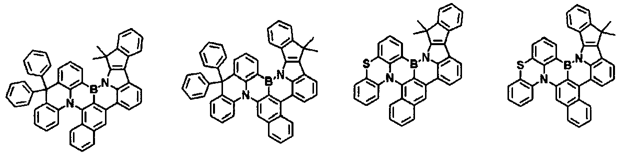 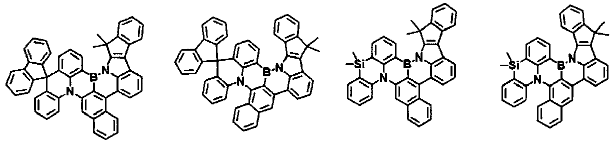 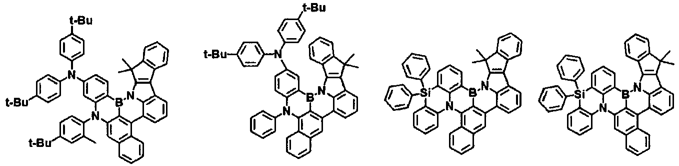 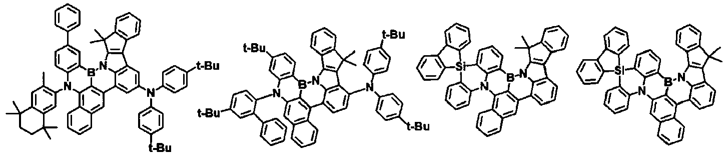 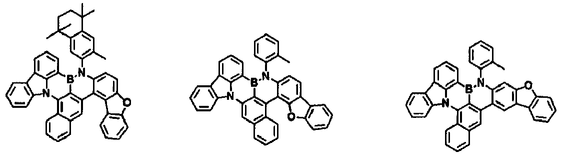 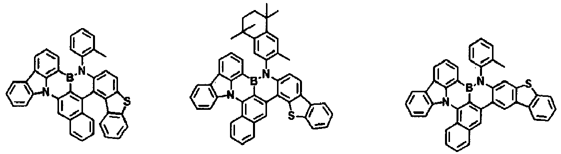 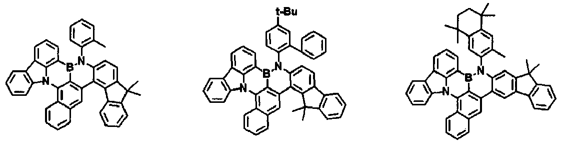 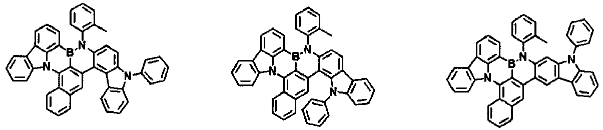 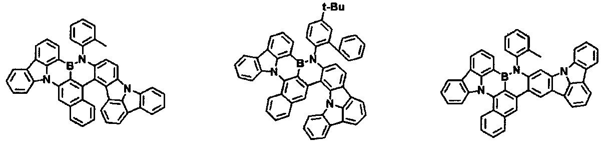 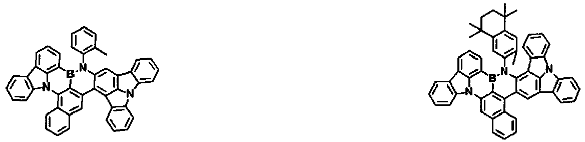 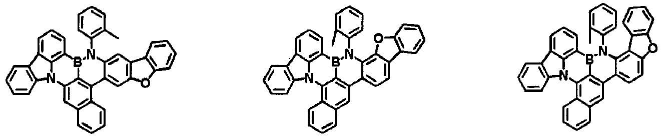 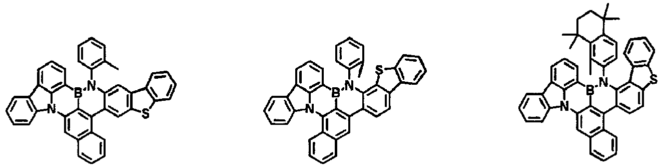 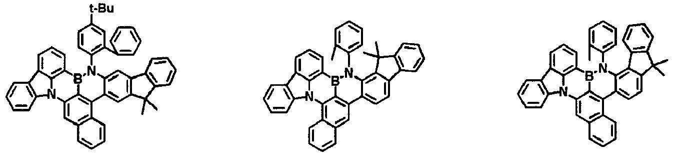 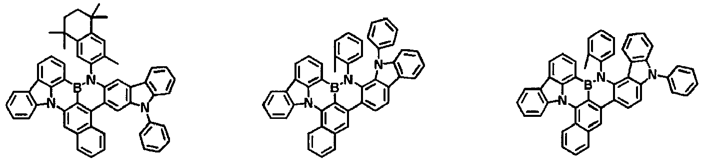 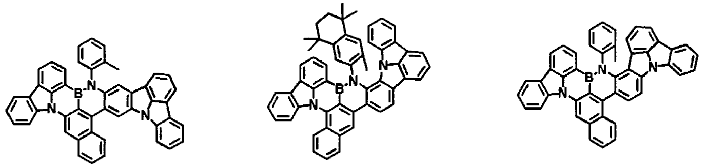 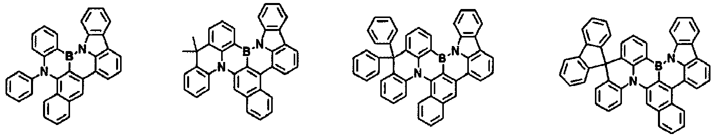 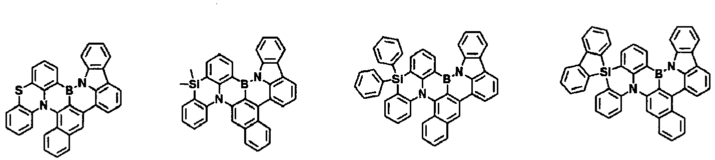 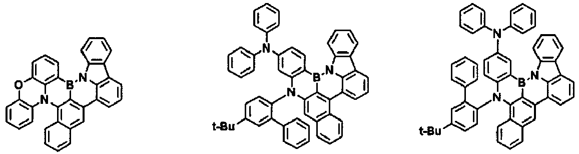 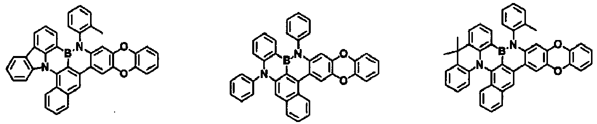 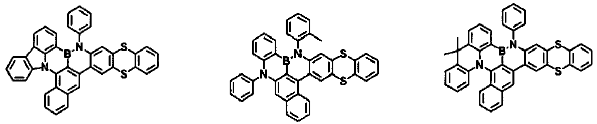 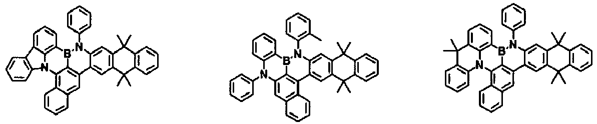 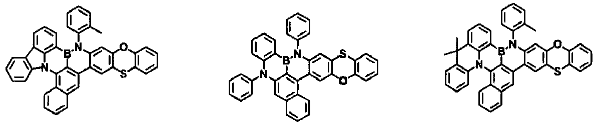 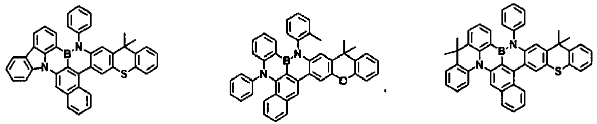 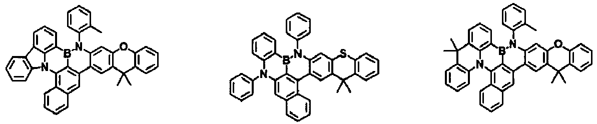 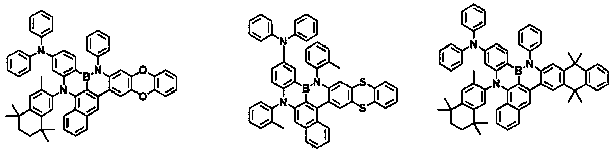 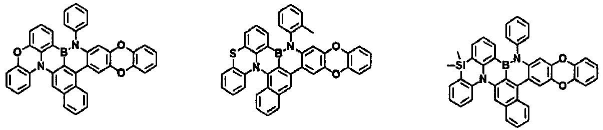 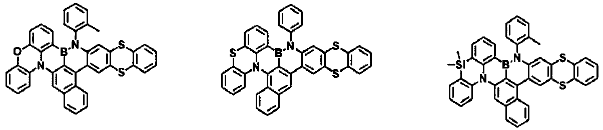 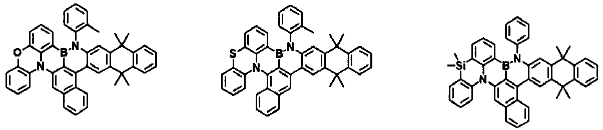 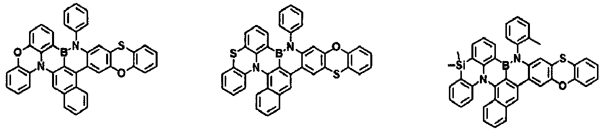 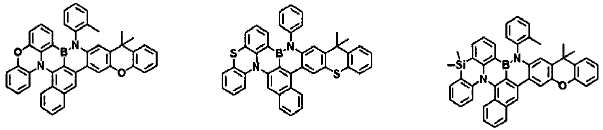 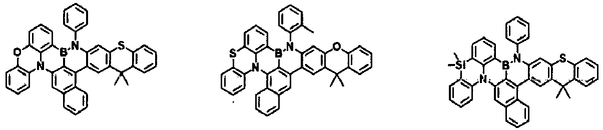 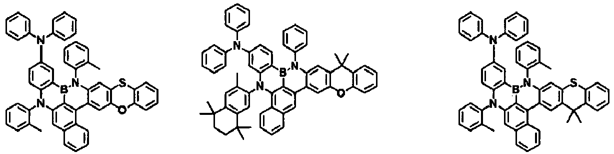 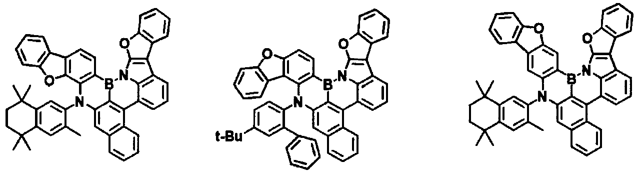 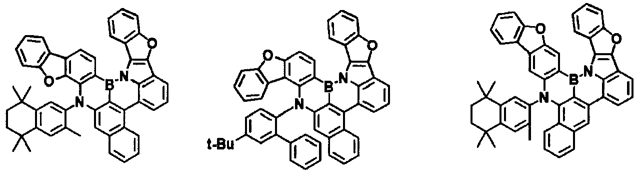 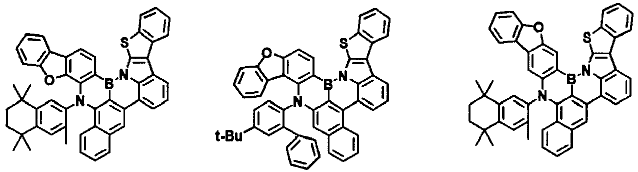 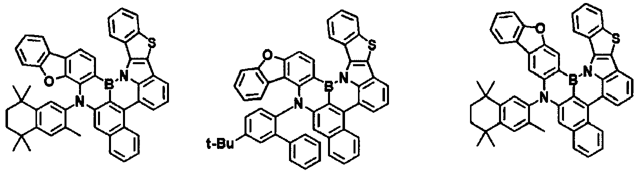 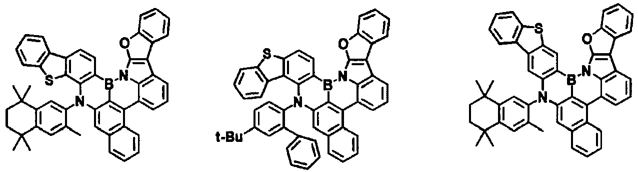 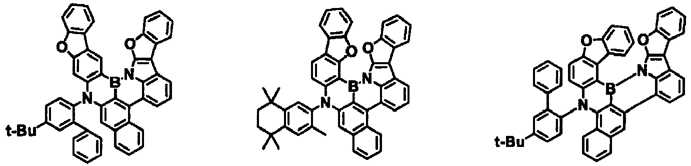 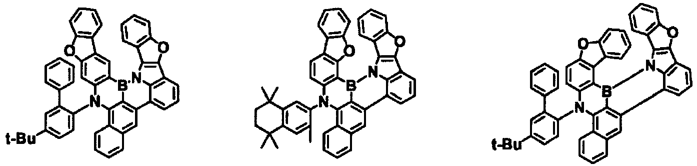 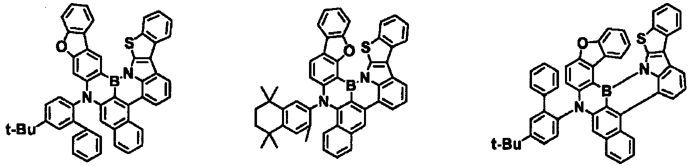 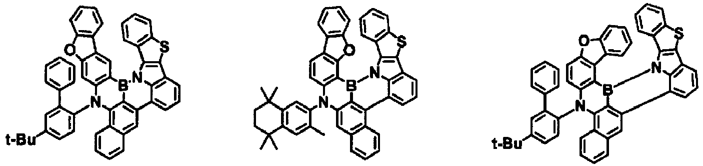 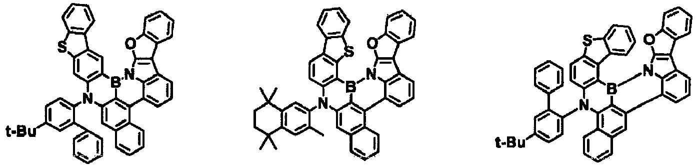 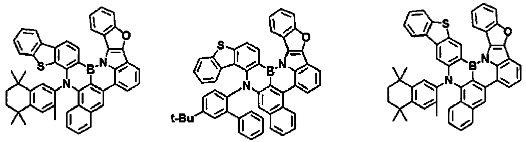 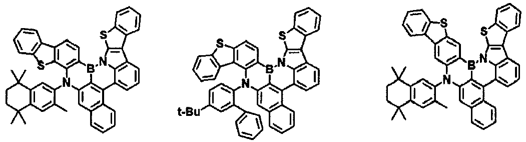 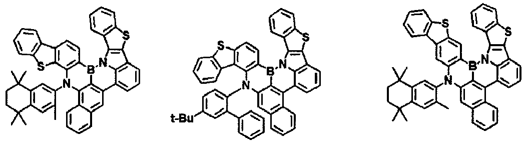 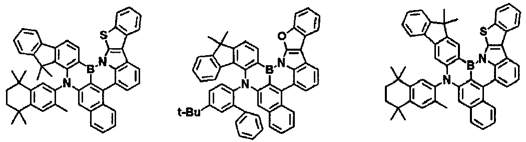 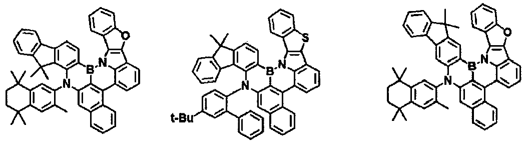 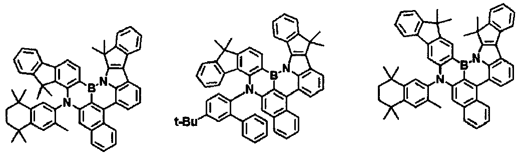 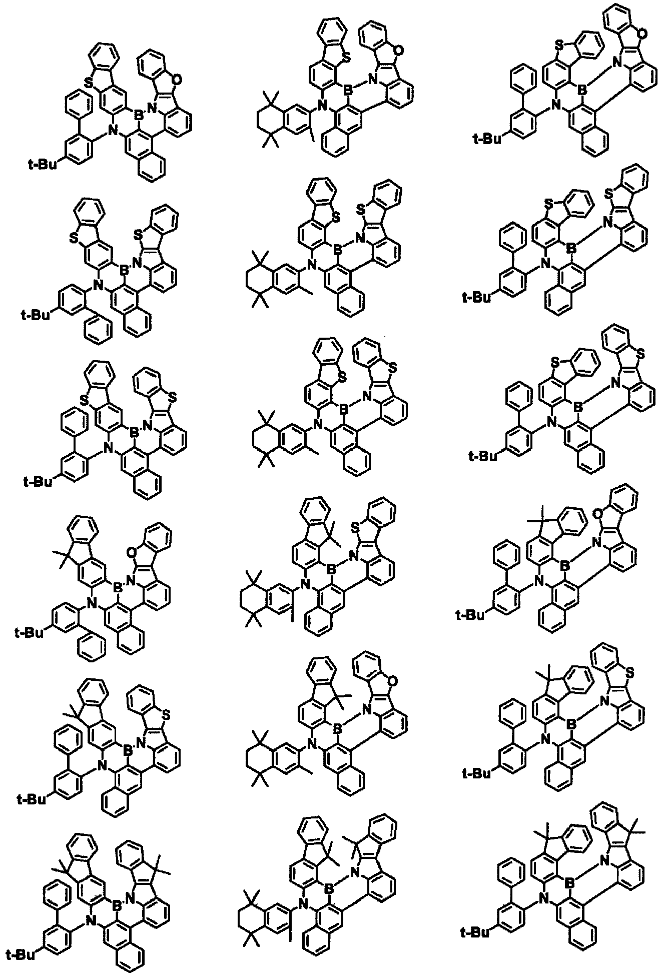 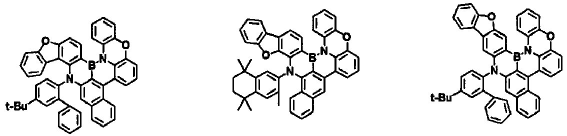 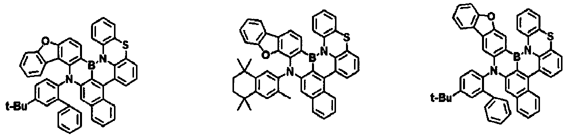 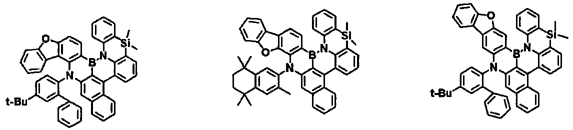 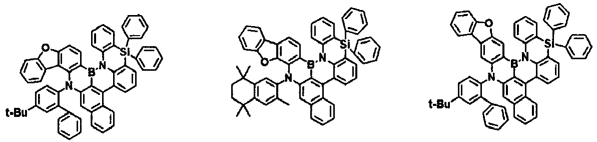 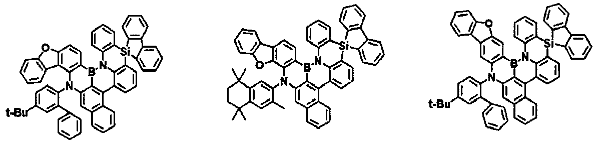 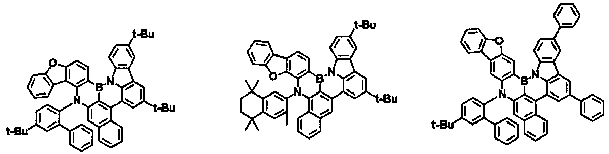 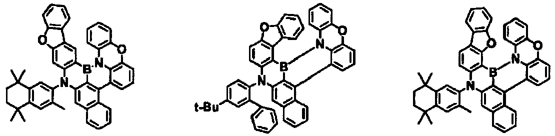 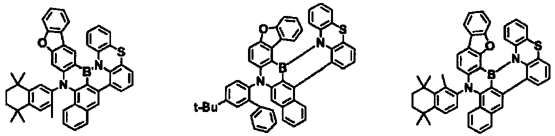 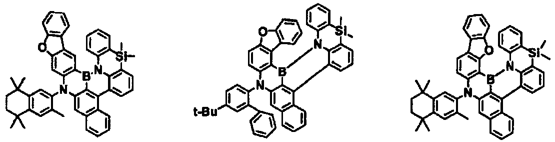 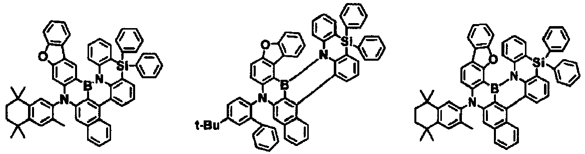 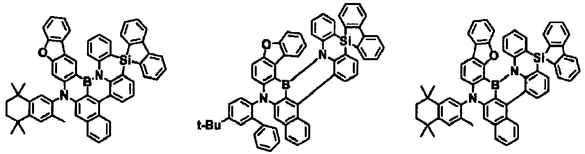 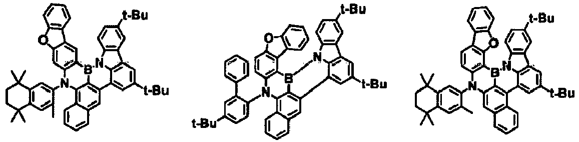 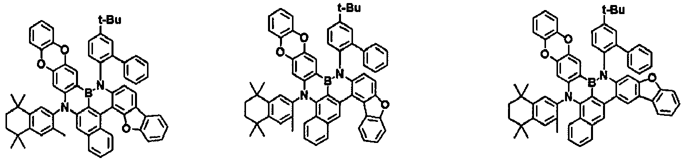 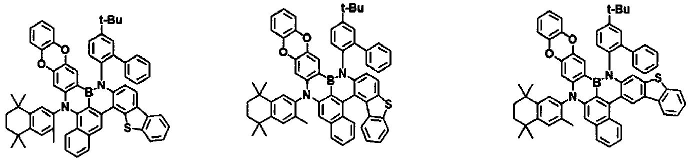 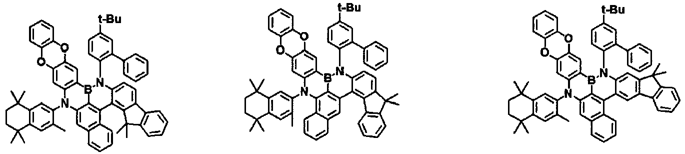 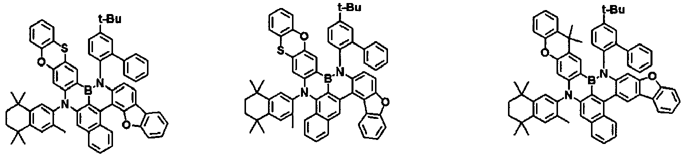 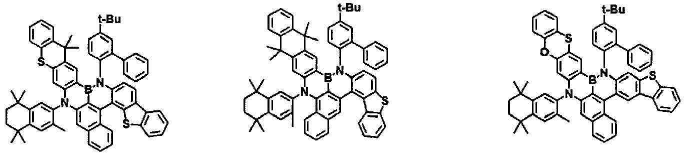 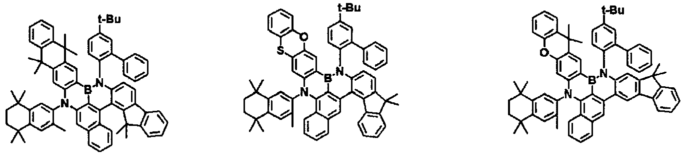 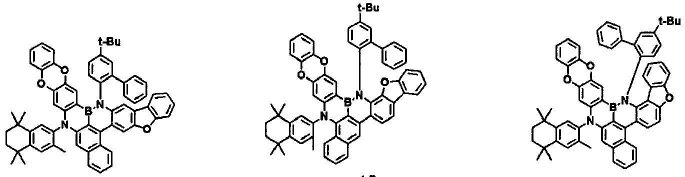 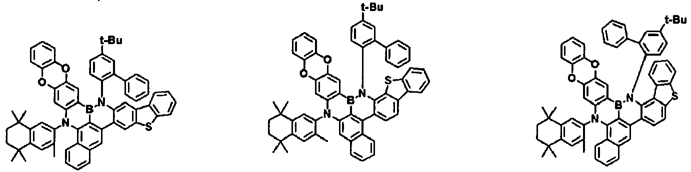 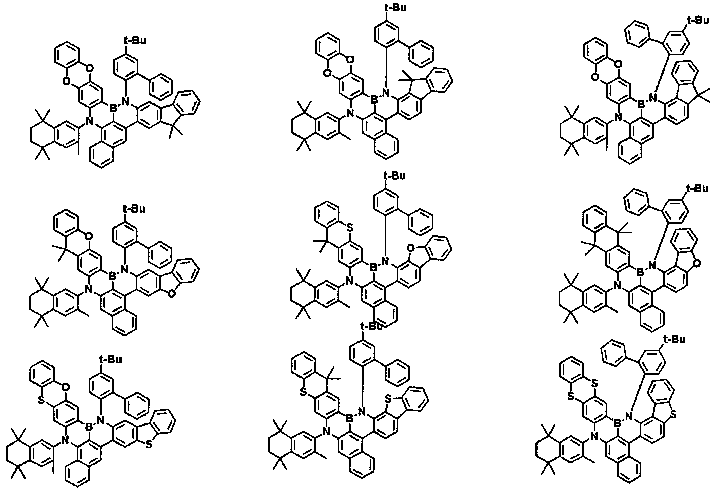 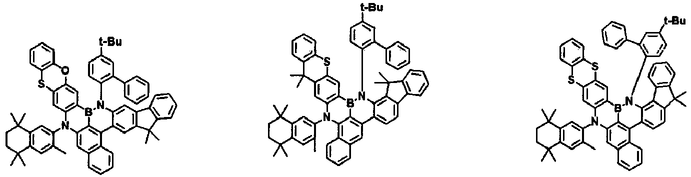 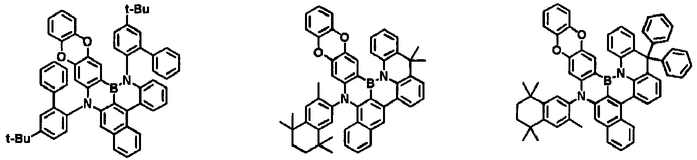 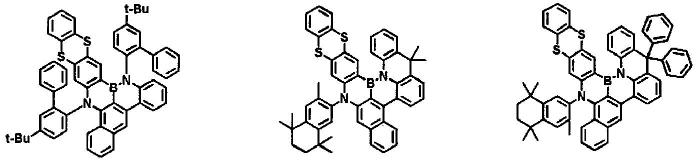 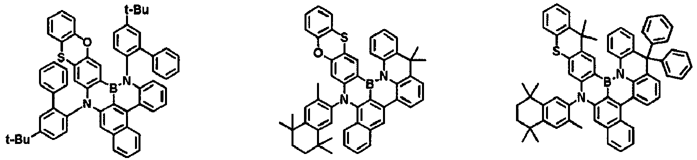 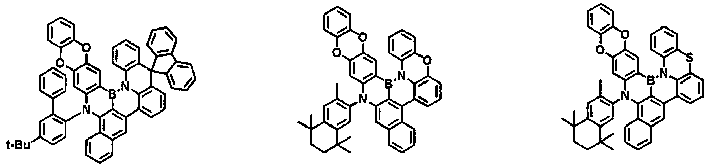 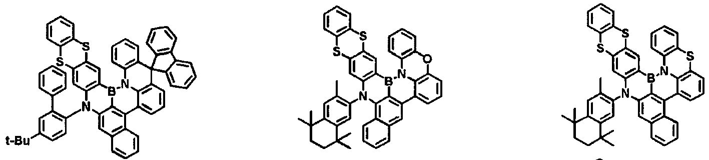 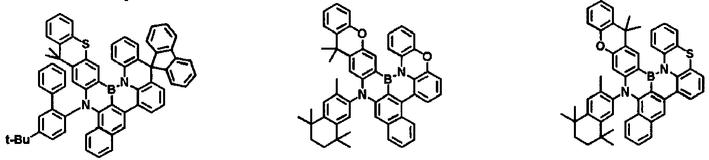 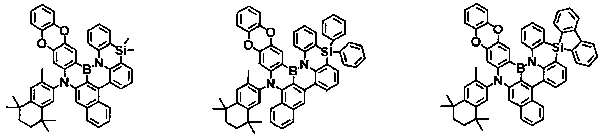 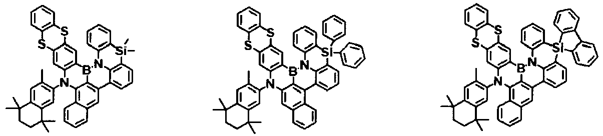 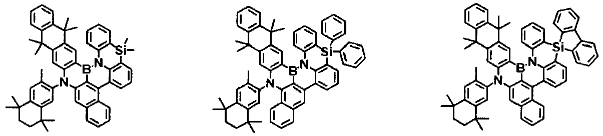 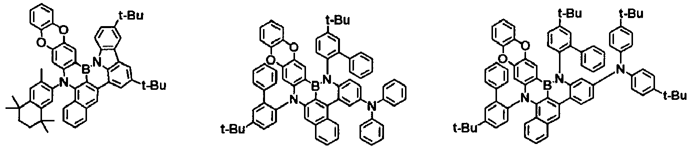 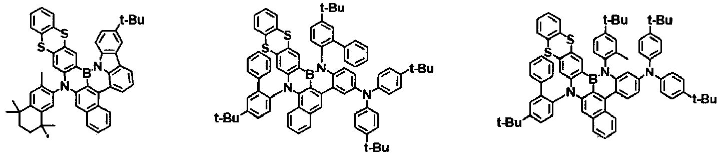 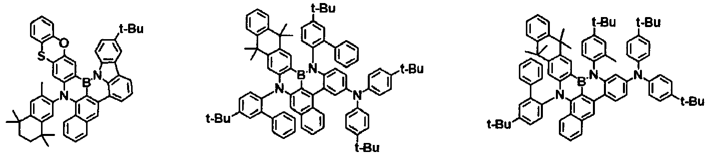 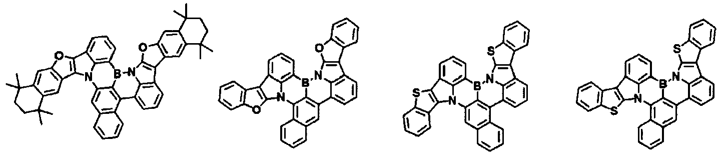 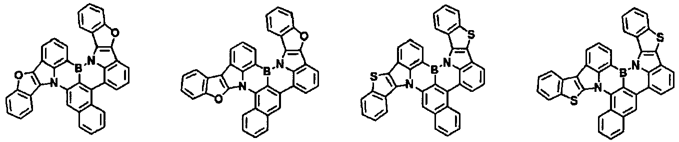 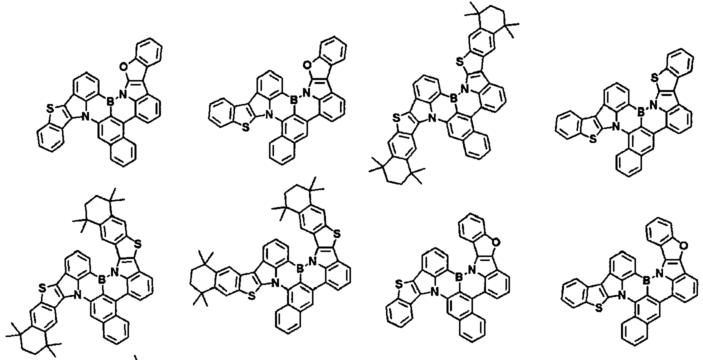 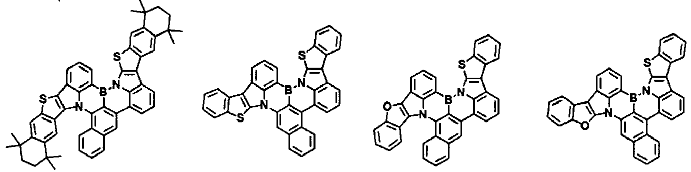 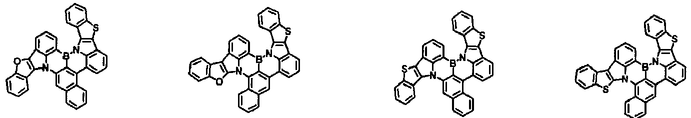 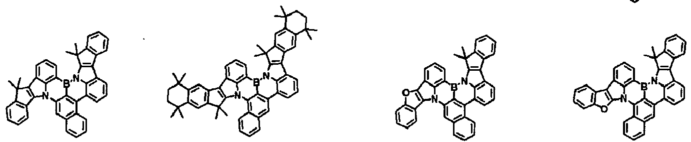 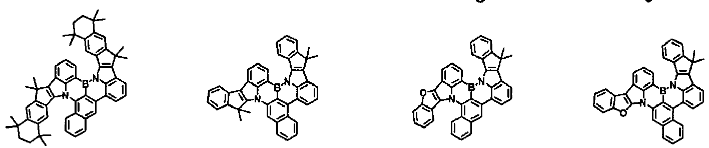 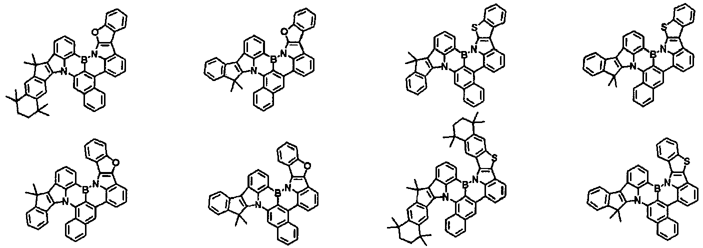 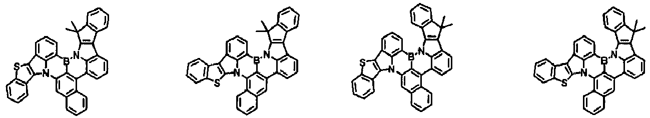 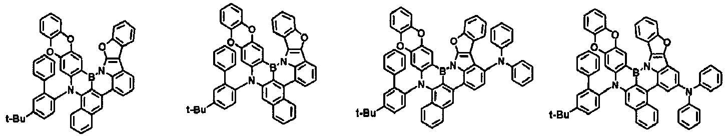 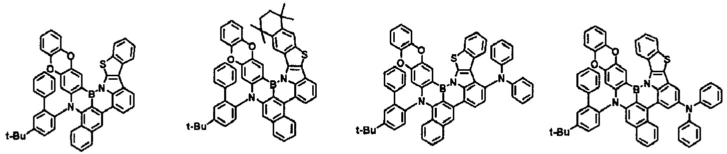 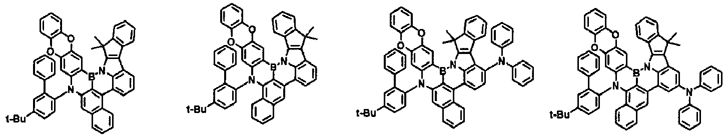 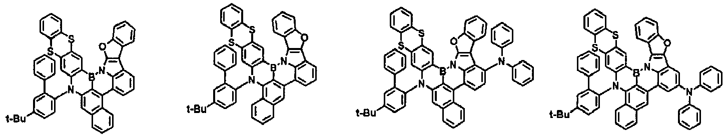 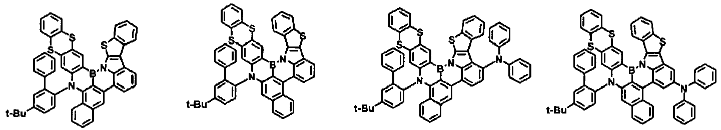 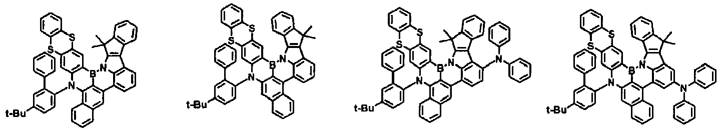 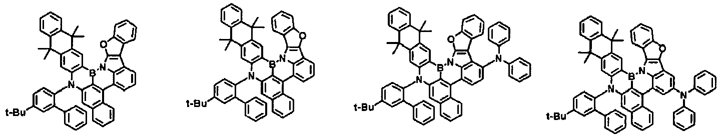 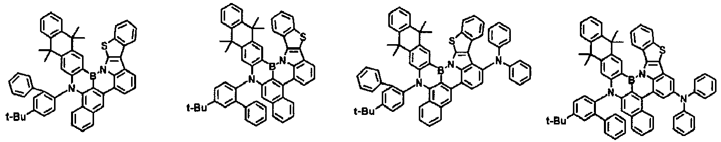 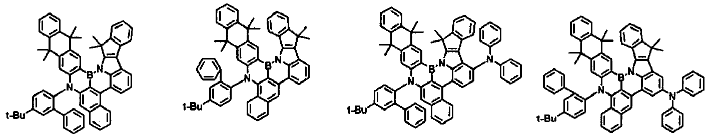 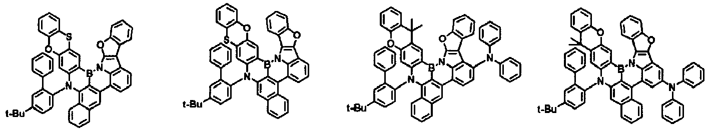 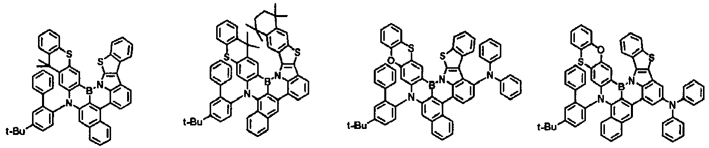 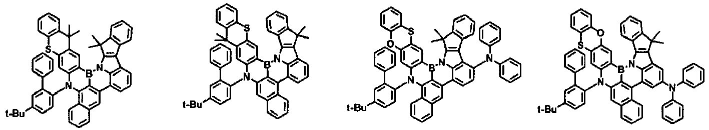 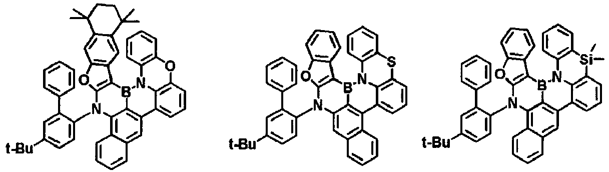 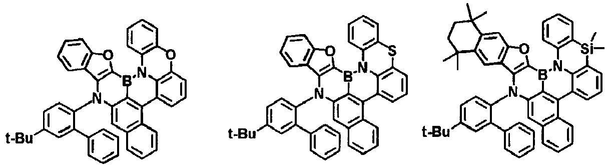 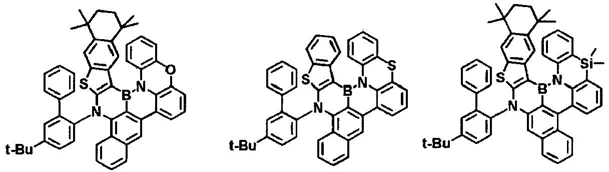 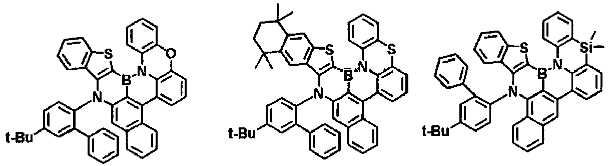 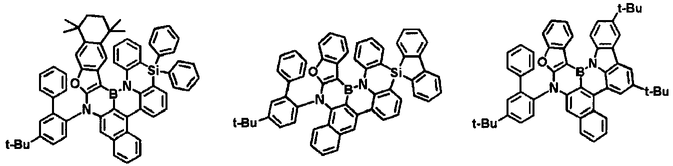 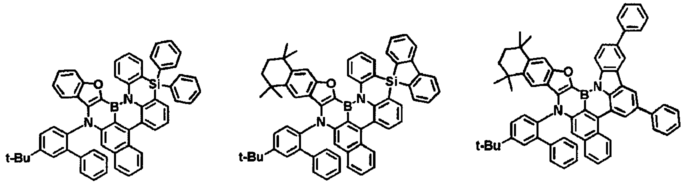 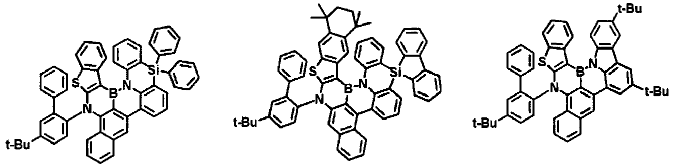 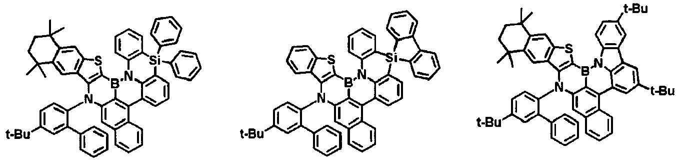 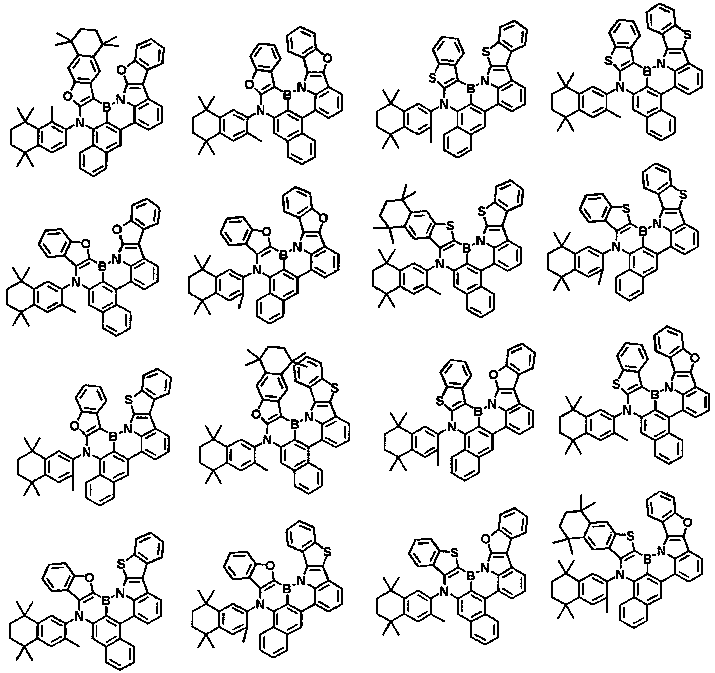 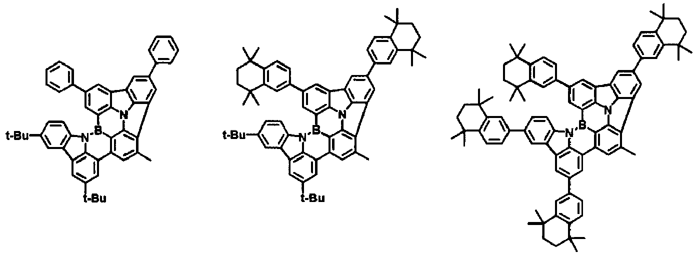 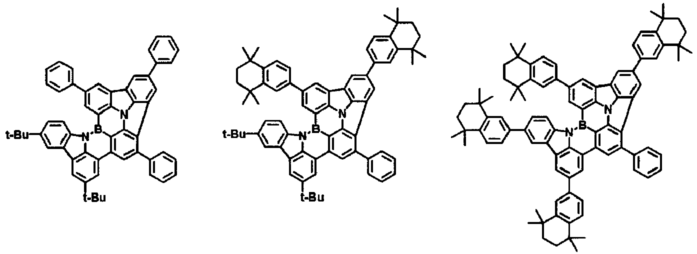 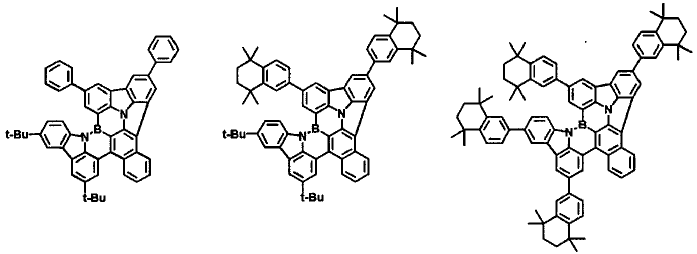 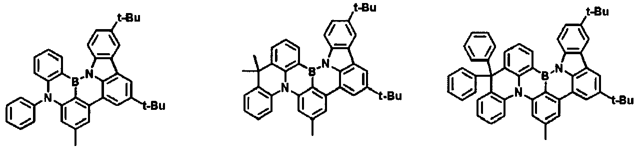 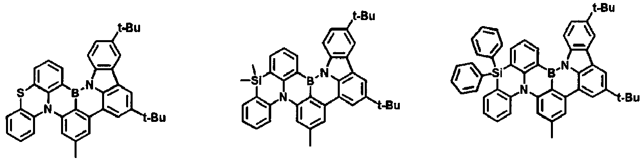 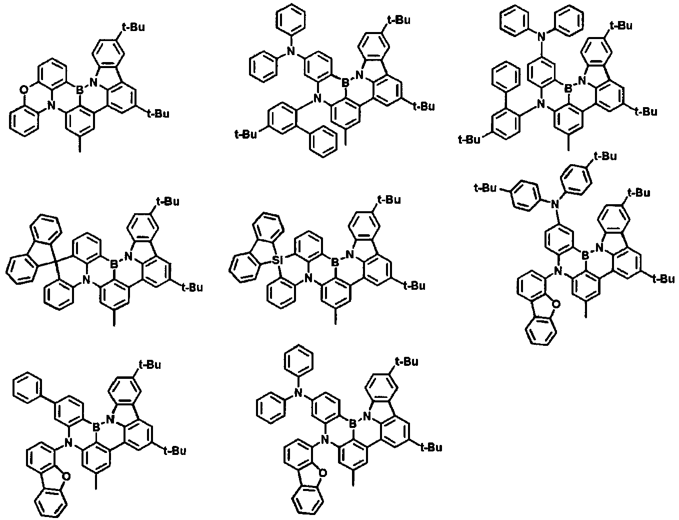 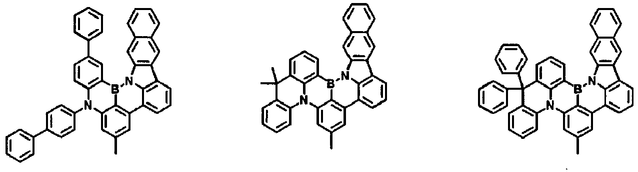 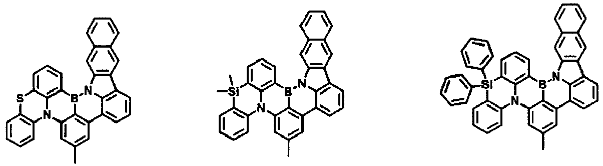 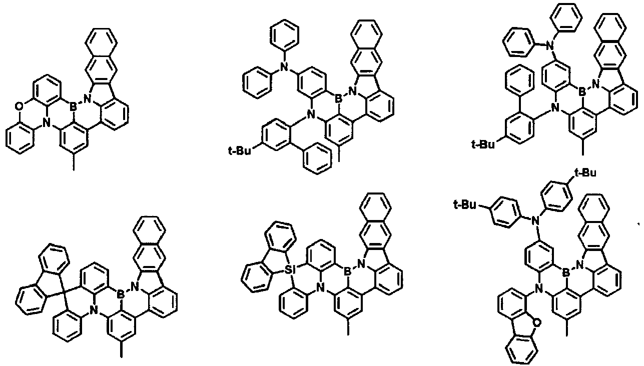 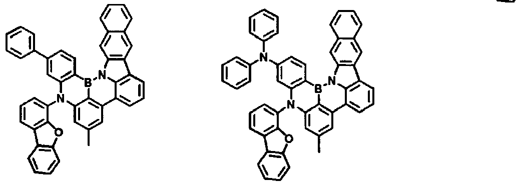 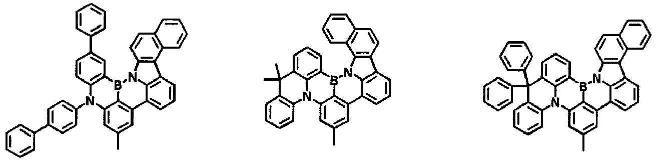 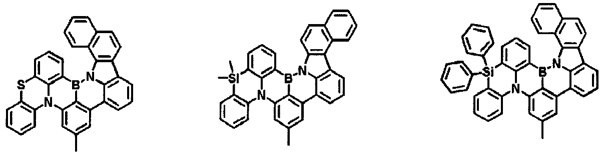 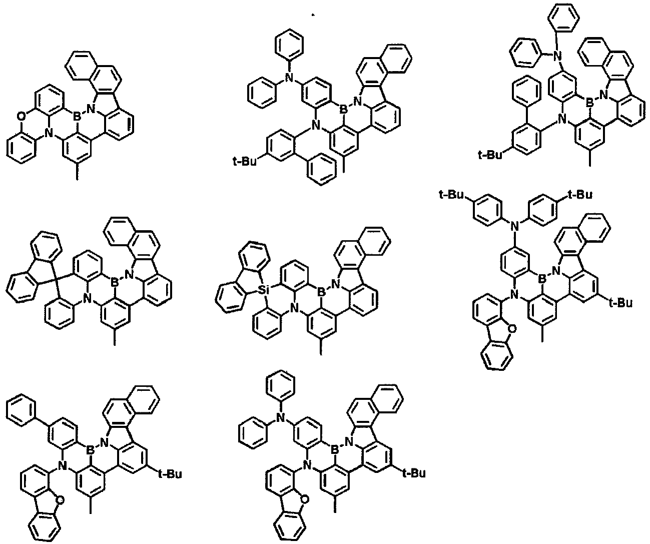 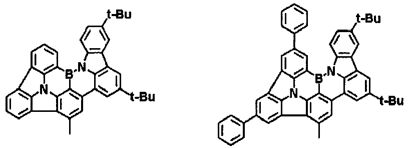 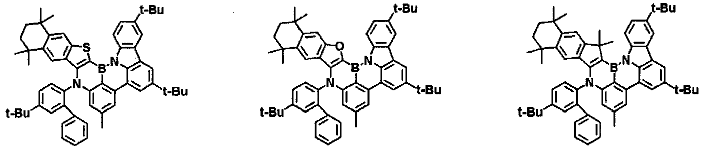 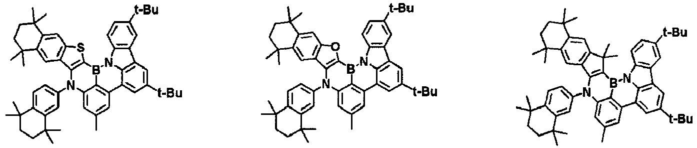 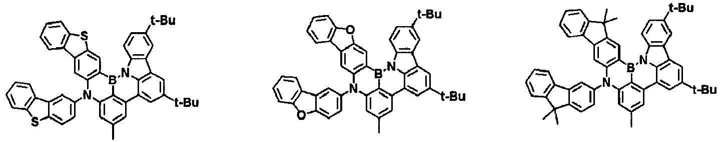 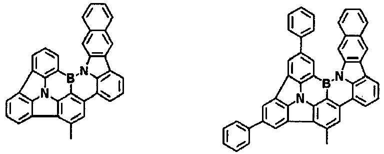 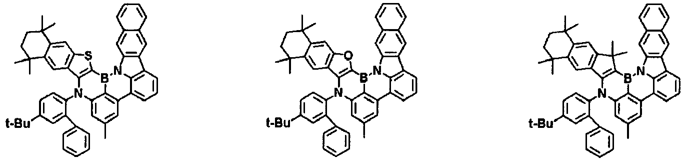 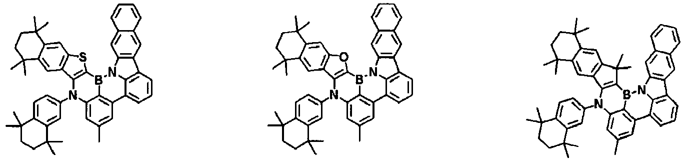 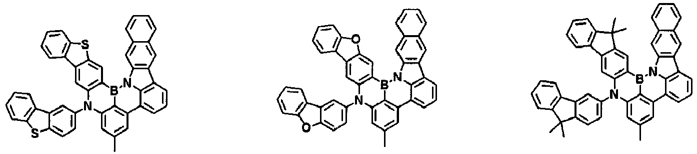 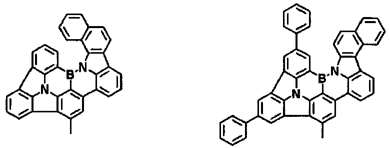 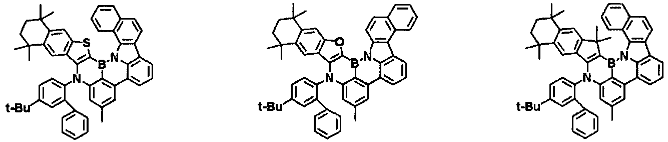 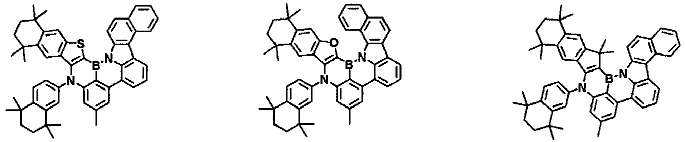 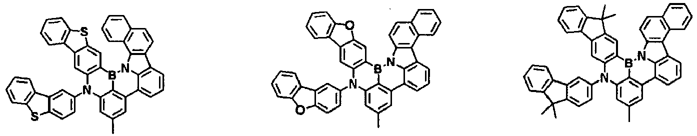 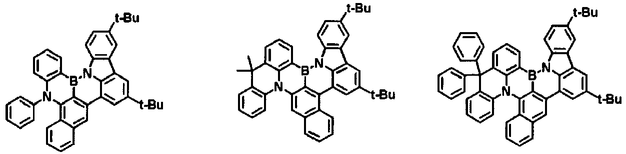 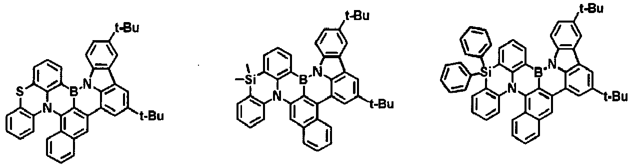 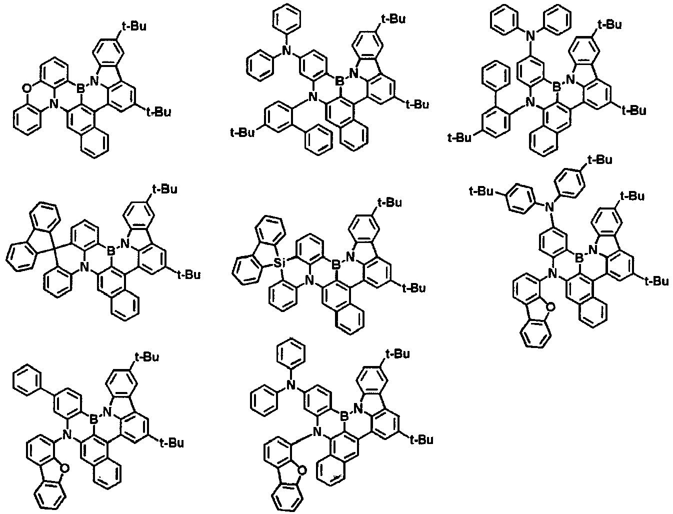 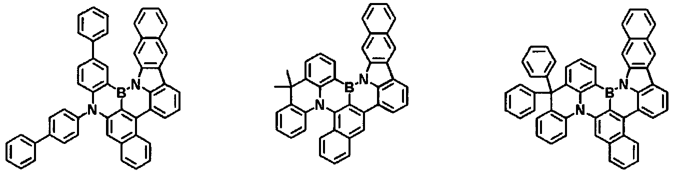 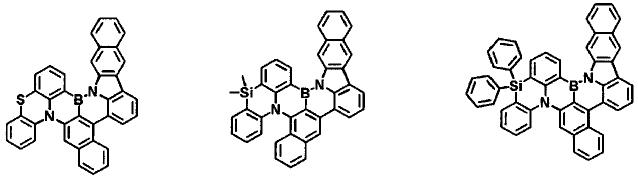 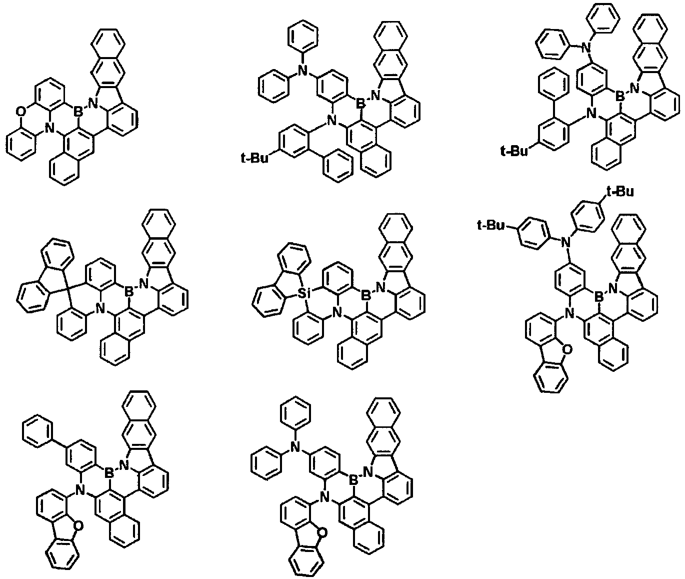 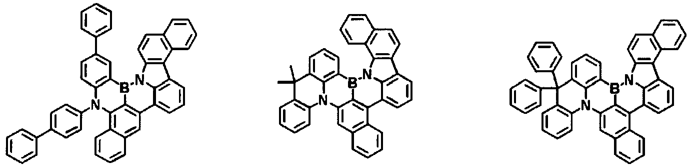 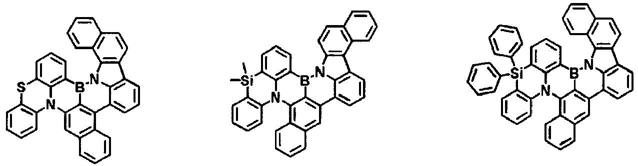 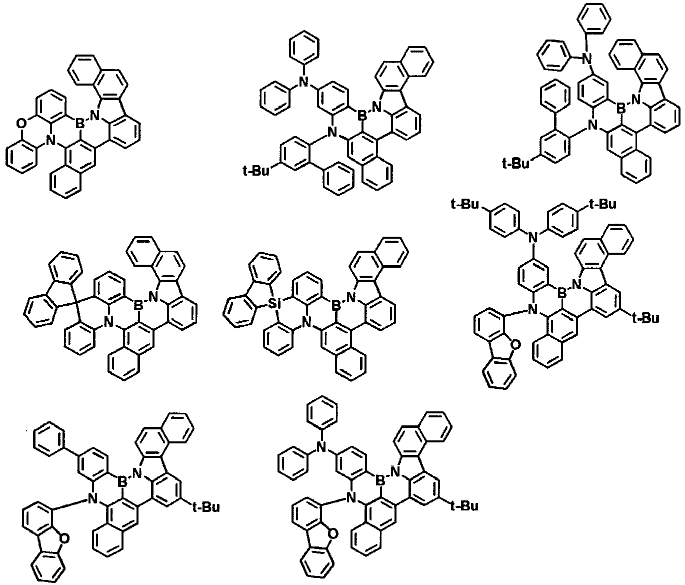 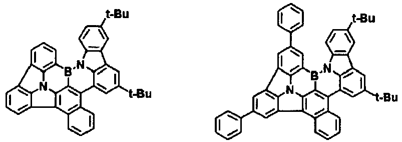 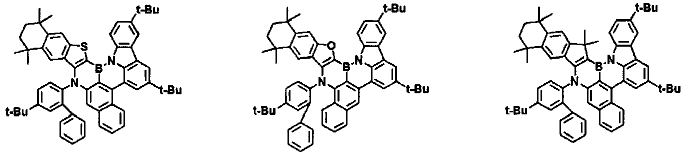 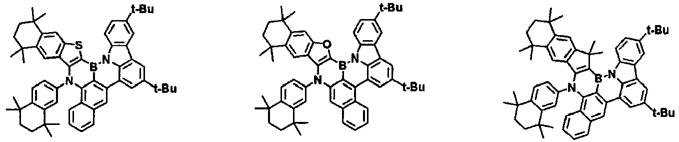 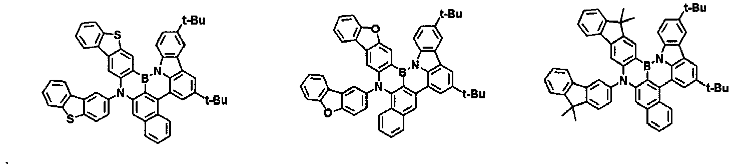 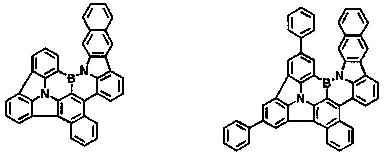 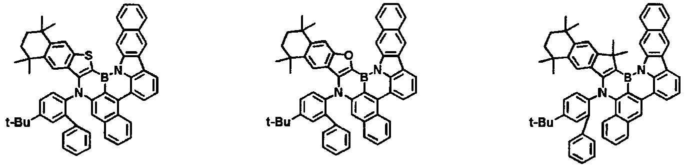 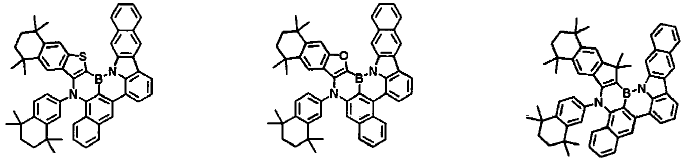 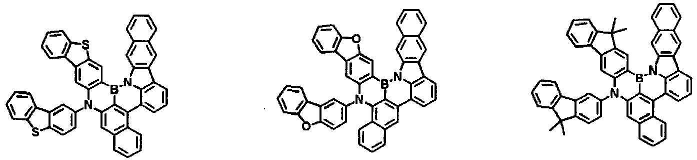 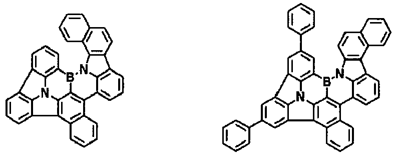 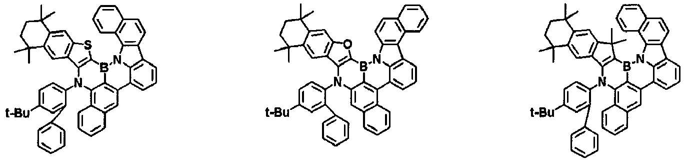 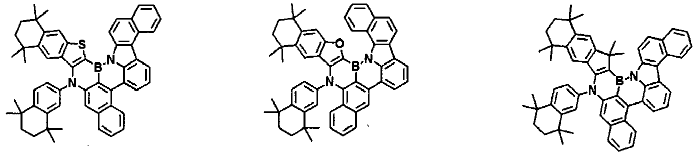 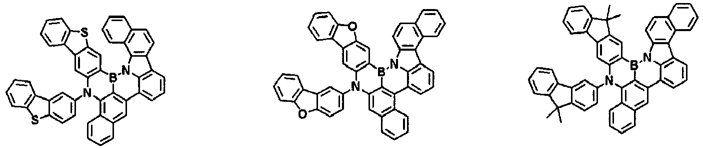 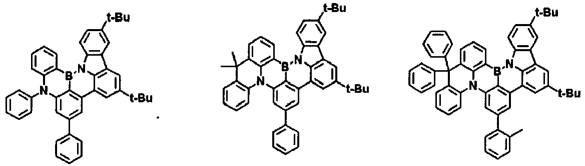 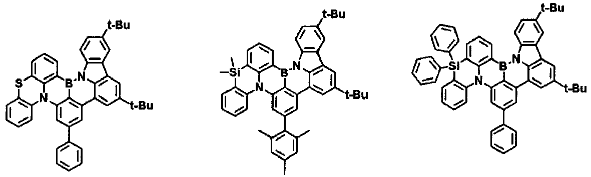 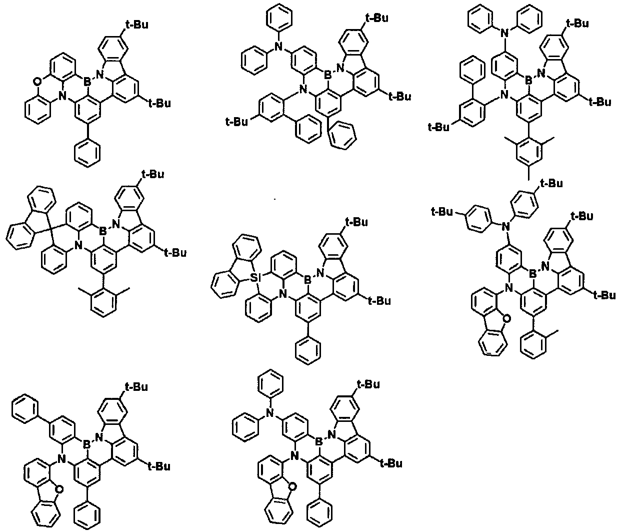 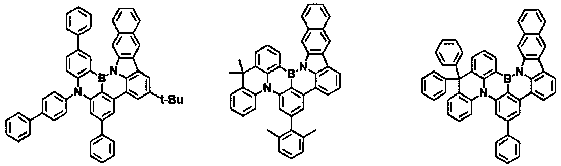 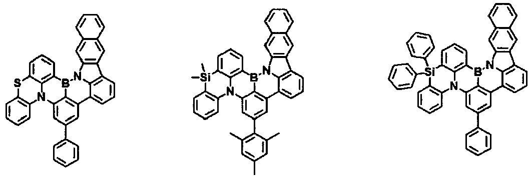 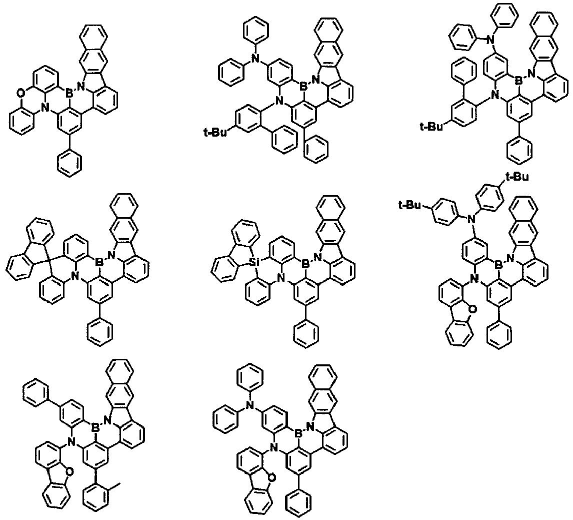 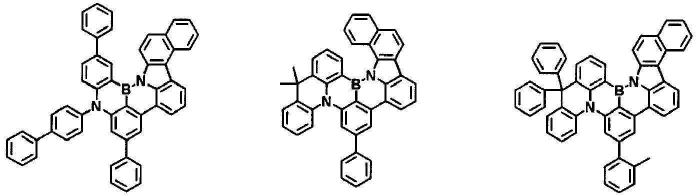 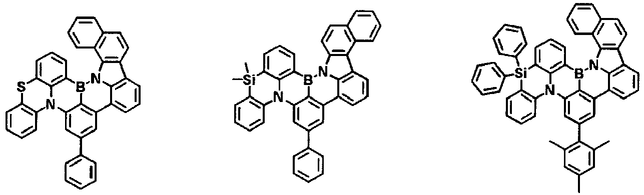 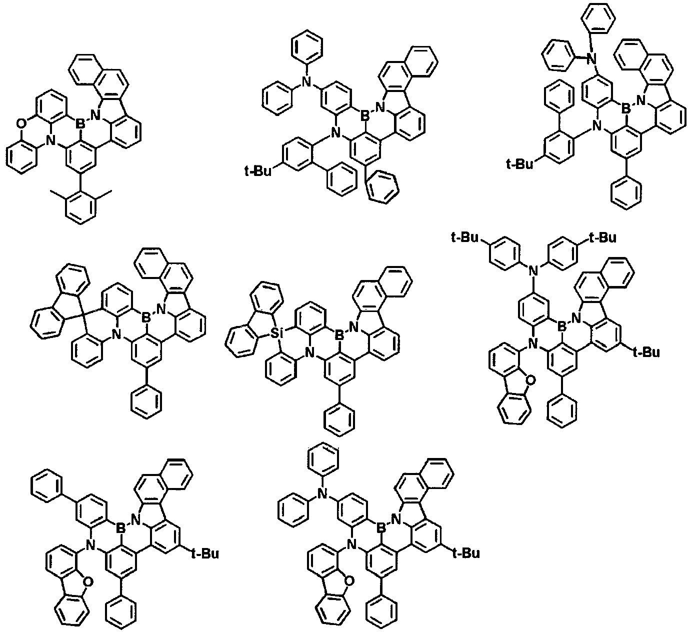 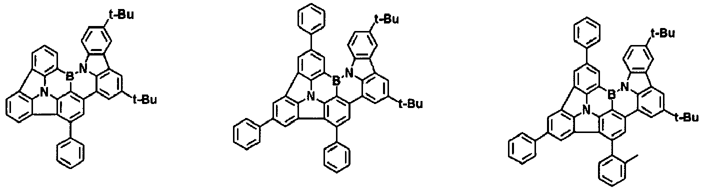 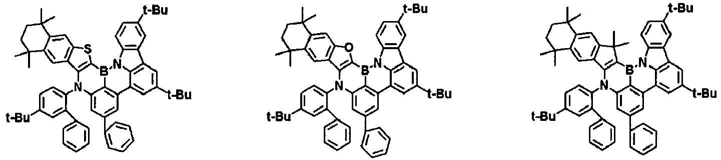 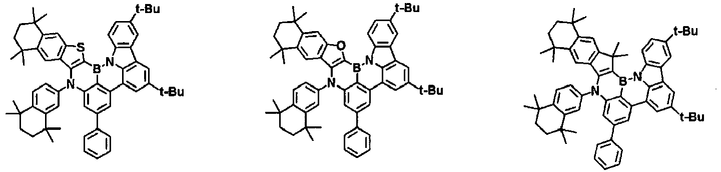 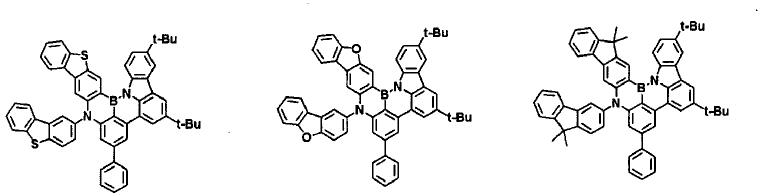 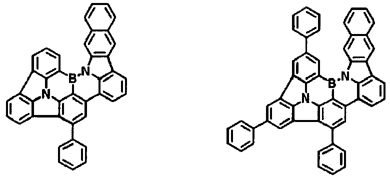 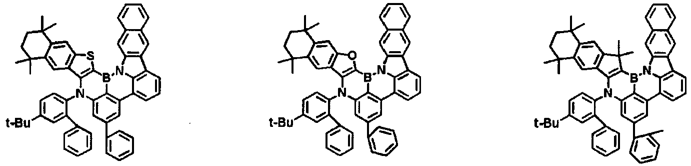 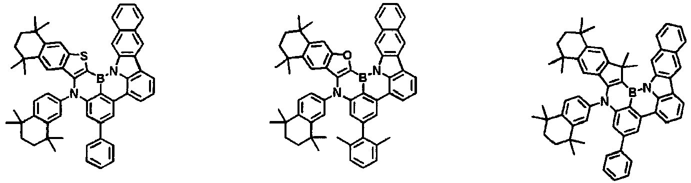 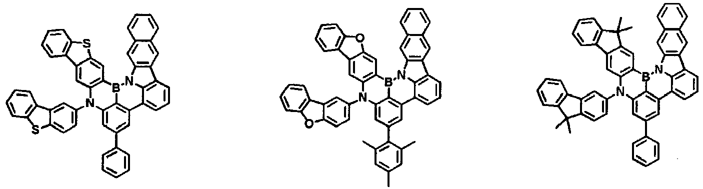 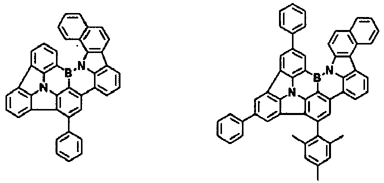 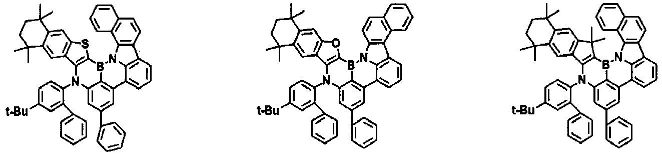 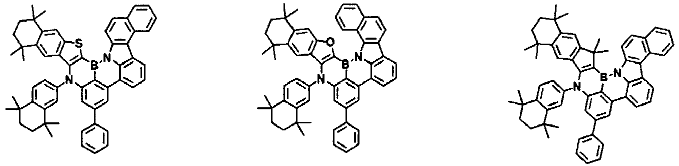 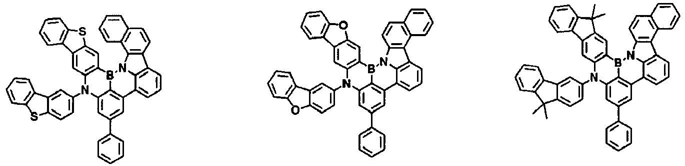 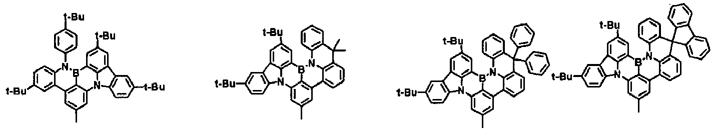 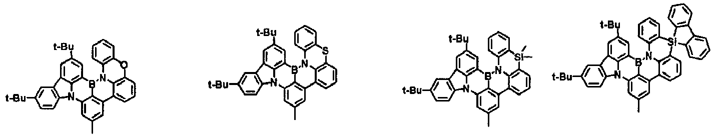 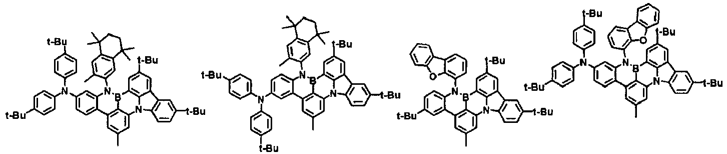 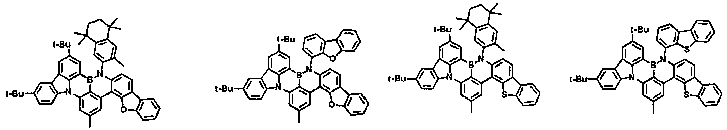 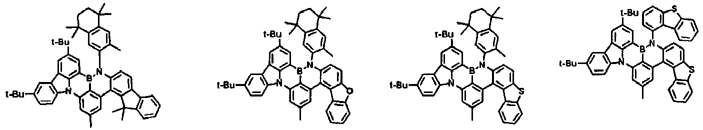 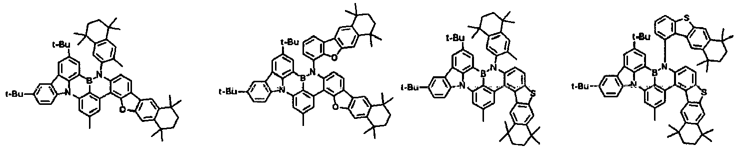 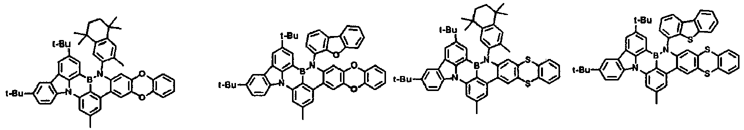 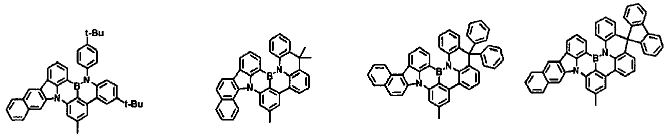 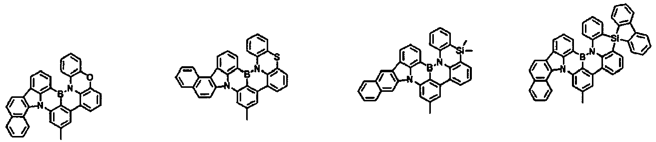 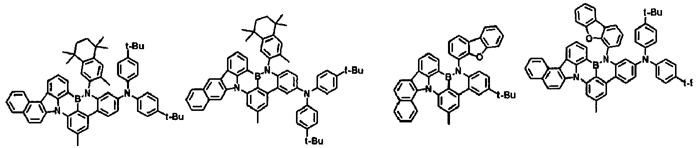 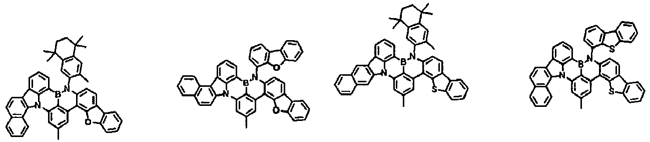 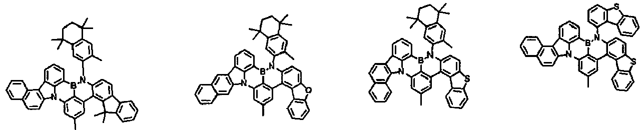 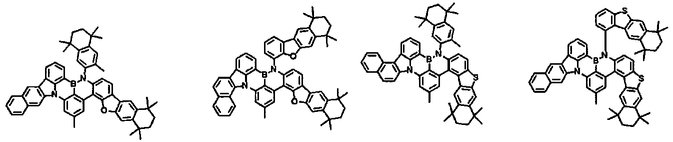 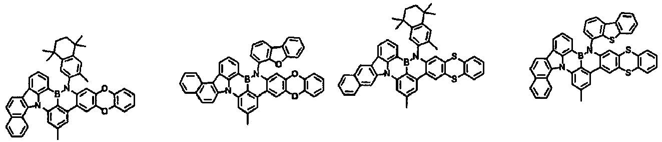 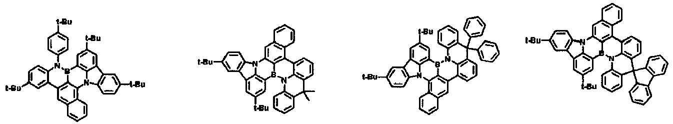 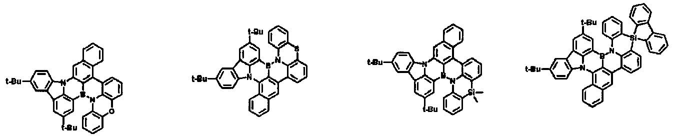 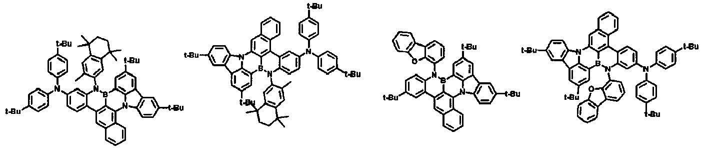 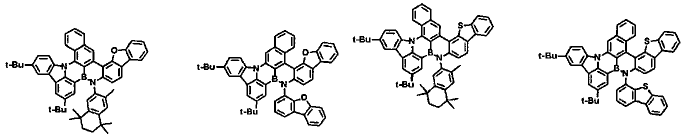 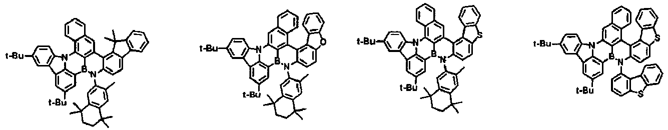 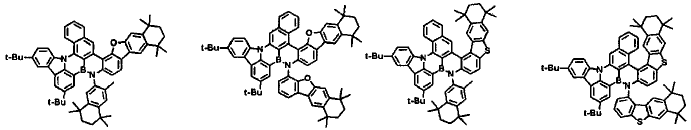 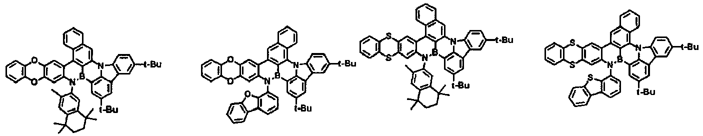 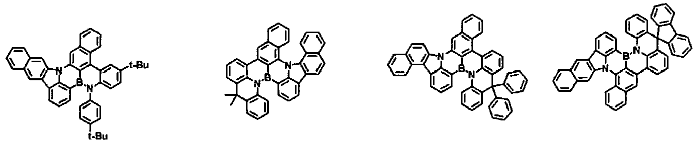 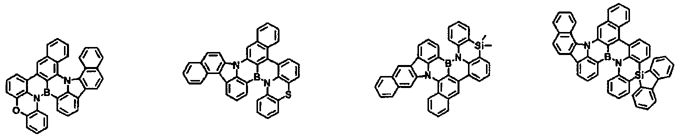 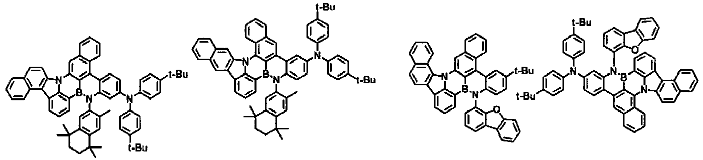 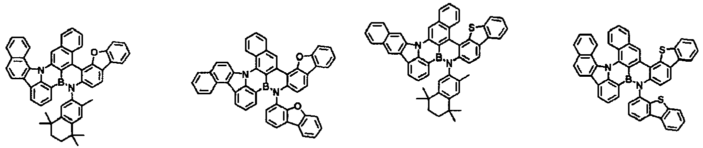 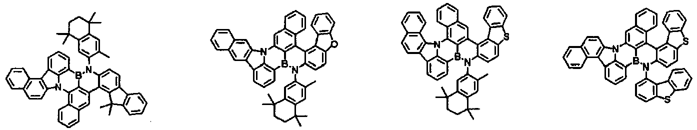 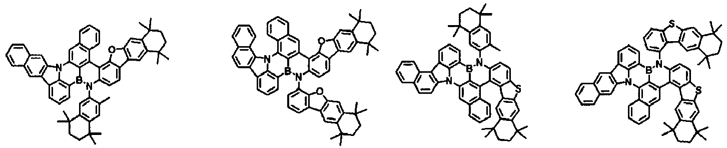 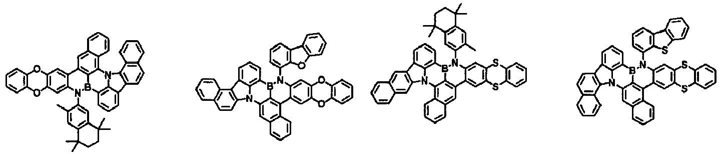 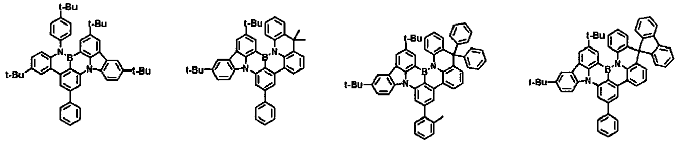 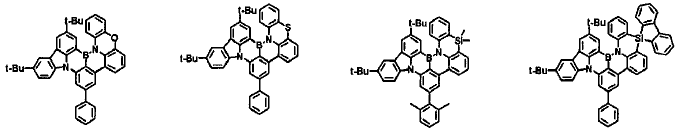 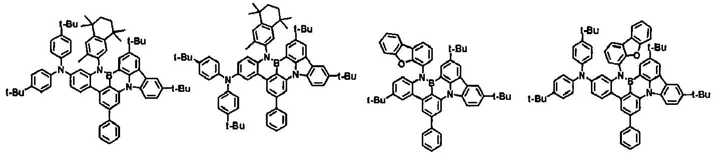 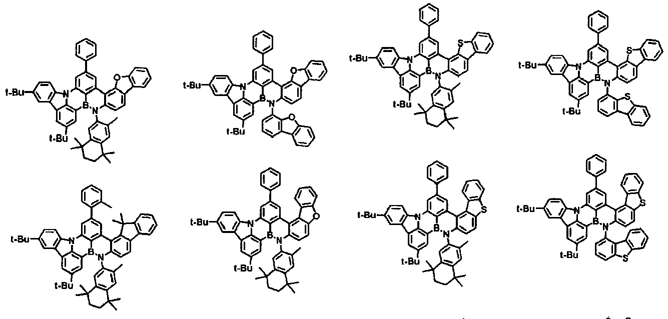 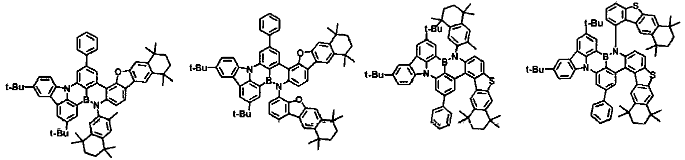 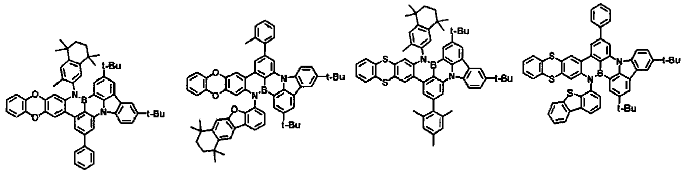 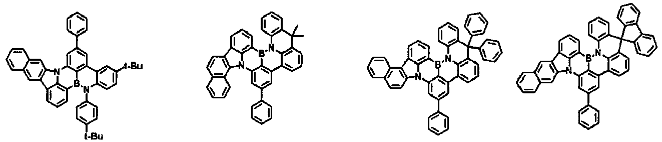 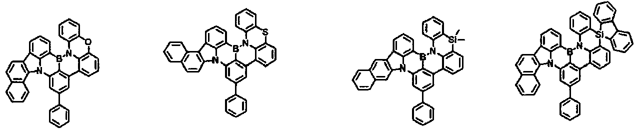 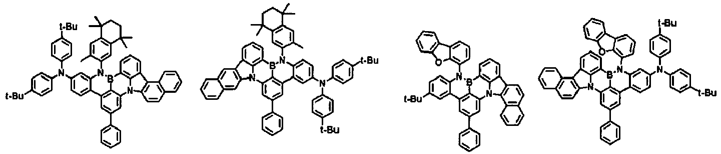 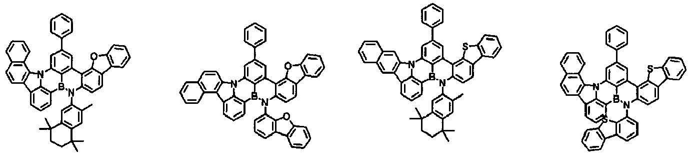 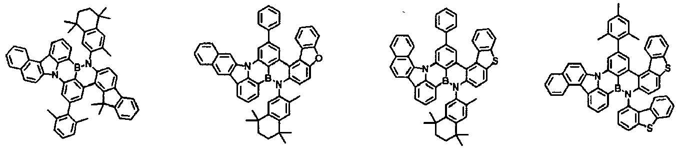 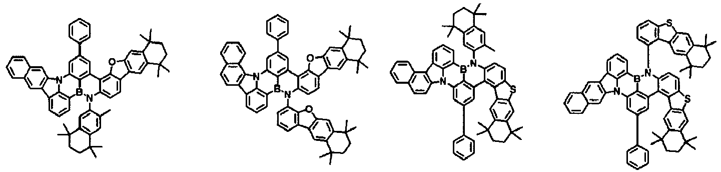 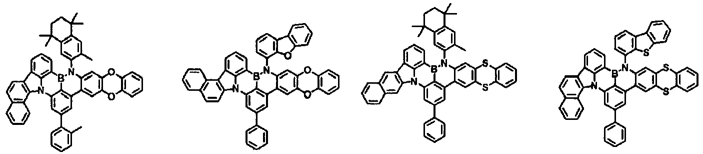 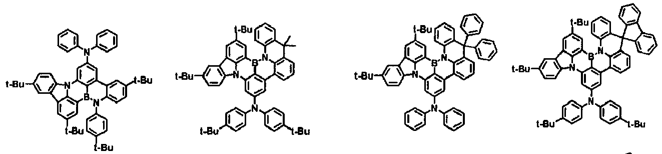 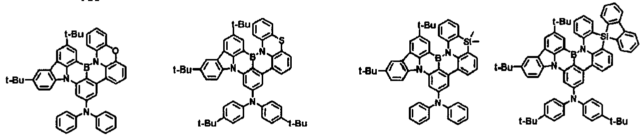 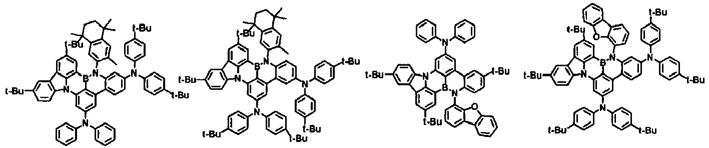 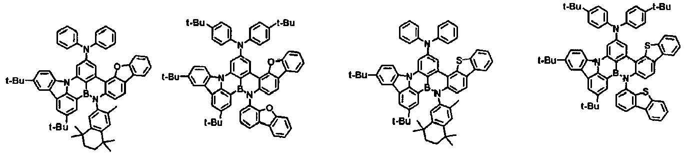 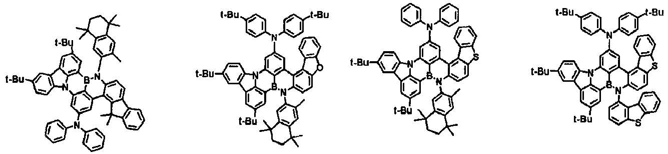 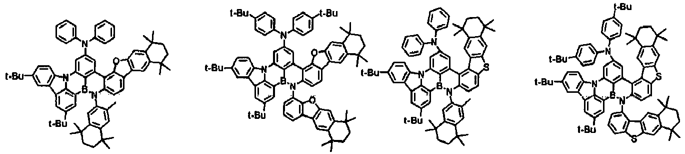 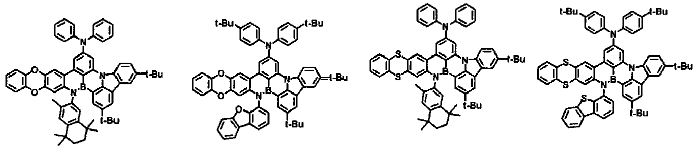 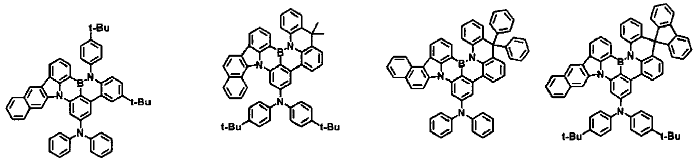 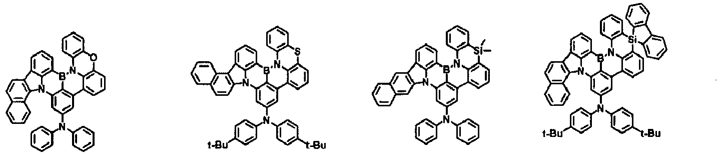 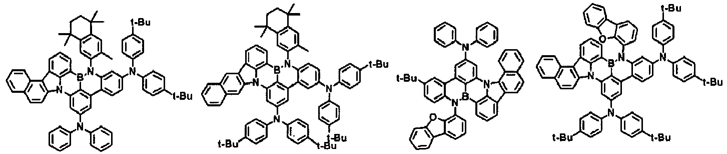 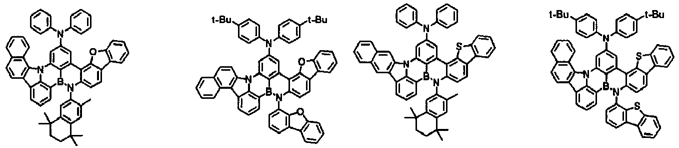 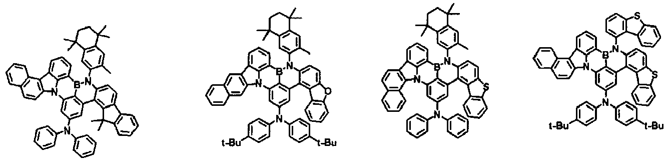 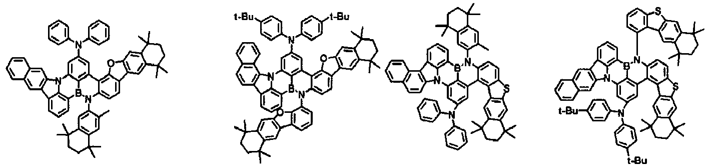 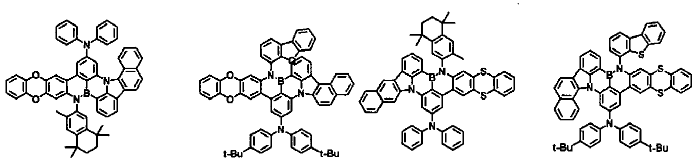 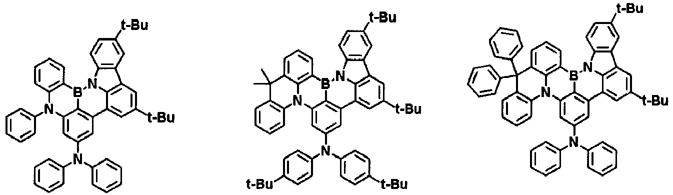 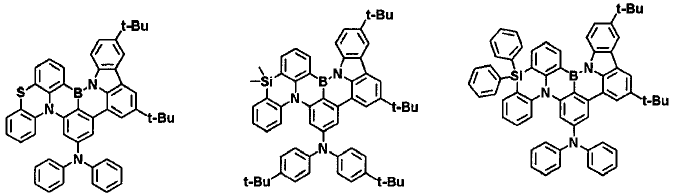 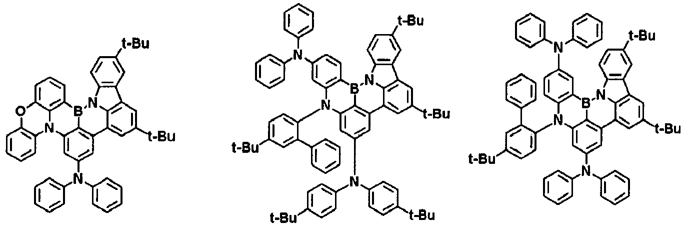 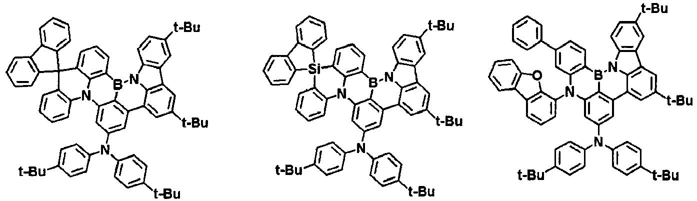 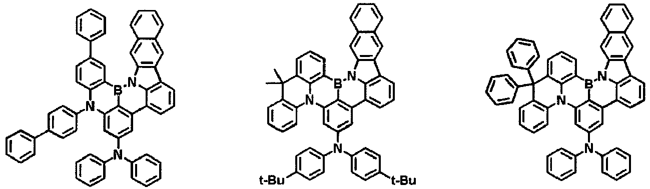 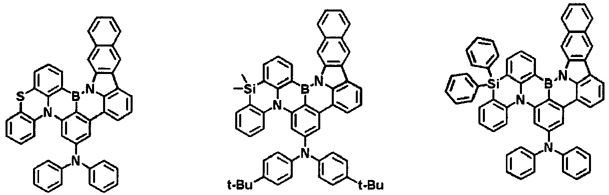 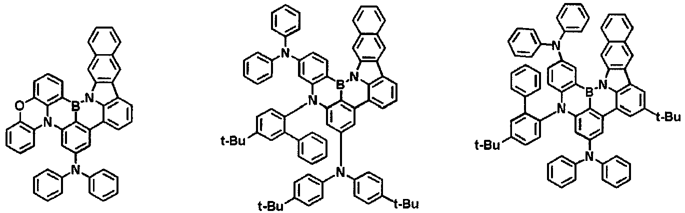 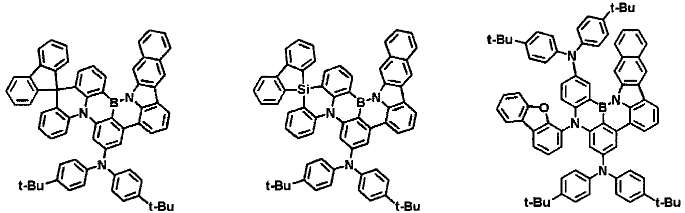 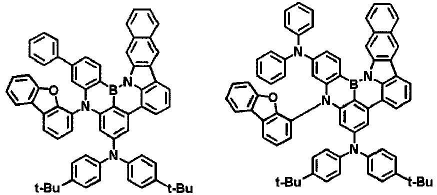 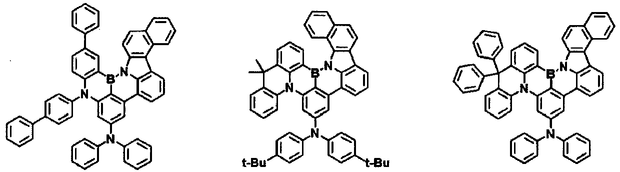 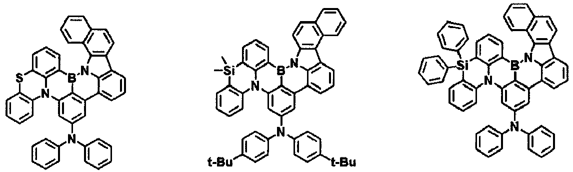 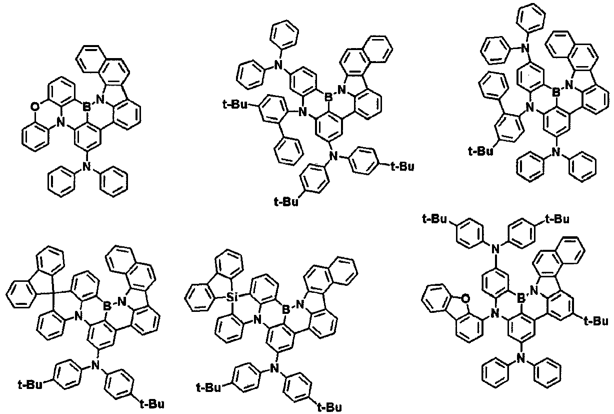 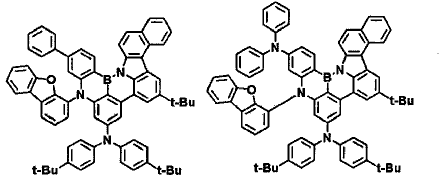 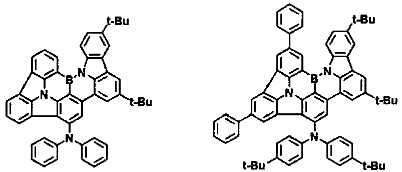 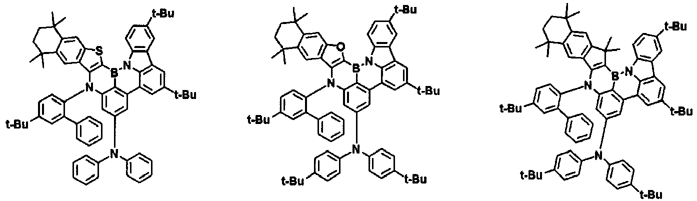 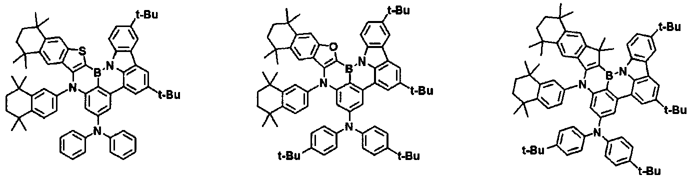 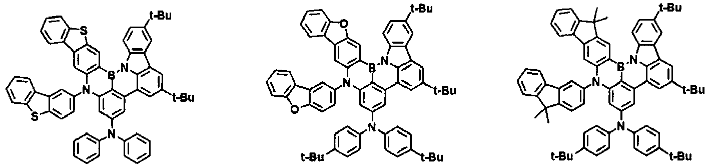 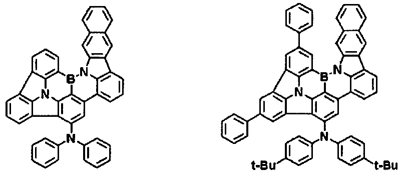 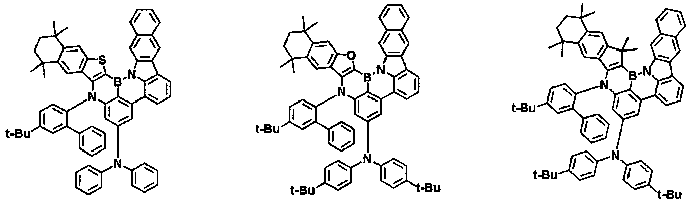 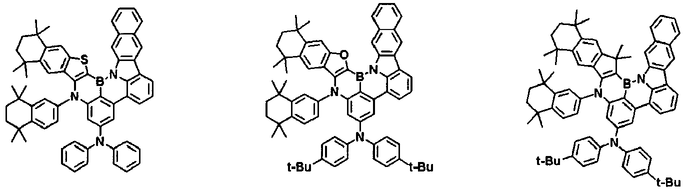 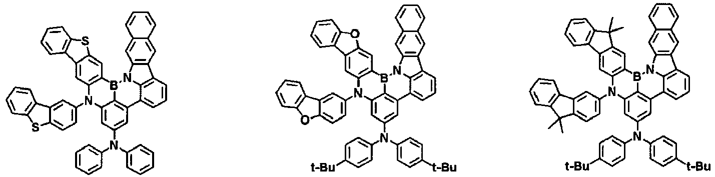 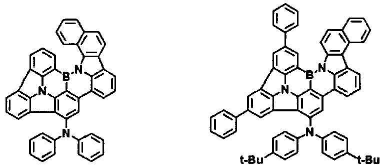 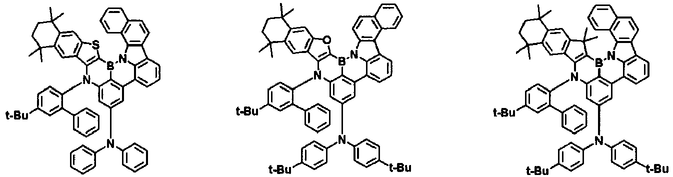 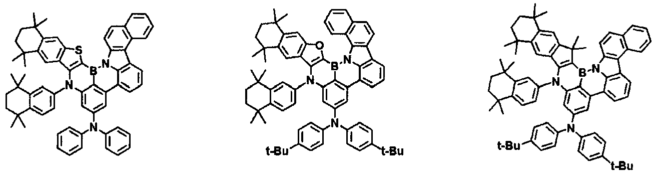 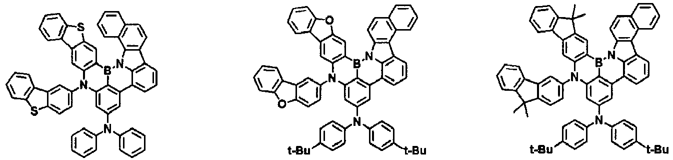 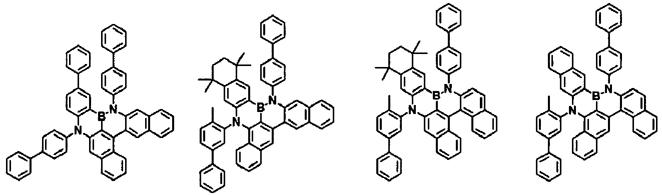 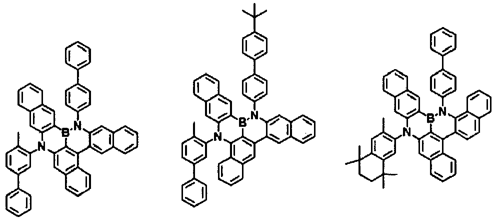 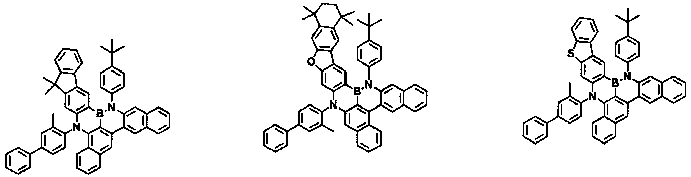 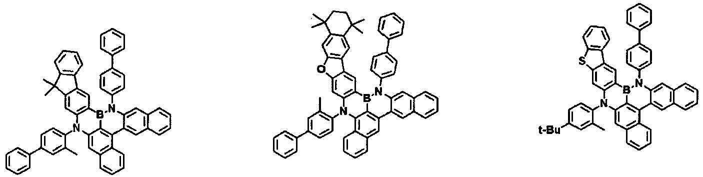 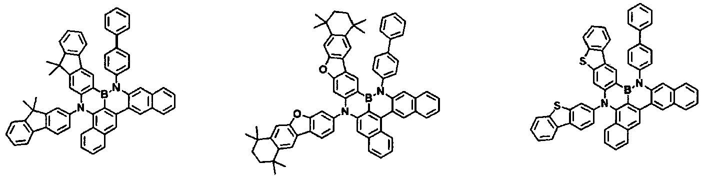 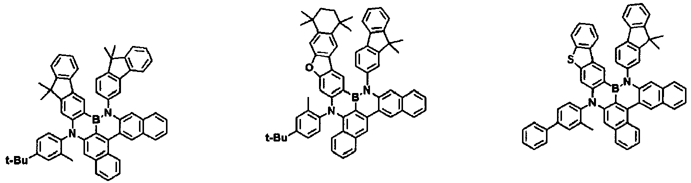 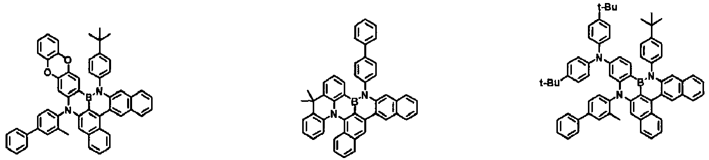 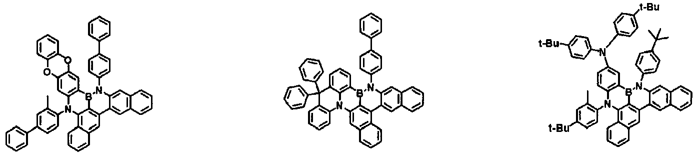 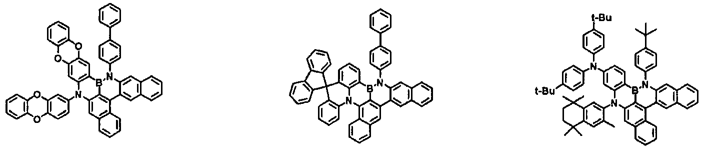 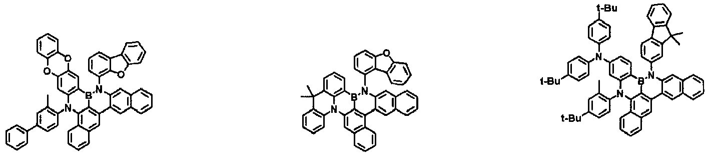 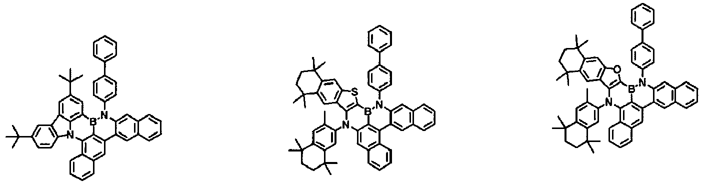 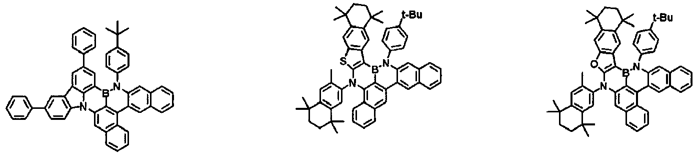 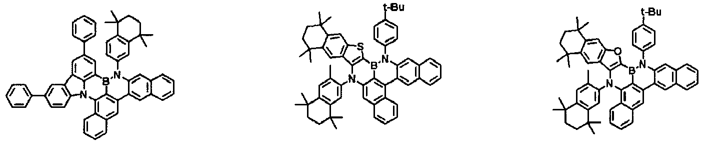 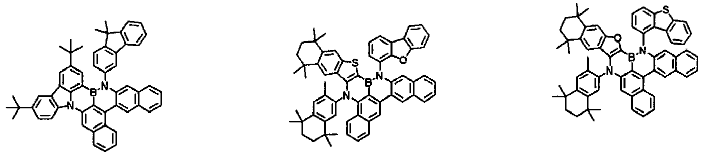 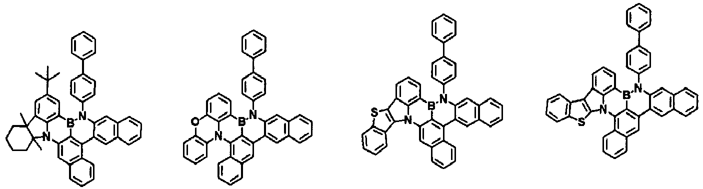 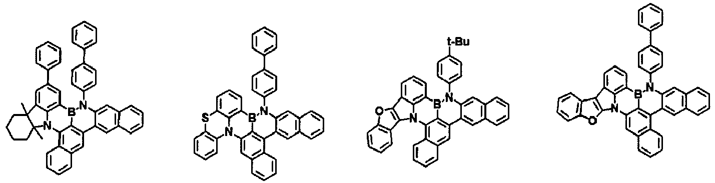 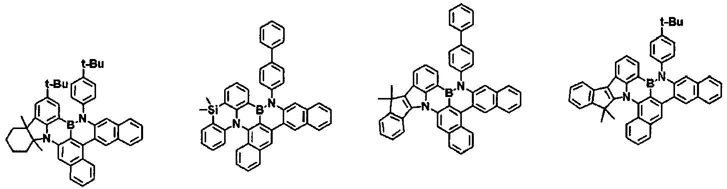 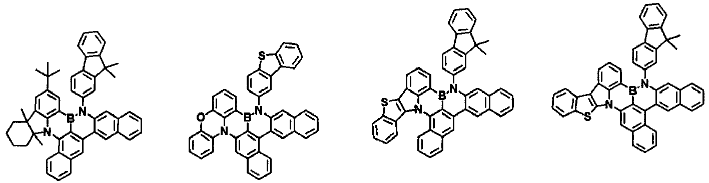 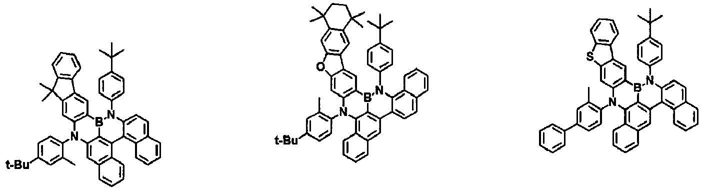 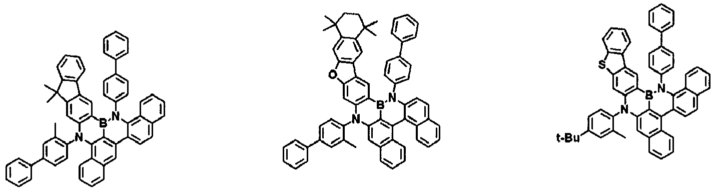 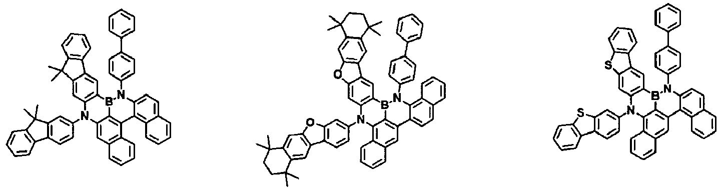 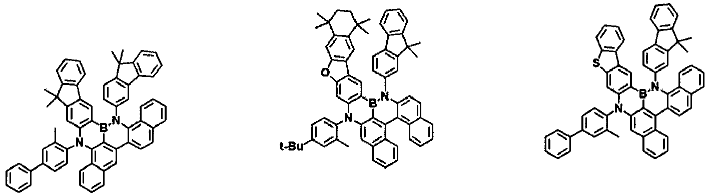 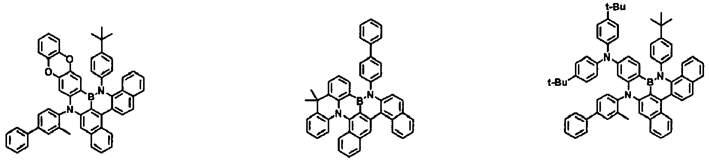 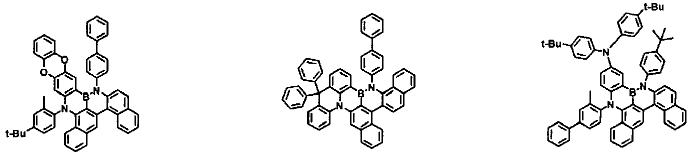 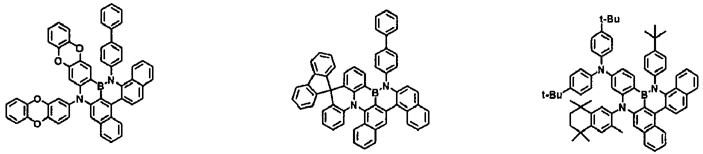 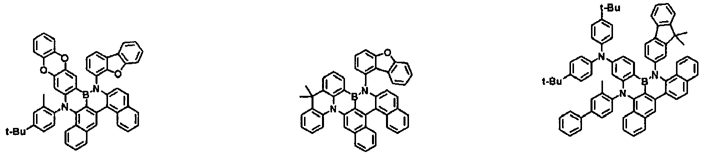 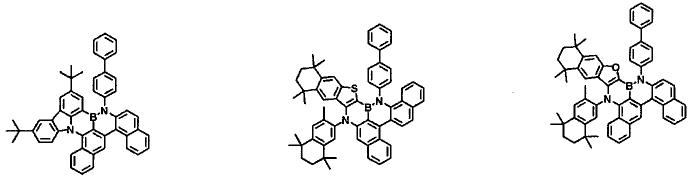 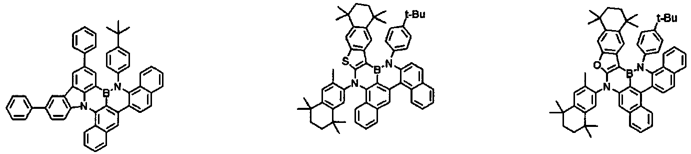 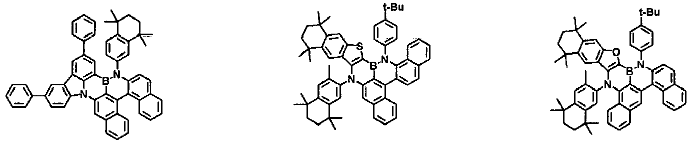 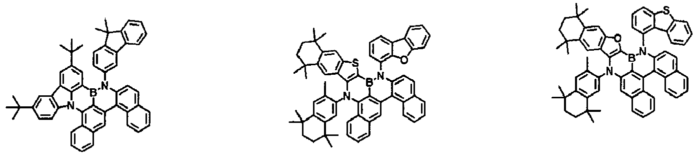 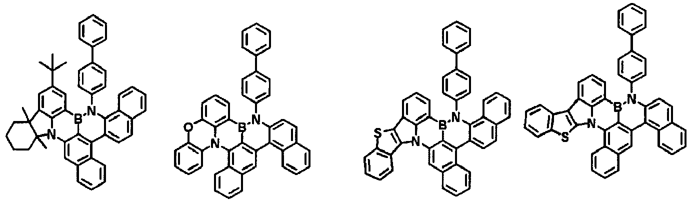 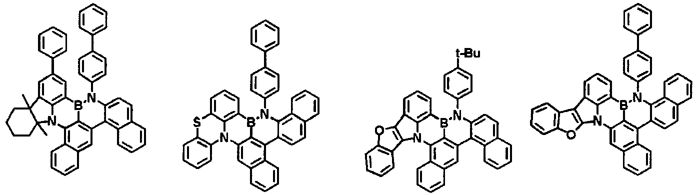 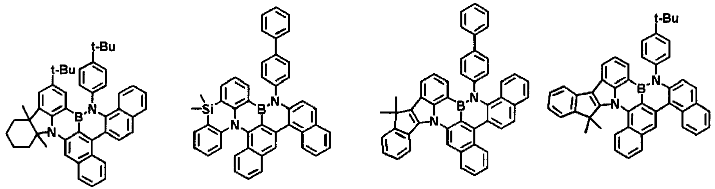 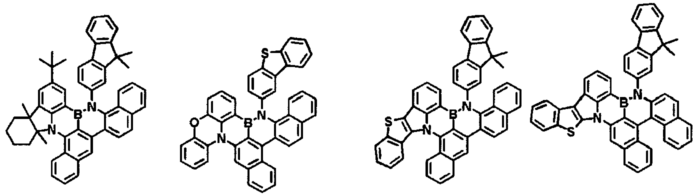 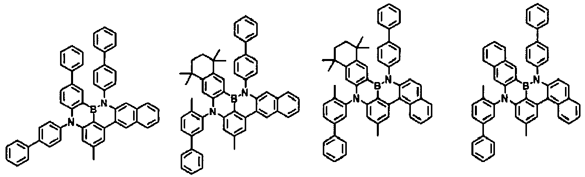 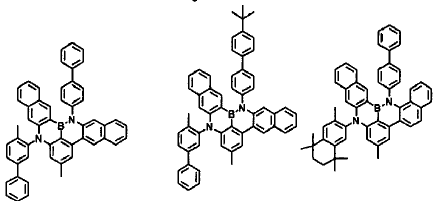 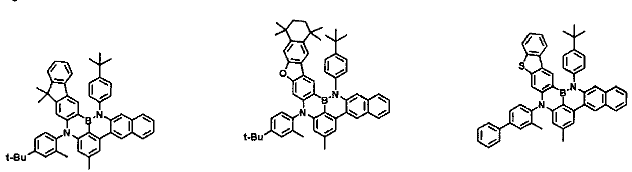 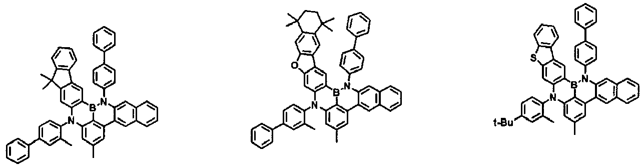 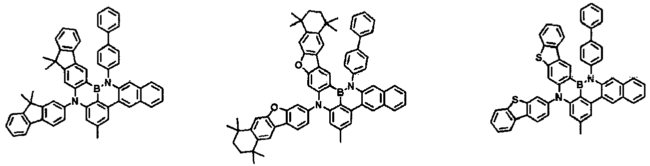 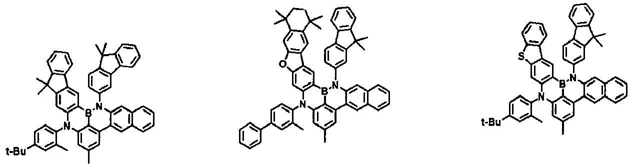 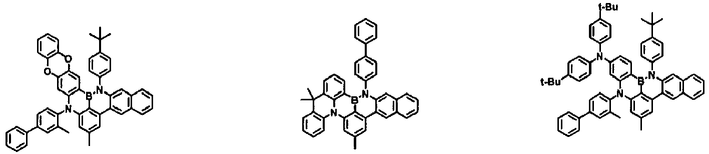 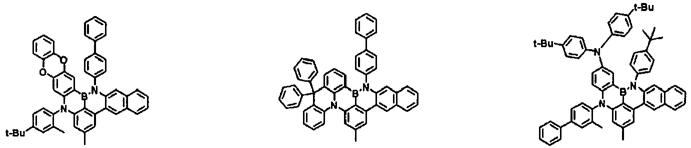 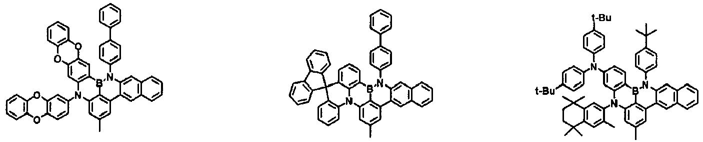 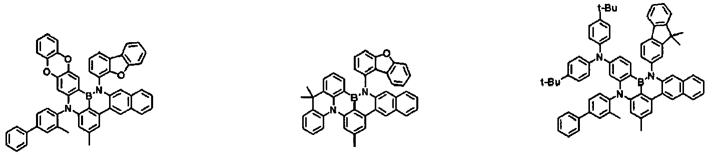 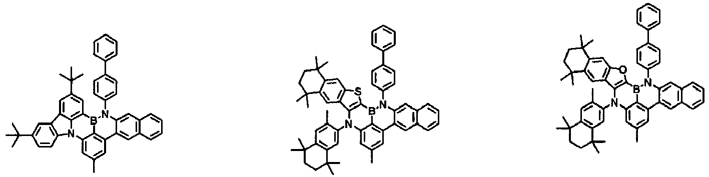 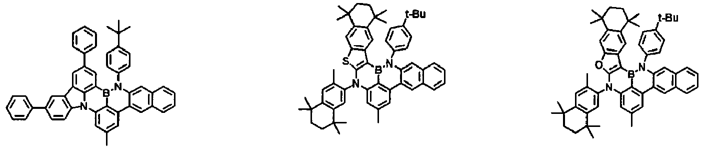 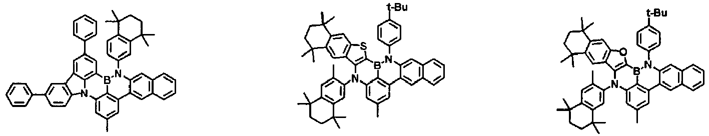 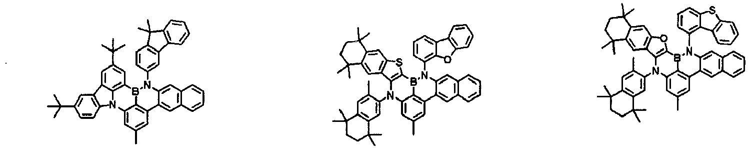 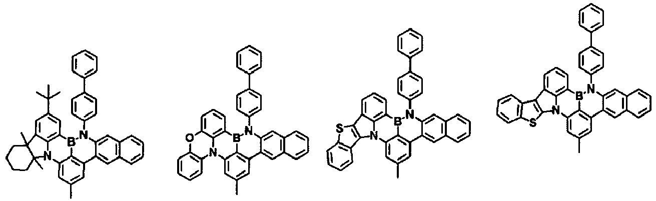 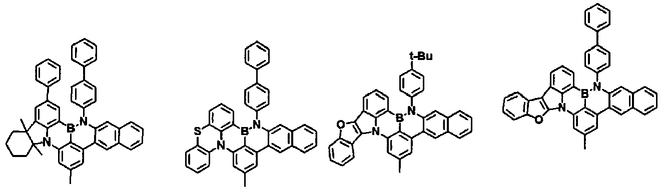 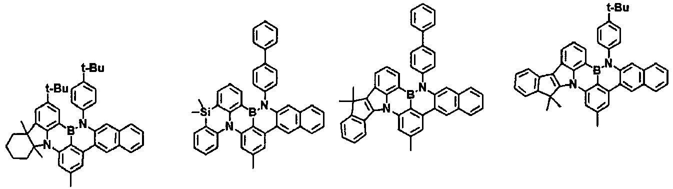 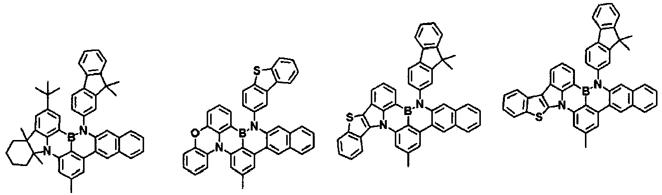 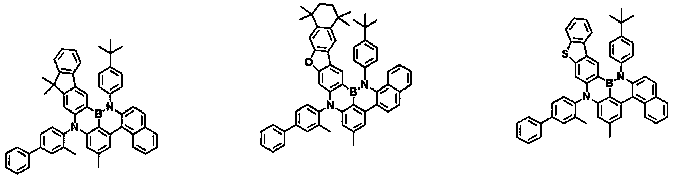 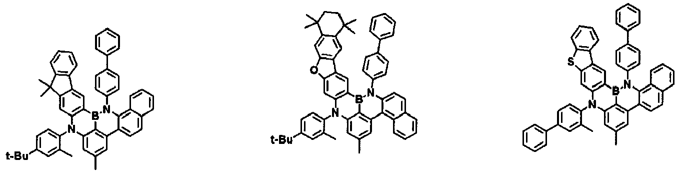 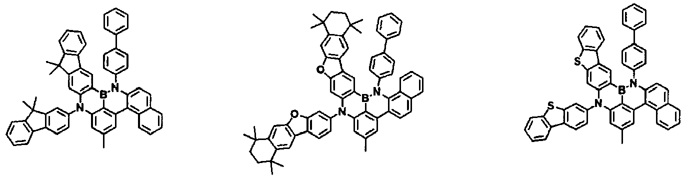 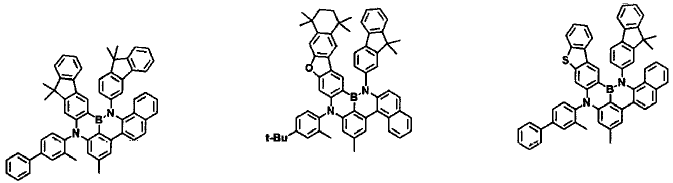 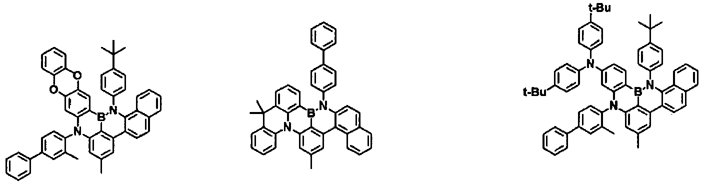 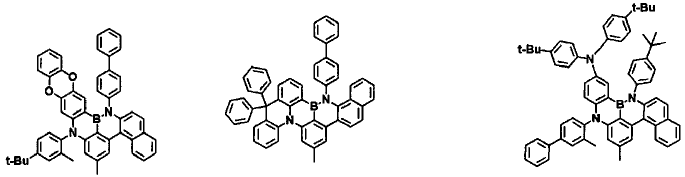 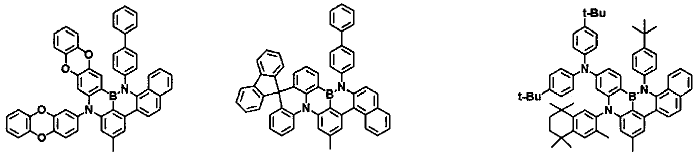 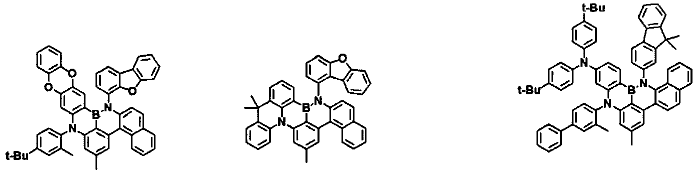 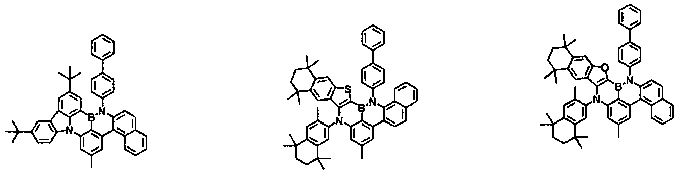 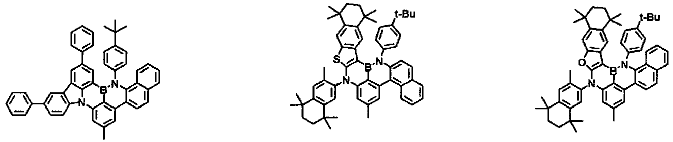 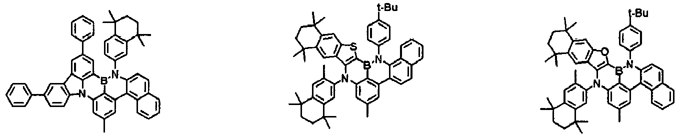 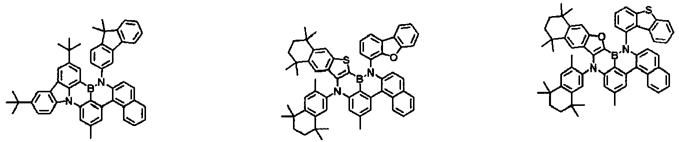 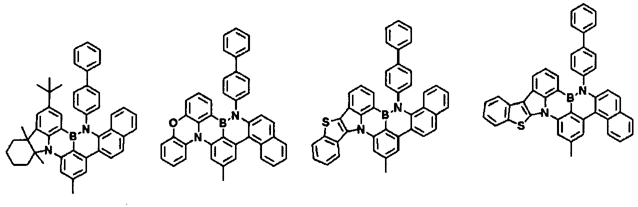 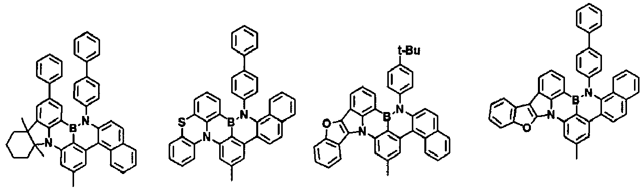 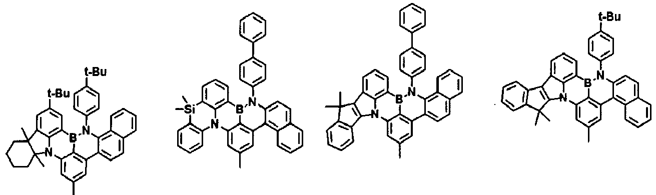 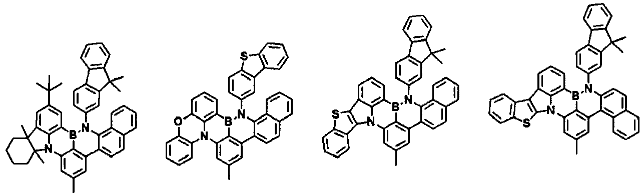 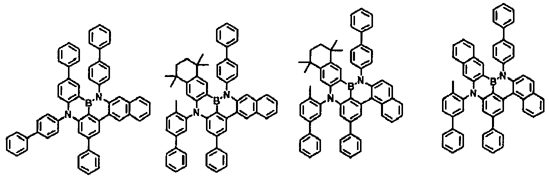 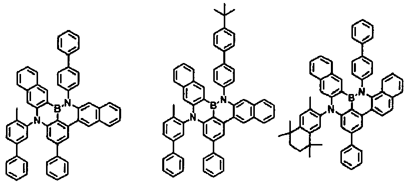 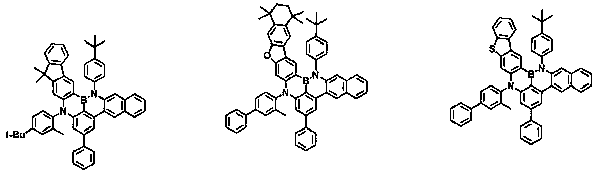 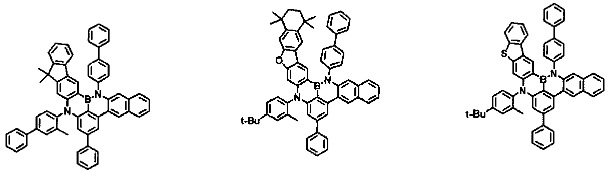 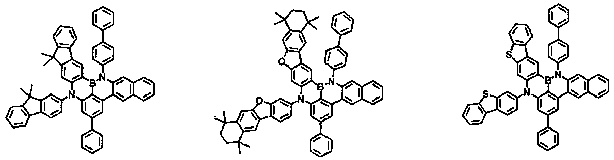 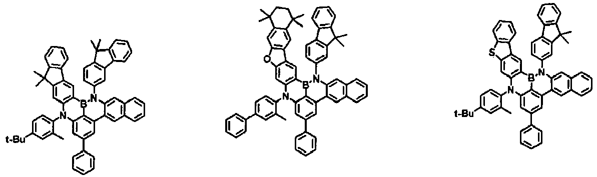 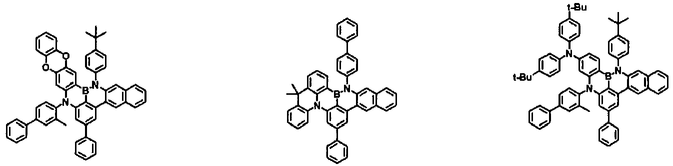 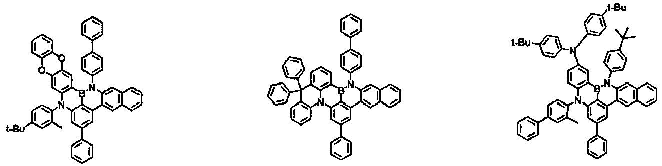 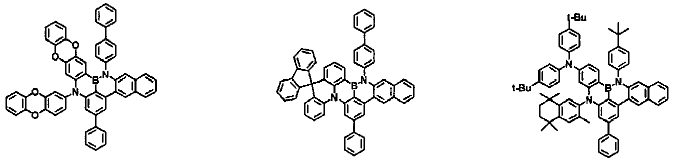 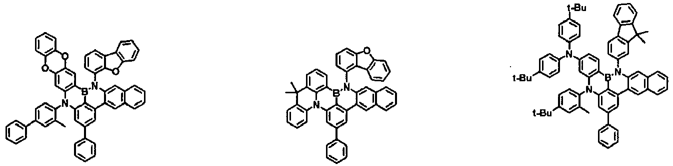 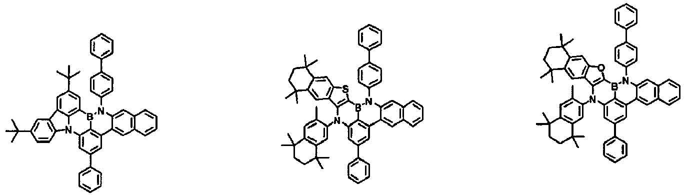 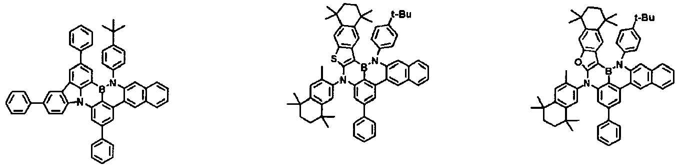 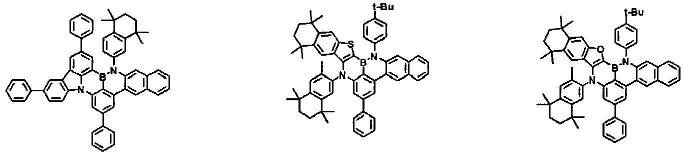 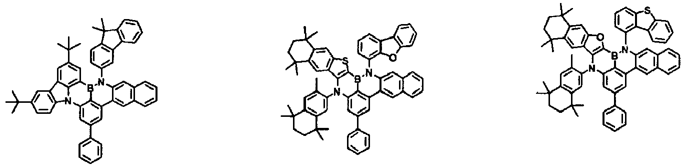 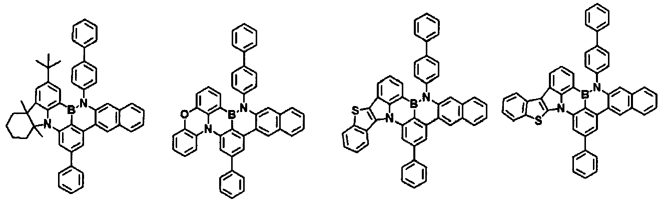 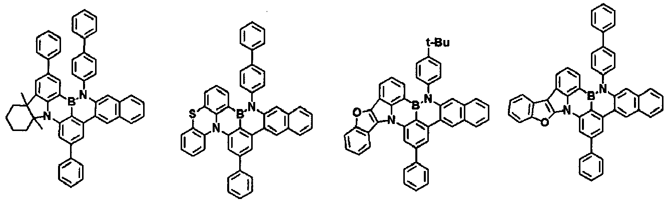 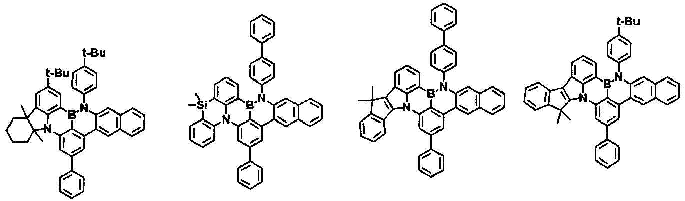 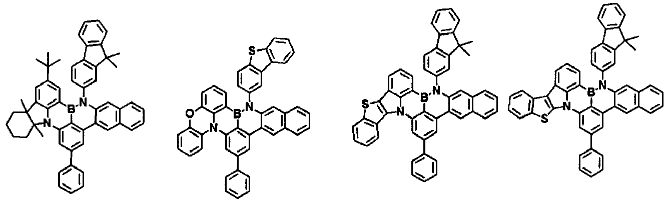 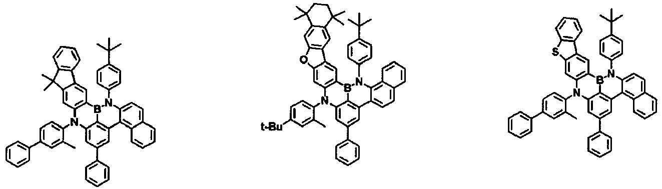 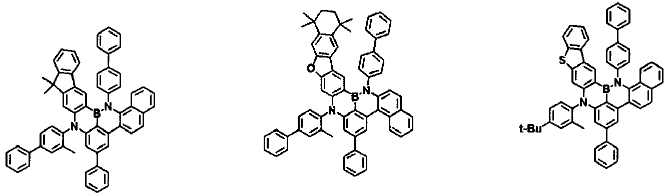 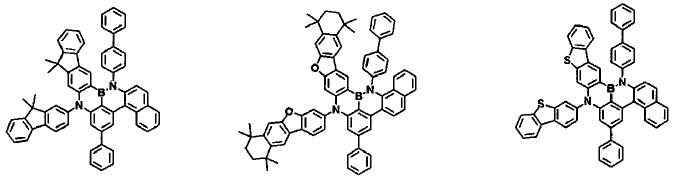 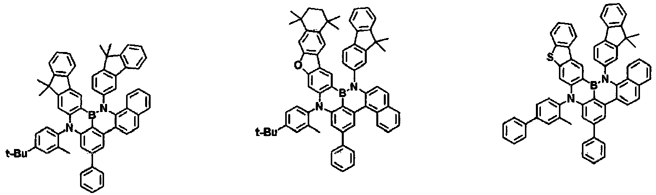 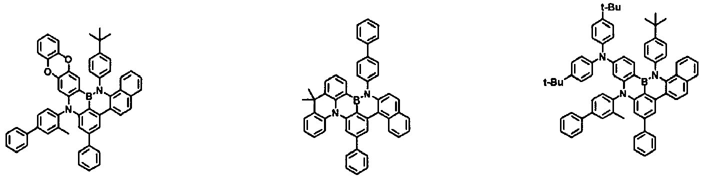 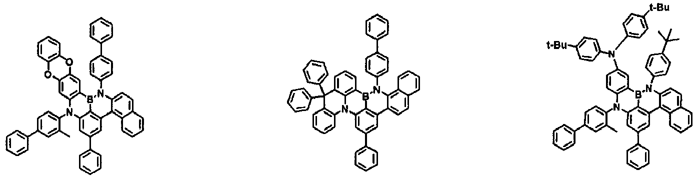 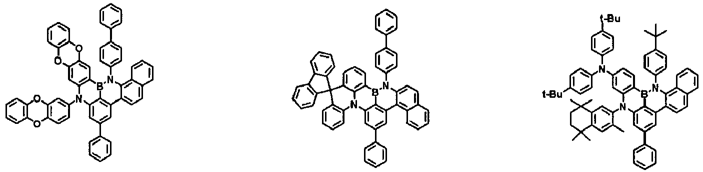 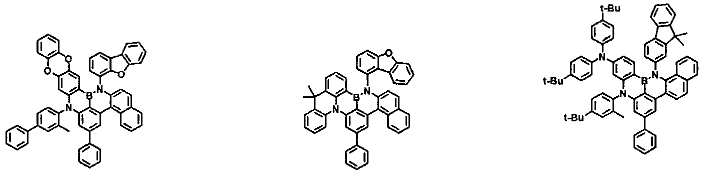 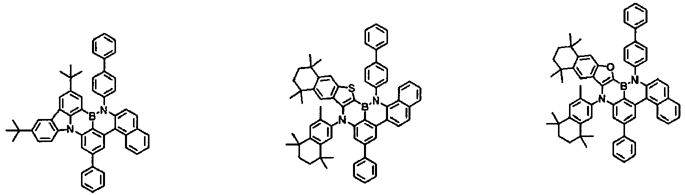 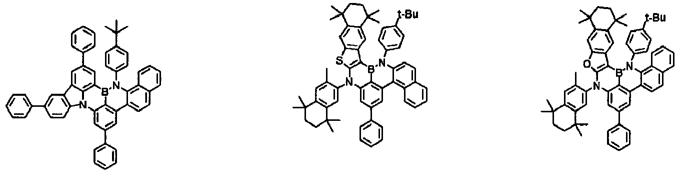 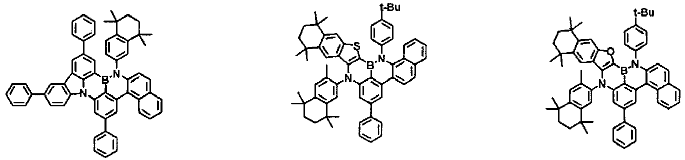 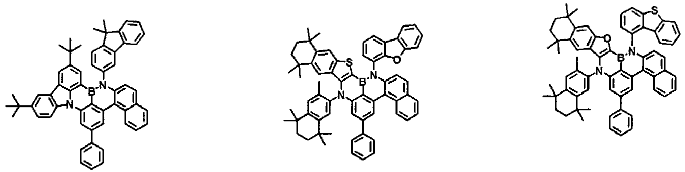 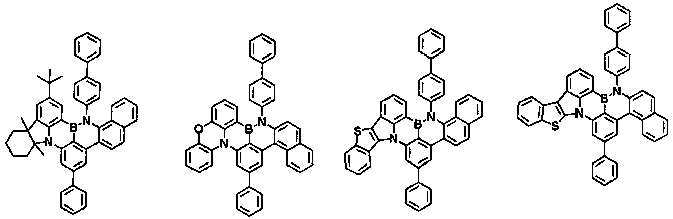 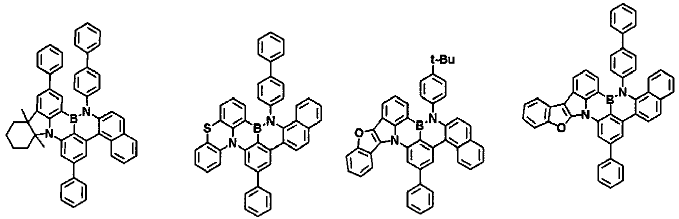 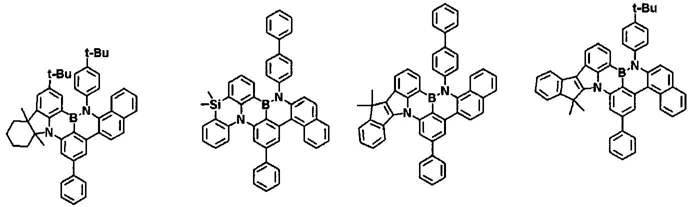 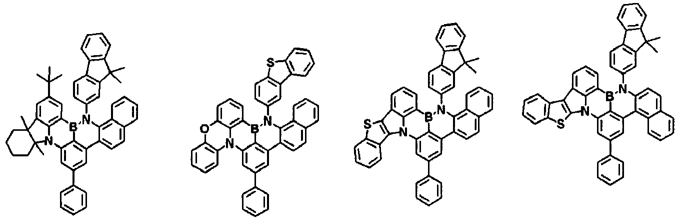 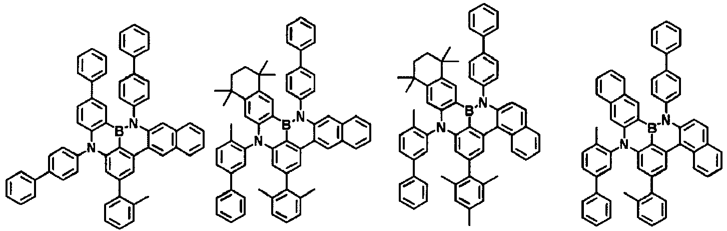 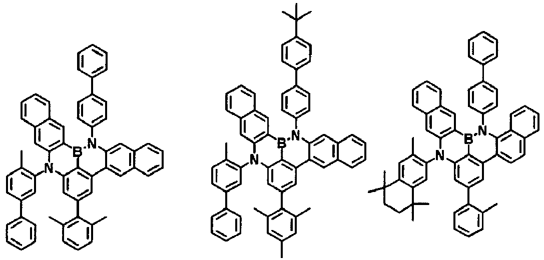 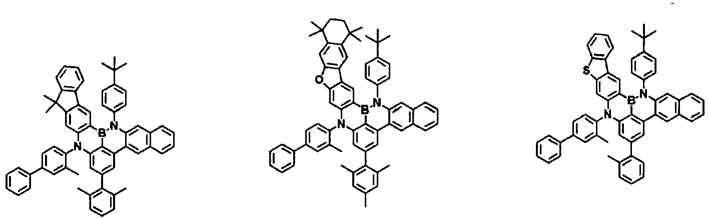 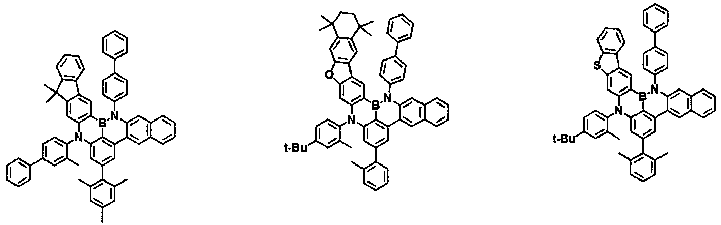 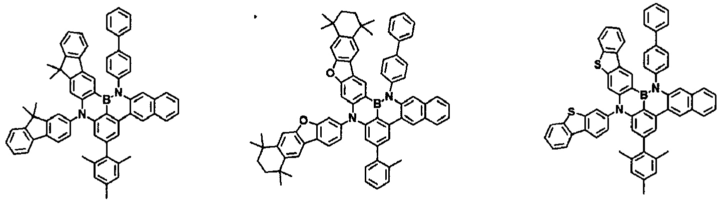 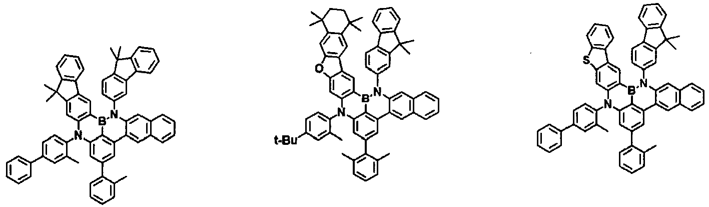 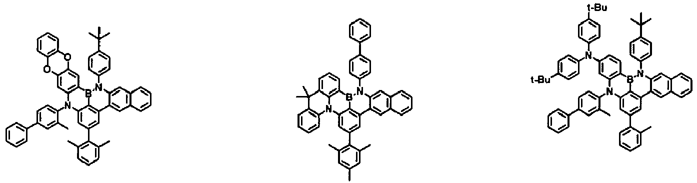 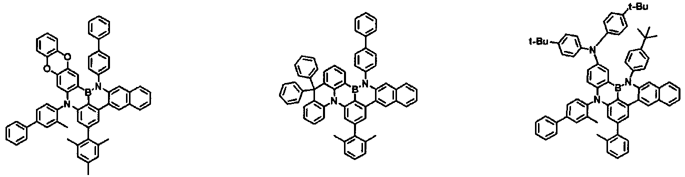 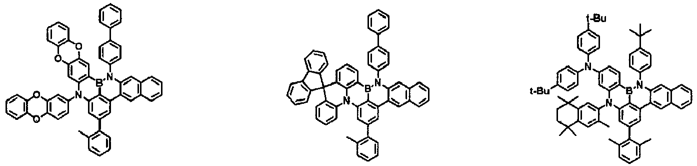 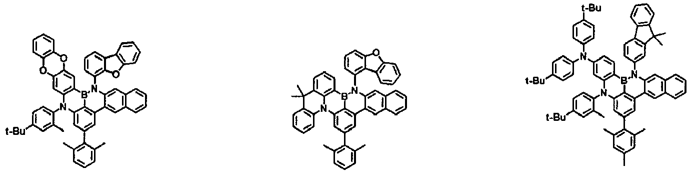 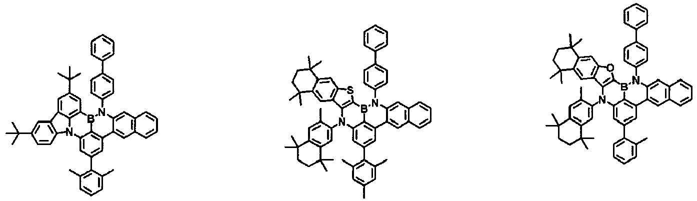 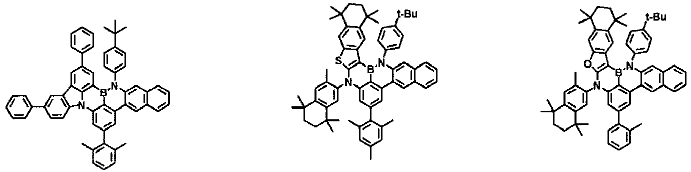 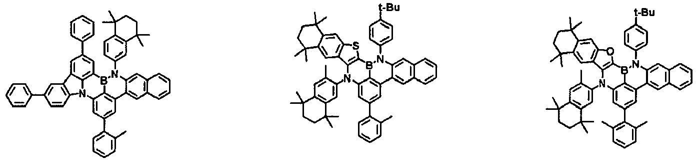 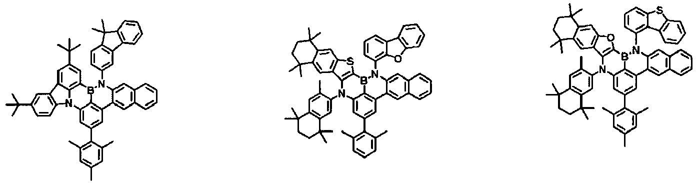 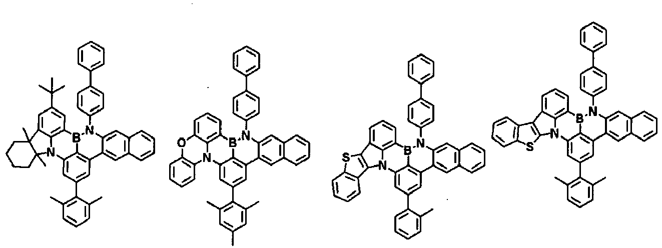 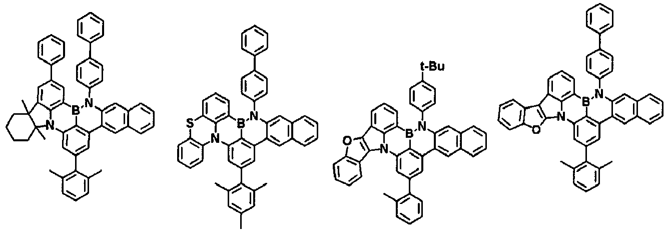 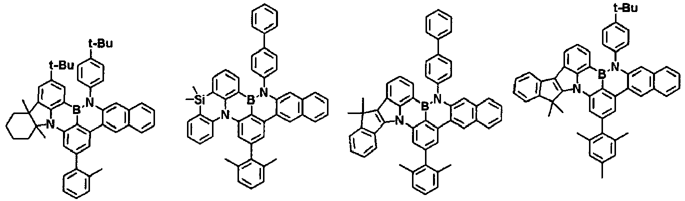 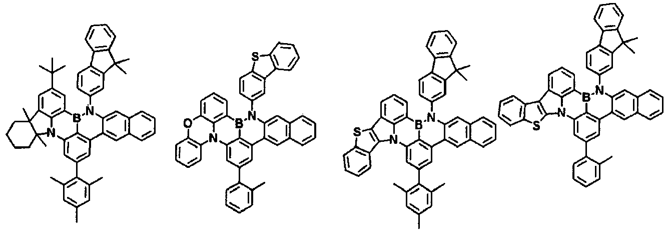 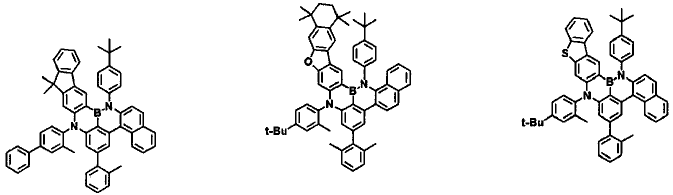 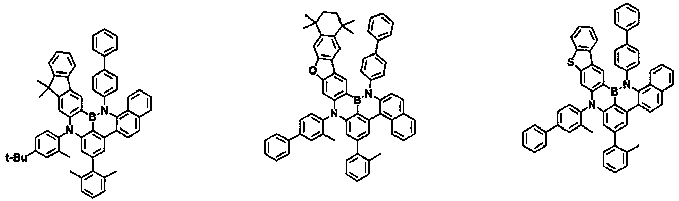 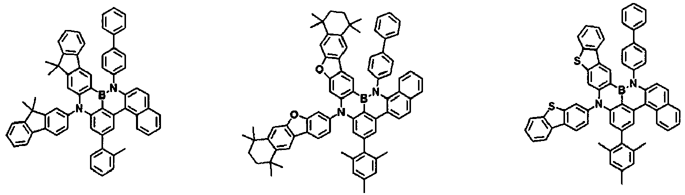 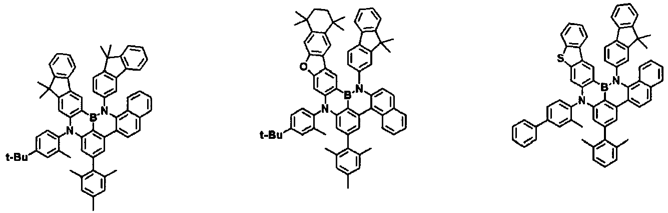 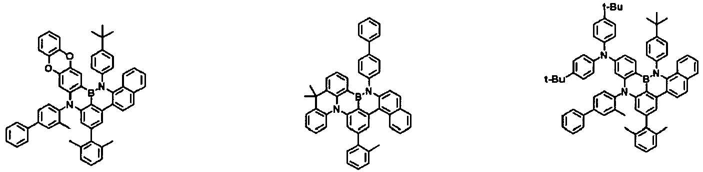 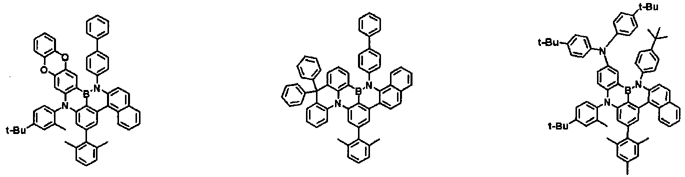 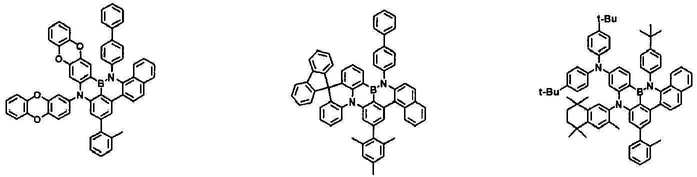 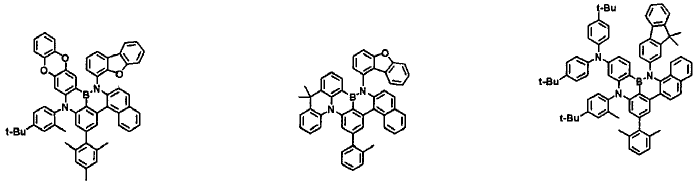 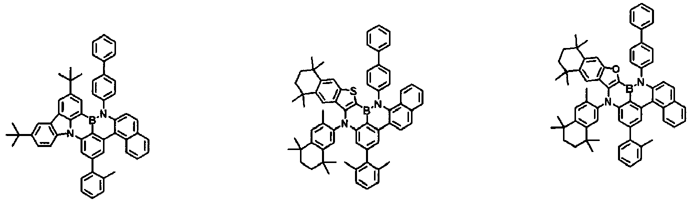 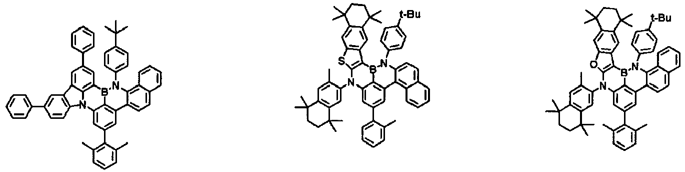 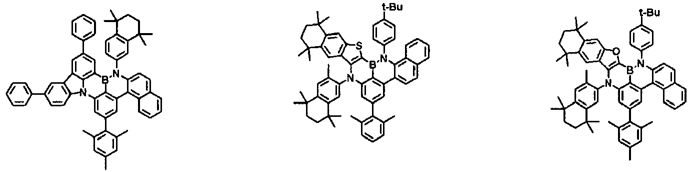 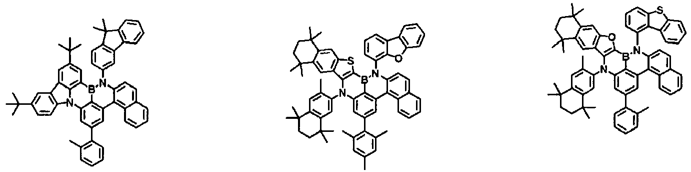 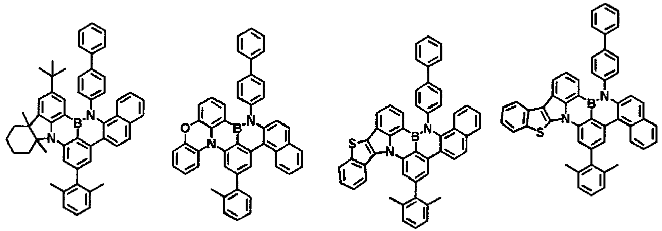 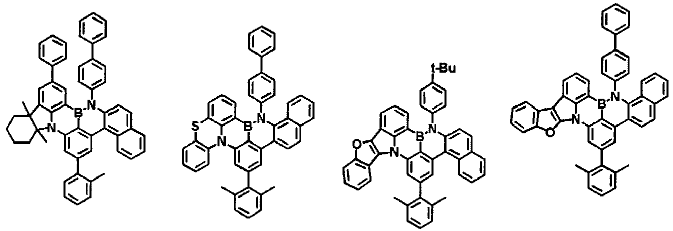 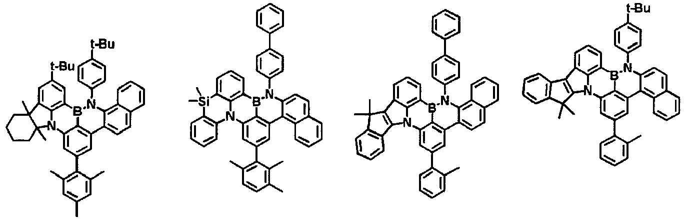 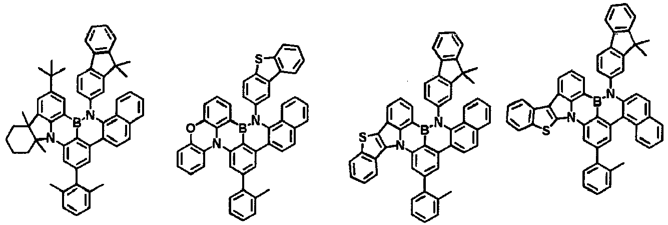 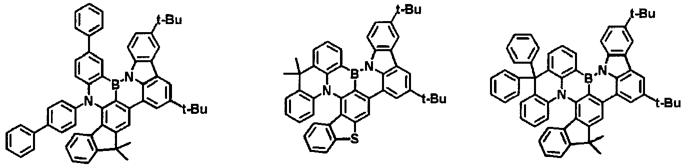 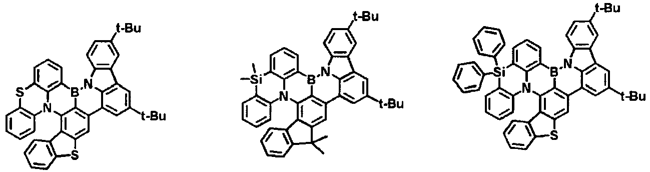 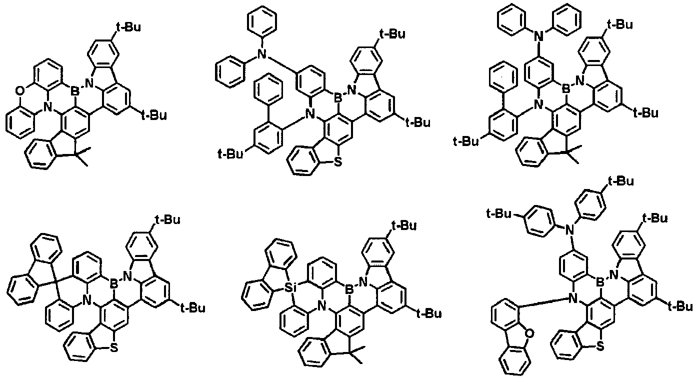 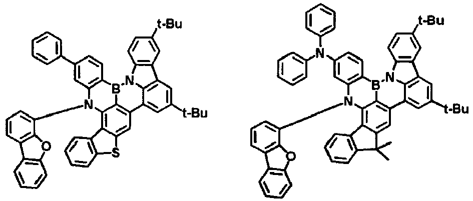 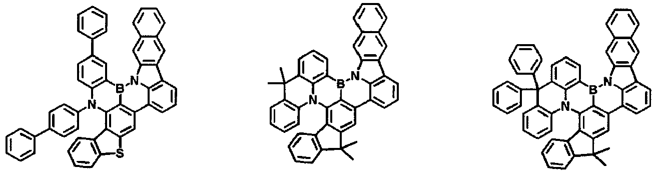 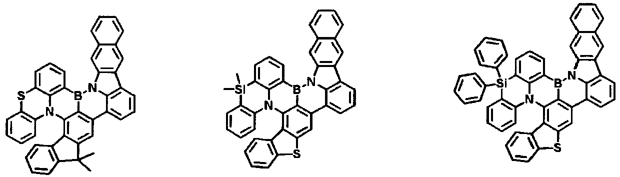 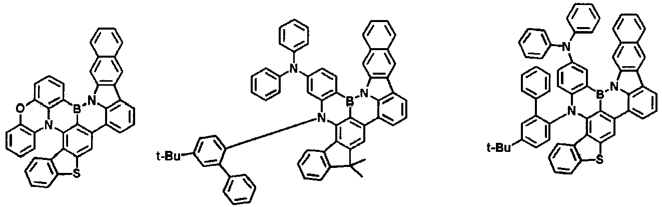 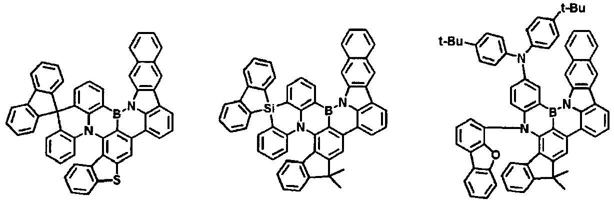 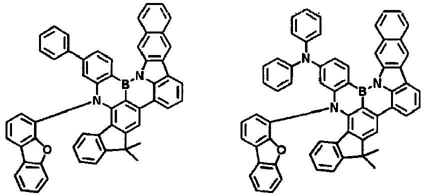 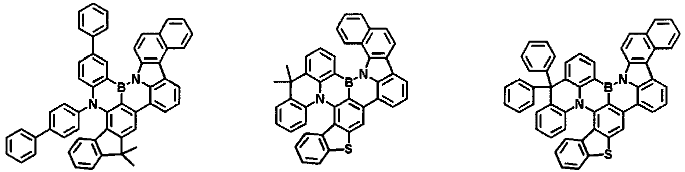 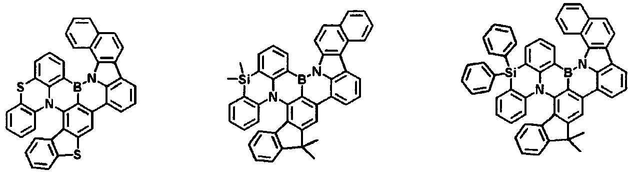 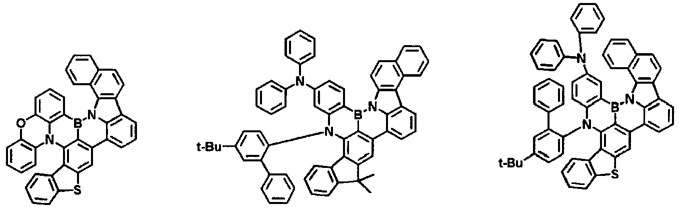 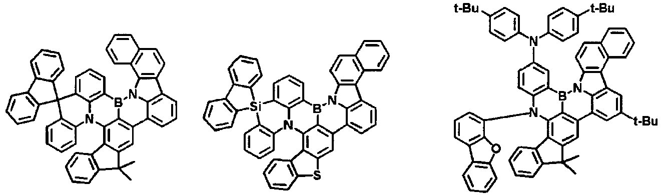 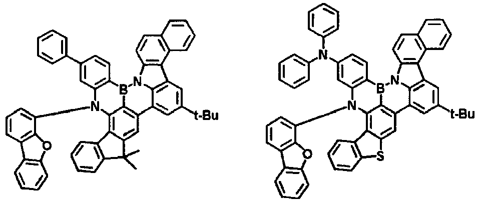 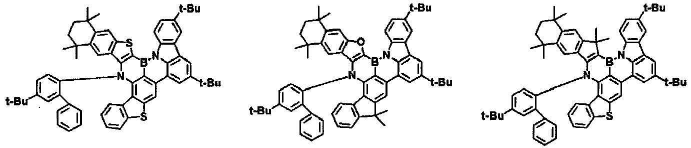 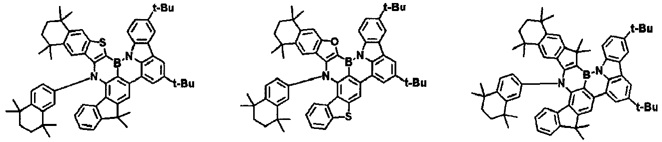 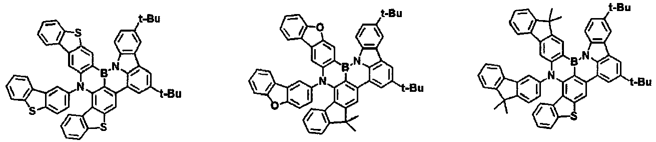 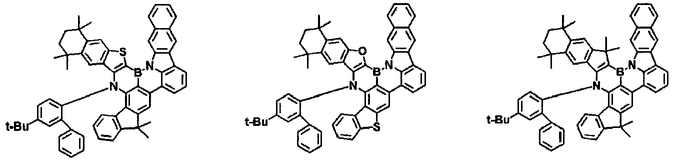 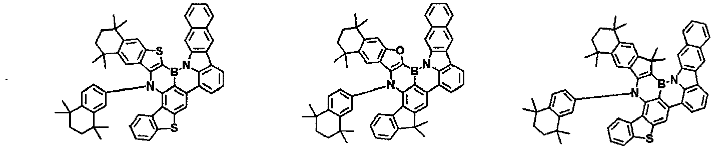 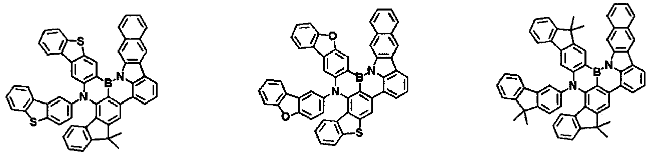 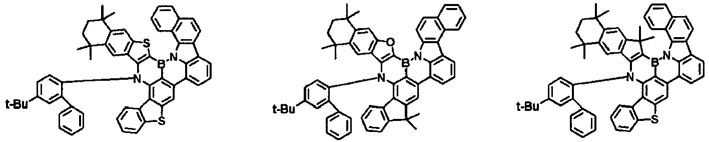 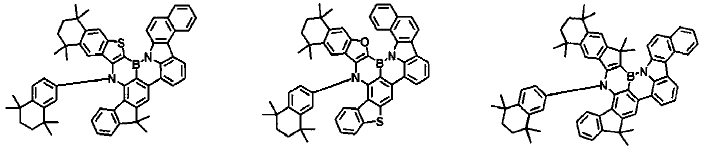 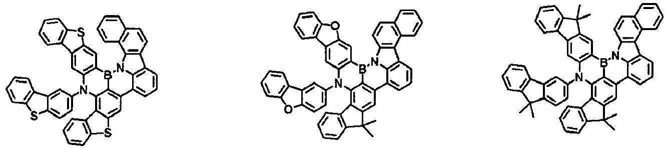 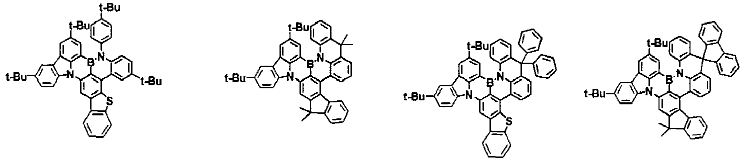 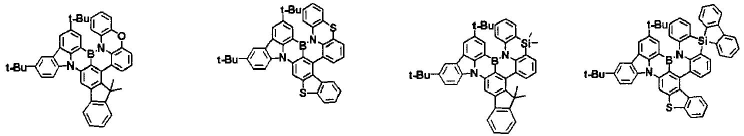 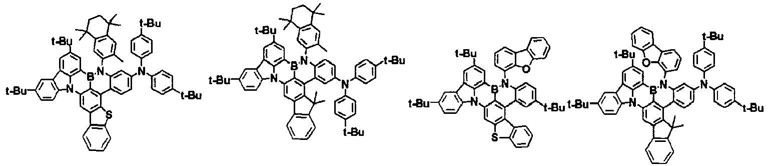 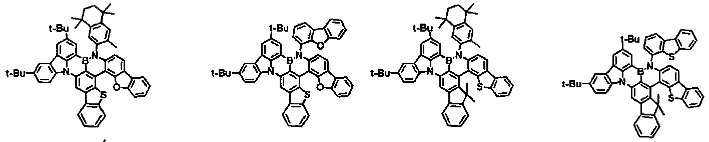 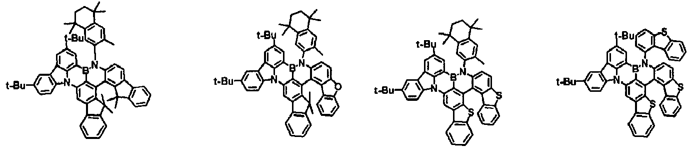 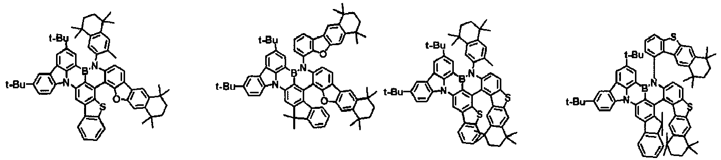 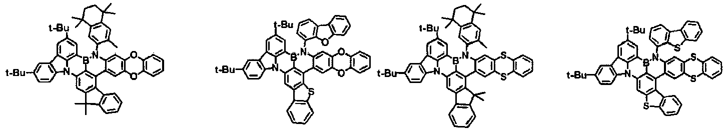 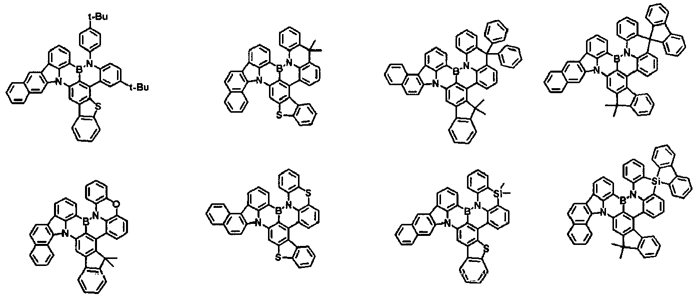 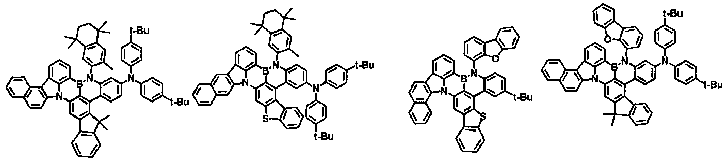 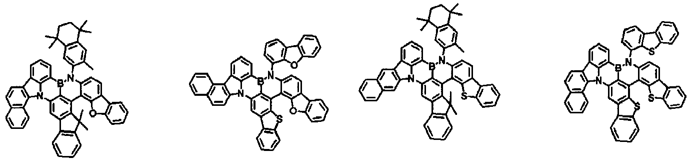 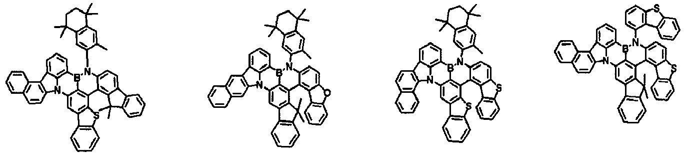 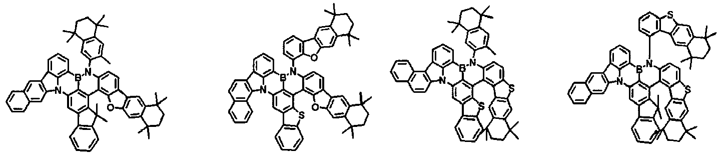 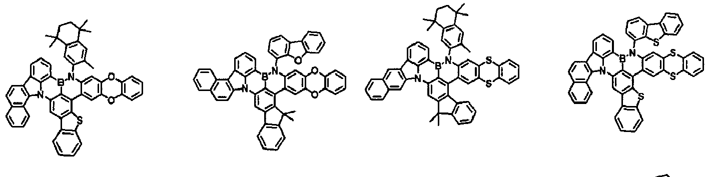 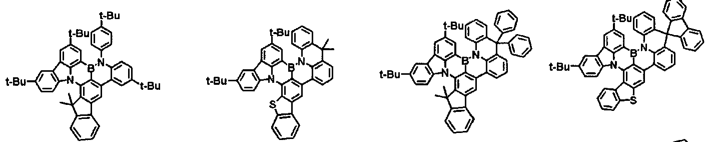 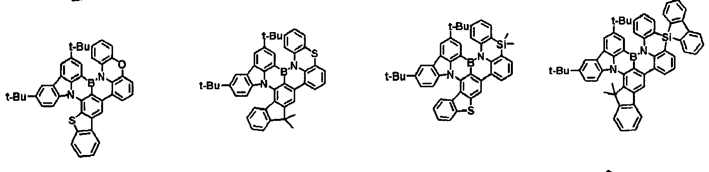 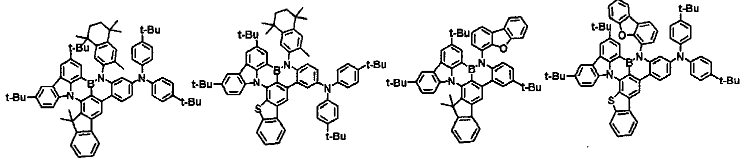 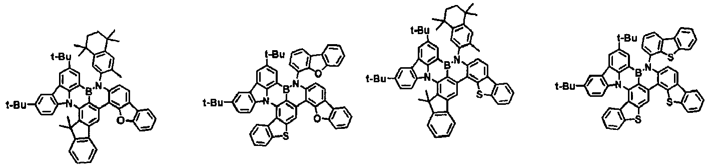 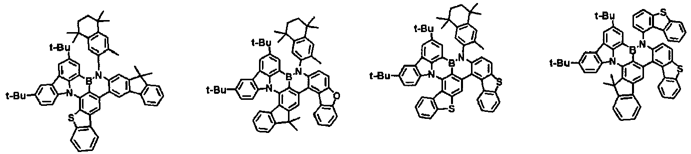 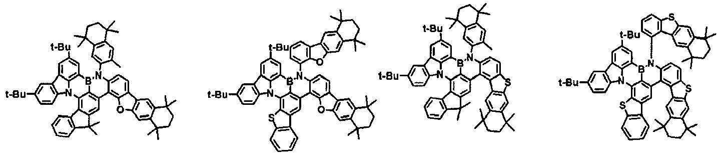 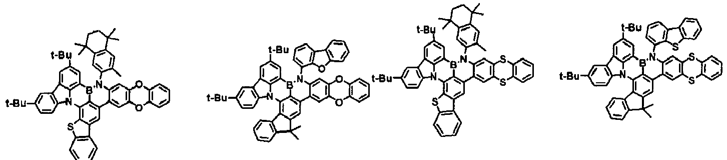 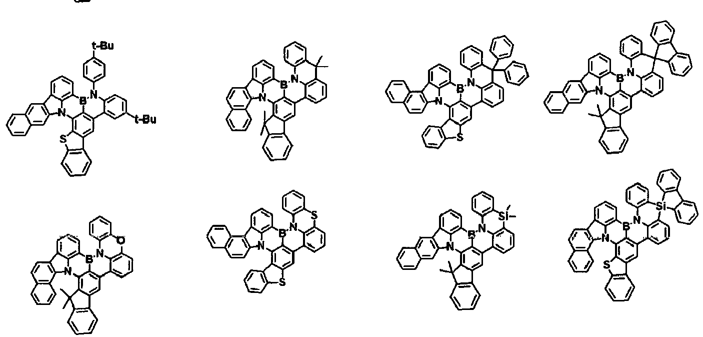 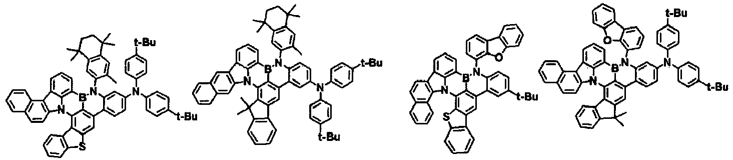 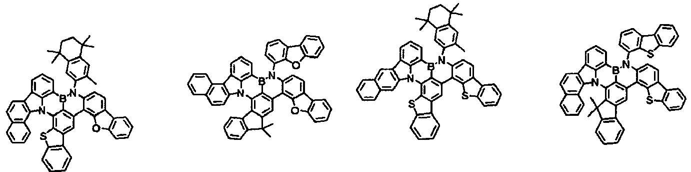 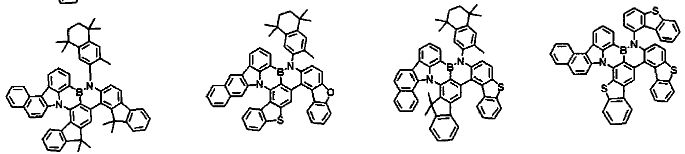 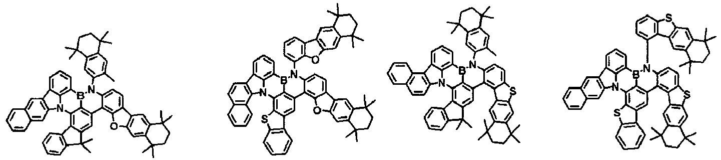 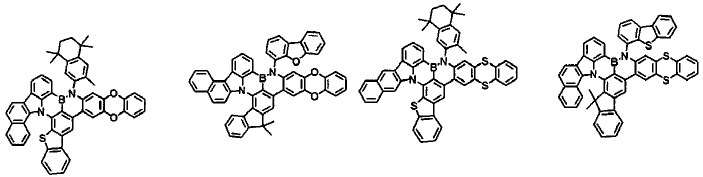 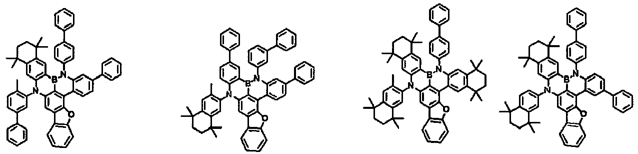 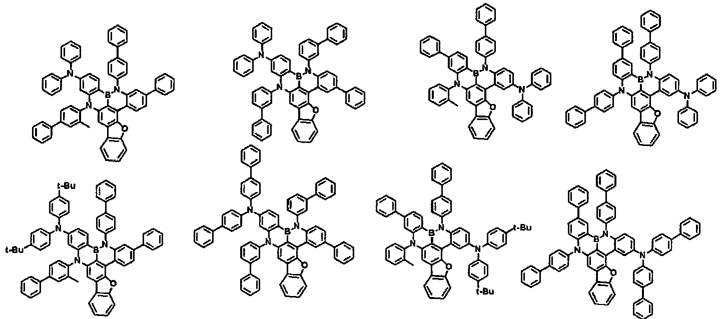 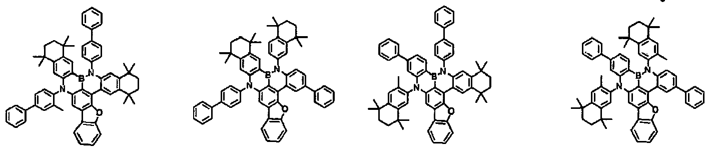 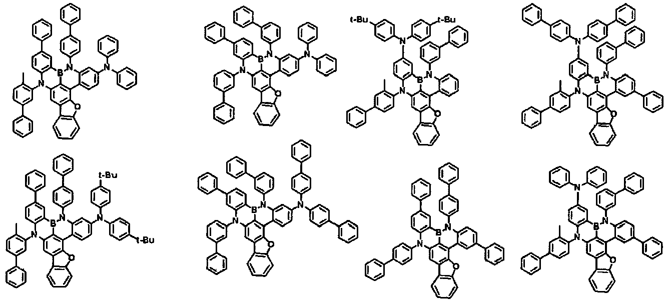 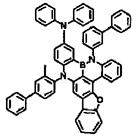 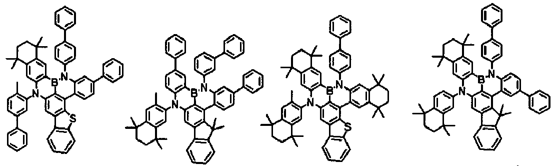 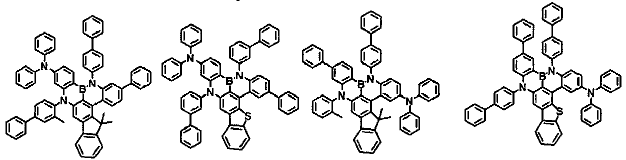 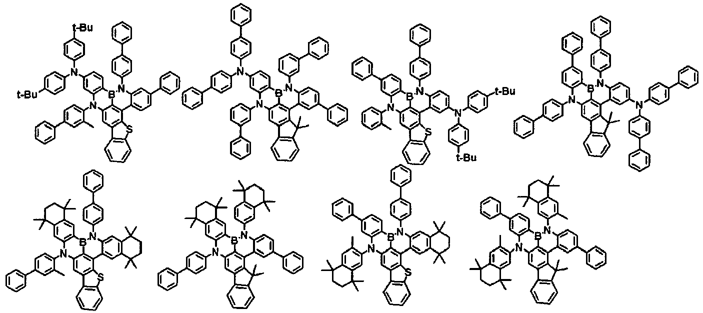 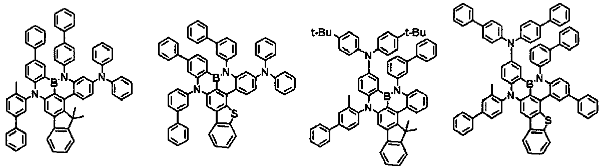 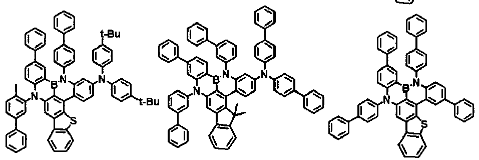 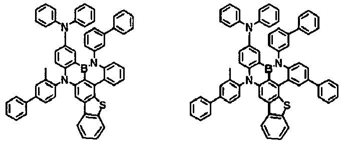 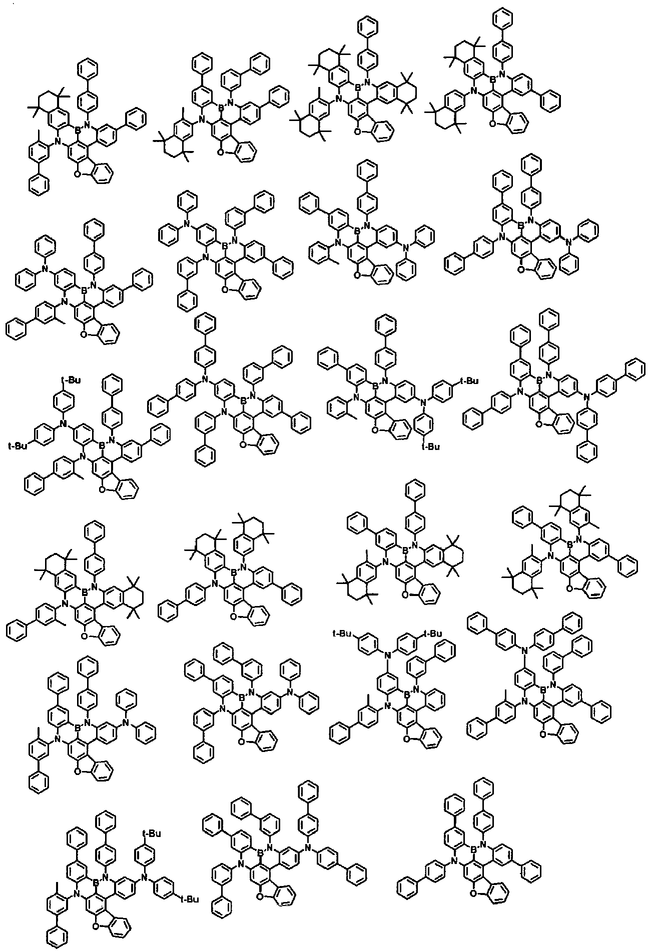 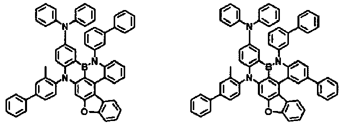 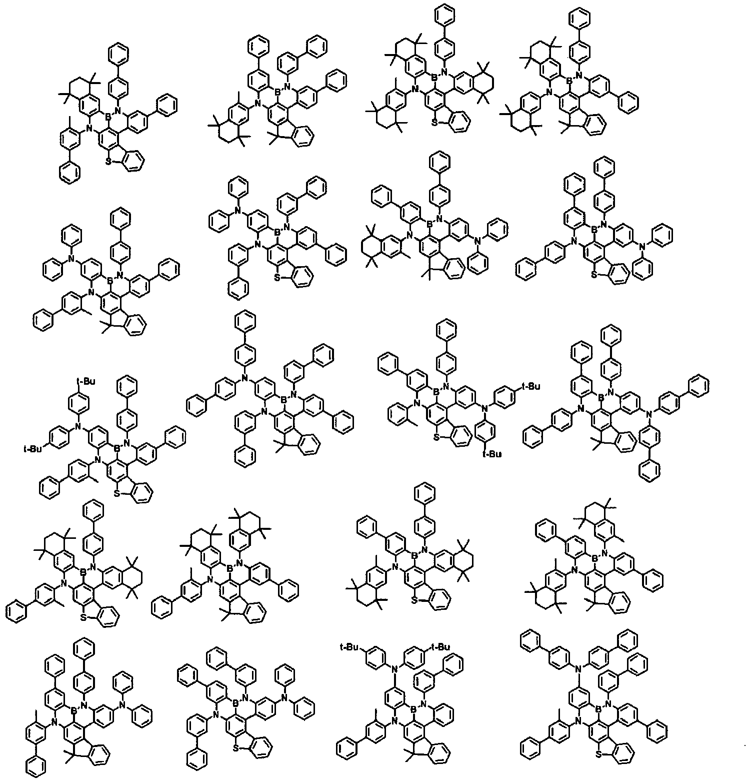 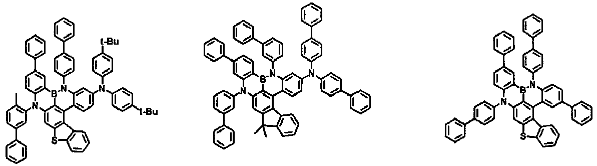 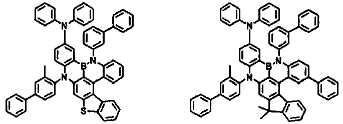 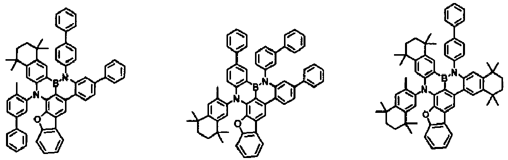 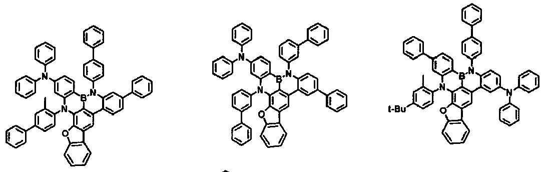 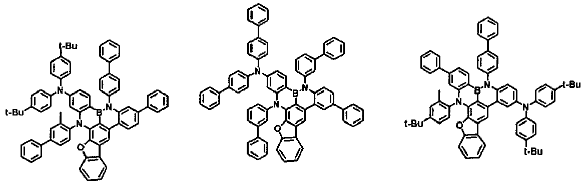 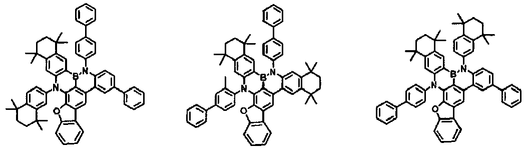 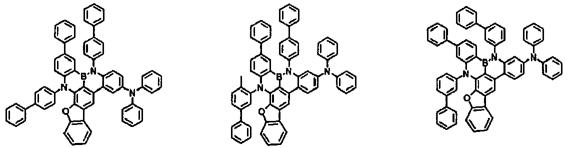 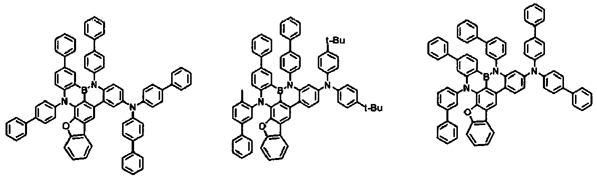 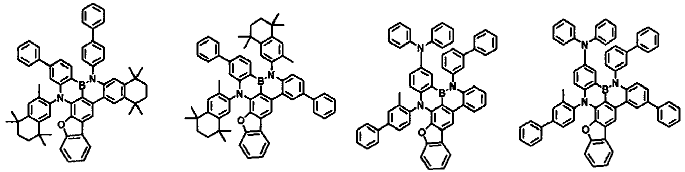 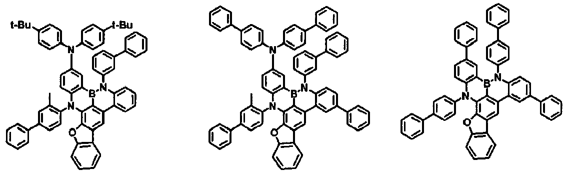 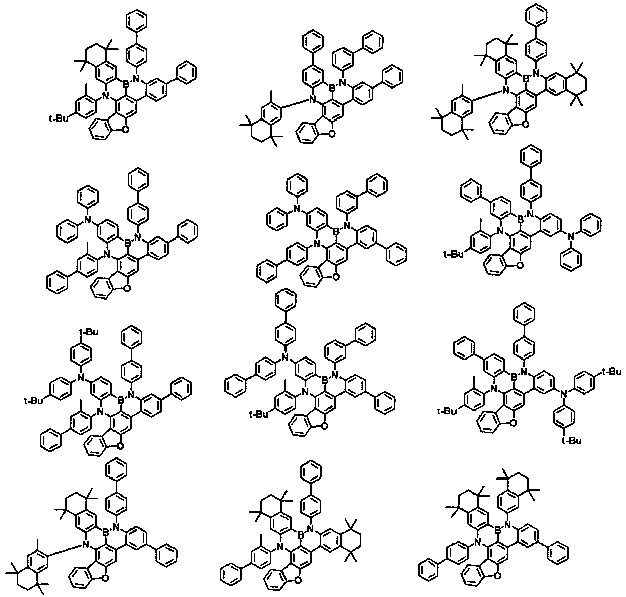 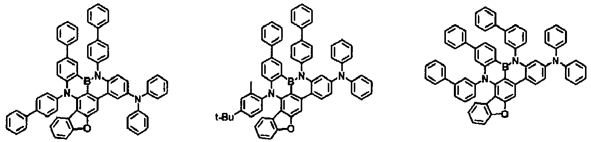 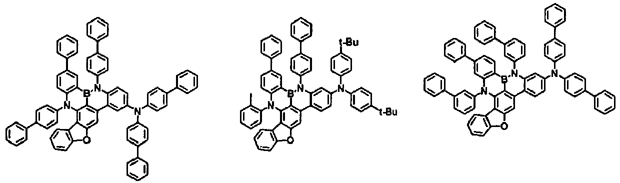 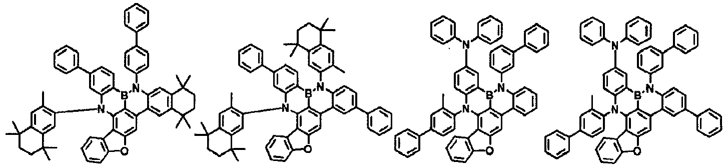 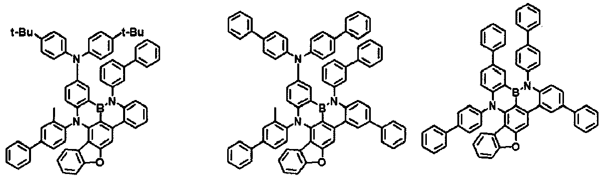 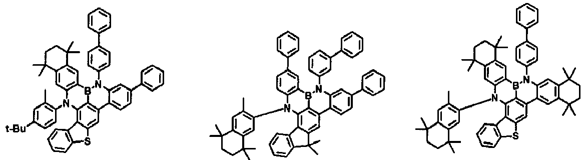 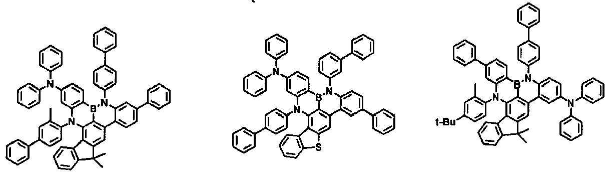 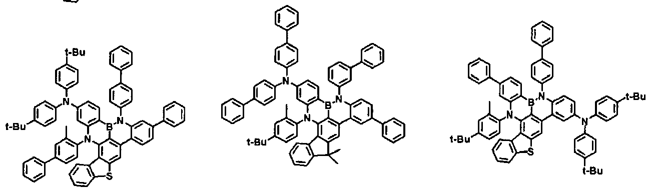 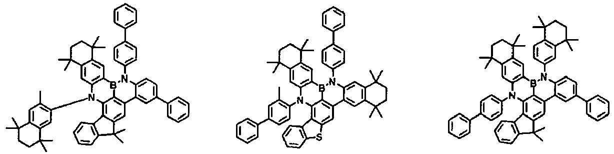 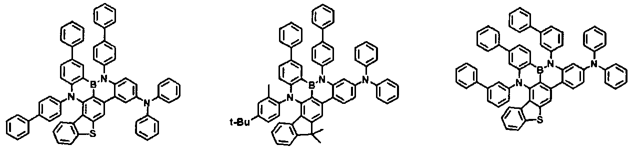 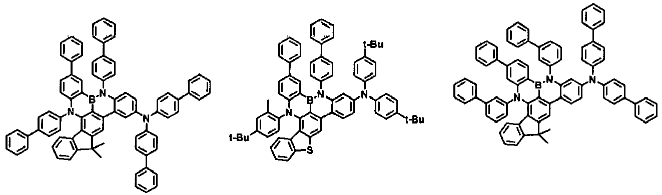 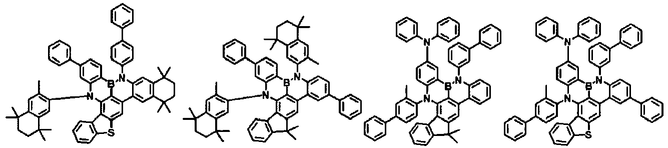 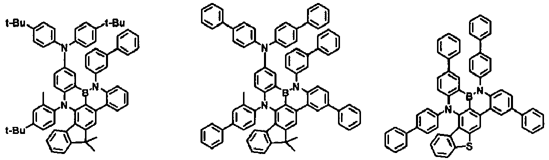 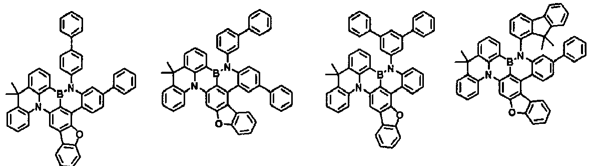 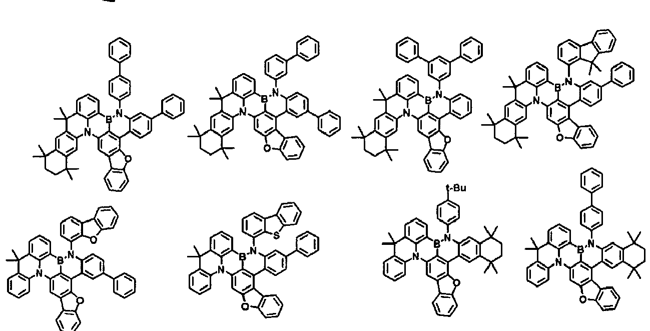 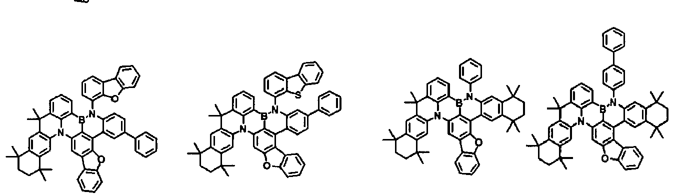 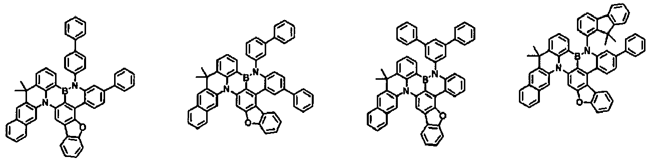 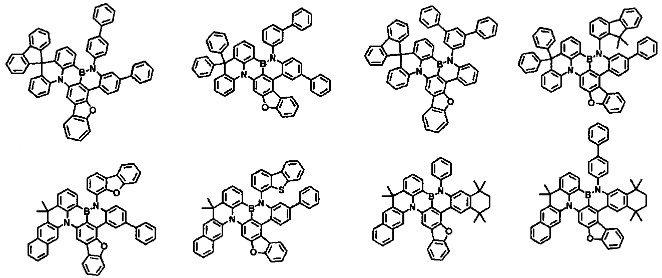 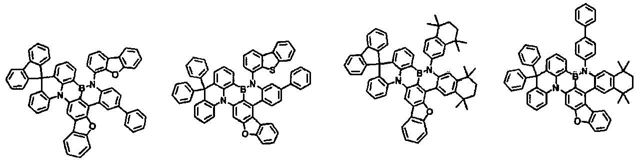 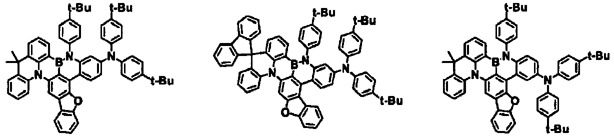 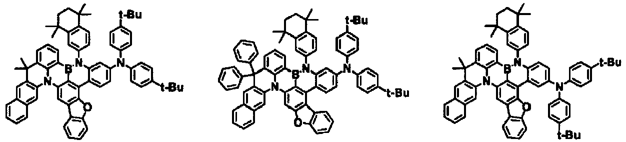 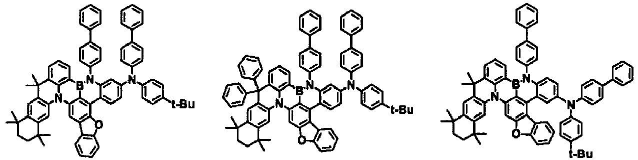 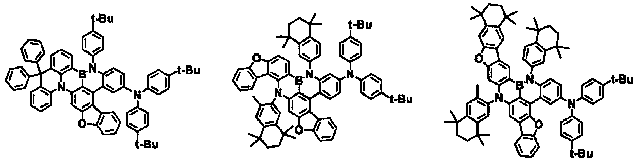 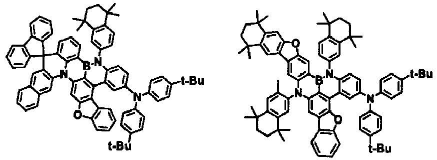 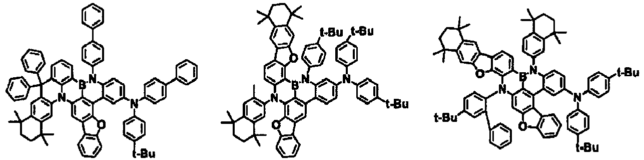 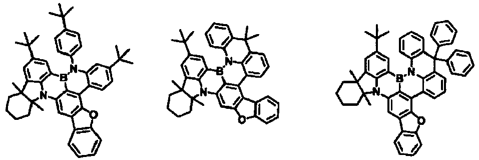 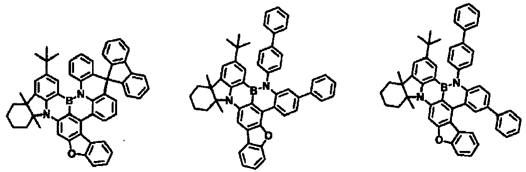 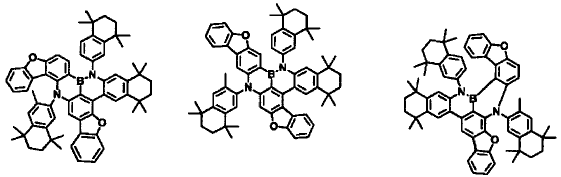 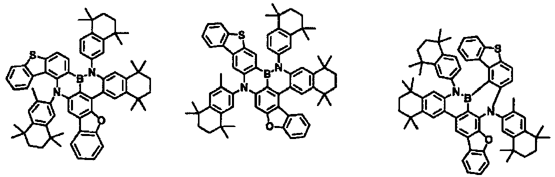 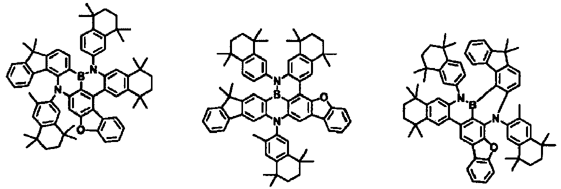 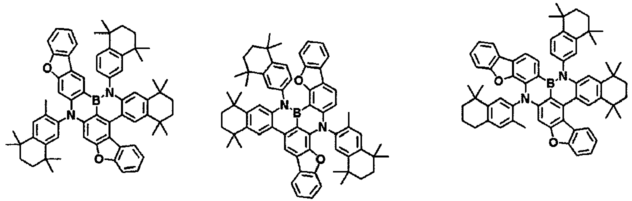 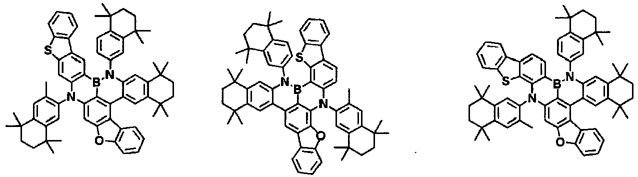 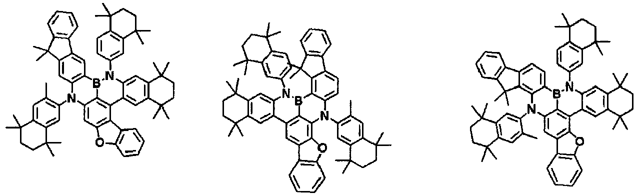 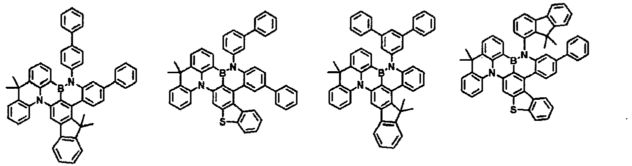 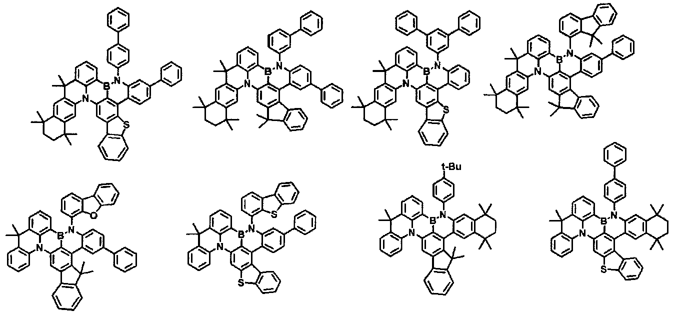 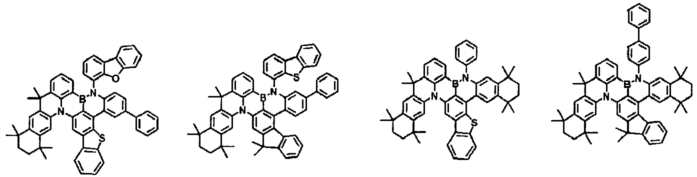 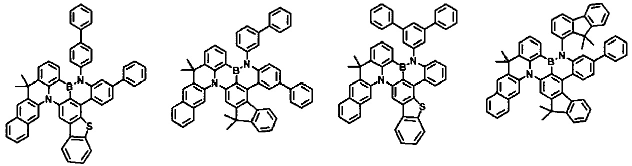 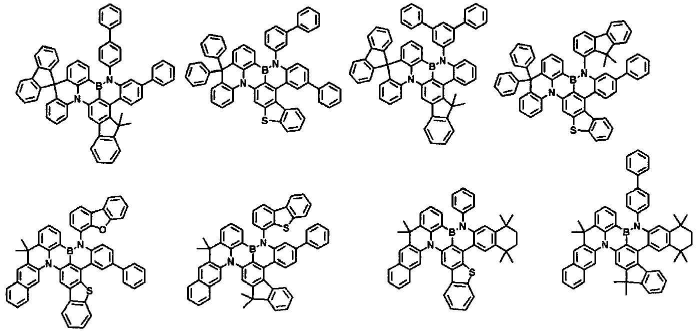 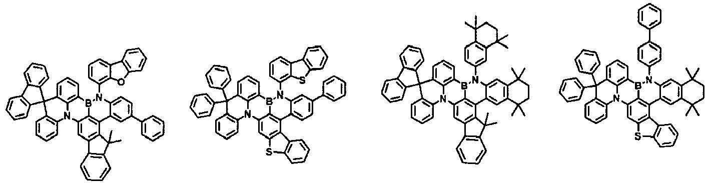 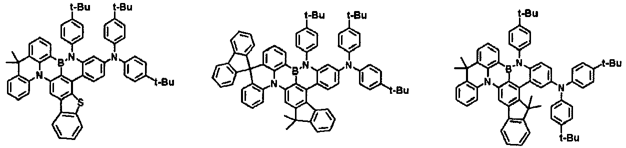 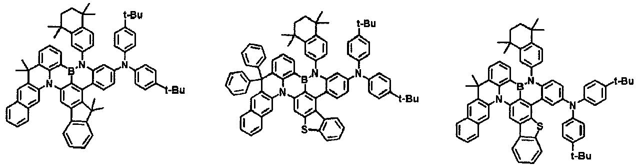 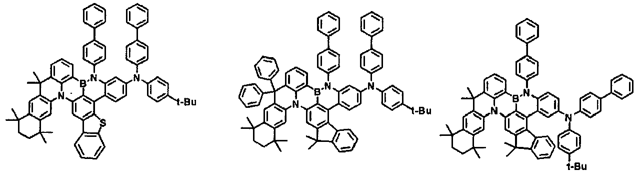 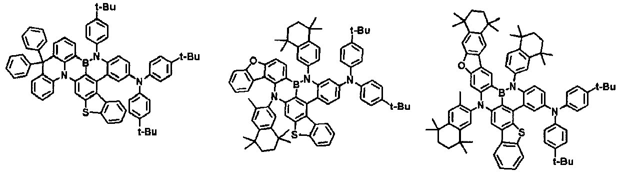 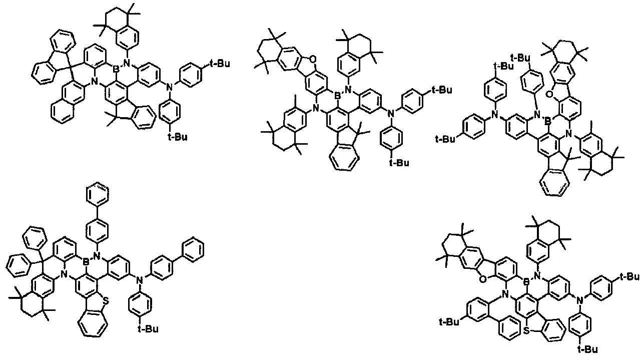 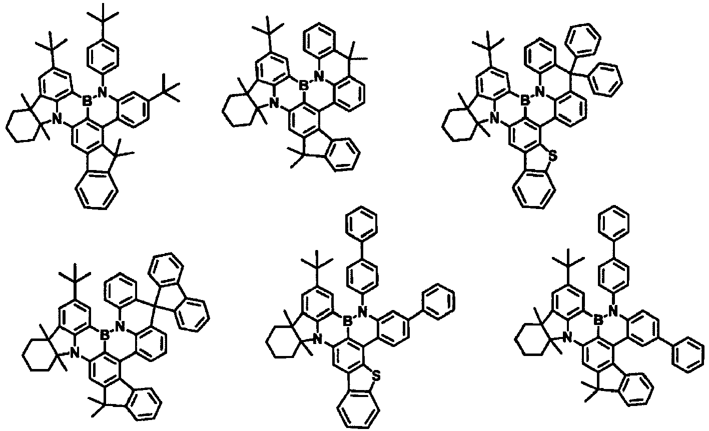 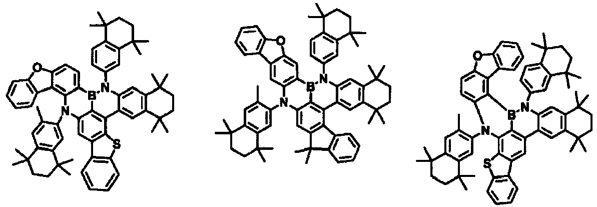 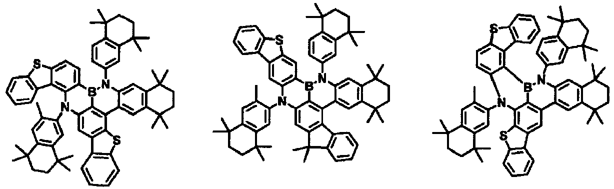 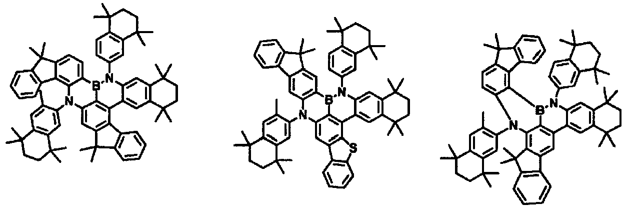 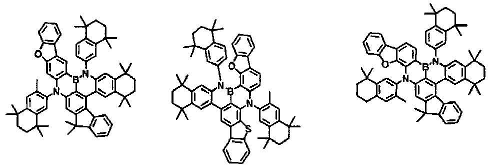 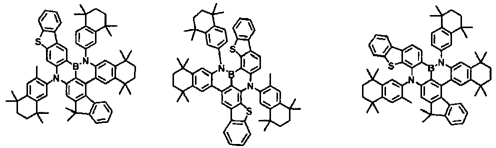 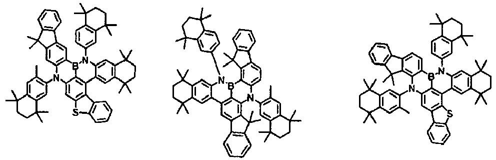 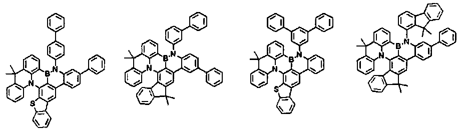 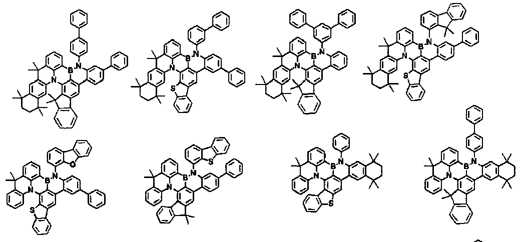 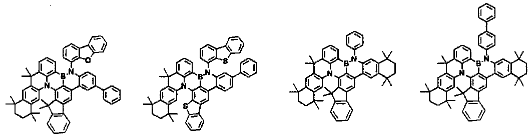 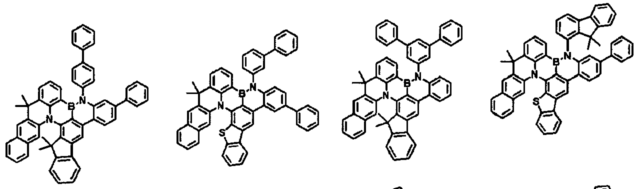 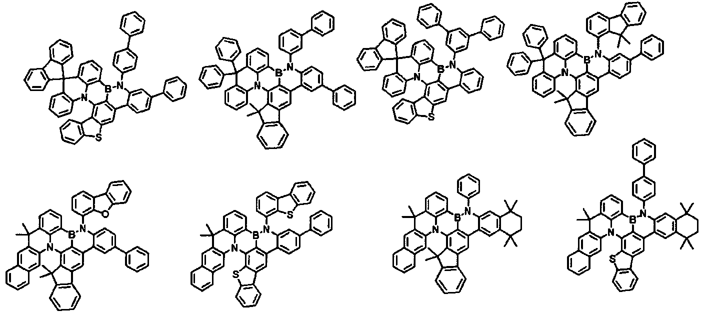 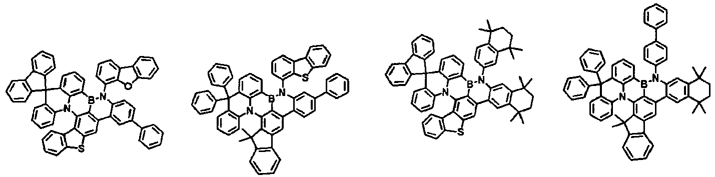 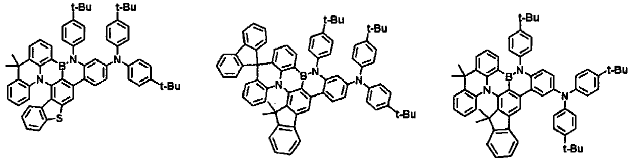 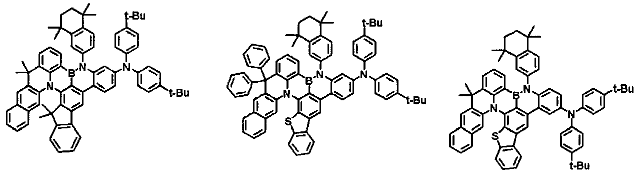 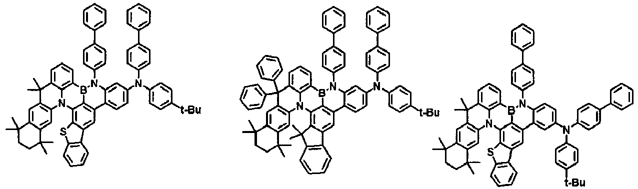 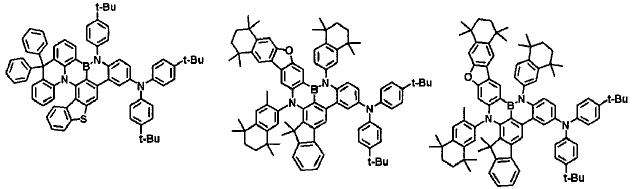 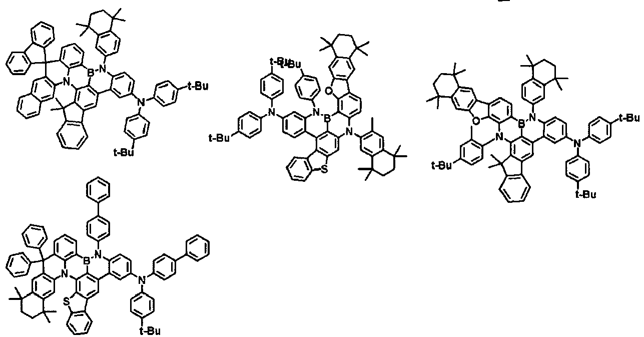 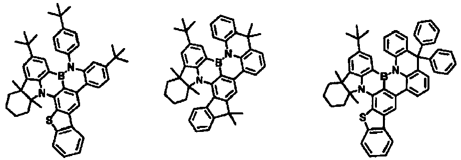 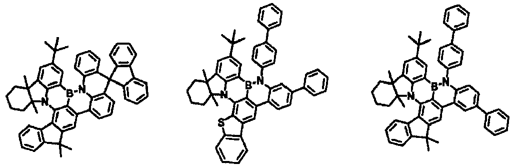 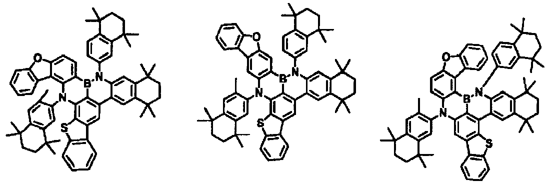 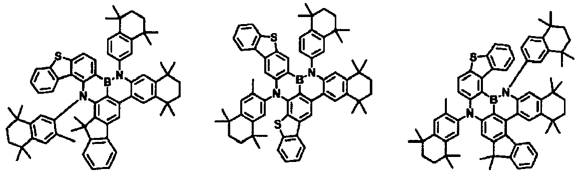 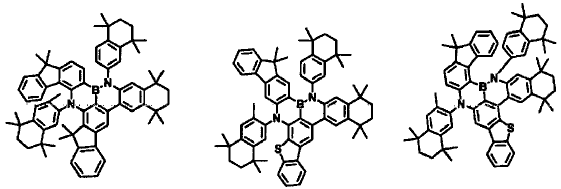 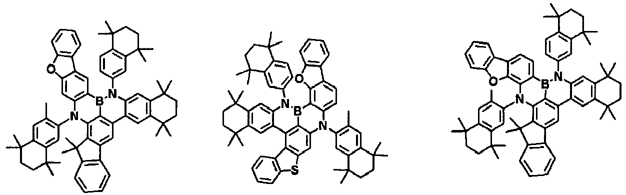 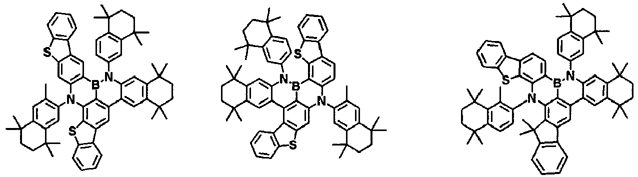 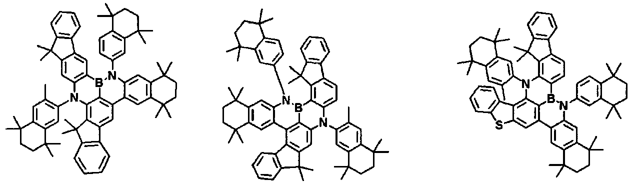 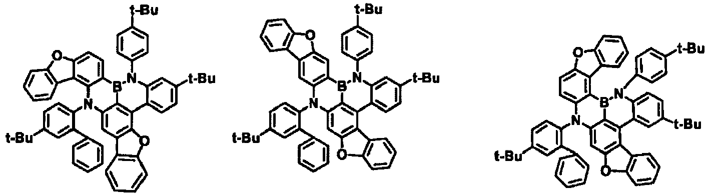 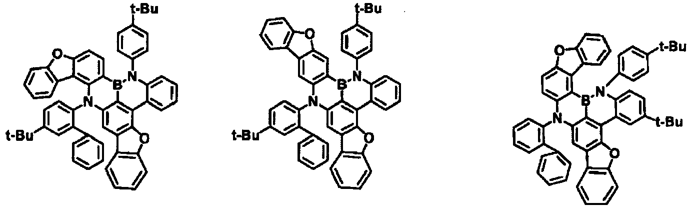 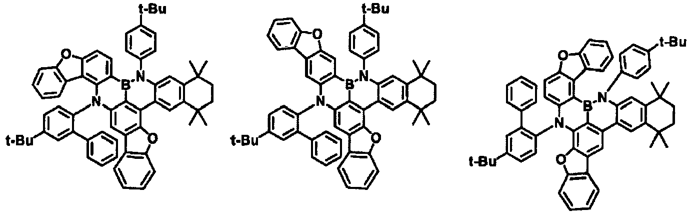 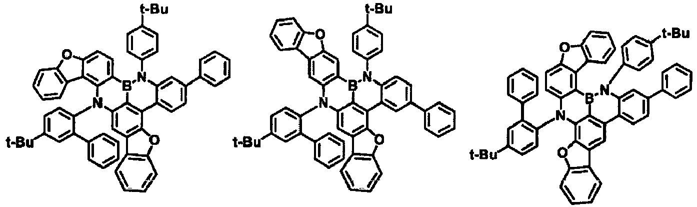 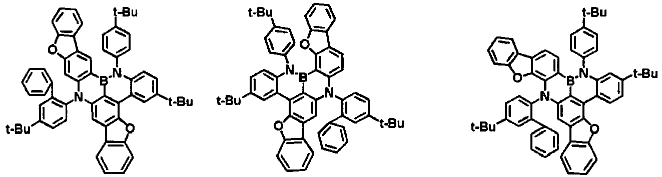 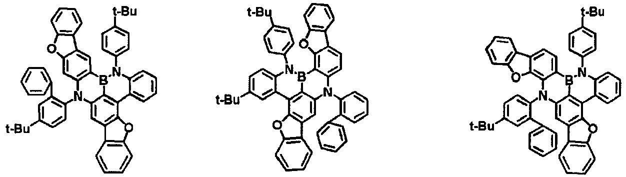 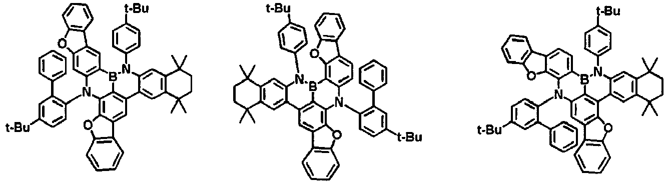 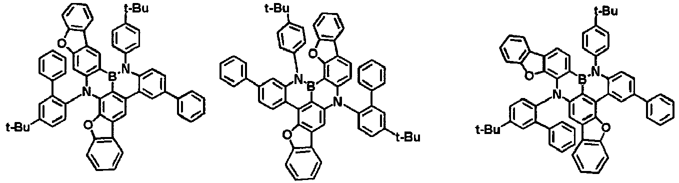 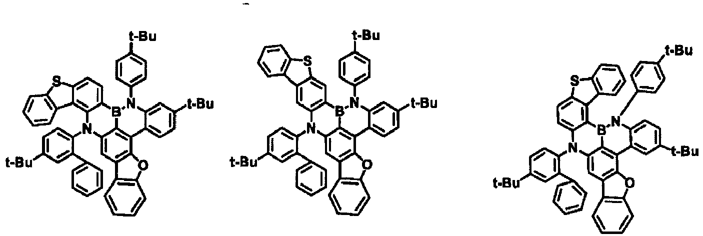 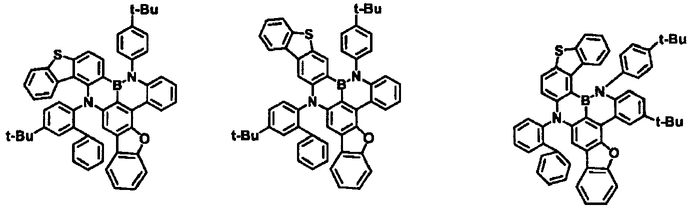 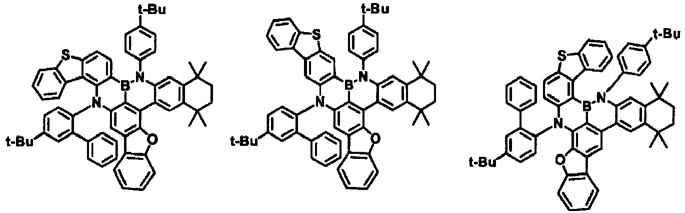 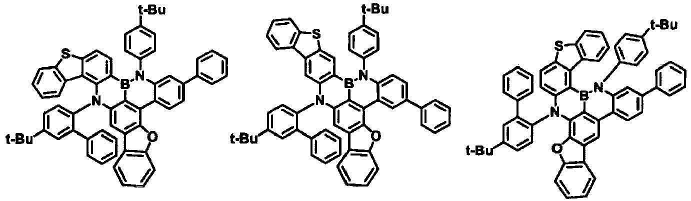 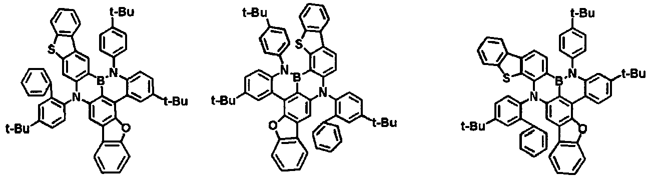 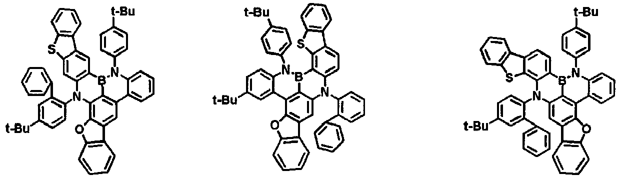 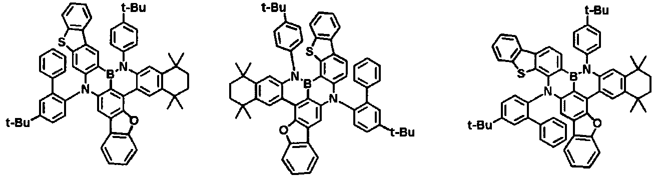 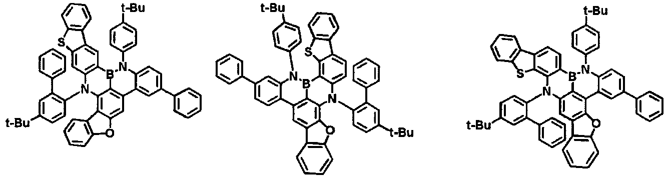 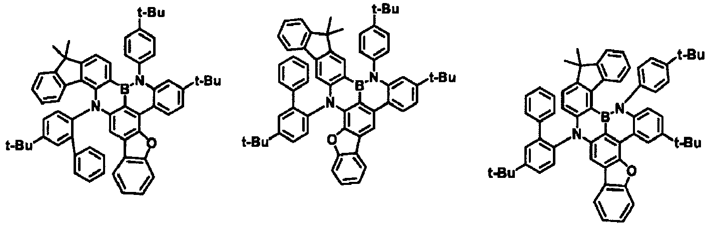 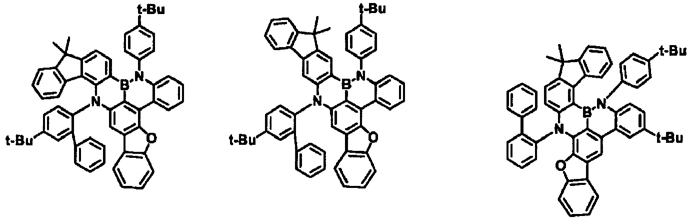 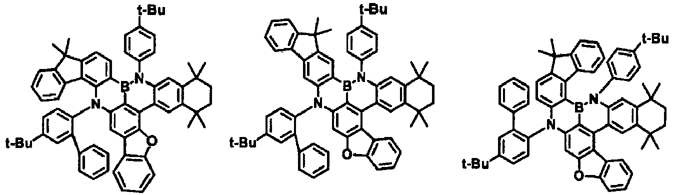 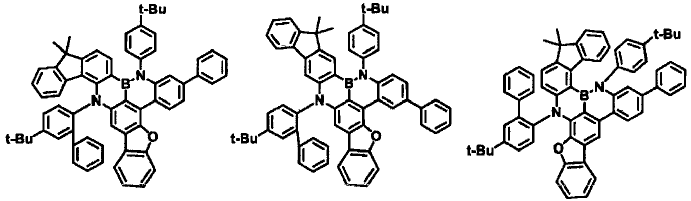 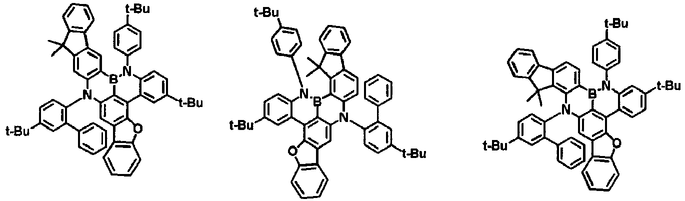 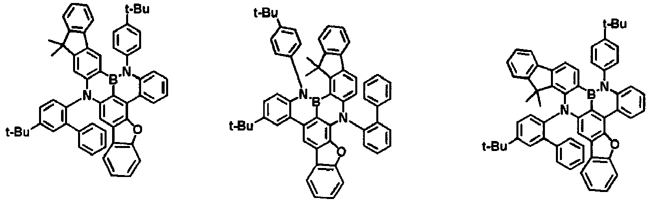 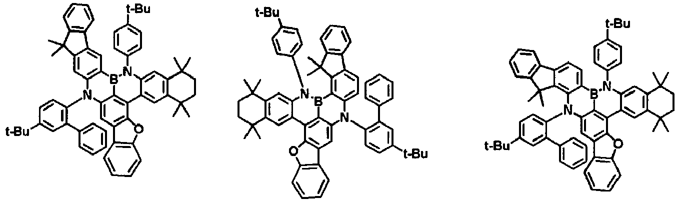 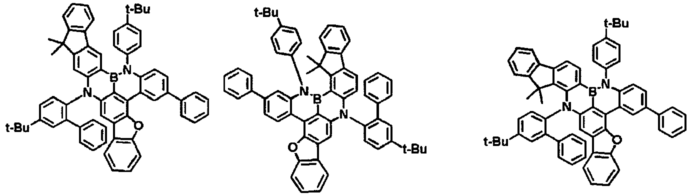 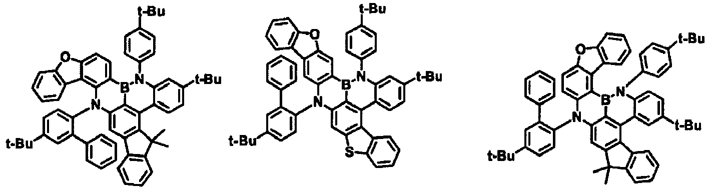 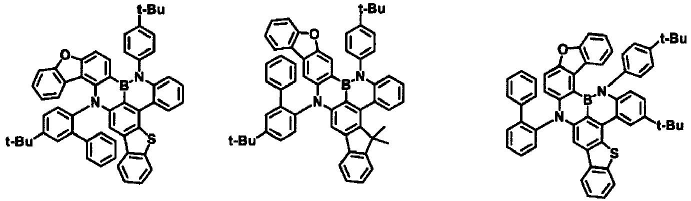 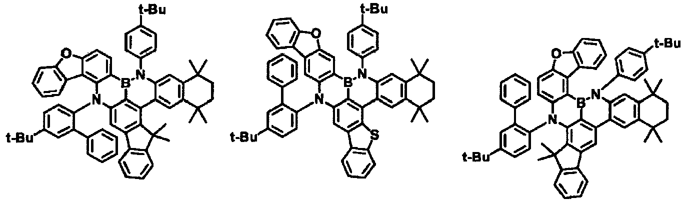 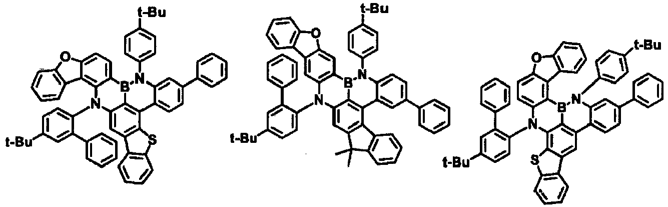 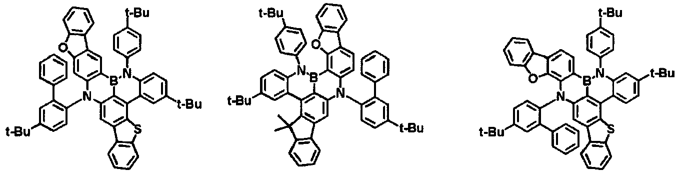 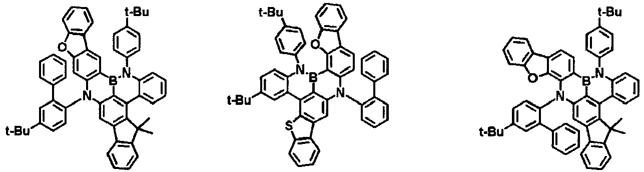 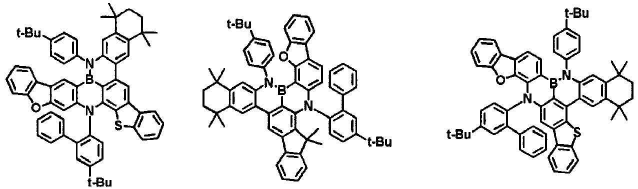 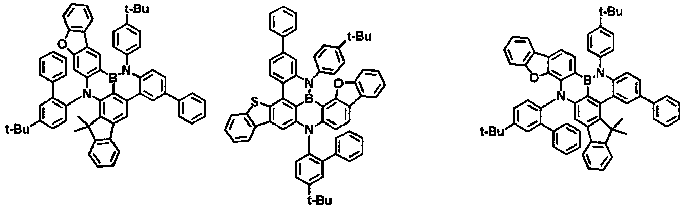 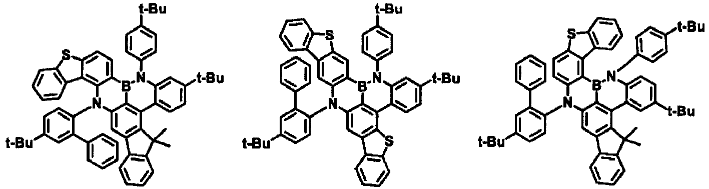 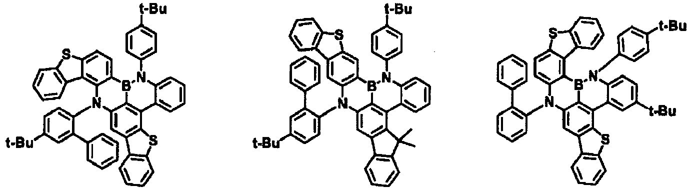 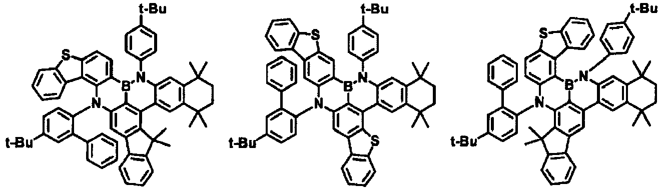 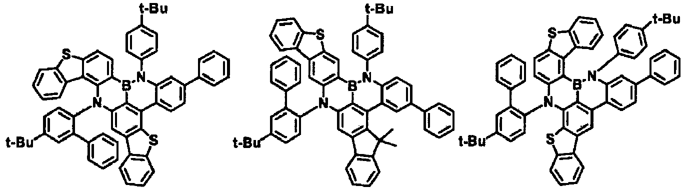 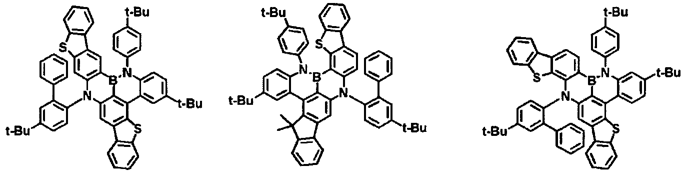 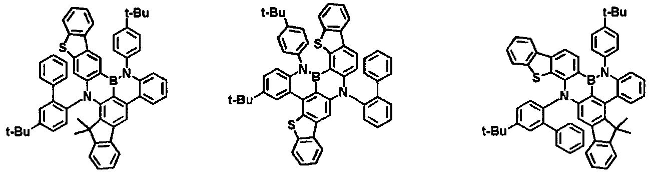 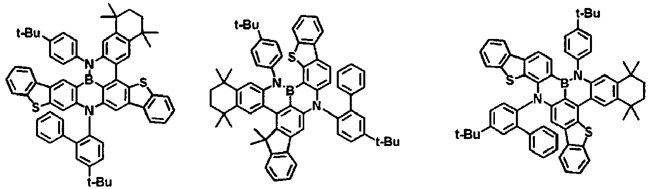 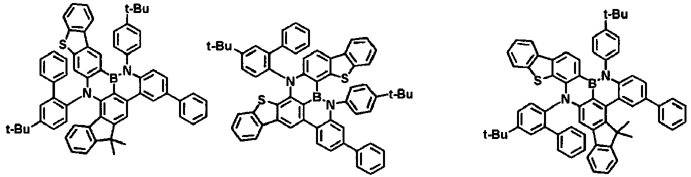 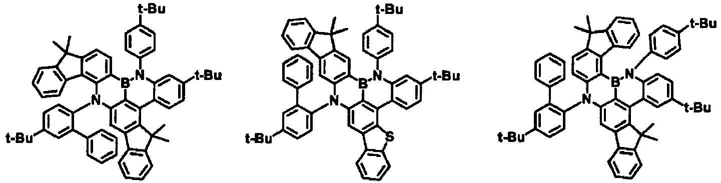 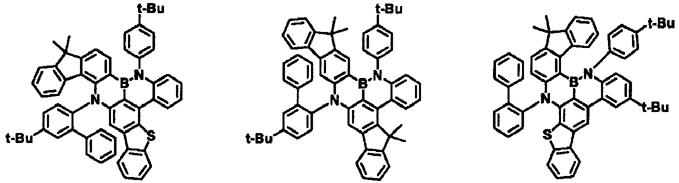 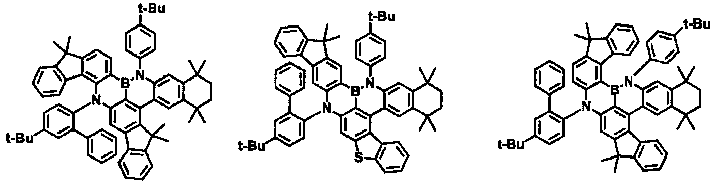 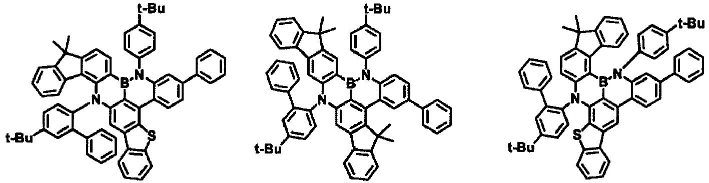 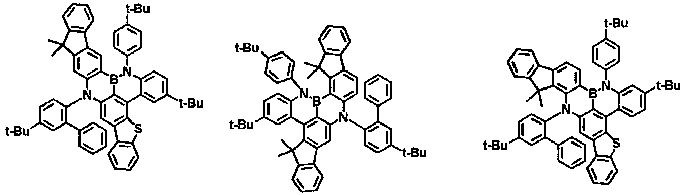 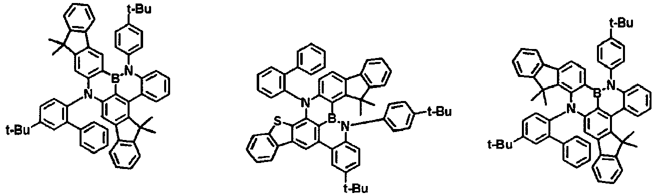 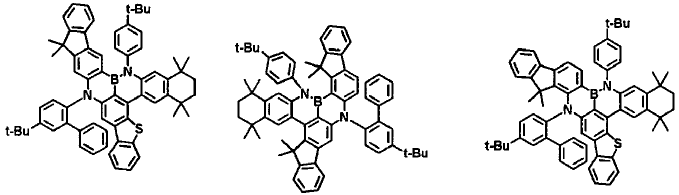 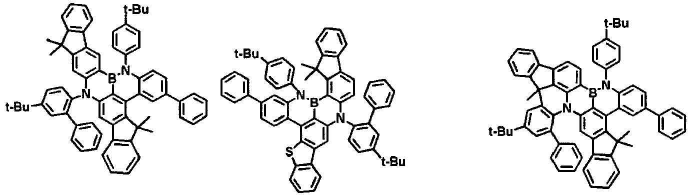 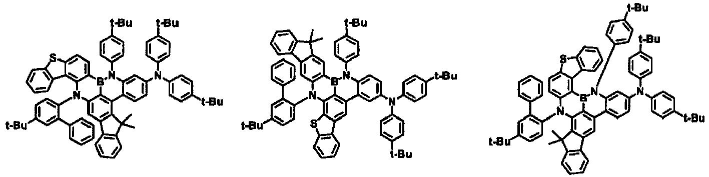 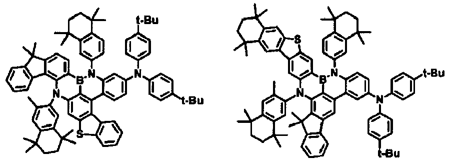 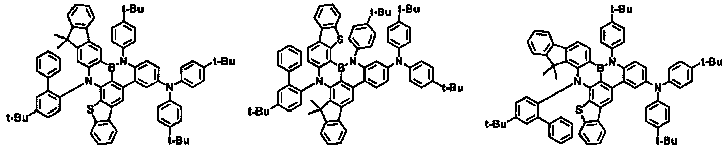 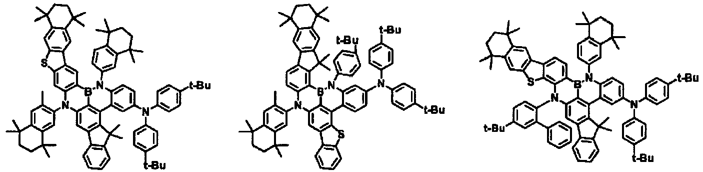 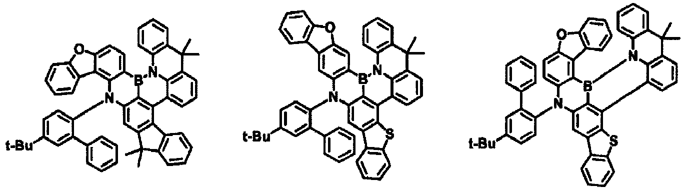 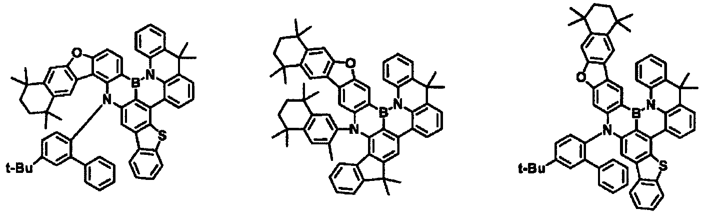 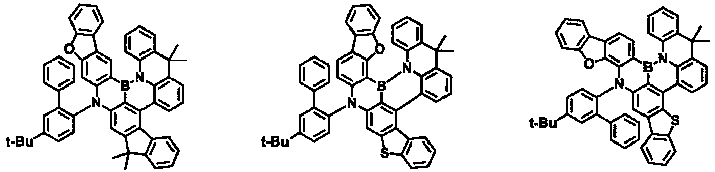 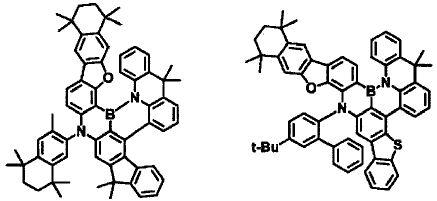 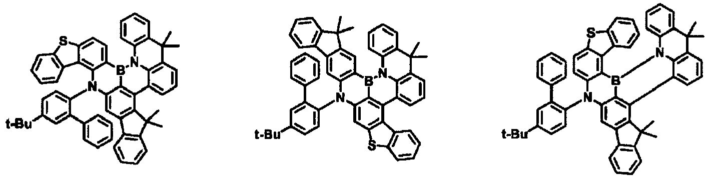 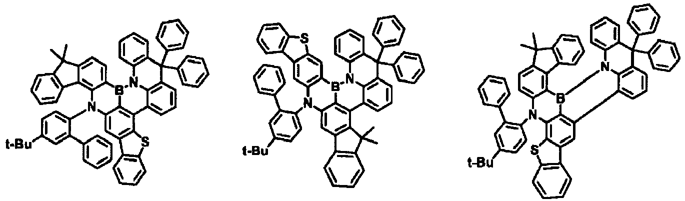 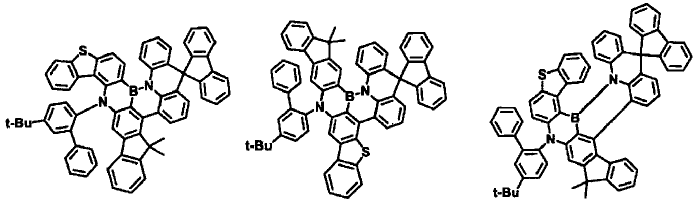 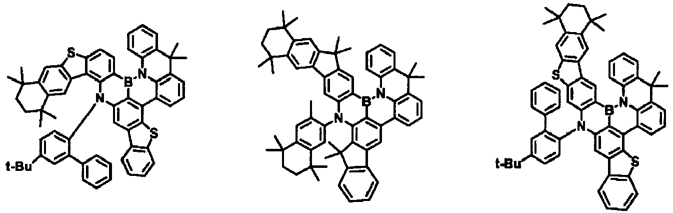 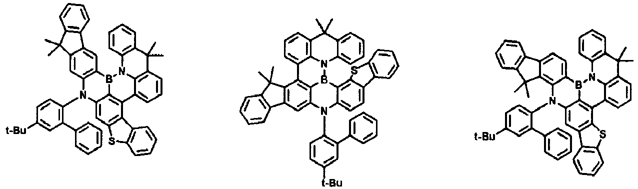 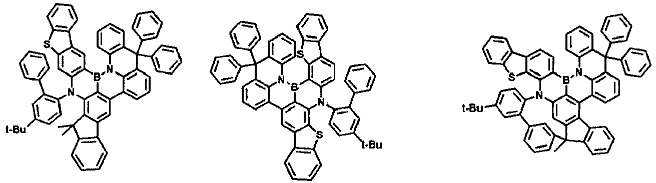 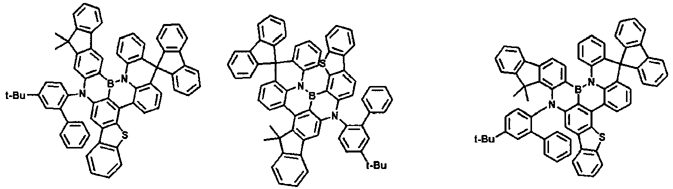 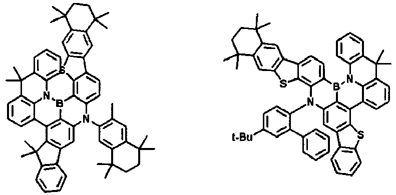 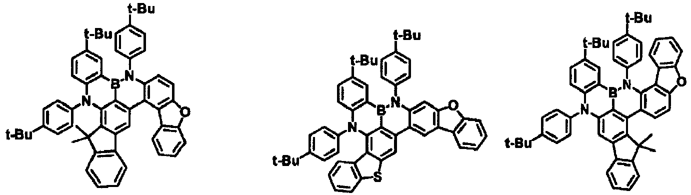 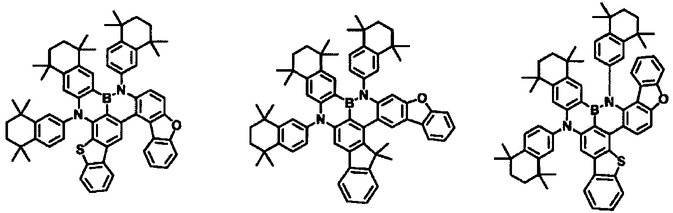 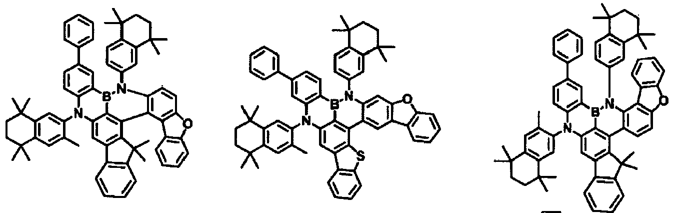 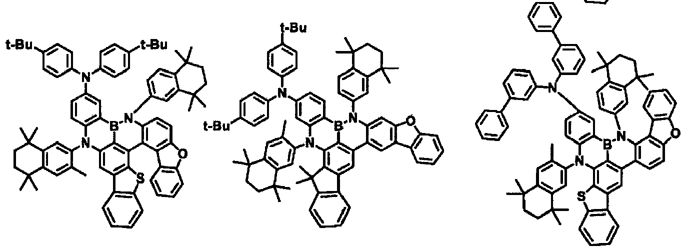 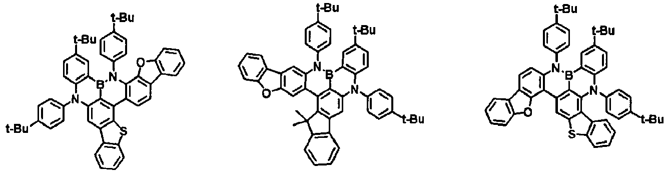 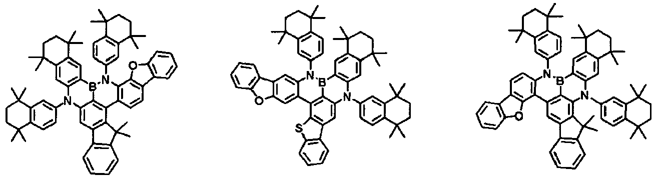 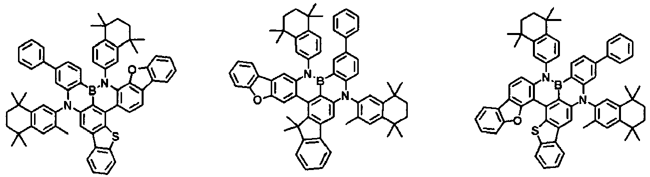 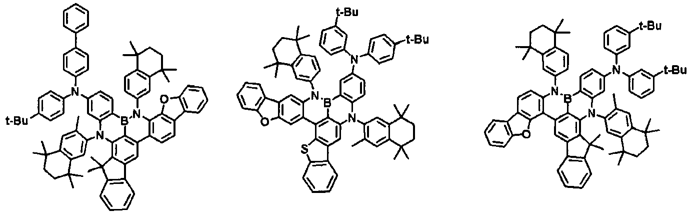 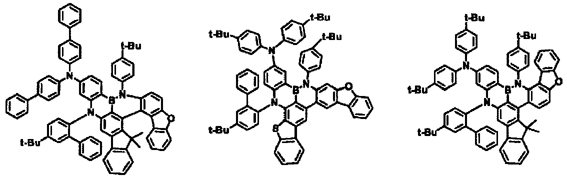 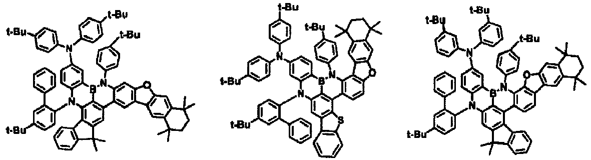 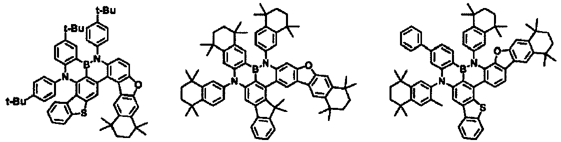 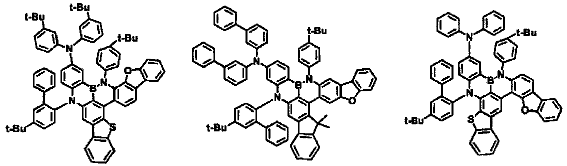 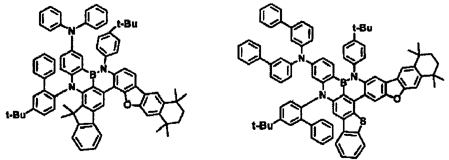 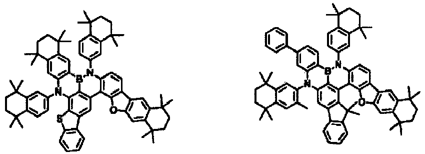 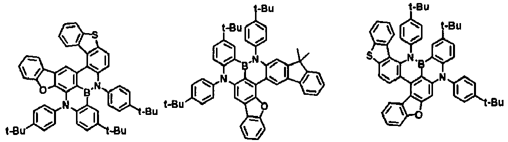 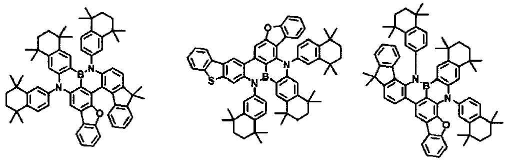 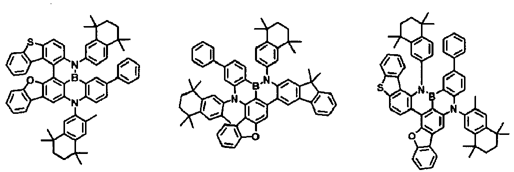 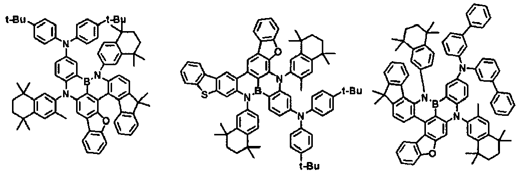 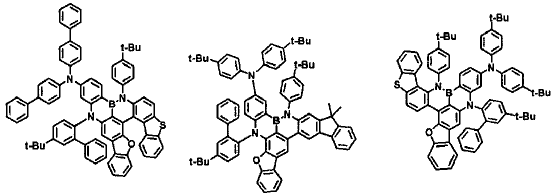 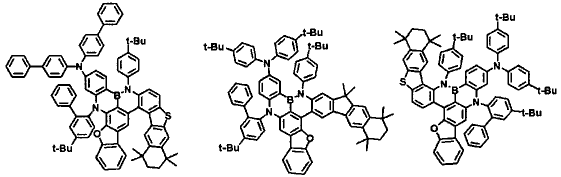 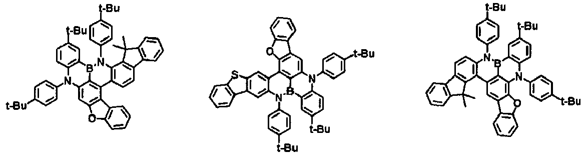 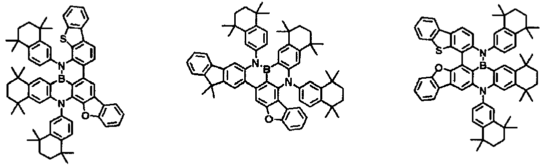 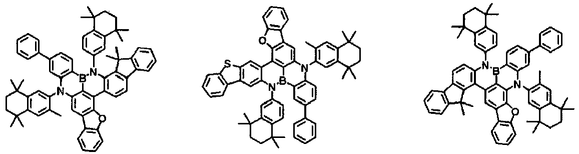 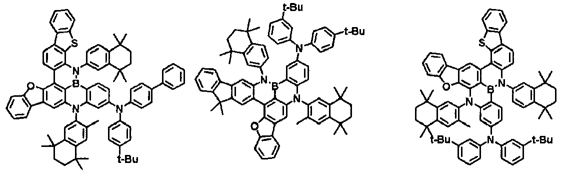 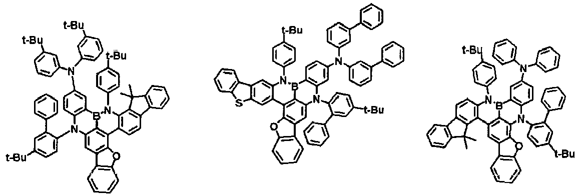 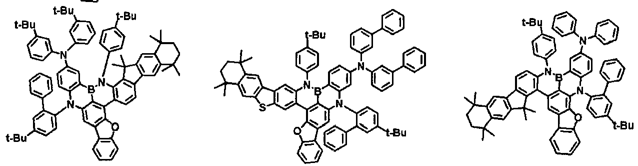 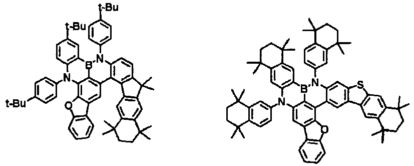 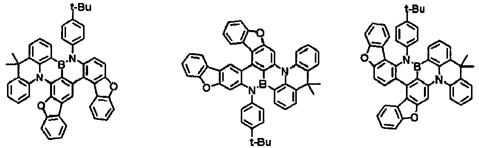 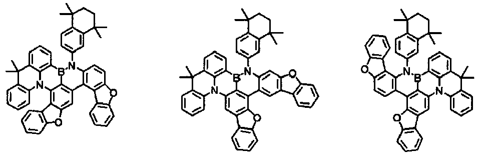 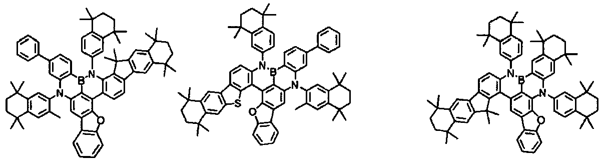 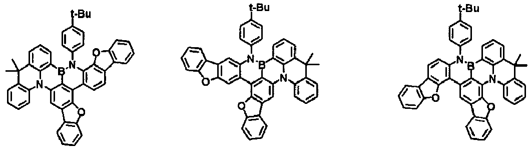 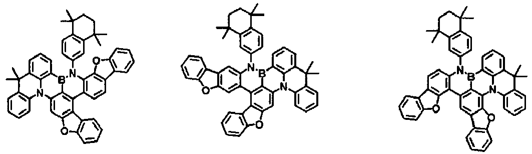 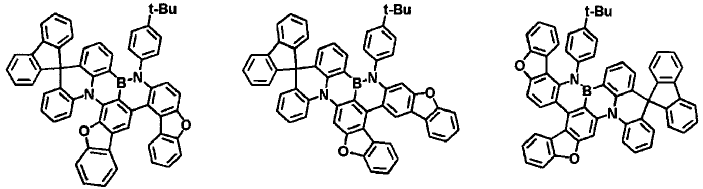 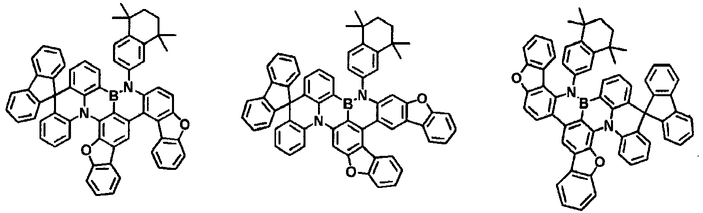 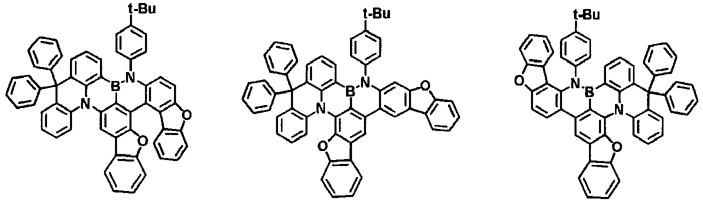 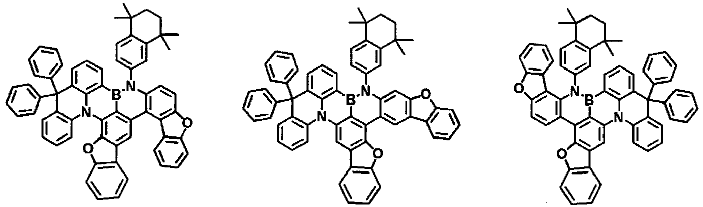 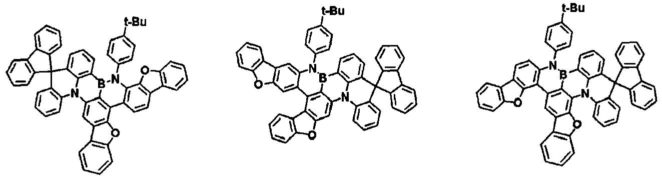 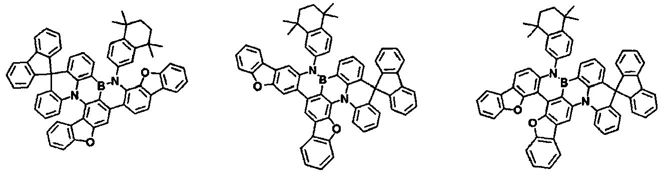 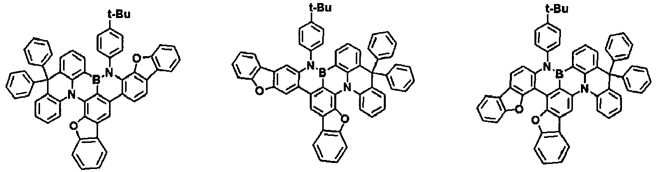 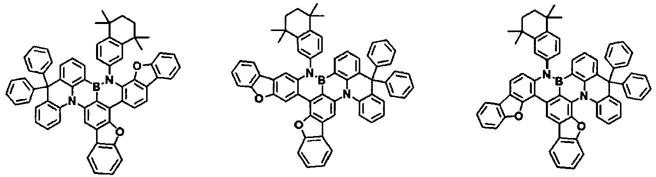 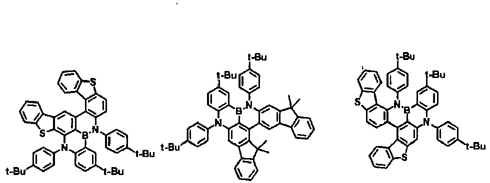 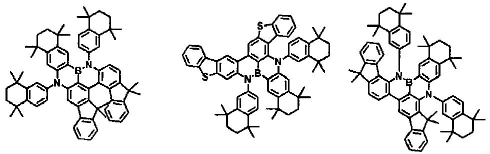 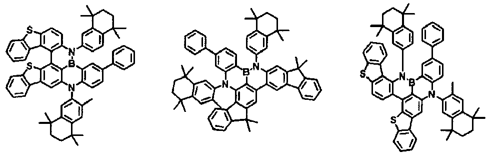 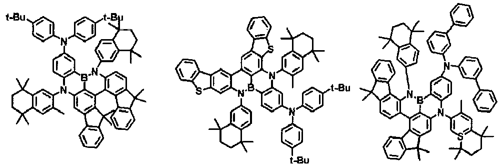 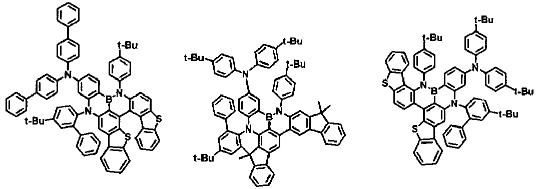 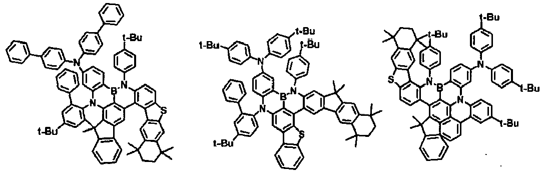 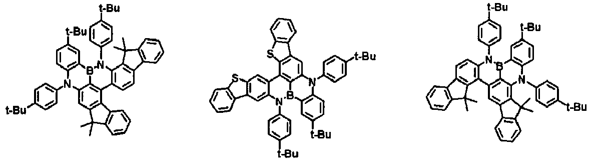 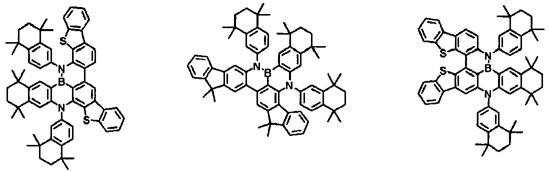 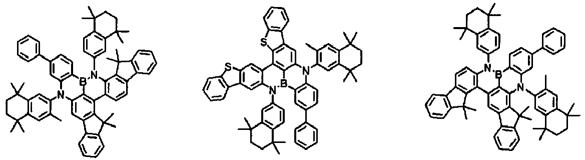 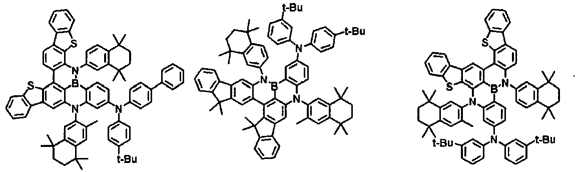 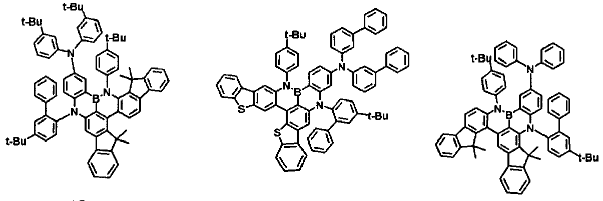 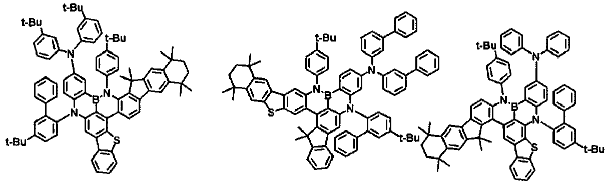 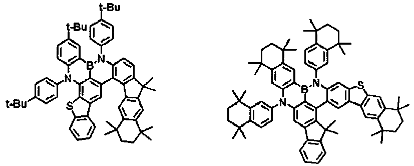 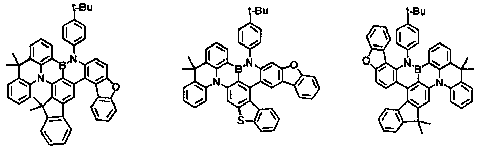 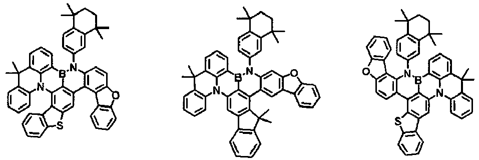 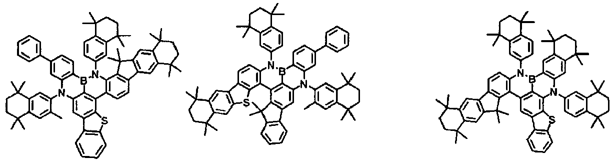 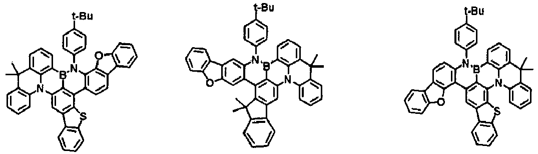 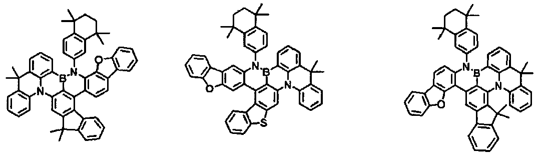 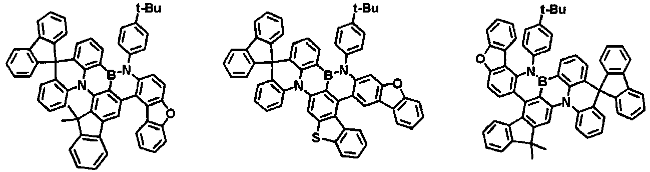 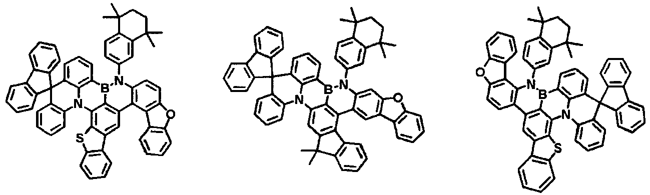 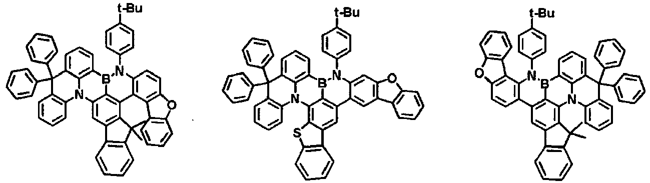 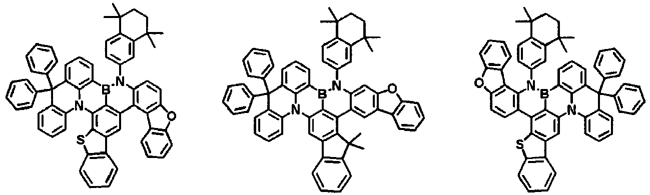 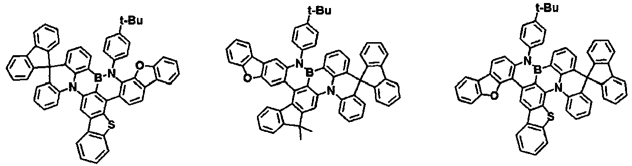 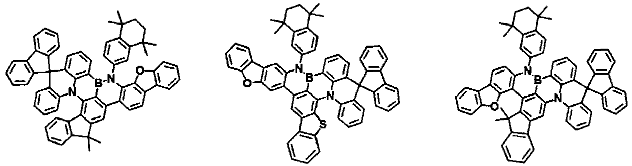 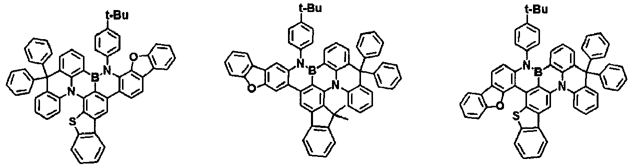 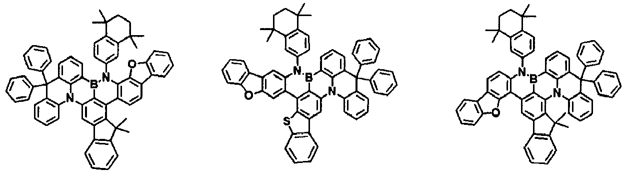 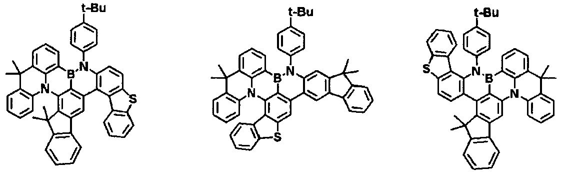 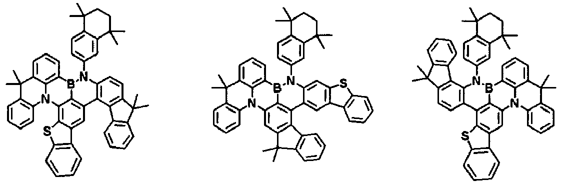 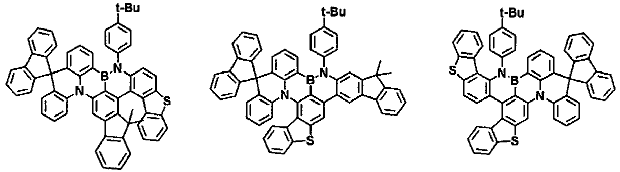 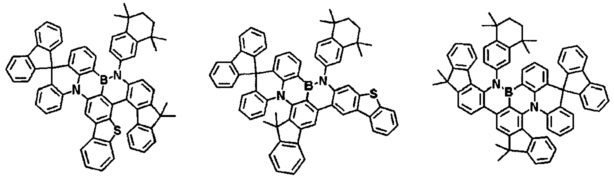 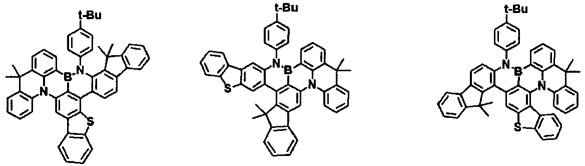 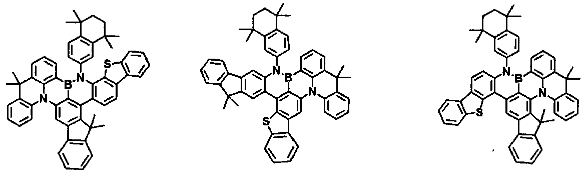 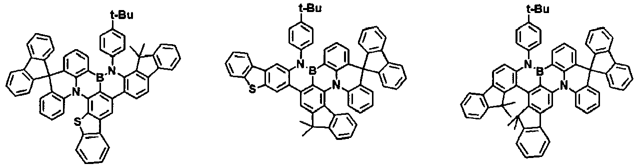 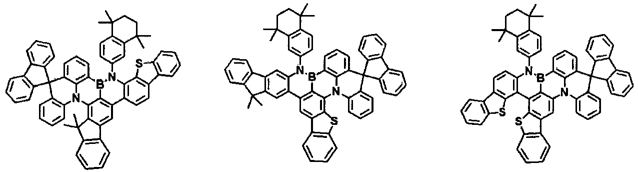 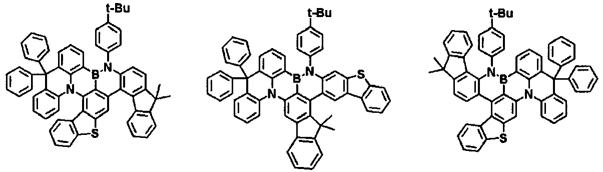 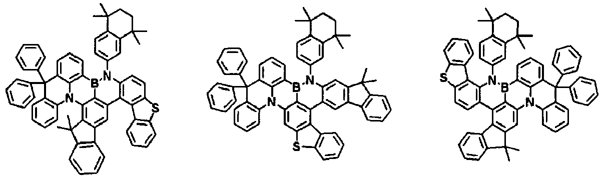 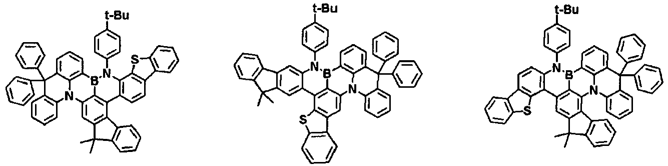 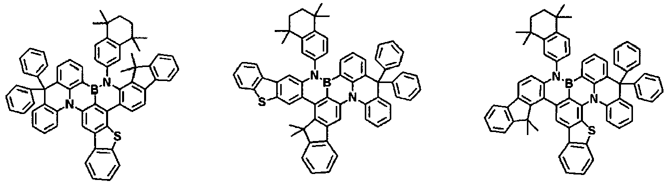 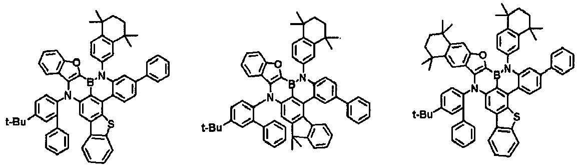 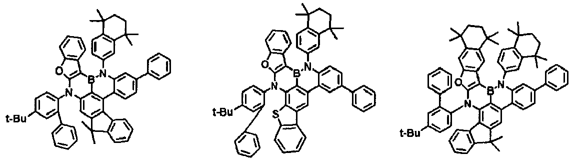 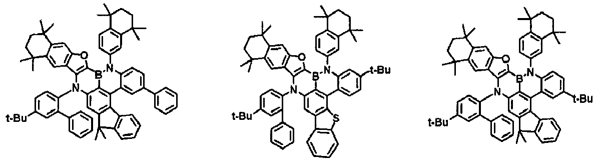 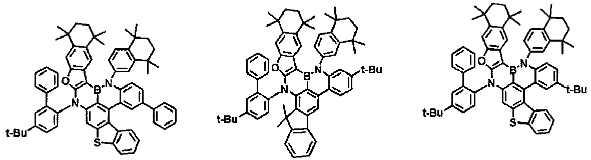 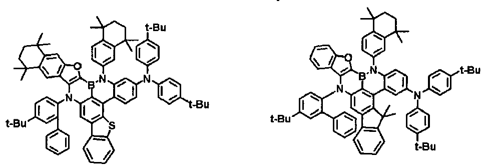 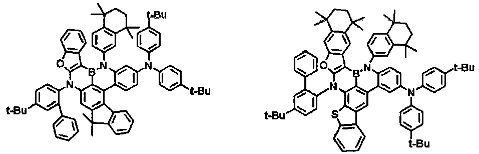 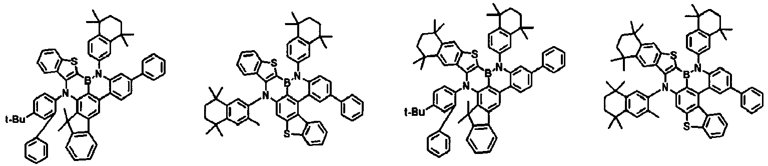 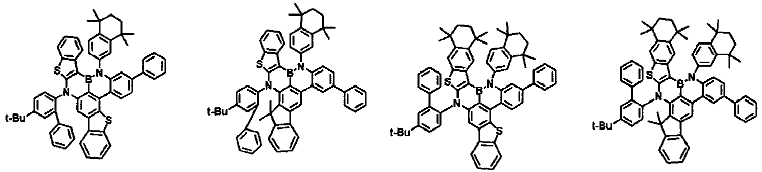 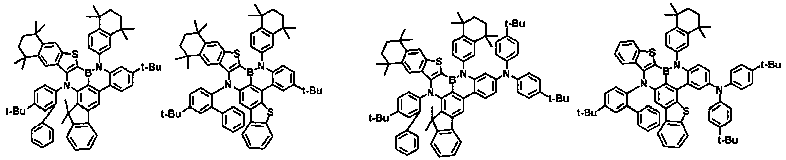 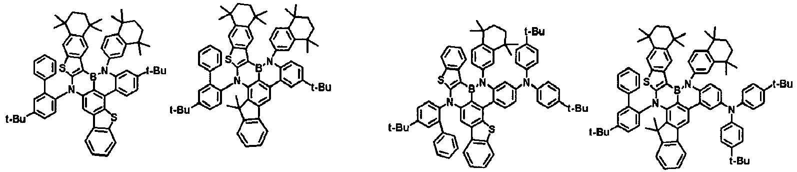 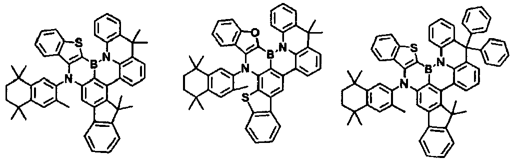 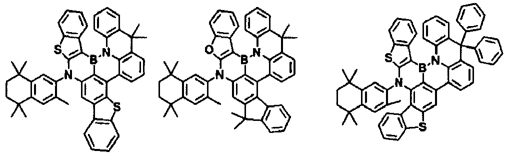 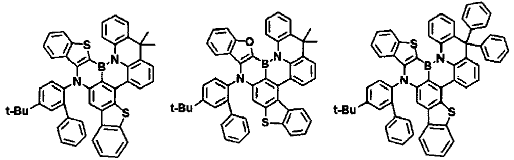 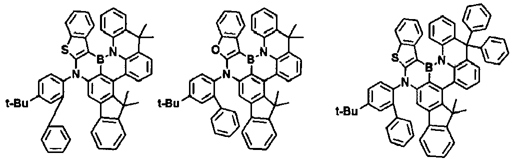 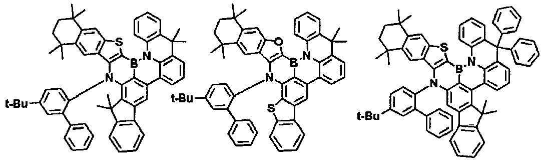 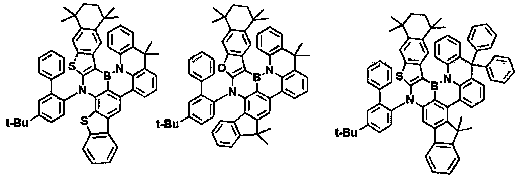 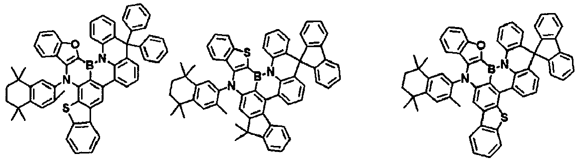 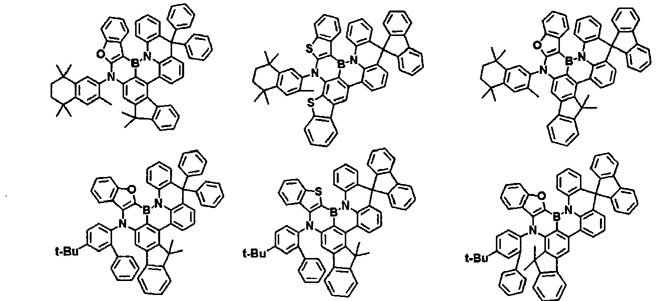 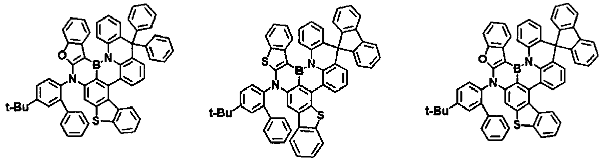 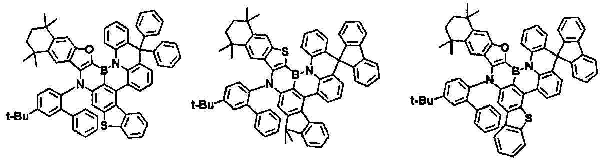 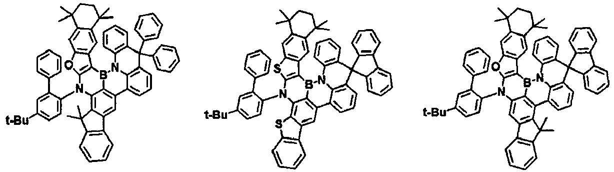 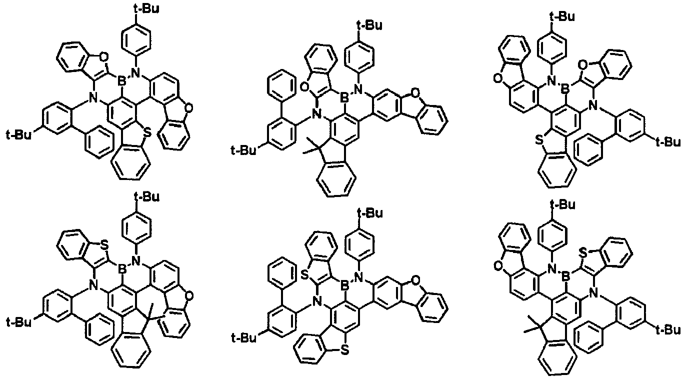 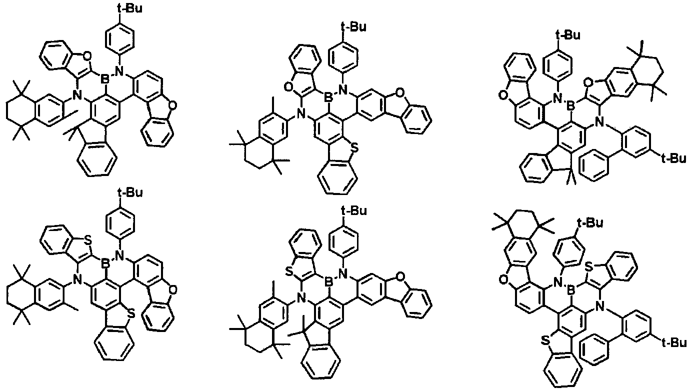 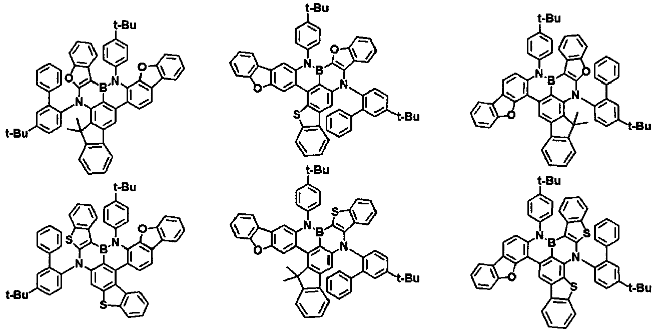 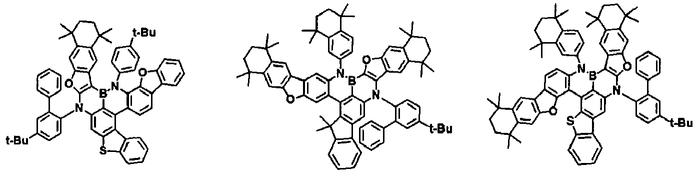 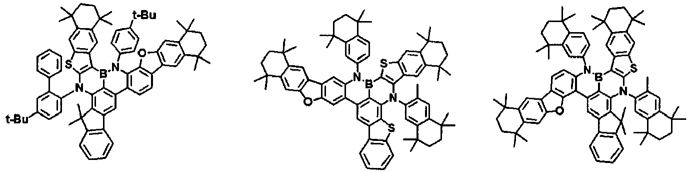 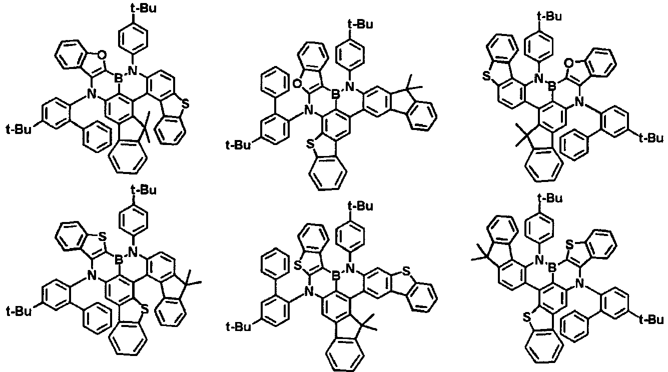 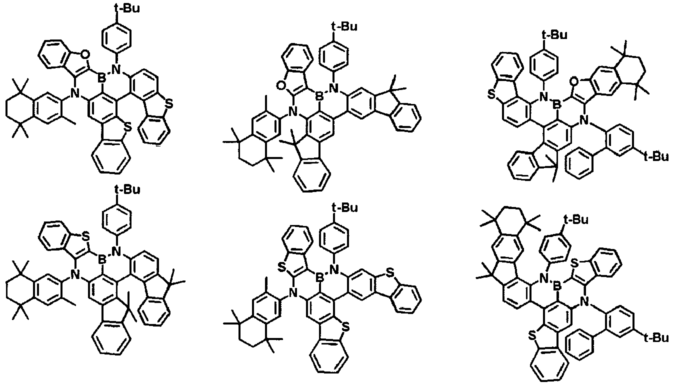 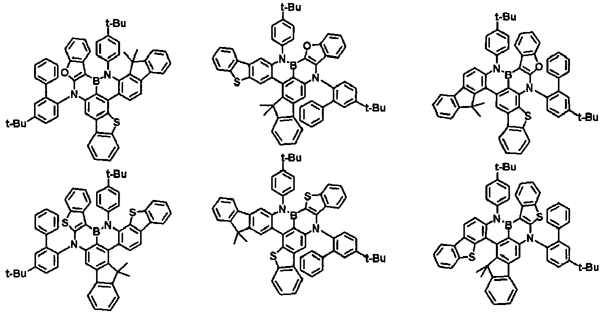 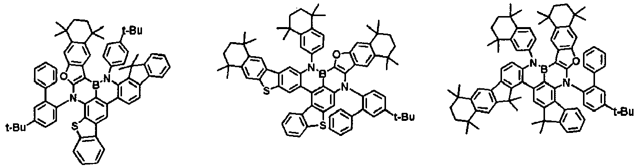 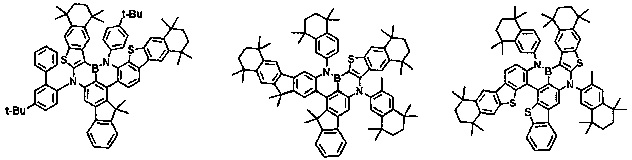 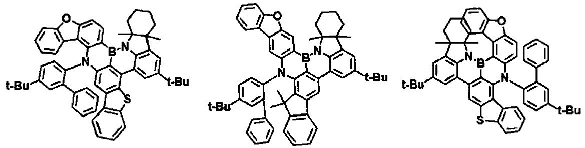 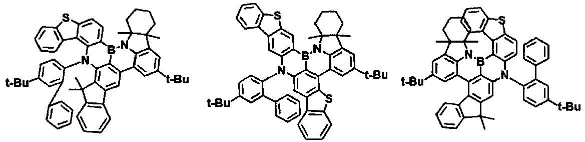 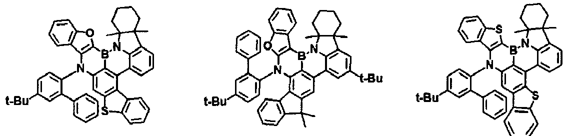 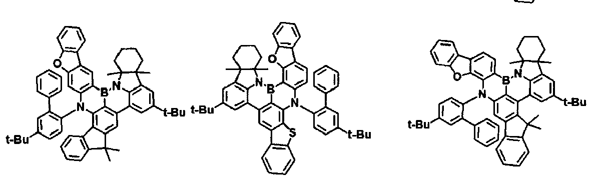 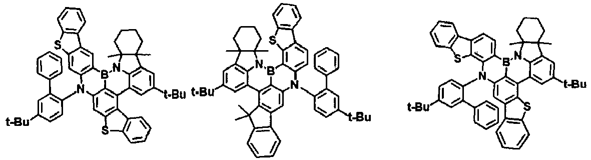 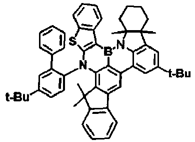 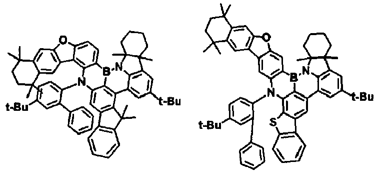 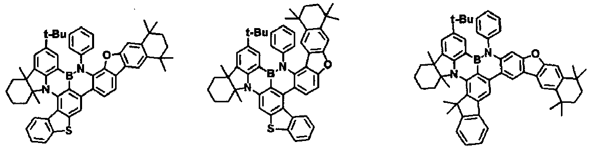 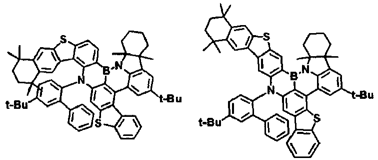 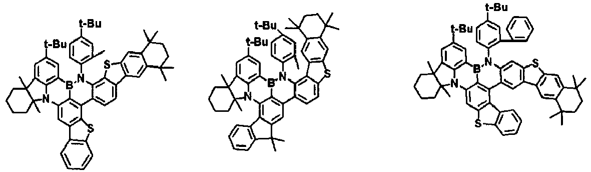 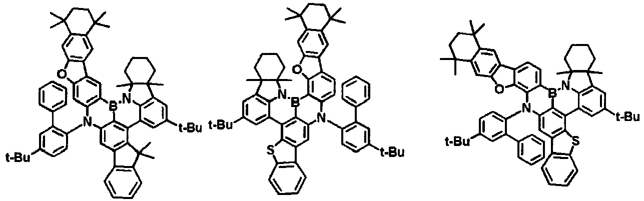 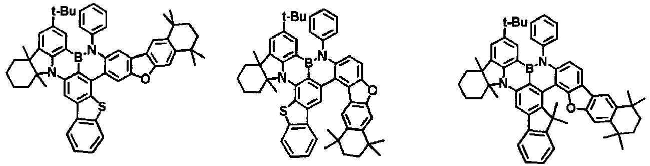 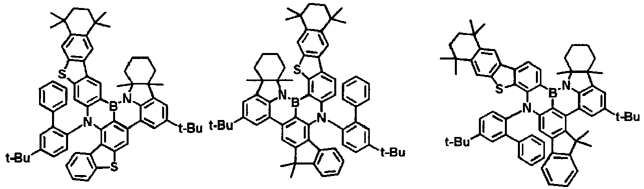 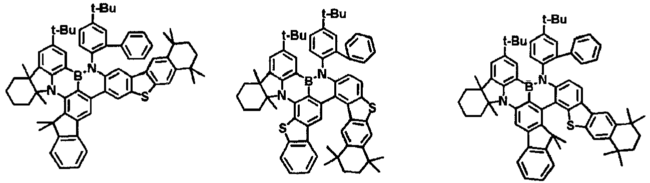 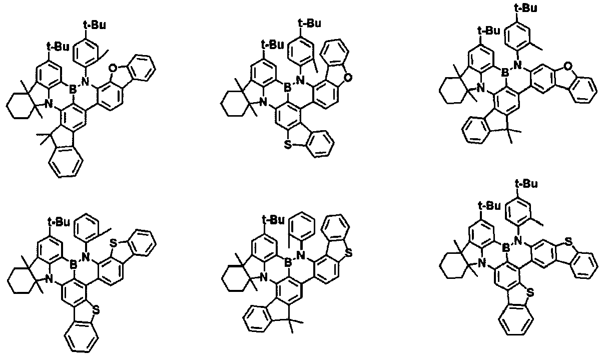 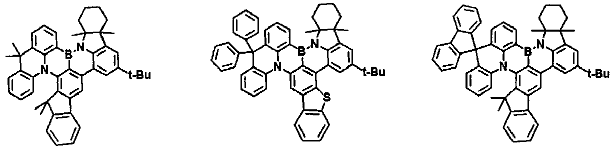 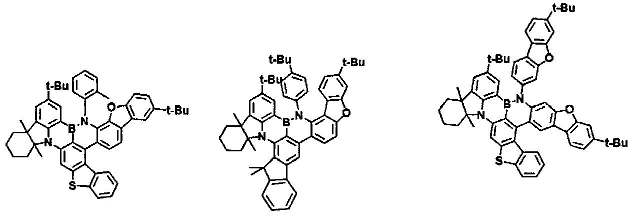 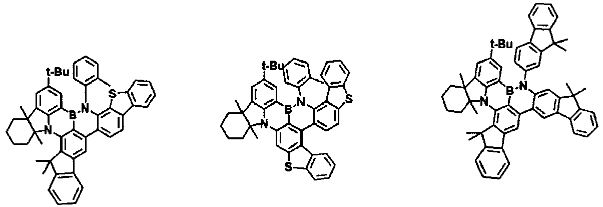 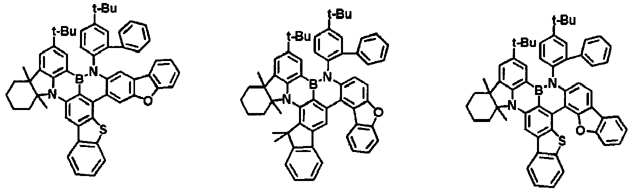 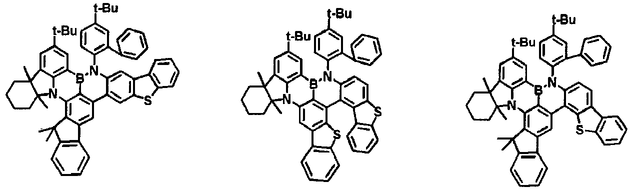 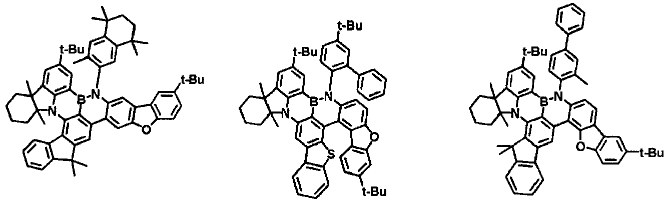 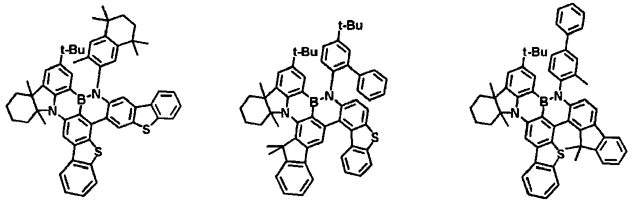 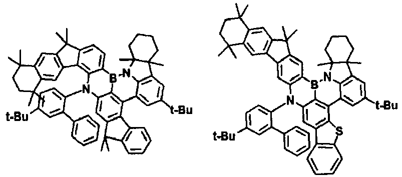 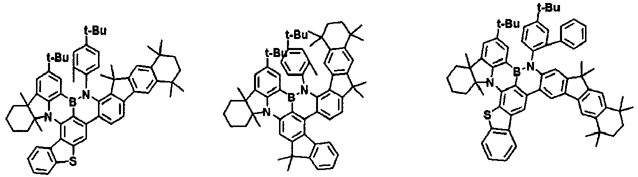 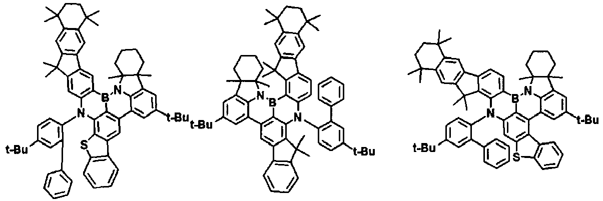 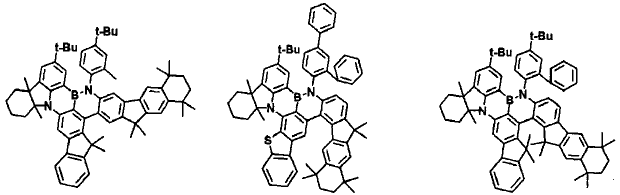 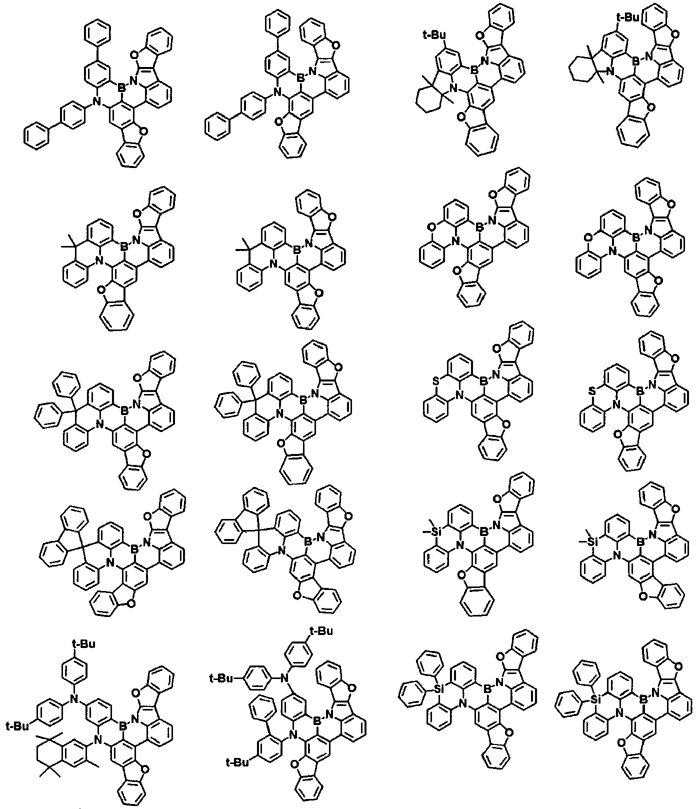 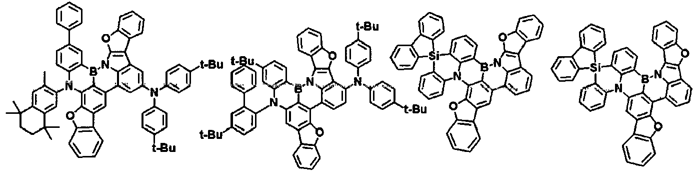 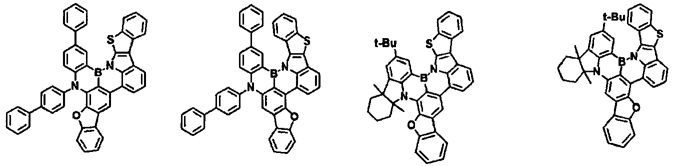 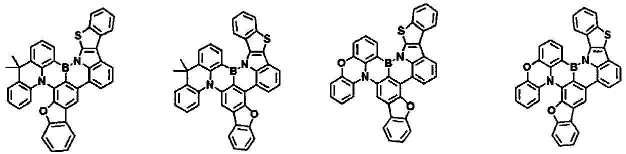 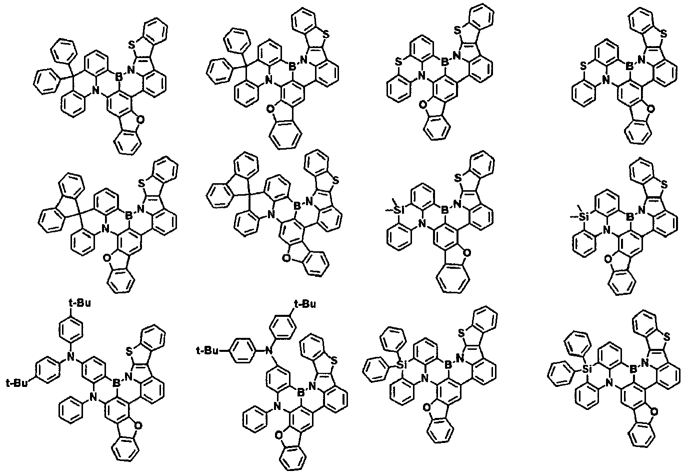 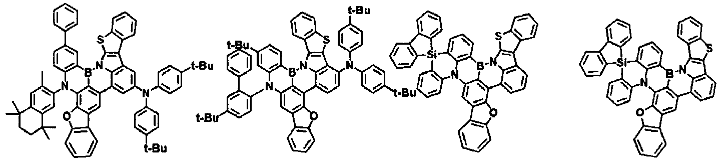 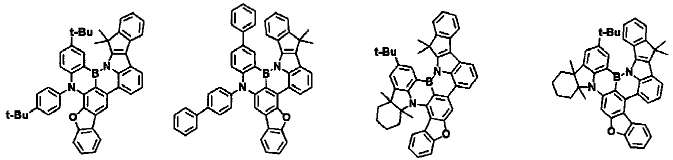 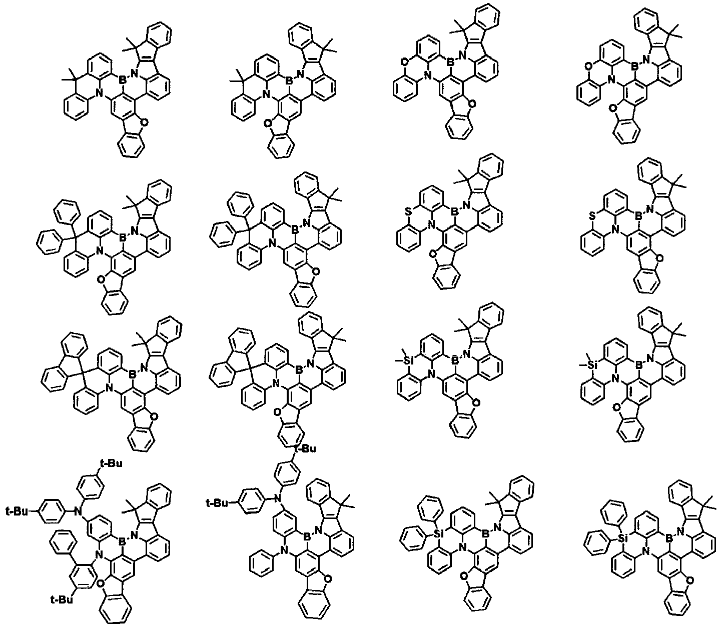 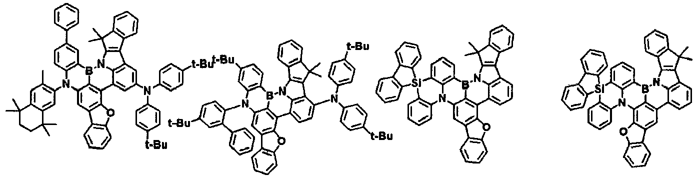 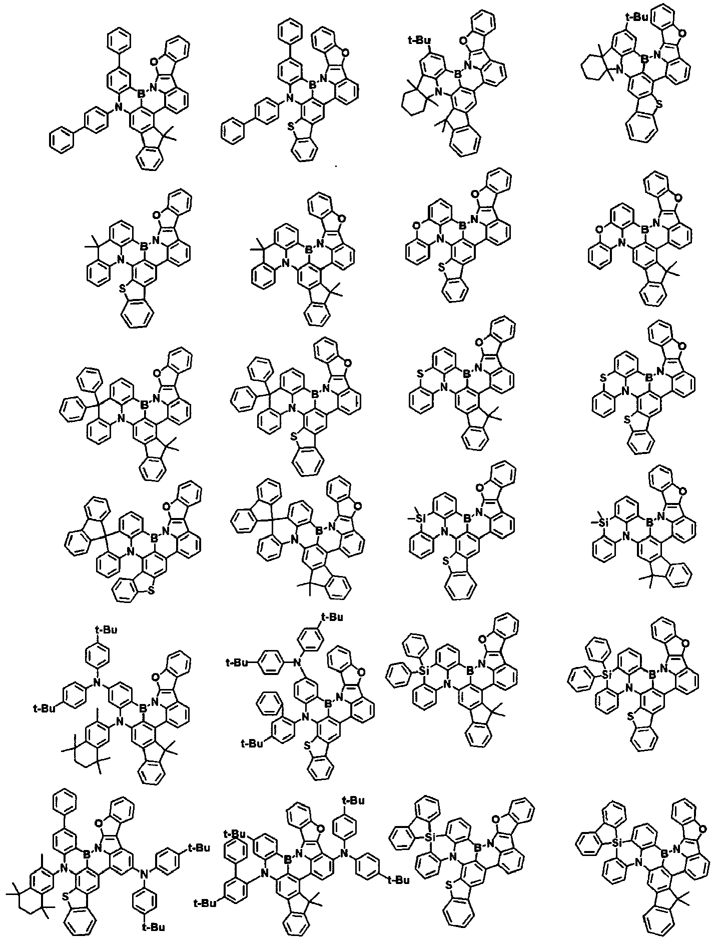 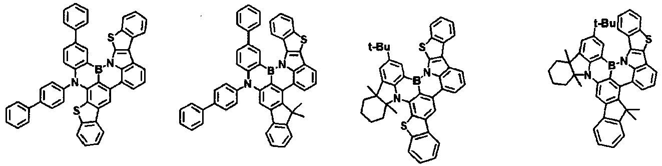 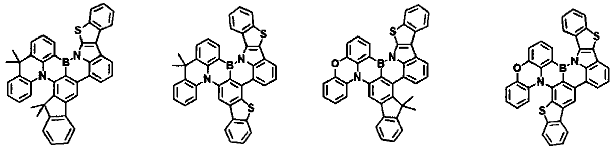 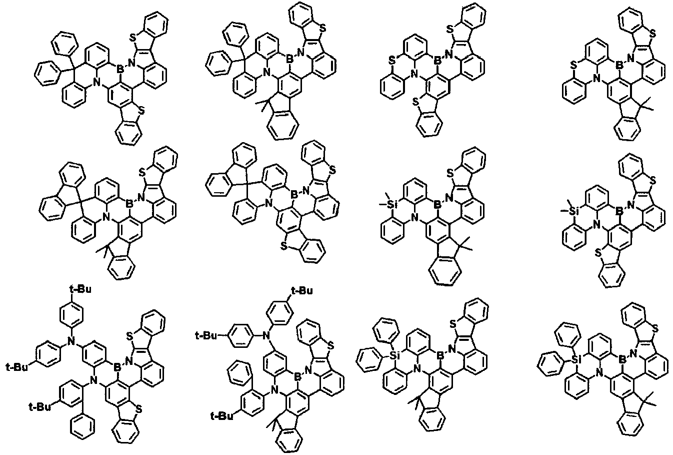 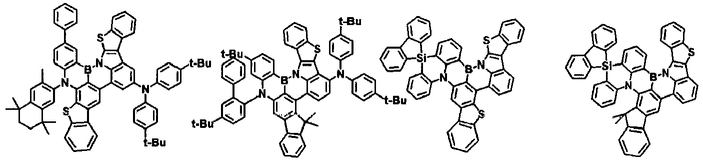 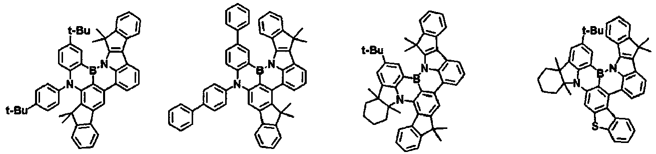 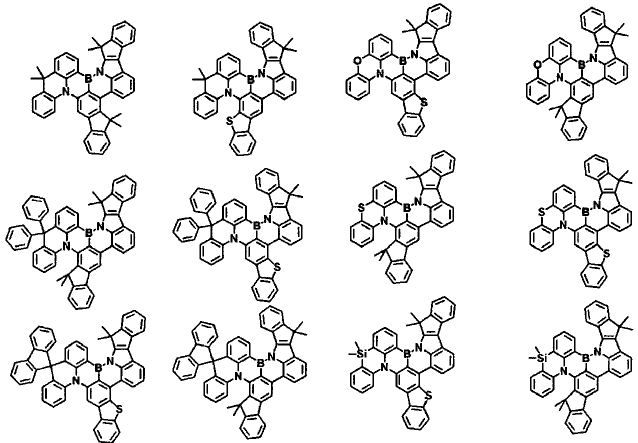 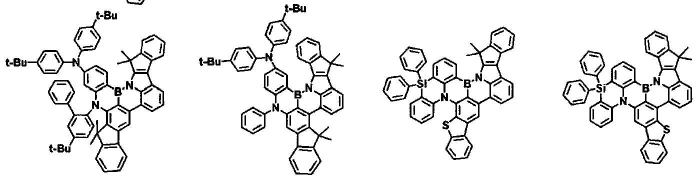 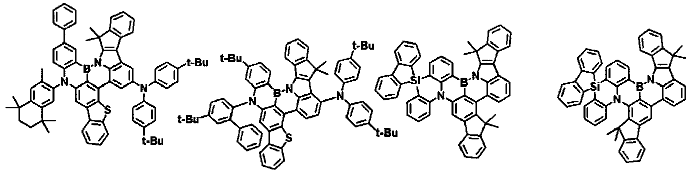 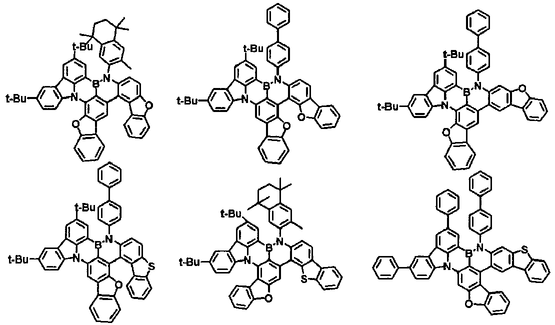 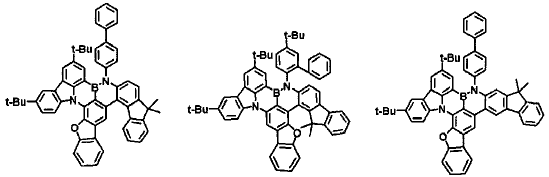 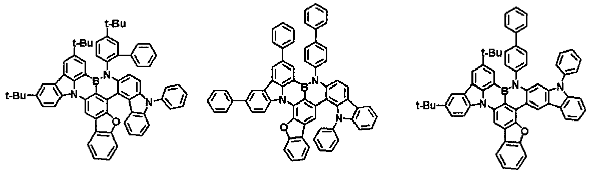 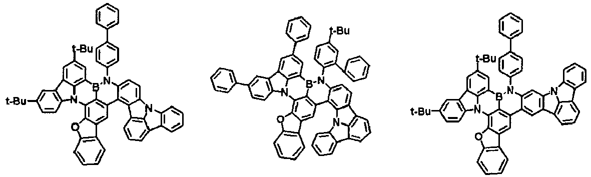 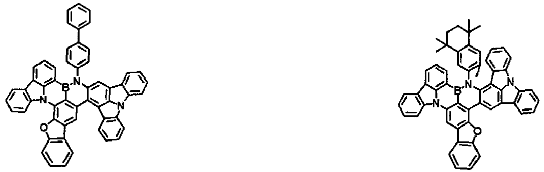 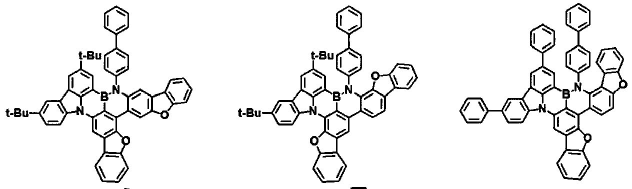 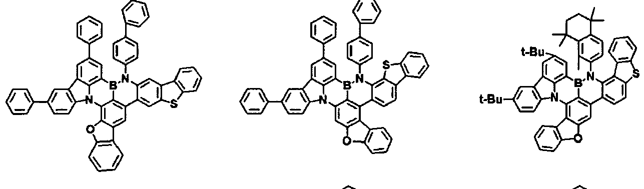 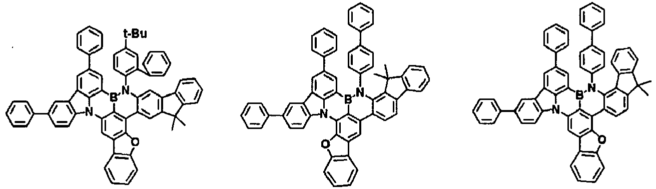 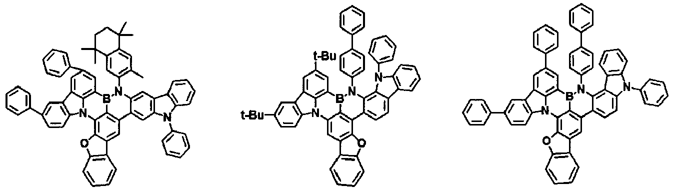 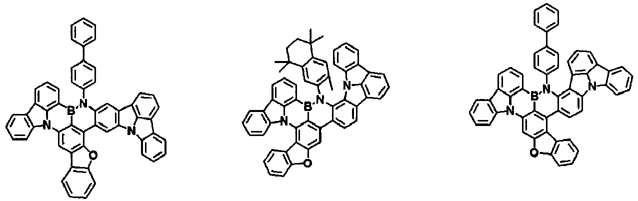 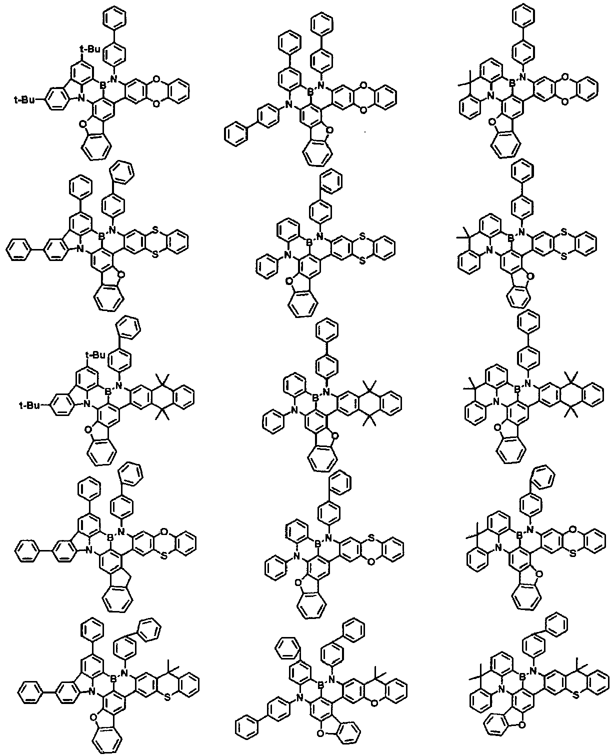 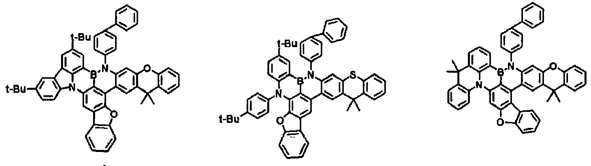 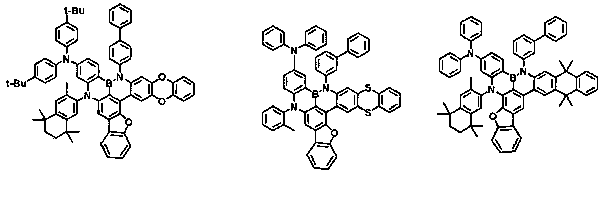 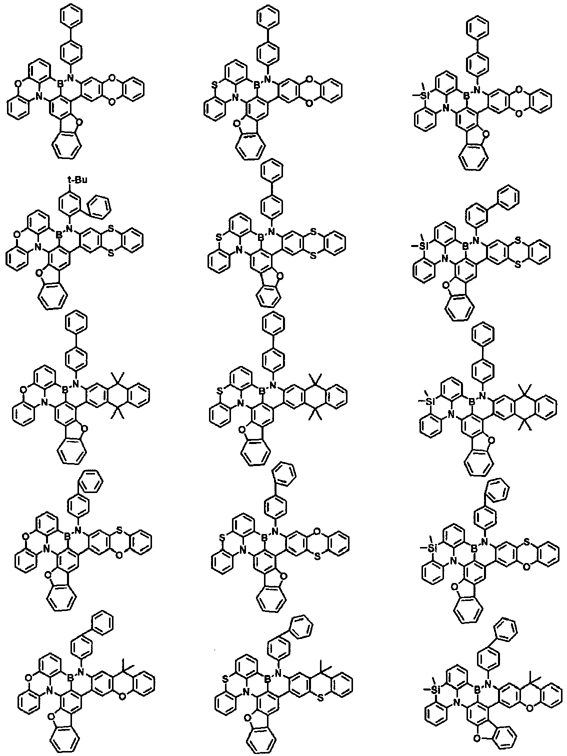 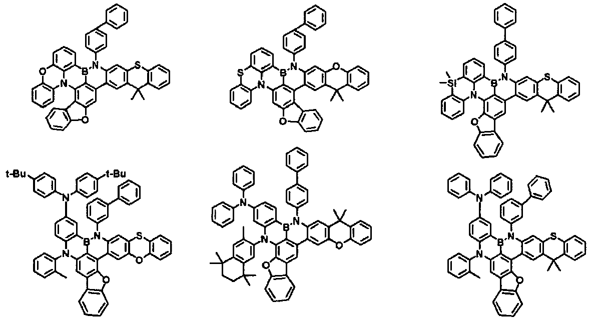 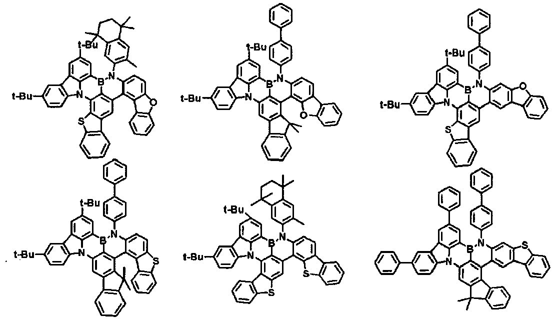 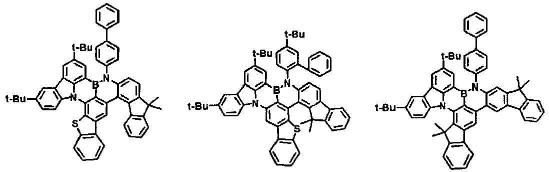 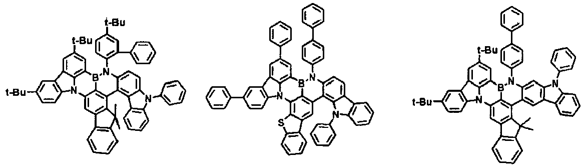 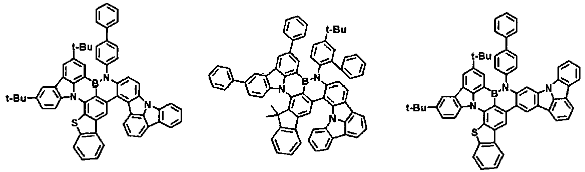 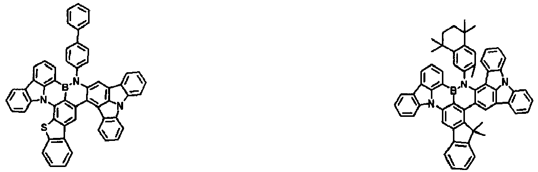 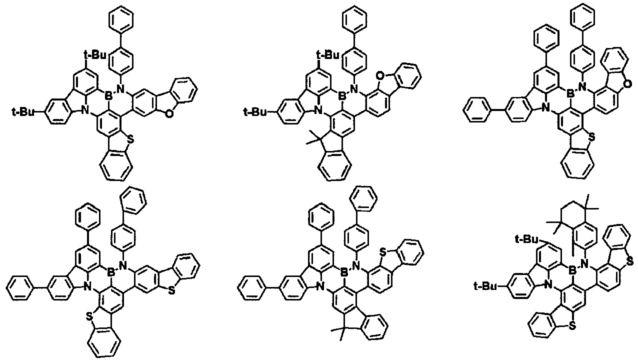 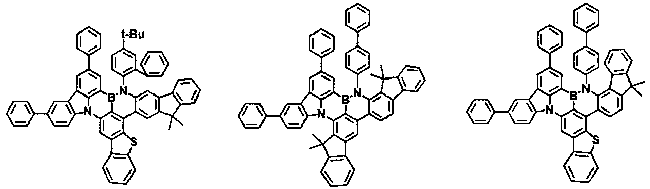 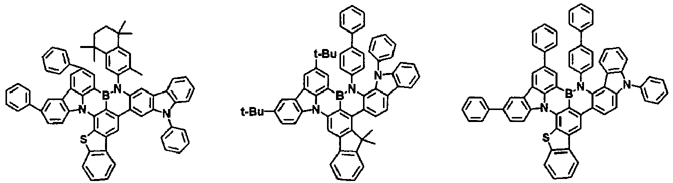 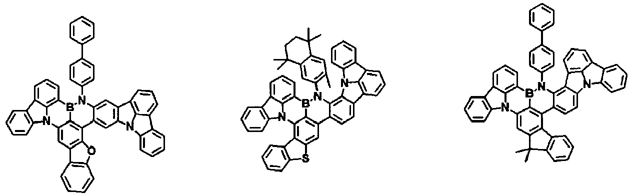 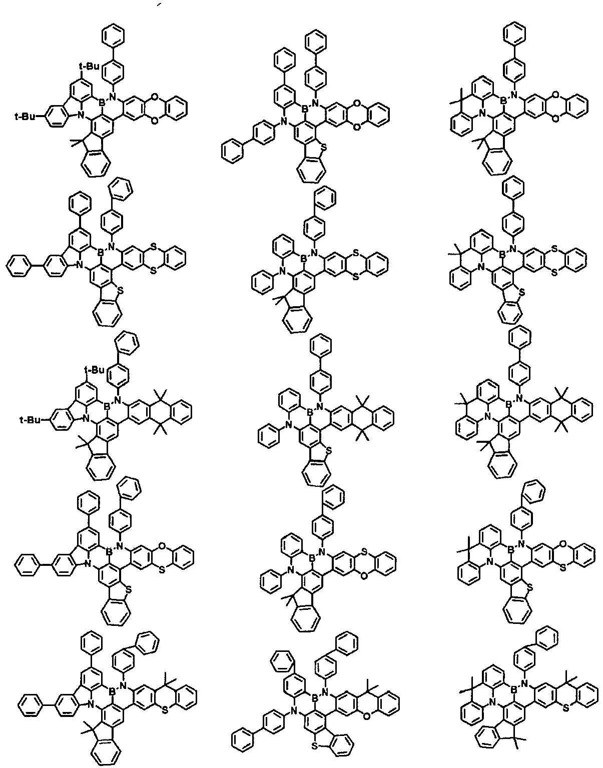 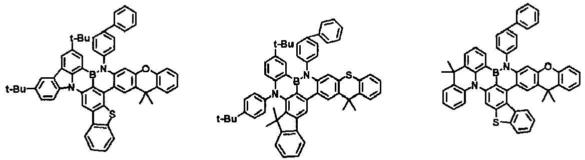 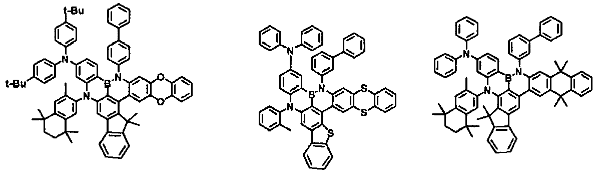 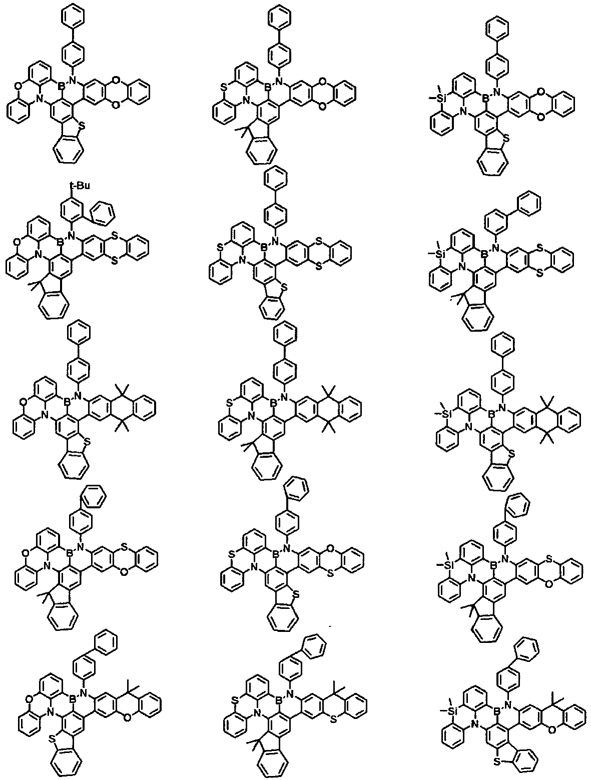 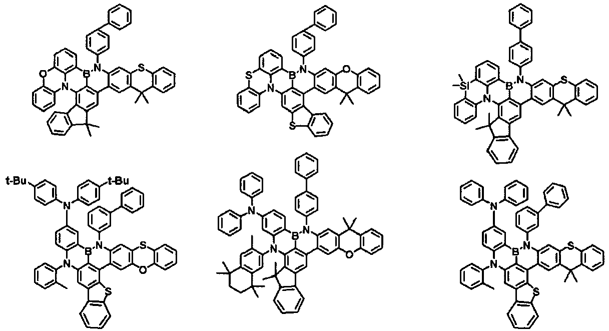 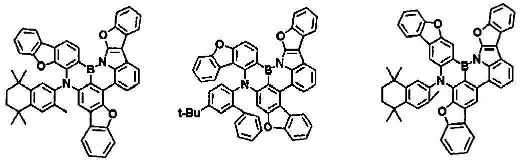 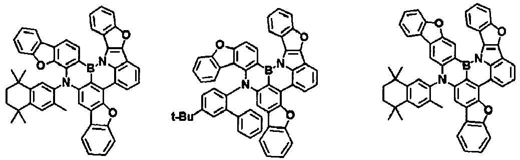 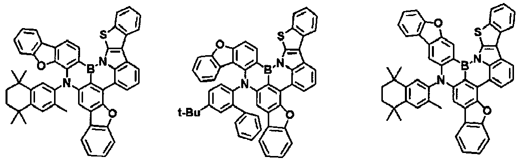 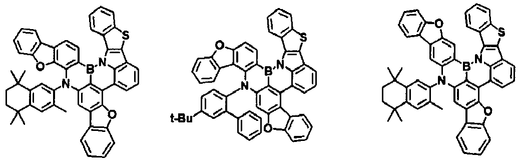 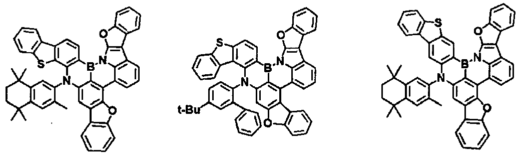 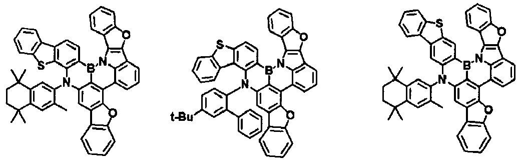 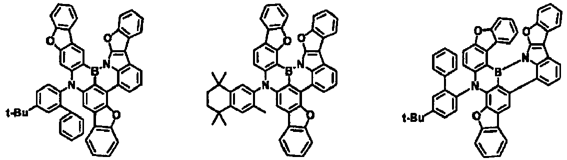 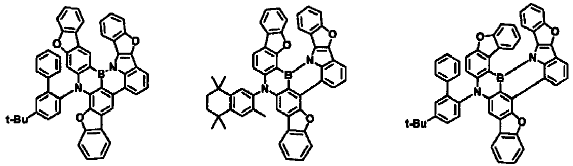 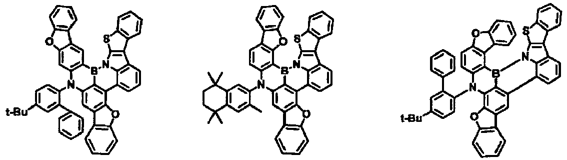 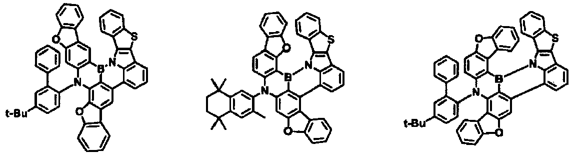 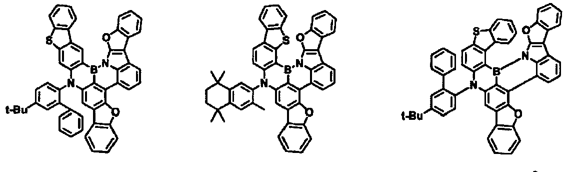 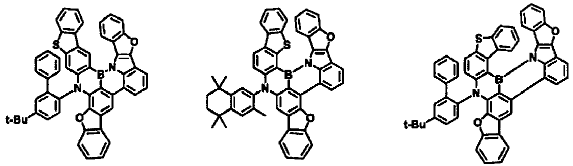 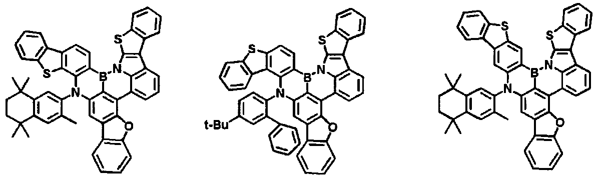 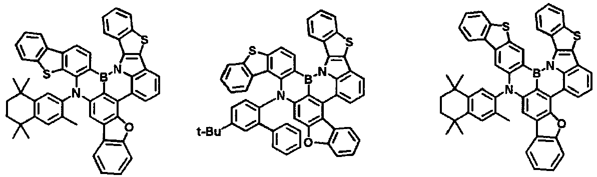 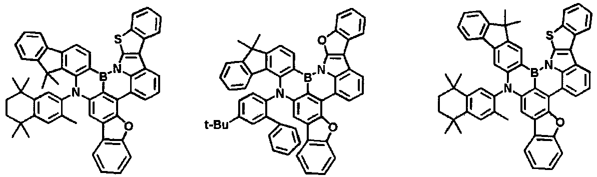 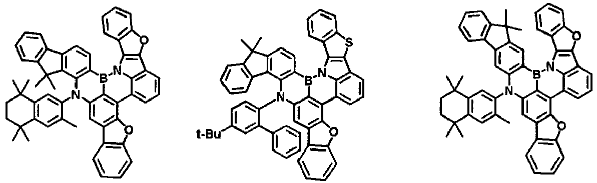 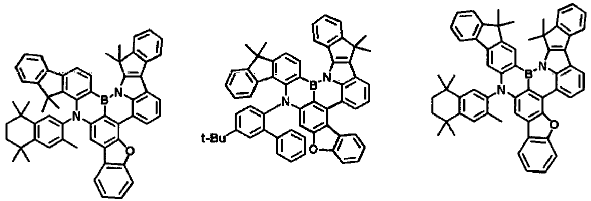 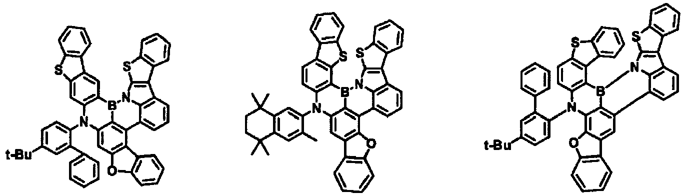 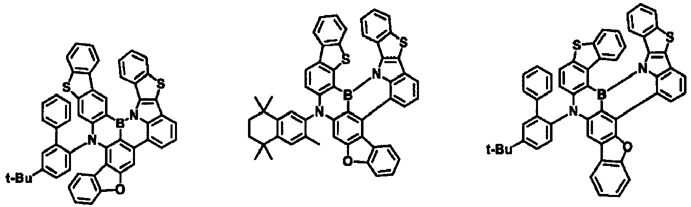 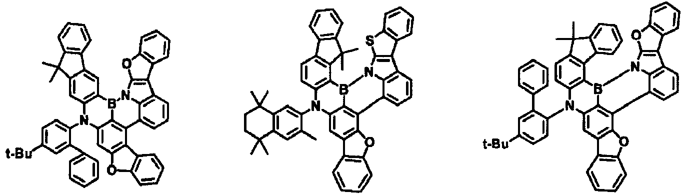 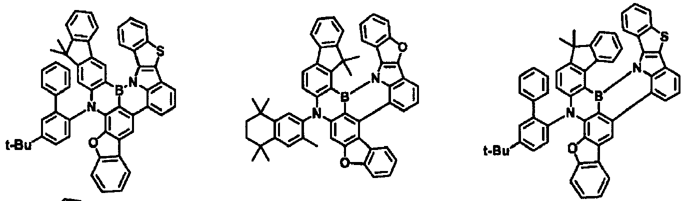 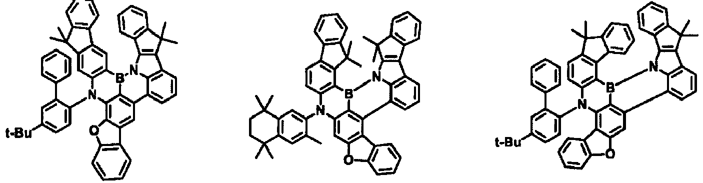 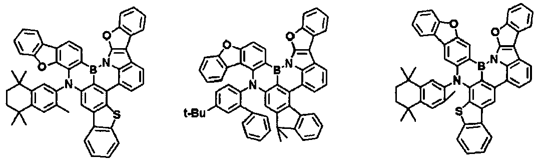 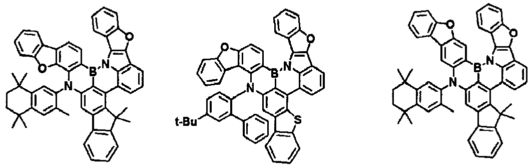 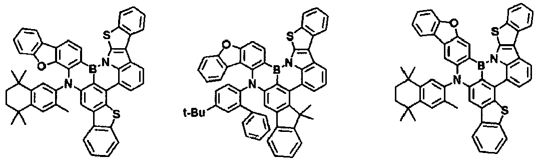 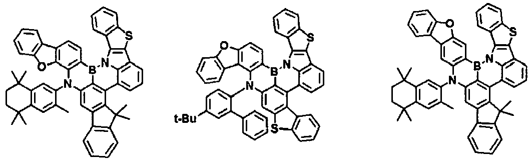 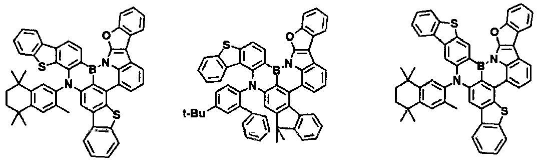 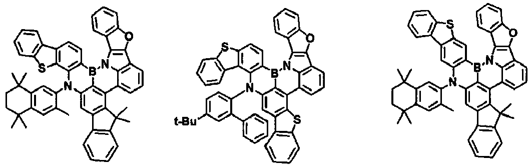 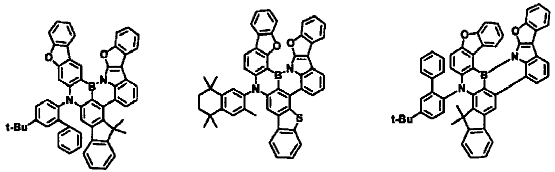 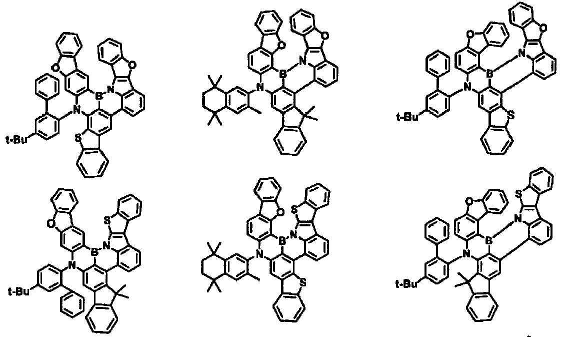 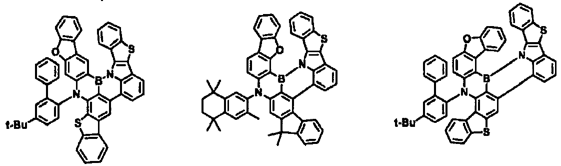 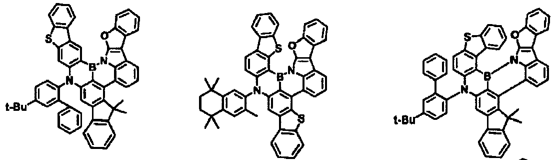 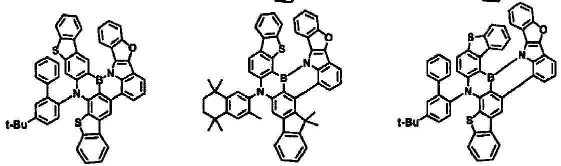 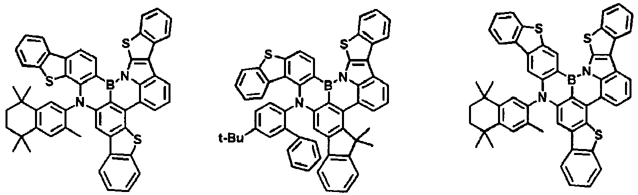 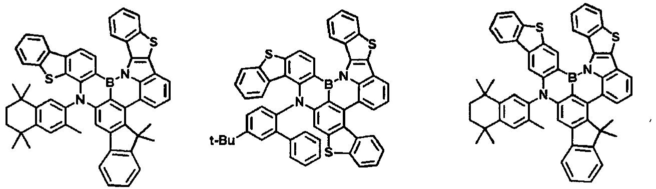 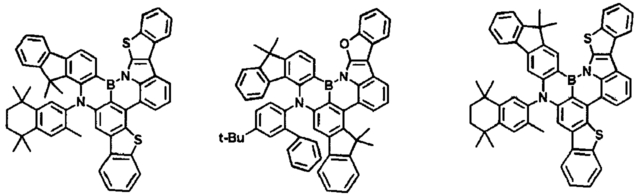 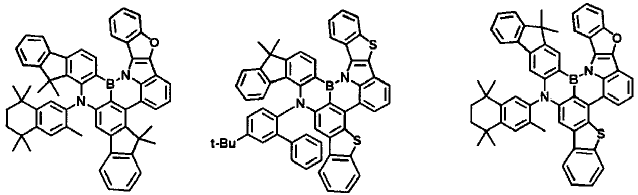 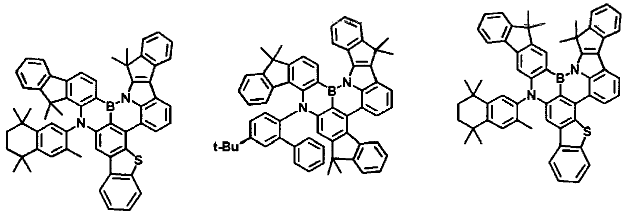 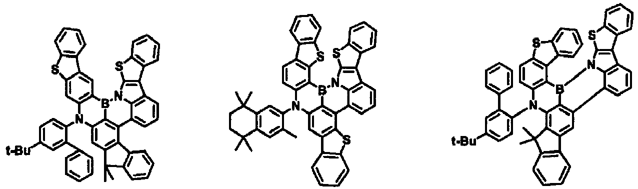 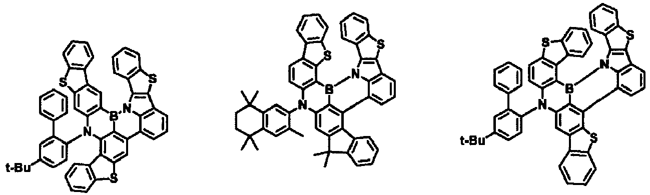 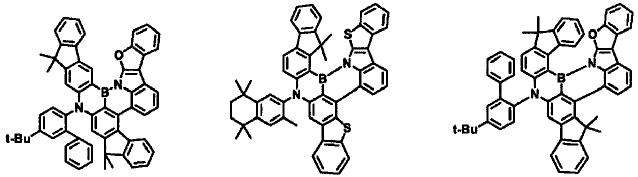 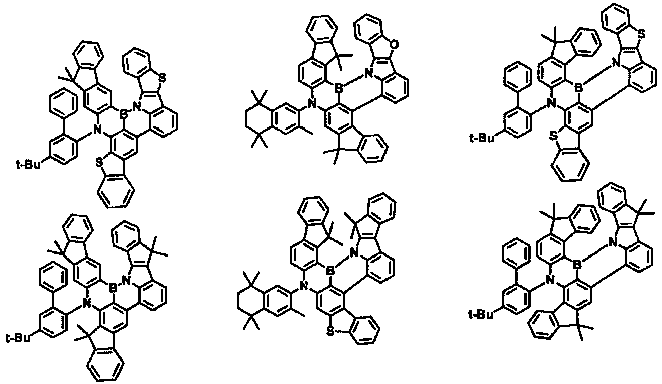 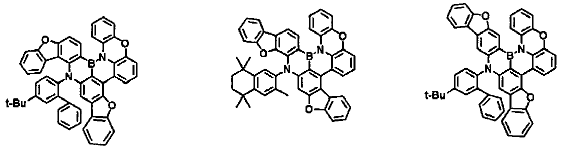 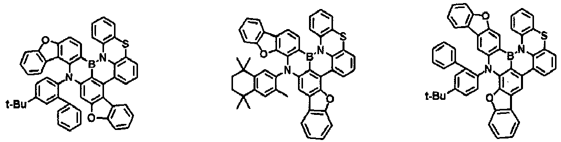 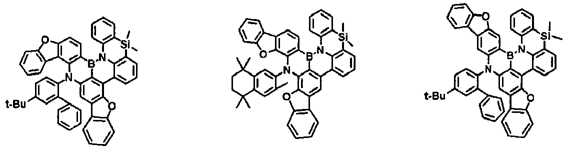 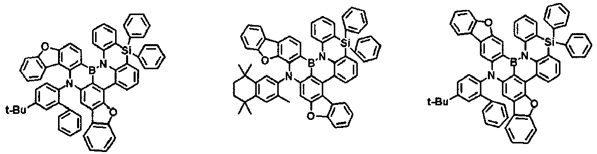 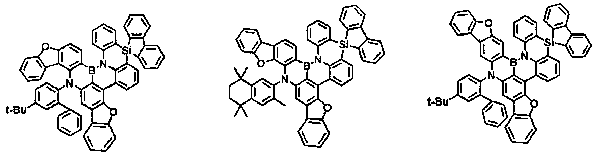 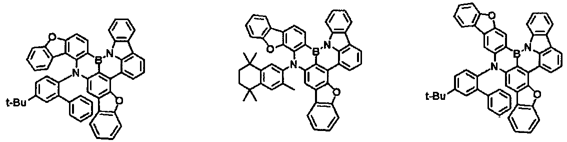 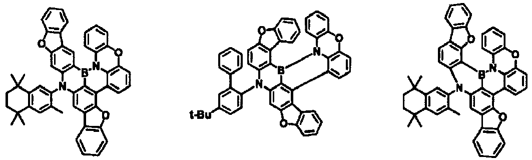 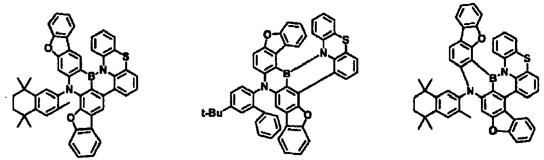 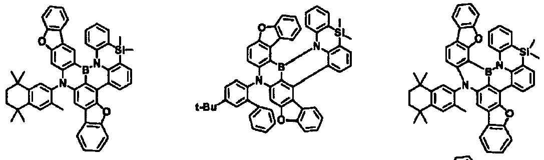 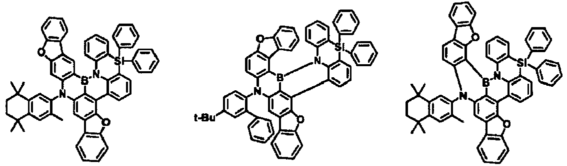 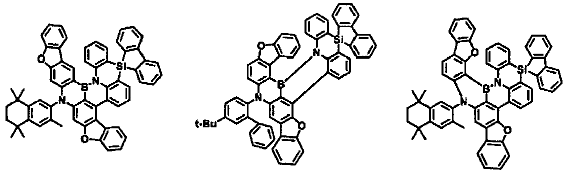 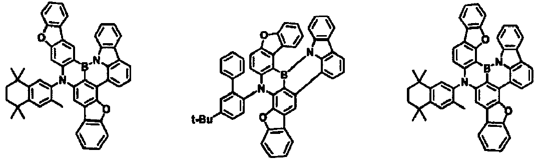 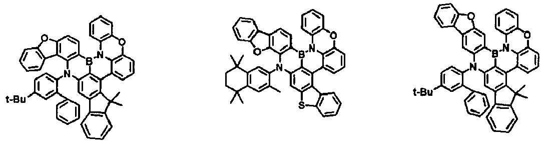 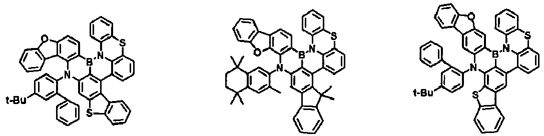 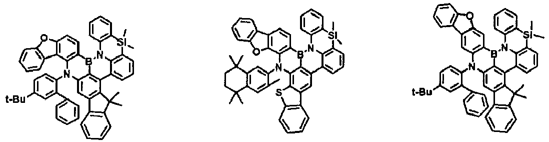 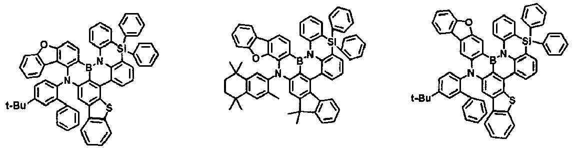 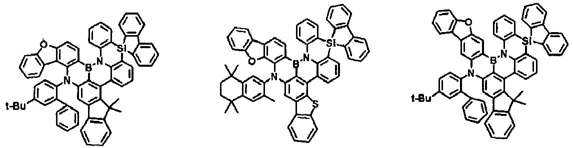 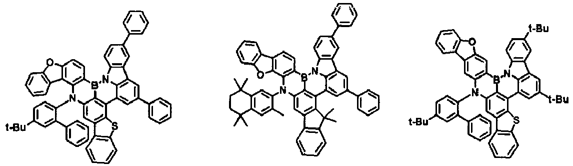 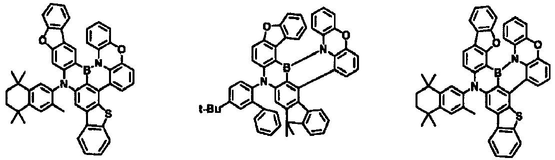 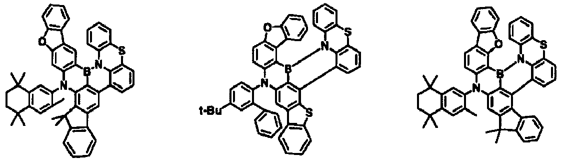 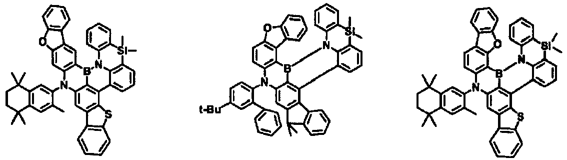 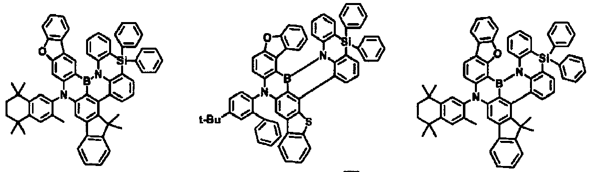 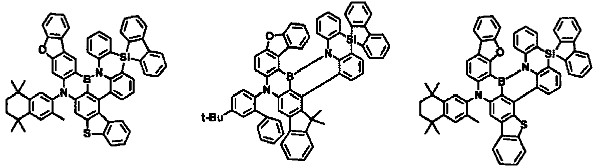 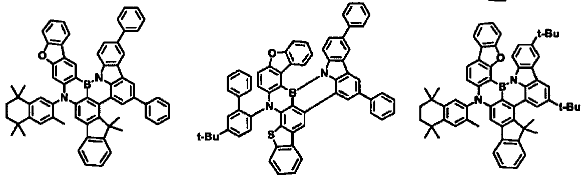 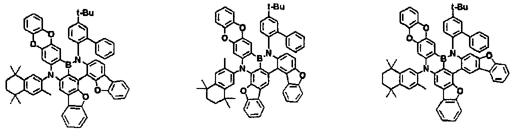 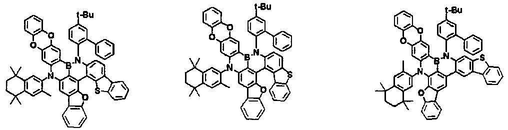 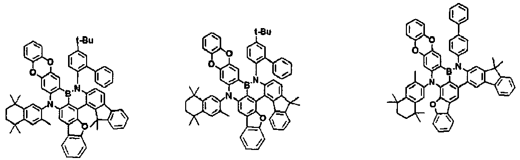 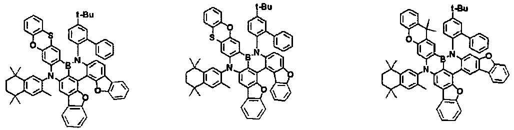 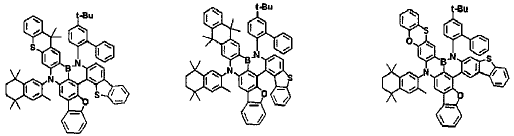 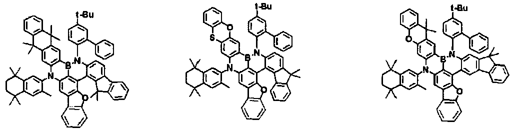 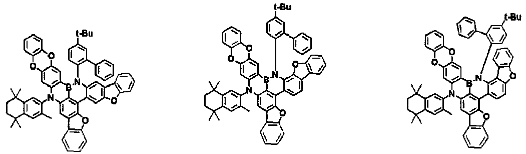 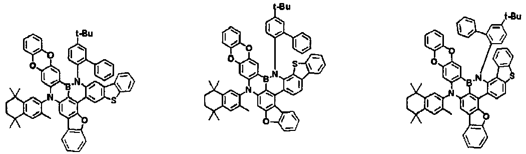 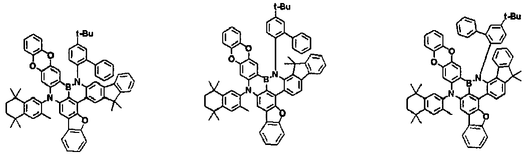 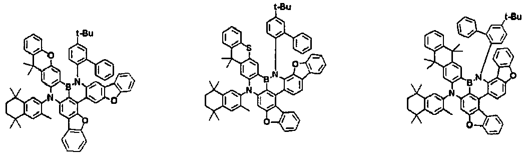 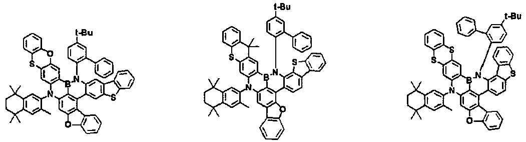 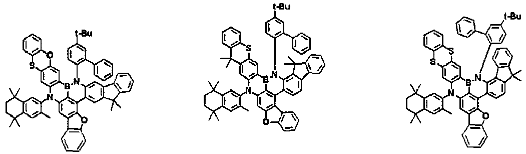 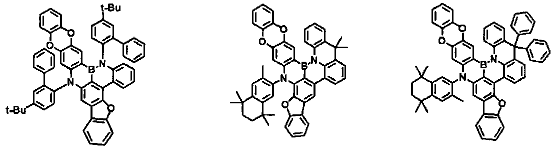 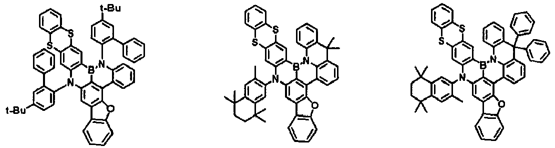 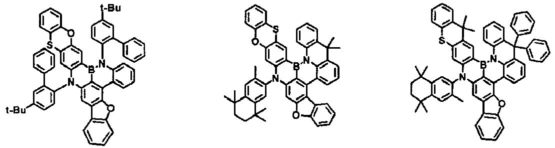 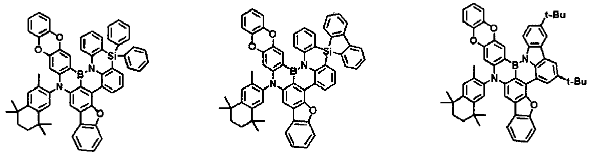 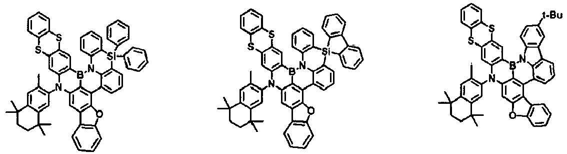 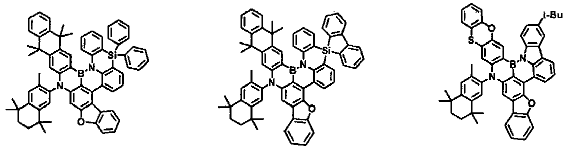 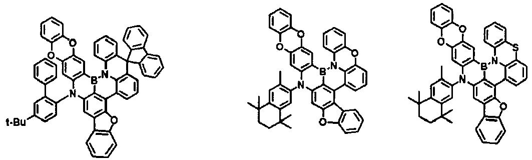 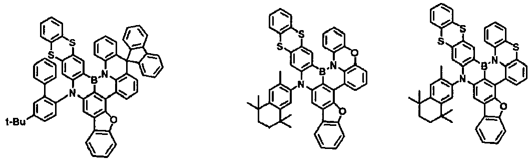 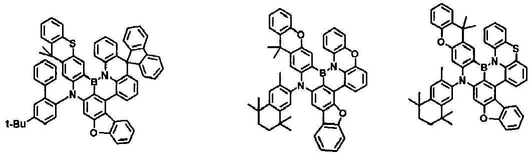 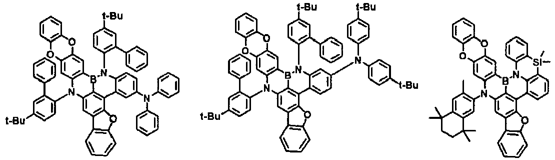 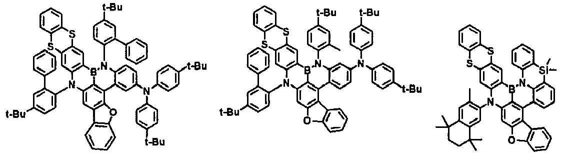 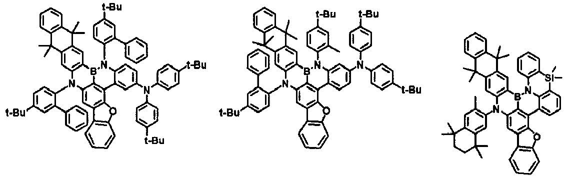 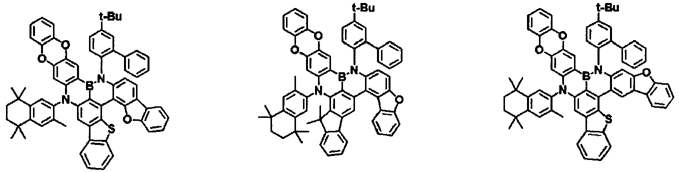 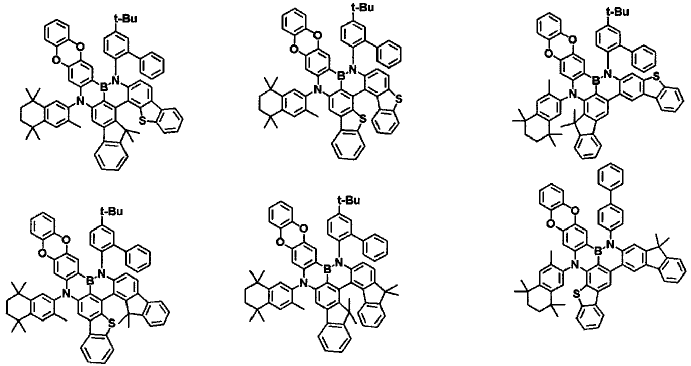 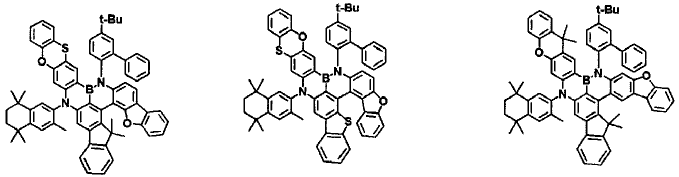 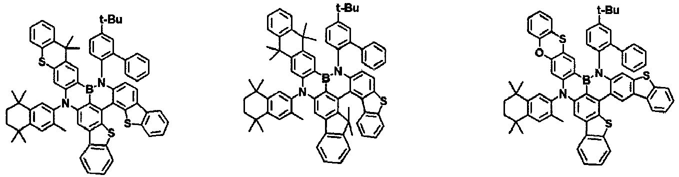 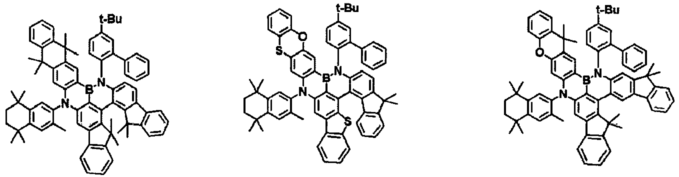 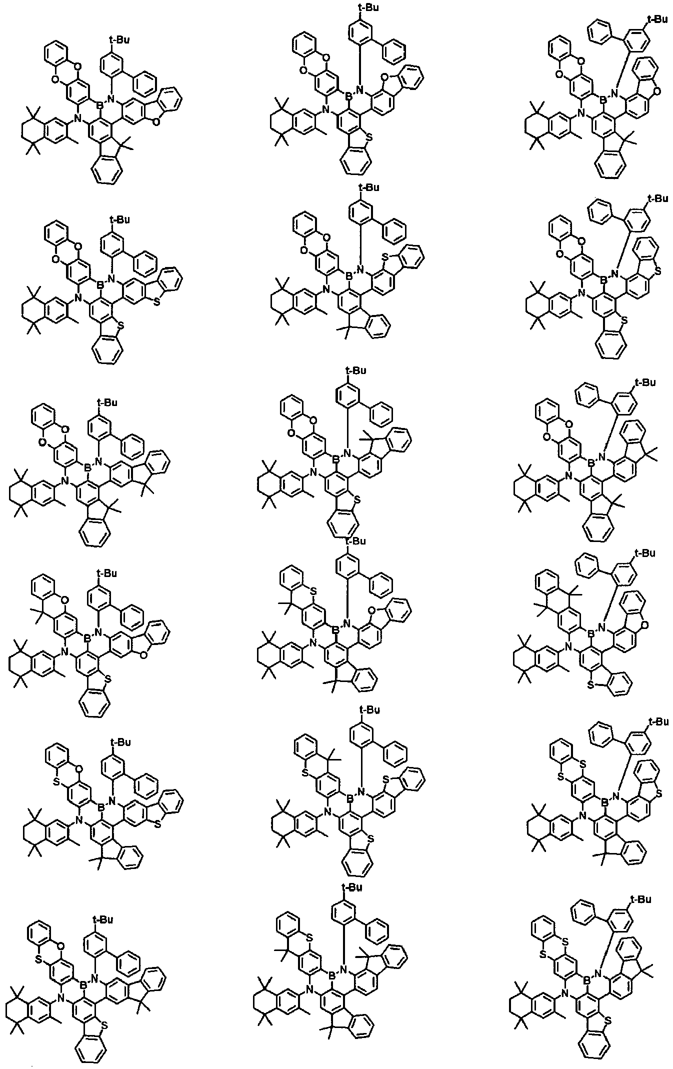 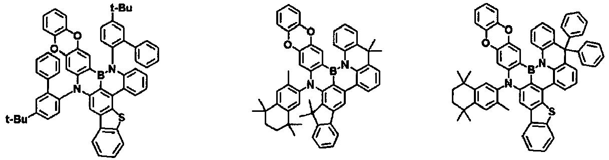 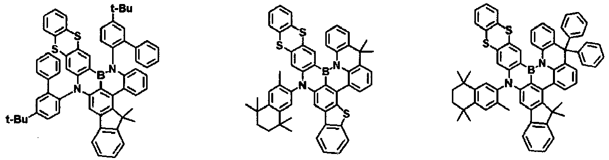 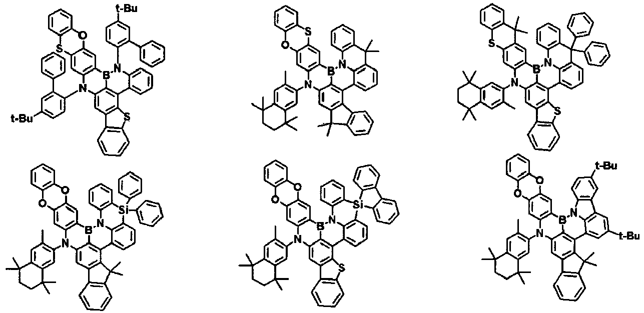 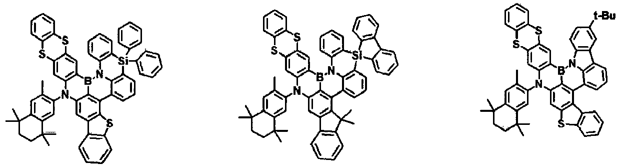 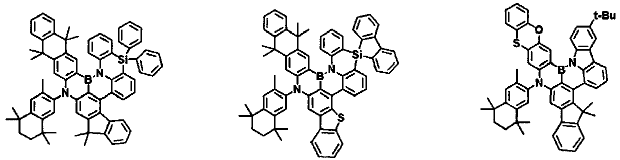 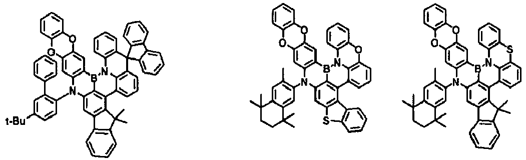 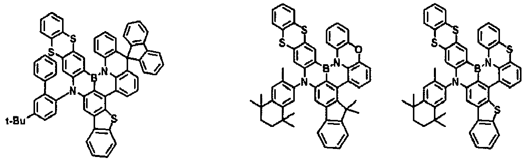 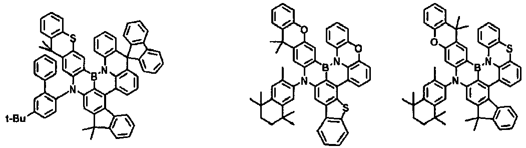 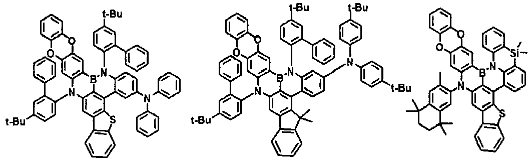 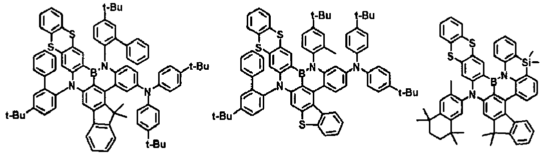 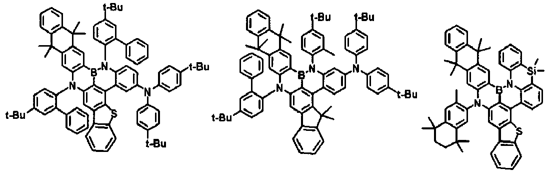 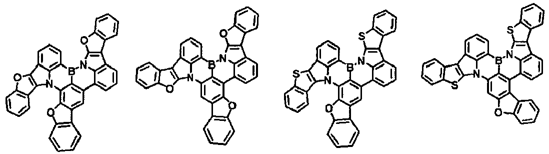 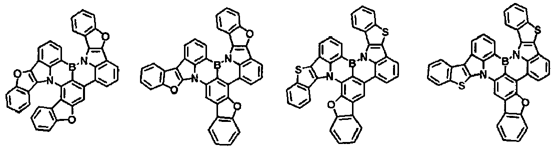 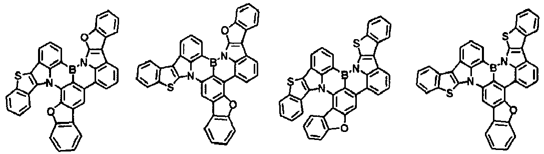 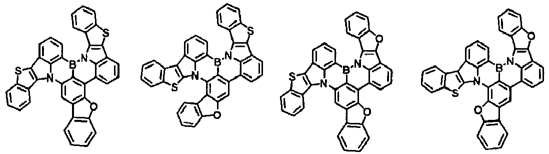 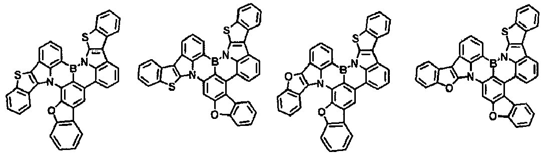 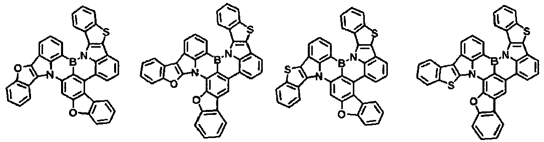 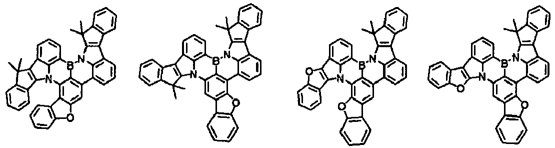 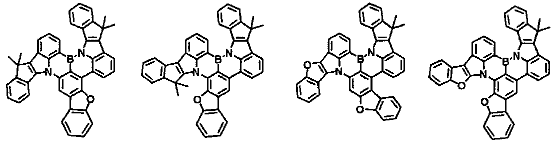 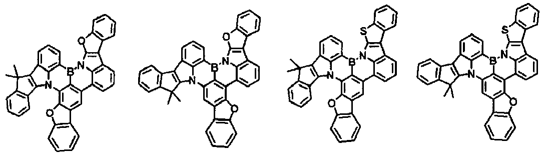 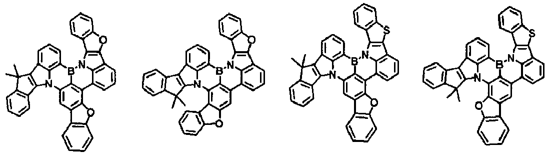 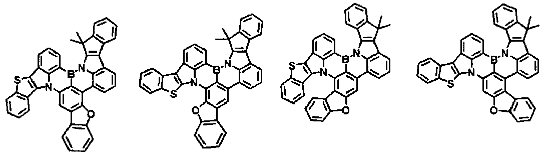 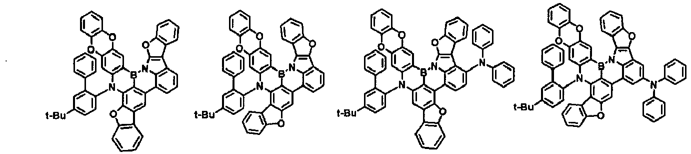 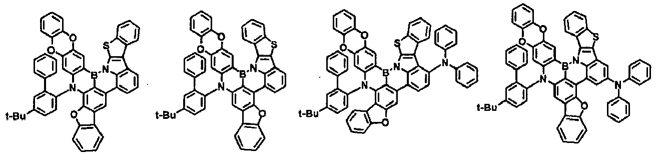 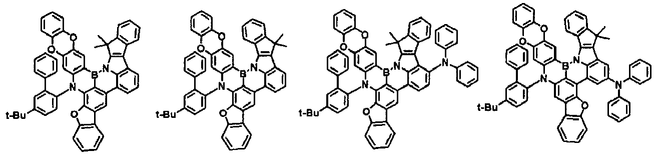 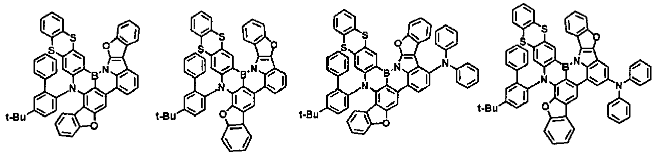 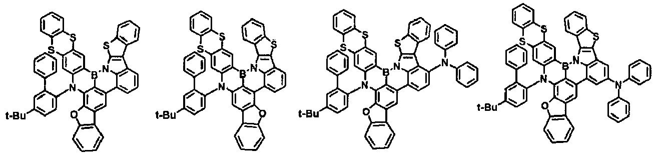 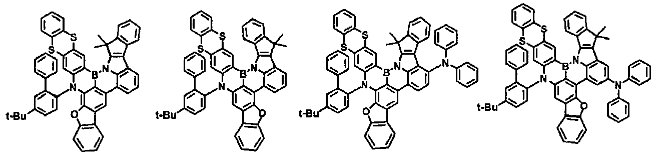 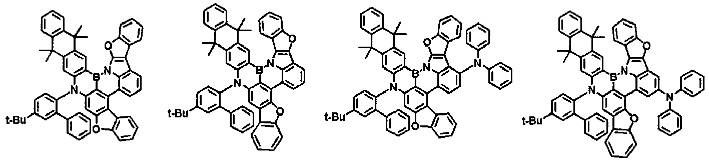 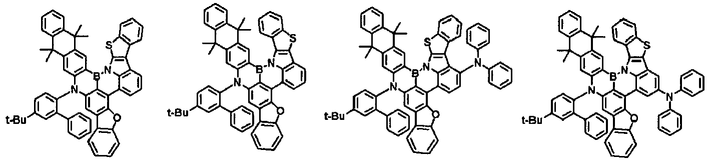 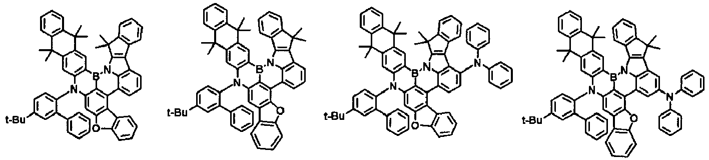 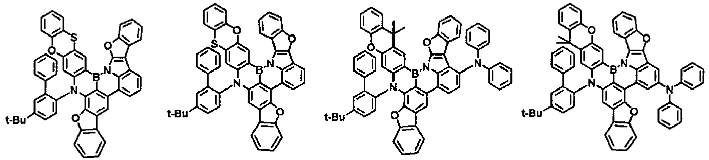 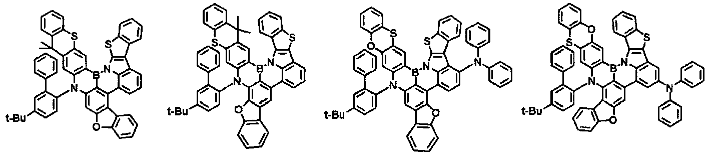 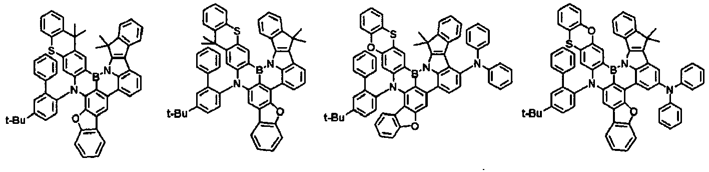 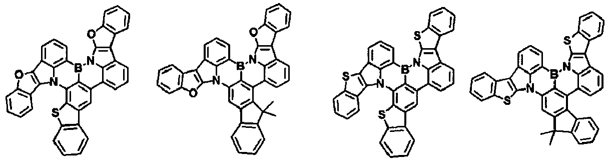 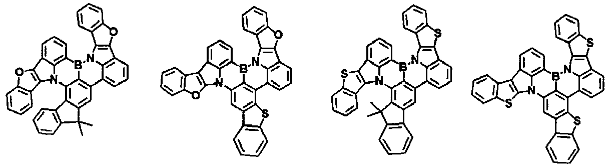 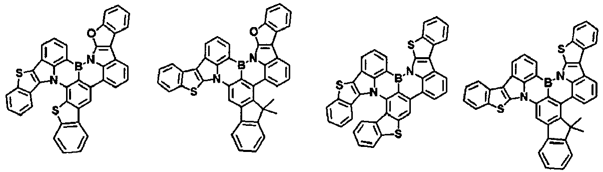 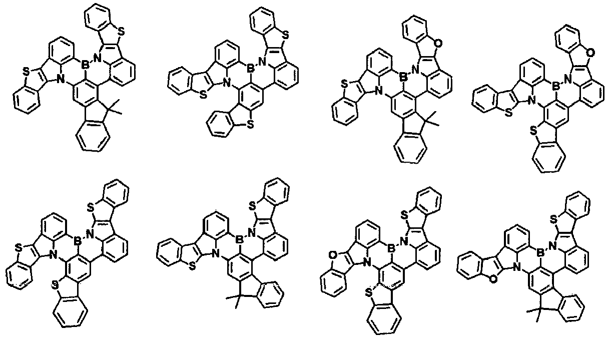 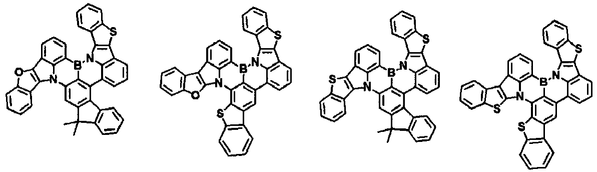 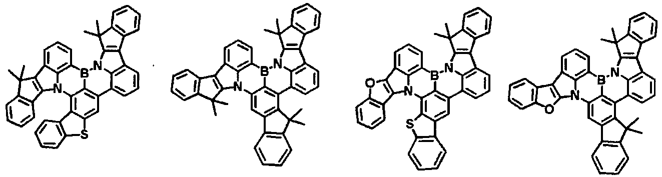 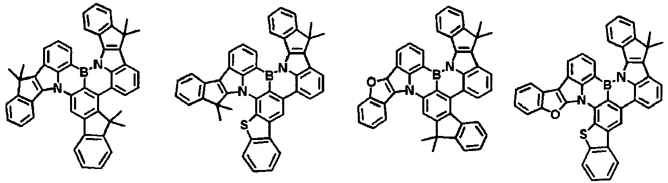 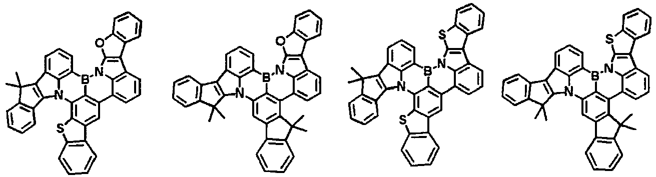 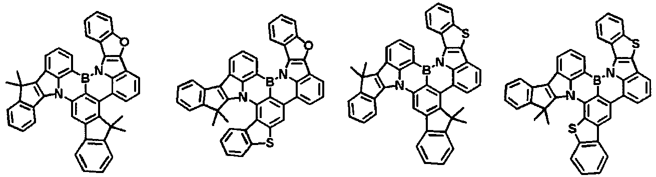 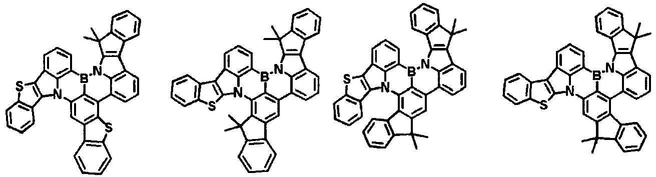 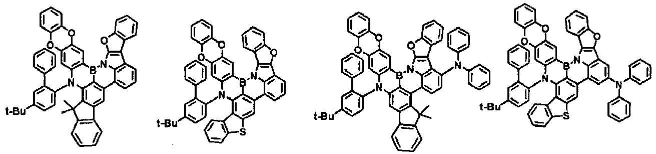 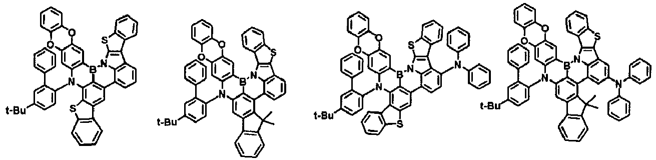 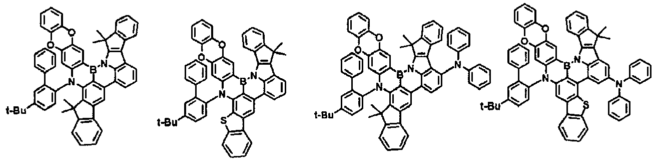 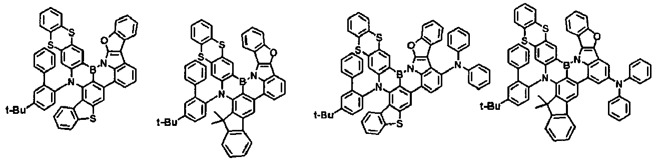 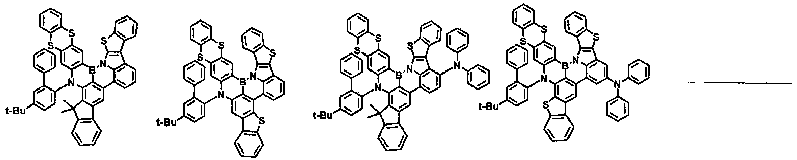 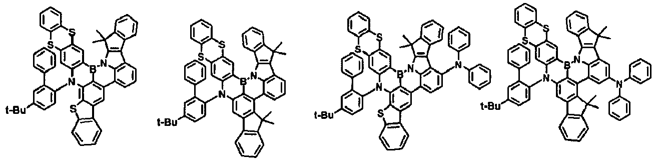 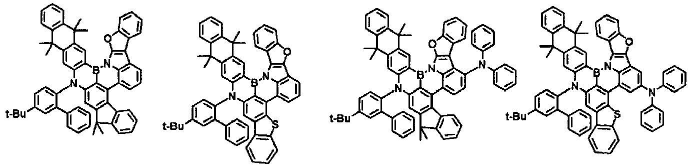 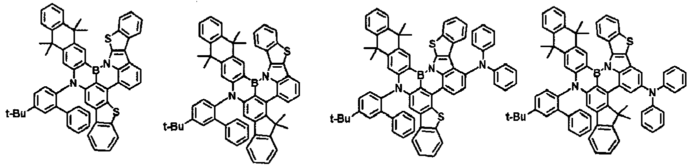 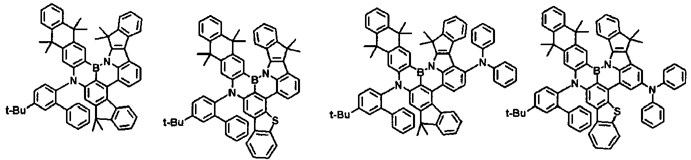 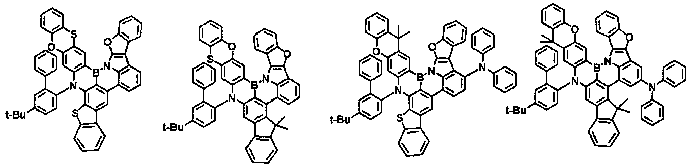 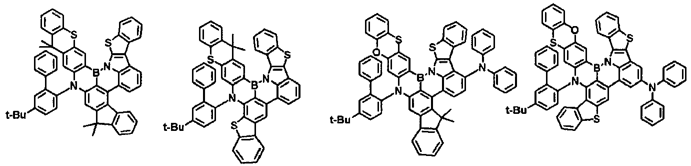 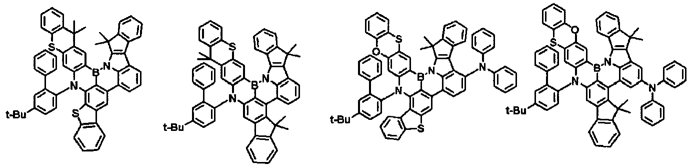 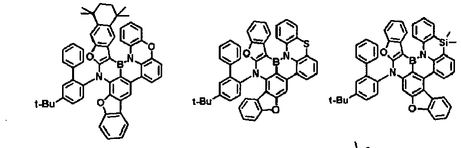 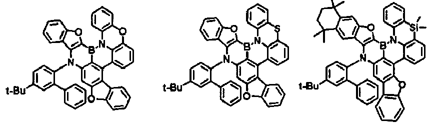 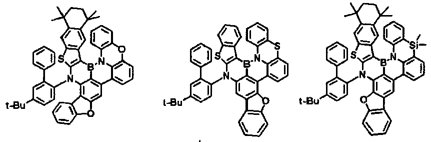 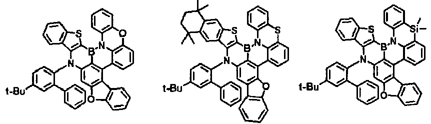 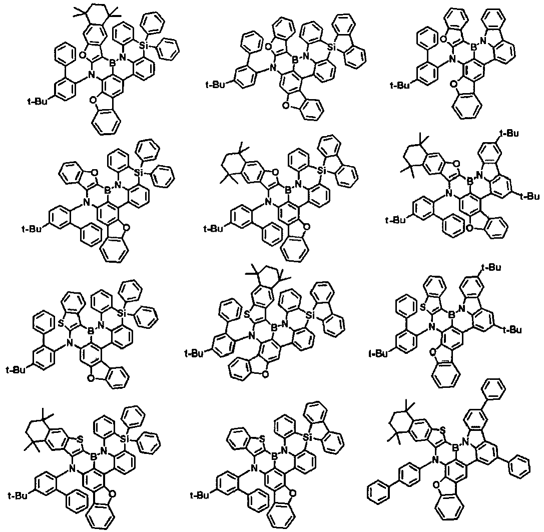 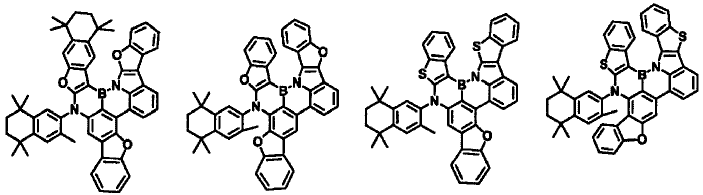 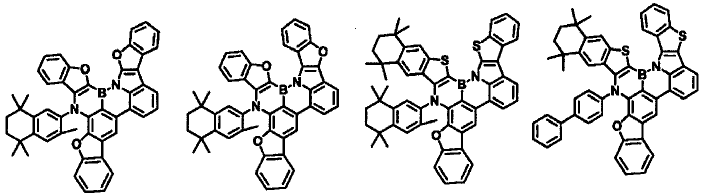 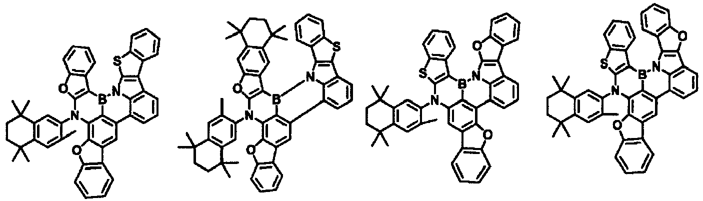 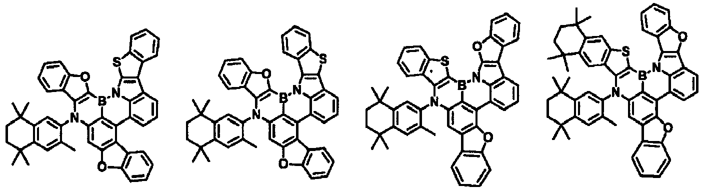 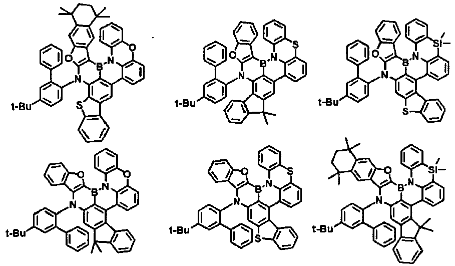 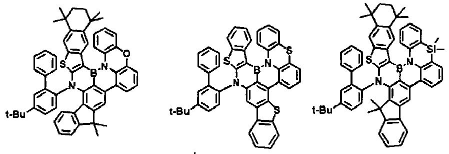 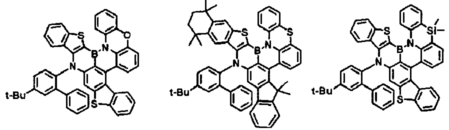 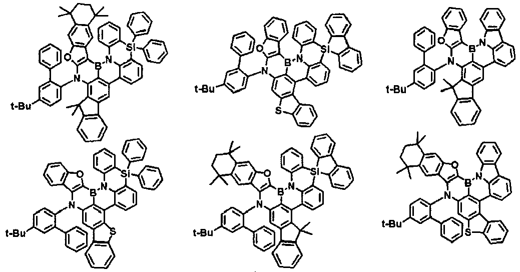 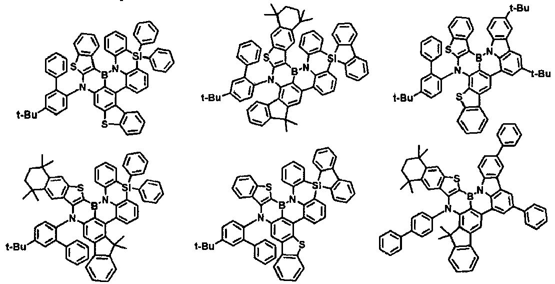 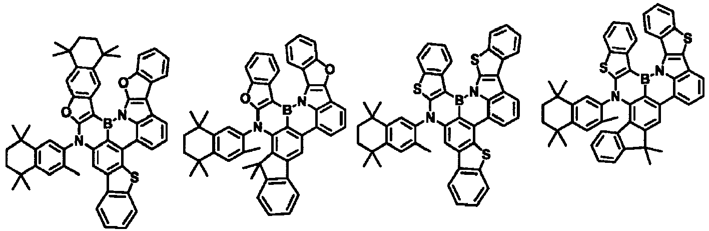 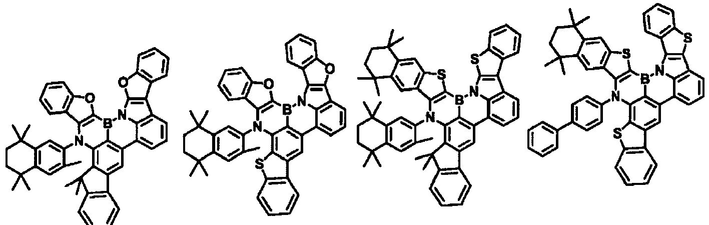 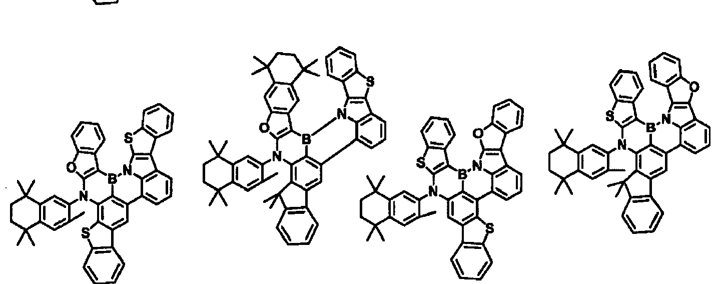 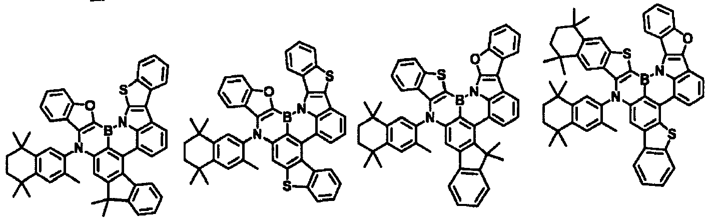 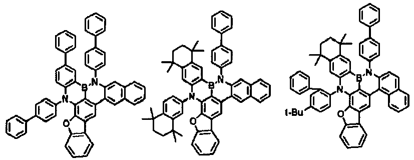 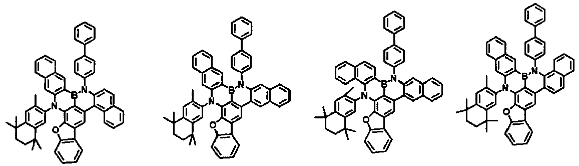 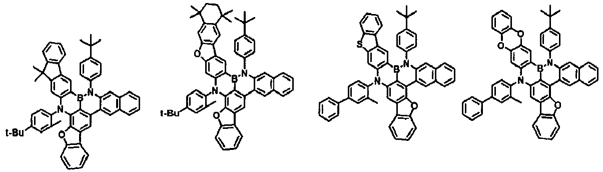 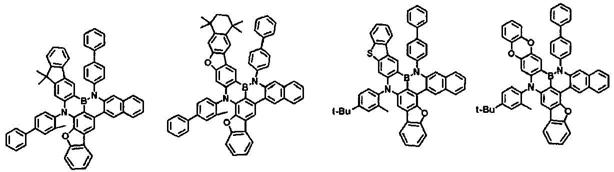 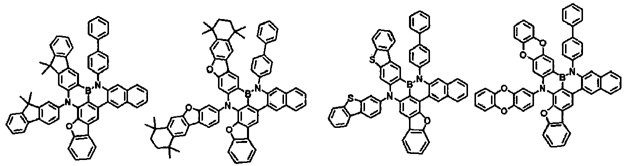 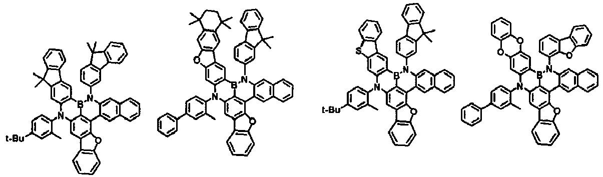 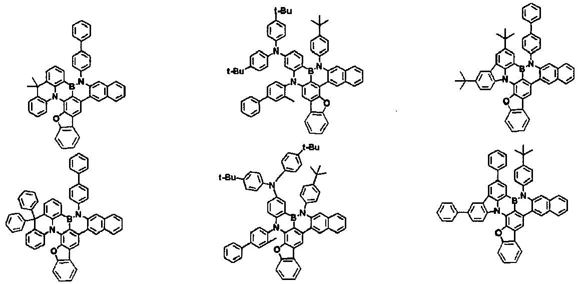 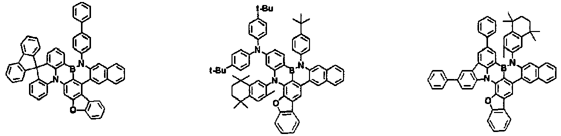 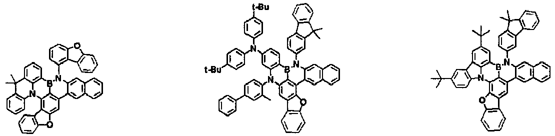 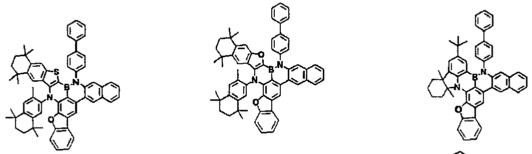 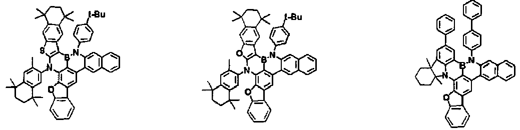 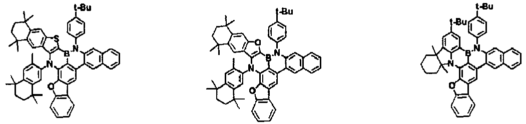 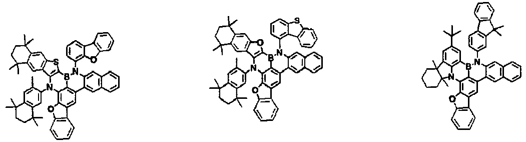 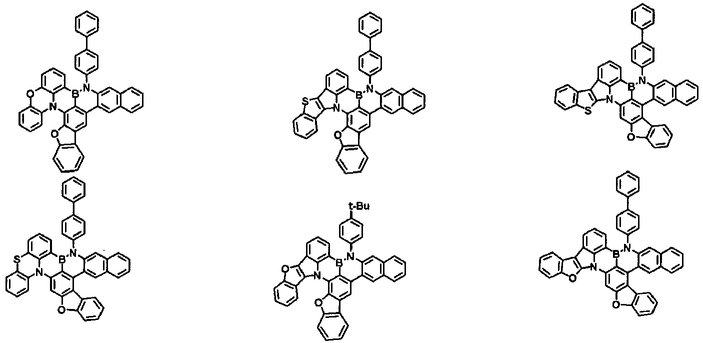 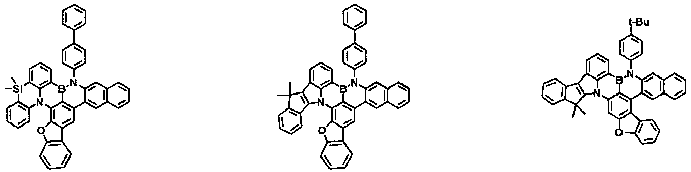 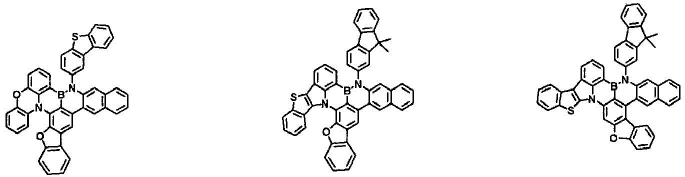 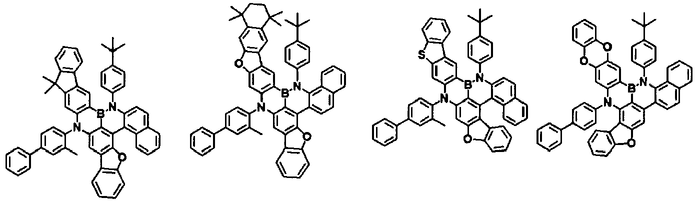 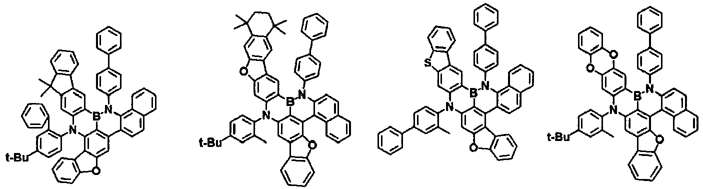 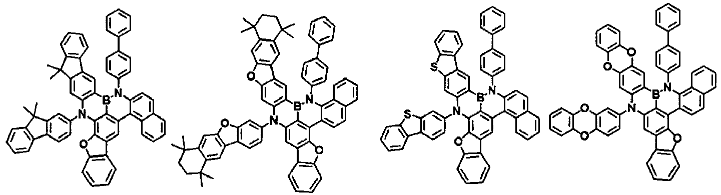 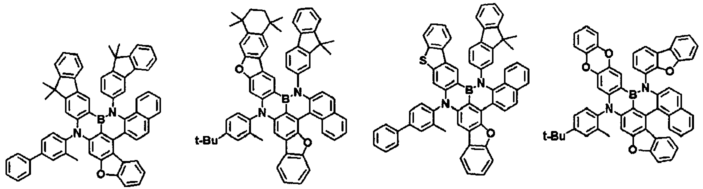 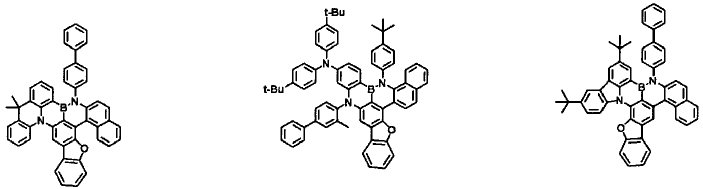 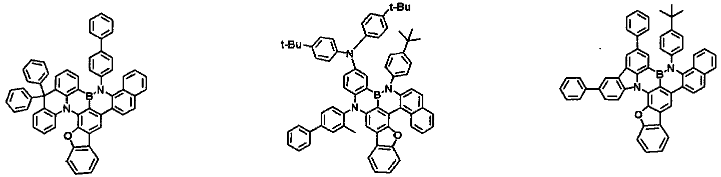 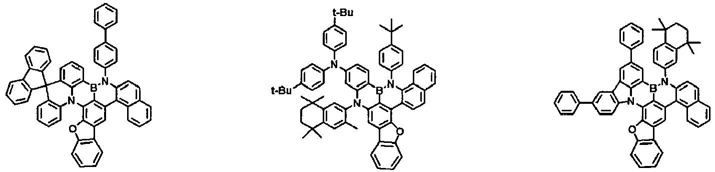 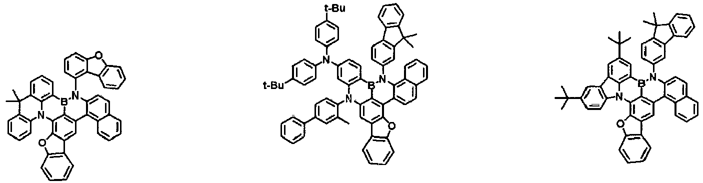 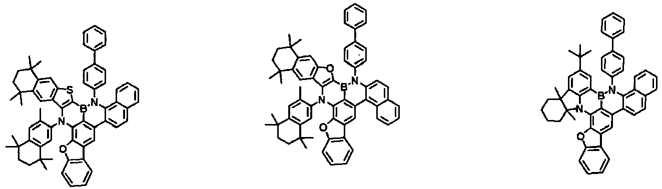 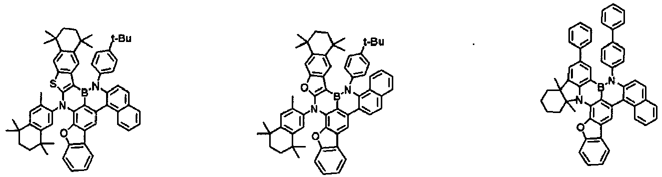 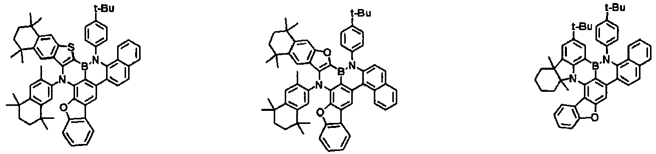 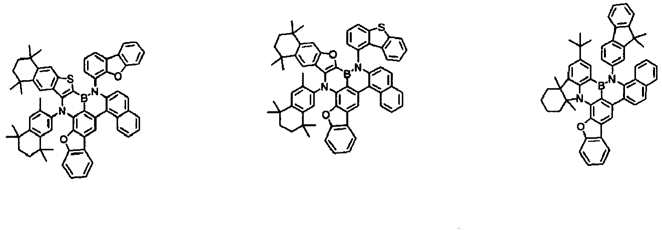 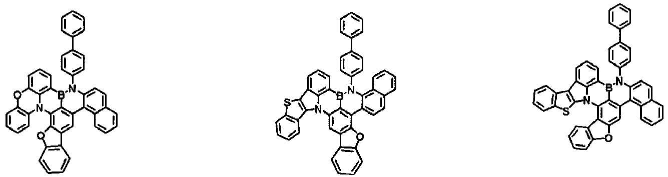 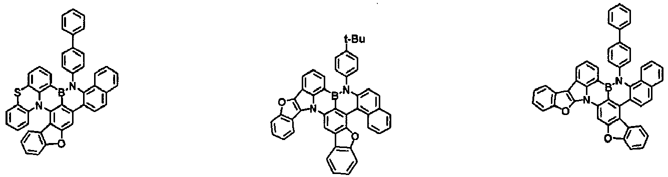 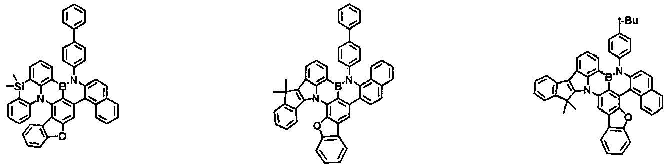 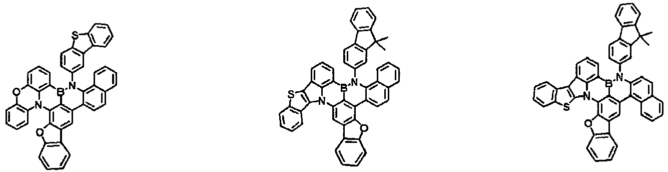 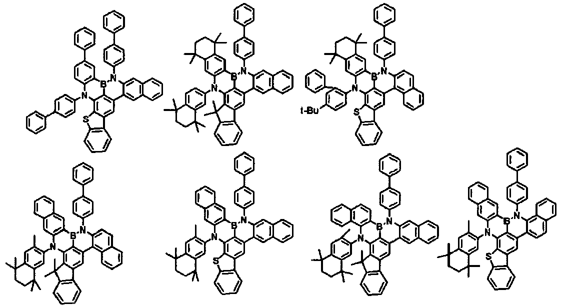 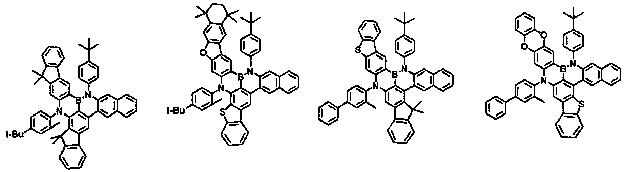 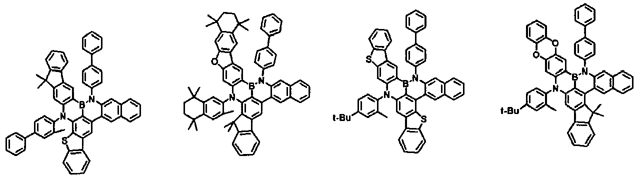 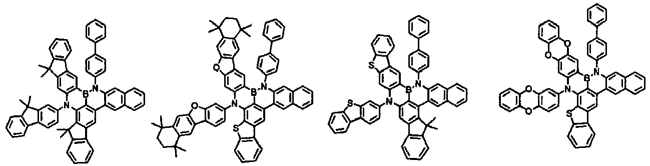 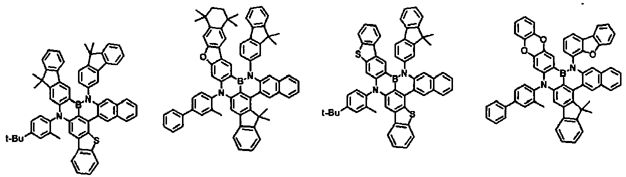 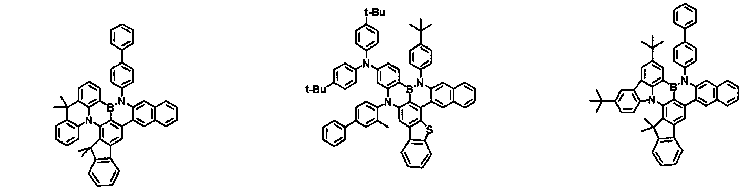 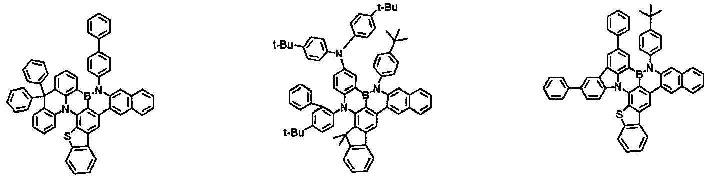 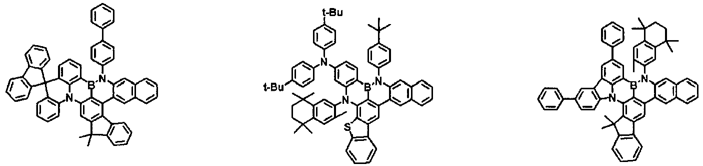 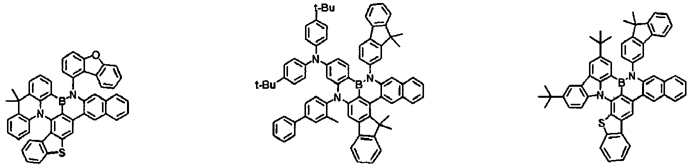 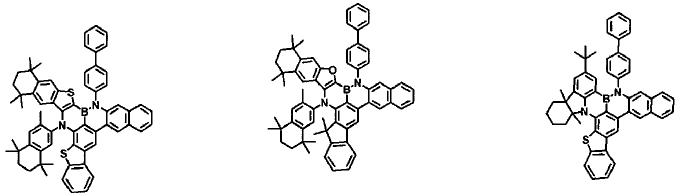 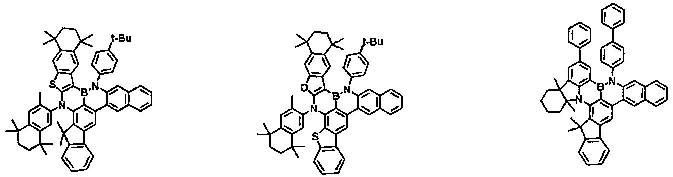 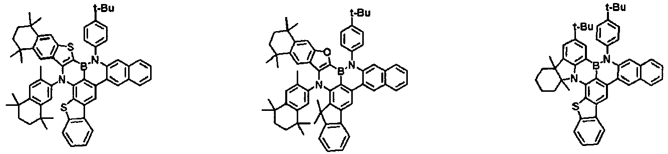 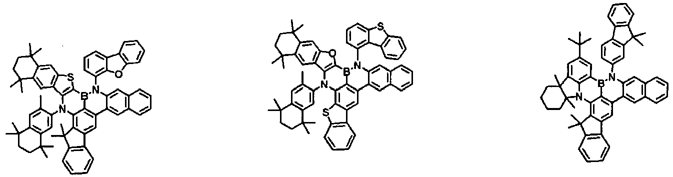 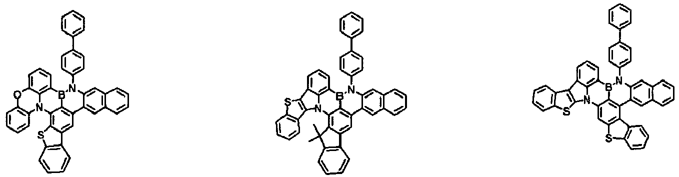 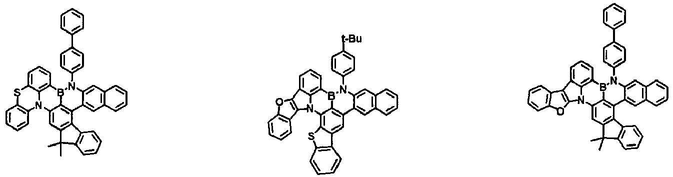 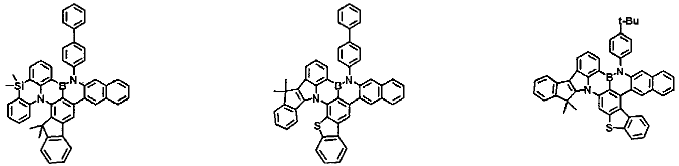 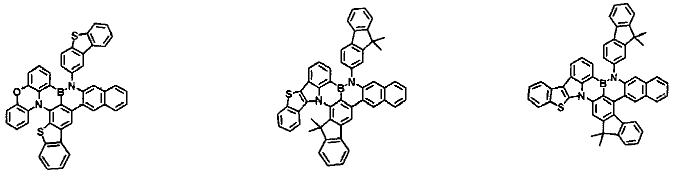 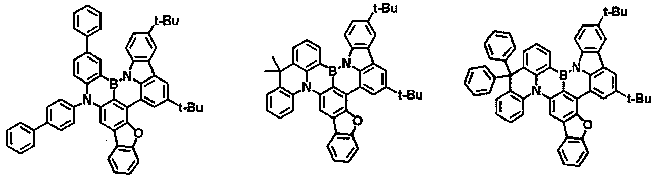 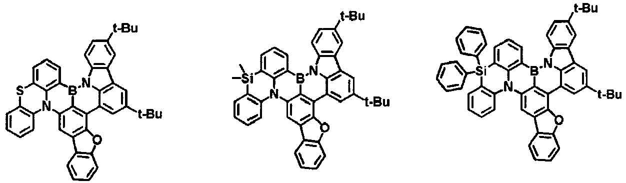 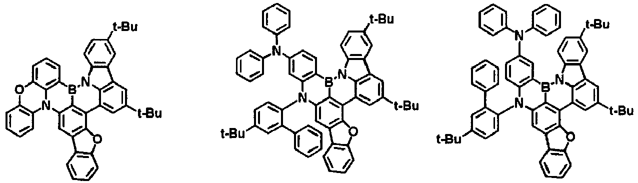 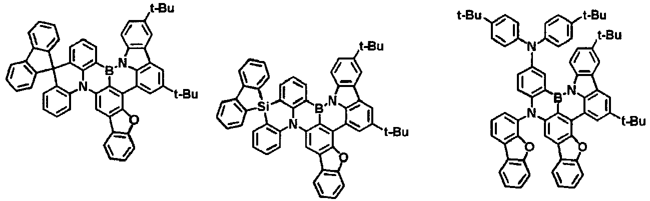 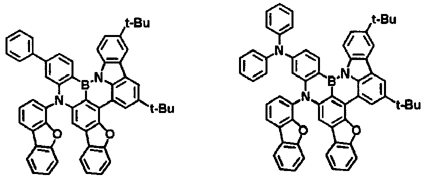 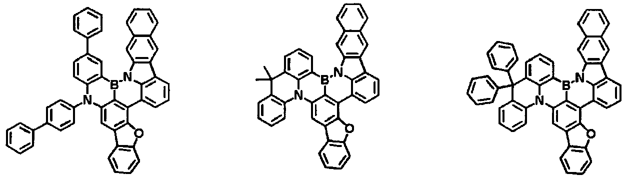 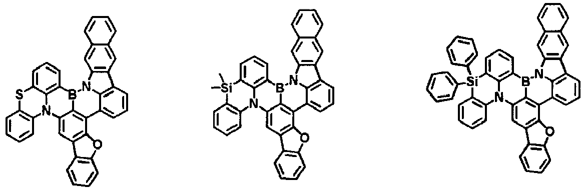 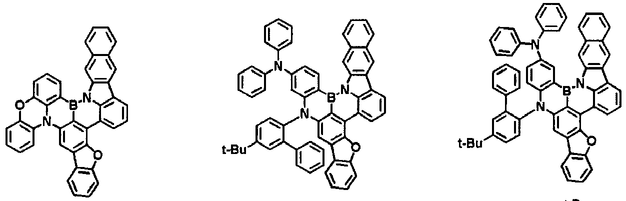 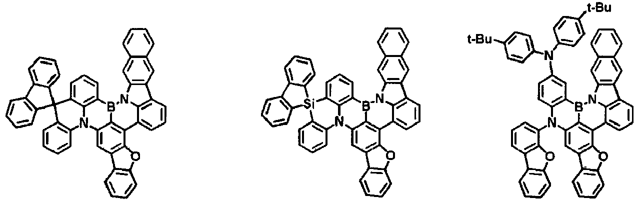 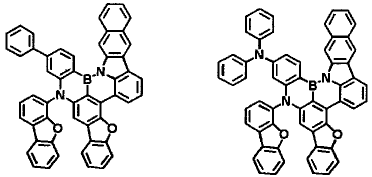 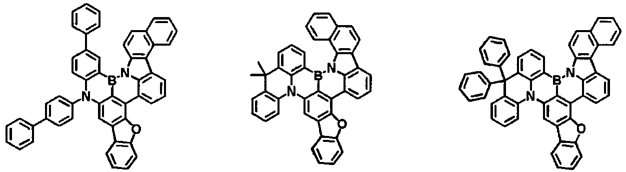 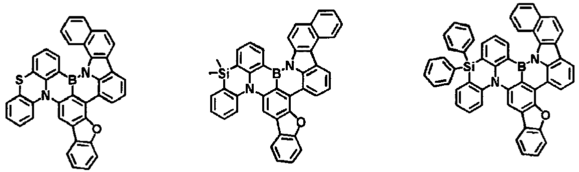 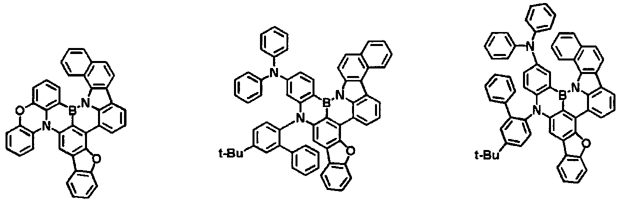 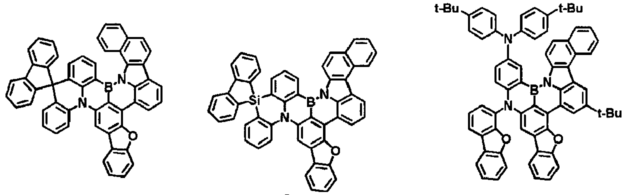 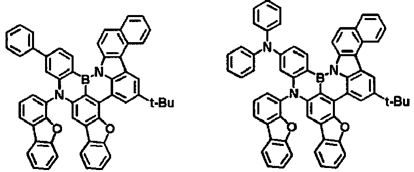 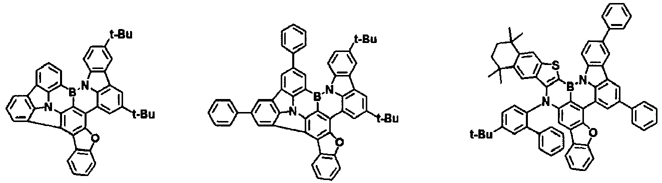 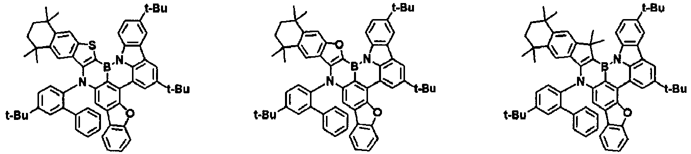 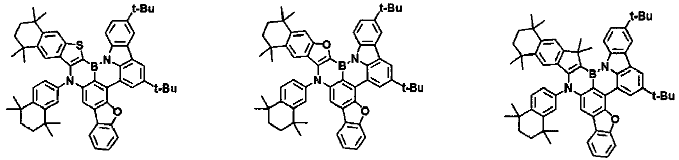 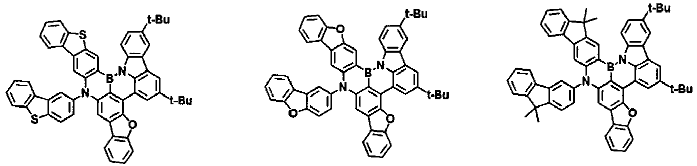 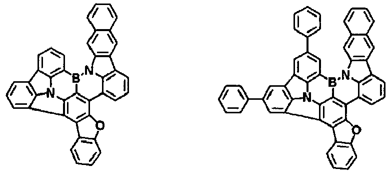 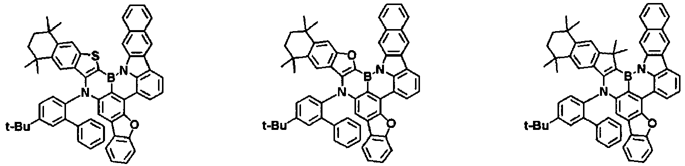 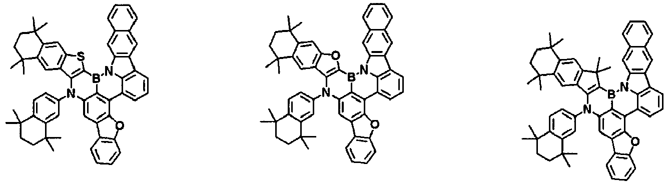 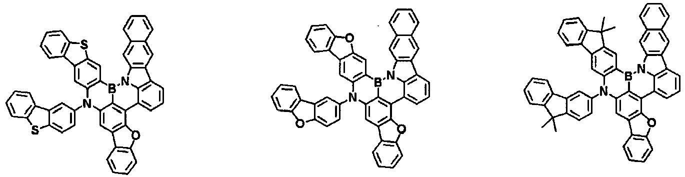 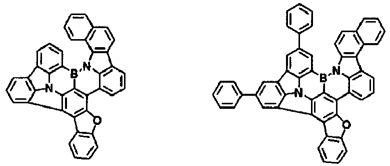 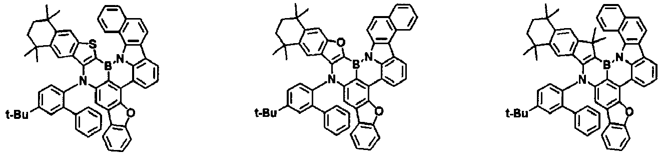 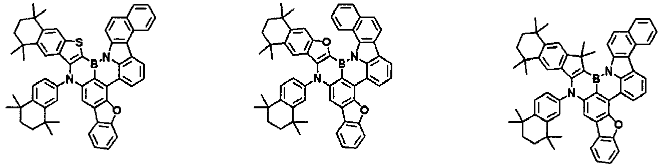 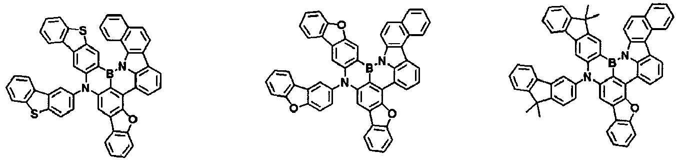 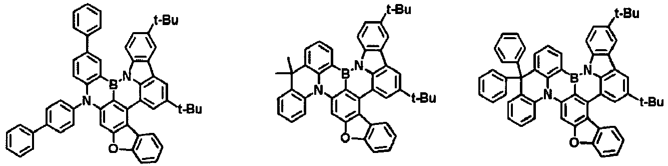 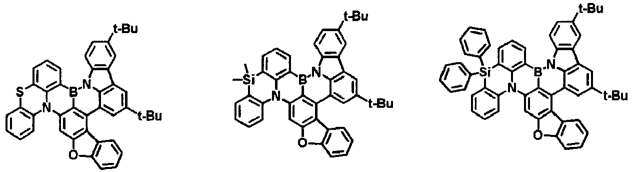 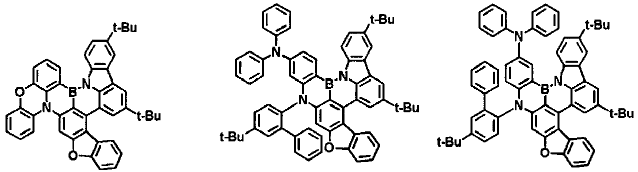 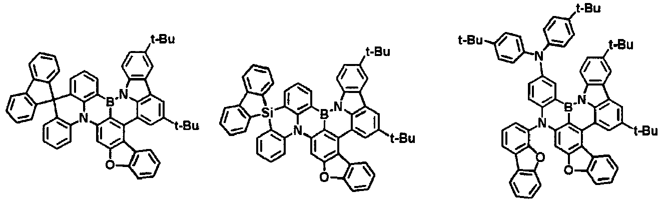 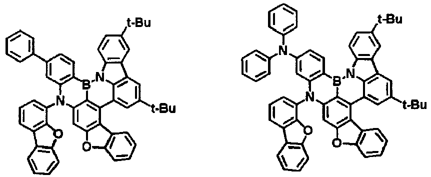 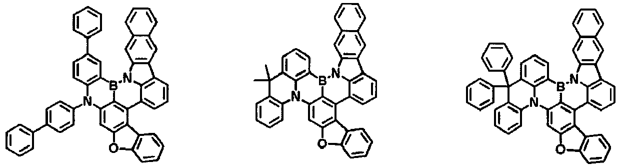 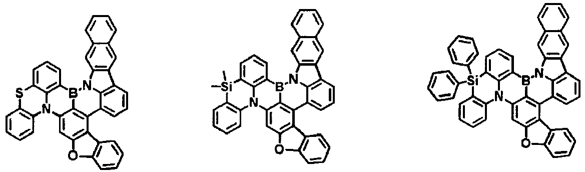 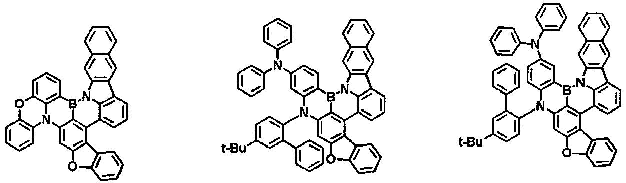 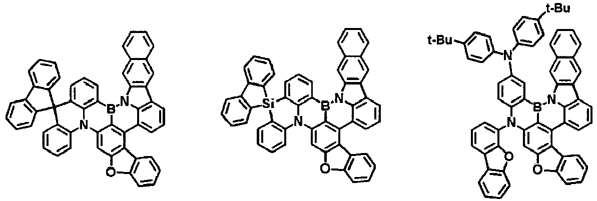 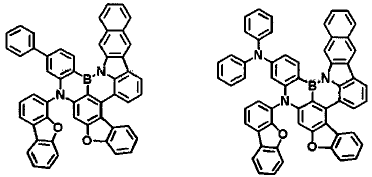 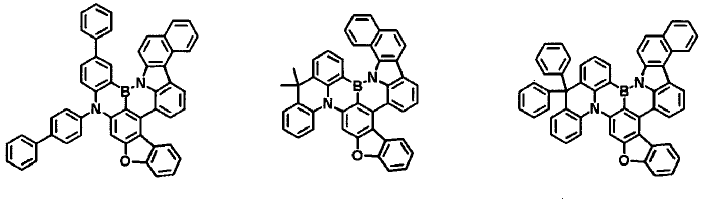 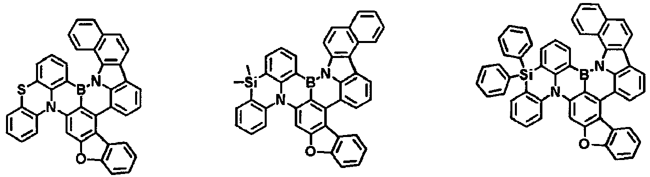 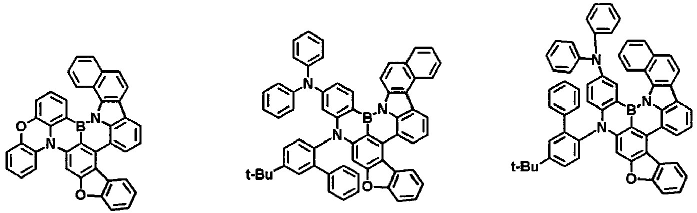 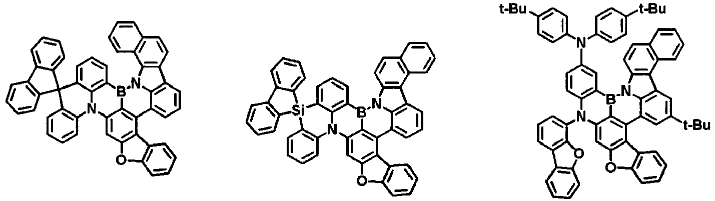 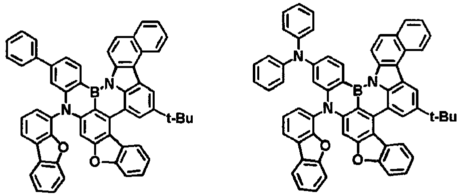 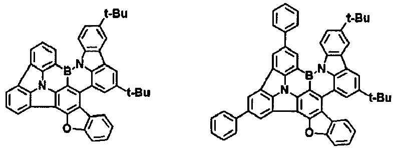 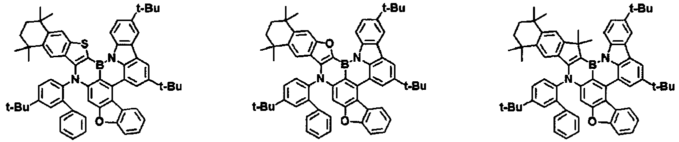 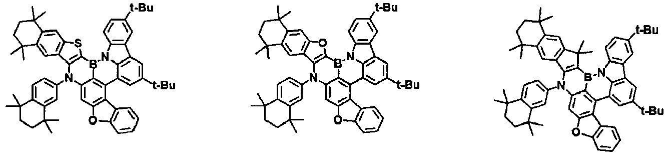 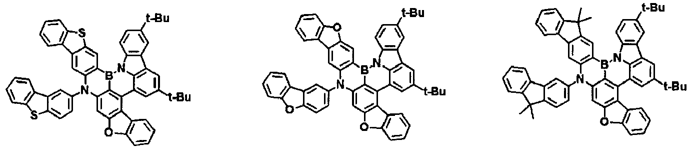 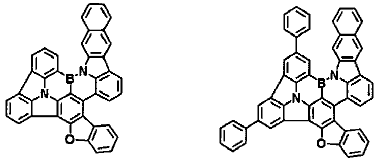 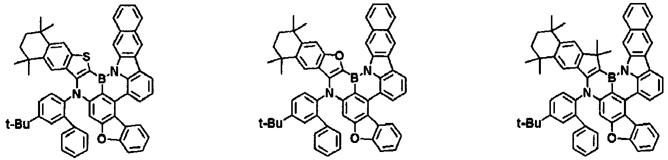 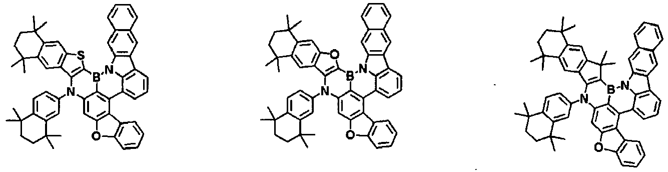 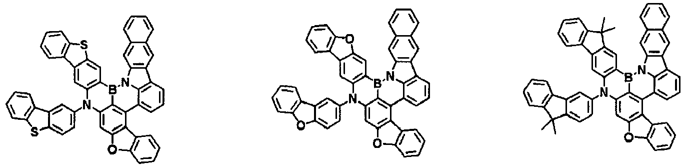 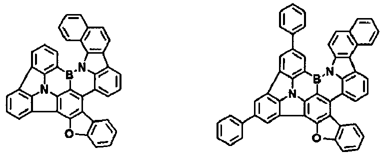 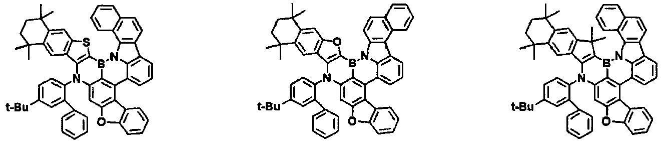 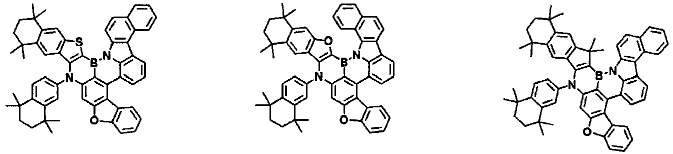 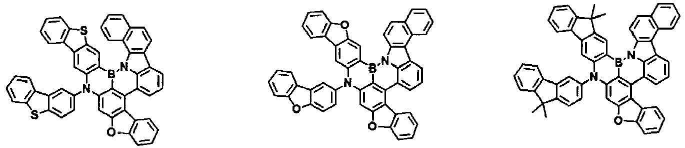 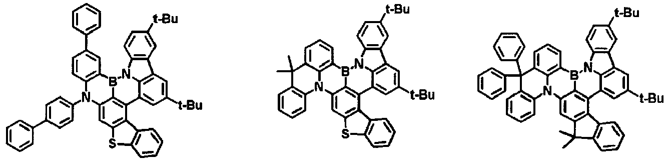 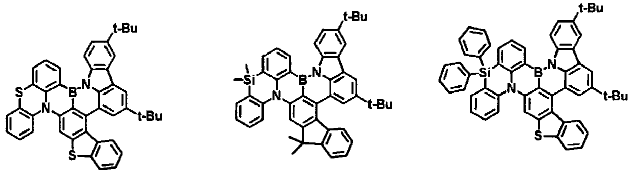 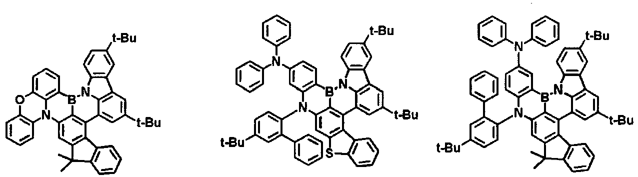 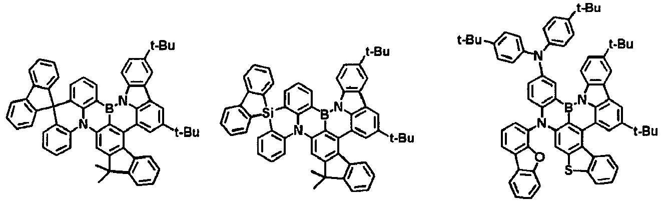 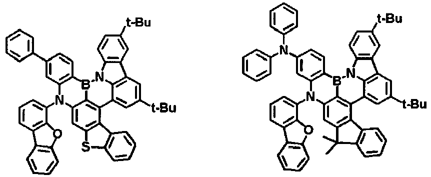 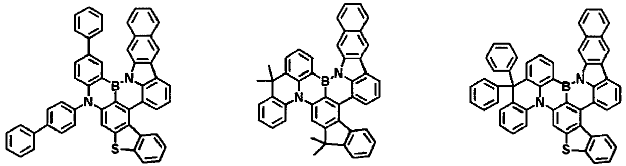 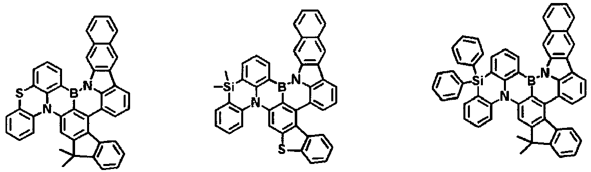 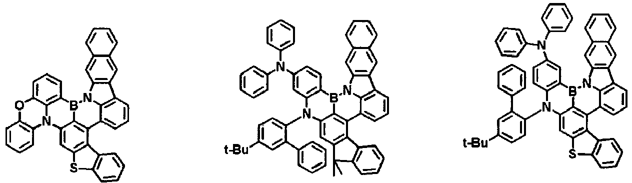 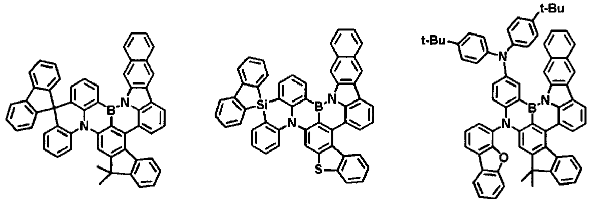 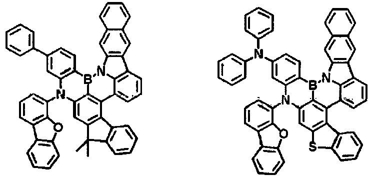 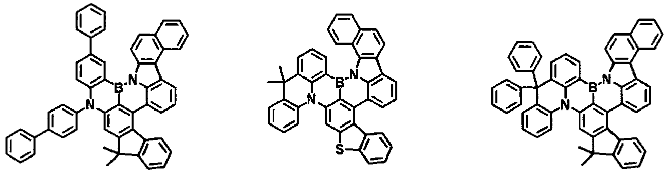 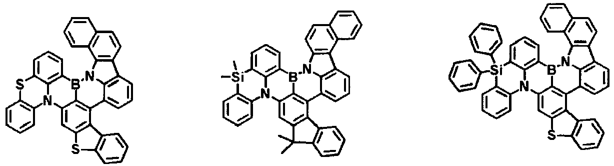 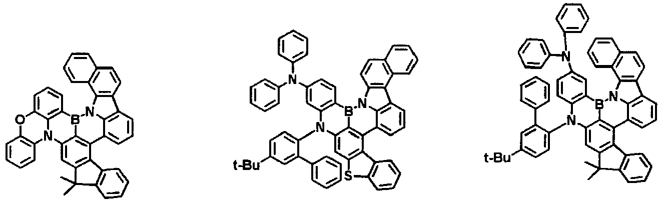 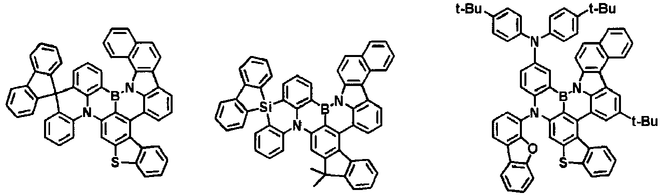 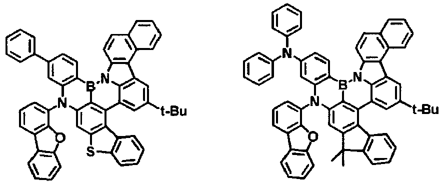 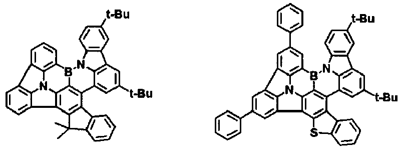 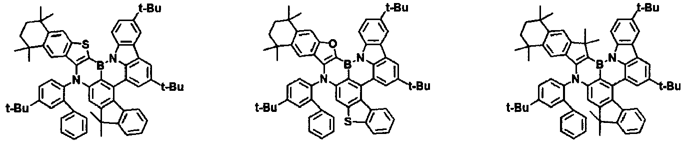 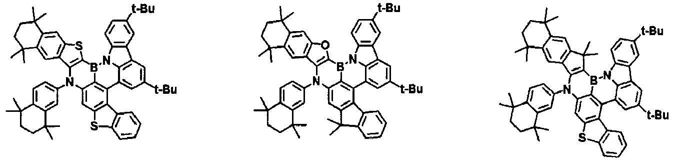 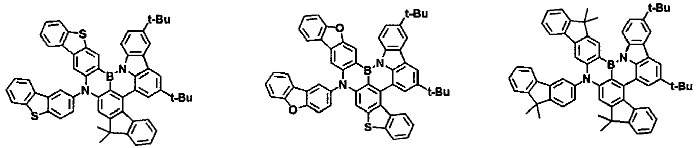 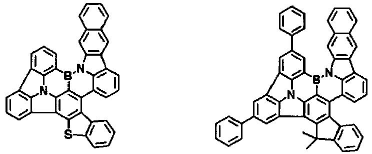 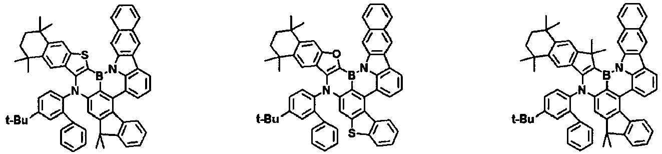 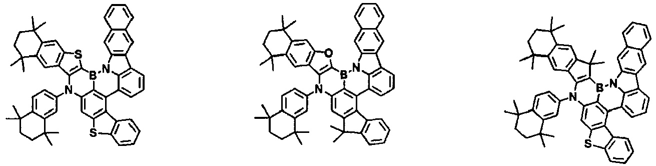 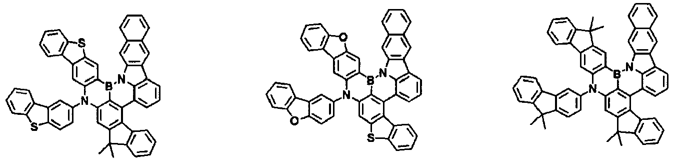 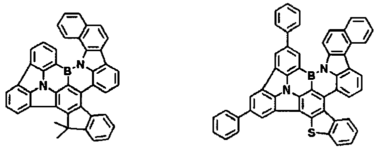 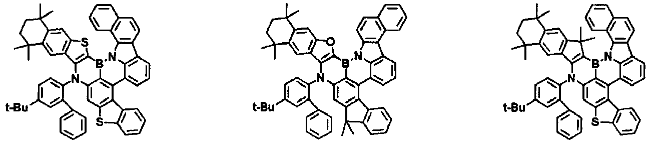 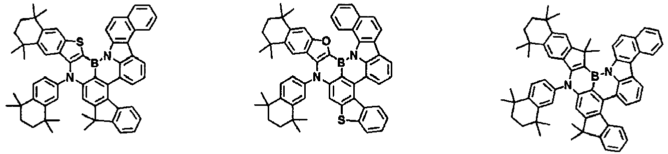 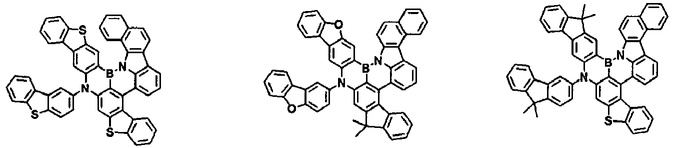 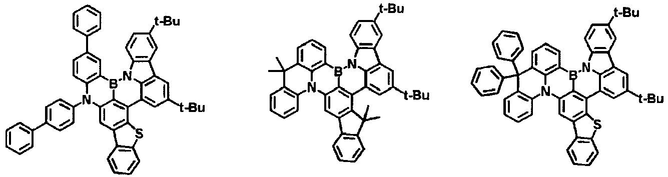 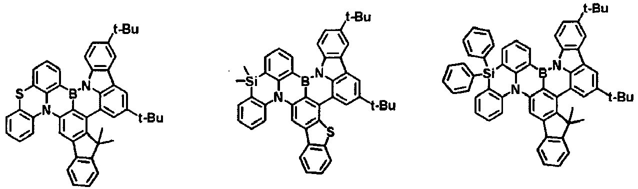 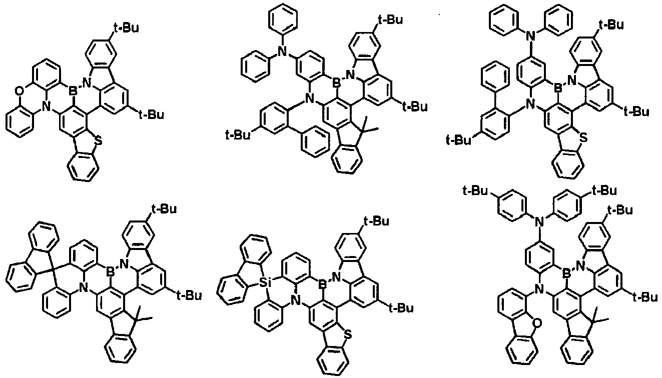 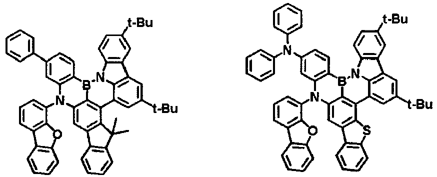 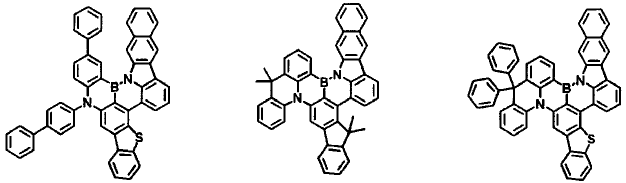 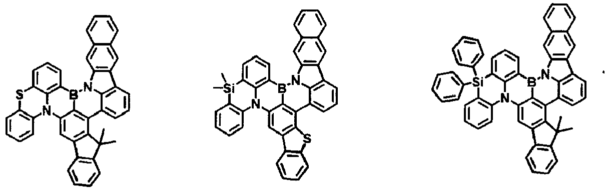 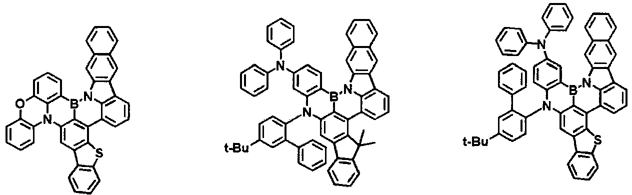 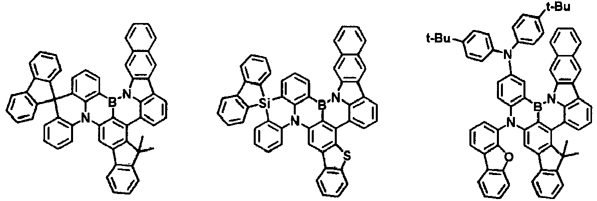 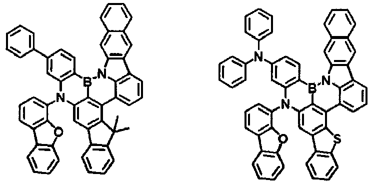 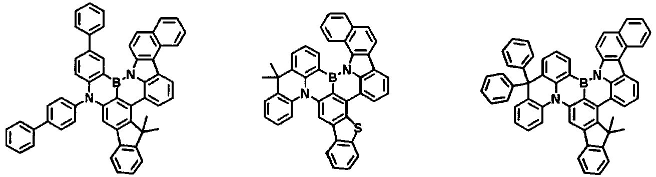 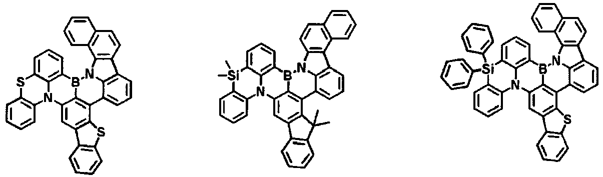 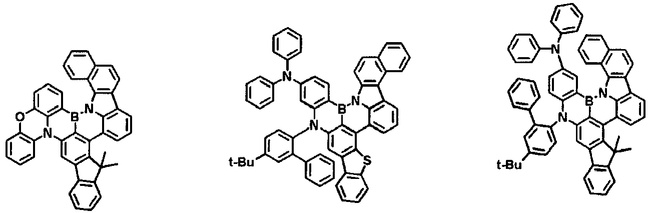 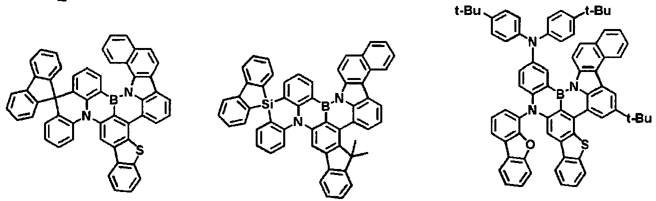 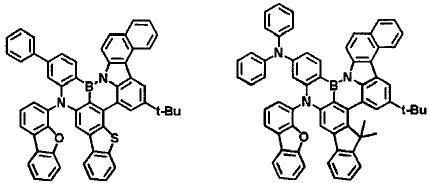 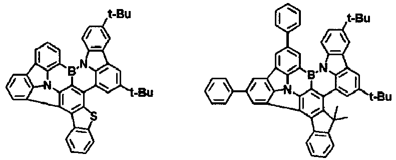 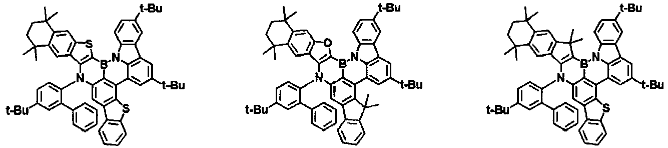 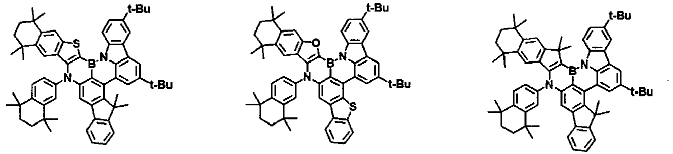 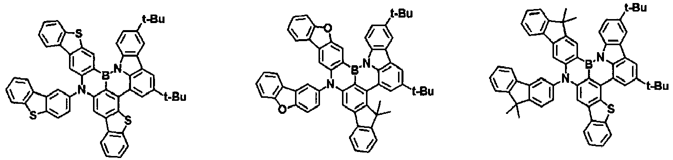 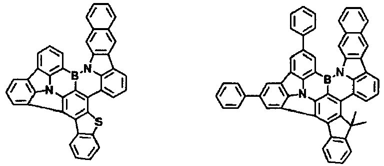 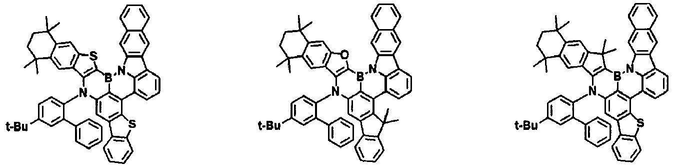 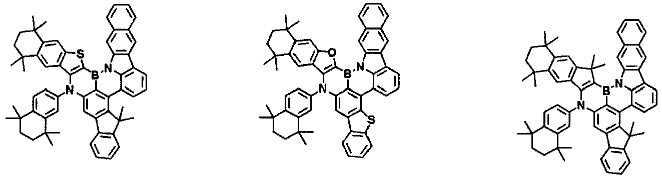 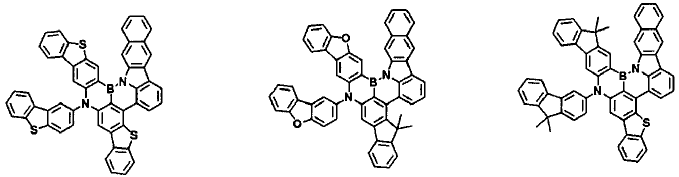 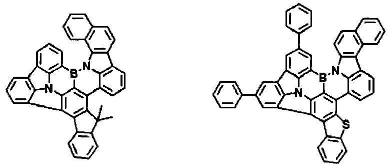 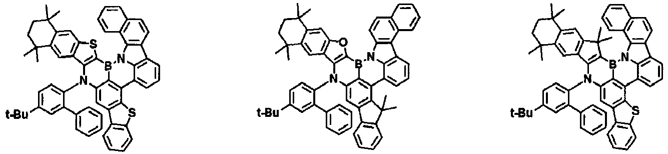 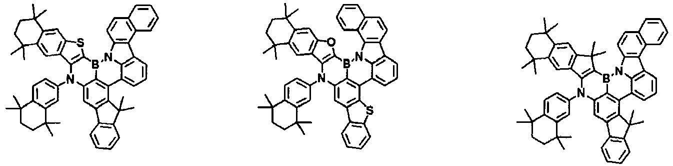 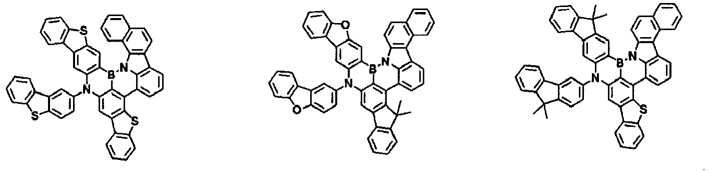 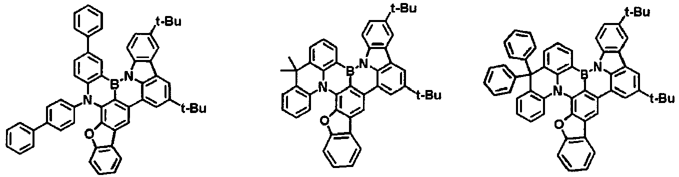 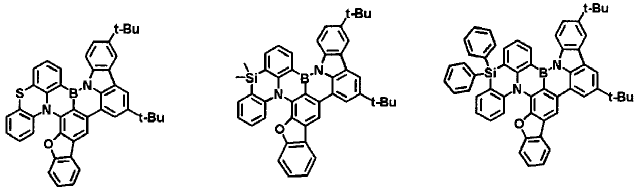 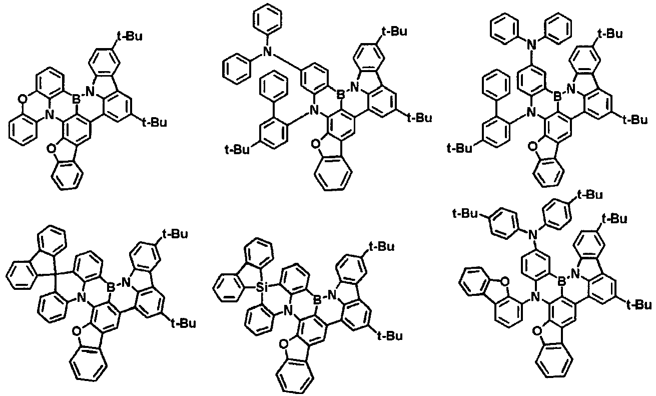 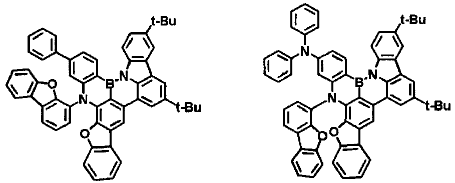 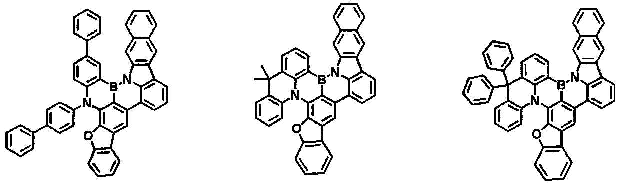 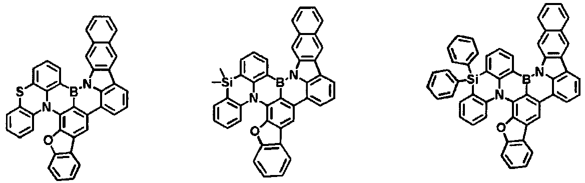 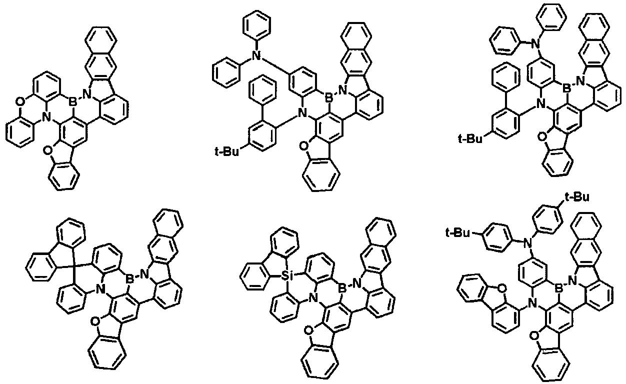 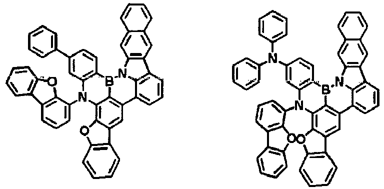 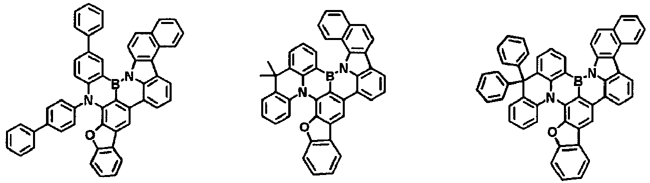 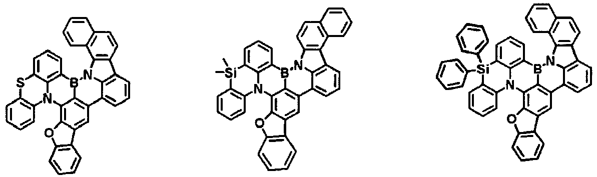 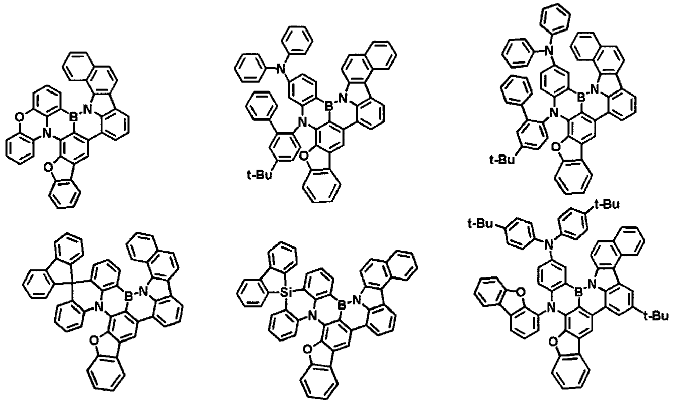 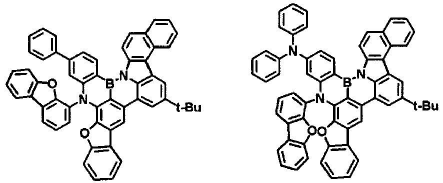 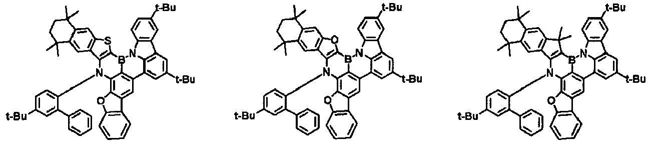 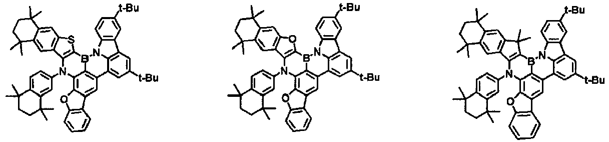 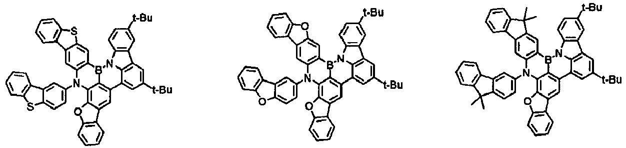 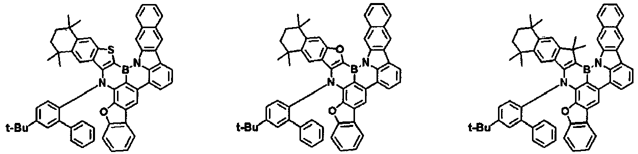 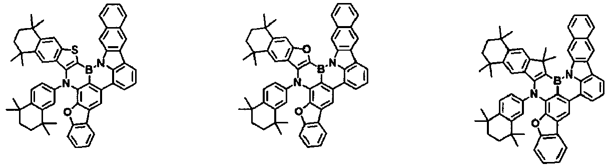 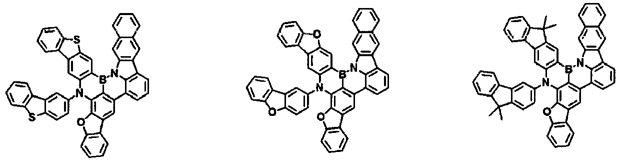 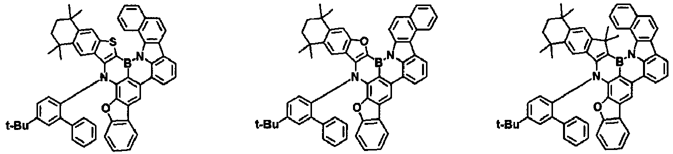 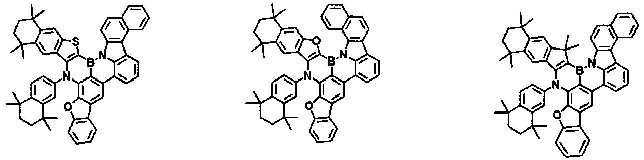 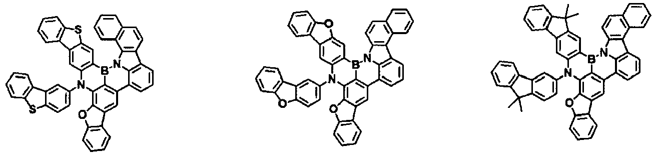 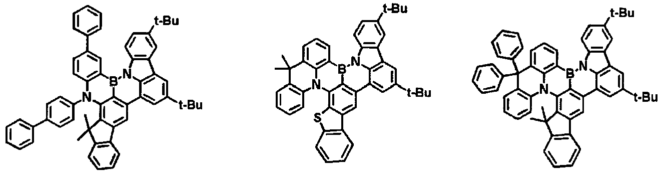 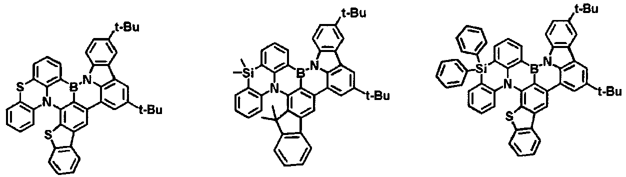 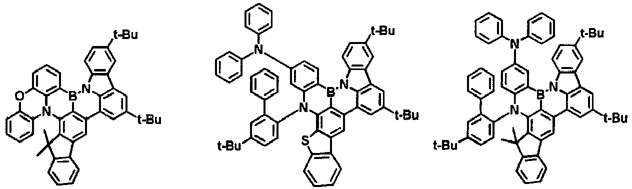 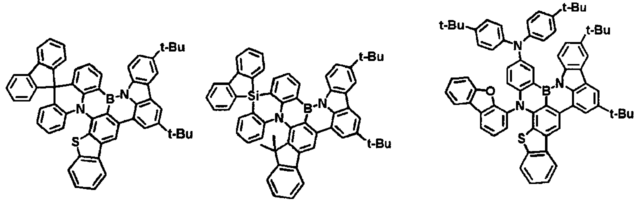 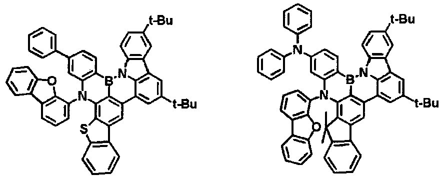 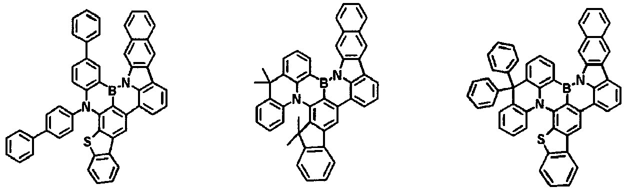 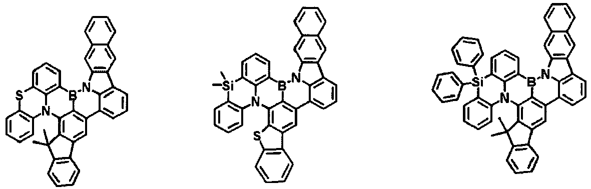 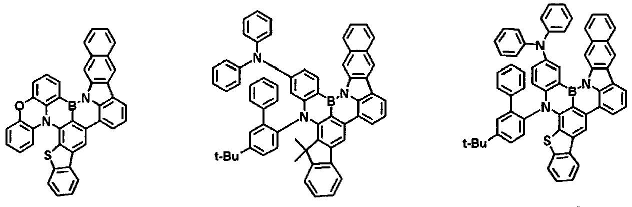 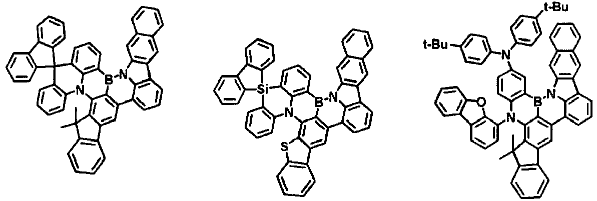 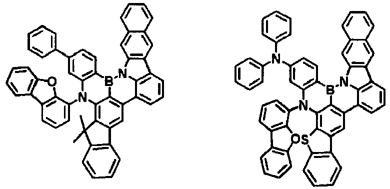 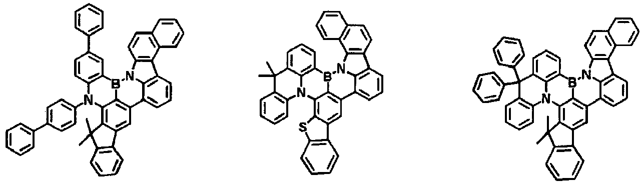 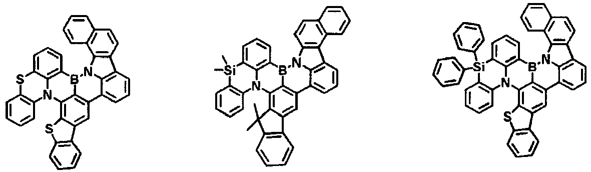 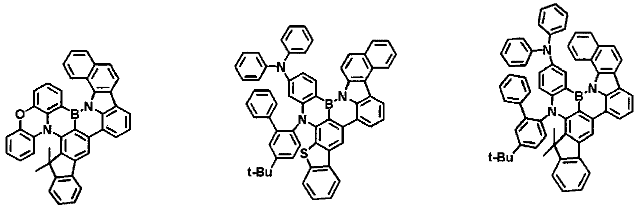 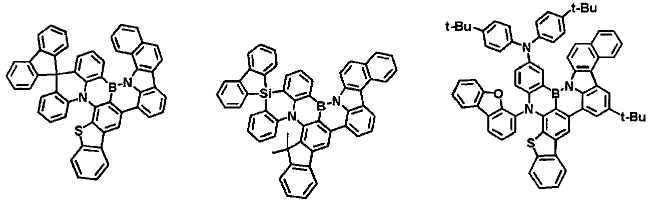 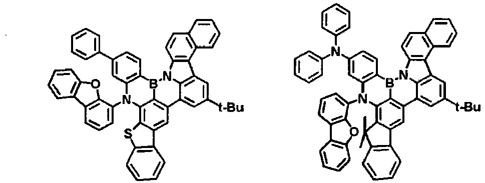 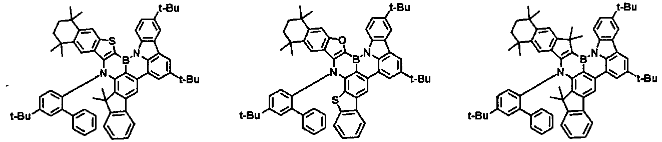 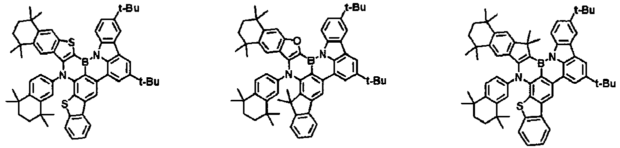 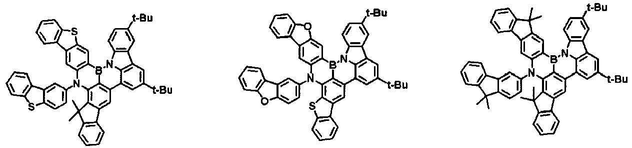 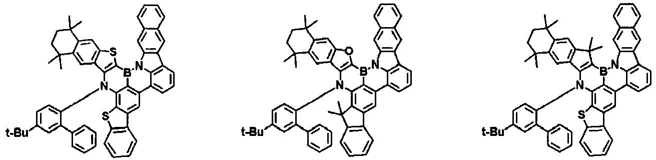 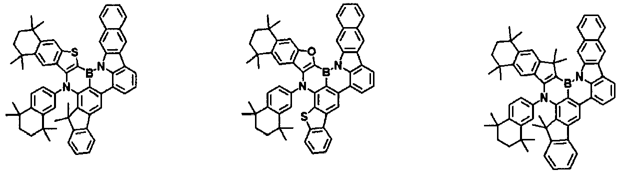 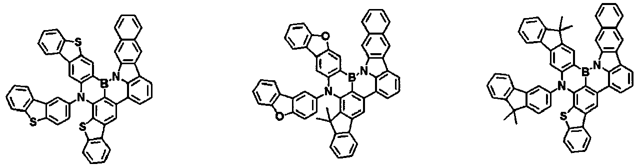 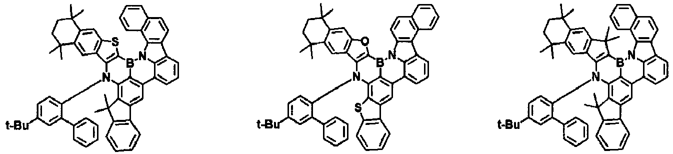 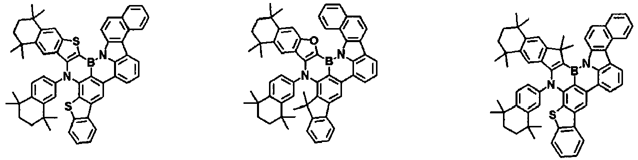 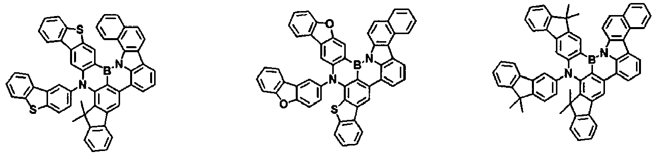 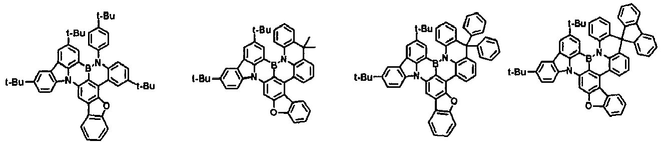 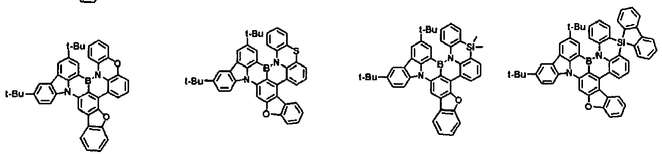 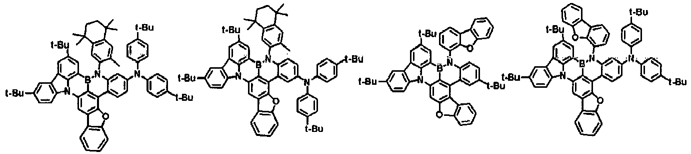 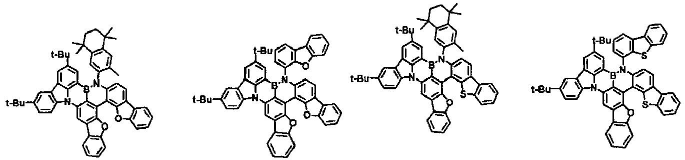 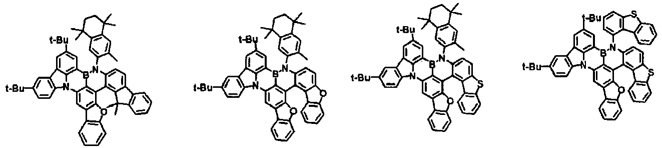 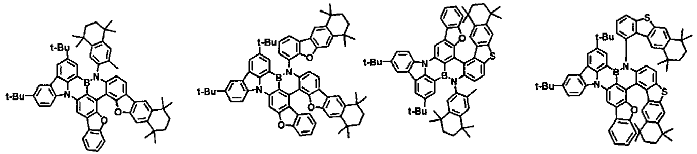 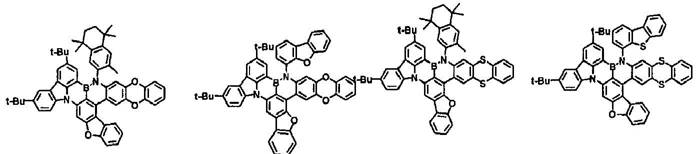 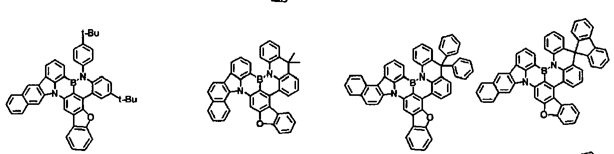 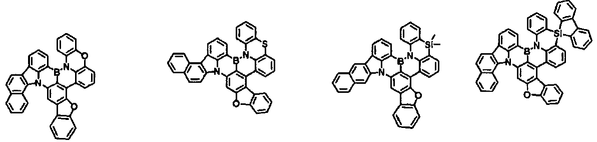 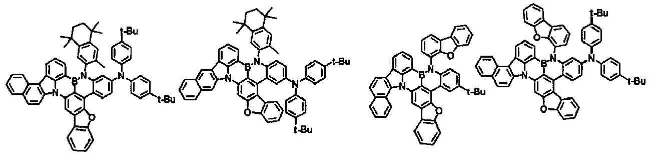 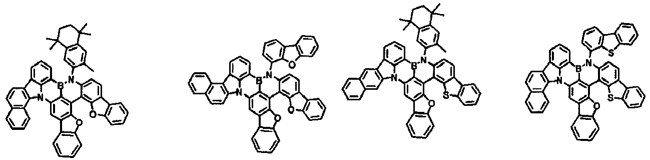 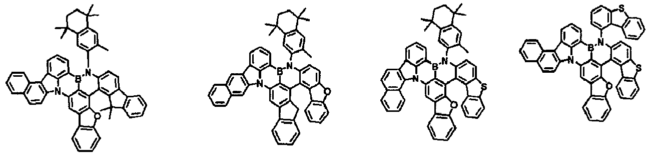 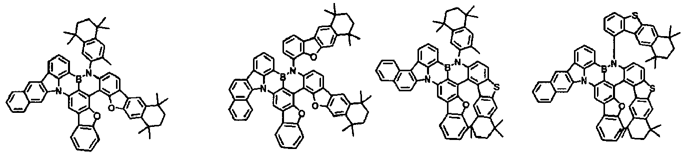 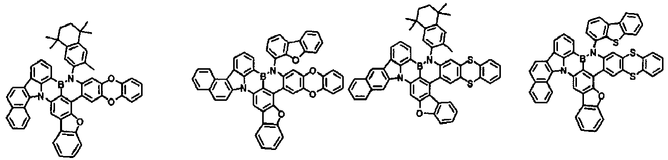 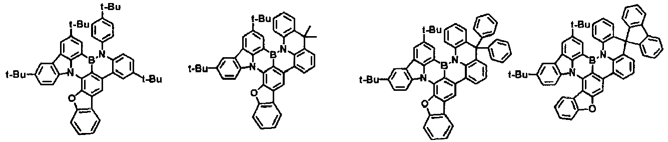 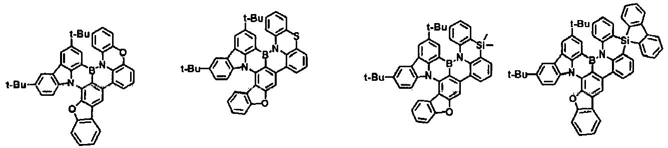 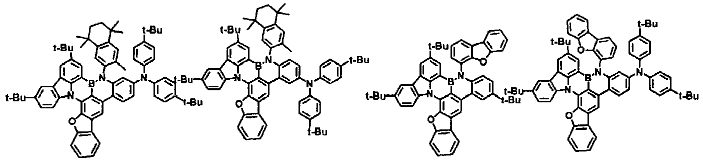 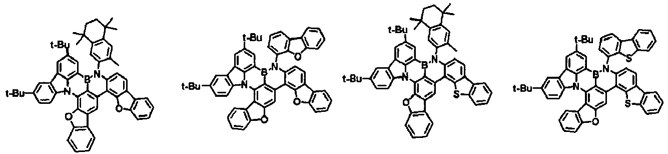 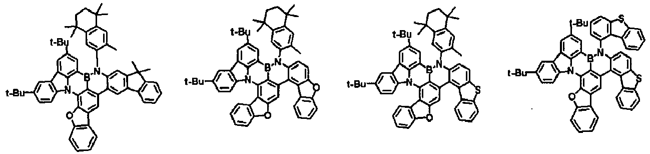 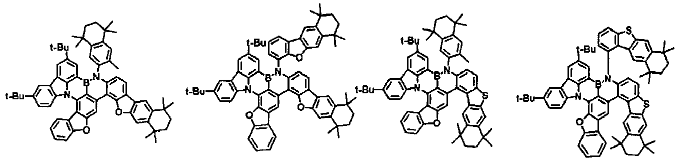 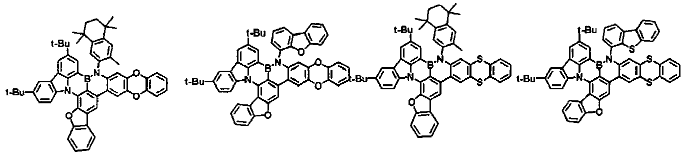 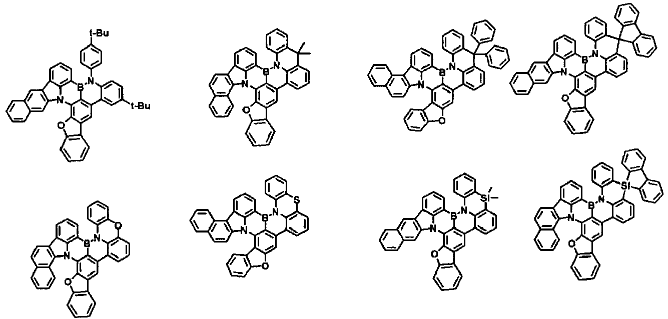 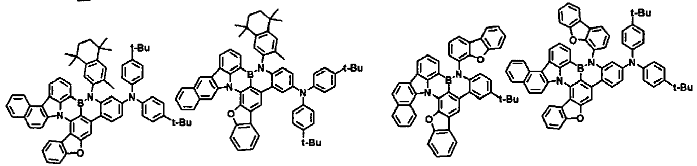 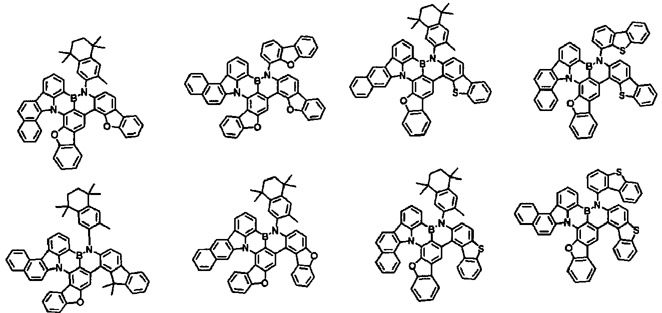 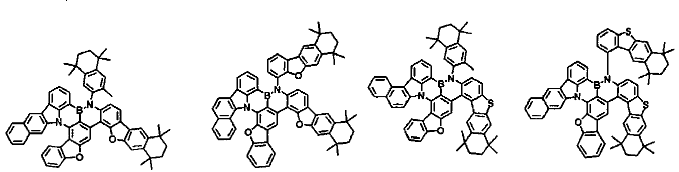 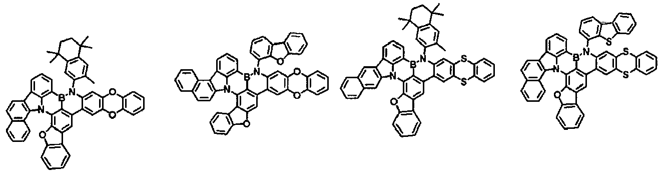 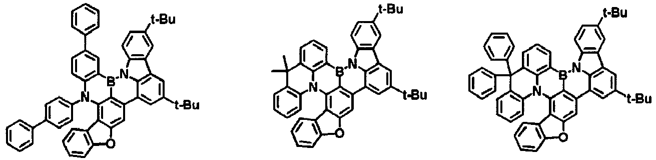 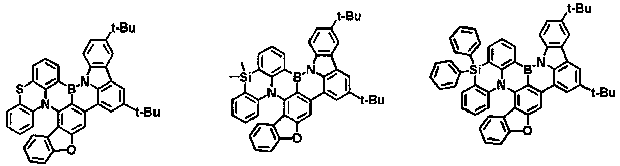 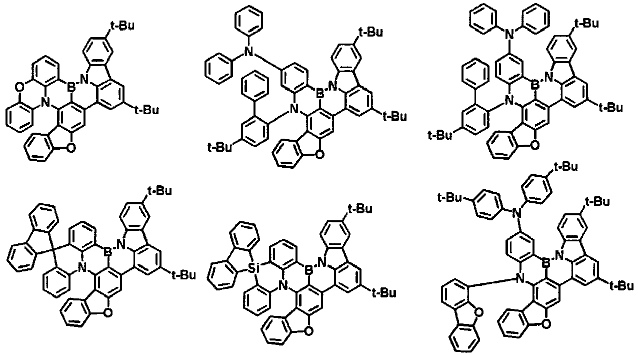 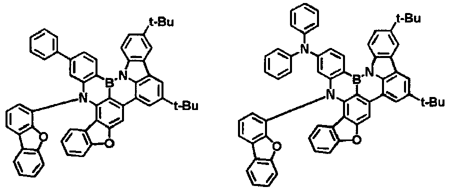 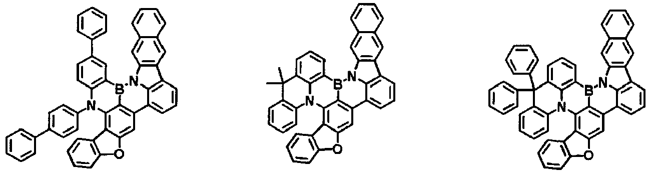 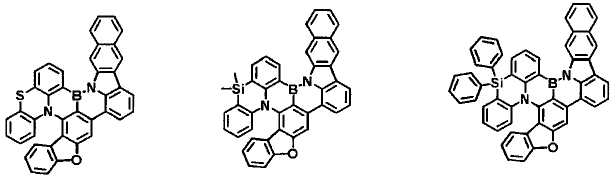 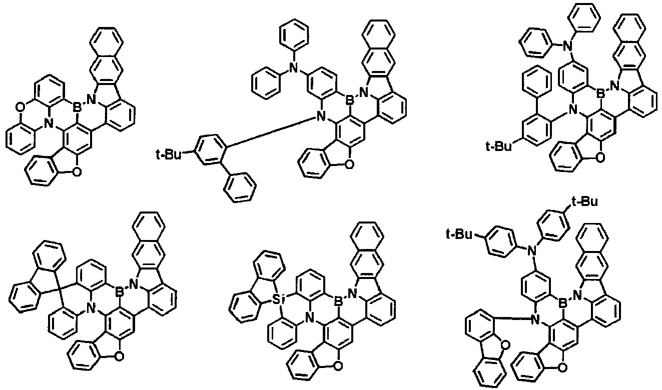 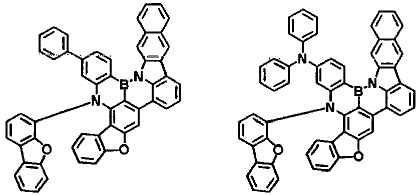 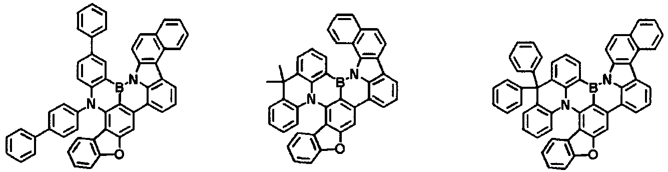 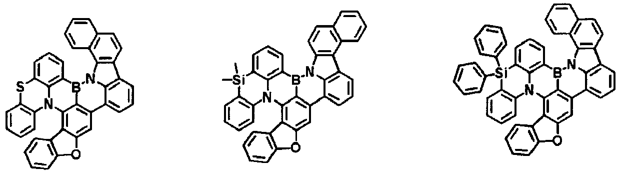 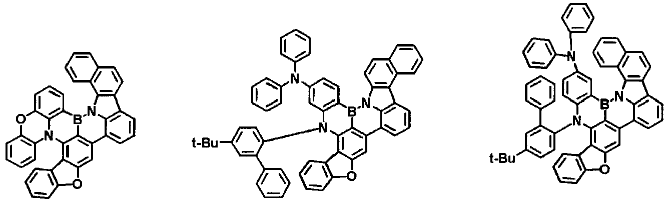 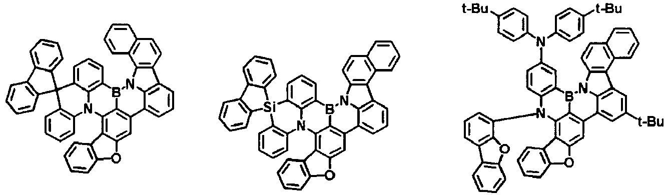 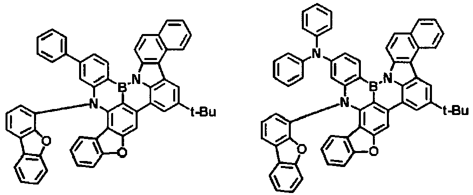 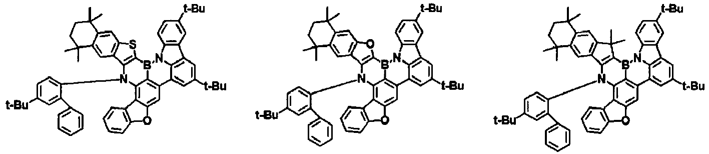 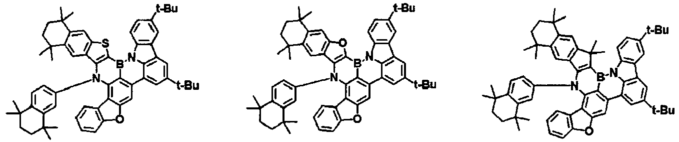 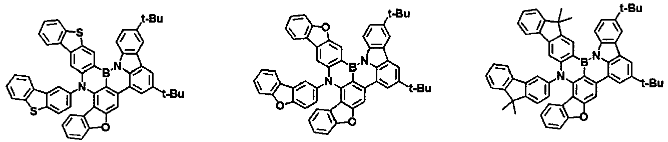 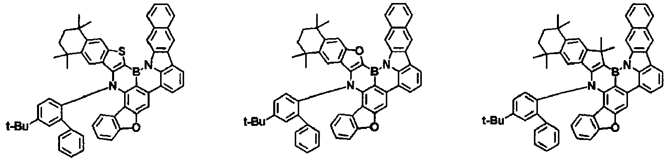 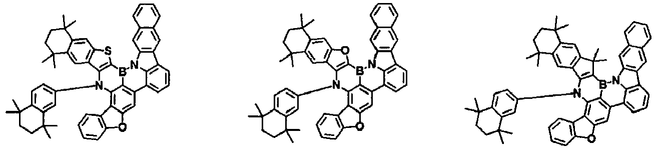 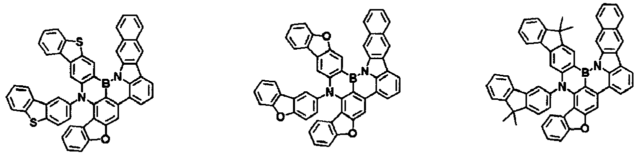 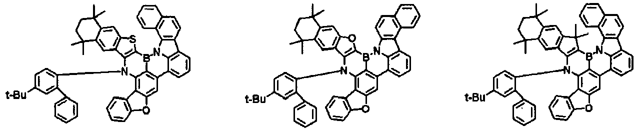 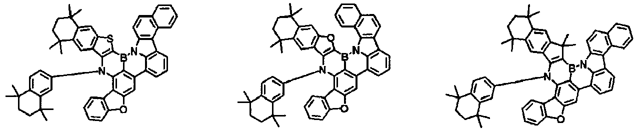 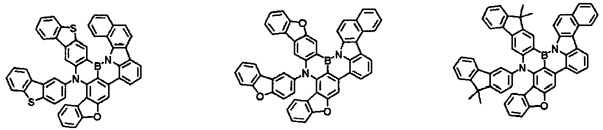 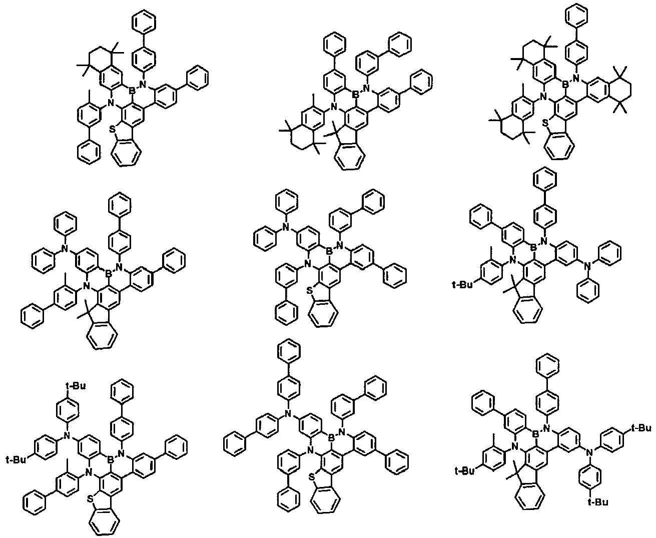 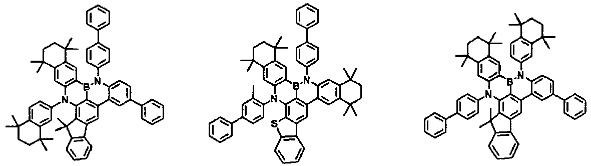 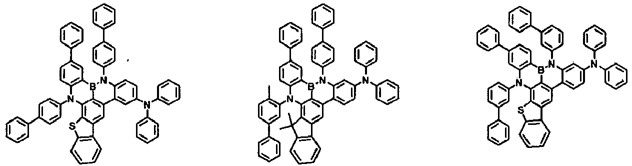 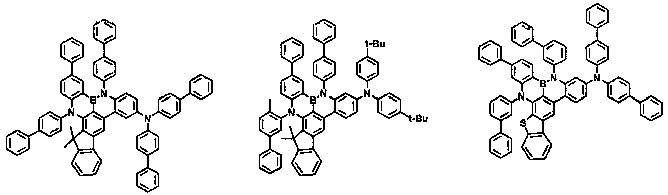 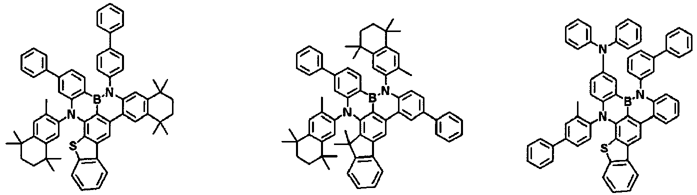 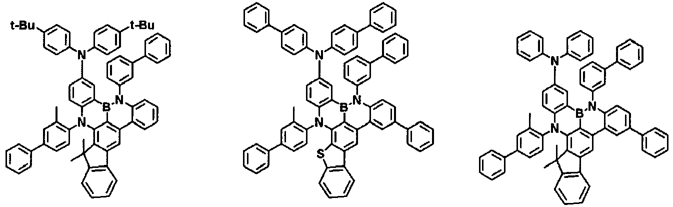 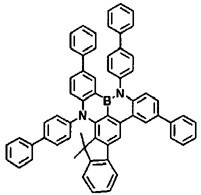 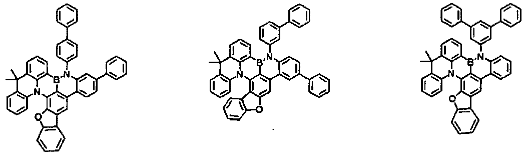 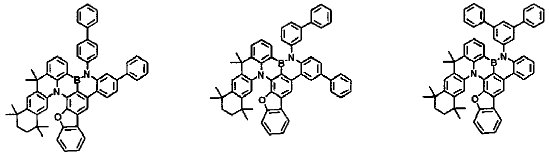 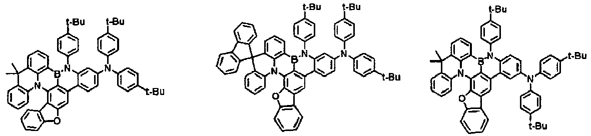 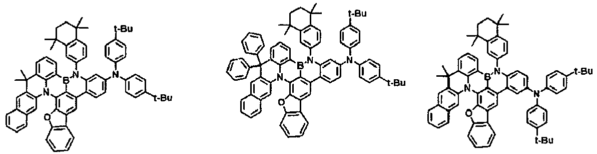 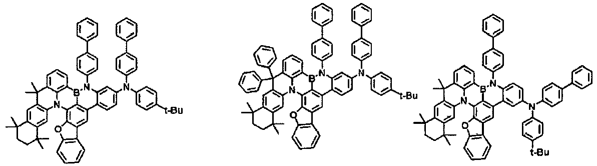 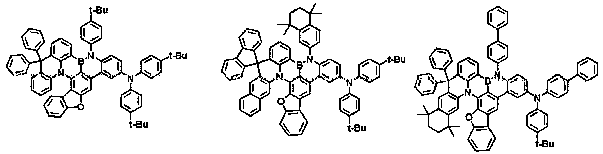 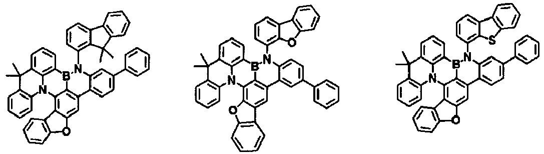 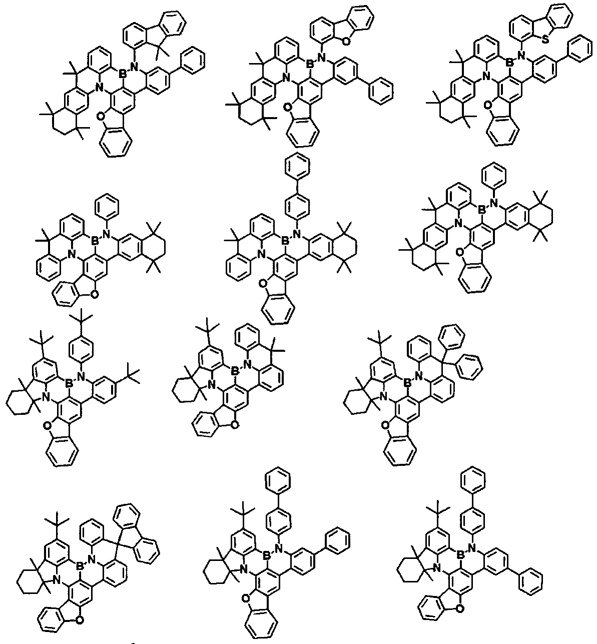 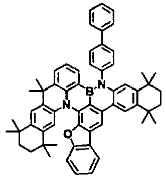 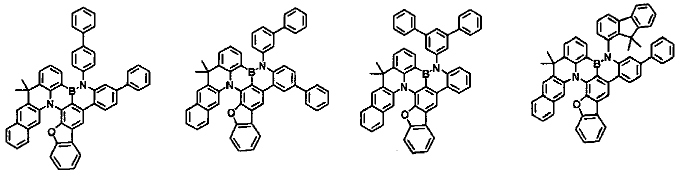 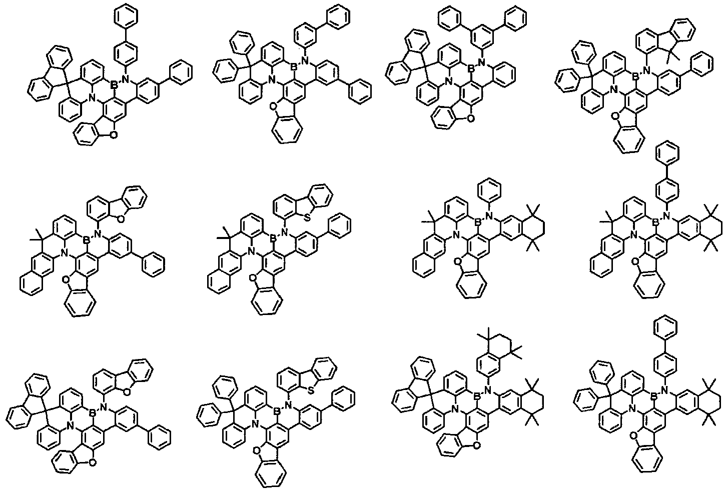 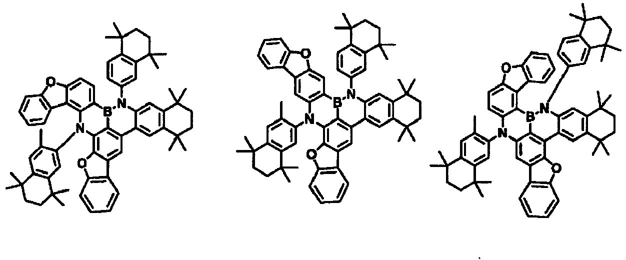 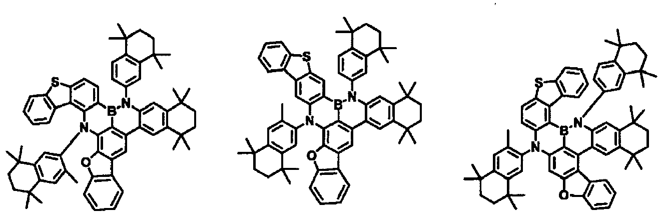 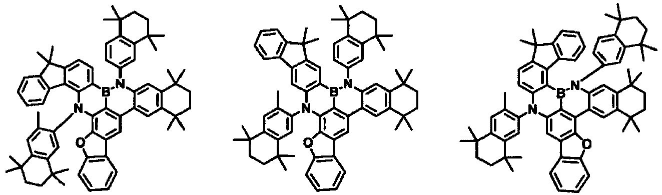 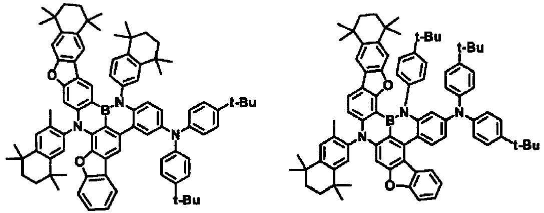 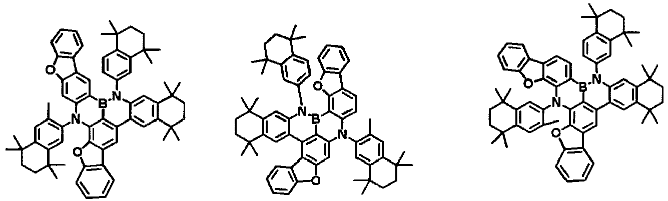 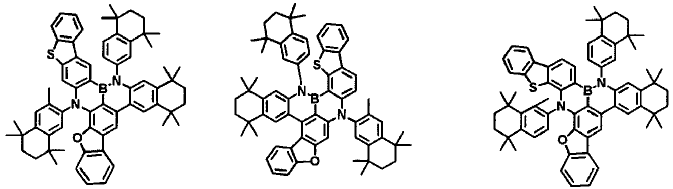 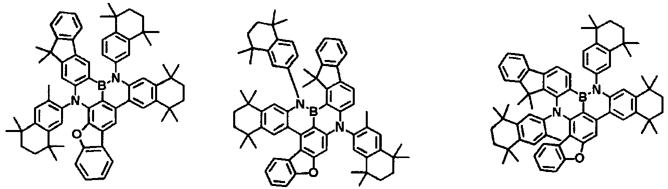 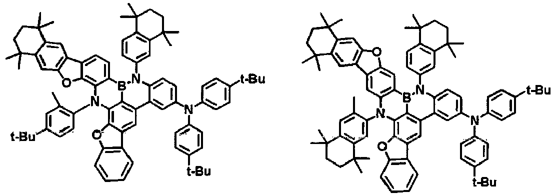 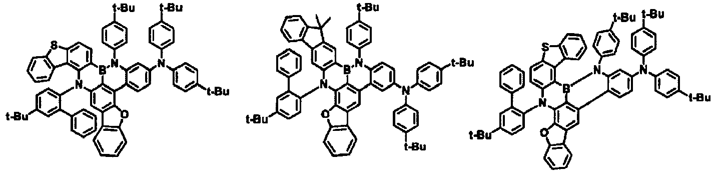 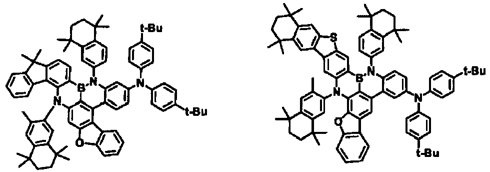 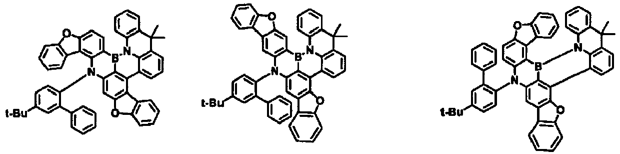 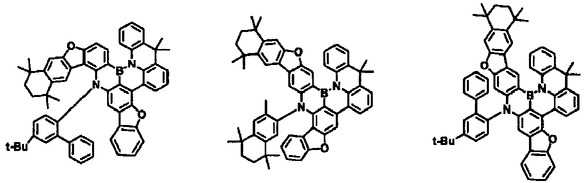 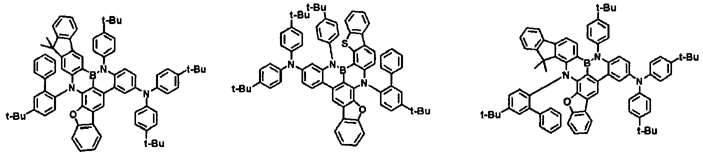 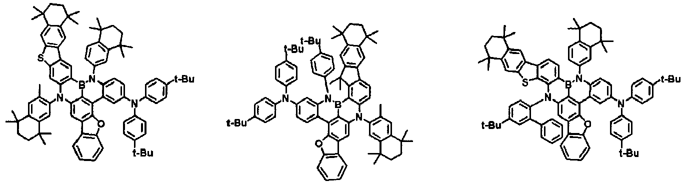 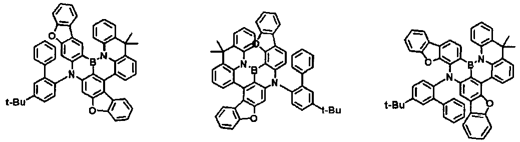 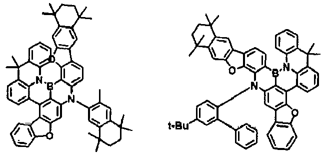 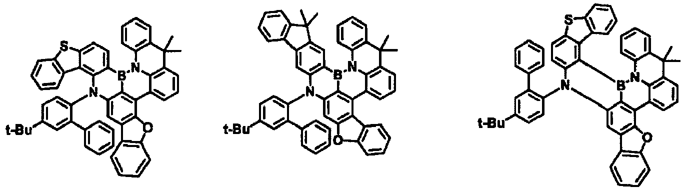 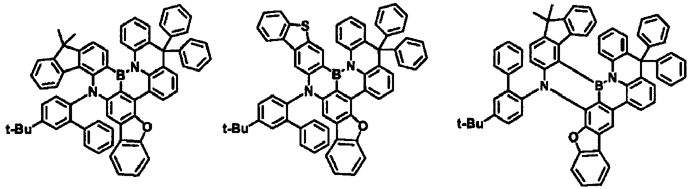 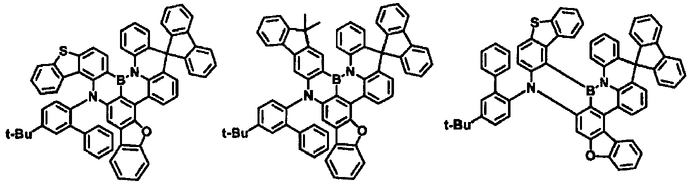 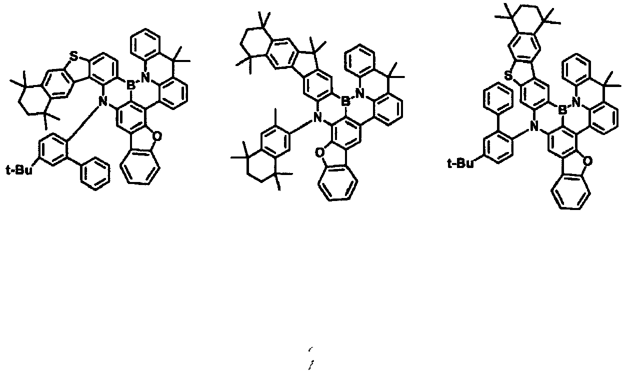 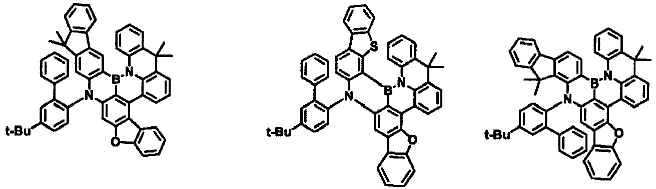 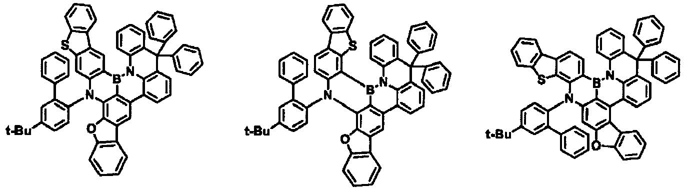 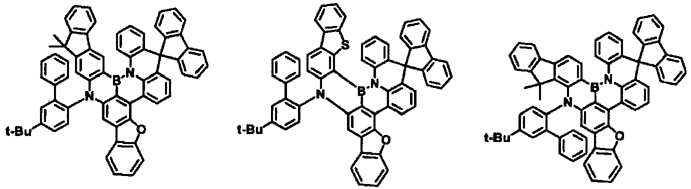 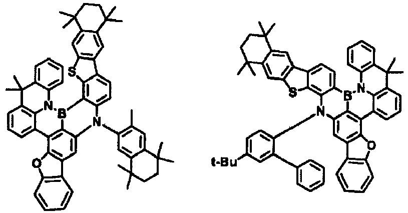 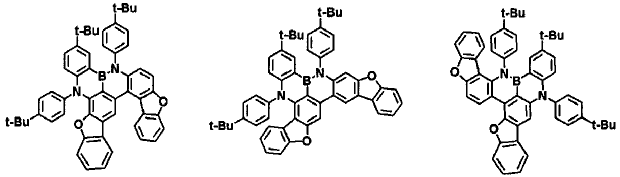 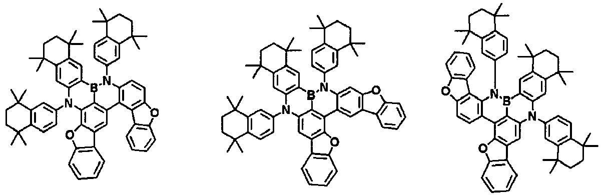 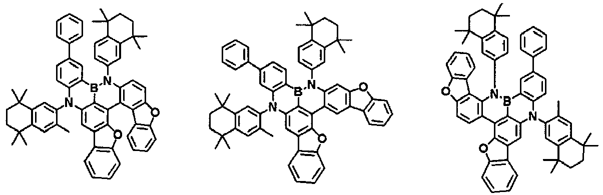 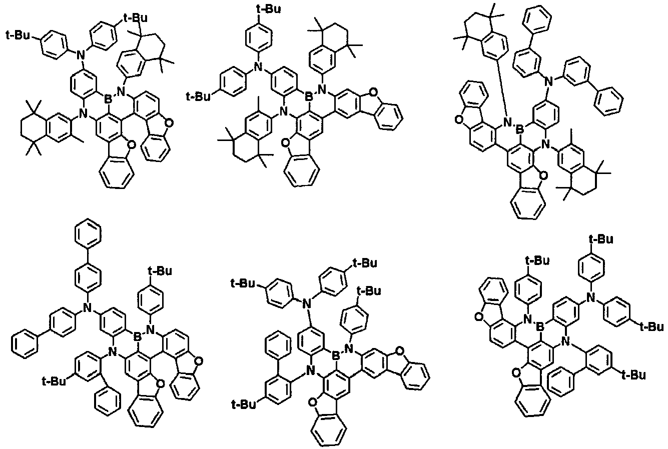 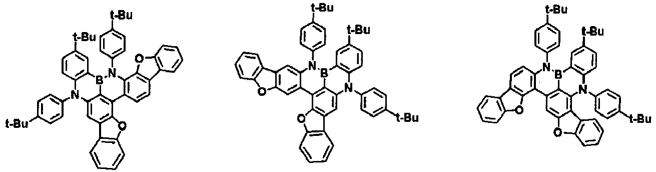 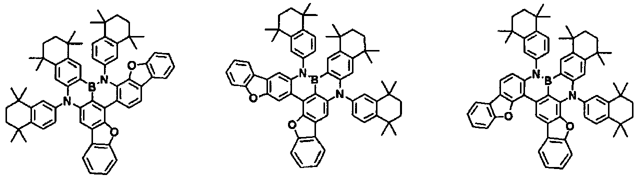 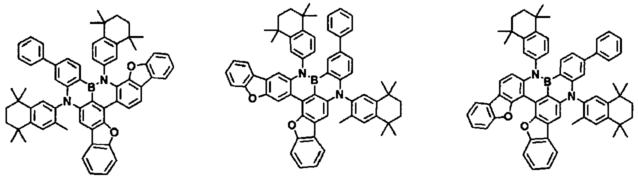 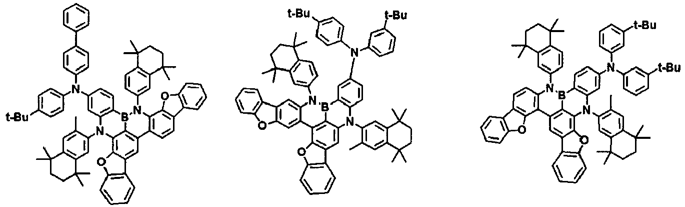 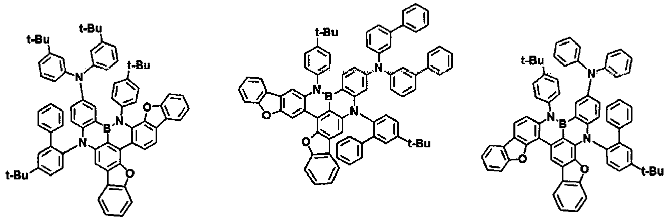 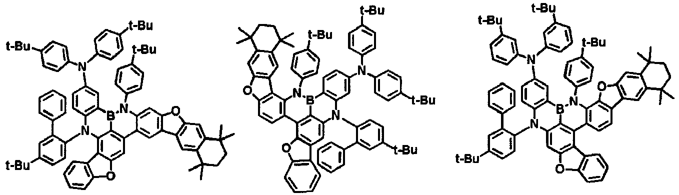 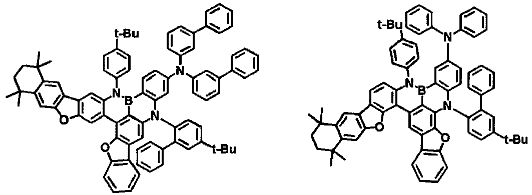 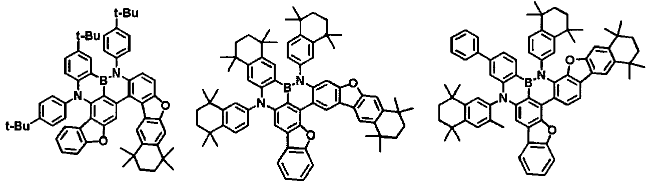 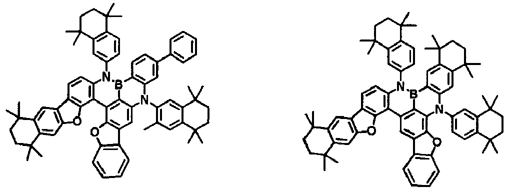 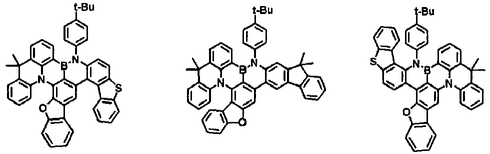 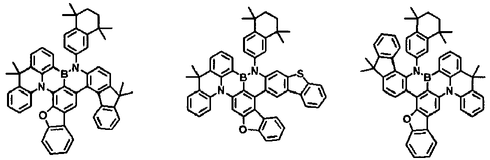 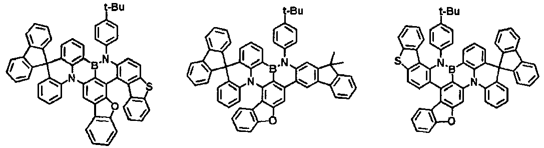 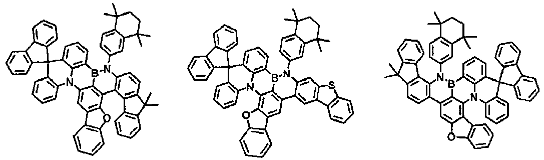 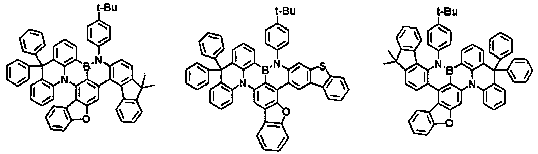 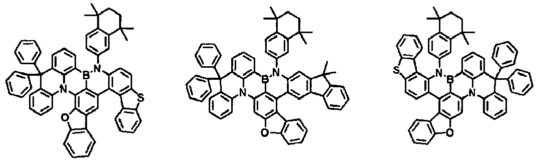 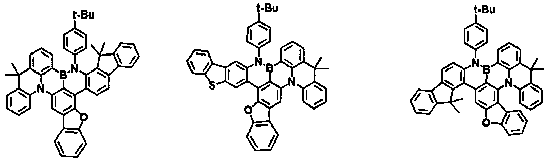 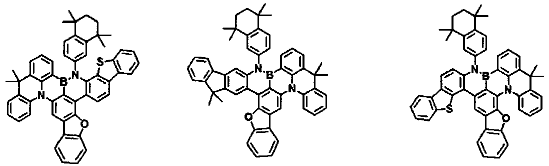 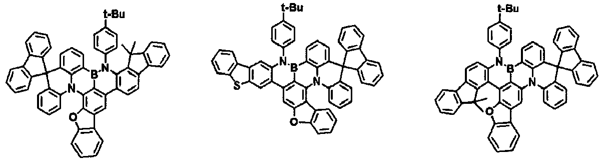 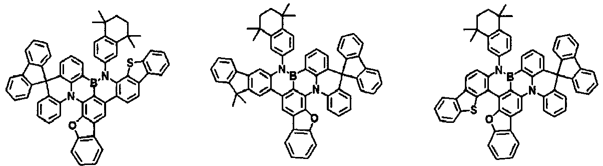 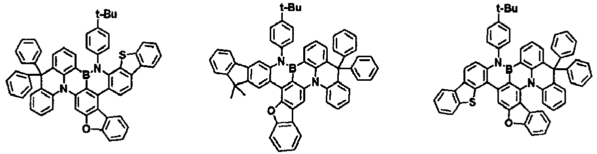 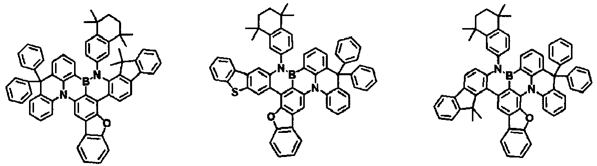 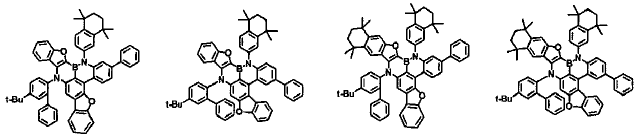 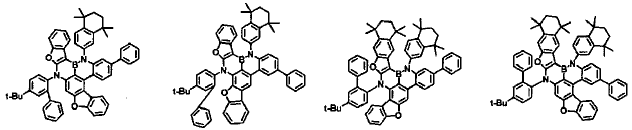 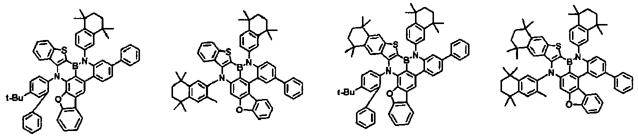 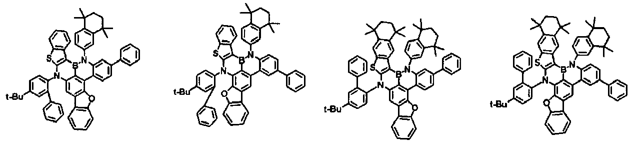 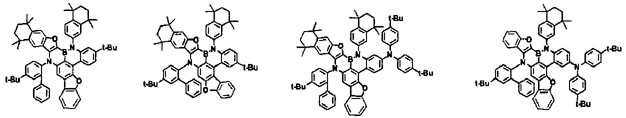 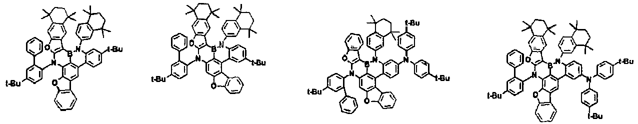 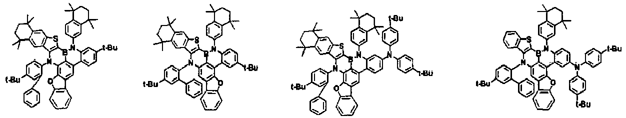 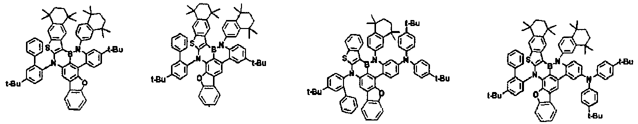 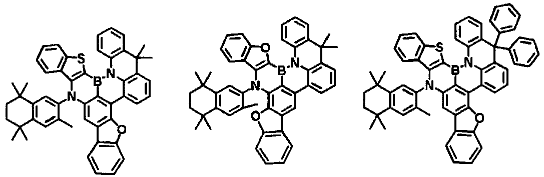 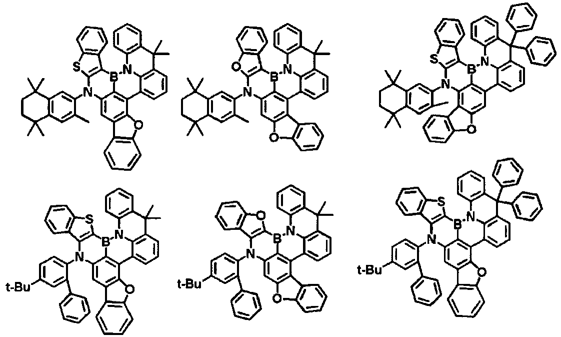 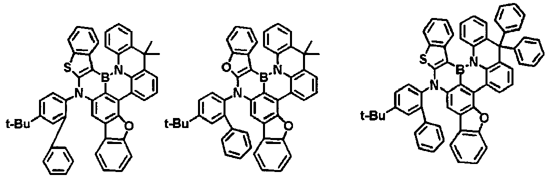 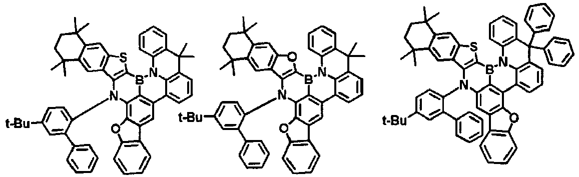 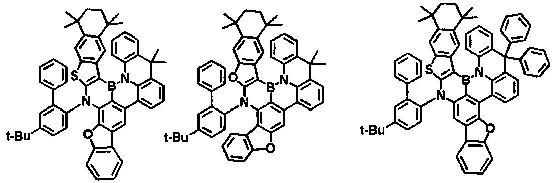 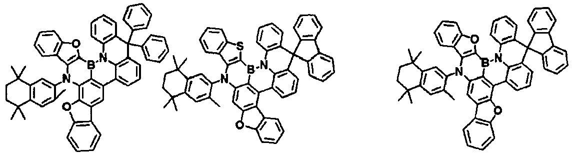 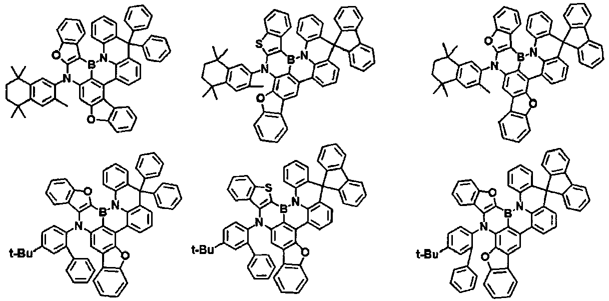 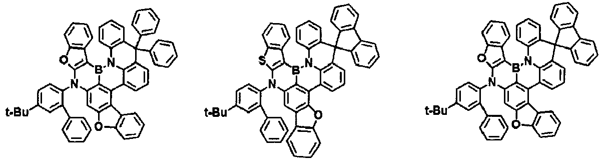 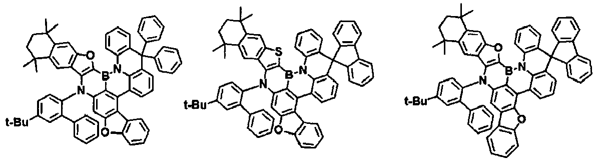 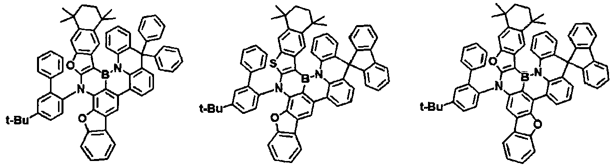 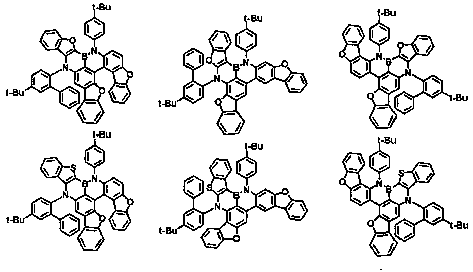 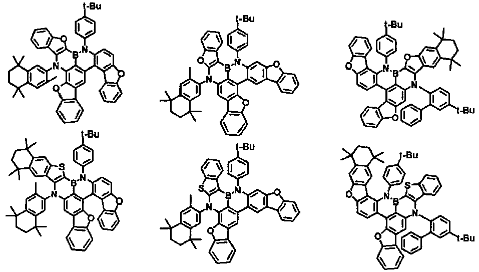 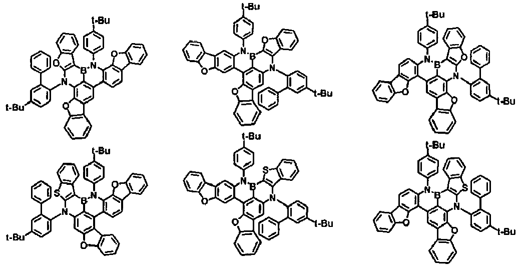 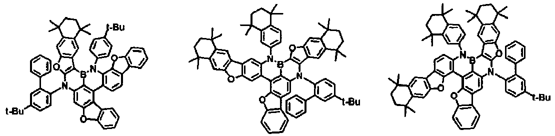 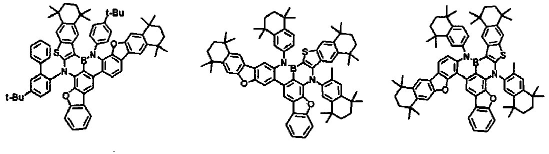 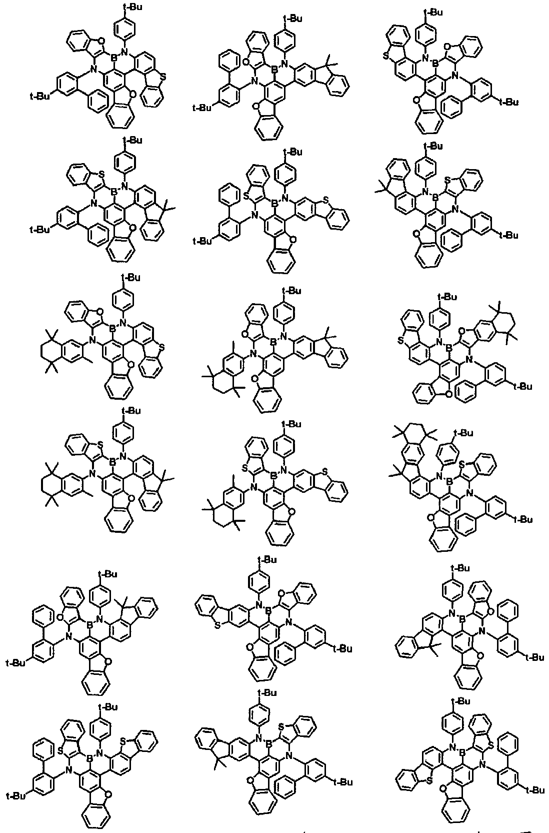 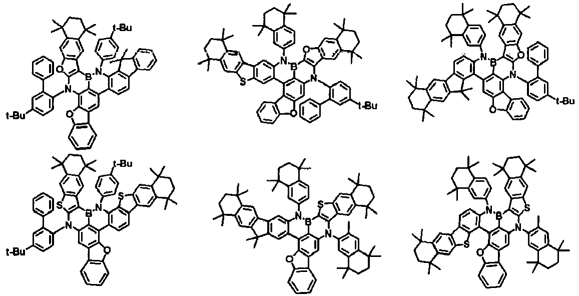 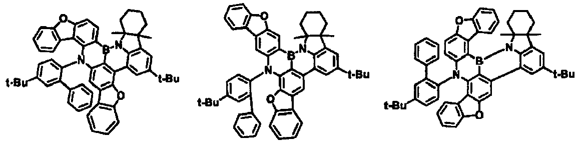 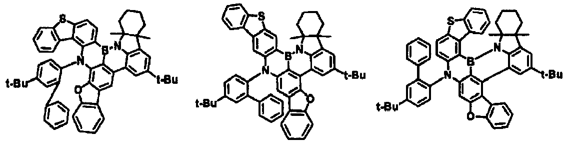 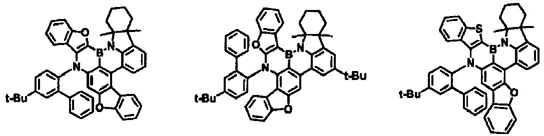 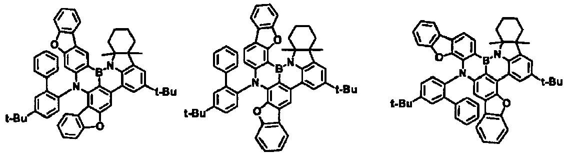 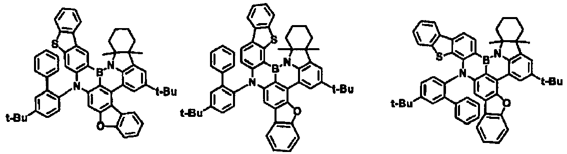 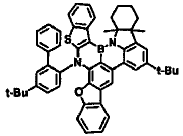 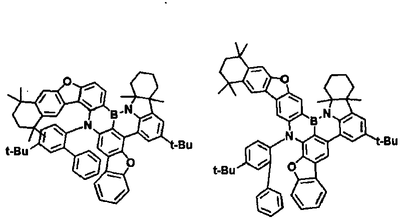 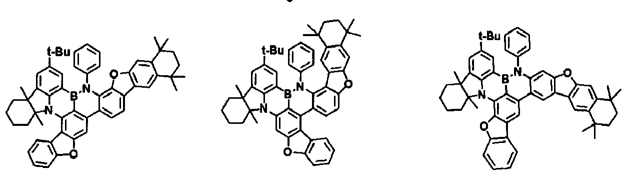 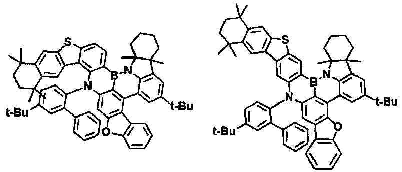 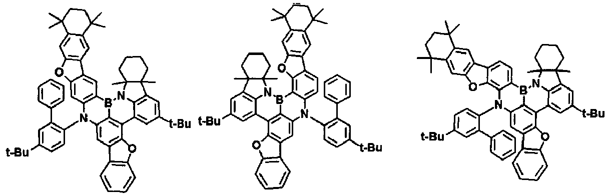 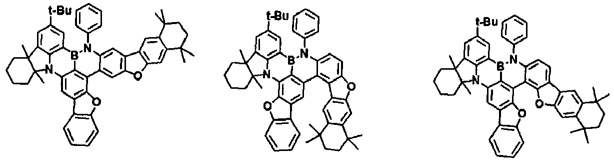 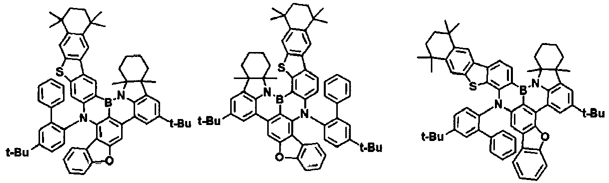 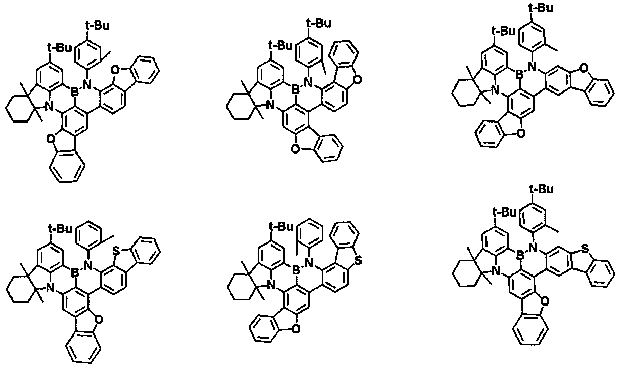 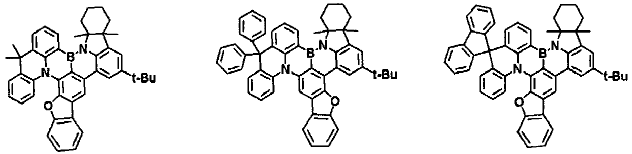 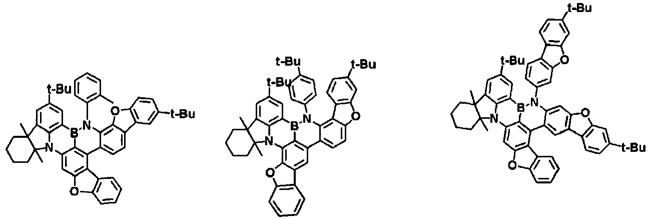 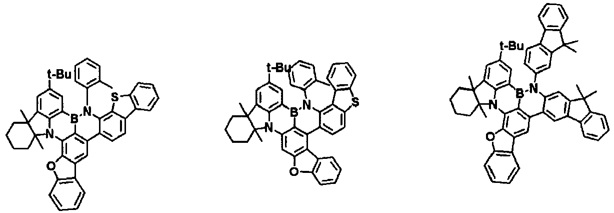 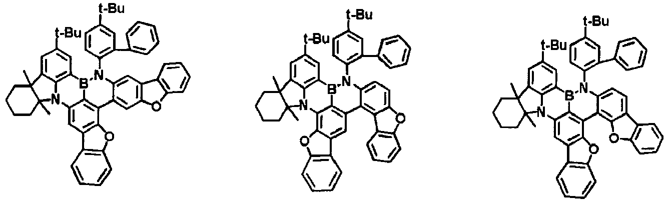 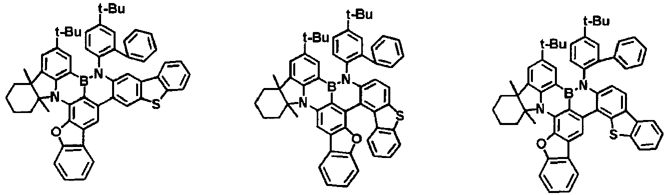 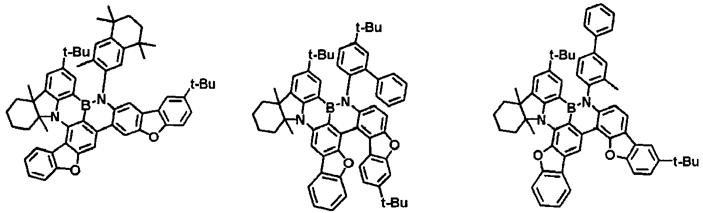 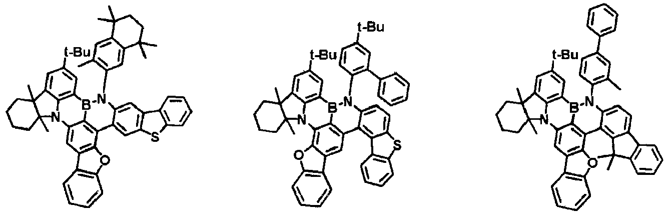 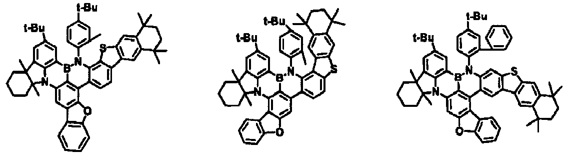 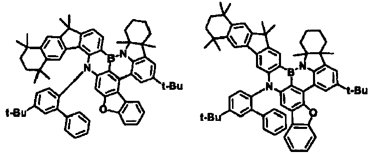 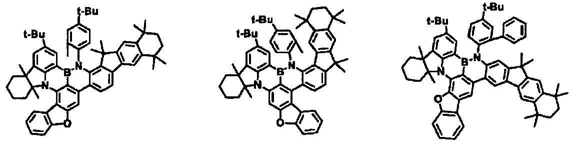 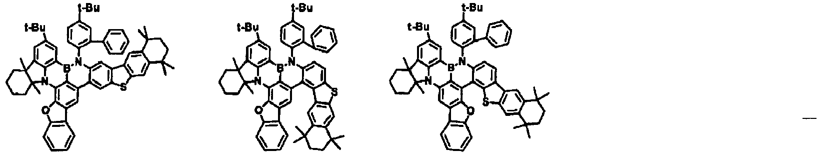 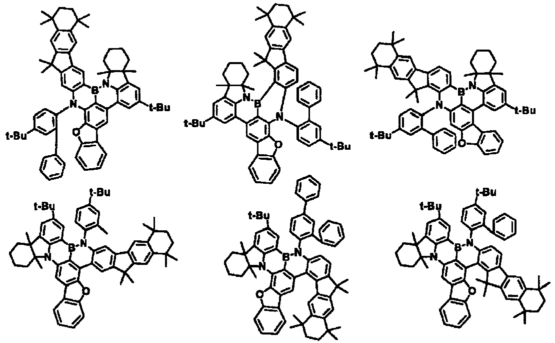 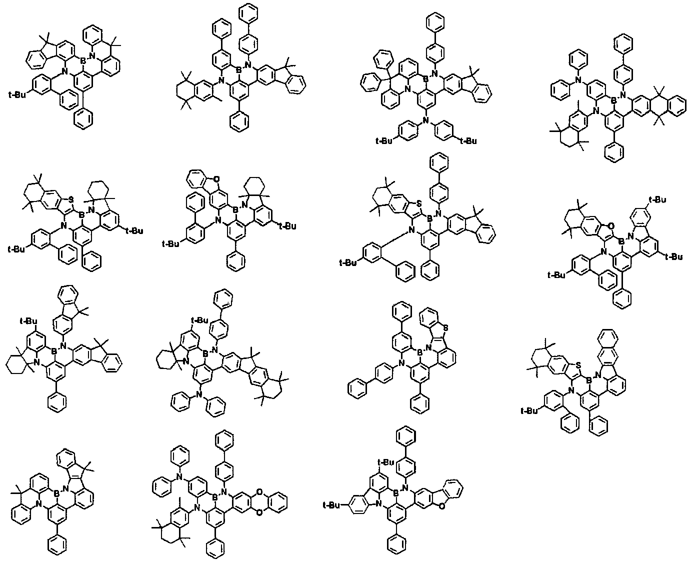 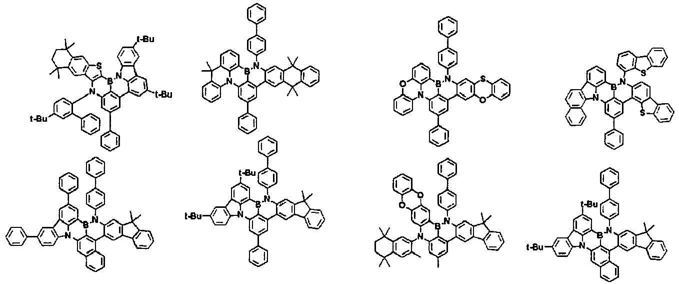 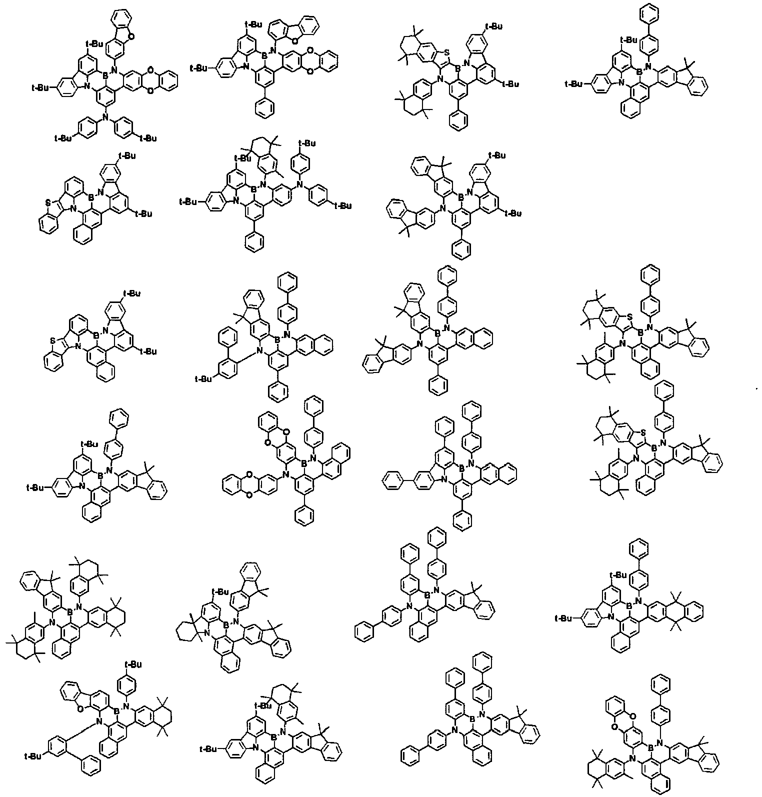 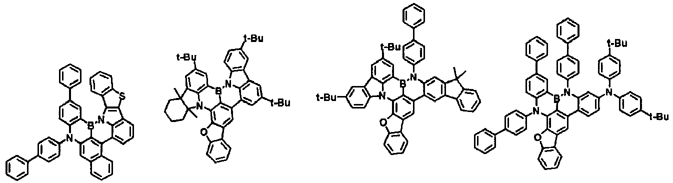 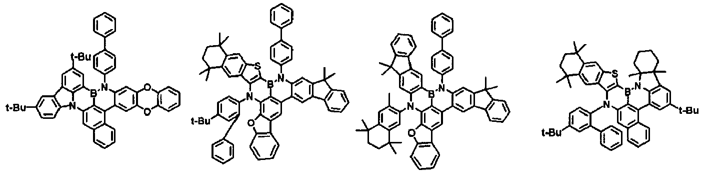 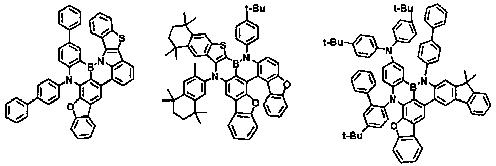 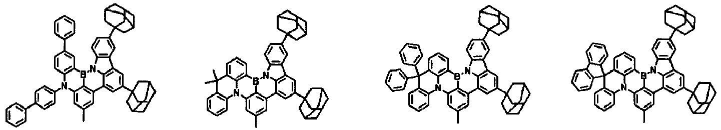 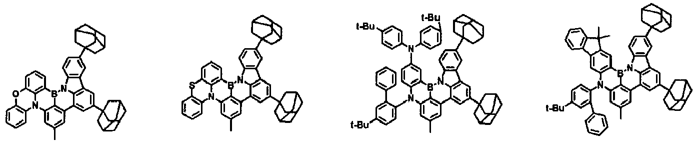 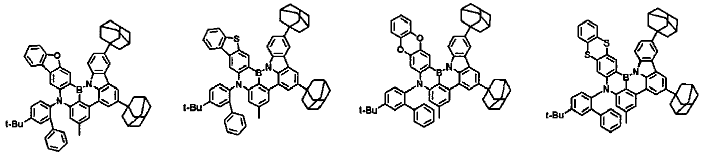 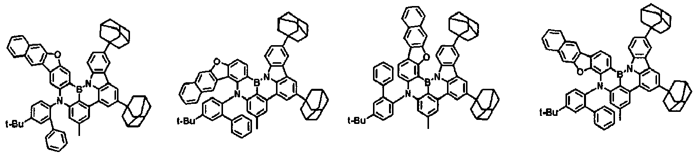 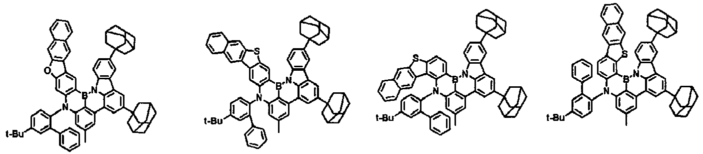 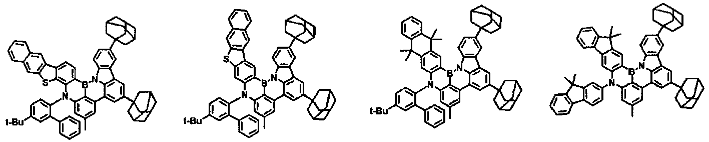 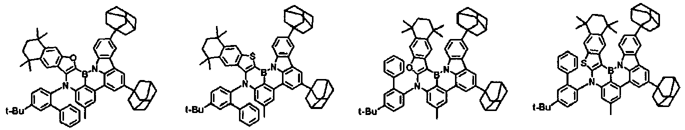 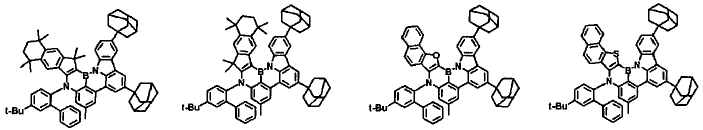 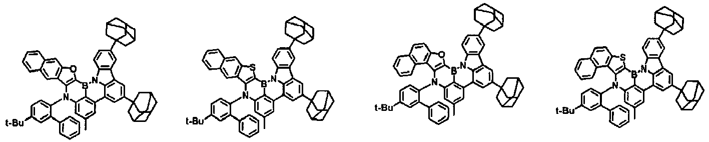 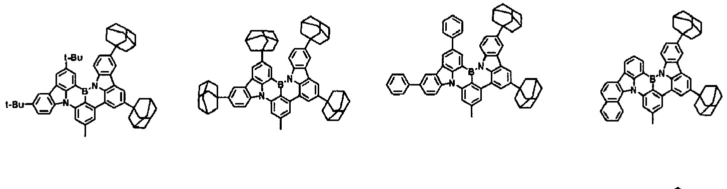 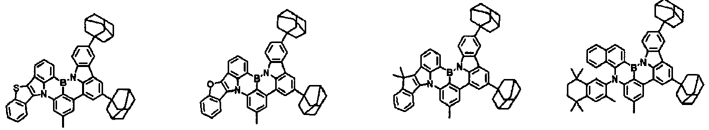 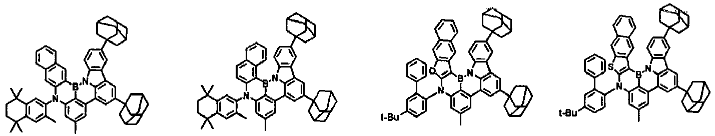 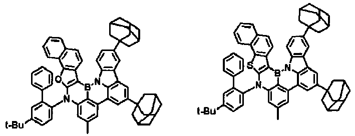 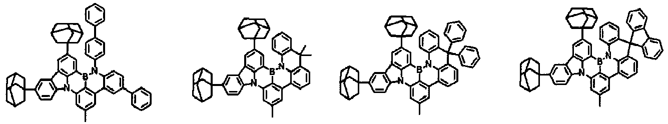 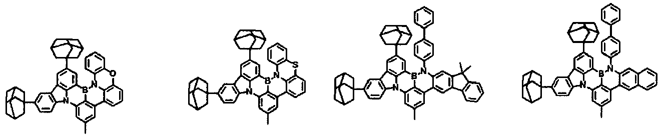 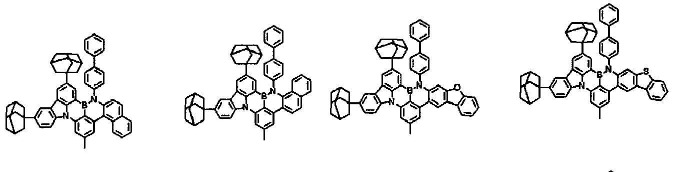 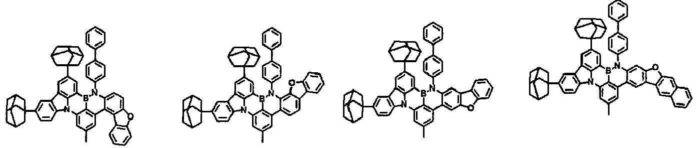 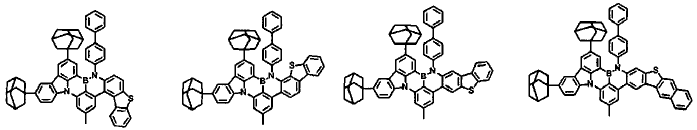 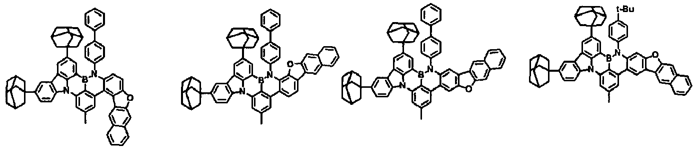 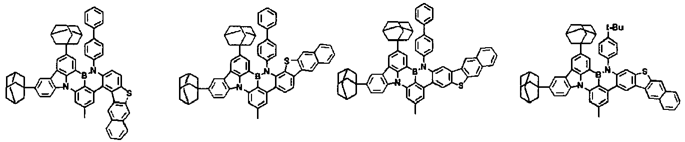 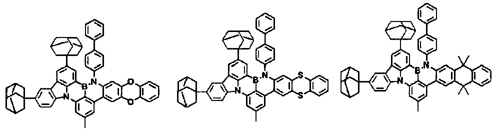 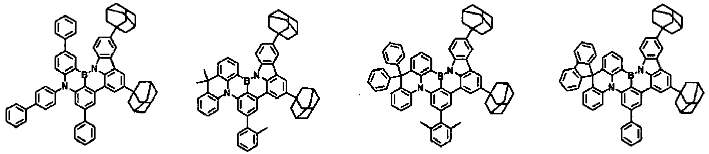 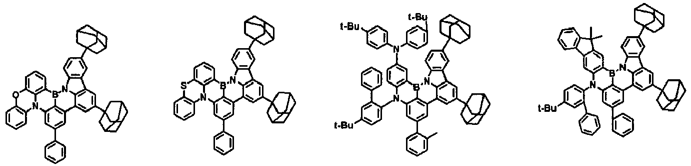 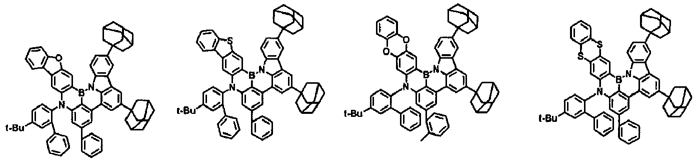 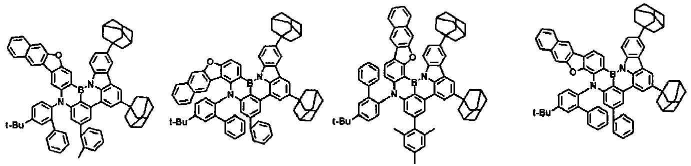 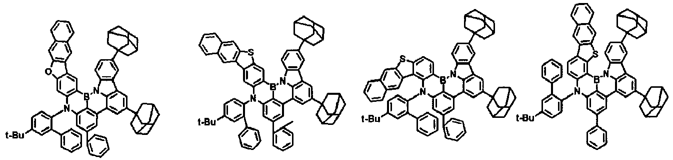 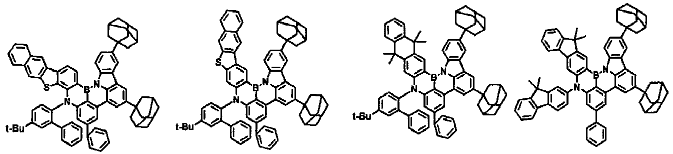 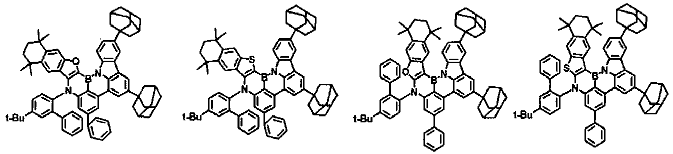 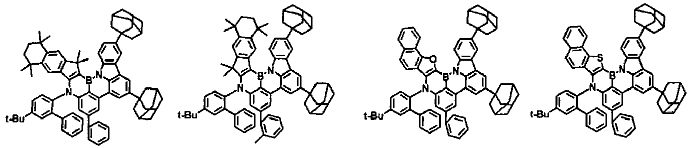 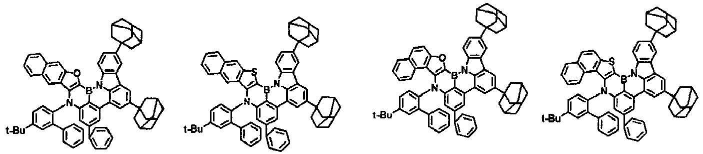 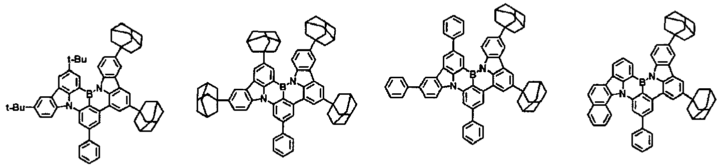 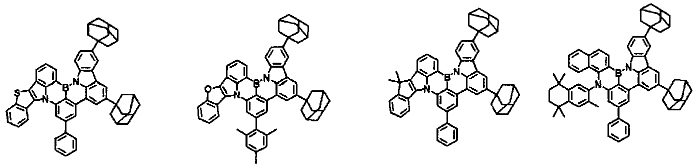 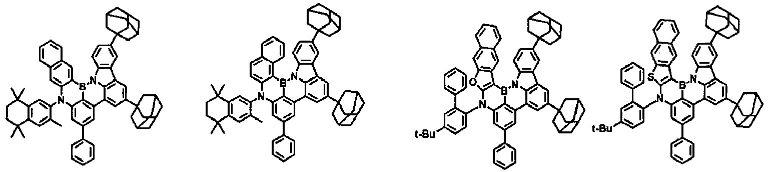 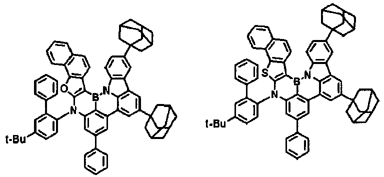 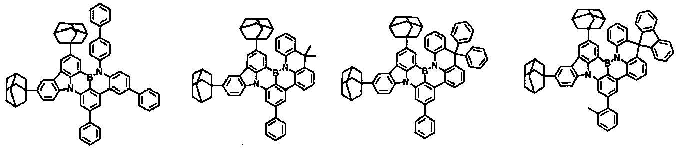 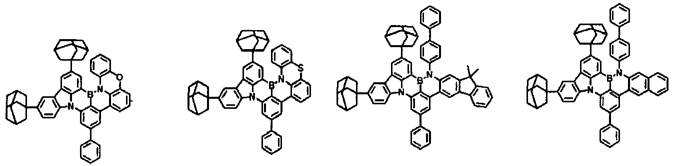 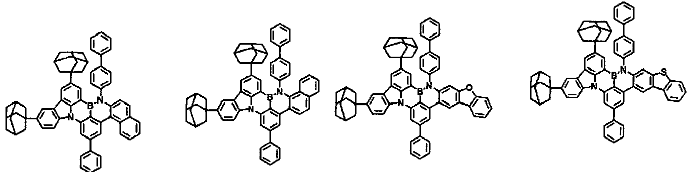 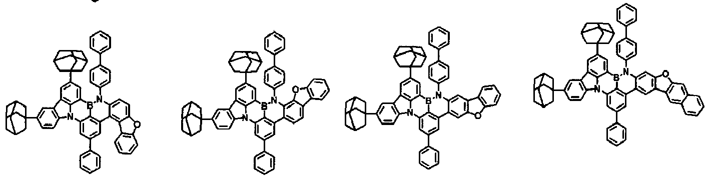 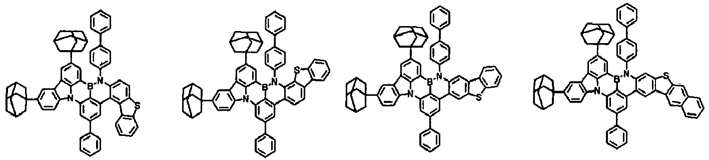 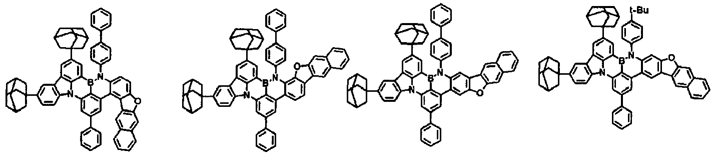 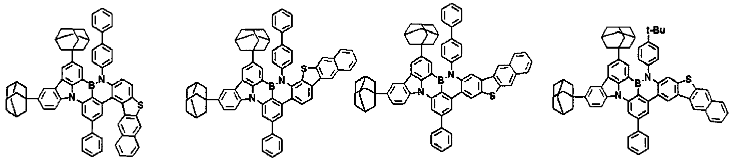 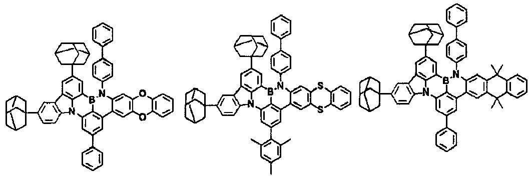 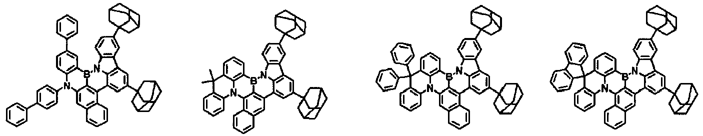 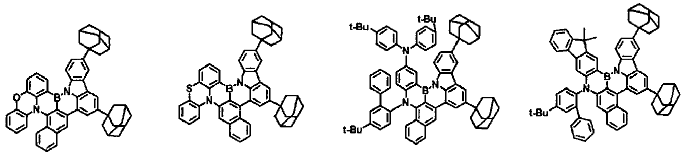 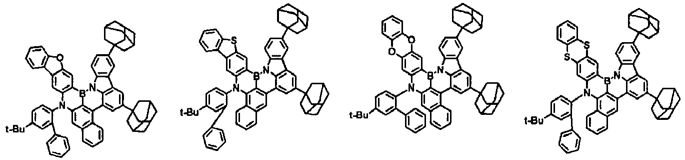 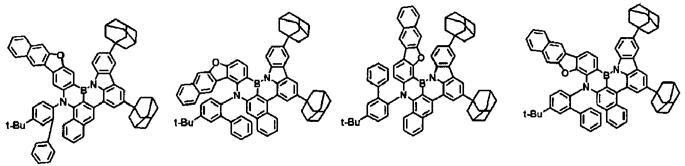 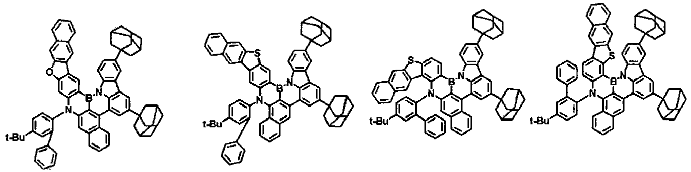 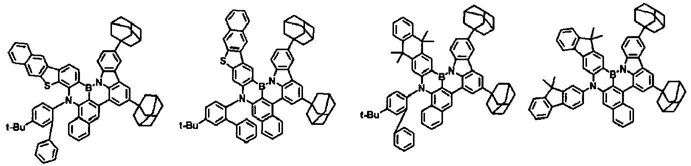 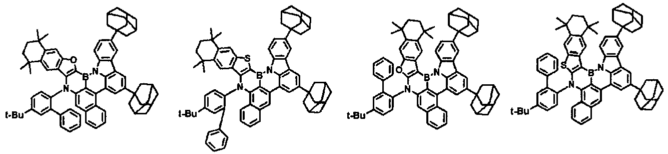 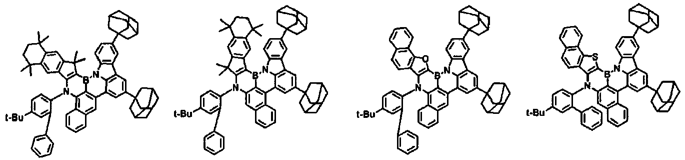 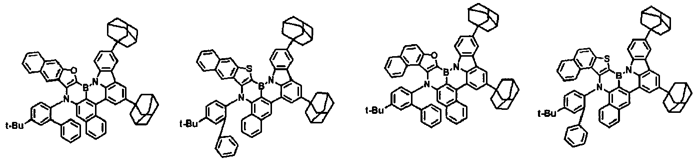 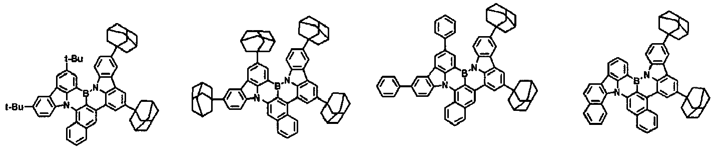 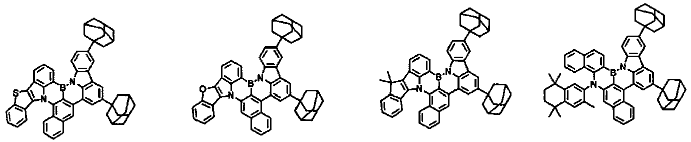 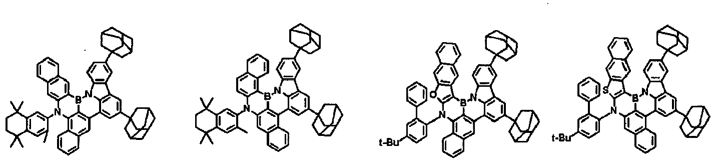 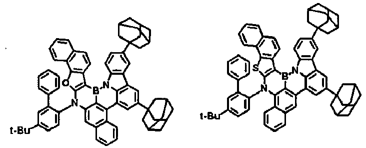 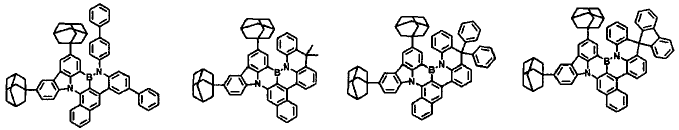 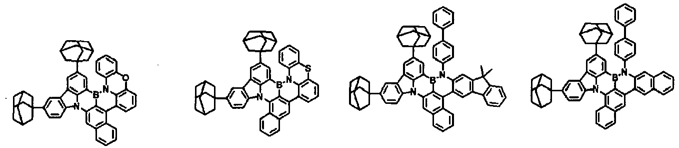 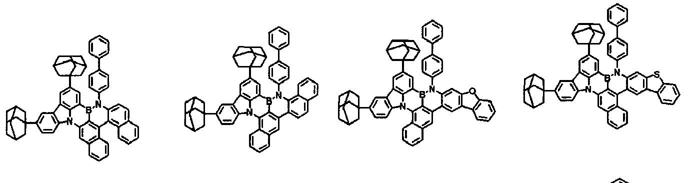 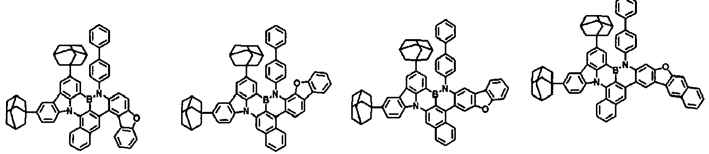 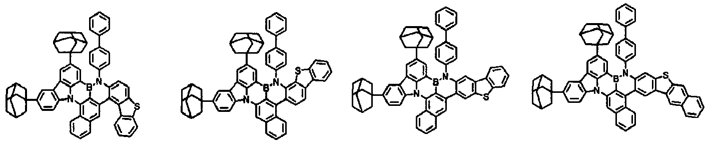 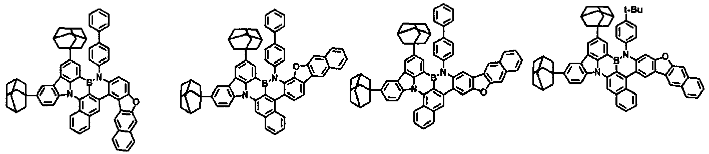 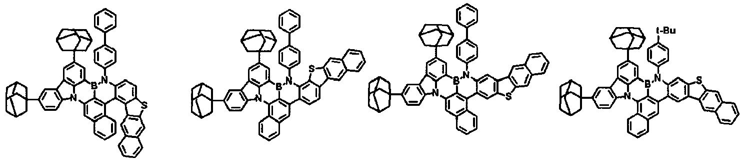 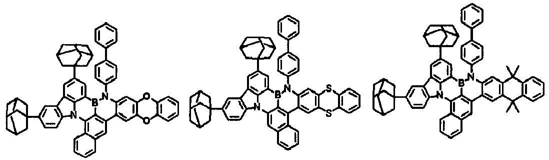 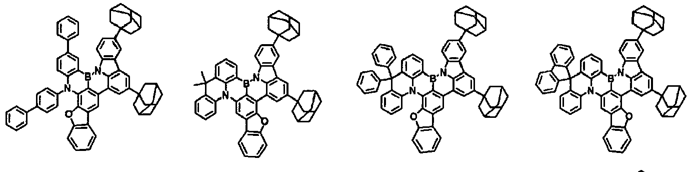 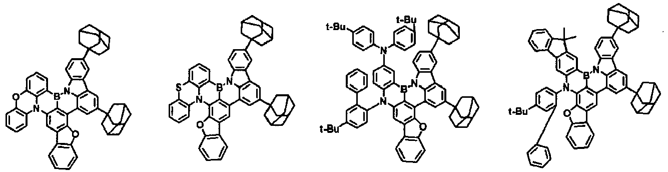 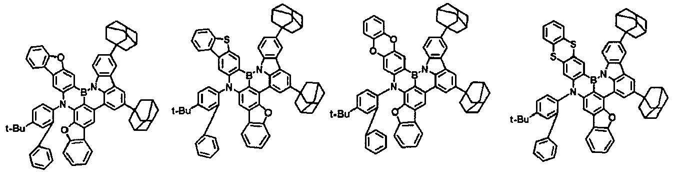 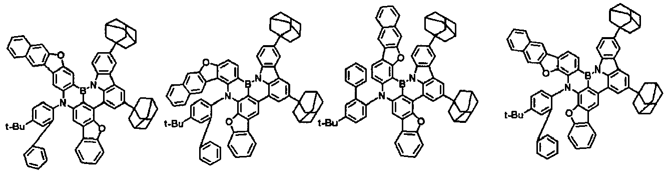 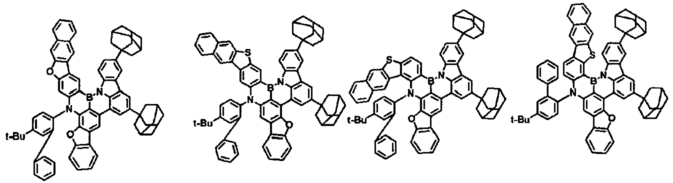 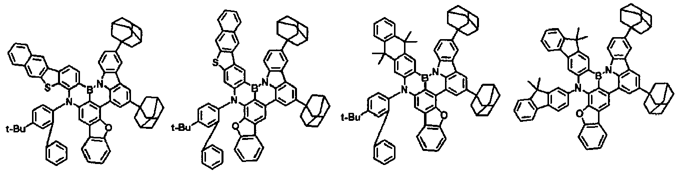 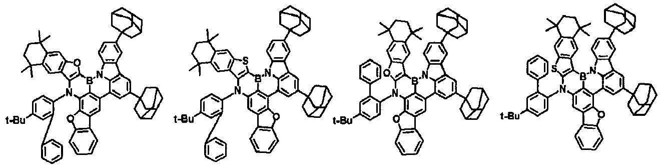 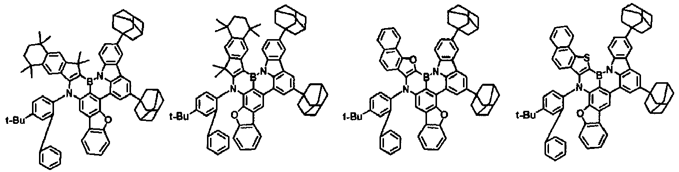 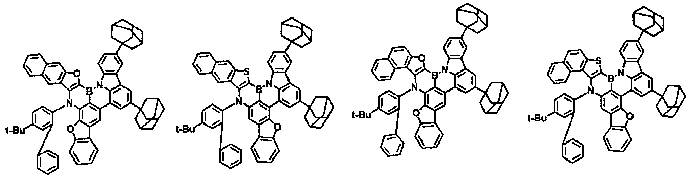 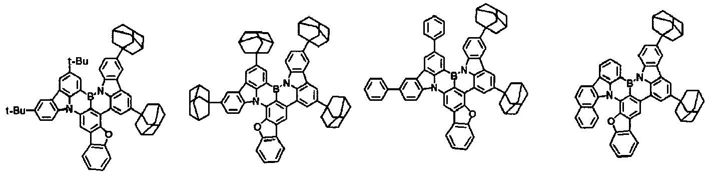 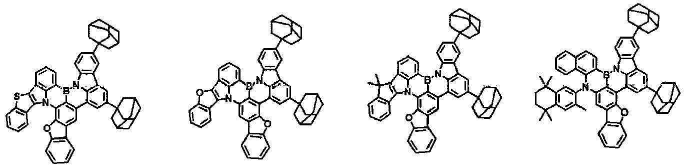 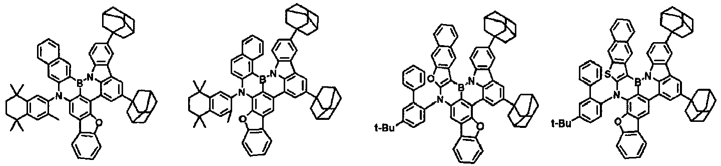 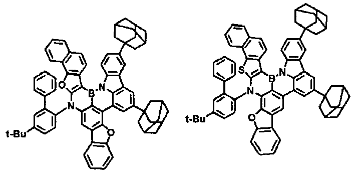 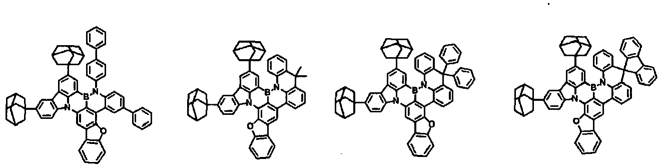 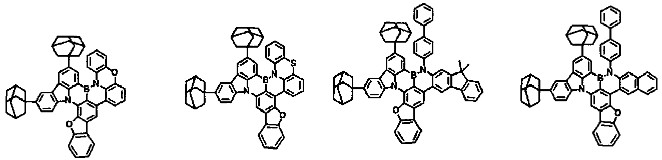 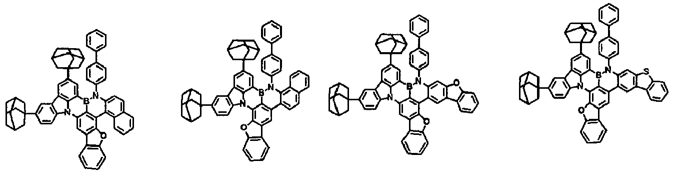 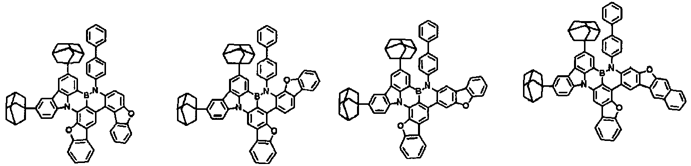 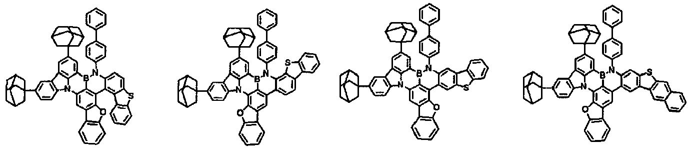 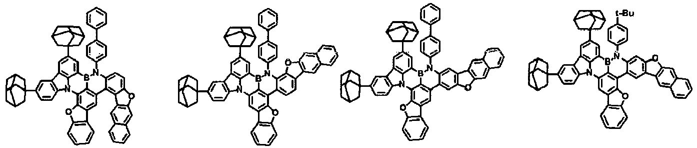 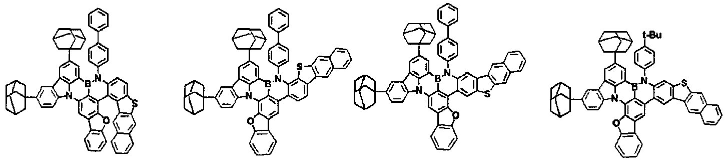 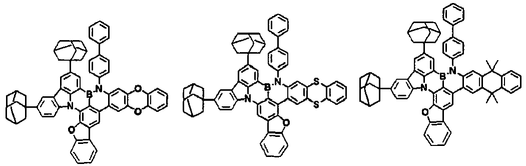 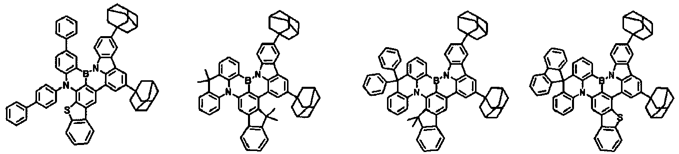 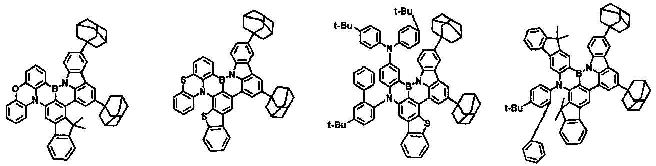 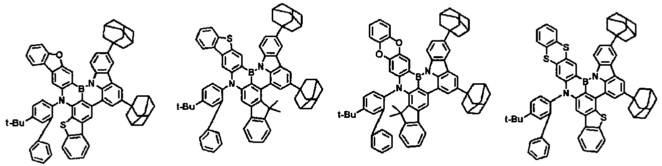 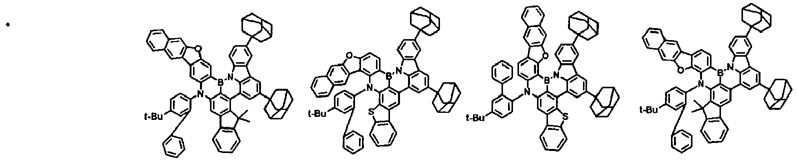 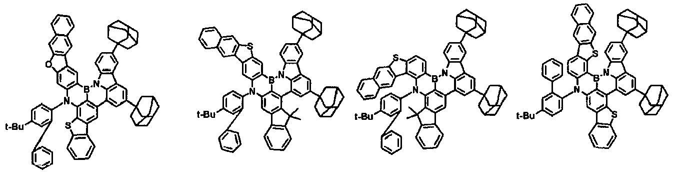 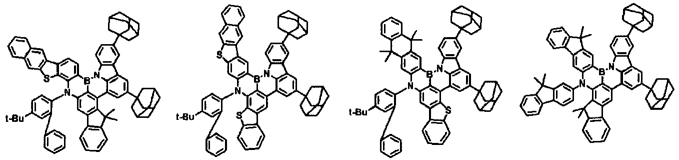 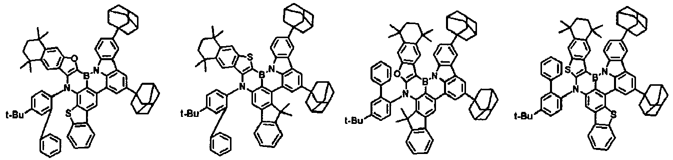 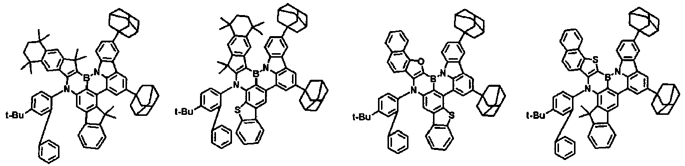 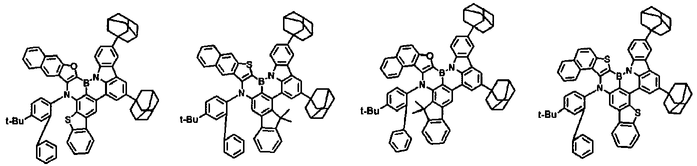 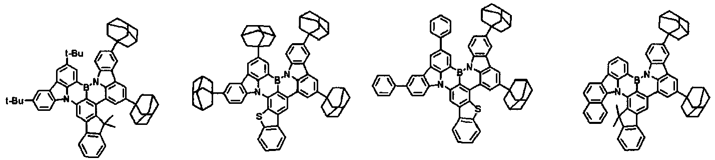 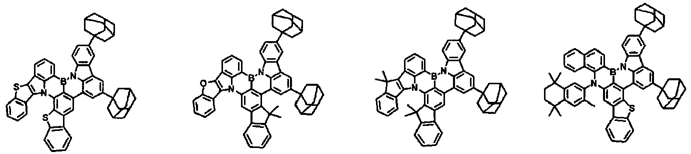 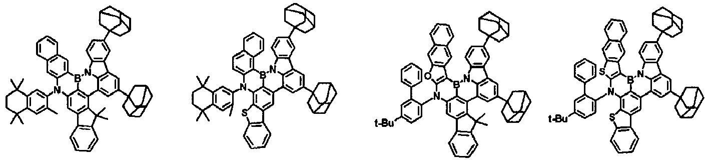 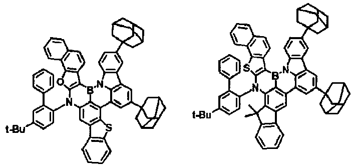 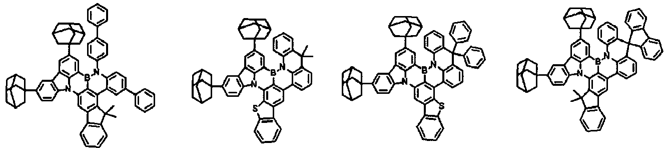 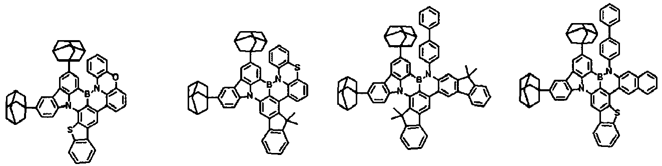 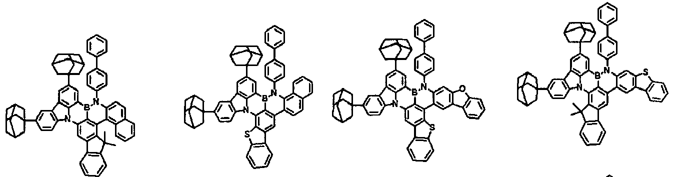 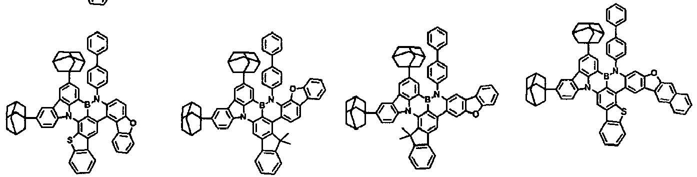 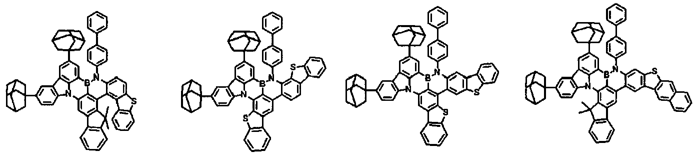 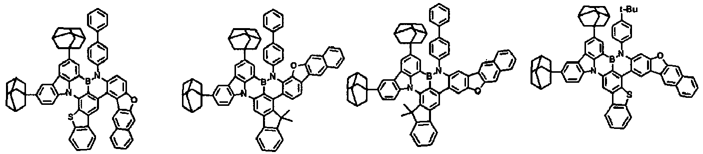 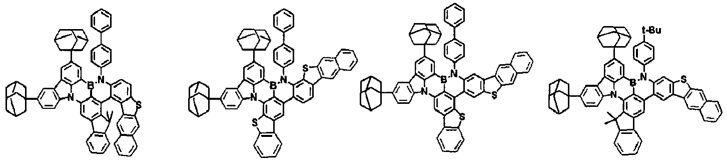 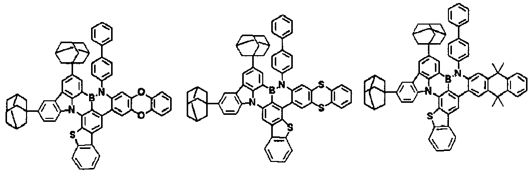 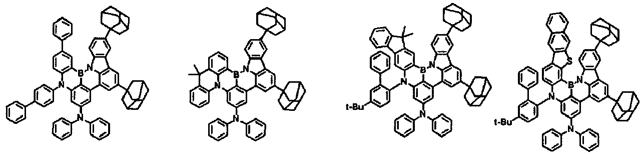 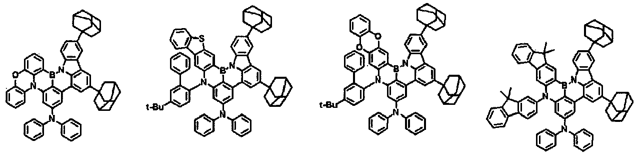 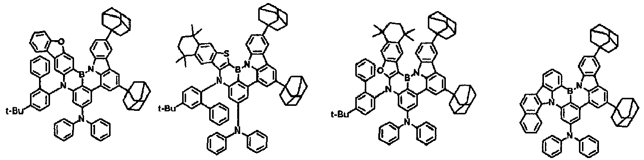 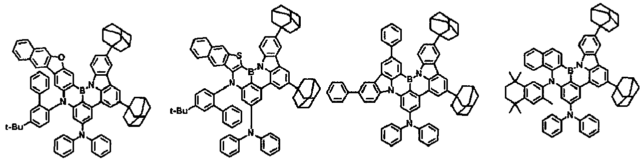 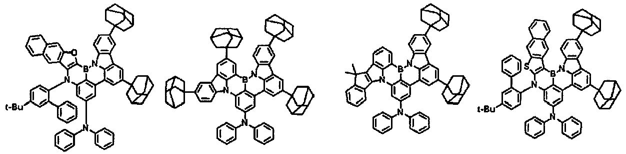 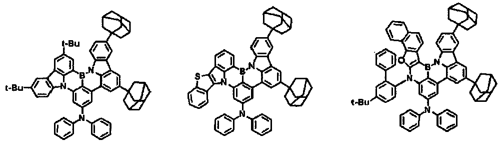 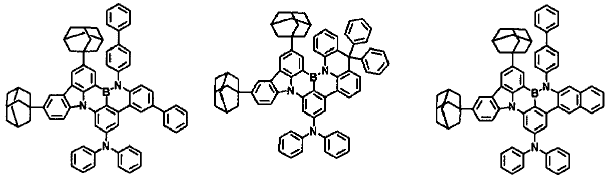 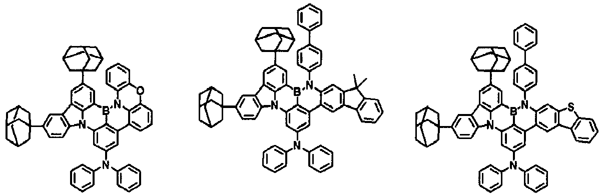 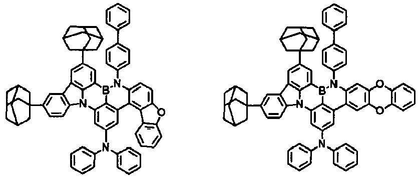 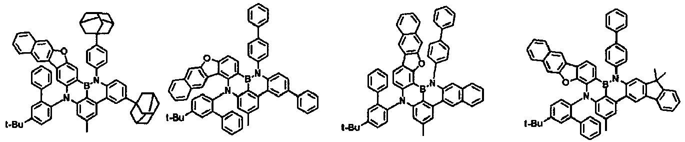 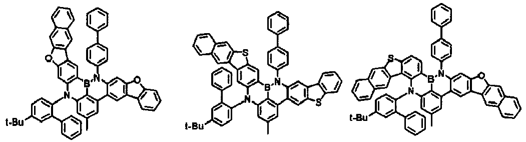 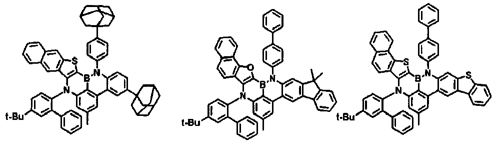 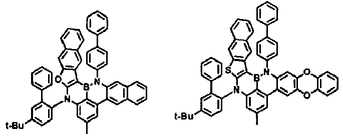 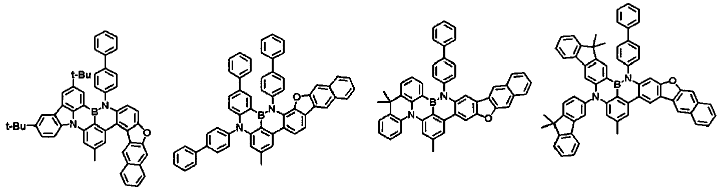 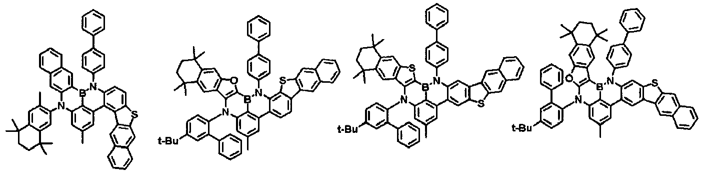 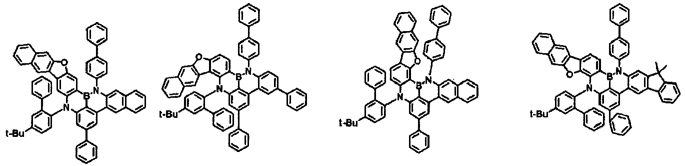 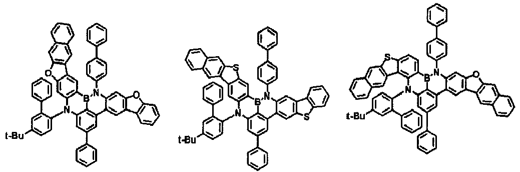 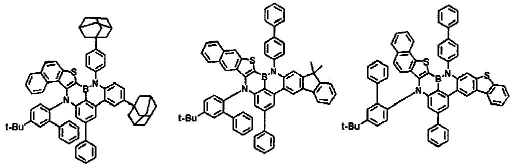 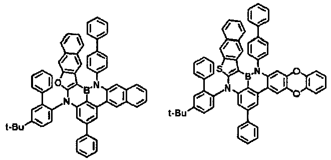 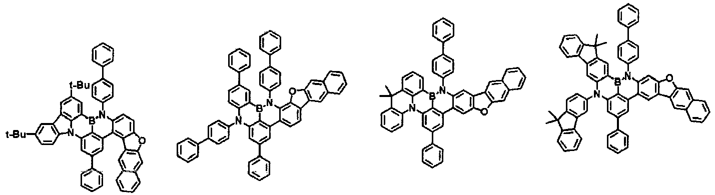 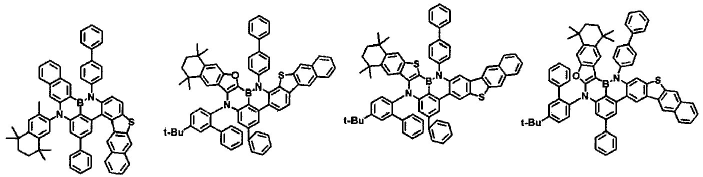 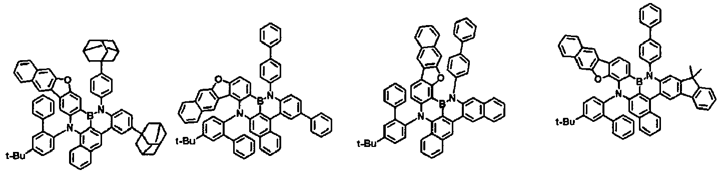 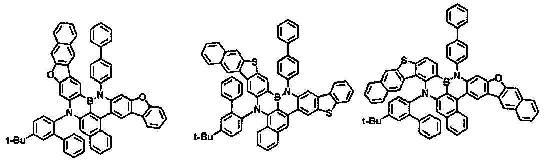 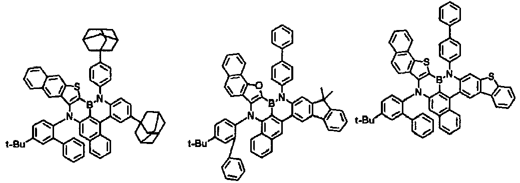 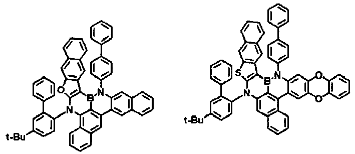 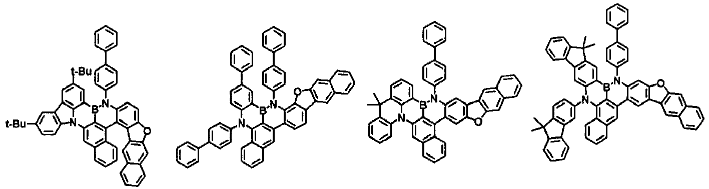 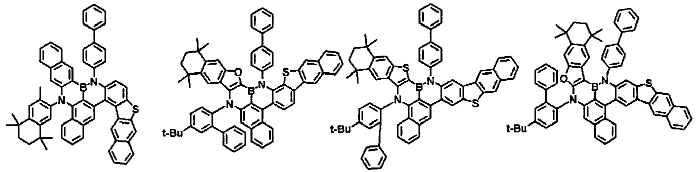 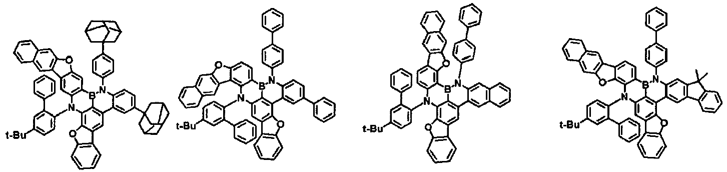 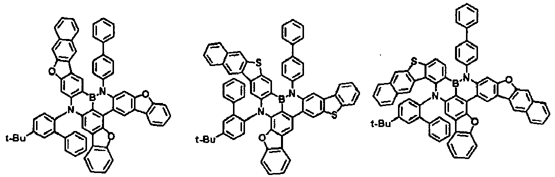 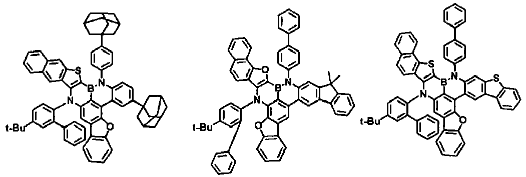 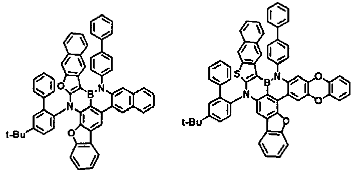 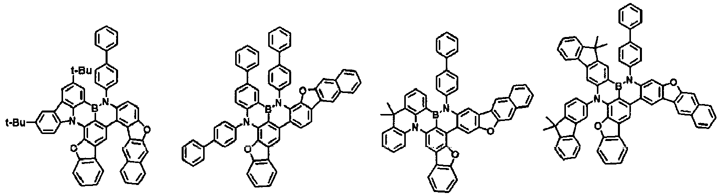 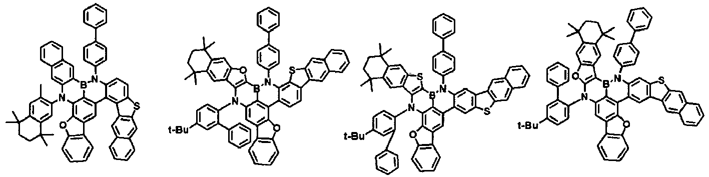 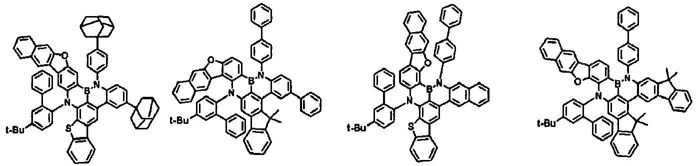 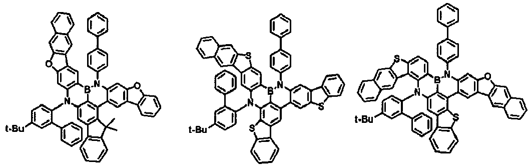 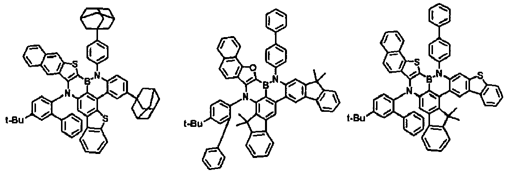 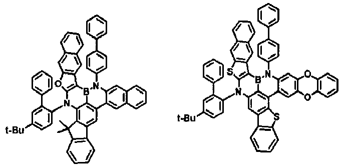 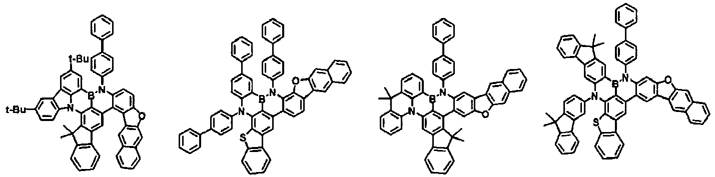 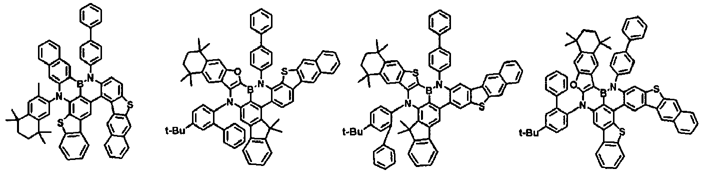 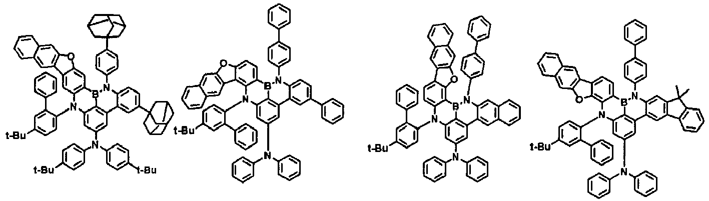 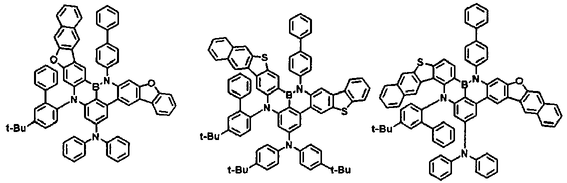 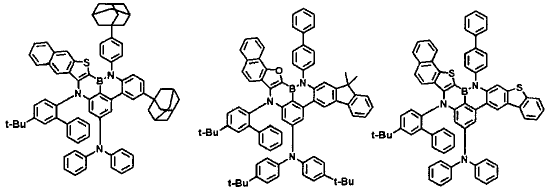 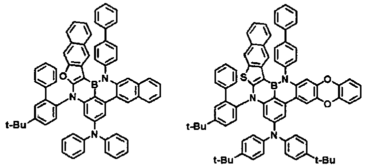 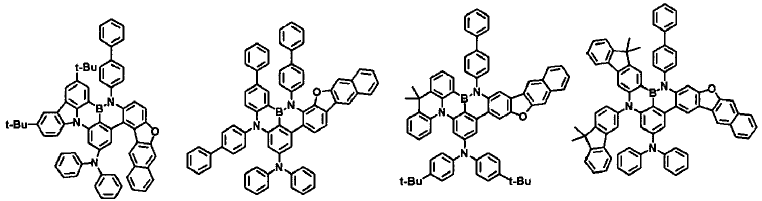 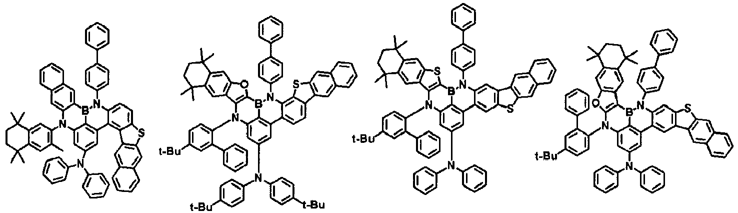 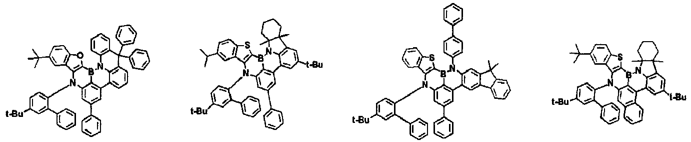 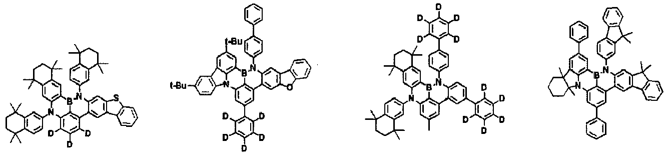 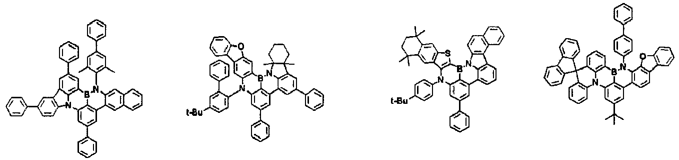 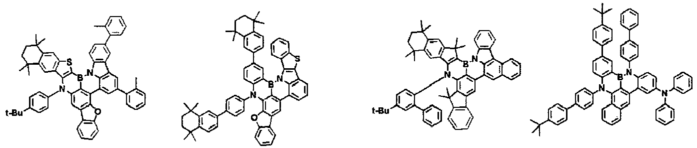 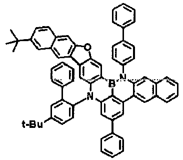 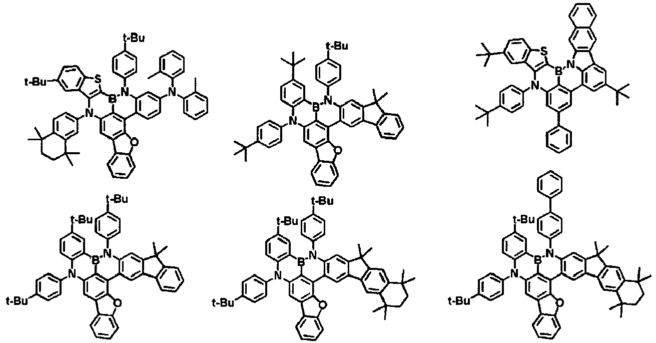 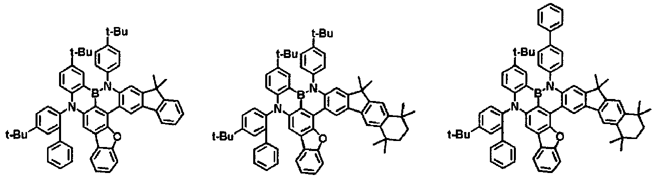 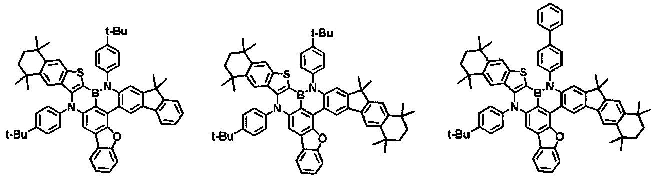 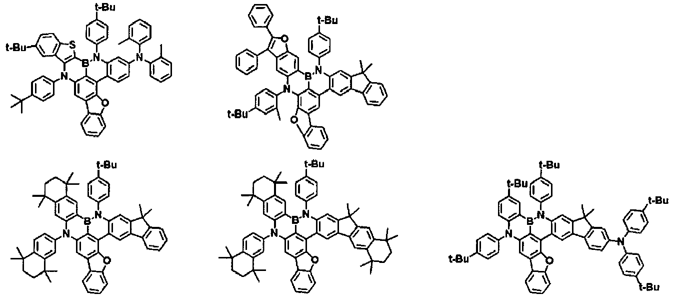 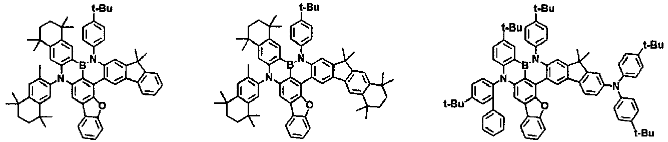 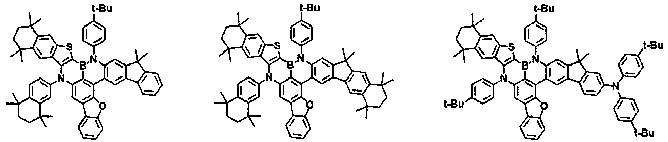 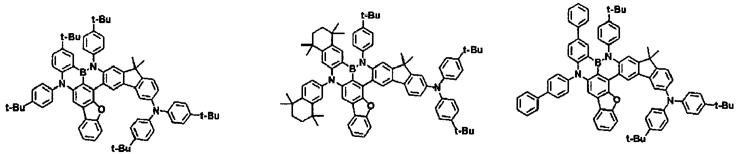 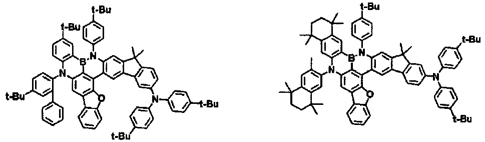 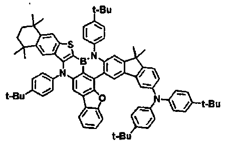 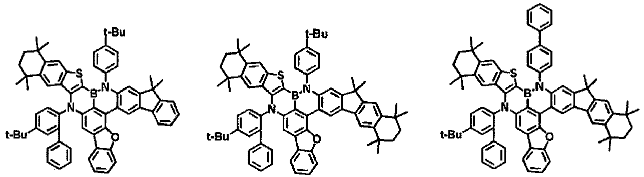 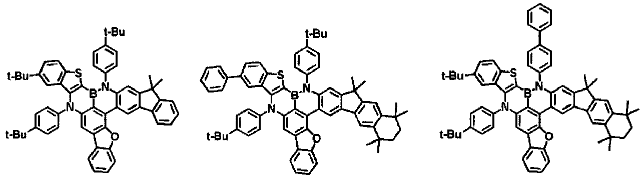 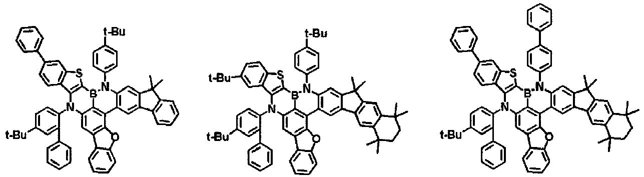 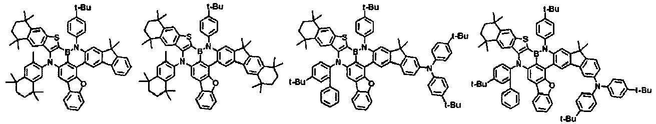 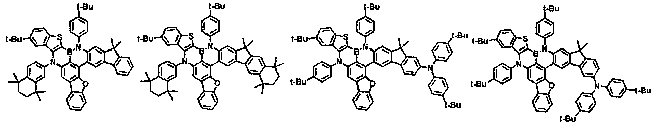 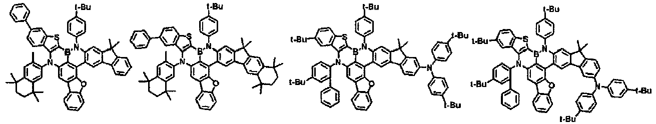 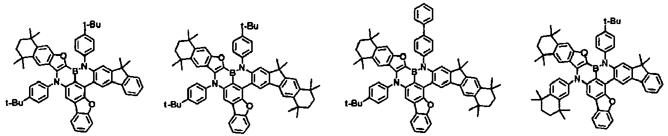 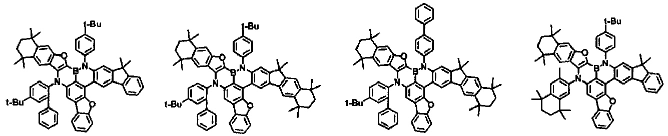 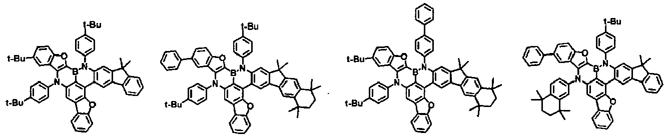 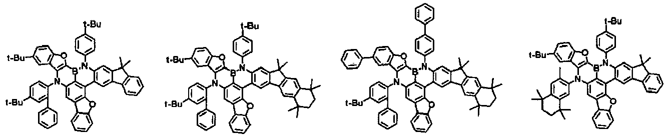 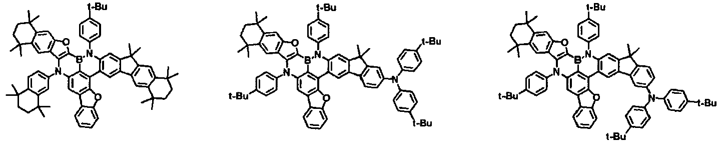 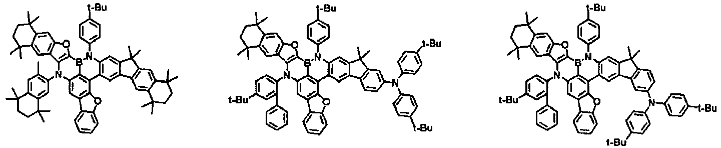 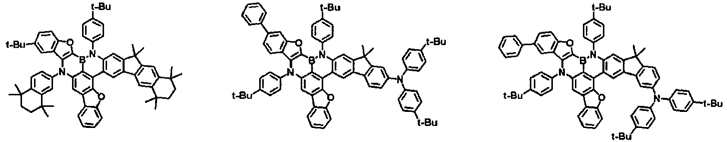 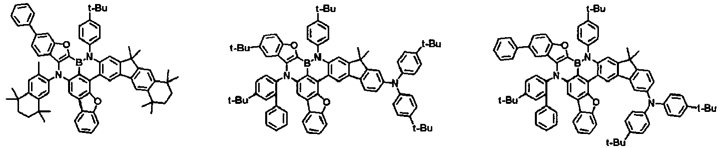 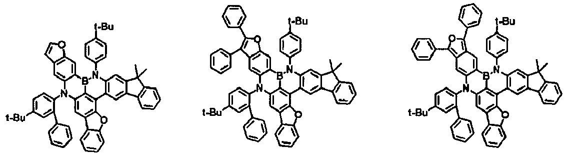 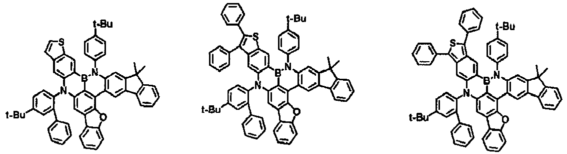 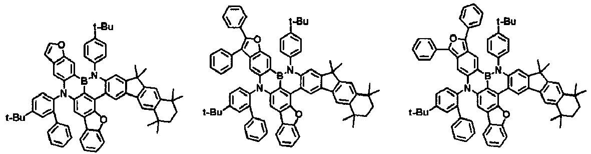 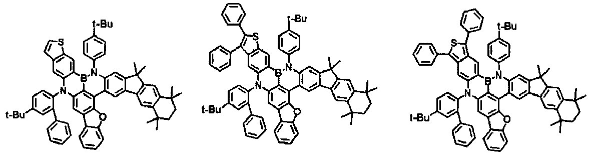 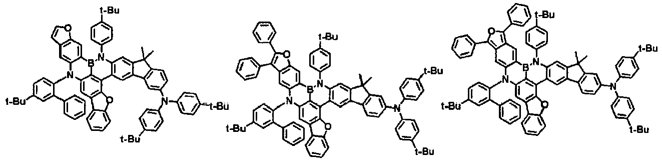 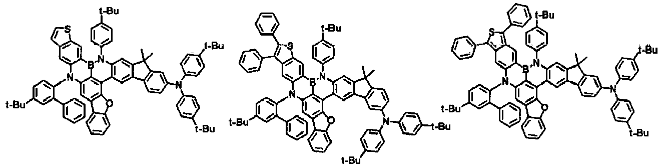 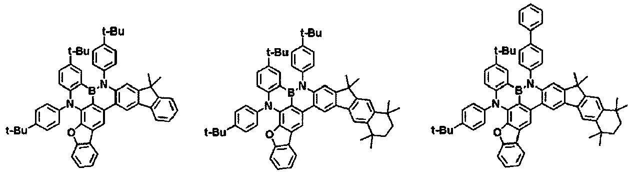 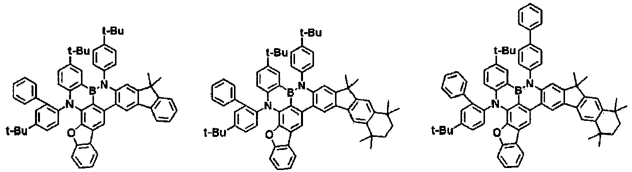 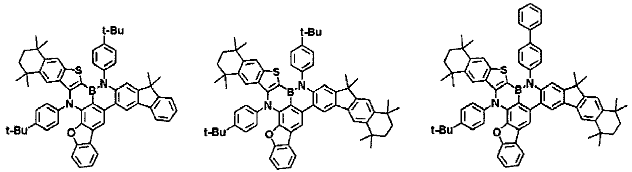 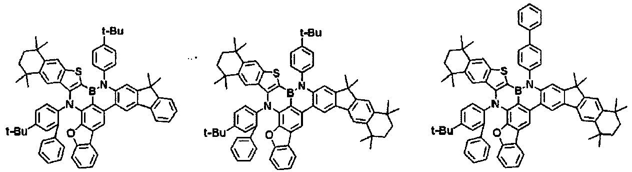 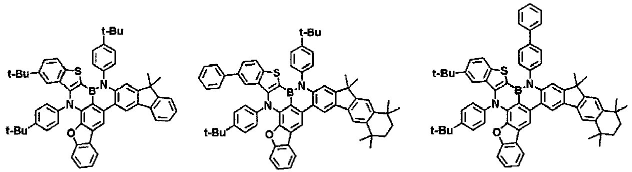 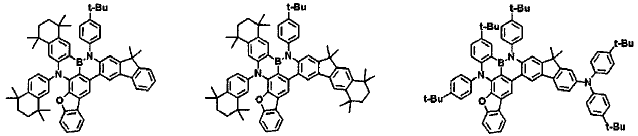 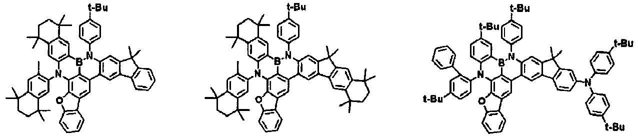 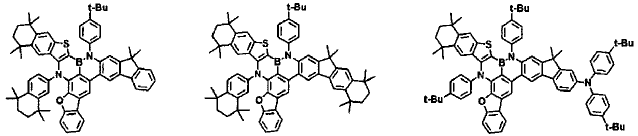 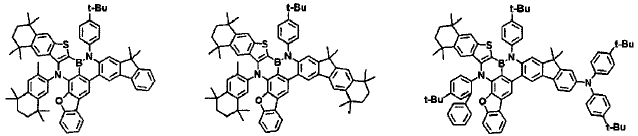 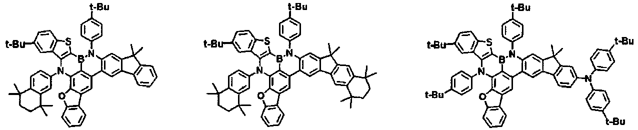 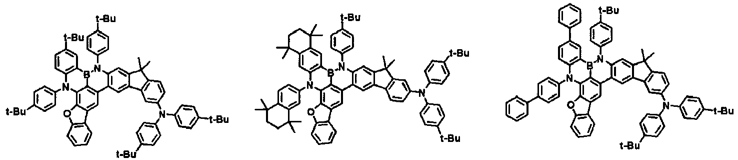 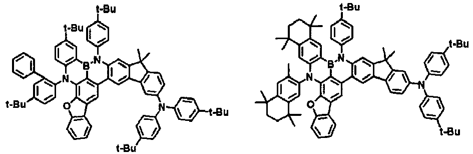 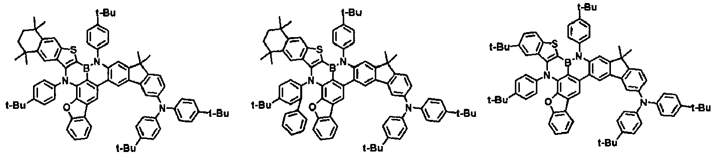 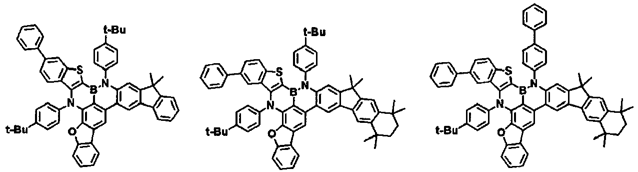 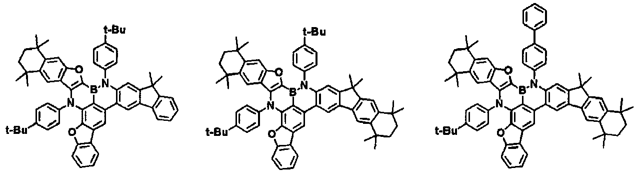 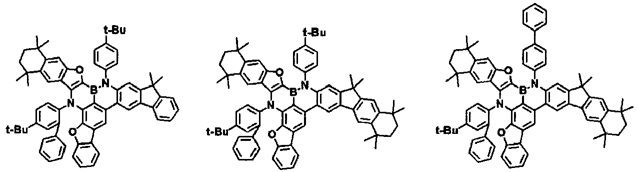 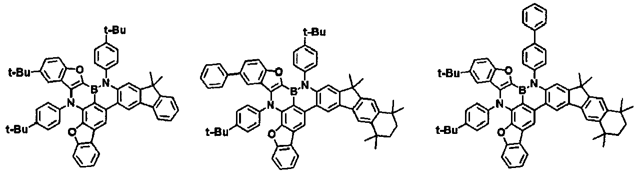 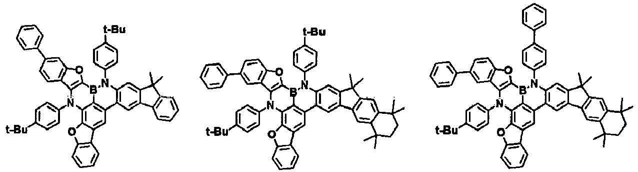 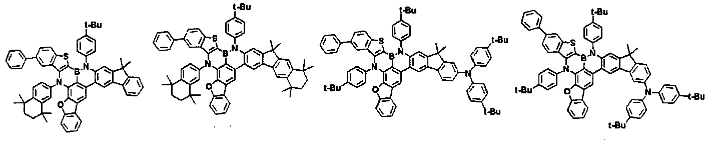 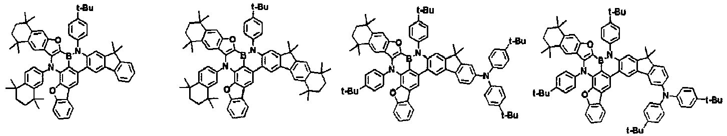 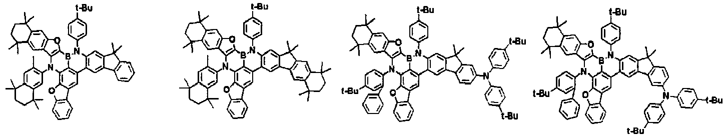 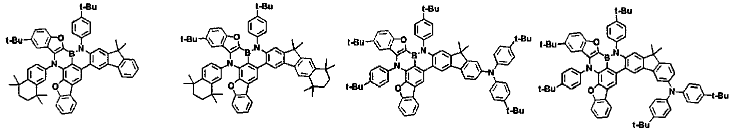 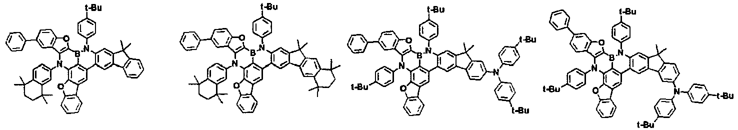 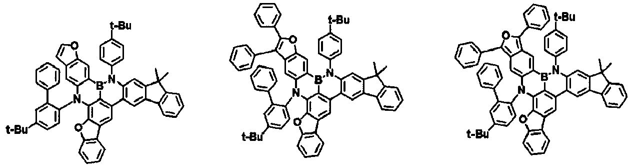 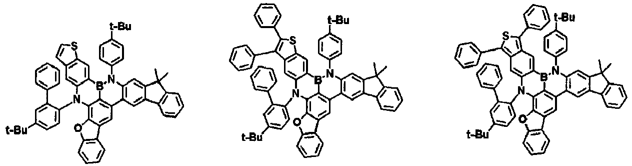 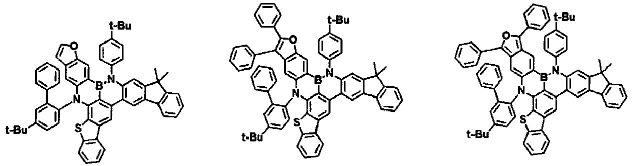 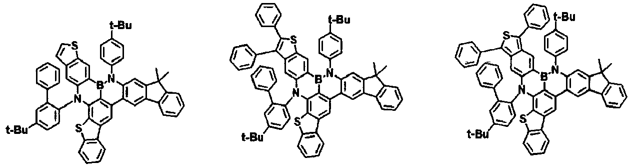 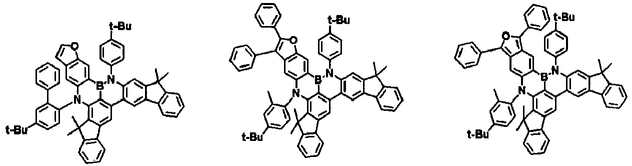 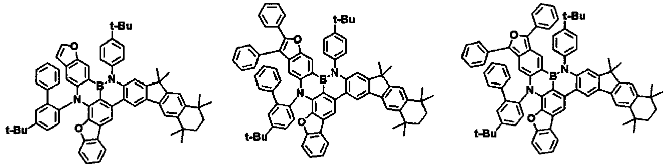 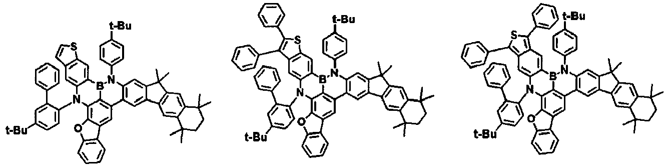 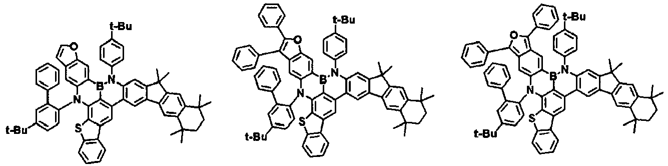 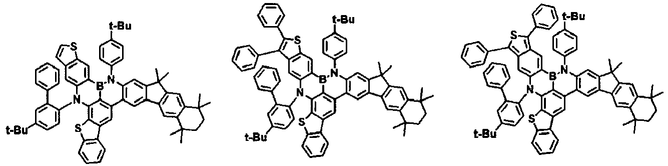 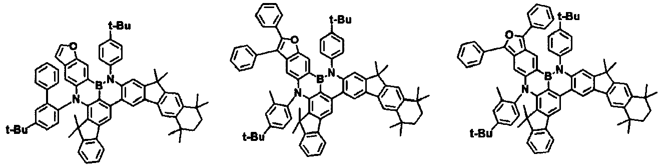 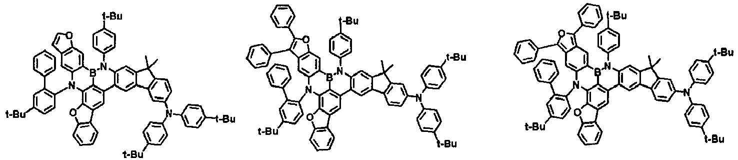 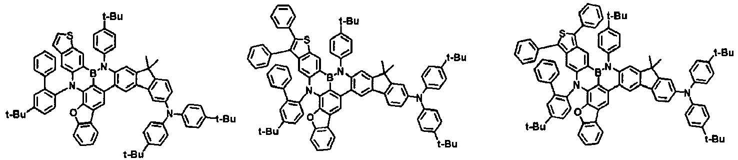 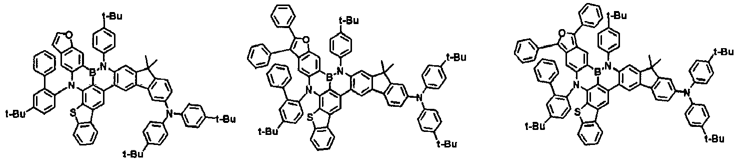 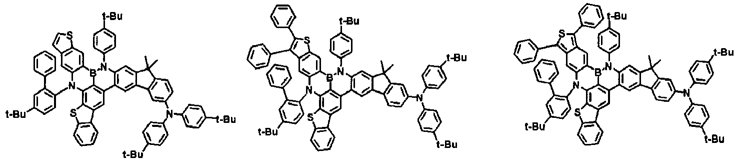 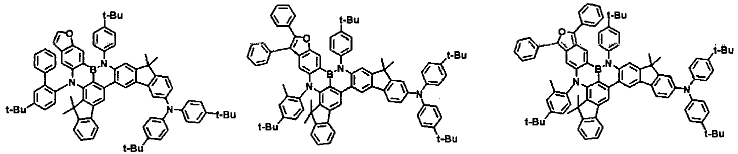 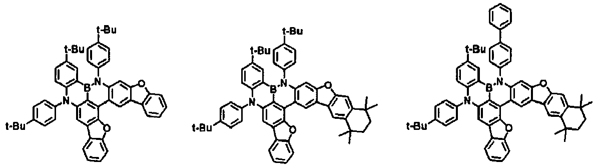 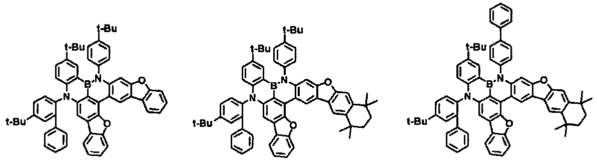 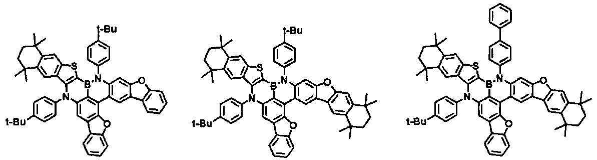 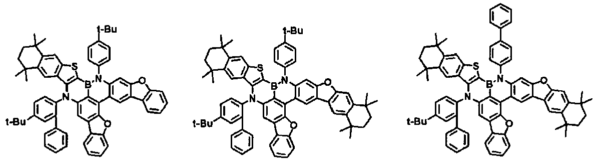 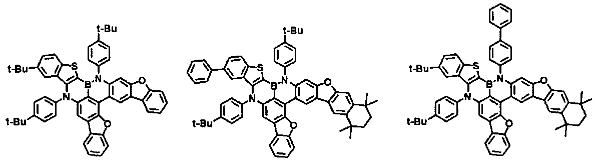 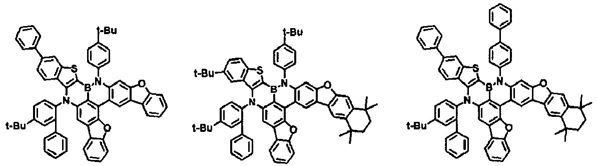 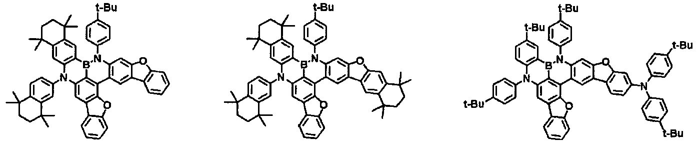 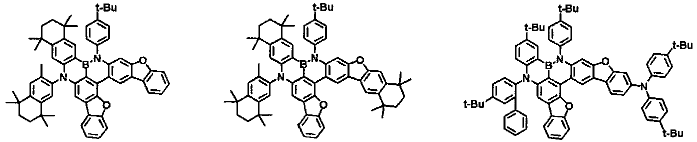 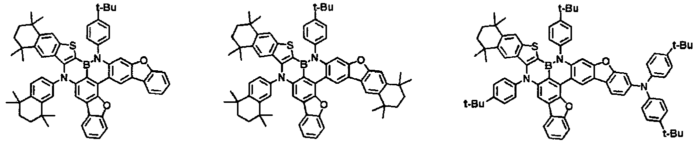 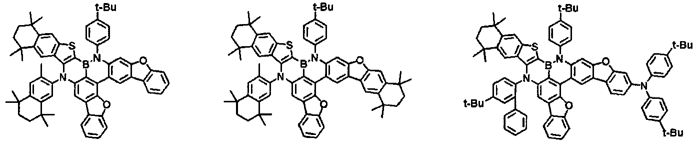 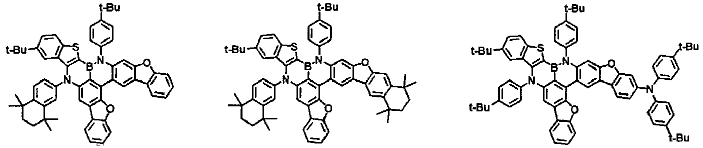 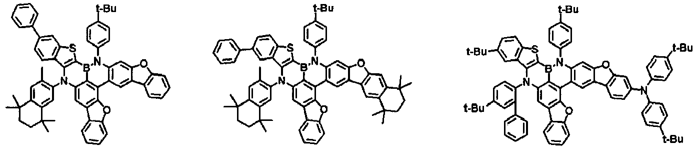 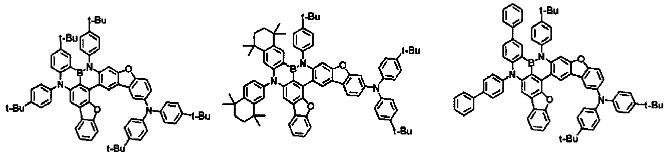 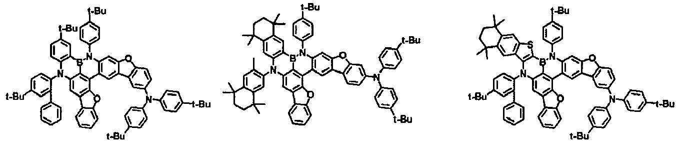 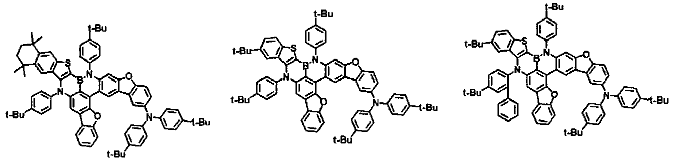 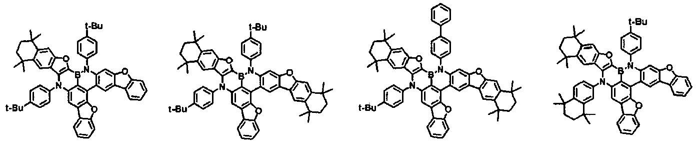 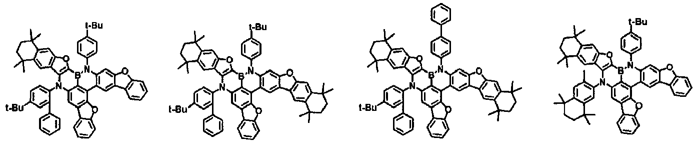 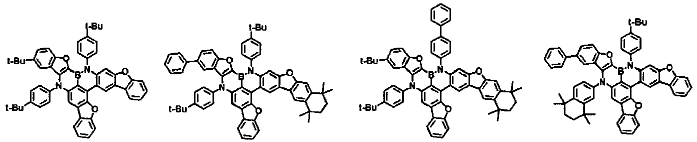 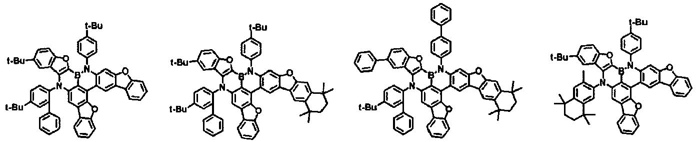 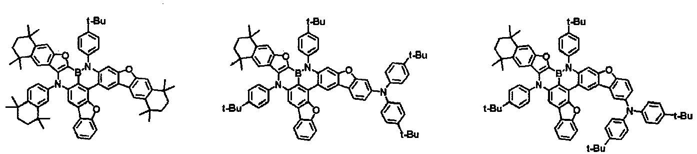 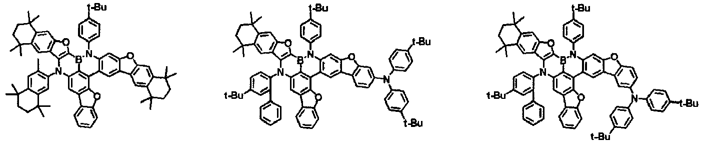 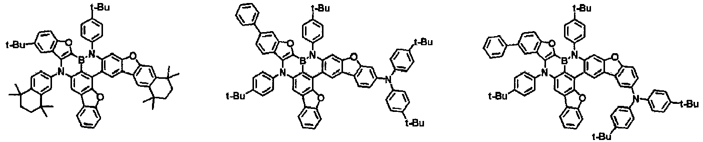 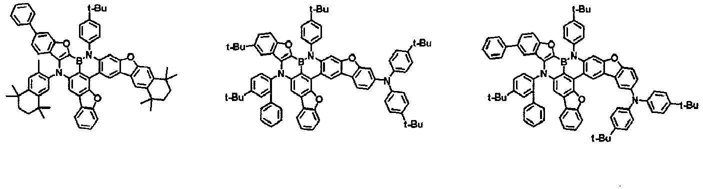 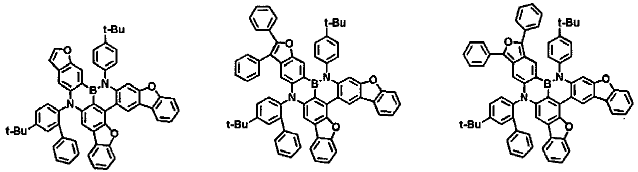 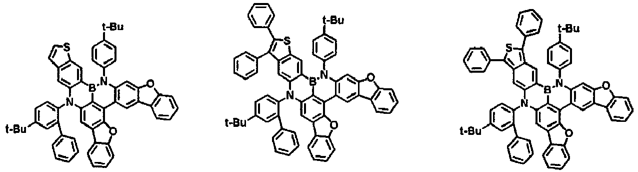 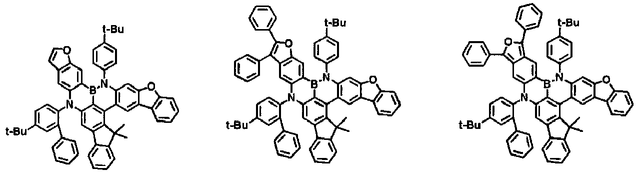 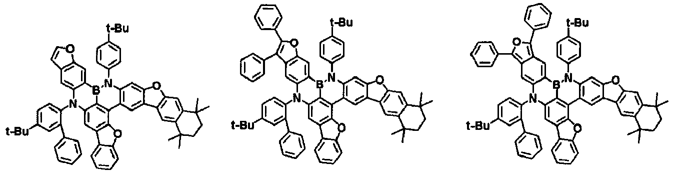 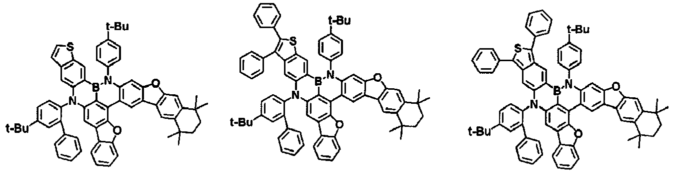 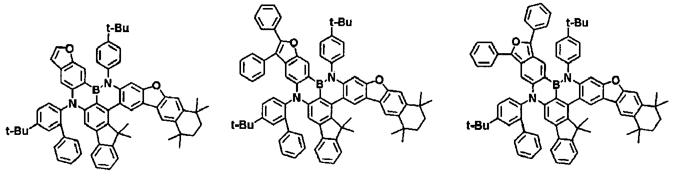 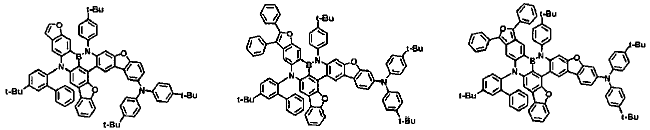 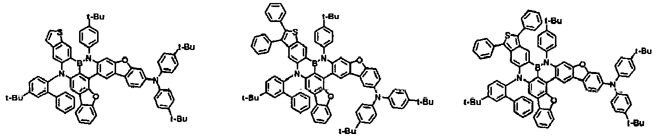 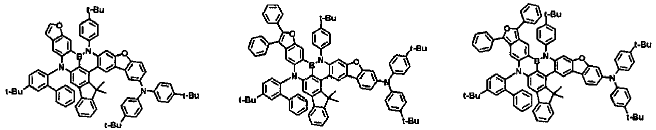 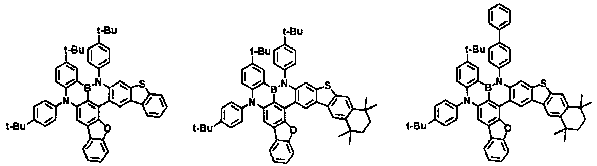 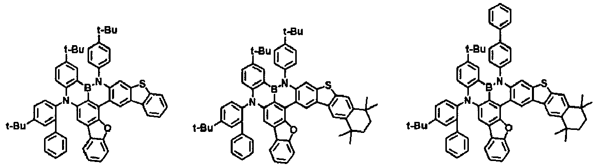 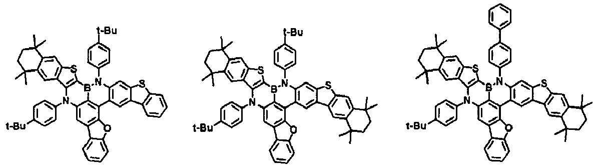 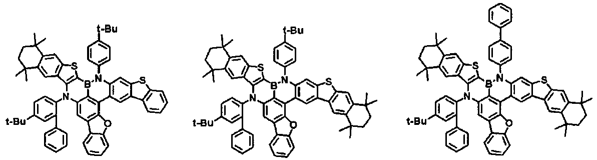 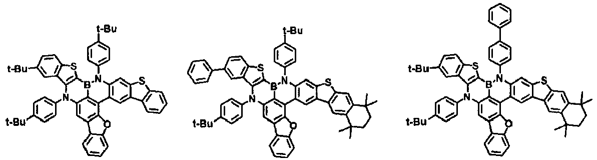 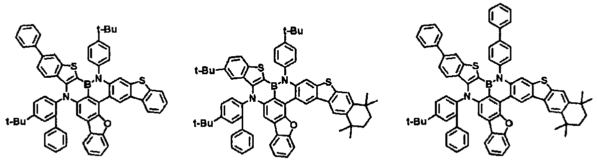 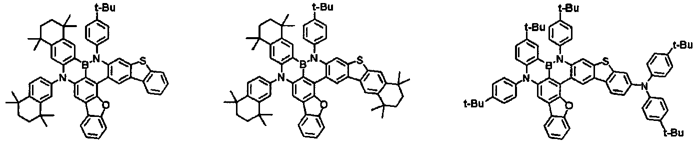 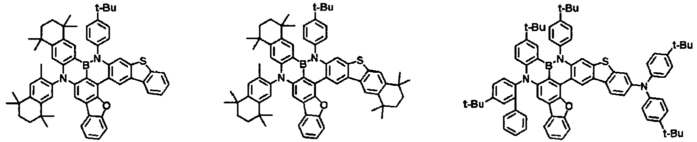 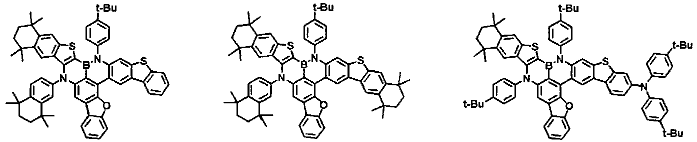 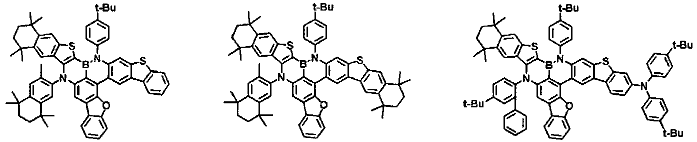 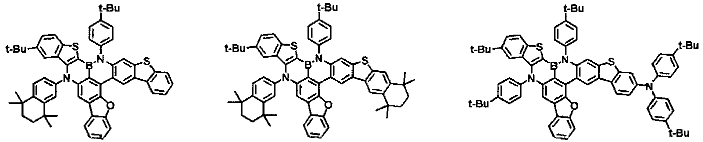 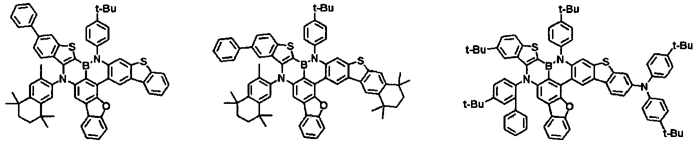 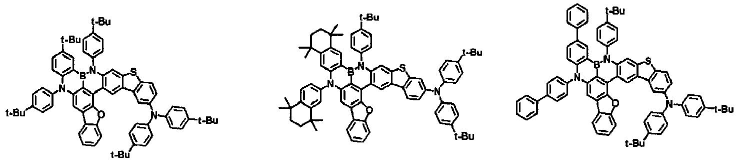 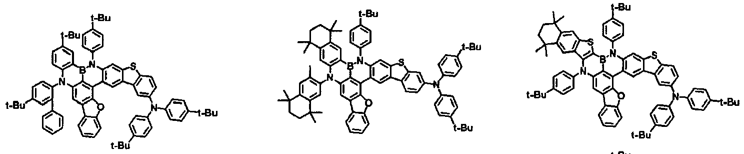 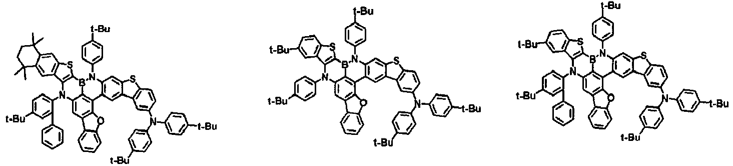 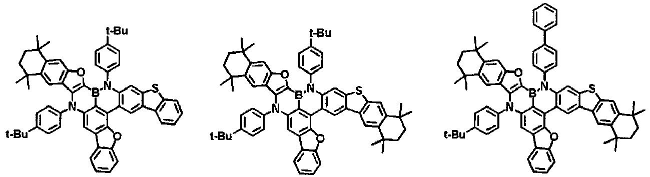 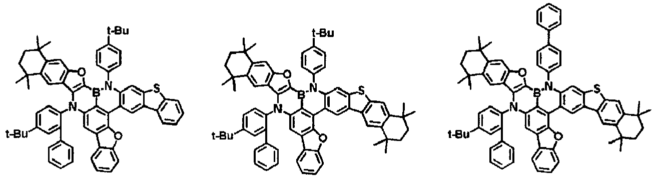 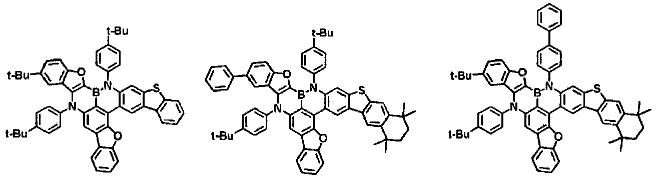 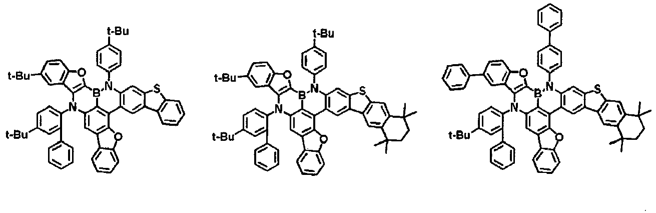 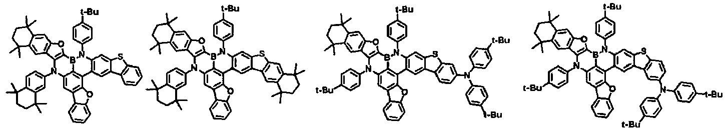 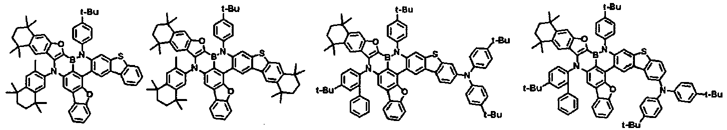 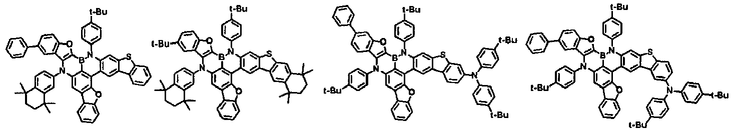 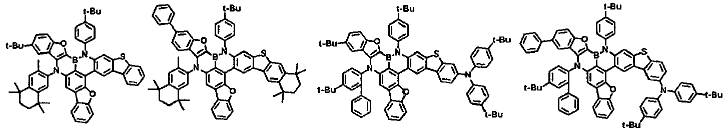 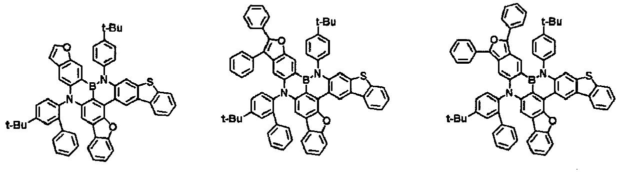 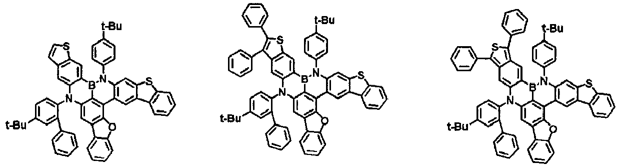 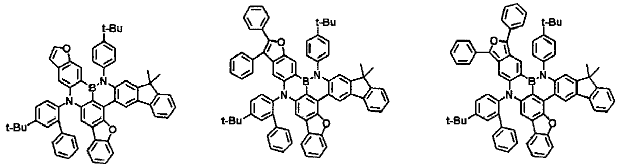 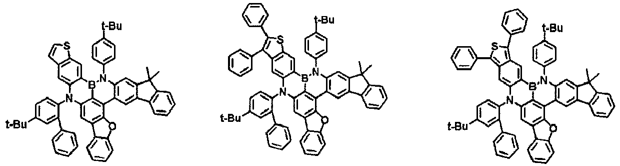 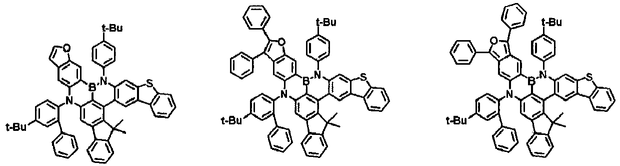 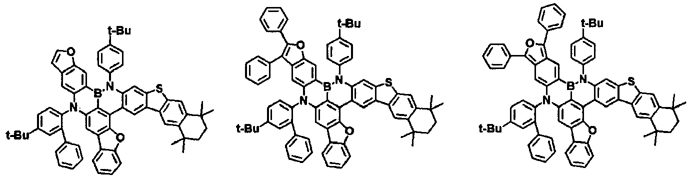 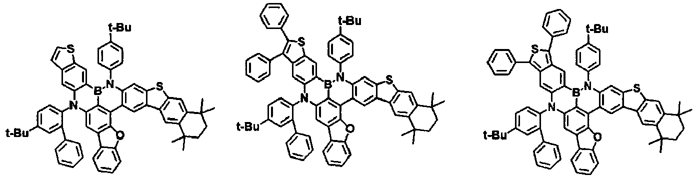 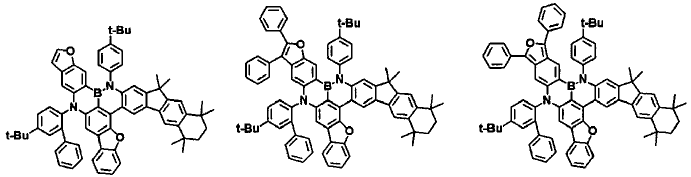 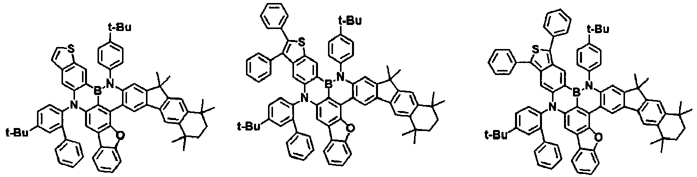 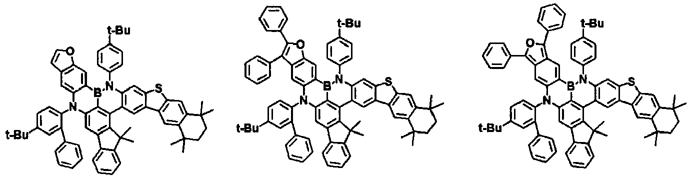 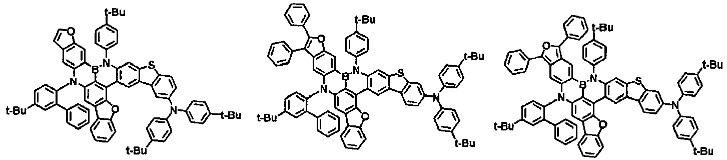 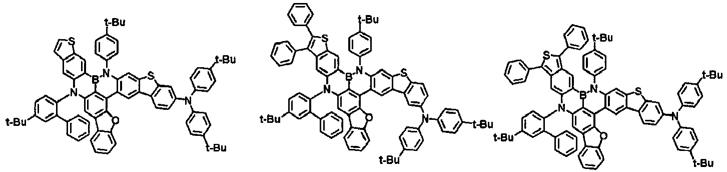 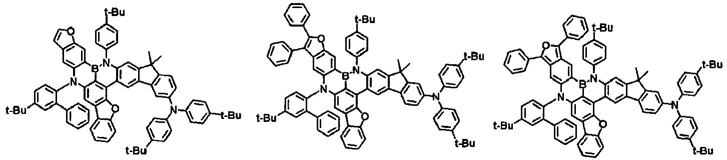 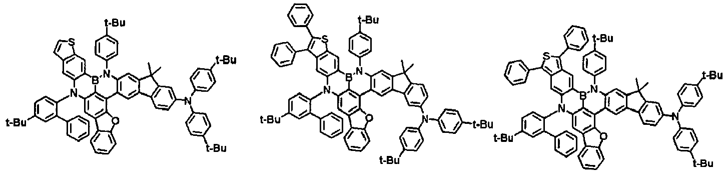 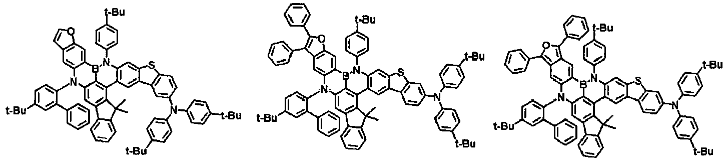 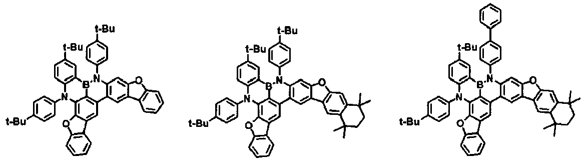 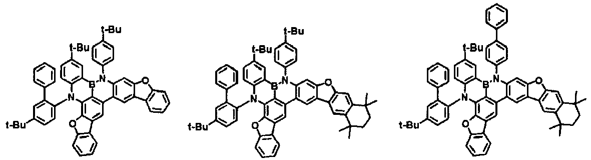 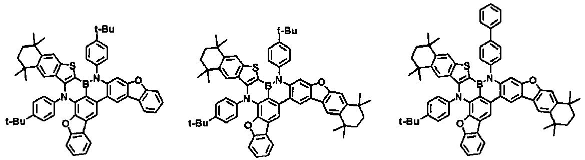 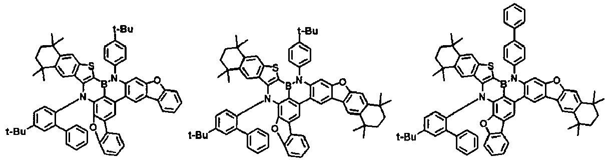 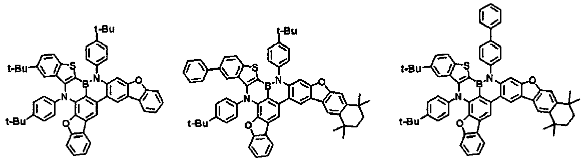 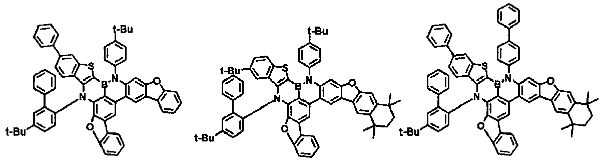 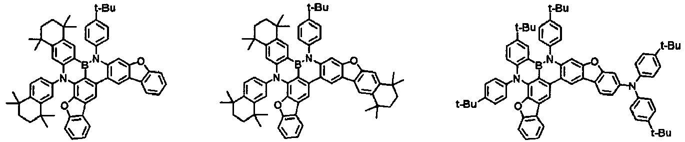 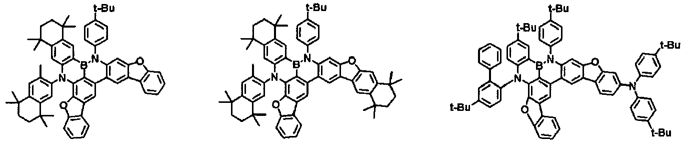 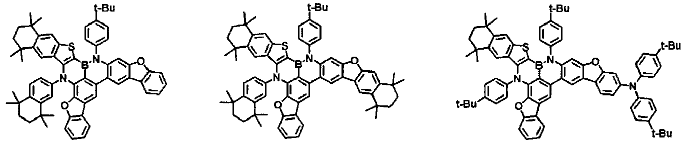 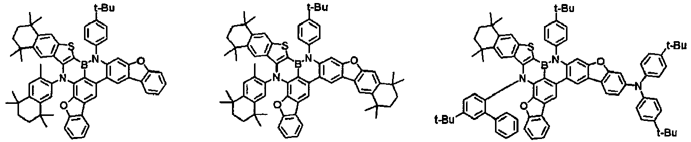 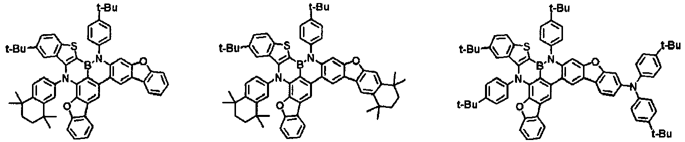 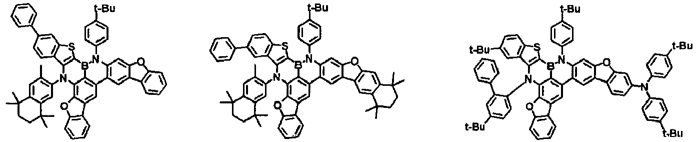 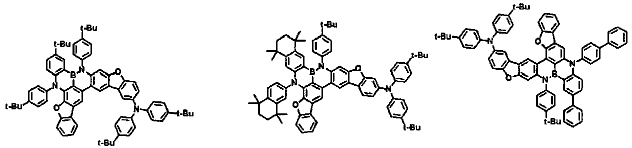 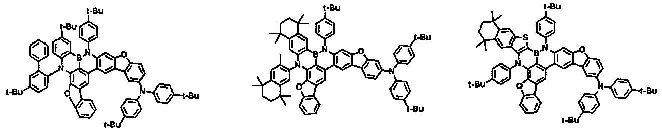 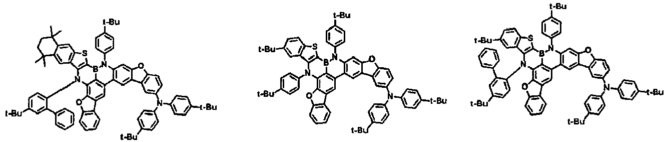 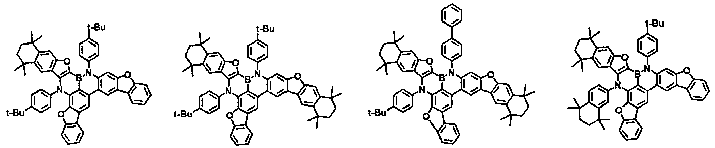 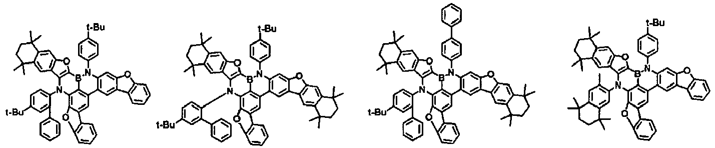 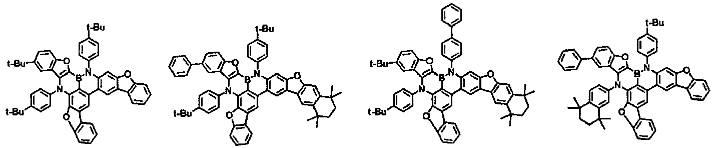 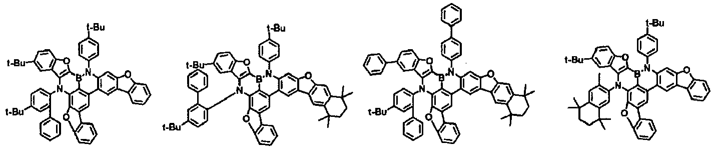 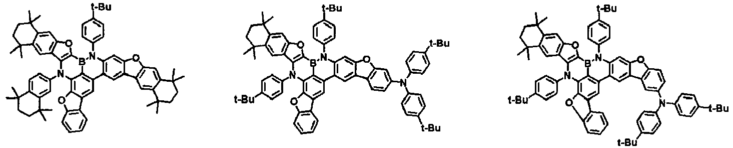 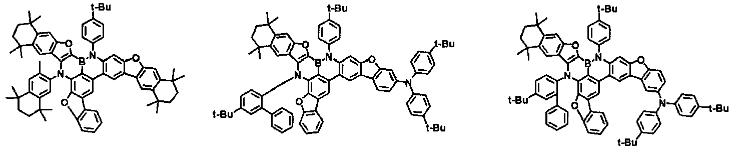 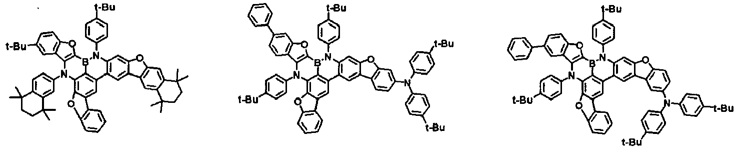 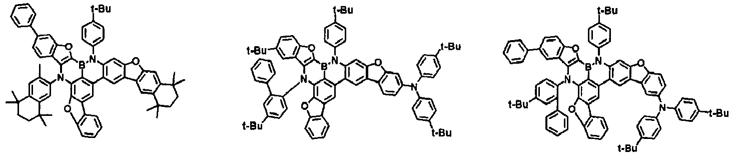 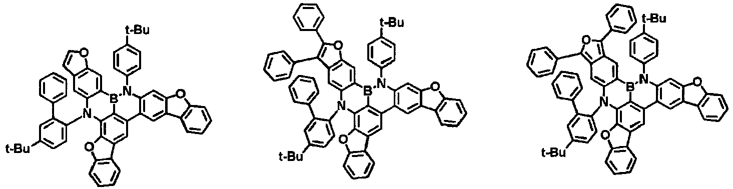 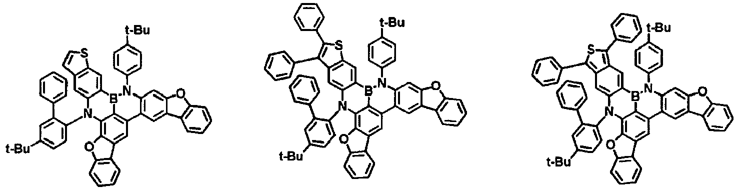 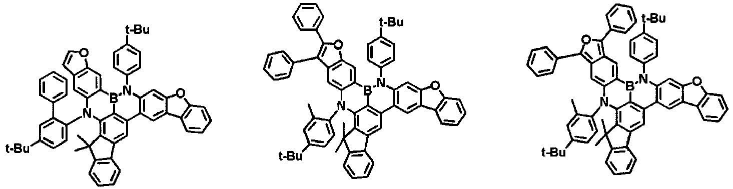 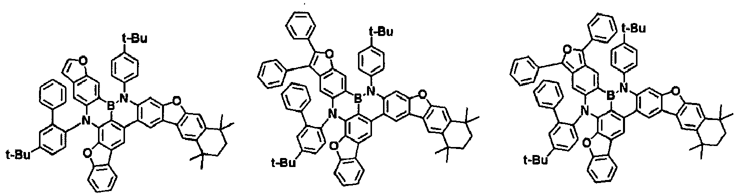 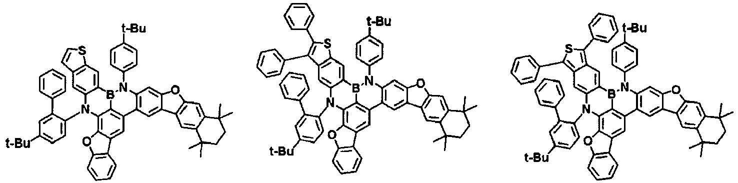 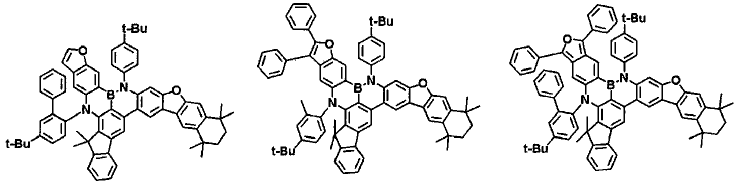 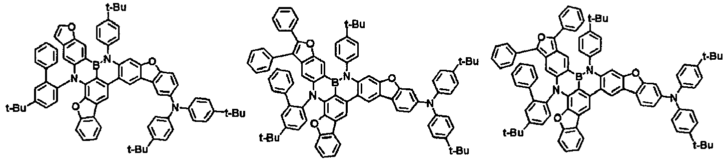 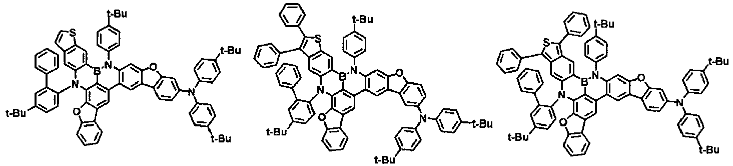 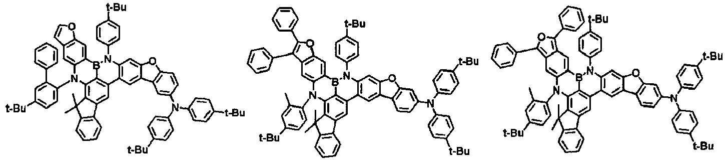 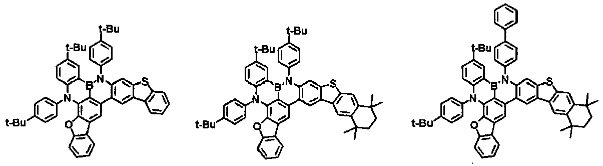 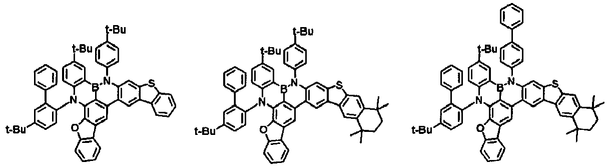 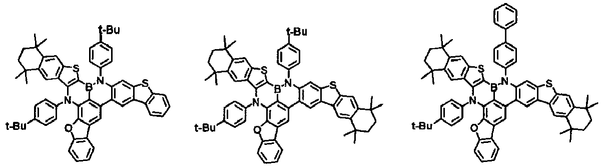 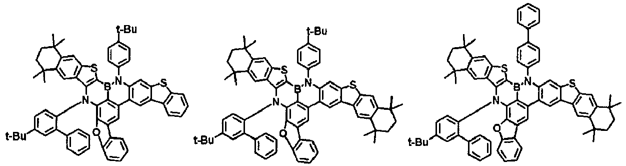 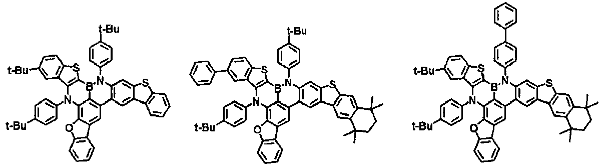 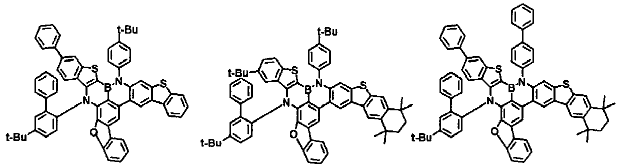 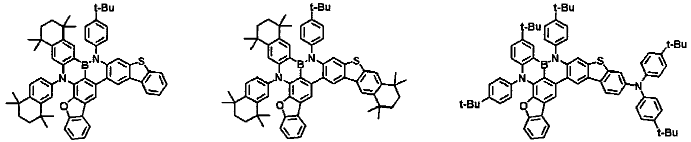 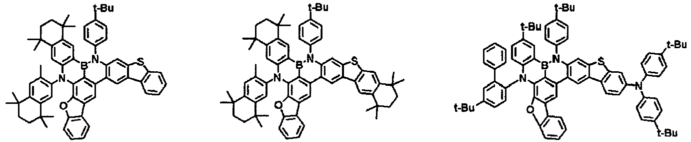 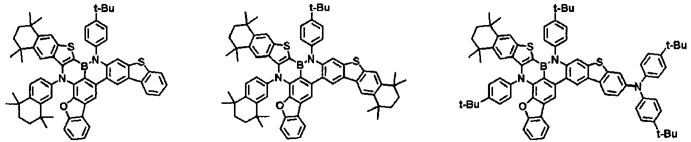 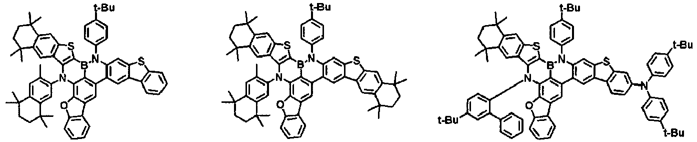 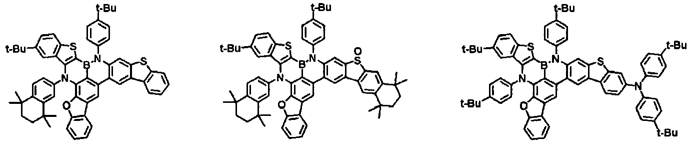 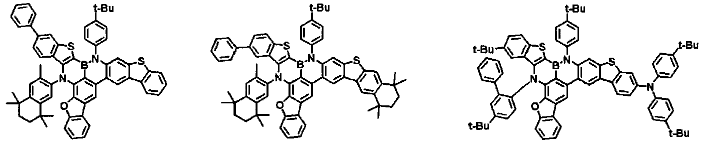 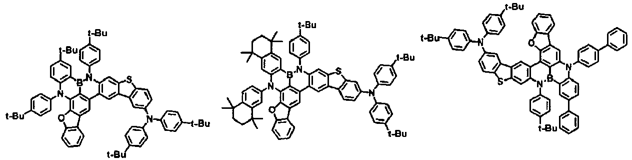 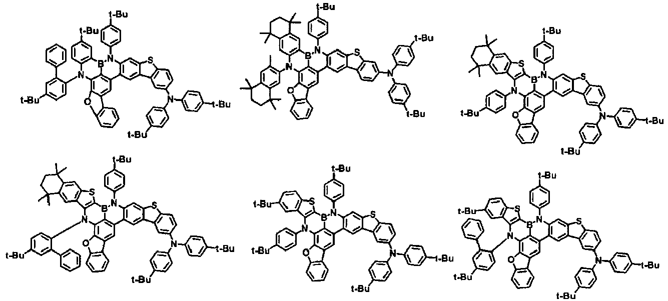 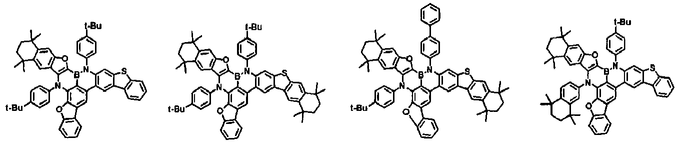 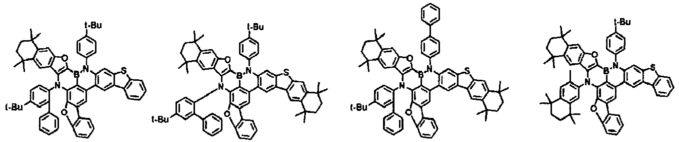 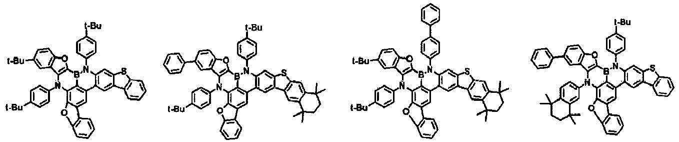 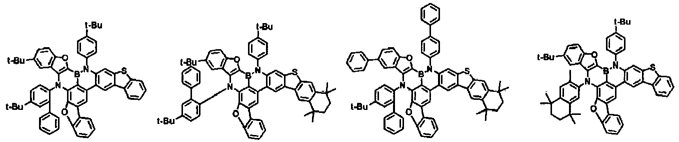 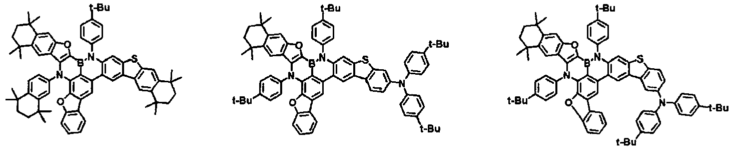 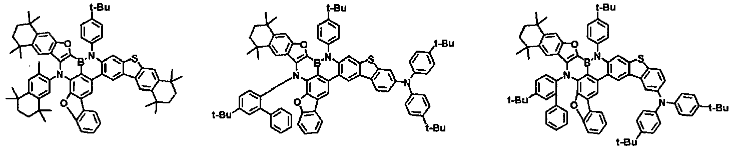 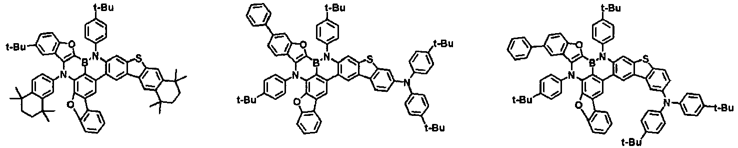 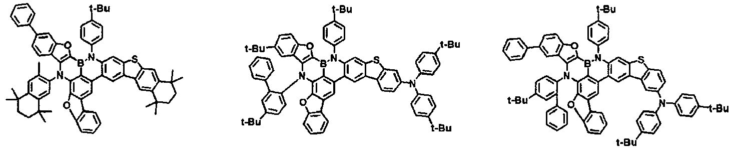 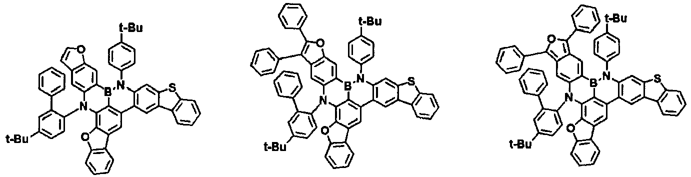 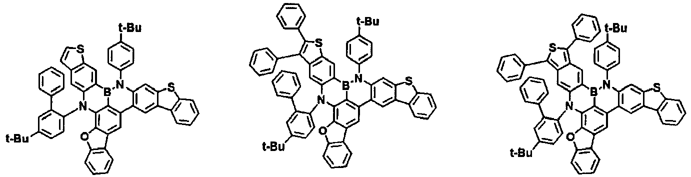 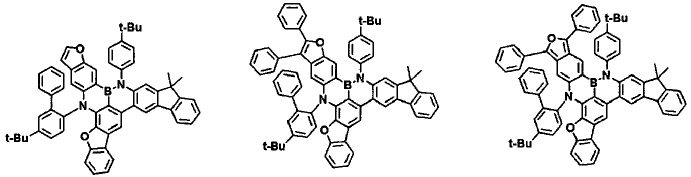 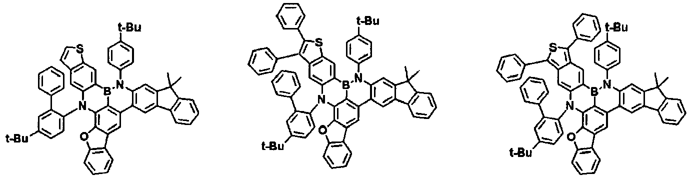 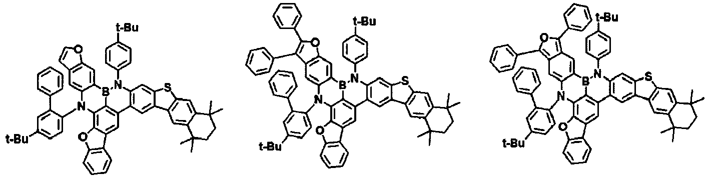 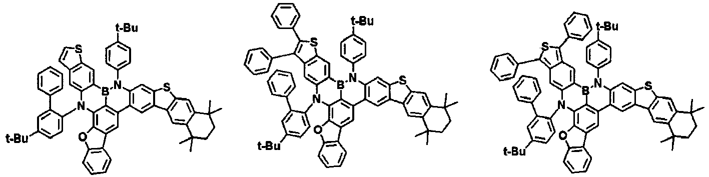 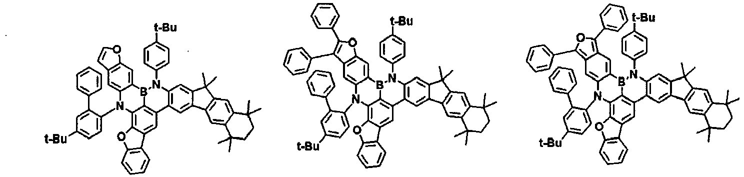 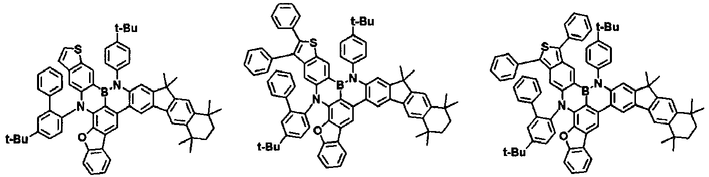 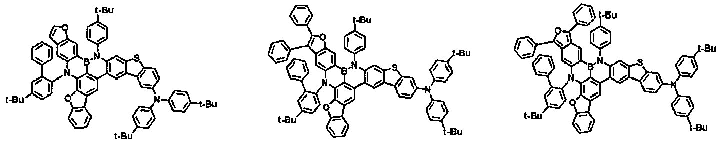 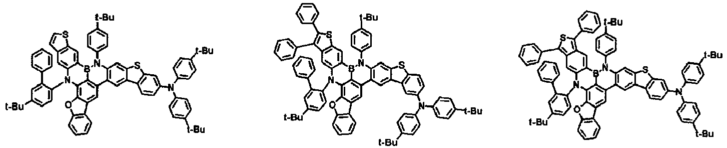 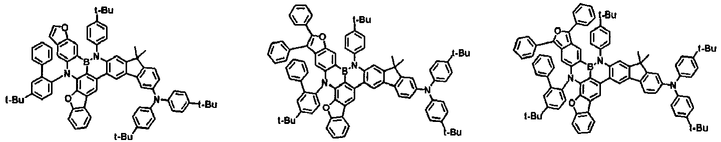 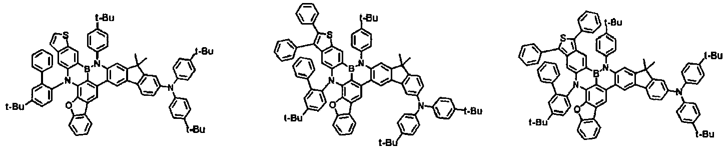 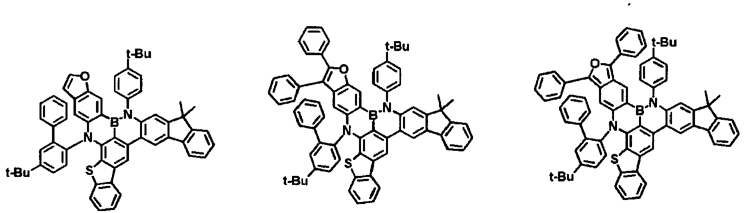 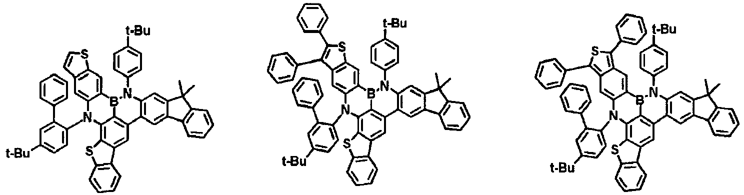 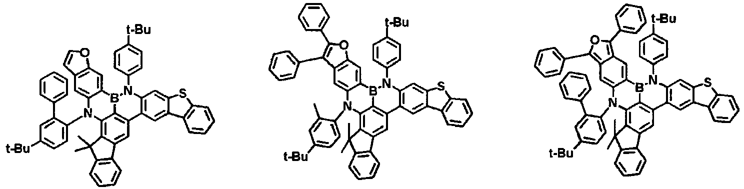 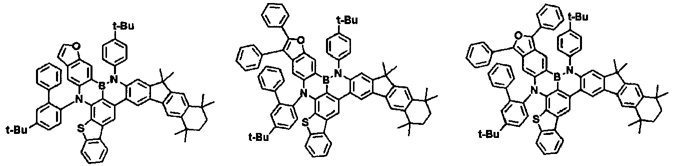 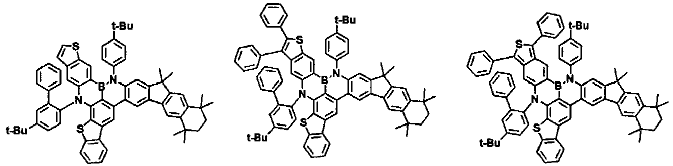 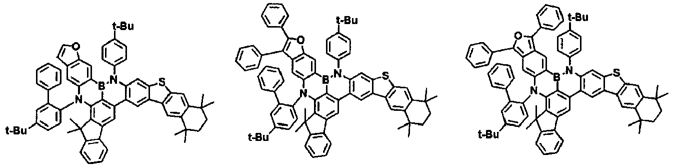 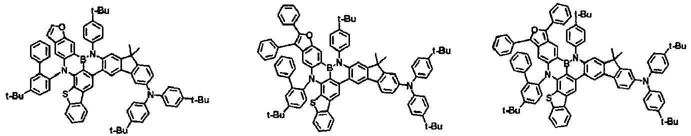 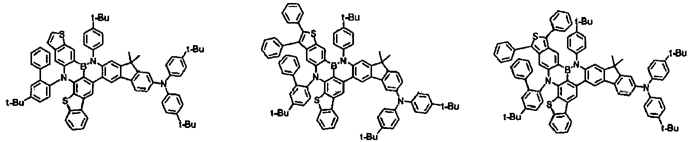 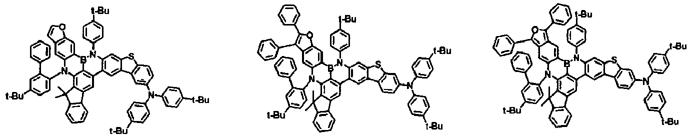 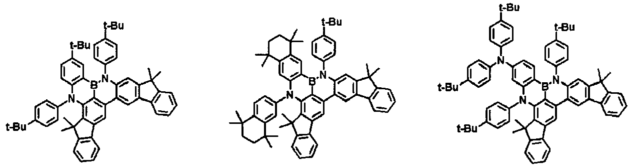 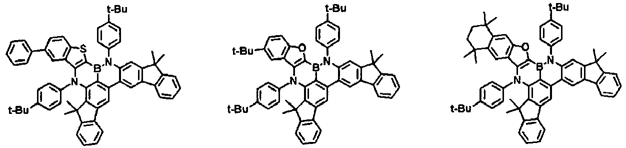 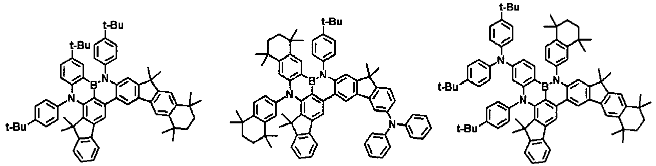 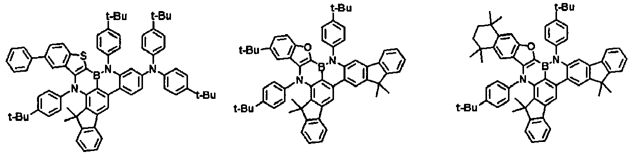 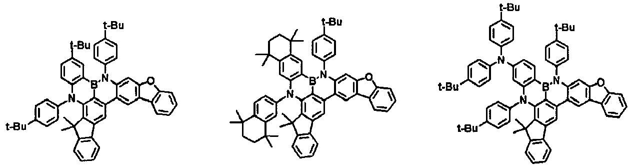 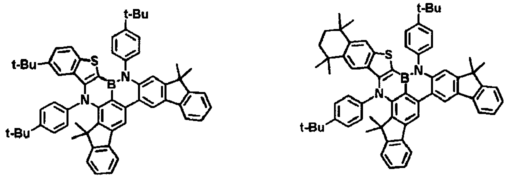 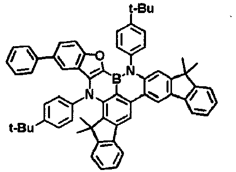 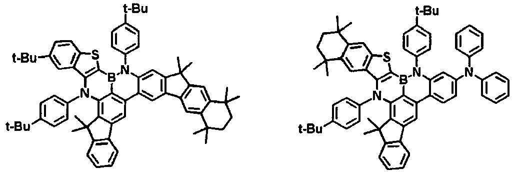 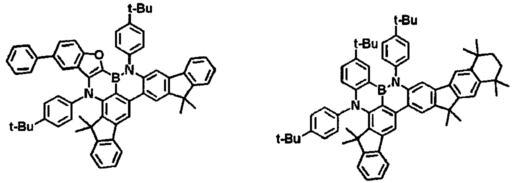 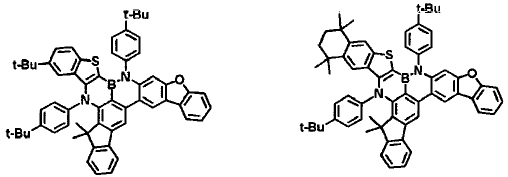 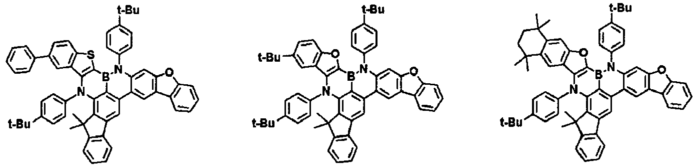 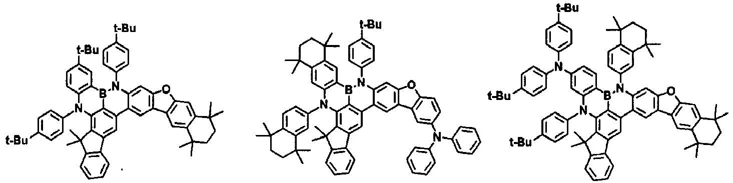 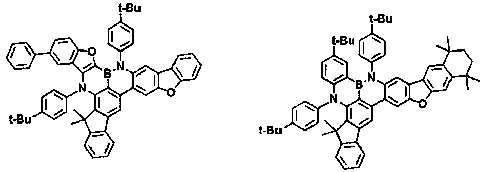 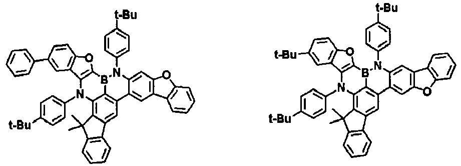 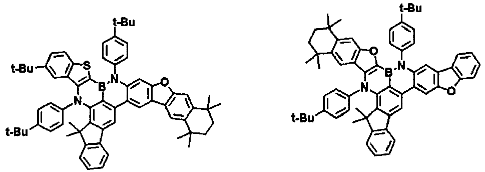 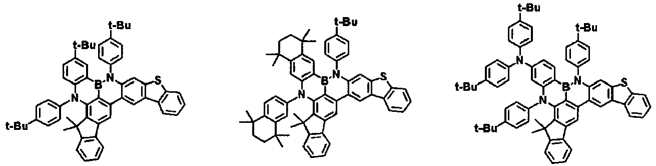 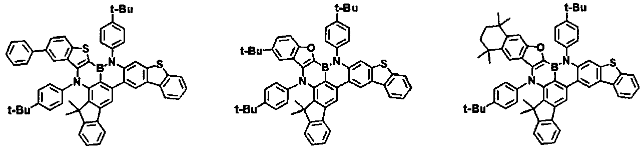 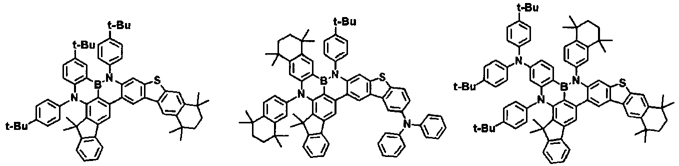 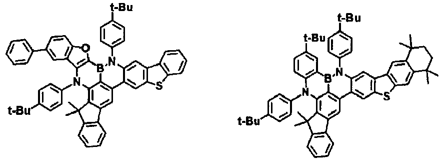 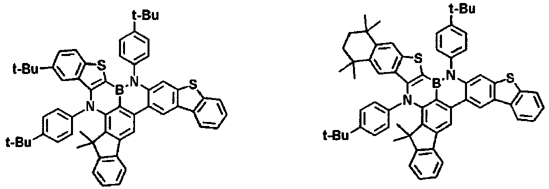 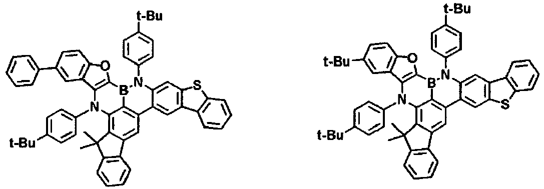 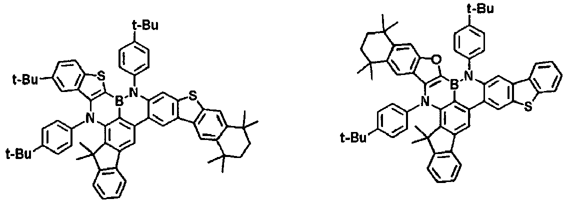 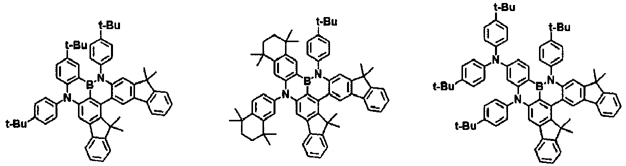 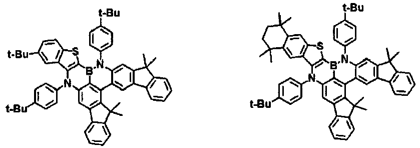 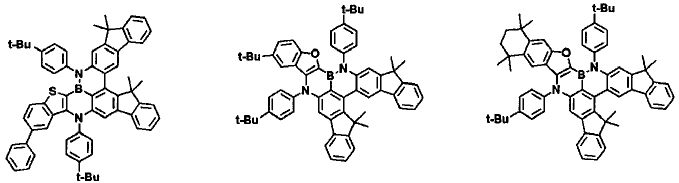 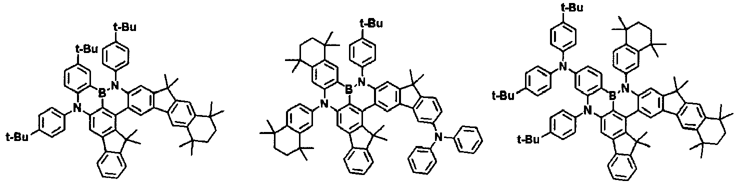 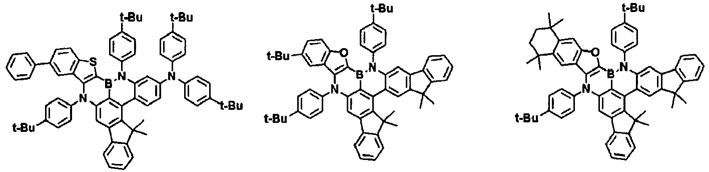 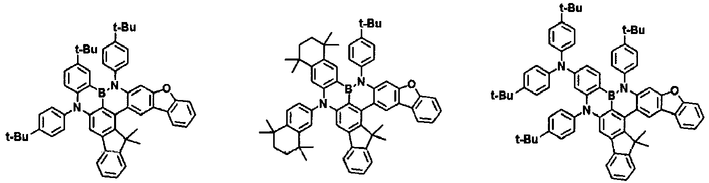 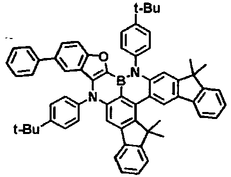 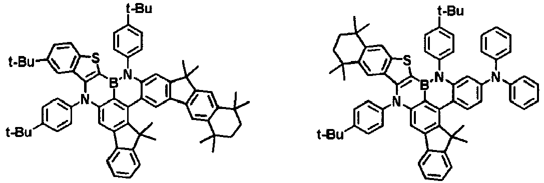 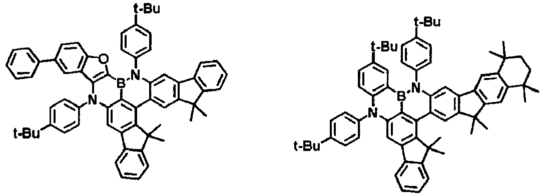 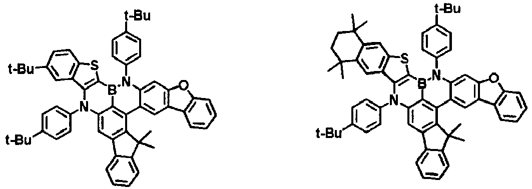 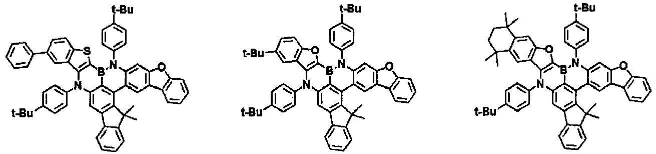 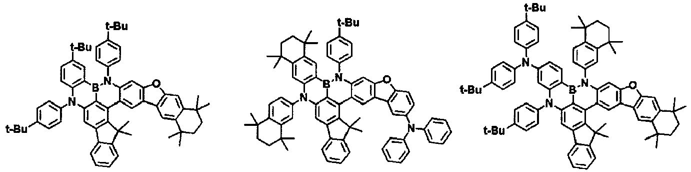 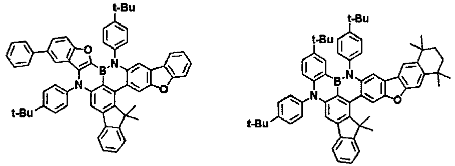 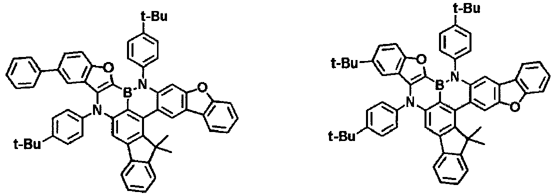 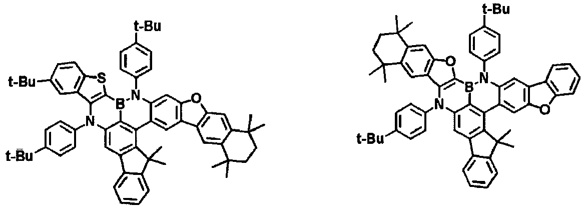 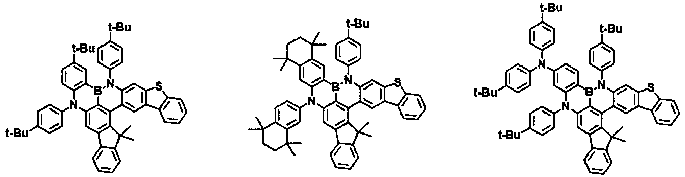 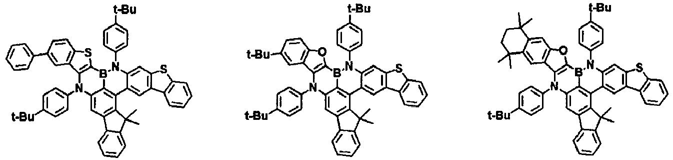 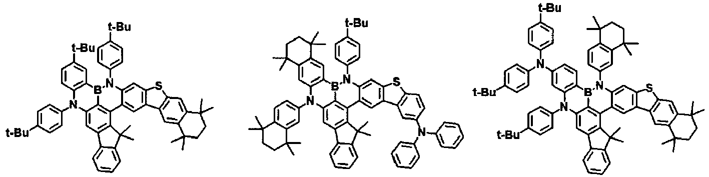 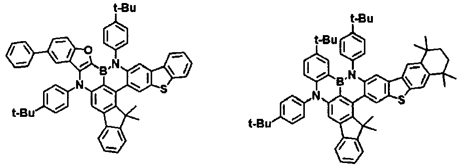 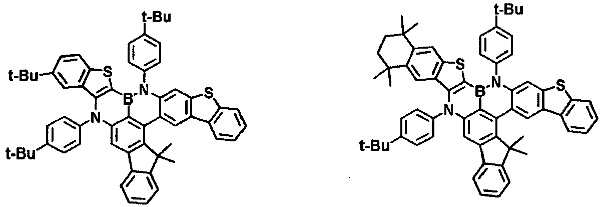 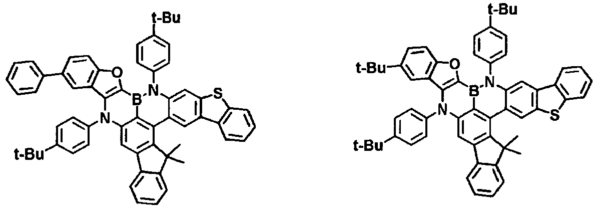 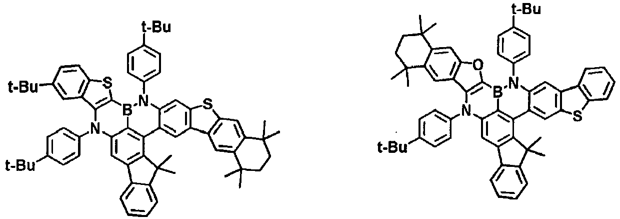 wherein the compound, t-Bu is a tert-butyl group.

One embodiment of the present specification provides an organic light emitting device including the compound described above.

In the present specification, a description of a certain member being placed "on" another member includes not only a case of the certain member being in contact with the another member but a case of still another member being present between the two members.

In the present specification, a description of a certain part "including" certain constituents means capable of further including other constituents, and does not exclude other constituents unless particularly stated on the contrary.

In the present specification, the "layer" has a meaning compatible with a `film' mainly used in the art, and means coating covering a target area. The size of the "layer" is not limited, and each "layer" may have the same or a different size. According to one embodiment, the size of the "layer" may be the same as the whole device, may correspond to the size of a specific functional area, or may be as small as a single subpixel.

In the present specification, a meaning of a specific A material being included in a B layer includes both i) one or more types of A materials being included in one B layer, and ii) a B layer being formed in one or more layers, and an A material being included in one or more of the B layers that is a multilayer.

In the present specification, a meaning of a specific A material being included in a C layer or a D layer includes both i) being included in one or more layers of one or more C layers, ii) being included in one or more layers of one or more D layers, or iii) being included in each of one or more C layers and one or more D layers.

In the present specification, "deuteration", "substituted with deuterium" or "deuterated" means hydrogen at a substitutable position of a compound being substituted with deuterium.

In the present specification, "substituted with deuterium by X%", "X% deuterated", "degree of deteration of X% or "deuterium substitution rate of X%" means X% of hydrogens at a substitutable position in a corresponding structure being substituted with deuterium. For example, when the corresponding structure is dibenzofuran, the dibenzofuran being "substituted with deuterium by 25%", the dibenzofuran being "25% deuterated", the dibenzofuran having a "degree of deuteration of 25%", or the dibenzofuran having a "deuterium substitution rate of 25%" means two of eight hydrogens at a substitutable position of the dibenzofuran being substituted with deuterium.

In the present specification, the degree of deuteration may be identified using known methods such as nuclear magnetic resonance (¹H NMR), TLC/MS (thin-layer chromatography/mass spectrometry) or MALDI-TOF MS (matrix assisted laser desorption/ionization time-of-flight mass spectrometry).

One embodiment of the present specification provides an organic light emitting device including a first electrode; a second electrode; and an organic material layer comprising one or more layers provided between the first electrode and the second electrode, wherein one or more layers of the organic material layer include the compound represented by Chemical Formula 1.

The organic material layer of the organic light emitting device of the present specification may be formed in a single layer structure, but may also be formed in a multilayer structure in which two or more organic material layers are laminated. For example, the organic light emitting device of the present specification may have a structure including a hole injection layer, a hole transfer layer, a light emitting layer, an electron transfer layer, an electron injection layer, an electron blocking layer, a hole blocking layer and the like. However, the structure of the organic light emitting device is not limited thereto, and may include a smaller number of organic layers.

In one embodiment of the present specification, the organic material layer includes a light emitting layer, and the light emitting layer includes the compound represented by Chemical Formula 1.

In one embodiment of the present specification, the organic material layer includes a light emitting layer, and the light emitting layer includes the compound represented by Chemical Formula 1 as a dopant of the light emitting layer.

In one embodiment of the present specification, the organic material layer includes a light emitting layer, and the light emitting layer includes the compound represented by Chemical Formula 1 as a blue fluorescent dopant of the light emitting layer.

In one embodiment of the present specification, the organic light emitting device further includes one, two or more layers selected from the group consisting of a hole injection layer, a hole transfer layer, a light emitting layer, an electron transfer layer, an electron injection layer, a hole blocking layer and an electron blocking layer.

In one embodiment of the present specification, the light emitting layer further includes a host compound.

In one embodiment of the present specification, the light emitting layer further includes a host compound, and in the host compound, at least one hydrogen at a substitutable position is substituted with deuterium.

In one embodiment of the present specification, when the host compound is substituted with deuterium, the host compound is substituted with deuterium by 30% or greater. In another embodiment, the host compound is substituted with deuterium by 40% or greater. In another embodiment, the host compound is substituted with deuterium by 60% or greater. In another embodiment, the host compound is substituted with deuterium by 80% or greater. In another embodiment, the host compound is substituted with deuterium by 100%.

In one embodiment of the present specification, the light emitting layer further includes a compound represented by the following Chemical Formula H.

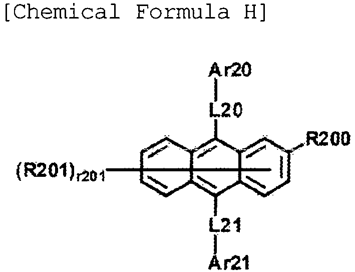

In Chemical Formula H,
L20 and L21 are the same as or different from each other, and each independently a direct bond; a substituted or unsubstituted arylene group; or a substituted or unsubstituted heterocyclic group,
Ar20 and Ar21 are the same as or different from each other, and each independently hydrogen; deuterium; a substituted or unsubstituted aryl group; or a substituted or unsubstituted heterocyclic group,
R200 and R201 are the same as or different from each other, and each independently hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, and
r201 is an integer of 1 to 7, and when r201 is 2 or greater, the two or more R201s are the same as or different from each other.

In one embodiment of the present specification, L20 and L21 are the same as or different from each other, and each independently a direct bond; a monocyclic or polycyclic arylene group having 6 to 30 carbon atoms; or a monocyclic or polycyclic heteroarylene group having 2 to 30 carbon atoms.

In one embodiment of the present specification, L20 and L21 are the same as or different from each other, and each independently a direct bond; a monocyclic or polycyclic arylene group having 6 to 20 carbon atoms; or a monocyclic or polycyclic heteroarylene group having 2 to 20 carbon atoms.

In one embodiment of the present specification, L20 and L21 are the same as or different from each other, and each independently a direct bond; a phenylene group unsubstituted or substituted with deuterium; a biphenylylene group unsubstituted or substituted with deuterium; a naphthylene group unsubstituted or substituted with deuterium; a divalent dibenzofuran group; or a divalent dibenzothiophene group.

In one embodiment of the present specification, Ar20 and Ar21 are the same as or different from each other, and each independently a substituted or unsubstituted monocyclic or polycyclic aryl group having 6 to 30 carbon atoms; or a substituted or unsubstituted monocyclic or polycyclic heterocyclic group having 2 to 30 carbon atoms.

In one embodiment of the present specification, Ar20 and Ar21 are the same as or different from each other, and each independently a substituted or unsubstituted monocyclic or polycyclic aryl group having 6 to 20 carbon atoms; or a substituted or unsubstituted monocyclic or polycyclic heterocyclic group having 2 to 20 carbon atoms.

In one embodiment of the present specification, Ar20 and Ar21 are the same as or different from each other, and each independently a substituted or unsubstituted monocyclic to tetracyclic aryl group having 6 to 20 carbon atoms; or a substituted or unsubstituted monocyclic to tetracyclic heterocyclic group having 6 to 20 carbon atoms.

In one embodiment of the present specification, Ar20 and Ar21 are the same as or different from each other, and each independently a substituted or unsubstituted phenyl group; a substituted or unsubstituted biphenyl group; a substituted or unsubstituted terphenyl group; a substituted or unsubstituted naphthyl group; a substituted or unsubstituted anthracene group; a substituted or unsubstituted phenanthrene group; a substituted or unsubstituted phenalene group; a substituted or unsubstituted fluorene group; a substituted or unsubstituted benzofluorene group; a substituted or unsubstituted furan group; a substituted or unsubstituted thiophene group; a substituted or unsubstituted dibenzofuran group; a substituted or unsubstituted naphthobenzofuran group; a substituted or unsubstituted dibenzothiophene group; or a substituted or unsubstituted naphthobenzothiophene group.

In one embodiment of the present specification, Ar20 and Ar21 are the same as or different from each other, and each independently a phenyl group unsubstituted or substituted with deuterium, or a monocyclic or polycyclic aryl group having 6 to 20 carbon atoms; a biphenyl group unsubstituted or substituted with deuterium, or a monocyclic or polycyclic aryl group having 6 to 20 carbon atoms; a naphthyl group unsubstituted or substituted with a monocyclic or polycyclic aryl group having 6 to 20 carbon atoms; a dibenzofuran group unsubstituted or substituted with a monocyclic or polycyclic aryl group having 6 to 20 carbon atoms; a naphthobenzofuran group unsubstituted or substituted with a monocyclic or polycyclic aryl group having 6 to 20 carbon atoms; a dibenzothiophene group unsubstituted or substituted with a monocyclic or polycyclic aryl group having 6 to 20 carbon atoms; or a naphthobenzothiophene group unsubstituted or substituted with a monocyclic or polycyclic aryl group having 6 to 20 carbon atoms.

In one embodiment of the present specification, Ar20 and Ar21 are the same as or different from each other, and each independently a phenyl group unsubstituted or substituted with deuterium; a biphenyl group unsubstituted or substituted with deuterium; a terphenyl group; a naphthyl group unsubstituted or substituted with deuterium; a phenanthrene group; a dibenzofuran group; a naphthobenzofuran group; a dibenzothiophene group; or a naphthobenzothiophene group.

In one embodiment of the present specification, Ar20 is a substituted or unsubstituted heterocyclic group, and Ar21 is a substituted or unsubstituted aryl group.

In one embodiment of the present specification, R200 is hydrogen; deuterium; a halogen group; a substituted or unsubstituted linear or branched alkyl group having 1 to 30 carbon atoms; a substituted or unsubstituted monocyclic or polycyclic cycloalkyl group having 3 to 30 carbon atoms; a substituted or unsubstituted monocyclic or polycyclic aryl group having 6 to 30 carbon atoms; or a substituted or unsubstituted monocyclic or polycyclic heterocyclic group having 2 to 30 carbon atoms.

In one embodiment of the present specification, R200 is hydrogen; deuterium; fluorine; a substituted or unsubstituted linear or branched alkyl group having 1 to 10 carbon atoms; a substituted or unsubstituted monocyclic or polycyclic cycloalkyl group having 3 to 10 carbon atoms; a substituted or unsubstituted monocyclic or polycyclic aryl group having 6 to 30 carbon atoms; or a substituted or unsubstituted monocyclic or polycyclic heterocyclic group having 2 to 30 carbon atoms.

In one embodiment of the present specification, R200 is hydrogen; a substituted or unsubstituted monocyclic or polycyclic aryl group having 6 to 30 carbon atoms; or a substituted or unsubstituted monocyclic or polycyclic heterocyclic group having 2 to 30 carbon atoms.

In one embodiment of the present specification, R200 is hydrogen; a substituted or unsubstituted monocyclic or polycyclic aryl group having 6 to 20 carbon atoms; or a substituted or unsubstituted monocyclic or polycyclic heterocyclic group having 2 to 20 carbon atoms.

In one embodiment of the present specification, R200 is hydrogen; a substituted or unsubstituted monocyclic to tetracyclic aryl group having 6 to 20 carbon atoms; or a substituted or unsubstituted monocyclic to tetracyclic heterocyclic group having 6 to 20 carbon atoms.

In one embodiment of the present specification, R200 is hydrogen; a substituted or unsubstituted phenyl group; a substituted or unsubstituted biphenyl group; a substituted or unsubstituted terphenyl group; a substituted or unsubstituted naphthyl group; a substituted or unsubstituted anthracene group; a substituted or unsubstituted phenanthrene group; a substituted or unsubstituted phenalene group; a substituted or unsubstituted fluorene group; a substituted or unsubstituted benzofluorene group; a substituted or unsubstituted furan group; a substituted or unsubstituted thiophene group; a substituted or unsubstituted dibenzofuran group; a substituted or unsubstituted naphthobenzofuran group; a substituted or unsubstituted dibenzothiophene group; or a substituted or unsubstituted naphthobenzothiophene group.

In one embodiment of the present specification, R200 is hydrogen; deuterium; a phenyl group unsubstituted or substituted with deuterium, or a monocyclic or polycyclic aryl group having 6 to 20 carbon atoms; a biphenyl group unsubstituted or substituted with a monocyclic or polycyclic aryl group having 6 to 20 carbon atoms; a naphthyl group unsubstituted or substituted with deuterium, or a monocyclic or polycyclic aryl group having 6 to 20 carbon atoms; a dibenzofuran group unsubstituted or substituted with a monocyclic or polycyclic aryl group having 6 to 20 carbon atoms; a naphthobenzofuran group unsubstituted or substituted with a monocyclic or polycyclic aryl group having 6 to 20 carbon atoms; a dibenzothiophene group unsubstituted or substituted with a monocyclic or polycyclic aryl group having 6 to 20 carbon atoms; or a naphthobenzothiophene group unsubstituted or substituted with a monocyclic or polycyclic aryl group having 6 to 20 carbon atoms.

In one embodiment of the present specification, R200 is hydrogen; deuterium; a phenyl group unsubstituted or substituted with deuterium, a phenyl group or a naphthyl group; a biphenyl group; a naphthyl group unsubstituted or substituted with deuterium, a phenyl group or a naphthyl group; a dibenzofuran group; a naphthobenzofuran group; a dibenzothiophene group; or a naphthobenzothiophene group.

According to one embodiment of the present specification, R201 is hydrogen.

According to one embodiment of the present specification, R201 is deuterium.

In one embodiment of the present specification, when the compound represented by Chemical Formula H is substituted with deuterium, 30% or more of hydrogens at a substitutable position are substituted with deuterium. In another embodiment, 40% or more of hydrogens at a substitutable position are substituted with deuterium in the structure of Chemical Formula H. In another embodiment, 60% or more of hydrogens at a substitutable position are substituted with deuterium in the structure of Chemical Formula H.

In another embodiment, 80% or more of hydrogens at a substitutable position are substituted with deuterium in the structure of Chemical Formula H. In another embodiment, 100% of hydrogens at a substitutable position are substituted with deuterium in the structure of Chemical Formula H.

In one embodiment of the present specification, the compound represented by Chemical Formula H is one selected from the following compounds.

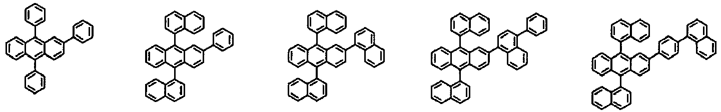

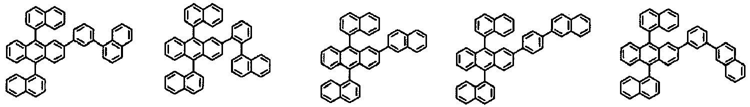

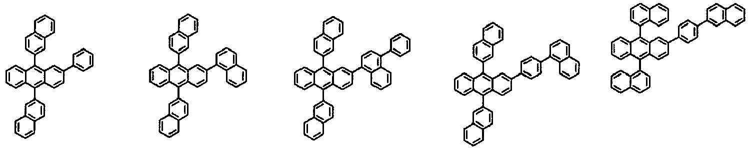

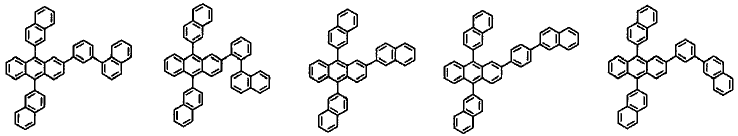

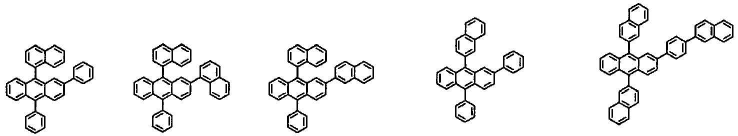

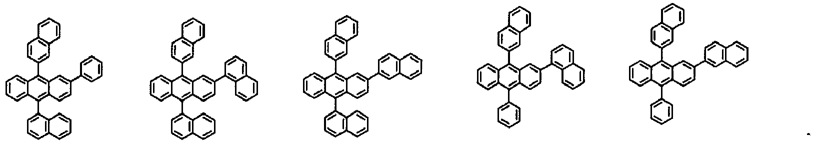

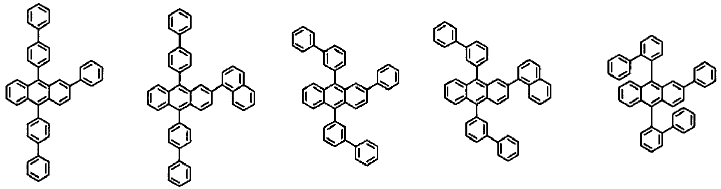

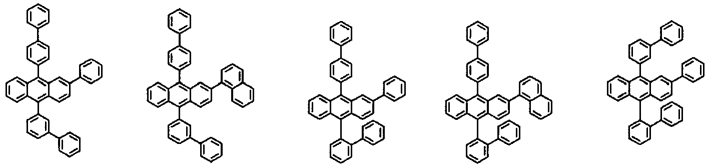

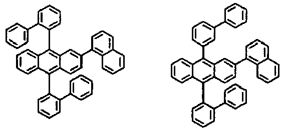

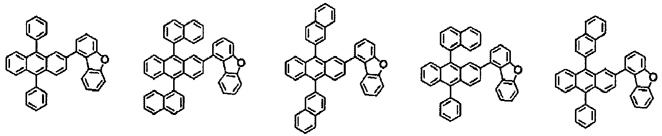

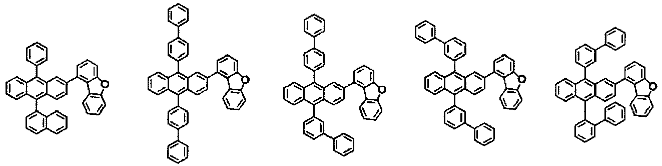

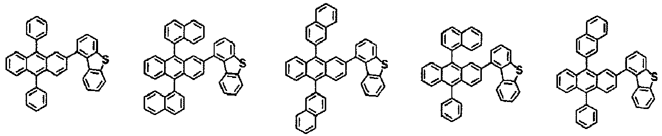

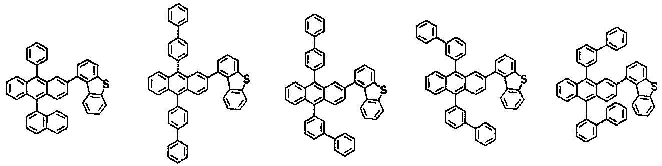

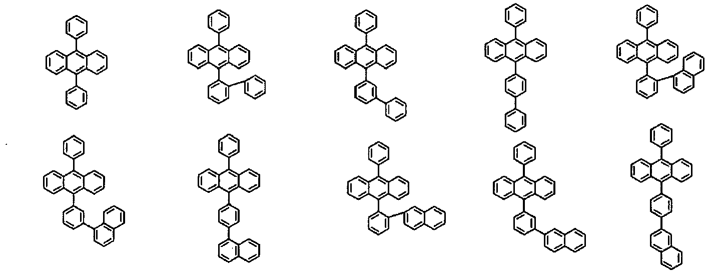

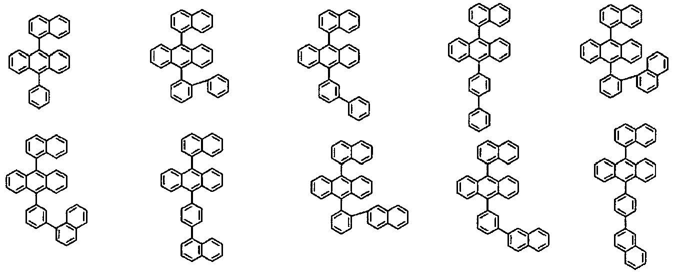

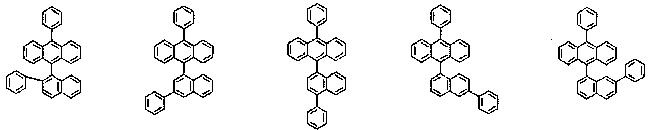

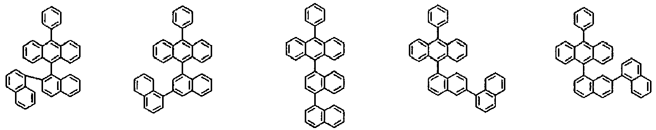

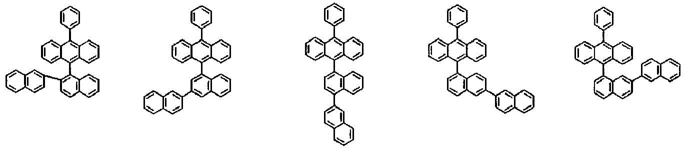

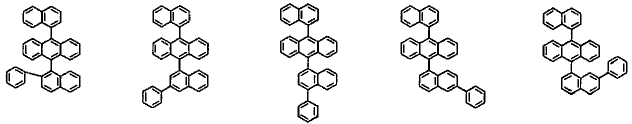

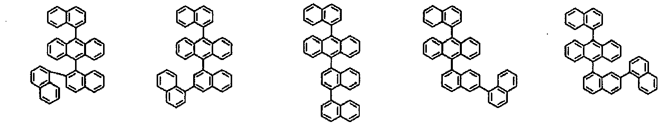

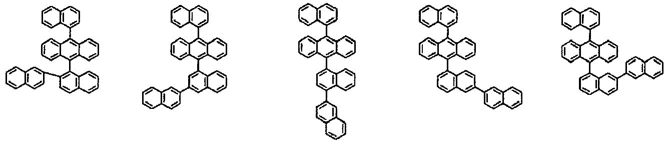

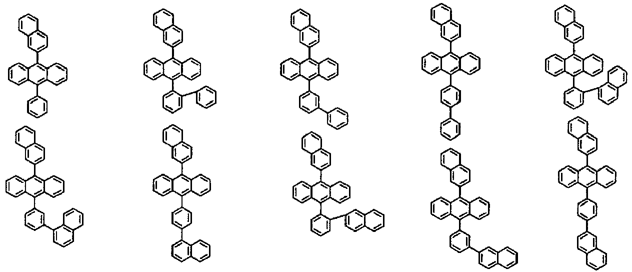

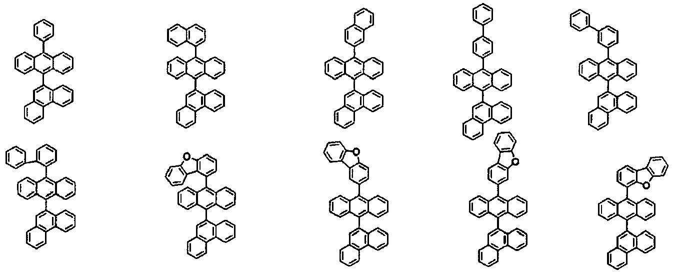

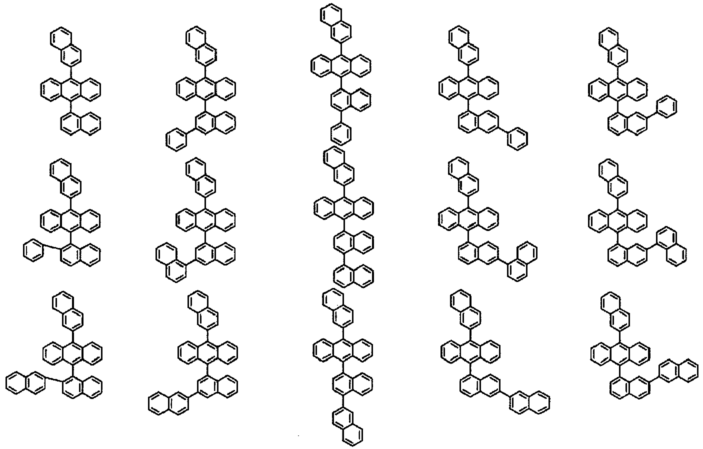

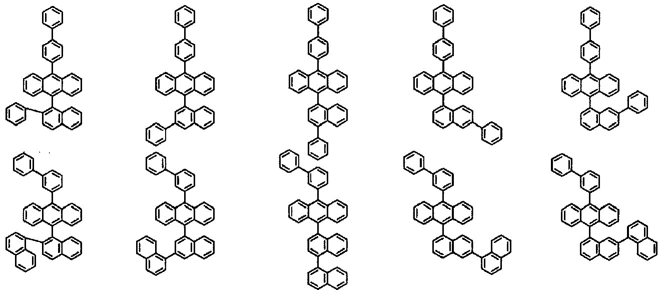

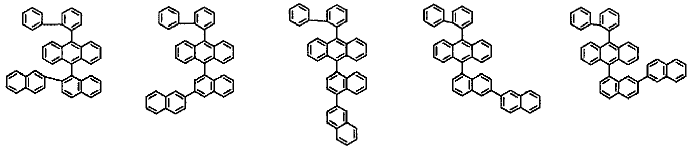

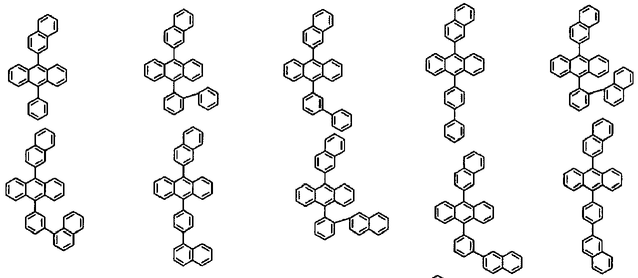

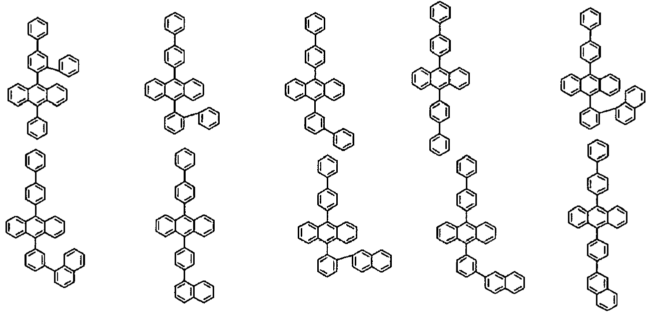

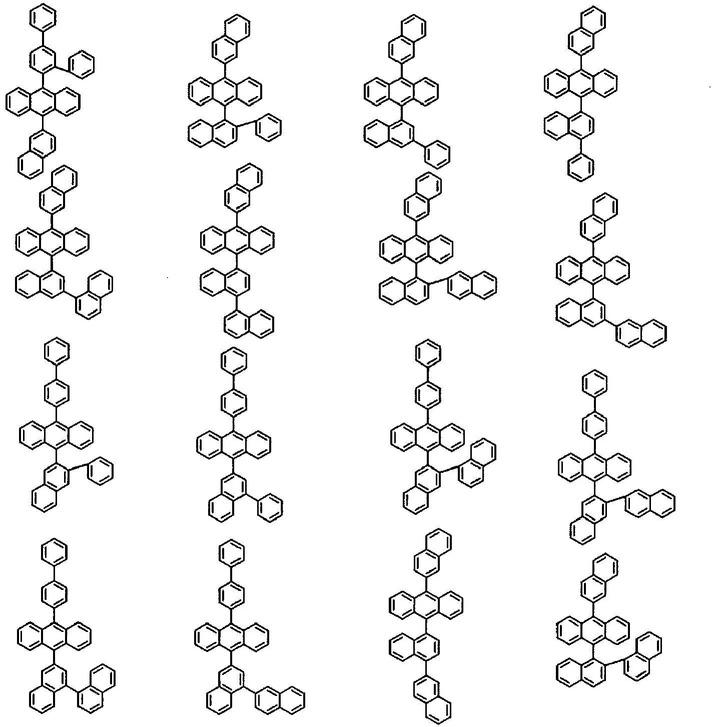

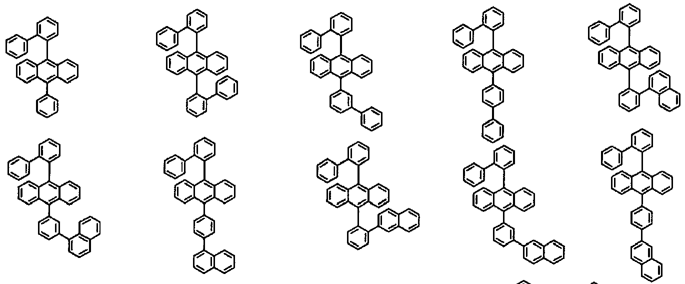

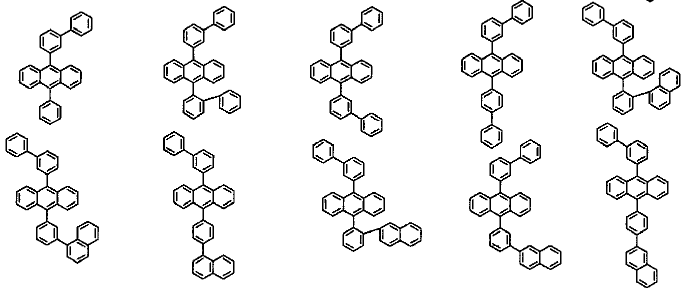

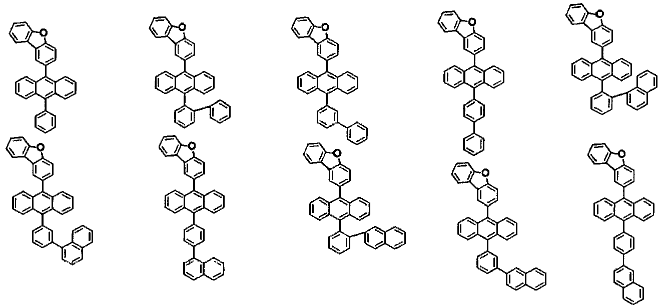

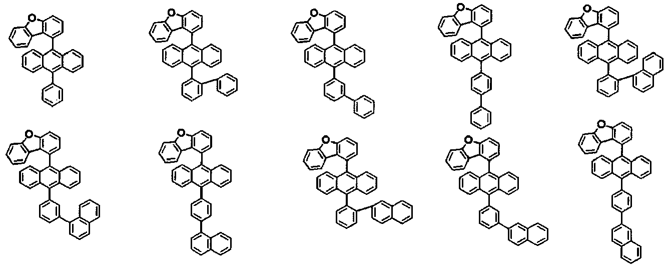

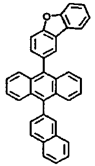

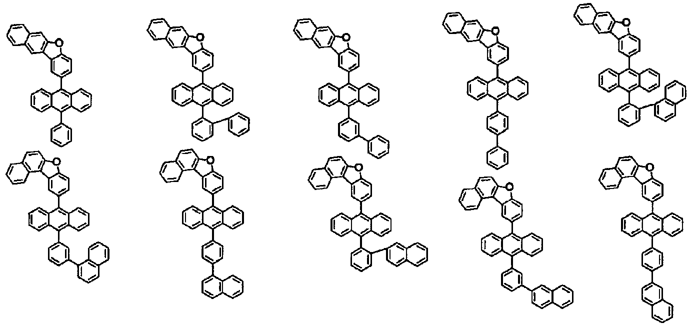

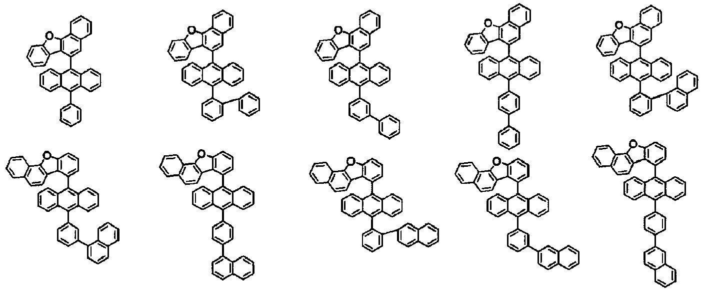

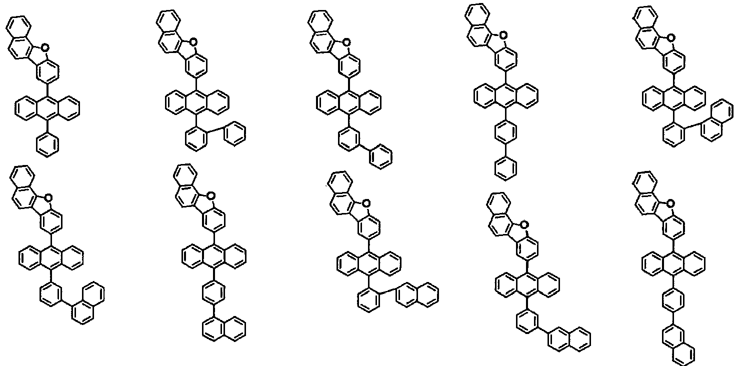

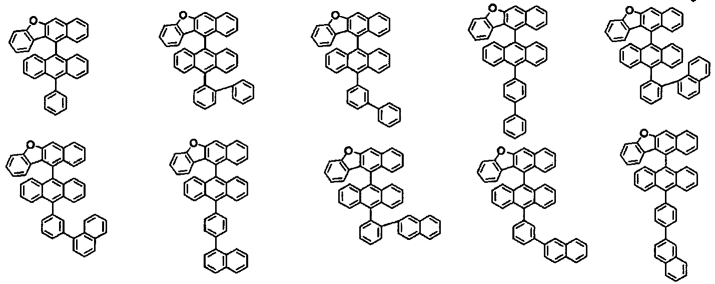

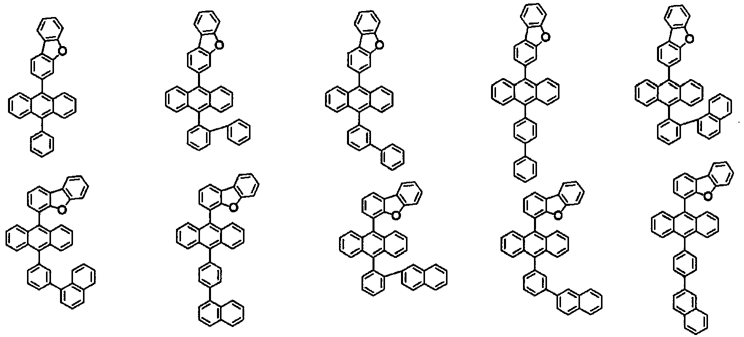

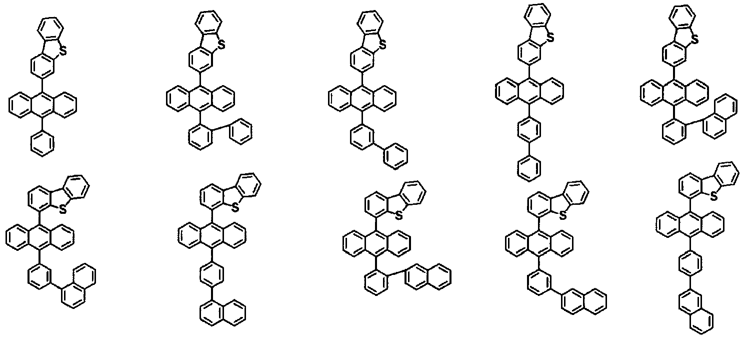

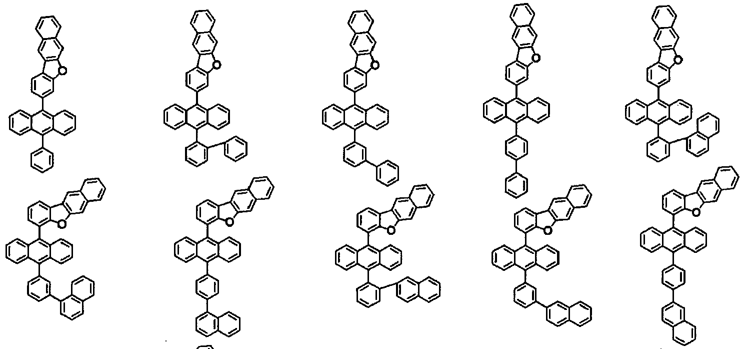

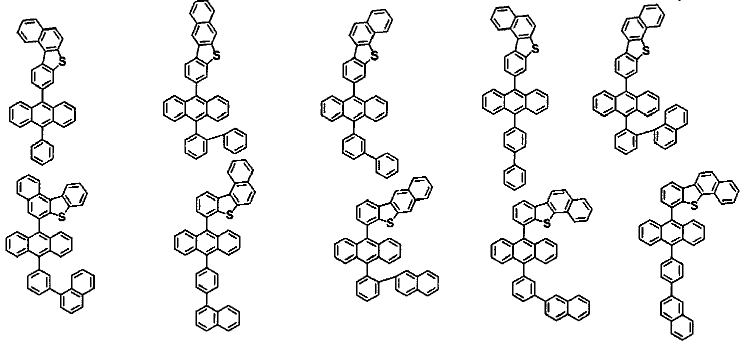

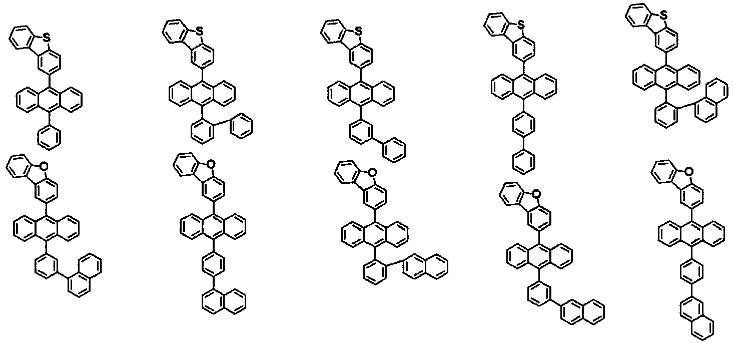

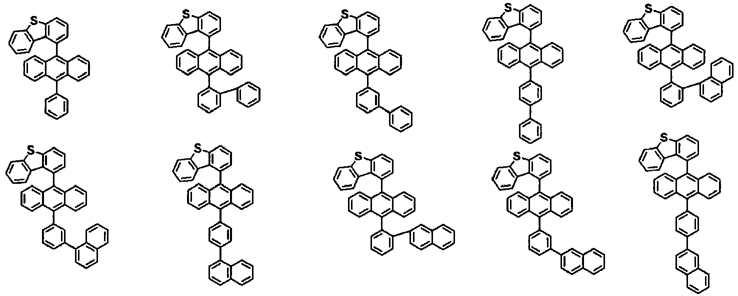

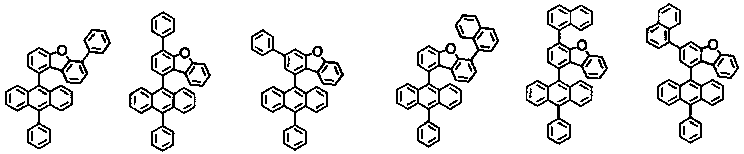

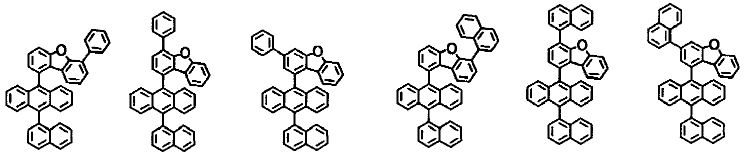

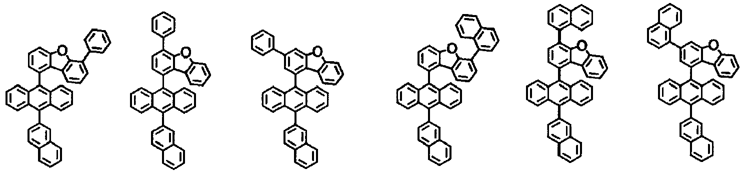

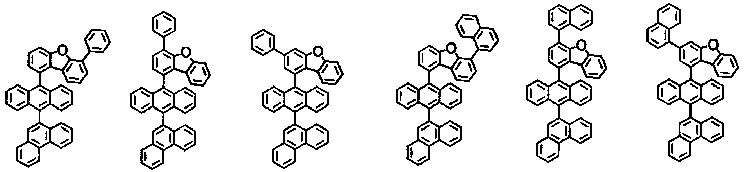

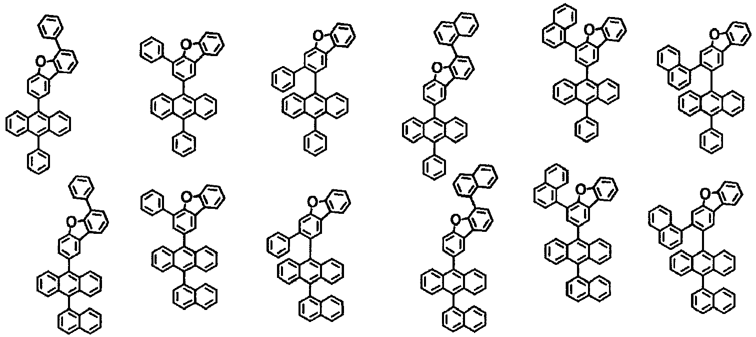

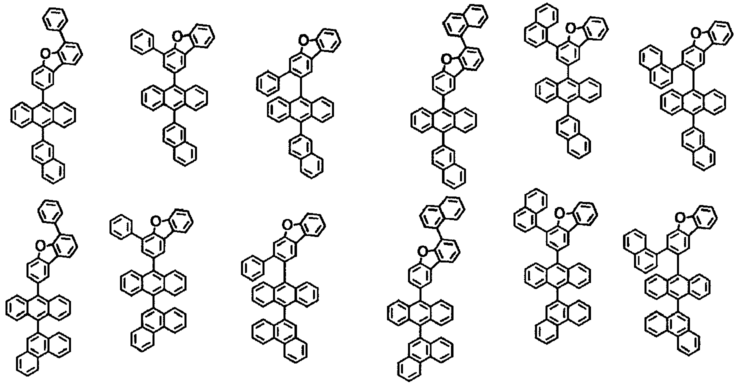

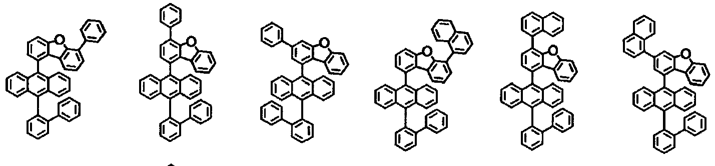

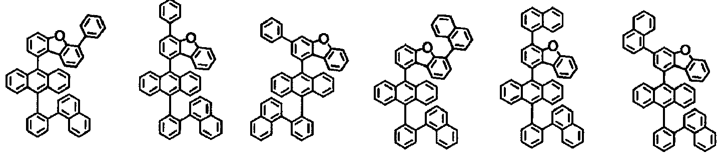

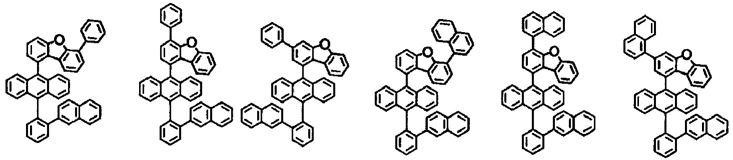

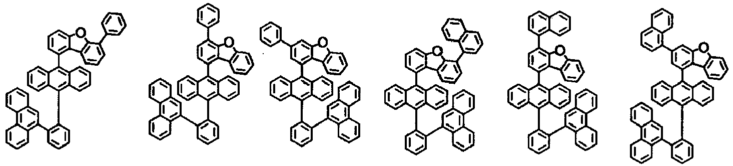

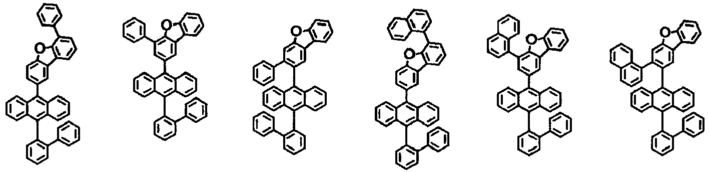

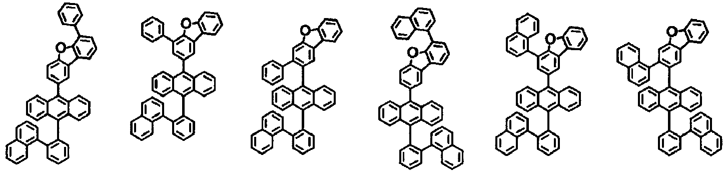

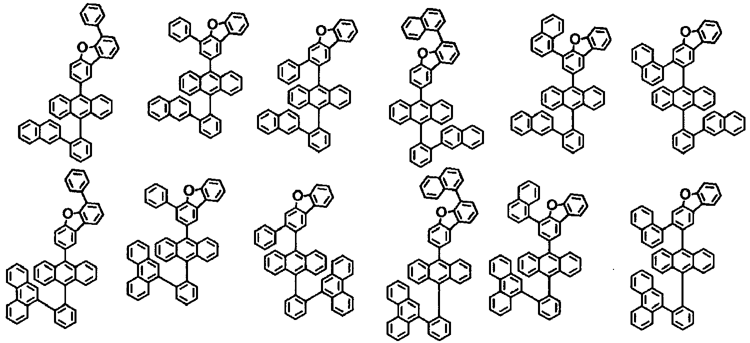

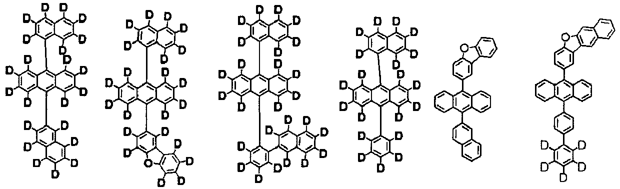

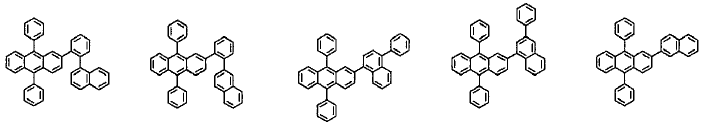

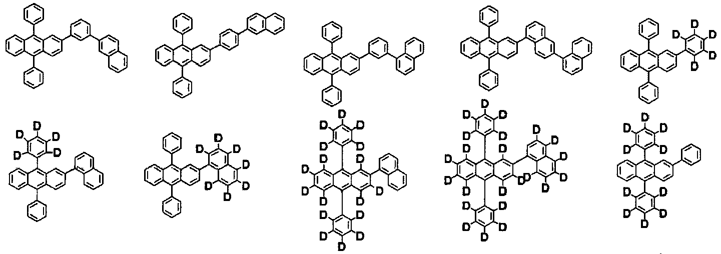

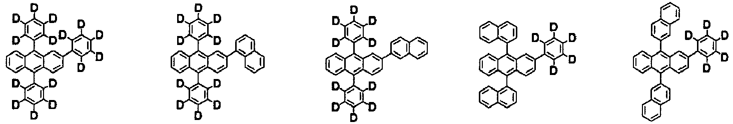

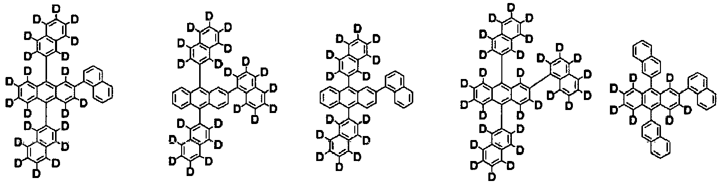

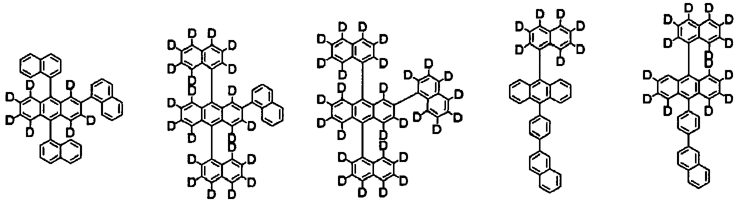

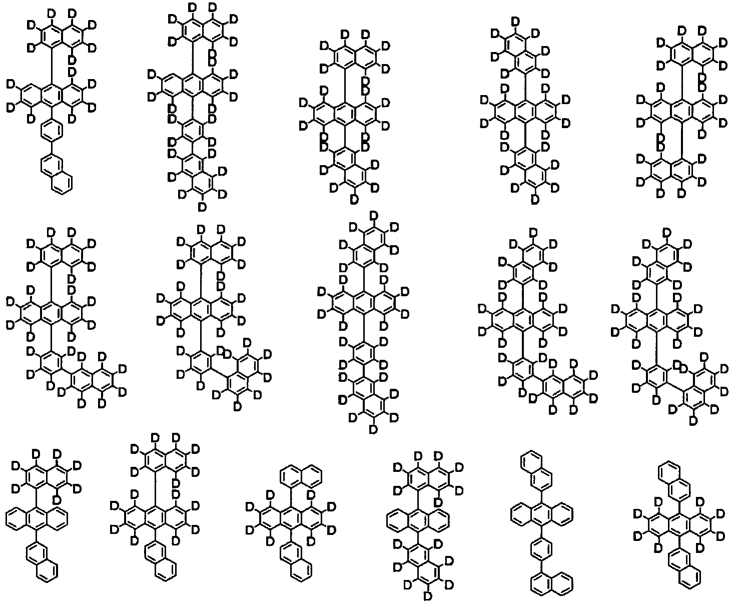

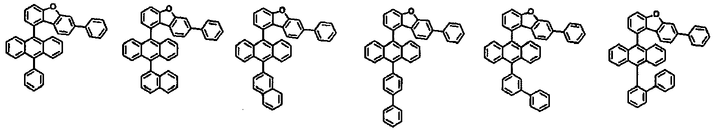

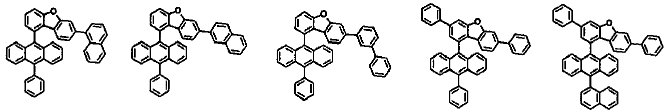

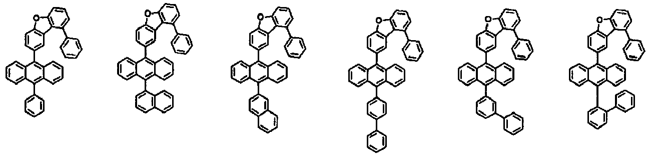

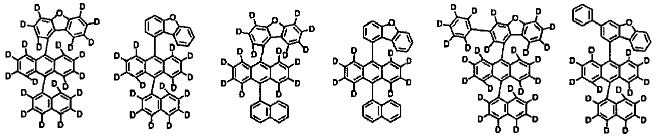

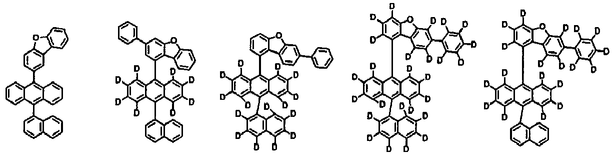

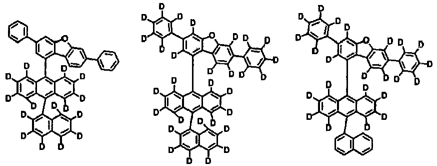

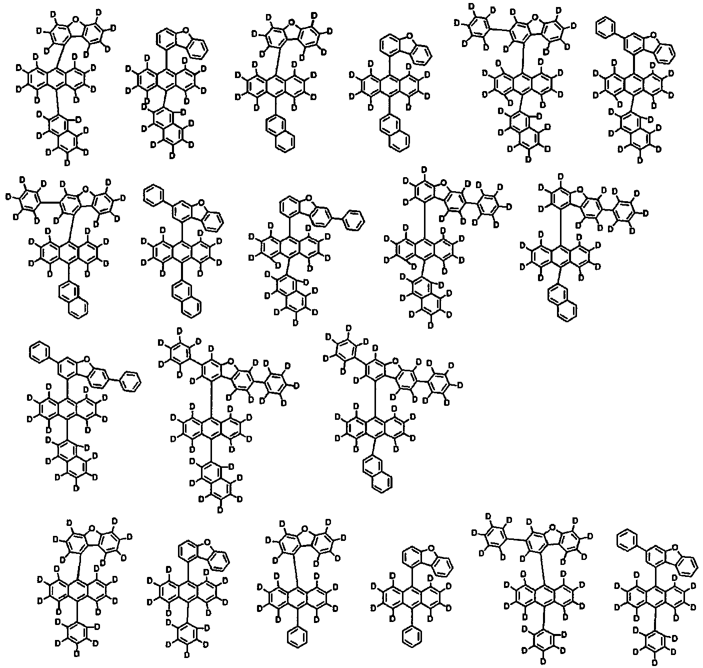

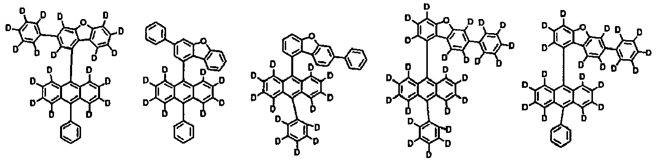

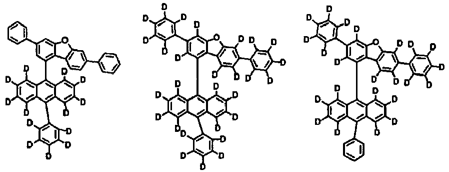

According to one embodiment of the present specification, the compound represented by Chemical Formula H may be prepared as in the following General Formula 1, however, the preparation is not limited thereto.

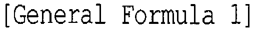

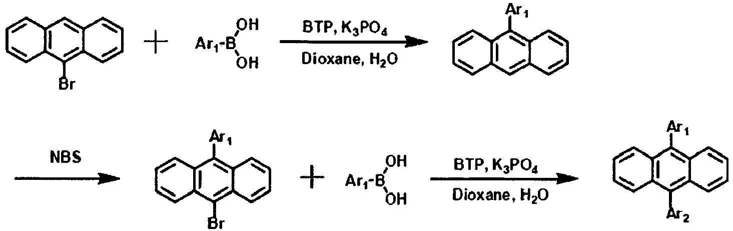

In General Formula 1,
Ar₁ has the same definition as -L20-Ar20 of Chemical Formula H,
Ar₂ has the same definition as -L21-Ar21 of Chemical Formula H, and the anthracene core of General Formula 1 may be further substituted with R200 and R201.

In one embodiment of the present specification, the compound represented by Chemical Formula 1 is used as a dopant and the compound represented by Chemical Formula H is used as a host in the light emitting layer.

In one embodiment of the present specification, when the light emitting layer includes a host and a dopant, a content of the dopant may be selected in a range of 0.01 parts by weight to 10 parts by weight based on 100 parts by weight of the light emitting layer, however, the content is not limited thereto.

In one embodiment of the present specification, the light emitting layer includes a host and a dopant, and the host and the dopant are included in a weight ratio of 99:1 to 1:99, preferably in a weight ratio of 99:1 to 70:30, and more preferably in a weight ratio of 99:1 to 90:10.

The light emitting layer may further include a host material, and the host includes fused aromatic ring derivatives, heteroring-containing compounds or the like. Specifically, the fused aromatic ring derivative includes anthracene derivatives, pyrene derivatives, naphthalene derivatives, pentacene derivatives, phenanthrene compounds, fluoranthene compounds or the like, and the heteroring-containing compound includes carbazole derivatives, dibenzofuran derivatives, ladder-type furan compounds, pyrimidine derivatives, triazine derivatives or the like, and may include mixtures of two or more types thereof, however, the fused aromatic ring derivative and the heteroring-containing compound are not limited thereto.

According to one embodiment of the present specification, the organic material layer includes a light emitting layer, and the light emitting layer includes one or more types of dopants, and a host.

According to one embodiment of the present specification, the organic material layer includes a light emitting layer, and the light emitting layer includes two or more types of mixed dopants of and a host.

According to one embodiment of the present specification, one or more of the two or more types of mixed dopants include Chemical Formula 1, and the host includes the compound represented by Chemical Formula H. One or more of the two or more types of mixed dopants include Chemical Formula 1, and as the rest, dopant materials known in the art may be used, however, the material is not limited thereto.

According to one embodiment of the present specification, one or more of the two or more types of mixed dopants include Chemical Formula 1, and as the rest, one or more of a boron-based compound, a pyrene-based compound and a delayed fluorescence-based compound different from Chemical Formula 1 may be used, however, the material is not limited thereto.

According to one embodiment of the present specification, the organic material layer includes a light emitting layer, and the light emitting layer includes one or more types of hosts.

According to one embodiment of the present specification, the organic material layer includes a light emitting layer, and the light emitting layer includes two or more types of mixed hosts.

According to one embodiment of the present specification, one or more of the two or more types of mixed hosts are the compound represented by Chemical Formula H.

According to one embodiment of the present specification, the two or more types of mixed hosts are different from each other, and each independently the compound represented by Chemical Formula H.

According to one embodiment of the present specification, the organic material layer includes a light emitting layer, and the light emitting layer includes two types of mixed hosts.

According to one embodiment of the present specification, the organic material layer includes a light emitting layer, the light emitting layer includes two types of mixed hosts, the two types of mixed hosts are different from each other, and the two types of hosts are the compound represented by Chemical Formula H.

According to one embodiment of the present specification, the organic material layer includes a light emitting layer, includes a first host represented by Chemical Formula H; and a second host represented by Chemical Formula H, and the first host and the second host are different from each other.

According to one embodiment of the present specification, the first host:the second host are included in a weight ratio of 95:5 to 5:95, and preferably included in a weight ratio of 70:30 to 30:70.

According to one embodiment of the present specification, the organic material layer includes a light emitting layer, and the light emitting layer includes one or more types of hosts, and a dopant.

According to one embodiment of the present specification, the organic material layer includes a light emitting layer, the light emitting layer includes one or more types of hosts, and a dopant, and the host includes the compound represented by Chemical Formula H and the dopant includes the compound represented by Chemical Formula 1.

According to one embodiment of the present specification, the organic material layer includes a light emitting layer, and the light emitting layer includes two or more types of mixed hosts, and a dopant.

According to one embodiment of the present specification, one or more of the two or more types of mixed hosts include the compound represented by Chemical Formula H, and the dopant includes the compound represented by Chemical Formula 1.

In the present specification, the two or more types of mixed hosts are different from each other.

According to one embodiment of the present specification, the organic material layer includes a light emitting layer, and the light emitting layer includes two types of mixed hosts, and a dopant.

According to one embodiment of the present specification, the two types of mixed hosts are different from each other and each independently include the compound represented by Chemical Formula H, and the dopant includes the compound represented by Chemical Formula 1.

According to one embodiment of the present specification, a first host represented by Chemical Formula H; a second host represented by Chemical Formula H; and a dopant represented by Chemical Formula 1 are included, and the first host and the second host are different from each other.

According to one embodiment of the present specification, the organic material layer uses one or more types of hosts and one or more types of dopants, and the one or more types of hosts include the compound represented by Chemical Formula H and the one or more types of dopants include the compound represented by Chemical Formula 1.

According to one embodiment of the present specification, the organic material layer uses two or more types of mixed hosts and two or more types of mixed dopants, and as the two or more types of mixed hosts, the same materials as described above may be used, and as the two or more types of mixed dopants, the same materials as described above may be used.

According to one embodiment of the present specification, the organic material layer includes a light emitting layer, the light emitting layer includes a dopant material, and the dopant material includes the compound of Chemical Formula 1.

According to one embodiment of the present specification, the light emitting layer further includes one or more types of dopants and a host. As the one or more types of dopants, dopant materials known in the art may be used, however, the dopant is not limited thereto.

According to one embodiment of the present specification, the light emitting layer further includes one or more types of hosts. The one or more types of hosts include the compound represented by Chemical Formula H.

According to one embodiment of the present specification, the light emitting layer includes two or more types of mixed hosts. One or more types of the two or more types of mixed hosts include the compound represented by Chemical Formula H.

According to one embodiment of the present specification, the light emitting layer further includes two or more types of mixed hosts. The two types of mixed hosts are different from each other, and each independently include the compound represented by Chemical Formula H.

In one embodiment of the present specification, the organic light emitting device includes a first electrode; a second electrode; a light emitting layer provided between the first electrode and the second electrode; and two or more organic material layers provided either between the light emitting layer and the first electrode, or between the light emitting layer and the second electrode, wherein at least one of the two or more organic material layers includes the compound represented by Chemical Formula 1.

In one embodiment of the present specification, as the two or more organic material layers, two or more may be selected from the group consisting of a light emitting layer, a hole transfer layer, a hole injection layer, a layer carrying out hole transfer and hole injection at the same time, and an electron blocking layer.

In one embodiment of the present specification, the organic light emitting device may include two or more electron transfer layers, but is not limited thereto.

In one embodiment of the present specification, the organic material layer includes two or more electron transfer layers, and at least one of the two or more electron transfer layers includes the compound represented by Chemical Formula 1. Specifically, in one embodiment of the present specification, the compound represented by Chemical Formula 1 may be included in one of the two or more electron transfer layers, or may be included in each of the two or more electron transfer layers.

In addition, when the compound is included in each of the two or more electron transfer layers in one embodiment of the present specification, materials other than the compound represented by Chemical Formula 1 may be the same as or different from each other.

In addition, in one embodiment of the present specification, materials of each of the two or more electron transfer layers may be the same as or different from each other.

In one embodiment of the present specification, the organic light emitting device may include two or more hole injection layers, but is not limited thereto.

In addition, in one embodiment of the present specification, materials of each of the two or more hole injection layers may be the same as or different from each other.

When the organic material layer including the compound represented by Chemical Formula 1 is an electron transfer layer, the electron transfer layer may further include an n-type dopant. As the n-type dopant, those known in the art may be used, and for example, metals or metal complexes may be used. For example, the electron transfer layer including the compound represented by Chemical Formula 1 may further include LiQ (lithium quinolate).

In one embodiment of the present specification, the organic material layer includes two or more hole transfer layers, and at least one of the two or more hole transfer layers includes the compound represented by Chemical Formula 1. Specifically, in one embodiment of the present specification, the compound represented by Chemical Formula 1 may be included in one of the two or more hole transfer layers, or may be included in each of the two or more hole transfer layers.

In addition, when the compound represented by Chemical Formula 1 is included in each of the two or more hole transfer layers in one embodiment of the present specification, materials other than the compound represented by Chemical Formula 1 may be the same as or different from each other.

In one embodiment of the present specification, the organic material layer may further include, in addition to the organic material layer including the compound represented by Chemical Formula 1, a hole injection layer or a hole transfer layer including a compound including an arylamine group, a carbazolyl group or a benzocarbazolyl group.

In one embodiment of the present specification, the first electrode is an anode or a cathode.

In one embodiment of the present specification, the second electrode is a cathode or an anode.

In one embodiment of the present specification, the organic light emitting device may be an organic light emitting device having a structure in which an anode, an organic material layer comprising one or more layers and a cathode are consecutively laminated on a substrate (normal type).

In one embodiment of the present specification, the organic light emitting device may be an organic light emitting device having a structure in a reverse direction in which a cathode, an organic material layer comprising one or more layers and an anode are consecutively laminated on a substrate (inverted type).

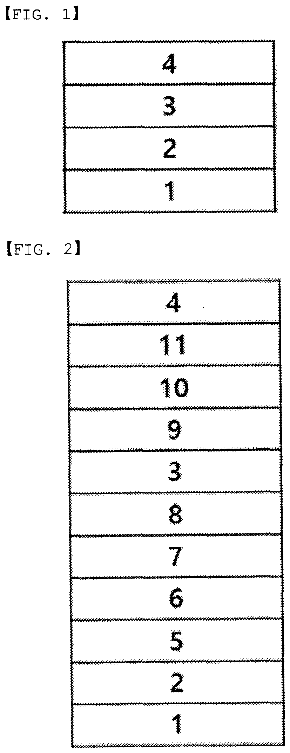

For example, structures of the organic light emitting device according to one embodiment of the present specification are illustrated in FIG. 1 and FIG. 2. FIG. 1 and FIG. 2 only illustrate the organic light emitting device, and the organic light emitting device is not limited thereto.

FIG. 1 illustrates a structure of the organic light emitting device in which a substrate (1), a first electrode (2), a light emitting layer (3) and a second electrode (4) are consecutively laminated. In such a structure, the compound may be included in the light emitting layer (3).

FIG. 2 illustrates a structure of the organic light emitting device in which a substrate (1), a first electrode (2), a first hole injection layer (5), a second hole injection layer (6), a hole transfer layer (7), an electron blocking layer (8), a light emitting layer (3), a first electron transfer layer (9), a second electron transfer layer (10), an electron injection layer (11) and a second electrode (4) are consecutively laminated. In such a structure, the compound may be included in the light emitting layer (3).

The organic light emitting device of the present specification may be manufactured using materials and methods known in the art, except that one or more layers of the organic material layers include the compound, that is, the compound represented by Chemical Formula 1.

When the organic light emitting device includes a plurality of organic material layers, the organic material layers may be formed with materials the same as or different from each other.

For example, the organic light emitting device of the present specification may be manufactured by consecutively laminating a first electrode, an organic material layer and a second electrode on a substrate. Herein, the organic light emitting device may be manufactured by forming an anode on a substrate by depositing a metal, a metal oxide having conductivity, or an alloy thereof using a physical vapor deposition (PVD) method such as a sputtering method or an e-beam evaporation method, and forming an organic material layer including a hole injection layer, a hole transfer layer, a light emitting layer and an electron transfer layer thereon, and then depositing a material usable as a cathode thereon. In addition to such a method, the organic light emitting device may also be manufactured by consecutively depositing a cathode material, an organic material layer and an anode material on a substrate.

In addition, the compound represented by Chemical Formula 1 may be formed into an organic material layer using a solution coating method as well as a vacuum deposition method when manufacturing the organic light emitting device. Herein, the solution coating method means spin coating, dip coating, doctor blading, inkjet printing, screen printing, a spray method, roll coating and the like, but is not limited thereto.

In addition to such a method, the organic light emitting device may also be manufactured by consecutively laminating a cathode material, an organic material layer and an anode material on a substrate (International Patent Application Laid-Open Publication No. 2003/012890). However, the manufacturing method is not limited thereto.

As the first electrode material, materials having large work function are normally preferred so that hole injection to an organic material layer is smooth. Examples thereof include metals such as vanadium, chromium, copper, zinc and gold, or alloys thereof; metal oxides such as zinc oxide, indium oxide, indium tin oxide (ITO) and indium zinc oxide (IZO); combinations of metals and oxides such as ZnO:Al or SnO₂:Sb; conductive polymers such as poly(3-methylthiophene), poly[3,4-(ethylene-1,2-dioxy)thiophene] (PEDOT), polypyrrole and polyaniline, but are not limited thereto.

As the second electrode material, materials having small work function are normally preferred so that electron injection to an organic material layer is smooth. Examples thereof include metals such as magnesium, calcium, sodium, potassium, titanium, indium, yttrium, lithium, gadolinium, aluminum, silver, tin and lead, or alloys thereof; multilayer structure materials such as LiF/Al or LiO₂/Al, and the like, but are not limited thereto.

In the present specification, when the compound represented by Chemical Formula 1 is included in an organic material layer other than a light emitting layer, or an additional light emitting layer is provided, a light emitting material of the light emitting layer is a material capable of emitting light in a visible region by receiving holes and electrons from a hole transfer layer and an electron transfer layer, respectively, and binding the holes and the electrons, and is preferably a material having favorable quantum efficiency for fluorescence or phosphorescence. Examples thereof include 8-hydroxy-quinoline aluminum complexes (Alq₃); carbazole-based compounds; dimerized styryl compounds; BAlq; 10-hydroxybenzoquinoline-metal compounds; benzoxazole-, benzothiazole- and benzimidazole-based compounds; poly(p-phenylenevinylene) (PPV)-based polymers; spiro compounds; polyfluorene; rubrene and the like, but are not limited thereto.

The light emitting layer may include a host material and a dopant material. The host material includes fused aromatic ring derivatives, heteroring-containing compounds or the like. Specifically, the fused aromatic ring derivative includes anthracene derivatives, pyrene derivatives, naphthalene derivatives, pentacene derivatives, phenanthrene compounds, fluoranthene compounds and the like, and the heteroring-containing compound includes dibenzofuran derivatives, ladder-type furan compounds, pyrimidine derivatives and the like, however, the material is not limited thereto.

When including additional compounds in addition to the compound represented by Chemical Formula 1, the dopant material includes aromatic amine derivatives, styrylamine compounds, boron complexes, fluoranthene compounds, metal complexes and the like. Specifically, the aromatic amine derivative is a fused aromatic ring derivative having a substituted or unsubstituted arylamine group and includes arylamine group-including pyrene, anthracene, chrysene, peryflanthene and the like. In addition, the styrylamine compound is a compound in which substituted or unsubstituted arylamine is substituted with at least one arylvinyl group, and one, two or more substituents selected from the group consisting of an aryl group, a silyl group, an alkyl group, a cycloalkyl group and an arylamine group are substituted or unsubstituted. Specifically, styrylamine, styryldiamine, styryltriamine, styryltetramine or the like is included, however, the styrylamine compound is not limited thereto. In addition, the metal complex includes iridium complexes, platinum complexes or the like, but is not limited thereto.

The hole injection layer is a layer injecting holes from an electrode. The hole injection material preferably has, by having an ability to transfer holes, a hole injection effect from a first electrode and an excellent hole injection effect for a light emitting layer or a light emitting material. In addition, the hole injection material is preferably a material having an excellent ability to prevent excitons generated in the light emitting layer from moving to an electron injection layer or an electron injection material. In addition, a material having an excellent thin film forming ability is preferred. In addition, the HOMO (highest occupied molecular orbital) of the hole injection material is preferably in between the work function of a first electrode material and the HOMO of surrounding organic material layers. Specific examples of the hole injection material include metal porphyrins, oligothiophene, arylamine-based organic materials; carbazole-based organic materials; nitrile-based organic materials; hexanitrile hexaazatriphenylene-based organic materials; quinacridone-based organic materials; perylene-based organic materials; polythiophene-based conductive polymers such as anthraquinone or polyaniline, and the like, or a mixture of two or more of the examples described above, but are not limited thereto.

According to one embodiment of the present specification, the hole injection layer includes a compound represented by the following Chemical Formula HI-1.

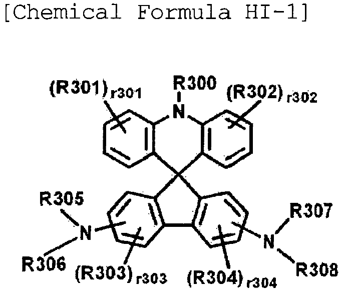

In Chemical Formula HI-1,
R301 to R308 are the same as or different from each other, and each independently hydrogen; deuterium; a cyano group; a substituted or unsubstituted alkyl group; a substituted or unsubstituted amine group; a substituted or unsubstituted aryl group; or a substituted or unsubstituted heteroaryl group, or bond to adjacent groups to form a substituted or unsubstituted ring,
r301 and r302 are each an integer of 1 to 4,
r303 and r304 are each an integer of 1 to 3,
when r301 is 2 or greater, R301s are the same as or different from each other,
when r302 is 2 or greater, R302s are the same as or different from each other,
when r303 is 2 or greater, R303s are the same as or different from each other, and
when r304 is 2 or greater, R304s are the same as or different from each other.

According to one embodiment of the present specification, R301 to R304 are hydrogen.

According to one embodiment of the present specification, R300 is a substituted or unsubstituted aryl group.

According to one embodiment of the present specification, R300 is a monocyclic or polycyclic aryl group having 6 to 30 carbon atoms.

According to one embodiment of the present specification, R300 is a phenyl group.

According to one embodiment of the present specification, R300 bonds to R301 or R302 to form a substituted or unsubstituted ring.

According to one embodiment of the present specification, R300 bonds to R301 or R302 to form a substituted or unsubstituted heteroring.

According to one embodiment of the present specification, R300 bonds to R301 or R302 to form a monocyclic or polycyclic heteroring having 2 to 30 carbon atoms.

According to one embodiment of the present specification, R300 bonds to R301 or R302 to form indole.

According to one embodiment of the present specification, R305 to R308 are the same as or different from each other, and each independently a substituted or unsubstituted aryl group; or a substituted or unsubstituted amine group.

According to one embodiment of the present specification, R305 to R308 are the same as or different from each other, and each independently a monocyclic or polycyclic aryl group having 6 to 30 carbon atoms; or a monocyclic or polycyclic diarylamine group having 6 to 30 carbon atoms.

According to one embodiment of the present specification, R305 to R308 are the same as or different from each other, and each independently a phenyl group; or a diphenylamine group.

According to one embodiment of the present specification, Chemical Formula HI-1 is represented by the following compound.

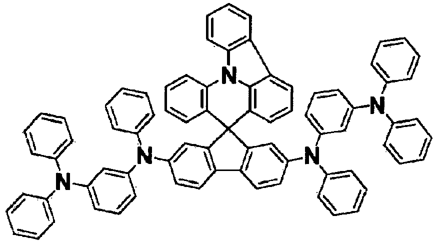

According to one embodiment of the present specification, the hole injection layer includes a compound represented by the following Chemical Formula HI-2.

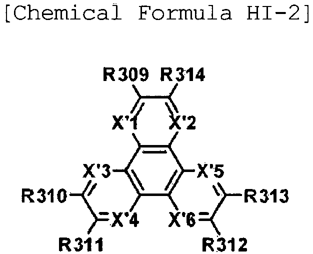

In Chemical Formula HI-2,
at least one of X'1 to X'6 is N, and the rest are CH, and
R309 to R314 are the same as or different from each other, and each independently hydrogen; deuterium; a cyano group; a substituted or unsubstituted alkyl group; a substituted or unsubstituted amine group; a substituted or unsubstituted aryl group; or a substituted or unsubstituted heteroaryl group, or bond to adjacent groups to form a substituted or unsubstituted ring.

According to one embodiment of the present specification, X'1 to X'6 are N.

According to one embodiment of the present specification, R309 to R314 are a cyano group.

According to one embodiment of the present specification, Chemical Formula HI-2 is represented by the following compound.

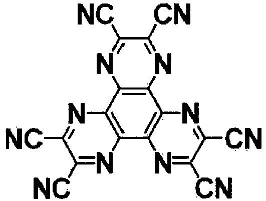

The hole transfer layer is a layer receiving holes from a hole injection layer and transferring the holes to a light emitting layer. As the hole transfer material, materials capable of receiving holes from a first electrode or a hole injection layer and moving the holes to a light emitting layer, and having high mobility for the holes are preferred. Specific examples thereof include arylamine-based organic materials, carbazole-based organic materials, conductive polymers, block copolymers having conjugated parts and non-conjugated parts together, and the like, but are not limited thereto.

According to one embodiment of the present specification, the hole transfer layer includes a compound represented by the following Chemical Formula HT-1.

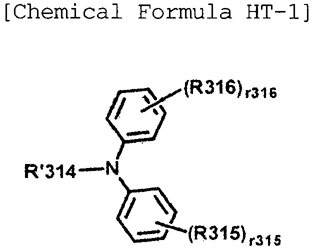

In Chemical Formula HT-1,
R'314, R315 and R316 are the same as or different from each other, and each independently one selected from the group consisting of hydrogen; deuterium; a substituted or unsubstituted alkyl group; a substituted or unsubstituted aryl group; a substituted or unsubstituted heteroaryl group; and a combination thereof, or bond to adjacent groups to form a substituted or unsubstituted ring,
r315 is an integer of 1 to 4, and when r315 is 2 or greater, the two or more R315s are the same as or different from each other, and
r316 is an integer of 1 to 4, and when r316 is 2 or greater, the two or more R316s are the same as or different from each other.

According to one embodiment of the present specification, R'314 is one selected from the group consisting of a substituted or unsubstituted aryl group; a substituted or unsubstituted heteroaryl group; and a combination thereof.

According to one embodiment of the present specification, R'314 is one selected from the group consisting of a carbazole group; a phenyl group; a biphenyl group; and a combination thereof.

According to one embodiment of the present specification, R315 and R316 are the same as or different from each other, and each independently a substituted or unsubstituted aryl group, or bond to adjacent groups to form an aromatic hydrocarbon ring substituted with an alkyl group.

According to one embodiment of the present specification, R315 and R316 are the same as or different from each other, and each independently a phenyl group, or bond to adjacent groups to form indene substituted with a methyl group.

According to one embodiment of the present specification, Chemical Formula HT-1 is selected from among the following compounds.

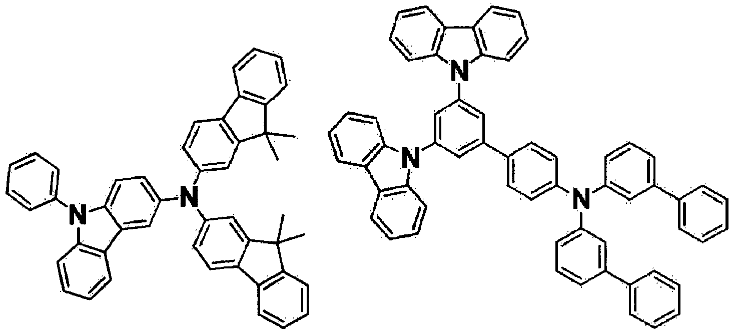

The electron transfer layer is a layer receiving electrons from an electron injection layer and transferring the electrons to a light emitting layer. As the electron transfer material, materials capable of favorably receiving electrons from a second electrode and moving the electrons to a light emitting layer, and having high mobility for the electrons are preferred. Specific examples thereof include Al complexes of 8-hydroxyquinoline; complexes including Alq₃; organic radical compounds; hydroxyflavon-metal complexes; triazine derivatives; LiQ and the like, but are not limited thereto. The electron transfer layer may be used together with any desired first electrode material as used in the art. Particularly, the suitable first electrode material is a common material having low work function and having an aluminum layer or a silver layer following. Specifically, cesium, barium, calcium, ytterbium, samarium and the like are included, and in each case, an aluminum layer or a silver layer follows.

According to one embodiment of the present specification, the electron transfer layer includes a compound represented by the following Chemical Formula ET-1.

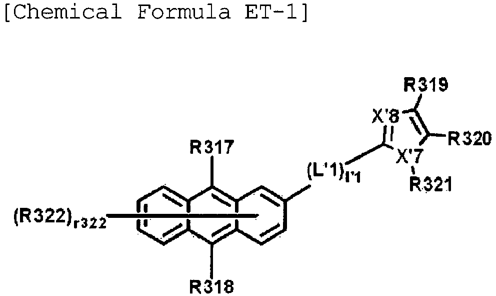

In Chemical Formula ET-1,
at least one of X'7 and X'8 is N, and the other one is CH,
R317 to R322 are the same as or different from each other, and each independently hydrogen; deuterium; a cyano group; a substituted or unsubstituted alkyl group; a substituted or unsubstituted amine group; a substituted or unsubstituted aryl group; or a substituted or unsubstituted heteroaryl group, or bond to adjacent groups to form a substituted or unsubstituted ring,
L'1 is a direct bond; a substituted or unsubstituted arylene group; or a substituted or unsubstituted heteroarylene group,
r322 is an integer of 1 to 7, and when r322 is 2 or greater, R322s are the same as or different from each other, and
l'1 is an integer of 1 to 5, and when l'1 is 2 or greater, L'1s are the same as or different from each other.

According to one embodiment of the present specification, R317 to R322 are the same as or different from each other, and each independently hydrogen; or a substituted or unsubstituted aryl group, and adjacent groups bond to each other to form a substituted or unsubstituted aromatic hydrocarbon ring.

According to one embodiment of the present specification, R317 to R322 are the same as or different from each other, and each independently hydrogen; a phenyl group; or a naphthyl group, or adjacent groups bond to each other to form benzene.

According to one embodiment of the present specification, L'1 is a substituted or unsubstituted arylene group.

According to one embodiment of the present specification, L'1 is a phenylene group.

According to one embodiment of the present specification, ET-1 is represented by the following compound.

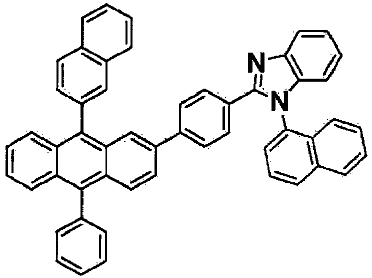

According to one embodiment of the present specification, the electron transfer layer includes a compound represented by the following Chemical Formula ET-2.

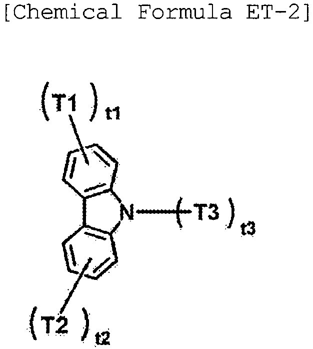

In Chemical Formula ET-2,
T1 to T3 are the same as or different from each other, and each independently one selected from the group consisting of hydrogen; deuterium; a cyano group; a substituted or unsubstituted alkyl group; a substituted or unsubstituted amine group; a substituted or unsubstituted aryl group; a substituted or unsubstituted heteroaryl group; and a combination thereof, or bond to adjacent groups to form a substituted or unsubstituted ring,
t1 is an integer of 1 to 4, and when t1 is 2 or greater, the two or more T1s are the same as or different from each other,
t2 is an integer of 1 to 4, and when t2 is 2 or greater, the two or more T2s are the same as or different from each other, and
t3 is an integer of 1 to 10, and when t3 is 2 or greater, the two or more T3s are the same as or different from each other.

According to one embodiment of the present specification, T1 to T3 are the same as or different from each other, and each independently one selected from the group consisting of hydrogen; a substituted or unsubstituted aryl group; a substituted or unsubstituted heteroaryl group; and a combination thereof.

According to one embodiment of the present specification, T1 to T3 are the same as or different from each other, and each independently one selected from the group consisting of hydrogen; a carbazole group; a phenyl group; a biphenyl group; a triazine group; and a combination thereof.

According to one embodiment of the present specification, ET-2 is represented by the following compound.

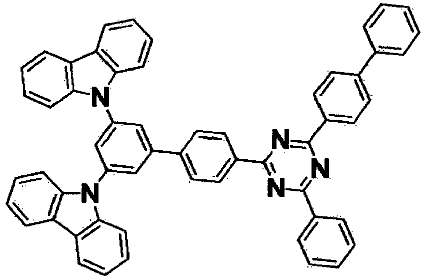

The electron transfer layer may further include a metal complex. As the metal, metals used in the art may be used.

The electron injection layer is a layer injecting electrons from an electrode. As the electron injection material, materials having an excellent electron transferring ability, having an electron injection effect from a second electrode, and having an excellent electron injection effect for a light emitting layer or light emitting material are preferred. In addition, materials preventing excitons generated in the light emitting layer from moving to a hole injection layer, and having an excellent thin film forming ability are preferred. Specific examples thereof include fluorenone, anthraquinodimethane, diphenoquinone, thiopyran dioxide, oxazole, oxadiazole, triazole, triazine, imidazole, perylene tetracarboxylic acid, fluorenylidene methane, anthrone or the like, and derivatives thereof, metal complex compounds, nitrogen-containing 5-membered ring derivatives, a mixture of two or more of the examples described above, and the like, but are not limited thereto.

The metal complex compound includes 8-hydroxyquinolinato lithium, bis(8-hydroxyquinolinato)zinc, bis(8-hydroxyquinolinato) copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium and the like, but is not limited thereto.

The electron blocking layer is a layer capable of enhancing lifetime and efficiency of a device by preventing electrons injected from an electron injection layer from passing a light emitting layer and entering a hole injection layer. Known material may be used without limit, and the electron blocking layer may be formed either between the light emitting layer and the hole injection layer, or between the light emitting layer and a layer carrying out hole injection and hole transfer at the same time.

According to one embodiment of the present specification, the electron blocking layer is represented by Chemical Formula HT-1.

The hole blocking layer is a layer blocking holes from passing a light emitting layer and reaching a cathode, and may be generally formed under the same condition as an electron injection layer. Specific examples thereof may include oxadiazole derivatives, triazole derivatives, phenanthroline derivatives, aluminum complexes, pyridine, pyrimidine, triazine derivatives or the like, but are not limited thereto.

The organic light emitting device according to the present specification may be a top-emission type, a bottom-emission type or a dual-emission type depending on the materials used.

In one embodiment of the present specification, the compound represented by Chemical Formula 1 may be included in an organic solar cell or an organic transistor in addition to an organic light emitting device.

The compound according to the present specification may also be used in an organic light emitting device including an organic phosphorescent device, an organic solar cell, an organic photo conductor, an organic transistor and the like under a similar principle used in the organic light emitting device. For example, the organic solar cell may have a structure including an anode, a cathode and a photoactive layer provided between the anode and the cathode, and the photoactive layer may include the compound.

The organic light emitting device according to the present specification may be included in various electronic devices and used. For example, the electronic device may be a display panel, a touch panel, a solar module, an illumination device or the like, but is not limited thereto.

The organic light emitting device of the present specification may be manufactured using common organic light emitting device manufacturing methods and materials except that one or more organic material layers are formed using the compound described above.

Hereinafter, the present specification will be described in detail with reference to examples, comparative examples and the like. However, the examples and the comparative examples according to the present specification may be modified to various other forms, and the scope of the present specification is not to be construed as being limited to the examples and the comparative examples described below. Examples and comparative examples of the present specification are provided in order to more fully describe the present specification to those having average knowledge in the art.

In addition, according to one embodiment of the present specification, compounds of the following synthesis examples are examples of Chemical Formula 1 of the present specification, and Chemical Formula 1 includes one of Compounds M1 to M5 and M7 to M16, M18 to M84, M86 to M115, M117 to M128, M130, M131, M133 to M144 and M146 to M150 of the following Synthesis Examples 1 to 5 and 7 to 16, 18 to 84, 86 to 115, 117 to 128, 130, 131, 133 to 144 and 146 to 150.

### Synthesis Example 1. Synthesis of Compound M1

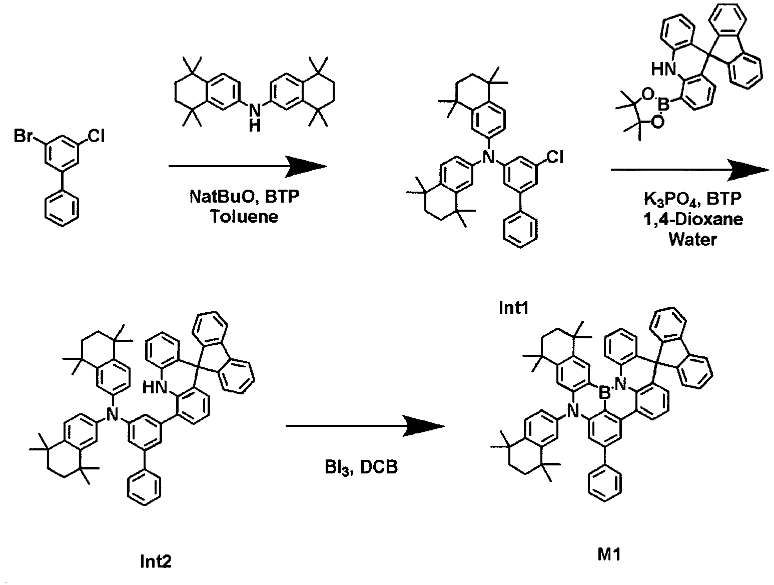

### 1) Synthesis of Int1

Under the nitrogen atmosphere, 3-bromo-5-chloro-1,1'-biphenyl (30 g), bis(5,5,8,8-tetramethyl-5,6,7,8-tetrahydronaphthalen-2-yl)amine (43.7 g), sodium-tert-butoxide (32.3 g) and bis (tri-tert-butylphosphine)palladium(0) (1.2 g) were introduced to toluene (600 ml), and refluxed for 2 hours. After the reaction was finished, the result was extracted, and then recrystallized to obtain Int1 (51 g, yield 79%) . MS[M+H]+=577

### 2) Synthesis of Int2

Int1 (30 g), 4-(4,4,5,5-tetramethyl-1,3,2-dioxaborolan-2-yl)-10H-spiro[acridine-9,9'-fluorene] (23.8 g), tripotassium phosphate (33.2 g) and bis(tri-tert-butylphosphine)palladium(0) (0.5 g) were introduced to 1,4-dioxane (300 ml) and water (100 ml), and refluxed for 4 hours. After the reaction was finished, the result was extracted, and then recrystallized to obtain Int2 (33 g, yield 73%). MS[M+H]+=872

### 3) Synthesis of Compound M1

Under the nitrogen atmosphere, Int2 (25 g) and boron triiodide (19.1 g) were introduced to 1,2-dichlorobenzene (250 ml), and stirred for 4 hours at 160°C. After the reaction was finished, the result was extracted, and then recrystallized to obtain Compound M1 (8.1 g, yield 32%). MS[M+H]+=880

### Synthesis Example 2. Synthesis of Compound M2

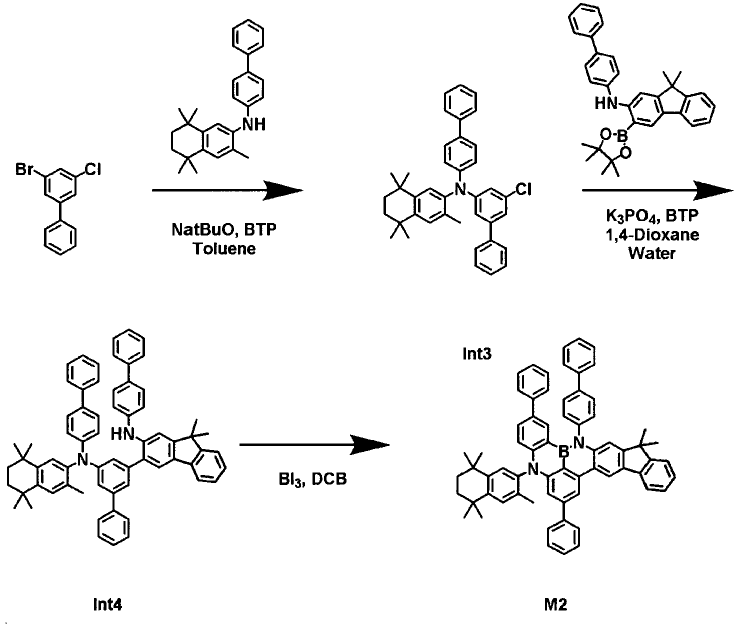

### 1) Synthesis of Int3

The same equivalents and method were used as in the synthesis process of Int1 using N-([1,1'-biphenyl]-4-yl)-3,5,5,8,8-pentamethyl-5,6,7,8-tetrahydronaphthalen-2-amine instead of bis(5,5,8,8-tetramethyl-5,6,7,8-tetrahydronaphthalen-2-yl)amine, and after the reaction was finished, the result was extracted and then recrystallized to obtain Int3 (48.5 g, yield 78%). MS[M+H]+=557

### 2) Synthesis of Int4

The same equivalents and method were used as in the synthesis process of Int2 using Int3 and N-([1,1'-biphenyl]-4-yl)-9,9-dimethyl-3-(4,4,5,5-tetramethyl-1,3,2-dioxaborolan-2-yl)-9H-fluoren-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int4 (35.7 g, yield 75%). MS[M+H]+=882

### 3) Synthesis of Compound M2

Under the nitrogen atmosphere, Int4 (25 g) and boron triiodide (18.9 g) were introduced to 1,2-dichlorobenzene (250 ml), and stirred for 4 hours at 160°C. After the reaction was finished, the result was extracted, and then recrystallized to obtain Compound M2 (7.3 g, yield 29%). MS[M+H]+=890

### Synthesis Example 3. Synthesis of Compound M3

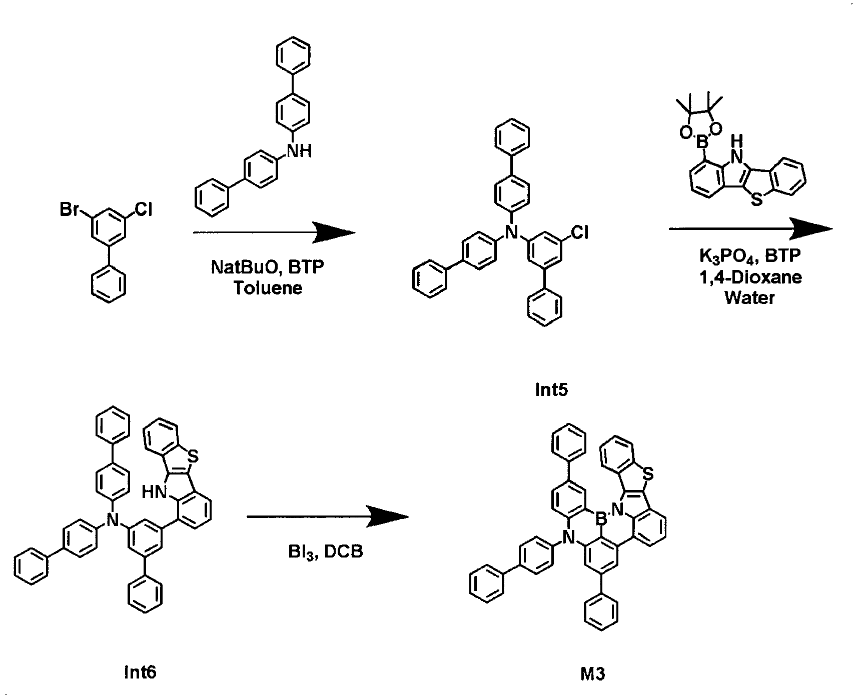

### 1) Synthesis of Int5

The same equivalents and method were used as in the synthesis process of Int1 using di([1,1'-biphenyl]-4-yl)amine instead of bis(5,5,8,8-tetramethyl-5,6,7,8-tetrahydronaphthalen-2-yl)amine, and after the reaction was finished, the result was extracted and then recrystallized to obtain Int5 (45.4 g, yield 80%). MS[M+H]+=509

### 2) Synthesis of Int6

The same equivalents and method were used as in the synthesis process of Int2 using Int5 and 1-(4,4,5,5-tetramethyl-1,3,2-dioxaborolan-2-yl)-10H-benzo[4,5]thieno[3,2-b]indole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int6 (32.3 g, yield 79%). MS[M+H]+=695

### 3) Synthesis of Compound M3

Under the nitrogen atmosphere, Int6 (25 g) and boron triiodide (23.9 g) were introduced to 1,2-dichlorobenzene (250 ml), and stirred for 4 hours at 160°C. After the reaction was finished, the result was extracted, and then recrystallized to obtain Compound M3 (7.2 g, yield 28%). MS[M+H]+=703

### Synthesis Example 4. Synthesis of Compound M4

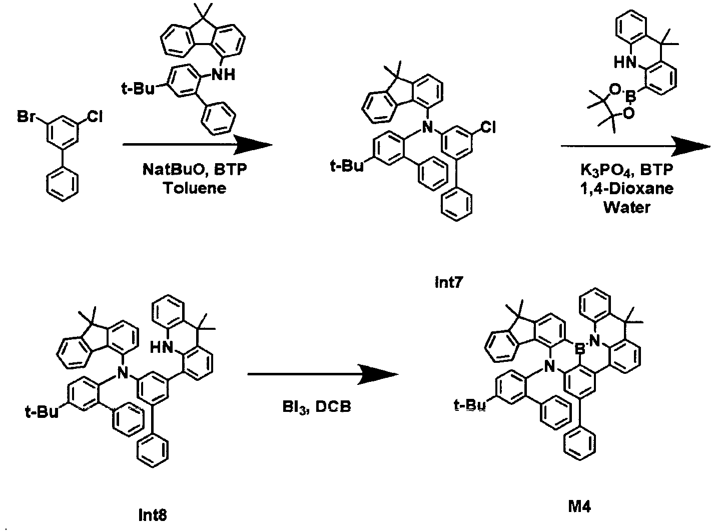

### 1) Synthesis of Int7

The same equivalents and method were used as in the synthesis process of Int1 using N-(5-(tert-butyl)-[1,1'-biphenyl]-2-yl)-9,9-dimethyl-9H-fluoren-4-amine instead of bis(5,5,8,8-tetramethyl-5,6,7,8-tetrahydronaphthalen-2-yl)amine, and after the reaction was finished, the result was extracted and then recrystallized to obtain Int7 (51.1 g, yield 75%). MS[M+H]+=605

### 2) Synthesis of Int8

The same equivalents and method were used as in the synthesis process of Int2 using Int7 and 9,9-dimethyl-4-(4,4,5,5-tetramethyl-1,3,2-dioxaborolan-2-yl)-9,10-dihydroacridine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int8 (28.8 g, yield 75%). MS[M+H]+=778

### 3) Synthesis of Compound M4

Under the nitrogen atmosphere, Int8 (25 g) and boron triiodide (21.4 g) were introduced to 1,2-dichlorobenzene (250 ml), and stirred for 4 hours at 160°C. After the reaction was finished, the result was extracted, and then recrystallized to obtain Compound M4 (7.1 g, yield 28%). MS[M+H]+=786

### Synthesis Example 5. Synthesis of Compound M5

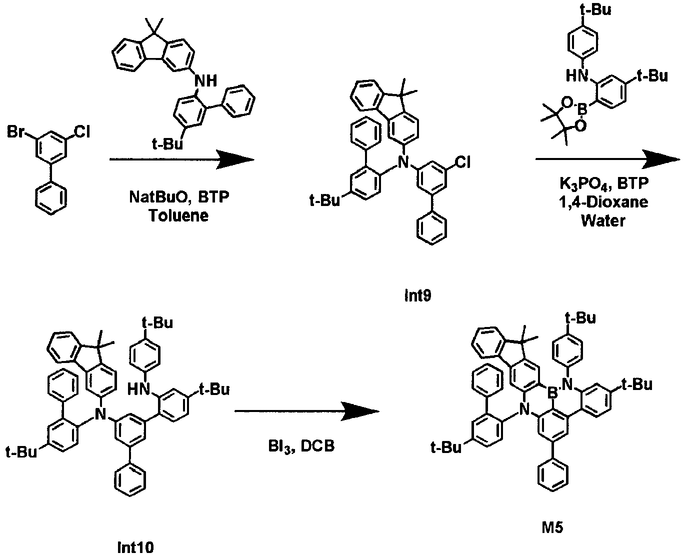

### 1) Synthesis of Int9

The same equivalents and method were used as in the synthesis process of Int1 using N-(5-(tert-butyl)-[1,1'-biphenyl]-2-yl)-9,9-dimethyl-9H-fluoren-3-amine instead of bis(5,5,8,8-tetramethyl-5,6,7,8-tetrahydronaphthalen-2-yl)amine, and after the reaction was finished, the result was extracted and then recrystallized to obtain Int9 (52.5 g, yield 77%). MS[M+H]+=605

### 2) Synthesis of IntlO

The same equivalents and method were used as in the synthesis process of Int2 using Int9 and 5-(tert-butyl)-N-(4-(tert-butyl)phenyl)-2-(4,4,5,5-tetramethyl-1,3,2-dioxaborolan-2-yl)aniline instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int10 (33.1 g, yield 79%). MS[M+H]+=850

### 3) Synthesis of Compound M5

Under the nitrogen atmosphere, Int10 (25 g) and boron triiodide (19.6 g) were introduced to 1,2-dichlorobenzene (250 ml), and stirred for 4 hours at 160°C. After the reaction was finished, the result was extracted, and then recrystallized to obtain Compound M5 (7.4 g, yield 29%). MS[M+H]+=858

### Synthesis Example 7. Synthesis of Compound M7

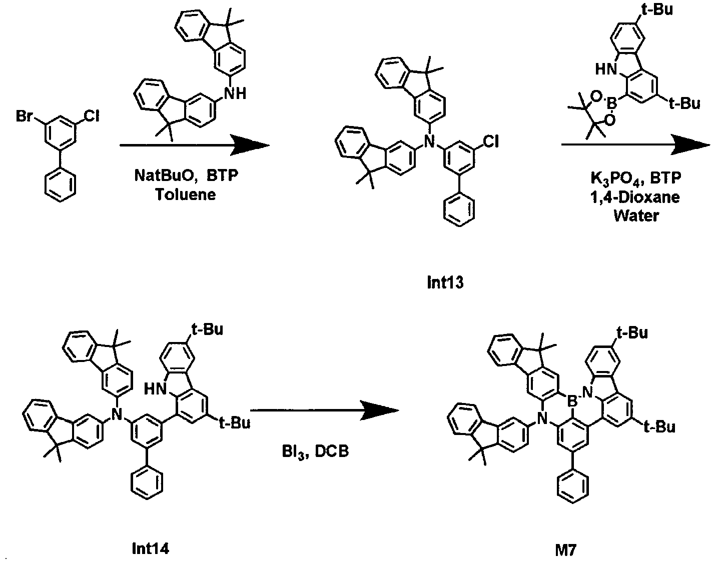

### 1) Synthesis of Int13

The same equivalents and method were used as in the synthesis process of Int1 using bis(9,9-dimethyl-9H-fluoren-3-yl)amine instead of bis(5,5,8,8-tetramethyl-5,6,7,8-tetrahydronaphthalen-2-yl)amine, and after the reaction was finished, the result was extracted and then recrystallized to obtain Int13 (49.5 g, yield 75%). MS[M+H]+=589

### 2) Synthesis of Int14

The same equivalents and method were used as in the synthesis process of Int2 using Int13 and 3,6-di-tert-butyl-1-(4,4,5,5-tetramethyl-1,3,2-dioxaborolan-2-yl)-9H-carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int14 (31.2 g, yield 74%). MS[M+H]+=832

### 3) Synthesis of Compound M7

Under the nitrogen atmosphere, Int14 (25 g) and boron triiodide (20.0 g) were introduced to 1,2-dichlorobenzene (250 ml), and stirred for 4 hours at 160°C. After the reaction was finished, the result was extracted, and then recrystallized to obtain Compound M7 (7.3 g, yield 29%). MS[M+H]+=840

### Synthesis Example 8. Synthesis of Compound M8

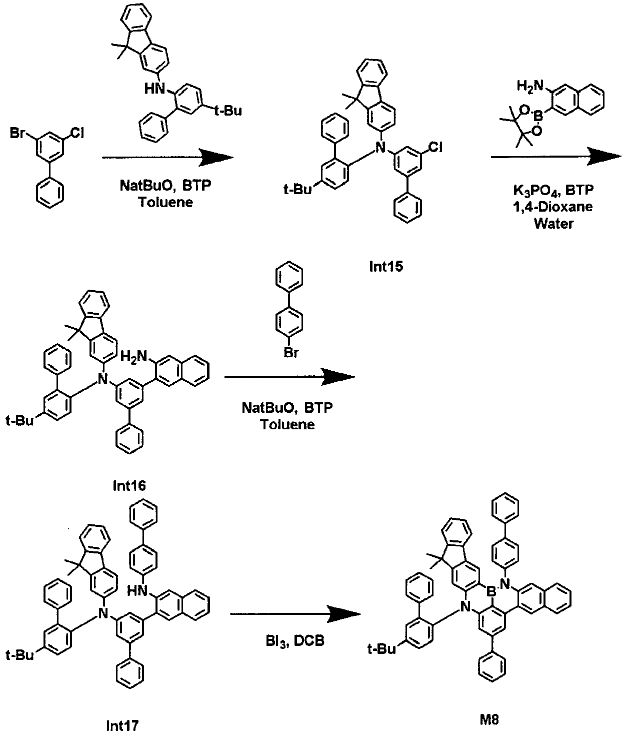

### 1) Synthesis of Int15

The same equivalents and method were used as in the synthesis process of Int1 using N-(5-(tert-butyl)-[1,1'-biphenyl]-2-yl)-9,9-dimethyl-9H-fluoren-2-amine instead of bis(5,5,8,8-tetramethyl-5,6,7,8-tetrahydronaphthalen-2-yl)amine, and after the reaction was finished, the result was extracted and then recrystallized to obtain Int15 (49.7 g, yield 73%). MS[M+H]+=605

### 2) Synthesis of Int16

The same equivalents and method were used as in the synthesis process of Int2 using Int15 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int16 (27.1 g, yield 77%). MS[M+H]+=711

### 3) Synthesis of Int17

The same equivalents and method were used as in the synthesis process of Int1 using Int16 (27 g) and 4-bromo-1,1'-biphenyl (8.9 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int17 (26 g, yield 79%). MS[M+H]+=864

### 4) Synthesis of Compound M8

Under the nitrogen atmosphere, Int17 (25 g) and boron triiodide (19.3 g) were introduced to 1,2-dichlorobenzene (250 ml), and stirred for 4 hours at 160°C. After the reaction was finished, the result was extracted, and then recrystallized to obtain Compound M8 (7.4 g, yield 29%). MS[M+H]+=872

### Synthesis Example 9. Synthesis of Compound M9

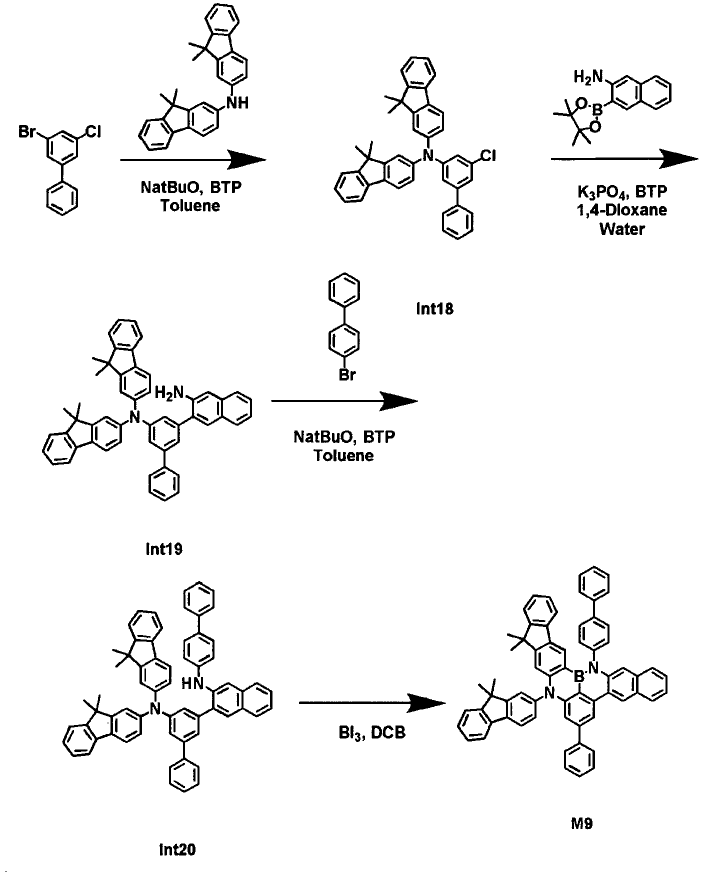

### 1) Synthesis of Int18

The same equivalents and method were used as in the synthesis process of Int1 using bis(9,9-dimethyl-9H-fluoren-2-yl)amine instead of bis(5,5,8,8-tetramethyl-5,6,7,8-tetrahydronaphthalen-2-yl)amine, and after the reaction was finished, the result was extracted and then recrystallized to obtain Int18 (48.7 g, yield 74%). MS[M+H]+=589

### 2) Synthesis of Int19

The same equivalents and method were used as in the synthesis process of Int2 using Int18 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int19 (28.1 g, yield 79%). MS[M+H]+=695

### 3) Synthesis of Int20

The same equivalents and method were used as in the synthesis process of Int1 using Int19 (27 g) and 4-bromo-1,1'-biphenyl (9.1 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int20 (26.2 g, yield 80%). MS[M+H]+=848

### 4) Synthesis of Compound M9

Under the nitrogen atmosphere, Int20 (25 g) and boron triiodide (19.6 g) were introduced to 1,2-dichlorobenzene (250 ml), and stirred for 4 hours at 160°C. After the reaction was finished, the result was extracted, and then recrystallized to obtain Compound M9 (7.5 g, yield 30%). MS[M+H]+=856

### Synthesis Example 10. Synthesis of Compound M10

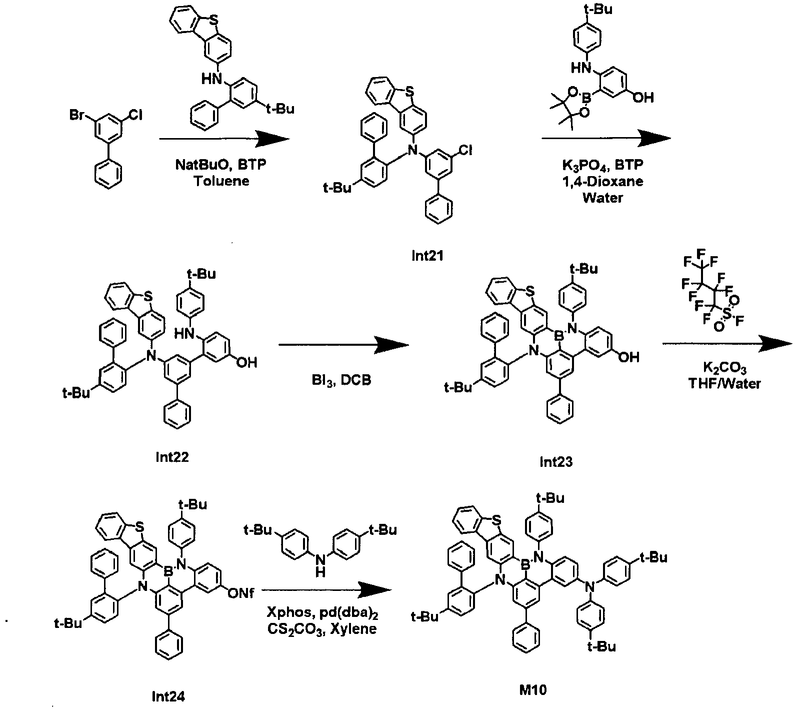

### 1) Synthesis of Int21

The same equivalents and method were used as in the synthesis process of Int1 using N-(5-(tert-butyl)-[1,1'-biphenyl]-2-yl)dibenzo[b,d]thiophen-2-amine instead of bis(5,5,8,8-tetramethyl-5,6,7,8-tetrahydronaphthalen-2-yl)amine, and after the reaction was finished, the result was extracted and then recrystallized to obtain Int21 (48.9 g, yield 73%). MS[M+H]+=595

### 2) Synthesis of Int22

The same equivalents and method were used as in the synthesis process of Int2 using Int21 and 4-((4-(tert-butyl)phenyl)amino)-3-(4,4,5,5-tetramethyl-1,3,2-dioxaborolan-2-yl)phenol instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int22 (30.2 g, yield 75%). MS[M+H]+=800

### 3) Synthesis of Int23

Under the nitrogen atmosphere, Int22 (25 g) and boron triiodide (20.8 g) were introduced to 1,2-dichlorobenzene (250 ml), and stirred for 4 hours at 160°C. After the reaction was finished, the result was extracted, and then recrystallized to obtain Int23 (7.4 g, yield 29%). MS[M+H]+=808

### 4) Synthesis of Int24

Int23 (7 g), 1,1,2,2,3,3,4,4,4-nonafluorobutane-1-sulfonyl fluoride (2.4 ml) and potassium carbonate (3.6 g) were introduced to tetrahydrofuran (70 ml) and water (30 ml), and stirred for 2 hours under reflux. After the reaction was finished, the result was extracted, and then column purified to obtain Int24 (9 g, yield 95%). MS[M+H]+=1089

### 5) Synthesis of Compound M10

Under the nitrogen atmosphere, Int24 (7 g), bis(4-(tert-butyl)phenyl)amine (1.8 g), pd(dba)₂ (0.11 g), Xphos (0.18 g) and cesium carbonate (6.3 g) were introduced to xylene (100 ml), and stirred for 12 hours under reflux. After the reaction was finished, the result was extracted, and then recrystallized to obtain Compound M10 (5 g, yield 73%). MS[M+H]+=1071

### Synthesis Example 11. Synthesis of Compound M11

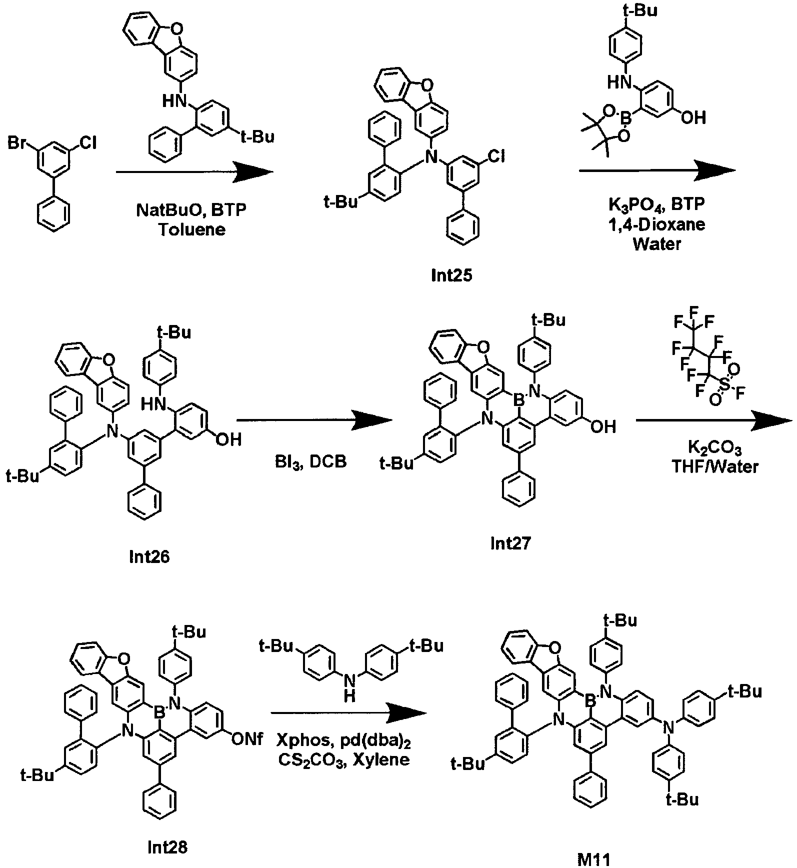

### 1) Synthesis of Int25

The same equivalents and method were used as in the synthesis process of Int1 using N-(5-(tert-butyl)-[1,1'-biphenyl]-2-yl)dibenzo[b,d]furan-2-amine instead of bis(5,5,8,8-tetramethyl-5,6,7,8-tetrahydronaphthalen-2-yl)amine, and after the reaction was finished, the result was extracted and then recrystallized to obtain Int25 (49.2 g, yield 76%). MS[M+H]+=579

### 2) Synthesis of Int26

The same equivalents and method were used as in the synthesis process of Int2 using Int25 and 4-((4-(tert-butyl)phenyl)amino)-3-(4,4,5,5-tetramethyl-1,3,2-dioxaborolan-2-yl)phenol instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int26 (30.1 g, yield 74%). MS[M+H]+=784

### 3) Synthesis of Int27

Under the nitrogen atmosphere, Int26 (25 g) and boron triiodide (21.3 g) were introduced to 1,2-dichlorobenzene (250 ml), and stirred for 4 hours at 160°C. After the reaction was finished, the result was extracted, and then recrystallized to obtain Int27 (7.5 g, yield 30%). MS[M+H]+=792

### 4) Synthesis of Int28

Int27 (7 g), 1,1,2,2,3,3,4,4,4-nonafluorobutane-1-sulfonyl fluoride (2.4 ml) and potassium carbonate (3.7 g) were introduced to tetrahydrofuran (70 ml) and water (30 ml), and stirred for 2 hours under reflux. After the reaction was finished, the result was extracted, and then column purified to obtain Int28 (9.1 g, yield 96%). MS[M+H]+=1074

### 5) Synthesis of Compound M11

Under the nitrogen atmosphere, Int28 (7 g), bis(4-(tert-butyl)phenyl)amine (1.84 g), pd(dba)₂ (0.11 g), Xphos (0.19 g) and cesium carbonate (6.4 g) were introduced to xylene (100 ml), and stirred for 12 hours under reflux. After the reaction was finished, the result was extracted, and then recrystallized toobtain Compound M11 (5.2 g, yield 76%). MS[M+H]+=1055

### Synthesis Example 12. Synthesis of Compound M12

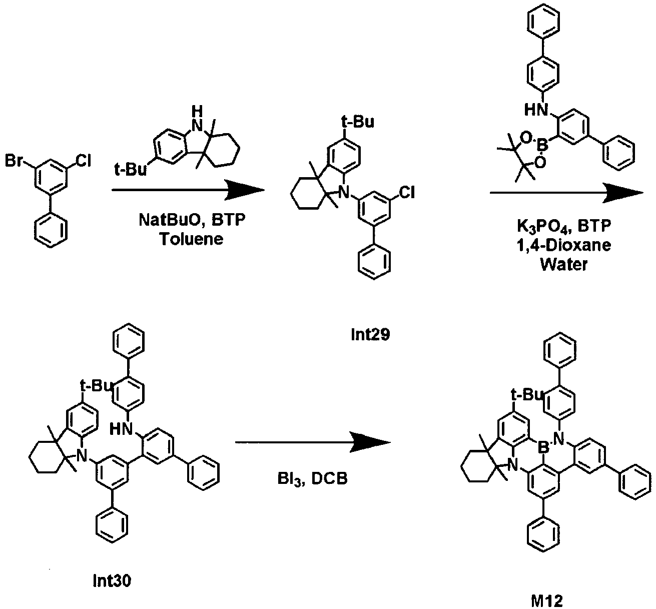

### 1) Synthesis of Int29

The same equivalents and method were used as in the synthesis process of Int1 using 6-(tert-butyl)-4a,9a-dimethyl-2,3,4,4a,9,9a-hexahydro-1H-carbazole instead of bis(5,5,8,8-tetramethyl-5,6,7,8-tetrahydronaphthalen-2-yl)amine, and after the reaction was finished, the result was extracted and then recrystallized to obtain Int29 (39 g, yield 78%). MS[M+H]+=445

### 2) Synthesis of Int30

Int30 (37 g, yield 75%) was obtained in the same manner as in the synthesis of Int2 except that Int29 and N-([1,1'-biphenyl]-4-yl)-3-(4,4,5,5-tetramethyl-1,3,2-dioxaborolan-2-yl)-[1,1'-biphenyl]-4-amine were used instead of Int1 and 4-(4,4,5,5-tetramethyl-1,3,2-dioxaborolan-2-yl)-10H-spiro[acridine-9,9'-fluorene]. MS[M+H]+=730

### 3) Synthesis of Compound M12

Under the nitrogen atmosphere, Int30 (25 g) and boron triiodide (22.8 g) were introduced to 1,2-dichlorobenzene (250 ml), and stirred for 4 hours at 160°C. After the reaction was finished, the result was extracted, and then recrystallized to obtain Compound M12 (7.7 g, yield 30%). MS[M+H]+=738

### Synthesis Example 13. Synthesis of Compound M13

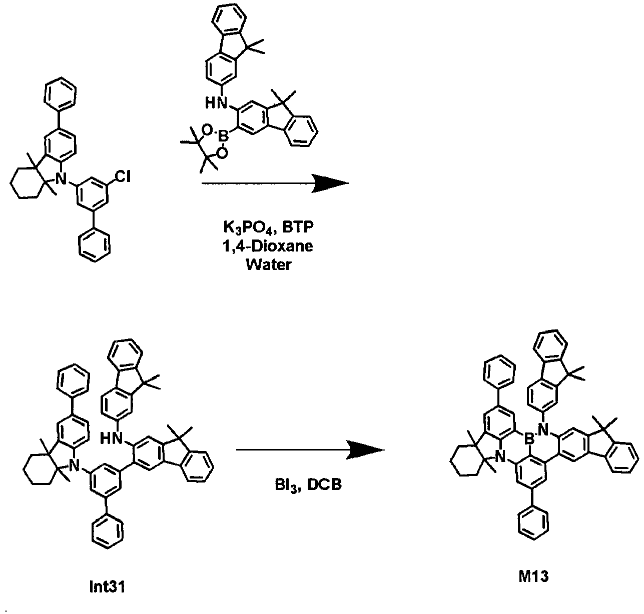

### 1) Synthesis of Int31

Int31 (39 g, yield 73%) was obtained in the same manner as in the synthesis of Int2 except that 9-(5-chloro-[1,1'-biphenyl]-3-yl)-4a,9a-dimethyl-6-phenyl-2,3,4,4a,9,9a-hexahydro-1H-carbazole and N-(9,9-dimethyl-9H-fluoren-2-yl)-9,9-dimethyl-3-(4,4,5,5-tetramethyl-1,3,2-dioxaborolan-2-yl)-9H-fluoren-2-amine were used instead of Int1 and 4-(4,4,5,5-tetramethyl-1,3,2-dioxaborolan-2-yl)-10H-spiro[acridine-9,9'-fluorene]. MS[M+H]+=830

### 2) Synthesis of Compound M13

Under the nitrogen atmosphere, Int31 (25 g) and boron triiodide (20.1 g) were introduced to 1,2-dichlorobenzene (250 ml), and stirred for 4 hours at 160°C. After the reaction was finished, the result was extracted, and then recrystallized to obtain Compound M13 (7.3 g, yield 29%). MS[M+H]+=838

### Synthesis Example 14. Synthesis of Compound M14

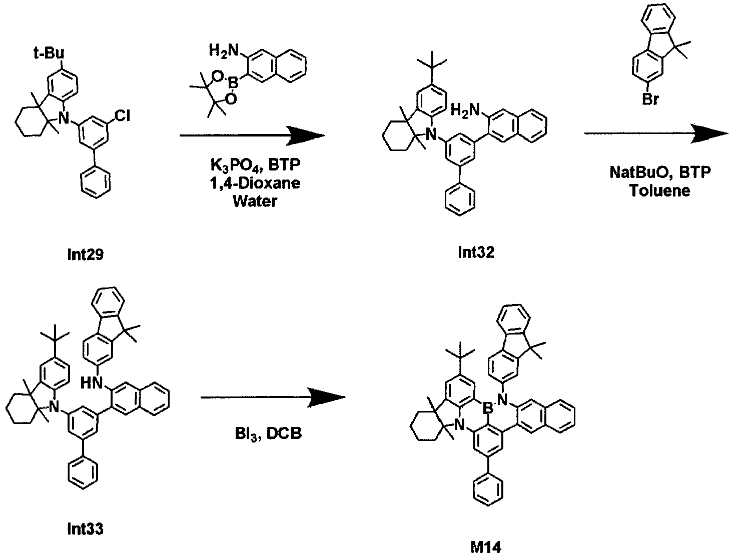

### 1) Synthesis of Int32

The same equivalents and method were used as in the synthesis process of Int2 using Int29 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int32 (29 g, yield 78%). MS[M+H]+=551

### 2) Synthesis of Int33

The same equivalents and method were used as in the synthesis process of Int1 using Int32 (27 g) and 2-bromo-9,9-dimethyl-9H-fluorene (13.4 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int33 (27.2 g, yield 75%). MS[M+H]+=744

### 3) Synthesis of Compound M14

Under the nitrogen atmosphere, Int33 (25 g) and boron triiodide (22.4 g) were introduced to 1,2-dichlorobenzene (250 ml), and stirred for 4 hours at 160°C. After the reaction was finished, the result was extracted, and then recrystallized to obtain Compound M14 (7.6 g, yield 30%). MS[M+H]+=752

### Synthesis Example 15. Synthesis of Compound M15

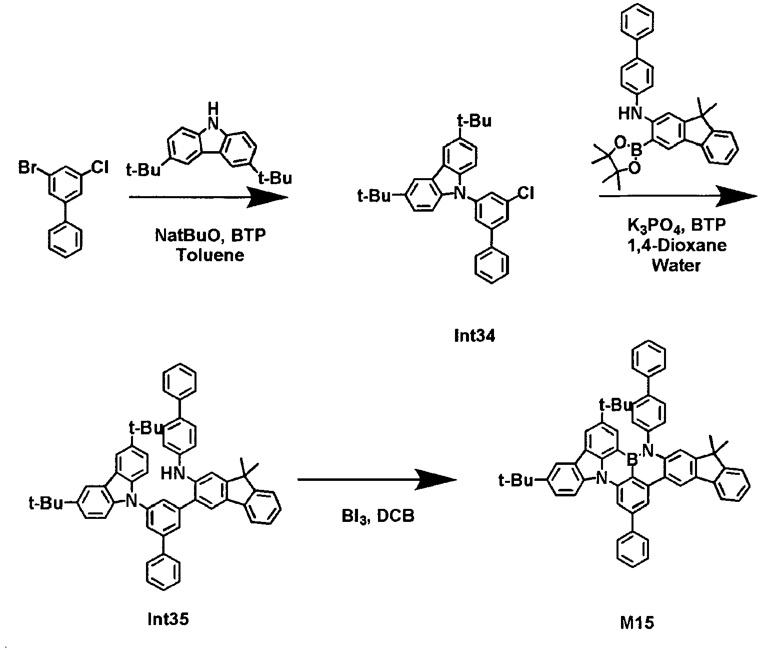

### 1) Synthesis of Int34

The same equivalents and method were used as in the synthesis process of Int1 using 3,6-di-tert-butyl-9H-carbazole instead of bis(5,5,8,8-tetramethyl-5,6,7,8-tetrahydronaphthalen-2-yl)amine, and after the reaction was finished, the result was extracted and then recrystallized to obtain Int34 (38.5 g, yield 74%). MS[M+H]+=467

### 2) Synthesis of Int35

The same equivalents and method were used as in the synthesis process of Int2 using Int34 and N-([1,1'-biphenyl]-4-yl)-9,9-dimethyl-3-(4,4,5,5-tetramethyl-1,3,2-dioxaborolan-2-yl)-9H-fluoren-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int35 (38.3 g, yield 75%). MS[M+H]+=792

### 3) Synthesis of Compound M15

Under the nitrogen atmosphere, Int35 (25 g) and boron triiodide (21.0 g) were introduced to 1,2-dichlorobenzene (250 ml), and stirred for 4 hours at 160°C. After the reaction was finished, the result was extracted, and then recrystallized to obtain Compound M15 (7.7 g, yield 31%). MS[M+H]+=800

### Synthesis Example 16. Synthesis of Compound M16

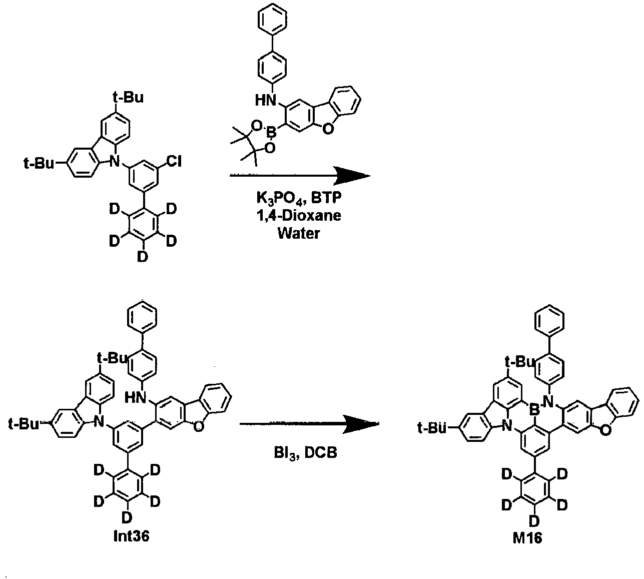

### 1) Synthesis of Int36

Int36 (38.2 g, yield 78%) was obtained in the same manner as in the synthesis of Int2 except that 3,6-di-tert-butyl-9-(5-chloro-[1,1'-biphenyl]-3-yl-2',3',4',5',6'-d5)-9H-carbazole and N-([1,1'-biphenyl]-4-yl)-3-(4,4,5,5-tetramethyl-1,3,2-dioxaborolan-2-yl)dibenzo[b,d]furan-2-amine were used instead of Int1 and 4-(4,4,5,5-tetramethyl-1,3,2-dioxaborolan-2-yl)-10H-spiro[acridine-9,9'-fluorene]. MS[M+H]+=771

### 2) Synthesis of Compound M16

Under the nitrogen atmosphere, Int36 (25 g) and boron triiodide (21.6 g) were introduced to 1,2-dichlorobenzene (250 ml), and stirred for 4 hours at 160°C. After the reaction was finished, the result was extracted, and then recrystallized to obtain Compound M16 (7.4 g, yield 29%). MS[M+H]+=779

### Synthesis Example 18. Synthesis of Compound M18

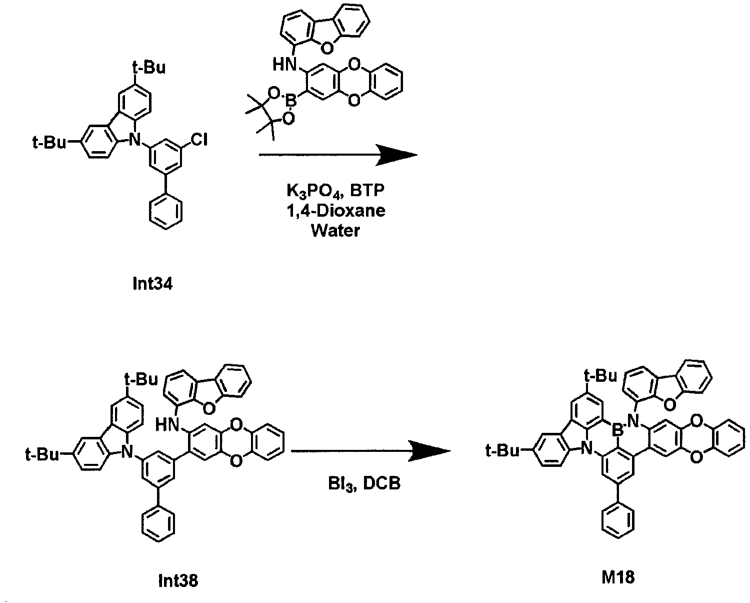

### 1) Synthesis of Int38

The same equivalents and method were used as in the synthesis process of Int2 using Int34 and N-(dibenzo[b,d]furan-4-yl)-3-(4,4,5,5-tetramethyl-1,3,2-dioxaborolan-2-yl)dibenzo[b,e][1,4]dioxin-2-amine instead of Int1 and 4-(4,4,5,5-tetramethyl-l,3,2-dioxaborolan-2-yl)-10H-spiro[acridine-9,9'-fluorene], and after the reaction was finished, the result was extracted and then recrystallized to obtain Int38 (40.2 g, yield 79%). MS[M+H]+=795

### 2) Synthesis of Compound M18

Under the nitrogen atmosphere, Int38 (25 g) and boron triiodide (20.9 g) were introduced to 1,2-dichlorobenzene (250 ml), and stirred for 4 hours at 160°C. After the reaction was finished, the result was extracted, and then recrystallized to obtain Compound M18 (7.7 g, yield 31%). MS[M+H]+=803

### Synthesis Example 19. Synthesis of Compound M19

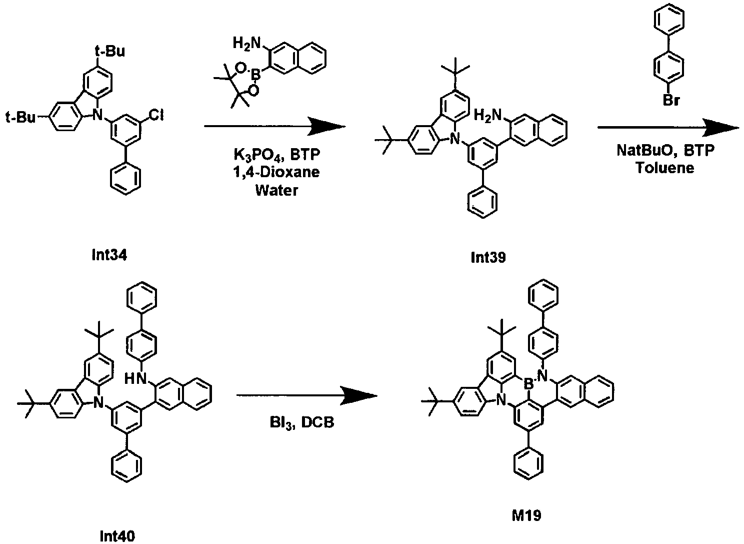

### 1) Synthesis of Int39

The same equivalents and method were used as in the synthesis process of Int2 using Int34 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int39 (27.3 g, yield 74%). MS[M+H]+=574

### 2) Synthesis of Int40

The same equivalents and method were used as in the synthesis process of Int1 using Int39 (27 g) and 4-bromo-1,1'-biphenyl (11 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int40 (27.1 g, yield 79%). MS[M+H]+=726

### 3) Synthesis of Compound M19

Under the nitrogen atmosphere, Int40 (25 g) and boron triiodide (23 g) were introduced to 1,2-dichlorobenzene (250 ml), and stirred for 4 hours at 160°C. After the reaction was finished, the result was extracted, and then recrystallized to obtain Compound M19 (7.4 g, yield 29%). MS[M+H]+=734

### Synthesis Example 20. Synthesis of Compound M20

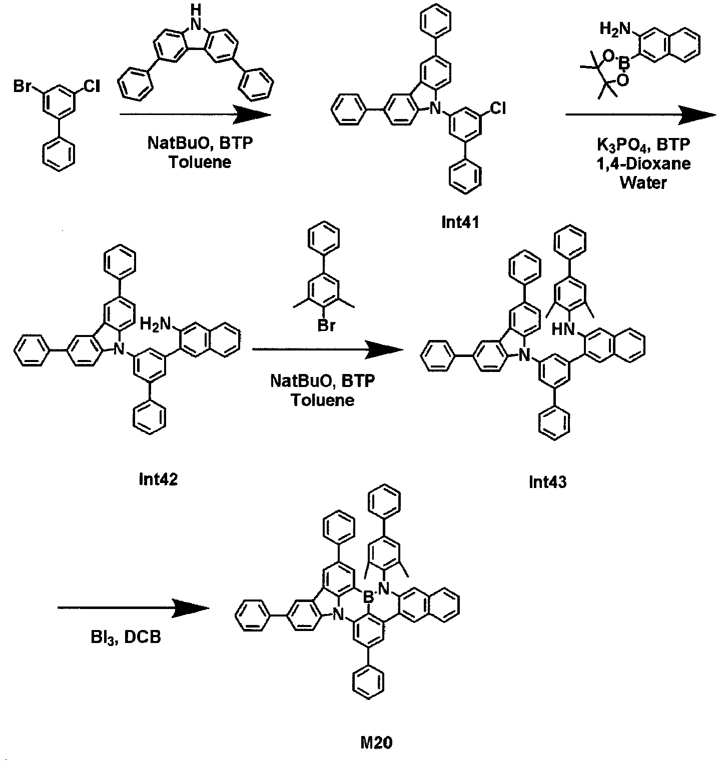

### 1) Synthesis of Int41

The same equivalents and method were used as in the synthesis process of Int1 using 3,6-diphenyl-9H-carbazole instead of bis(5,5,8,8-tetramethyl-5,6,7,8-tetrahydronaphthalen-2-yl)amine, and after the reaction was finished, the result was extracted and then recrystallized to obtain Int41 (41.4 g, yield 73%). MS[M+H]+=507

### 2) Synthesis of Int42

The same equivalents and method were used as in the synthesis process of Int2 using Int41 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int42 (27.7 g, yield 76%). MS[M+H]+=614

### 3) Synthesis of Int43

The same equivalents and method were used as in the synthesis process of Int1 using Int42 (27 g) and 4-bromo-3,5-dimethyl-1,1'-biphenyl (11.5 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int43 (26.5 g, yield 76%). MS[M+H]+=794

### 4) Synthesis of Compound M20

Under the nitrogen atmosphere, Int43 (25 g) and boron triiodide (21.0 g) were introduced to 1,2-dichlorobenzene (250 ml), and stirred for 4 hours at 160°C. After the reaction was finished, the result was extracted, and then recrystallized to obtain Compound M20 (7.5 g, yield 30%). MS[M+H]+=802

### Synthesis Example 21. Synthesis of Compound M21

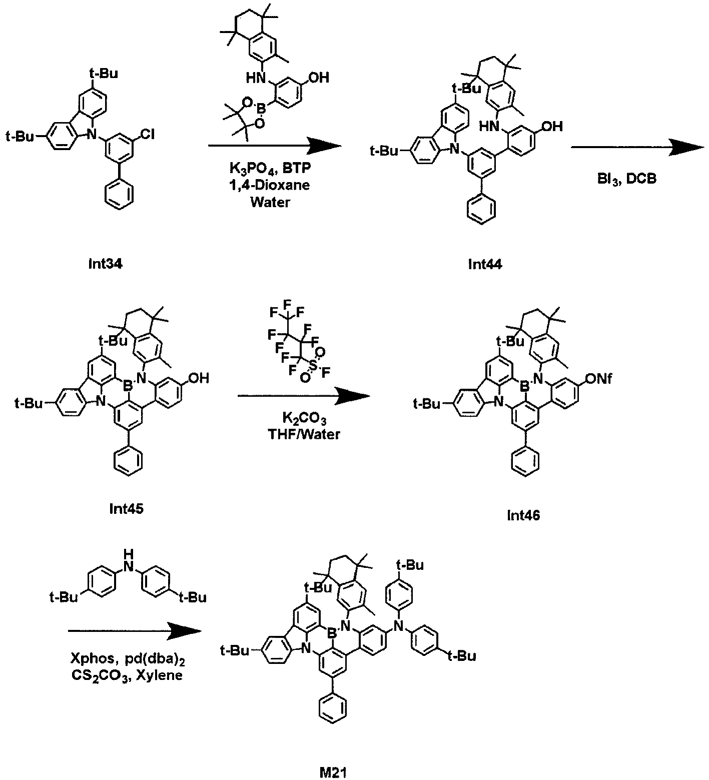

### 1) Synthesis of Int44

The same equivalents and method were used as in the synthesis process of Int2 using Int34 and 3-((3,5,5,8,8-pentamethyl-5,6,7,8-tetrahydronaphthalen-2-yl)amino)-4-(4,4,5,5-tetramethyl-1,3,2-dioxaborolan-2-yl)phenol instead of Int1 and, 4-(4,4,5,5-tetramethyl-1,3,2-dioxaborolan-2-yl)-10H-spiro[acridine-9,9'-fluorene], and after the reaction was finished, the result was extracted and then recrystallized to obtain Int44 (35.5 g, yield 75%). MS[M+H]+=740

### 2) Synthesis of Int45

Under the nitrogen atmosphere, Int44 (25 g) and boron triiodide (22.5 g) were introduced to 1,2-dichlorobenzene (250 ml), and stirred for 4 hours at 160°C. After the reaction was finished, the result was extracted, and then recrystallized to obtain Int45 (7.2 g, yield 28%). MS[M+H]+=748

### 3) Synthesis of Int46

Int45 (7 g), 1,1,2,2,3,3,4,4,4-nonafluorobutane-1-sulfonyl fluoride (2.5 ml) and potassium carbonate (3.9 g) were introduced to tetrahydrofuran (70 ml) and water (30 ml), and stirred for 2 hours under reflux. After the reaction was finished, the result was extracted, and then column purified to obtain Int46 (9.2 g, yield 95%). MS[M+H]+=1030

### 4) Synthesis of Compound M21

Under the nitrogen atmosphere, Int46 (7 g), bis(4-(tert-butyl)phenyl)amine (1.9 g), pd(dba)₂ (0.12 g), Xphos (0.19 g) and cesium carbonate (6.7 g) were introduced to xylene (100 ml), and stirred for 12 hours under reflux. After the reaction was finished, the result was extracted, and then recrystallized to obtain Compound M21 (5.4 g, yield 79%). MS[M+H]+=1011

### Synthesis Example 22. Synthesis of Compound M22

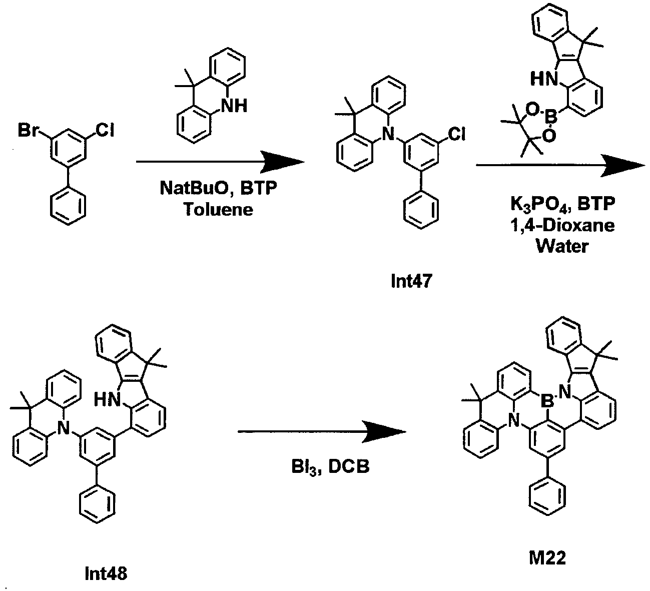

### 1) Synthesis of Int47

The same equivalents and method were used as in the synthesis process of Int1 using 9,9-dimethyl-9,10-dihydroacridine instead of bis(5,5,8,8-tetramethyl-5,6,7,8-tetrahydronaphthalen-2-yl)amine, and after the reaction was finished, the result was extracted and then recrystallized to obtain Int47 (34 g, yield 77%). MS[M+H]+=396

### 2) Synthesis of Int48

The same equivalents and method were used as in the synthesis process of Int2 using Int47 and 10,10-dimethyl-6-(4,4,5,5-tetramethyl-1,3,2-dioxaborolan-2-yl)-5,10-dihydroindeno[1,2-b]indole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int48 (35.1 g, yield 78%). MS[M+H]+=593

### 3) Synthesis of Compound M22

Under the nitrogen atmosphere, Int48 (25 g) and boron triiodide (28.1 g) were introduced to 1,2-dichlorobenzene (250 ml), and stirred for 4 hours at 160°C. After the reaction was finished, the result was extracted, and then recrystallized to obtain Compound M22 (6.7 g, yield 26%). MS[M+H]+=601

### Synthesis Example 23. Synthesis of Compound M23

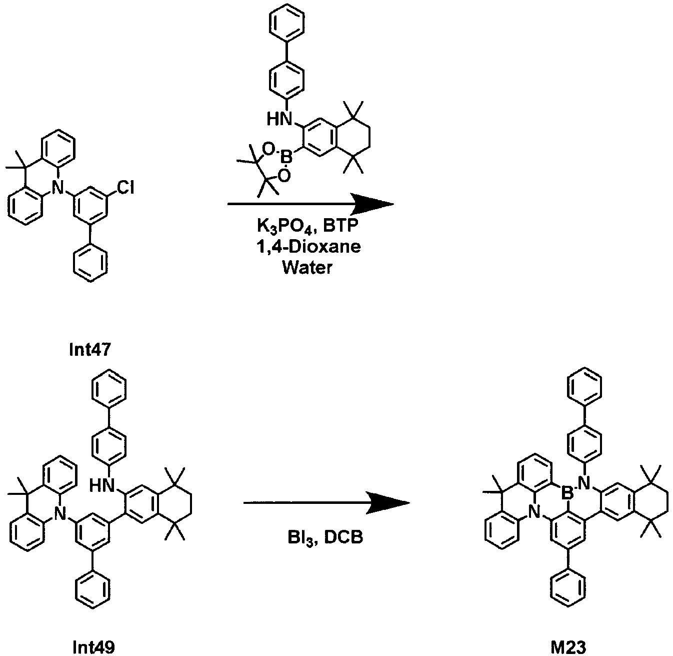

### 1) Synthesis of Int49

The same equivalents and method were used as in the synthesis process of Int2 using Int47 and N-([1,1'-biphenyl]-4-yl)-5,5,8,8-tetramethyl-3-(4,4,5,5-tetramethyl-1,3,2-dioxaborolan-2-yl)-5,6,7,8-tetrahydronaphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int49 (42.4 g, yield 78%). MS[M+H]+=716

### 2) Synthesis of Compound M23

Under the nitrogen atmosphere, Int49 (25 g) and boron triiodide (23.3 g) were introduced to 1,2-dichlorobenzene (250 ml), and stirred for 4 hours at 160°C. After the reaction was finished, the result was extracted, and then recrystallized to obtain Compound M23 (7.1 g, yield 28%). MS[M+H]+=724

### Synthesis Example 24. Synthesis of Compound M24

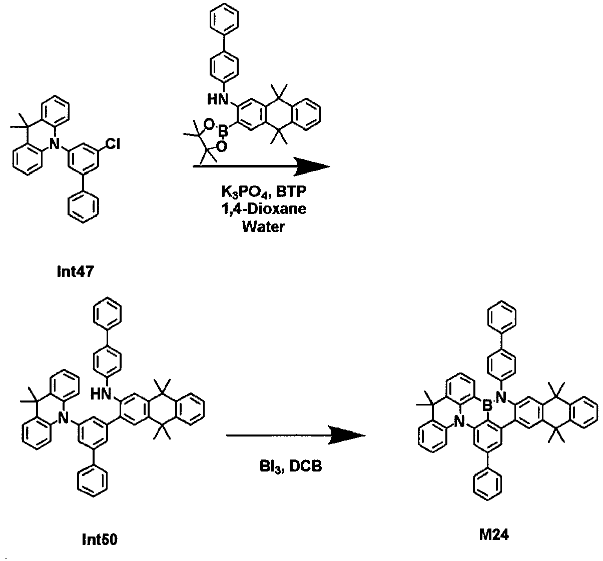

### 1) Synthesis of Int50

The same equivalents and method were used as in the synthesis process of Int2 using Int47 and N-([1,1'-biphenyl]-4-yl)-9,9,10,10-tetramethyl-3-(4,4,5,5-tetramethyl-1,3,2-dioxaborolan-2-yl)-9,10-dihydroanthracen-2-amine instead of Int1 and 4-(4,4,5,5-tetramethyl-l,3,2-dioxaborolan-2-yl)-10H-spiro[acridine-9,9'-fluorene], and after the reaction was finished, the result was extracted and then recrystallized to obtain Int50 (43.1 g, yield 75%). MS[M+H]+=764

### 2) Synthesis of Compound M24

Under the nitrogen atmosphere, Int50 (25 g) and boron triiodide (21.8 g) were introduced to 1,2-dichlorobenzene (250 ml), and stirred for 4 hours at 160°C. After the reaction was finished, the result was extracted, and then recrystallized to obtain Compound M24 (7.3 g, yield 29%). MS[M+H]+=772

### Synthesis Example 25. Synthesis of Compound M25

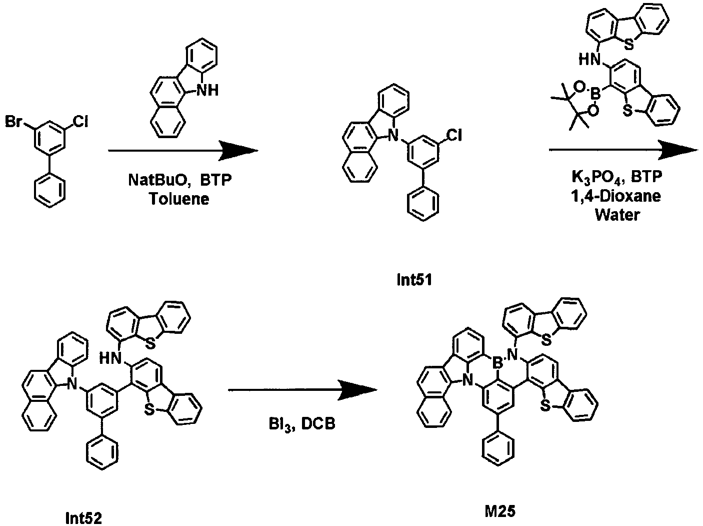

### 1) Synthesis of Int51

The same equivalents and method were used as in the synthesis process of Int1 using 11H-benzo[a]carbazole instead of bis(5,5,8,8-tetramethyl-5,6,7,8-tetrahydronaphthalen-2-yl)amine, and after the reaction was finished, the result was extracted and then recrystallized to obtain Int51 (36 g, yield 79%). MS[M+H]+=405

### 2) Synthesis of Int52

The same equivalents and method were used as in the synthesis process of Int2 using Int51 and N-(dibenzo[b,d]thiophen-4-yl)-4-(4,4,5,5-tetramethyl-1,3,2-dioxaborolan-2-yl)dibenzo[b,d]thiophen-3-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int52 (44 g, yield 79%). MS[M+H]+=750

### 3) Synthesis of Compound M25

Under the nitrogen atmosphere, Int52 (25 g) and boron triiodide (22.2 g) were introduced to 1,2-dichlorobenzene (250 ml), and stirred for 4 hours at 160°C. After the reaction was finished, the result was extracted, and then recrystallized to obtain Compound M25 (7.2 g, yield 29%). MS[M+H]+=758

### Synthesis Example 26. Synthesis of Compound M26

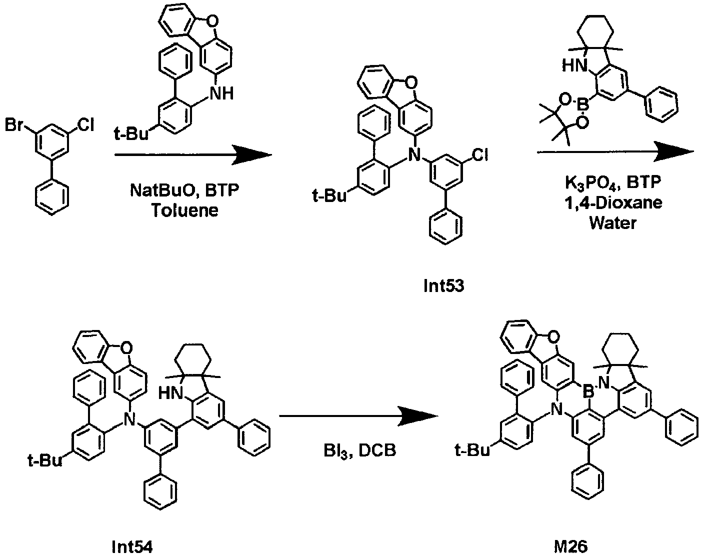

### 1) Synthesis of Int53

The same equivalents and method were used as in the synthesis process of Int1 using N-(5-(tert-butyl)-[1,1'-biphenyl]-2-yl)dibenzo[b,d]furan-2-amine instead of bis(5,5,8,8-tetramethyl-5,6,7,8-tetrahydronaphthalen-2-yl)amine, and after the reaction was finished, the result was extracted and then recrystallized to obtain Int53 (47 g, yield 73%). MS[M+H]+=579

### 2) Synthesis of Int54

The same equivalents and method were used as in the synthesis process of Int2 using Int53 and 4a,9a-dimethyl-6-phenyl-8-(4,4,5,5-tetramethyl-1,3,2-dioxaborolan-2-yl)-2,3,4,4a,9,9a-hexahydro-1H-carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int54 (32.2 g, yield 76%). MS[M+H]+=820

### 3) Synthesis of Compound M26

Under the nitrogen atmosphere, Int54 (25 g) and boron triiodide (20.3 g) were introduced to 1,2-dichlorobenzene (250 ml), and stirred for 4 hours at 160°C. After the reaction was finished, the result was extracted, and then recrystallized to obtain Compound M26 (7.4 g, yield 29%). MS[M+H]+=828

### Synthesis Example 27. Synthesis of Compound M27

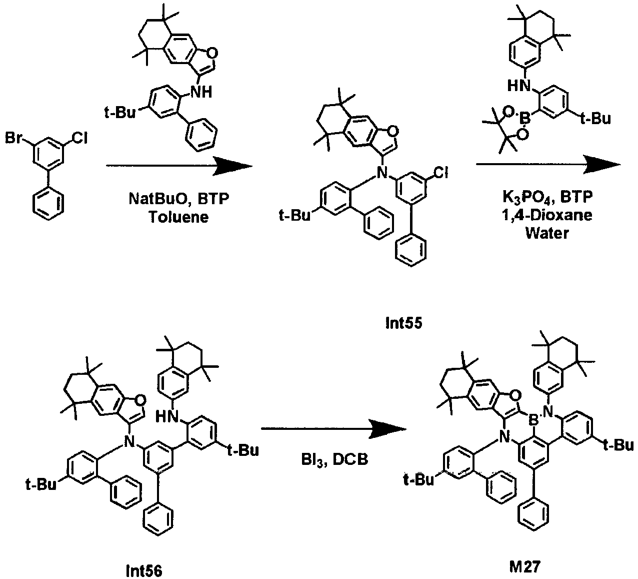

### 1) Synthesis of Int55

The same equivalents and method were used as in the synthesis process of Int1 using N-(5-(tert-butyl)-[1,1'-biphenyl]-2-yl)-5,5,8,8-tetramethyl-5,6,7,8-tetrahydronaphtho[2,3-b]furan-3-amine instead of bis(5,5,8,8-tetramethyl-5,6,7,8-tetrahydronaphthalen-2-yl)amine, and after the reaction was finished, the result was extracted and then recrystallized to obtain Int55 (55 g, yield 77%). MS[M+H]+=639

### 2) Synthesis of Int56

The same equivalents and method were used as in the synthesis process of Int2 using Int55 and N-(4-(tert-butyl)-2-(4,4,5,5-tetramethyl-1,3,2-dioxaborolan-2-yl)phenyl)-5,5,8,8-tetramethyl-5,6,7,8-tetrahydronaphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int56 (34.2 g, yield 78%). MS[M+H]+=938

### 3) Synthesis of Compound M27

Under the nitrogen atmosphere, Int56 (25 g) and boron triiodide (17.8 g) were introduced to 1,2-dichlorobenzene (250 ml), and stirred for 4 hours at 160°C. After the reaction was finished, the result was extracted, and then recrystallized to obtain Compound M27 (7.7 g, yield 31%). MS[M+H]+=946

### Synthesis Example 28. Synthesis of Compound M28

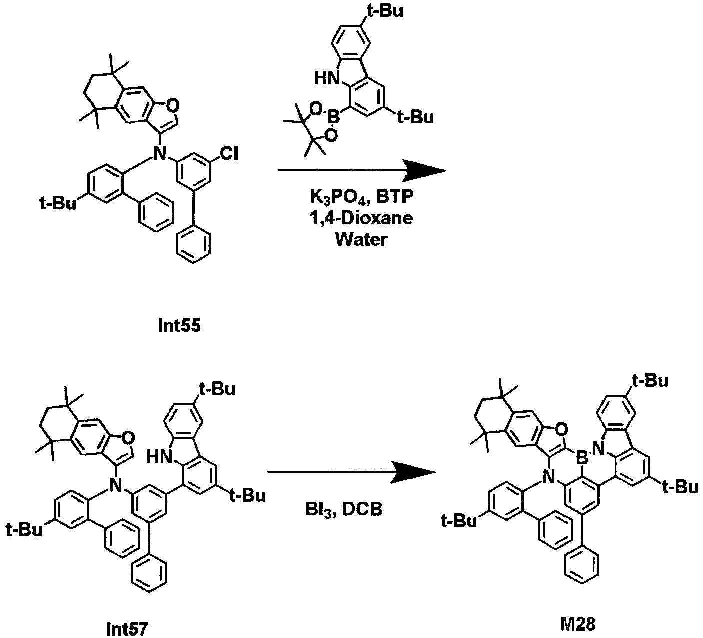

### 1) Synthesis of Int57

The same equivalents and method were used as in the synthesis process of Int2 using Int55 and 3,6-di-tert-butyl-1-(4,4,5,5-tetramethyl-1,3,2-dioxaborolan-2-yl)-9H-carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int57 (33.3 g, yield 80%). MS[M+H]+=882

### 2) Synthesis of Compound M28

Under the nitrogen atmosphere, Int57 (25 g) and boron triiodide (18.9 g) were introduced to 1,2-dichlorobenzene (250 ml), and stirred for 4 hours at 160°C. After the reaction was finished, the result was extracted, and then recrystallized to obtain Compound M28 (7.3 g, yield 29%). MS[M+H]+=890

### Synthesis Example 29. Synthesis of Compound M29

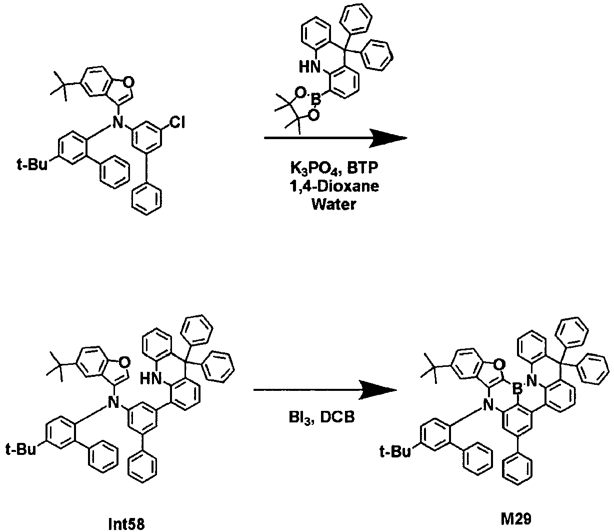

### 1) Synthesis of Int58

The same equivalents and method were used as in the synthesis process of Int2 using 5-(tert-butyl)-N-(5-(tert-butyl) -[1,1'-biphenyl]-2-yl)-N-(5-chloro-[1,1'-biphenyl]-3-yl)benzofuran-3-amine and 9,9-diphenyl-4-(4,4,5,5-tetramethyl-1,3,2-dioxaborolan-2-yl)-9,10-dihydroacridine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int58 (35.2 g, yield 78%). MS[M+H]+=882

### 2) Synthesis of Compound M29

Under the nitrogen atmosphere, Int58 (25 g) and boron triiodide (18.9 g) were introduced to 1,2-dichlorobenzene (250 ml), and stirred for 4 hours at 160°C. After the reaction was finished, the result was extracted, and then recrystallized to obtain Compound M29 (7.2 g, yield 29%). MS[M+H]+=889

### Synthesis Example 30. Synthesis of Compound M30

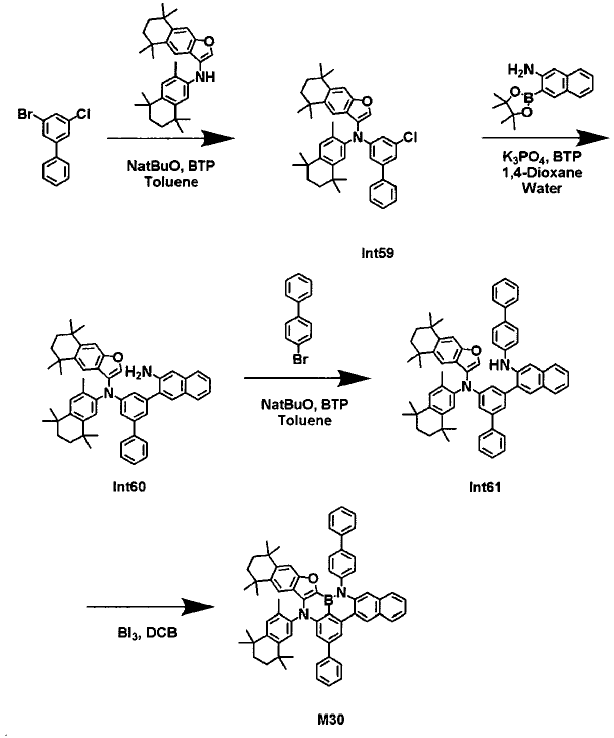

### 1) Synthesis of Int59

The same equivalents and method were used as in the synthesis process of Int1 using 5,5,8,8-tetramethyl-N-(3,5,5,8,8-pentamethyl-5,6,7,8-tetrahydronaphthalen-2-yl)-5, 6, 7, 8-tetrahydronaphtho[2, 3-b]furan-3-amine instead of bis(5,5,8,8-tetramethyl-5,6,7,8-tetrahydronaphthalen-2-yl)amine, and after the reaction was finished, the result was extracted and then recrystallized to obtain Int59 (55.6 g, yield 79%). MS[M+H]+=631

### 2) Synthesis of Int60

The same equivalents and method were used as in the synthesis process of Int2 using Int59 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int60 (27.8 g, yield 79%). MS[M+H]+=738

### 3) Synthesis of Int61

The same equivalents and method were used as in the synthesis process of Int1 using Int60 (27 g) and 4-bromo-1,1'-biphenyl (8.6 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int61 (25.1 g, yield 77%). MS[M+H]+=890

### 4) Synthesis of Compound M30

Under the nitrogen atmosphere, Int61 (25 g) and boron triiodide (18.7 g) were introduced to 1,2-dichlorobenzene (250 ml), and stirred for 4 hours at 160°C. After the reaction was finished, the result was extracted, and then recrystallized to obtain Compound M30 (7.2 g, yield 29%). MS[M+H]+=898

### Synthesis Example 31. Synthesis of Compound M31

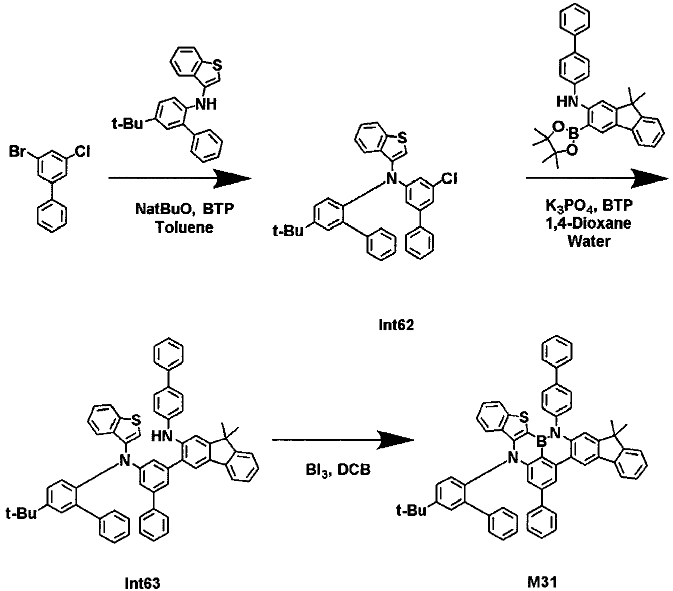

### 1) Synthesis of Int62

The same equivalents and method were used as in the synthesis process of Int1 using N-(5-(tert-butyl)-[1,1'-biphenyl]-2-yl)benzo[b]thiophen-3-amine instead of bis(5,5,8,8-tetramethyl-5,6,7,8-tetrahydronaphthalen-2-yl)amine, and after the reaction was finished, the result was extracted and then recrystallized to obtain Int62 (44 g, yield 72%). MS[M+H]+=545

### 2) Synthesis of Int63

The same equivalents and method were used as in the synthesis process of Int2 using Int62 and N-([1,1'-biphenyl]-4-yl)-9,9-dimethyl-3-(4,4,5,5-tetramethyl-1,3,2-dioxaborolan-2-yl)-9H-fluoren-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int63 (34.2 g, yield 71%). MS[M+H]+=870

### 3) Synthesis of Compound M31

Under the nitrogen atmosphere, Int63 (25 g) and boron triiodide (19.1 g) were introduced to 1,2-dichlorobenzene (250 ml), and stirred for 4 hours at 160°C. After the reaction was finished, the result was extracted, and then recrystallized to obtain Compound M31 (7.2 g, yield 29%). MS[M+H]+=878

### Synthesis Example 32. Synthesis of Compound M32

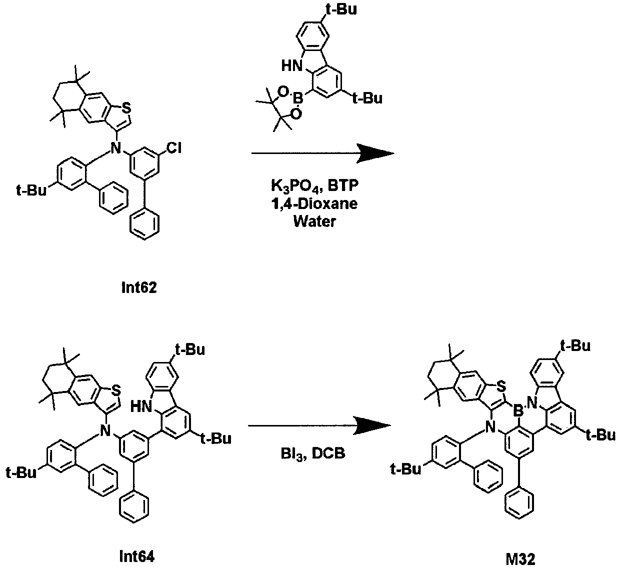

### 1) Synthesis of Int64

The same equivalents and method were used as in the synthesis process of Int2 using Int62 and 3,6-di-tert-butyl-1-(4,4,5,5-tetramethyl-1,3,2-dioxaborolan-2-yl)-9H-carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int64 (32.2 g, yield 78%). MS[M+H]+=898

### 2) Synthesis of Compound M32

Under the nitrogen atmosphere, Int64 (25 g) and boron triiodide (18.5 g) were introduced to 1,2-dichlorobenzene (250 ml), and stirred for 4 hours at 160°C. After the reaction was finished, the result was extracted, and then recrystallized to obtain Compound M32 (7.2 g, yield 29%). MS[M+H]+=906

### Synthesis Example 33. Synthesis of Compound M33

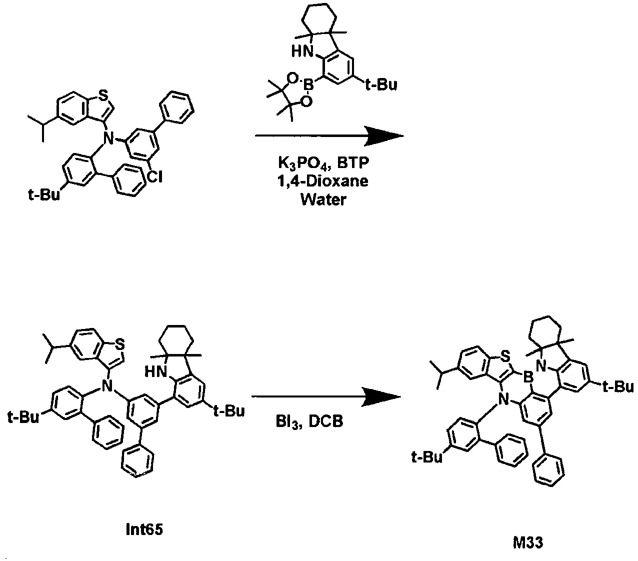

### 1) Synthesis of Int65

The same equivalents and method were used as in the synthesis process of Int2 using N-(5-(tert-butyl)-[1,1'-biphenyl]-2-yl)-N-(5-chloro-[1,1'-biphenyl]-3-yl)-5-isopropylbenzo[b]thiophen-3-amine and 6-(tert-butyl)-4a,9a-dimethyl-8-(4,4,5,5-tetramethyl-1,3,2-dioxaborolan-2-yl)-2,3,4,4a,9,9a-hexahydro-1H-carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int65 (31.1 g, yield 75%). MS[M+H]+=808

### 2) Synthesis of Compound M33

Under the nitrogen atmosphere, Int65 (25 g) and boron triiodide (20.6 g) were introduced to 1,2-dichlorobenzene (250 ml), and stirred for 4 hours at 160°C. After the reaction was finished, the result was extracted, and then recrystallized to obtain Compound M33 (7.3 g, yield 29%). MS[M+H]+=816

### Synthesis Example 34. Synthesis of Compound M34

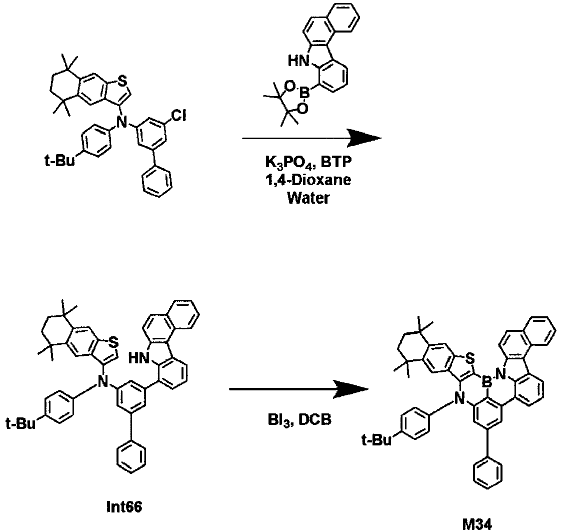

### 1) Synthesis of Int66

The same equivalents and method were used as in the synthesis process of Int2 using N-(4-(tert-butyl)phenyl)-N-(5-chloro-[1,1'-biphenyl]-3-yl)-5,5,8,8-tetramethyl-5,6,7,8-tetrahydronaphtho[2,3-b]thiophen-3-amine and 8-(4,4,5,5-tetramethyl-1,3,2-dioxaborolan-2-yl)-7H-benzo[c]carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int66 (28.9 g, yield 73%). MS[M+H]+=760

### 2) Synthesis of Compound M34

Under the nitrogen atmosphere, Int66 (25 g) and boron triiodide (21.9 g) were introduced to 1,2-dichlorobenzene (250 ml), and stirred for 4 hours at 160°C. After the reaction was finished, the result was extracted, and then recrystallized to obtain Compound M34 (7.3 g, yield 29%). MS[M+H]+=768

### Synthesis Example 35. Synthesis of Compound M35

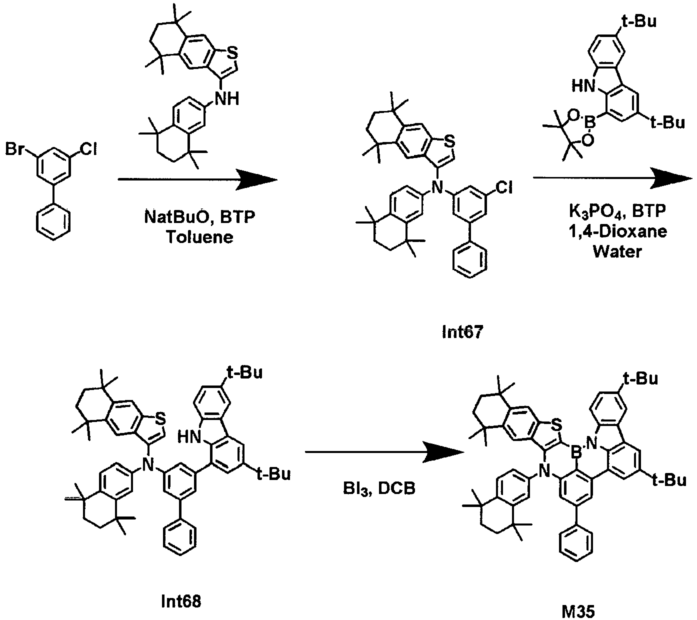

### 1) Synthesis of Int67

The same equivalents and method were used as in the synthesis process of Int1 using 5,5,8,8-tetramethyl-N-(5,5,8,8-tetramethyl-5,6,7,8-tetrahydronaphthalen-2-yl)-5,6,7,8-tetrahydronaphtho[2,3-b]thiophen-3-amine instead of bis(5,5,8,8-tetramethyl-5,6,7,8-tetrahydronaphthalen-2-yl)amine, and after the reaction was finished, the result was extracted and then recrystallized to obtain Int67 (55.2 g, yield 78%). MS[M+H]+=633

### 2) Synthesis of Int68

The same equivalents and method were used as in the synthesis process of Int2 using Int67 and 3,6-di-tert-butyl-1-(4,4,5,5-tetramethyl-1,3,2-dioxaborolan-2-yl)-9H-carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int68 (31.1 g, yield 75%). MS[M+H]+=876

### 3) Synthesis of Compound M35

Under the nitrogen atmosphere, Int68 (25 g) and boron triiodide (19 g) were introduced to 1,2-dichlorobenzene (250 ml), and stirred for 4 hours at 160°C. After the reaction was finished, the result was extracted, and then recrystallized to obtain Compound M35 (7.1 g, yield 28%). MS[M+H]+=884

### Synthesis Example 36. Synthesis of Compound M36

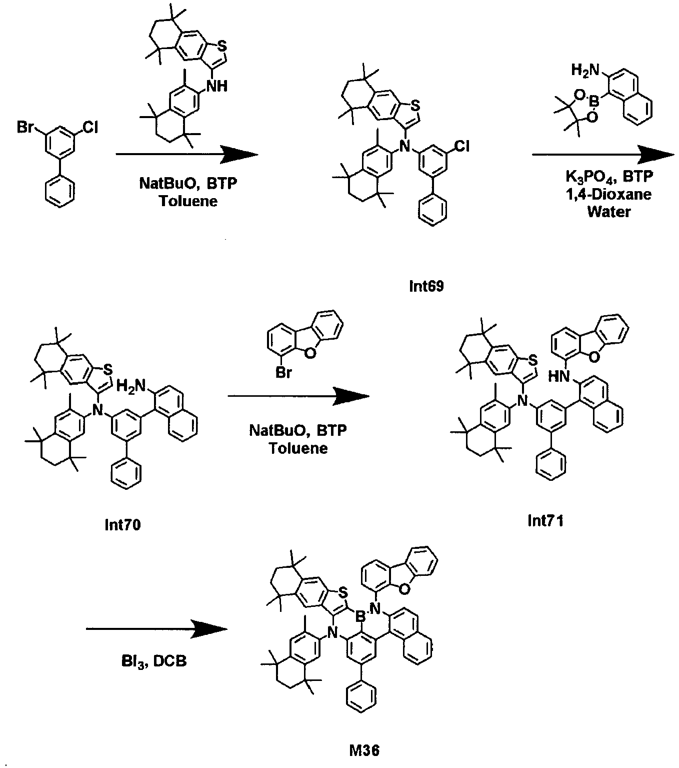

### 1) Synthesis of Int69

The same equivalents and method were used as in the synthesis process of Int1 using 5,5,8,8-tetramethyl-N-(3,5,5,8,8-pentamethyl-5,6,7,8-tetrahydronaphthalen-2-yl)-5,6,7,8-tetrahydronaphtho[2,3-b]thiophen-3-amine instead of bis(5,5,8,8-tetramethyl-5,6,7,8-tetrahydronaphthalen-2-yl)amine, and after the reaction was finished, the result was extracted and then recrystallized to obtain Int69 (54.3 g, yield 75%). MS[M+H]+=647

### 2) Synthesis of Int70

The same equivalents and method were used as in the synthesis process of Int2 using Int69 and 1-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int70 (27.7 g, yield 79%). MS[M+H]+=754

### 3) Synthesis of Int71

The same equivalents and method were used as in the synthesis process of Int1 using Int70 (27 g) and 4-bromodibenzo[b,d]furan (8.9 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int71 (26.2 g, yield 79%). MS[M+H]+=920

### 4) Synthesis of Compound M36

Under the nitrogen atmosphere, Int71 (25 g) and boron triiodide (18.1 g) were introduced to 1,2-dichlorobenzene (250 ml), and stirred for 4 hours at 160°C. After the reaction was finished, the result was extracted, and then recrystallized to obtain Compound M36 (6.9 g, yield 27%). MS[M+H]+=928

### Synthesis Example 37. Synthesis of Compound M37

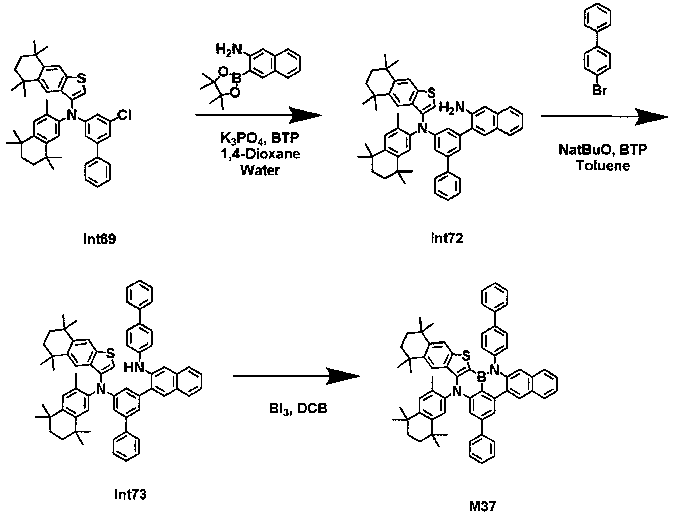

### 1) Synthesis of Int72

The same equivalents and method were used as in the synthesis process of Int2 using Int69 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int72 (27.1 g, yield 78%). MS[M+H]+=754

### 2) Synthesis of Int73

The same equivalents and method were used as in the synthesis process of Int1 using Int72 (27 g) and 4-bromo-1,1'-biphenyl (8.4 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int73 (25.1 g, yield 77%). MS[M+H]+=906

### 3) Synthesis of Compound M37

Under the nitrogen atmosphere, Int73 (25 g) and boron triiodide (18.4 g) were introduced to 1,2-dichlorobenzene (250 ml), and stirred for 4 hours at 160°C. After the reaction was finished, the result was extracted, and then recrystallized to obtain Compound M37 (6.8 g, yield 27%). MS[M+H]+=914

### Synthesis Example 38. Synthesis of Compound M38

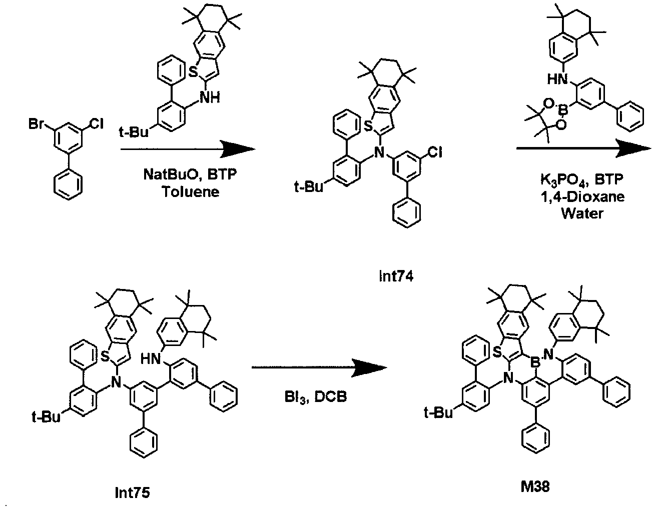

### 1) Synthesis of Int74

The same equivalents and method were used as in the synthesis process of Int1 using N-(5-(tert-butyl)-[1,1'-biphenyl]-2-yl)-5,5,8,8-tetramethyl-5,6,7,8-tetrahydronaphtho[2,3-b]thiophen-2-amine instead of bis(5,5,8,8-tetramethyl-5,6,7,8-tetrahydronaphthalen-2-yl)amine, and after the reaction was finished, the result was extracted and then recrystallized to obtain Int74 (55.2 g, yield 75%). MS[M+H]+=655

### 2) Synthesis of Int75

The same equivalents and method were used as in the synthesis process of Int2 using Int74 and 5,5,8,8-tetramethyl-N-(3-(4,4,5,5-tetramethyl-1,3,2-dioxaborolan-2-yl)-[1,1'-biphenyl]-4-yl)-5,6,7,8-tetrahydronaphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int75 (33.2 g, yield 74%). MS[M+H]+=974

### 3) Synthesis of Compound M38

Under the nitrogen atmosphere, Int75 (25 g) and boron triiodide (17.1 g) were introduced to 1,2-dichlorobenzene (250 ml), and stirred for 4 hours at 160°C. After the reaction was finished, the result was extracted, and then recrystallized to obtain Compound M38 (7.2 g, yield 29%). MS[M+H]+=982

### Synthesis Example 39. Synthesis of Compound M39

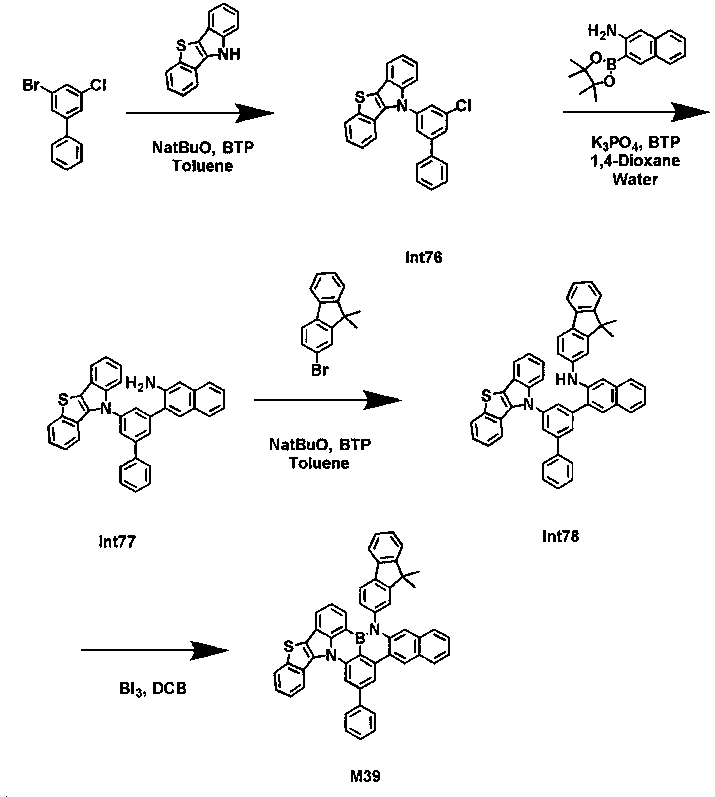

### 1) Synthesis of Int76

The same equivalents and method were used as in the synthesis process of Int1 using 10H-benzo[4,5]thieno[3,2-b]indole instead of bis(5,5,8,8-tetramethyl-5,6,7,8-tetrahydronaphthalen-2-yl)amine, and after the reaction was finished, the result was extracted and then recrystallized to obtain Int76 (36.1 g, yield 78%). MS[M+H]+=411

### 2) Synthesis of Int77

The same equivalents and method were used as in the synthesis process of Int2 using Int76 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int77 (30.1 g, yield 80%). MS[M+H]+=518

### 3) Synthesis of Int78

The same equivalents and method were used as in the synthesis process of Int1 using Int77 (27 g) and 2-bromo-9,9-dimethyl-9H-fluorene (14.3 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int78 (26.6 g, yield 72%). MS[M+H]+=710

### 4) Synthesis of Compound M39

Under the nitrogen atmosphere, Int78 (25 g) and boron triiodide (23.5 g) were introduced to 1,2-dichlorobenzene (250 ml), and stirred for 4 hours at 160°C. After the reaction was finished, the result was extracted, and then recrystallized to obtain Compound M39 (7.3 g, yield 29%). MS[M+H]+=718

### Synthesis Example 40. Synthesis of Compound M40

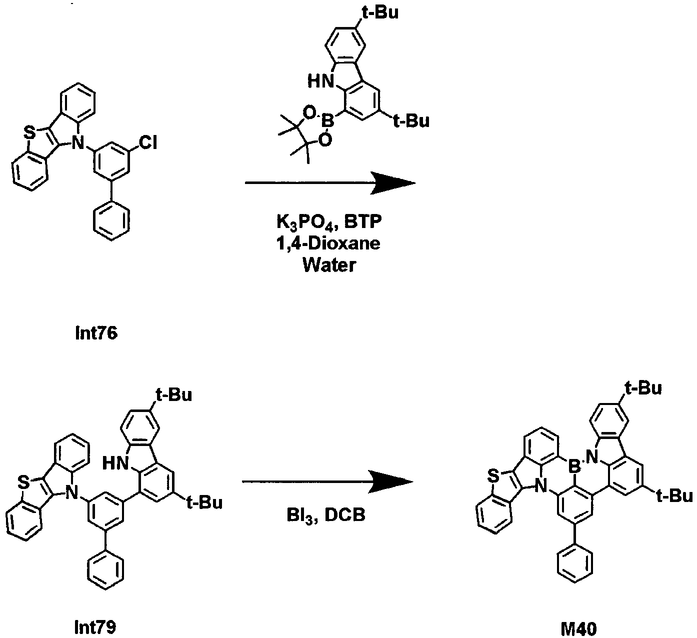

### 1) Synthesis of Int79

The same equivalents and method were used as in the synthesis process of Int2 using Int76 and 3,6-di-tert-butyl-1-(4,4,5,5-tetramethyl-1,3,2-dioxaborolan-2-yl)-9H-carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int79 (34.5 g, yield 72%). MS[M+H]+=654

### 2) Synthesis of Compound M40

Under the nitrogen atmosphere, Int79 (25 g) and boron triiodide (25.5 g) were introduced to 1,2-dichlorobenzene (250 ml), and stirred for 4 hours at 160°C. After the reaction was finished, the result was extracted, and then recrystallized to obtain Compound M40 (7.2 g, yield 28%). MS[M+H]+=662

### Synthesis Example 41. Synthesis of Compound M41

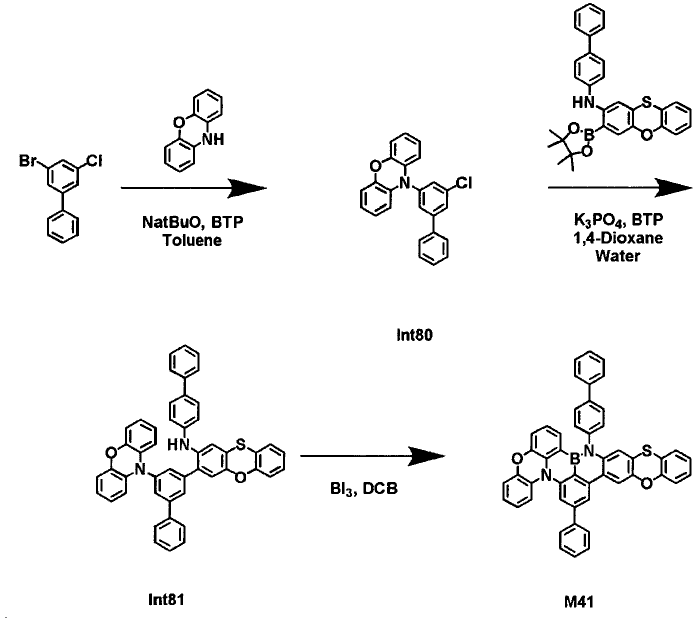

### 1) Synthesis of Int80

The same equivalents and method were used as in the synthesis process of Int1 using 10H-phenoxazine instead of bis(5,5,8,8-tetramethyl-5,6,7,8-tetrahydronaphthalen-2-yl)amine, and after the reaction was finished, the result was extracted and then recrystallized to obtain Int80 (32.2 g, yield 78%). MS[M+H]+=371

### 2) Synthesis of Int81

The same equivalents and method were used as in the synthesis process of Int2 using Int80 and N-([1,1'-biphenyl]-4-yl)-3-(4,4,5,5-tetramethyl-1,3,2-dioxaborolan-2-yl)phenoxathiin-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int81 (42 g, yield 74%). MS[M+H]+=702

### 3) Synthesis of Compound M41

Under the nitrogen atmosphere, Int81 (25 g) and boron triiodide (23.7 g) were introduced to 1,2-dichlorobenzene (250 ml), and stirred for 4 hours at 160°C. After the reaction was finished, the result was extracted, and then recrystallized to obtain Compound M41 (7.3 g, yield 29%). MS[M+H]+=710

### Synthesis Example 42. Synthesis of Compound M42

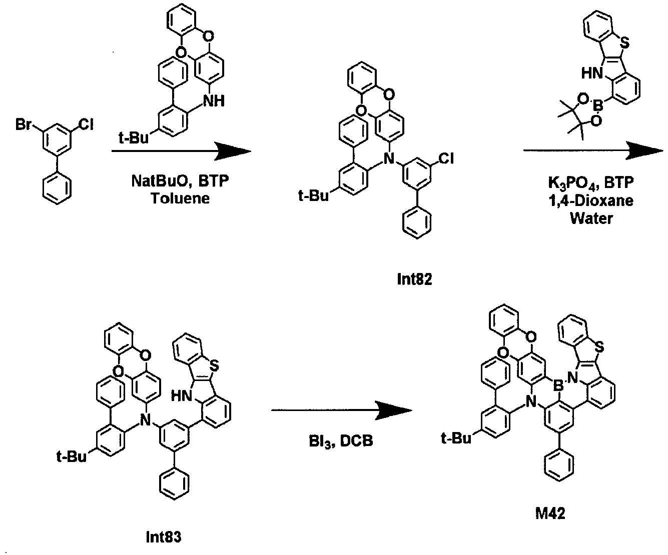

### 1) Synthesis of Int82

The same equivalents and method were used as in the synthesis process of Int1 using N-(5-(tert-butyl)-[1,1'-biphenyl]-2-yl)dibenzo[b,e][1,4]dioxin-2-amine instead of bis(5,5,8,8-tetramethyl-5,6,7,8-tetrahydronaphthalen-2-yl)amine, and after the reaction was finished, the result was extracted and then recrystallized to obtain Int82 (47.1 g, yield 71%). MS[M+H]+=595

### 2) Synthesis of Int83

The same equivalents and method were used as in the synthesis process of Int2 using Int82 and 1-(4,4,5,5-tetramethyl-1,3,2-dioxaborolan-2-yl)-10H-benzo[4,5]thieno[3,2-b]indole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int83 (29.8 g, yield 76%). MS[M+H]+=782

### 3) Synthesis of Compound M42

Under the nitrogen atmosphere, Int83 (25 g) and boron triiodide (21.3 g) were introduced to 1,2-dichlorobenzene (250 ml), and stirred for 4 hours at 160°C. After the reaction was finished, the result was extracted, and then recrystallized to obtain Compound M42 (7.5 g, yield 30%). MS[M+H]+=790

### Synthesis Example 43. Synthesis of Compound M43

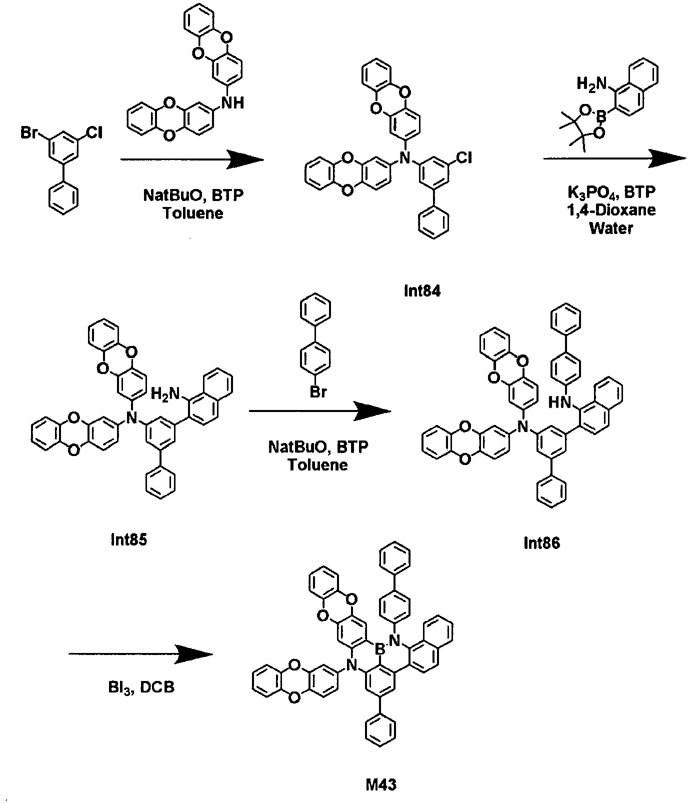

### 1) Synthesis of Int84

The same equivalents and method were used as in the synthesis process of Int1 using bis(dibenzo[b,e][1,4]dioxin-2-yl)amine instead of bis(5,5,8,8-tetramethyl-5,6,7,8-tetrahydronaphthalen-2-yl)amine, and after the reaction was finished, the result was extracted and then recrystallized to obtain Int84 (46.6 g, yield 73%). MS[M+H]+=569

### 2) Synthesis of Int85

The same equivalents and method were used as in the synthesis process of Int2 using Int84 and 2-(4,4,5,5-tetramethyl-1,3,2-dioxaborolan-2-yl)naphthalen-1-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int85 (27.2 g, yield 76%). MS[M+H]+=676

### 3) Synthesis of Int86

The same equivalents and method were used as in the synthesis process of Int1 using Int85 (27 g) and 4-bromo-1,1'-biphenyl (9.3 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int86 (25.5 g, yield 77%). MS[M+H]+=828

### 4) Synthesis of Compound M43

Under the nitrogen atmosphere, Int86 (25 g) and boron triiodide (20.1 g) were introduced to 1,2-dichlorobenzene (250 ml), and stirred for 4 hours at 160°C. After the reaction was finished, the result was extracted, and then recrystallized to obtain Compound M43 (7.4 g, yield 29%). MS[M+H]+=836

### Synthesis Example 44. Synthesis of Compound M44

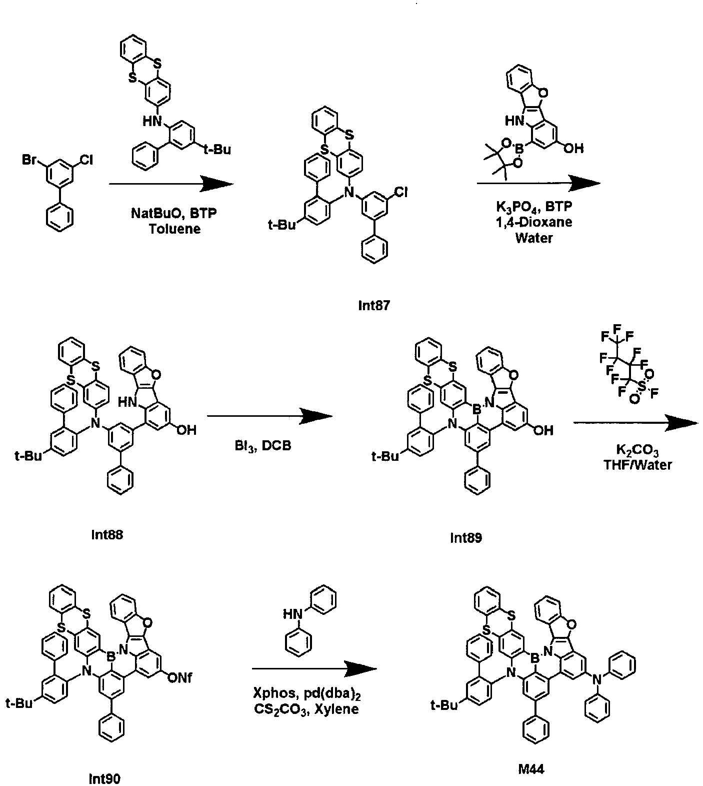

### 1) Synthesis of Int87

The same equivalents and method were used as in the synthesis process of Int1 using N-(5-(tert-butyl)-[1,1'-biphenyl]-2-yl)thianthren-2-amine instead of bis(5,5,8,8-tetramethyl-5,6,7,8-tetrahydronaphthalen-2-yl)amine, and after the reaction was finished, the result was extracted and then recrystallized to obtain Int87 (51 g, yield 73%). MS[M+H]+=627

### 2) Synthesis of Int88

The same equivalents and method were used as in the synthesis process of Int2 using Int87 and 1-(4,4,5,5-tetramethyl-1,3,2-dioxaborolan-2-yl)-10H-benzofuro[3,2-b]indol-3-ol instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int88 (28.1 g, yield 72%). MS[M+H]+=814

### 3) Synthesis of Int89

Under the nitrogen atmosphere, Int88 (25 g) and boron triiodide (20.5 g) were introduced to 1,2-dichlorobenzene (250 ml), and stirred for 4 hours at 160°C. After the reaction was finished, the result was extracted, and then recrystallized to obtain Int89 (7.5 g, yield 30%). MS[M+H]+=822

### 4) Synthesis of Int90

Int89 (7 g), 1,1,2,2,3,3,4,4,4-nonafluorobutane-1-sulfonyl fluoride (2.3 ml) and potassium carbonate (3.6 g) were introduced to tetrahydrofuran (70 ml) and water (30 ml), and stirred for 2 hours under reflux. After the reaction was finished, the result was extracted, and then column purified to obtain Int90 (8.8 g, yield 94%). MS[M+H]+=1104

### 5) Synthesis of Compound M44

Under the nitrogen atmosphere, Int90 (7 g), diphenylamine (1.1 g), pd(dba)₂ (0.11 g), Xphos (0.18 g) and cesium carbonate (6.3 g) were introduced to xylene (100 ml), and stirred for 12 hours under reflux. After the reaction was finished, the result was extracted, and then recrystallized to obtain Compound M44 (4.9 g, yield 79%). MS[M+H]+=973

### Synthesis Example 45. Synthesis of Compound M45

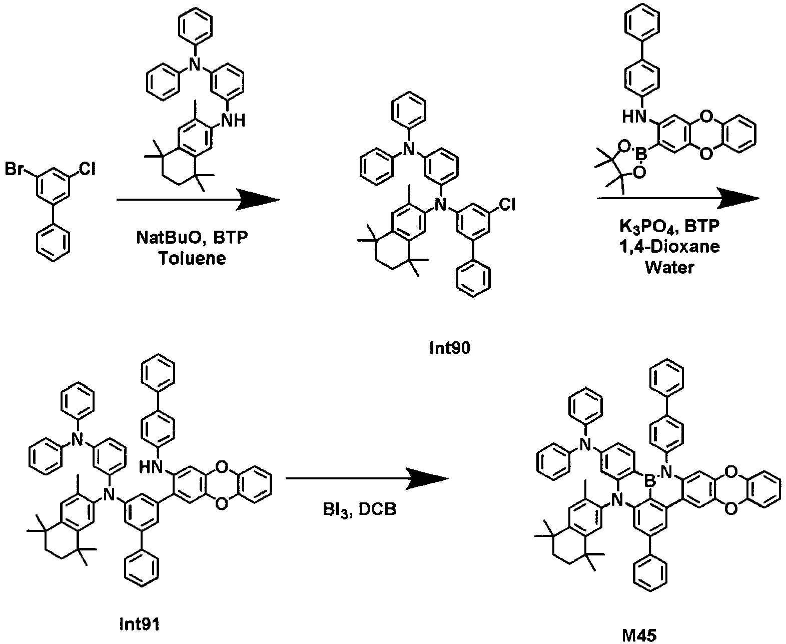

### 1) Synthesis of Int90

The same equivalents and method were used as in the synthesis process of Int1 using N1-(3,5,5,8,8-pentamethyl-5,6,7,8-tetrahydronaphthalen-2-yl)-N3,N3-diphenylbenzene-1,3-diamine instead of bis(5,5,8,8-tetramethyl-5,6,7,8-tetrahydronaphthalen-2-yl)amine, and after the reaction was finished, the result was extracted and then recrystallized to obtain Int90 (54.3 g, yield 75%). MS[M+H]+=648

### 2) Synthesis of Int91

The same equivalents and method were used as in the synthesis process of Int2 using Int90 and N-([1,1'-biphenyl]-4-yl)-3-(4,4,5,5-tetramethyl-1,3,2-dioxaborolan-2-yl)dibenzo[b,e][1,4]dioxin-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int91 (32.6 g, yield 73%). MS[M+H]+=963

### 3) Synthesis of Compound M45

Under the nitrogen atmosphere, Int91 (25 g) and boron triiodide (17.3 g) were introduced to 1,2-dichlorobenzene (250 ml), and stirred for 4 hours at 160°C. After the reaction was finished, the result was extracted, and then recrystallized to obtain Compound M45 (7.3 g, yield 29%). MS[M+H]+=971

### Synthesis Example 46. Synthesis of Compound M46

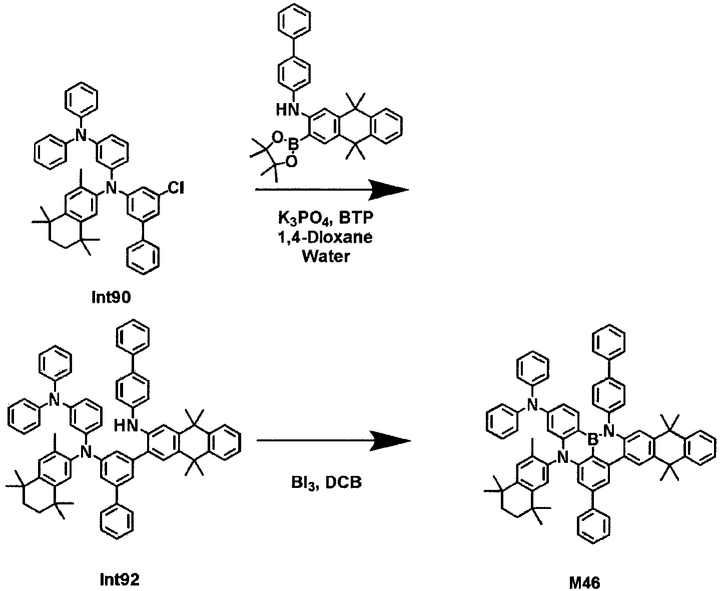

### 1) Synthesis of Int92

The same equivalents and method were used as in the synthesis process of Int2 using Int90 and N-([1,1'-biphenyl]-4-yl)-9,9,10,10-tetramethyl-3-(4,4,5,5-tetramethyl-1,3,2-dioxaborolan-2-yl)-9,10-dihydroanthracen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int92 (35.2 g, yield 75%). MS[M+H]+=1015

### 2) Synthesis of Compound M46

Under the nitrogen atmosphere, Int92 (25 g) and boron triiodide (16.4 g) were introduced to 1,2-dichlorobenzene (250 ml), and stirred for 4 hours at 160°C. After the reaction was finished, the result was extracted, and then recrystallized to obtain Compound M46 (7.5 g, yield 30%). MS[M+H]+=1023

### Synthesis Example 47. Synthesis of Compound M47

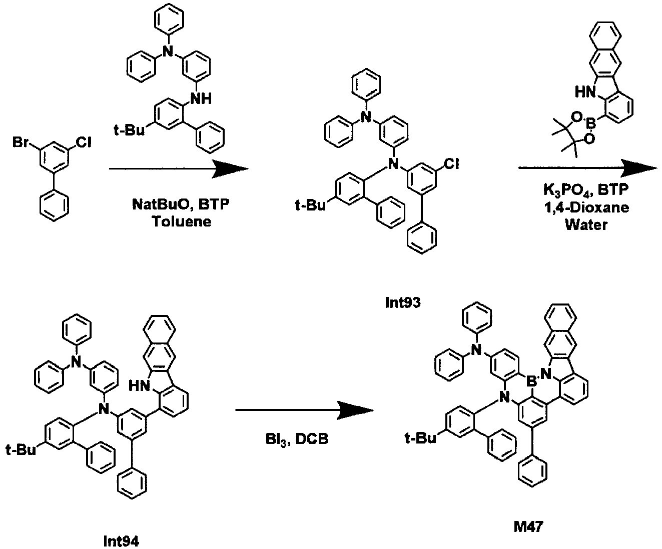

### 1) Synthesis of Int93

The same equivalents and method were used as in the synthesis process of Int1 using N1-(5-(tert-butyl)-[1,1'-biphenyl]-2-yl)-N3,N3-diphenylbenzene-1,3-diamine instead of bis(5,5,8,8-tetramethyl-5,6,7,8-tetrahydronaphthalen-2-yl)amine, and after the reaction was finished, the result was extracted and then recrystallized to obtain Int93 (52.5 g, yield 71%). MS[M+H]+=656

### 2) Synthesis of Int94

The same equivalents and method were used as in the synthesis process of Int2 using Int93 and 4-(4,4,5,5-tetramethyl-1,3,2-dioxaborolan-2-yl)-5H-benzo[b]carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int94 (29.8 g, yield 78%). MS[M+H]+=837

### 3) Synthesis of Compound M47

Under the nitrogen atmosphere, Int94 (25 g) and boron triiodide (19.9 g) were introduced to 1,2-dichlorobenzene (250 ml), and stirred for 4 hours at 160°C. After the reaction was finished, the result was extracted, and then recrystallized to obtain Compound M47 (7.5 g, yield 30%). MS[M+H]+=845

### Synthesis Example 48. Synthesis of Compound M48

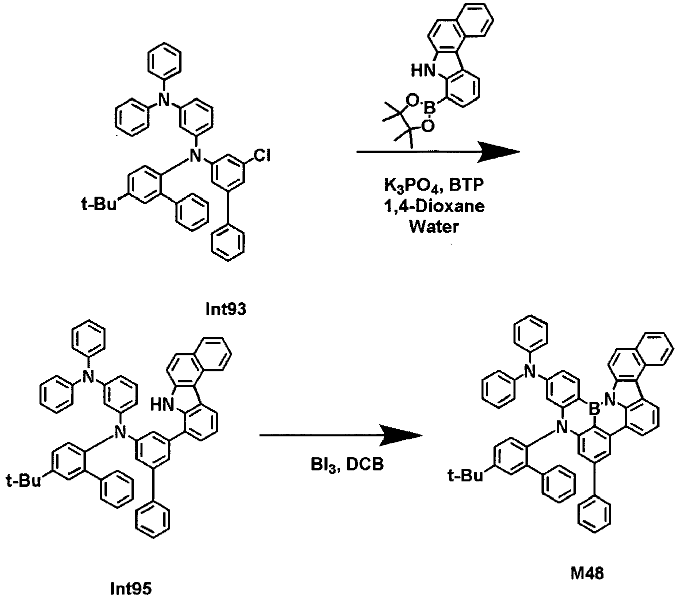

### 1) Synthesis of Int95

The same equivalents and method were used as in the synthesis process of Int2 using Int93 and 8-(4,4,5,5-tetramethyl-1,3,2-dioxaborolan-2-yl)-7H-benzo[c]carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int95 (29.4 g, yield 77%). MS[M+H]+=837

### 2) Synthesis of Compound M48

Under the nitrogen atmosphere, Int95 (25 g) and boron triiodide (19.9 g) were introduced to 1,2-dichlorobenzene (250 ml), and stirred for 4 hours at 160°C. After the reaction was finished, the result was extracted, and then recrystallized to obtain Compound M48 (7.1 g, yield 28%). MS[M+H]+=845

### Synthesis Example 49. Synthesis of Compound M49

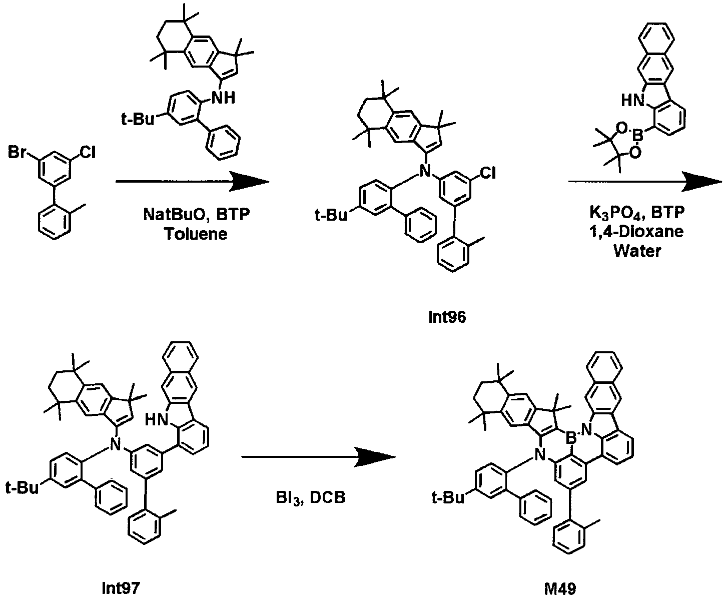

### 1) Synthesis of Int96

The same equivalents and method were used as in the synthesis process of Int1 using 3'-bromo-5'-chloro-2-methyl-1,1'-biphenyl (30 g) and N-(5-(tert-butyl)-[1,1'-biphenyl]-2-yl)-1,1,5,5,8,8-hexamethyl-5,6,7,8-tetrahydro-1H-cyclopenta[b]naphthalen-3-amine (51 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int96 (53.5 g, yield 74%). MS[M+H]+=679

### 2) Synthesis of Int97

The same equivalents and method were used as in the synthesis process of Int2 using Int96 and 4-(4,4,5,5-tetramethyl-1,3,2-dioxaborolan-2-yl)-5H-benzo[b]carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int97 (28.8 g, yield 76%). MS[M+H]+=860

### 3) Synthesis of Compound M49

Under the nitrogen atmosphere, Int97 (25 g) and boron triiodide (19.4 g) were introduced to 1,2-dichlorobenzene (250 ml), and stirred for 4 hours at 160°C. After the reaction was finished, the result was extracted, and then recrystallized to obtain Compound M49 (7.2 g, yield 29%). MS[M+H]+=868

### Synthesis Example 50. Synthesis of Compound M50

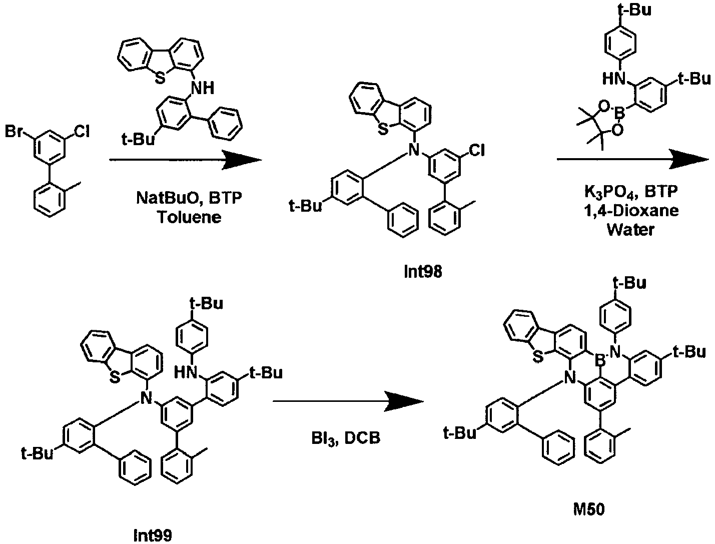

### 1) Synthesis of Int98

The same equivalents and method were used as in the synthesis process of Int1 using 3'-bromo-5'-chloro-2-methyl-1,1'-biphenyl (30 g) and N-(5-(tert-butyl)-[1,1'-biphenyl]-2-yl)dibenzo[b,d]thiophen-4-amine (43.4 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int98 (49.4 g, yield 76%). MS[M+H]+=609

### 2) Synthesis of Int99

The same equivalents and method were used as in the synthesis process of Int2 using Int98 and 5-(tert-butyl)-N-(4-(tert-butyl)phenyl)-2-(4,4,5,5-tetramethyl-1,3,2-dioxaborolan-2-yl)aniline instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int99 (29.9 g, yield 71%). MS[M+H]+=854

### 3) Synthesis of Compound M50

Under the nitrogen atmosphere, Int99 (25 g) and boron triiodide (19.5 g) were introduced to 1,2-dichlorobenzene (250 ml), and stirred for 4 hours at 160°C. After the reaction was finished, the result was extracted, and then recrystallized to obtain Compound M50 (7.3 g, yield 29%). MS[M+H]+=862

### Synthesis Example 51. Synthesis of Compound M51

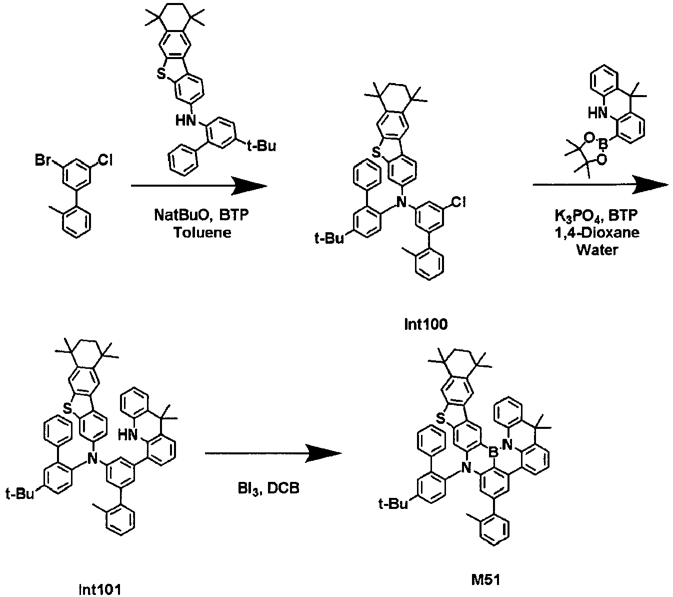

### 1) Synthesis of Int100

The same equivalents and method were used as in the synthesis process of Int1 using 3'-bromo-5'-chloro-2-methyl-1,1'-biphenyl (30 g) and N-(5-(tert-butyl)-[1,1'-biphenyl]-2-yl)-7,7,10,10-tetramethyl-7,8,9,10-tetrahydrobenzo[b]naphtho[2,3-d]thiophen-3-amine (55.2 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int100 (53.5 g, yield 70%). MS[M+H]+=719

### 2) Synthesis of Int101

The same equivalents and method were used as in the synthesis process of Int2 using Int100 and 9,9-dimethyl-4-(4,4,5,5-tetramethyl-1,3,2-dioxaborolan-2-yl)-9,10-dihydroacridine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int101 (27.7 g, yield 74%). MS[M+H]+=892

### 3) Synthesis of Compound M51

Under the nitrogen atmosphere, Int101 (25 g) and boron triiodide (18.7 g) were introduced to 1,2-dichlorobenzene (250 ml), and stirred for 4 hours at 160°C. After the reaction was finished, the result was extracted, and then recrystallized to obtain Compound M51 (7.1 g, yield 28%). MS[M+H]+=900

### Synthesis Example 52. Synthesis of Compound M52

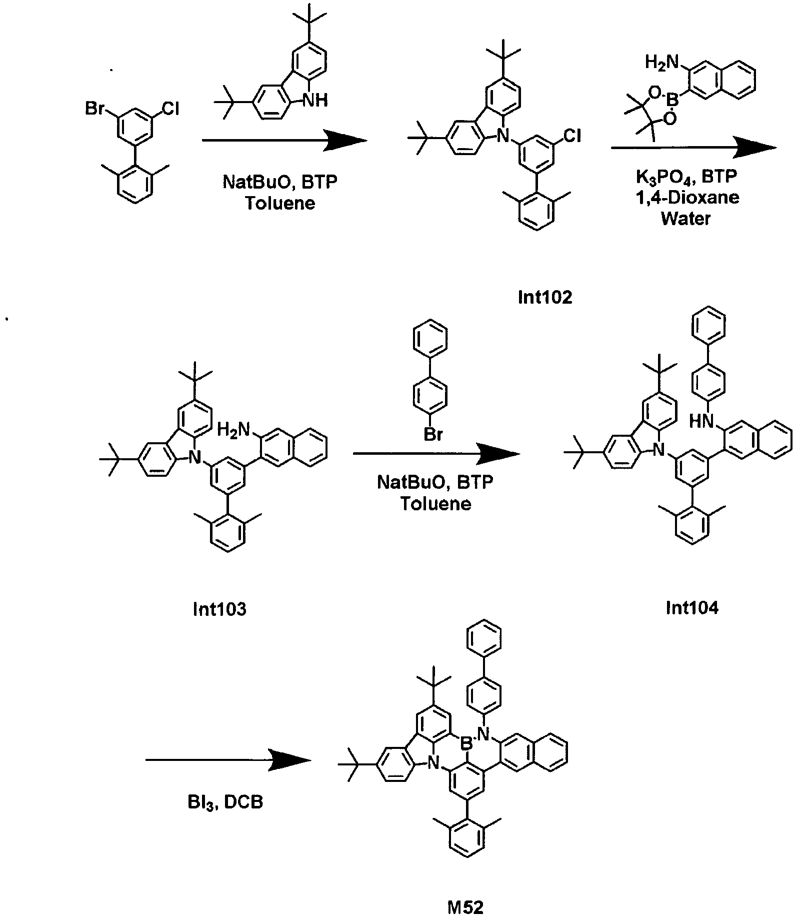

### 1) Synthesis of Int102

The same equivalents and method were used as in the synthesis process of Int1 using 3'-bromo-5'-chloro-2,6-dimethyl-1,1'-biphenyl (30 g) and 3,6-di-tert-butyl-9H-carbazole (28.4 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int102 (38.1 g, yield 76%). MS[M+H]+=495

### 2) Synthesis of Int103

The same equivalents and method were used as in the synthesis process of Int2 using Int102 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int103 (27.7 g, yield 76%). MS[M+H]+=602

### 3) Synthesis of Int104

The same equivalents and method were used as in the synthesis process of Int1 using Int103 (27 g) and 4-bromo-1,1'-biphenyl (10.5 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int104 (25.4 g, yield 75%). MS[M+H]+=754

### 4) Synthesis of Compound M52

Under the nitrogen atmosphere, Int104 (25 g) and boron triiodide (22.1 g) were introduced to 1,2-dichlorobenzene (250 ml), and stirred for 4 hours at 160°C. After the reaction was finished, the result was extracted, and then recrystallized to obtain Compound M52 (7.2 g, yield 29%). MS[M+H]+=762

### Synthesis Example 53. Synthesis of Compound M53

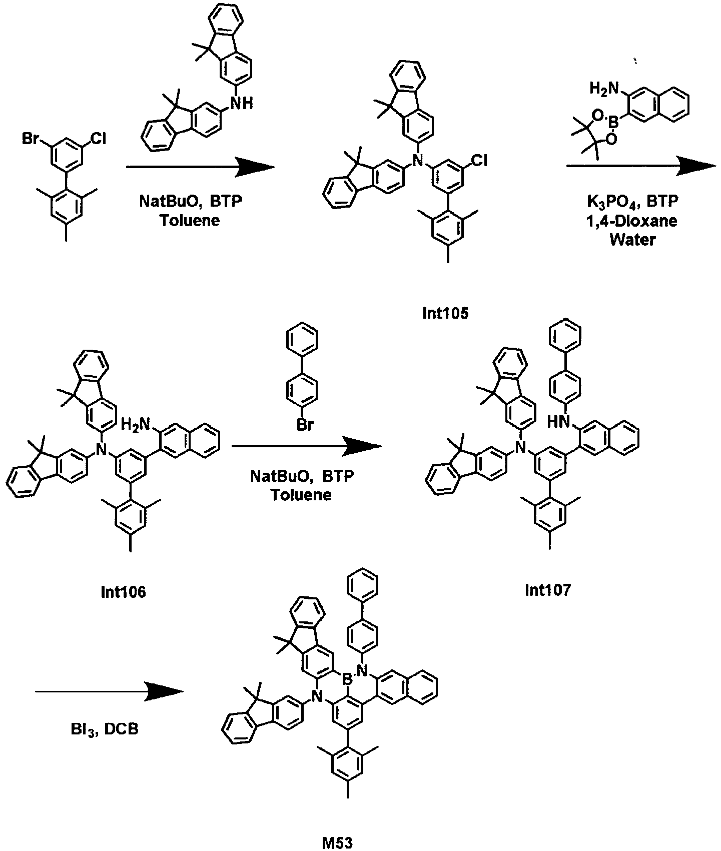

### 1) Synthesis of Int105

The same equivalents and method were used as in the synthesis process of Int1 using 3'-bromo-5'-chloro-2,4,6-trimethyl-1,1'-biphenyl (30 g) and bis(9,9-dimethyl-9H-fluoren-2-yl)amine (27.1 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int105 (46.2 g, yield 76%). MS[M+H]+=631

### 2) Synthesis of Int106

The same equivalents and method were used as in the synthesis process of Int2 using Int105 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int106 (25.3 g, yield 72%). MS[M+H]+=738

### 3) Synthesis of Int107

The same equivalents and method were used as in the synthesis process of Int1 using Int106 (27 g) and 4-bromo-1,1'-biphenyl (8.5 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int107 (25.1 g, yield 77%). MS[M+H]+=890

### 4) Synthesis of Compound M53

Under the nitrogen atmosphere, Int107 (25 g) and boron triiodide (18.7 g) were introduced to 1,2-dichlorobenzene (250 ml), and stirred for 4 hours at 160°C. After the reaction was finished, the result was extracted, and then recrystallized to obtain Compound M53 (7 g, yield 28%). MS[M+H]+=898

### Synthesis Example 54. Synthesis of Compound M54

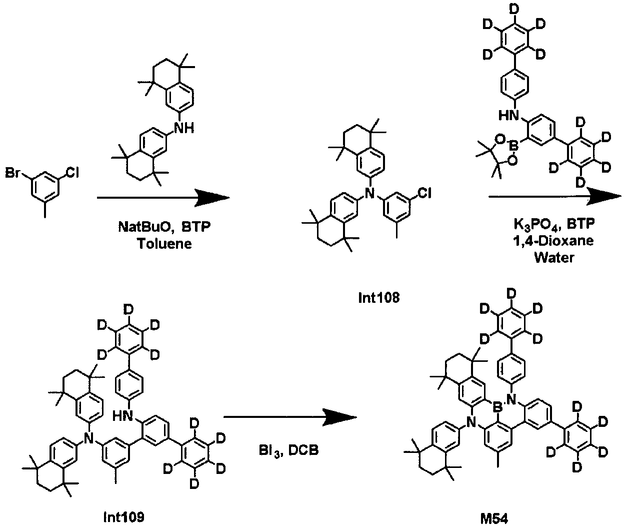

### 1) Synthesis of Int108

The same equivalents and method were used as in the synthesis process of Int1 using 1-bromo-3-chloro-5-methylbenzene (30 g) instead of 3-bromo-5-chloro-1,1'-bipheny, and after the reaction was finished, the result was extracted and then recrystallized to obtain Int108 (56 g, yield 75%) . MS[M+H]+=515

### 2) Synthesis of Int109

The same equivalents and method were used as in the synthesis process of Int2 using Int108 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int109 (34 g, yield 72%). MS[M+H]+=810

### 3) Synthesis of Compound M54

Under the nitrogen atmosphere, Int109 (25 g) and boron triiodide (20.6 g) were introduced to 1,2-dichlorobenzene (250 ml), and stirred for 4 hours at 160°C. After the reaction was finished, the result was extracted, and then recrystallized to obtain Compound M54 (7.2 g, yield 29%). MS[M+H]+=818

### Synthesis Example 55. Synthesis of Compound M55

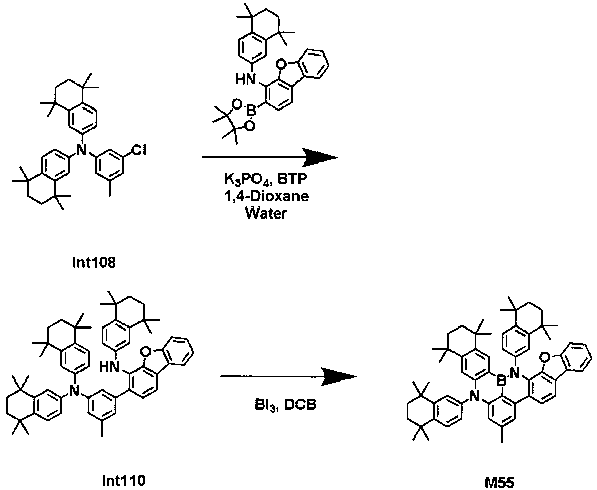

### 1) Synthesis of Int110

The same equivalents and method were used as in the synthesis process of Int2 using Int108 and 3-(4,4,5,5-tetramethyl-1,3,2-dioxaborolan-2-yl)-N-(5,5,8,8-tetramethyl-5,6,7,8-tetrahydronaphthalen-2-yl)dibenzo[b,d]furan-4-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int110 (36 g, yield 73%). MS[M+H]+=848

### 2) Synthesis of Compound M55

Under the nitrogen atmosphere, Int110 (25 g) and boron triiodide (19.6 g) were introduced to 1,2-dichlorobenzene (250 ml), and stirred for 4 hours at 160°C. After the reaction was finished, the result was extracted, and then recrystallized to obtain Compound M55 (7.5 g, yield 30%). MS[M+H]+=856

### Synthesis Example 56. Synthesis of Compound M56

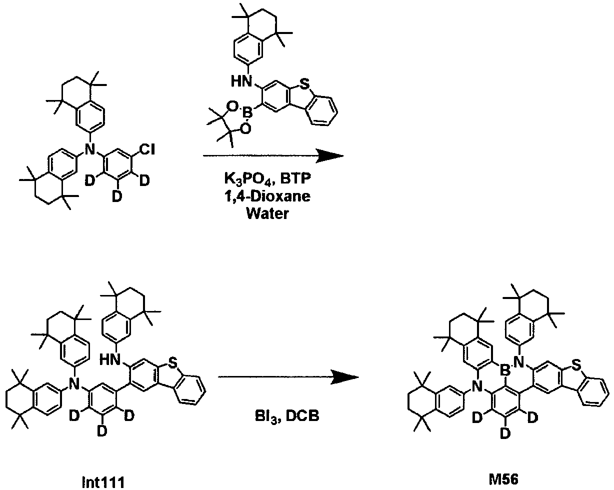

### 1) Synthesis of Int111

The same equivalents and method were used as in the synthesis process of Int2 using N-(3-chlorophenyl-4,5,6-d3)-5,5,8,8-tetramethyl-N-(5,5,8,8-tetramethyl-5,6,7,8-tetrahydronaphthalen-2-yl)-5,6,7,8-tetrahydronaphthalen-2-amine and 2-(4,4,5,5-tetramethyl-1,3,2-dioxaborolan-2-yl)-N-(5,5,8,8-tetramethyl-5,6,7,8-tetrahydronaphthalen-2-yl)dibenzo[b,d]thiophen-3-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int111 (37.6 g, yield 74%). MS[M+H]+=853

### 2) Synthesis of Compound M56

Under the nitrogen atmosphere, Int111 (25 g) and boron triiodide (19.5 g) were introduced to 1,2-dichlorobenzene (250 ml), and stirred for 4 hours at 160°C. After the reaction was finished, the result was extracted, and then recrystallized to obtain Compound M56 (7.2 g, yield 29%). MS[M+H]+=861

### Synthesis Example 57. Synthesis of Compound M57

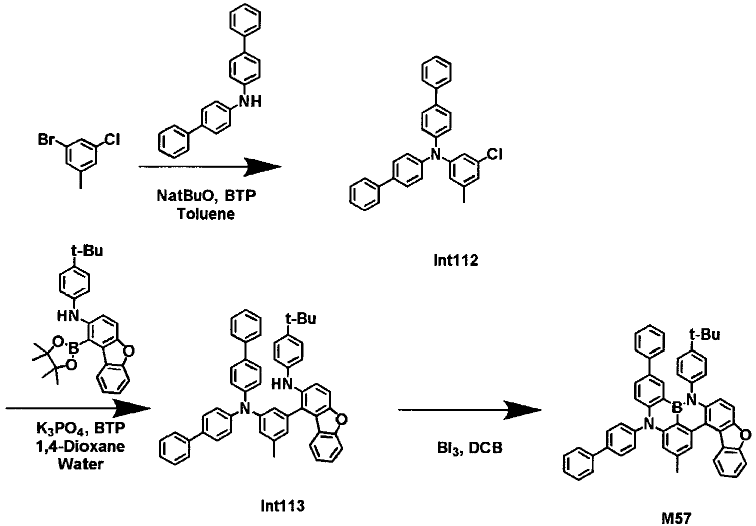

### 1) Synthesis of Int112

The same equivalents and method were used as in the synthesis process of Int1 using 1-bromo-3-chloro-5-methylbenzene (30 g) and di([1,1'-biphenyl]-4-yl)amine (46.9 g) instead of 3-bromo-5-chloro-1,1'-bipheny and bis(5,5,8,8-tetramethyl-5,6,7,8-tetrahydronaphthalen-2-yl)amine, and after the reaction was finished, the result was extracted and then recrystallized to obtain Int112 (51 g, yield 78%). MS[M+H]+=447

### 2) Synthesis of Int113

The same equivalents and method were used as in the synthesis process of Int2 using Int112 and N-(4-(tert-butyl)phenyl)-1-(4,4,5,5-tetramethyl-1,3,2-dioxaborolan-2-yl)dibenzo[b,d]furan-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int113 (37 g, yield 76%). MS[M+H]+=726

### 3) Synthesis of Compound M57

Under the nitrogen atmosphere, Int113 (25 g) and boron triiodide (23 g) were introduced to 1,2-dichlorobenzene (250 ml), and stirred for 4 hours at 160°C. After the reaction was finished, the result was extracted, and then recrystallized to obtain Compound M57 (7.4 g, yield 29%). MS[M+H]+=734

### Synthesis Example 58. Synthesis of Compound M58

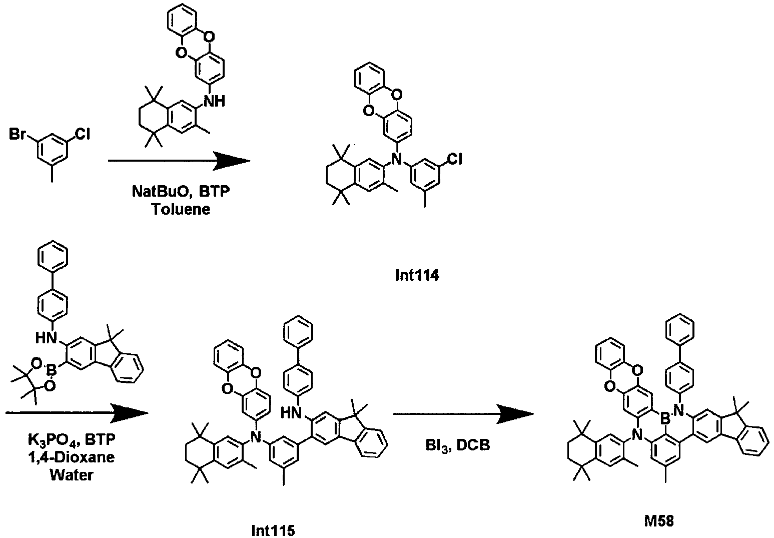

### 1) Synthesis of Int114

The same equivalents and method were used as in the synthesis process of Int1 using 1-bromo-3-chloro-5-methylbenzene (30 g) and N-(3,5,5,8,8-pentamethyl-5,6,7,8-tetrahydronaphthalen-2-yl)dibenzo[b,e][1,4]dioxin-2-amine (58.4 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int114 (55 g, yield 72%). MS[M+H]+=525

### 2) Synthesis of Int115

The same equivalents and method were used as in the synthesis process of Int2 using Int114 and N-([1,1'-biphenyl]-4-yl)-9,9-dimethyl-3-(4,4,5,5-tetramethyl-1,3,2-dioxaborolan-2-yl)-9H-fluoren-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int115 (36.3 g, yield 75%). MS[M+H]+=850

### 3) Synthesis of Compound M58

Under the nitrogen atmosphere, Int115 (25 g) and boron triiodide (19.6 g) were introduced to 1,2-dichlorobenzene (250 ml), and stirred for 4 hours at 160°C. After the reaction was finished, the result was extracted, and then recrystallized to obtain Compound M58 (7.5 g, yield 30%). MS[M+H]+=858

### Synthesis Example 59. Synthesis of Compound M59

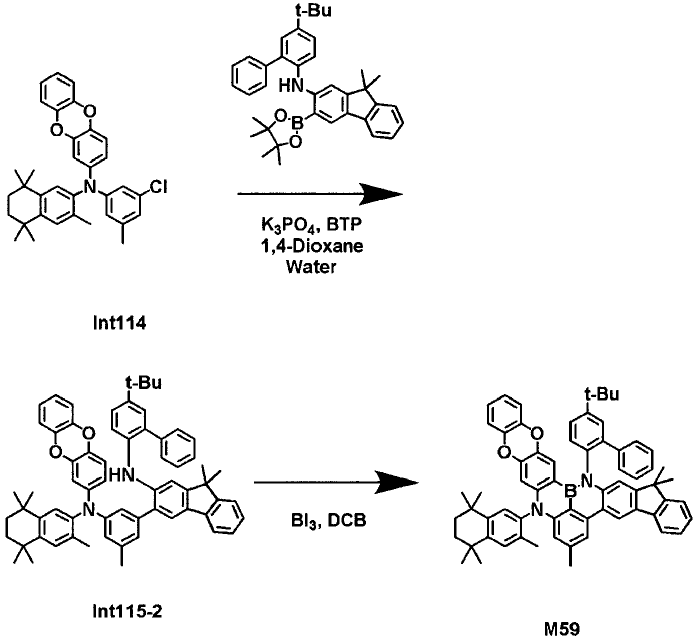

### 1) Synthesis of Int115-2

The same equivalents and method were used as in the synthesis process of Int2 using Int114 and N-(5-(tert-butyl)-[1,1'-biphenyl]-2-yl)-9,9-dimethyl-3-(4,4,5,5-tetramethyl-1,3,2-dioxaborolan-2-yl)-9H-fluoren-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int115-2 (37.7 g, yield 73%). MS[M+H]+=906

### 2) Synthesis of Compound M59

Under the nitrogen atmosphere, Int115-2 (25 g) and boron triiodide (18.4 g) were introduced to 1,2-dichlorobenzene (250 ml), and stirred for 4 hours at 160°C. After the reaction was finished, the result was extracted, and then recrystallized to obtain Compound M59 (7.7 g, yield 31%). MS[M+H]+=914

### Synthesis Example 60. Synthesis of Compound M60

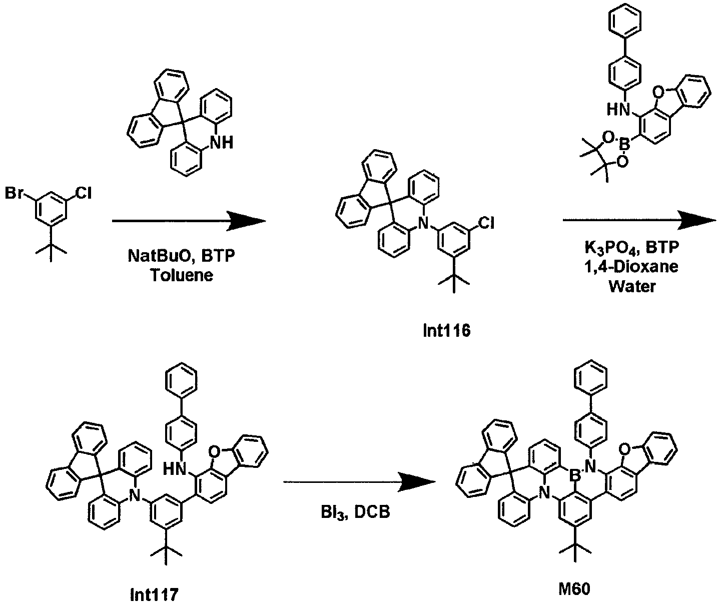

### 1) Synthesis of Int116

The same equivalents and method were used as in the synthesis process of Int1 using 1-bromo-3-(tert-butyl)-5-chlorobenzene (30 g) and 10H-spiro[acridine-9,9'-fluorene] (40.2 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int116 (46 g, yield 76%). MS[M+H]+=499

### 2) Synthesis of Int117

The same equivalents and method were used as in the synthesis process of Int2 using Int116 and N-([1,1'-biphenyl]-4-yl)-3-(4,4,5,5-tetramethyl-1,3,2-dioxaborolan-2-yl)dibenzo[b,d]furan-4-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int117 (36.6 g, yield 76%). MS[M+H]+=798

### 3) Synthesis of Compound M60

Under the nitrogen atmosphere, Int117 (25 g) and boron triiodide (20.9 g) were introduced to 1,2-dichlorobenzene (250 ml), and stirred for 4 hours at 160°C. After the reaction was finished, the result was extracted, and then recrystallized to obtain Compound M60 (6.9 g, yield 27%). MS[M+H]+=806

### Synthesis Example 61. Synthesis of Compound M61

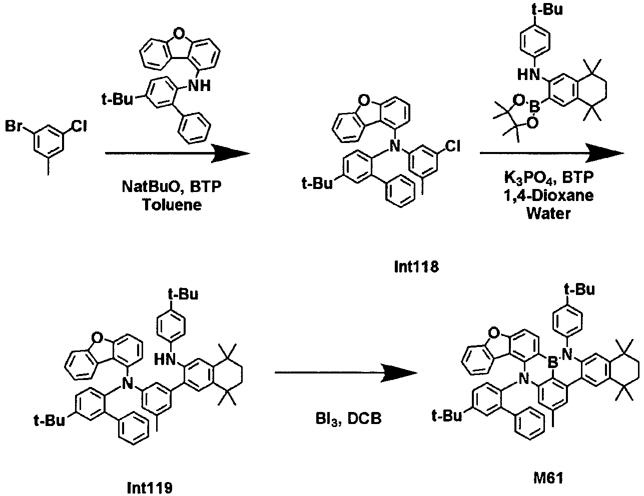

### 1) Synthesis of Int118

The same equivalents and method were used as in the synthesis process of Int1 using 1-bromo-3-chloro-5-methylbenzene (30 g) and N-(5-(tert-butyl)-[1,1'-biphenyl]-2-yl)dibenzo[b,d]furan-1-amine (57.2 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int118 (55 g, yield 73%). MS[M+H]+=517

### 2) Synthesis of Int119

The same equivalents and method were used as in the synthesis process of Int2 using Int118 and N-(4-(tert-butyl)phenyl)-5,5,8,8-tetramethyl-3-(4,4,5,5-tetramethyl-1,3,2-dioxaborolan-2-yl)-5,6,7,8-tetrahydronaphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int119 (36.6 g, yield 77%). MS[M+H]+=816

### 3) Synthesis of Compound M61

Under the nitrogen atmosphere, Int119 (25 g) and boron triiodide (20.4 g) were introduced to 1,2-dichlorobenzene (250 ml), and stirred for 4 hours at 160°C. After the reaction was finished, the result was extracted, and then recrystallized to obtain Compound M61 (6.8 g, yield 27%). MS[M+H]+=824

### Synthesis Example 62. Synthesis of Compound M62

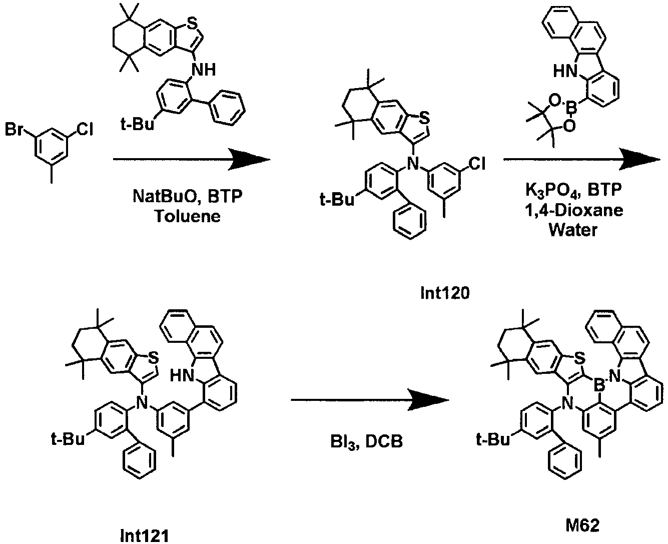

### 1) Synthesis of Int120

The same equivalents and method were used as in the synthesis process of Int1 using 1-bromo-3-chloro-5-methylbenzene (30 g) and N-(5-(tert-butyl)-[1,1'-biphenyl]-2-yl)-5,5,8,8-tetramethyl-5,6,7,8-tetrahydronaphtho[2,3-b]thiophen-3-amine (57.2 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int120 (62 g, yield 72%). MS[M+H]+=593

### 2) Synthesis of Int121

The same equivalents and method were used as in the synthesis process of Int2 using Int120 and 10-(4,4,5,5-tetramethyl-1, 3, 2-dioxaborolan-2-yl) -HH-benzo [a] carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int121 (31.1 g, yield 79%). MS[M+H]+=774

### 3) Synthesis of Compound M62

Under the nitrogen atmosphere, Int121 (25 g) and boron triiodide (21.5 g) were introduced to 1,2-dichlorobenzene (250 ml), and stirred for 4 hours at 160°C. After the reaction was finished, the result was extracted, and then recrystallized to obtain Compound M62 (6.2 g, yield 25%). MS[M+H]+=782

### Synthesis Example 63. Synthesis of Compound M63

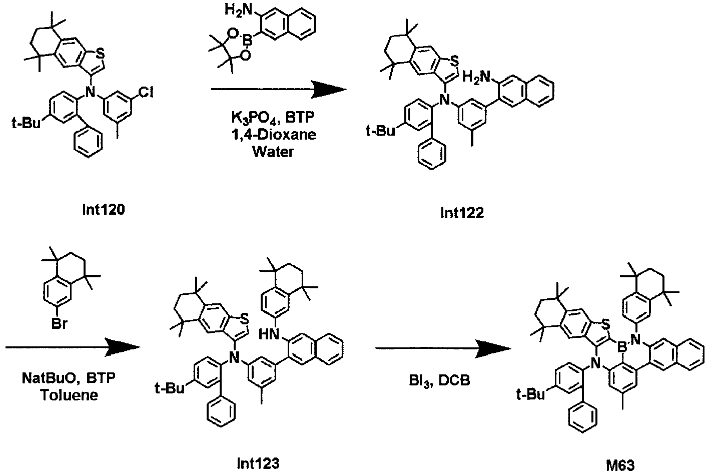

### 1) Synthesis of Int122

The same equivalents and method were used as in the synthesis process of Int2 using Int120 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int122 (27.7 g, yield 78%). MS[M+H]+=700

### 2) Synthesis of Int123

The same equivalents and method were used as in the synthesis process of Int1 using Int122 (27 g) and 6-bromo-1,1,4,4-tetramethyl-1,2,3,4-tetrahydronaphthalene (9.0 g) instead of 3-bromo-5-chloro-1,1'-biphenyl and bis (5, 5, 8, 8-tetramethyl-5,6,7,8-tetrahydronaphthalen-2-yl)amine, and after the reaction was finished, the result was extracted and then recrystallized to obtain Int123 (25.3 g, yield 74%). MS[M+H]+=886

### 3) Synthesis of Compound M63

Under the nitrogen atmosphere, Int123 (25 g) and boron triiodide (18.8 g) were introduced to 1,2-dichlorobenzene (250 ml), and stirred for 4 hours at 160°C. After the reaction was finished, the result was extracted, and then recrystallized to obtain Compound M63 (6.7 g, yield 27%). MS[M+H]+=894

### Synthesis Example 64. Synthesis of Compound M64

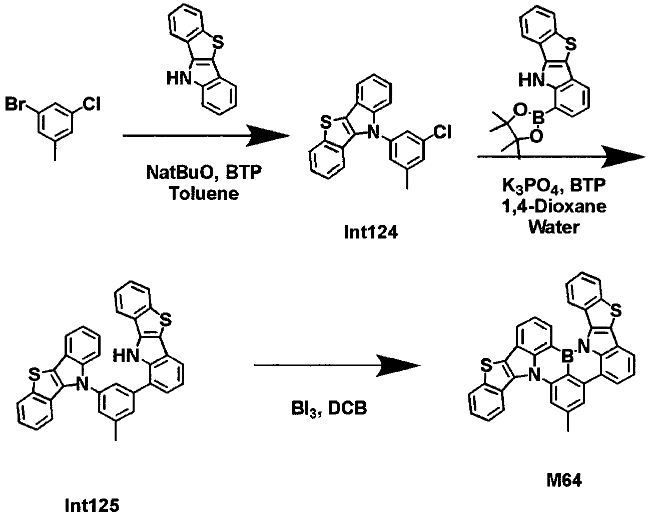

### 1) Synthesis of Int124

The same equivalents and method were used as in the synthesis process of Int1 using 1-bromo-3-chloro-5-methylbenzene (30 g) and 10H-benzo[4,5]thieno[3,2-b]indole (32.6 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int124 (39 g, yield 77%). MS[M+H]+=349

### 2) Synthesis of Int125

The same equivalents and method were used as in the synthesis process of Int2 using Int124 and 1-(4,4,5,5-tetramethyl-1,3,2-dioxaborolan-2-yl)-10H-benzo[4,5]thieno[3,2-b]indole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int125 (33.5 g, yield 73%). MS[M+H]+=536

### 3) Synthesis of Compound M64

Under the nitrogen atmosphere, Int125 (25 g) and boron triiodide (31.2 g) were introduced to 1,2-dichlorobenzene (250 ml), and stirred for 4 hours at 160°C. After the reaction was finished, the result was extracted, and then recrystallized to obtain Compound M64 (6.8 g, yield 27%). MS[M+H]+=544

### Synthesis Example 65. Synthesis of Compound M65

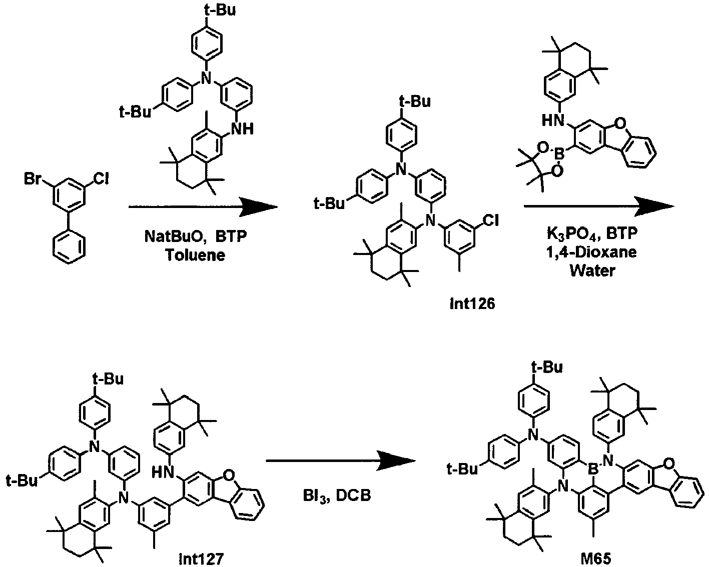

### 1) Synthesis of Int126

The same equivalents and method were used as in the synthesis process of Int1 using N1,N1-bis(4-(tert-butyl)phenyl)-N3-(3,5,5,8,8-pentamethyl-5,6,7,8-tetrahydronaphthalen-2-yl)benzene-1,3-diamine instead of bis(5,5,8,8-tetramethyl-5,6,7,8-tetrahydronaphthalen-2-yl)amine, and after the reaction was finished, the result was extracted and then recrystallized to obtain Int126 (58 g, yield 74%). MS[M+H]+=698

### 2) Synthesis of Int127

The same equivalents and method were used as in the synthesis process of Int2 using Int126 and 2-(4,4,5,5-tetramethyl-1,3,2-dioxaborolan-2-yl)-N-(5,5,8,8-tetramethyl-5,6,7,8-tetrahydronaphthalen-2-yl)dibenzo[b,d]furan-3-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int127 (32.4 g, yield 73%). MS[M+H]+=1031

### 3) Synthesis of Compound M65

Under the nitrogen atmosphere, Int127 (25 g) and boron triiodide (16.2 g) were introduced to 1,2-dichlorobenzene (250 ml), and stirred for 4 hours at 160°C. After the reaction was finished, the result was extracted, and then recrystallized to obtain Compound M65 (6.9 g, yield 27%). MS[M+H]+=1039

### Synthesis Example 66. Synthesis of Compound M66

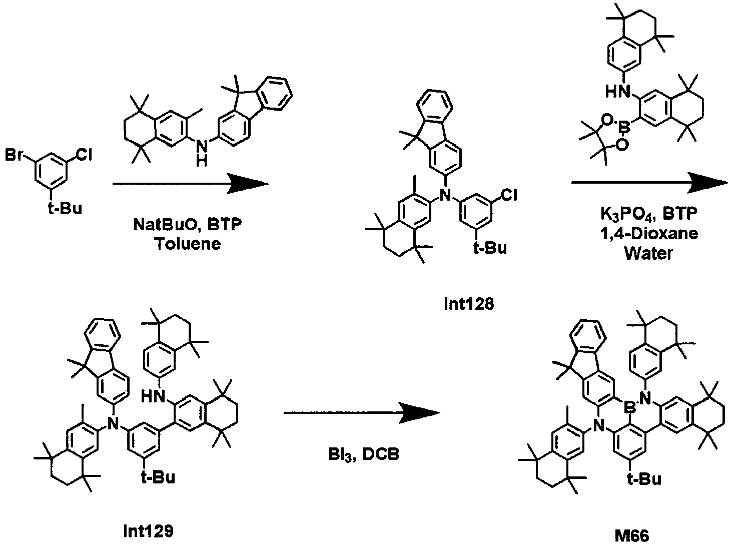

### 1) Synthesis of Int128

The same equivalents and method were used as in the synthesis process of Int1 using 1-bromo-3-(tert-butyl)-5-chlorobenzene (30 g) and 9,9-dimethyl-N-(3,5,5,8,8-pentamethyl-5,6,7,8-tetrahydronaphthalen-2-yl)-9H-fluoren-2-amine (49.6 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int128 (53 g, yield 76%). MS[M+H]+=577

### 2) Synthesis of Int129

The same equivalents and method were used as in the synthesis process of Int2 using Int128 and 5,5,8,8-tetramethyl-3-(4,4,5,5-tetramethyl-1,3,2-dioxaborolan-2-yl)-N-(5,5,8,8-tetramethyl-5,6,7,8-tetrahydronaphthalen-2-yl)-5,6,7,8-tetrahydronaphthalen-2-amine instead of Int1 and 4-(4,4,5,5-tetramethyl-1,3, 2-dioxaborolan-2-yl)-10H-spiro[acridine-9,9'-fluorene], and after the reaction was finished, the result was extracted and then recrystallized to obtain Int129 (35.4 g, yield 73%). MS[M+H]+=930

### 3) Synthesis of Compound M66

Under the nitrogen atmosphere, Int129 (25 g) and boron triiodide (17.9 g) were introduced to 1,2-dichlorobenzene (250 ml), and stirred for 4 hours at 160°C. After the reaction was finished, the result was extracted, and then recrystallized to obtain Compound M66 (7.1 g, yield 28%). MS[M+H]+=938

### Synthesis Example 67. Synthesis of Compound M67

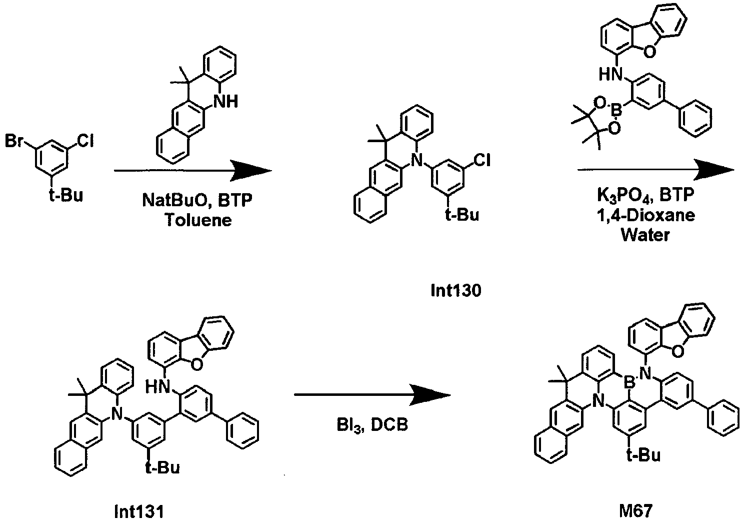

### 1) Synthesis of Int130

The same equivalents and method were used as in the synthesis process of Int1 using 1-bromo-3-(tert-butyl)-5-chlorobenzene (30 g) and 12,12-dimethyl-5,12-dihydrobenzo[b]acridine (31.4 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int130 (38.9 g, yield 75%). MS[M+H]+=427

### 2) Synthesis of Int131

The same equivalents and method were used as in the synthesis process of Int2 using Int130 and N-(3-(4,4,5,5-tetramethyl-1,3,2-dioxaborolan-2-yl)-[1,1'-biphenyl]-4-yl)dibenzo[b,d]furan-4-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int131 (37.7 g, yield 74%). MS[M+H]+=726

### 3) Synthesis of Compound M67

Under the nitrogen atmosphere, Int131 (25 g) and boron triiodide (22.9 g) were introduced to 1,2-dichlorobenzene (250 ml), and stirred for 4 hours at 160°C. After the reaction was finished, the result was extracted, and then recrystallized to obtain Compound M67 (7.2 g, yield 28%). MS[M+H]+=734

### Synthesis Example 68. Synthesis of Compound M68

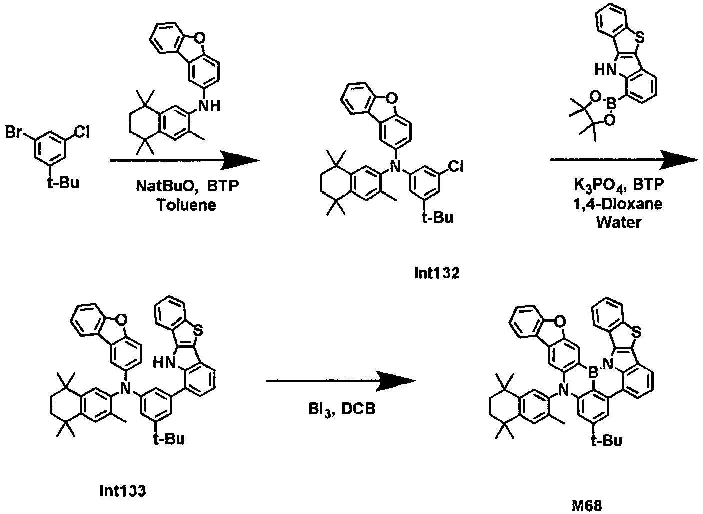

### 1) Synthesis of Int132

The same equivalents and method were used as in the synthesis process of Int1 using 1-bromo-3-(tert-butyl)-5-chlorobenzene (30 g) and N-(3,5,5,8,8-pentamethyl-5,6,7,8-tetrahydronaphthalen-2-yl)dibenzo[b,d]furan-2-amine (46.5 g) instead of 3-bromo-5-chloro-1,1'-biphenyl and bis (5,5,8,8-tetramethyl-5,6,7,8-tetrahydronaphthalen-2-yl)amine, and after the reaction was finished, the result was extracted and then recrystallized to obtain Int132 (47.7 g, yield 72%). MS[M+H]+=551

### 2) Synthesis of Int133

The same equivalents and method were used as in the synthesis process of Int2 using Int132 and 1-(4,4,5,5-tetramethyl-1,3,2-dioxaborolan-2-yl)-10H-benzo[4,5]thieno[3,2-b]indole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int133 (30.3 g, yield 75%). MS[M+H]+=738

### 3) Synthesis of Compound M68

Under the nitrogen atmosphere, Int133 (25 g) and boron triiodide (22.6 g) were introduced to 1,2-dichlorobenzene (250 ml), and stirred for 4 hours at 160°C. After the reaction was finished, the result was extracted, and then recrystallized to obtain Compound M68 (7.1 g, yield 28%). MS[M+H]+=746

### Synthesis Example 69. Synthesis of Compound M69

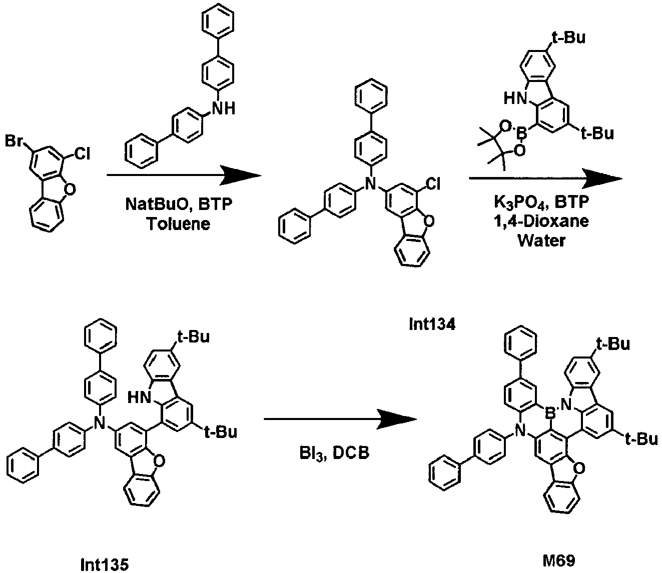

### 1) Synthesis of Int134

Under the nitrogen atmosphere, 2-bromo-4-chlorodibenzo[b,d]furan (30 g), di([1,1'-biphenyl]-4-yl)amine (43.2 g), sodium-tert-butoxide (31 g) and bis(tri-tert-butylphosphine)palladium(0) (1.1 g) were introduced to toluene (600 ml), and refluxed for 4 hours. After the reaction was finished, the result was extracted and then recrystallized to obtain Int134 (41.1 g, yield 74%). MS[M+H]+=523

### 2) Synthesis of Int135

Int134 (30 g), 3,6-di-tert-butyl-1-(4,4,5,5-tetramethyl-1,3,2-dioxaborolan-2-yl)-9H-carbazole (23.3 g), tripotassium phosphate (36.6 g) and bis(tri-tert-butylphosphine)palladium(0) (0.6 g) were introduced to 1,4-dioxane (300 ml) and water (100 ml), and refluxed for 6 hours. After the reaction was finished, the result was extracted and then recrystallized to obtain Int135 (32.3 g, yield 73%). MS[M+H]+=766

### 3) Synthesis of Compound M69

Under the nitrogen atmosphere, Int135 (25 g) and boron triiodide (21.8 g) were introduced to 1,2-dichlorobenzene (250 ml), and stirred for 4 hours at 160°C. After the reaction was finished, the result was extracted, and then recrystallized to obtain Compound M69 (7.3 g, yield 29%). MS[M+H]+=774

### Synthesis Example 70. Synthesis of Compound M70

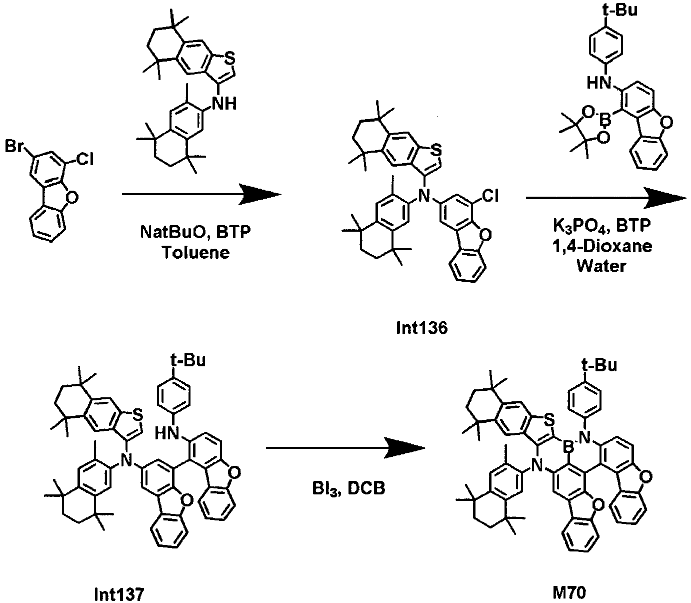

### 1) Synthesis of Int136

The same equivalents and method were used as in the synthesis process of Int134 using 5,5,8,8-tetramethyl-N-(3, 5, 5, 8, 8-pentamethyl-5,6, 7,8-tetrahydronaphthalen-2-yl)-5,6,7,8-tetrahydronaphtho[2,3-b]thiophen-3-amine instead of di([1,1'-biphenyl]-4-yl)amine, and after the reaction was finished, the result was extracted and then recrystallized to obtain Int136 (49.7 g, yield 710). MS[M+H]+=661

### 2) Synthesis of Int137

The same equivalents and method were used as in the synthesis process of Int135 using Int136 and N-(4-(tert-butyl)phenyl)-1-(4,4,5,5-tetramethyl-1,3,2-dioxaborolan-2-yl)dibenzo[b,d]furan-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int137 (33.4 g, yield 78%). MS[M+H]+=940

### 3) Synthesis of Compound M70

Under the nitrogen atmosphere, Int137 (25 g) and boron triiodide (17.7 g) were introduced to 1,2-dichlorobenzene (250 ml), and stirred for 4 hours at 160°C. After the reaction was finished, the result was extracted, and then recrystallized to obtain Compound M70 (7.1 g, yield 28%). MS[M+H]+=948

### Synthesis Example 71. Synthesis of Compound M71

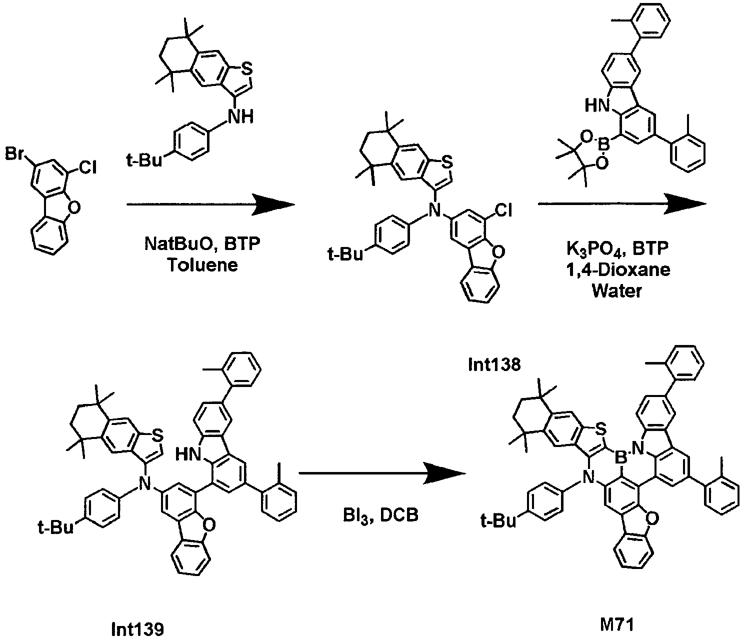

### 1) Synthesis of Int138

The same equivalents and method were used as in the synthesis process of Int134 using N-(4-(tert-butyl)phenyl)-5,5,8,8-tetramethyl-5,6,7,8-tetrahydronaphtho[2,3-b]thiophen-3-amine instead of di([1,1'-biphenyl]-4-yl)amine, and after the reaction was finished, the result was extracted and then recrystallized to obtain Int138 (46.1 g, yield 73%). MS[M+H]+=593

### 2) Synthesis of Int139

The same equivalents and method were used as in the synthesis process of Int135 using Int138 and 1-(4,4,5,5-tetramethyl-1,3,2-dioxaborolan-2-yl)-3,6-di-o-tolyl-9H-carbazole instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int139 (33.2 g, yield 73%). MS[M+H]+=904

### 3) Synthesis of Compound M71

Under the nitrogen atmosphere, Int139 (25 g) and boron triiodide (18.4 g) were introduced to 1,2-dichlorobenzene (250 ml), and stirred for 4 hours at 160°C. After the reaction was finished, the result was extracted, and then recrystallized to obtain Compound M71 (7.1 g, yield 28%). MS[M+H]+=912

### Synthesis Example 72. Synthesis of Compound M72

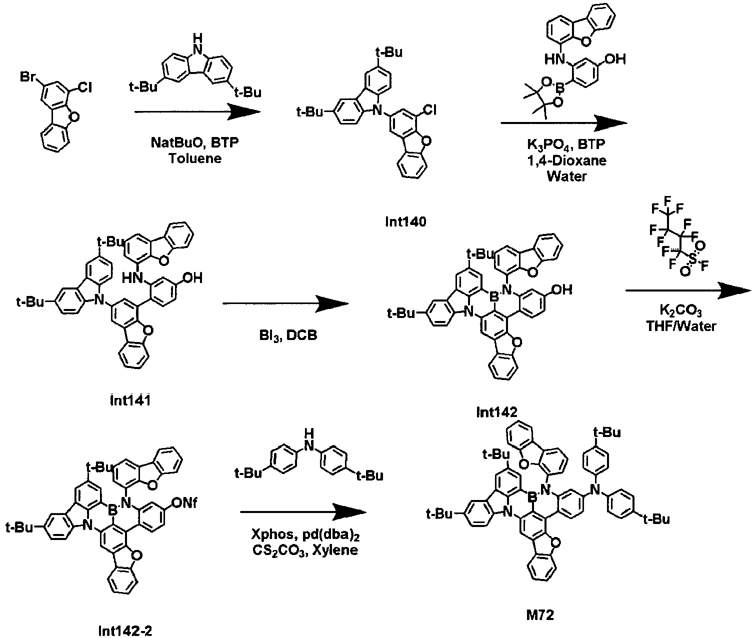

### 1) Synthesis of Int140

The same equivalents and method were used as in the synthesis process of Int134 using 3,6-di-tert-butyl-9H-carbazole instead of di([1,1'-biphenyl]-4-yl)amine, and after the reaction was finished, the result was extracted and then recrystallized to obtain Int140 (38 g, yield 74%). MS[M+H]+=481

### 2) Synthesis of Int141

The same equivalents and method were used as in the synthesis process of Int135 using Int140 and 3-(dibenzo[b,d]furan-4-ylamino)-4-(4,4,5,5-tetramethyl-1,3,2-dioxaborolan-2-yl)phenol instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int141 (33 g, yield 73%). MS[M+H]+=720

### 3) Synthesis of Int142

Under the nitrogen atmosphere, Int137 (25 g) and boron triiodide (23.2 g) were introduced to 1,2-dichlorobenzene (250 ml), and stirred for 4 hours at 160°C. After the reaction was finished, the result was extracted, and then recrystallized to obtain Int142 (7.4 g, yield 29%). MS[M+H]+=728

### 4) Synthesis of Int142-2

Int142 (7 g), 1,1,2,2,3,3,4,4,4-nonafluorobutane-1-sulfonyl fluoride (2.6 ml) and potassium carbonate (4.0 g) were introduced to tetrahydrofuran (70 ml) and water (30 ml), and stirred for 2 hours under reflux. After the reaction was finished, the result was extracted, and then column purified to obtain Int142-2 (9.1 g, yield 94%). MS[M+H]+=1010

### 5) Synthesis of Compound M72

Under the nitrogen atmosphere, Int142-2 (7 g), bis(4-(tert-butyl)phenyl)amine (1.8 g), pd(dba)₂ (0.11 g), Xphos (0.18 g) and cesium carbonate (6.3 g) were introduced to xylene (100 ml), and stirred for 12 hours under reflux. After the reaction was finished, the result was extracted, and then recrystallized to obtain Compound M72 (4.8 g, yield 76%). MS[M+H]+=991

### Synthesis Example 73. Synthesis of Compound M73

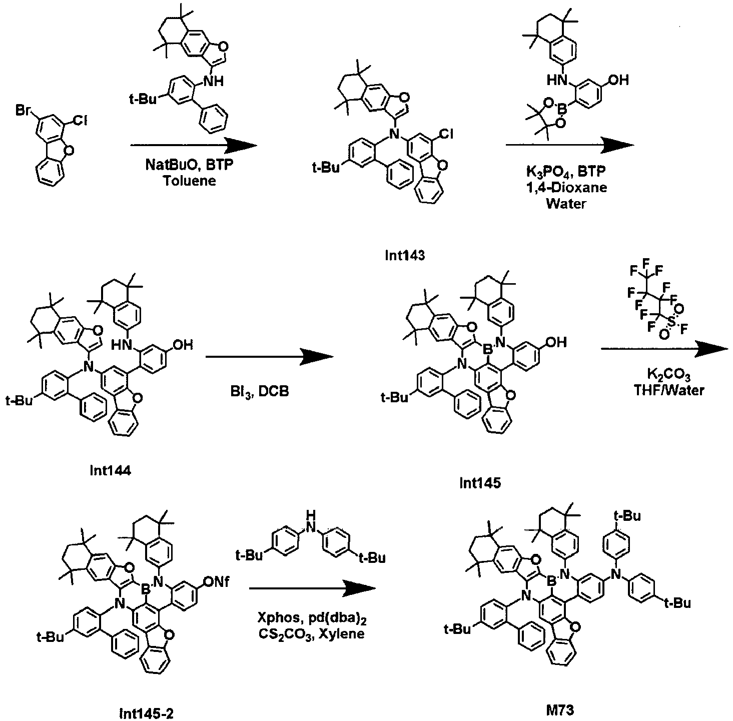

### 1) Synthesis of Int143

The same equivalents and method were used as in the synthesis process of Int134 using N-(5-(tert-butyl)-[1,1'-biphenyl]-2-yl)-5,5,8,8-tetramethyl-5,6,7,8-tetrahydronaphtho[2,3-b]furan-3-amine instead of di([1,1'-biphenyl]-4-yl)amine, and after the reaction was finished, the result was extracted and then recrystallized to obtain Int143 (54 g, yield 78%). MS[M+H]+=653

### 2) Synthesis of Int144

The same equivalents and method were used as in the synthesis process of Int135 using Int143 and 4-(4,4,5,5-tetramethyl-1,3,2-dioxaborolan-2-yl)-3-((5,5,8,8-tetramethyl-5,6,7,8-tetrahydronaphthalen-2-yl)amino)phenol instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int144 (32.2 g, yield 77%). MS[M+H]+=912

### 3) Synthesis of Int145

Under the nitrogen atmosphere, Int144 (25 g) and boron triiodide (18.3 g) were introduced to 1,2-dichlorobenzene (250 ml), and stirred for 4 hours at 160°C. After the reaction was finished, the result was extracted, and then recrystallized to obtain Int145 (7.3 g, yield 29%). MS[M+H]+=920

### 4) Synthesis of Int145-2

Int145 (7 g), 1,1,2,2,3,3,4,4,4-nonafluorobutane-1-sulfonyl fluoride (2.1 ml) and potassium carbonate (3.2 g) were introduced to tetrahydrofuran (70 ml) and water (30 ml), and stirred for 2 hours under reflux. After the reaction was finished, the result was extracted, and then column purified to obtain Int145-2 (8.8 g, yield 96%). MS[M+H]+=1201

### 5) Synthesis of Compound M73

Under the nitrogen atmosphere, Int145-2 (7 g), bis(4-(tert-butyl)phenyl)amine (1.7 g), pd(dba)₂ (0.11 g), Xphos (0.18 g) and cesium carbonate (5.7 g) were introduced to xylene (100 ml), and stirred for 12 hours under reflux. After the reaction was finished, the result was extracted, and then recrystallized to obtain Compound M73 (5.1 g, yield 74%). MS[M+H]+=1183

### Synthesis Example 74. Synthesis of Compound M74

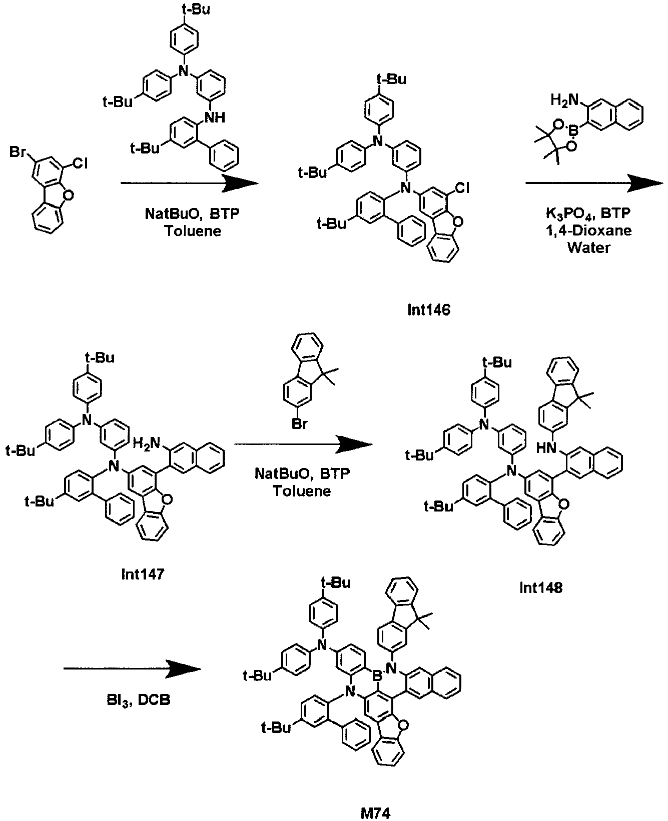

### 1) Synthesis of Int146

The same equivalents and method were used as in the synthesis process of Int134 using N1-(5-(tert-butyl)-[1,1'-biphenyl]-2-yl)-N3,N3-bis(4-(tert-butyl)phenyl)benzene-1,3-diamine instead of di([1,1'-biphenyl]-4-yl)amine, and after the reaction was finished, the result was extracted and then recrystallized to obtain Int146 (61.1 g, yield 73%). MS[M+H]+=782

### 2) Synthesis of Int147

The same equivalents and method were used as in the synthesis process of Int135 using Int146 and 3-(4,4,5,5-tetramethyl-1,3,2-dioxaborolan-2-yl)naphthalen-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int147 (27.1 g, yield 79%). MS[M+H]+=889

### 3) Synthesis of Int148

The same equivalents and method were used as in the synthesis process of Int134 using Int147 (27 g) and 2-bromo-9,9-dimethyl-9H-fluorene (8.3 g) instead of 2-bromo-4-chlorodibenzo[b,d]furan and di([1,1'-biphenyl]-4-yl)amine, and after the reaction was finished, the result was extracted and then recrystallized to obtain Int148 (25.6 g, yield 78%). MS[M+H]+=1080

### 4) Synthesis of Compound M74

Under the nitrogen atmosphere, Int148 (25 g) and boron triiodide (15.4 g) were introduced to 1,2-dichlorobenzene (250 ml), and stirred for 4 hours at 160°C. After the reaction was finished, the result was extracted, and then recrystallized to obtain Compound M74 (7.3 g, yield 29%). MS[M+H]+=1088.

### Synthesis Example 75. Synthesis of Compound M75

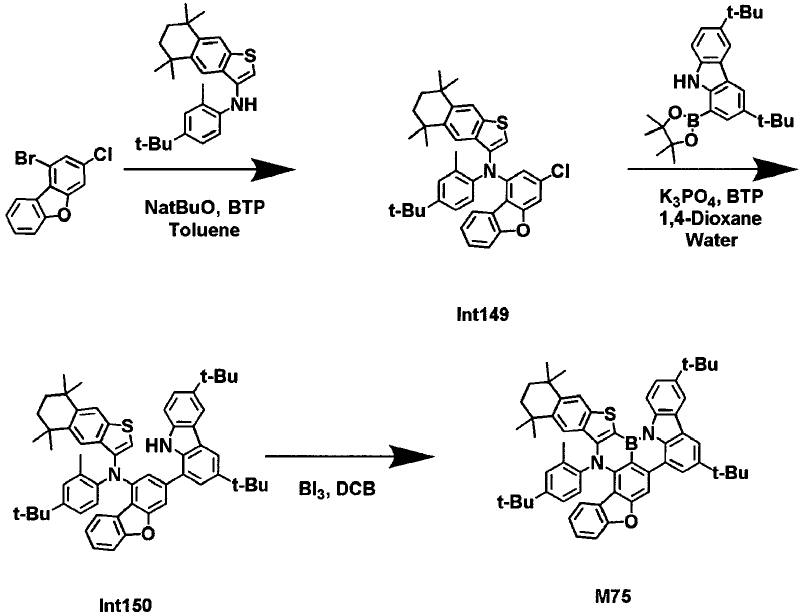

### 1) Synthesis of Int149

The same equivalents and method were used as in the synthesis process of Int134 using 1-bromo-3-chlorodibenzo[b,d]furan and N-(4-(tert-butyl)-2-methylphenyl)-5,5,8,8-tetramethyl-5,6,7,8-tetrahydronaphtho[2,3-b]thiophen-3-amine instead of 2-bromo-4-chlorodibenzo[b,d]furan and di([1,1'-biphenyl]-4-yl)amine, and after the reaction was finished, the result was extracted and then recrystallized to obtain Int149 (46.6 g, yield 72%). MS[M+H]+=607

### 2) Synthesis of Int150

The same equivalents and method were used as in the synthesis process of Int135 using Int149 instead of Int134, and after the reaction was finished, the result was extracted and then recrystallized to obtain Int150 (31.1 g, yield 74%). MS[M+H]+=850

### 3) Synthesis of Compound M75

Under the nitrogen atmosphere, Int150 (25 g) and boron triiodide (19.6 g) were introduced to 1,2-dichlorobenzene (250 ml), and stirred for 4 hours at 160°C. After the reaction was finished, the result was extracted, and then recrystallized to obtain Compound M75 (7.4 g, yield 29%). MS[M+H]+=858

### Synthesis Example 76. Synthesis of Compound M76

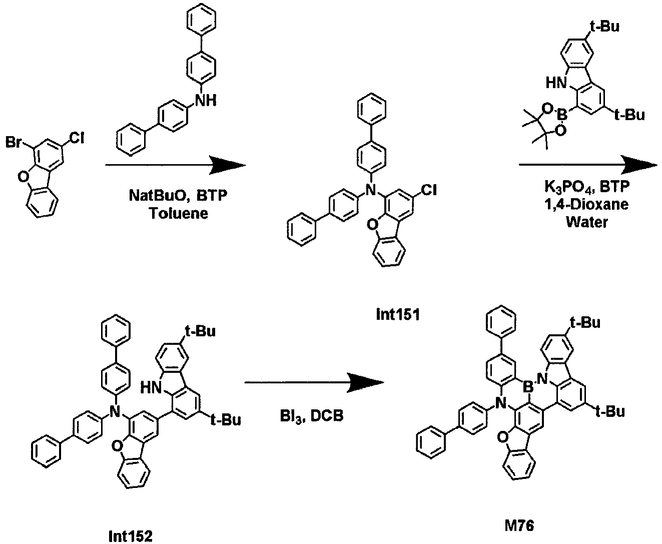

### 1) Synthesis of Int151

The same equivalents and method were used as in the synthesis process of Int134 using 4-bromo-2-chlorodibenzo[b,d]furan instead of 2-bromo-4-chlorodibenzo[b,d]furan, and after the reaction was finished, the result was extracted and then recrystallized to obtain Int151 (42.3 g, yield 76%). MS[M+H]+=523

### 2) Synthesis of Int152

The same equivalents and method were used as in the synthesis process of Int135 using Int151 instead of Int134, and after the reaction was finished, the result was extracted and then recrystallized to obtain Int152 (32.3 g, yield 73%). MS[M+H]+=766

### 3) Synthesis of Compound M76

Under the nitrogen atmosphere, Int152 (25 g) and boron triiodide (21.8 g) were introduced to 1,2-dichlorobenzene (250 ml), and stirred for 4 hours at 160°C. After the reaction was finished, the result was extracted, and then recrystallized to obtain Compound M76 (7.5 g, yield 30%). MS[M+H]+=774

### Synthesis Example 77. Synthesis of Compound M77

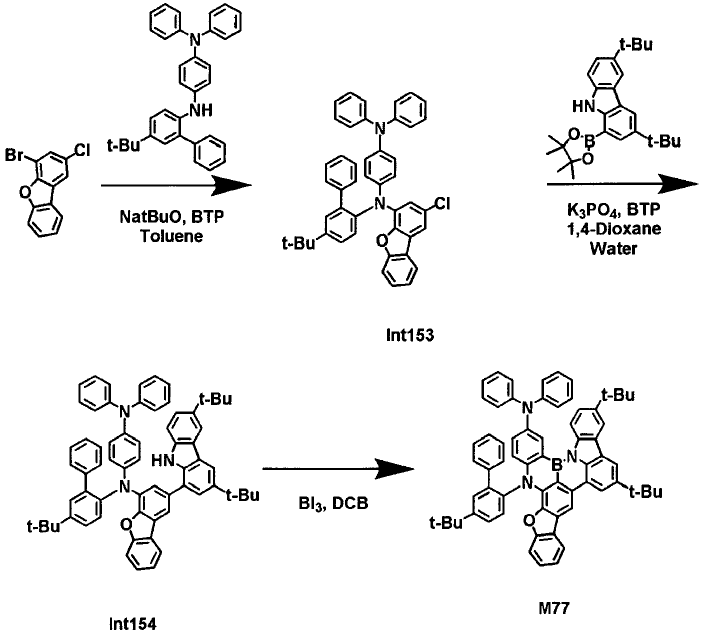

### 1) Synthesis of Int153

The same equivalents and method were used as in the synthesis process of Int134 using 4-bromo-2-chlorodibenzo[b,d]furan and N1-(5-(tert-butyl)-[1,1'-biphenyl]-2-yl)-N4,N4-diphenylbenzene-1,4-diamine instead of 2-bromo-4-chlorodibenzo[b,d]furan and di([1,1'-biphenyl]-4-yl)amine, and after the reaction was finished, the result was extracted and then recrystallized to obtain Int153 (55 g, yield 77%). MS[M+H]+=670

### 2) Synthesis of Int154

The same equivalents and method were used as in the synthesis process of Int135 using Int153 instead of Int134, and after the reaction was finished, the result was extracted and then recrystallized to obtain Int154 (31.2 g, yield 76%). MS[M+H]+=913

### 3) Synthesis of Compound M77

Under the nitrogen atmosphere, Int154 (25 g) and boron triiodide (18.3 g) were introduced to 1,2-dichlorobenzene (250 ml), and stirred for 4 hours at 160°C. After the reaction was finished, the result was extracted, and then recrystallized to obtain Compound M77 (7.3 g, yield 29%). MS[M+H]+=921

### Synthesis Example 78. Synthesis of Compound M78

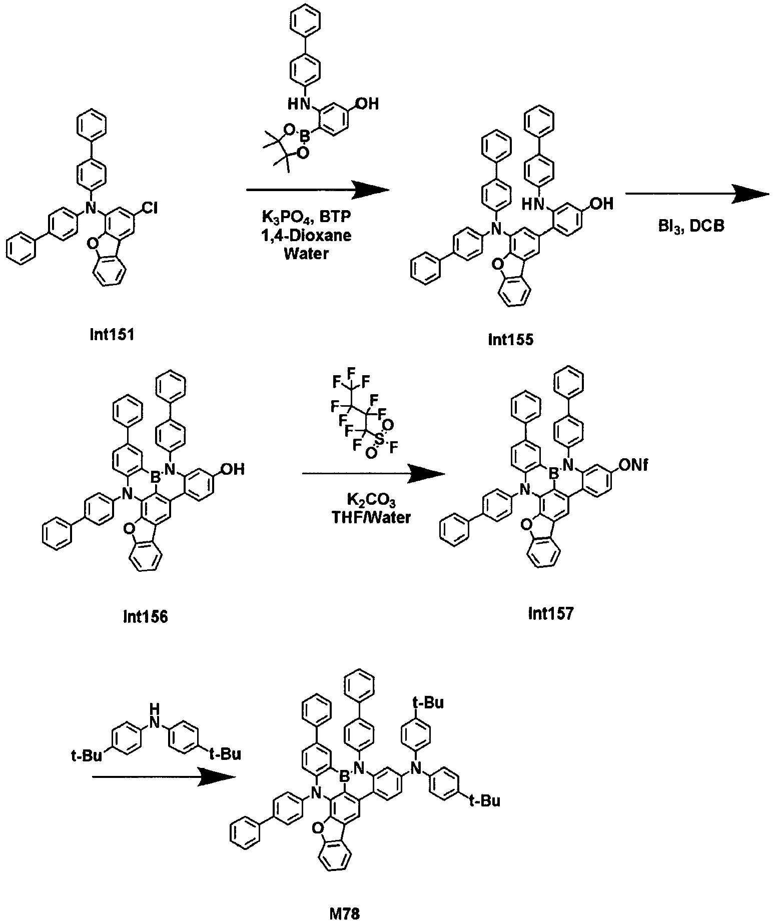

### 1) Synthesis of Int155

The same equivalents and method were used as in the synthesis process of Int135 using Int151 and 3-([1,1'-biphenyl]-4-ylamino)-4-(4,4,5,5-tetramethyl-1,3,2-dioxaborolan-2-yl)phenol instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int155 (26.6 g, yield 79%). MS[M+H]+=748

### 2) Synthesis of Int156

Under the nitrogen atmosphere, Int155 (25 g) and boron triiodide (22.3 g) were introduced to 1,2-dichlorobenzene (250 ml), and stirred for 4 hours at 160°C. After the reaction was finished, the result was extracted, and then recrystallized to obtain Int156 (7.1 g, yield 28%). MS[M+H]+=756

### 3) Synthesis of Int157

Int156 (7 g), 1,1,2,2,3,3,4,4,4-nonafluorobutane-1-sulfonyl fluoride (2.5 ml) and potassium carbonate (3.9 g) were introduced to tetrahydrofuran (70 ml) and water (30 ml), and stirred for 2 hours under reflux. After the reaction was finished, the result was extracted, and then column purified to obtain Int157 (8.9 g, yield 93%). MS[M+H]+=1038

### 4) Synthesis of Compound M78

Under the nitrogen atmosphere, Int157 (7 g), bis(4-(tert-butyl)phenyl)amine (1.9 g), pd(dba)₂ (0.12 g), Xphos (0.19 g) and cesium carbonate (6.6 g) were introduced to xylene (100 ml), and stirred for 12 hours under reflux. After the reaction was finished, the result was extracted, and then recrystallized to obtain Compound M78 (5.3 g, yield 77%). MS[M+H]+=1019

### Synthesis Example 79. Synthesis of Compound M79

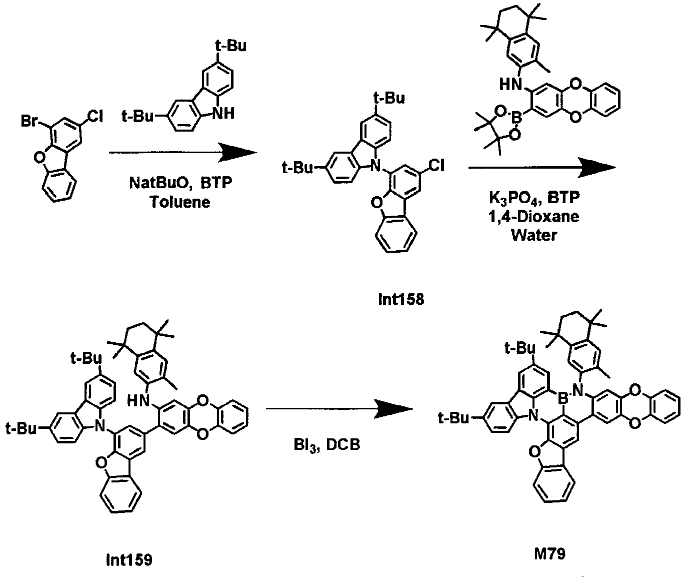

### 1) Synthesis of Int158

The same equivalents and method were used as in the synthesis process of Int134 using 4-bromo-2-chlorodibenzo[b,d]furan and 3,6-di-tert-butyl-9H-carbazole instead of 2-bromo-4-chlorodibenzo[b,d]furan and di([1,1'-biphenyl]-4-yl)amine, and after the reaction was finished, the result was extracted and then recrystallized to obtain Int158 (38.7 g, yield 76%). MS[M+H]+=481

### 2) Synthesis of Int159

The same equivalents and method were used as in the synthesis process of Int135 using Int158 and N-(3,5,5,8,8-pentamethyl-5,6,7,8-tetrahydronaphthalen-2-yl)-3-(4,4,5,5-tetramethyl-1,3,2-dioxaborolan-2-yl)dibenzo[b,e][1,4]dioxin-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int159 (38.6 g, yield 73%). MS[M+H]+=844

### 3) Synthesis of Compound M79

Under the nitrogen atmosphere, Int159 (25 g) and boron triiodide (19.7 g) were introduced to 1,2-dichlorobenzene (250 ml), and stirred for 4 hours at 160°C. After the reaction was finished, the result was extracted, and then recrystallized to obtain Compound M79 (7.3 g, yield 29%). MS[M+H]+=852

### Synthesis Example 80. Synthesis of Compound M80

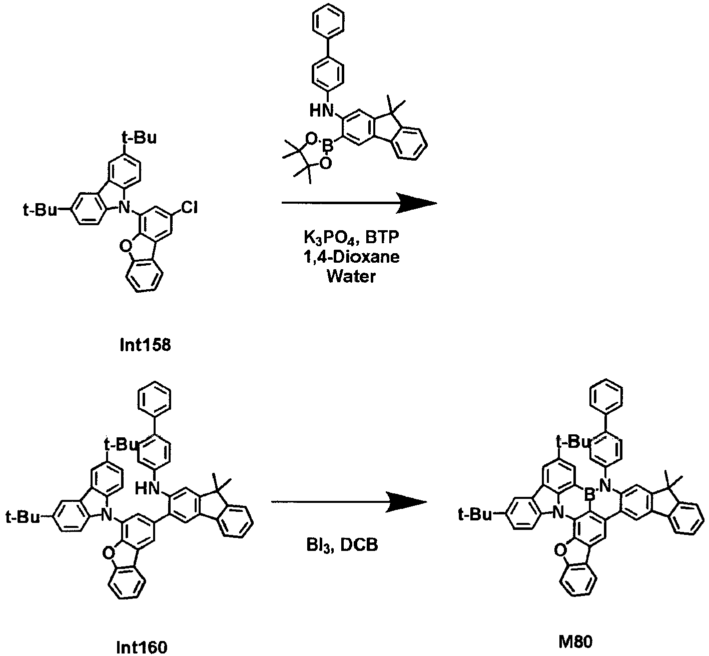

### 1) Synthesis of Int160

The same equivalents and method were used as in the synthesis process of Int135 using Int158 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int160 (37.7 g, yield 75%). MS[M+H]+=806

### 2) Synthesis of Compound M80

Under the nitrogen atmosphere, Int160 (25 g) and boron triiodide (20.7 g) were introduced to 1,2-dichlorobenzene (250 ml), and stirred for 4 hours at 160°C. After the reaction was finished, the result was extracted, and then recrystallized to obtain Compound M80 (7.4 g, yield 29%). MS[M+H]+=814

### Synthesis Example 81. Synthesis of Compound M81

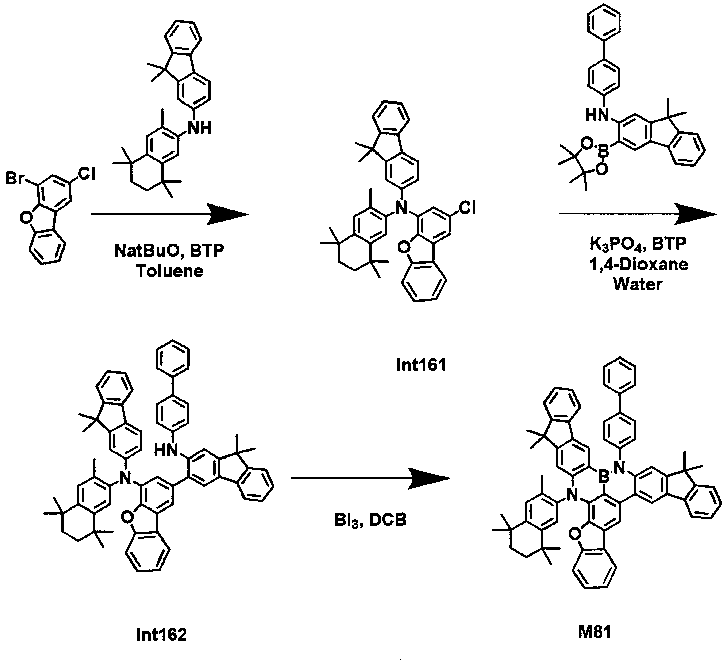

### 1) Synthesis of Int161

The same equivalents and method were used as in the synthesis process of Int134 using 4-bromo-2-chlorodibenzo[b,d]furan and 9,9-dimethyl-N-(3,5,5,8,8-pentamethyl-5,6,7,8-tetrahydronaphthalen-2-yl)-9H-fluoren-2-amine instead of 2-bromo-4-chlorodibenzo[b,d]furan and di([1,1'-biphenyl]-4-yl)amine, and after the reaction was finished, the result was extracted and then recrystallized to obtain Int161 (48.6 g, yield 75%). MS[M+H]+=611

### 2) Synthesis of Int162

The same equivalents and method were used as in the synthesis process of Int135 using Int161 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int162 (34.5 g, yield 75%). MS[M+H]+=936

### 3) Synthesis of Compound M81

Under the nitrogen atmosphere, Int162 (25 g) and boron triiodide (17.8 g) were introduced to 1,2-dichlorobenzene (250 ml), and stirred for 4 hours at 160°C. After the reaction was finished, the result was extracted, and then recrystallized to obtain Compound M81 (7.4 g, yield 29%). MS[M+H]+=944

### Synthesis Example 82. Synthesis of Compound M82

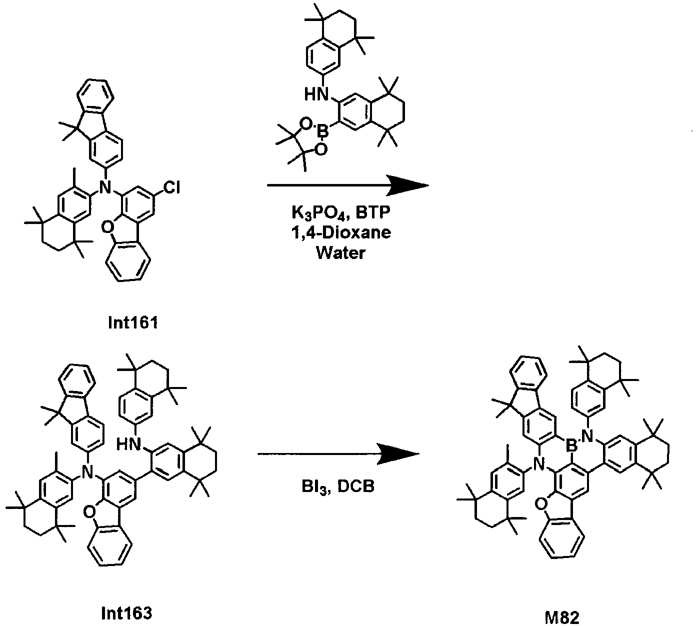

### 1) Synthesis of Int163

The same equivalents and method were used as in the synthesis process of Int135 using Int161 and 5,5,8,8-tetramethyl-3-(4,4,5,5-tetramethyl-1,3,2-dioxaborolan-2-yl)-N-(5,5,8,8-tetramethyl-5,6,7,8-tetrahydronaphthalen-2-yl)-5,6,7,8-tetrahydronaphthalen-2-amine instead of Intl34 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int163 (35 g, yield 74%). MS[M+H]+=964

### 2) Synthesis of Compound M82

Under the nitrogen atmosphere, Int163 (25 g) and boron triiodide (17.3 g) were introduced to 1,2-dichlorobenzene (250 ml), and stirred for 4 hours at 160°C. After the reaction was finished, the result was extracted, and then recrystallized to obtain Compound M82 (7.5 g, yield 30%). MS[M+H]+=972

### Synthesis Example 83. Synthesis of Compound M83

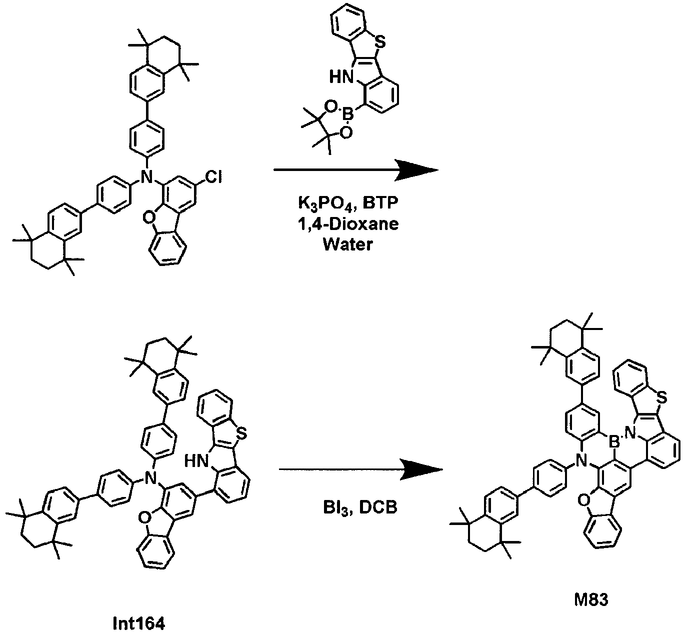

### 1) Synthesis of Int164

The same equivalents and method were used as in the synthesis process of Int135 using 2-chloro-N,N-bis(4-(5,5,8,8-tetramethyl-5,6,7,8-tetrahydronaphthalen-2-yl)phenyl)dibenzo[b,d]furan-4-amine and 1-(4,4,5,5-tetramethyl-1,3,2-dioxaborolan-2-yl)-10H-benzo[4,5]thieno[3,2-b]indole instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int164 (28 g, yield 75%). MS[M+H]+=930

### 2) Synthesis of Compound M83

Under the nitrogen atmosphere, Int164 (25 g) and boron triiodide (17.9 g) were introduced to 1,2-dichlorobenzene (250 ml), and stirred for 4 hours at 160°C. After the reaction was finished, the result was extracted, and then recrystallized to obtain Compound M83 (7.1 g, yield 28%). MS[M+H]+=938

### Synthesis Example 84. Synthesis of Compound M84

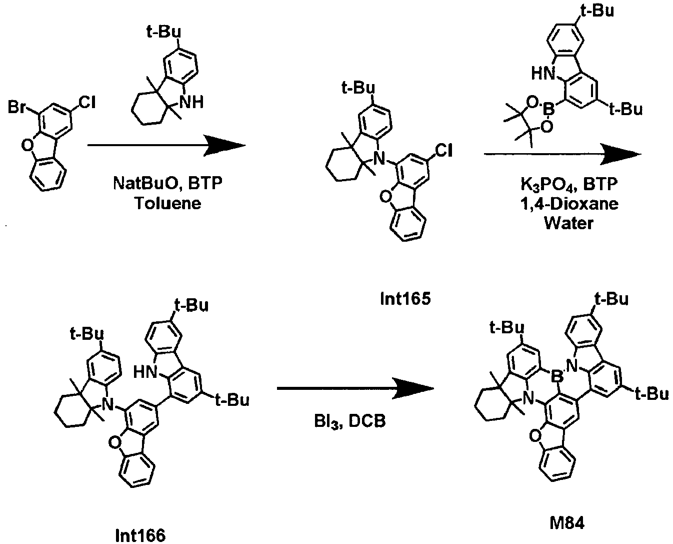

### 1) Synthesis of Int165

The same equivalents and method were used as in the synthesis process of Int134 using 4-bromo-2-chlorodibenzo[b,d]furan and 6-(tert-butyl)-4a,9a-dimethyl-2,3,4,4a,9,9a-hexahydro-1H-carbazole instead of 2-bromo-4-chlorodibenzo[b,d]furan and di([1,1'-biphenyl]-4-yl)amine, and after the reaction was finished, the result was extracted and then recrystallized to obtain Int165 (36.3 g, yield 74%). MS[M+H]+=459

### 2) Synthesis of Int166

The same equivalents and method were used as in the synthesis process of Int135 using Int165 instead of Int134, and after the reaction was finished, the result was extracted and then recrystallized to obtain Int166 (33 g, yield 72%). MS[M+H]+=702

### 3) Synthesis of Compound M84

Under the nitrogen atmosphere, Int166 (25 g) and boron triiodide (23.4 g) were introduced to 1,2-dichlorobenzene (250 ml), and stirred for 4 hours at 160°C. After the reaction was finished, the result was extracted, and then recrystallized to obtain Compound M84 (7.2 g, yield 28%). MS[M+H]+=710

### Synthesis Example 86. Synthesis of Compound M86

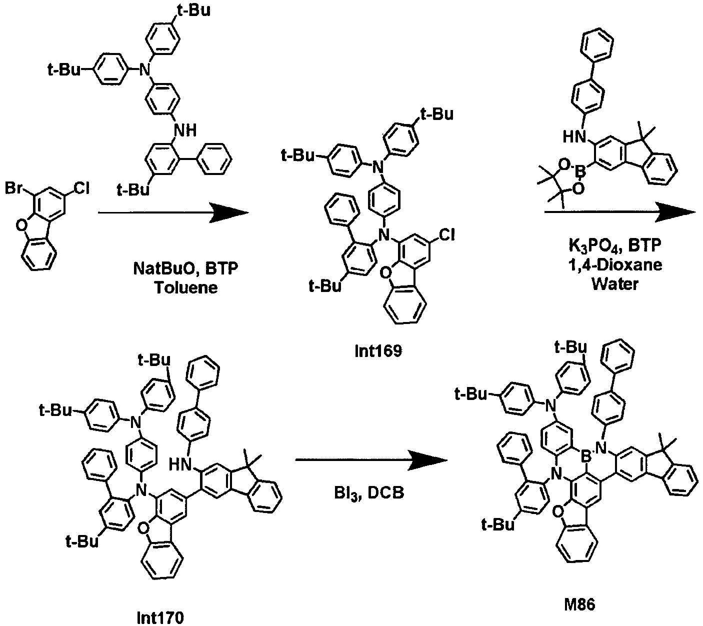

### 1) Synthesis of Int169

The same equivalents and method were used as in the synthesis process of Int134 using 4-bromo-2-chlorodibenzo[b,d]furan and N1-(5-(tert-butyl)-[1,1'-biphenyl]-2-yl)-N4,N4-bis(4-(tert-butyl)phenyl)benzene-1,4-diamine instead of 2-bromo-4-chlorodibenzo[b,d]furan and di([1,1'-biphenyl]-4-yl)amine, and after the reaction was finished, the result was extracted and then recrystallized to obtain Int169 (59 g, yield 710). MS[M+H]+=782

### 2) Synthesis of Int170

The same equivalents and method were used as in the synthesis process of Int135 using Int169 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int170 (32 g, yield 75%). MS[M+H]+=1107

### 3) Synthesis of Compound M86

Under the nitrogen atmosphere, Int170 (25 g) and boron triiodide (15.1 g) were introduced to 1,2-dichlorobenzene (250 ml), and stirred for 4 hours at 160°C. After the reaction was finished, the result was extracted, and then recrystallized to obtain Compound M86 (7.4 g, yield 29%). MS[M+H]+=1115

### Synthesis Example 87. Synthesis of Compound M87

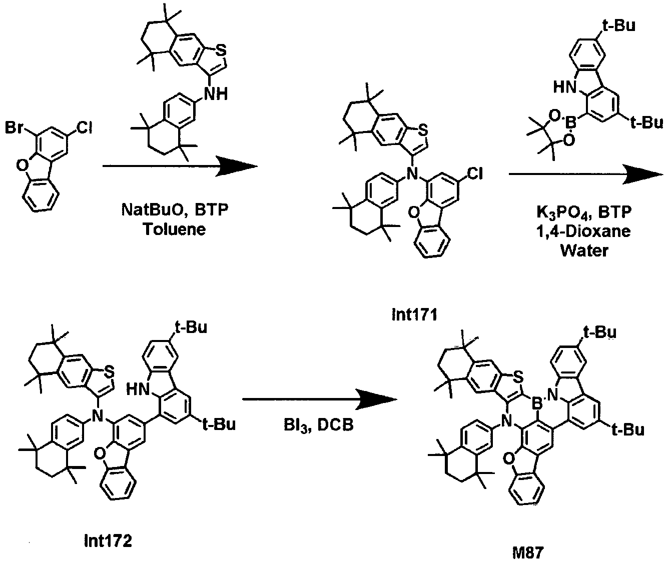

### 1) Synthesis of Int171

The same equivalents and method were used as in the synthesis process of Int134 using 4-bromo-2-chlorodibenzo[b,d]furan and 5,5,8,8-tetramethyl-N-(5,5,8,8-tetramethyl-5,6,7,8-tetrahydronaphthalen-2-yl)-5,6,7,8-tetrahydronaphtho[2,3-b]thiophen-3-amine instead of 2-bromo-4-chlorodibenzo[b,d]furan and di([1,1'-biphenyl]-4-yl)amine, and after the reaction was finished, the result was extracted and then recrystallized to obtain Int171 (51.2 g, yield 74%). MS[M+H]+=647

### 2) Synthesis of Int172

The same equivalents and method were used as in the synthesis process of Int135 using Int171 instead of Int134, and after the reaction was finished, the result was extracted and then recrystallized to obtain Int172 (31 g, yield 75%). MS[M+H]+=890

### 3) Synthesis of Compound M87

Under the nitrogen atmosphere, Int172 (25 g) and boron triiodide (18.7 g) were introduced to 1,2-dichlorobenzene (250 ml), and stirred for 4 hours at 160°C. After the reaction was finished, the result was extracted, and then recrystallized to obtain Compound M87 (7.5 g, yield 30%). MS[M+H]+=898

### Synthesis Example 88. Synthesis of Compound M88

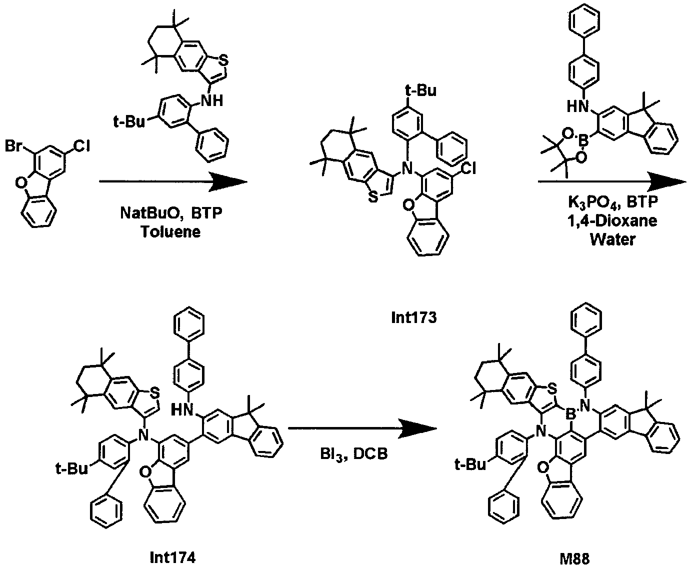

### 1) Synthesis of Int173

The same equivalents and method were used as in the synthesis process of Int134 using 4-bromo-2-chlorodibenzo[b,d]furan and N-(5-(tert-butyl)-[1,1'-biphenyl]-2-yl)-5,5,8,8-tetramethyl-5,6,7,8-tetrahydronaphtho[2,3-b]thiophen-3-amine instead of 2-bromo-4-chlorodibenzo[b,d]furan and di([1,1'-biphenyl]-4-yl)amine, and after the reaction was finished, the result was extracted and then recrystallized to obtain Int173 (53 g, yield 74%). MS[M+H]+=669

### 2) Synthesis of Int174

The same equivalents and method were used as in the synthesis process of Int135 using Int173 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int174 (34 g, yield 76%). MS[M+H]+=994

### 3) Synthesis of Compound M88

Under the nitrogen atmosphere, Int174 (25 g) and boron triiodide (16.8 g) were introduced to 1,2-dichlorobenzene (250 ml), and stirred for 4 hours at 160°C. After the reaction was finished, the result was extracted, and then recrystallized to obtain Compound M88 (7.3 g, yield 29%). MS[M+H]+=1002

### Synthesis Example 89. Synthesis of Compound M89

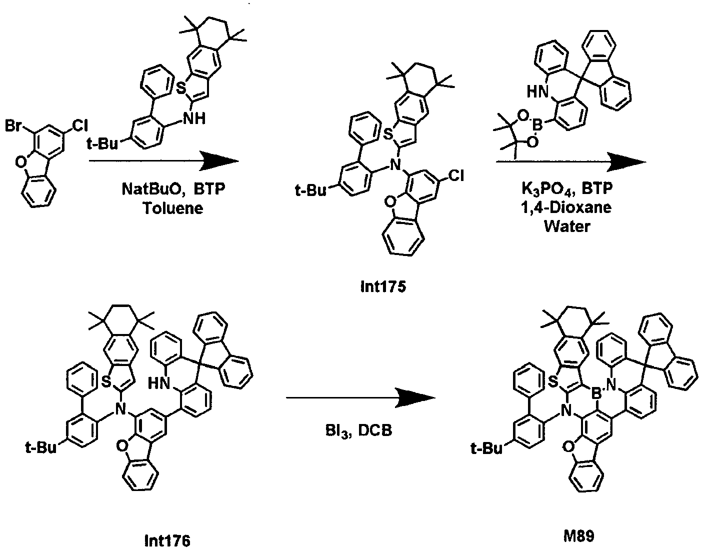

### 1) Synthesis of Int175

The same equivalents and method were used as in the synthesis process of Int134 using 4-bromo-2-chlorodibenzo[b,d]furan and N-(5-(tert-butyl)-[1,1'-biphenyl]-2-yl)-5,5,8,8-tetramethyl-5,6,7,8-tetrahydronaphtho[2,3-b]thiophen-2-amine instead of 2-bromo-4-chlorodibenzo[b,d]furan and di([1,1'-biphenyl]-4-yl)amine, and after the reaction was finished, the result was extracted and then recrystallized to obtain Int175 (52.4 g, yield 74%). MS[M+H]+=669

### 2) Synthesis of Int176

The same equivalents and method were used as in the synthesis process of Int135 using Int175 and 4-(4,4,5,5-tetramethyl-1,3,2-dioxaborolan-2-yl)-10H-spiro[acridine-9,9'-fluorene] instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int176 (33.2 g, yield 77%). MS[M+H]+=964

### 3) Synthesis of Compound M89

Under the nitrogen atmosphere, Int176 (25 g) and boron triiodide (17.3 g) were introduced to 1,2-dichlorobenzene (250 ml), and stirred for 4 hours at 160°C. After the reaction was finished, the result was extracted, and then recrystallized to obtain Compound M89 (7.1 g, yield 28%). MS[M+H]+=972

### Synthesis Example 90. Synthesis of Compound M90

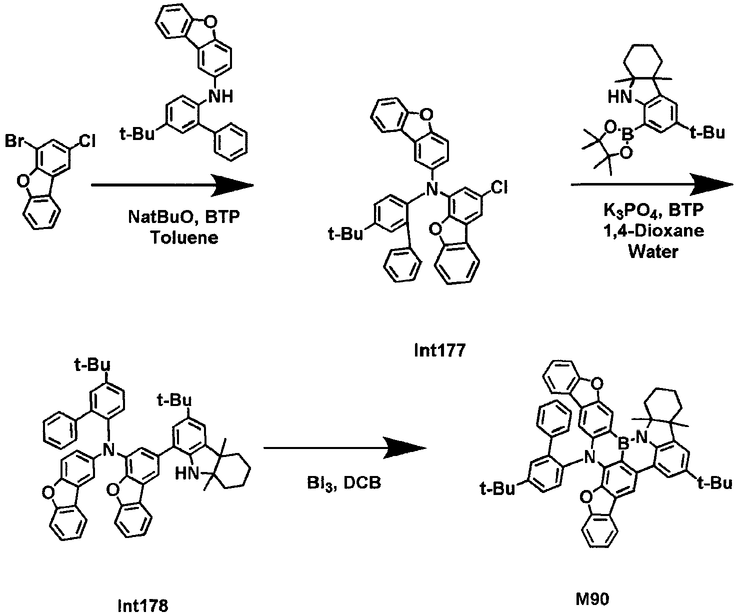

### 1) Synthesis of Int177

The same equivalents and method were used as in the synthesis process of Int134 using 4-bromo-2-chlorodibenzo[b,d]furan and N-(5-(tert-butyl)-[1,1'-biphenyl]-2-yl)dibenzo[b,d]furan-2-amine instead of 2-bromo-4-chlorodibenzo[b,d]furan and di([1,1'-biphenyl]-4-yl)amine, and after the reaction was finished, the result was extracted and then recrystallized to obtain Int177 (45.6 g, yield 72%). MS[M+H]+=593

### 2) Synthesis of Int178

The same equivalents and method were used as in the synthesis process of Int135 using Int177 and 6-(tert-butyl)-4a,9a-dimethyl-8-(4,4,5,5-tetramethyl-1,3,2-dioxaborolan-2-yl)-2,3,4,4a,9,9a-hexahydro-1H-carbazole instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int178 (29.9 g, yield 73%). MS[M+H]+=814

### 3) Synthesis of Compound M90

Under the nitrogen atmosphere, Int178 (25 g) and boron triiodide (20.5 g) were introduced to 1,2-dichlorobenzene (250 ml), and stirred for 4 hours at 160°C. After the reaction was finished, the result was extracted, and then recrystallized to obtain Compound M90 (7.3 g, yield 29%). MS[M+H]+=822

### Synthesis Example 91. Synthesis of Compound M91

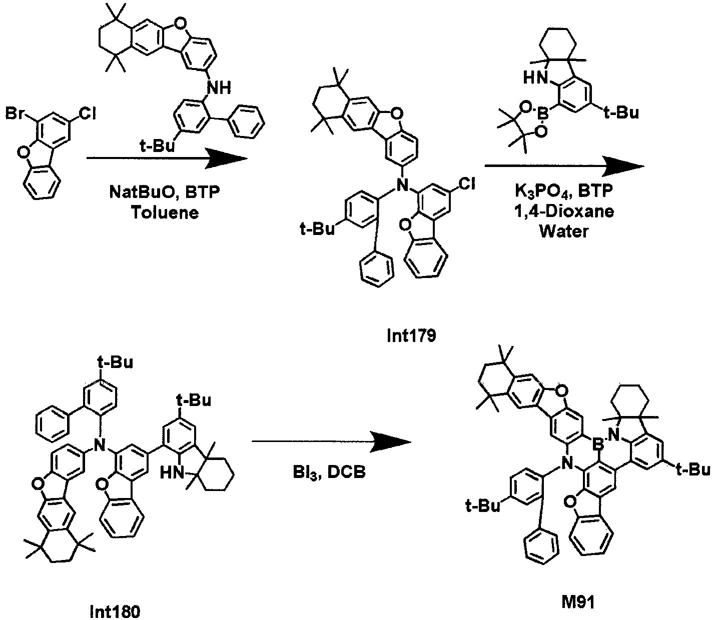

### 1) Synthesis of Int179

The same equivalents and method were used as in the synthesis process of Int134 using 4-bromo-2-chlorodibenzo[b,d]furan and N-(5-(tert-butyl)-[1,1'-biphenyl]-2-yl)-7,7,10,10-tetramethyl-7,8,9,10-tetrahydronaphtho[2,3-b]benzofuran-2-amine instead of 2-bromo-4-chlorodibenzo[b,d]furan and di([1,1'-biphenyl]-4-yl)amine, and after the reaction was finished, the result was extracted and then recrystallized to obtain Int179 (54.4 g, yield 73%). MS[M+H]+=703

### 2) Synthesis of Int180

The same equivalents and method were used as in the synthesis process of Int135 using Int179 and 6-(tert-butyl)-4a,9a-dimethyl-8-(4,4,5,5-tetramethyl-1,3,2-dioxaborolan-2-yl)-2,3,4,4a,9,9a-hexahydro-1H-carbazole instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int180 (28.4 g, yield 72%). MS[M+H]+=924

### 3) Synthesis of Compound M91

Under the nitrogen atmosphere, Int180 (25 g) and boron triiodide (18.1 g) were introduced to 1,2-dichlorobenzene (250 ml), and stirred for 4 hours at 160°C. After the reaction was finished, the result was extracted, and then recrystallized to obtain Compound M91 (7.2 g, yield 29%). MS[M+H]+=932

### Synthesis Example 92. Synthesis of Compound M92

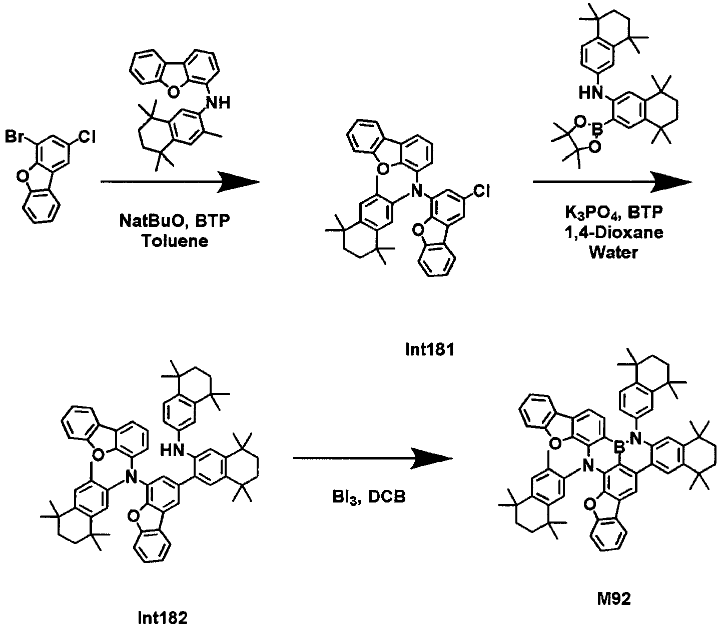

### 1) Synthesis of Int181

The same equivalents and method were used as in the synthesis process of Int134 using 4-bromo-2-chlorodibenzo[b,d]furan and N-(3,5,5,8,8-pentamethyl-5,6,7,8-tetrahydronaphthalen-2-yl)dibenzo[b,d]furan-4-amine instead of 2-bromo-4-chlorodibenzo[b,d]furan and di([1,1'-biphenyl]-4-yl)amine, and after the reaction was finished, the result was extracted and then recrystallized to obtain Int181 (47.2 g, yield 76%). MS[M+H]+=585

### 2) Synthesis of Int182

The same equivalents and method were used as in the synthesis process of Int135 using Int181 and 5,5,8,8-tetramethyl-3-(4,4,5,5-tetramethyl-1,3,2-dioxaborolan-2-yl)-N-(5,5,8,8-tetramethyl-5,6,7,8-tetrahydronaphthalen-2-yl)-5,6,7,8-tetrahydronaphthalen-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int182 (36.3 g, yield 75%). MS[M+H]+=938

### 3) Synthesis of Compound M92

Under the nitrogen atmosphere, Int182 (25 g) and boron triiodide (17.8 g) were introduced to 1,2-dichlorobenzene (250 ml), and stirred for 4 hours at 160°C. After the reaction was finished, the result was extracted, and then recrystallized to obtain Compound M92 (7.4 g, yield 29%). MS[M+H]+=946

### Synthesis Example 93. Synthesis of Compound M93

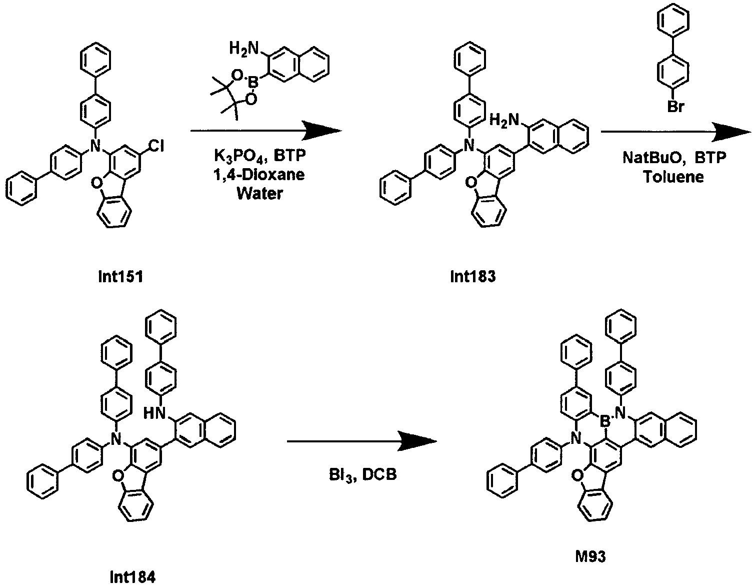

### 1) Synthesis of Int183

The same equivalents and method were used as in the synthesis process of Int135 using Int151 and 3-(4,4,5,5-tetramethyl-1,3,2-dioxaborolan-2-yl)naphthalen-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int183 (27.8 g, yield 77%). MS[M+H]+=630

### 2) Synthesis of Int184

The same equivalents and method were used as in the synthesis process of Int134 using Int183 (27 g) and 4-bromo-1,1'-biphenyl (10.1 g) instead of 2-bromo-4-chlorodibenzo[b,d]furan and di([1,1'-biphenyl]-4-yl)amine, and after the reaction was finished, the result was extracted and then recrystallized to obtain Int184 (25.4 g, yield 76%). MS[M+H]+=782

### 3) Synthesis of Compound M93

Under the nitrogen atmosphere, Int184 (25 g) and boron triiodide (21.3 g) were introduced to 1,2-dichlorobenzene (250 ml), and stirred for 4 hours at 160°C. After the reaction was finished, the result was extracted, and then recrystallized to obtain Compound M93 (7.5 g, yield 30%). MS[M+H]+=790

### Synthesis Example 94. Synthesis of Compound M94

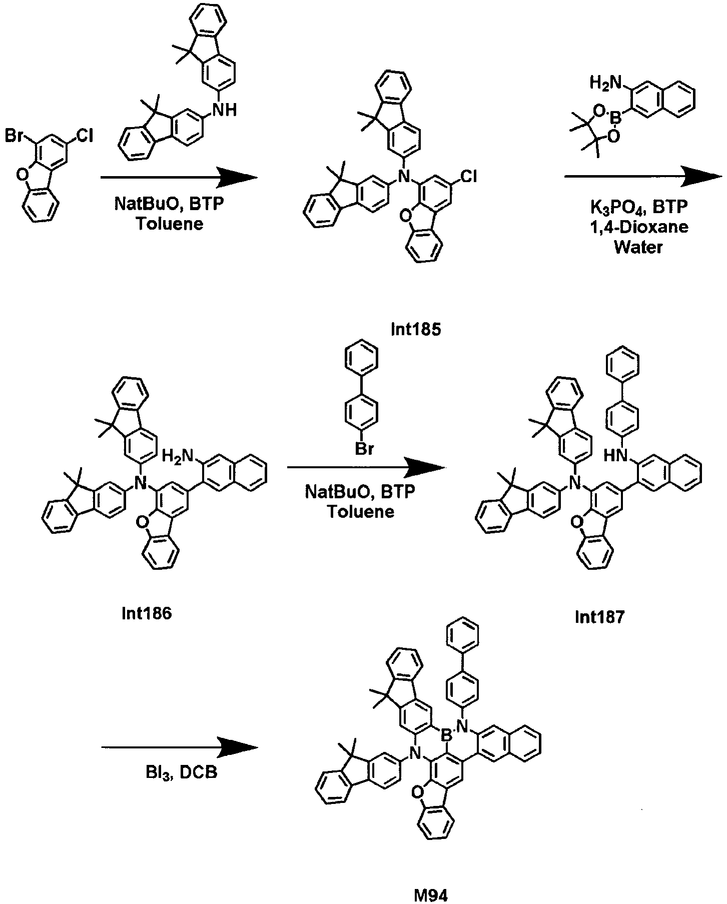

### 1) Synthesis of Int185

The same equivalents and method were used as in the synthesis process of Int134 using 4-bromo-2-chlorodibenzo[b,d]furan and bis(9,9-dimethyl-9H-fluoren-2-yl)amine instead of 2-bromo-4-chlorodibenzo[b,d]furan and di([1,1'-biphenyl]-4-yl)amine, and after the reaction was finished, the result was extracted and then recrystallized to obtain Int185 (48.5 g, yield 76%). MS[M+H]+=603

### 2) Synthesis of Int186

The same equivalents and method were used as in the synthesis process of Int135 using Int185 and 3-(4,4,5,5-tetramethyl-1,3,2-dioxaborolan-2-yl)naphthalen-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int186 (27.6 g, yield 78%). MS[M+H]+=710

### 3) Synthesis of Int187

The same equivalents and method were used as in the synthesis process of Int134 using Int186 (27 g) and 4-bromo-1,1'-biphenyl (8.9 g) instead of 2-bromo-4-chlorodibenzo[b,d]furan and di([1,1'-biphenyl]-4-yl)amine, and after the reaction was finished, the result was extracted and then recrystallized to obtain Int187 (24.4 g, yield 74%). MS[M+H]+=862

### 4) Synthesis of Compound M94

Under the nitrogen atmosphere, Int187 (25 g) and boron triiodide (19.4 g) were introduced to 1,2-dichlorobenzene (250 ml), and stirred for 4 hours at 160°C. After the reaction was finished, the result was extracted, and then recrystallized to obtain Compound M94 (7.1 g, yield 28%). MS[M+H]+=870

### Synthesis Example 95. Synthesis of Compound M95

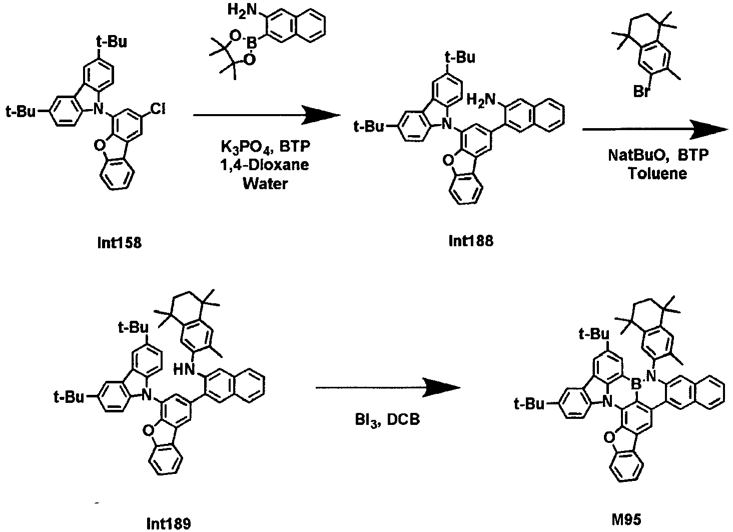

### 1) Synthesis of Int188

The same equivalents and method were used as in the synthesis process of Int135 using Int158 and 3-(4,4,5,5-tetramethyl-1,3,2-dioxaborolan-2-yl)naphthalen-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int188 (27.1 g, yield 74%). MS[M+H]+=588

### 2) Synthesis of Int189

The same equivalents and method were used as in the synthesis process of Int134 using Int188 (27 g) and 6-bromo-1,1,4,4,7-pentamethyl-1,2,3,4-tetrahydronaphthalene (12.9 g) instead of 2-bromo-4-chlorodibenzo[b,d]furan and di([1,1'-biphenyl]-4-yl)amine, and after the reaction was finished, the result was extracted and then recrystallized to obtain Int189 (26.6 g, yield 73%). MS[M+H]+=788

### 3) Synthesis of Compound M95

Under the nitrogen atmosphere, Int189 (25 g) and boron triiodide (21.1 g) were introduced to 1,2-dichlorobenzene (250 ml), and stirred for 4 hours at 160°C. After the reaction was finished, the result was extracted, and then recrystallized to obtain Compound M95 (7.2 g, yield 29%). MS[M+H]+=796

### Synthesis Example 96. Synthesis of Compound M96

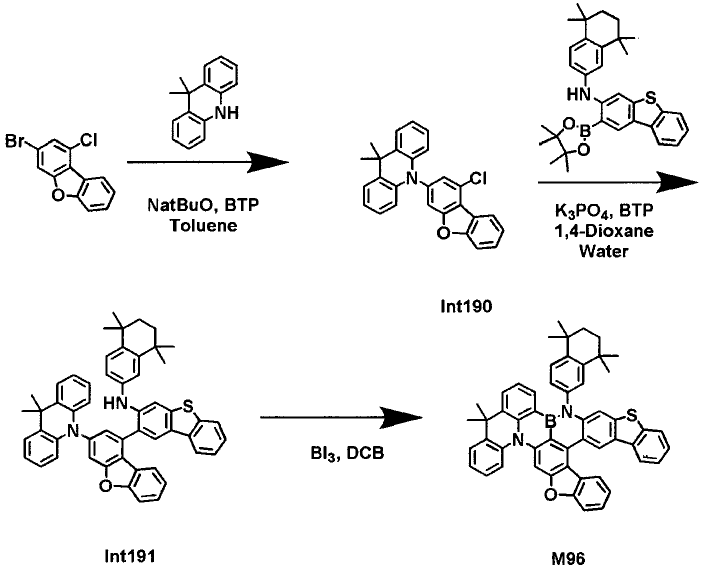

### 1) Synthesis of Int190

The same equivalents and method were used as in the synthesis process of Int134 using 3-bromo-1-chlorodibenzo[b,d]furan and 9,9-dimethyl-9,10-dihydroacridine instead of 2-bromo-4-chlorodibenzo[b,d]furan and di([1,1'-biphenyl]-4-yl)amine, and after the reaction was finished, the result was extracted and then recrystallized to obtain Int190 (34.5 g, yield 79%). MS[M+H]+=411

### 2) Synthesis of Int191

The same equivalents and method were used as in the synthesis process of Int135 using Int190 and 2-(4,4,5,5-tetramethyl-1,3,2-dioxaborolan-2-yl)-N-(5,5,8,8-tetramethyl-5,6,7,8-tetrahydronaphthalen-2-yl)dibenzo[b,d]thiophen-3-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int191 (41.1 g, yield 74%). MS[M+H]+=760

### 3) Synthesis of Compound M96

Under the nitrogen atmosphere, Int191 (25 g) and boron triiodide (21.9 g) were introduced to 1,2-dichlorobenzene (250 ml), and stirred for 4 hours at 160°C. After the reaction was finished, the result was extracted, and then recrystallized to obtain Compound M96 (7.4 g, yield 29%). MS[M+H]+=768

### Synthesis Example 97. Synthesis of Compound M97

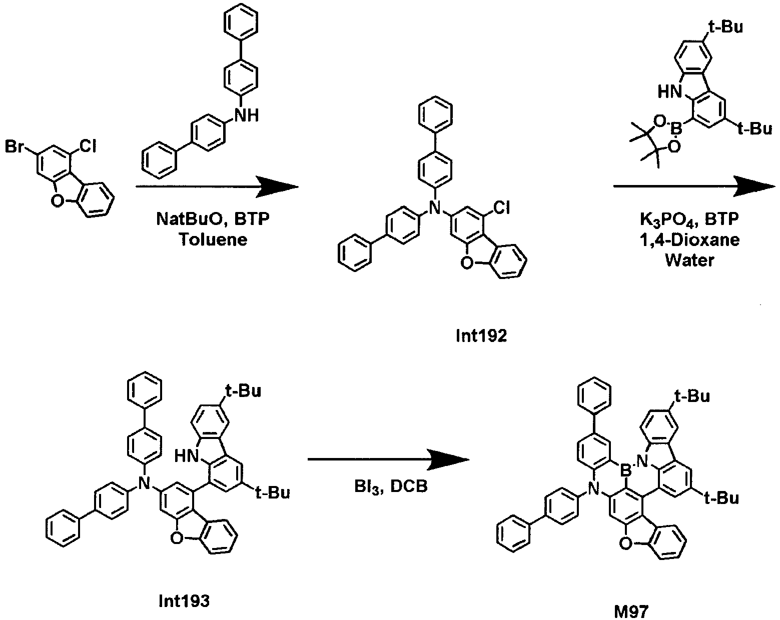

### 1) Synthesis of Int192

The same equivalents and method were used as in the synthesis process of Int134 using 3-bromo-1-chlorodibenzo[b,d]furan instead of 2-bromo-4-chlorodibenzo[b,d]furan, and after the reaction was finished, the result was extracted and then recrystallized to obtain Int192 (43 g, yield 77%). MS[M+H]+=523

### 2) Synthesis of Int193

The same equivalents and method were used as in the synthesis process of Int135 using Int192 instead of Int134, and after the reaction was finished, the result was extracted and then recrystallized to obtain Int193 (34.3 g, yield 78%). MS[M+H]+=766

### 3) Synthesis of Compound M97

Under the nitrogen atmosphere, Int193 (25 g) and boron triiodide (21.7 g) were introduced to 1,2-dichlorobenzene (250 ml), and stirred for 4 hours at 160°C. After the reaction was finished, the result was extracted, and then recrystallized to obtain Compound M97 (7.0 g, yield 28%). MS[M+H]+=774

### Synthesis Example 98. Synthesis of Compound M98

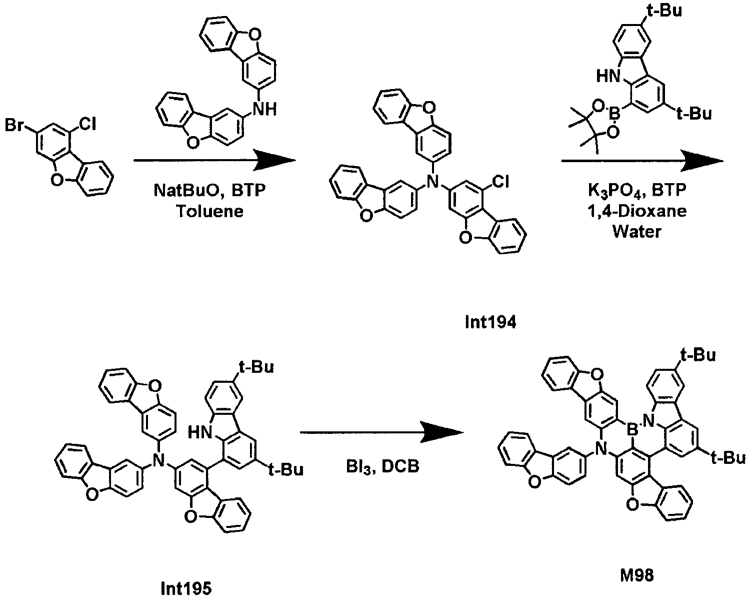

### 1) Synthesis of Int194

The same equivalents and method were used as in the synthesis process of Int134 using 3-bromo-1-chlorodibenzo[b,d]furan and bis(dibenzo[b,d]furan-2-yl)amine instead of 2-bromo-4-chlorodibenzo[b,d]furan and di([1,1'-biphenyl]-4-yl)amine, and after the reaction was finished, the result was extracted and then recrystallized to obtain Int194 (42 g, yield 72%). MS[M+H]+=551

### 2) Synthesis of Int195

The same equivalents and method were used as in the synthesis process of Int135 using Int194 instead of Int134, and after the reaction was finished, the result was extracted and then recrystallized to obtain Int195 (33.2 g, yield 77%). MS[M+H]+=794

### 3) Synthesis of Compound M98

Under the nitrogen atmosphere, Int195 (25 g) and boron triiodide (21 g) were introduced to 1,2-dichlorobenzene (250 ml), and stirred for 4 hours at 160°C. After the reaction was finished, the result was extracted, and then recrystallized to obtain Compound M98 (7.1 g, yield 28%). MS[M+H]+=802

### Synthesis Example 99. Synthesis of Compound M99

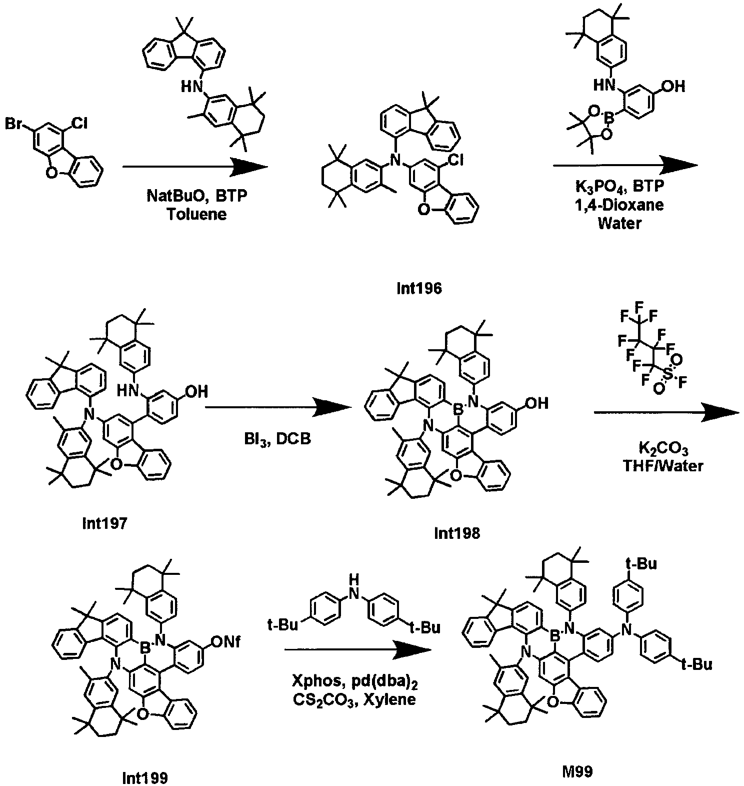

### 1) Synthesis of Int196

The same equivalents and method were used as in the synthesis process of Int134 using 3-bromo-1-chlorodibenzo[b,d]furan and 9,9-dimethyl-N-(3,5,5,8,8-pentamethyl-5,6,7,8-tetrahydronaphthalen-2-yl)-9H-fluoren-4-amine instead of 2-bromo-4-chlorodibenzo[b,d]furan and di([1,1'-biphenyl]-4-yl)amine, and after the reaction was finished, the result was extracted and then recrystallized to obtain Int196 (47.2 g, yield 73%). MS[M+H]+=611

### 2) Synthesis of Int197

The same equivalents and method were used as in the synthesis process of Int135 using Int196 and 4-(4,4,5,5-tetramethyl-1,3,2-dioxaborolan-2-yl)-3-((5,5,8,8-tetramethyl-5, 6, 7, 8-tetrahydronaphthalen-2-yl) amino) phenol instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int197 (33.1 g, yield 77%). MS[M+H]+=870

### 3) Synthesis of Int198

Under the nitrogen atmosphere, Int197 (25 g) and boron triiodide (19.2 g) were introduced to 1,2-dichlorobenzene (250 ml), and stirred for 4 hours at 160°C. After the reaction was finished, the result was extracted, and then recrystallized to obtain Int198 (7.2 g, yield 29%). MS[M+H]+=878

### 4) Synthesis of Int199

Int198 (7 g), 1,1,2,2,3,3,4,4,4-nonafluorobutane-1-sulfonyl fluoride (2.2 ml) and potassium carbonate (3.3 g) were introduced to tetrahydrofuran (70 ml) and water (30 ml), and stirred for 2 hours under reflux. After the reaction was finished, the result was extracted, and then column purified to obtain Int199 (8.8 g, yield 95%). MS[M+H]+=1160

### 5) Synthesis of Compound M99

Under the nitrogen atmosphere, Int199 (7 g), bis(4-(tert-butyl) phenyl) amine (1.7 g), pd(dba)₂ (0.11 g), Xphos (0.18 g) and cesium carbonate (6.0 g) were introduced to xylene (100 ml), and stirred for 12 hours under reflux. After the reaction was finished, the result was extracted, and then recrystallized to obtain Compound M99 (5.4 g, yield 78%). MS[M+H]+=1141

### Synthesis Example 100. Synthesis of Compound M100

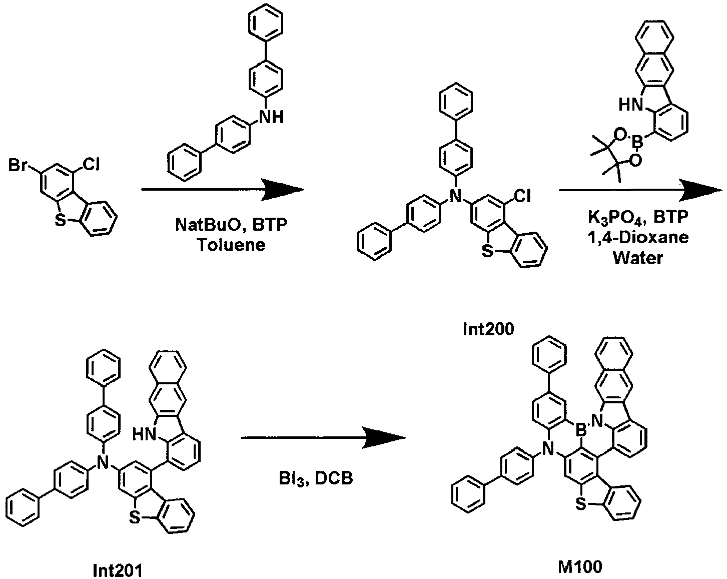

### 1) Synthesis of Int200

The same equivalents and method were used as in the synthesis process of Int134 using 3-bromo-1-chlorodibenzo[b,d]thiophene instead of 2-bromo-4-chlorodibenzo[b,d]furan, and after the reaction was finished, the result was extracted and then recrystallized to obtain Int200 (41.4 g, yield 72%). MS[M+H]+=539

### 2) Synthesis of Int201

The same equivalents and method were used as in the synthesis process of Int135 using Int200 and 4-(4,4,5,5-tetramethyl-1,3,2-dioxaborolan-2-yl)-5H-benzo[b]carbazole instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int201 (28.8 g, yield 72%). MS[M+H]+=720

### 3) Synthesis of Compound M100

Under the nitrogen atmosphere, Int201 (25 g) and boron triiodide (23.1 g) were introduced to 1,2-dichlorobenzene (250 ml), and stirred for 4 hours at 160°C. After the reaction was finished, the result was extracted, and then recrystallized to obtain Compound M100 (7.6 g, yield 30%). MS[M+H]+=728

### Synthesis Example 101. Synthesis of Compound M101

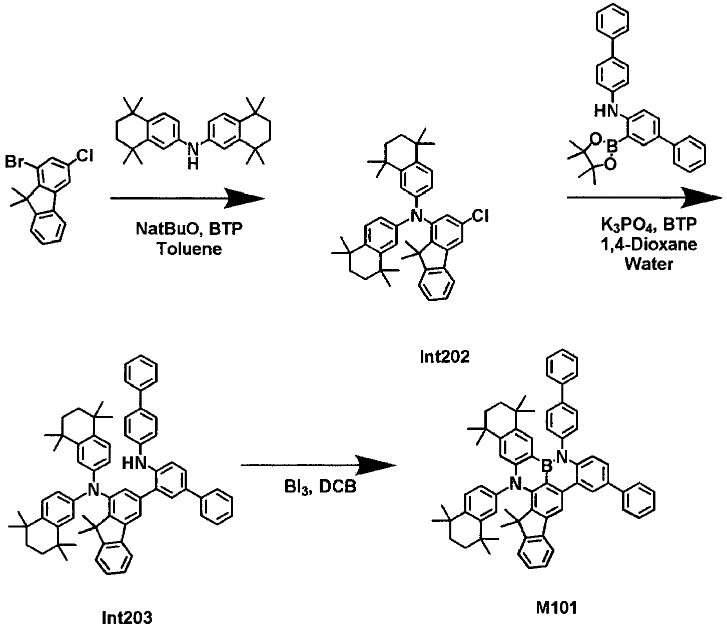

### 1) Synthesis of Int202

The same equivalents and method were used as in the synthesis process of Int134 using 1-bromo-3-chloro-9,9-dimethyl-9H-fluorene and bis(5,5,8,8-tetramethyl-5,6,7,8-tetrahydronaphthalen-2-yl)amine instead of 2-bromo-4-chlorodibenzo[b,d]furan and di([1,1'-biphenyl]-4-yl)amine, and after the reaction was finished, the result was extracted and then recrystallized to obtain Int202 (43.3 g, yield 72%). MS[M+H]+=617

### 2) Synthesis of Int203

The same equivalents and method were used as in the synthesis process of Int135 using Int202 and N-([1,1'-biphenyl]-4-yl)-3-(4,4,5,5-tetramethyl-1,3,2-dioxaborolan-2-yl)-[1,1'-biphenyl]-4-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int203 (34.3 g, yield 78%). MS[M+H]+=902

### 3) Synthesis of Compound M101

Under the nitrogen atmosphere, Int203 (25 g) and boron triiodide (18.5 g) were introduced to 1,2-dichlorobenzene (250 ml), and stirred for 4 hours at 160°C. After the reaction was finished, the result was extracted, and then recrystallized to obtain Compound M101 (7.6 g, yield 30%). MS[M+H]+=910

### Synthesis Example 102. Synthesis of Compound M102

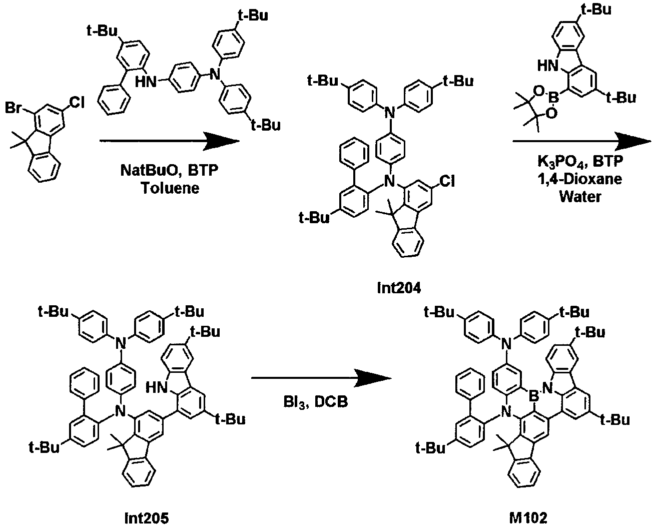

### 1) Synthesis of Int204

The same equivalents and method were used as in the synthesis process of Int134 using 1-bromo-3-chloro-9,9-dimethyl-9H-fluorene and N1-(5-(tert-butyl)-[1,1'-biphenyl]-2-yl)-N4,N4-bis(4-(tert-butyl)phenyl)benzene-1,4-diamine instead of 2-bromo-4-chlorodibenzo[b,d]furan and di([1,1'-biphenyl]-4-yl)amine, and after the reaction was finished, the result was extracted and then recrystallized to obtain Int204 (55.9 g, yield 71%). MS[M+H]+=809

### 2) Synthesis of Int205

The same equivalents and method were used as in the synthesis process of Int135 using Int204 instead of Int134, and after the reaction was finished, the result was extracted and then recrystallized to obtain Int205 (29.8 g, yield 76%). MS[M+H]+=1052

### 3) Synthesis of Compound M102

Under the nitrogen atmosphere, Int205 (25 g) and boron triiodide (15.8 g) were introduced to 1,2-dichlorobenzene (250 ml), and stirred for 4 hours at 160°C. After the reaction was finished, the result was extracted, and then recrystallized to obtain Compound M102 (7.4 g, yield 29%). MS[M+H]+=1060

### Synthesis Example 103. Synthesis of Compound M103

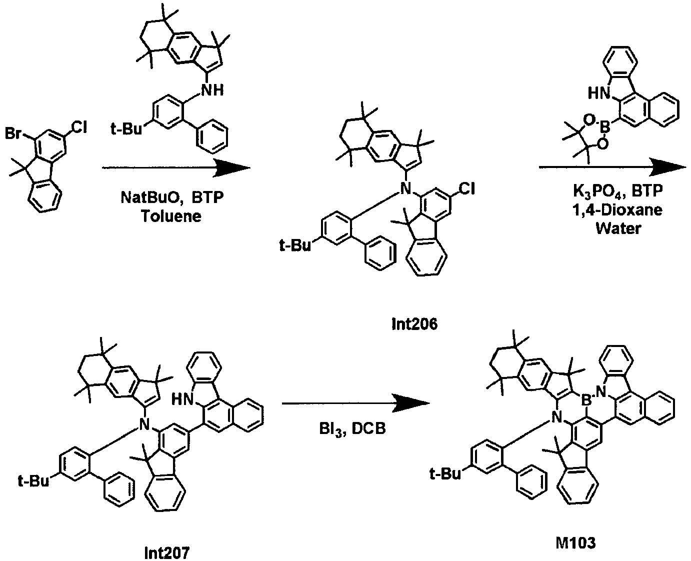

### 1) Synthesis of Int206

The same equivalents and method were used as in the synthesis process of Int134 using 1-bromo-3-chloro-9,9-dimethyl-9H-fluorene and N-(5-(tert-butyl)-[1,1'-biphenyl]-2-yl)-1,1,5,5,8,8-hexamethyl-5,6,7,8-tetrahydro-1H-cyclopenta[b]naphthalen-3-amine instead of 2-bromo-4-chlorodibenzo[b,d]furan and di([1,1'-biphenyl]-4-yl)amine, and after the reaction was finished, the result was extracted and then recrystallized to obtain Int206 (52 g, yield 76%). MS[M+H]+=705

### 2) Synthesis of Int207

The same equivalents and method were used as in the synthesis process of Int135 using Int206 and 6-(4,4,5,5-tetramethyl-1,3,2-dioxaborolan-2-yl)-7H-benzo[c]carbazole instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int207 (27.7 g, yield 73%). MS[M+H]+=886

### 3) Synthesis of Compound M103

Under the nitrogen atmosphere, Int207 (25 g) and boron triiodide (18.8 g) were introduced to 1,2-dichlorobenzene (250 ml), and stirred for 4 hours at 160°C. After the reaction was finished, the result was extracted, and then recrystallized to obtain Compound M103 (7.5 g, yield 30%). MS[M+H]+=894

### Synthesis Example 104. Synthesis of Compound M104

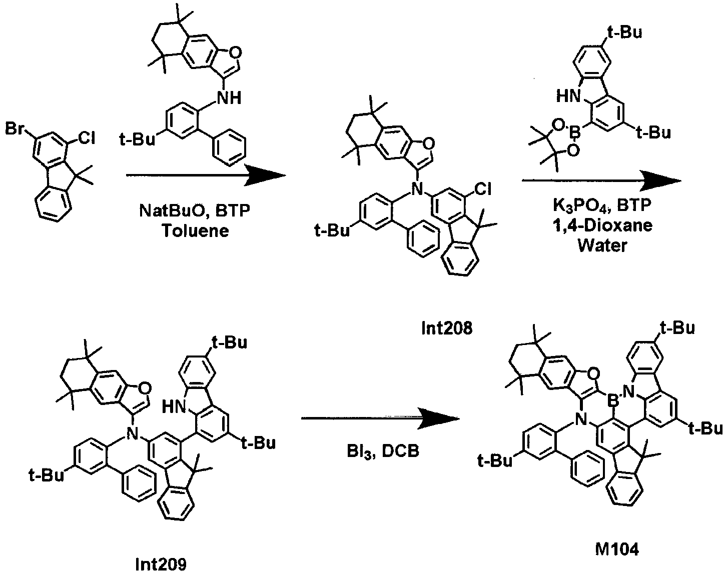

### 1) Synthesis of Int208

The same equivalents and method were used as in the synthesis process of Int134 using 3-bromo-1-chloro-9,9-dimethyl-9H-fluorene and N-(5-(tert-butyl)-[1,1'-biphenyl]-2-yl)-5,5,8,8-tetramethyl-5,6,7,8-tetrahydronaphtho[2,3-b]furan-3-amine instead of 2-bromo-4-chlorodibenzo[b,d]furan and di([1,1'-biphenyl]-4-yl)amine, and after the reaction was finished, the result was extracted and then recrystallized to obtain Int208 (51 g, yield 77%). MS[M+H]+=679

### 2) Synthesis of Int209

The same equivalents and method were used as in the synthesis process of Int135 using Int208 instead of Int134, and after the reaction was finished, the result was extracted and then recrystallized to obtain Int209 (31.4 g, yield 77%). MS [M+H] +=922

### 3) Synthesis of Compound M104

Under the nitrogen atmosphere, Int209 (25 g) and boron triiodide (18.1 g) were introduced to 1,2-dichlorobenzene (250 ml), and stirred for 4 hours at 160°C. After the reaction was finished, the result was extracted, and then recrystallized to obtain Compound M104 (7.3 g, yield 29%). MS[M+H]+=930

### Synthesis Example 105. Synthesis of Compound M105

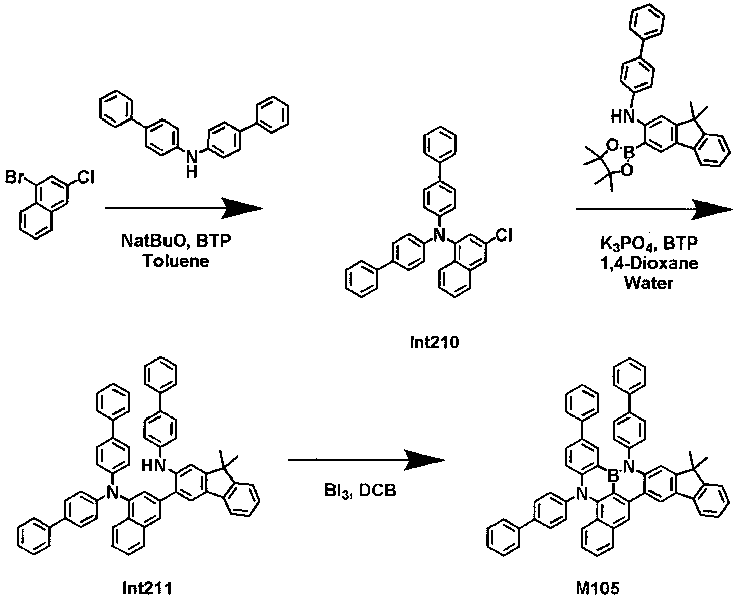

### 1) Synthesis of Int210

The same equivalents and method were used as in the synthesis process of Int134 using 1-bromo-3-chloronaphthalene instead of 2-bromo-4-chlorodibenzo[b,d]furan, and after the reaction was finished, the result was extracted and then recrystallized to obtain Int210 (43 g, yield 72%). MS[M+H]+=483

### 2) Synthesis of Int211

The same equivalents and method were used as in the synthesis process of Intl35 using Int210 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3, 6-di-tert-butyl-1-(4,4,5,5-tetramethyl-1,3,2-dioxaborolan-2-yl)-9H-carbazole, and after the reaction was finished, the result was extracted and then recrystallized to obtain Int211 (36.6 g, yield 73%). MS[M+H]+=808

### 3) Synthesis of Compound M105

Under the nitrogen atmosphere, Int211 (25 g) and boron triiodide (20.6 g) were introduced to 1,2-dichlorobenzene (250 ml), and stirred for 4 hours at 160°C. After the reaction was finished, the result was extracted, and then recrystallized to obtain Compound M105 (7.2 g, yield 29%). MS[M+H]+=816

### Synthesis Example 106. Synthesis of Compound M106

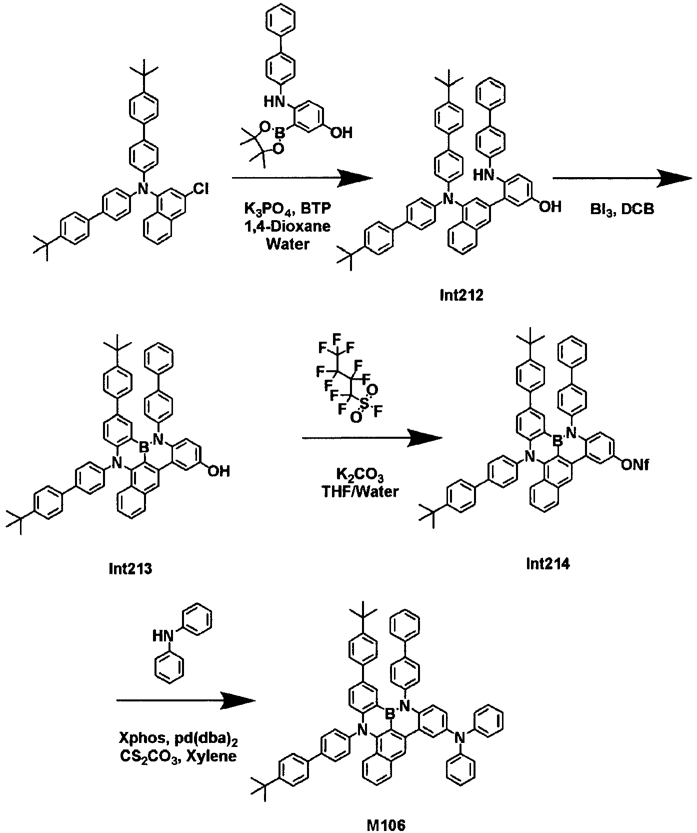

### 1) Synthesis of Int212

The same equivalents and method were used as in the synthesis process of Int135 using N,N-bis(4'-(tert-butyl)-[1,1'-biphenyl]-4-yl)-3-chloronaphthalen-1-amine and 4-([1,1'-biphenyl]-4-ylamino)-3-(4,4,5,5-tetramethyl-1,3,2-dioxaborolan-2-yl)phenol instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int212 (31 g, yield 75%). MS[M+H]+=820

### 2) Synthesis of Int213

Under the nitrogen atmosphere, Int212 (25 g) and boron triiodide (20.3 g) were introduced to 1,2-dichlorobenzene (250 ml), and stirred for 4 hours at 160°C. After the reaction was finished, the result was extracted, and then recrystallized to obtain Int213 (7.1 g, yield 28%). MS[M+H]+=828

### 3) Synthesis of Int214

Int213 (7 g), 1,1,2,2,3,3,4,4,4-nonafluorobutane-1-sulfonyl fluoride (2.3 ml) and potassium carbonate (3.5 g) were introduced to tetrahydrofuran (70 ml) and water (30 ml), and stirred for 2 hours under reflux. After the reaction was finished, the result was extracted, and then column purified to obtain Int214 (8.8 g, yield 94%). MS[M+H]+=1110

### 4) Synthesis of Compound M106

Under the nitrogen atmosphere, Int214 (7 g), diphenylamine (2.2 g), pd(dba)₂ (0.15 g), Xphos (0.24 g) and cesium carbonate (8.3 g) were introduced to xylene (100 ml), and stirred for 12 hours under reflux. After the reaction was finished, the result was extracted, and then recrystallized to obtain Compound M106 (4.5 g, yield 73%). MS[M+H]+=979

### Synthesis Example 107. Synthesis of Compound M107

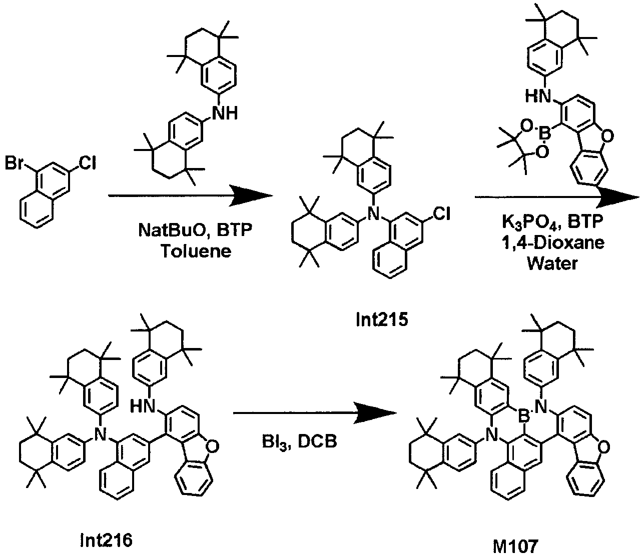

### 1) Synthesis of Int215

The same equivalents and method were used as in the synthesis process of Int134 using 1-bromo-3-chloronaphthalene and bis(5,5,8,8-tetramethyl-5,6,7,8-tetrahydronaphthalen-2-yl)amine instead of 2-bromo-4-chlorodibenzo[b,d]furan and di([1,1'-biphenyl]-4-yl)amine, and after the reaction was finished, the result was extracted and then recrystallized to obtain Int215 (49 g, yield 72%). MS[M+H]+=551

### 2) Synthesis of Int216

The same equivalents and method were used as in the synthesis process of Int135 using Int215 and 1-(4,4,5,5-tetramethyl-1,3,2-dioxaborolan-2-yl)-N-(5,5,8,8-tetramethyl-5,6,7,8-tetrahydronaphthalen-2-yl)dibenzo[b,d]furan-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int216 (35.5 g, yield 74%). MS[M+H]+=884

### 3) Synthesis of Compound M107

Under the nitrogen atmosphere, Int216 (25 g) and boron triiodide (18.8 g) were introduced to 1,2-dichlorobenzene (250 ml), and stirred for 4 hours at 160°C. After the reaction was finished, the result was extracted, and then recrystallized to obtain Compound M107 (7.6 g, yield 30%). MS[M+H]+=892

### Synthesis Example 108. Synthesis of Compound M108

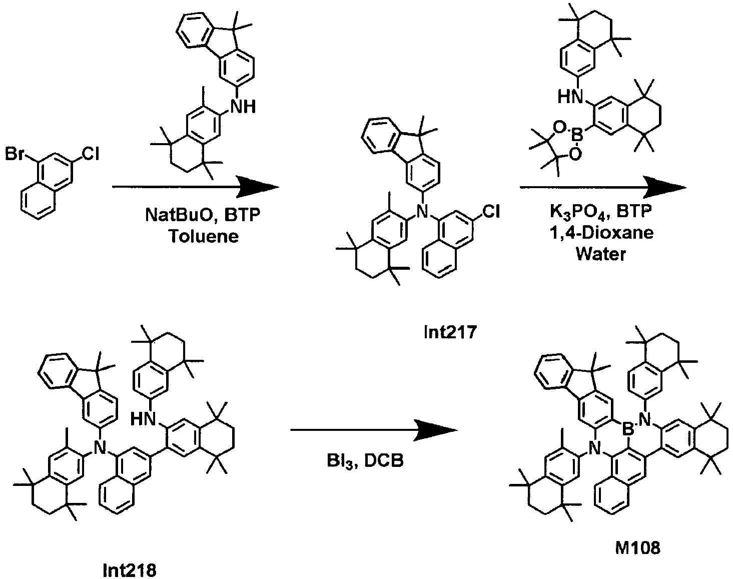

### 1) Synthesis of Int217

The same equivalents and method were used as in the synthesis process of Int134 using 1-bromo-3-chloronaphthalene and 9,9-dimethyl-N-(3,5,5,8,8-pentamethyl-5,6,7,8-tetrahydronaphthalen-2-yl)-9H-fluoren-3-amine instead of 2-bromo-4-chlorodibenzo[b,d]furan and di([1,1'-biphenyl]-4-yl)amine, and after the reaction was finished, the result was extracted and then recrystallized to obtain Int217 (53 g, yield 75%). MS[M+H]+=571

### 2) Synthesis of Int218

The same equivalents and method were used as in the synthesis process of Int135 using Int217 and 5,5,8,8-tetramethyl-3-(4,4,5,5-tetramethyl-1,3,2-dioxaborolan-2-yl)-N-(5,5,8,8-tetramethyl-5,6,7,8-tetrahydronaphthalen-2-yl)-5,6,7,8-tetrahydronaphthalen-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int218 (34.8 g, yield 72%). MS[M+H]+=924

### 3) Synthesis of Compound M108

Under the nitrogen atmosphere, Int218 (25 g) and boron triiodide (18.1 g) were introduced to 1,2-dichlorobenzene (250 ml), and stirred for 4 hours at 160°C. After the reaction was finished, the result was extracted, and then recrystallized to obtain Compound M108 (7.4 g, yield 29%). MS[M+H]+=932

### Synthesis Example 109. Synthesis of Compound M109

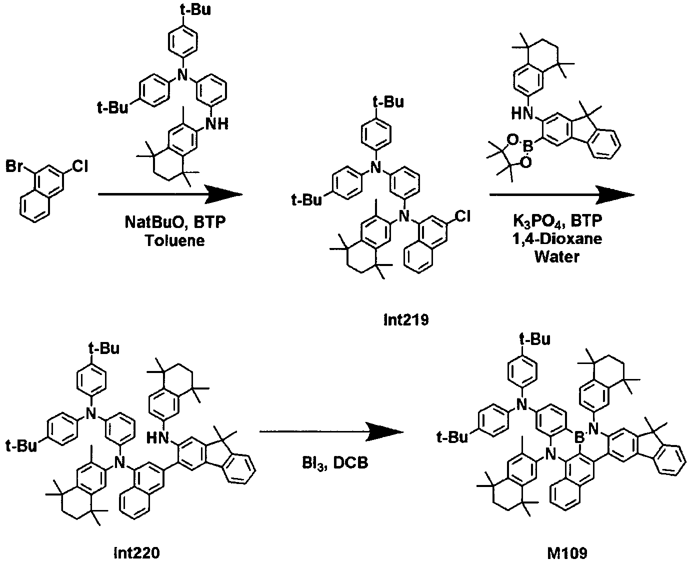

### 1) Synthesis of Int219

The same equivalents and method were used as in the synthesis process of Int134 using 1-bromo-3-chloronaphthalene and N1,N1-bis(4-(tert-butyl)phenyl)-N3-(3,5,5,8,8-pentamethyl-5,6,7,8-tetrahydronaphthalen-2-yl)benzene-1,3-diamine instead of 2-bromo-4-chlorodibenzo[b,d]furan and di([1,1'-biphenyl]-4-yl)amine, and after the reaction was finished, the result was extracted and then recrystallized to obtain Int219 (66 g, yield 72%). MS[M+H]+=734

### 2) Synthesis of Int220

The same equivalents and method were used as in the synthesis process of Int135 using Int219 and 9,9-dimethyl-3-(4,4,5,5-tetramethyl-1,3,2-dioxaborolan-2-yl)-N-(5,5,8,8-tetramethyl-5,6,7,8-tetrahydronaphthalen-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int220 (35.2 g, yield 79%). MS[M+H]+=1093

### 3) Synthesis of Compound M109

Under the nitrogen atmosphere, Int220 (25 g) and boron triiodide (15.3 g) were introduced to 1,2-dichlorobenzene (250 ml), and stirred for 4 hours at 160°C. After the reaction was finished, the result was extracted, and then recrystallized to obtain Compound M109 (7.5 g, yield 30%). MS[M+H]+=1101

### Synthesis Example 110. Synthesis of Compound M110

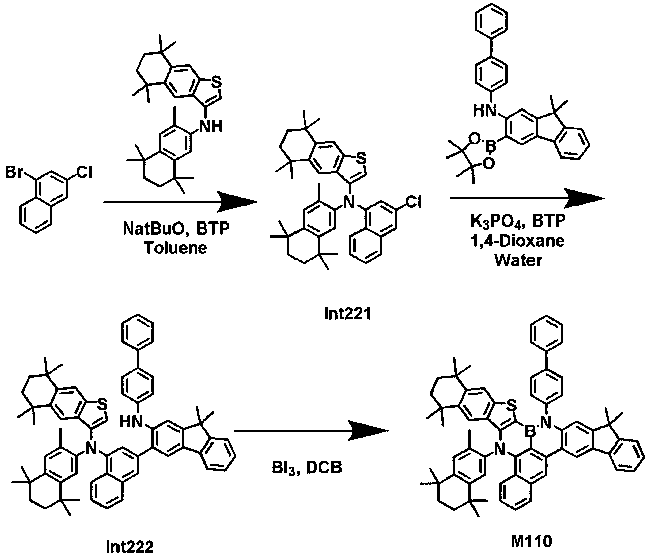

### 1) Synthesis of Int221

The same equivalents and method were used as in the synthesis process of Int134 using 1-bromo-3-chloronaphthalene and 5,5,8,8-tetramethyl-N-(3,5,5,8,8-pentamethyl-5,6,7,8-tetrahydronaphthalen-2-yl)-5,6,7,8-tetrahydronaphtho[2,3-b]thiophen-3-amine instead of 2-bromo-4-chlorodibenzo[b,d]furan and di([1,1'-biphenyl]-4-yl)amine, and after the reaction was finished, the result was extracted and then recrystallized to obtain Int221 (56.6 g, yield 73%). MS[M+H]+=621

### 2) Synthesis of Int222

The same equivalents and method were used as in the synthesis process of Int135 using Int221 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int222 (34.8 g, yield 76%). MS[M+H]+=946

### 3) Synthesis of Compound M110

Under the nitrogen atmosphere, Int222 (25 g) and boron triiodide (17.6 g) were introduced to 1,2-dichlorobenzene (250 ml), and stirred for 4 hours at 160°C. After the reaction was finished, the result was extracted, and then recrystallized to obtain Compound M110 (7.2 g, yield 29%). MS[M+H]+=954

### Synthesis Example 111. Synthesis of Compound M111

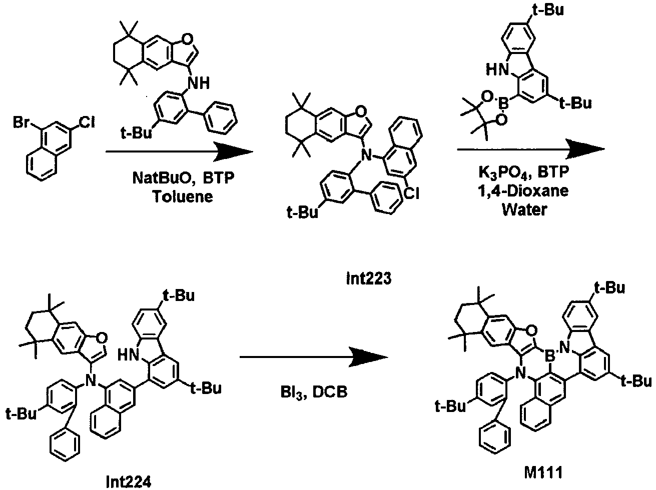

### 1) Synthesis of Int223

The same equivalents and method were used as in the synthesis process of Int134 using 1-bromo-3-chloronaphthalene and N-(5-(tert-butyl)-[1,1'-biphenyl]-2-yl)-5,5,8,8-tetramethyl-5,6,7,8-tetrahydronaphtho[2,3-b]furan-3-amine instead of 2-bromo-4-chlorodibenzo[b,d]furan and di([1,1'-biphenyl]-4-yl)amine, and after the reaction was finished, the result was extracted and then recrystallized to obtain Int223 (54.5 g, yield 72%). MS[M+H]+=613

### 2) Synthesis of Int224

The same equivalents and method were used as in the synthesis process of Int135 using Int223 instead of Int134, and after the reaction was finished, the result was extracted and then recrystallized to obtain Int224 (31.1 g, yield 74%). MS[M+H]+=856

### 3) Synthesis of Compound M111

Under the nitrogen atmosphere, Int224 (25 g) and boron triiodide (19.5 g) were introduced to 1,2-dichlorobenzene (250 ml), and stirred for 4 hours at 160°C. After the reaction was finished, the result was extracted, and then recrystallized to obtain Compound M111 (7.1 g, yield 28%). MS[M+H]+=864

### Synthesis Example 112. Synthesis of Compound M112

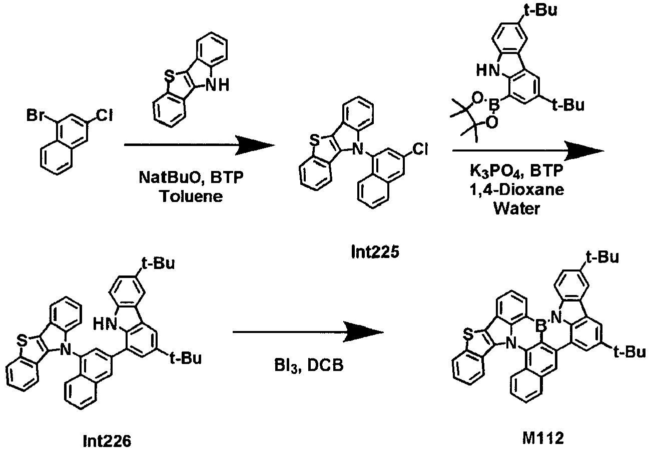

### 1) Synthesis of Int225

The same equivalents and method were used as in the synthesis process of Int134 using 1-bromo-3-chloronaphthalene and 10H-benzo [4, 5] thieno [3, 2-b] indole instead of 2-bromo-4-chlorodibenzo[b,d]furan and di([1,1'-biphenyl]-4-yl)amine, and after the reaction was finished, the result was extracted and then recrystallized to obtain Int225 (35 g, yield 73%). MS[M+H]+=385

### 2) Synthesis of Int226

The same equivalents and method were used as in the synthesis process of Int135 using Int225 instead of Int134, and after the reaction was finished, the result was extracted and then recrystallized to obtain Int226 (36.5 g, yield 75%). MS[M+H]+=628

### 3) Synthesis of Compound M112

Under the nitrogen atmosphere, Int226 (25 g) and boron triiodide (26.5 g) were introduced to 1,2-dichlorobenzene (250 ml), and stirred for 4 hours at 160°C. After the reaction was finished, the result was extracted, and then recrystallized to obtain Compound M112 (7.2 g, yield 28%). MS[M+H]+=636

### Synthesis Example 113. Synthesis of Compound M113

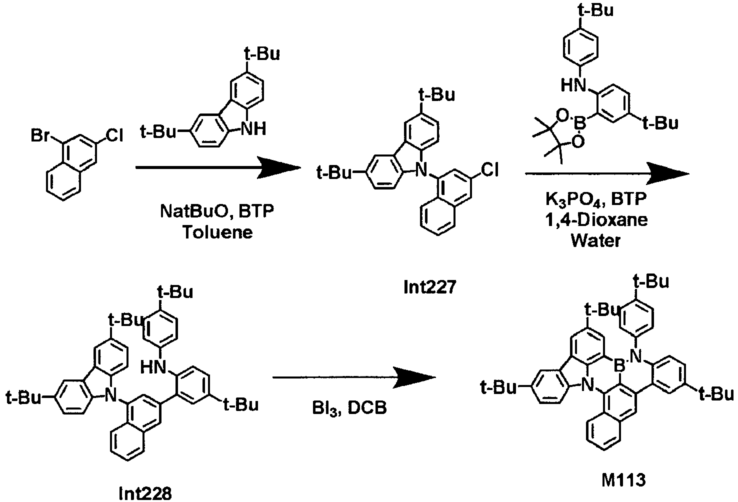

### 1) Synthesis of Int227

The same equivalents and method were used as in the synthesis process of Int134 using 1-bromo-3-chloronaphthalene and 3,6-di-tert-butyl-9H-carbazole instead of 2-bromo-4-chlorodibenzo[b,d]furan and di([1,1'-biphenyl]-4-yl)amine, and after the reaction was finished, the result was extracted and then recrystallized to obtain Int227 (39 g, yield 71%). MS[M+H]+=441

### 2) Synthesis of Int228

The same equivalents and method were used as in the synthesis process of Int135 using Int227 and 4-(tert-butyl)-N-(4-(tert-butyl)phenyl)-2-(4,4,5,5-tetramethyl-1,3,2-dioxaborolan-2-yl)aniline instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int228 (34.5 g, yield 74%). MS[M+H]+=686

### 3) Synthesis of Compound M113

Under the nitrogen atmosphere, Int228 (25 g) and boron triiodide (26.5 g) were introduced to 1,2-dichlorobenzene (250 ml), and stirred for 4 hours at 160°C. After the reaction was finished, the result was extracted, and then recrystallized to obtain Compound M113 (7.4 g, yield 29%). MS[M+H]+=694

### Synthesis Example 114. Synthesis of Compound M114

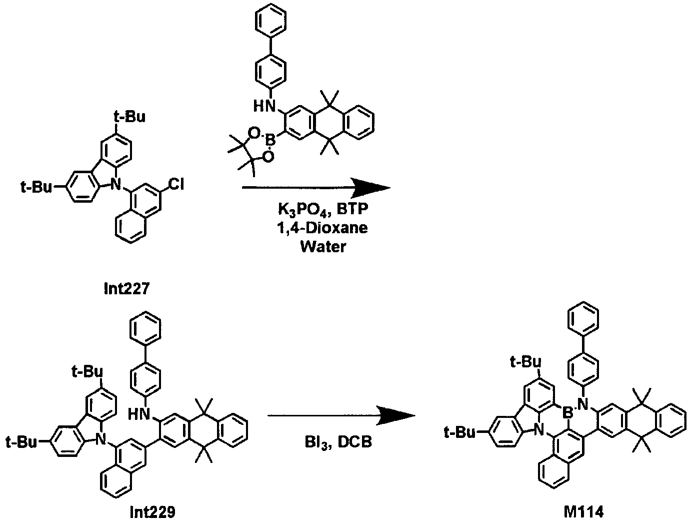

### 1) Synthesis of Int229

The same equivalents and method were used as in the synthesis process of Int135 using Int227 and N-([1,1'-biphenyl]-4-yl)-9,9,10,10-tetramethyl-3-(4,4,5,5-tetramethyl-1,3,2-dioxaborolan-2-yl)-9,10-dihydroanthracen-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int229 (42.1 g, yield 77%). MS[M+H]+=808

### 2) Synthesis of Compound M114

Under the nitrogen atmosphere, Int229 (25 g) and boron triiodide (20.7 g) were introduced to 1,2-dichlorobenzene (250 ml), and stirred for 4 hours at 160°C. After the reaction was finished, the result was extracted, and then recrystallized to obtain Compound M114 (7.5 g, yield 30%). MS[M+H]+=816

### Synthesis Example 115. Synthesis of Compound M115

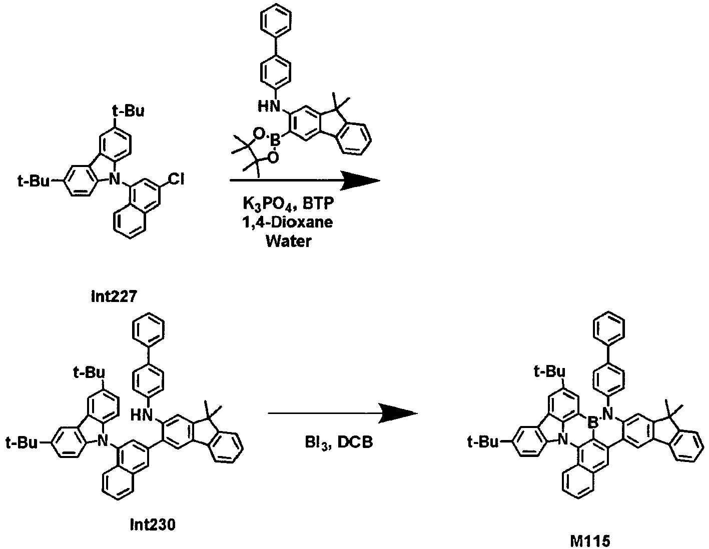

### 1) Synthesis of Int230

The same equivalents and method were used as in the synthesis process of Int135 using Int227 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int230 (38.7 g, yield 74%). MS[M+H]+=766

### 2) Synthesis of Compound M115

Under the nitrogen atmosphere, Int230 (25 g) and boron triiodide (21.7 g) were introduced to 1,2-dichlorobenzene (250 ml), and stirred for 4 hours at 160°C. After the reaction was finished, the result was extracted, and then recrystallized to obtain Compound M115 (7.4 g, yield 29%). MS[M+H]+=774

### Synthesis Example 117. Synthesis of Compound M117

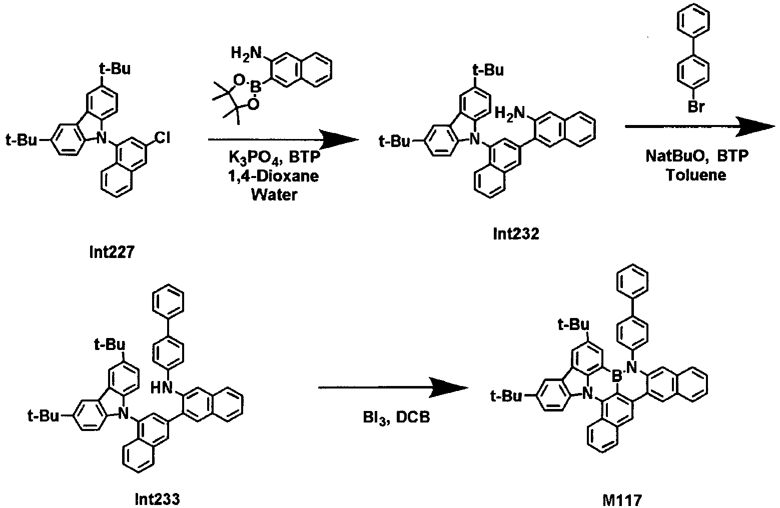

### 1) Synthesis of Int232

The same equivalents and method were used as in the synthesis process of Int135 using Int227 and 3-(4,4,5,5-tetramethyl-1,3,2-dioxaborolan-2-yl)naphthalen-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int232 (27.8 g, yield 75%). MS[M+H]+=548

### 2) Synthesis of Int233

The same equivalents and method were used as in the synthesis process of Int134 using Int232 (27 g) and 4-bromo-1,1'-biphenyl (11.5 g) instead of 2-bromo-4-chlorodibenzo[b,d]furan and di([1,1'-biphenyl]-4-yl)amine, and after the reaction was finished, the result was extracted and then recrystallized to obtain Int233 (26.4 g, yield 76%). MS[M+H]+=700

### 3) Synthesis of Compound M117

Under the nitrogen atmosphere, Int233 (25 g) and boron triiodide (23.8 g) were introduced to 1,2-dichlorobenzene (250 ml), and stirred for 4 hours at 160°C. After the reaction was finished, the result was extracted, and then recrystallized to obtain Compound M117 (7.4 g, yield 29%). MS[M+H]+=708

### Synthesis Example 118. Synthesis of Compound M118

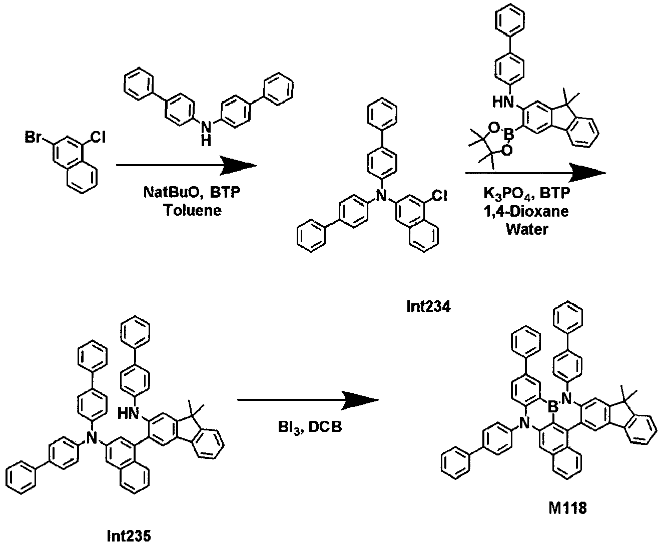

### 1) Synthesis of Int234

The same equivalents and method were used as in the synthesis process of Int134 using 1-bromo-3-chloronaphthalene instead of 2-bromo-4-chlorodibenzo[b,d]furan, and after the reaction was finished, the result was extracted and then recrystallized to obtain Int234 (43 g, yield 72%). MS[M+H]+=483

### 2) Synthesis of Int235

The same equivalents and method were used as in the synthesis process of Int135 using Int234 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int235 (38 g, yield 76%). MS[M+H]+=808

### 3) Synthesis of Compound M118

Under the nitrogen atmosphere, Int235 (25 g) and boron triiodide (20.6 g) were introduced to 1,2-dichlorobenzene (250 ml), and stirred for 4 hours at 160°C. After the reaction was finished, the result was extracted, and then recrystallized to obtain Compound M118 (7.5 g, yield 30%). MS[M+H]+=816

### Synthesis Example 119. Synthesis of Compound M119

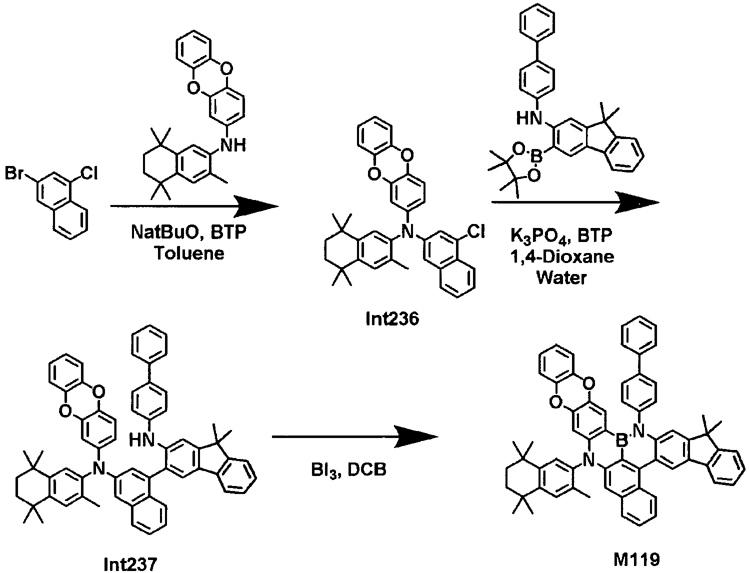

### 1) Synthesis of Int236

The same equivalents and method were used as in the synthesis process of Int134 using 1-bromo-3-chloronaphthalene and N-(3,5,5,8,8-pentamethyl-5,6,7,8-tetrahydronaphthalen-2-yl)dibenzo[b,e] [1,4]dioxin-2-amine instead of 2-bromo-4-chlorodibenzo[b,d]furan and di([1,1'-biphenyl]-4-yl)amine, and after the reaction was finished, the result was extracted and then recrystallized to obtain Int236 (49.3 g, yield 71%). MS[M+H]+=561

### 2) Synthesis of Int237

The same equivalents and method were used as in the synthesis process of Int135 using Int236 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int237 (36.6 g, yield 77%). MS[M+H]+=886

### 3) Synthesis of Compound M119

Under the nitrogen atmosphere, Int237 (25 g) and boron triiodide (18.8 g) were introduced to 1,2-dichlorobenzene (250 ml), and stirred for 4 hours at 160°C. After the reaction was finished, the result was extracted, and then recrystallized to obtain Compound M119 (7.4 g, yield 29%). MS[M+H]+=894

### Synthesis Example 120. Synthesis of Compound M120

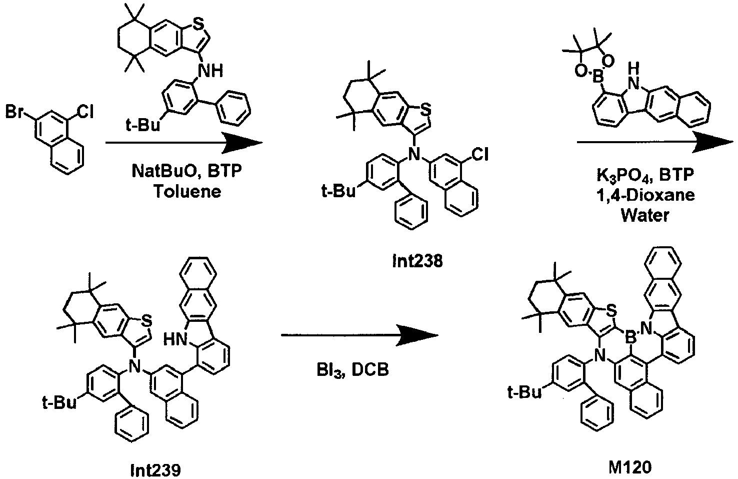

### 1) Synthesis of Int238

The same equivalents and method were used as in the synthesis process of Int134 using 1-bromo-3-chloronaphthalene and N-(5-(tert-butyl)-[1,1'-biphenyl]-2-yl)-5,5,8,8-tetramethyl-5,6,7,8-tetrahydronaphtho[2,3-b]thiophen-3-amine instead of 2-bromo-4-chlorodibenzo[b,d]furan and di([1,1'-biphenyl]-4-yl)amine, and after the reaction was finished, the result was extracted and then recrystallized to obtain Int238 (56.6 g, yield 73%). MS[M+H]+=629

### 2) Synthesis of Int239

The same equivalents and method were used as in the synthesis process of Int135 using Int238 and 4-(4,4,5,5-tetramethyl-1,3,2-dioxaborolan-2-yl)-5H-benzo[b]carbazole instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int239 (28.3 g, yield 73%). MS[M+H]+=810

### 3) Synthesis of Compound M120

Under the nitrogen atmosphere, Int239 (25 g) and boron triiodide (20.6 g) were introduced to 1,2-dichlorobenzene (250 ml), and stirred for 4 hours at 160°C. After the reaction was finished, the result was extracted, and then recrystallized to obtain Compound M120 (7.5 g, yield 30%). MS[M+H]+=818

### Synthesis Example 121. Synthesis of Compound M121

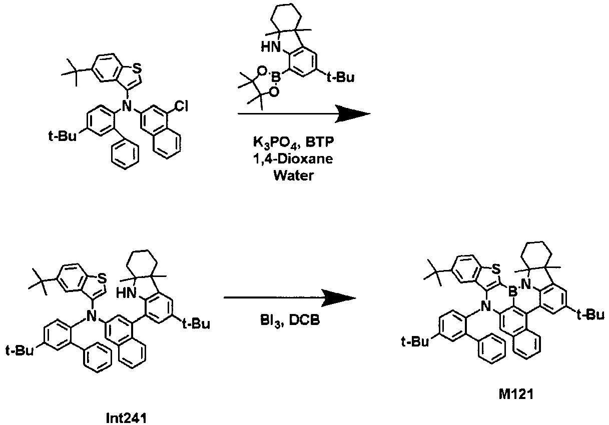

### 1) Synthesis of Int241

The same equivalents and method were used as in the synthesis process of Int135 using 5-(tert-butyl)-N-(5-(tert-butyl)-[1,1'-biphenyl]-2-yl)-N-(4-chloronaphthalen-2-yl)benzo[b]thiophen-3-amine and 6-(tert-butyl)-4a,9a-dimethyl-8-(4,4,5,5-tetramethyl-1,3,2-dioxaborolan-2-yl)-2,3,4,4a,9,9a-hexahydro-1H-carbazole instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int241 (30.2 g, yield 73%). MS[M+H]+=796

### 2) Synthesis of Compound M121

Under the nitrogen atmosphere, Int241 (25 g) and boron triiodide (20.9 g) were introduced to 1,2-dichlorobenzene (250 ml), and stirred for 4 hours at 160°C. After the reaction was finished, the result was extracted, and then recrystallized to obtain Compound M121 (7.3 g, yield 29%). MS[M+H]+=804

### Synthesis Example 122. Synthesis of Compound M122

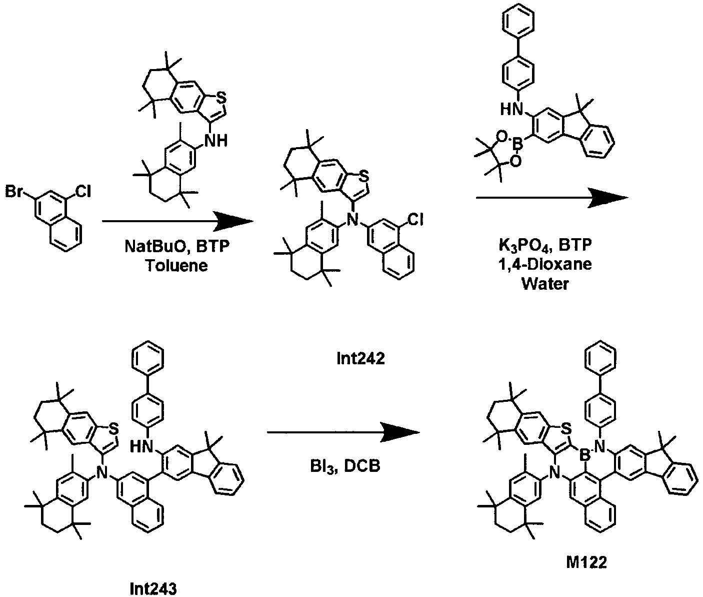

### 1) Synthesis of Int242

The same equivalents and method were used as in the synthesis process of Int134 using 1-bromo-3-chloronaphthalene and 5,5,8,8-tetramethyl-N-(3,5,5,8,8-pentamethyl-5,6,7,8-tetrahydronaphthalen-2-yl)-5,6,7,8-tetrahydronaphtho[2,3-b]thiophen-3-amine instead of 2-bromo-4-chlorodibenzo[b,d]furan and di([1,1'-biphenyl]-4-yl)amine, and after the reaction was finished, the result was extracted and then recrystallized to obtain Int242 (55.5 g, yield 72%). MS[M+H]+=621

### 2) Synthesis of Int243

The same equivalents and method were used as in the synthesis process of Int135 using Int242 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int243 (32.4 g, yield 71%). MS[M+H]+=946

### 3) Synthesis of Compound M122

Under the nitrogen atmosphere, Int243 (25 g) and boron triiodide (17.6 g) were introduced to 1,2-dichlorobenzene (250 ml), and stirred for 4 hours at 160°C. After the reaction was finished, the result was extracted, and then recrystallized to obtain Compound M122 (7.3 g, yield 29%). MS[M+H]+=954

### Synthesis Example 123. Synthesis of Compound M123

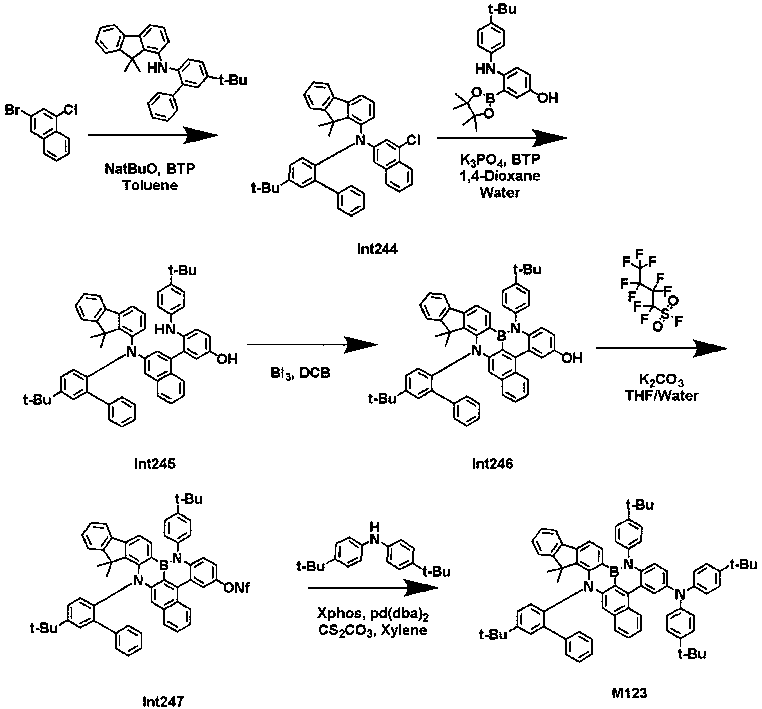

### 1) Synthesis of Int244

The same equivalents and method were used as in the synthesis process of Int134 using 1-bromo-3-chloronaphthalene and N-(5-(tert-butyl)-[1,1'-biphenyl]-2-yl)-9,9-dimethyl-9H-fluoren-1-amine instead of 2-bromo-4-chlorodibenzo[b,d]furan and di([1,1'-biphenyl]-4-yl)amine, and after the reaction was finished, the result was extracted and then recrystallized to obtain Int244 (54.5 g, yield 76%). MS[M+H]+=579

### 2) Synthesis of Int245

The same equivalents and method were used as in the synthesis process of Int135 using Int244 and 4-((4-(tert-butyl)phenyl)amino)-3-(4,4,5,5-tetramethyl-1,3,2-dioxaborolan-2-yl)phenol instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int245 (31 g, yield 76%). MS[M+H]+=784

### 3) Synthesis of Int246

Under the nitrogen atmosphere, Int245 (25 g) and boron triiodide (21.2 g) were introduced to 1,2-dichlorobenzene (250 ml), and stirred for 4 hours at 160°C. After the reaction was finished, the result was extracted, and then recrystallized to obtain Int246 (7.2 g, yield 29%). MS[M+H]+=792

### 4) Synthesis of Int247

Int246 (7 g), 1,1,2,2,3,3,4,4,4-nonafluorobutane-1-sulfonyl fluoride (2.4 ml) and potassium carbonate (3.7 g) were introduced to tetrahydrofuran (70 ml) and water (30 ml), and stirred for 2 hours under reflux. After the reaction was finished, the result was extracted, and then column purified to obtain Int247 (8.8 g, yield 93%). MS[M+H]+=1074

### 5) Synthesis of Compound M123

Under the nitrogen atmosphere, Int247 (7 g), bis(4-(tert-butyl) phenyl) amine (1.1 g), pd(dba)₂ (0.11 g), Xphos (0.19 g) and cesium carbonate (6.4 g) were introduced to xylene (100 ml), and stirred for 12 hours under reflux. After the reaction was finished, the result was extracted, and then recrystallized to obtain Compound M123 (4.9 g, yield 71%). MS[M+H]+=1055

### Synthesis Example 124. Synthesis of Compound M124

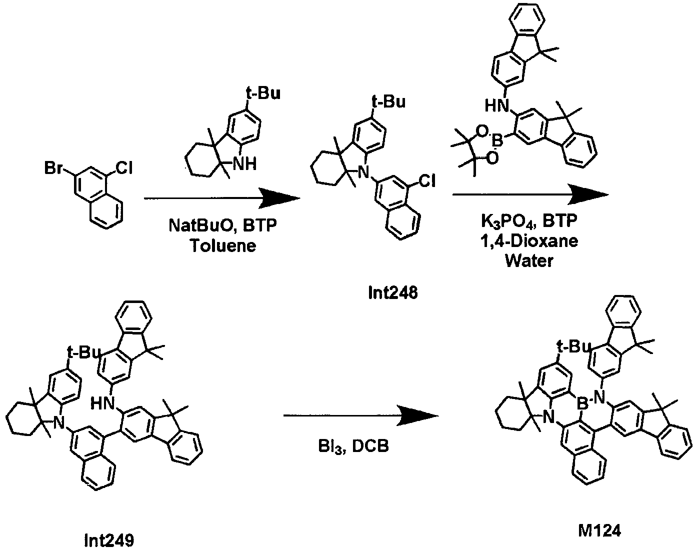

### 1) Synthesis of Int248

The same equivalents and method were used as in the synthesis process of Int134 using 3-bromo-1-chloronaphthalene and 6-(tert-butyl)-4a,9a-dimethyl-2,3,4,4a,9,9a-hexahydro-1H-carbazole instead of 2-bromo-4-chlorodibenzo[b,d]furan and di([1,1'-biphenyl]-4-yl)amine, and after the reaction was finished, the result was extracted and then recrystallized to obtain Int248 (38.7 g, yield 75%). MS[M+H]+=419

### 2) Synthesis of Int249

The same equivalents and method were used as in the synthesis process of Int135 using Int248 and N-(9,9-dimethyl-9H-fluoren-2-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int249 (43.2 g, yield 77%). MS[M+H]+=784

### 3) Synthesis of Compound M124

Under the nitrogen atmosphere, Int249 (25 g) and boron triiodide (21.3 g) were introduced to 1,2-dichlorobenzene (250 ml), and stirred for 4 hours at 160°C. After the reaction was finished, the result was extracted, and then recrystallized to obtain Compound M124 (7.3 g, yield 29%). MS[M+H]+=792

### Synthesis Example 125. Synthesis of Compound M125

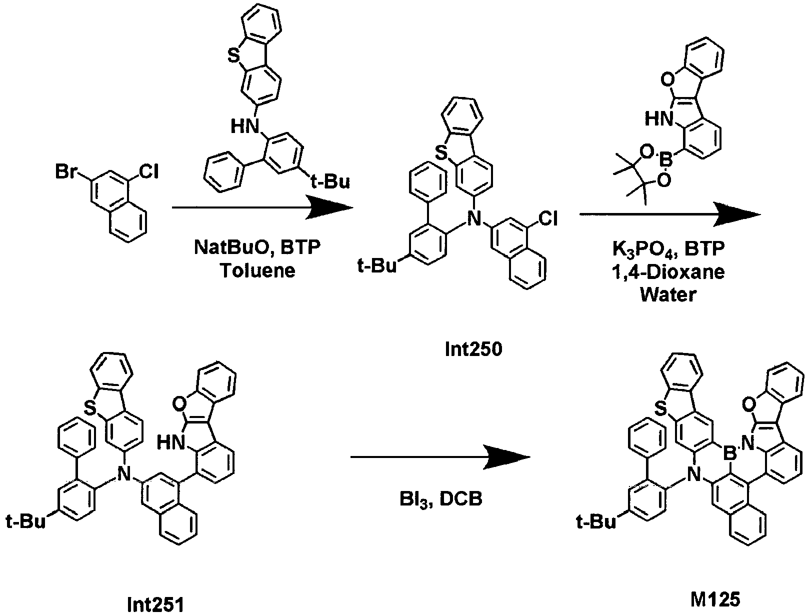

### 1) Synthesis of Int250

The same equivalents and method were used as in the synthesis process of Int134 using 3-bromo-1-chloronaphthalene and N-(5-(tert-butyl)-[1,1'-biphenyl]-2-yl)dibenzo[b,d]thiophen-3-amine instead of 2-bromo-4-chlorodibenzo[b,d]furan and di([1,1'-biphenyl]-4-yl)amine, and after the reaction was finished, the result was extracted and then recrystallized to obtain Int250 (51.4 g, yield 73%). MS[M+H]+=569

### 2) Synthesis of Int251

The same equivalents and method were used as in the synthesis process of Int135 using Int250 and 7-(4,4,5,5-tetramethyl-1,3,2-dioxaborolan-2-yl)-6H-benzofuro[2,3-b]indole instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int251 (29.8 g, yield 76%). MS[M+H]+=740

### 3) Synthesis of Compound M125

Under the nitrogen atmosphere, Int251 (25 g) and boron triiodide (22.5 g) were introduced to 1,2-dichlorobenzene (250 ml), and stirred for 4 hours at 160°C. After the reaction was finished, the result was extracted, and then recrystallized to obtain Compound M125 (7.1 g, yield 28%). MS[M+H]+=748

### Synthesis Example 126. Synthesis of Compound M126

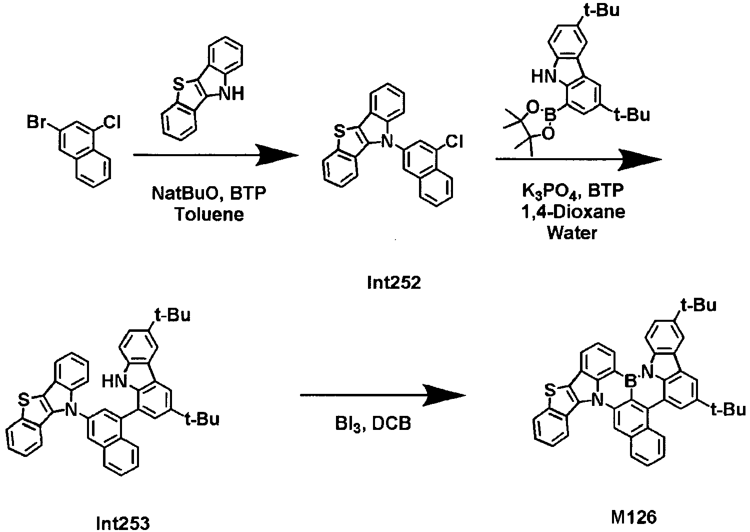

### 1) Synthesis of Int252

The same equivalents and method were used as in the synthesis process of Int134 using 3-bromo-1-chloronaphthalene and 10H-benzo[4,5]thieno[3,2-b]indole instead of 2-bromo-4-chlorodibenzo[b,d]furan and di([1,1'-biphenyl]-4-yl)amine, and after the reaction was finished, the result was extracted and then recrystallized to obtain Int252 (36 g, yield 76%). MS[M+H]+=384

### 2) Synthesis of Int253

The same equivalents and method were used as in the synthesis process of Int135 using Int252 instead of Int134, and after the reaction was finished, the result was extracted and then recrystallized to obtain Int253 (36.7 g, yield 75%). MS[M+H]+=628

### 3) Synthesis of Compound M126

Under the nitrogen atmosphere, Int253 (25 g) and boron triiodide (26.5 g) were introduced to 1,2-dichlorobenzene (250 ml), and stirred for 4 hours at 160°C. After the reaction was finished, the result was extracted, and then recrystallized to obtain Compound M126 (7.4 g, yield 29%). MS[M+H]+=636

### Synthesis Example 127. Synthesis of Compound M127

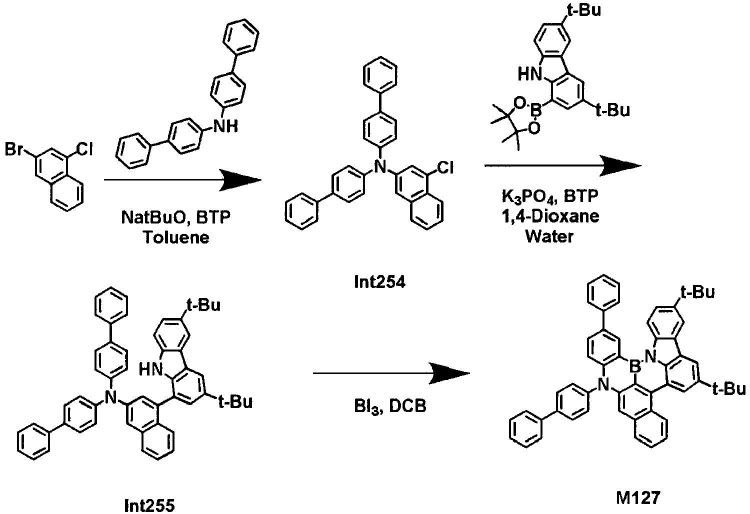

### 1) Synthesis of Int254

The same equivalents and method were used as in the synthesis process of Int134 using 3-bromo-1-chloronaphthalene instead of 2-bromo-4-chlorodibenzo[b,d]furan, and after the reaction was finished, the result was extracted and then recrystallized to obtain Int254 (43.1 g, yield 72%). MS[M+H]+=483

### 2) Synthesis of Int255

The same equivalents and method were used as in the synthesis process of Int135 using Int254 instead of Int134, and after the reaction was finished, the result was extracted and then recrystallized to obtain Int255 (35.5 g, yield 79%). MS[M+H]+=726

### 3) Synthesis of Compound M127

Under the nitrogen atmosphere, Int255 (25 g) and boron triiodide (22.4 g) were introduced to 1,2-dichlorobenzene (250 ml), and stirred for 4 hours at 160°C. After the reaction was finished, the result was extracted, and then recrystallized to obtain Compound M127 (7.2 g, yield 29%). MS[M+H]+=734

### Synthesis Example 128. Synthesis of Compound M128

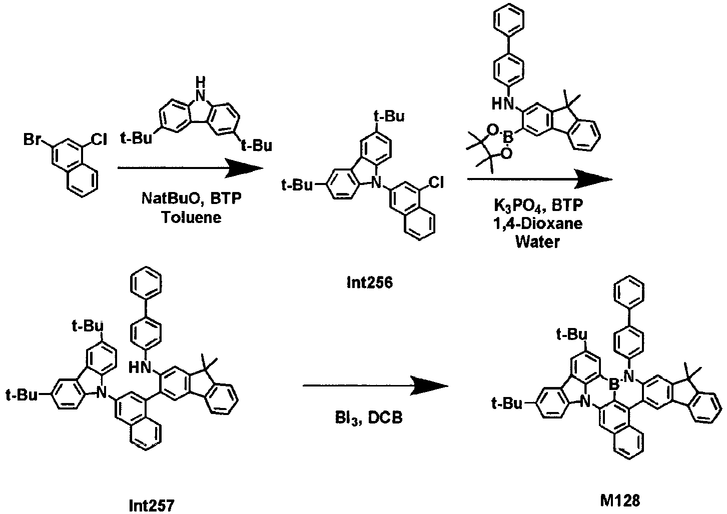

### 1) Synthesis of Int256

The same equivalents and method were used as in the synthesis process of Int134 using 3-bromo-1-chloronaphthalene and 3,6-di-tert-butyl-9H-carbazole instead of 2-bromo-4-chlorodibenzo[b,d]furan and di([1,1'-biphenyl]-4-yl)amine, and after the reaction was finished, the result was extracted and then recrystallized to obtain Int256 (42.8 g, yield 78%). MS[M+H]+=441

### 2) Synthesis of Int257

The same equivalents and method were used as in the synthesis process of Int135 using Int256 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int257 (38.8 g, yield 74%). MS[M+H]+=766

### 3) Synthesis of Compound M128

Under the nitrogen atmosphere, Int257 (25 g) and boron triiodide (21.7 g) were introduced to 1,2-dichlorobenzene (250 ml), and stirred for 4 hours at 160°C. After the reaction was finished, the result was extracted, and then recrystallized to obtain Compound M128 (7.4 g, yield 29%). MS[M+H]+=774

### Synthesis Example 130. Synthesis of Compound M130

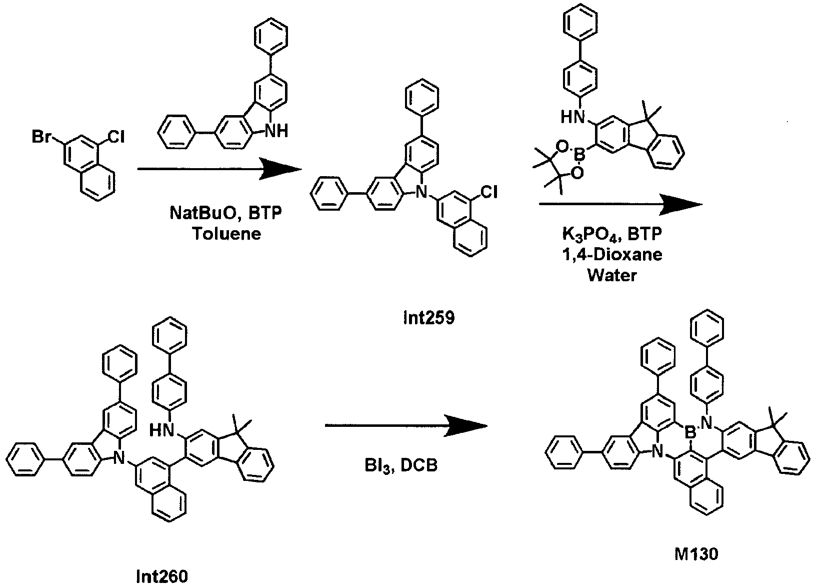

### 1) Synthesis of Int259

The same equivalents and method were used as in the synthesis process of Int134 using 3-bromo-1-chloronaphthalene and 3,6-diphenyl-9H-carbazole instead of 2-bromo-4-chlorodibenzo[b,d]furan and di([1,1'-biphenyl]-4-yl)amine, and after the reaction was finished, the result was extracted and then recrystallized to obtain Int259 (43.1 g, yield 72%). MS[M+H]+=481

### 2) Synthesis of Int260

The same equivalents and method were used as in the synthesis process of Int135 using Int259 and N-([1,1'-biphenyl]-4-yl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int260 (38.2 g, yield 76%). MS[M+H]+=806

### 3) Synthesis of Compound M130

Under the nitrogen atmosphere, Int260 (25 g) and boron triiodide (20.7 g) were introduced to 1,2-dichlorobenzene (250 ml), and stirred for 4 hours at 160°C. After the reaction was finished, the result was extracted, and then recrystallized to obtain Compound M130 (7.2 g, yield 29%). MS[M+H]+=814

### Synthesis Example 131. Synthesis of Compound M131

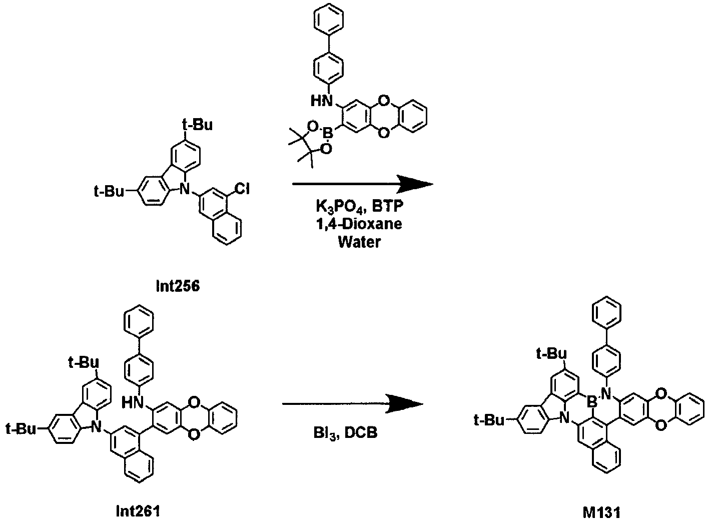

### 1) Synthesis of Int261

The same equivalents and method were used as in the synthesis process of Int135 using Int256 and N-([1,1'-biphenyl]-4-yl)-3-(4,4,5,5-tetramethyl-1,3,2-dioxaborolan-2-yl)dibenzo[b,e][1,4]dioxin-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int261 (35.6 g, yield 75%). MS[M+H]+=756

### 2) Synthesis of Compound M131

Under the nitrogen atmosphere, Int261 (25 g) and boron triiodide (22.1 g) were introduced to 1,2-dichlorobenzene (250 ml), and stirred for 4 hours at 160°C. After the reaction was finished, the result was extracted, and then recrystallized to obtain Compound M131 (7.3 g, yield 29%). MS[M+H]+=764

### Synthesis Example 133. Synthesis of Compound M133

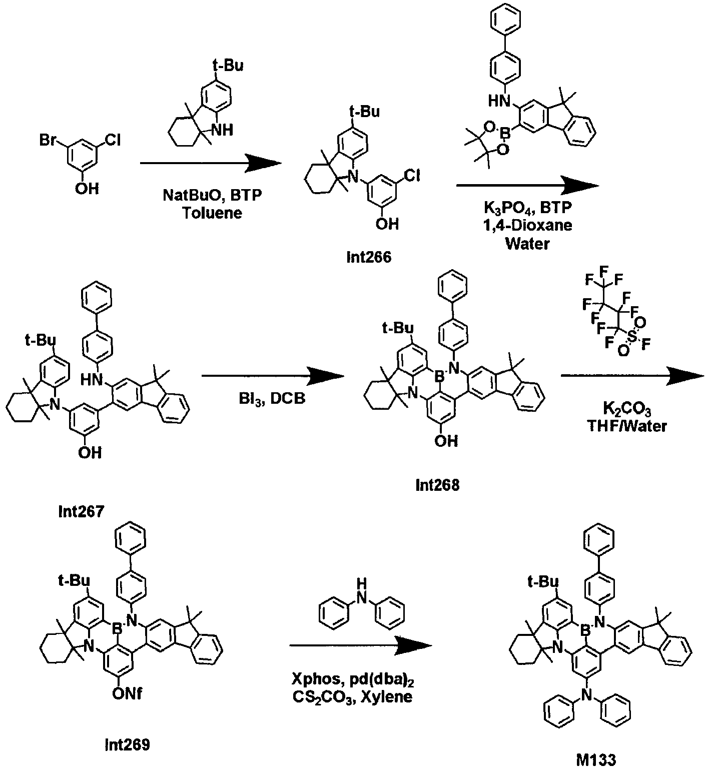

### 1) Synthesis of Int266

3-Bromo-5-chlorophenol (30 g), 6-(tert-butyl)-4a,9a-dimethyl-2,3,4,4a,9,9a-hexahydro-1H-carbazole (37.2 g), sodiumtert-butoxide (42 g) and bis(tri-tert-butylphosphine)palladium(0) (1.5 g) were introduced to toluene (600 ml), and refluxed for 1 hour. After the reaction was finished, the result was extracted and then recrystallized to obtain Int266 (41.1 g, yield 74%). MS[M+H]+=385

### 2) Synthesis of Int267

Int266 (30 g), N-([1,1'-biphenyl]-4-yl)-9,9-dimethyl-3-(4,4,5,5-tetramethyl-1,3,2-dioxaborolan-2-yl)-9H-fluoren-2-amine (31.7 g), tripotassium phosphate (49.8 g) and bis(tri-tert-butylphosphine)palladium(0) (0.8 g) were introduced to 1,4-dioxane (300 ml) and water (100 ml), and refluxed for 2 hours. After the reaction was finished, the result was extracted and then recrystallized to obtain Int267 (39.2 g, yield 71%). MS[M+H]+=710

### 3) Synthesis of Int268

Under the nitrogen atmosphere, Int267 (25 g) and boron triiodide (22 g) were introduced to 1,2-dichlorobenzene (250 ml), and stirred for 4 hours at 160°C. After the reaction was finished, the result was extracted, and then recrystallized to obtain Int268 (7.2 g, yield 30%). MS[M+H]+=718

### 4) Synthesis of Int269

Int268 (7 g), 1,1,2,2,3,3,4,4,4-nonafluorobutane-1-sulfonyl fluoride (2.6 ml) and potassium carbonate (4.1 g) were introduced to tetrahydrofuran (70 ml) and water (30 ml), and stirred for 2 hours under reflux. After the reaction was finished, the result was extracted, and then column purified to obtain Int269 (9.1 g, yield 93%). MS[M+H]+=1000

### 5) Synthesis of Compound M133

Under the nitrogen atmosphere, Int269 (7 g), diphenylamine (1.2 g), pd(dba)₂ (0.12 g), Xphos (0.20 g) and cesium carbonate (6.9 g) were introduced to xylene (100 ml), and stirred for 12 hours under reflux. After the reaction was finished, the result was extracted, and then recrystallized to obtain Compound M133 (4.7 g, yield 77%). MS[M+H]+=869

### Synthesis Example 134. Synthesis of Compound M134

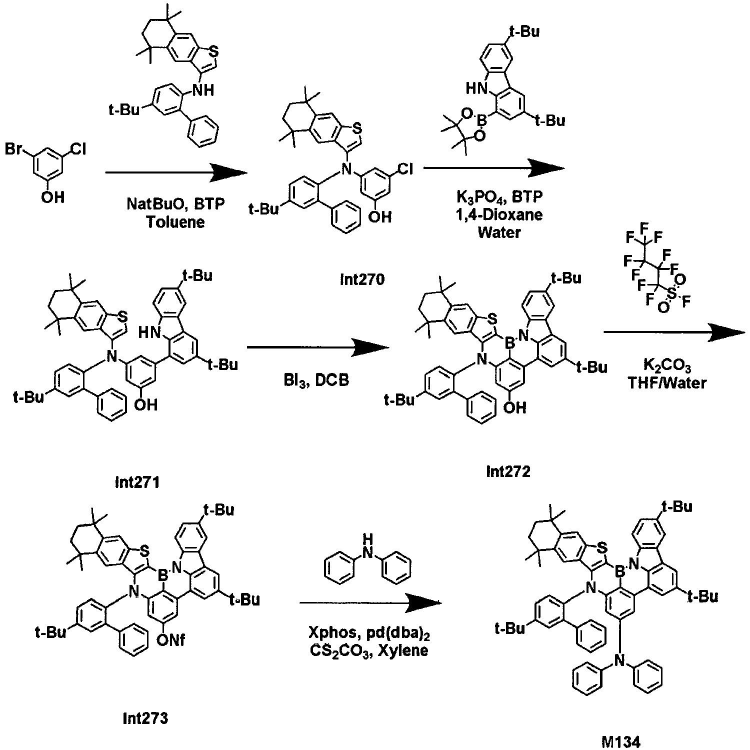

### 1) Synthesis of Int270

The same equivalents and method were used as in the synthesis process of Int266 using N-(5-(tert-butyl)-[1,1'-biphenyl]-2-yl)-5,5,8,8-tetramethyl-5,6,7,8-tetrahydronaphtho[2,3-b]thiophen-3-amine instead of 6-(tert-butyl)-4a,9a-dimethyl-2,3,4,4a,9,9a-hexahydro-1H-carbazole, and the result was recrystallized to obtain Int270 (62 g, yield 72%). MS[M+H]+=595

### 2) Synthesis of Int271

The same equivalents and method were used as in the synthesis process of Int267 using Int270 and 3,6-di-tert-butyl-1-(4,4,5,5-tetramethyl-1,3,2-dioxaborolan-2-yl)-9H-carbazole instead of Int266 and N-([1,1'-biphenyl]-4-yl)-9,9-dimethyl-3-(4,4,5,5-tetramethyl-1,3,2-dioxaborolan-2-yl)-9H-fluoren-2-amine, and the result was recrystallized to obtain Int271 (33.2 g, yield 79%). MS[M+H]+=838

### 3) Synthesis of Int272

Under the nitrogen atmosphere, Int271 (25 g) and boron triiodide (19.9 g) were introduced to 1,2-dichlorobenzene (250 ml), and stirred for 4 hours at 160°C. After the reaction was finished, the result was extracted, and then recrystallized to obtain Int272 (7.1 g, yield 28%). MS[M+H]+=846

### 4) Synthesis of Int273

Int272 (7 g), 1,1,2,2,3,3,4,4,4-nonafluorobutane-1-sulfonyl fluoride (2.3 ml) and potassium carbonate (3.4 g) were introduced to tetrahydrofuran (70 ml) and water (30 ml), and stirred for 2 hours under reflux. After the reaction was finished, the result was extracted, and then column purified to obtain Int273 (8.6 g, yield 92%). MS[M+H]+=1128

### 5) Synthesis of Compound M134

Under the nitrogen atmosphere, Int273 (7 g), diphenylamine (1.1 g), pd(dba)₂ (0.11 g), Xphos (0.18 g) and cesium carbonate (6.1 g) were introduced to xylene (100 ml), and stirred for 12 hours under reflux. After the reaction was finished, the result was extracted, and then recrystallized to obtain Compound M134 (4.8 g, yield 78%). MS[M+H]+=997

### Synthesis Example 135. Synthesis of Compound M135

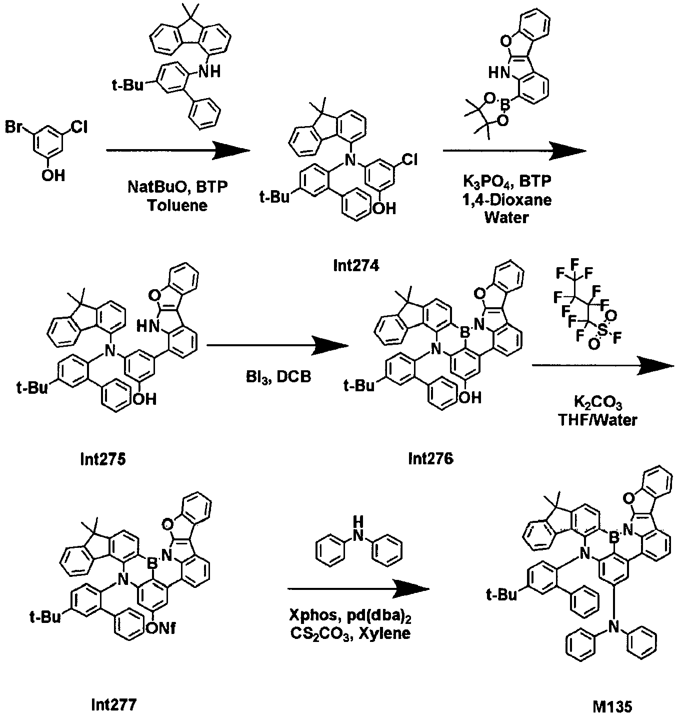

### 1) Synthesis of Int274

The same equivalents and method were used as in the synthesis process of Int266 using N-(5-(tert-butyl)-[1,1'-biphenyl]-2-yl)-9,9-dimethyl-9H-fluoren-4-amine instead of 6-(tert-butyl)-4a,9a-dimethyl-2,3,4,4a,9,9a-hexahydro-1H-carbazole, and the result was recrystallized to obtain Int274 (58 g, yield 74%). MS[M+H]+=545

### 2) Synthesis of Int275

The same equivalents and method were used as in the synthesis process of Int267 using Int274 and 7-(4,4,5,5-tetramethyl-1,3,2-dioxaborolan-2-yl)-6H-benzofuro[2,3-b]indole instead of Int266 and N-([1,1'-biphenyl]-4-yl)-9,9-dimethyl-3-(4,4,5,5-tetramethyl-1,3,2-dioxaborolan-2-yl)-9H-fluoren-2-amine, and the result was recrystallized to obtain Int275 (29.2 g, yield 74%). MS[M+H]+=716

### 3) Synthesis of Int276

Under the nitrogen atmosphere, Int275 (25 g) and boron triiodide (23.3 g) were introduced to 1,2-dichlorobenzene (250 ml), and stirred for 4 hours at 160°C. After the reaction was finished, the result was extracted, and then recrystallized to obtain Int276 (7.2 g, yield 28%). MS[M+H]+=724

### 4) Synthesis of Int277

Int276 (7 g), 1,1,2,2,3,3,4,4,4-nonafluorobutane-1-sulfonyl fluoride (2.6 ml) and potassium carbonate (4.1 g) were introduced to tetrahydrofuran (70 ml) and water (30 ml), and stirred for 2 hours under reflux. After the reaction was finished, the result was extracted, and then column purified to obtain Int277 (9.2 g, yield 95%). MS[M+H]+=1006

### 5) Synthesis of Compound M135

Under the nitrogen atmosphere, Int277 (7 g), diphenylamine (1.2 g), pd(dba)₂ (0.12 g), Xphos (0.20 g) and cesium carbonate (6.1 g) were introduced to xylene (100 ml), and stirred for 12 hours under reflux. After the reaction was finished, the result was extracted, and then recrystallized to obtain Compound M135 (4.4 g, yield 72%). MS[M+H]+=875

### Synthesis Example 136. Synthesis of Compound M136

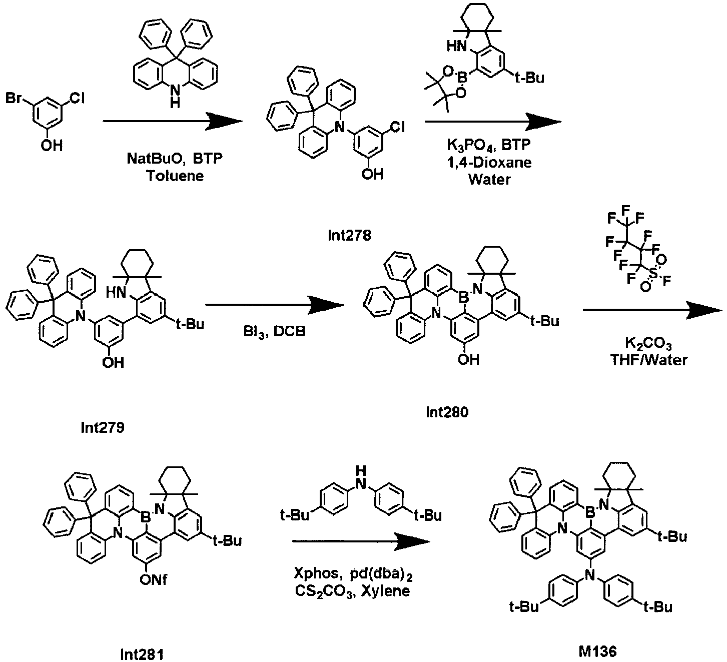

### 1) Synthesis of Int278

The same equivalents and method were used as in the synthesis process of Int266 using 9,9-diphenyl-9,10-dihydroacridine instead of 6-(tert-butyl)-4a,9a-dimethyl-2,3,4,4a,9,9a-hexahydro-1H-carbazole, and the result was recrystallized to obtain Int278 (51 g, yield 77%). MS[M+H]+=461

### 2) Synthesis of Int279

The same equivalents and method were used as in the synthesis process of Int267 using Int278 and 6-(tert-butyl)-4a,9a-dimethyl-8-(4,4,5,5-tetramethyl-1,3,2-dioxaborolan-2-yl)-2,3,4,4a,9,9a-hexahydro-1H-carbazole instead of Int266 and N-([1,1'-biphenyl]-4-yl)-9,9-dimethyl-3-(4,4,5,5-tetramethyl-1,3,2-dioxaborolan-2-yl)-9H-fluoren-2-amine, and the result was recrystallized to obtain Int279 (32.3 g, yield 73%). MS[M+H]+=682

### 3) Synthesis of Int280

Under the nitrogen atmosphere, Int279 (25 g) and boron triiodide (24.4 g) were introduced to 1,2-dichlorobenzene (250 ml), and stirred for 4 hours at 160°C. After the reaction was finished, the result was extracted, and then recrystallized to obtain Int280 (7.3 g, yield 29%). MS[M+H]+=690

### 4) Synthesis of Int281

Int280 (7 g), 1,1,2,2,3,3,4,4,4-nonafluorobutane-1-sulfonyl fluoride (2.8 ml) and potassium carbonate (4.3 g) were introduced to tetrahydrofuran (70 ml) and water (30 ml), and stirred for 2 hours under reflux. After the reaction was finished, the result was extracted, and then column purified to obtain Int281 (9.1 g, yield 92%). MS[M+H]+=972

### 5) Synthesis of Compound M136

Under the nitrogen atmosphere, Int281 (7 g), bis(4-(tert-butyl)phenyl)amine (2.1 g), pd(dba)₂ (0.13 g), Xphos (0.21 g) and cesium carbonate (7.1 g) were introduced to xylene (100 ml), and stirred for 12 hours under reflux. After the reaction was finished, the result was extracted, and then recrystallized to obtain Compound M136 (5.1 g, yield 74%). MS[M+H]+=953

### Synthesis Example 137. Sunthesis of Compound M137

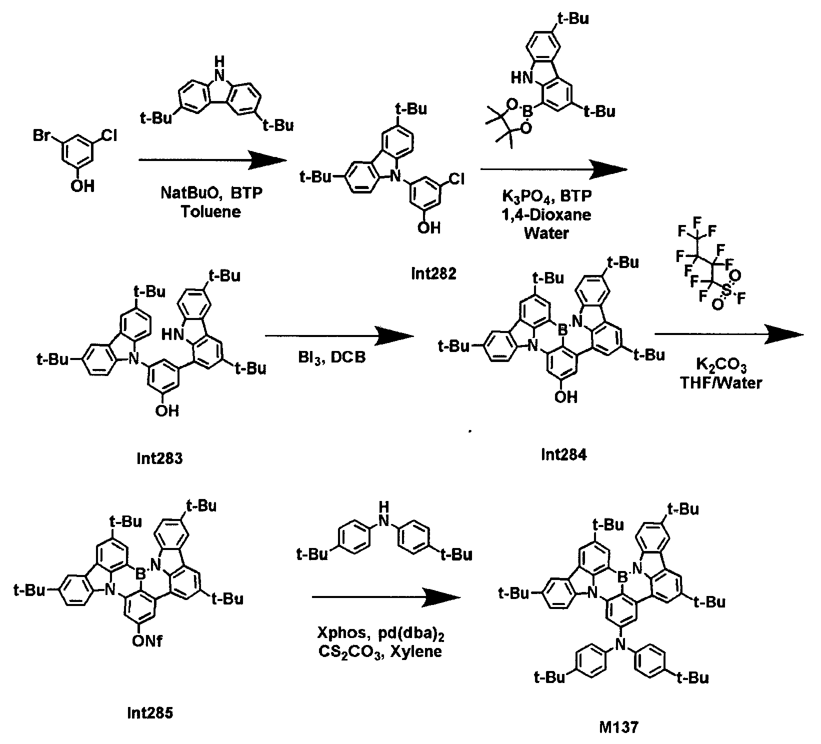

### 1) Synthesis of Int282

The same equivalents and method were used as in the synthesis process of Int266 using 3,6-di-tert-butyl-9H-carbazole instead of 6-(tert-butyl)-4a,9a-dimethyl-2,3,4,4a,9,9a-hexahydro-1H-carbazole, and the result was recrystallized to obtain Int282 (44 g, yield 75%). MS[M+H]+=407

### 2) Synthesis of Int283

The same equivalents and method were used as in the synthesis process of Int267 using Int282 and 3,6-di(tert-butyl)-8-(4,4,5,5-tetramethyl-1,3,2-dioxaborolan-2-yl)-2,3,4,4a,9,9a-hexahydro-1H-carbazole instead of Int266 and N-([1,1'-biphenyl]-4-yl)-9,9-dimethyl-3-(4,4,5,5-tetramethyl-1,3,2-dioxaborolan-2-yl)-9H-fluoren-2-amine, and the result was recrystallized to obtain Int283 (37 g, yield 77%). MS[M+H]+=650

### 3) Synthesis of Int284

Under the nitrogen atmosphere, Int283 (25 g) and boron triiodide (25.6 g) were introduced to 1,2-dichlorobenzene (250 ml), and stirred for 4 hours at 160°C. After the reaction was finished, the result was extracted, and then recrystallized to obtain Int284 (7.2 g, yield 28%). MS[M+H]+=658

### 4) Synthesis of Int285

Int284 (7 g), 1,1,2,2,3,3,4,4,4-nonafluorobutane-1-sulfonyl fluoride (2.9 ml) and potassium carbonate (4.4 g) were introduced to tetrahydrofuran (70 ml) and water (30 ml), and stirred for 2 hours under reflux. After the reaction was finished, the result was extracted, and then column purified to obtain Int285 (9.2 g, yield 92%). MS[M+H]+=940

### 5) Synthesis of Compound M137

Under the nitrogen atmosphere, Int285 (7 g), bis(4-(tert-butyl)phenyl)amine (2.1 g), pd(dba)₂ (0.13 g), Xphos (0.21 g) and cesium carbonate (7.3 g) were introduced to xylene (100 ml), and stirred for 12 hours under reflux. After the reaction was finished, the result was extracted, and then recrystallized to obtain Compound M137 (5.3 g, yield 77%). MS[M+H]+=921

### Synthesis Example 138. Synthesis of Compound M138

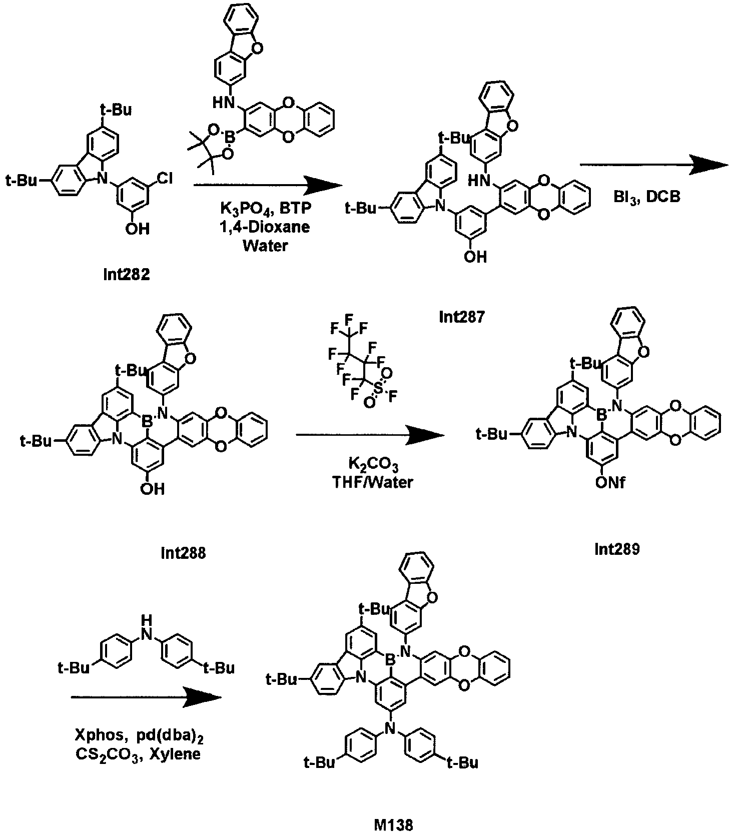

### 1) Synthesis of Int287

The same equivalents and method were used as in the synthesis process of Int267 using Int282 and N-(dibenzo[b,d]furan-3-yl)-3-(4,4,5,5-tetramethyl-1,3,2-dioxaborolan-2-yl)dibenzo[b,e][1,4]dioxin-2-amine instead of Int266 and N-([1,1'-biphenyl]-4-yl)-9,9-dimethyl-3-(4,4,5,5-tetramethyl-1,3,2-dioxaborolan-2-yl)-9H-fluoren-2-amine, and the result was recrystallized to obtain Int287 (41.2 g, yield 76%). MS[M+H]+=736

### 2) Synthesis of Int288

Under the nitrogen atmosphere, Int287 (25 g) and boron triiodide (22.6 g) were introduced to 1,2-dichlorobenzene (250 ml), and stirred for 4 hours at 160°C. After the reaction was finished, the result was extracted, and then recrystallized to obtain Int288 (7.3 g, yield 29%). MS[M+H]+=734

### 4) Synthesis of Int289

Int288 (7 g), 1,1,2,2,3,3,4,4,4-nonafluorobutane-1-sulfonyl fluoride (2.6 ml) and potassium carbonate (3.9 g) were introduced to tetrahydrofuran (70 ml) and water (30 ml), and stirred for 2 hours under reflux. After the reaction was finished, the result was extracted, and then column purified to obtain Int289 (8.9 g, yield 92%). MS[M+H]+=1026

### 5) Synthesis of Compound M138

Under the nitrogen atmosphere, Int289 (7 g), bis(4-(tert-butyl)phenyl)amine (2.0 g), pd(dba)₂ (0.12 g), Xphos (0.20 g) and cesium carbonate (6.7 g) were introduced to xylene (100 ml), and stirred for 12 hours under reflux. After the reaction was finished, the result was extracted, and then recrystallized to obtain Compound M138 (5.1 g, yield 74%). MS[M+H]+=1007

### Synthesis Example 139. Synthesis of Compound M139

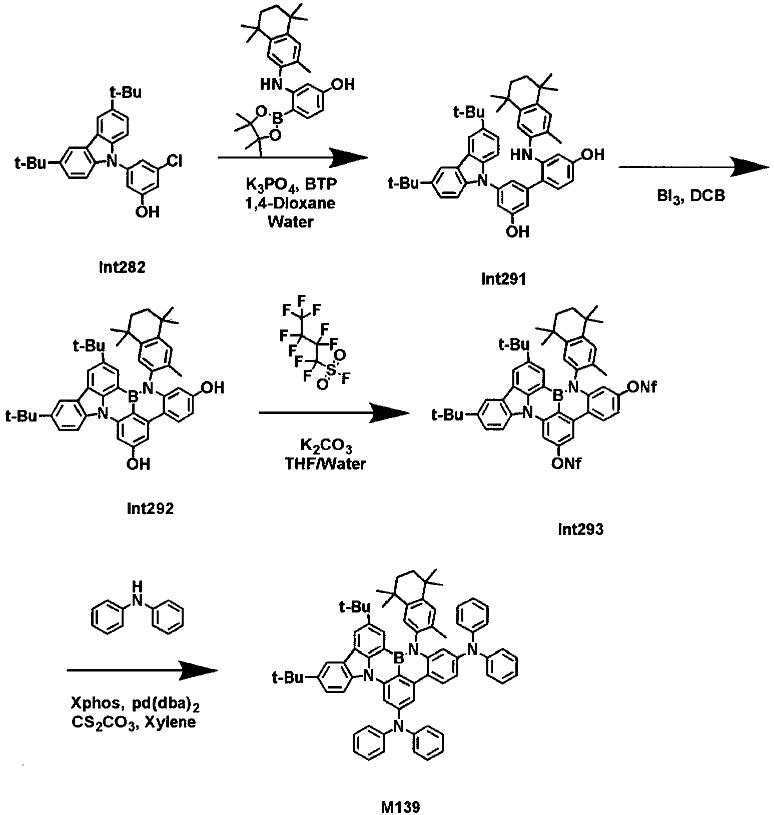

### 1) Synthesis of Int291

The same equivalents and method were used as in the synthesis process of Int267 using Int282 and 3-((3,5,5,8,8-pentamethyl-5,6,7,8-tetrahydronaphthalen-2-yl)amino)-4-(4,4,5,5-tetramethyl-1,3,2-dioxaborolan-2-yl)phenol instead of Int266 and N-([1,1'-biphenyl]-4-yl)-9,9-dimethyl-3-(4,4,5,5-tetramethyl-1,3,2-dioxaborolan-2-yl)-9H-fluoren-2-amine, and the result was recrystallized to obtain Int291 (37.7 g, yield 75%). MS[M+H]+=680

### 2) Synthesis of Int292

Under the nitrogen atmosphere, Int291 (25 g) and boron triiodide (24.5 g) were introduced to 1,2-dichlorobenzene (250 ml), and stirred for 4 hours at 160°C. After the reaction was finished, the result was extracted, and then recrystallized to obtain Int292 (7.3 g, yield 29%). MS[M+H]+=688

### 4) Synthesis of Int293

Int292 (7 g), 1,1,2,2,3,3,4,4,4-nonafluorobutane-1-sulfonyl fluoride (2.8 ml) and potassium carbonate (4.3 g) were introduced to tetrahydrofuran (70 ml) and water (30 ml), and stirred for 2 hours under reflux. After the reaction was finished, the result was extracted, and then column purified to obtain Int293 (9.1 g, yield 92%). MS[M+H]+=970

### 5) Synthesis of Compound M139

Under the nitrogen atmosphere, Int293 (7 g), diphenylamine (2.5 g), pd(dba)₂ (0.17 g), Xphos (0.28 g) and cesium carbonate (9.4 g) were introduced to xylene (100 ml), and stirred for 12 hours under reflux. After the reaction was finished, the result was extracted, and then recrystallized to obtain Compound M139 (5.5 g, yield 77%). MS[M+H]+=990

### Synthesis Example 140. Synthesis of Compound M140

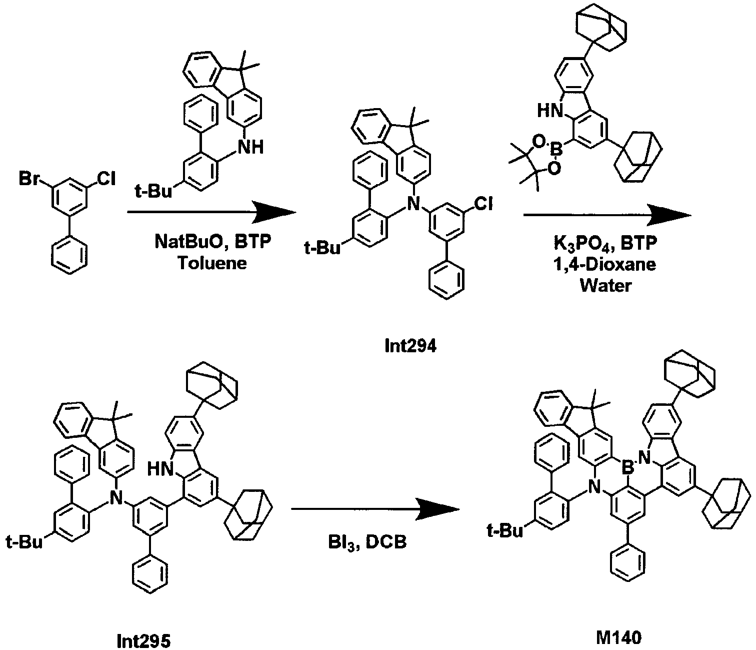

### 1) Synthesis of Int294

The same equivalents and method were used as in the synthesis process of Int1 using N-(5-(tert-butyl)-[1,1'-biphenyl]-2-yl)-9,9-dimethyl-9H-fluoren-3-amine instead of bis(5,5,8,8-tetramethyl-5,6,7,8-tetrahydronaphthalen-2-yl)amine, and after the reaction was finished, the result was extracted and then recrystallized to obtain Int294 (48 g, yield 71%). MS[M+H]+=605

### 2) Synthesis of Int295

The same equivalents and method were used as in the synthesis process of Int2 using Int294 and 3,6-di(adamantan-1-yl)-1-(4,4,5,5-tetramethyl-1,3,2-dioxaborolan-2-yl)-9H-carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int295 (36.6 g, yield 73%). MS[M+H]+=1004

### 3) Synthesis of Compound M140

Under the nitrogen atmosphere, Int295 (25 g) and boron triiodide (16.6 g) were introduced to 1,2-dichlorobenzene (250 ml), and stirred for 4 hours at 160°C. After the reaction was finished, the result was extracted, and then recrystallized to obtain Compound M140 (7.4 g, yield 29%). MS[M+H]+=1012

### Synthesis Example 141. Synthesis of Compound M141

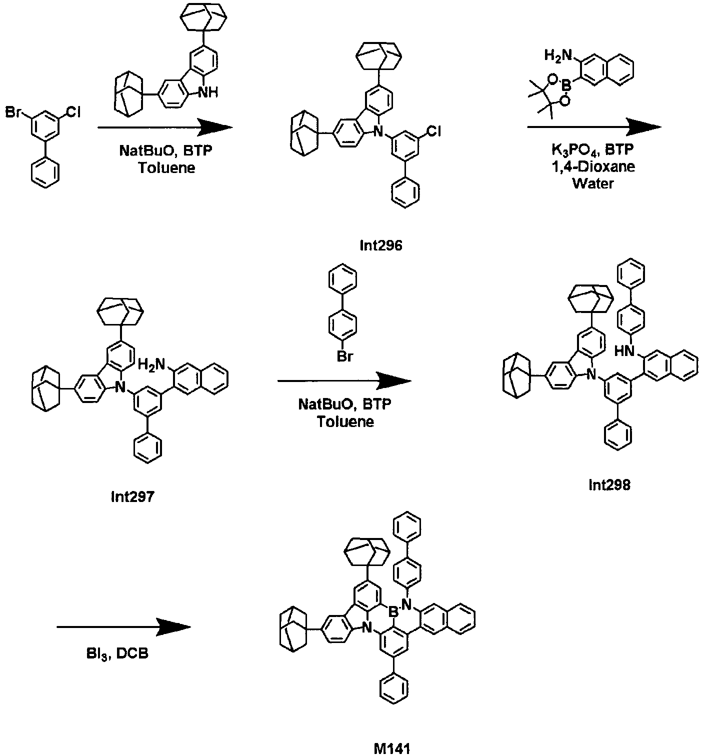

### 1) Synthesis of Int296

The same equivalents and method were used as in the synthesis process of Int1 using 3,6-di(adamantan-1-yl)-9H-carbazole instead of bis(5,5,8,8-tetramethyl-5,6,7,8-tetrahydronaphthalen-2-yl)amine, and after the reaction was finished, the result was extracted and then recrystallized to obtain Int296 (51 g, yield 73%). MS[M+H]+=623

### 2) Synthesis of Int297

The same equivalents and method were used as in the synthesis process of Int2 using Int296 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int297 (27.3 g, yield 78%). MS[M+H]+=730

### 3) Synthesis of Int298

The same equivalents and method were used as in the synthesis process of Int1 using Int297 (27 g) and 4-bromo-1,1'-biphenyl (10.4 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int298 (25.4 g, yield 78%). MS[M+H]+=882

### 4) Synthesis of Compound M141

Under the nitrogen atmosphere, Int298 (25 g) and boron triiodide (18.9 g) were introduced to 1,2-dichlorobenzene (250 ml), and stirred for 4 hours at 160°C. After the reaction was finished, the result was extracted, and then recrystallized to obtain Compound M141 (7.3 g, yield 29%). MS[M+H]+=890

### Synthesis Example 142. Synthesis of Compound M142

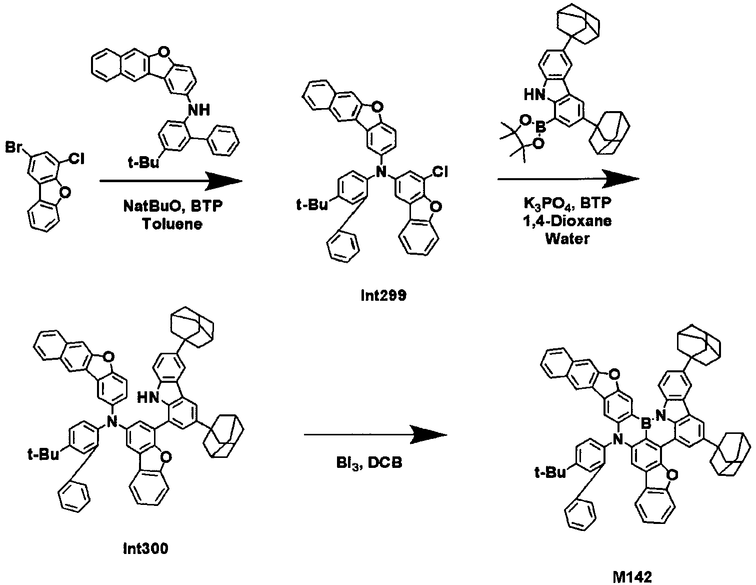

### 1) Synthesis of Int299

The same equivalents and method were used as in the synthesis process of Int134 using N-(5-(tert-butyl)-[1,1'-biphenyl]-2-yl)naphtho[2,3-b]benzofuran-2-amine instead of di([1,1'-biphenyl]-4-yl)amine, and after the reaction was finished, the result was extracted and then recrystallized to obtain Int299 (52.5 g, yield 77%). MS[M+H]+=643

### 2) Synthesis of Int300

The same equivalents and method were used as in the synthesis process of Int135 using Int299 and 3,6-di(adamantan-1-yl)-1-(4,4,5,5-tetramethyl-1,3,2-dioxaborolan-2-yl)-9H-carbazole instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int300 (36.5 g, yield 75%). MS[M+H]+=1042

### 3) Synthesis of Compound M142

Under the nitrogen atmosphere, Int300 (25 g) and boron triiodide (16 g) were introduced to 1,2-dichlorobenzene (250 ml), and stirred for 4 hours at 160°C. After the reaction was finished, the result was extracted, and then recrystallized to obtain Compound M142 (7.2 g, yield 29%). MS[M+H]+=1050

### Synthesis Example 143. Synthesis of Compound M143

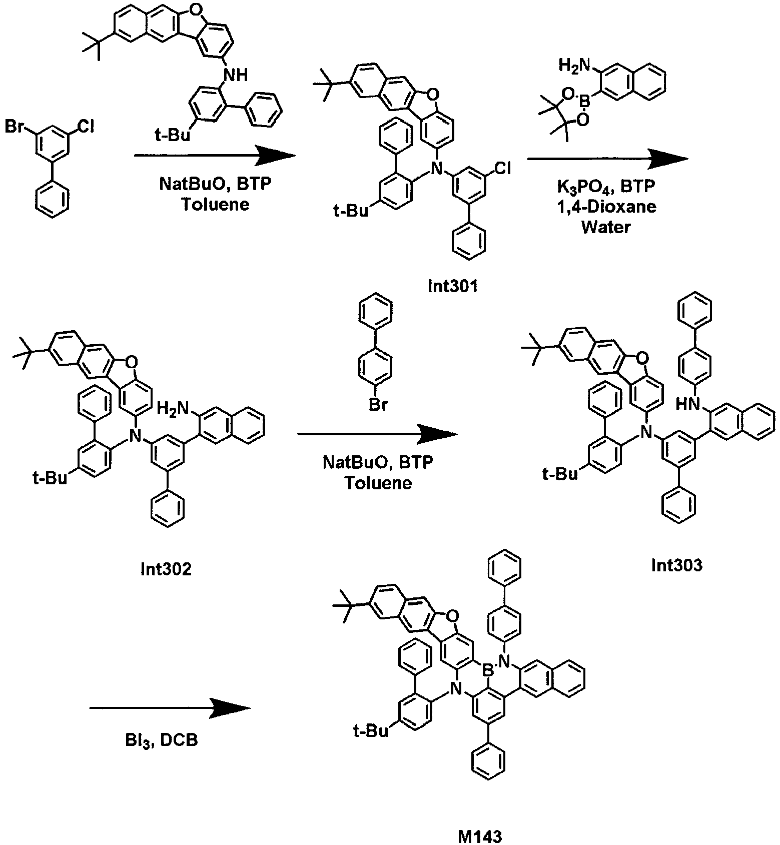

### 1) Synthesis of Int301

The same equivalents and method were used as in the synthesis process of Int1 using 9-(tert-butyl)-N-(5-(tert-butyl)-[1,1'-biphenyl]-2-yl)naphtho[2,3-b]benzofuran-2-amine instead of bis(5,5,8,8-tetramethyl-5,6,7,8-tetrahydronaphthalen-2-yl)amine, and after the reaction was finished, the result was extracted and then recrystallized to obtain Int301 (55.3 g, yield 72%). MS[M+H]+=629

### 2) Synthesis of Int302

The same equivalents and method were used as in the synthesis process of Int2 using Int301 and 3-(4,4,5,5-tetramethyl-1,3,2-dioxaborolan-2-yl)naphthalen-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int302 (27.2 g, yield 78%). MS[M+H]+=792

### 3) Synthesis of Int303

The same equivalents and method were used as in the synthesis process of Int1 using Int302 (27 g) and 4-bromo-1,1'-biphenyl (10.4 g) instead of 3-bromo-5-chloro-1,1'-biphenyl and bis(5,5,8,8-tetramethyl-5,6,7,8-tetrahydronaphthalen-2-yl)amine, and after the reaction was finished, the result was extracted and then recrystallized to obtain Int303 (25.1 g, yield 78%). MS[M+H]+=944

### 4) Synthesis of Compound M143

Under the nitrogen atmosphere, Int303 (25 g) and boron triiodide (17.6 g) were introduced to 1,2-dichlorobenzene (250 ml), and stirred for 4 hours at 160°C. After the reaction was finished, the result was extracted, and then recrystallized to obtain Compound M143 (7.1 g, yield 28%). MS[M+H]+=952

### Synthesis Example 144. Synthesis of Compound M144

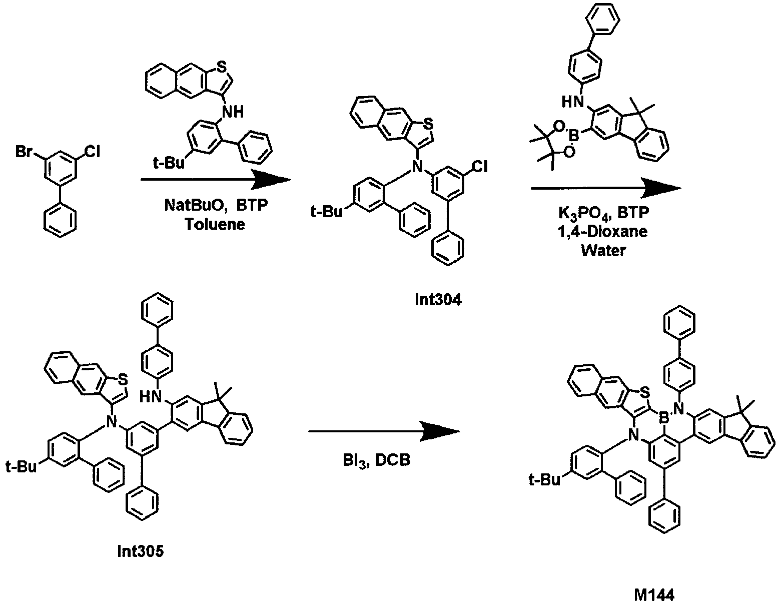

### 1) Synthesis of Int304

The same equivalents and method were used as in the synthesis process of Int1 using N-(5-(tert-butyl)-[1,1'-biphenyl]-2-yl)naphtho[2,3-b]thiophen-3-amine instead of bis(5,5,8,8-tetramethyl-5,6,7,8-tetrahydronaphthalen-2-yl)amine, and after the reaction was finished, the result was extracted and then recrystallized to obtain Int304 (52.2 g, yield 78%). MS[M+H]+=595

### 2) Synthesis of Int305

The same equivalents and method were used as in the synthesis process of Int2 using Int304 and N-([1,1'-biphenyl]-4-yl)-9,9-dimethyl-3-(4,4,5,5-tetramethyl-1,3,2-dioxaborolan-2-yl)-9H-fluoren-2-amine instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int305 (34.3 g, yield 74%). MS[M+H]+=920

### 3) Synthesis of Compound M144

Under the nitrogen atmosphere, Int305 (25 g) and boron triiodide (18.1 g) were introduced to 1,2-dichlorobenzene (250 ml), and stirred for 4 hours at 160°C. After the reaction was finished, the result was extracted, and then recrystallized to obtain Compound M144 (7.2 g, yield 29%). MS[M+H]+=928

### Synthesis Example 146. Synthesis of Compound M146

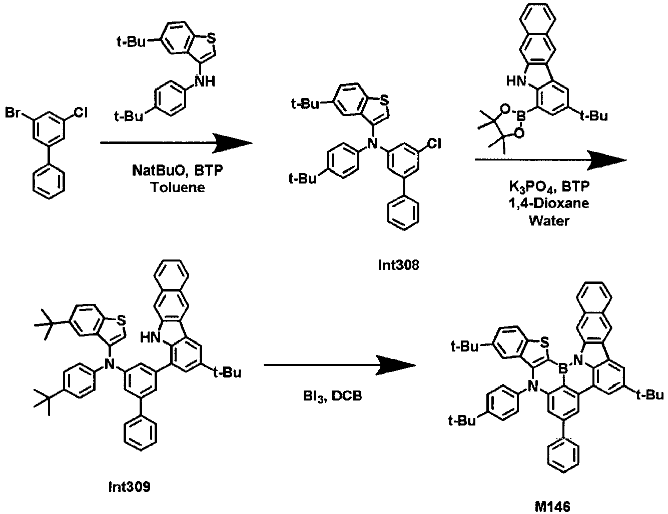

### 1) Synthesis of Int308

The same equivalents and method were used as in the synthesis process of Int1 using 5-(tert-butyl)-N-(4-(tert-butyl)phenyl)benzo[b]thiophen-3-amine instead of bis(5,5,8,8-tetramethyl-5,6,7,8-tetrahydronaphthalen-2-yl)amine, and after the reaction was finished, the result was extracted and then recrystallized to obtain Int308 (44 g, yield 75%). MS[M+H]+=525

### 2) Synthesis of Int309

The same equivalents and method were used as in the synthesis process of Int2 using Int308 and 2-(tert-butyl)-4-(4,4,5,5-tetramethyl-1,3,2-dioxaborolan-2-yl)-5H-benzo[b]carbazole instead of Int1 and 4-(4,4,5,5-tetramethyl-1,3,2-dioxaborolan-2-yl)-10H-spiro[acridine-9,9'-fluorene], and after the reaction was finished, the result was extracted and then recrystallized to obtain Int309 (31.1 g, yield 71%). MS[M+H]+=762

### 3) Synthesis of Compound M146

Under the nitrogen atmosphere, Int309 (25 g) and boron triiodide (21.9 g) were introduced to 1,2-dichlorobenzene (250 ml), and stirred for 4 hours at 160°C. After the reaction was finished, the result was extracted, and then recrystallized to obtain Compound M146 (7.2 g, yield 29%). MS[M+H]+=770

### Synthesis Example 147. Synthesis of Compound M147

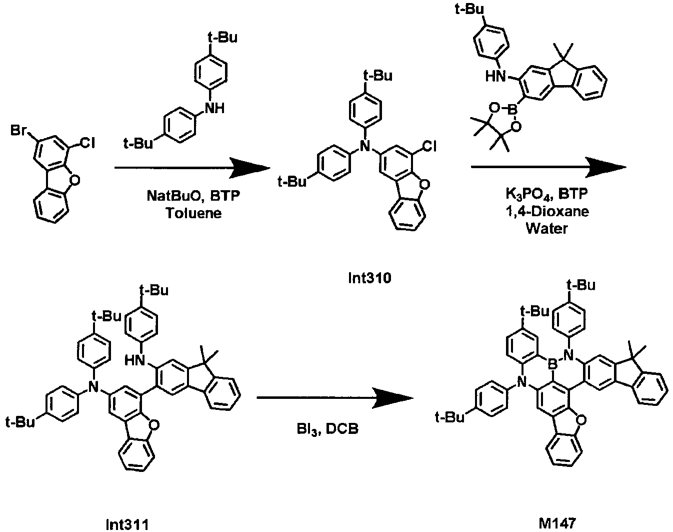

### 1) Synthesis of Int310

The same equivalents and method were used as in the synthesis process of Int134 using bis(4-(tert-butyl)phenyl)amine instead of di([1,1'-biphenyl]-4-yl)amine, and after the reaction was finished, the result was extracted and then recrystallized to obtain Int310 (37 g, yield 72%). MS[M+H]+=483

### 2) Synthesis of Int311

The same equivalents and method were used as in the synthesis process of Int135 using Int310 and N-(4-(tert-butyl)phenyl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int311 (35.2 g, yield 72%). MS[M+H]+=788

### 3) Synthesis of Compound M147

Under the nitrogen atmosphere, Int311 (25 g) and boron triiodide (21.1 g) were introduced to 1,2-dichlorobenzene (250 ml), and stirred for 4 hours at 160°C. After the reaction was finished, the result was extracted, and then recrystallized to obtain Compound M147 (7.6 g, yield 30%). MS[M+H]+=796

### Synthesis Example 148. Synthesis of Compound M148

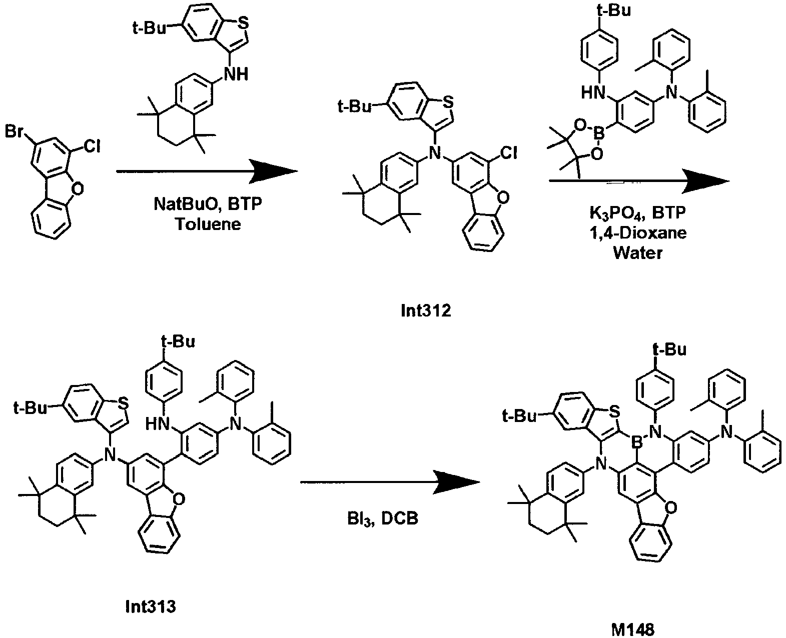

### 1) Synthesis of Int312

The same equivalents and method were used as in the synthesis process of Int134 using 5-(tert-butyl)-N-(5,5,8,8-tetramethyl-5,6,7,8-tetrahydronaphthalen-2-yl)benzo[b]thiophen-3-amine instead of di([1,1'-biphenyl]-4-yl)amine, and after the reaction was finished, the result was extracted and then recrystallized to obtain Int312 (47 g, yield 74%). MS[M+H]+=593

### 2) Synthesis of Int313

The same equivalents and method were used as in the synthesis process of Int135 using Int312 and N3-(4-(tert-butyl)phenyl)-4-(4,4,5,5-tetramethyl-1,3,2-dioxaborolan-2-yl)-N1,N1-di-o-tolylbenzene-1,3-diamine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int313 (36.6 g, yield 74%). MS[M+H]+=977

### 3) Synthesis of Compound M148

Under the nitrogen atmosphere, Int313 (25 g) and boron triiodide (17 g) were introduced to 1,2-dichlorobenzene (250 ml), and stirred for 4 hours at 160°C. After the reaction was finished, the result was extracted, and then recrystallized to obtain Compound M148 (7.7 g, yield 31%). MS[M+H]+=985

### Synthesis Example 149. Synthesis of Compound M149

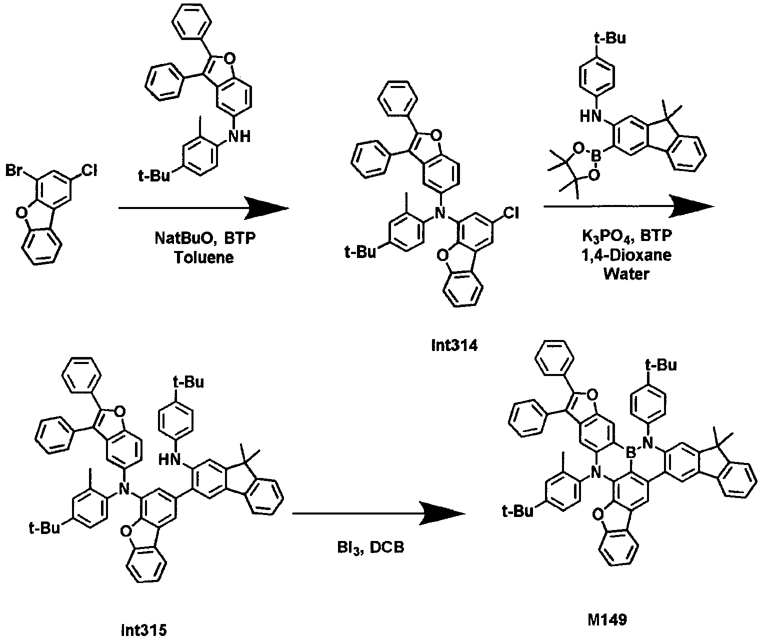

### 1) Synthesis of Int314

The same equivalents and method were used as in the synthesis process of Int158 using N-(4-(tert-butyl)-2-methylphenyl)-2,3-diphenylbenzofuran-5-amine instead of 3,6-di-tert-butyl-9H-carbazole, and after the reaction was finished, the result was extracted and then recrystallized to obtain Int314 (48 g, yield 71%). MS[M+H]+=633

### 2) Synthesis of Int315

The same equivalents and method were used as in the synthesis process of Int135 using Int314 and N-(4-(tert-butyl)phenyl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int315 (34.2 g, yield 77%). MS[M+H]+=938

### 3) Synthesis of Compound M149

Under the nitrogen atmosphere, Int315 (25 g) and boron triiodide (17.6 g) were introduced to 1,2-dichlorobenzene (250 ml), and stirred for 4 hours at 160°C. After the reaction was finished, the result was extracted, and then recrystallized to obtain Compound M149 (7.8 g, yield 31%). MS[M+H]+=946

### Synthesis Example 150. Synthesis of Compound M150

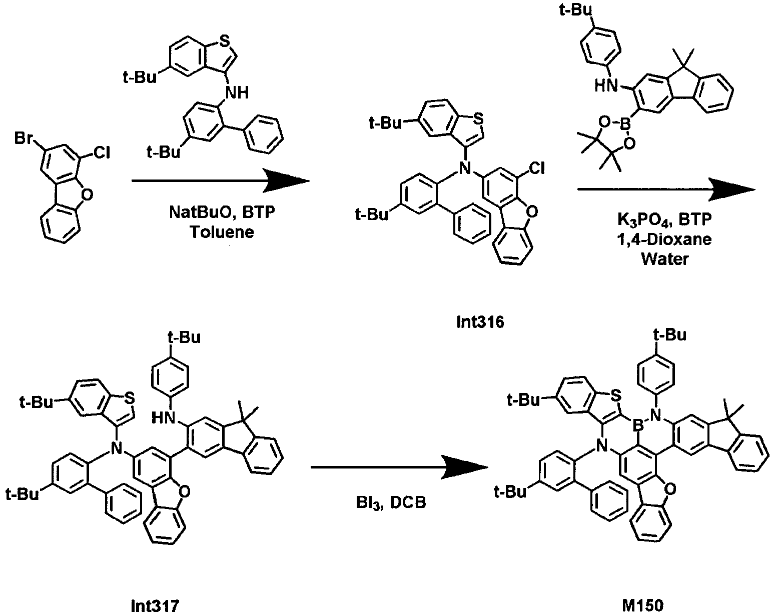

### 1) Synthesis of Int316

The same equivalents and method were used as in the synthesis process of Int134 using 5-(tert-butyl)-N-(5-(tert-butyl)-[1,1'-biphenyl]-2-yl)benzo[b]thiophen-3-amine instead of di([1,1'-biphenyl]-4-yl)amine, and after the reaction was finished, the result was extracted and then recrystallized to obtain Int316 (46 g, yield 70%). MS[M+H]+=615

### 2) Synthesis of Int317

The same equivalents and method were used as in the synthesis process of Int135 using Int316 and N-(4-(tert-butyl)phenyl)-9,9-dimethyl-3-(4,4,5,5-tetramethyl-1,3,2-dioxaborolan-2-yl)-9H-fluoren-2-amine instead of Int134 and 3,6-di-tert-butyl-1-(4,4,5,5-tetramethyl-1,3,2-dioxaborolan-2-yl)-9H-carbazole, and after the reaction was finished, the result was extracted and then recrystallized to obtain Int317 (33.7 g, yield 75%). MS[M+H]+=920

### 3) Synthesis of Compound M150

Under the nitrogen atmosphere, Int317 (25 g) and boron triiodide (18.1 g) were introduced to 1,2-dichlorobenzene (250 ml), and stirred for 4 hours at 160°C. After the reaction was finished, the result was extracted, and then recrystallized to obtain Compound M150 (7.8 g, yield 31%). MS[M+H]+=928

### Experimental Example 1

### Manufacture of Organic Light Emitting Device

### Example 1

A glass substrate on which ITO (indium tin oxide) was coated as a thin film to a thickness of 1,400 Å was placed in detergent-dissolved distilled water and ultrasonic cleaned. Herein, a product of Fischer Co. was used as the detergent, and as the distilled water, distilled water filtered twice with a filter manufactured by Millipore Co. was used. After the ITO was cleaned for 30 minutes, ultrasonic cleaning was repeated twice using distilled water for 10 minutes. After the cleaning with distilled water was finished, the substrate was ultrasonic cleaned with solvents of isopropyl alcohol, acetone and methanol, then dried, and then transferred to a plasma cleaner. In addition, the substrate was cleaned for 5 minutes using oxygen plasma, and then transferred to a vacuum deposition apparatus.

On the transparent ITO electrode prepared as above, the following HI-A and HAT-CN were thermal vacuum deposited to thicknesses of 650 Å and 50 Å, respectively, to form first and second hole injection layers. On the hole injection layer, the following HT-A was vacuum deposited to a thickness of 600 Å to form a hole transfer layer. On the hole transfer layer, the following HT-B was vacuum deposited to a thickness of 50 Å to form an electron blocking layer. Subsequently, a light emitting layer was formed on the electron blocking layer by vacuum depositing Compound M1 of Synthesis Example 1 as a blue light emitting dopant in 4 parts by weight based on 100 parts by weight of the light emitting layer, and the following BH to a thickness of 200 Å as a host. Then, the following Compound ET-A was vacuum deposited to 50 Å on the light emitting layer as a first electron transfer layer, and consecutively, the following ET-B and LiQ were vacuum deposited in a weight ratio of 1:1 to a thickness of 360 Å to form a second electron transfer layer. On the second electron transfer layer, LiQ was vacuum deposited to a thickness of 5 Å to form an electron injection layer. On the electron injection layer, aluminum and silver were deposited in a weight ratio of 10:1 to a thickness of 220 Å, and aluminum was deposited to a thickness of 1000 Å thereon to form a cathode.

In the above-described process, the deposition rates of the organic materials were maintained at 0.4 Å/sec to 0.9 Å/sec, the deposition rate of the aluminum of the cathode was maintained at 2 Å /sec, and the degree of vacuum during the deposition was maintained at 5×10⁻⁸ torr to 1×10⁻⁷ torr to manufacture an organic light emitting device.

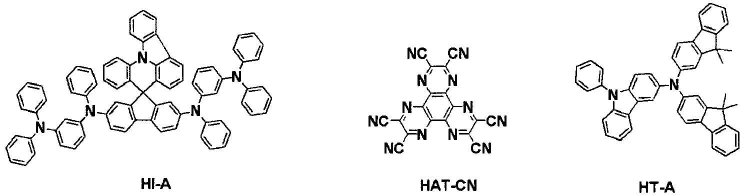

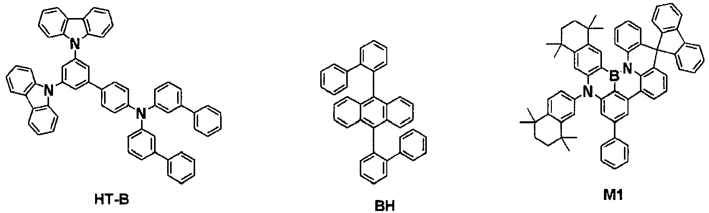

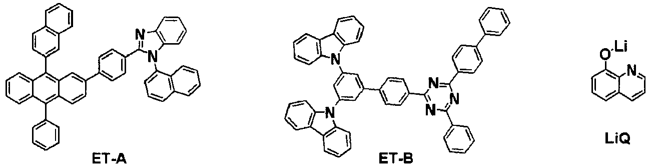

Examples 2 to 5 and 7 to 16, 18 to 84, 86 to 115, 117 to 128, 130, 131, 133 to 144, 146 to 150 and Comparative Examples 1 to 13

Organic light emitting devices were manufactured in the same manner as in Example 1 except that, as the dopant of the light emitting layer, compounds of the following Table 1 were each used instead of Compound M1.

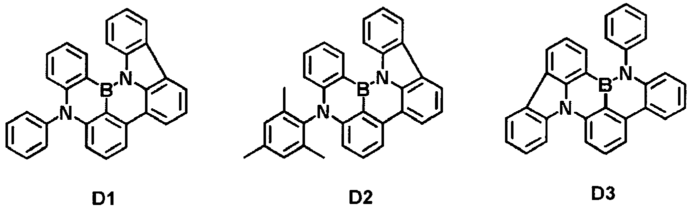

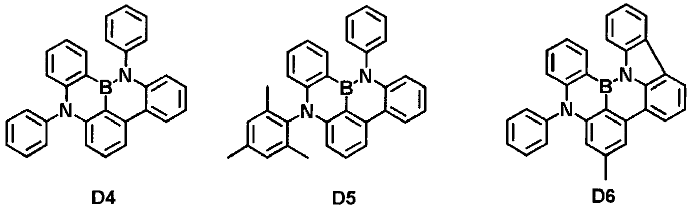

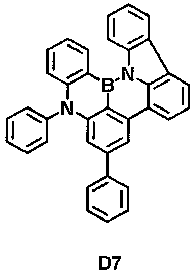

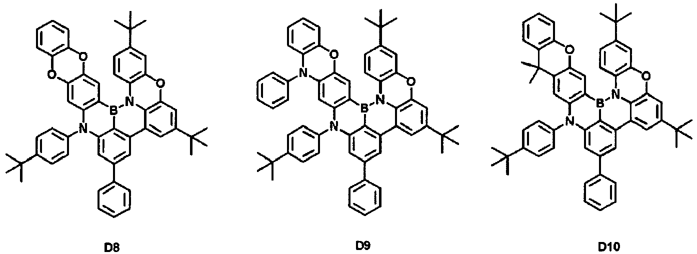

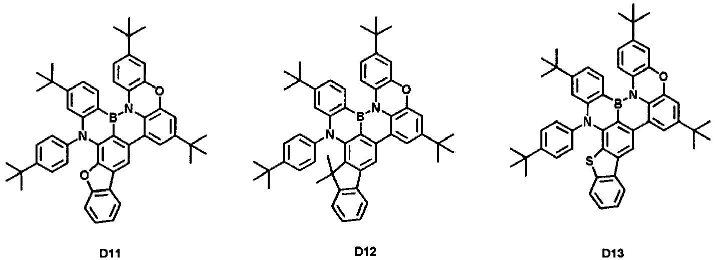

### <Experimental Example 1: Evaluation on Device>

For each of the organic light emitting devices of Examples 1 to 5, 7 to 16, 18 to 84, 86 to 115, 117 to 128, 130, 131, 133 to 144, 146 to 150 and Comparative Examples 1 to 13, a voltage and conversion efficiency (cd/A/y) when applying current density of 10 mA/cm², and a lifetime (LT₉₅) when applying current density of 20 mA/cm² were measured, and the results are shown in the following Table 1. Herein, T₉₅ represents time taken for luminance to decrease to 95% when employing initial luminance as 100% at current density of 20 mA/cm².

**[Table 1]**

| | voltage (V) | conversion efficiency (Cd/A/y) | lifetime (T95)hr |
|---|---|---|---|
| Example 1 (Compound M1) | 3.8 | 62.3 | 273 |
| Example 2 (Compound M2) | 3.7 | 62.1 | 272 |
| Example 3 (Compound M3) | 3.7 | 62.5 | 275 |
| Example 4 (Compound M4) | 3.7 | 64.3 | 278 |
| Example 5 (Compound M5) | 3.7 | 62.5 | 273 |
| Example 7 (Compound M7) | 3.7 | 64.7 | 278 |
| Example 8 (Compound M8) | 3.8 | 63.3 | 277 |
| Example 9 (Compound M9) | 3.8 | 63.2 | 276 |
| Example 10 (Compound M10) | 3.8 | 63.1 | 277 |
| Example 11 (Compound M11) | 3.8 | 63.2 | 277 |
| Example 12 (Compound M12) | 3.7 | 62.4 | 272 |
| Example 13 (Compound M13) | 3.8 | 64.1 | 278 |
| Example 14 (Compound M14) | 3.8 | 63.6 | 277 |
| Example 15 (Compound M15) | 3.8 | 64.8 | 276 |
| Example 16 (Compound M16) | 3.7 | 64.6 | 287 |
| Example 18 (Compound M18) | 3.7 | 64.5 | 277 |
| Example 19 (Compound M19) | 3.7 | 63.6 | 276 |
| Example 20 (Compound M20) | 3.8 | 63.5 | 276 |
| Example 21 (Compound M21) | 3.7 | 63.3 | 275 |
| Example 22 (Compound M22) | 3.8 | 64 | 279 |
| Example 23 (Compound M23) | 3.7 | 64.1 | 277 |
| Example 24 (Compound M24) | 3.7 | 64.5 | 278 |
| Example 25 (Compound M25) | 3.8 | 64.3 | 278 |
| Example 26 (Compound M26) | 3.8 | 62.2 | 272 |
| Example 27 (Compound M27) | 3.7 | 62.3 | 273 |
| Example 28 (Compound M28) | 3.8 | 64.6 | 278 |
| Example 29 (Compound M29) | 3.7 | 64.2 | 279 |
| Example 30 (Compound M30) | 3.8 | 63.3 | 277 |
| Example 31 (Compound M31) | 3.7 | 64.2 | 279 |
| Example 32 (Compound M32) | 3.7 | 64.5 | 277 |
| Example 33 (Compound M33) | 3.7 | 64.1 | 278 |
| Example 34 (Compound M34) | 3.7 | 64.4 | 277 |
| Example 35 (Compound M35) | 3.7 | 64.7 | 277 |
| Example 36 (Compound M36) | 3.7 | 63.3 | 276 |
| Example 37 (Compound M37) | 3.7 | 63.2 | 277 |
| Example 38 (Compound M38) | 3.7 | 62.4 | 272 |
| Example 39 (Compound M39) | 3.7 | 63.5 | 275 |
| Example 40 (Compound M40) | 3.7 | 64.4 | 278 |
| Example 41 (Compound M41) | 3.8 | 62.9 | 274 |
| Example 42 (Compound M42) | 3.8 | 62.8 | 271 |
| Example 43 (Compound M43) | 3.8 | 61.1 | 272 |
| Example 44 (Compound M44) | 3.8 | 63.9 | 275 |
| Example 45 (Compound M45) | 3.7 | 61.8 | 273 |
| Example 46 (Compound M46) | 3.7 | 61.8 | 274 |
| Example 47 (Compound M47) | 3.8 | 63.3 | 276 |
| Example 48 (Compound M48) | 3.8 | 63.4 | 275 |
| Example 49 (Compound M49) | 3.8 | 64.5 | 279 |
| Example 50 (Compound M50) | 3.8 | 62.3 | 271 |
| Example 51 (Compound M51) | 3.7 | 64.2 | 277 |
| Example 52 (Compound M52) | 3.8 | 63.4 | 276 |
| Example 53 (Compound M53) | 3.7 | 63.6 | 276 |
| Example 54 (Compound M54) | 3.8 | 60.4 | 283 |
| Example 55 (Compound M55) | 3.7 | 62.1 | 273 |
| Example 56 (Compound M56) | 3.7 | 62.3 | 282 |
| Example 57 (Compound M57) | 3.7 | 62.2 | 271 |
| Example 58 (Compound M58) | 3.7 | 62.8 | 273 |
| Example 59 (Compound M59) | 3.7 | 62.7 | 274 |
| Example 60 (Compound M60) | 3.7 | 64.1 | 278 |
| Example 61 (Compound M61) | 3.7 | 62.2 | 273 |
| Example 62 (Compound M62) | 3.8 | 62.9 | 275 |
| Example 63 (Compound M63) | 3.8 | 62.7 | 273 |
| Example 64 (Compound M64) | 3.8 | 64.4 | 278 |
| Example 65 (Compound M65) | 3.8 | 62.2 | 272 |
| Example 66 (Compound M66) | 3.7 | 62.3 | 272 |
| Example 67 (Compound M67) | 3.8 | 62.4 | 273 |
| Example 68 (Compound M68) | 3.8 | 64.4 | 278 |
| Example 69 (Compound M69) | 3.5 | 63.4 | 282 |
| Example 70 (Compound M70) | 3.6 | 65.5 | 288 |
| Example 71 (Compound M71) | 3.6 | 65.5 | 289 |
| Example 72 (Compound M72) | 3.6 | 64.4 | 283 |
| Example 73 (Compound M73) | 3.5 | 64.3 | 282 |
| Example 74 (Compound M74) | 3.6 | 63.5 | 285 |
| Example 75 (Compound M75) | 3.5 | 65.5 | 288 |
| Example 76 (Compound M76) | 3.6 | 63.4 | 281 |
| Example 77 (Compound M77) | 3.5 | 64.4 | 287 |
| Example 78 (Compound M78) | 3.6 | 62.4 | 281 |
| Example 79 (Compound M79) | 3.5 | 63.9 | 283 |
| Example 80 (Compound M80) | 3.6 | 65.6 | 289 |
| Example 81 (Compound M81) | 3.5 | 65.4 | 288 |
| Example 82 (Compound M82) | 3.6 | 63.2 | 284 |
| Example 83 (Compound M83) | 3.5 | 63.4 | 283 |
| Example 84 (Compound M84) | 3.5 | 65.4 | 287 |
| Example 86 (Compound M86) | 3.6 | 64.2 | 285 |
| Example 87 (Compound M87) | 3.6 | 65.5 | 289 |
| Example 88 (Compound M88) | 3.6 | 65.3 | 288 |
| Example 89 (Compound M89) | 3.5 | 65.2 | 288 |
| Example 90 (Compound M90) | 3.5 | 65.3 | 287 |
| Example 91 (Compound M91) | 3.5 | 65.4 | 288 |
| Example 92 (Compound M92) | 3.6 | 63.2 | 281 |
| Example 93 (Compound M93) | 3.5 | 62.3 | 281 |
| Example 94 (Compound M94) | 3.6 | 64.5 | 285 |
| Example 95 (Compound M95) | 3.5 | 64.6 | 284 |
| Example 96 (Compound M96) | 3.6 | 65.2 | 288 |
| Example 97 (Compound M97) | 3.5 | 63.3 | 281 |
| Example 98 (Compound M98) | 3.6 | 65.4 | 289 |
| Example 99 (Compound M99) | 3.5 | 64.2 | 286 |
| Example 100 (Compound M100) | 3.6 | 63.3 | 285 |
| Example 101 (Compound M101) | 3.5 | 61.3 | 282 |
| Example 102 (Compound M102) | 3.6 | 64.2 | 288 |
| Example 103 (Compound M103) | 3.5 | 65.5 | 289 |
| Example 104 (Compound M104) | 3.6 | 65.3 | 289 |
| Example 105 (Compound M105) | 3.7 | 62.3 | 283 |
| Example 106 (Compound M106) | 3.7 | 61.4 | 283 |
| Example 107 (Compound M107) | 3.8 | 62.3 | 281 |
| Example 108 (Compound M108) | 3.7 | 62.2 | 282 |
| Example 109 (Compound M109) | 3.8 | 63.4 | 286 |
| Example 110 (Compound M110) | 3.7 | 64.3 | 288 |
| Example 111 (Compound Mill) | 3.8 | 64.2 | 287 |
| Example 112 (Compound M112) | 3.7 | 64.4 | 287 |
| Example 113 (Compound M113) | 3.8 | 62.3 | 283 |
| Example 114 (Compound M114) | 3.7 | 62.8 | 282 |
| Example 115 (Compound M115) | 3.8 | 64.3 | 288 |
| Example 117 (Compound M117) | 3.7 | 63.3 | 284 |
| Example 118 (Compound M118) | 3.8 | 62.4 | 284 |
| Example 119 (Compound M119) | 3.8 | 62.9 | 284 |
| Example 120 (Compound M120) | 3.8 | 64.4 | 288 |
| Example 121 (Compound M121) | 3.8 | 64.2 | 288 |
| Example 122 (Compound M122) | 3.7 | 64.3 | 287 |
| Example 123 (Compound M123) | 3.8 | 63.2 | 285 |
| Example 124 (Compound M124) | 3.7 | 64.4 | 287 |
| Example 125 (Compound M125) | 3.8 | 64.1 | 288 |
| Example 126 (Compound M126) | 3.7 | 64.5 | 288 |
| Example 127 (Compound M127) | 3.8 | 62.3 | 282 |
| Example 128 (Compound M128) | 3.7 | 64.5 | 289 |
| Example 130 (Compound M130) | 3.7 | 64.5 | 289 |
| Example 131 (Compound M131) | 3.8 | 62.9 | 282 |
| Example 133 (Compound M133) | 3.7 | 65.4 | 289 |
| Example 134 (Compound M134) | 3.8 | 65.2 | 289 |
| Example 135 (Compound M135) | 3.8 | 65.4 | 287 |
| Example 136 (Compound M136) | 3.7 | 65.5 | 289 |
| Example 137 (Compound M137) | 3.7 | 65.3 | 287 |
| Example 138 (Compound M138) | 3.7 | 63.8 | 285 |
| Example 139 (Compound M139) | 3.7 | 64.3 | 288 |
| Example 140 (Compound M140) | 3.7 | 64.2 | 277 |
| Example 141 (Compound M141) | 3.7 | 61.2 | 278 |
| Example 142 (Compound M142) | 3.5 | 65.4 | 288 |
| Example 143 (Compound M143) | 3.8 | 62 | 283 |
| Example 144 (Compound M144) | 3.7 | 64.3 | 287 |
| Example 145 (Compound M145) | 3.7 | 64.2 | 289 |
| Example 146 (Compound M146) | 3.7 | 64.5 | 277 |
| Example 147 (Compound M147) | 3.6 | 65.5 | 289 |
| Example 148 (Compound M148) | 3.6 | 64.8 | 285 |
| Example 149 (Compound M149) | 3.7 | 65.1 | 289 |
| Example 150 (Compound M150) | 3.6 | 65.1 | 287 |
| Comparative Example 1 (Compound D1) | 4.2 | 51.1 | 205 |
| Comparative Example 2 (Compound D2) | 4.2 | 51.0 | 204 |
| Comparative Example 3 (Compound D3) | 4.3 | 52.3 | 205 |
| Comparative Example 4 (Compound D4) | 4.2 | 50.4 | 202 |
| Comparative Example 5 (Compound D5) | 4.2 | 50.3 | 203 |
| Comparative Example 6 (Compound 00) | 4.2 | 51.3 | 204 |
| Comparative Example 7 (Compound D7) | 4.2 | 51.2 | 204 |
| Comparative Example 8 (Compound D8) | 4.5 | 45.1 | 211 |
| Comparative Example 9 (Compound 00) | 4.6 | 45.5 | 212 |
| Comparative Example 10 (Compound D10) | 4.5 | 46.2 | 213 |
| Comparative Example 11 (Compound D11) | 4.6 | 49.1 | 216 |
| Comparative Example 12 (Compound D12) | 4.5 | 48.3 | 216 |
| Comparative Example 13 (Compound D13) | 4.5 | 47.4 | 216 |

The conversion efficiency (cd/A/y) considers color purity of' a material (CIEy) as well in current efficiency (cd/A), and is an important reference value of efficiency in small and large organic light emitting devices aiming for high luminance and high color gamut.

In Table 1, it was identified that the organic light emitting device according to one embodiment of the present specification had more superior driving voltage, conversion efficiency and lifetime compared to the organic light emitting devices of Comparative Examples 1 to 5 using the compound in which Z1 to Z3 are hydrogen.

In addition, it was identified that the organic light emitting device according to one embodiment of the present specification had more superior driving voltage, conversion efficiency and lifetime compared to the organic light emitting devices of Comparative Examples 6 and 7 using the compound in which Ar1 is a phenyl group, A1 is substituted or unsubstituted benzene, R6 to R8 are hydrogen, adjacent groups among Z1 to Z3 do not bond to form a substituted or unsubstituted ring, and Ar2 and R5 form an unsubstituted indole group at the same time.

In addition, it was identified that the organic light emitting device according to one embodiment of the present specification had more superior driving voltage, conversion efficiency and lifetime compared to the organic light emitting devices of Comparative Examples 8 to 13 using the compound in which Ar2 and R5 form a substituted benzoxazine ring.

### Experimental Example 2

### MD calculation (calculation of distance between molecules in host-dopant system)

### Example 2-1

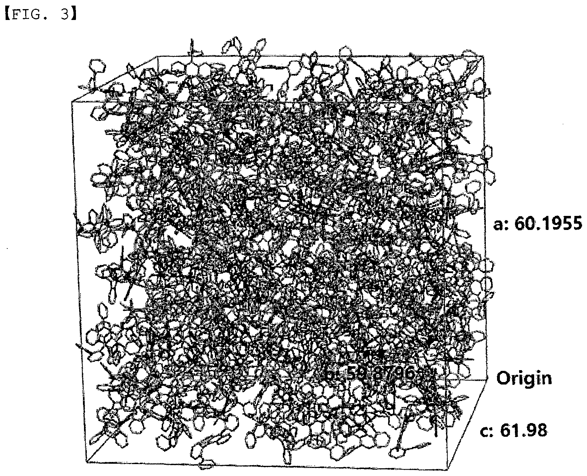

A system including the following Dopant B (dopant) and Compound BH of Example 1 (host) in a weight ratio of 5:95 was obtained. Specifically, 300 molecules (ratio of host 95% and dopant 5%), a temperature of 300K and a simulation time of 3 ns were set using an OPLS3e force field, and through NVT and NPT calculations, an environment of the doped device was computation chemically obtained by calculating molecular dynamics, and the obtained molecular model is shown in FIG. 3.

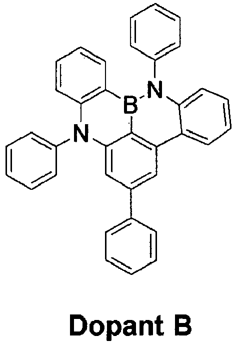

### Comparative Examples 2-1 and 2-2

Molecular systems were calculated in the same manner as in Example 2-1 except that dopants described in the following Table 2 were used instead of Dopant B.

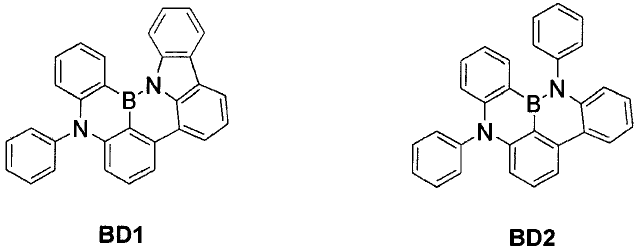

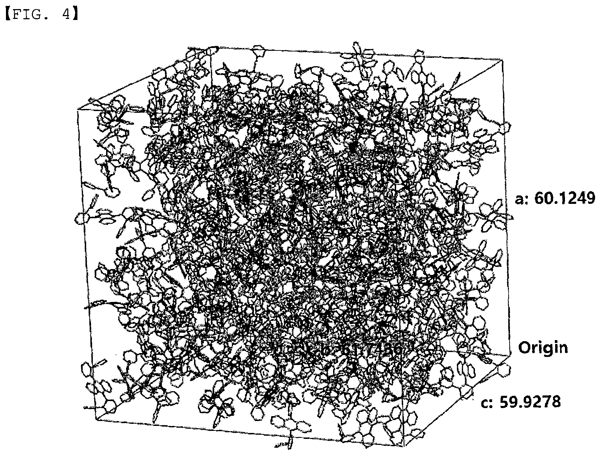

Specifically, FIG. 4 is a diagram illustrating a molecular model obtained by a simulation of a BD1 and BH system of Comparative Example 2-1.

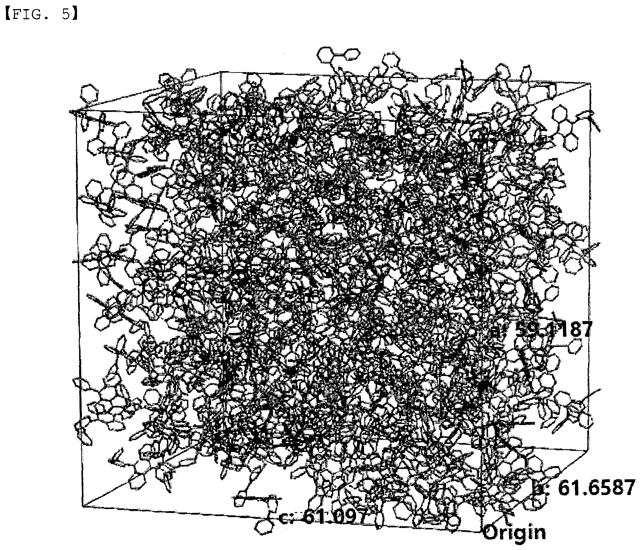

FIG. 5 is a diagram illustrating a molecular model obtained by a simulation of a BD2 and BH system of Comparative Example 2-2.

Calculated average distance values between the dopant and the host molecules of Example 2-1, and Comparative Examples 2-1 and 2-2 are shown in the following Table 2.

**[Table 2]**

| | Dopant | Average Distance Between Molecules (Å) |
|---|---|---|
| Example 2-1 | Dopant B | 15.71 |
| Comparative Example 2-1 | BD1 | 15.21 |
| Comparative Example 2-2 | BD2 | 15.27 |

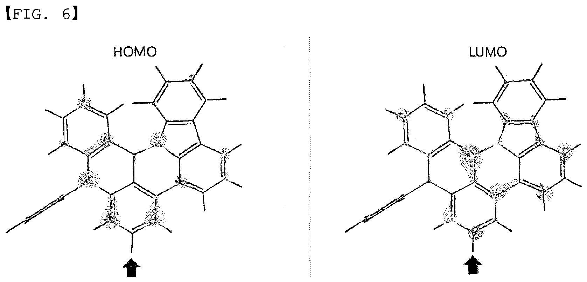

According to Table 2 and FIG. 3 to FIG. 6, it was identified that Dopant B, a compound in which at least one of Z1 to Z3 of Chemical Formula 1 according to one embodiment of the present specification includes a substituent, had a longer distance between the host and the dopant of the light emitting layer compared to BD1, a compound in which Z1 to Z3 are hydrogen, Ar1 is a phenyl group, A1 is benzene, R6 to R8 are hydrogen and Ar2 and R5 form an unsubstituted indole group, and BD2, a compound in which Z1 to Z3 are hydrogen, Ar1 and Ar2 are a phenyl group, A1 is benzene and R5 to R8 are hydrogen. When materials are concentrated in one space, a Dexter transition occurs between dopant and host materials or dopant and dopant materials, and quenching occurs between triplet electrons and singlet electrons. This means that smooth energy transfer does not occur, and an organic light emitting device has decreased efficiency. Specifically, FIG. 6 is a diagram showing orbital distribution of HOMO and LUMO of BD1, and when examining the structure of BD1, it is seen that the HOMO orbital is present abundantly in the lower benzene ring of B (boron) indicated by the arrow, and the LUMO orbital is present abundantly in the B (boron) atom and the lower benzene ring of B (boron) indicated by the arrow, and particularly, the portion corresponding to the para position of B (boron) is an unstable portion. As above, a very unstable portion is present in the lower benzene ring of B (boron) indicated by the arrow affected by both B (boron) and N (nitrogen). Accordingly, by at least one of Z1 to Z3 having a substituent other than hydrogen, Chemical Formula 1 of the present specification is capable of enhancing efficiency of an organic light emitting device by stabilizing the structure with no unstable portion. In addition, this also closely affect a lifetime of an organic light emitting device, and an organic light emitting device using an unstable material such as BD1, a compound in which Z1 to Z3 are hydrogen, Ar1 is a phenyl group, A1 is benzene, R6 to R8 are hydrogen and Ar2 and R5 form an unsubstituted indole group, and BD2, a compound in which Z1 to Z3 are hydrogen, Ar1 and Ar2 are a phenyl group, A1 is benzene and R5 to R8 are hydrogen, has a reduced lifetime. In addition, when a rapidly degraded portion is present much, a driving voltage increases due to the properties of an organic light emitting device dependent on hopping between molecules. However, when a distance between molecules increases and an unstable portion is removed as in the compound of Chemical Formula 1 of the present specification, injection of electrons and holes is reduced suppressing quenching and degradation, and as a result, an organic light emitting device has increased efficiency, an enhanced device lifetime, and a reduced voltage as well.

Accordingly, through the experiments of Experimental Examples 1 and 2, it was identified that the organic light emitting device using the compound of Chemical Formula 1 according to one embodiment of the present specification had properties of low driving voltage, high efficiency and long lifetime.

## Claims

1. A compound represented by the following Chemical Formula 1: 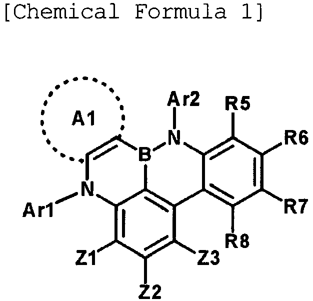 wherein, in Chemical Formula 1,
A1 is one selected from the group consisting of a substituted or unsubstituted aromatic hydrocarbon ring; a substituted or unsubstituted aliphatic hydrocarbon ring; a substituted or unsubstituted heteroring; and a fused ring thereof,
R5 to R8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups among R5 to R8 to form a substituted or unsubstituted ring,
Ar1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to A1 to form one selected from the group consisting an aromatic heteroring, an aliphatic heteroring, and a fused ring thereof, each of which is substituted or unsubstituted and includes one or more selected from N, S, O and Si;
Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R5 to form one selected from the group consisting of an aromatic heteroring, an aliphatic heteroring, and a fused ring thereof, each of which is substituted or unsubstituted and includes one or more selected from N, S, O and Si,
when Ar2 and R5 form a benzoxazine ring, the benzoxazine ring is an unsubstituted benzoxazine ring,
at least one of Z1 to Z3 is deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or adjacent groups among Z1 to Z3 bond to each other to form a substituted or unsubstituted ring, and the rest are hydrogen, and
when Ar1 is a phenyl group, and A1 is substituted or unsubstituted benzene, and R6 to R8 are hydrogen, and adjacent groups among Z1 to Z3 do not bond to each other to form a substituted or unsubstituted ring, and Ar2 and R5 form an indole group at the same time, the indole group is a substituted indole group.

2. The compound of Claim 1, wherein the compound of Chemical Formula 1 is represented by the following Chemical Formula 1-1: 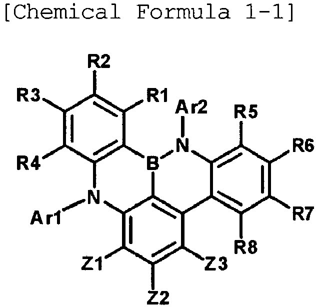 wherein in Chemical Formula 1-1,
R5 to R8, Ar2 and Z1 to Z3 have the same definitions as in Chemical Formula 1,
R1 to R4 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups among R1 to R4 to form one selected from the group consisting of a substituted or unsubstituted aromatic hydrocarbon ring; a substituted or unsubstituted aliphatic hydrocarbon ring; a substituted or unsubstituted heteroring; and a fused ring thereof,
Ar1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R4 to form one selected from the group consisting of an aromatic heteroring, an aliphatic heteroring, and a fused ring thereof, each of which is substituted or unsubstituted and includes one or more selected from N, S, O and Si, and
when Ar1 is a phenyl group, and R1 to R4 and R6 to R8 are hydrogen, and adjacent groups among Z1 to Z3 do not bond to each other to form a substituted or unsubstituted ring, and Ar2 and R5 form an indole group at the same time, the indole group is a substituted indole group.

3. The compound of Claim 1, wherein Chemical Formula 1 is represented by the following Chemical Formula 1-2: 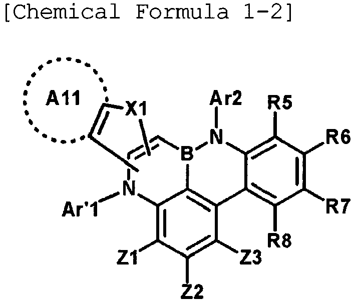 in Chemical Formula 1-2,
R5 to R8, Ar2 and Z1 to Z3 have the same definitions as in Chemical Formula 1,
X1 is CRR', O or S,
A11 is a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
Ar'1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, and
R and R' are the same as or different from each other, and each independently a substituted or unsubstituted alkyl group; a substituted or unsubstituted aryl group; or a substituted or unsubstituted heterocyclic group, or bond to each other to form a substituted or unsubstituted ring.

4. The compound of Claim 2, wherein the compound of Chemical Formula 1-1 is represented by one of the following Chemical Formulae 1-1-1 to 1-1-36: 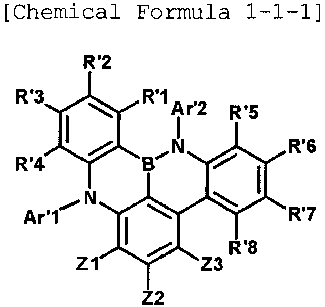 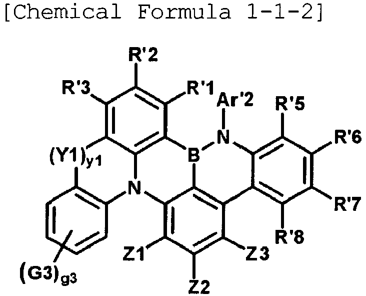 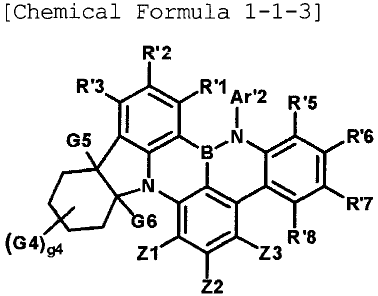 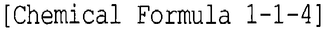 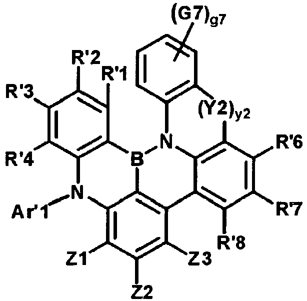 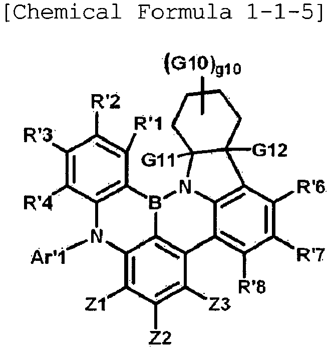 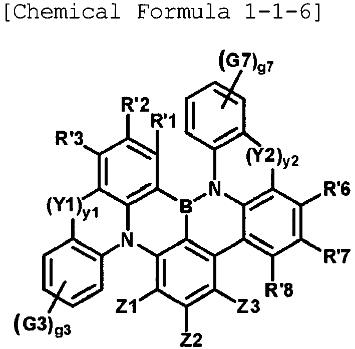 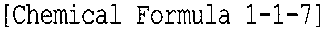 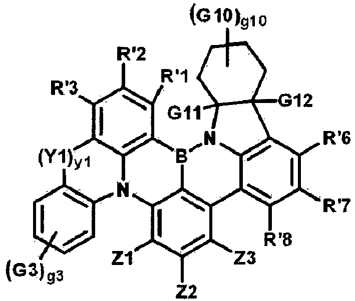 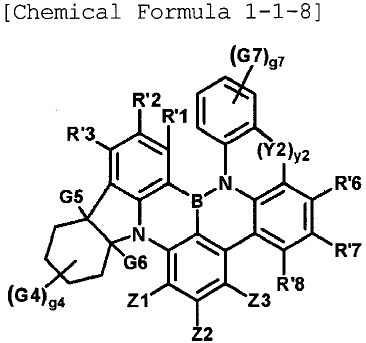 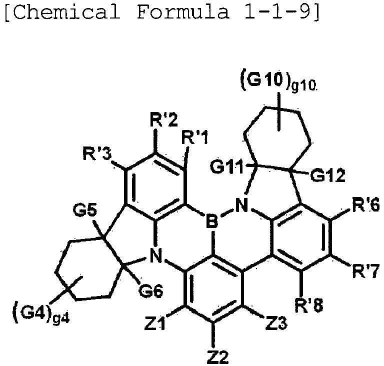 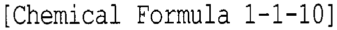 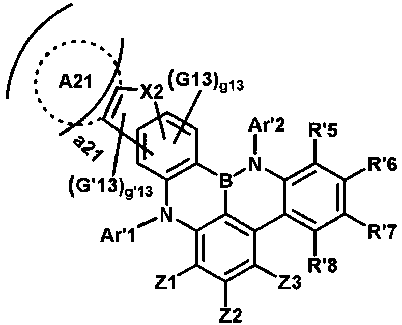 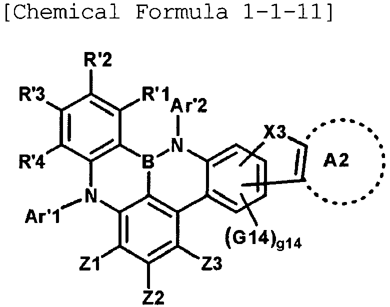 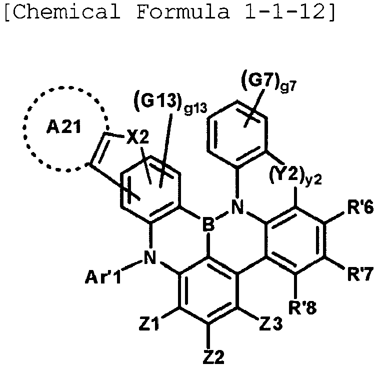 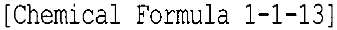 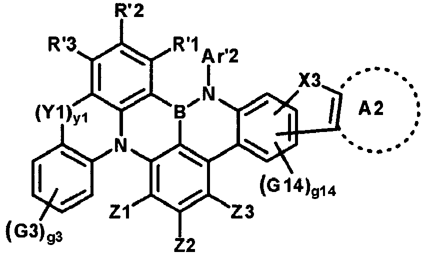 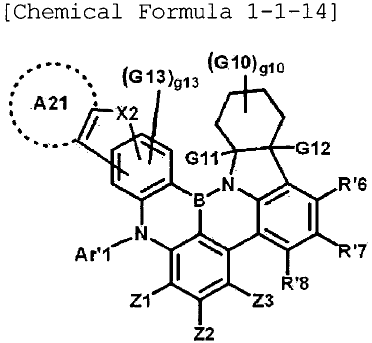 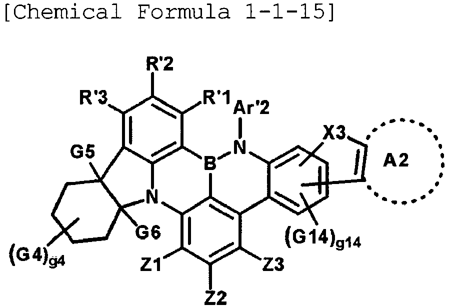 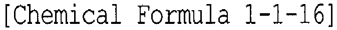 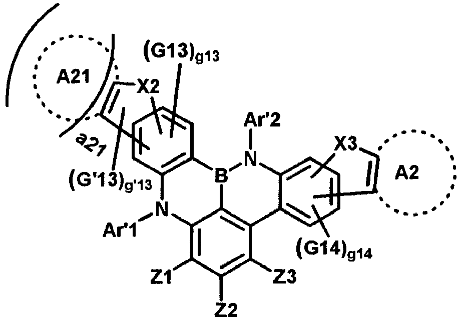 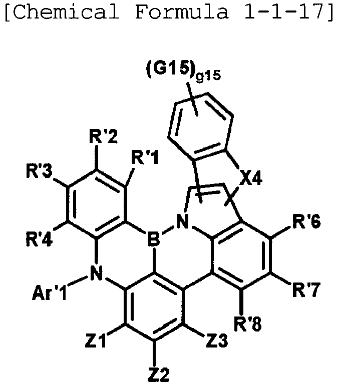 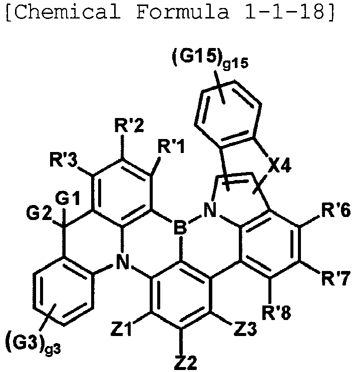 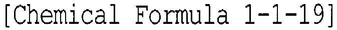 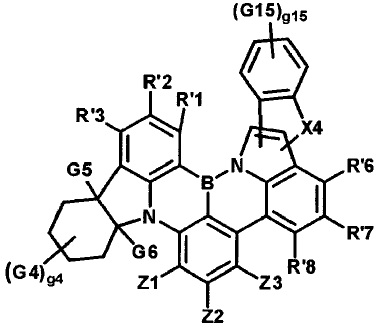 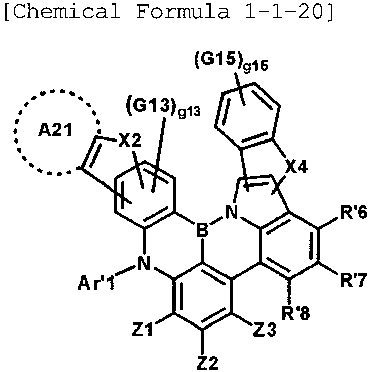 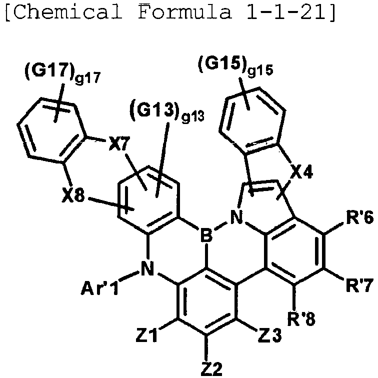 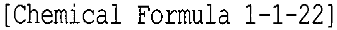 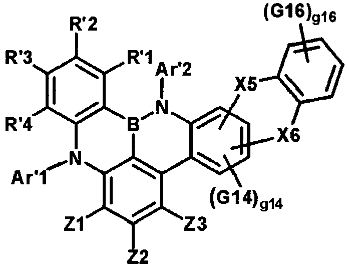 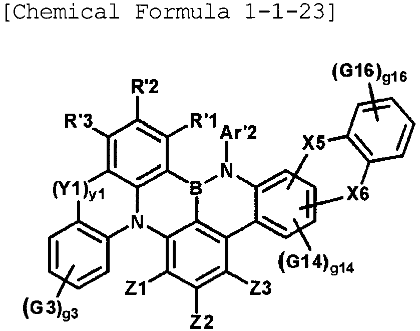 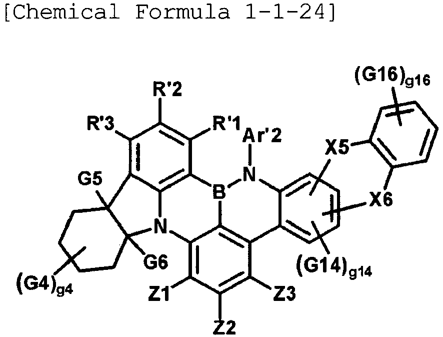 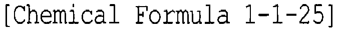 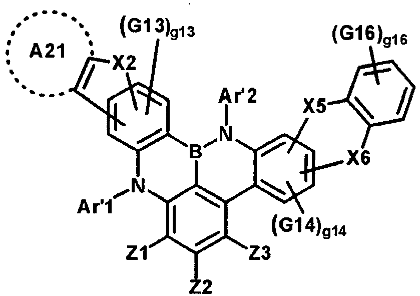 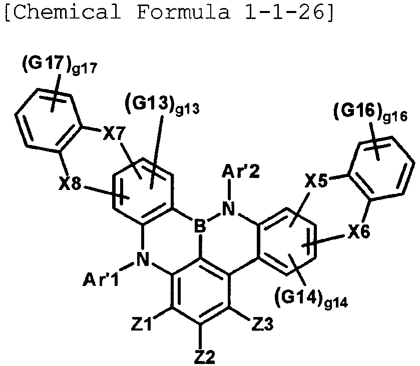 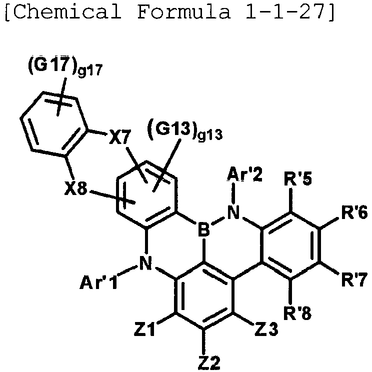 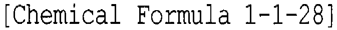 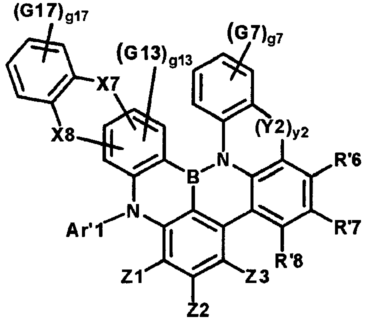 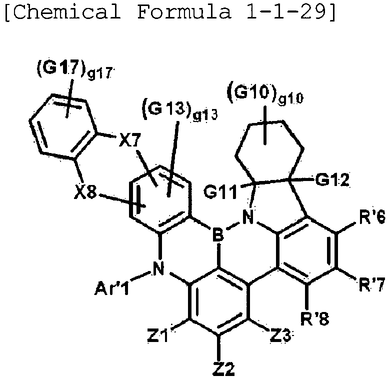 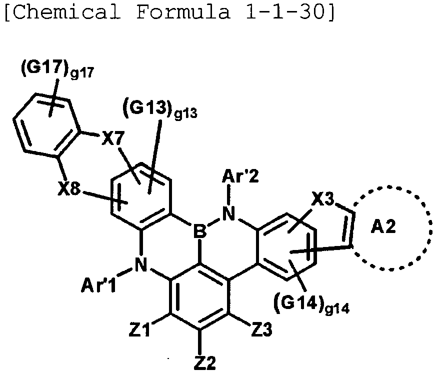 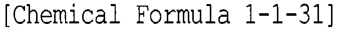 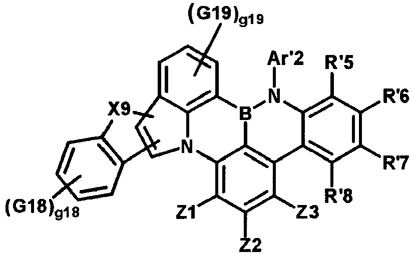 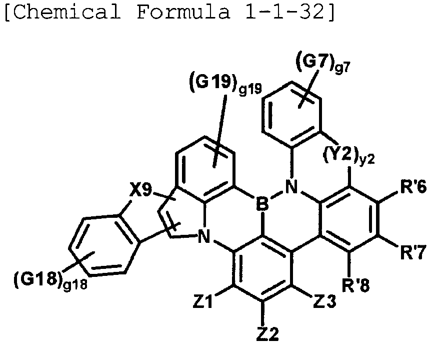 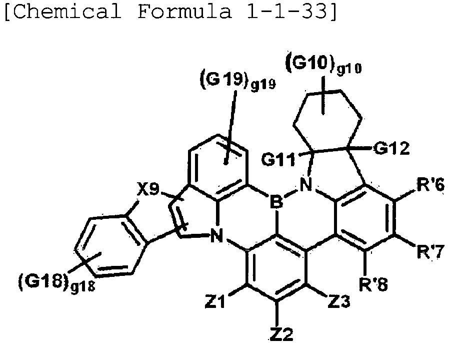 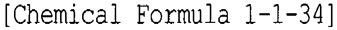 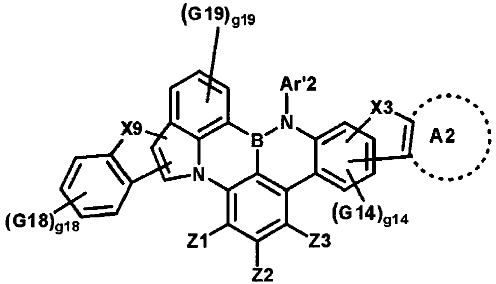 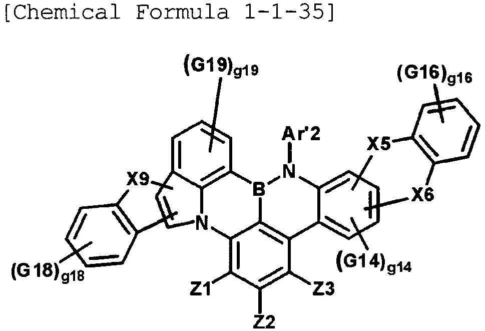 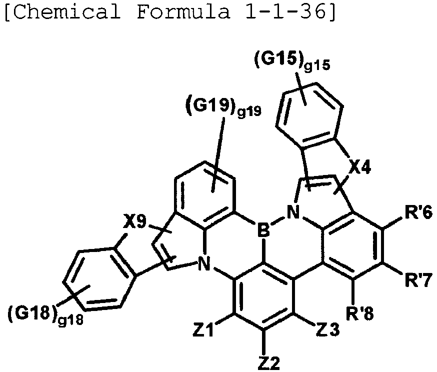 wherein in Chemical Formulae 1-1-1 to 1-1-36,
X2 to X9 are the same as or different from each other, and each independently CRR', NR", O or S,
Y1 and Y2 are the same as or different from each other, and each independently CG1G2, SiG8G9, NG101, O or S,
y1 is 0 or 1, and when y1 is 0, Y1 is a direct bond,
y2 is 0 or 1, and when y2 is 0, Y2 is a direct bond,
R, R' and R" are the same as or different from each other, and each independently a substituted or unsubstituted alkyl group; a substituted or unsubstituted aryl group; or a substituted or unsubstituted heterocyclic group, or bond to each other to form a substituted or unsubstituted ring,
R'1 to R'8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group,
G1 to G19, G'13 and G101 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or adjacent groups bond to each other to form a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
g3, g7, and g15 to g18 are each an integer of 1 to 4,
g4 and g10 are each an integer of 1 to 8,
g13 and g14 are each 1 or 2,
g'13 is an integer of 0 to 2,
g19 is an integer of 1 to 3,
a21 is 0 or 1,
when g3, g4, g7, g10, and g15 to g19 are each 2 or greater, substituents in the two or more parentheses are the same as or different from each other,
when g13, g'13 and g14 are each 2, substituents in the two parentheses are the same as or different from each other,
Ar'1 and Ar'2 are the same as or different from each other, and each independently a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group,
A2 and A21 are the same as or different from each other, and each independently a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
at least one of Z1 to Z3 is deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to adjacent groups to form a substituted or unsubstituted ring, and the rest are hydrogen, and
wherein in Chemical Formulae 1-1-4, 1-1-6, 1-1-8, 1-1-12, 1-1-28 and 1-1-32,
when y2 is 1 and Y2 is O, G7 and R'6 to R'8 are hydrogen.

5. The compound of Claim 3, wherein the compound of Chemical Formula 1-2 is represented by one of the following Chemical Formulae 1-2-1 to 1-2-6: 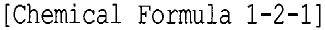 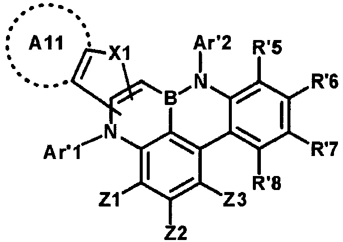 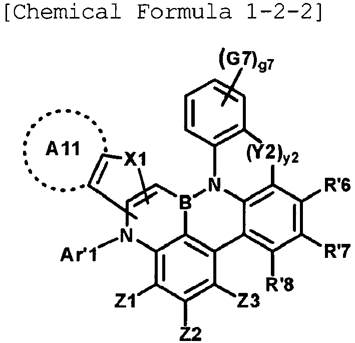 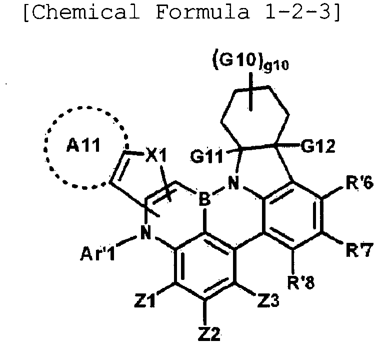 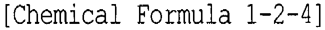 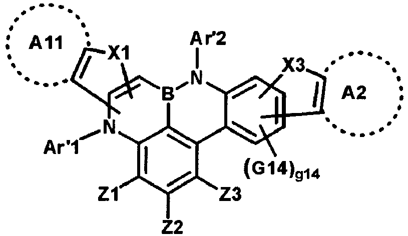 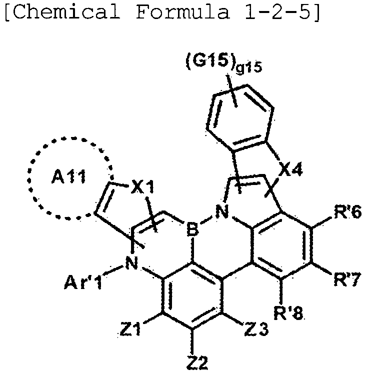 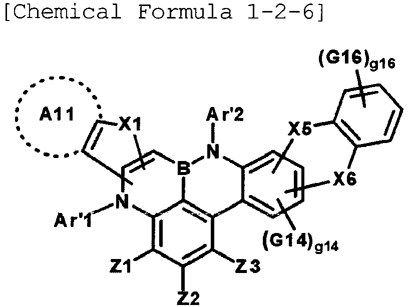 wherein in Chemical Formulae 1-2-1 to 1-2-6,
X1, A11 and Z1 to Z3 have the same definitions as in Chemical Formula 1-2,
X3 to X6 are the same as or different from each other, and each independently CRR', NR", 0 or S,
Y2 is CG1G2, SiG8G9, NG101, 0 or S,
y2 is 0 or 1, and when y2 is 0, Y2 is a direct bond,
A2 is a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
Ar'1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group,
R, R' and R" are the same as or different from each other, and each independently a substituted or unsubstituted alkyl group; a substituted or unsubstituted aryl group; or a substituted or unsubstituted heterocyclic group, or bond to each other to form a substituted or unsubstituted ring,
R'5 to R'8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group,
G1, G2, G7 to G12, G14, G15, G16 and G101 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or adjacent groups bond to each other to form a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
g7, g15 and g16 are each an integer of 1 to 4,
g10 is an integer of 1 to 8,
g14 is 1 or 2,
when g7, g10, g15 and g16 are each 2 or greater, substituents in the two or more parentheses are the same as or different from each other,
when g14 is 2, substituents in the two parentheses are the same as or different from each other,
Ar'1 and Ar'2 are the same as or different from each other, and each independently a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, and
wherein in Chemical Formula 1-2-2,
when y2 is 1 and Y2 is O, G7 and R'6 to R'8 are hydrogen.

6. The compound of Claim 1, wherein the compound of Chemical Formula 1 is represented by one of the following Chemical Formulae 1-3 to 1-5: 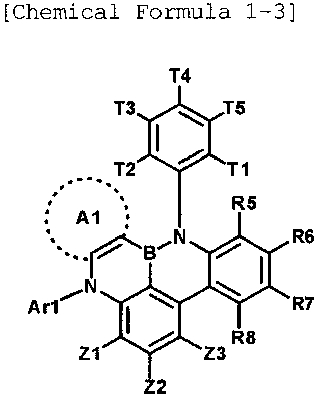 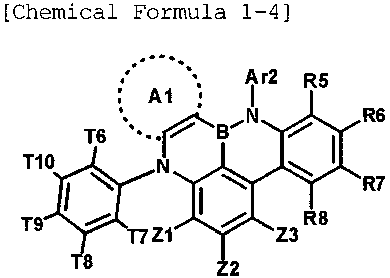 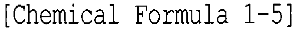 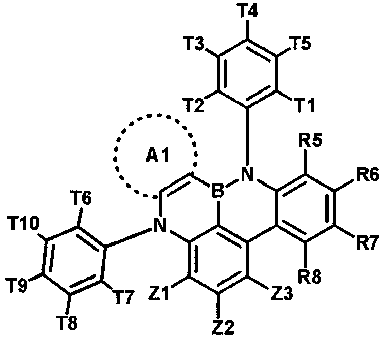 in Chemical Formulae 1-3 to 1-5,
Ar1, Ar2, A1, R5 to R8 and Z1 to Z3 have the same definitions as in Chemical Formula 1,
T1 to T10 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring,
at least one of T1 and T2 is a substituted or unsubstituted alkyl group; a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, and
at least one of T6 and T7 is a substituted or unsubstituted alkyl group; a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group.

7. The compound of Claim 1, wherein adjacent groups among Z1 to Z3 bond to each other to form a ring represented by the following Chemical Formula C-1 or C-2: 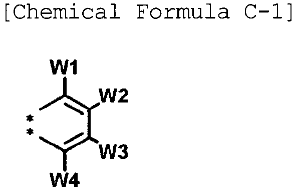 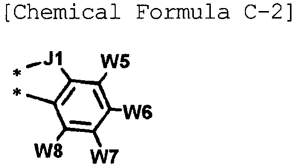 wherein in Chemical Formulae C-1 and C-2,
J1 is O, S, NQ7, CQ8Q9 or SiQ10Q11,
W1 to W8 and Q7 to Q11 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring, and
* is a site bonding to Chemical Formula 1.

8. The compound of Claim 1, wherein A1 is a monocyclic or polycyclic aromatic hydrocarbon ring having 6 to 30 carbon atoms unsubstituted or substituted with a linear or branched alkyl group having 1 to 30 carbon atoms, a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms, a monocyclic or polycyclic aryl group having 6 to 30 carbon atoms, or NQ1Q2; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms or a monocyclic or polycyclic aryl group having 6 to 30 carbon atoms,
Q1 and Q2 are the same as or different from each other, and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms,
R5 to R8 are the same as or different from each other, and each independently hydrogen; deuterium; a linear or branched alkyl group having 1 to 30 carbon atoms; a monocyclic or polycyclic aryl group having 6 to 30 carbon atoms; or NQ3Q4, or bond to adjacent groups to form a monocyclic or polycyclic aliphatic hydrocarbon ring having 3 to 30 carbon atoms unsubstituted or substituted with a linear or branched alkyl group having 1 to 30 carbon atoms; a monocyclic or polycyclic aromatic hydrocarbon ring having 6 to 30 carbon atoms unsubstituted or substituted with a linear or branched alkyl group having 1 to 30 carbon atoms, or a monocyclic or polycyclic diarylamine group having 6 to 30 carbon atoms unsubstituted or substituted with a linear or branched alkyl group having 1 to 30 carbon atoms; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms, a monocyclic or polycyclic aryl group having 6 to 30 carbon atoms, or a monocyclic or polycyclic diarylamine group having 6 to 30 carbon atoms unsubstituted or substituted with a linear or branched alkyl group having 1 to 30 carbon atoms,
Q3 and Q4 are the same as or different from each other, and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms,
Ar1 is a monocyclic or polycyclic aryl group having 6 to 30 carbon atoms unsubstituted or substituted with one or more selected from the group consisting of a linear or branched alkyl group having 1 to 30 carbon atoms, a monocyclic or polycyclic aryl group having 6 to 30 carbon atoms, and a combination thereof; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or bonds to A1 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof, each of which is unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms and includes one or more selected from N, S, O and Si,
Ar2 is a monocyclic or polycyclic aryl group having 6 to 30 carbon atoms unsubstituted or substituted with one or more selected from the group consisting of a linear or branched alkyl group having 1 to 30 carbon atoms, a monocyclic or polycyclic aryl group having 6 to 30 carbon atoms, and a combination thereof; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or bonds to R5 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms and including one or more selected from N, S, O and Si,
at least one of Z1 to Z3 is deuterium; a linear or branched alkyl group having 1 to 30 carbon atoms; a monocyclic or polycyclic cycloalkyl group having 3 to 30 carbon atoms; a monocyclic or polycyclic aryl group having 6 to 30 carbon atoms unsubstituted or substituted with deuterium, or a linear or branched alkyl group having 1 to 30 carbon atoms; or NQ5Q6, or bonds to adjacent groups to form a monocyclic or polycyclic aromatic hydrocarbon ring having 6 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with one or more substituents selected from among a linear or branched alkyl group having 1 to 30 carbon atoms, a monocyclic or polycyclic aryl group having 6 to 30 carbon atoms, a fused ring group of an aromatic hydrocarbon ring and an aliphatic hydrocarbon ring, and a combination thereof, and the rest are hydrogen,
Q5 and Q6 are the same as or different from each other, and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms,
when Ar2 and R5 form a benzoxazine ring, the benzoxazine ring is an unsubstituted benzoxazine ring, and
when Ar1 is a phenyl group, and A1 is substituted or unsubstituted benzene, and R6 to R8 are hydrogen, and adjacent groups among Z1 to Z3 do not bond to each other to form a substituted or unsubstituted ring, and Ar2 and R5 form an indole group at the same time, the indole group is a substituted indole group.

9. The compound of Claim 1, wherein the compound of Chemical Formula 1 is one selected from the following compounds: 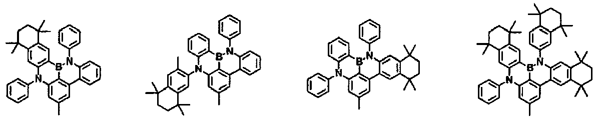 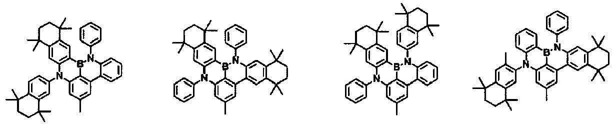 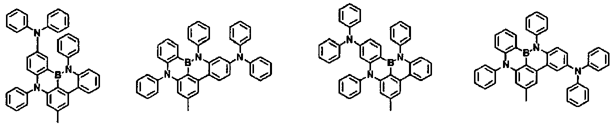 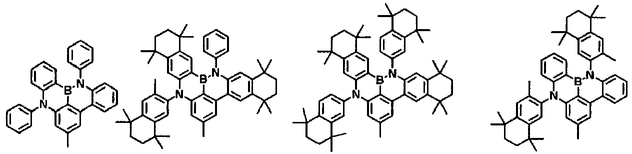 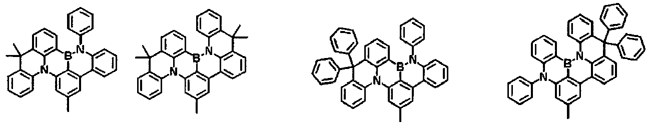 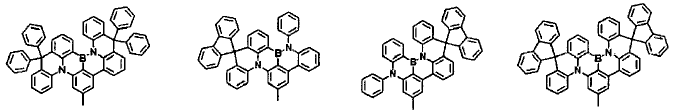 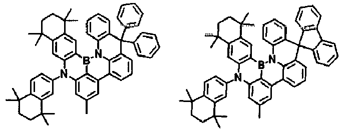 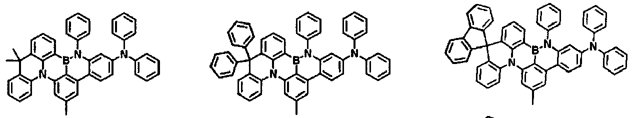 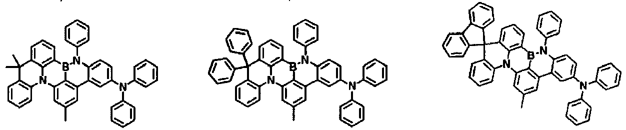 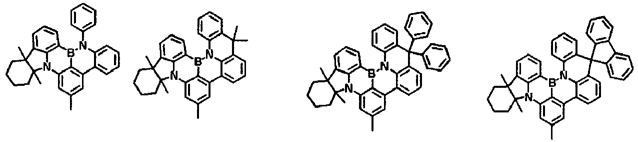 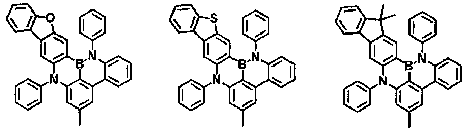 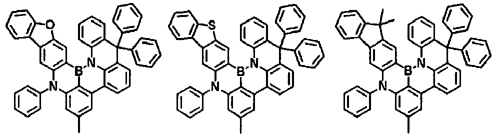 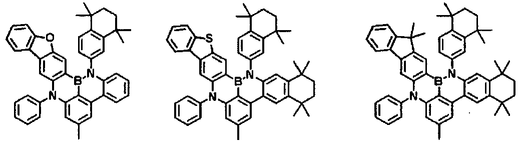 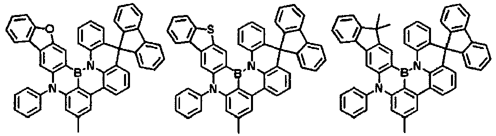 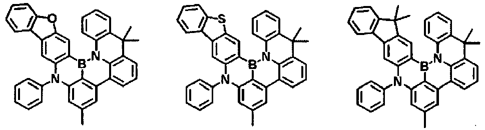 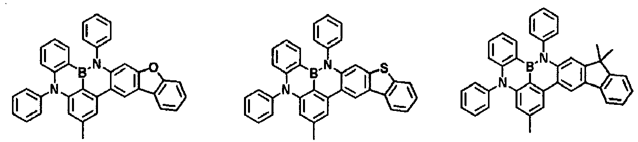 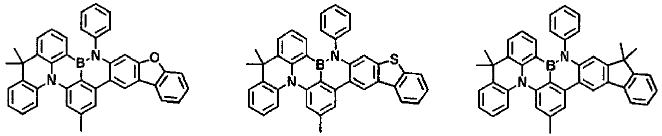 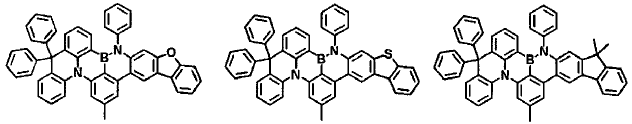 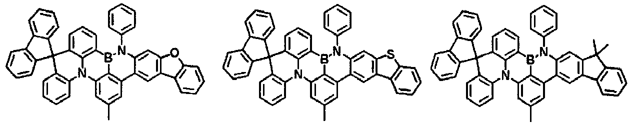 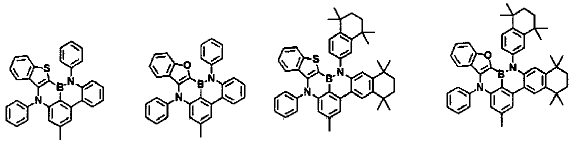 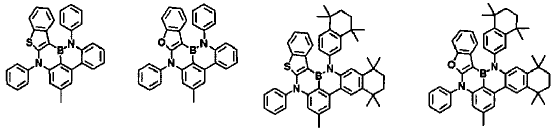 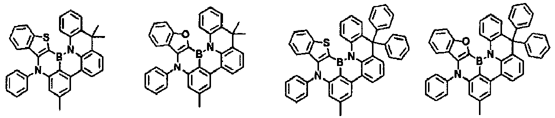 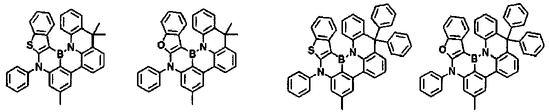 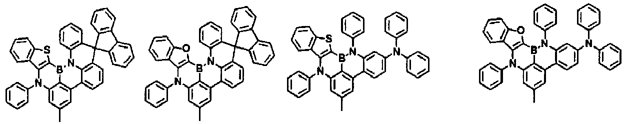 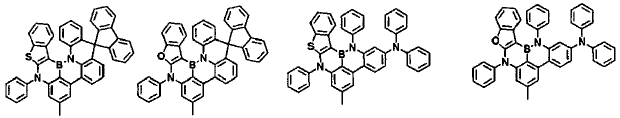 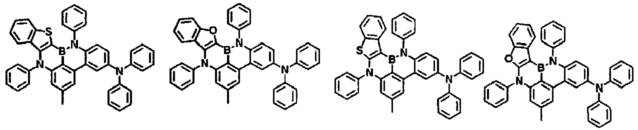 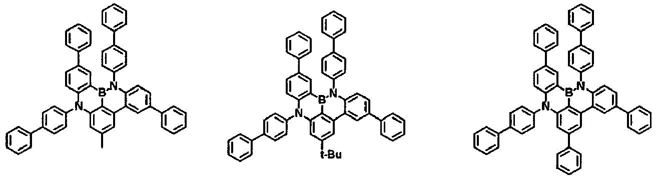 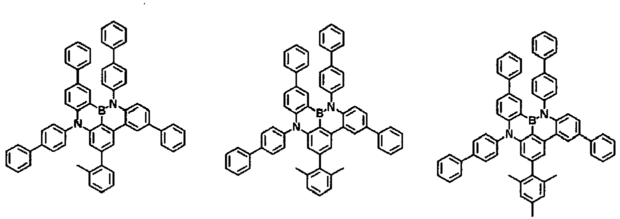 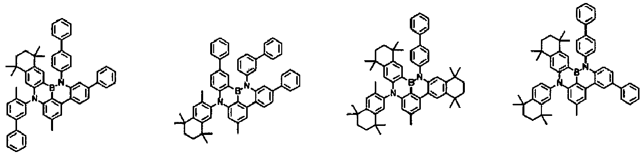 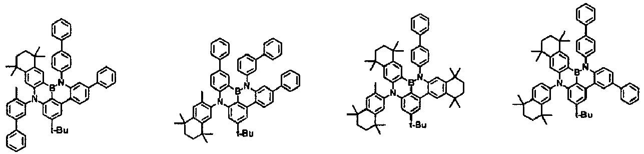 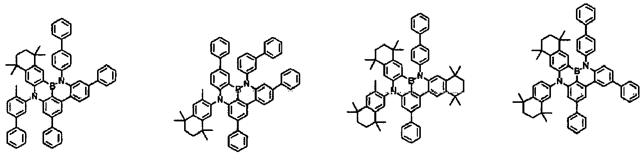 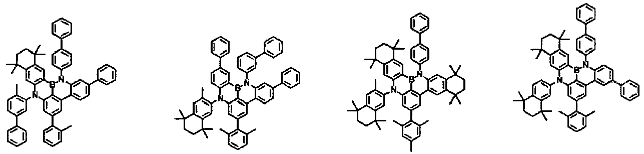 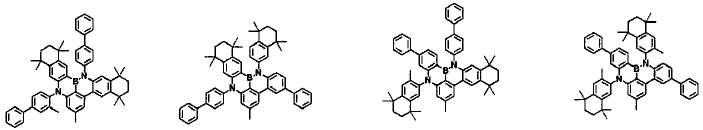 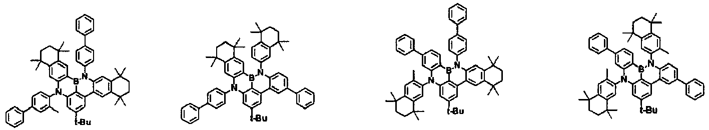 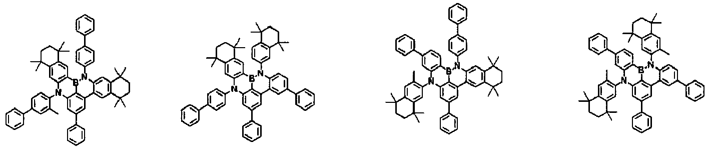 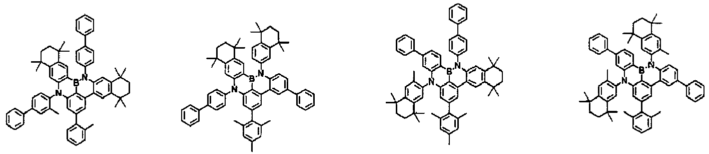 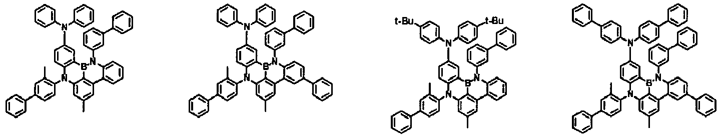 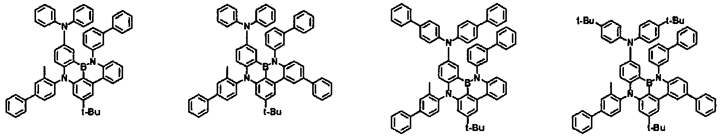 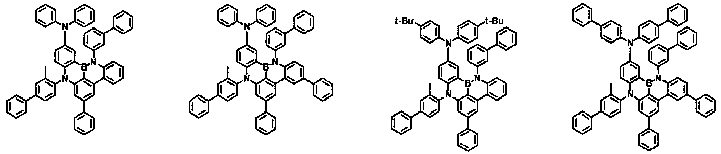 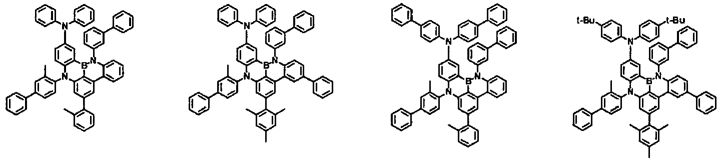 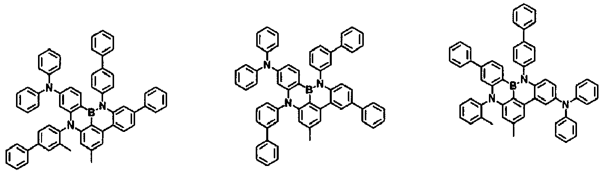 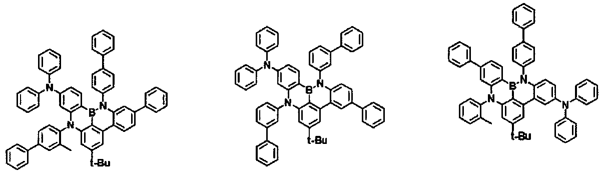 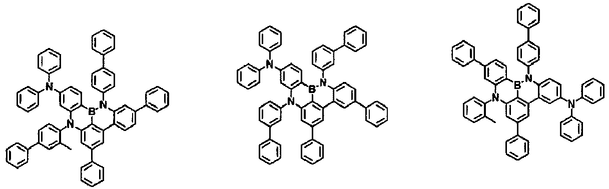 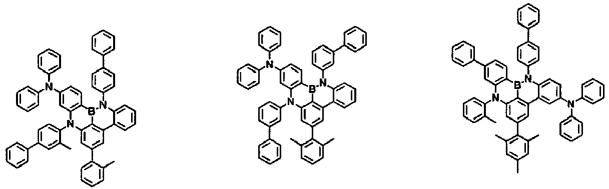 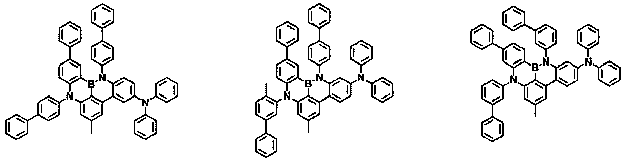 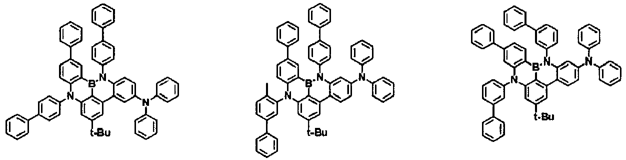 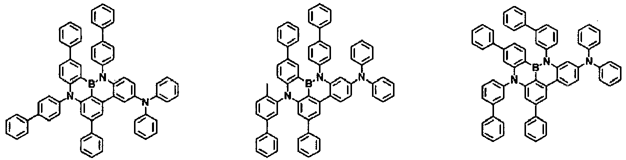 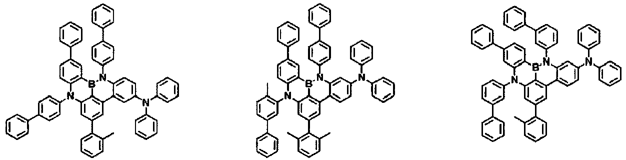 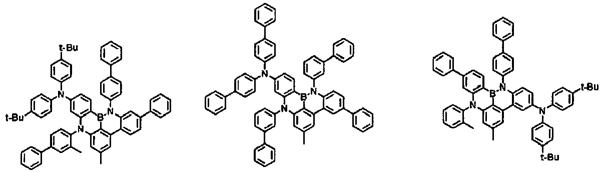 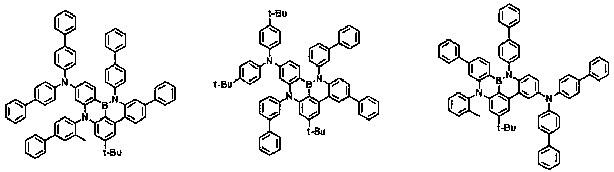 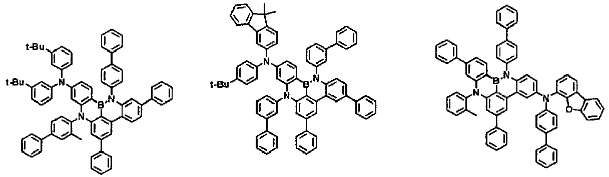 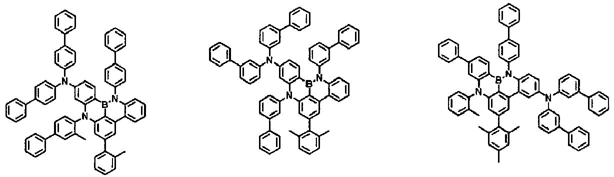 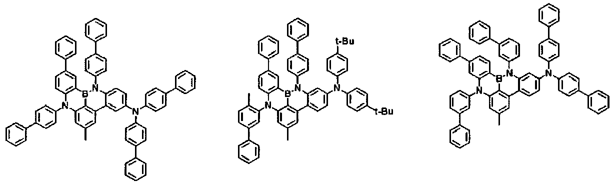 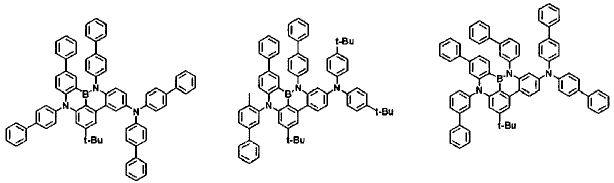 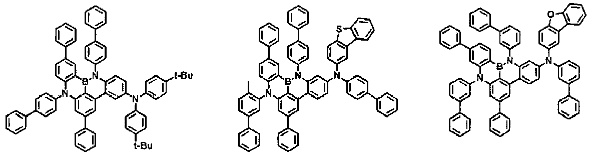 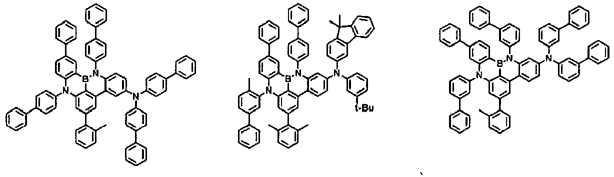 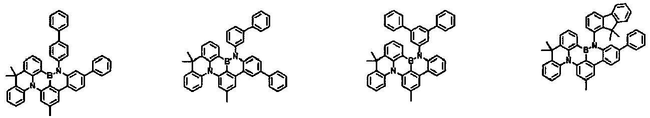 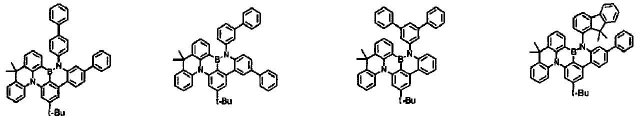 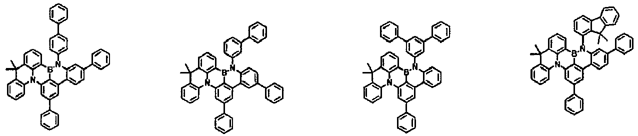 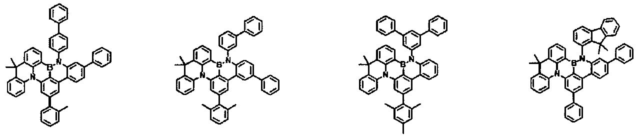 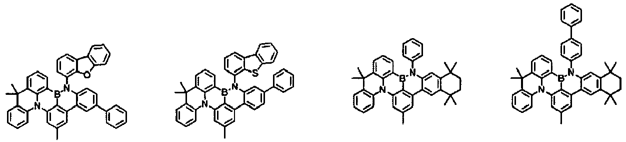 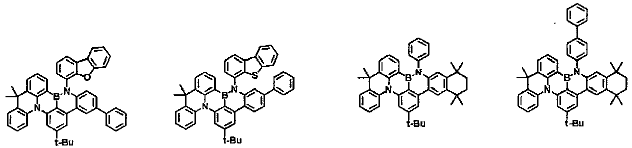 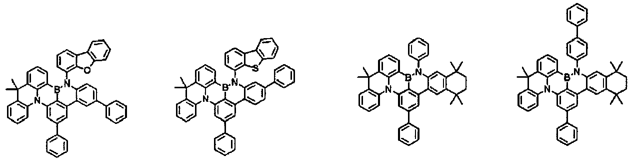 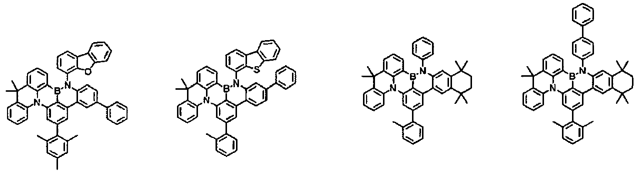 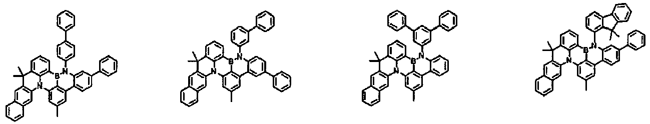 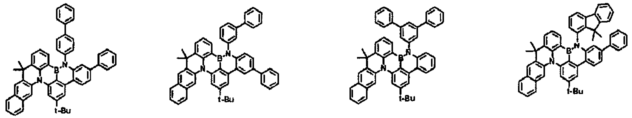 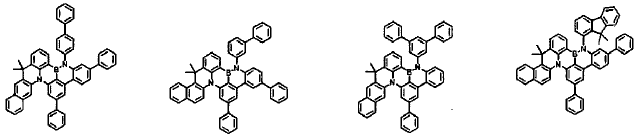 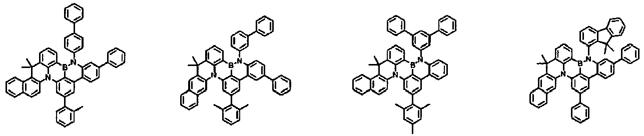 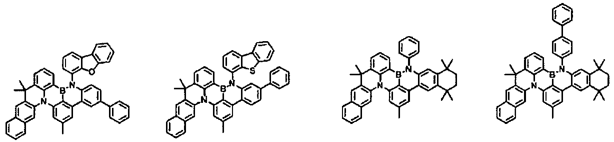 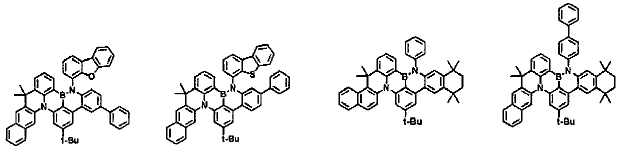 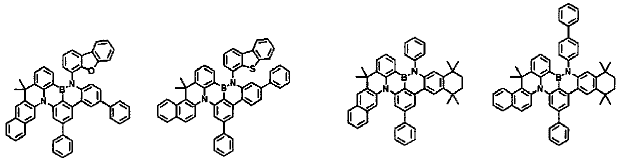 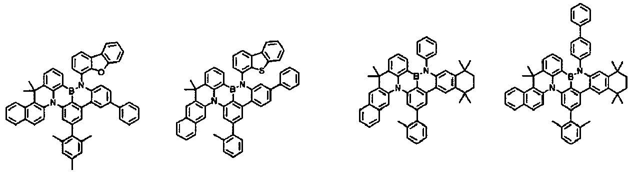 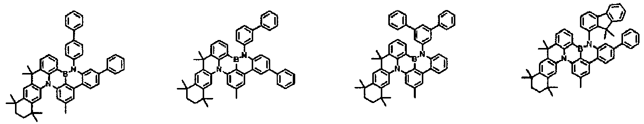 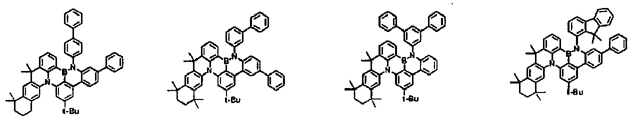 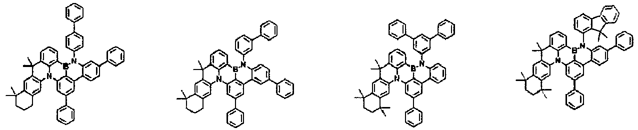 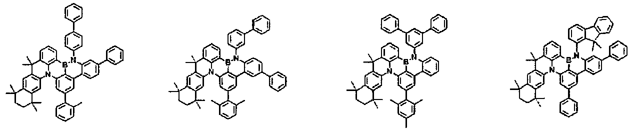 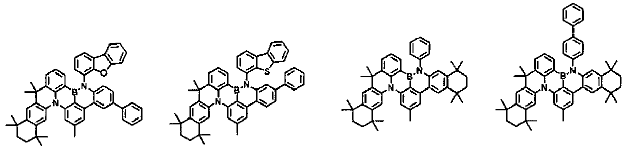 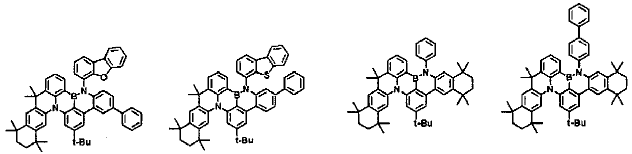 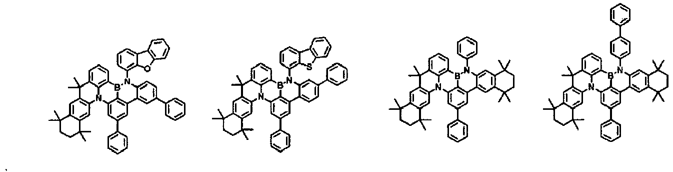 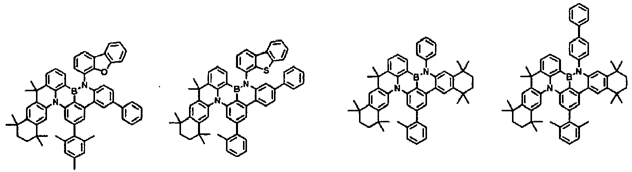 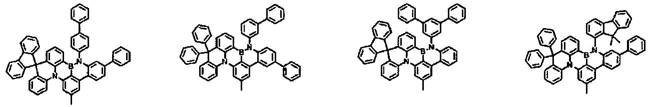 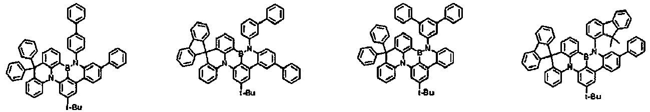 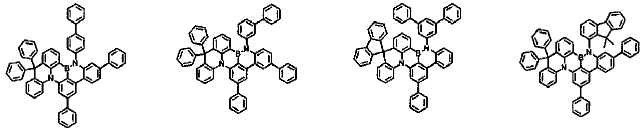 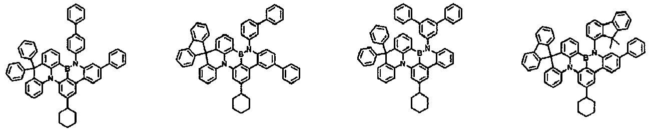 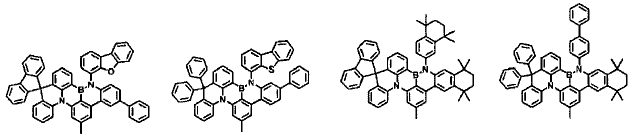 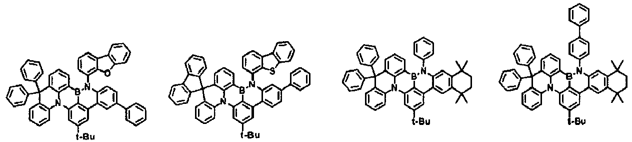 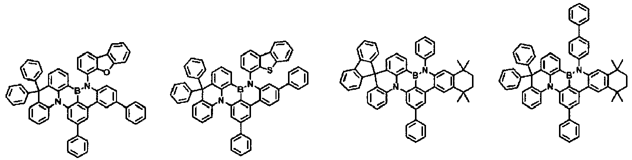 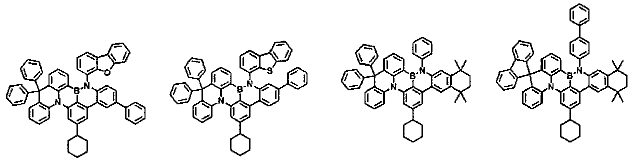 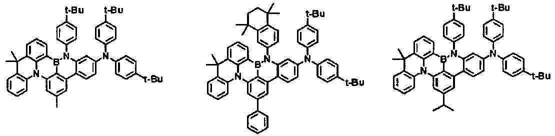 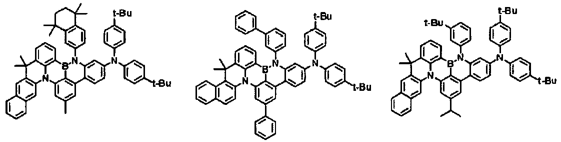 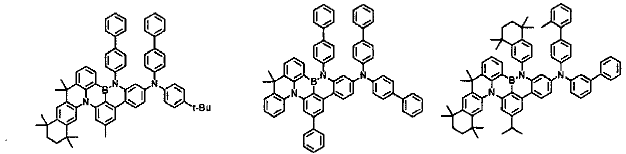 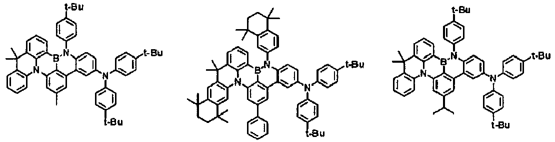 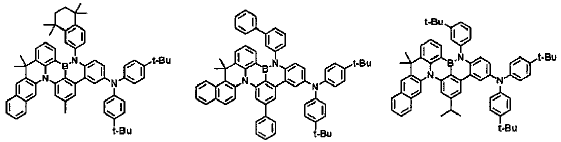 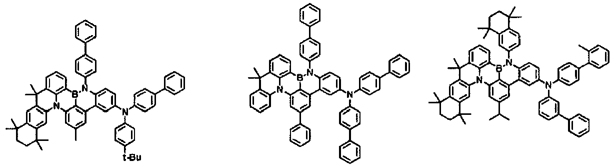 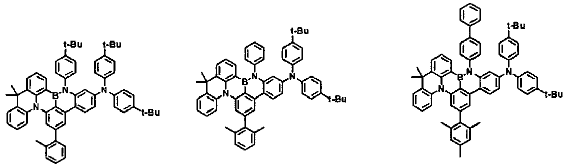 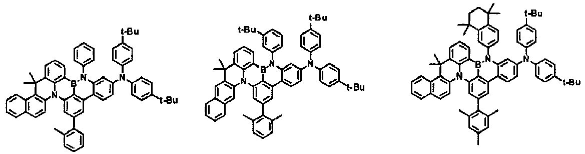 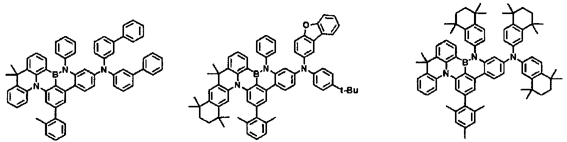 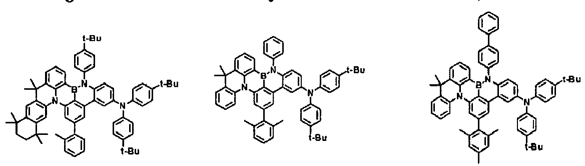 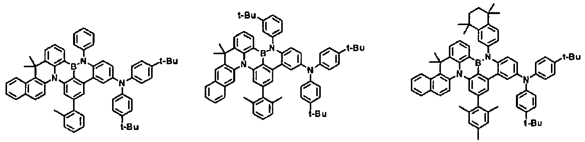 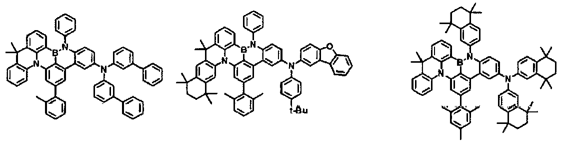 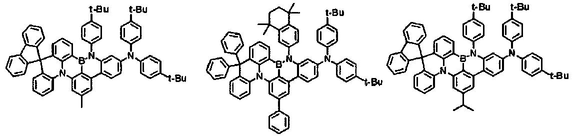 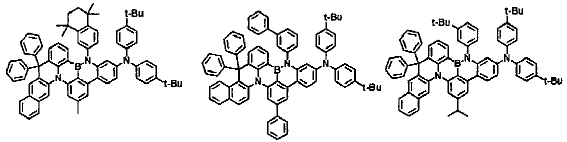 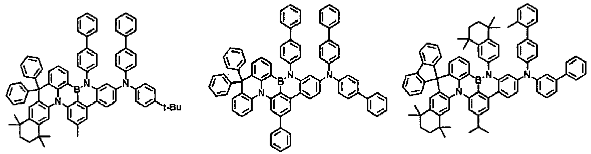 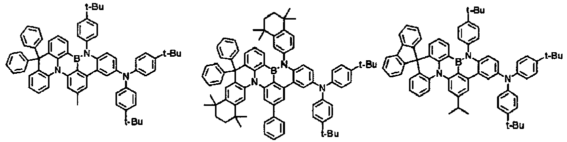 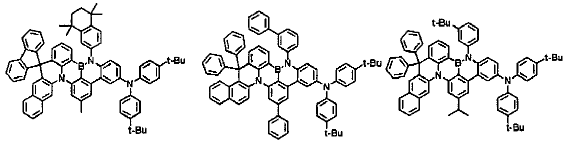 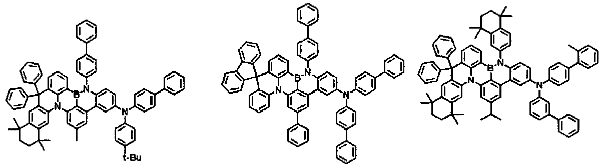 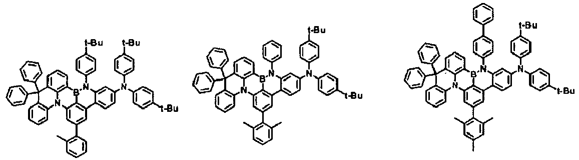 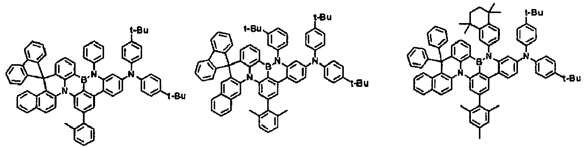 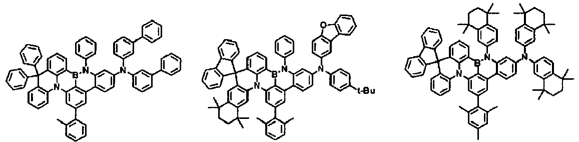 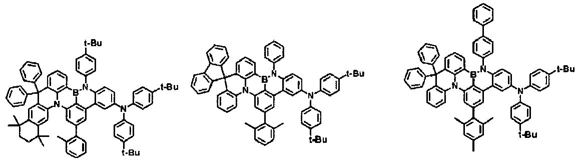 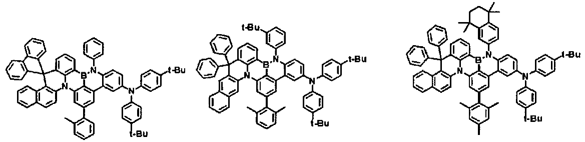 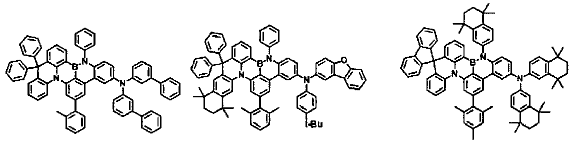 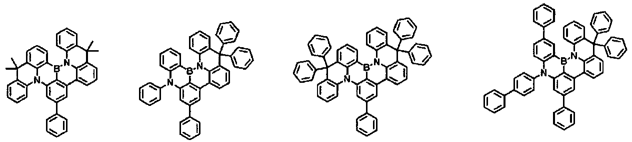 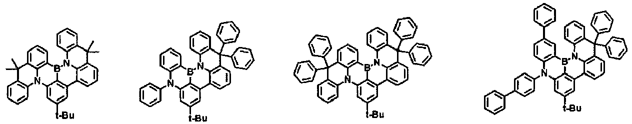 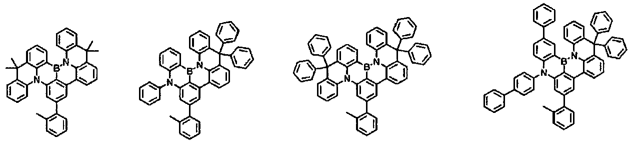 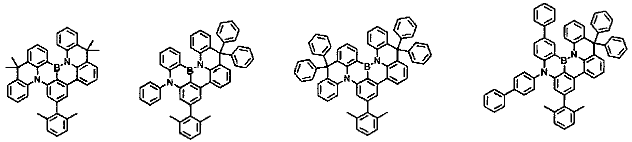 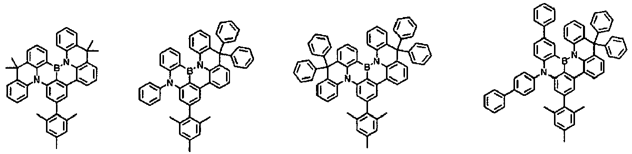 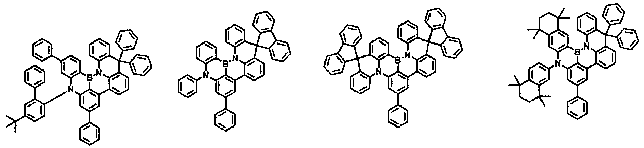 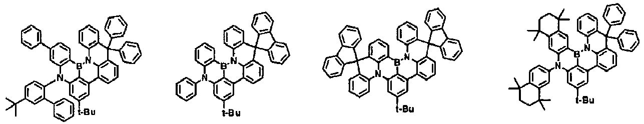 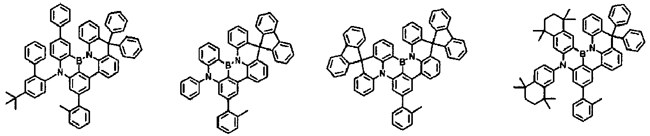 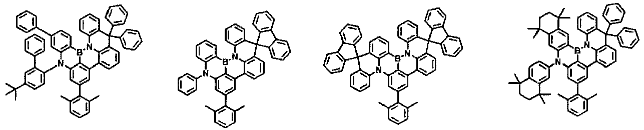 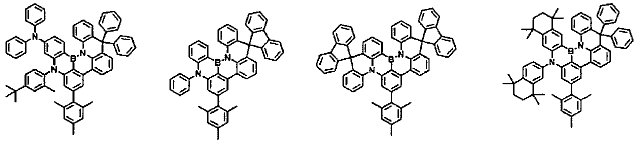 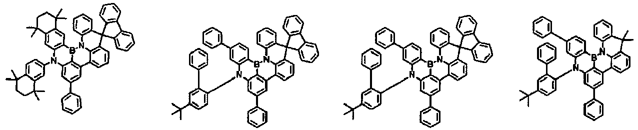 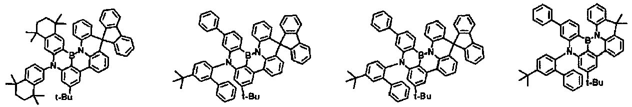 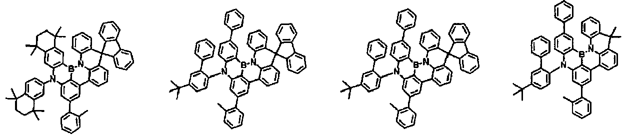 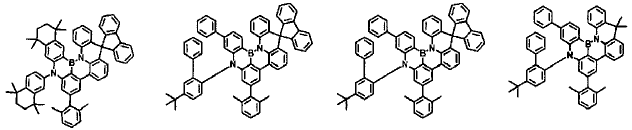 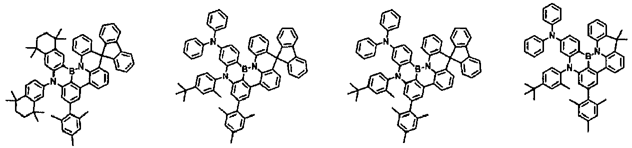 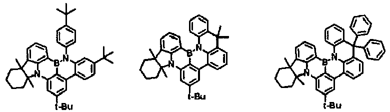 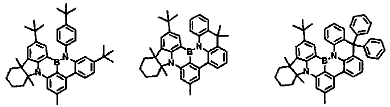 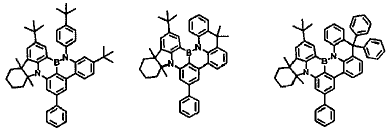 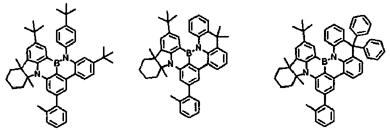 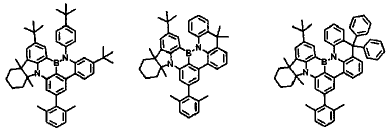 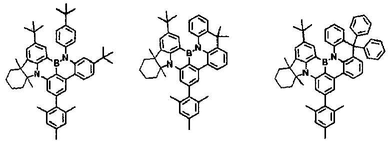 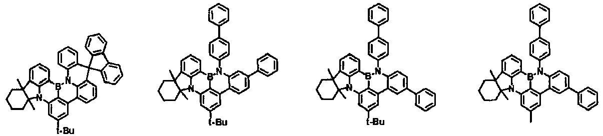 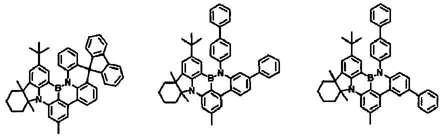 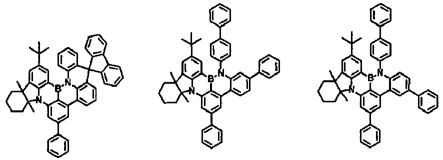 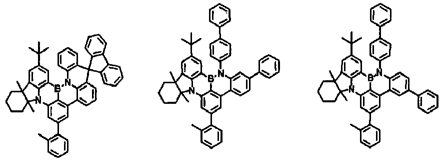 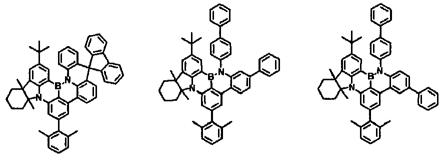 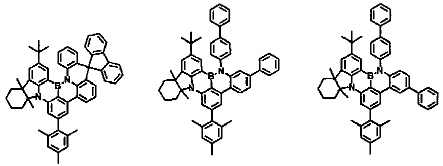 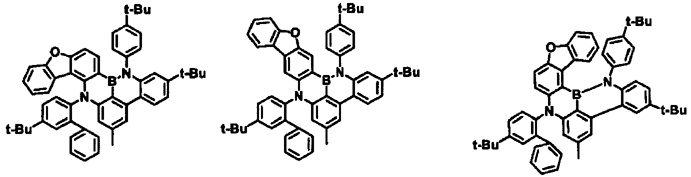 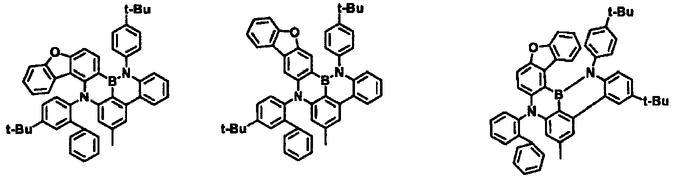 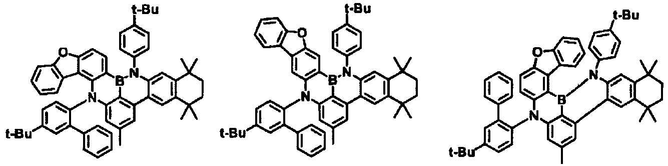 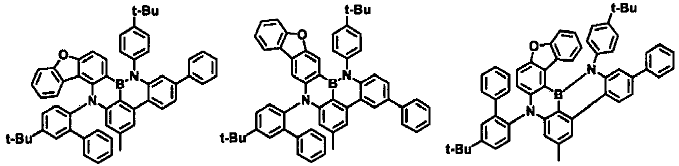 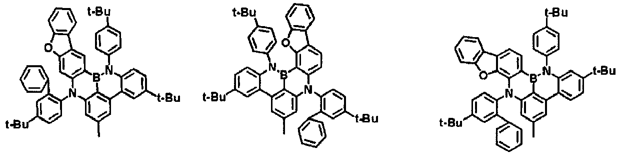 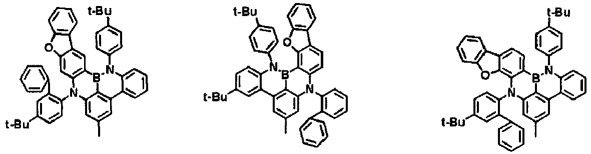 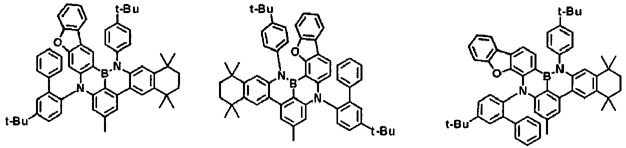 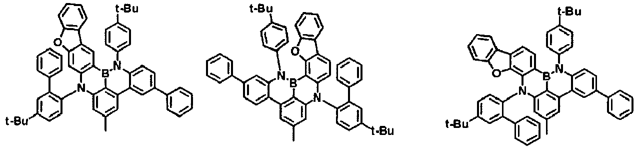 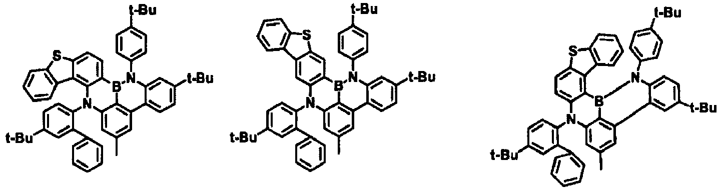 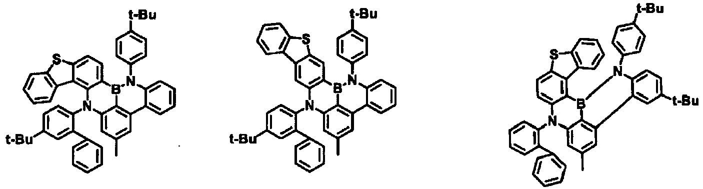 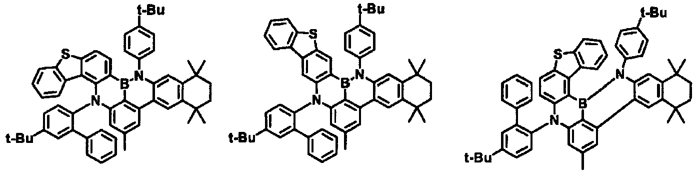 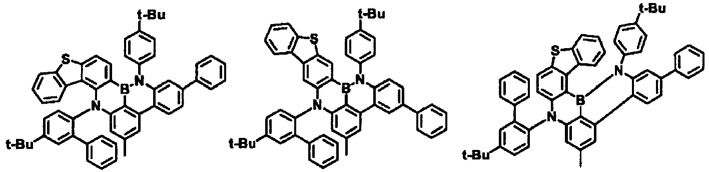 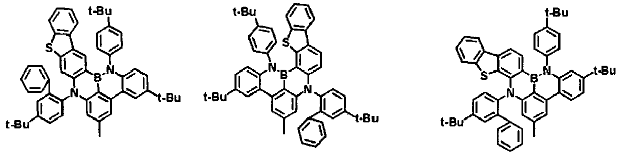 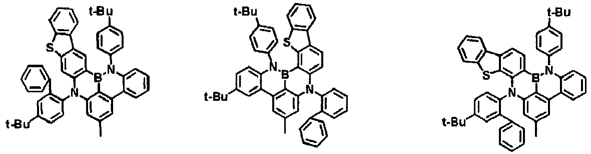 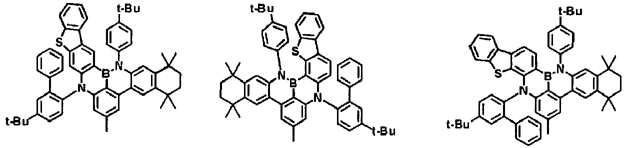 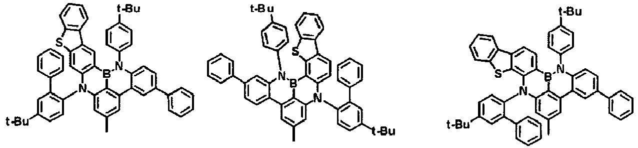 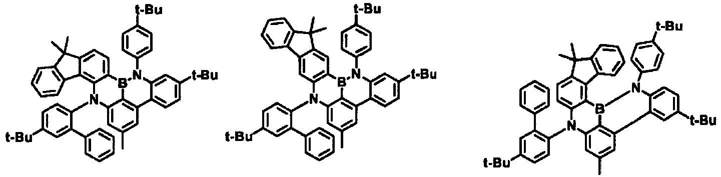 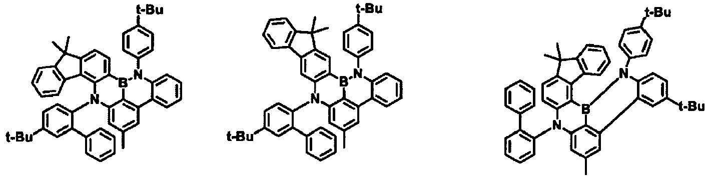 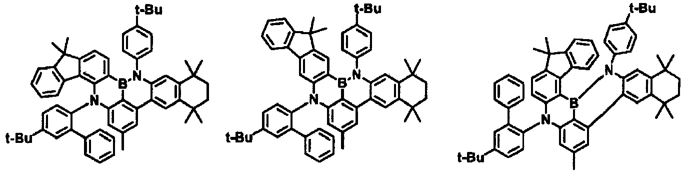 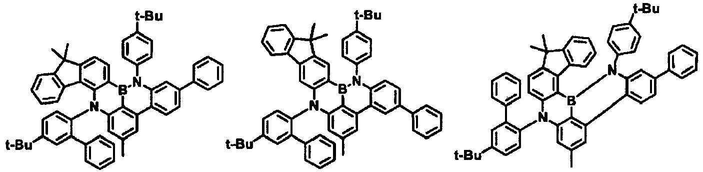 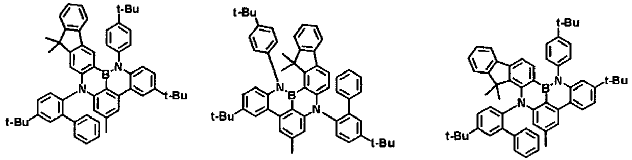 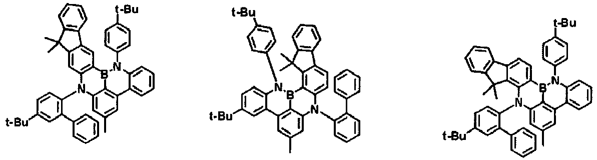 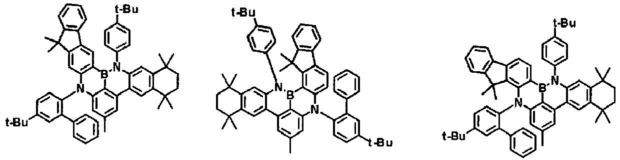 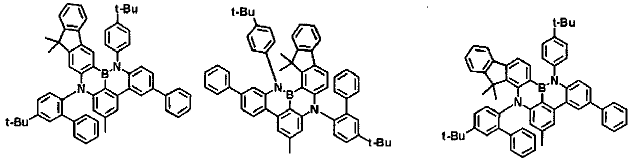 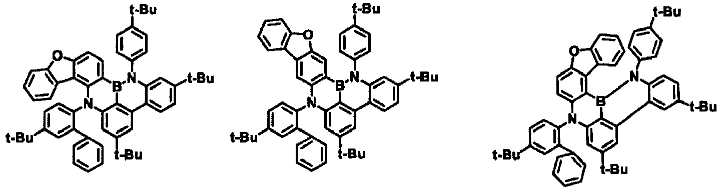 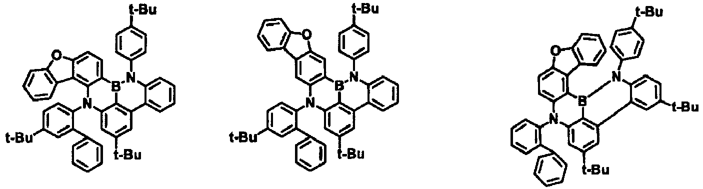 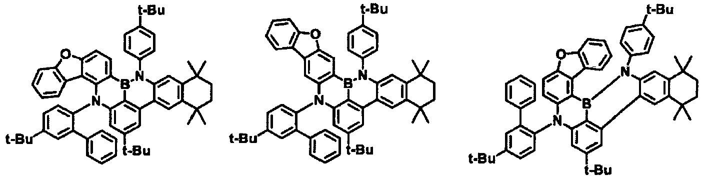 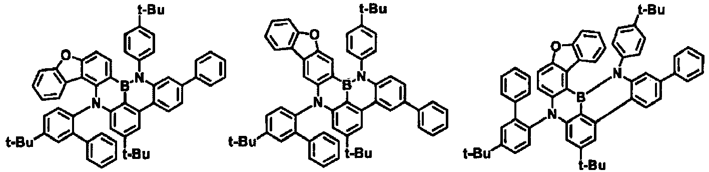 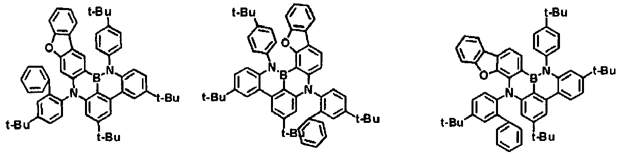 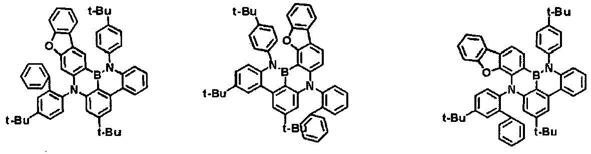 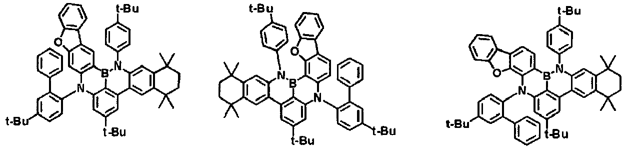 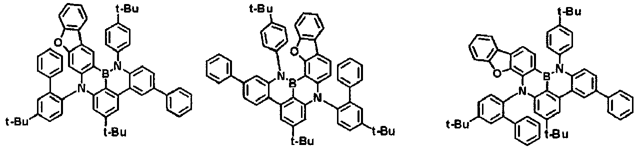 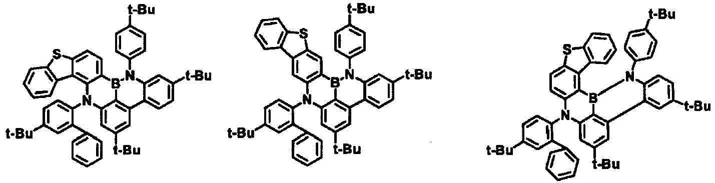 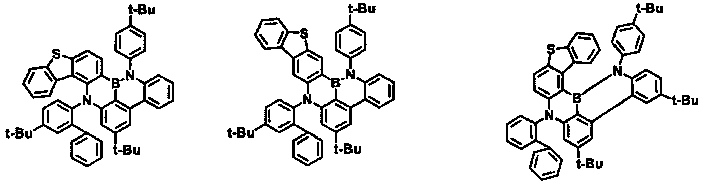 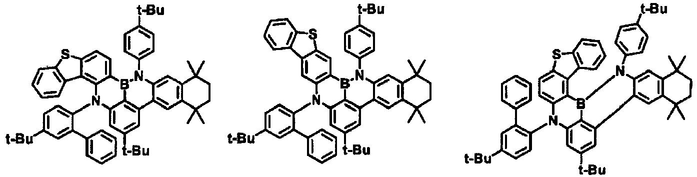 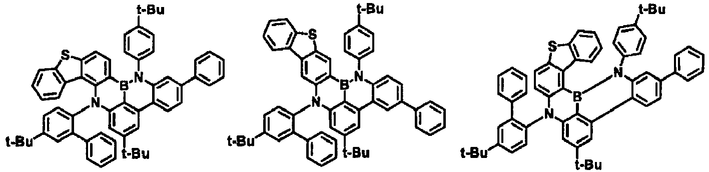 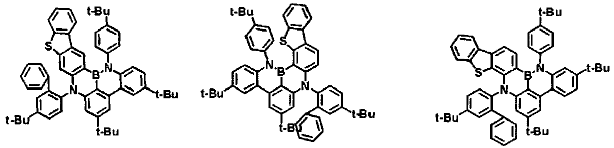 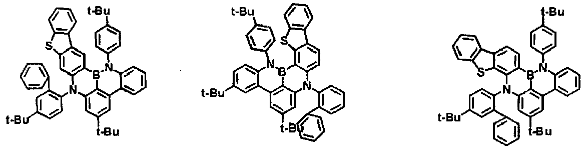 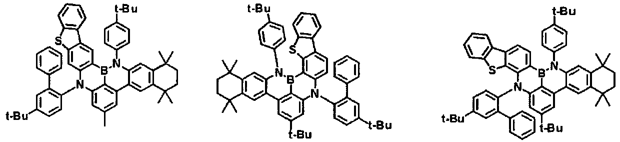 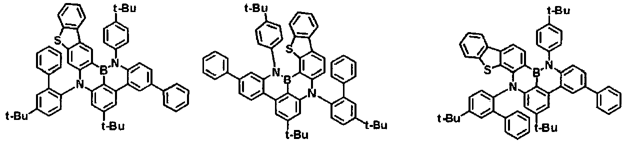 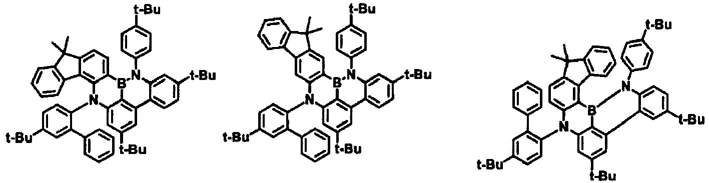 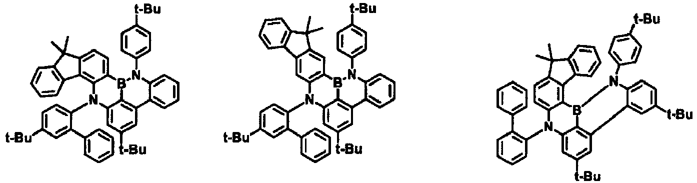 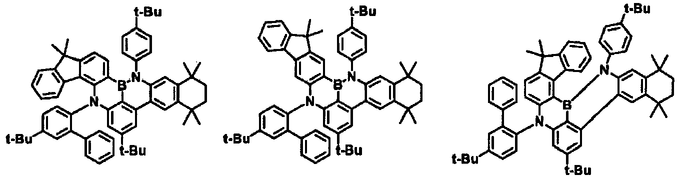 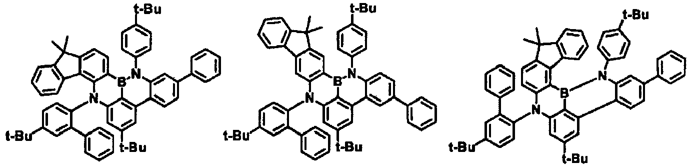 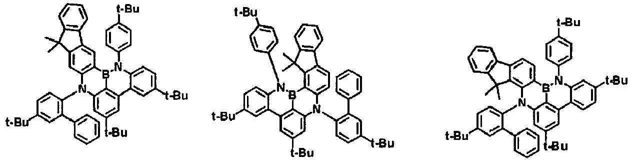 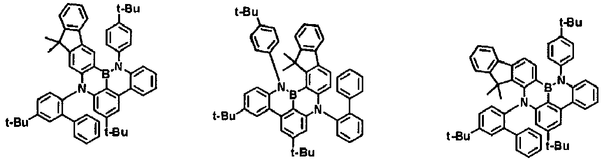 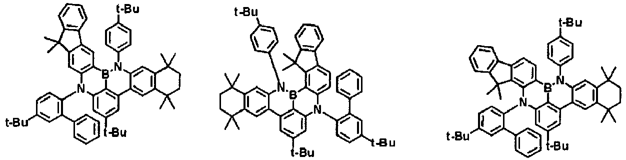 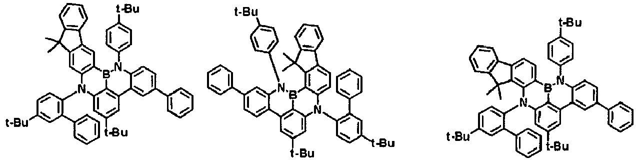 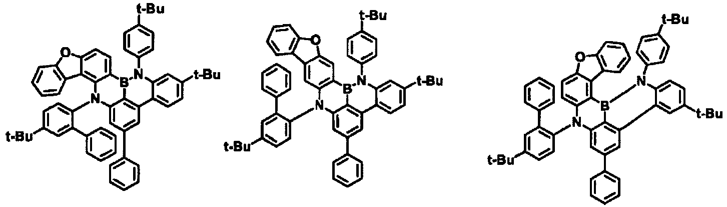 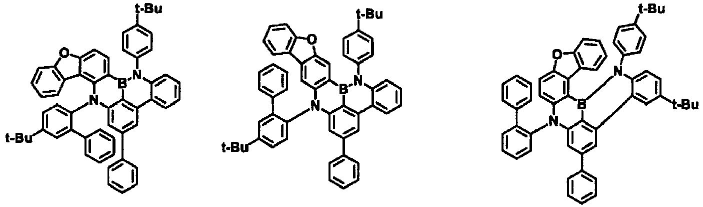 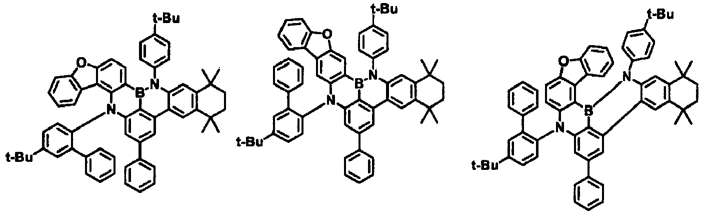 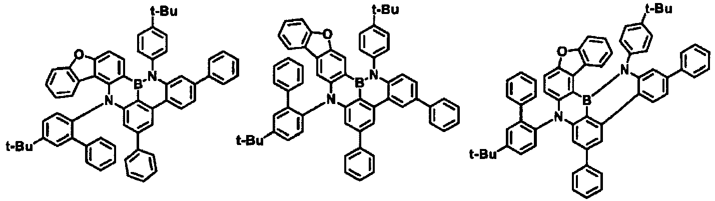 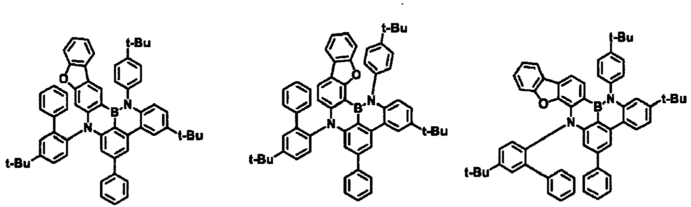 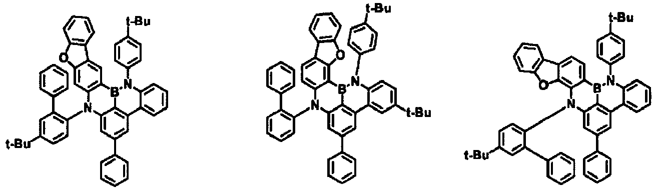 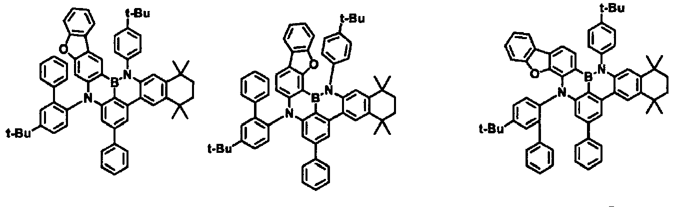 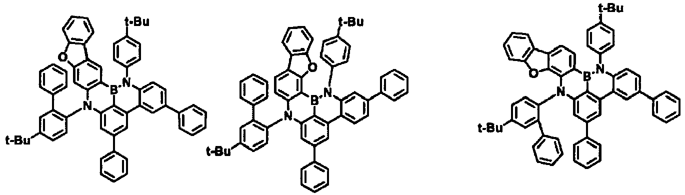 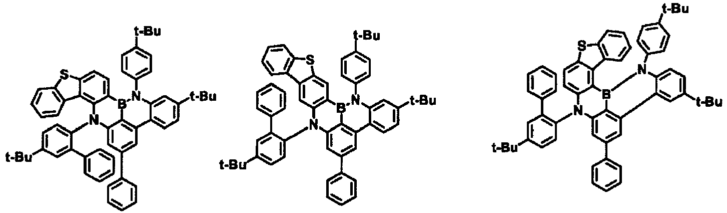 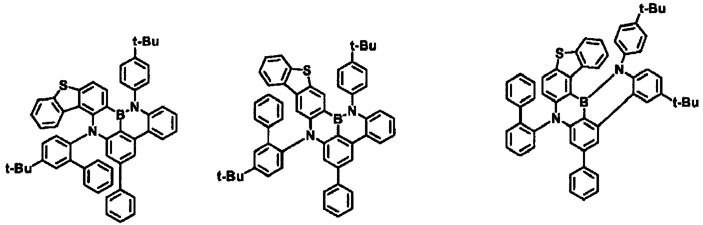 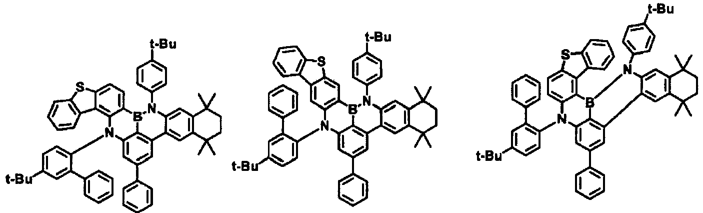 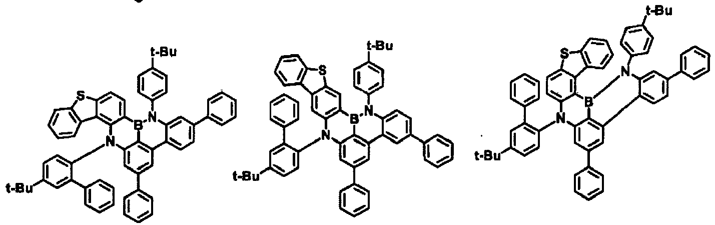 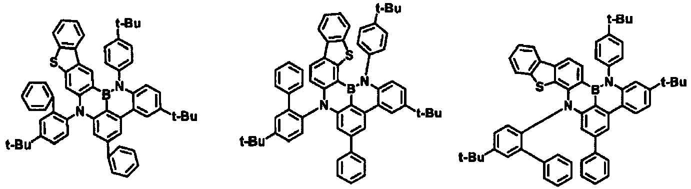 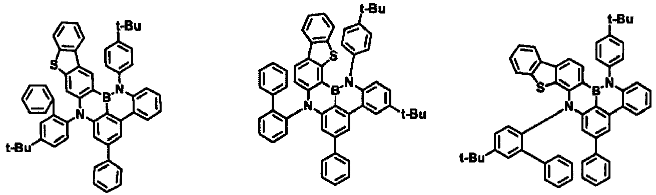 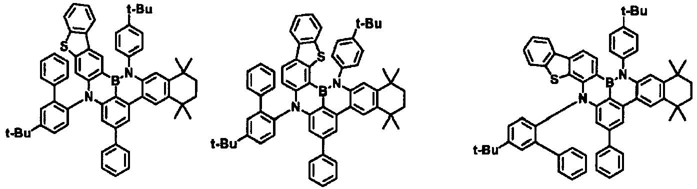 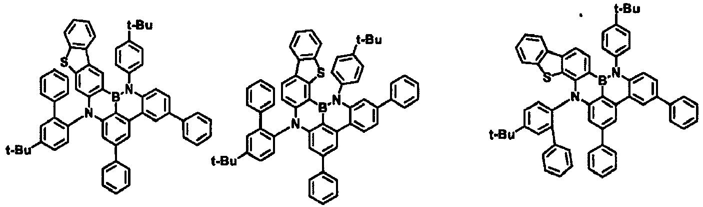 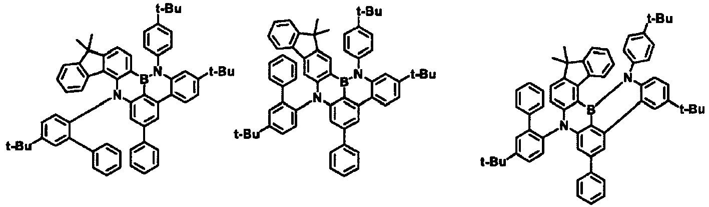 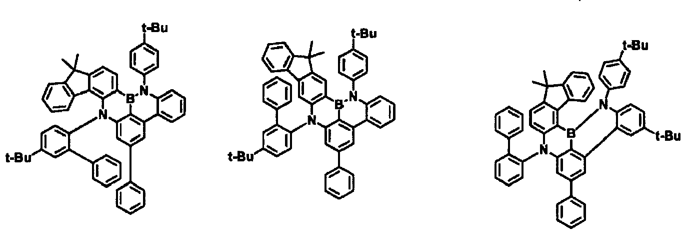 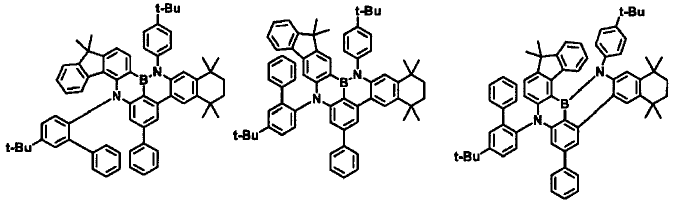 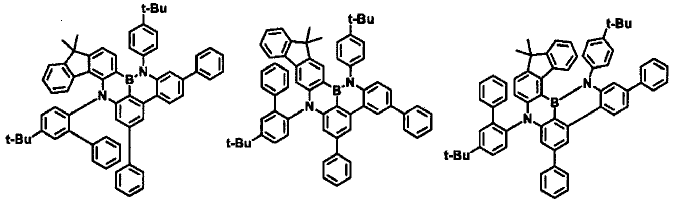 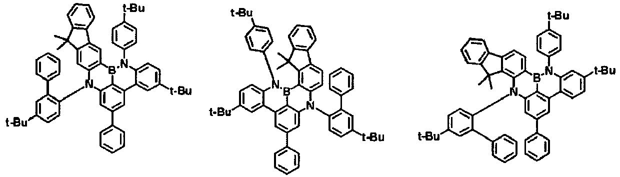 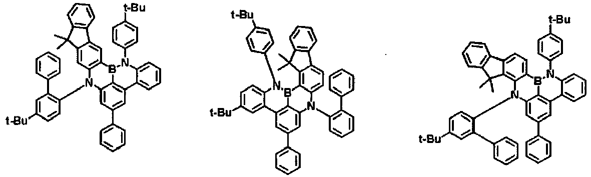 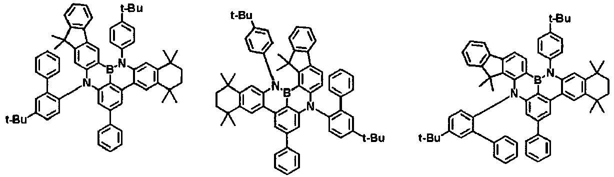 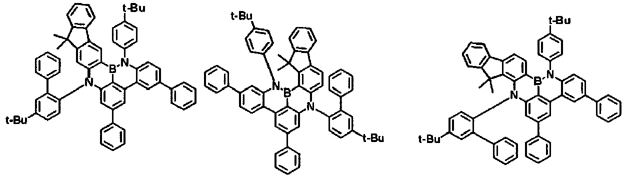 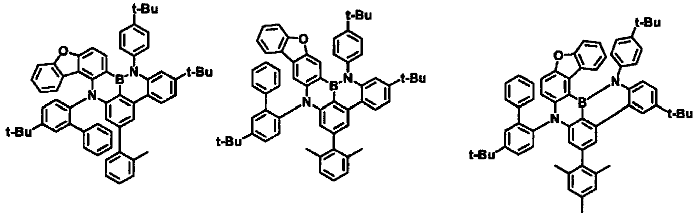 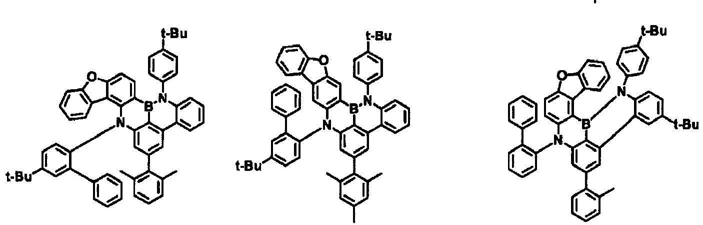 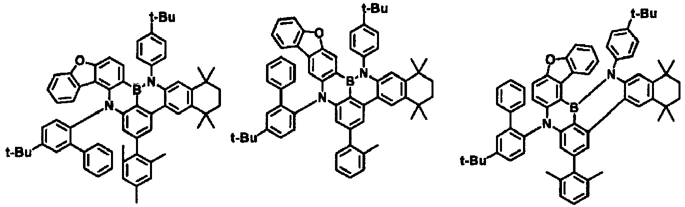 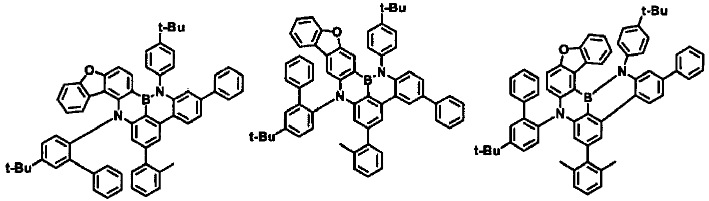 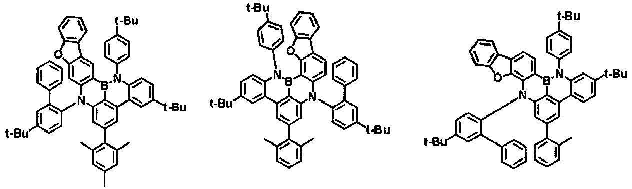 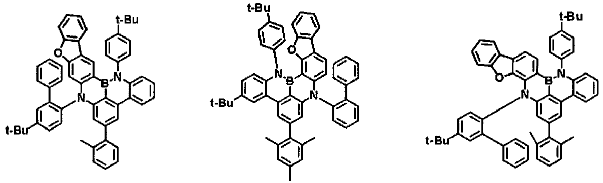 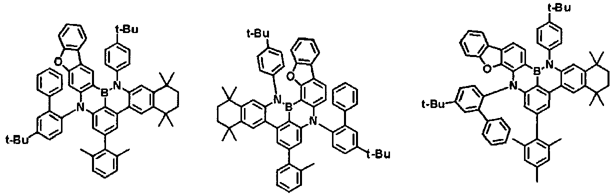 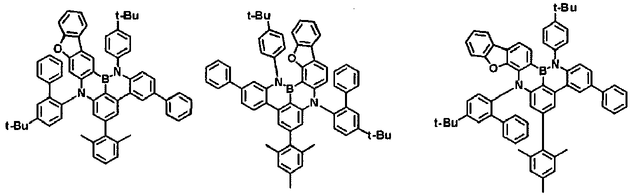 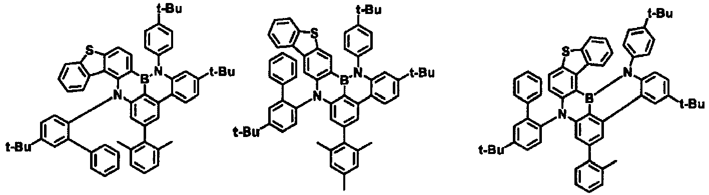 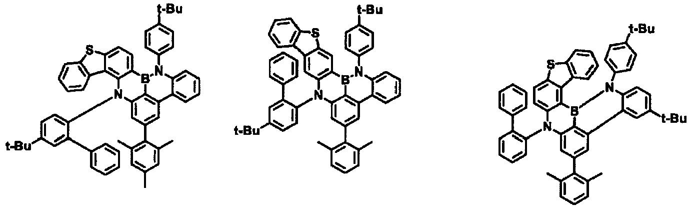 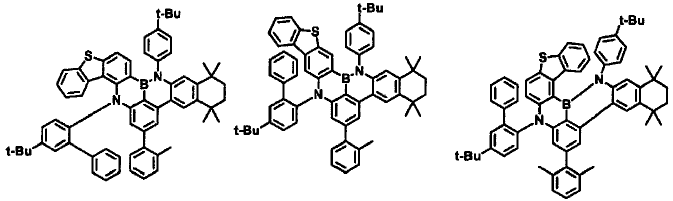 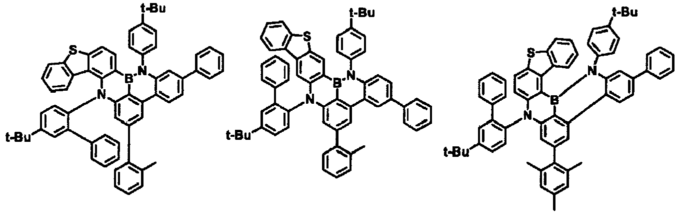 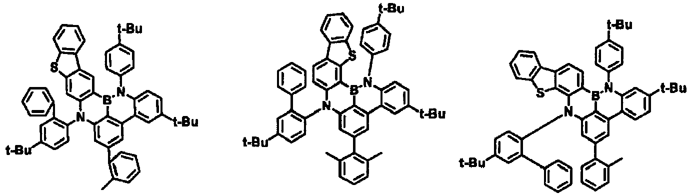 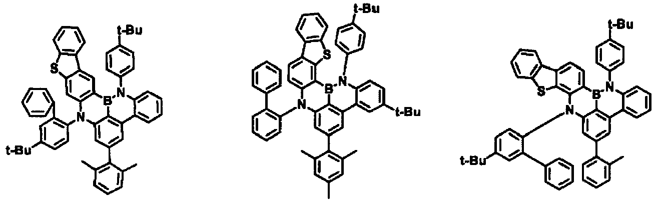 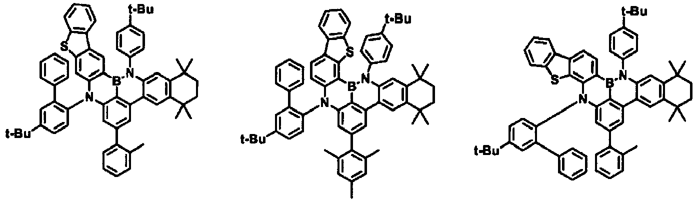 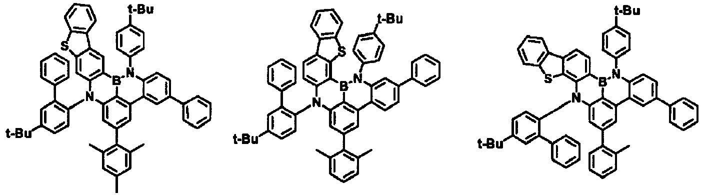 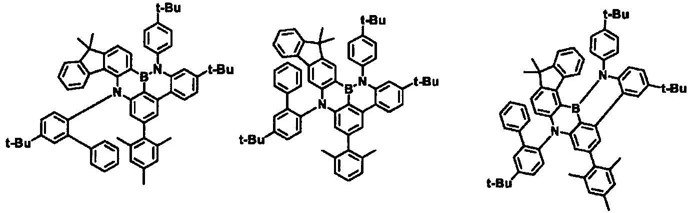 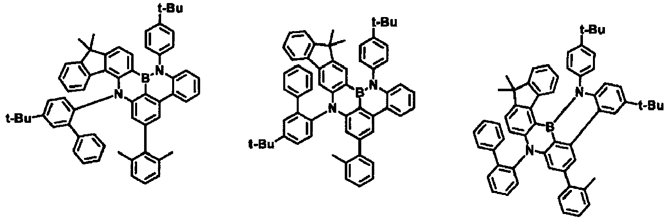 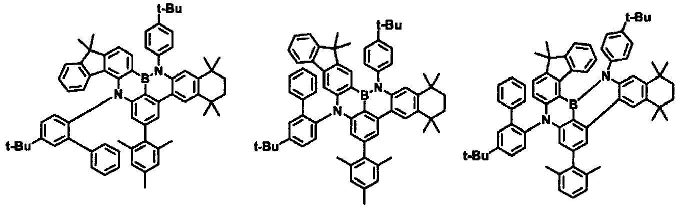 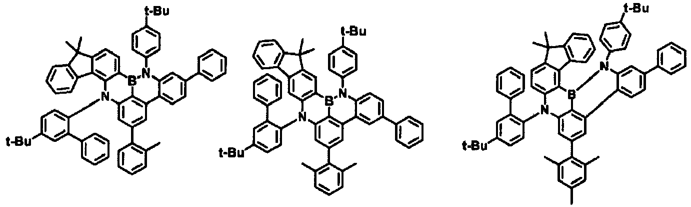 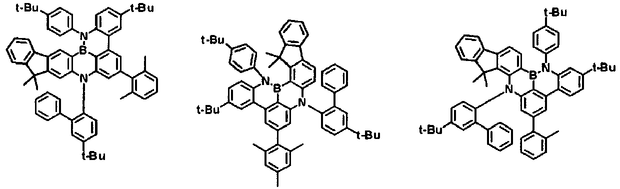 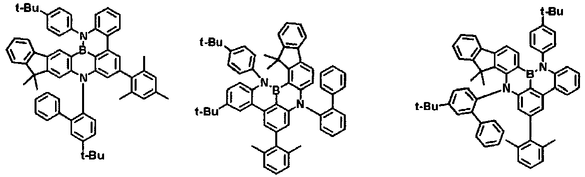 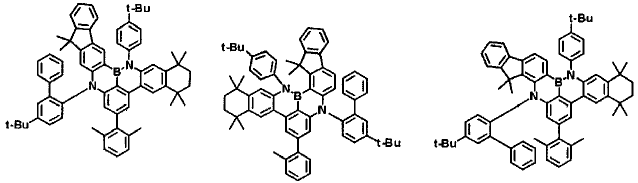 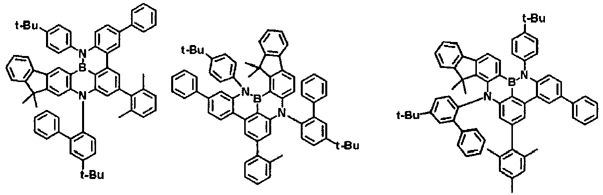 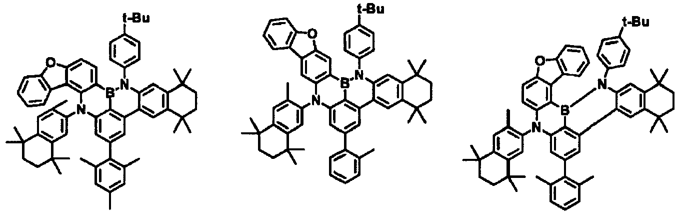 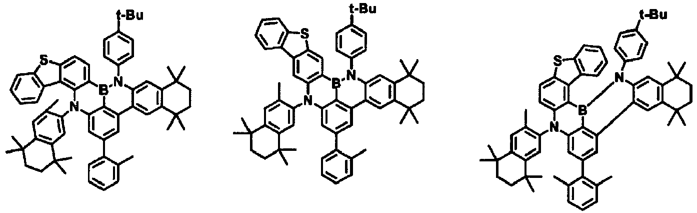 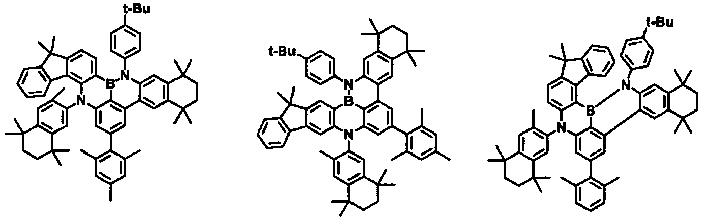 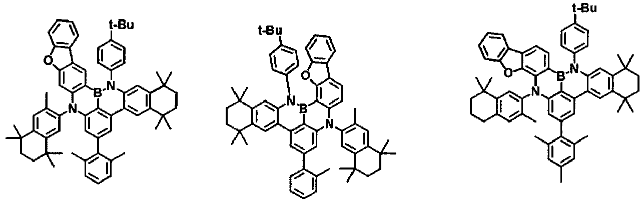 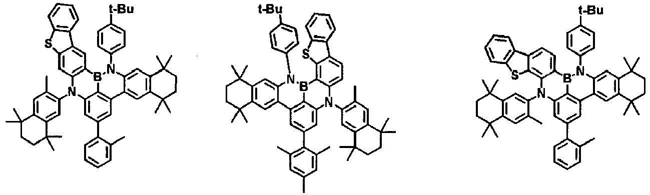 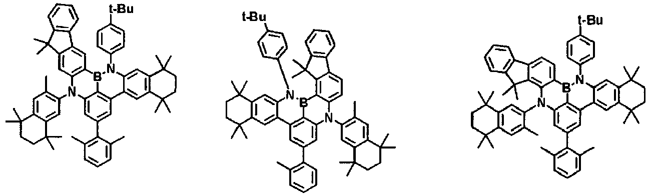 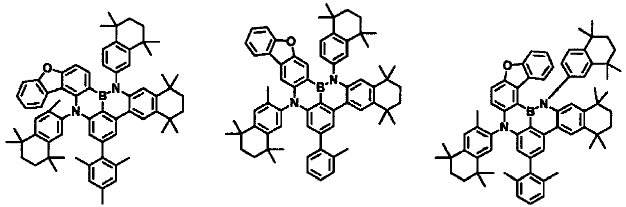 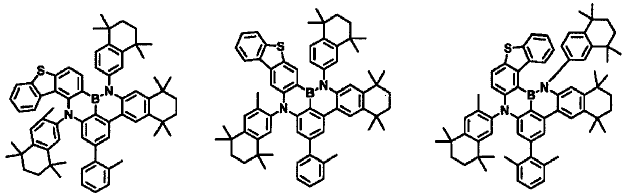 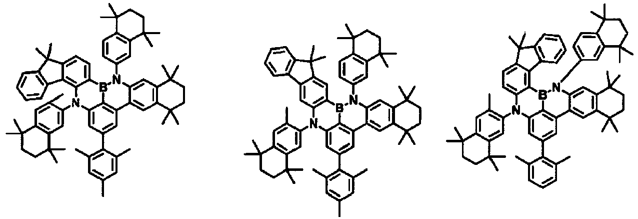 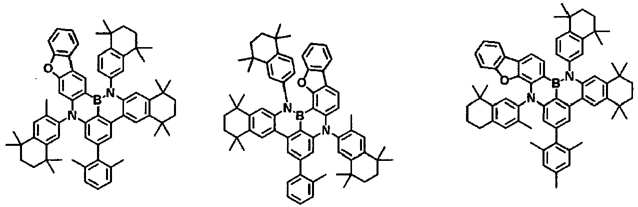 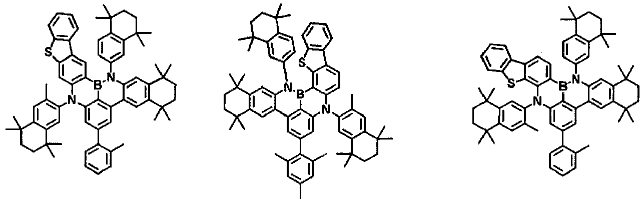 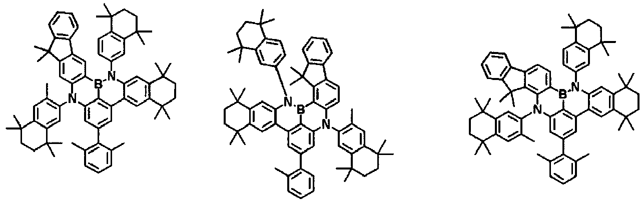 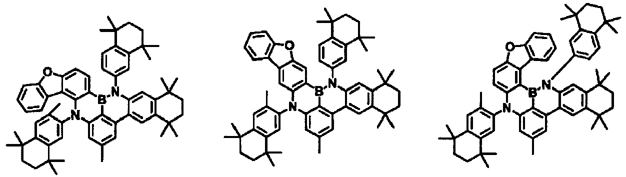 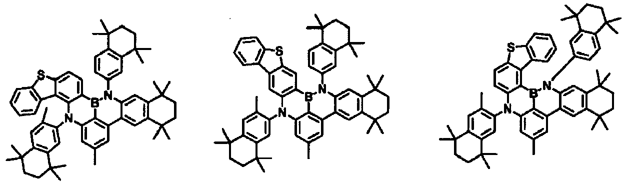 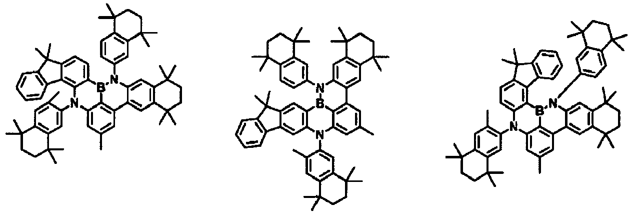 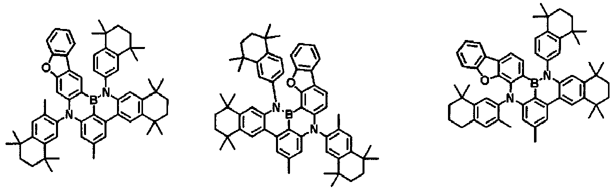 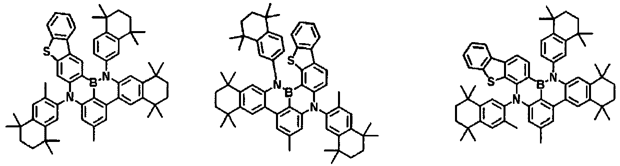 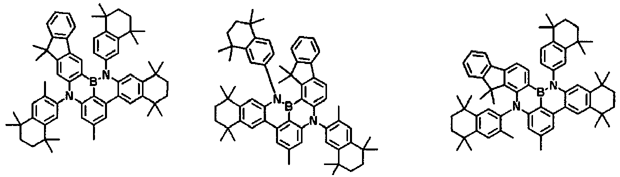 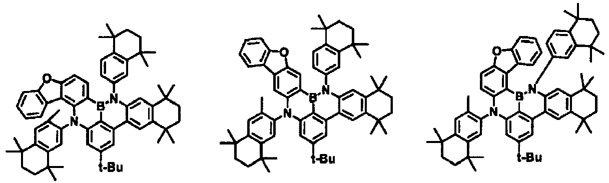 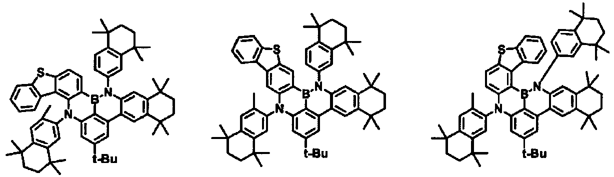 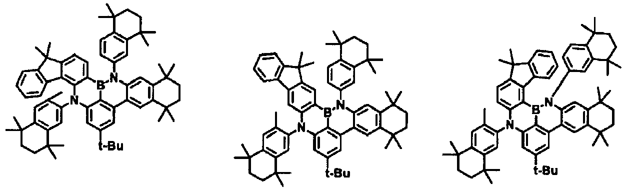 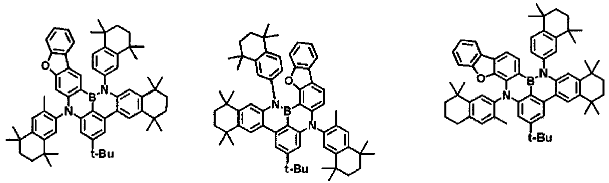 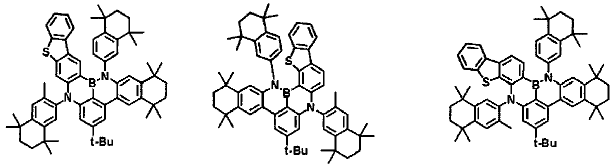 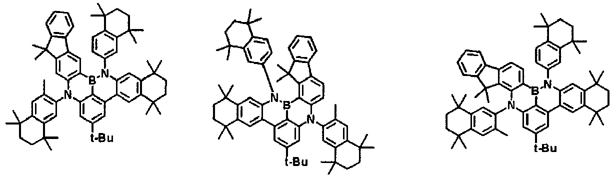 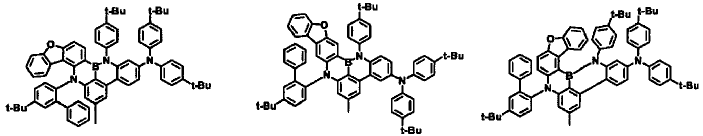 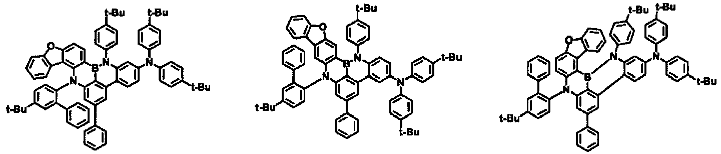 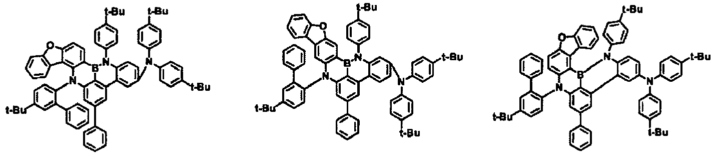 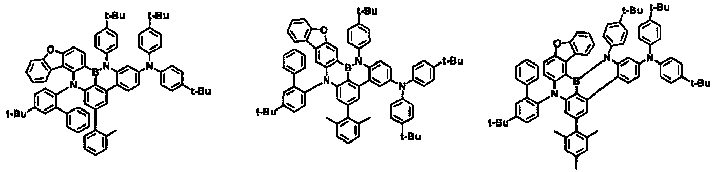 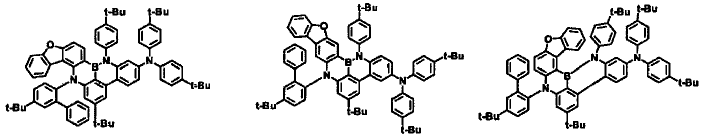 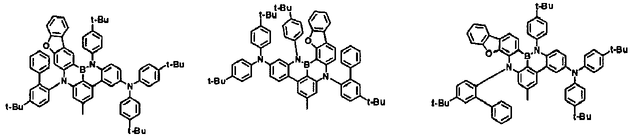 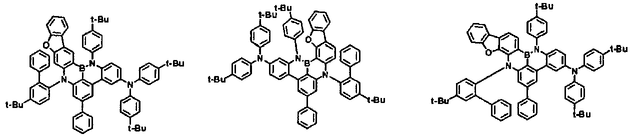 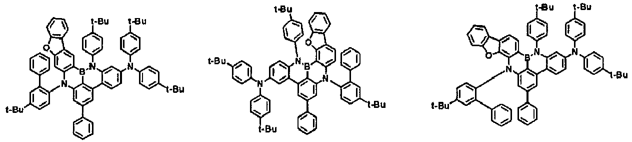 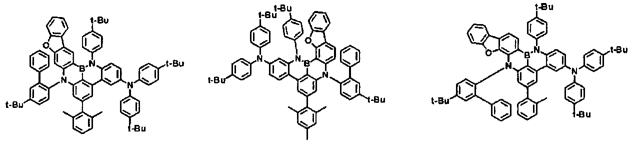 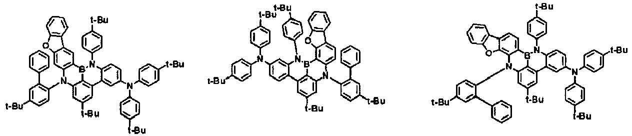 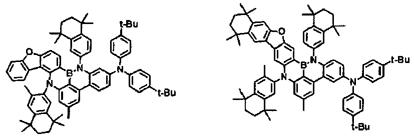 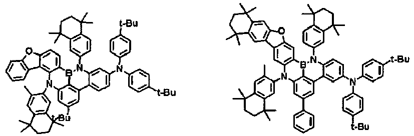 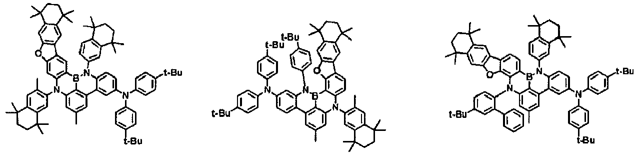 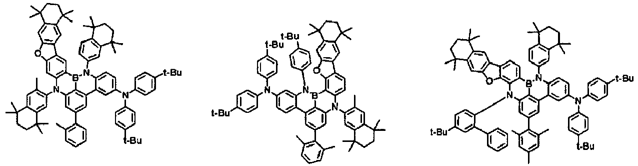 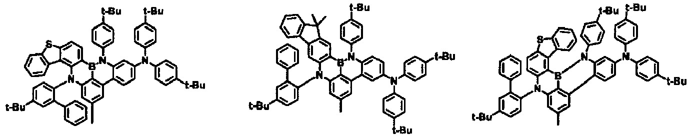 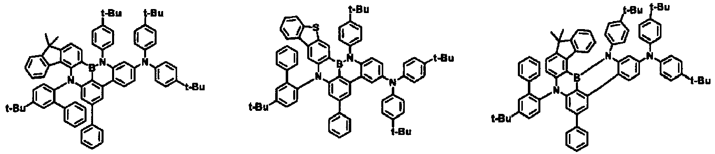 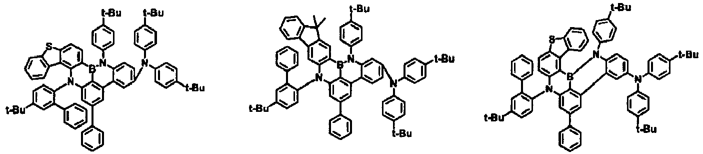 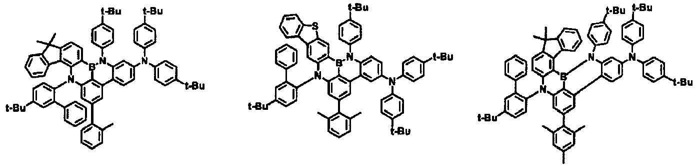 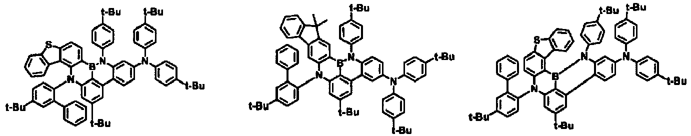 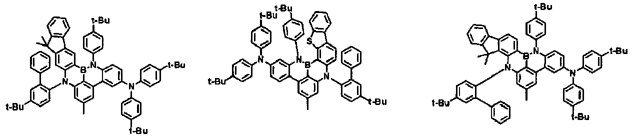 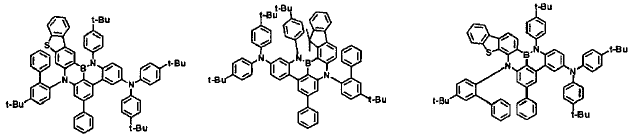 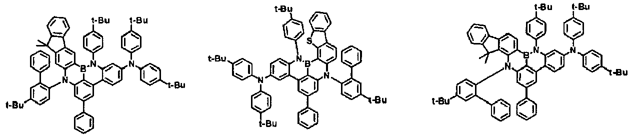 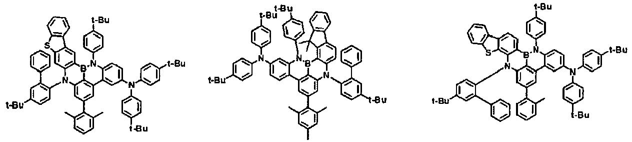 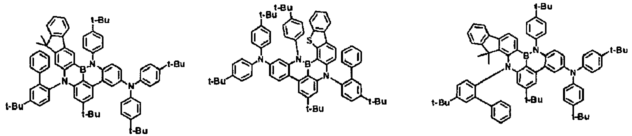 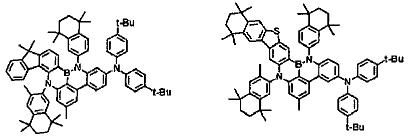 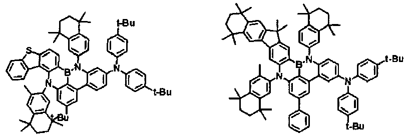 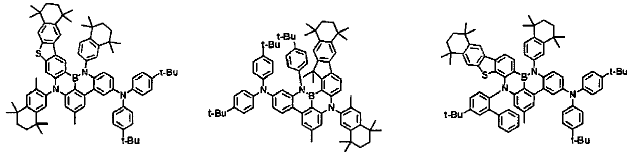 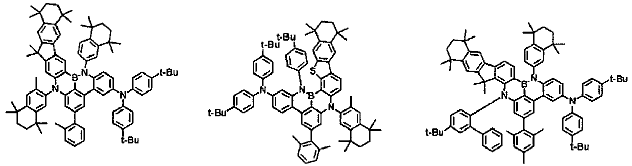 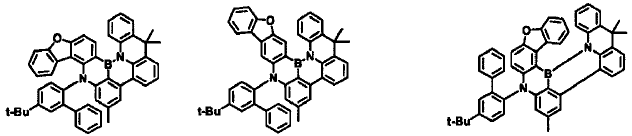 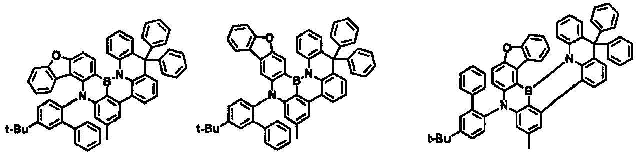 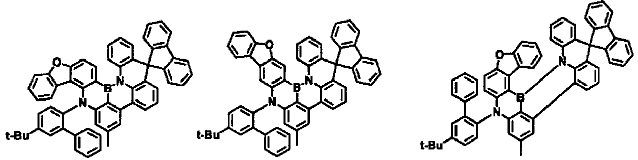 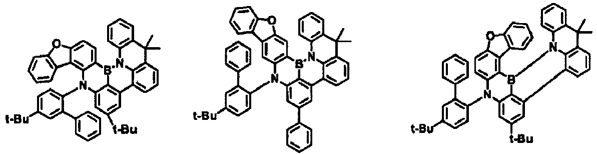 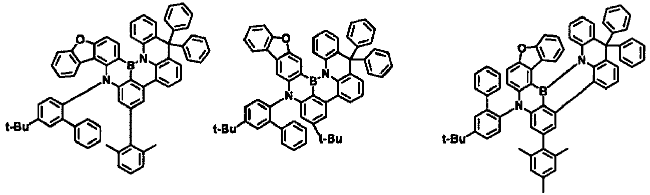 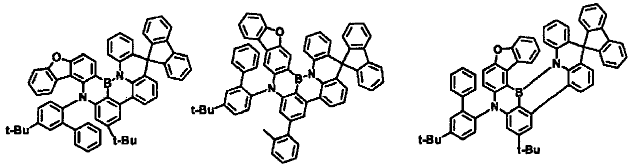 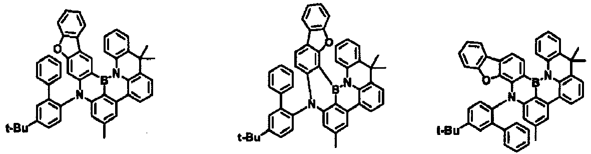 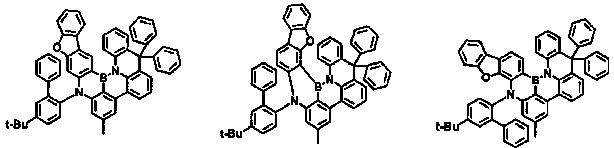 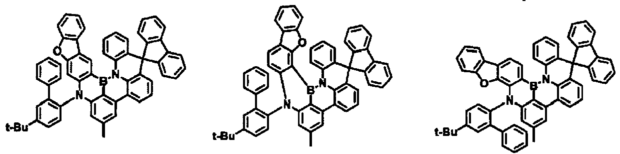 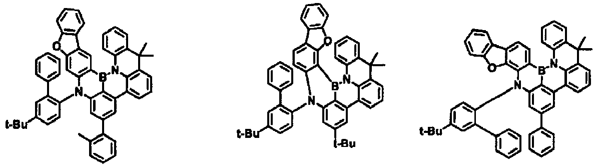 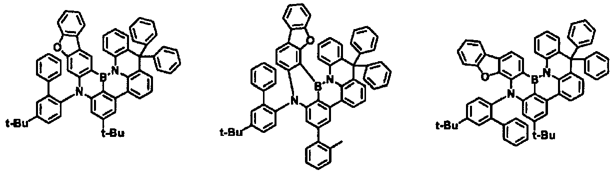 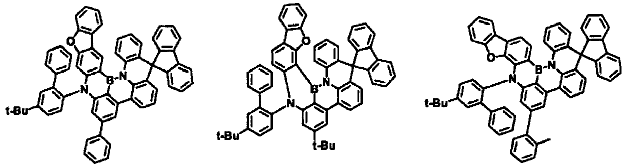 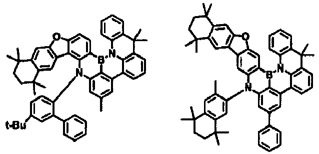 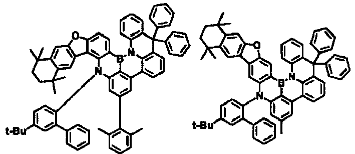 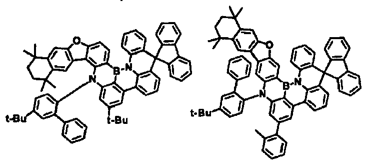 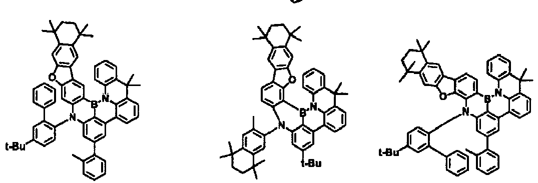 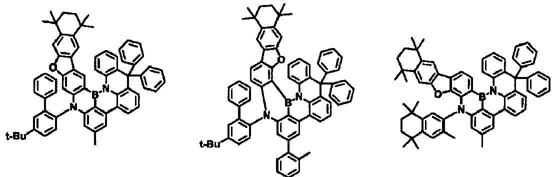 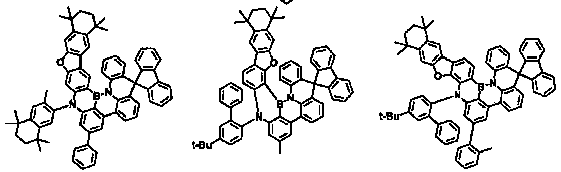 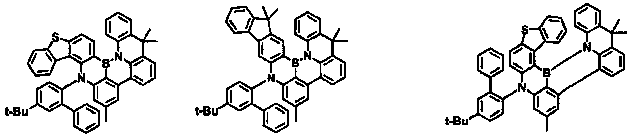 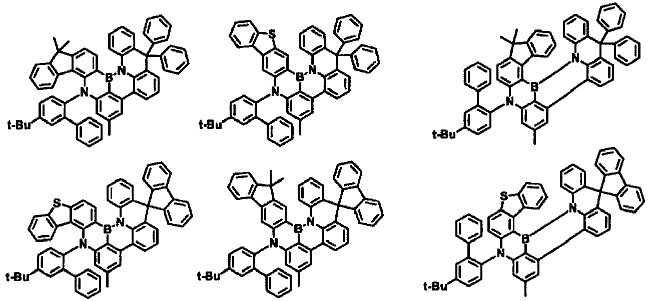 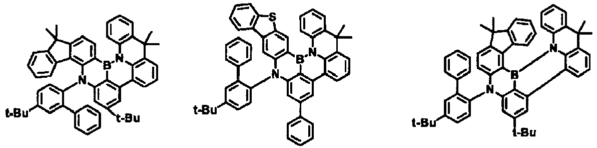 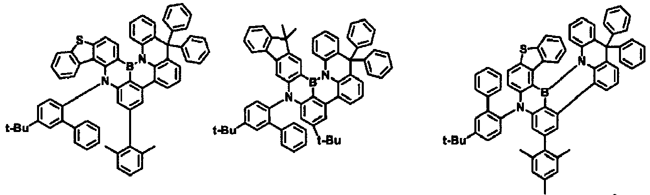 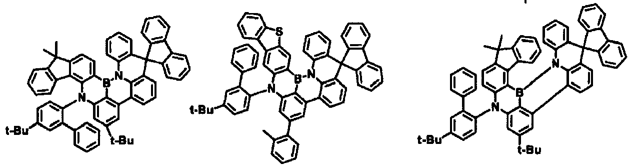 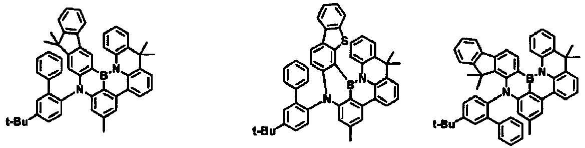 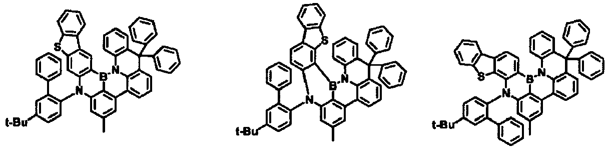 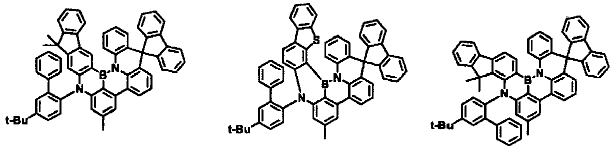 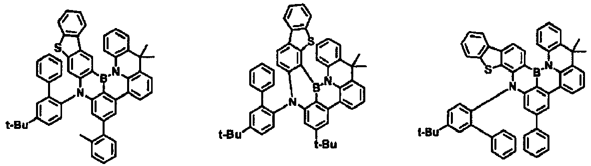 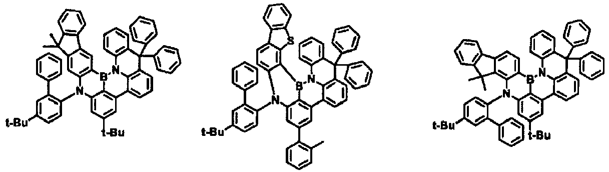 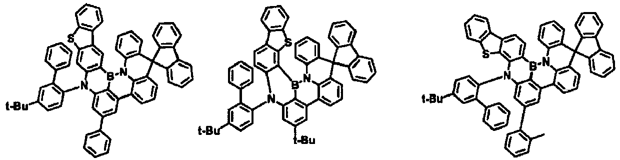 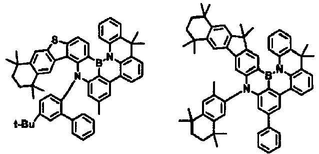 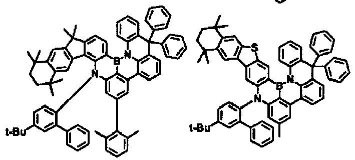 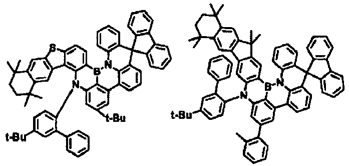 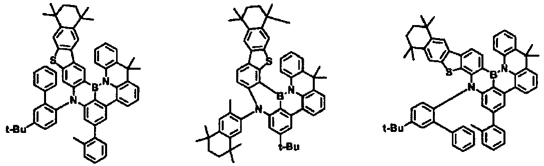 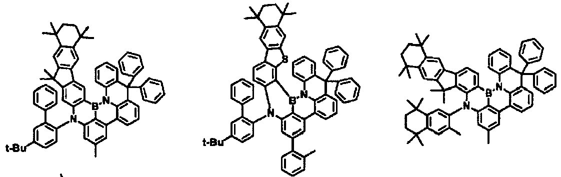 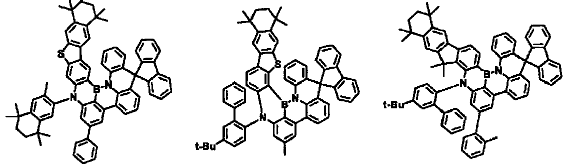 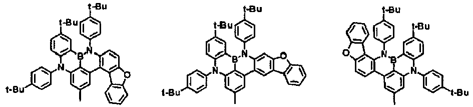 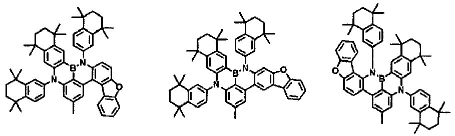 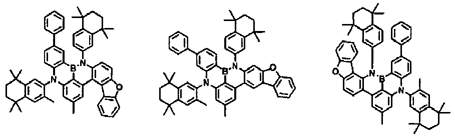 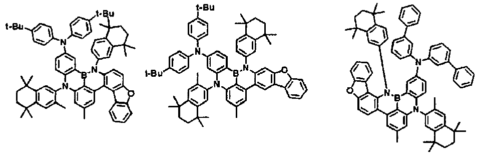 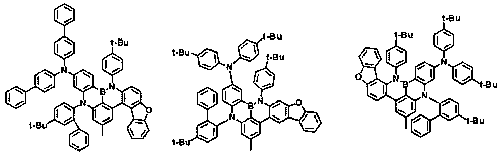 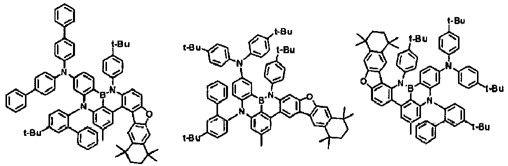 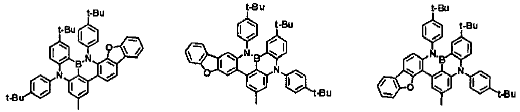 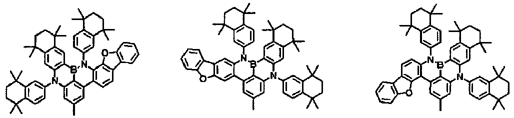 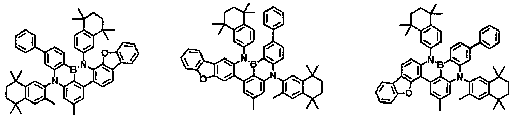 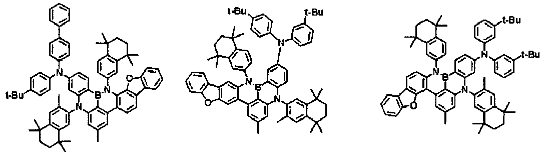 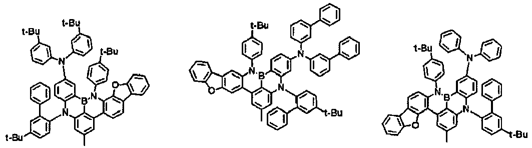 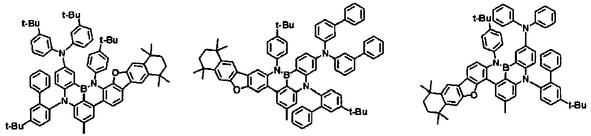 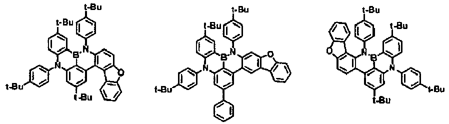 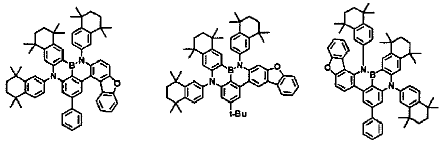 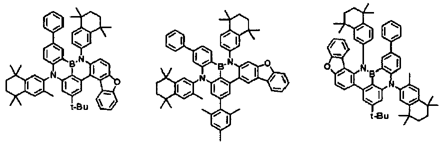 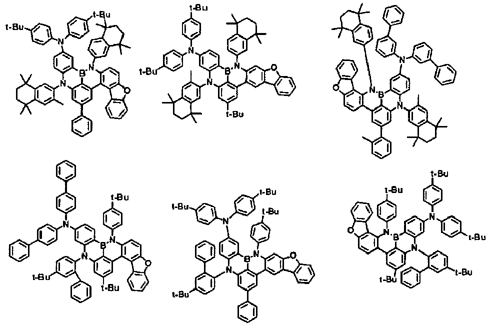 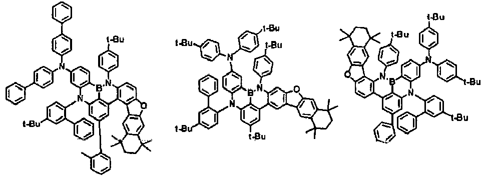 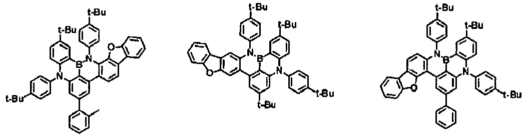 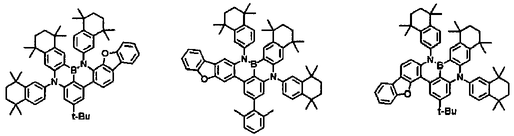 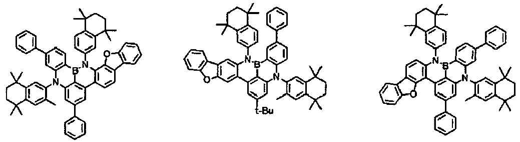 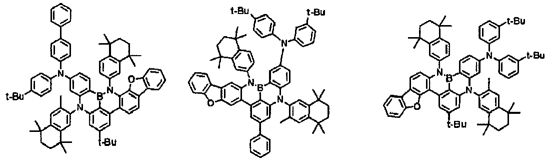 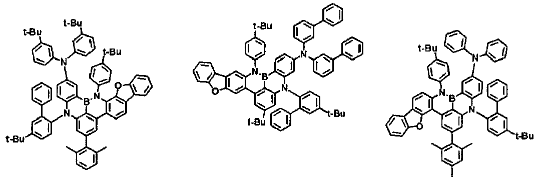 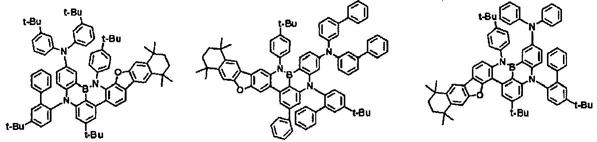 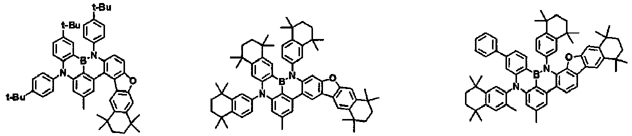 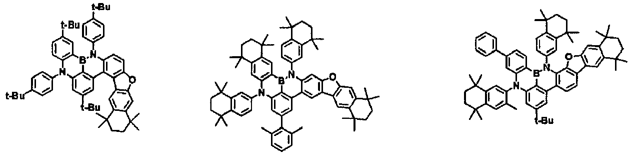 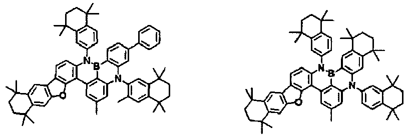 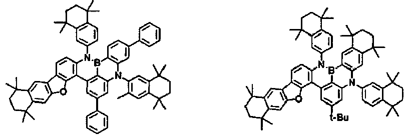 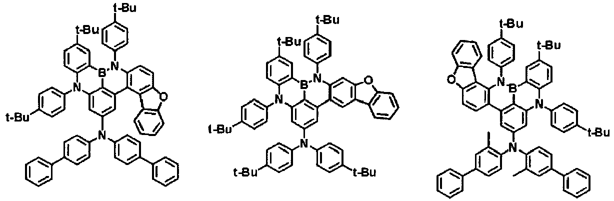 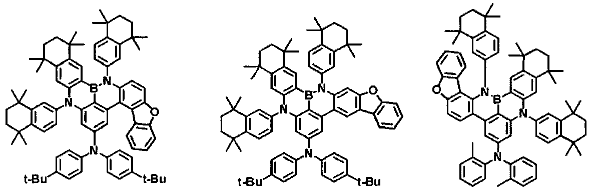 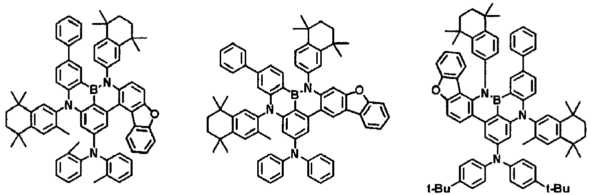 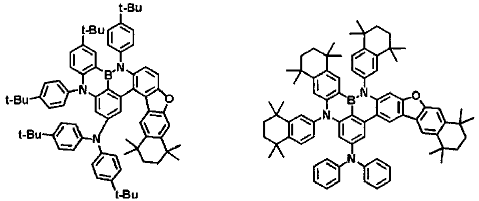 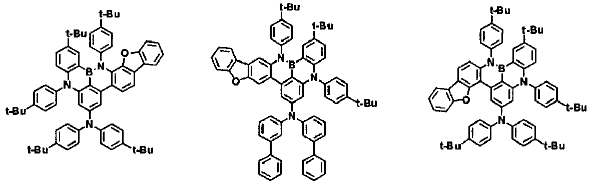 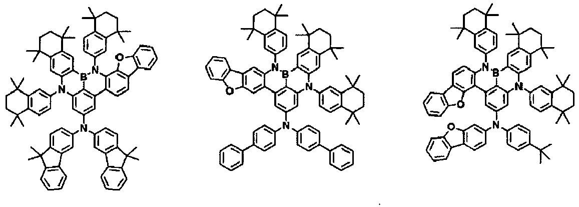 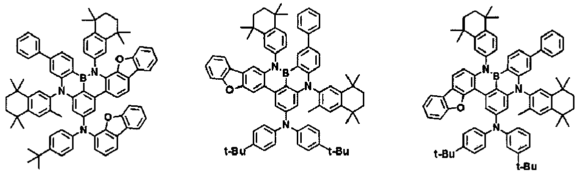 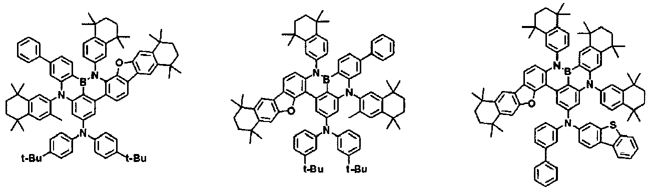 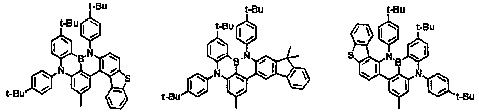 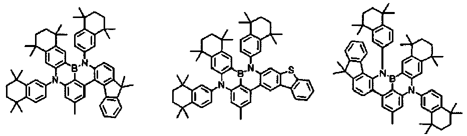 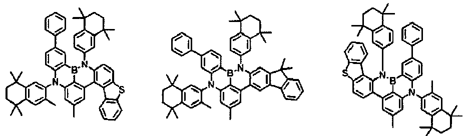 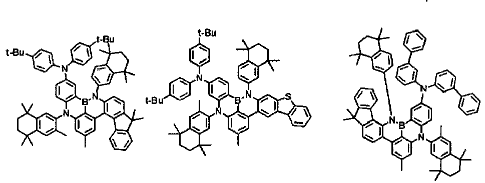 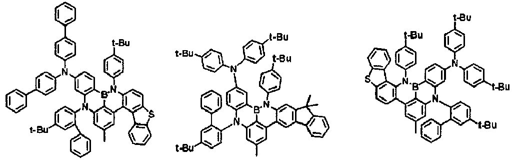 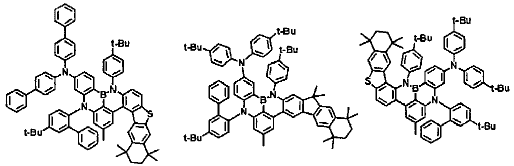 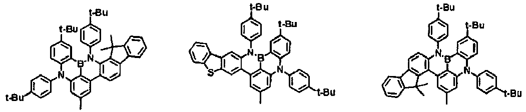 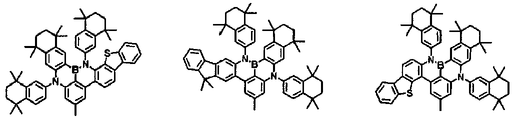 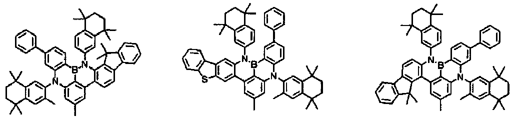 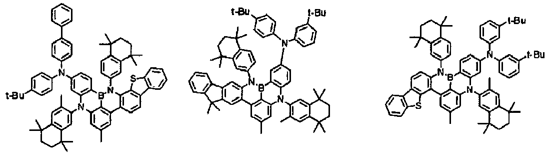 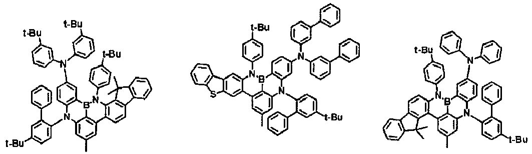 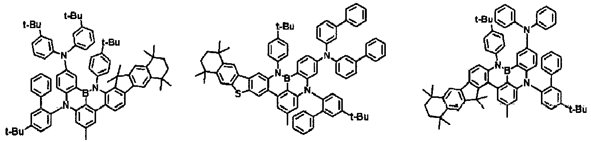 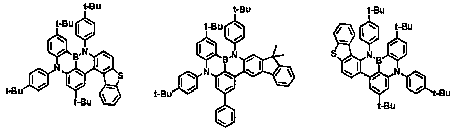 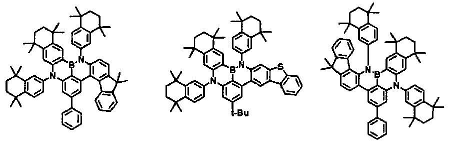 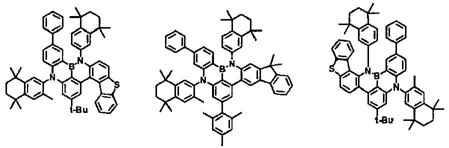 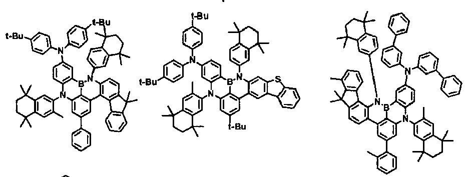 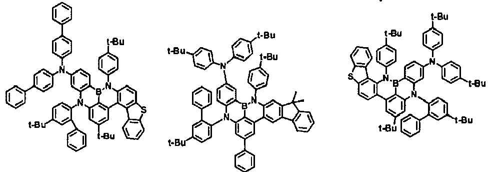 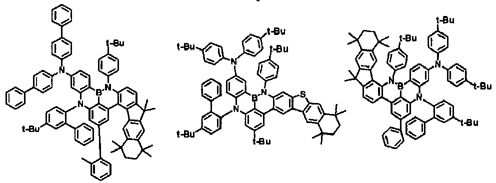 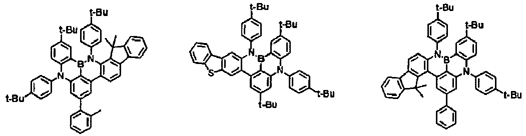 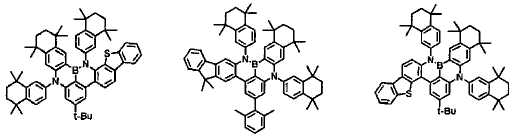 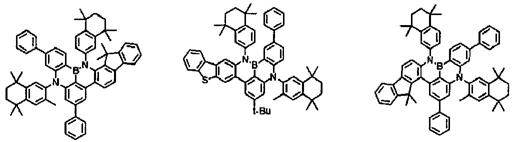 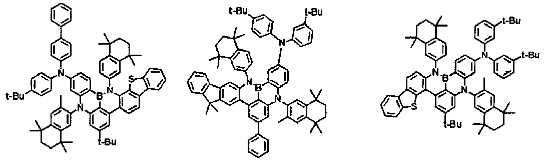 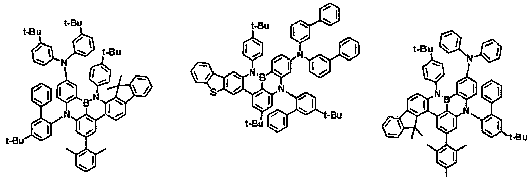 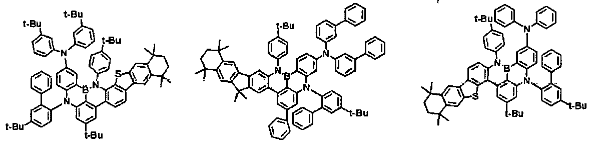 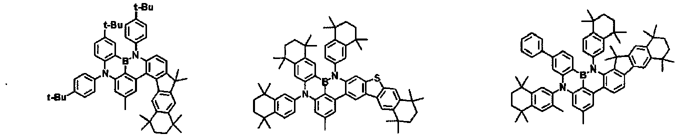 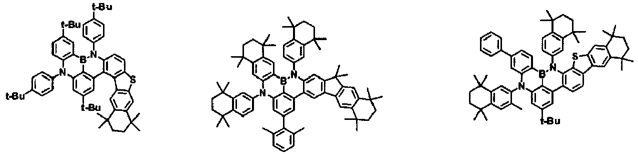 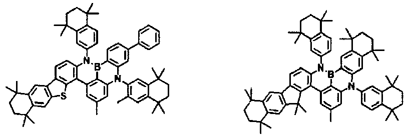 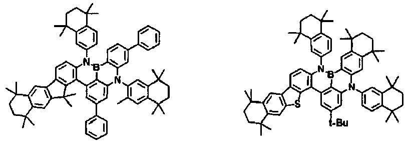 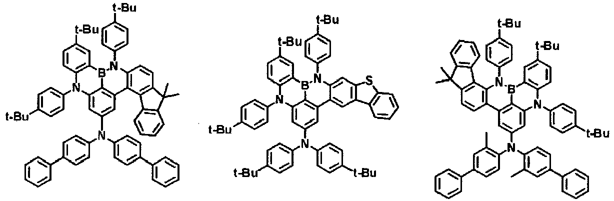 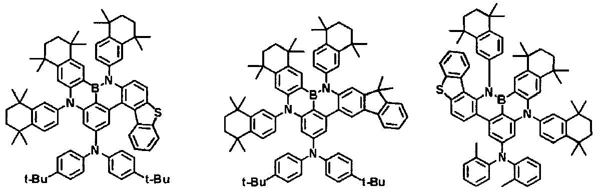 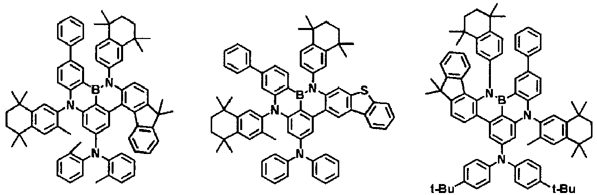 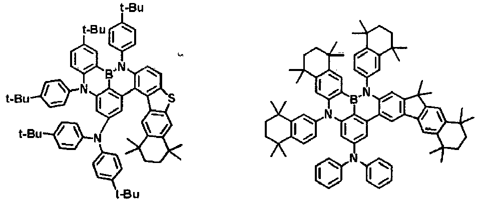 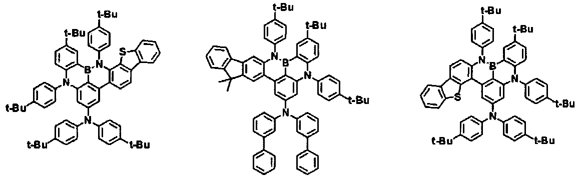 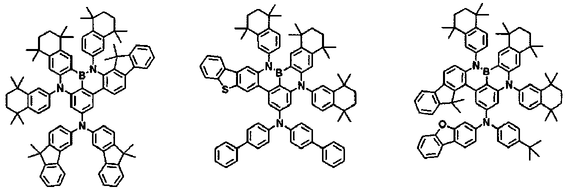 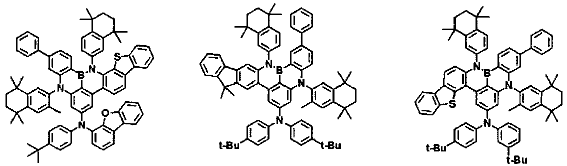 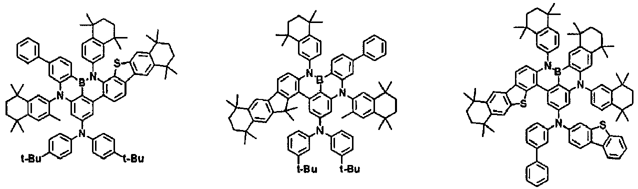 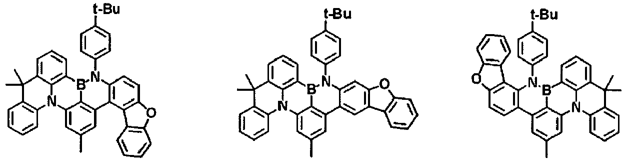 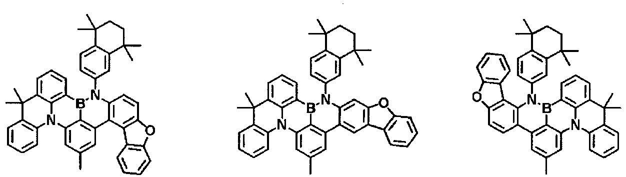 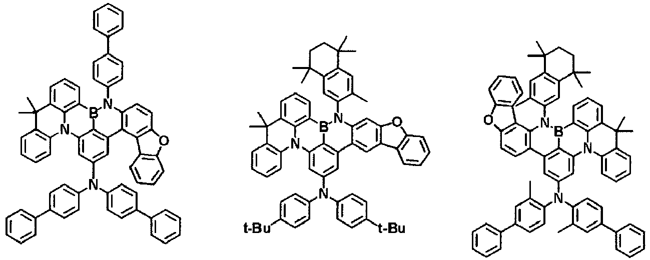 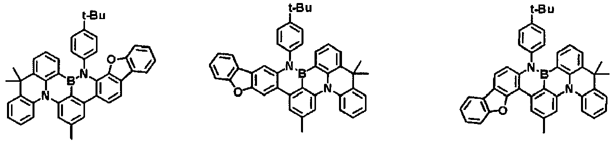 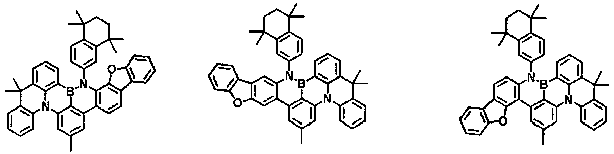 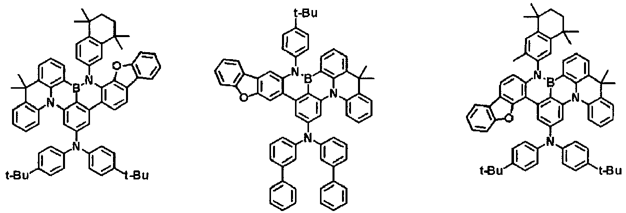 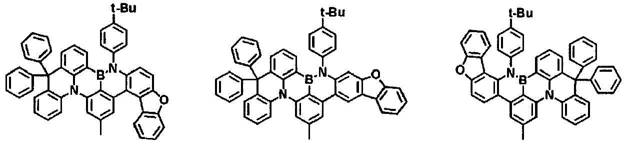 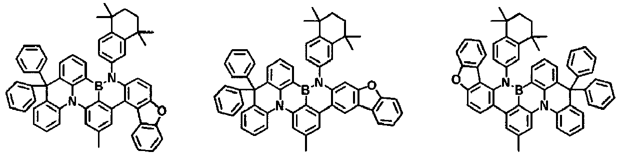 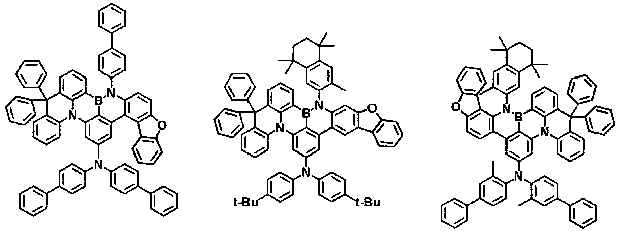 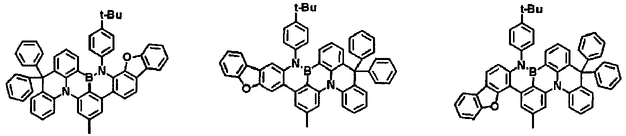 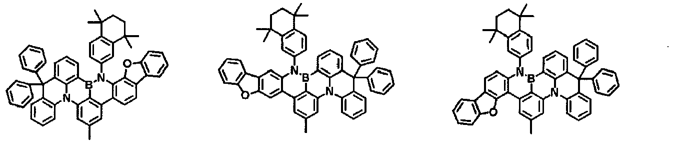 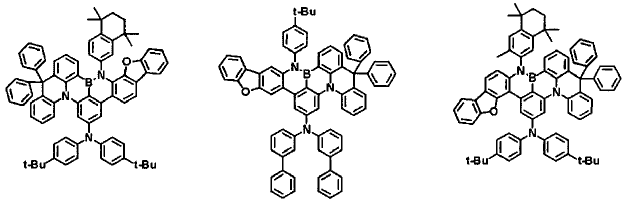 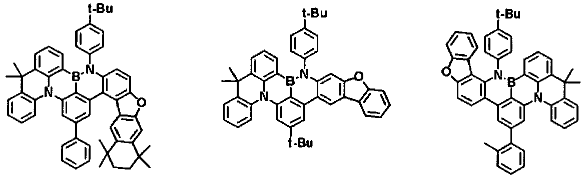 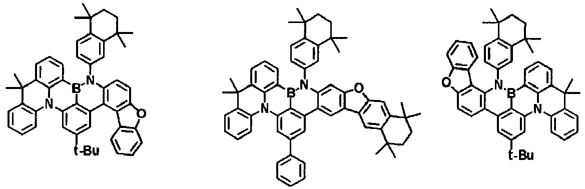 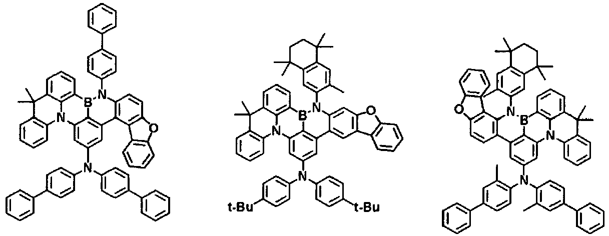 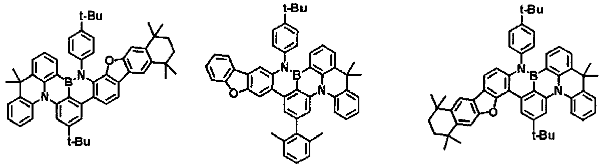 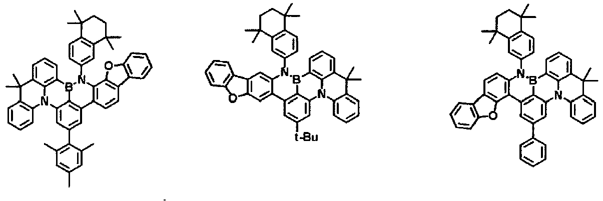 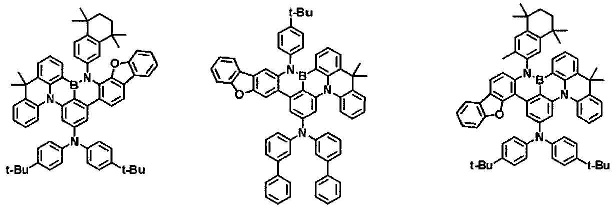 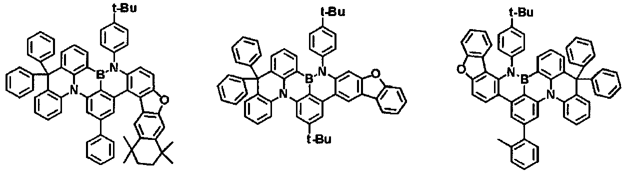 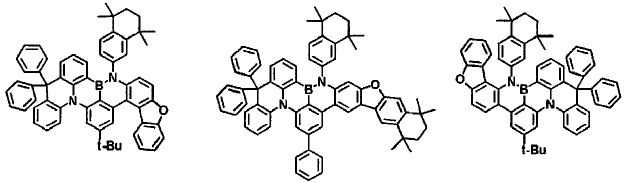 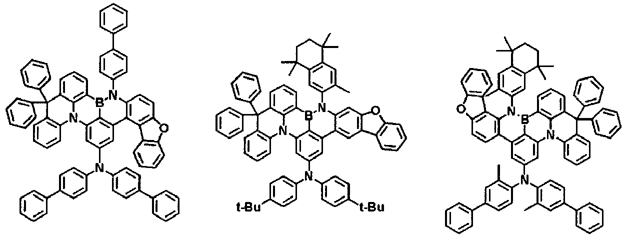 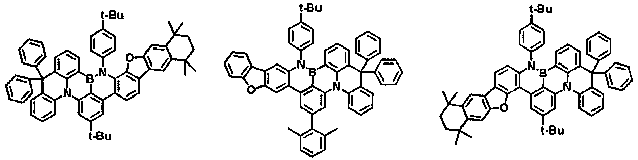 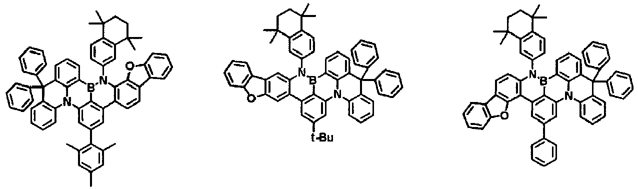 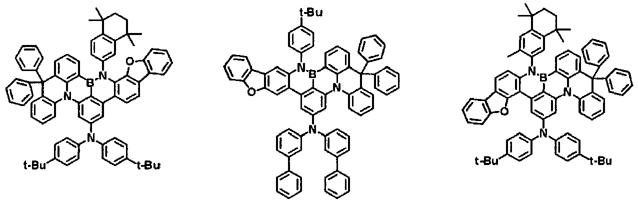 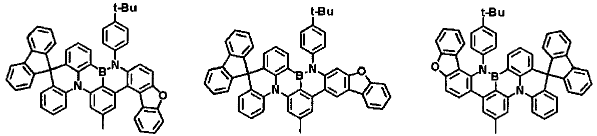 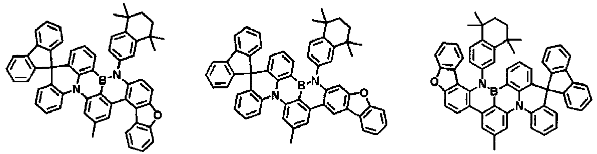 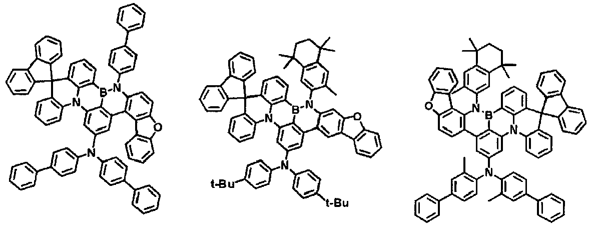 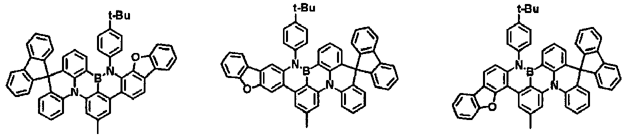 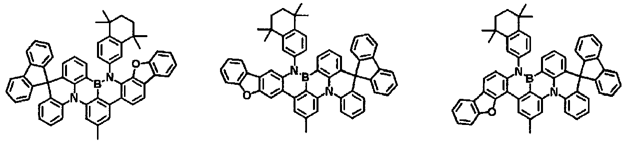 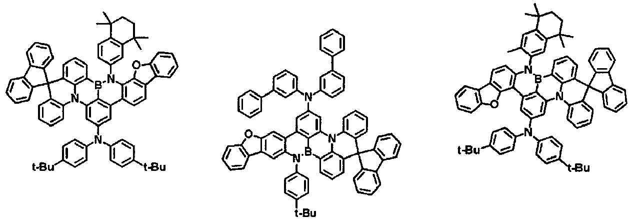 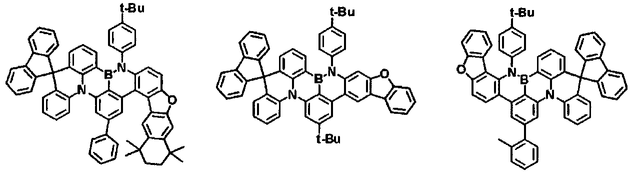 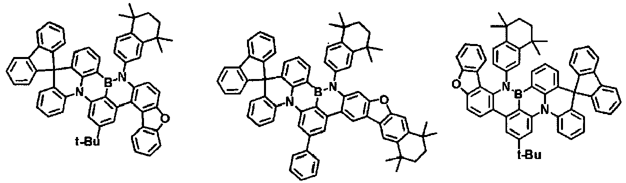 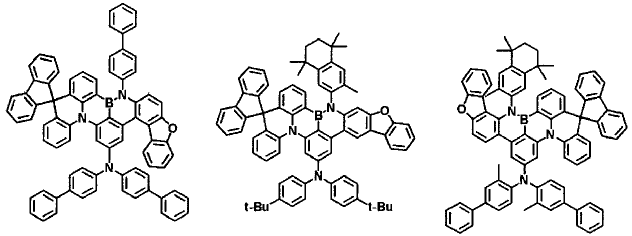 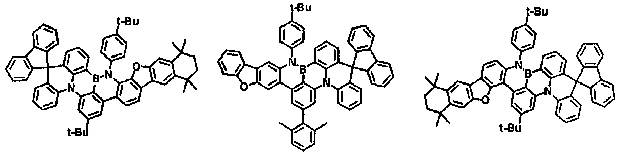 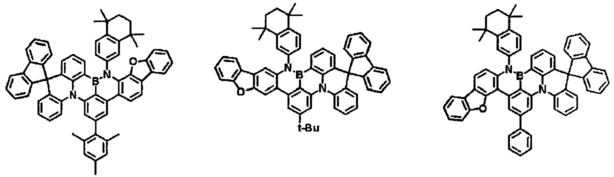 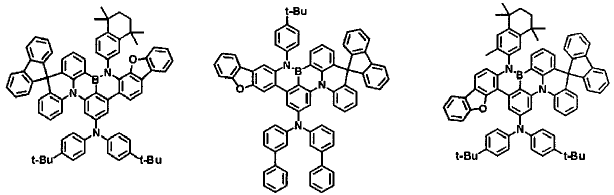 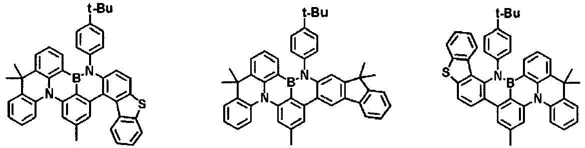 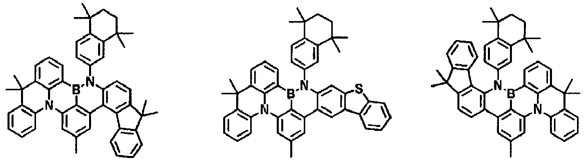 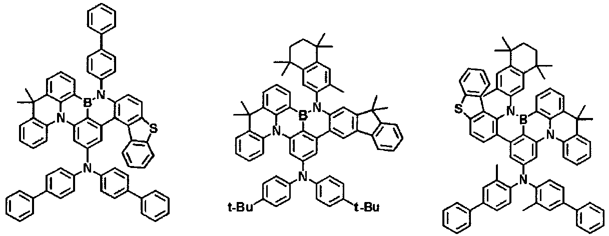 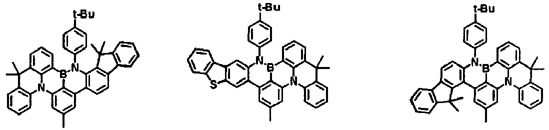 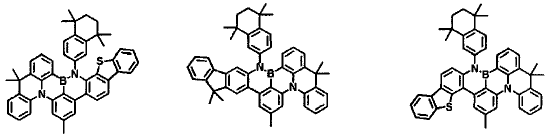 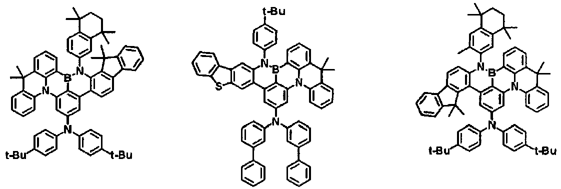 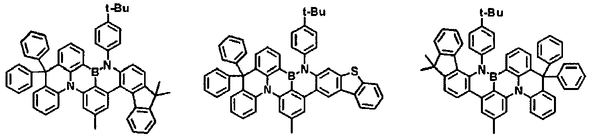 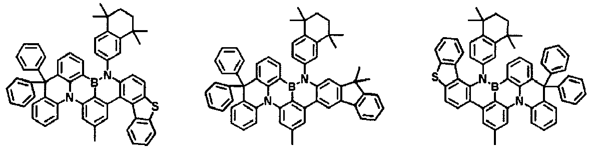 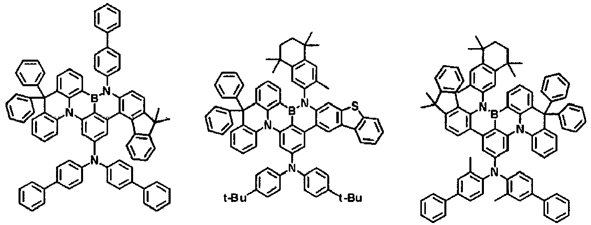 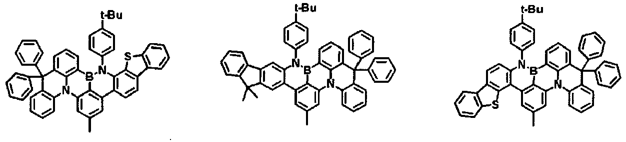 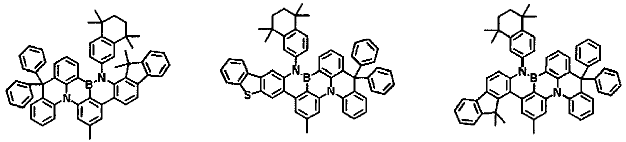 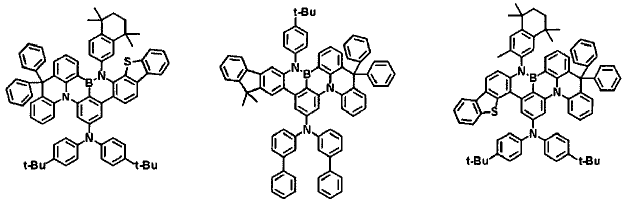 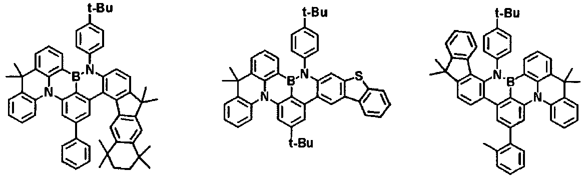 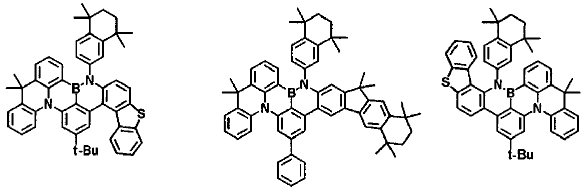 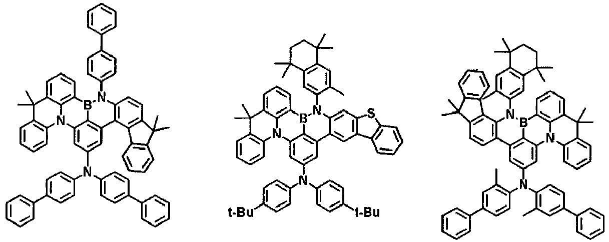 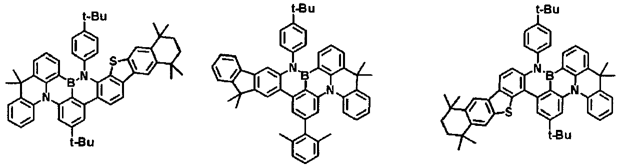 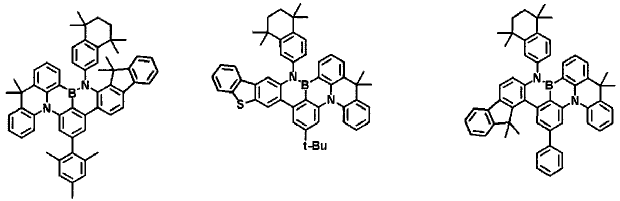 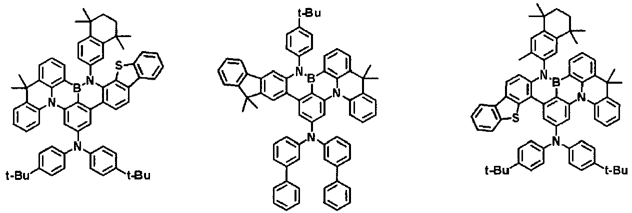 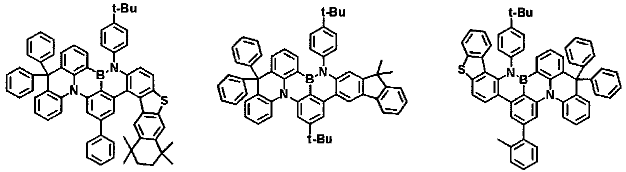 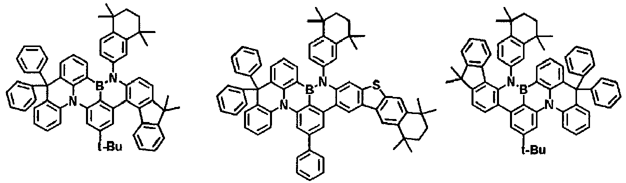 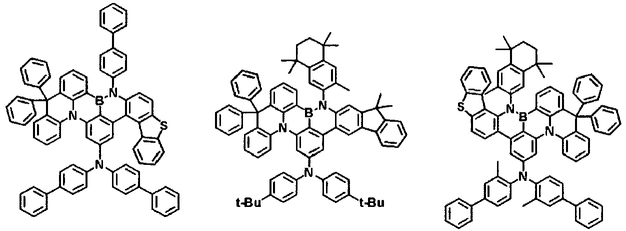 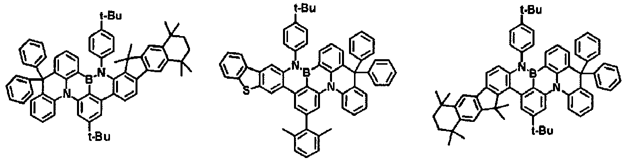 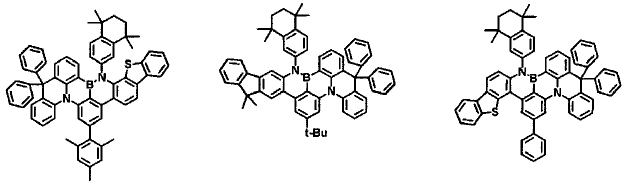 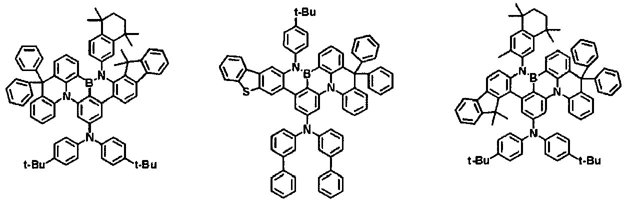 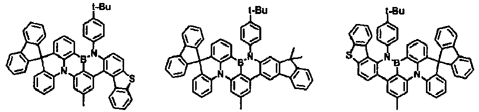 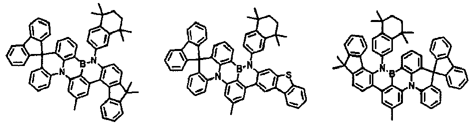 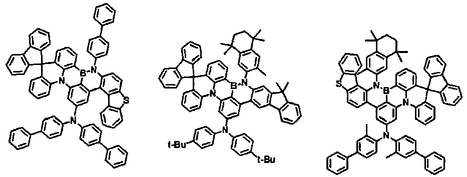 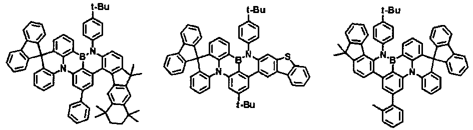 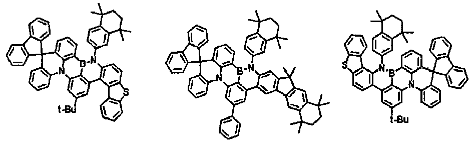 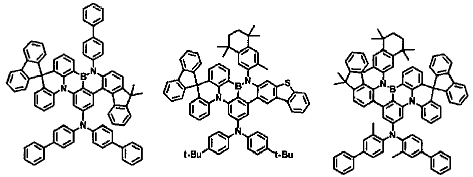 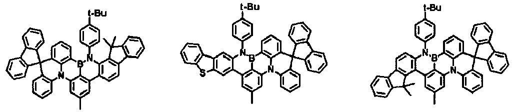 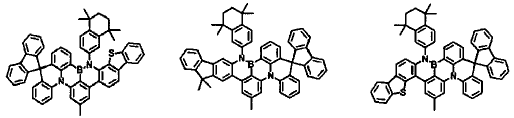 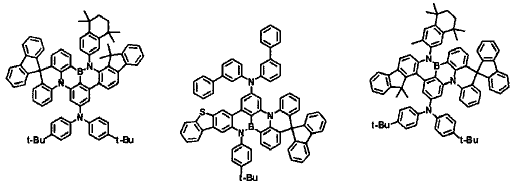 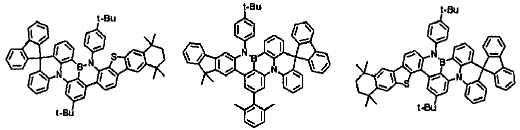 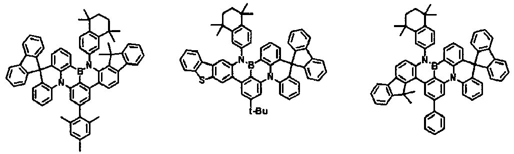 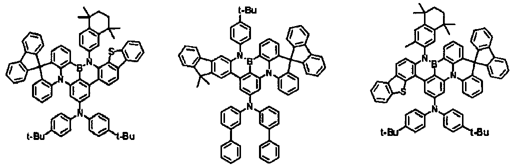 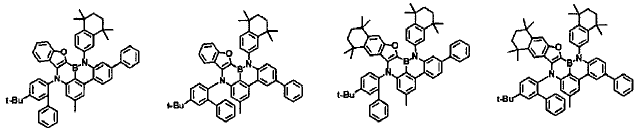 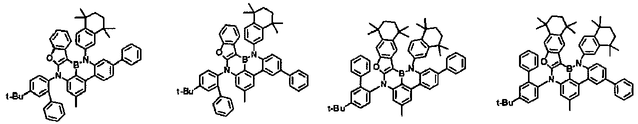 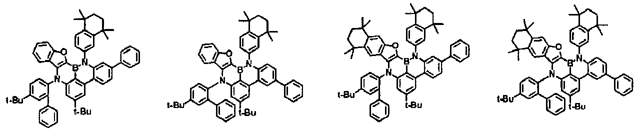 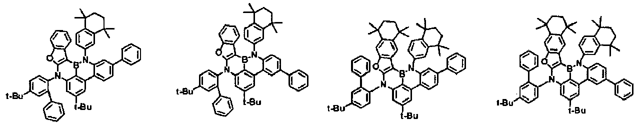 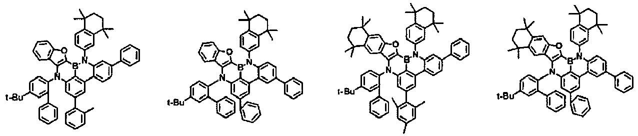 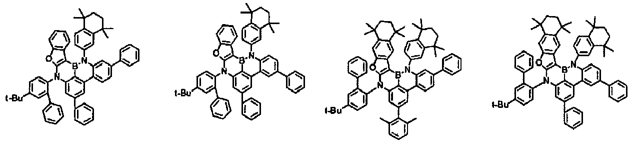 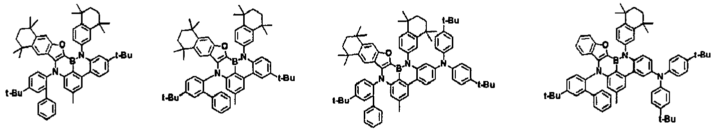 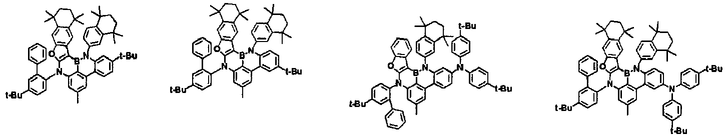 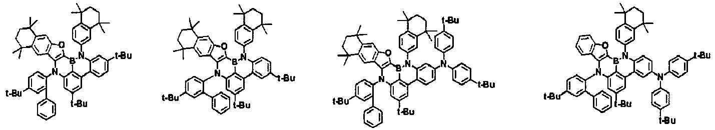 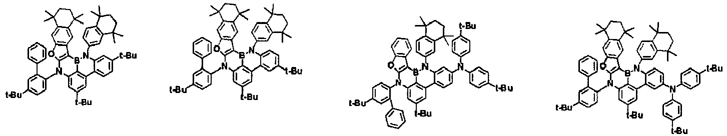 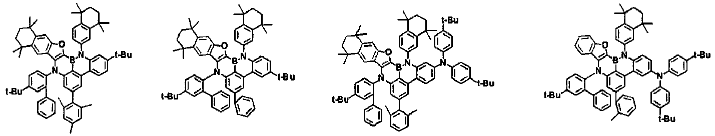 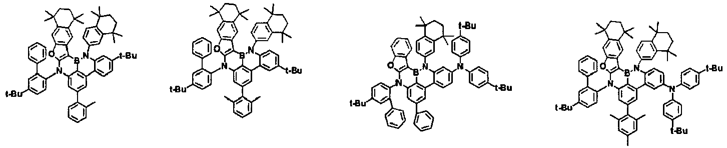 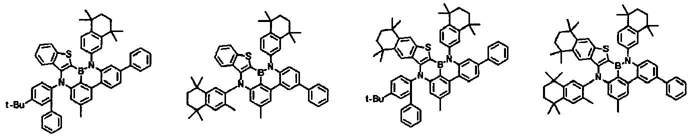 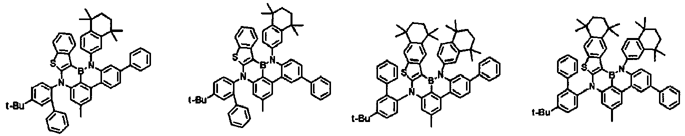 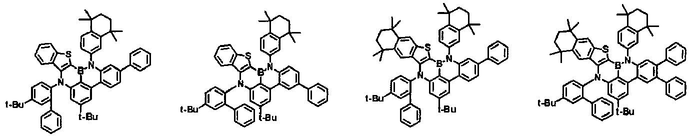 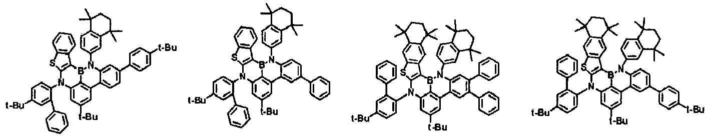 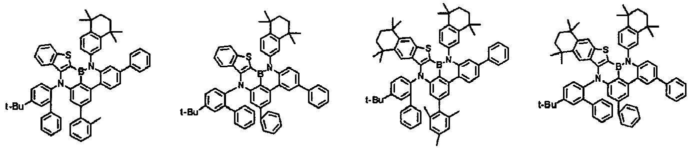 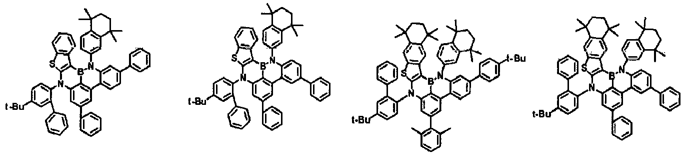 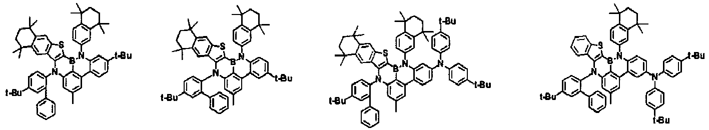 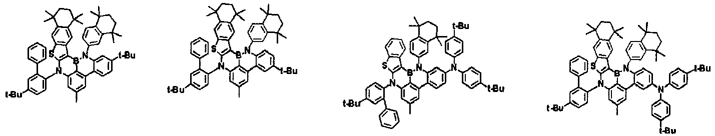 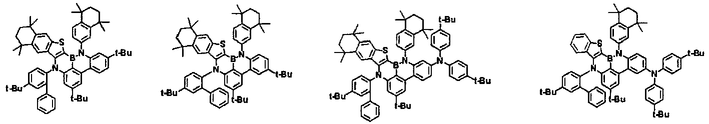 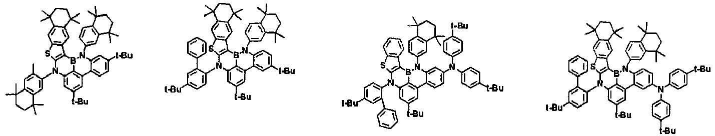 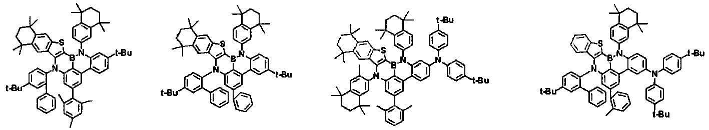 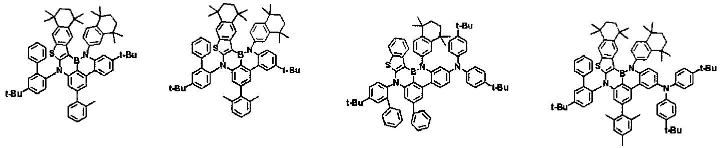 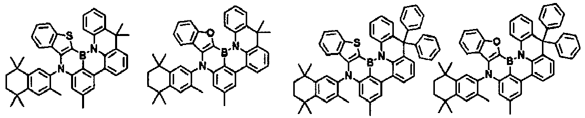 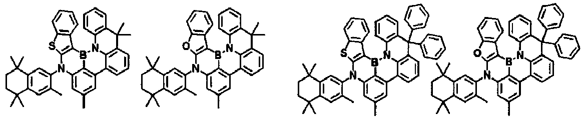 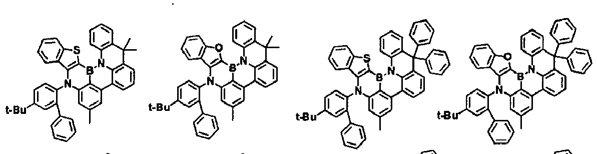 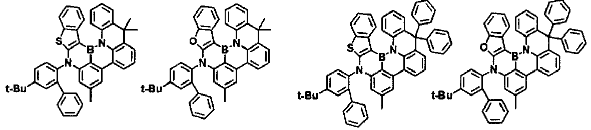 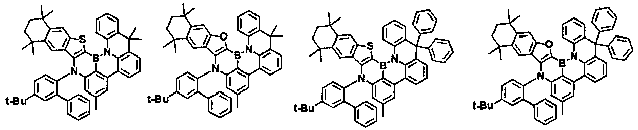 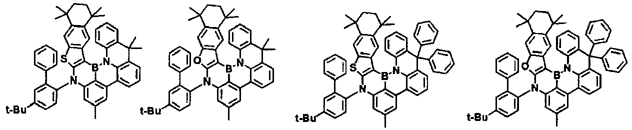 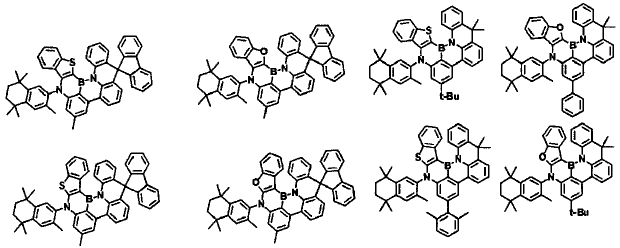 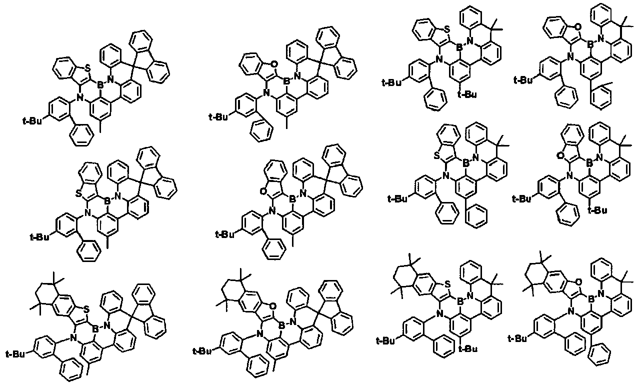 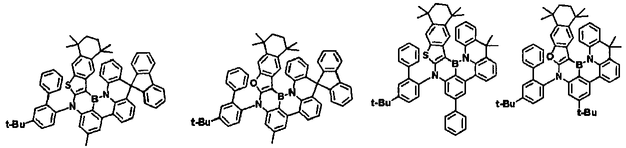 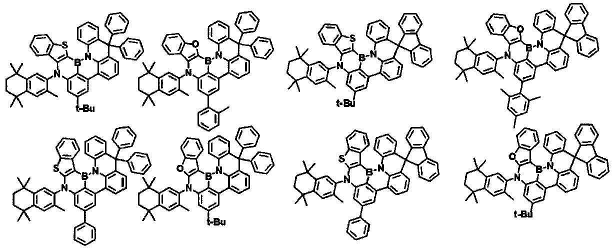 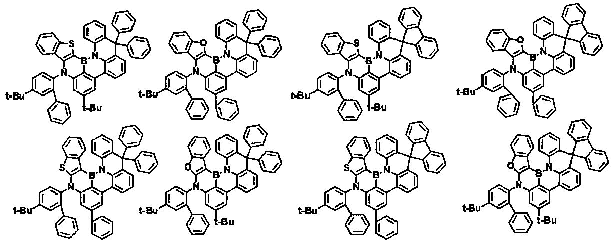 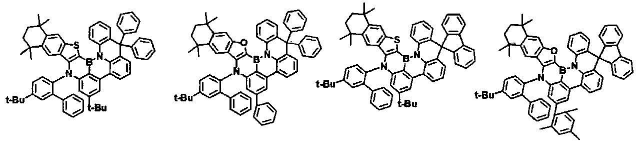 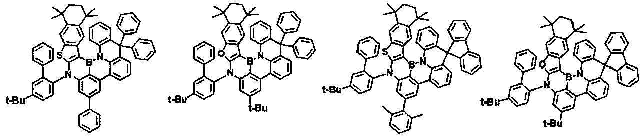 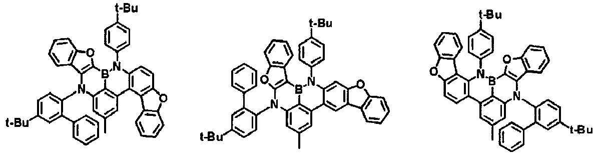 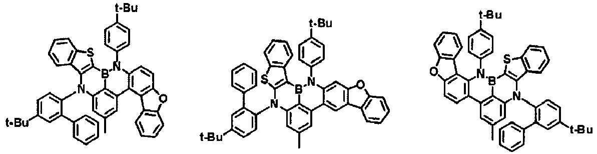 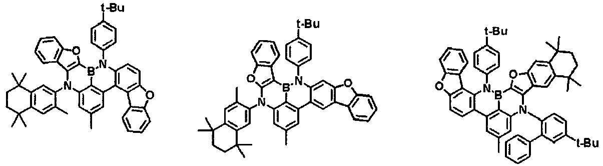 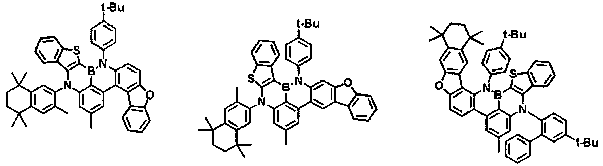 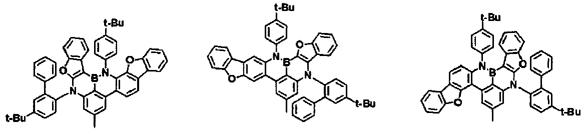 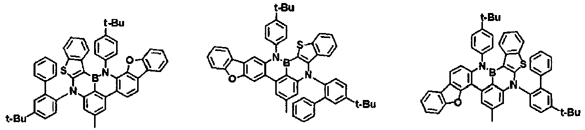 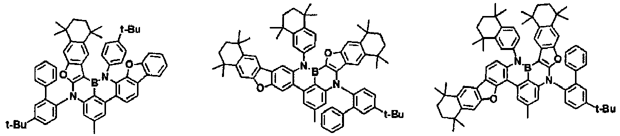 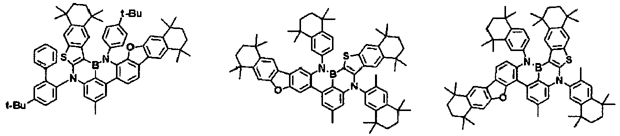 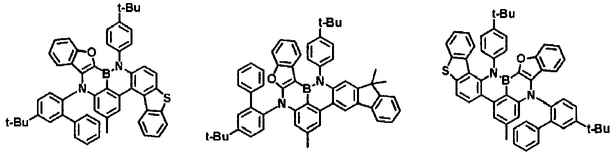 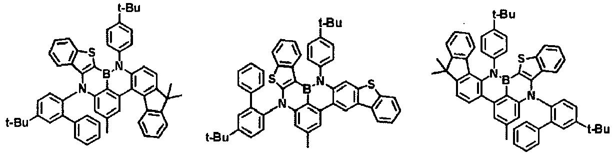 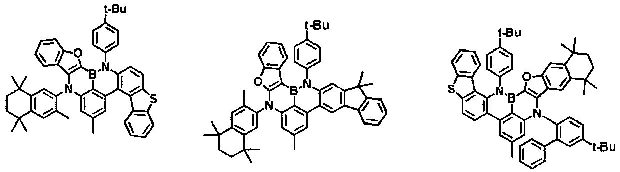 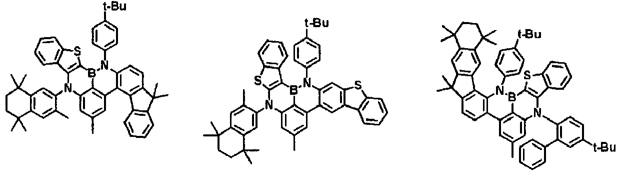 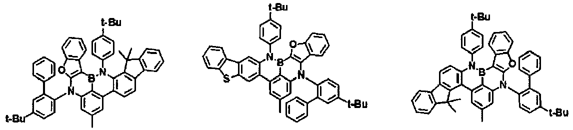 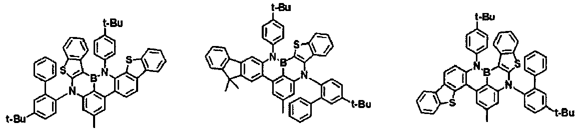 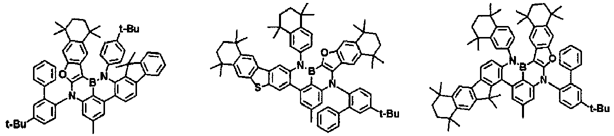 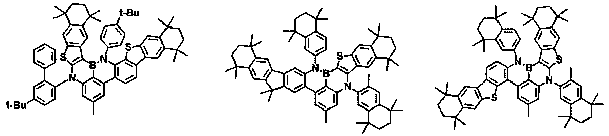 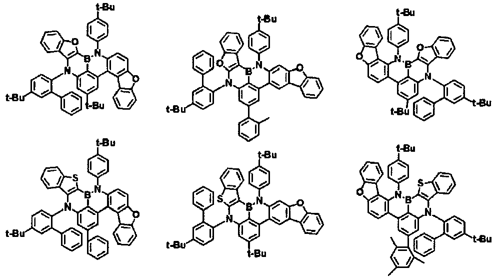 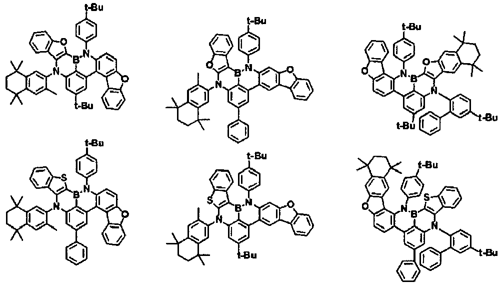 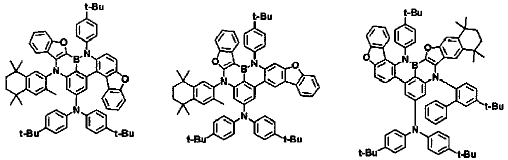 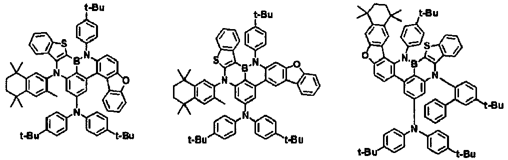 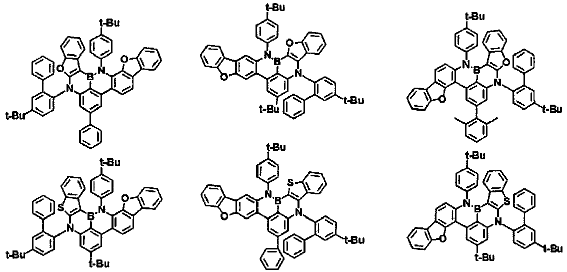 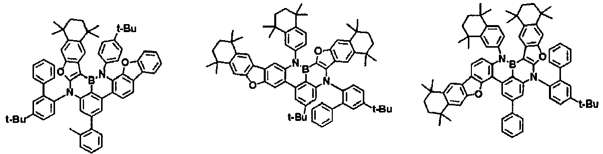 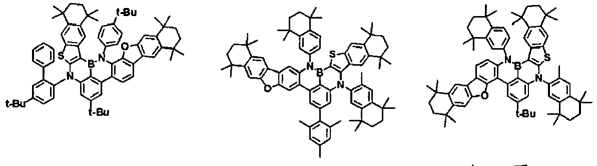 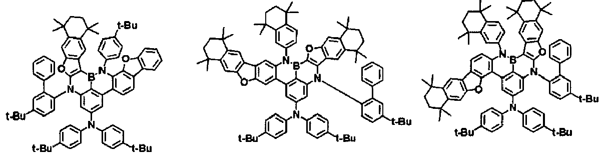 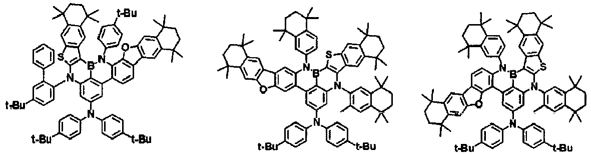 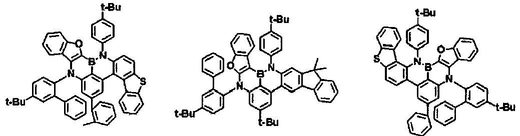 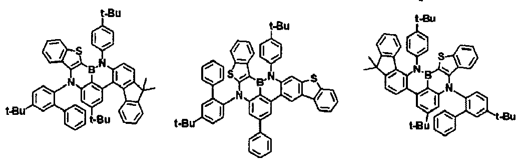 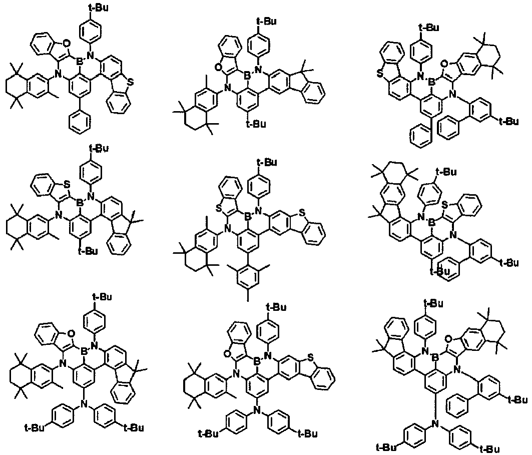 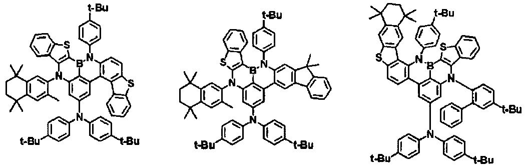 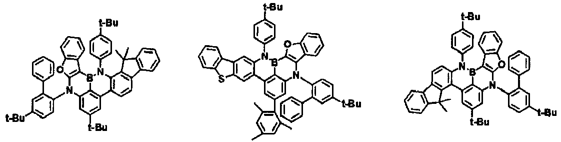 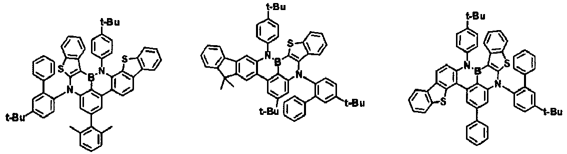 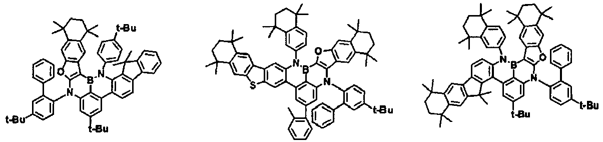 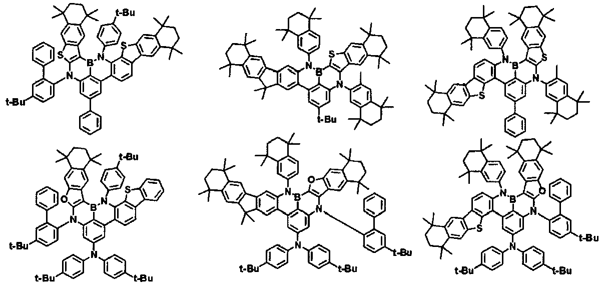 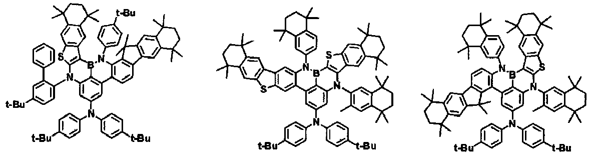 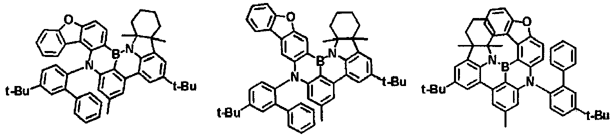 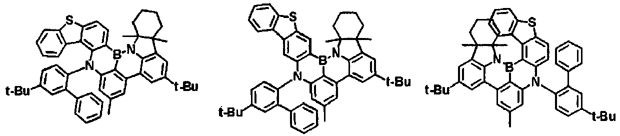 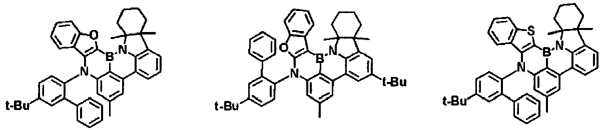 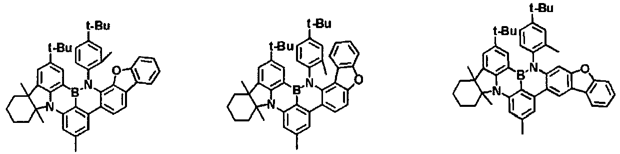 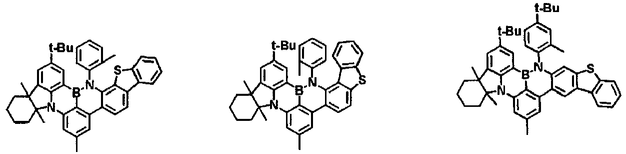 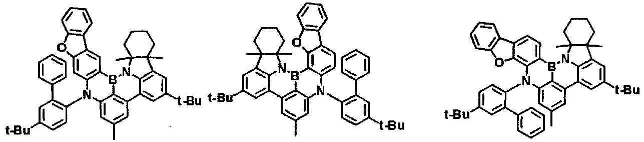 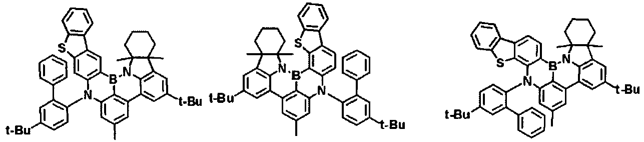 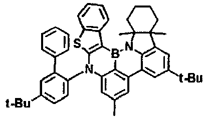 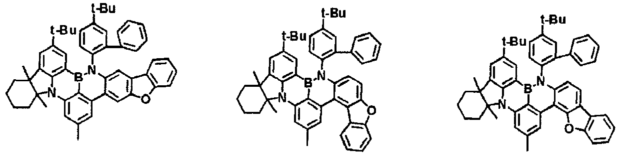 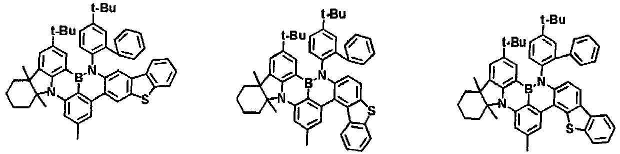 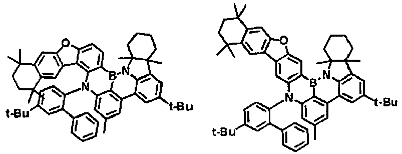 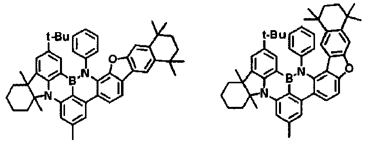 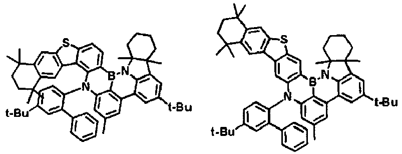 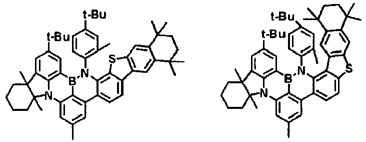 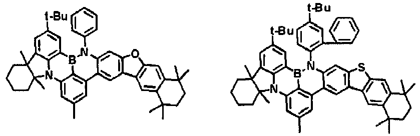 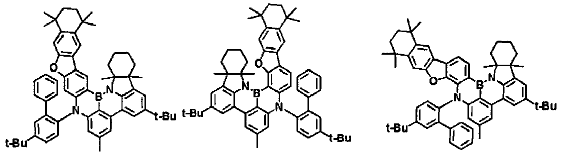 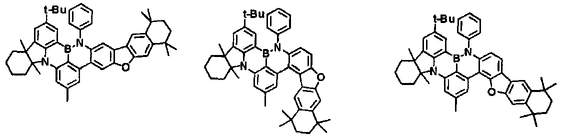 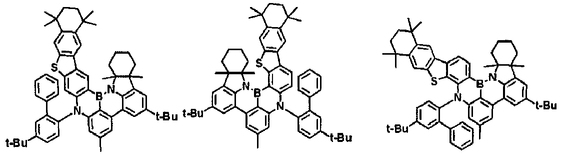 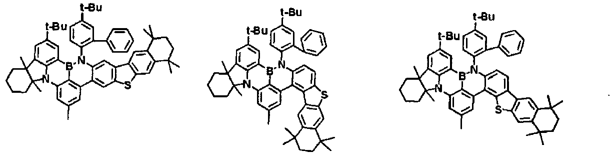 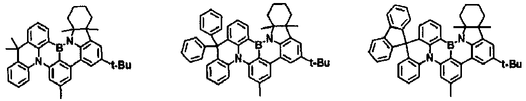 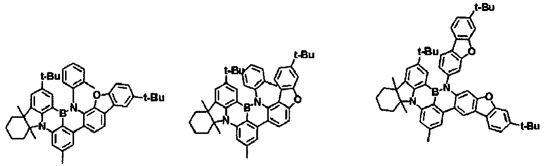 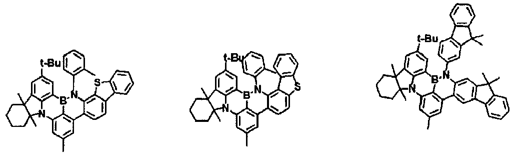 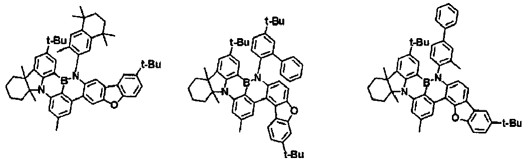 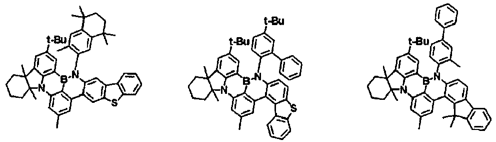 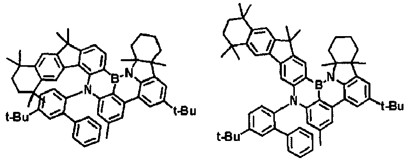 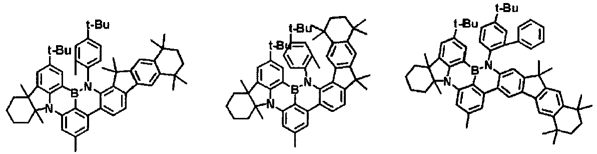 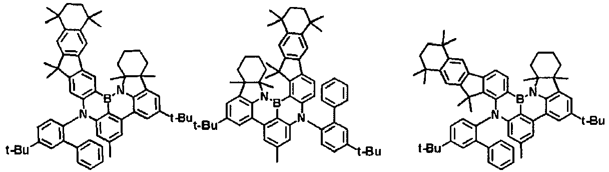 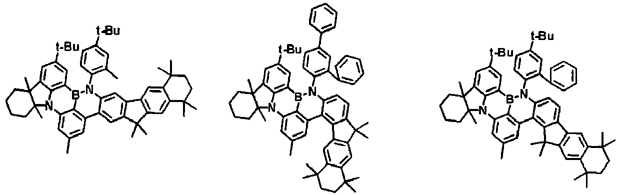 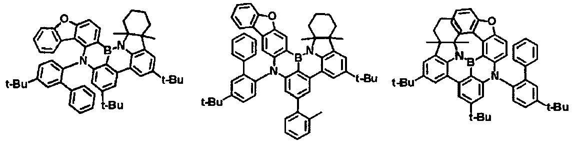 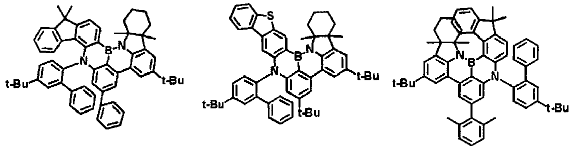 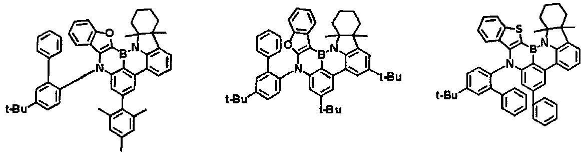 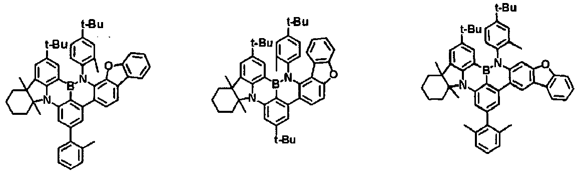 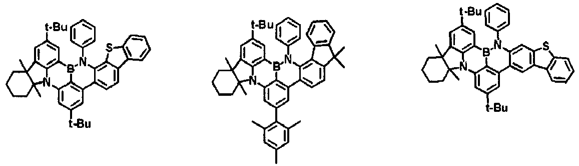 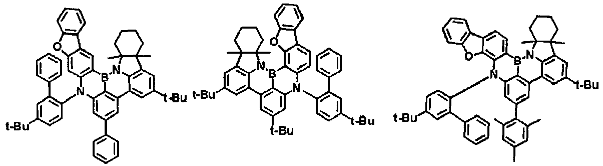 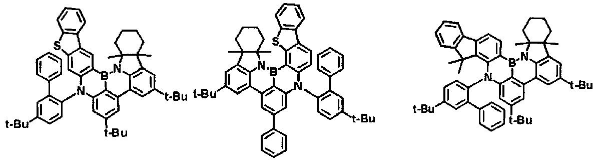 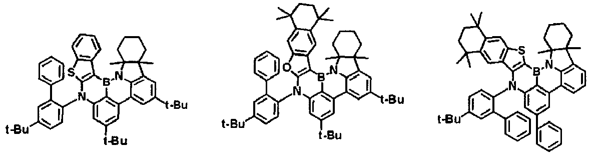 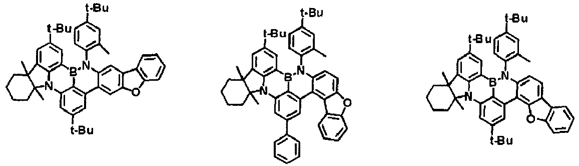 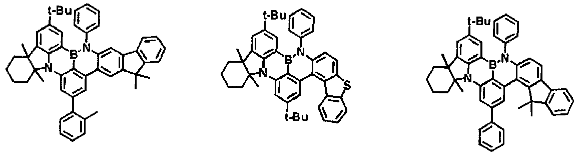 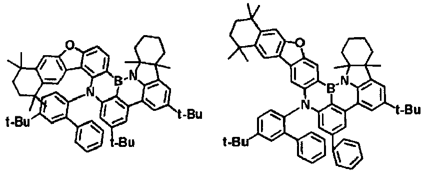 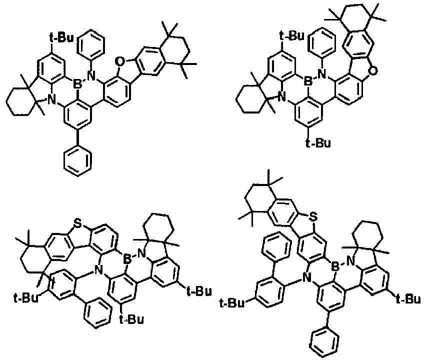 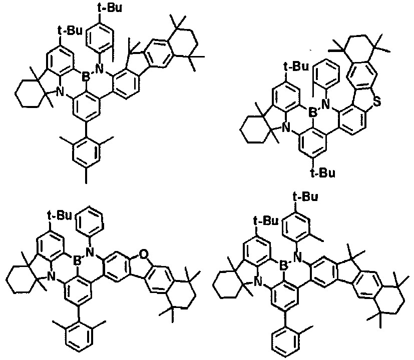 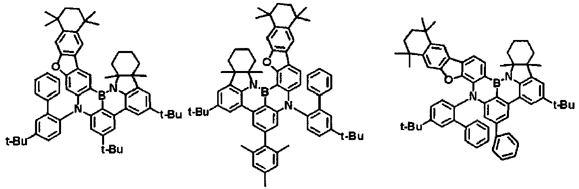 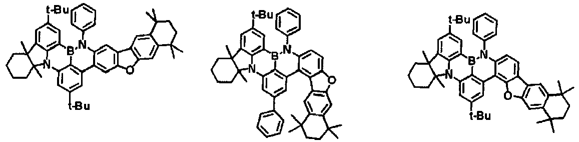 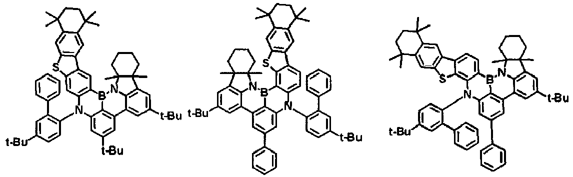 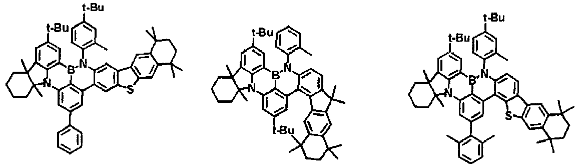 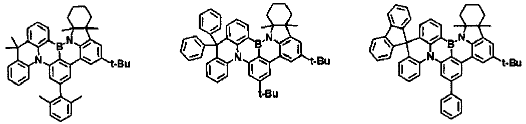 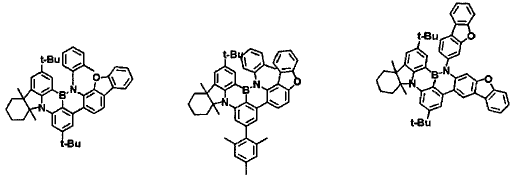 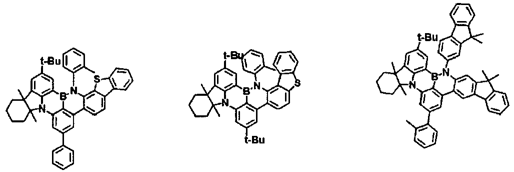 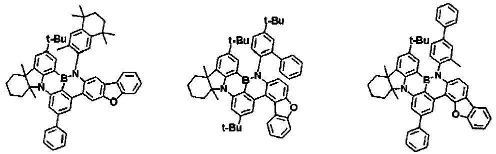 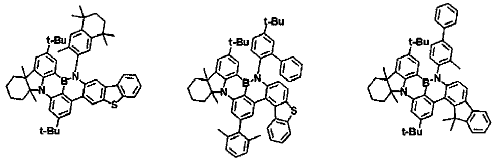 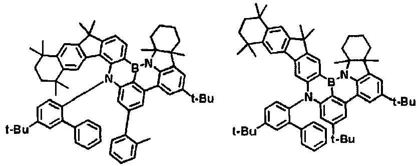 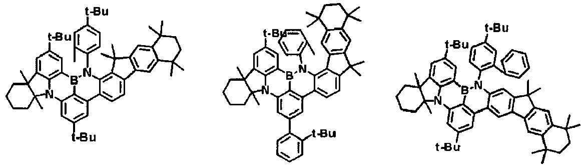 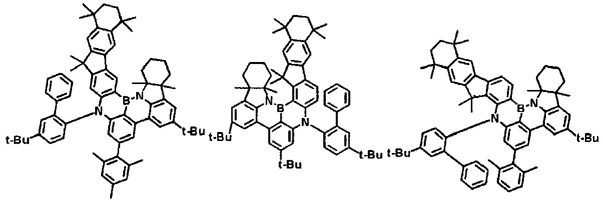 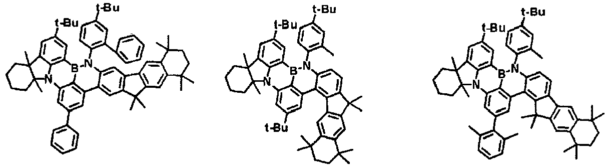 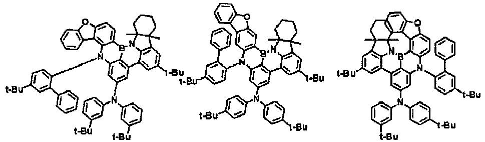 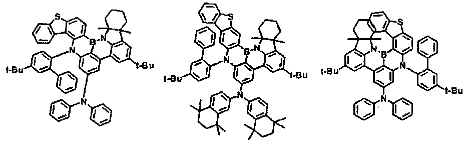 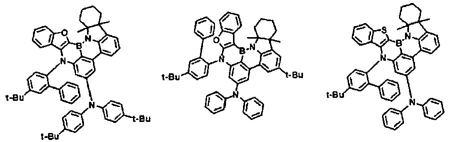 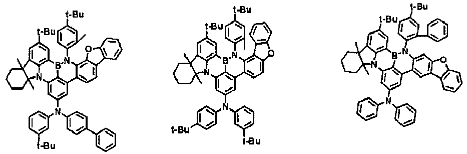 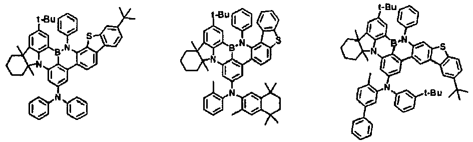 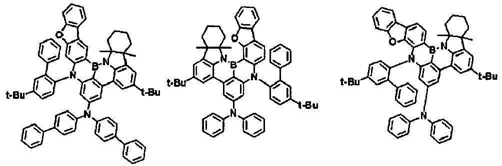 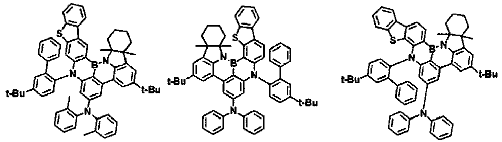 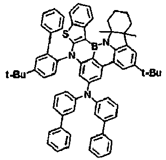 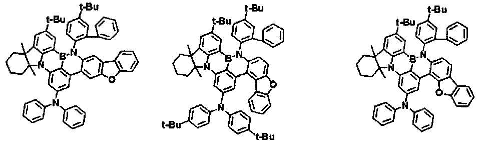 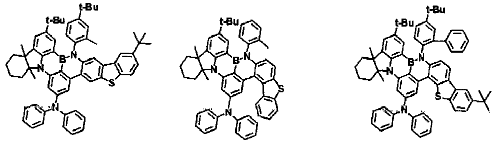 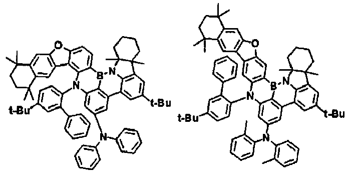 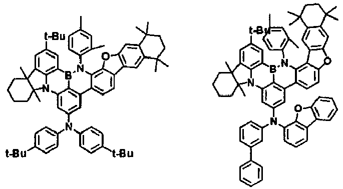 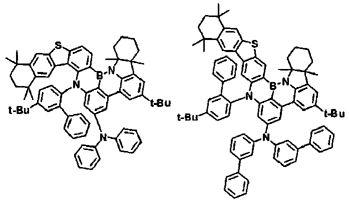 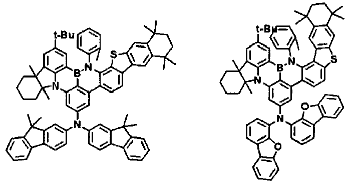 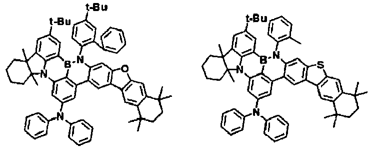 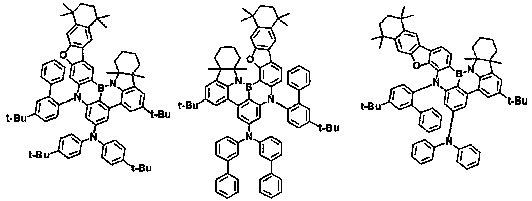 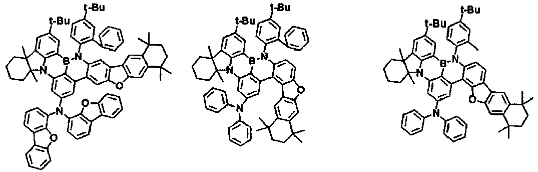 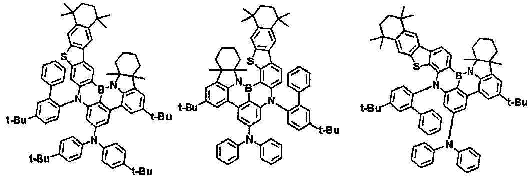 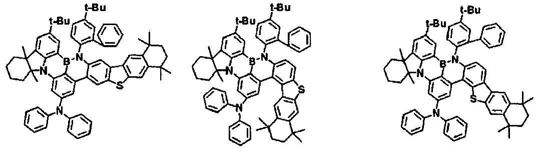 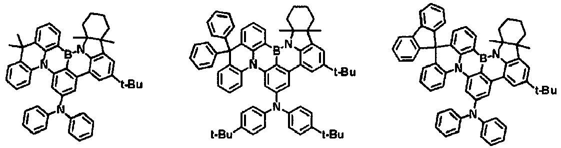 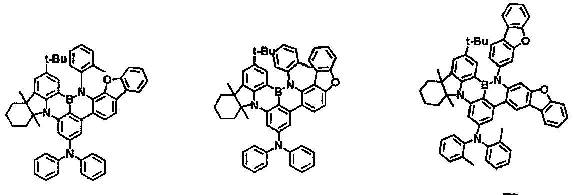 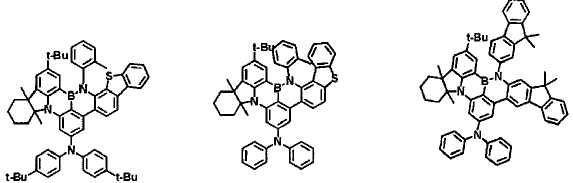 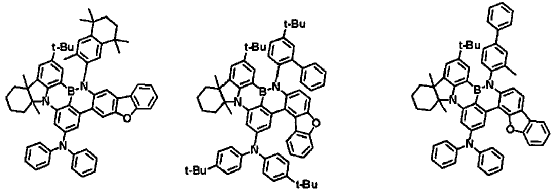 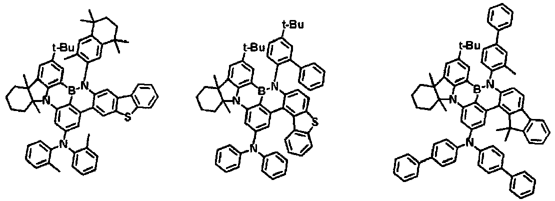 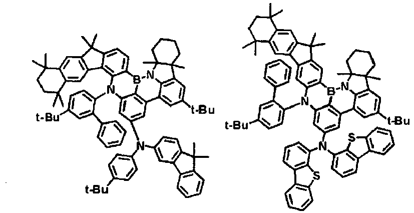 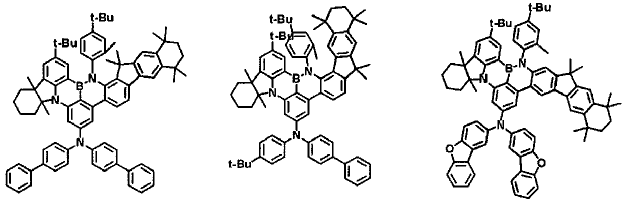 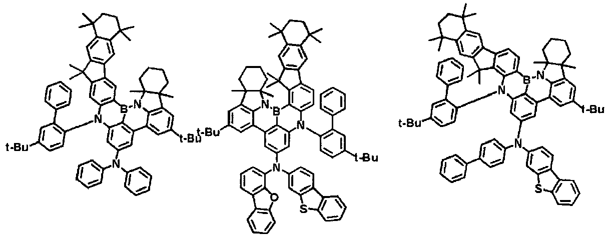 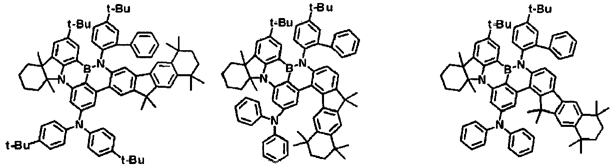 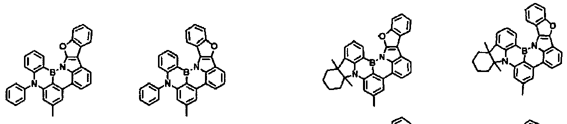 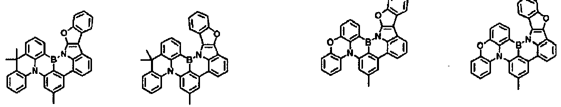 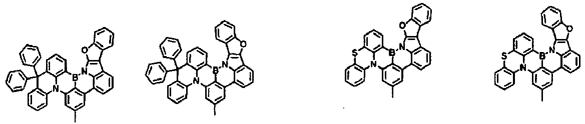 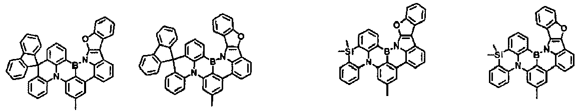 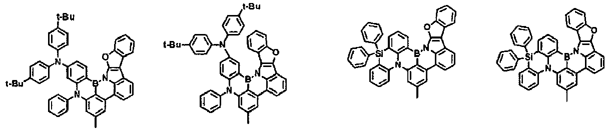 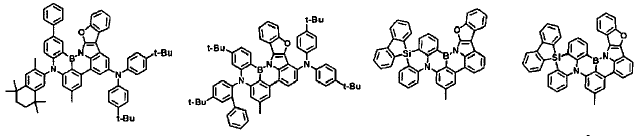 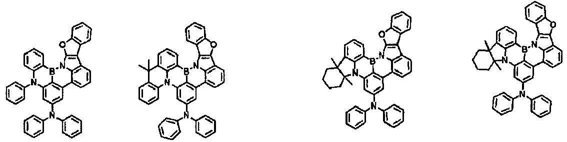 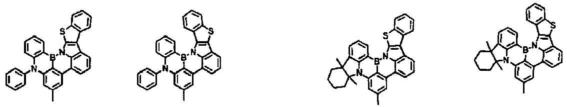 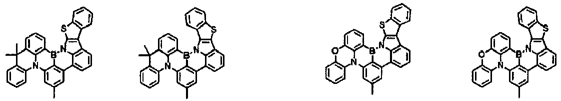 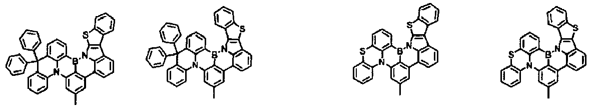 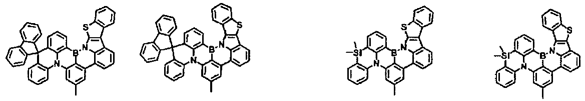 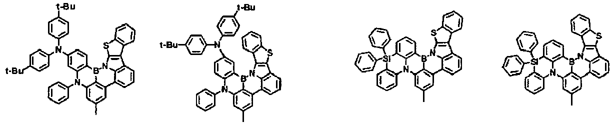 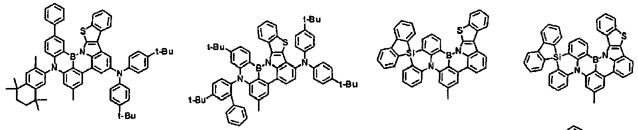 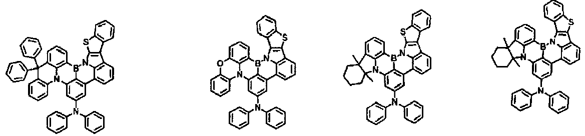 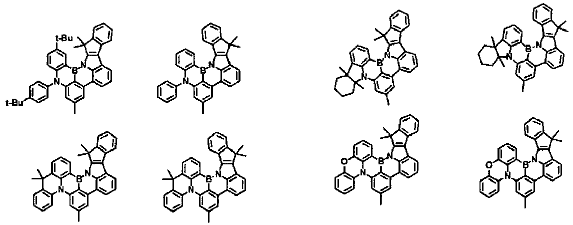 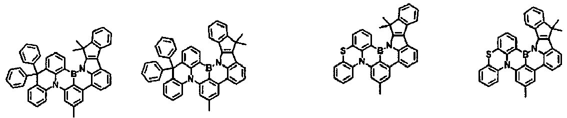 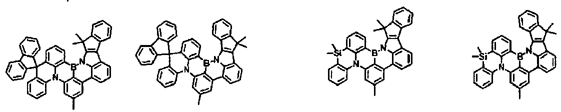 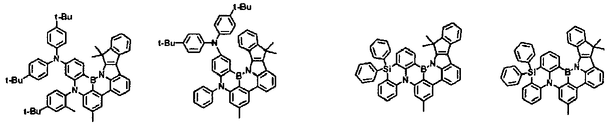 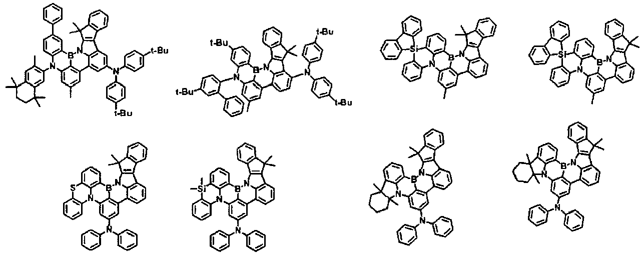 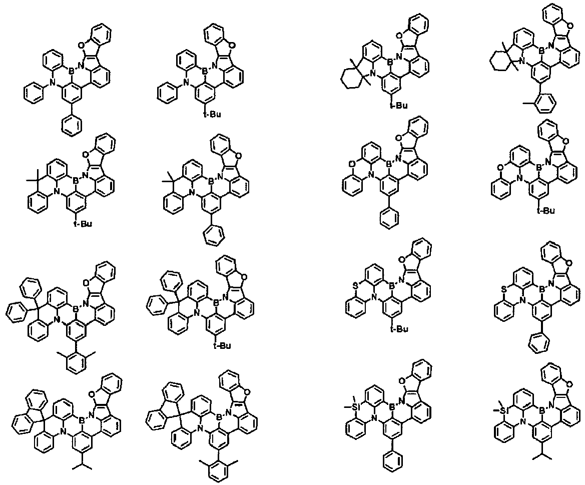 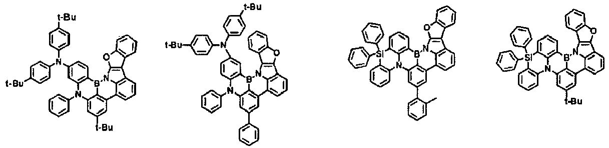 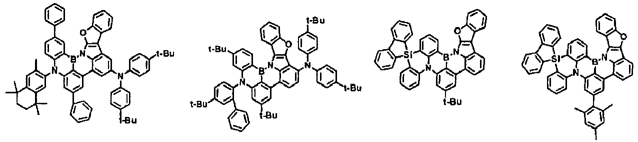 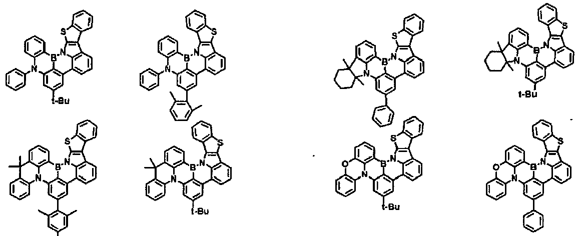 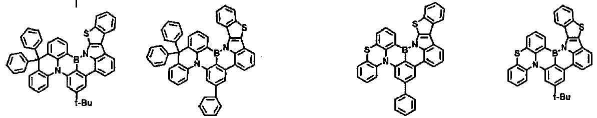 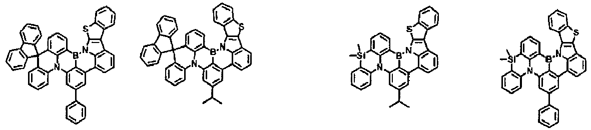 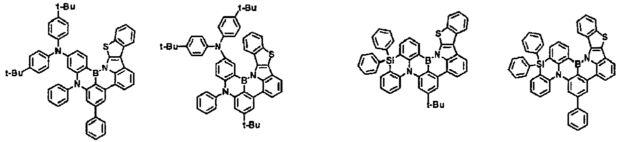 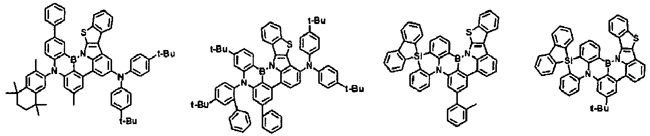 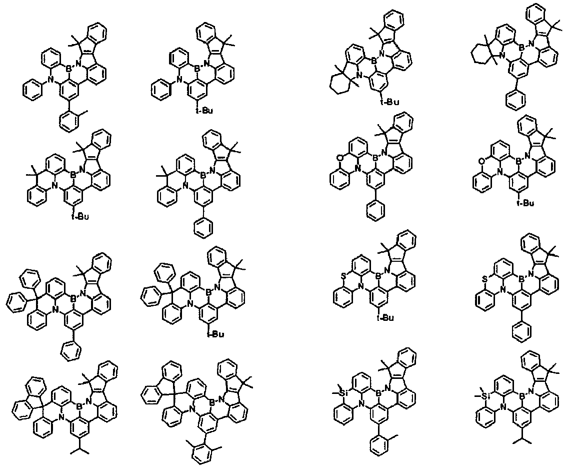 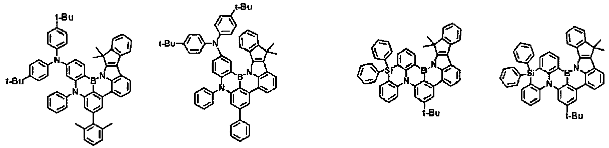 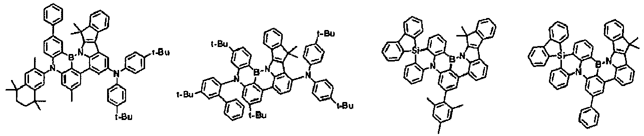 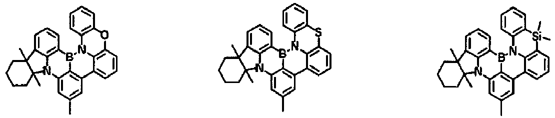 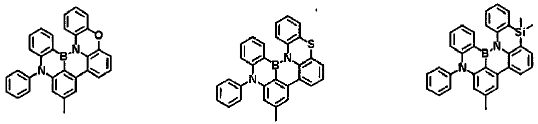 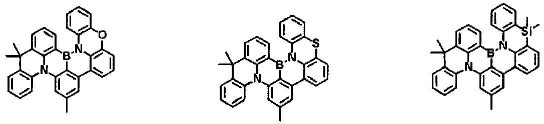 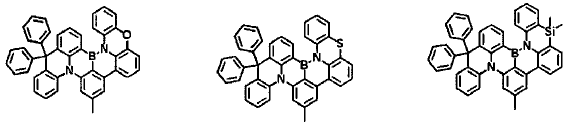 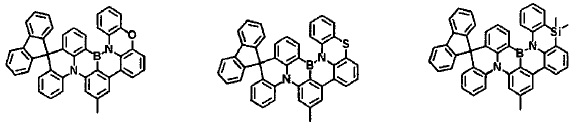 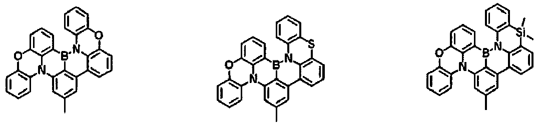 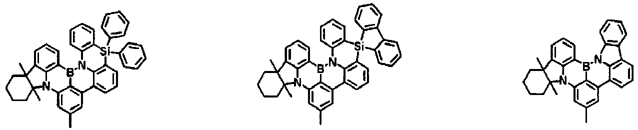 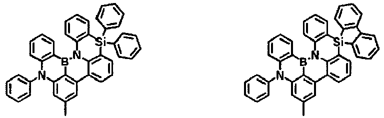 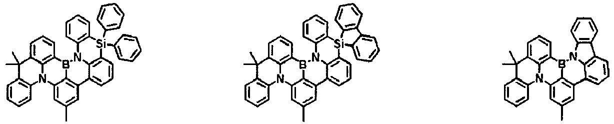 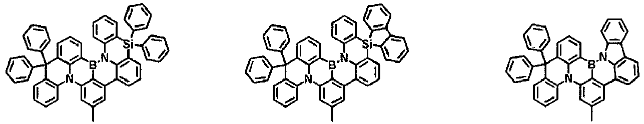 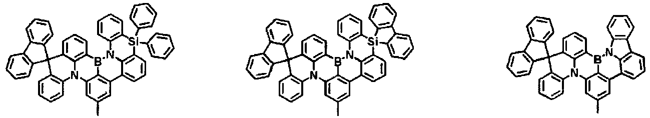 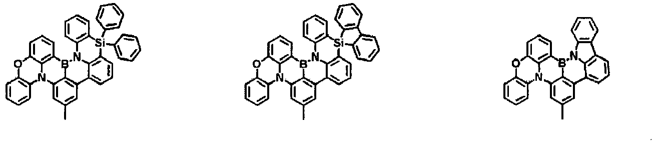 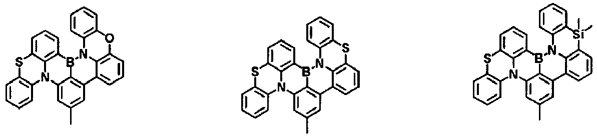 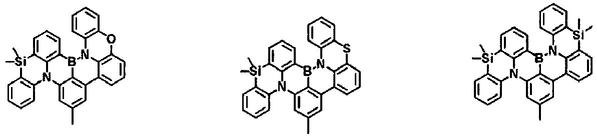 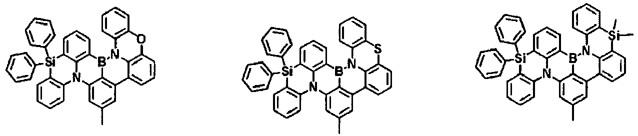 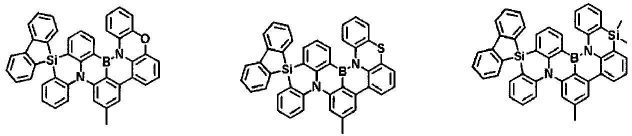 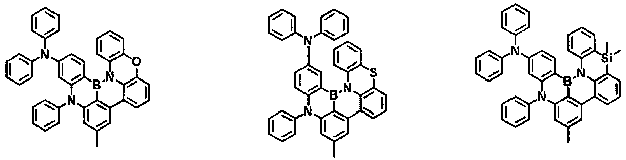 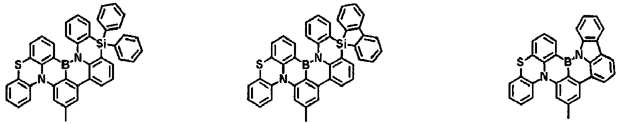 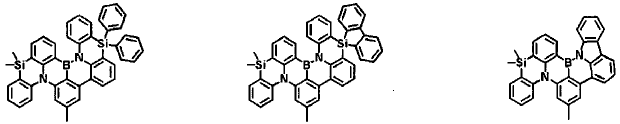 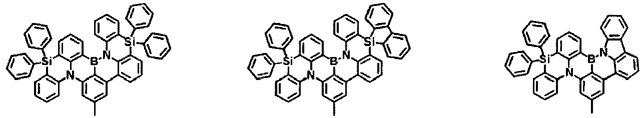 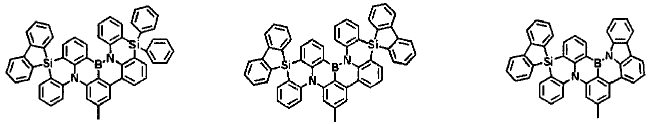 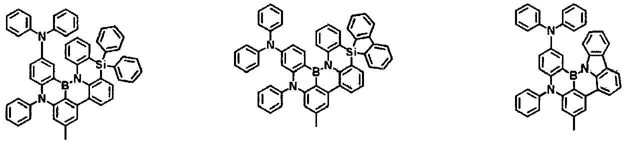 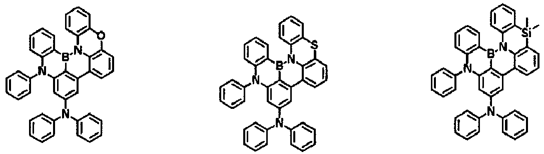 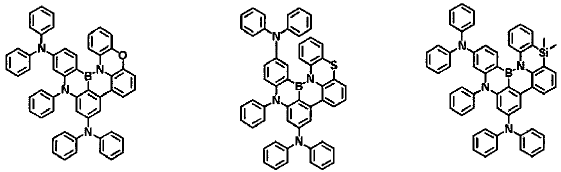 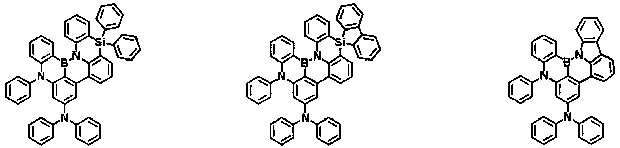 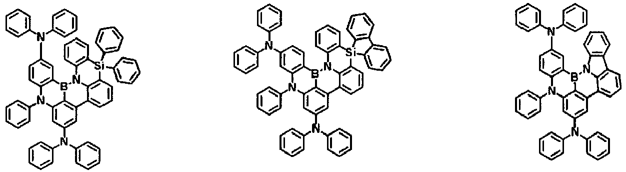 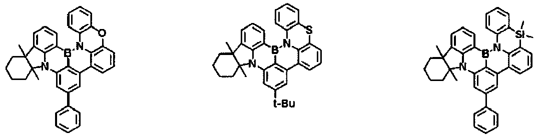 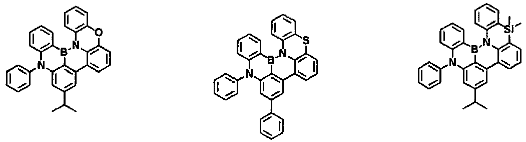 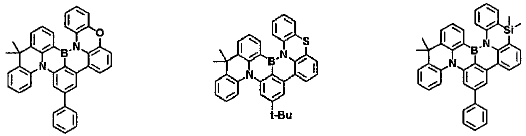 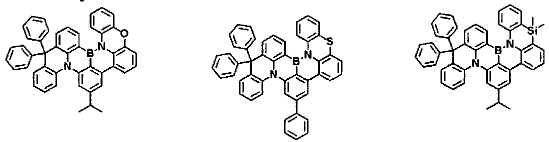 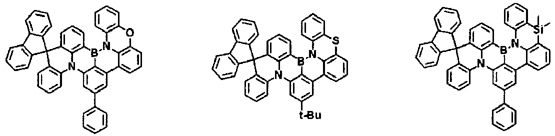 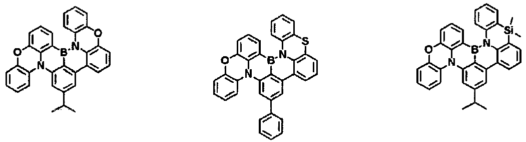 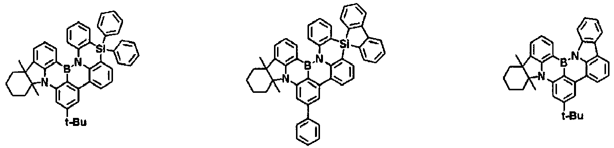 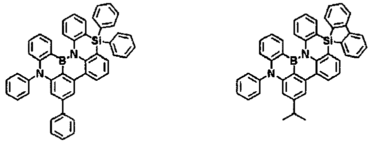 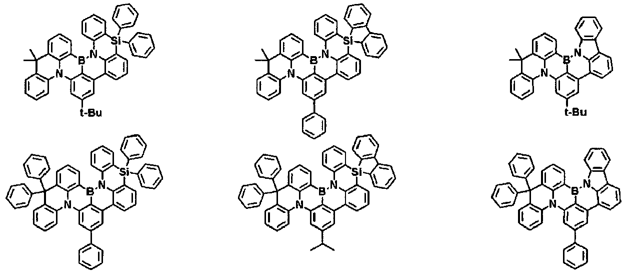 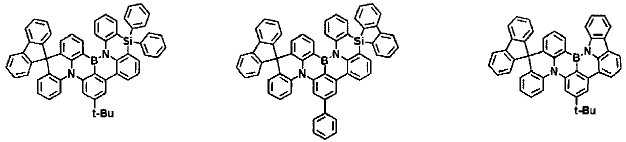 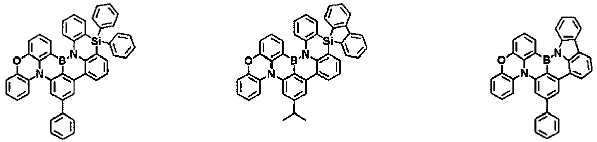 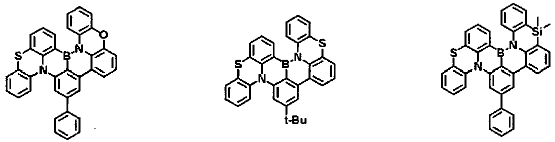 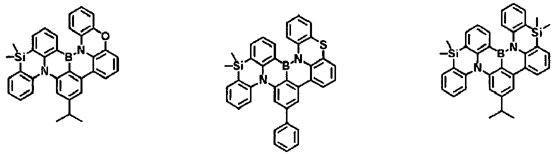 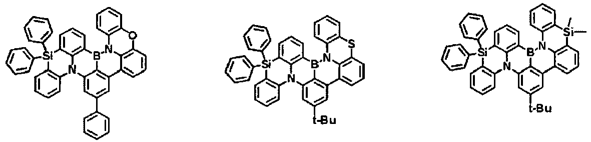 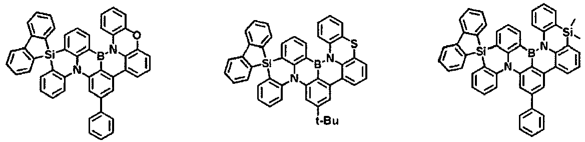 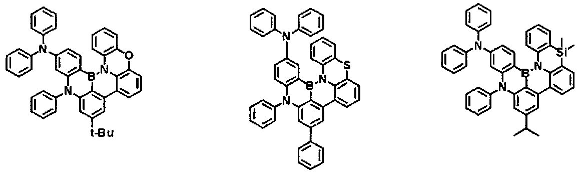 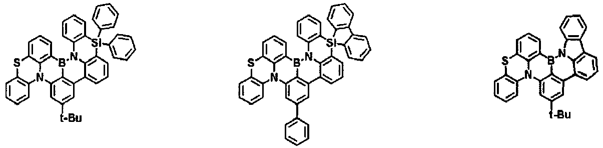 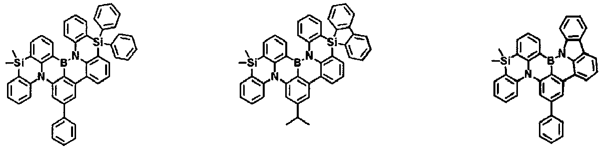 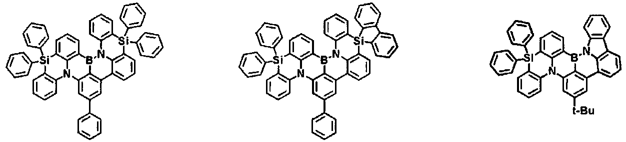 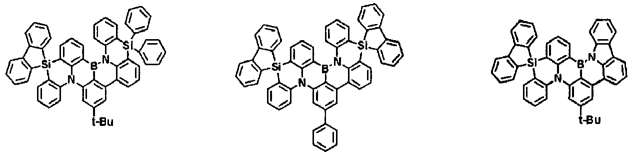 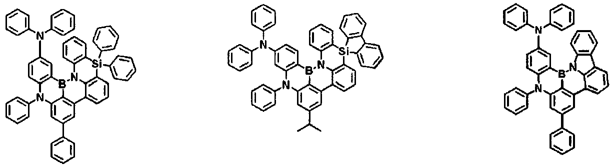 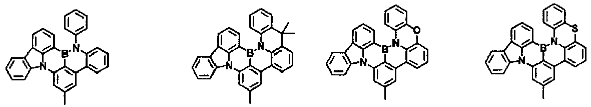 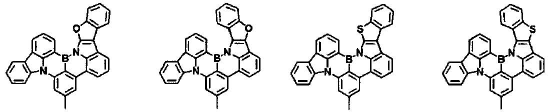 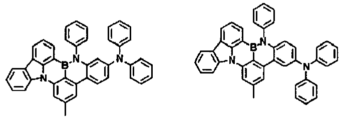 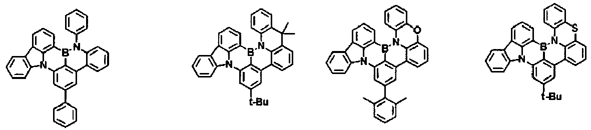 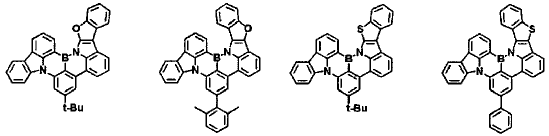 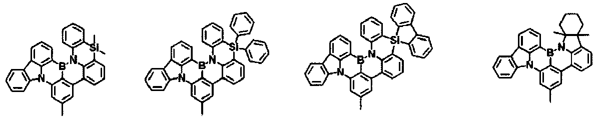 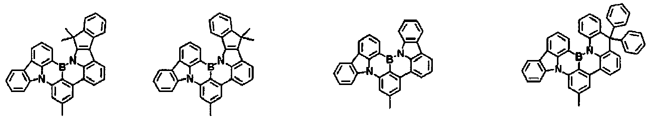 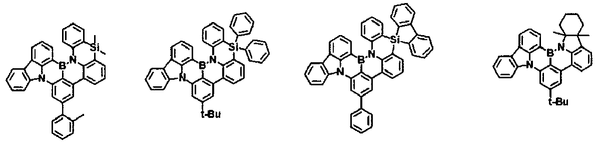 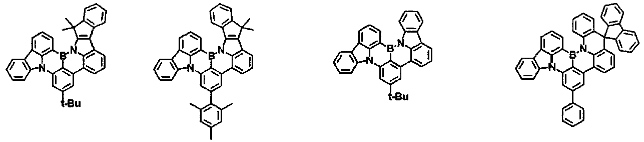 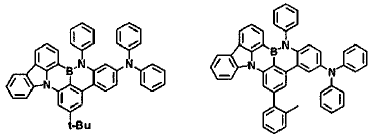 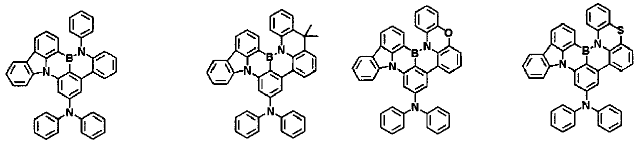 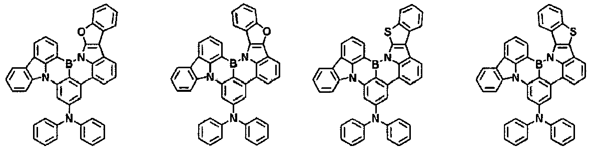 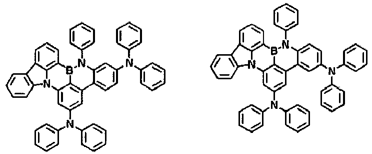 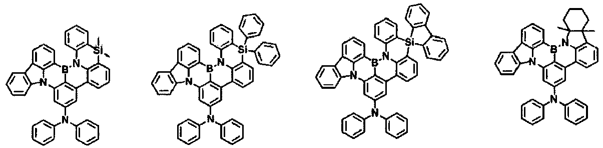 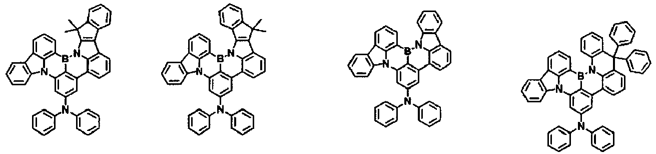 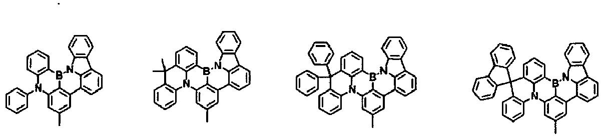 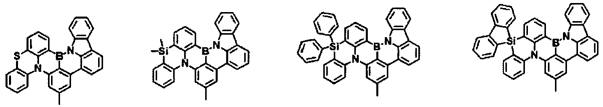 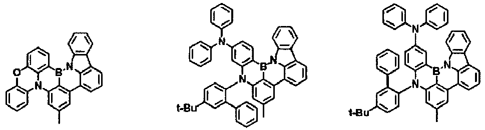 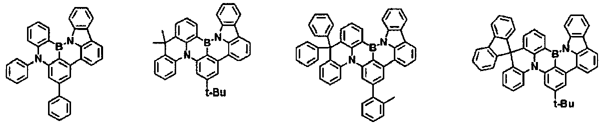 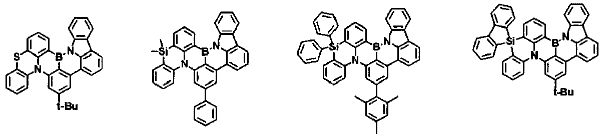 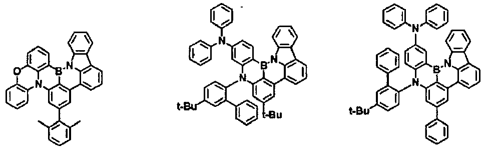 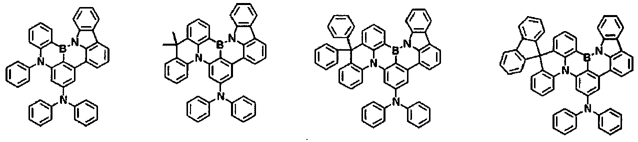 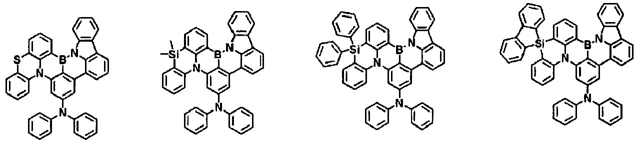 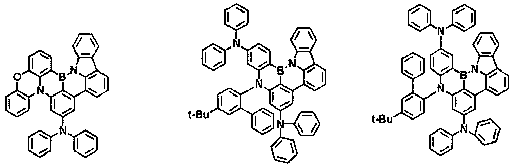 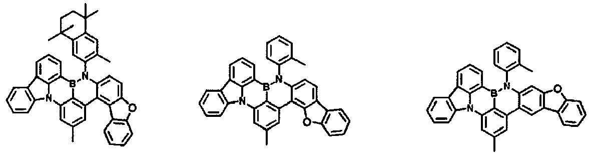 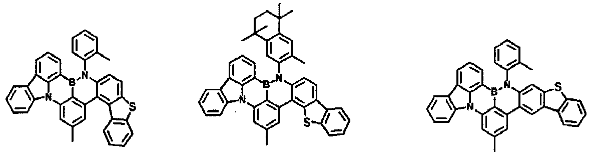 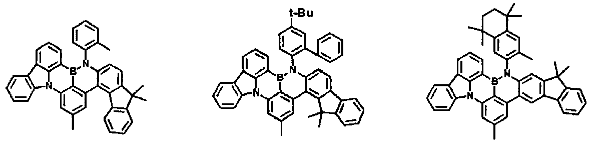 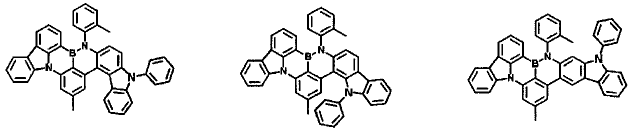 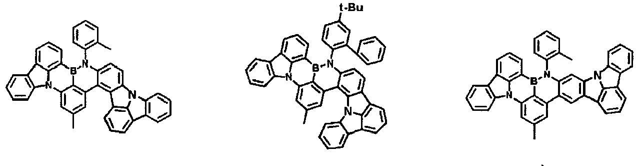 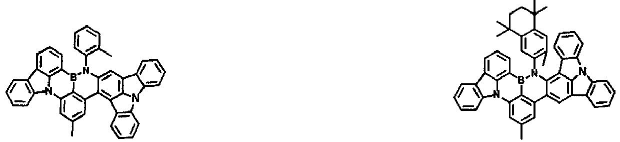 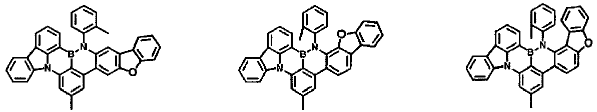 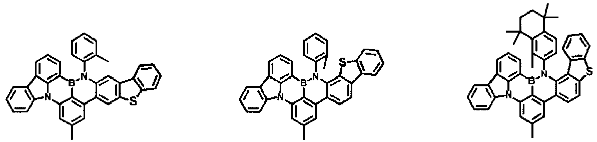 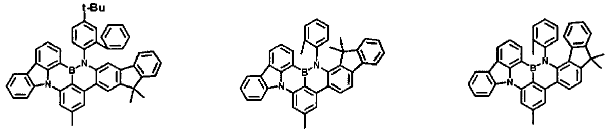 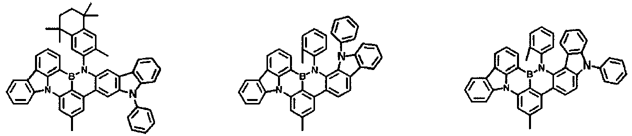 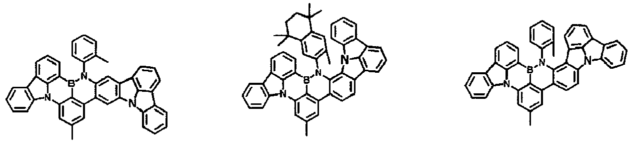 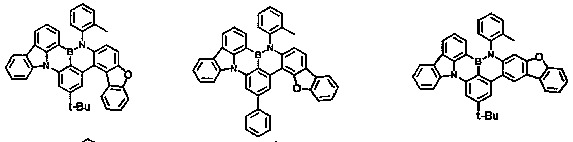 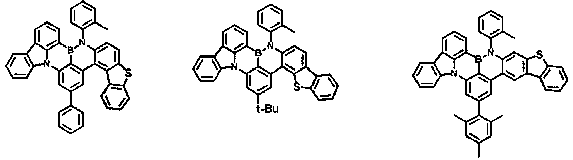 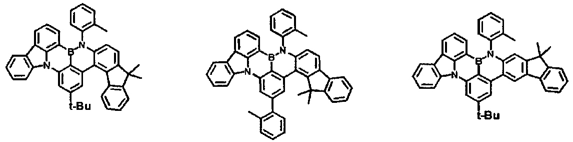 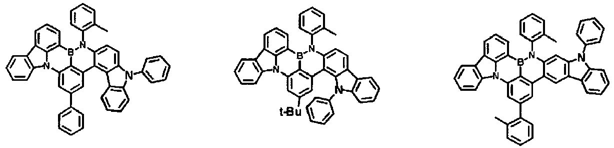 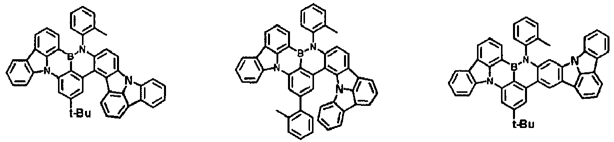 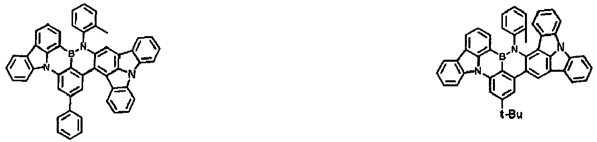 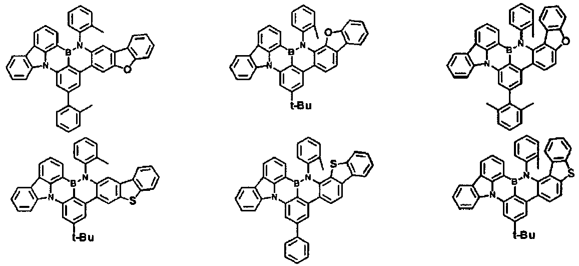 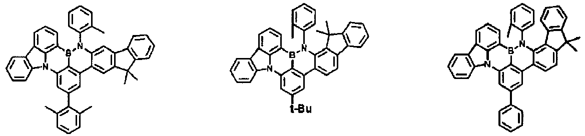 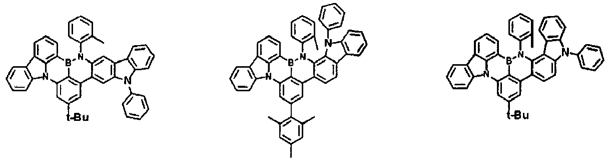 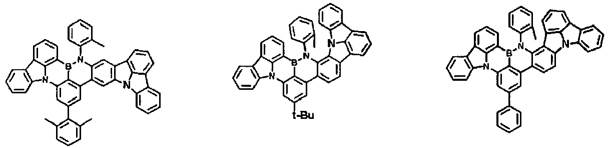 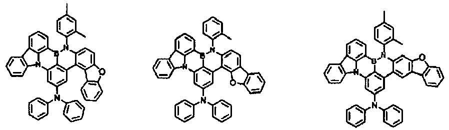 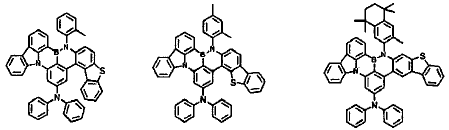 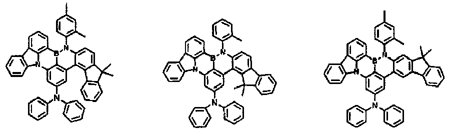 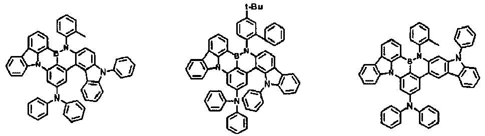 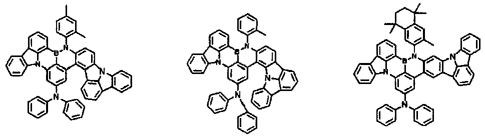 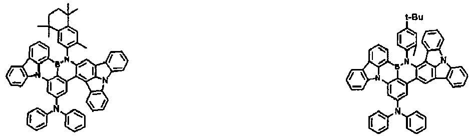 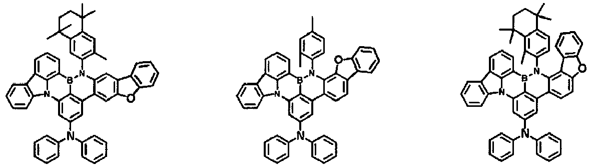 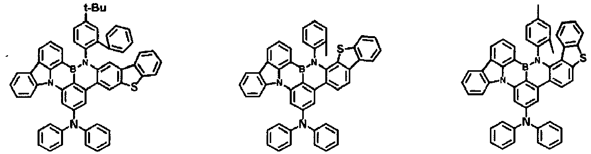 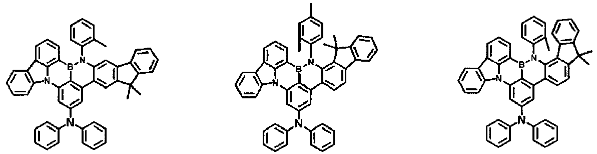 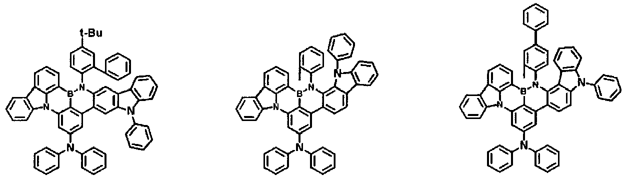 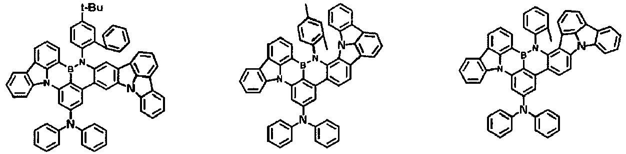 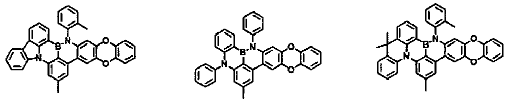 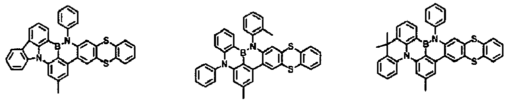 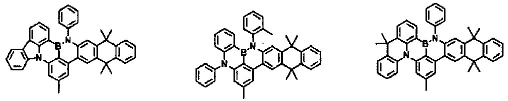 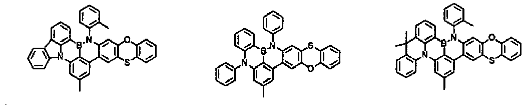 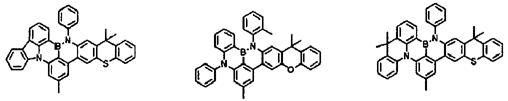 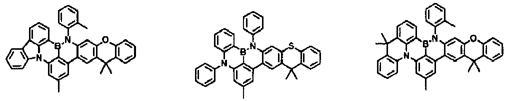 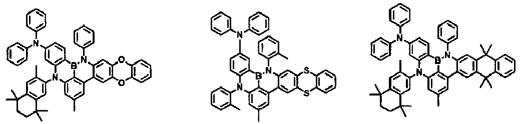 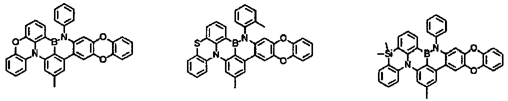 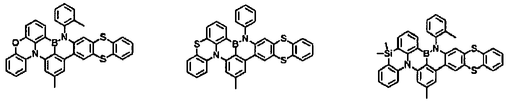 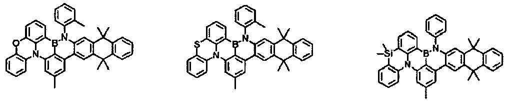 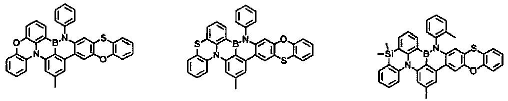 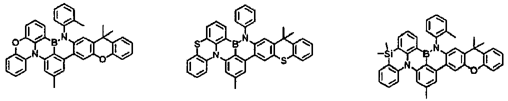 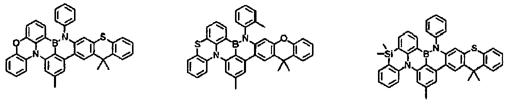 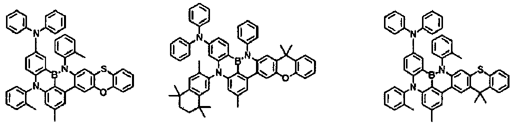 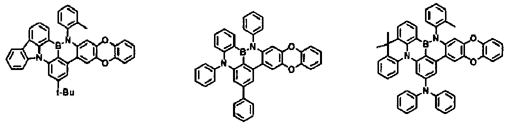 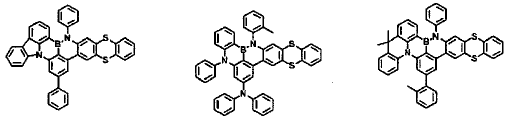 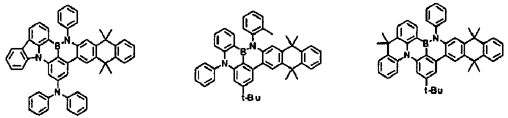 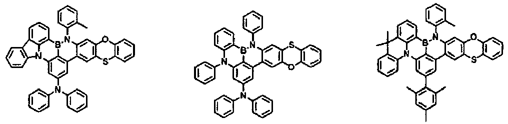 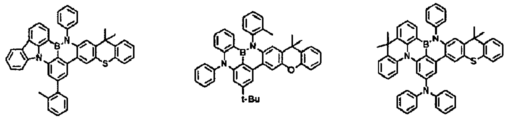 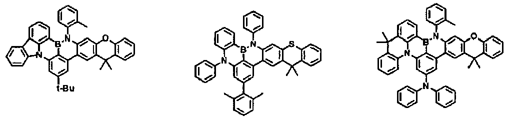 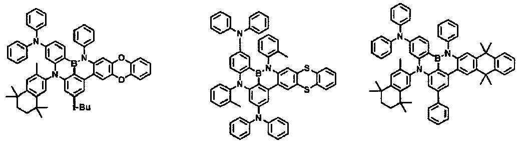 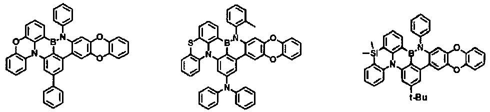 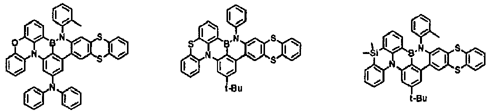 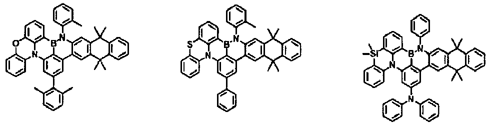 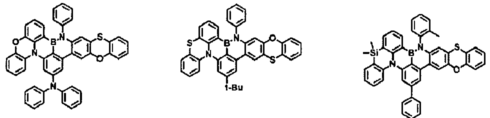 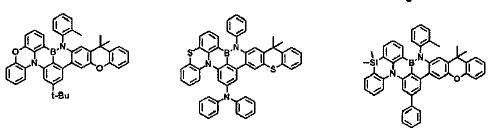 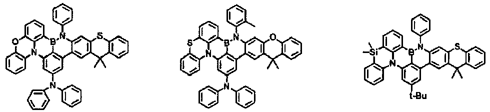 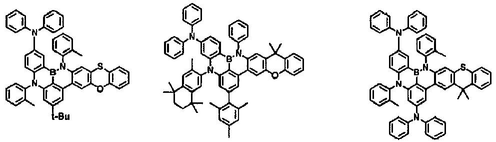 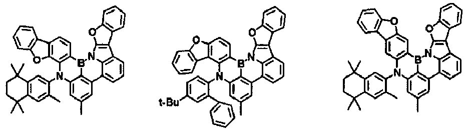 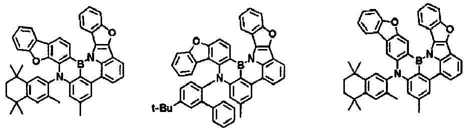 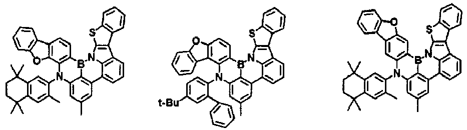 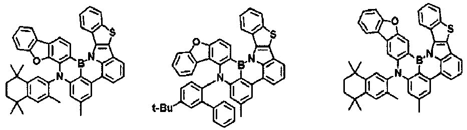 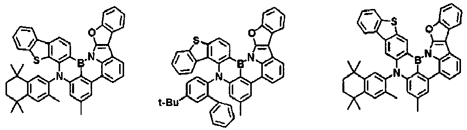 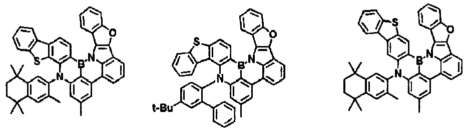 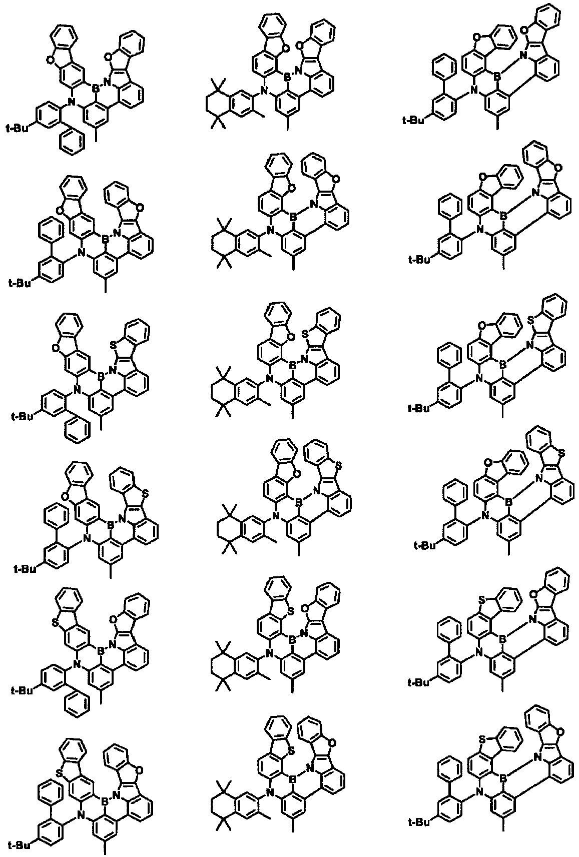 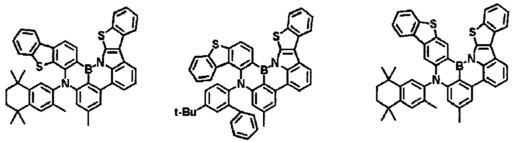 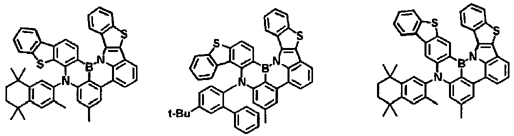 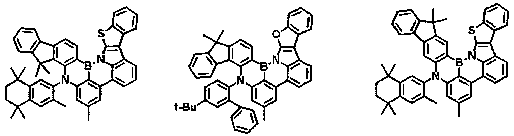 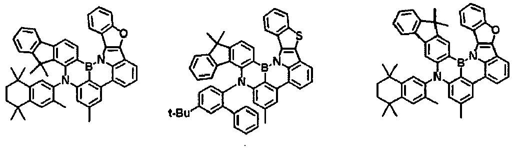 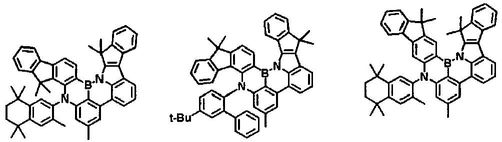 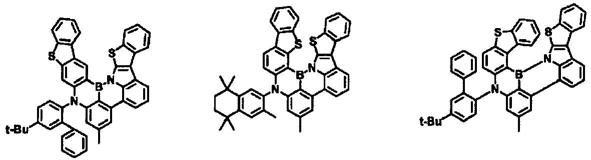 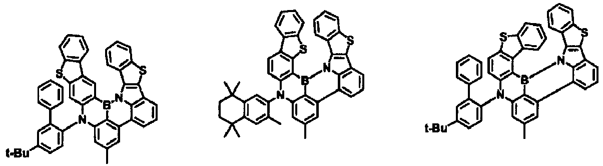 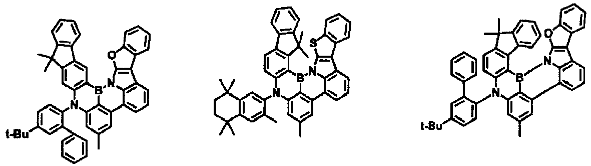 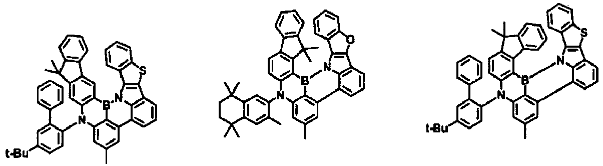 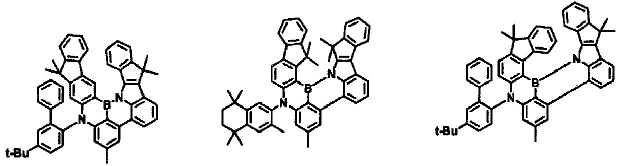 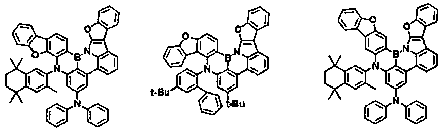 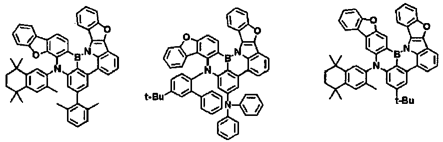 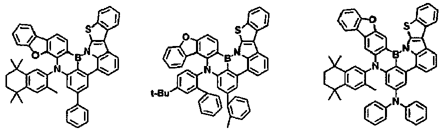 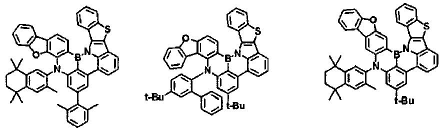 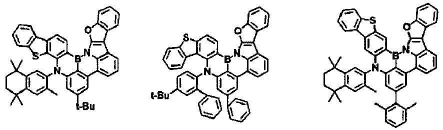 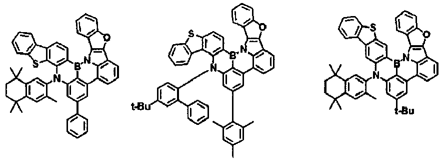 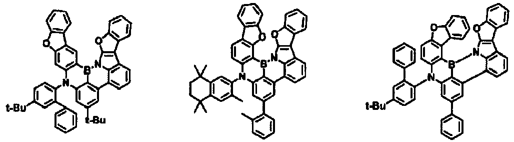 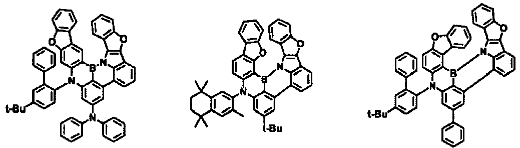 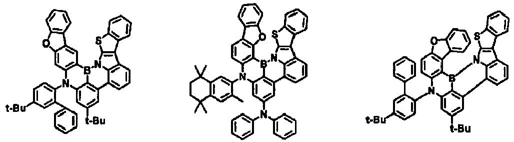 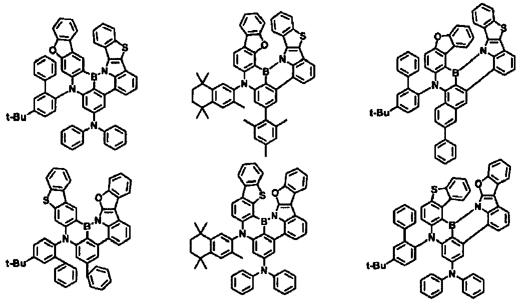 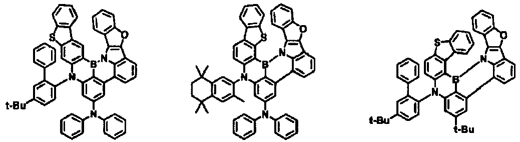 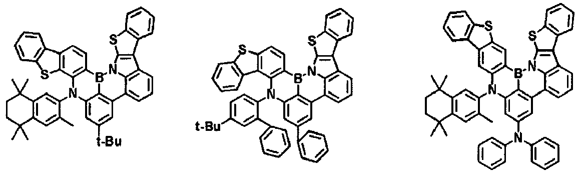 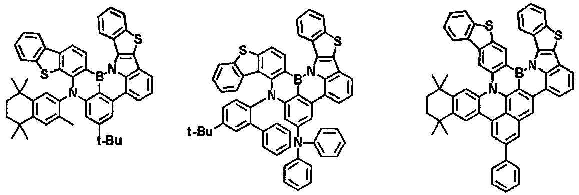 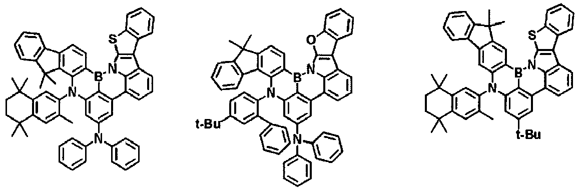 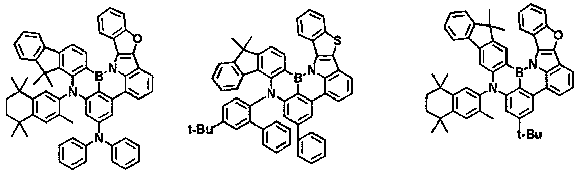 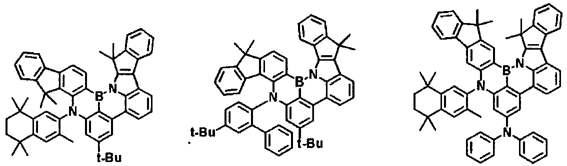 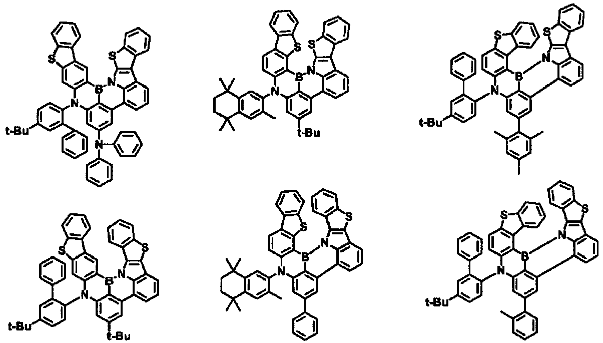 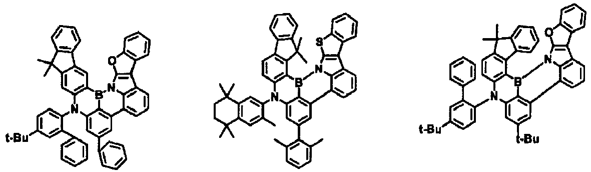 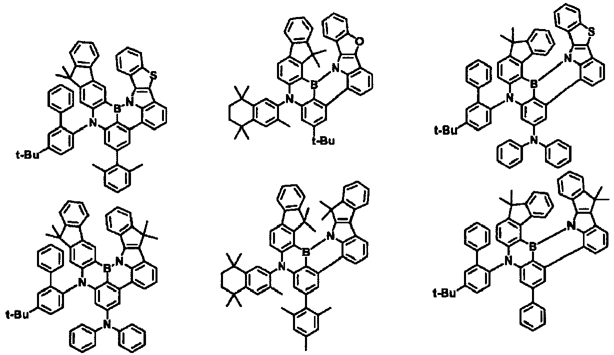 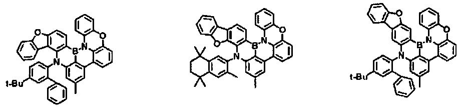 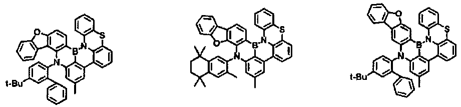 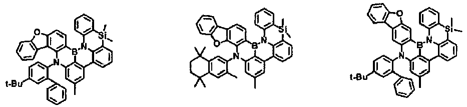 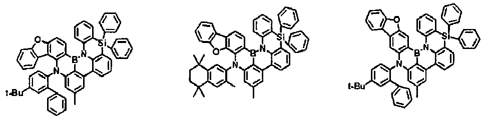 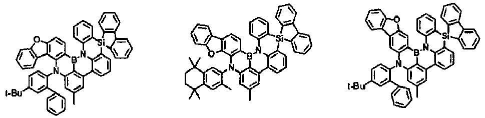 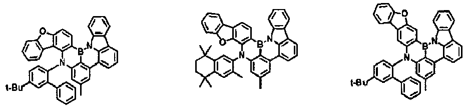 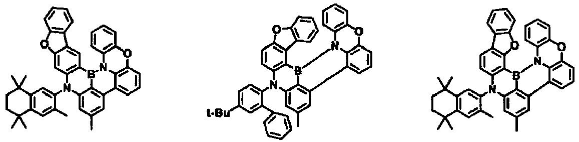 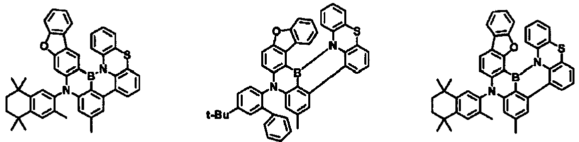 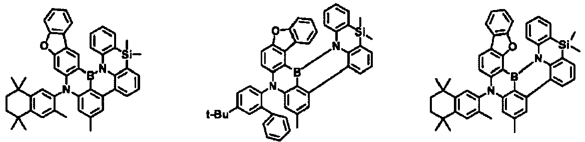 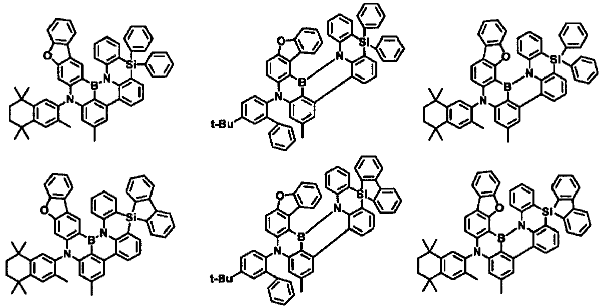 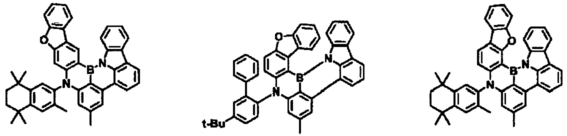 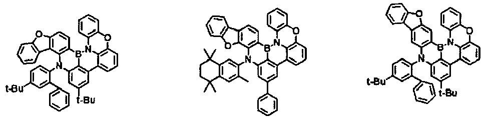 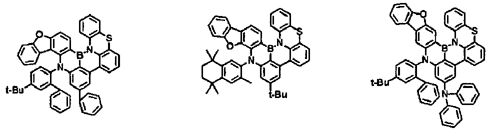 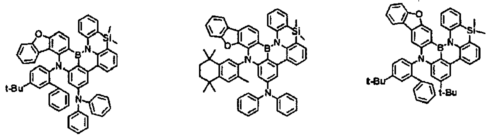 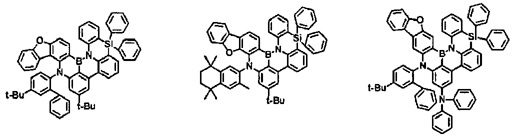 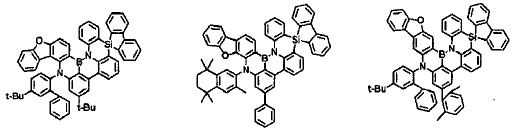 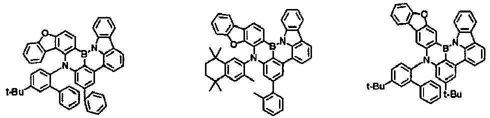 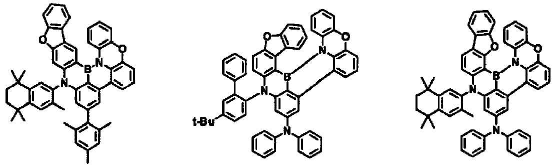 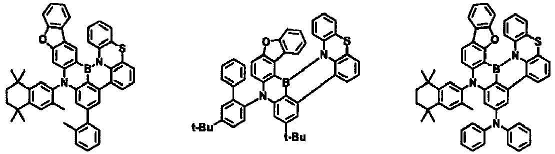 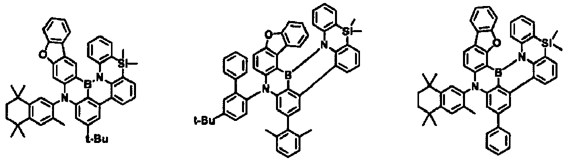 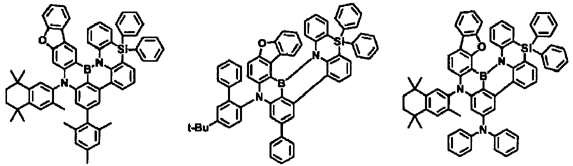 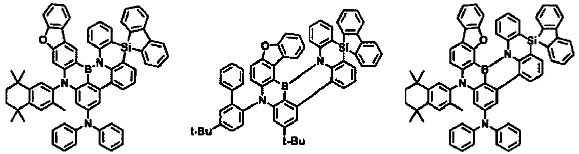 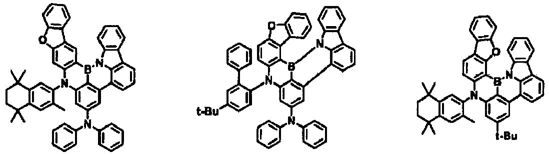 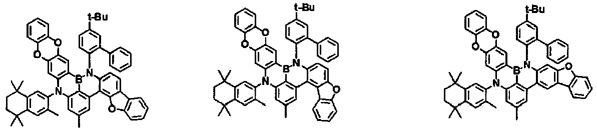 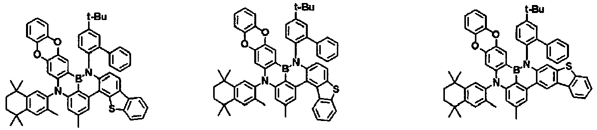 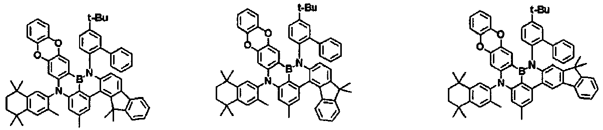 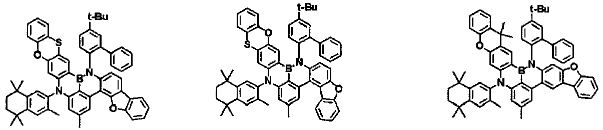 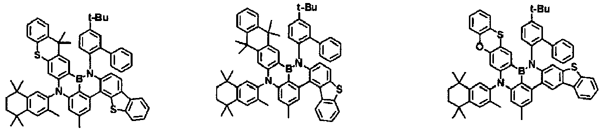 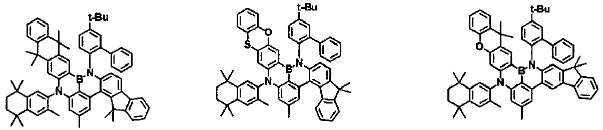 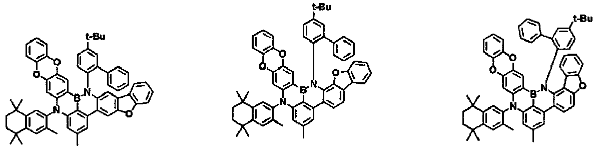 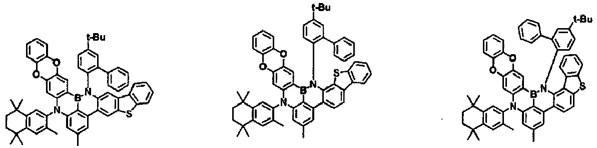 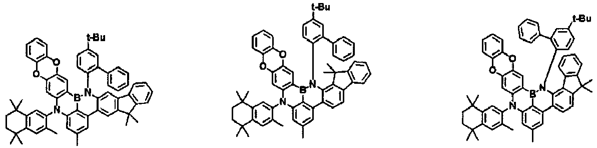 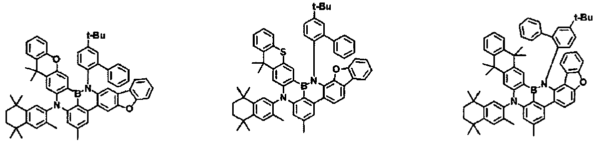 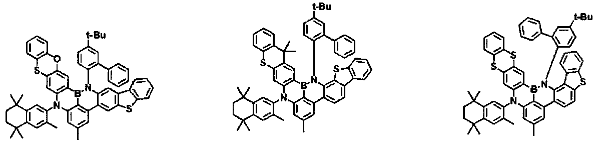 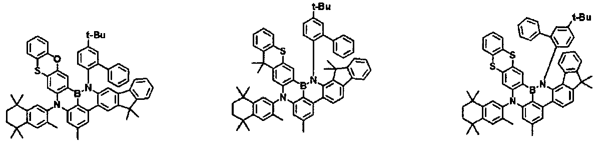 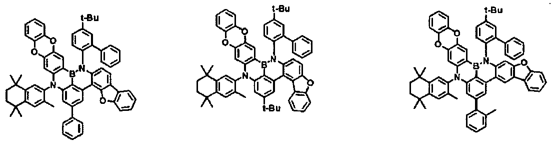 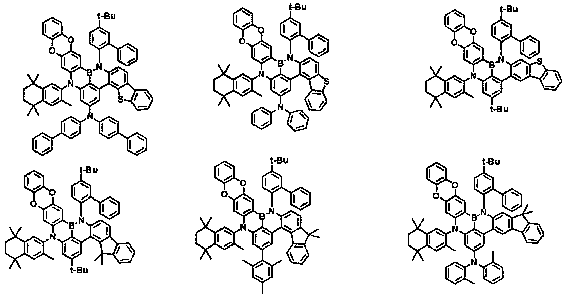 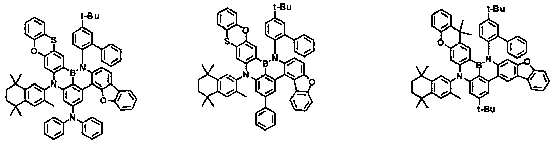 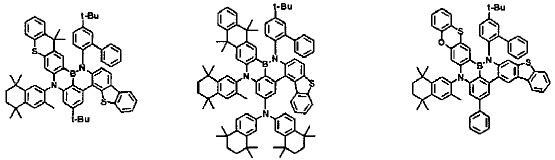 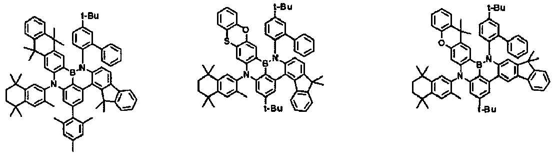 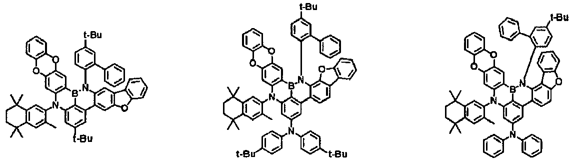 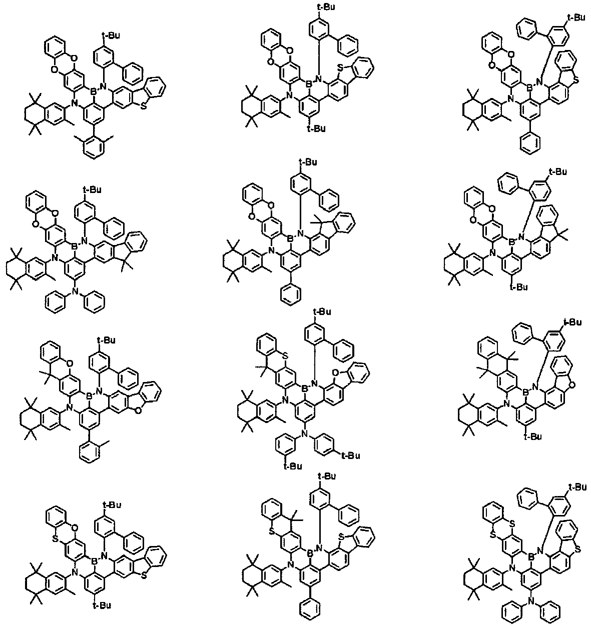 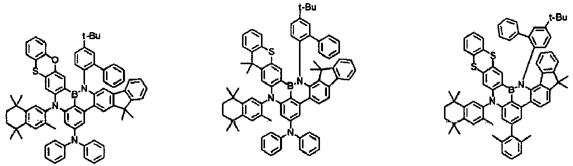 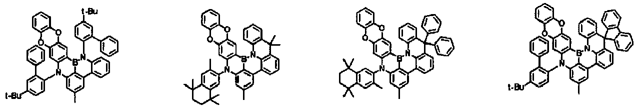 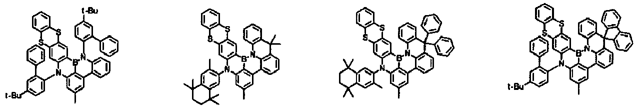 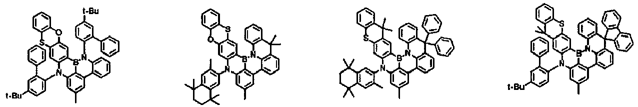 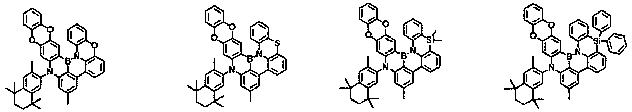 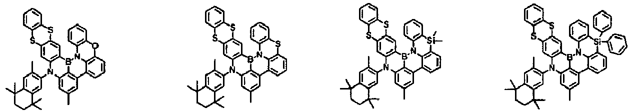 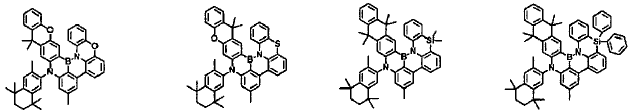 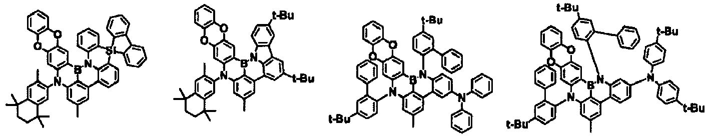 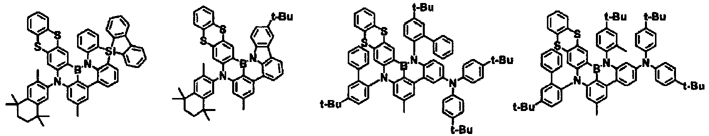 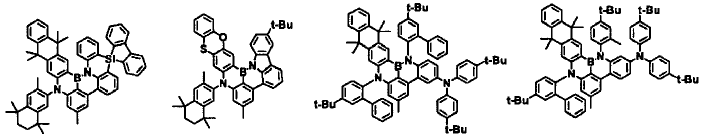 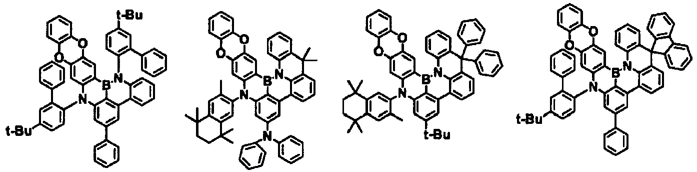 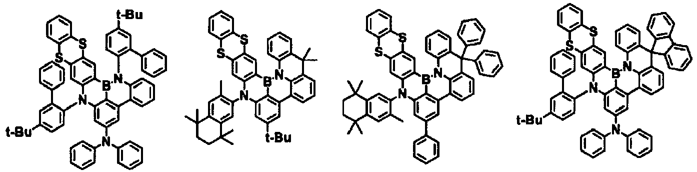 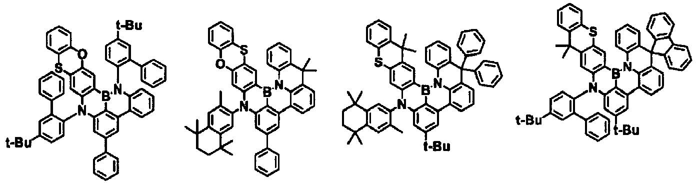 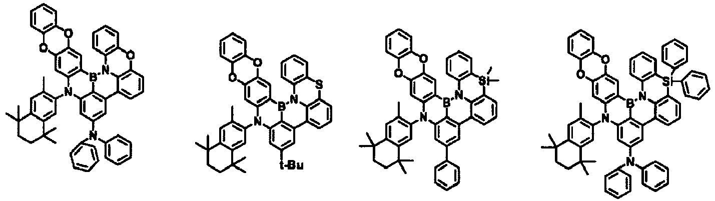 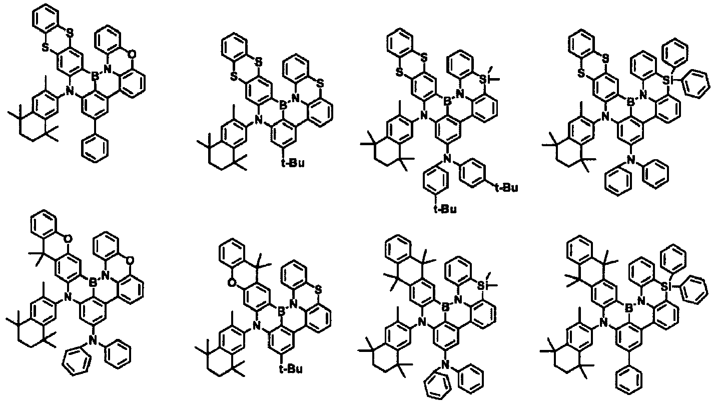 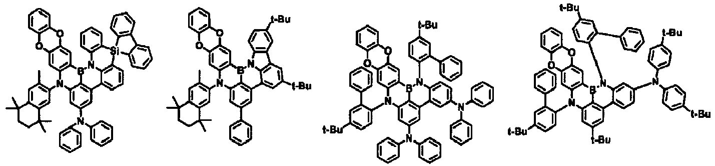 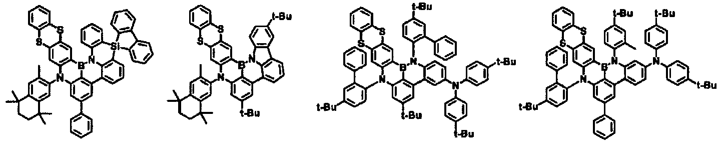 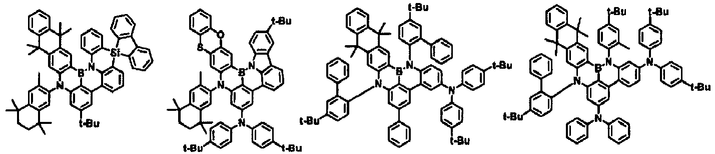 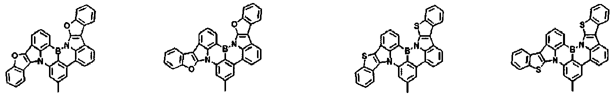 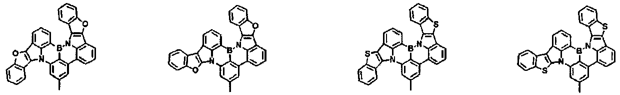 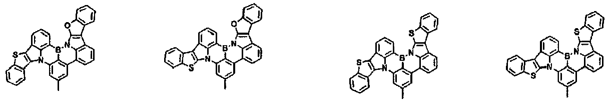 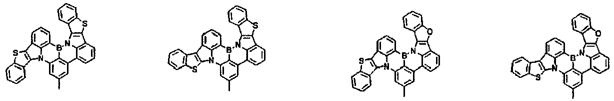 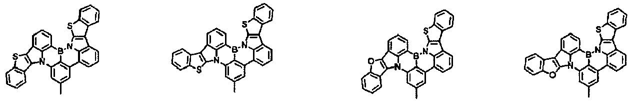 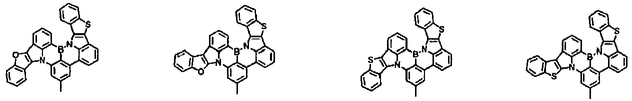 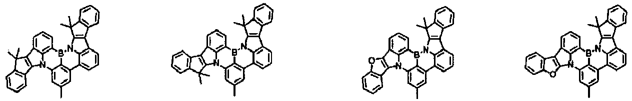 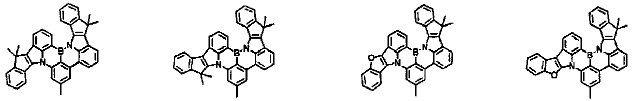 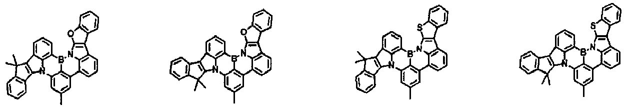 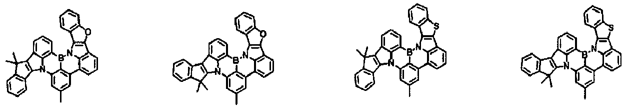 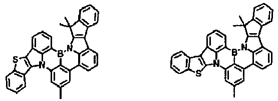 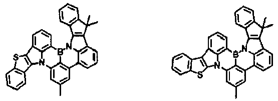 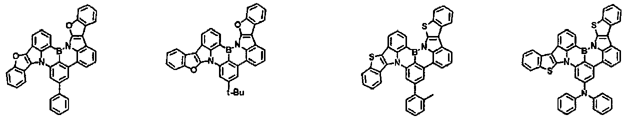 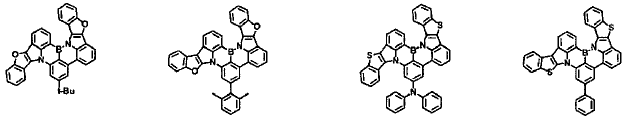 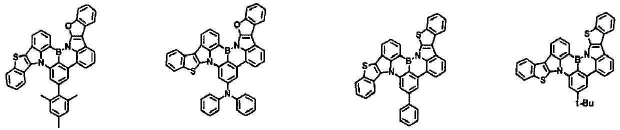 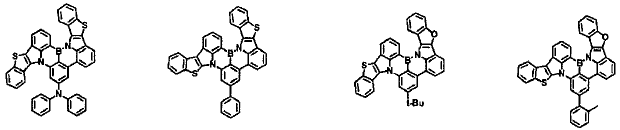 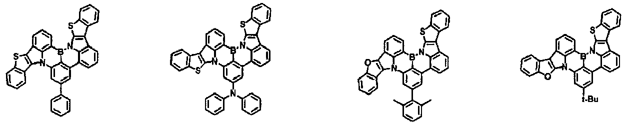 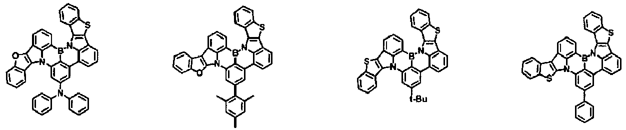 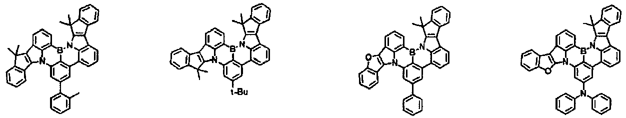 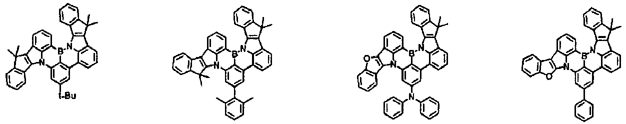 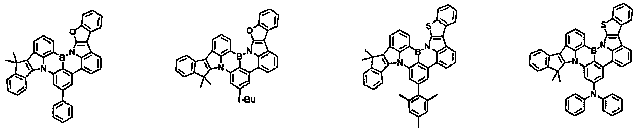 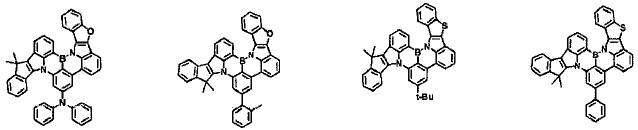 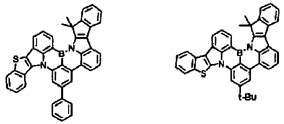 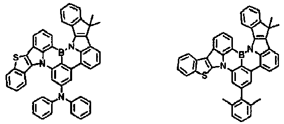 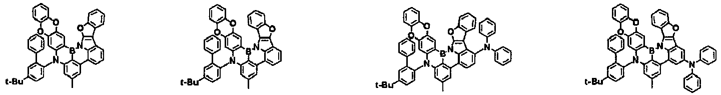 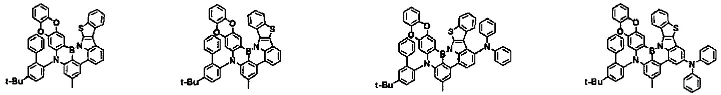 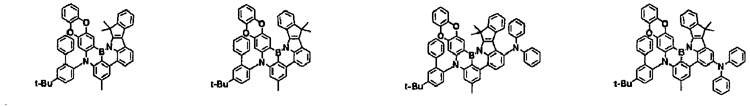 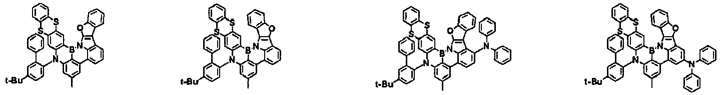 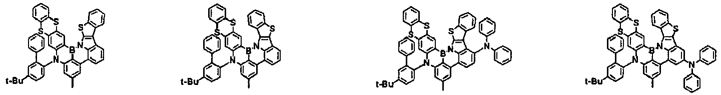 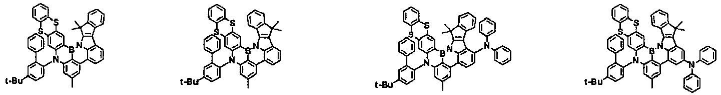 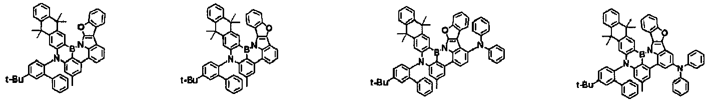 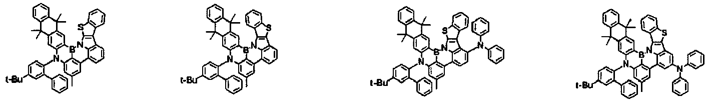 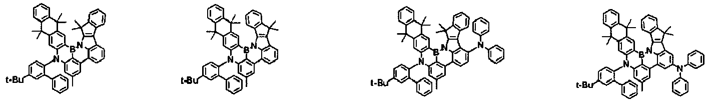 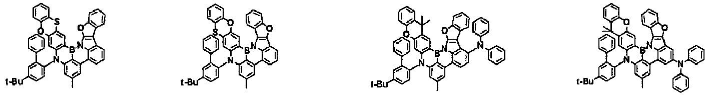 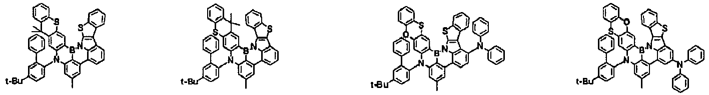 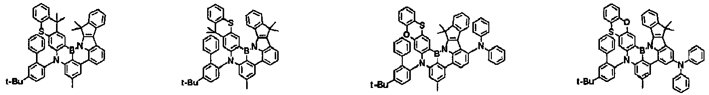 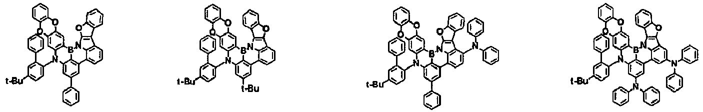 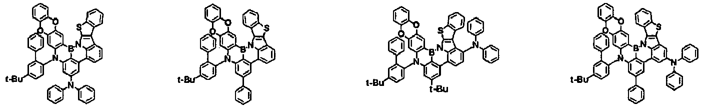 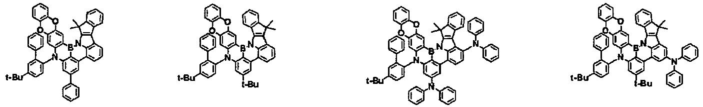 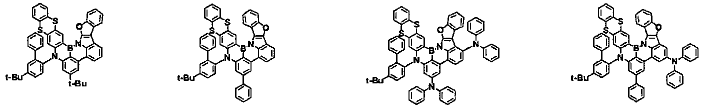 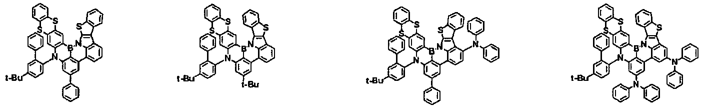 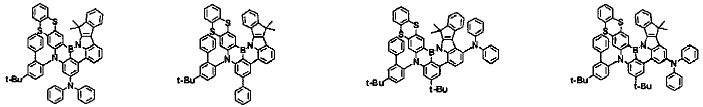 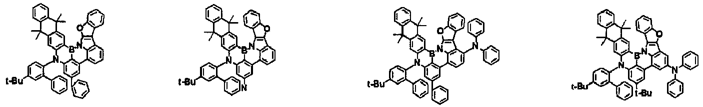 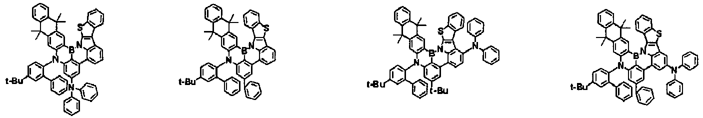 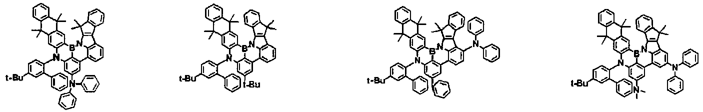 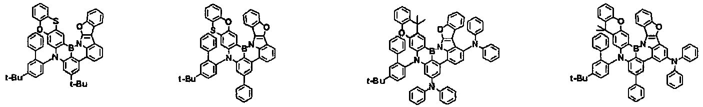 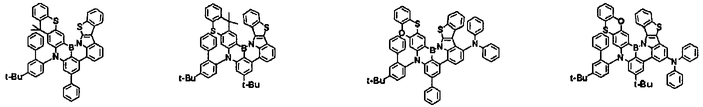 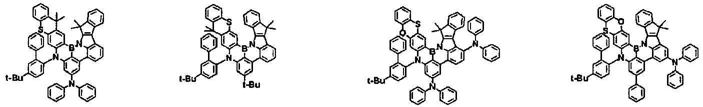 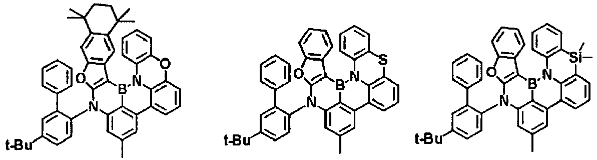 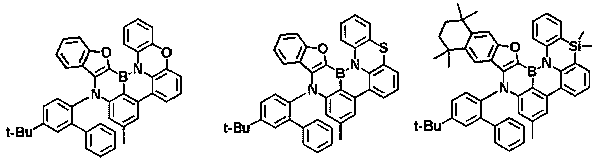 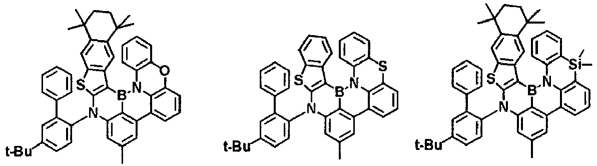 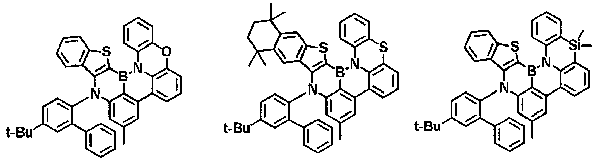 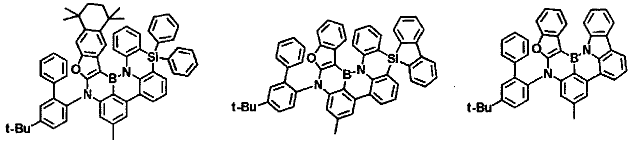 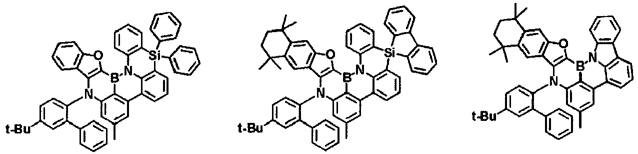 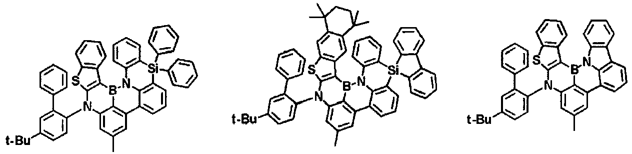 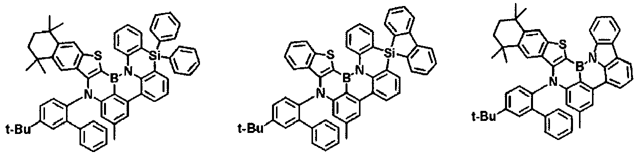 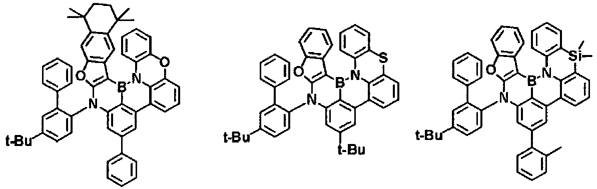 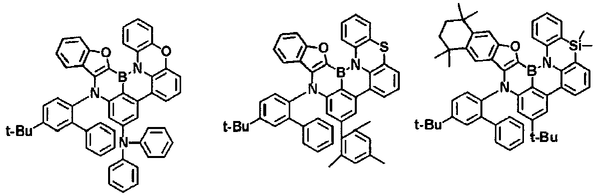 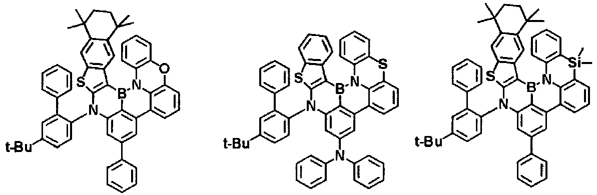 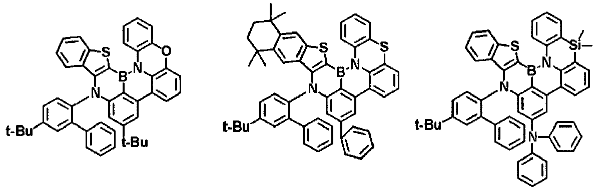 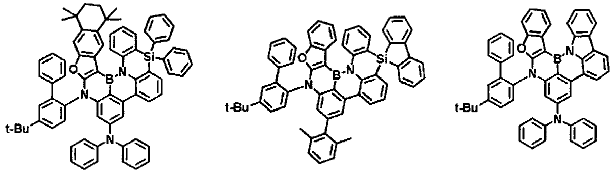 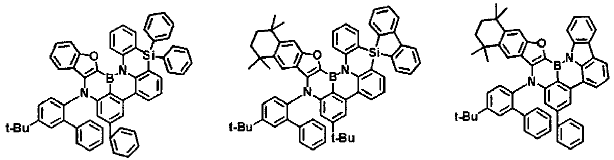 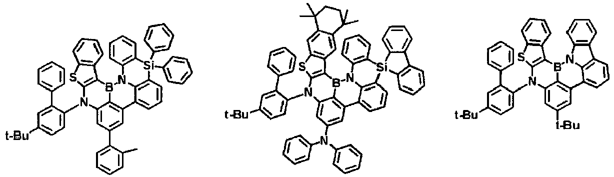 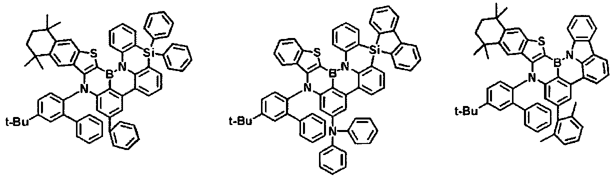 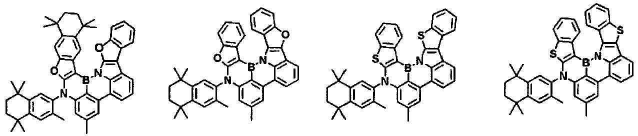 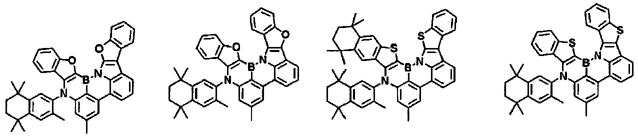 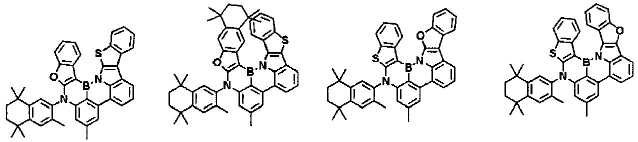 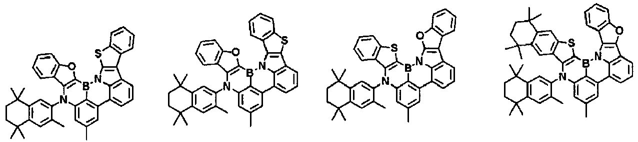 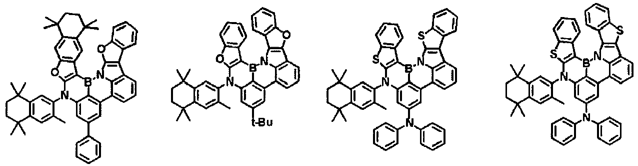 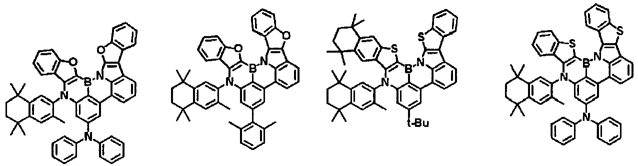 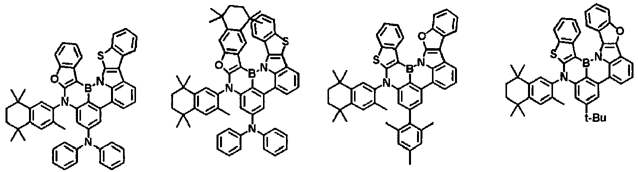 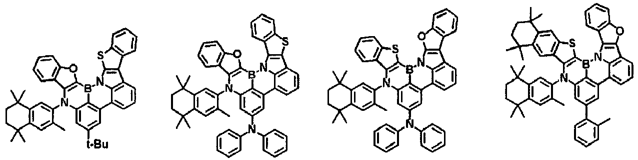 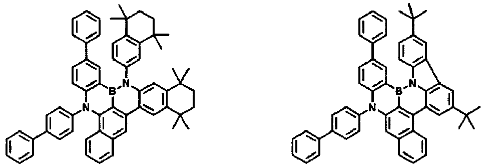 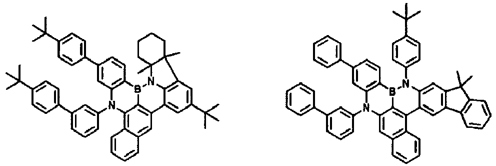 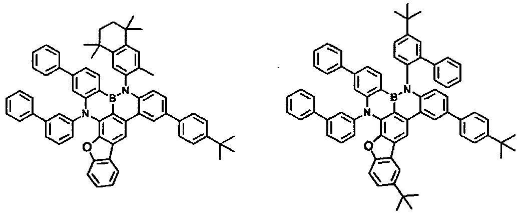 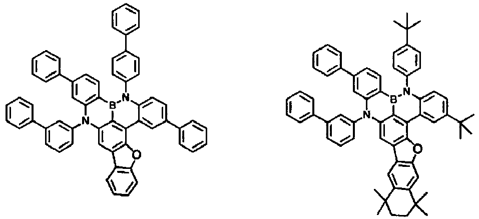 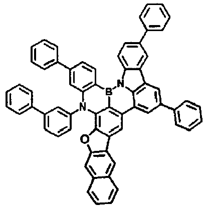 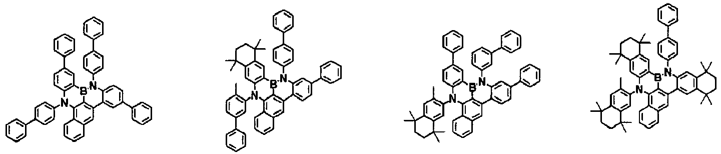 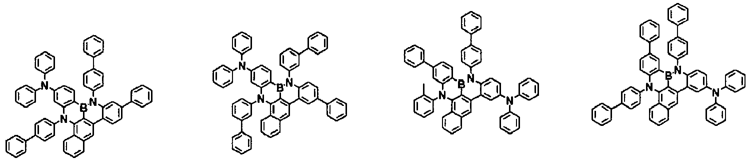 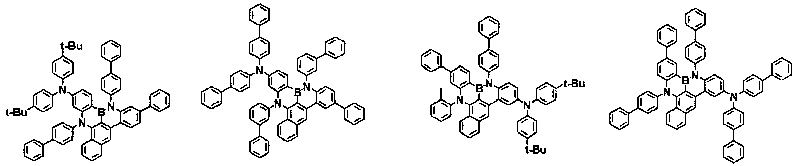 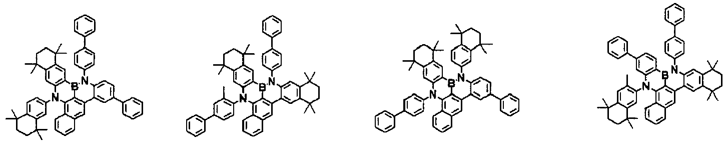 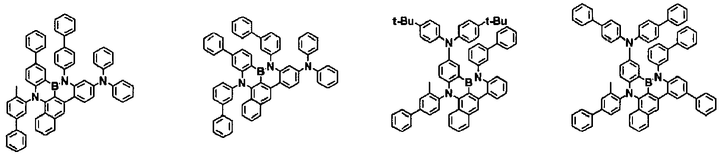 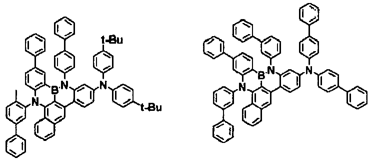 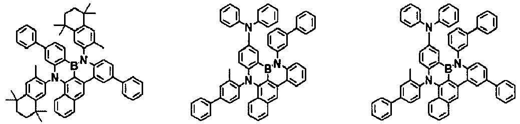 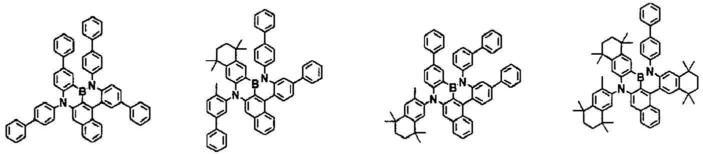 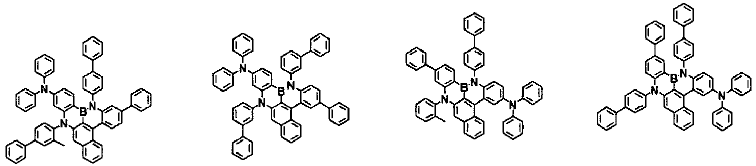 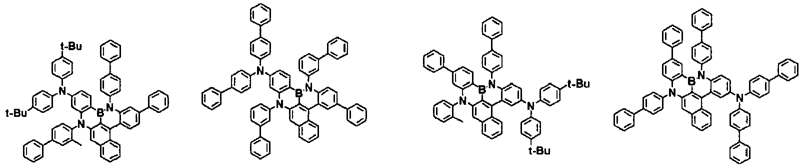 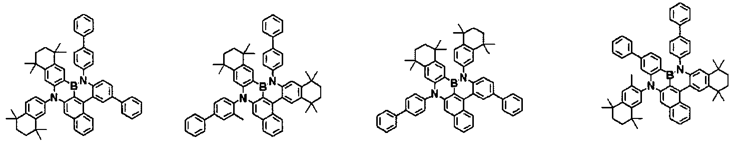 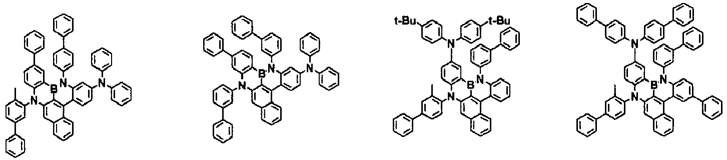 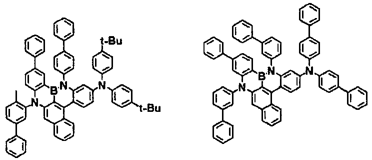 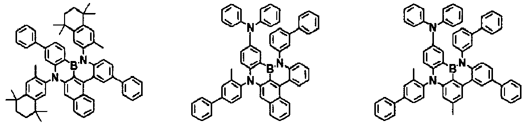 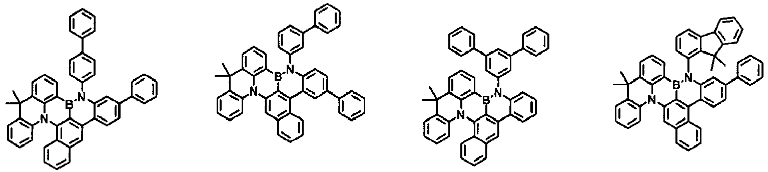 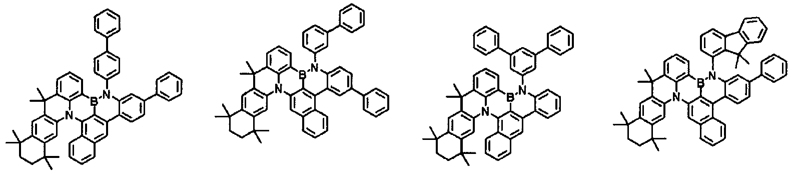 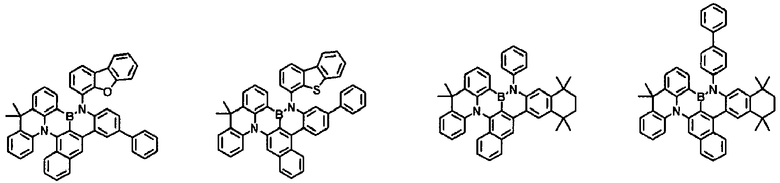 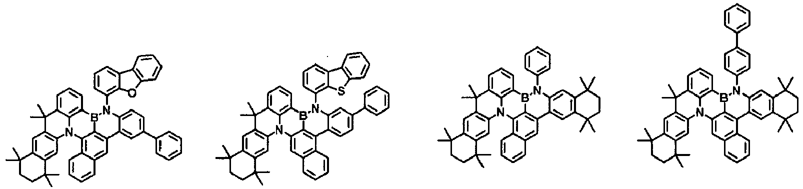 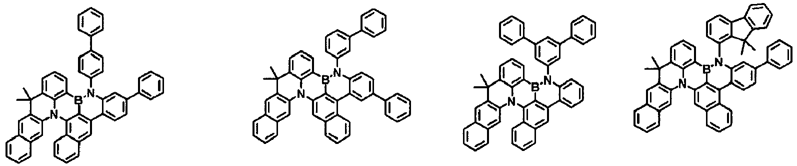 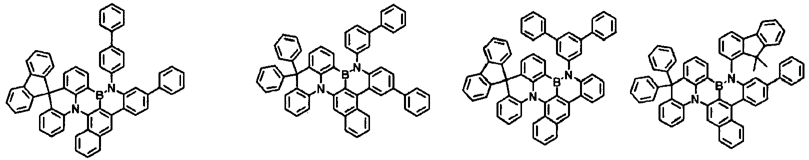 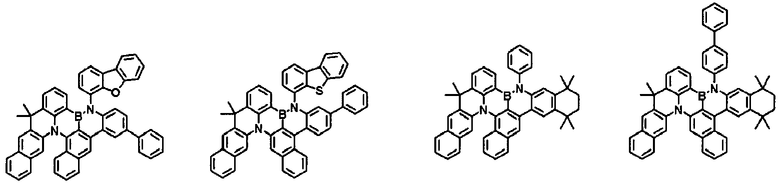 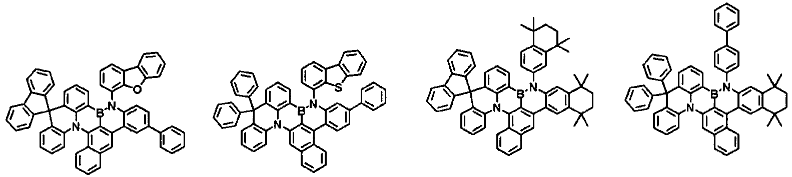 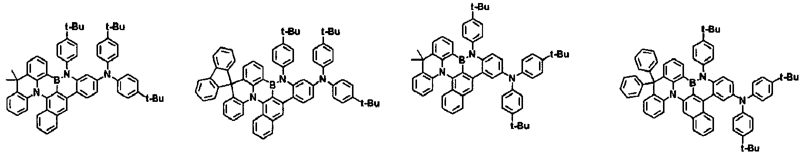 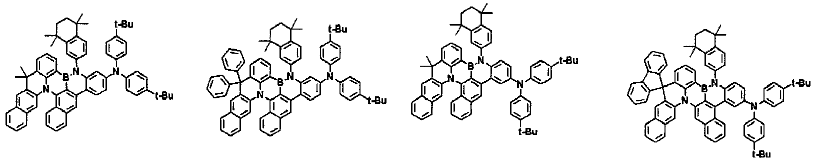 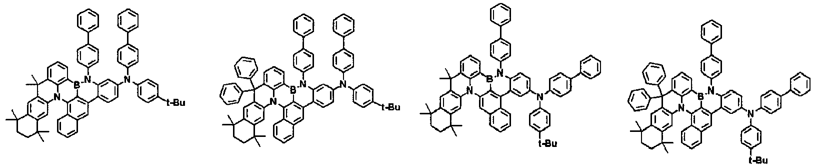 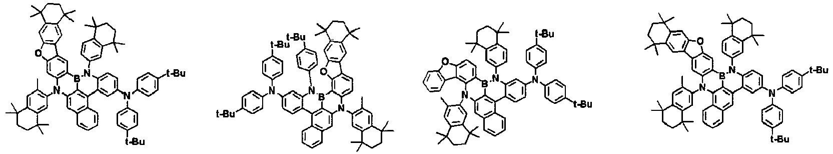 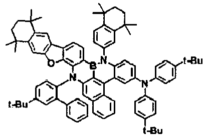 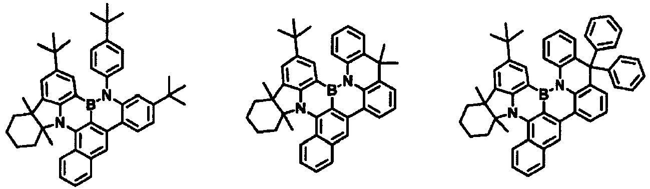 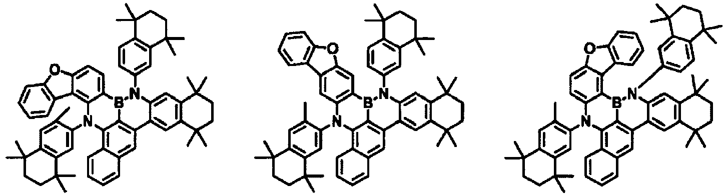 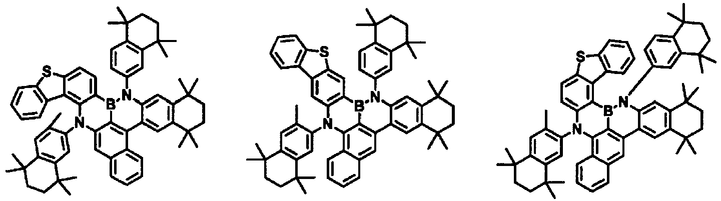 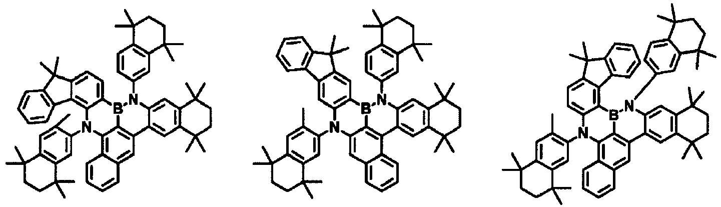 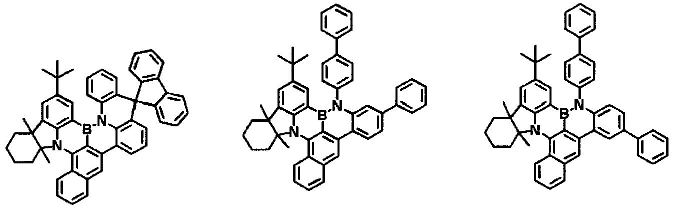 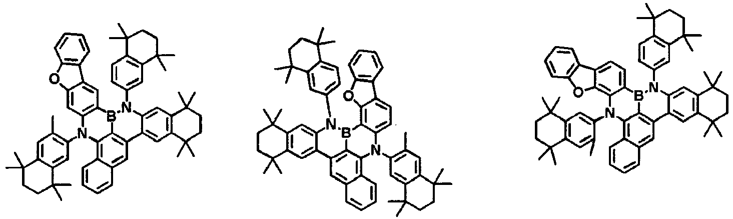 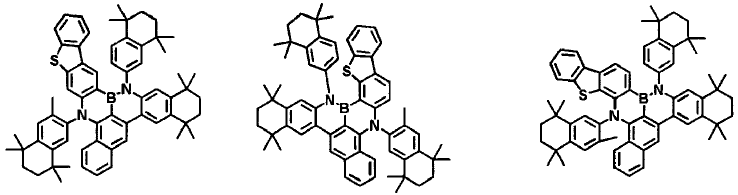 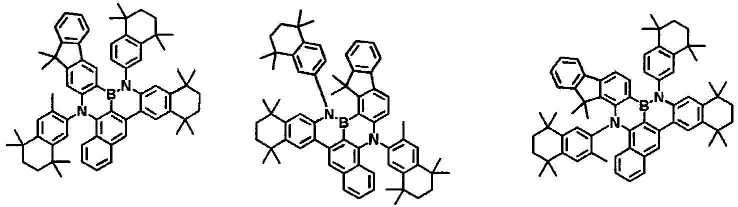 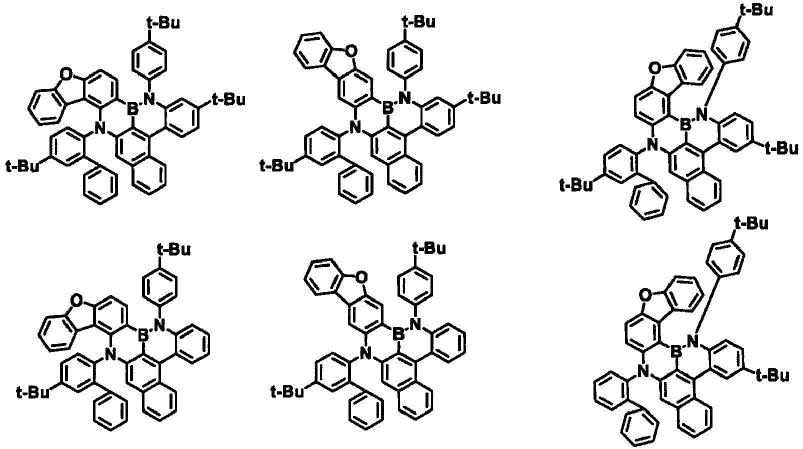 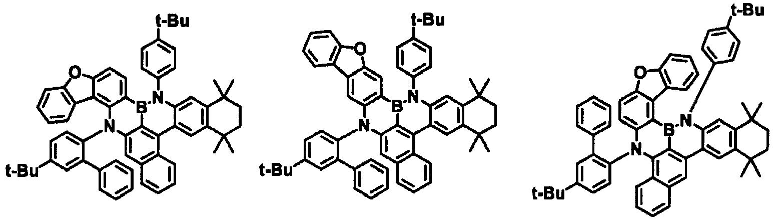 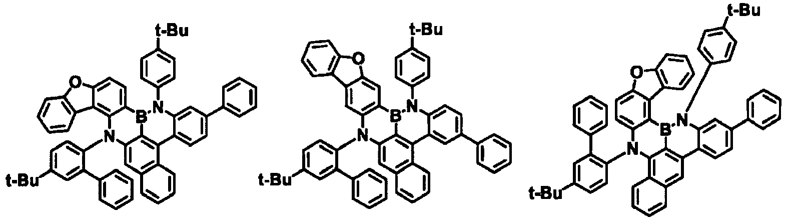 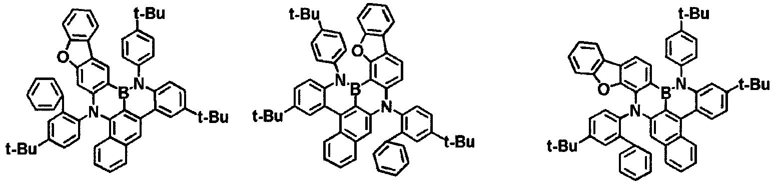 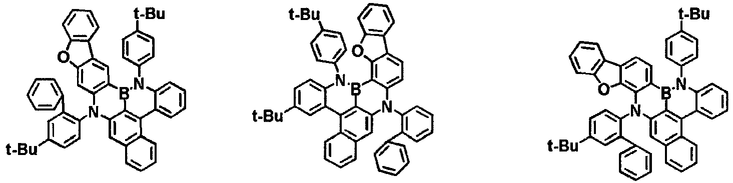 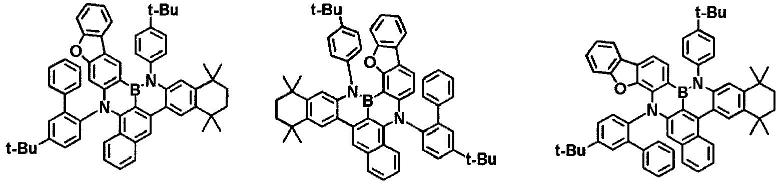 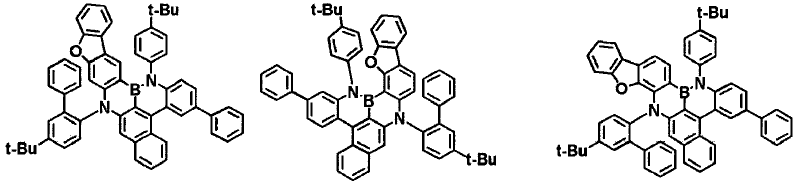 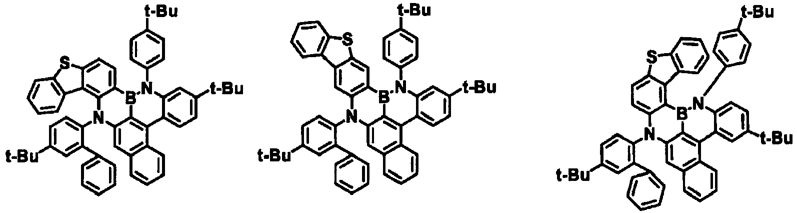 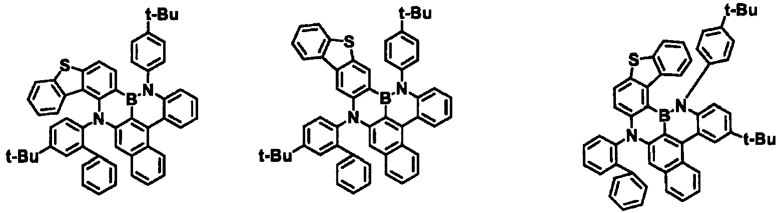 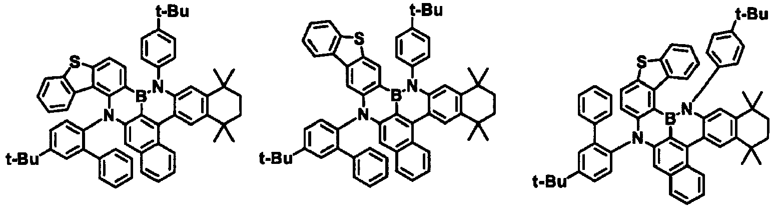 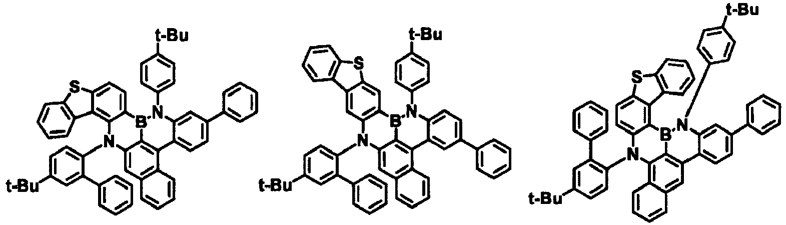 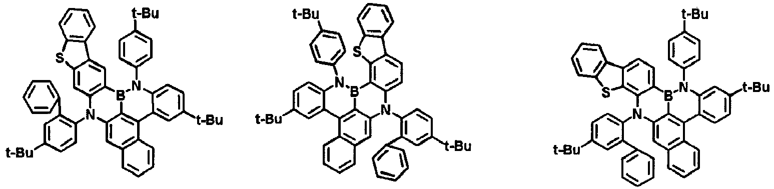 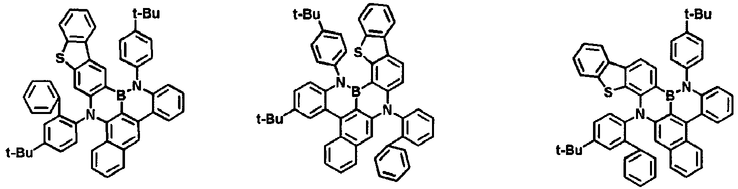 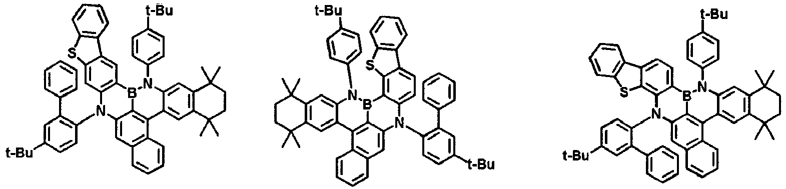 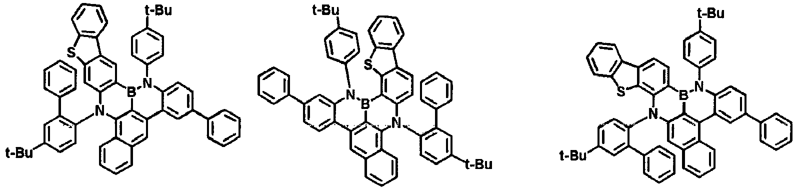 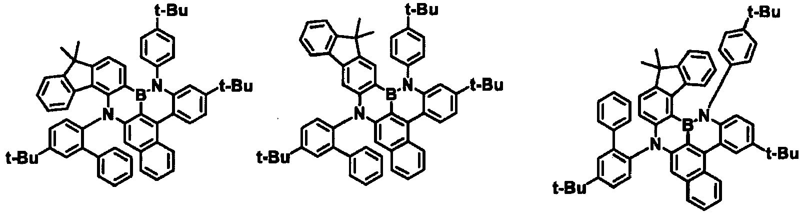 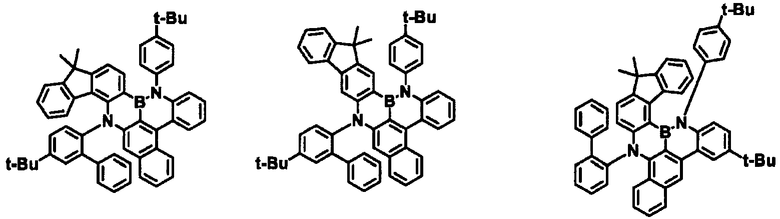 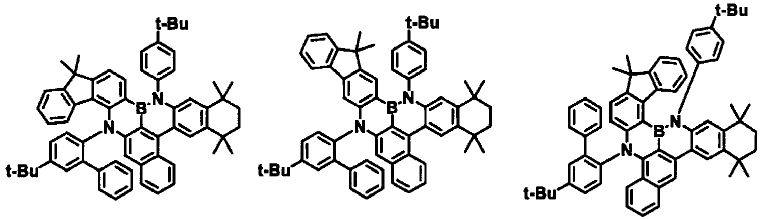 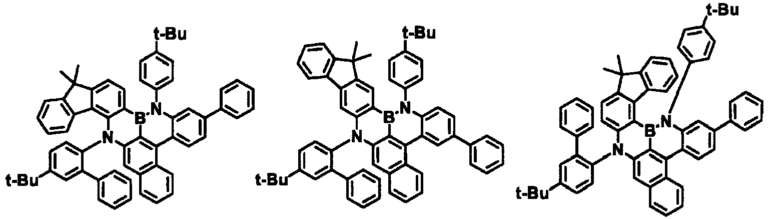 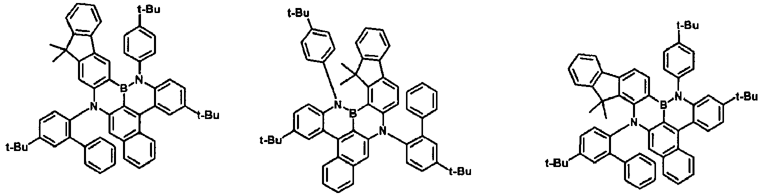 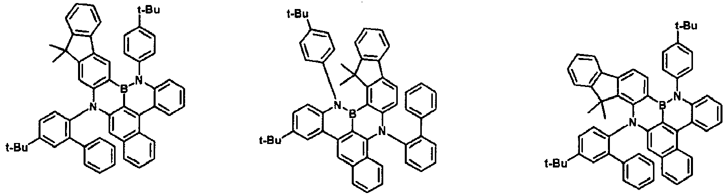 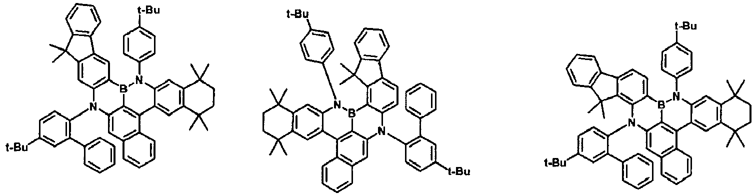 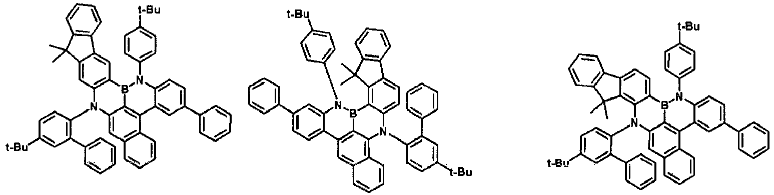 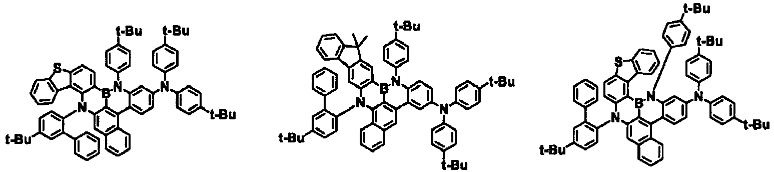 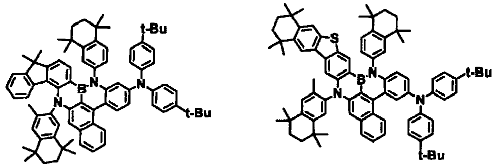 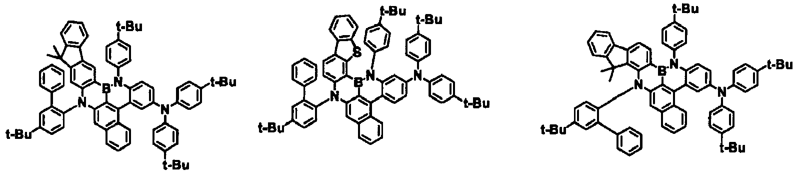 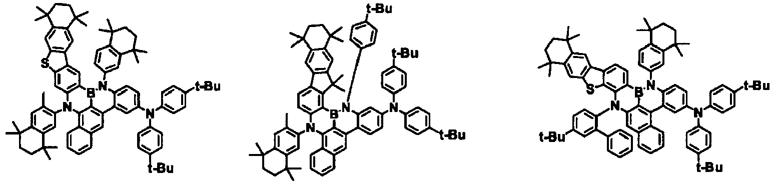 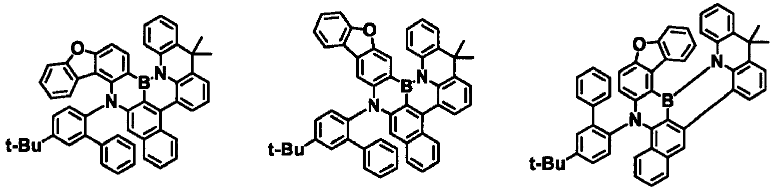 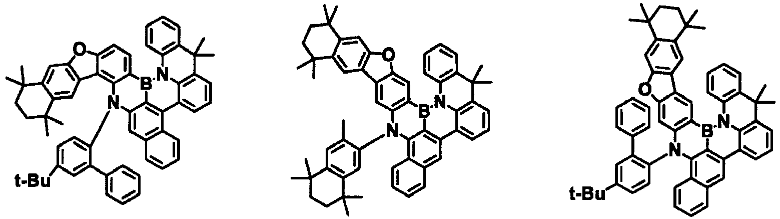 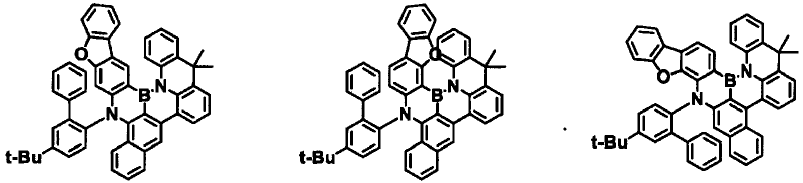 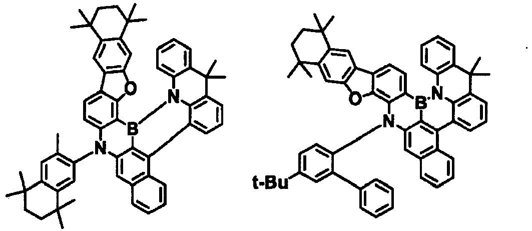 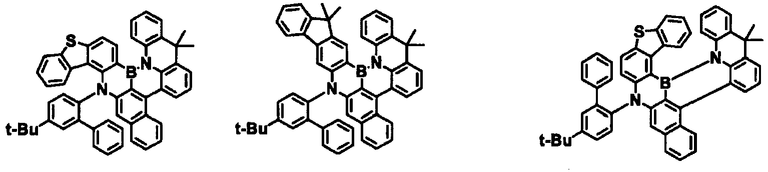 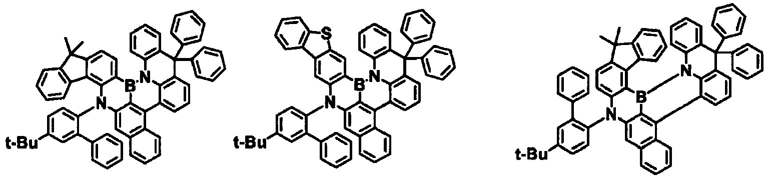 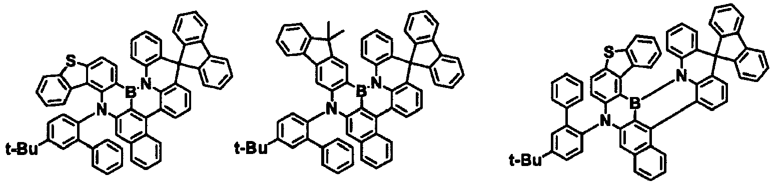 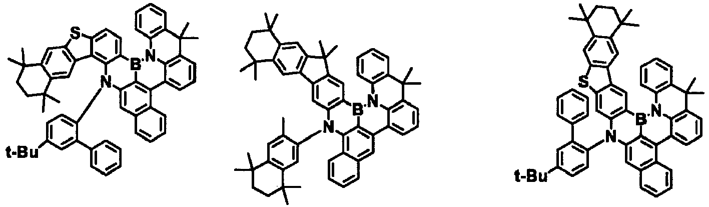 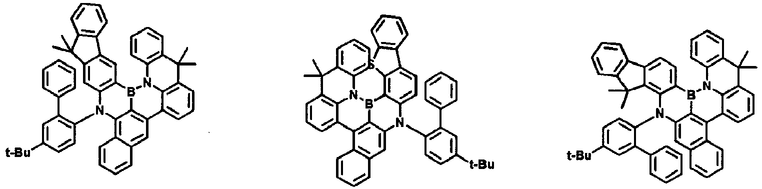 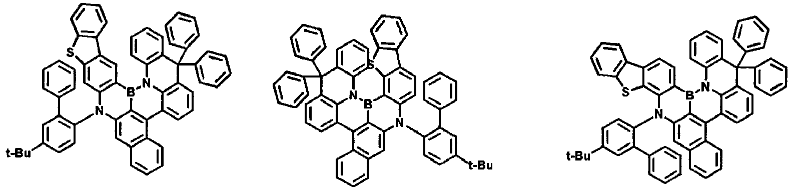 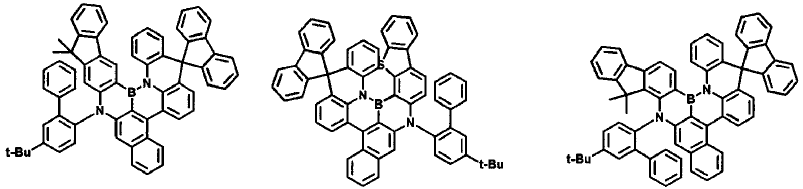 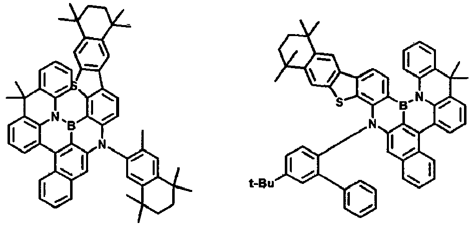 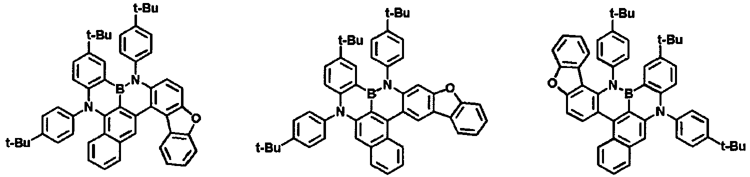 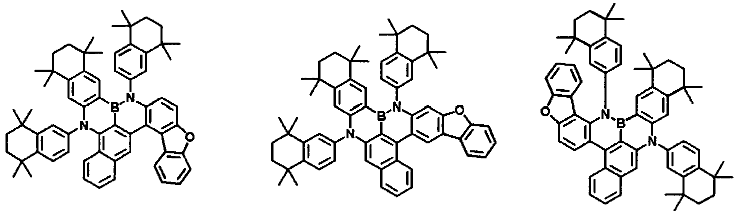 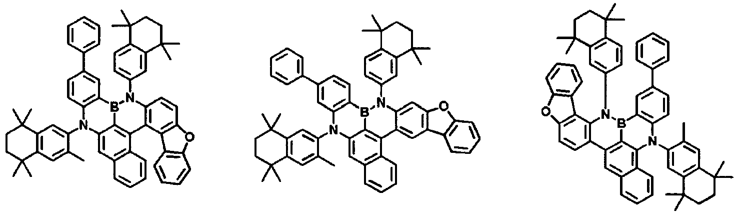 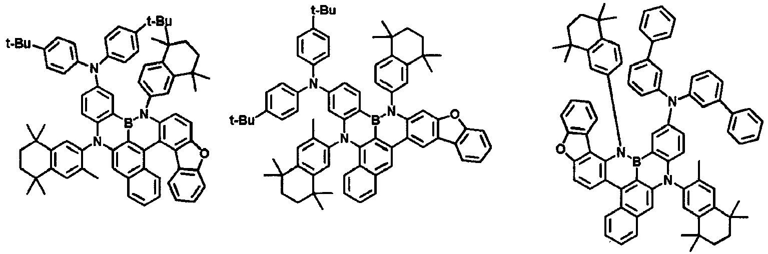 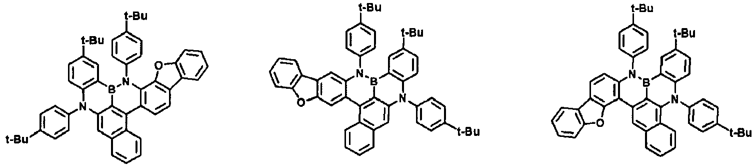 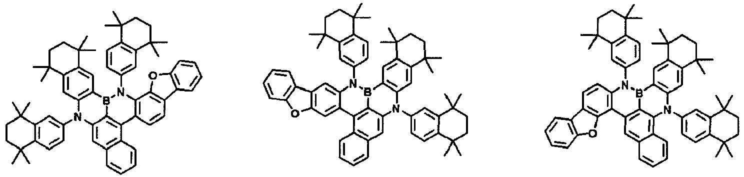 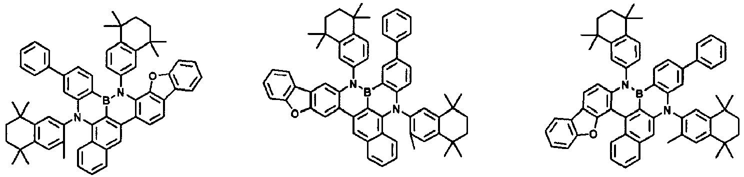 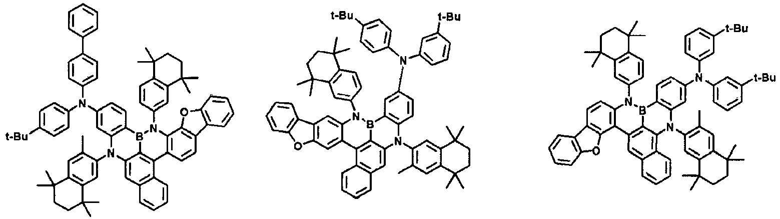 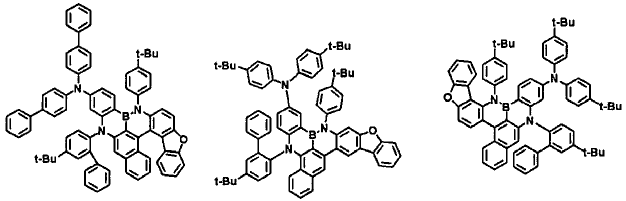 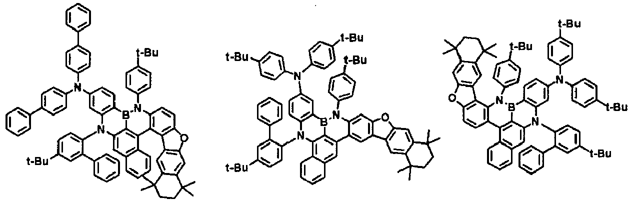 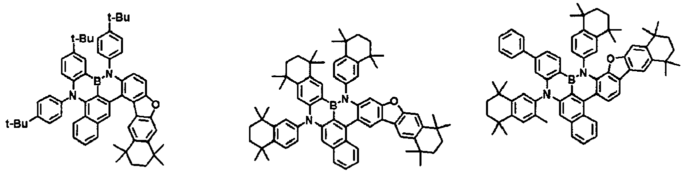 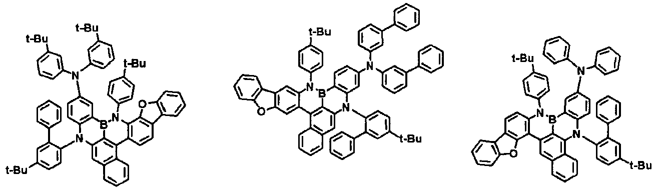 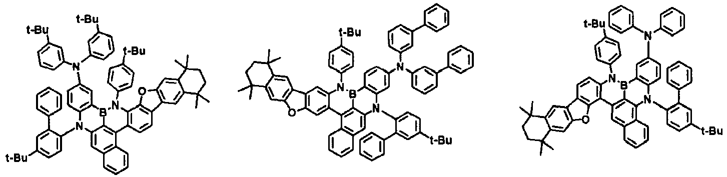 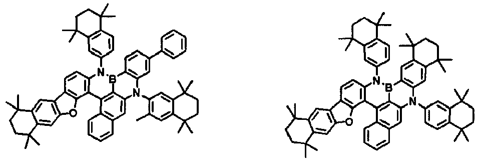 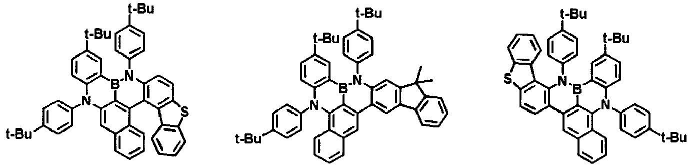 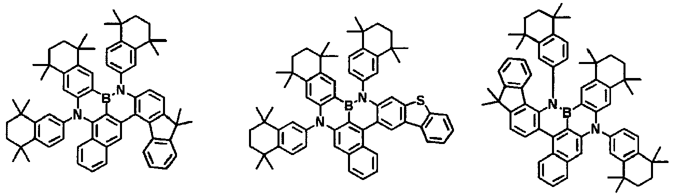 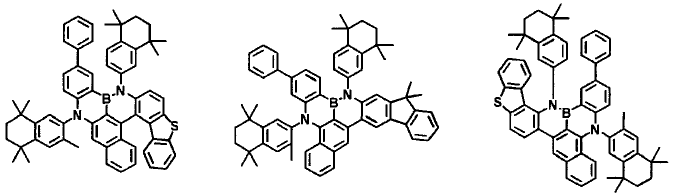 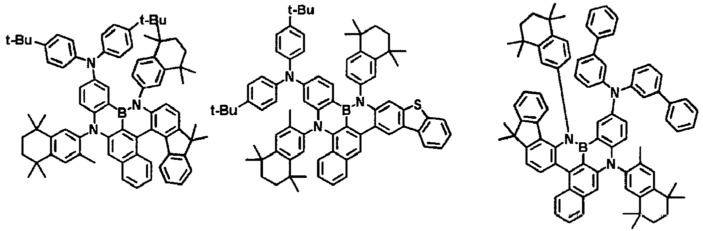 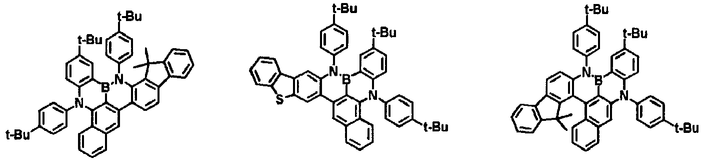 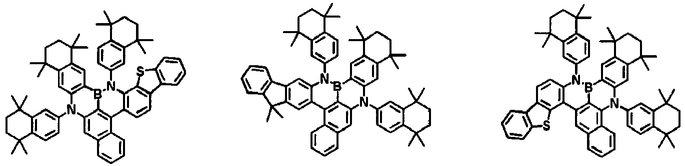 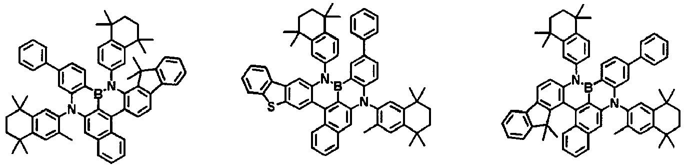 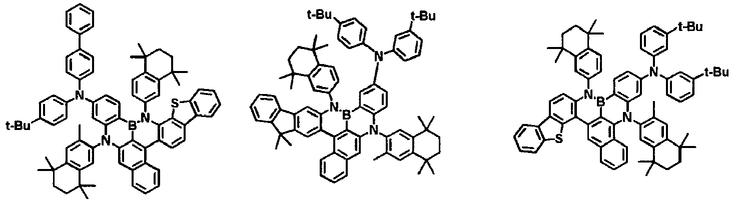 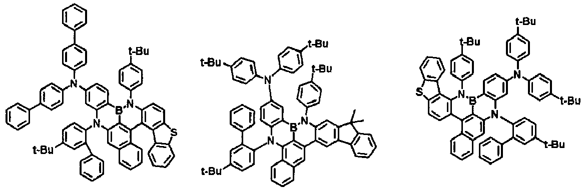 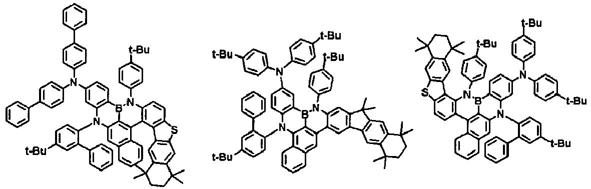 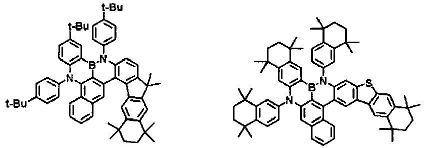 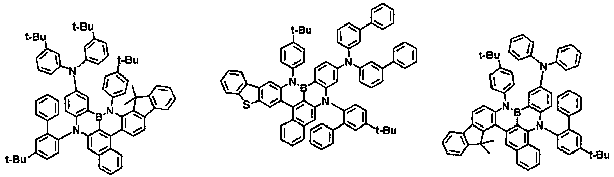 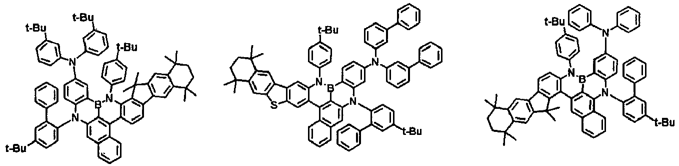 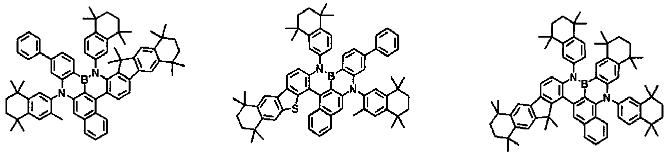 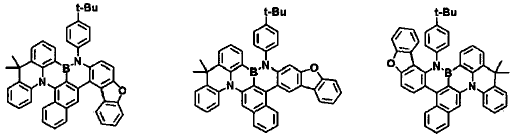 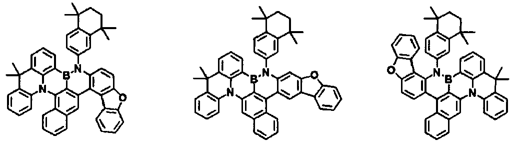 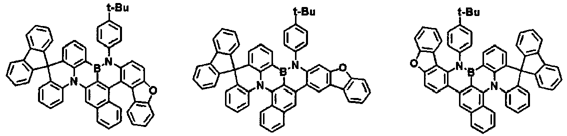 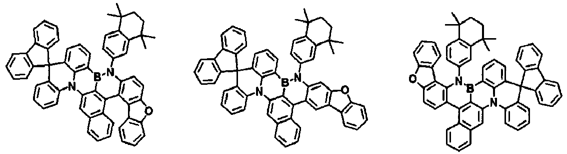 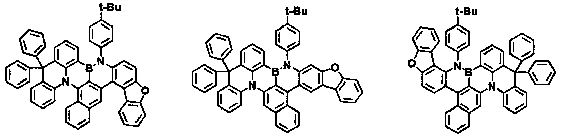 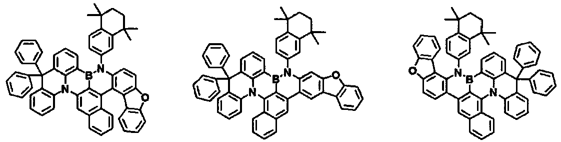 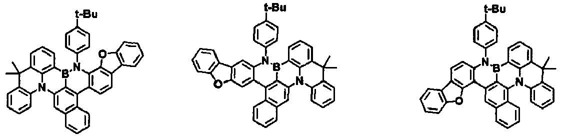 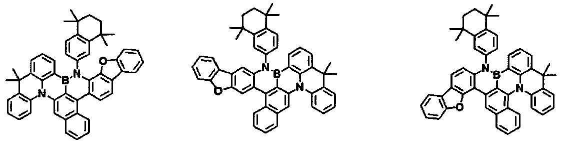 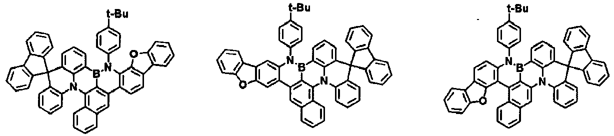 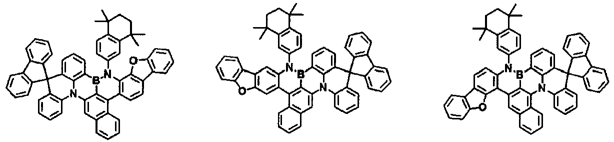 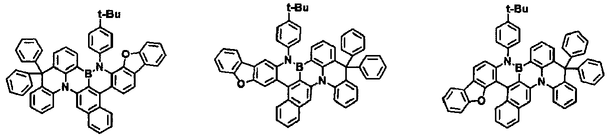 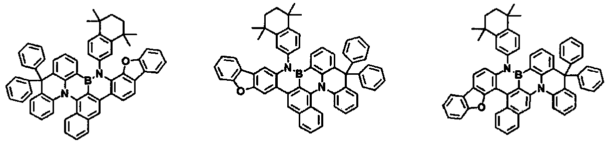 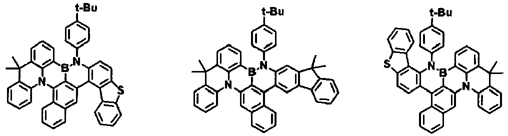 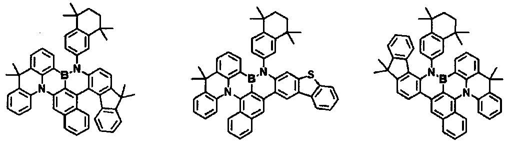 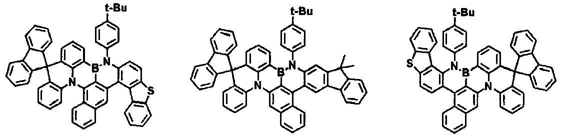 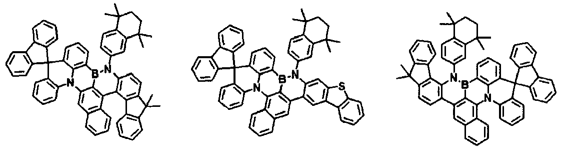 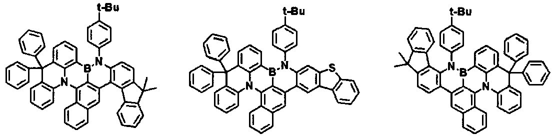 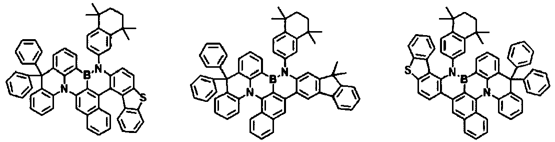 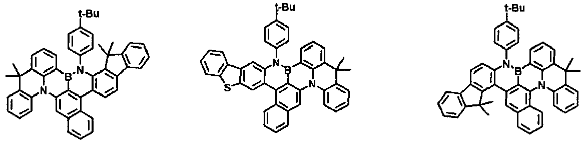 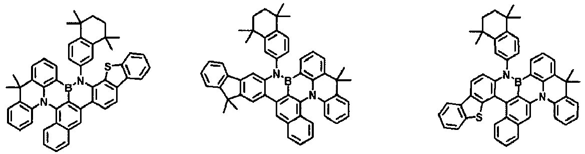 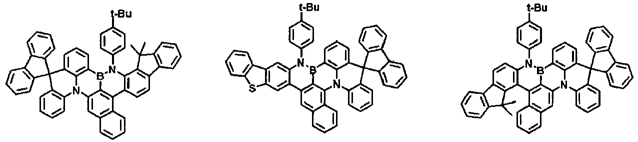 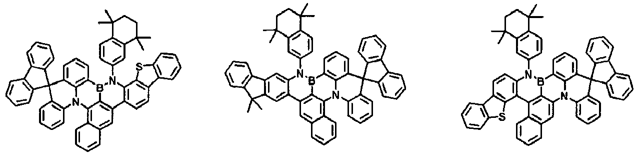 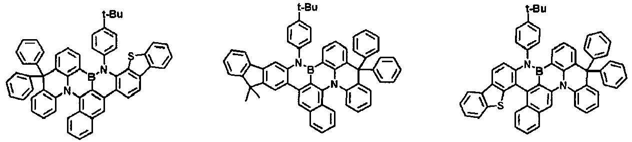 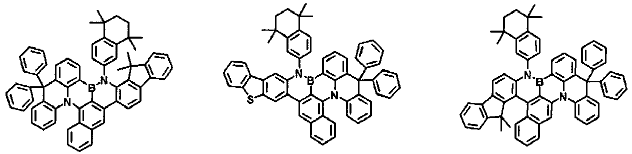 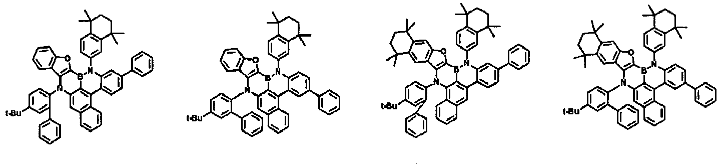 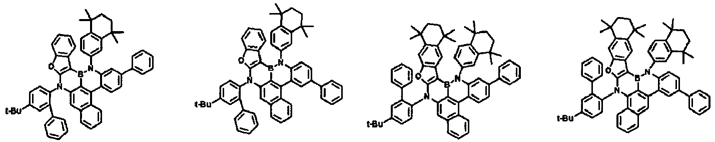 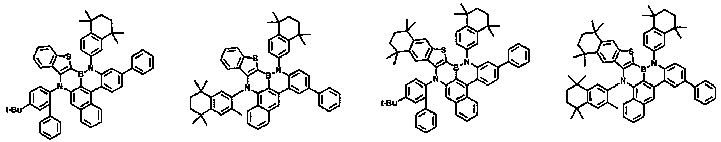 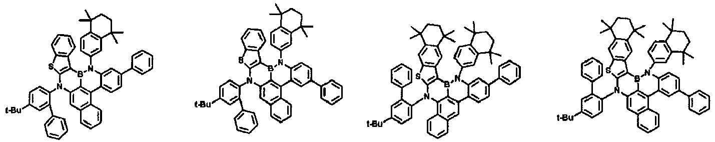 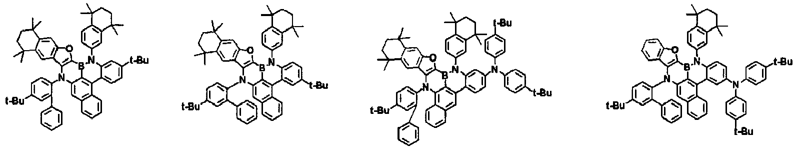 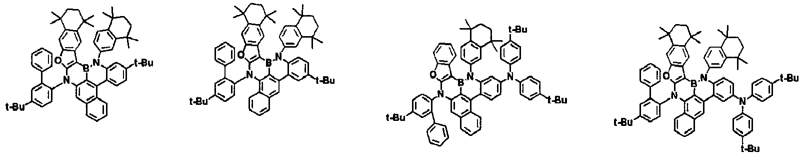 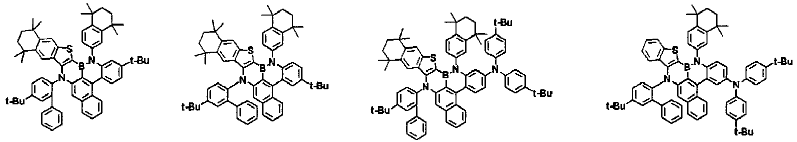 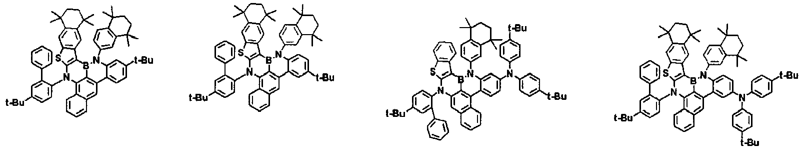 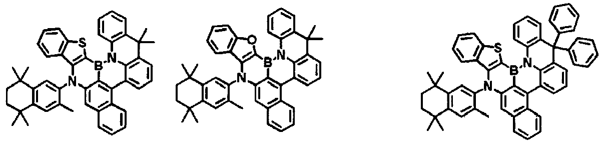 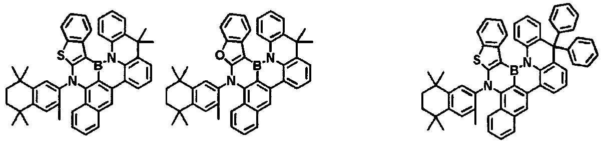 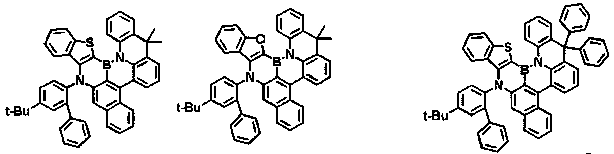 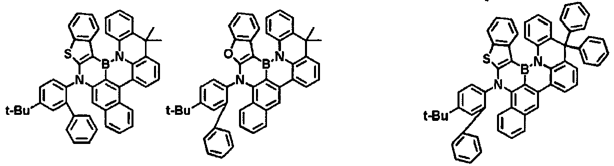 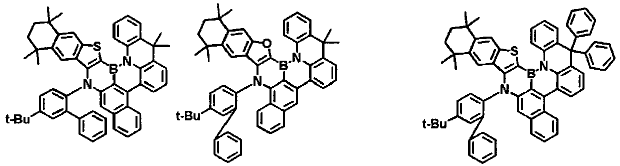 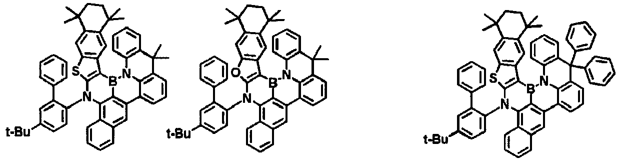 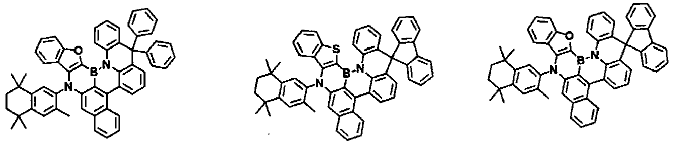 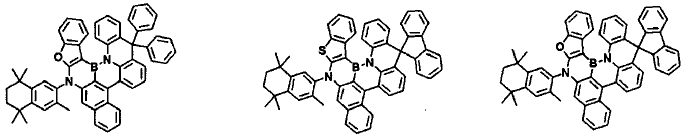 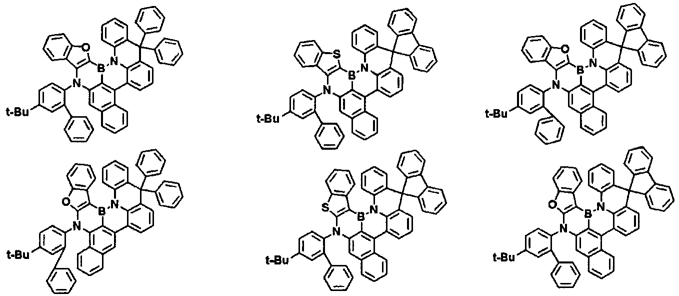 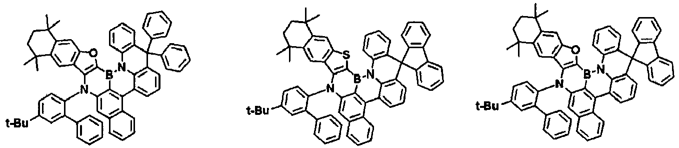 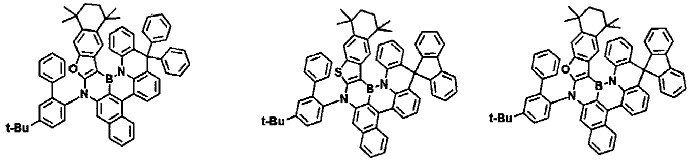 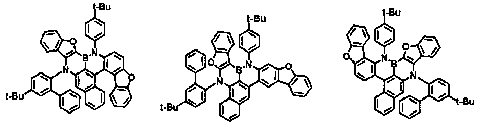 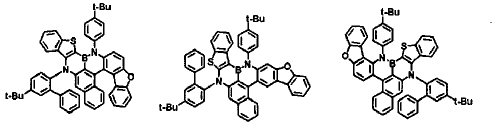 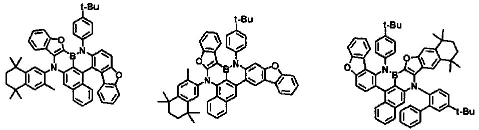 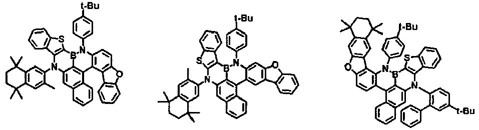 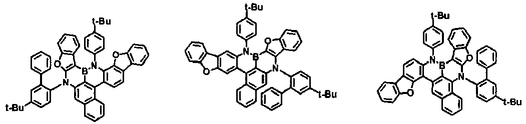 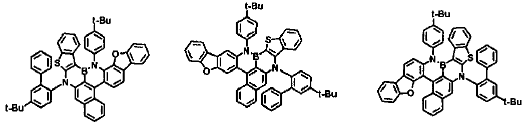 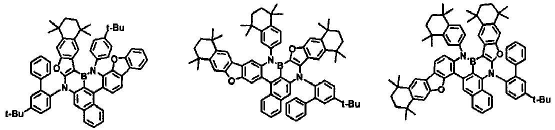 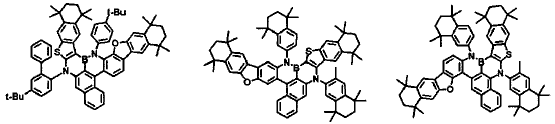 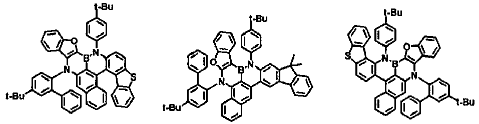 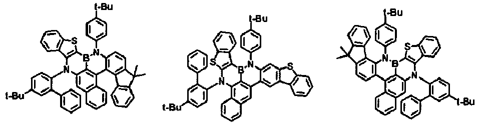 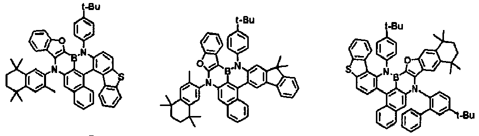 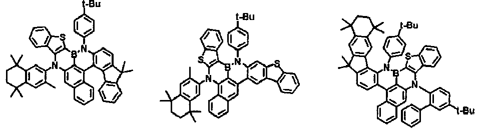 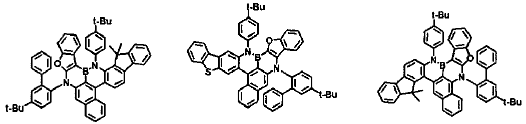 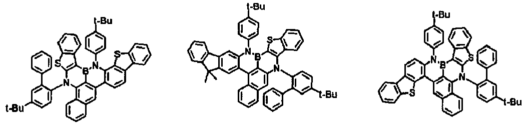 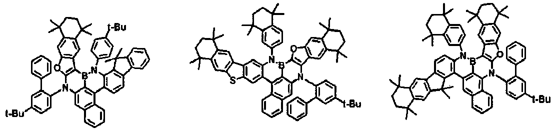 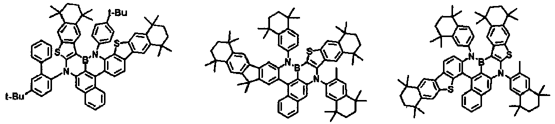 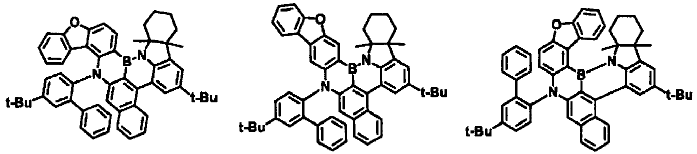 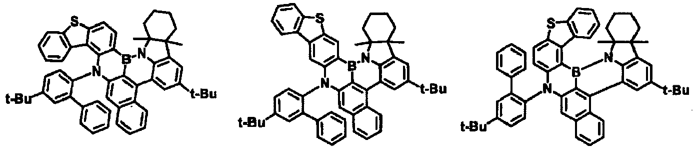 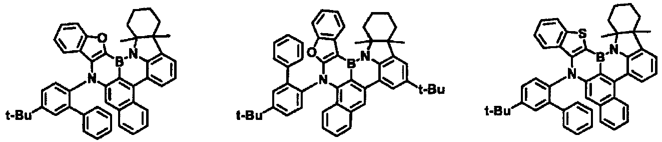 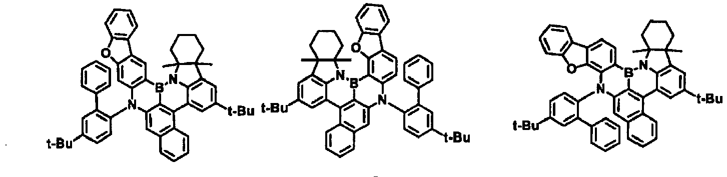 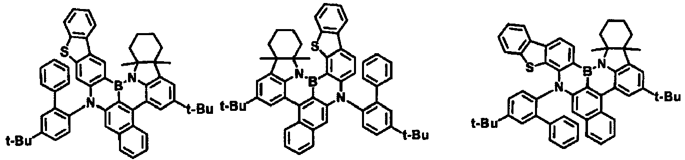 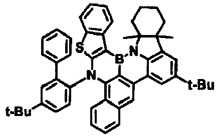 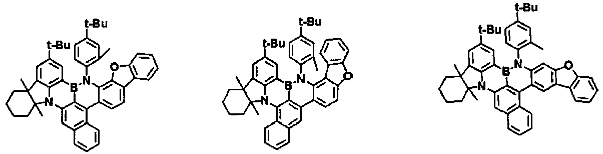 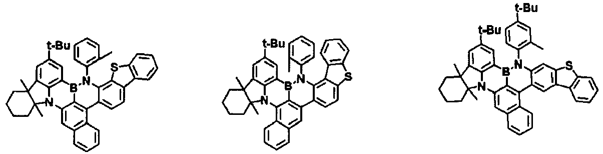 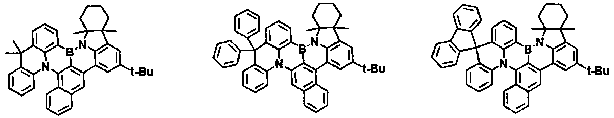 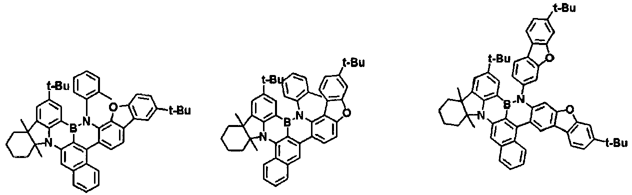 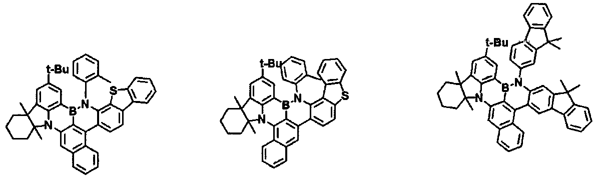 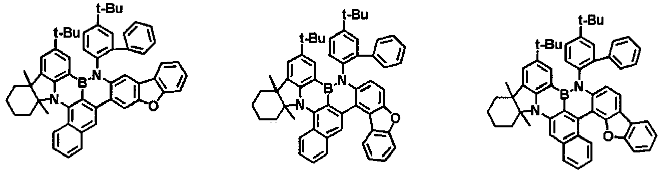 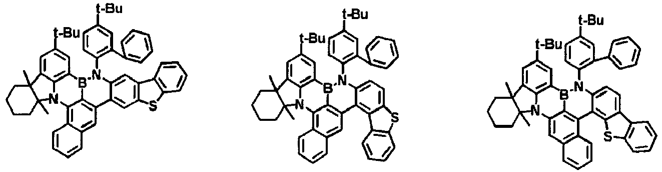 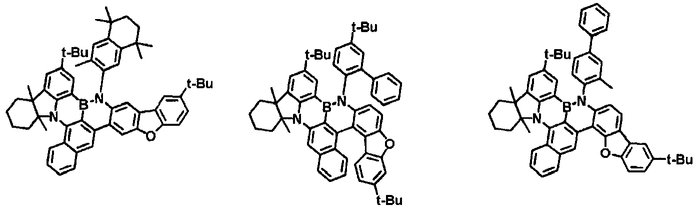 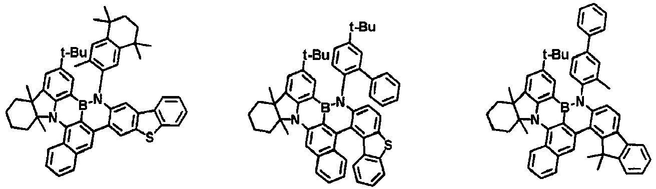 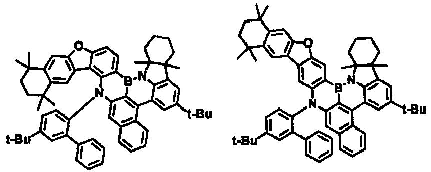 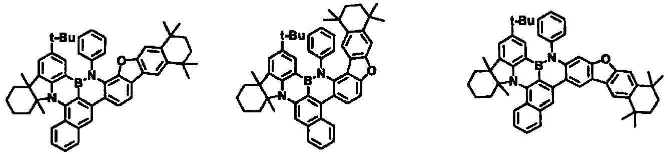 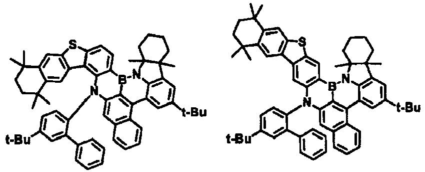 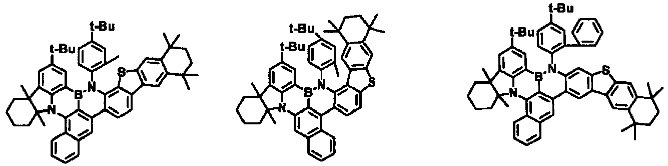 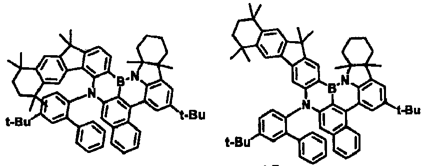 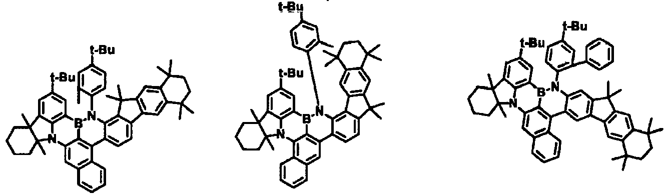 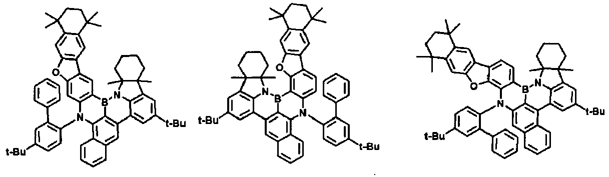 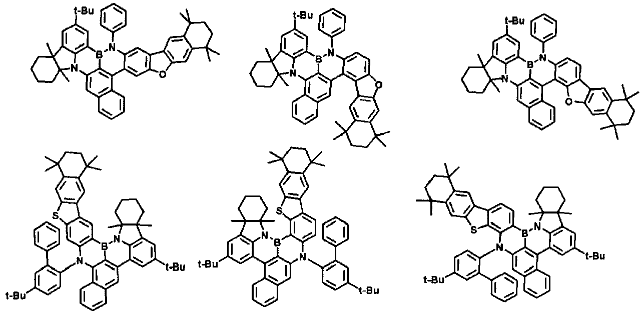 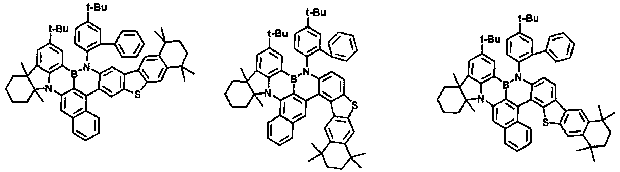 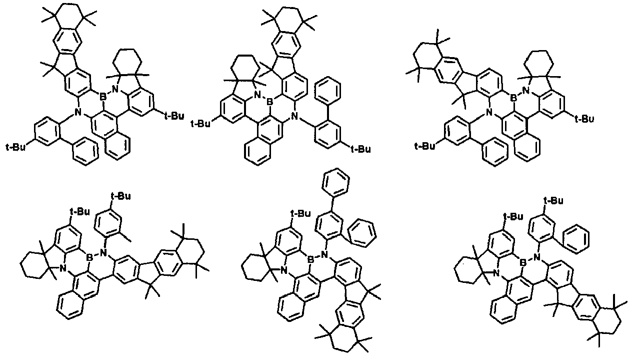 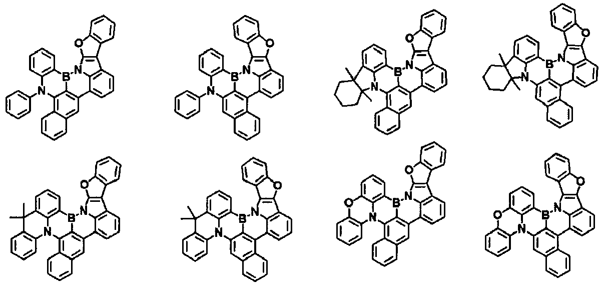 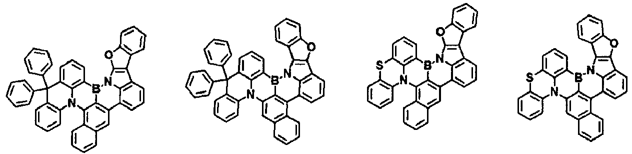 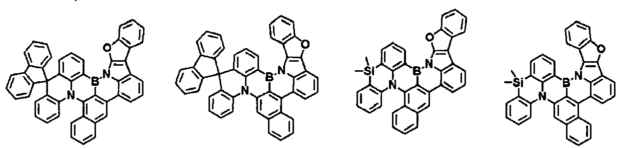 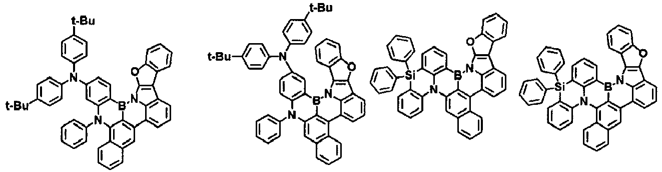 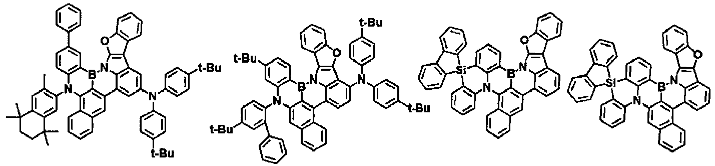 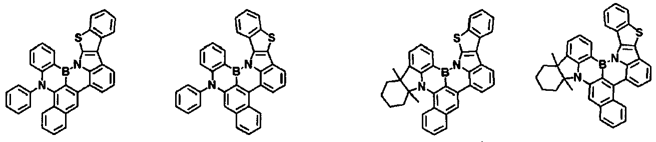 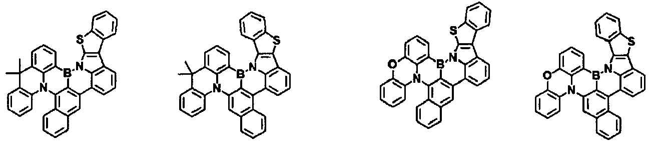 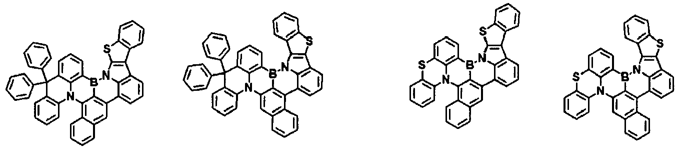 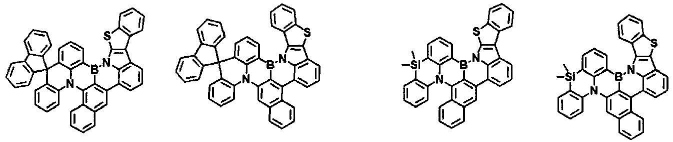 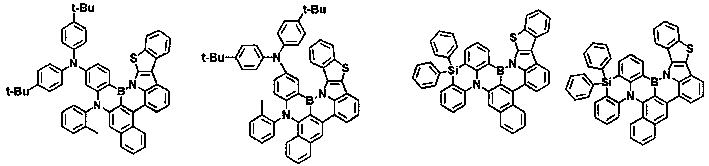 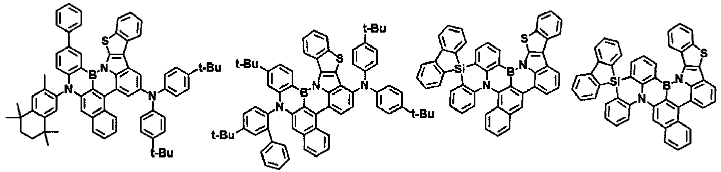 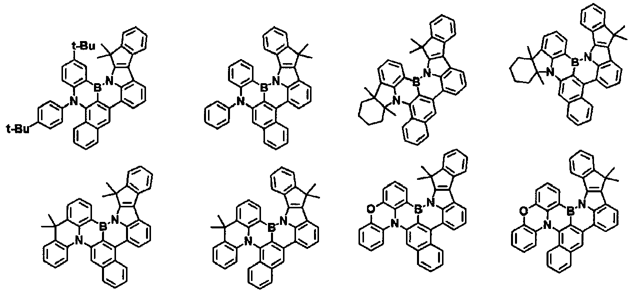 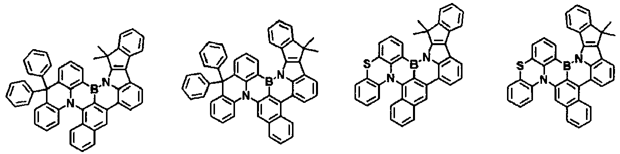 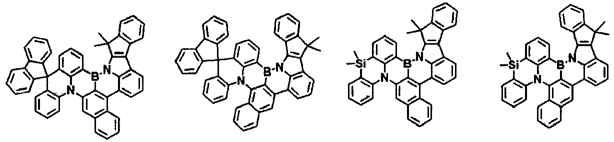 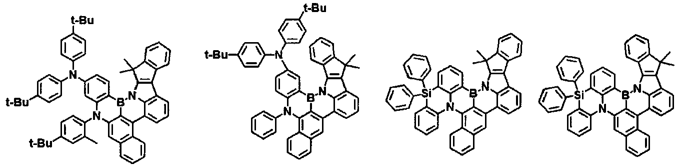 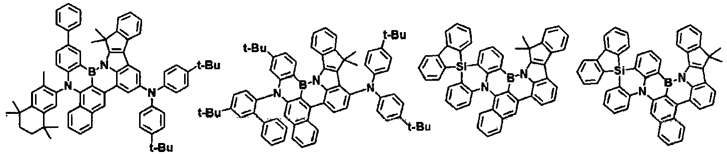 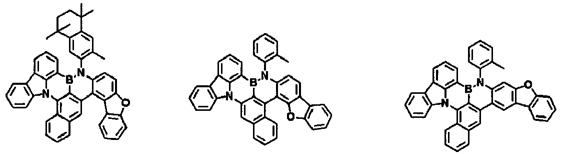 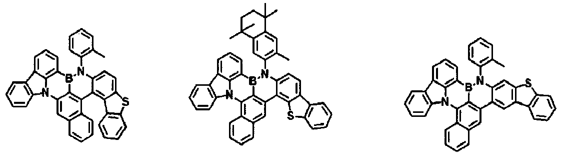 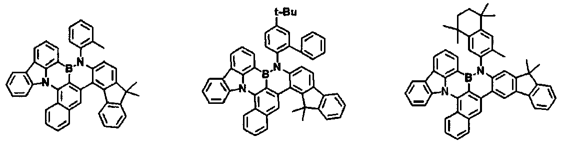 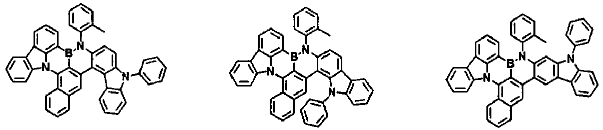 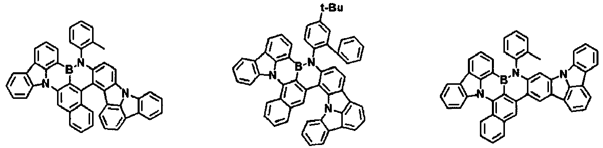 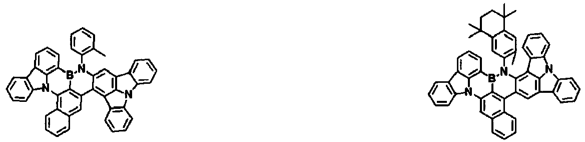 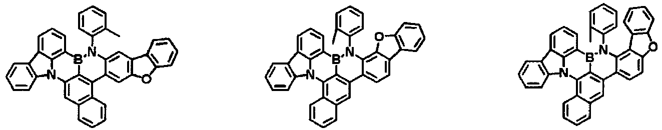 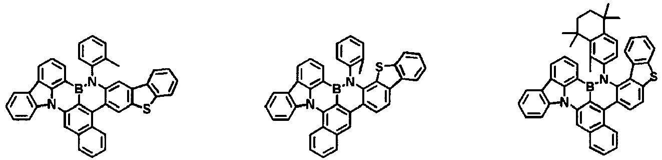 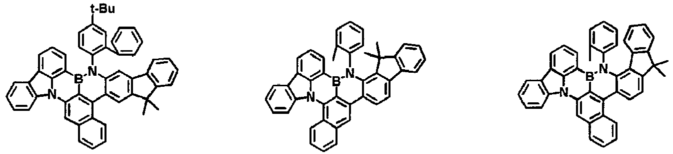 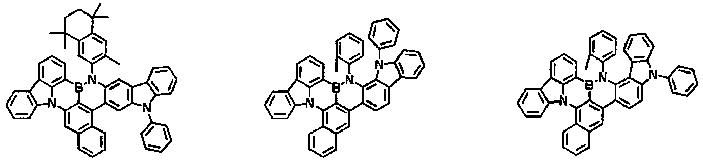 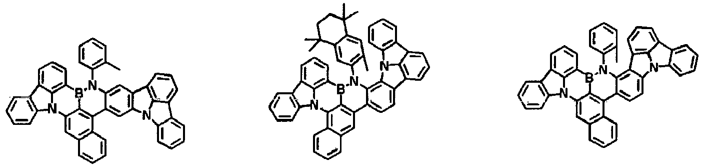 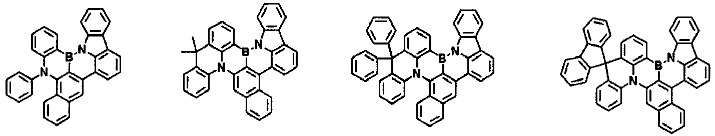 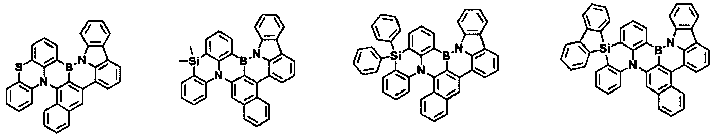 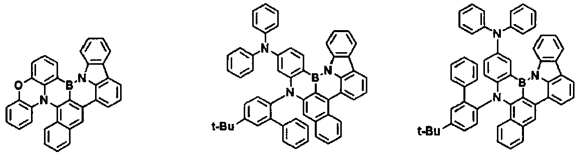 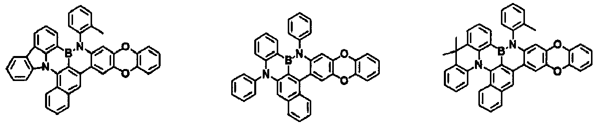 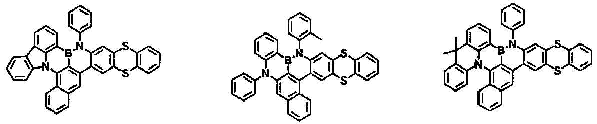 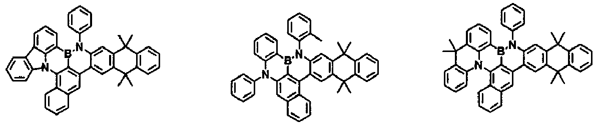 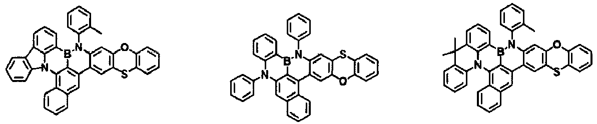 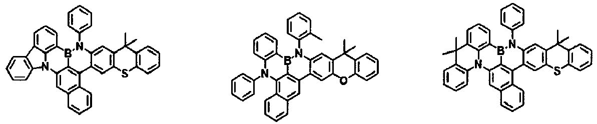 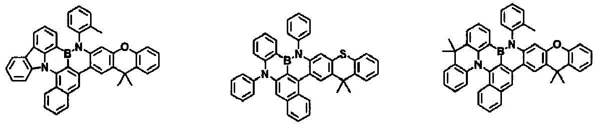 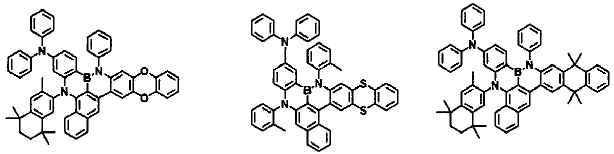 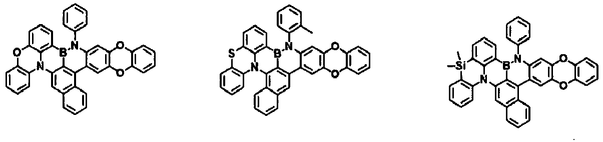 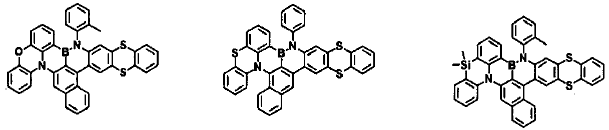 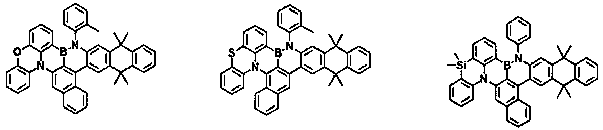 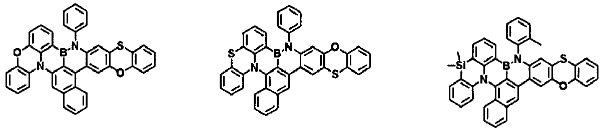 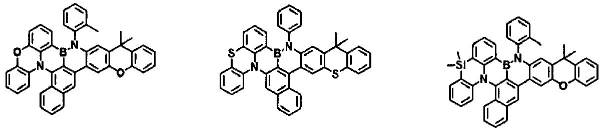 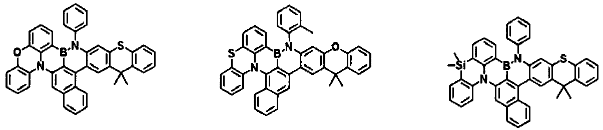 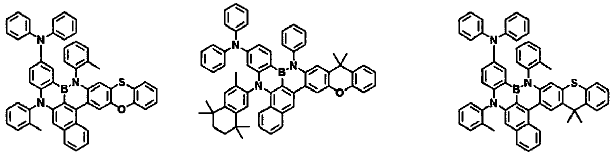 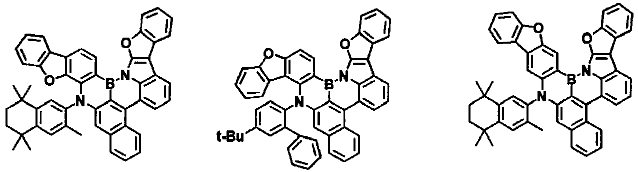 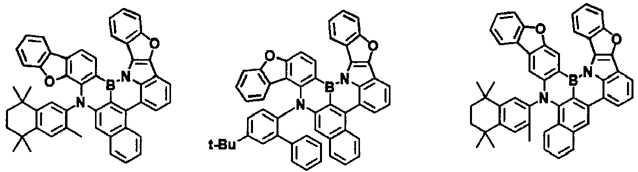 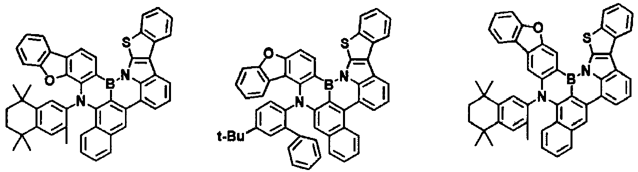 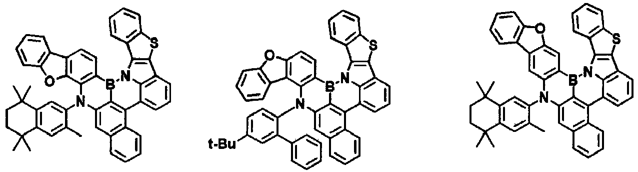 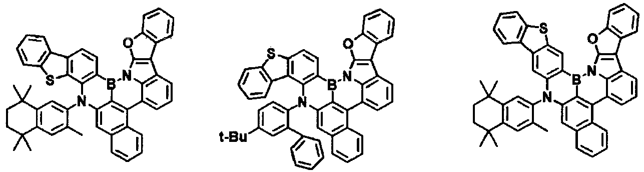 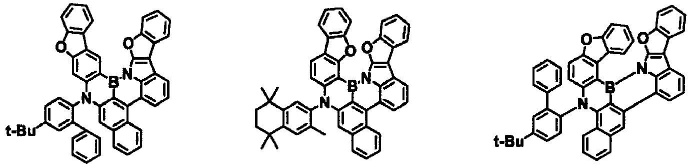 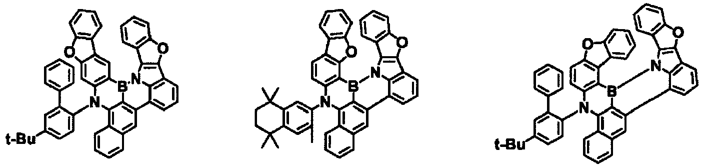 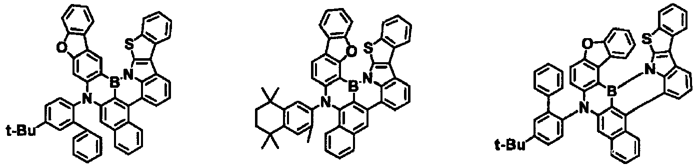 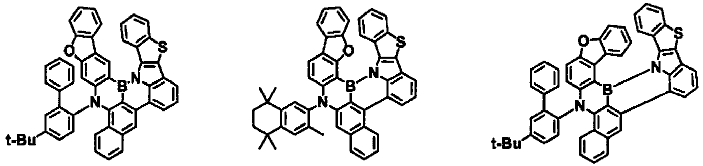 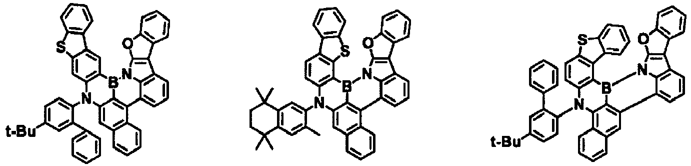 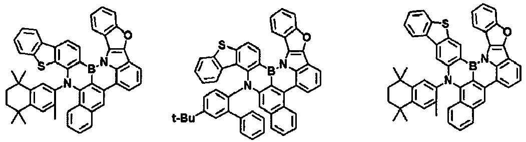 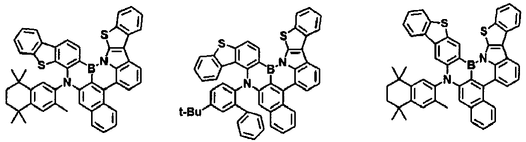 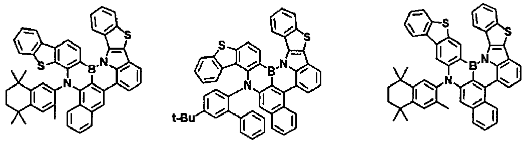 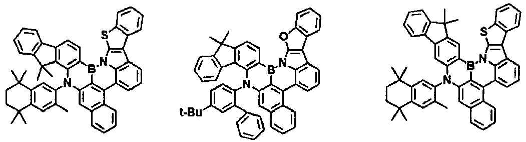 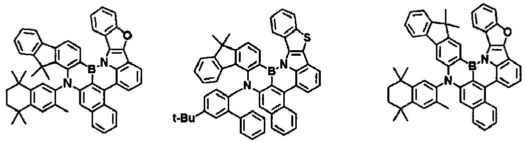 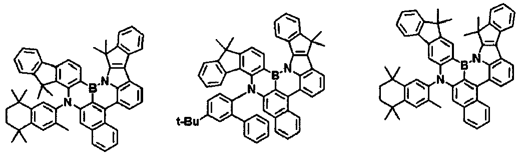 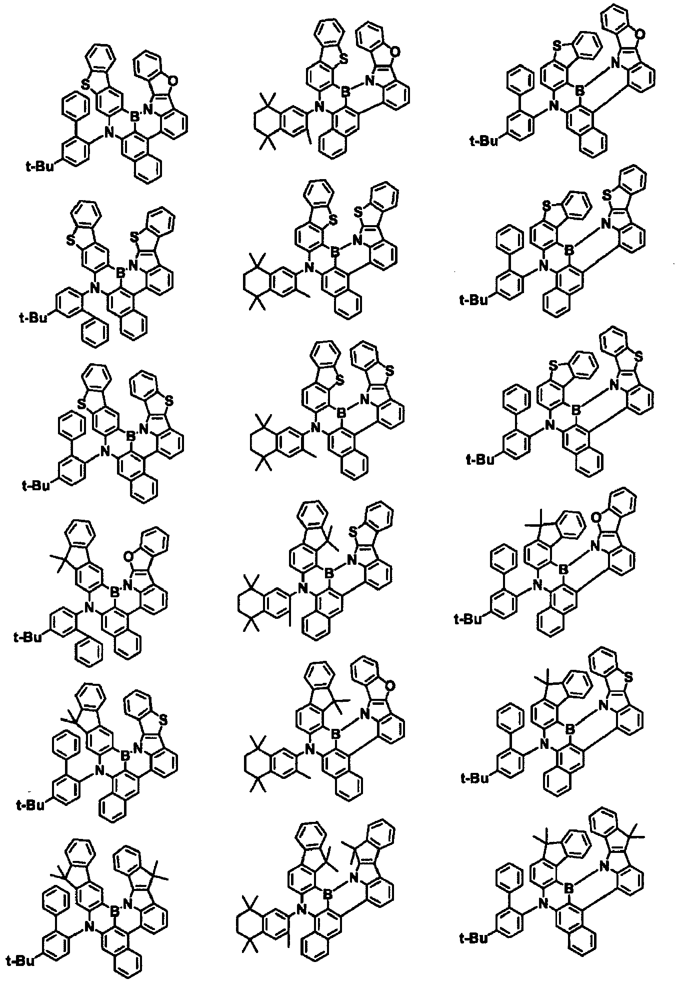 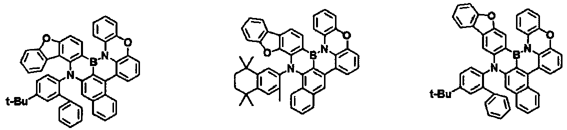 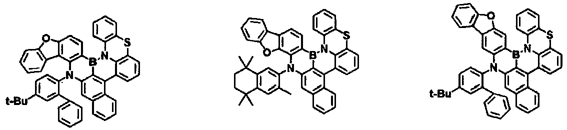 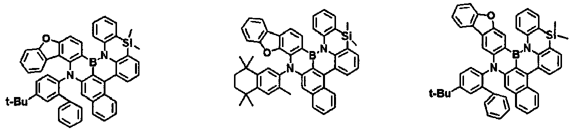 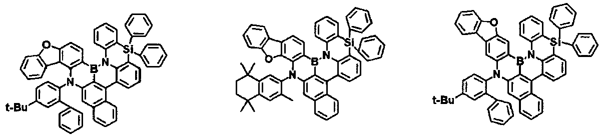 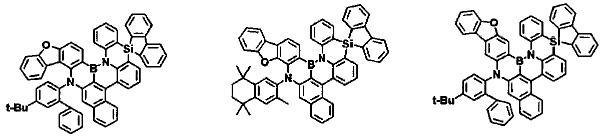 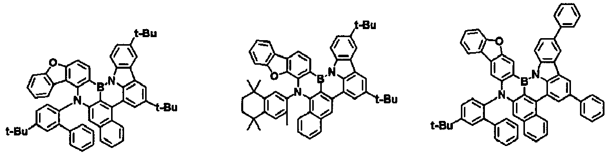 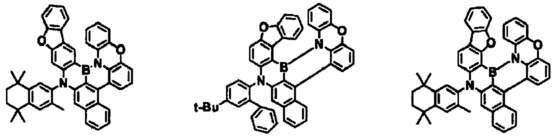 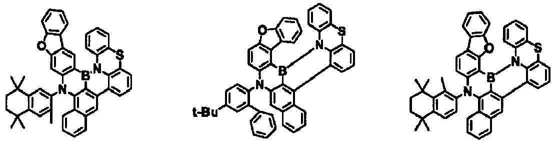 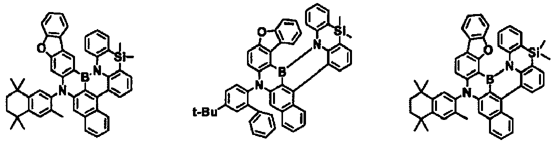 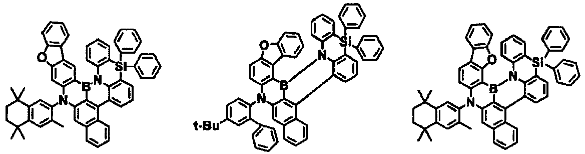 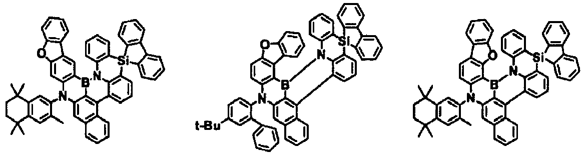 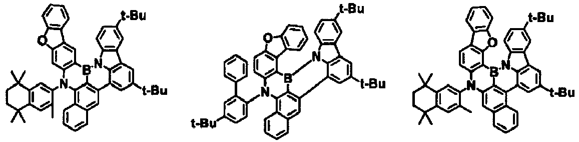 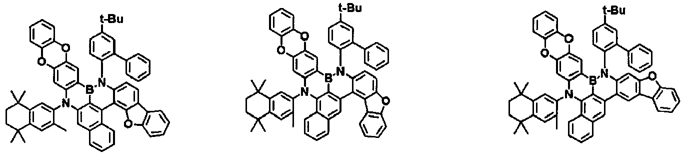 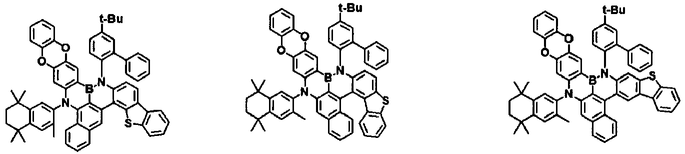 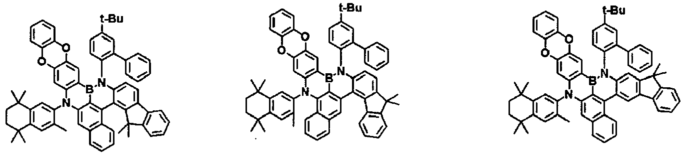 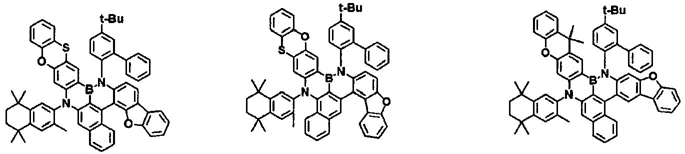 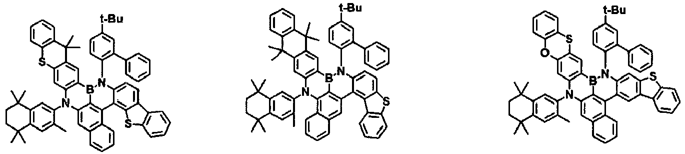 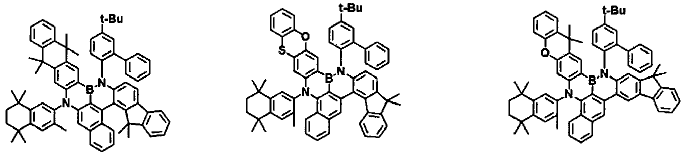 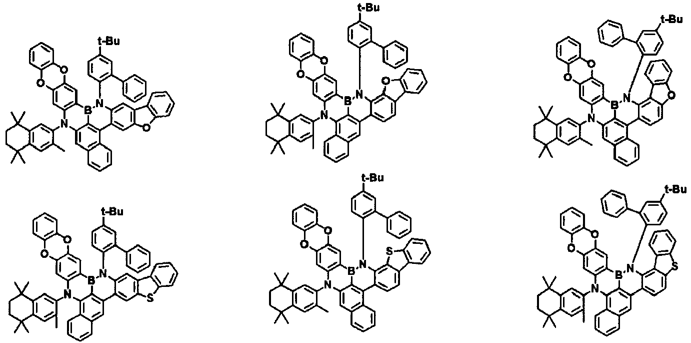 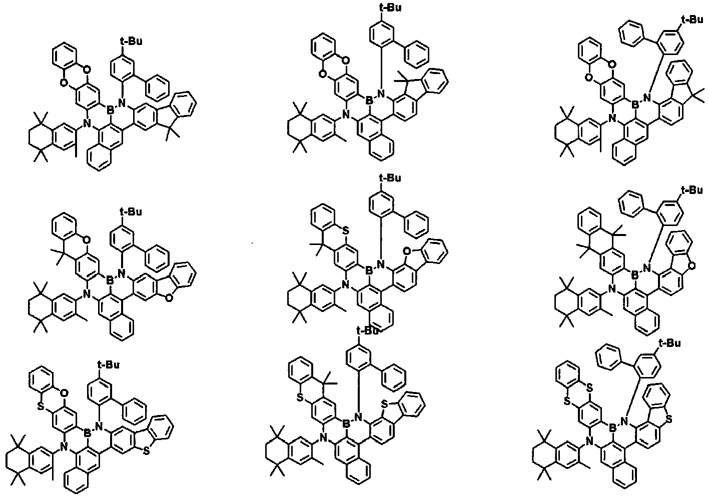 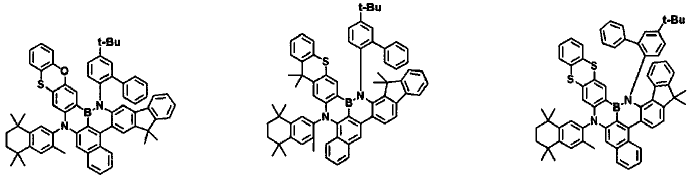 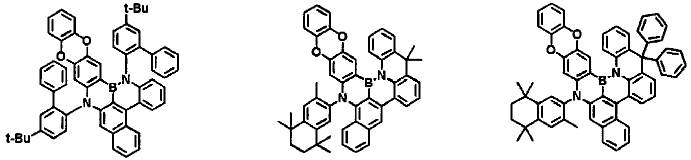 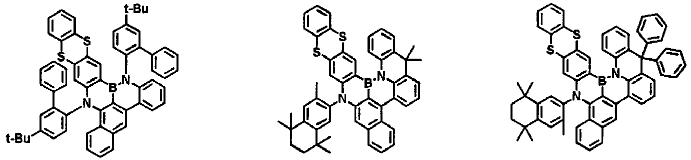 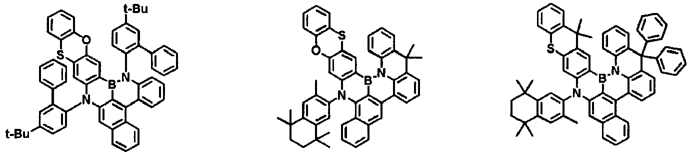 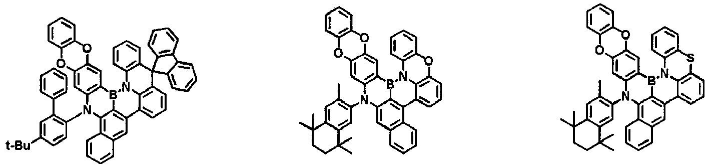 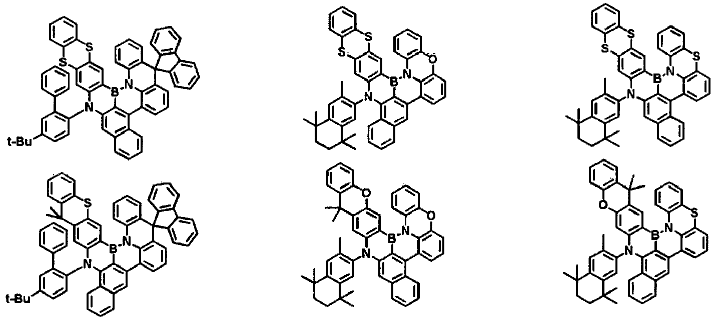 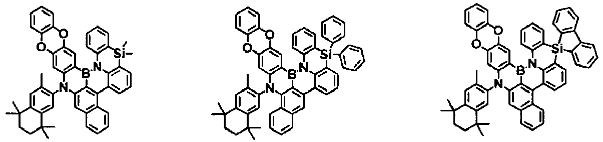 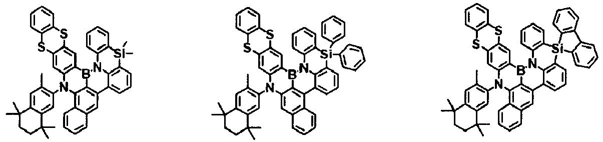 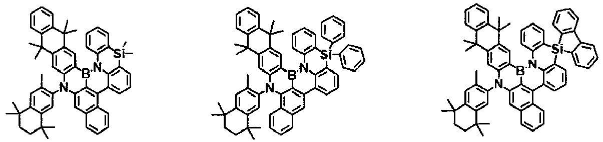 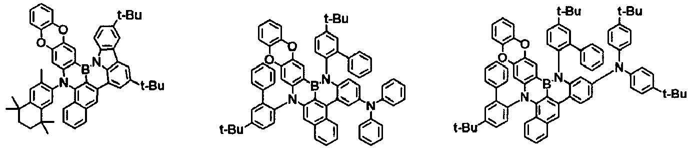 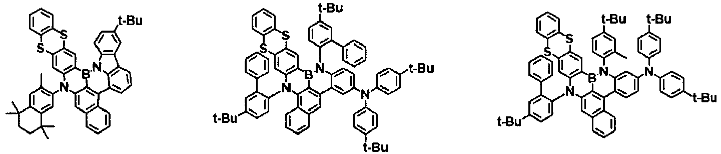 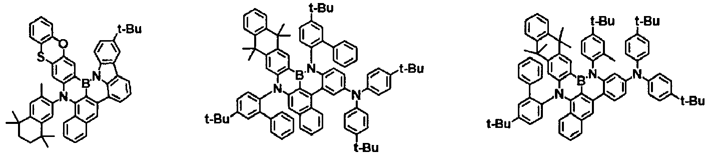 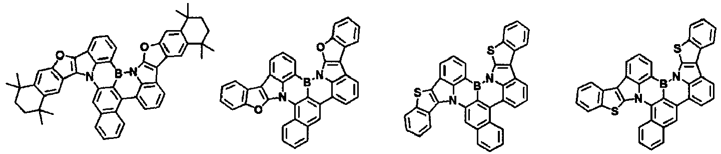 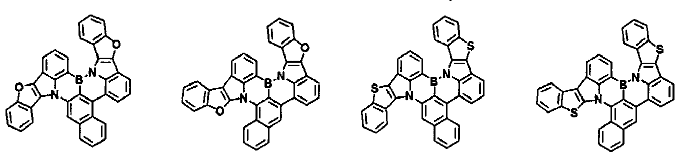 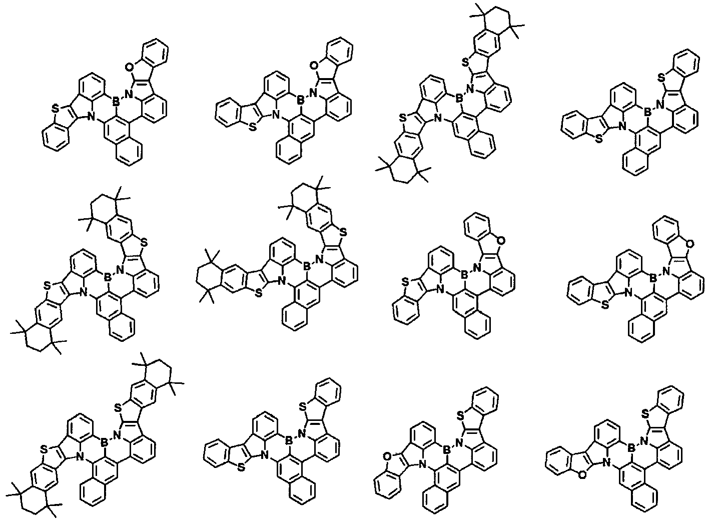 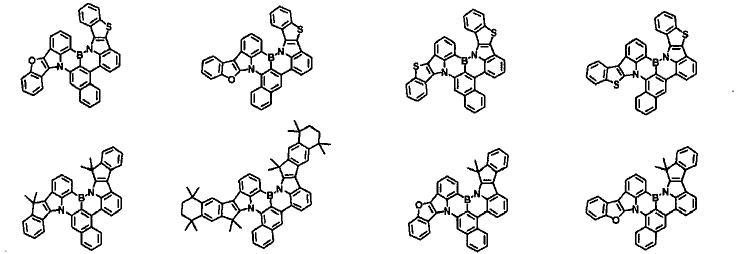 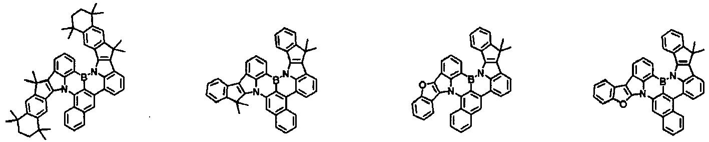 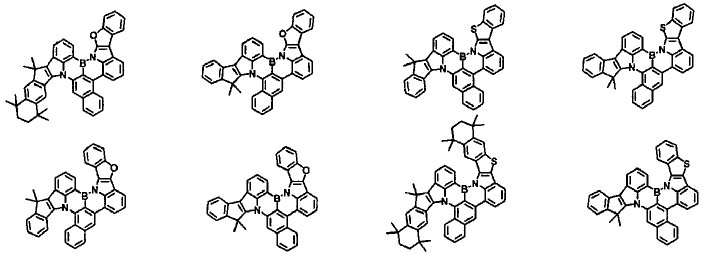 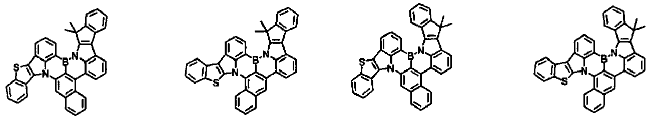 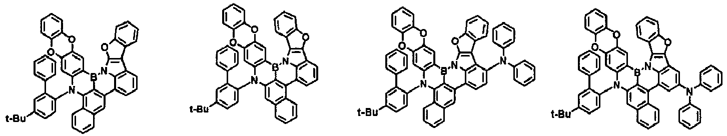 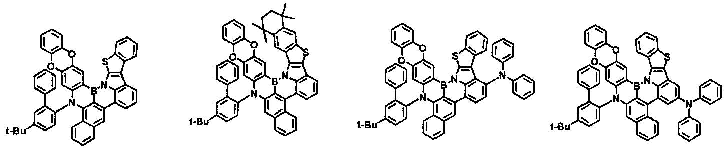 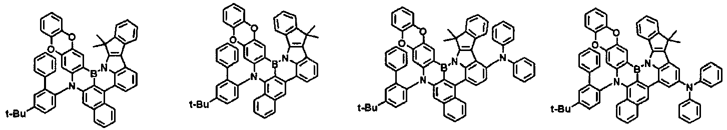 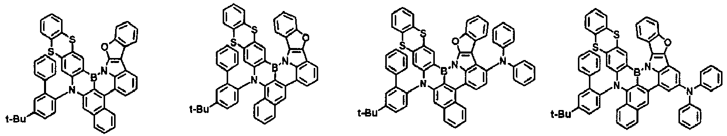 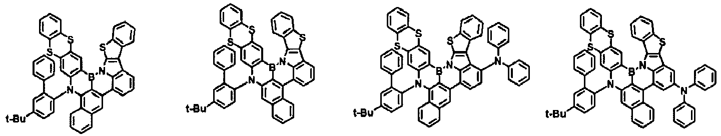 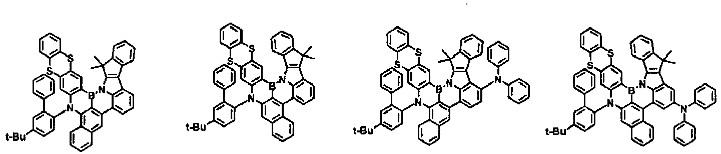 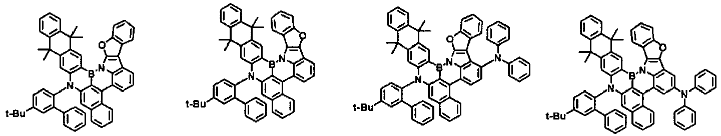 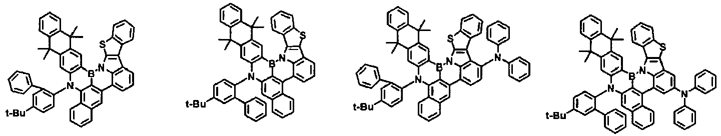 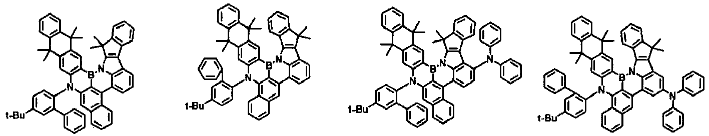 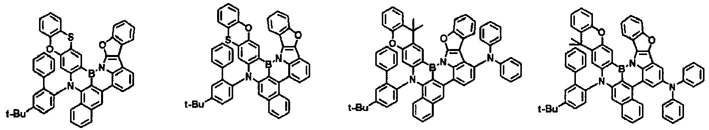 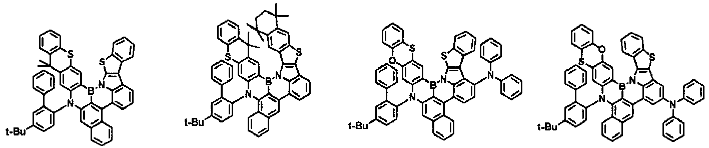 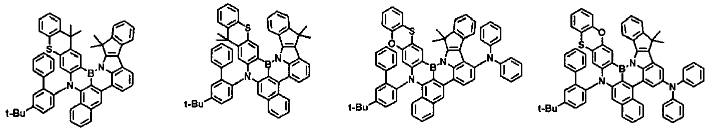 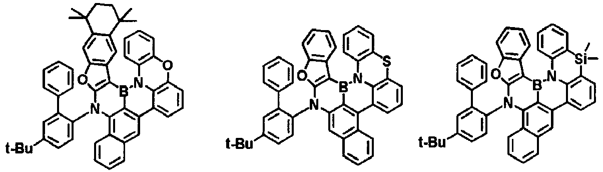 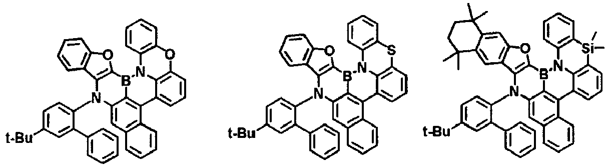 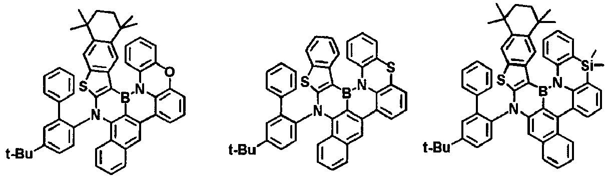 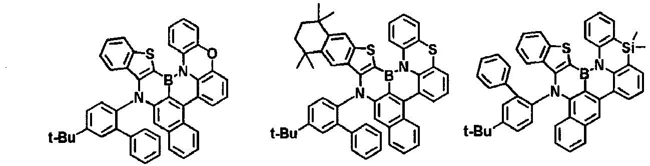 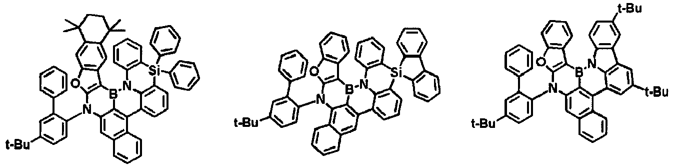 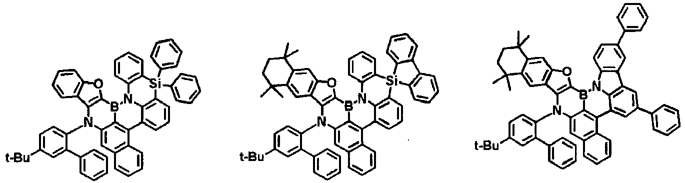 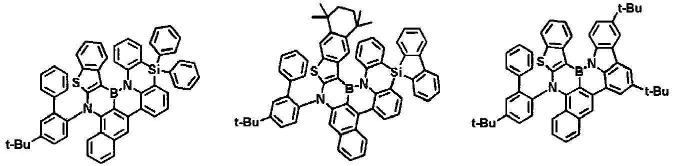 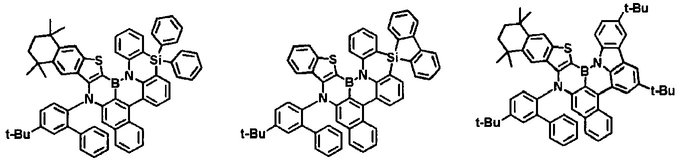 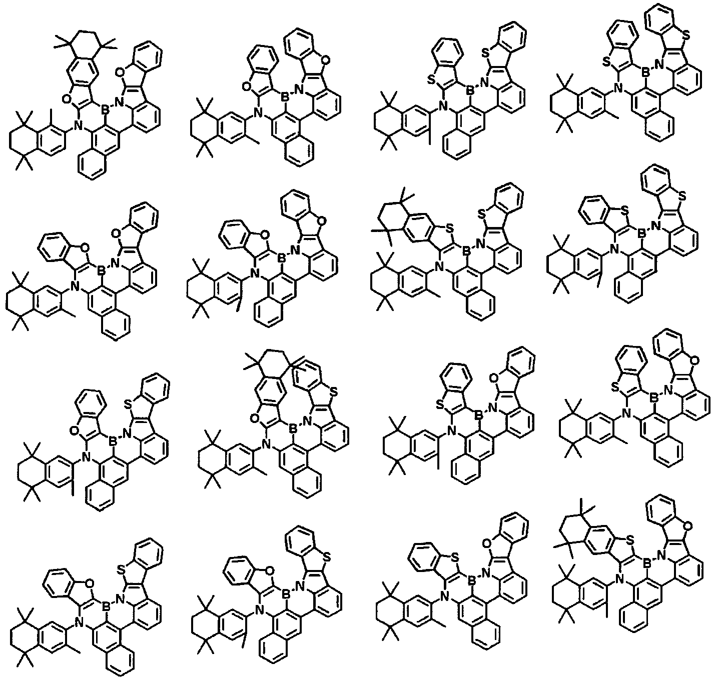 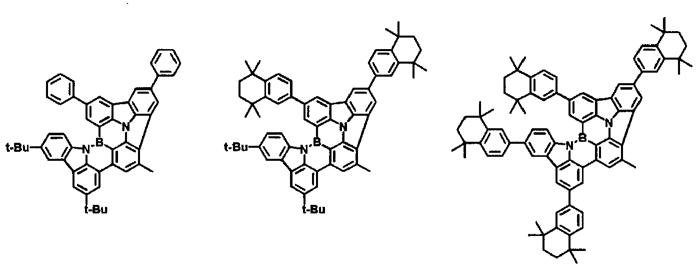 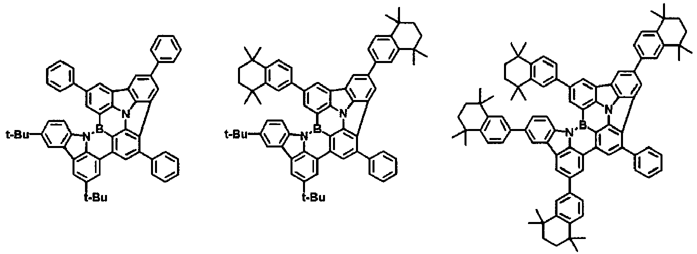 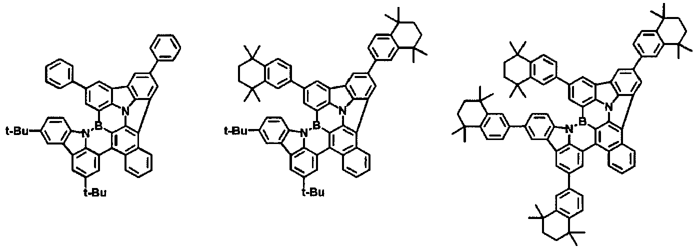 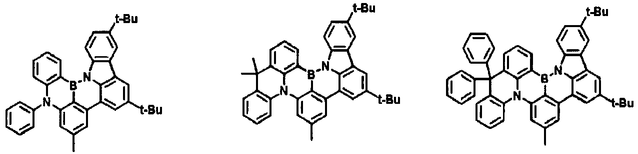 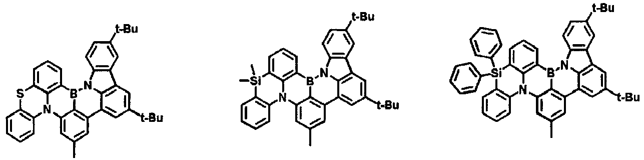 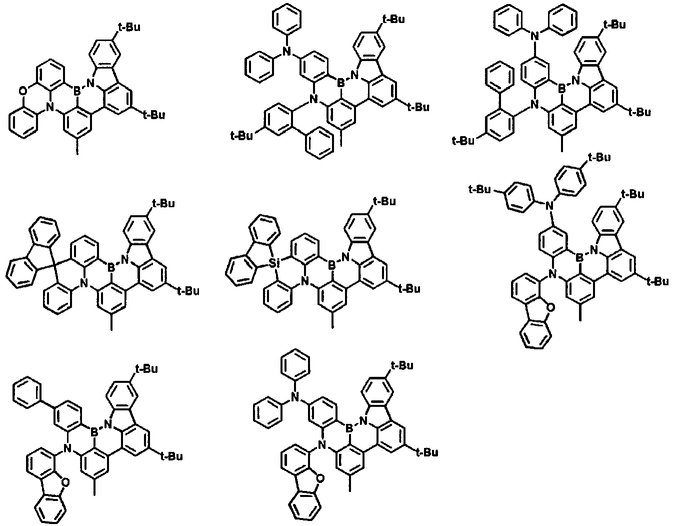 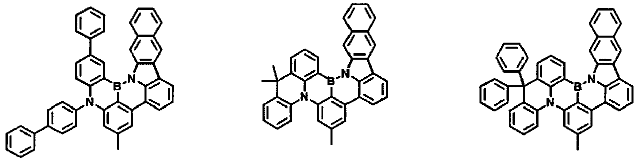 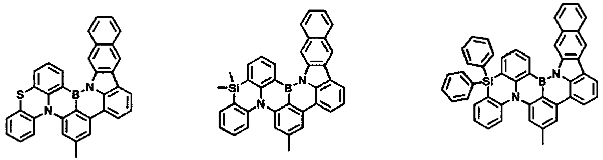 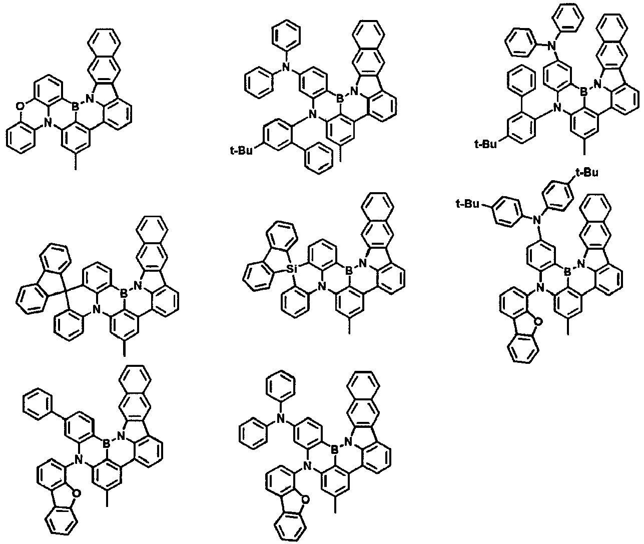 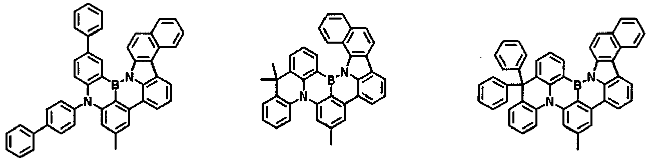 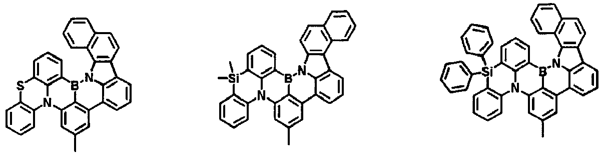 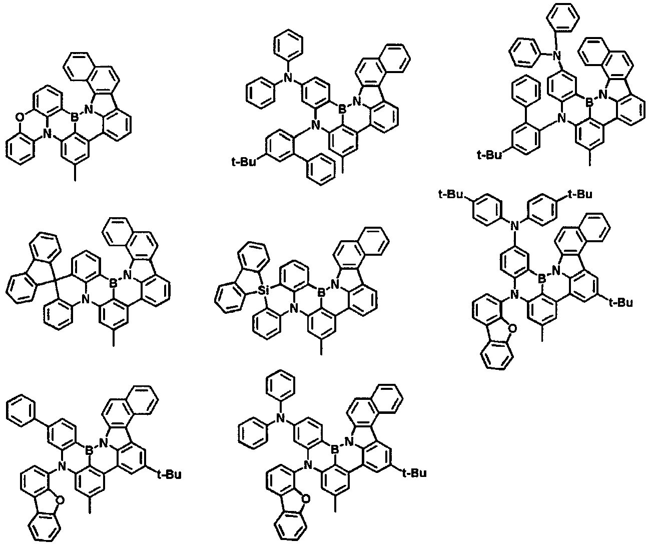 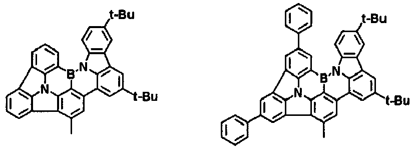 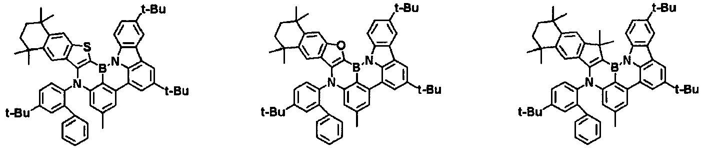 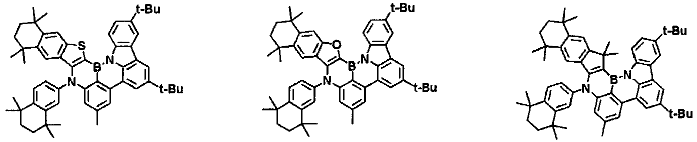 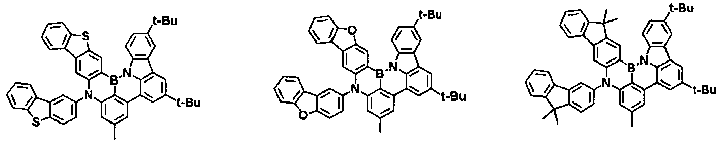 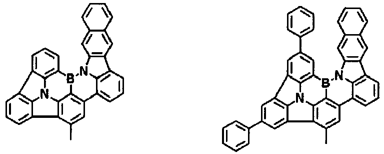 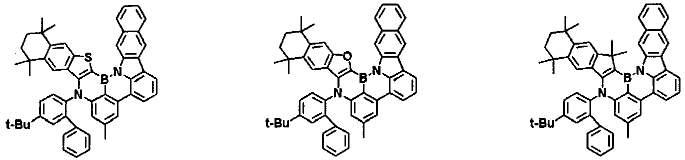 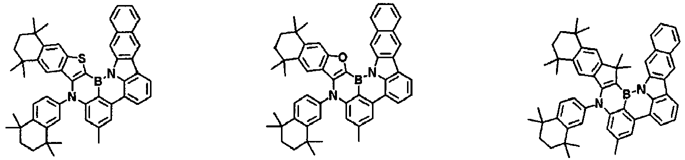 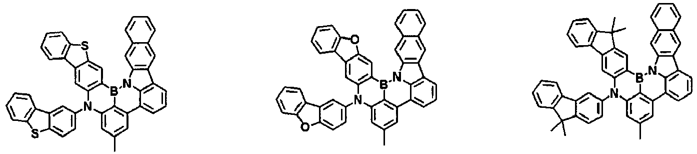 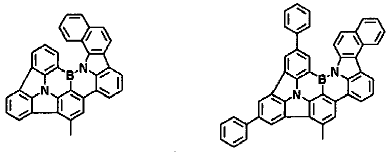 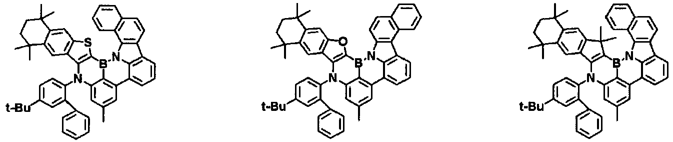 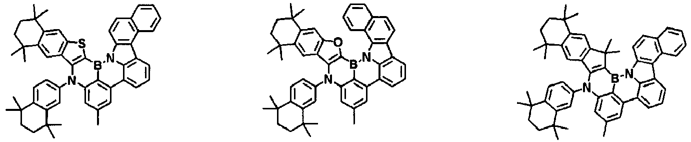 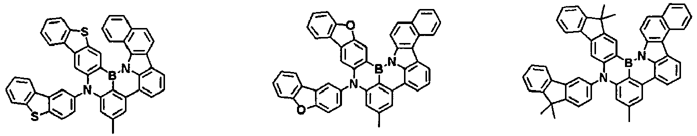 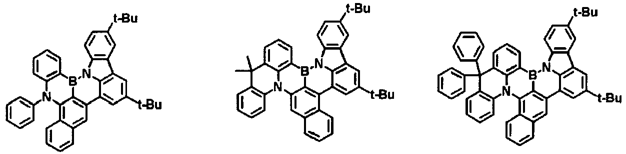 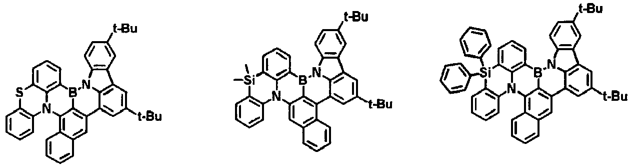 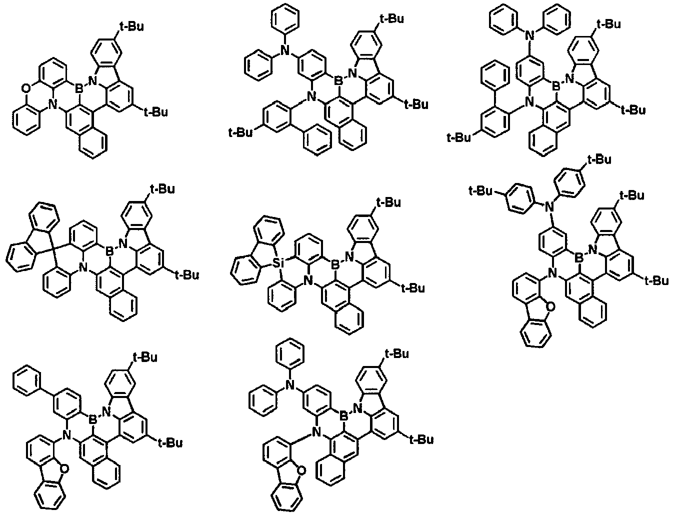 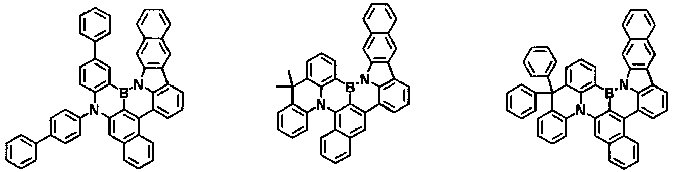 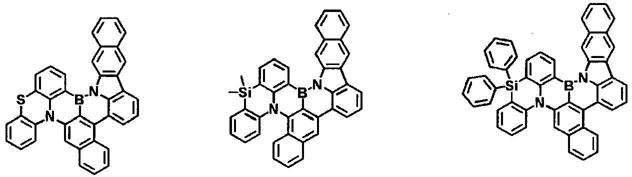 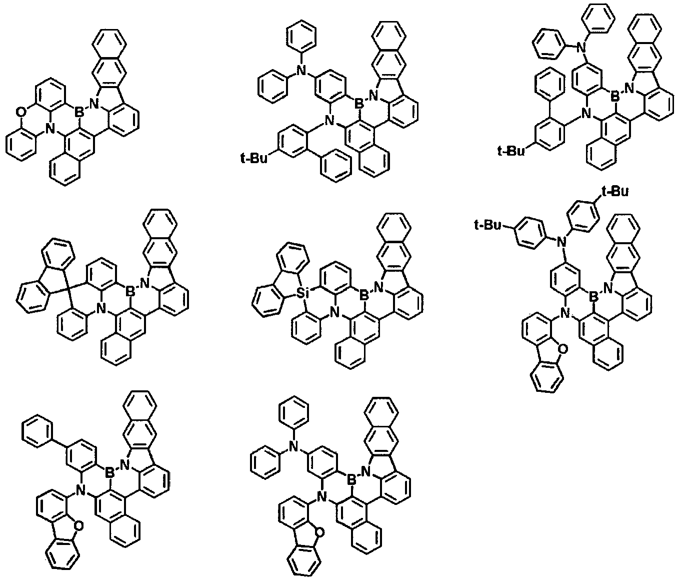 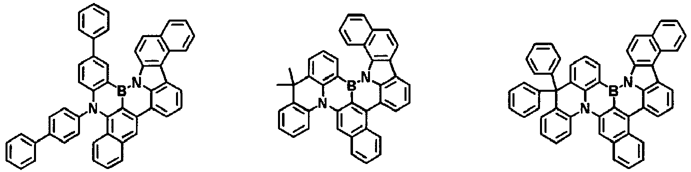 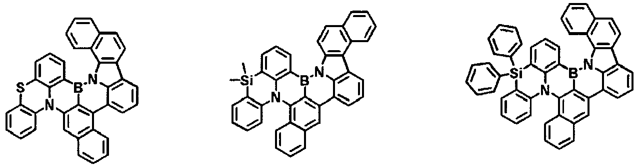 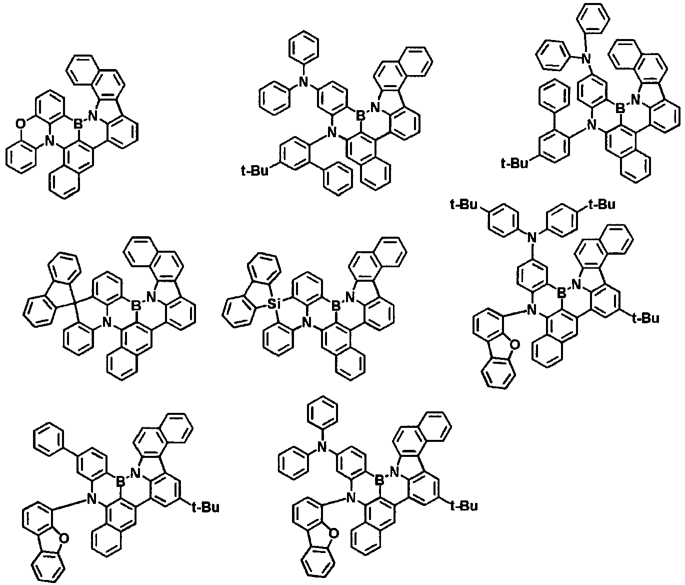 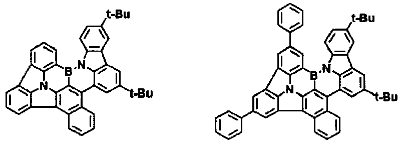 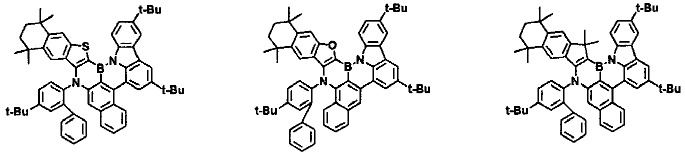 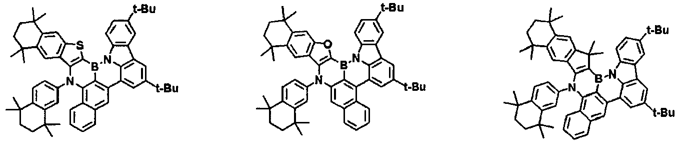 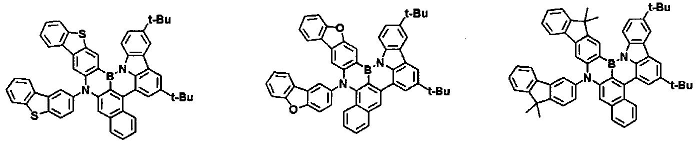 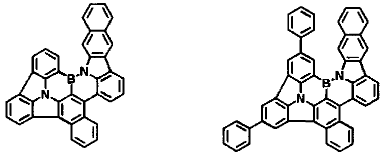 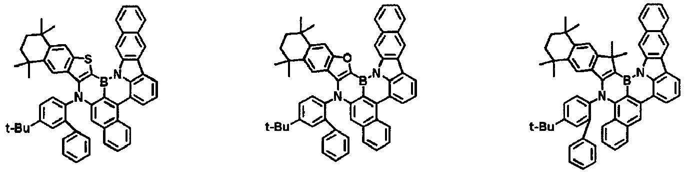 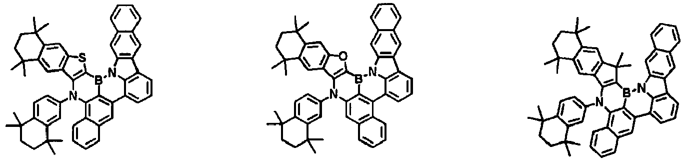 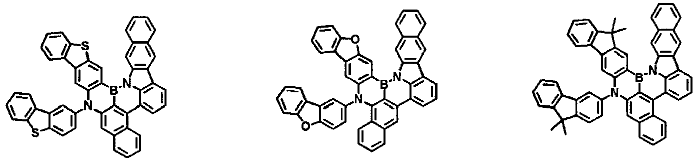 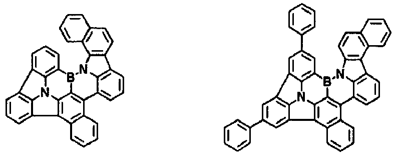 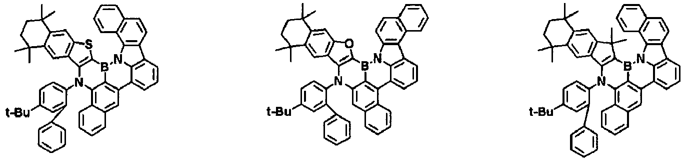 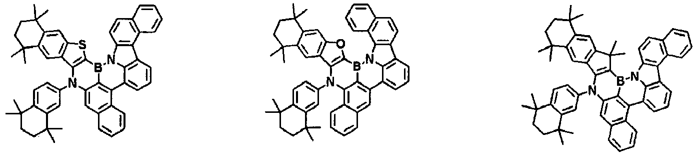 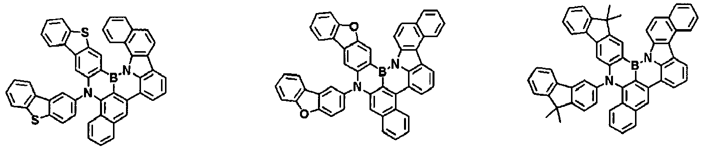 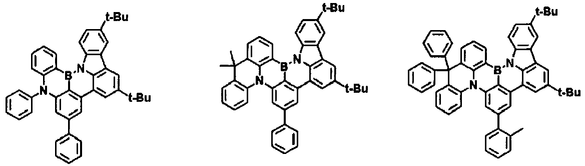 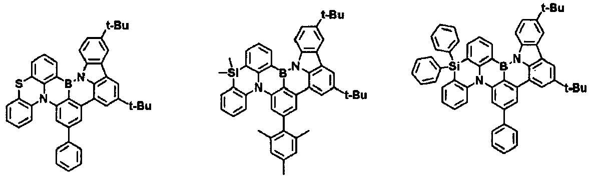 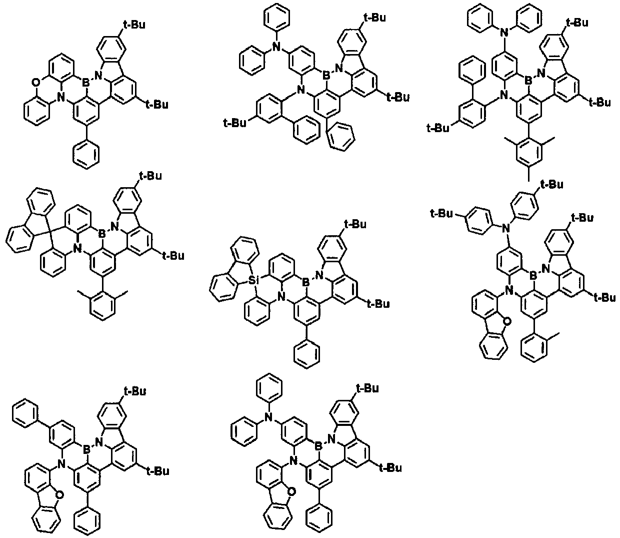 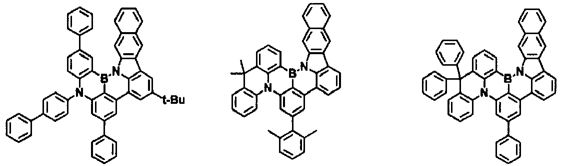 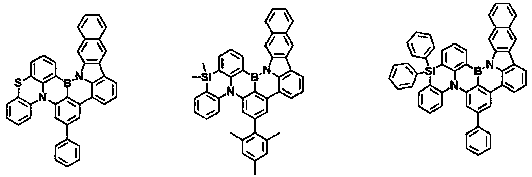 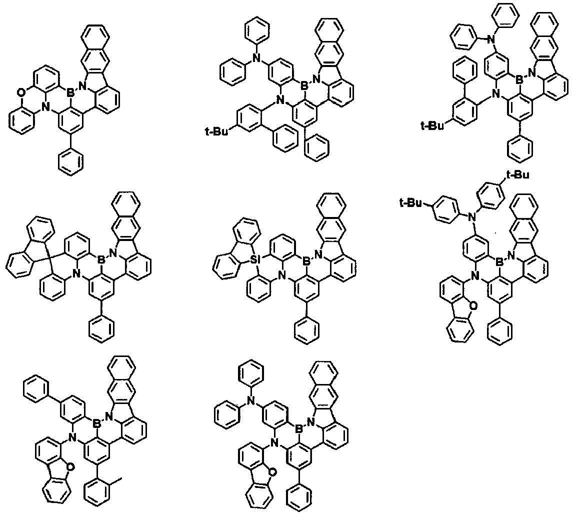 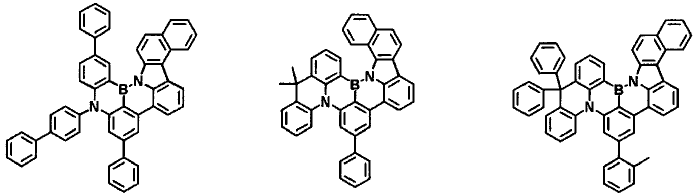 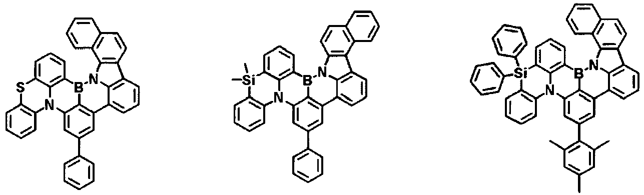 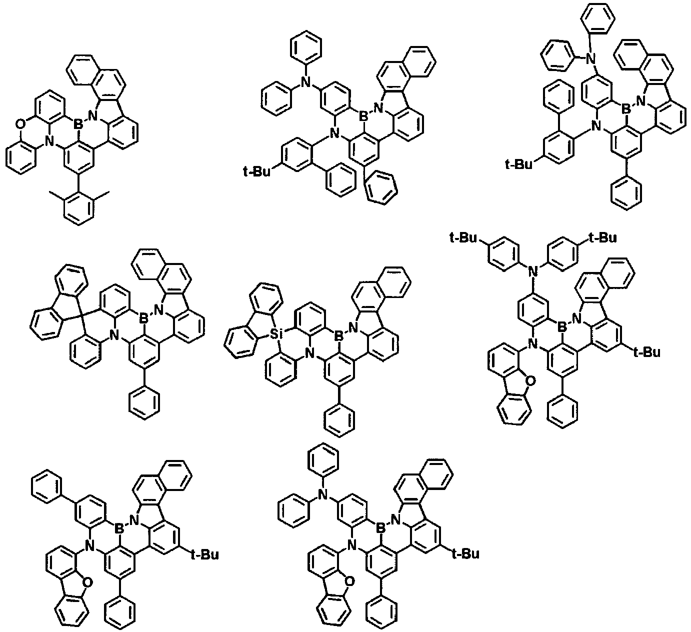 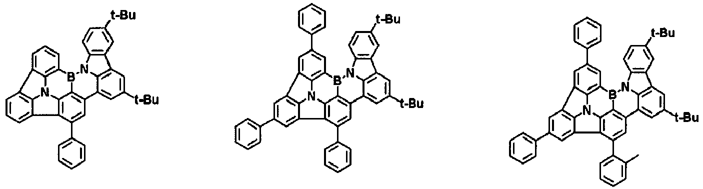 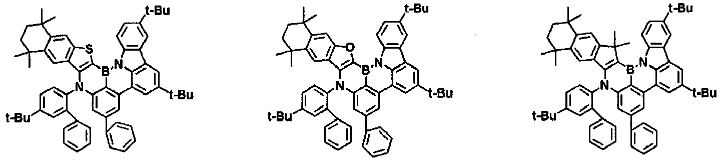 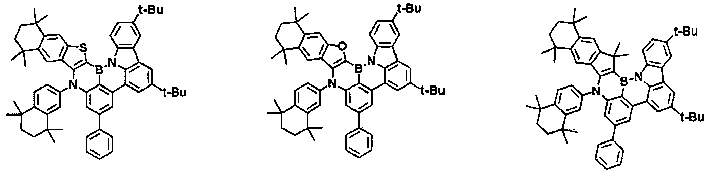 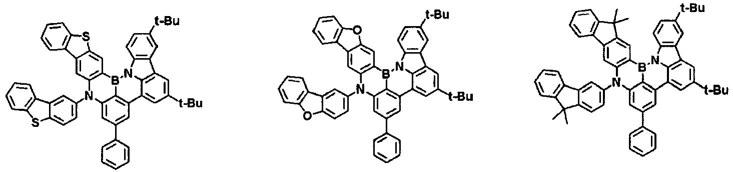 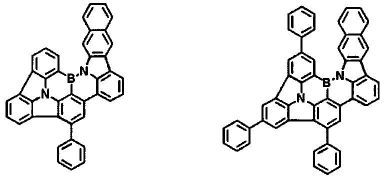 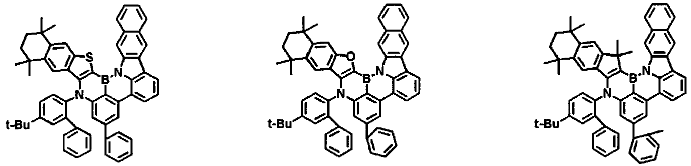 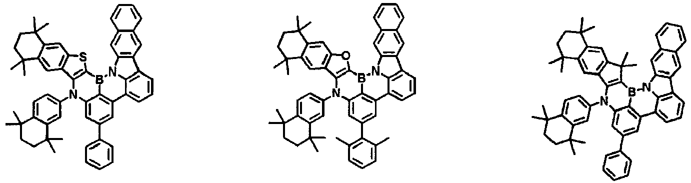 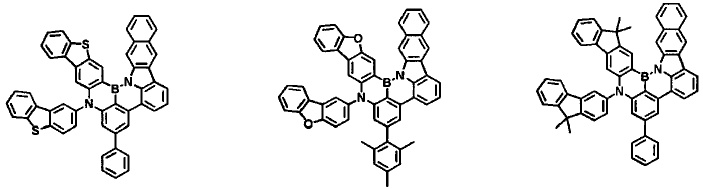 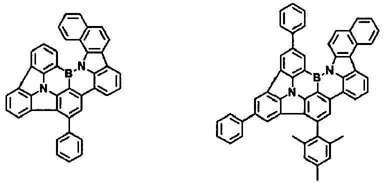 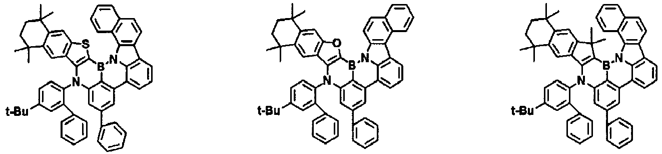 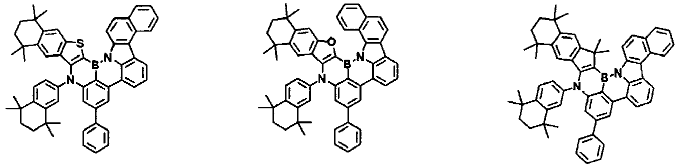 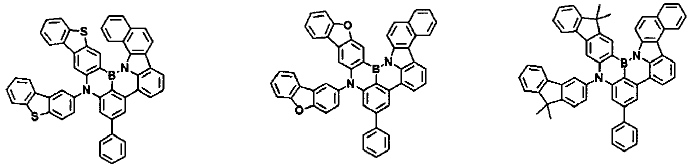 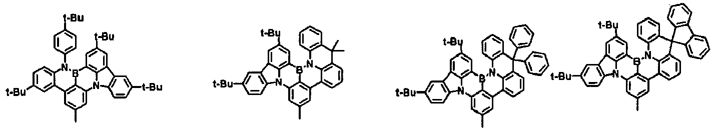 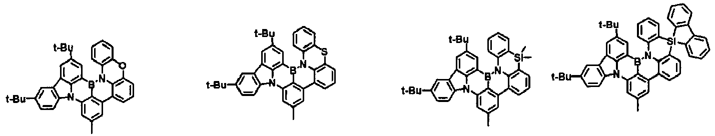 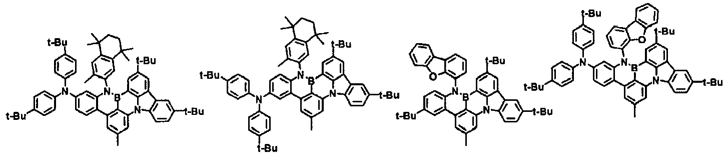 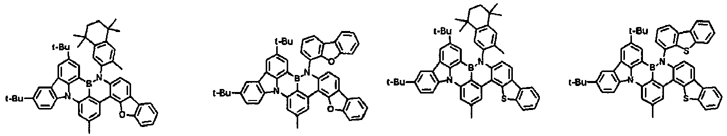 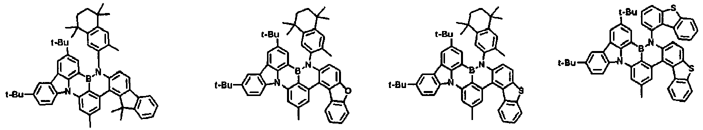 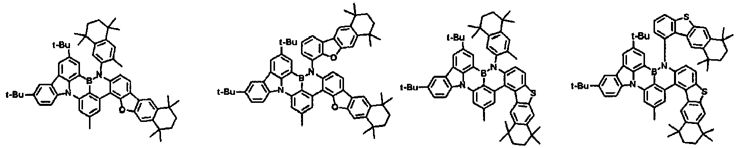 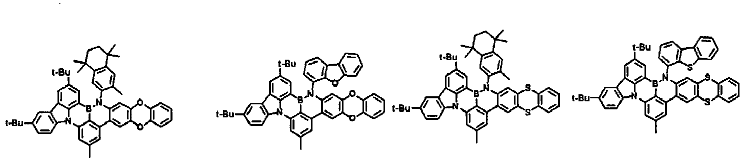 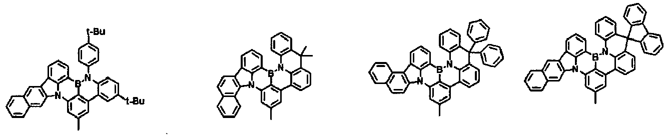 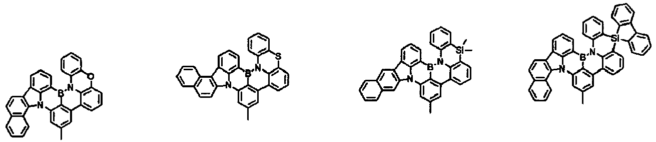 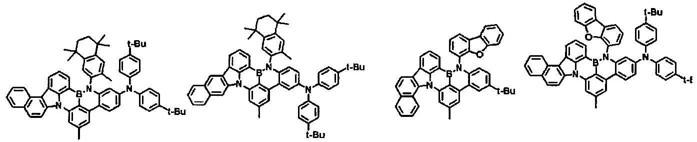 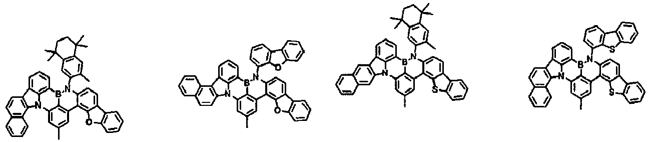 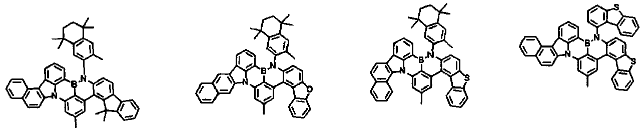 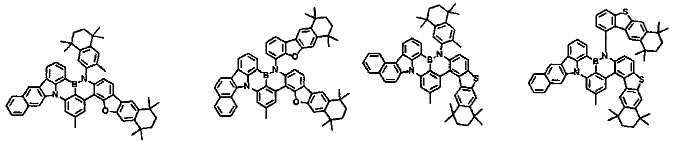 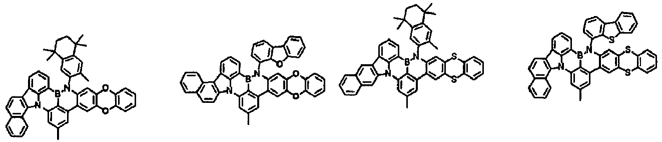 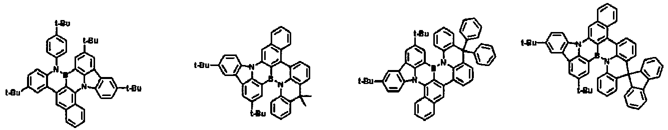 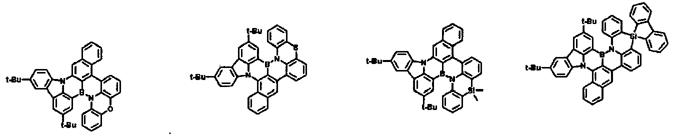 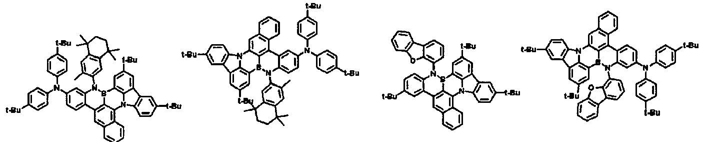 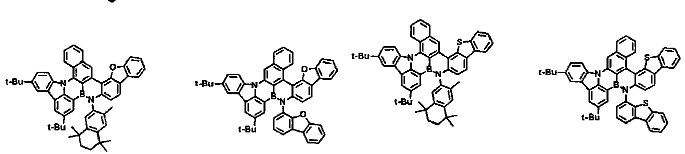 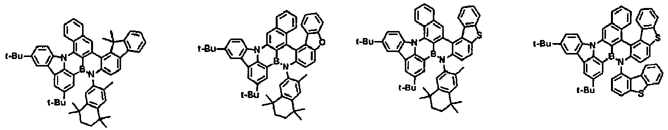 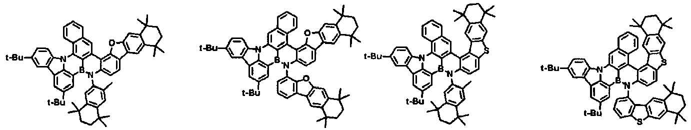 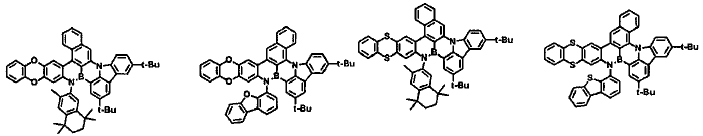 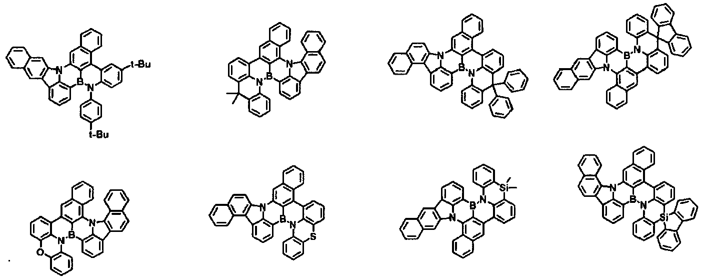 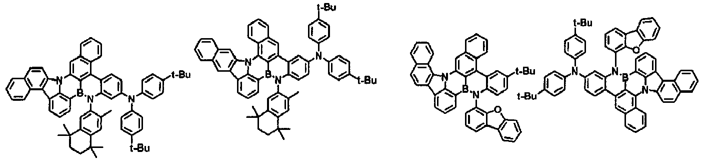 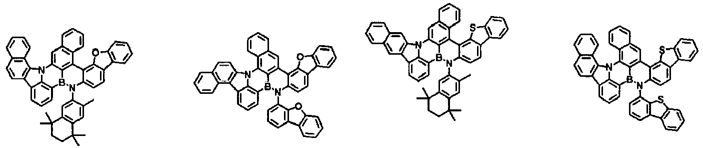 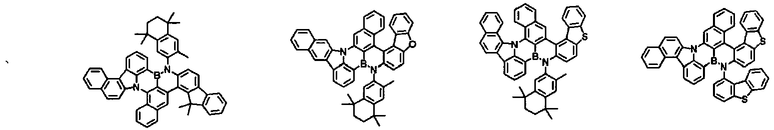 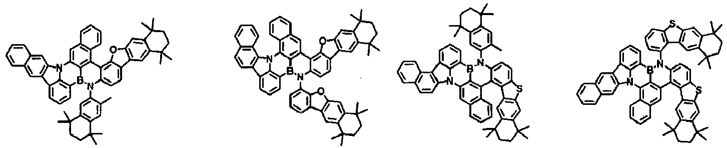 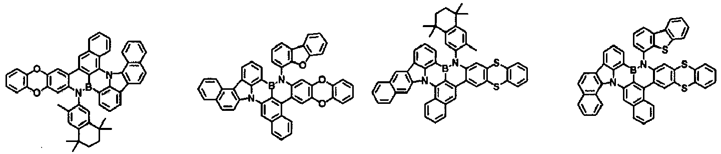 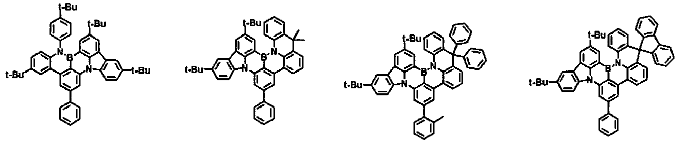 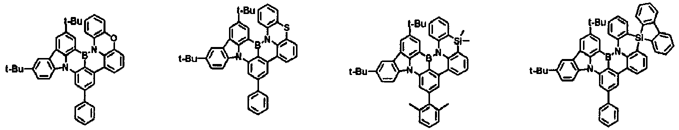 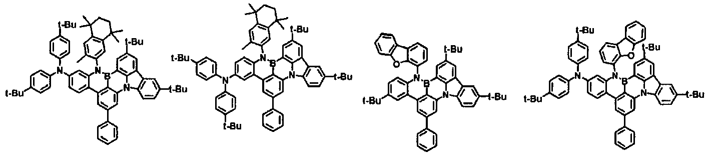 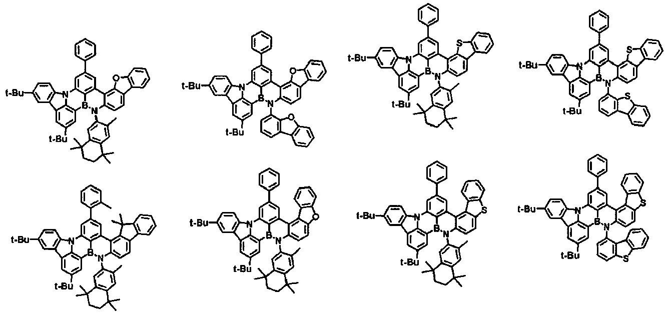 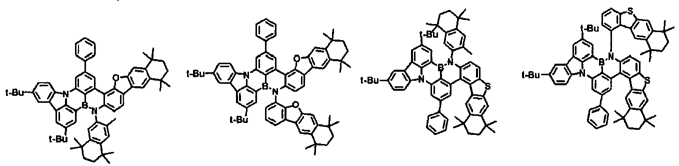 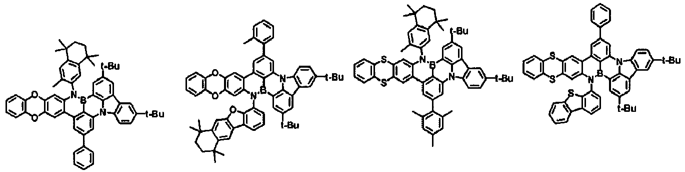 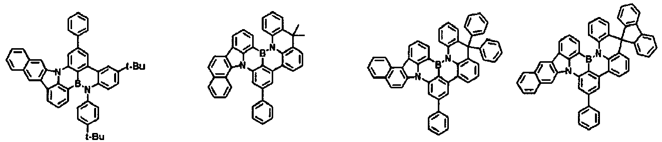 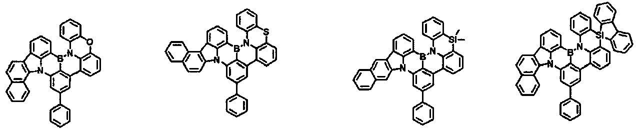 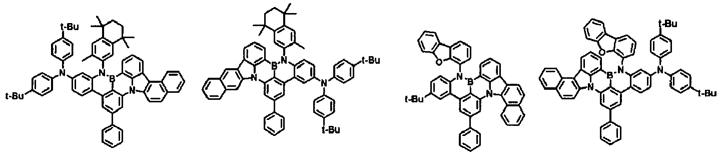 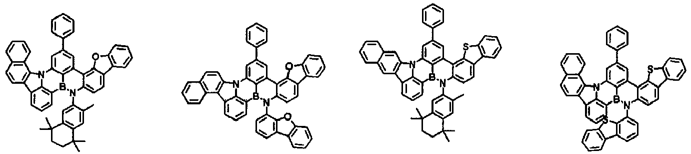 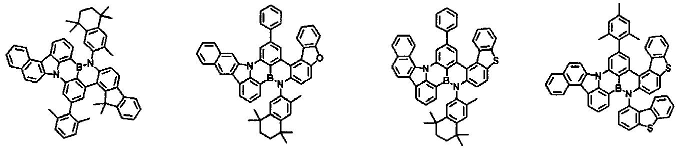 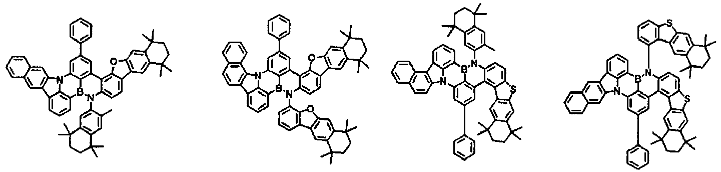 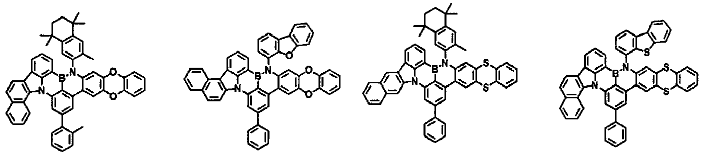 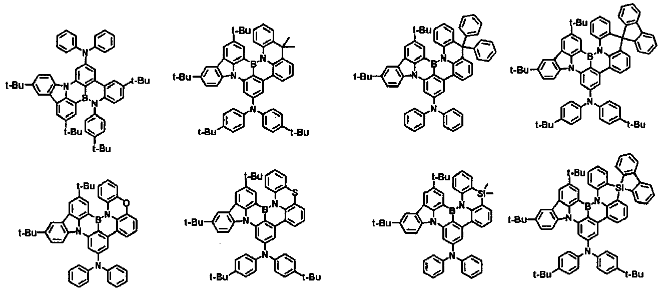 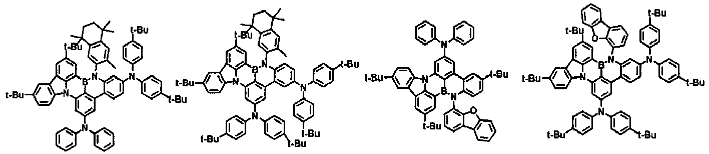 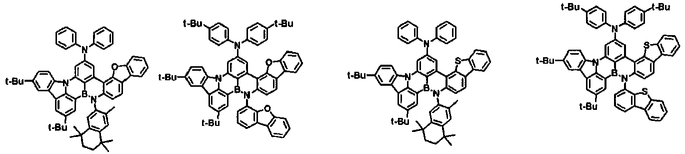 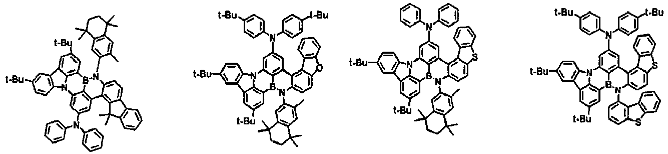 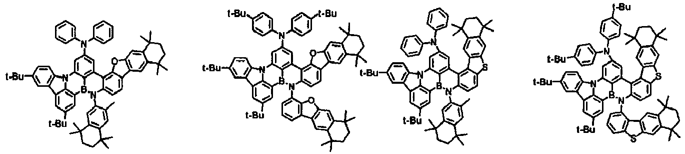 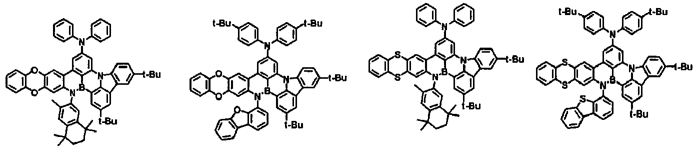 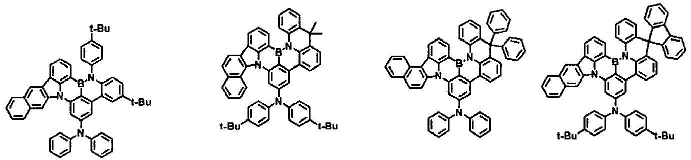 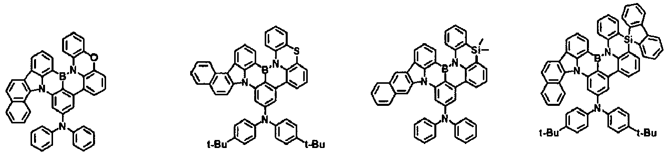 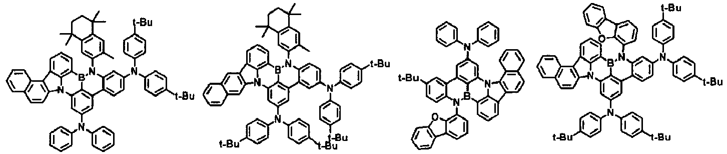 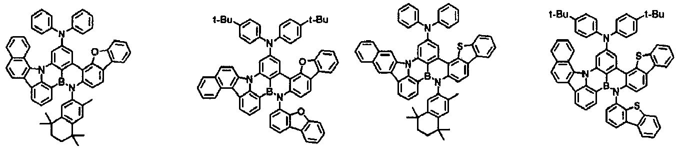 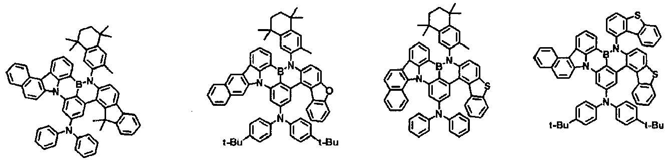 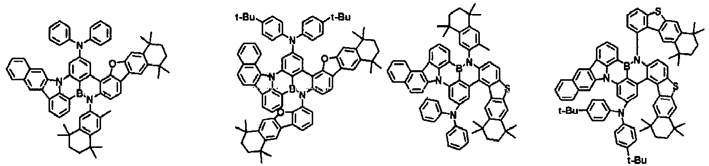 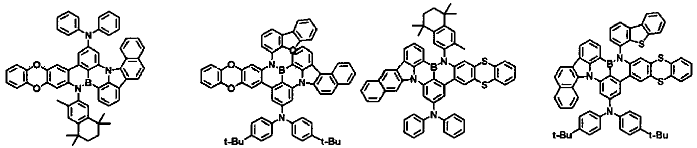 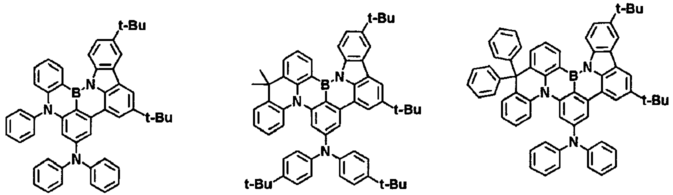 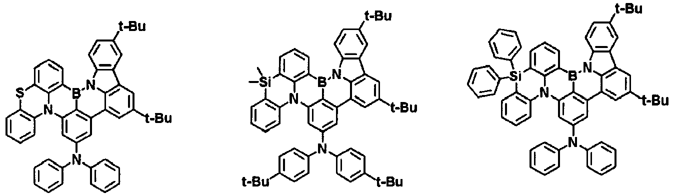 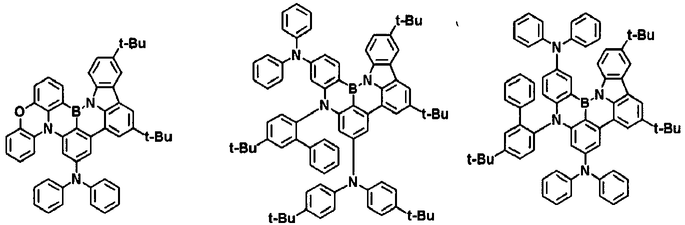 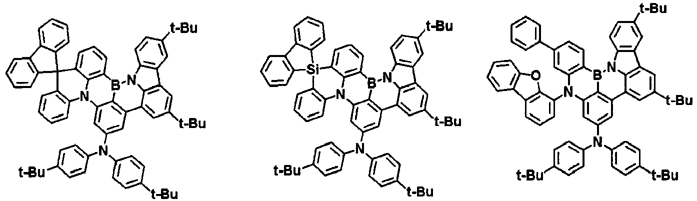 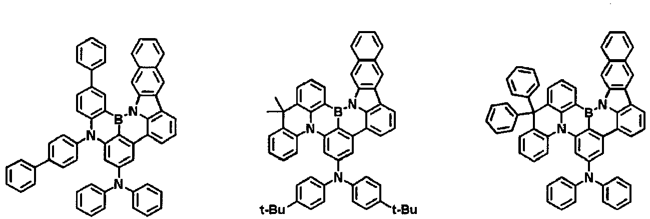 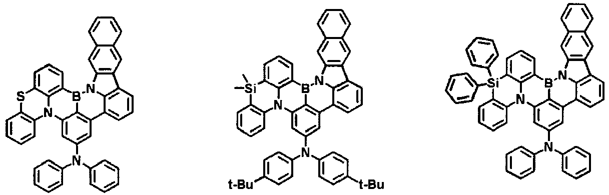 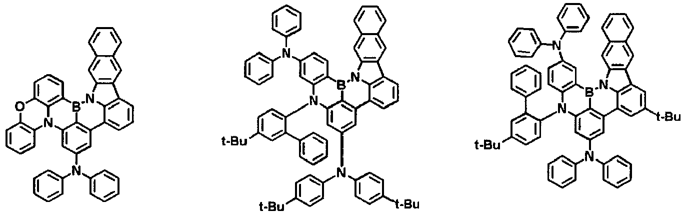 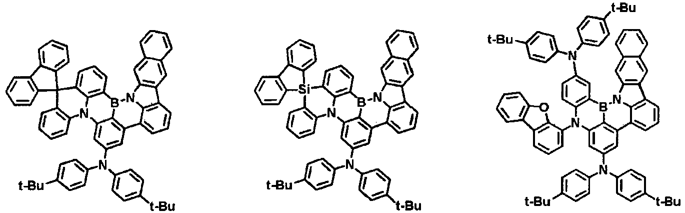 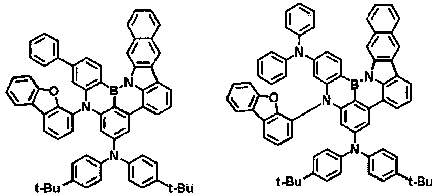 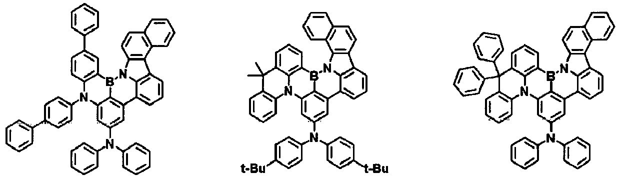 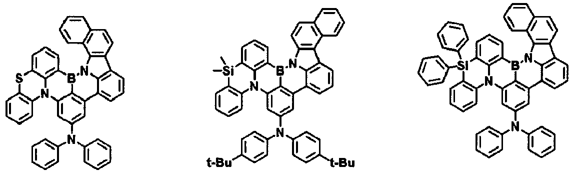 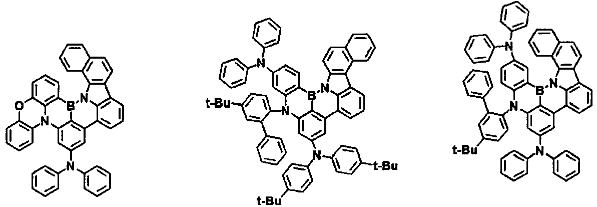 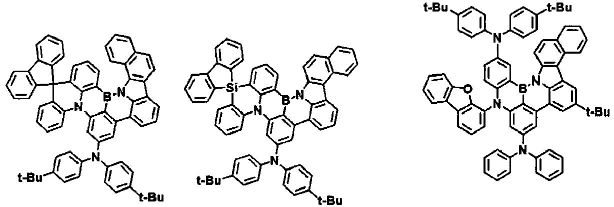 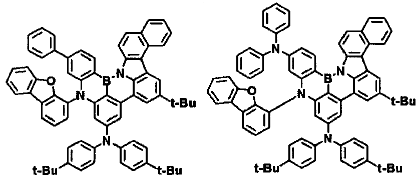 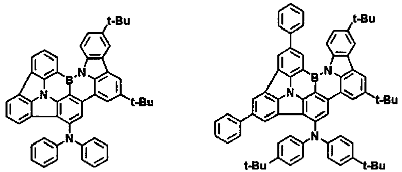 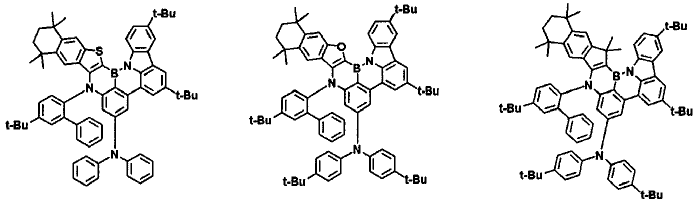 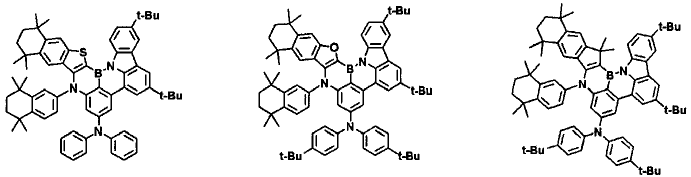 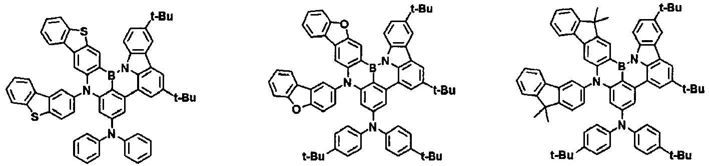 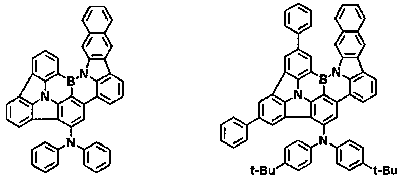 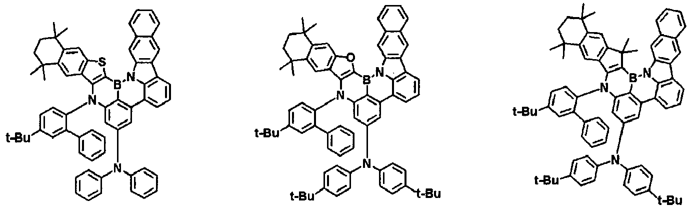 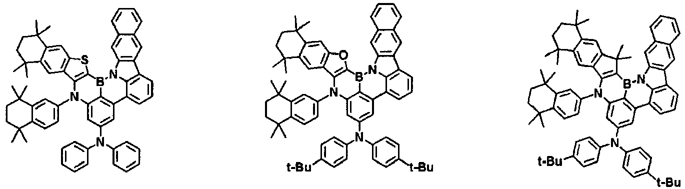 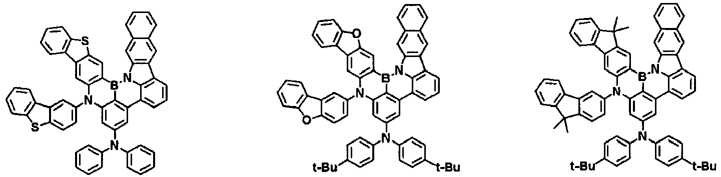 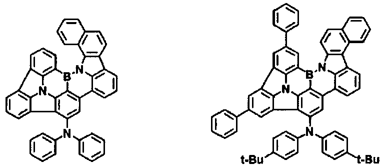 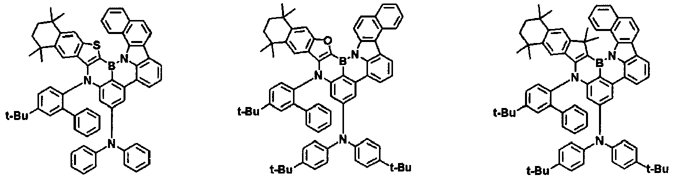 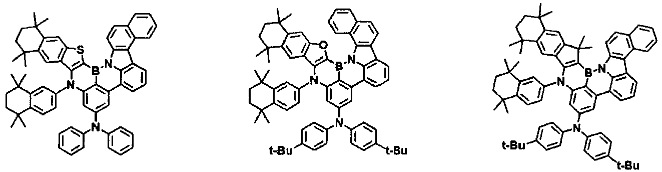 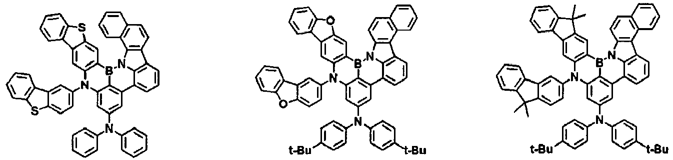 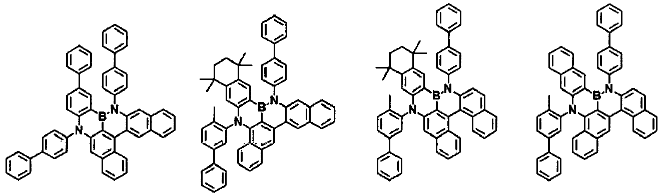 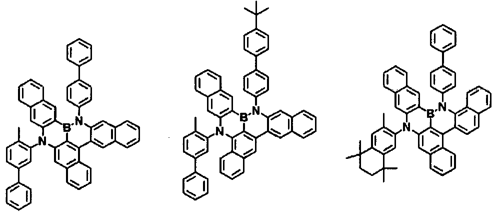 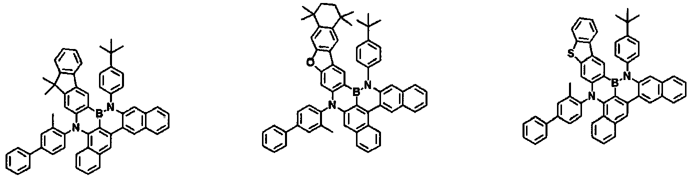 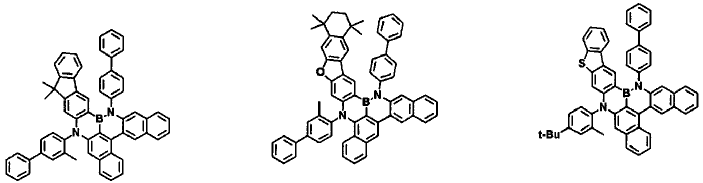 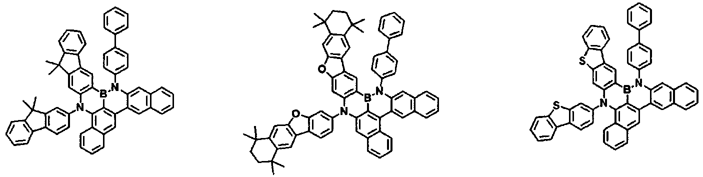 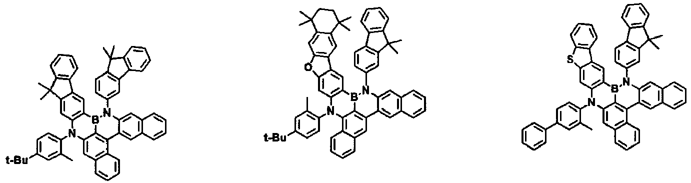 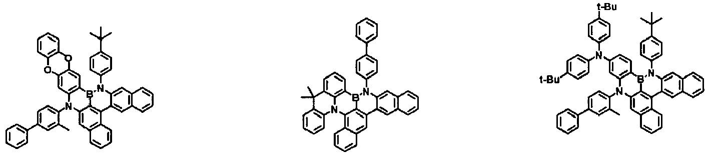 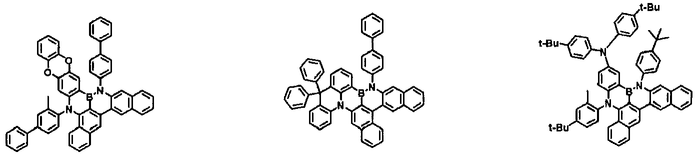 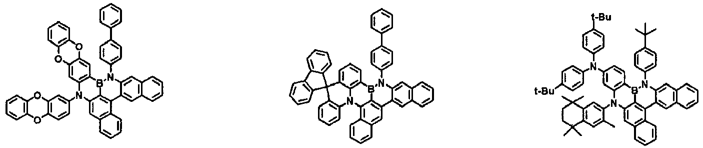 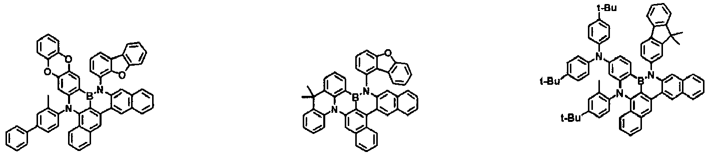 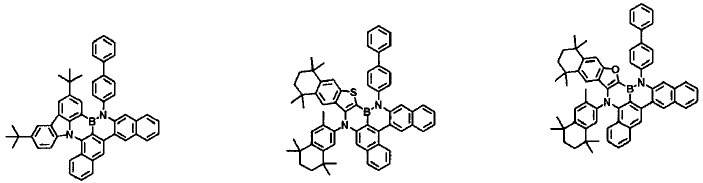 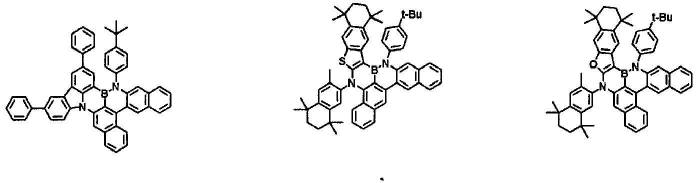 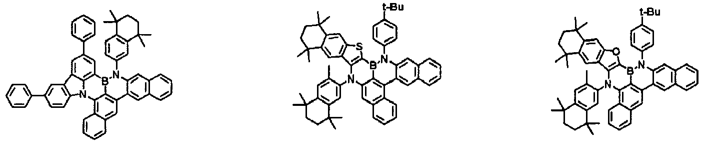 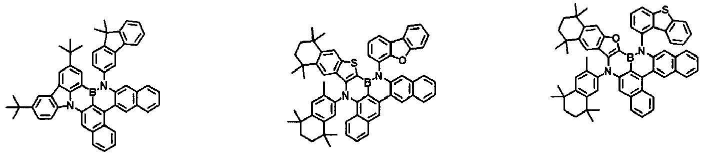 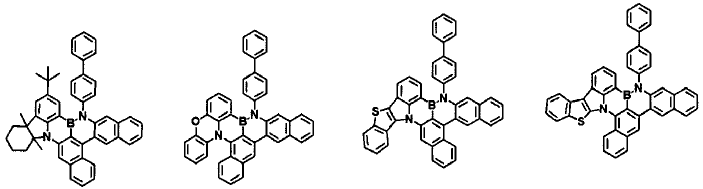 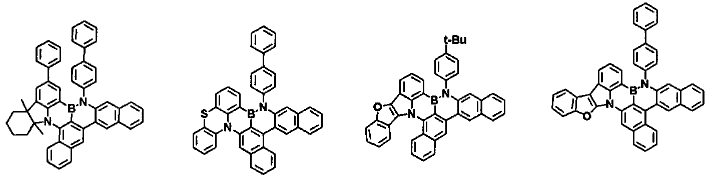 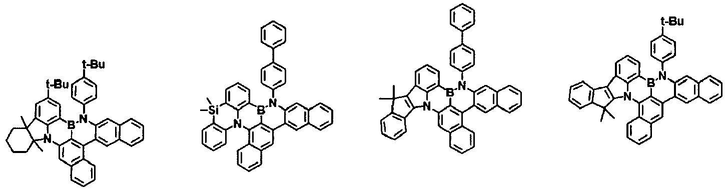 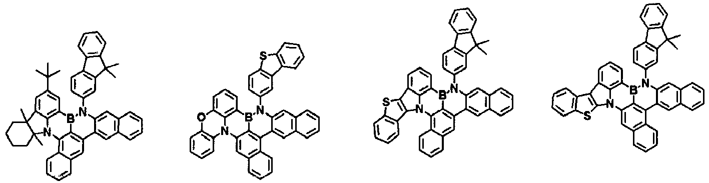 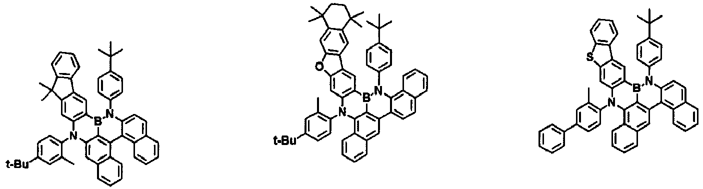 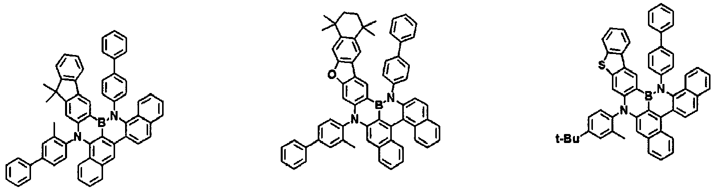 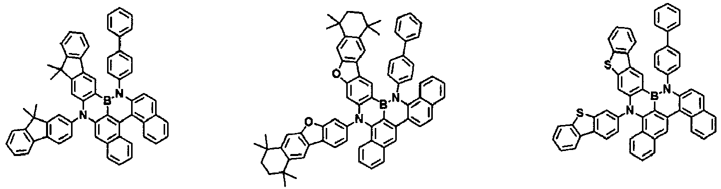 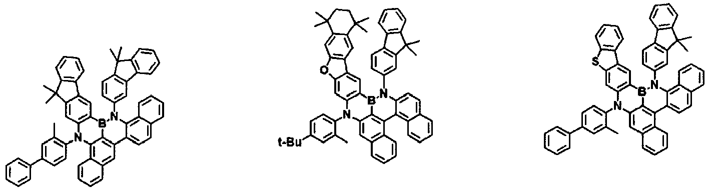 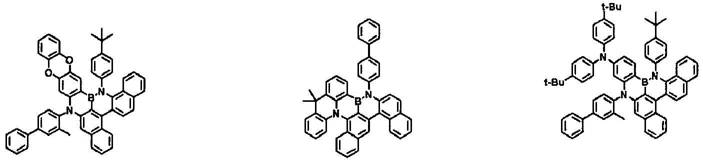 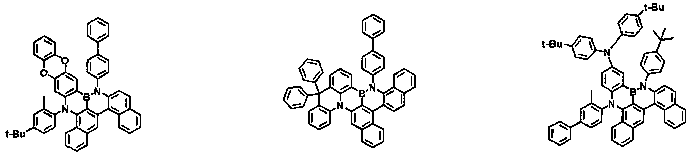 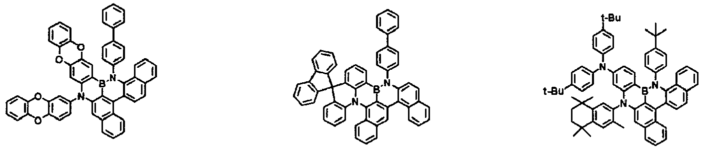 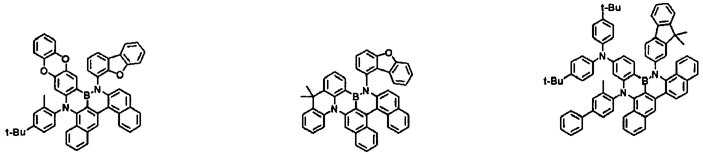 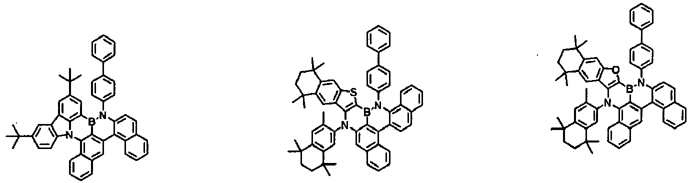 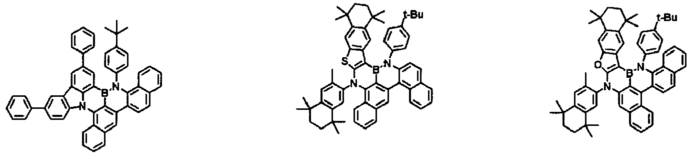 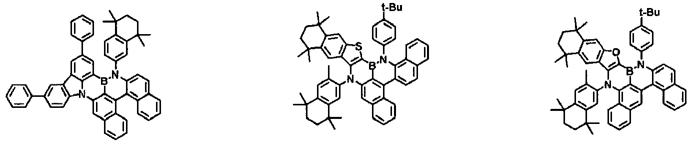 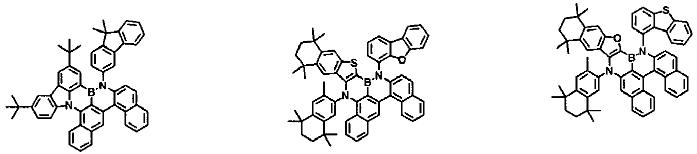 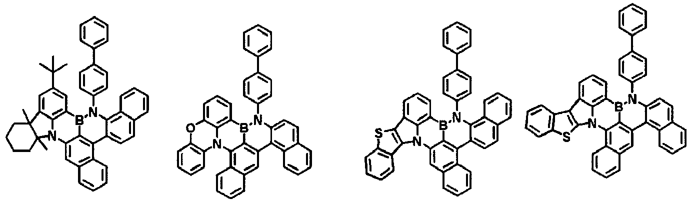 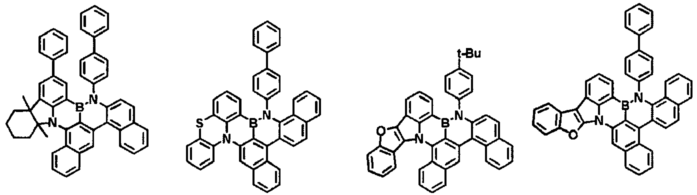 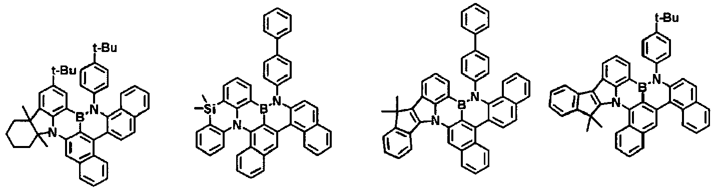 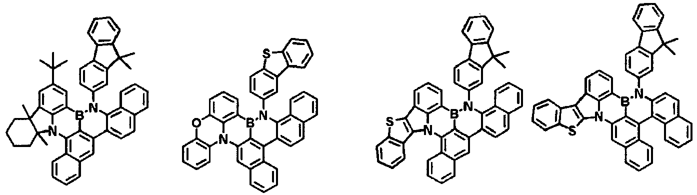 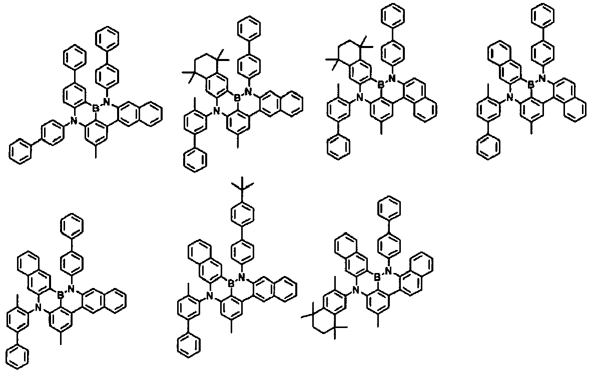 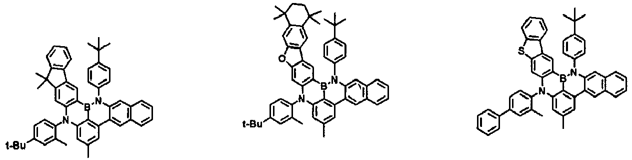 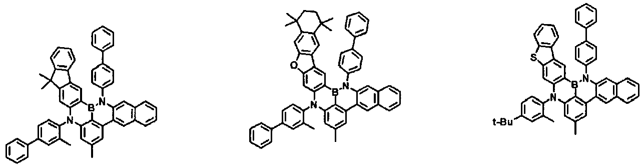 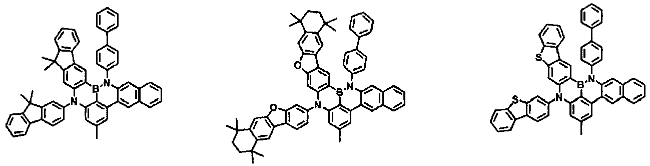 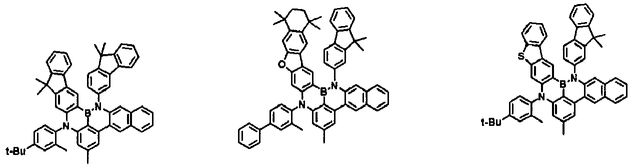 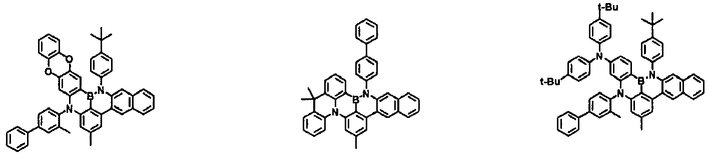 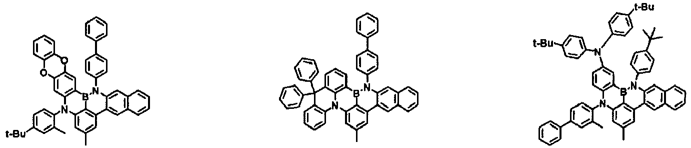 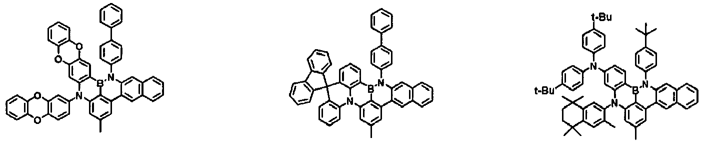 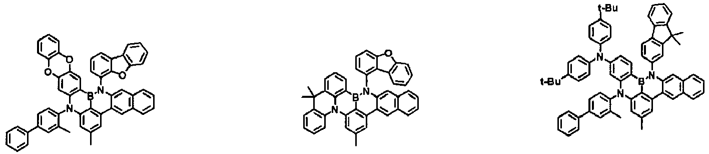 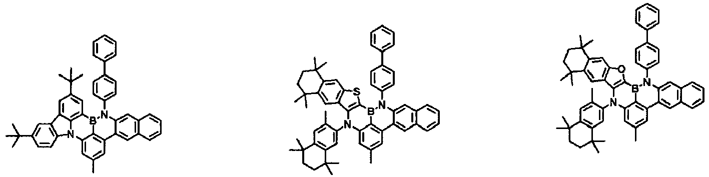 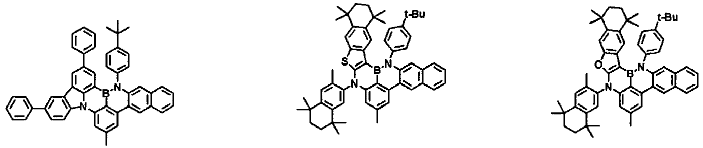 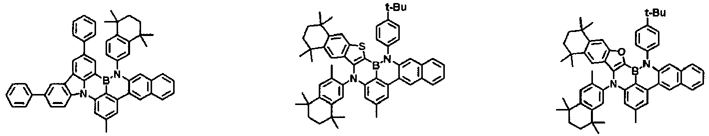 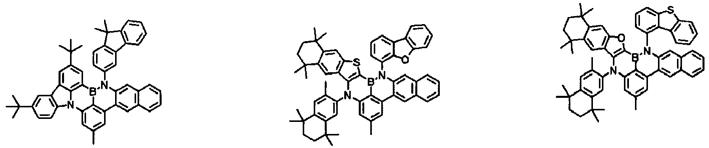 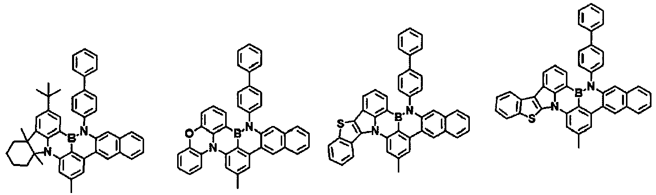 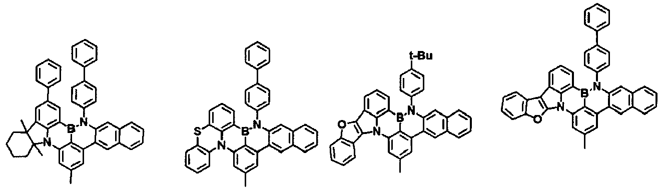 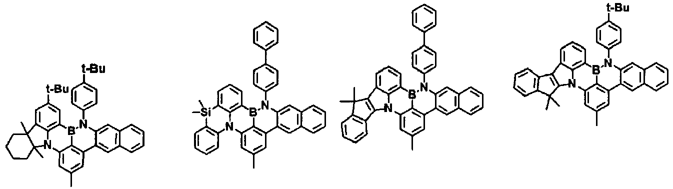 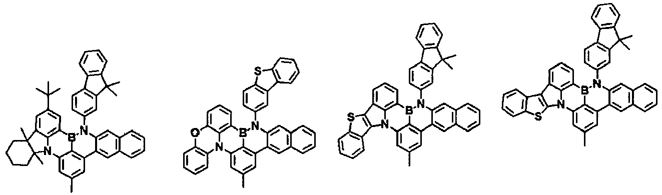 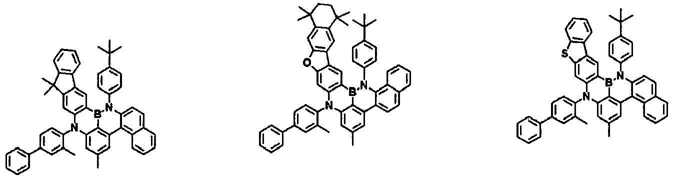 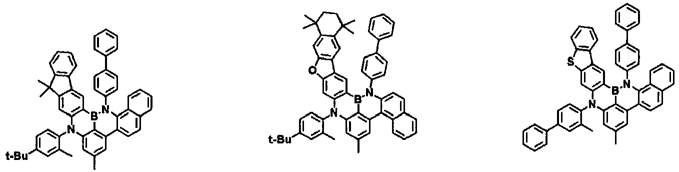 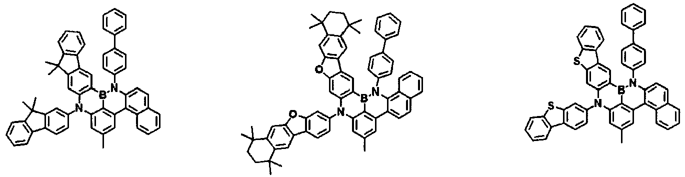 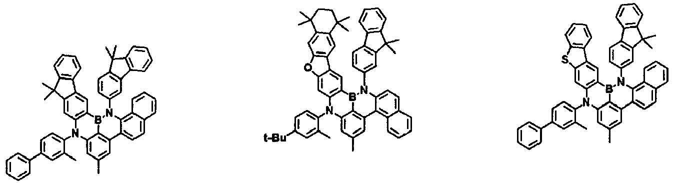 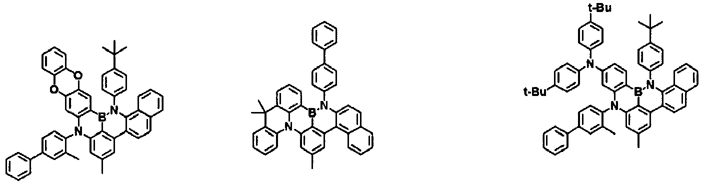 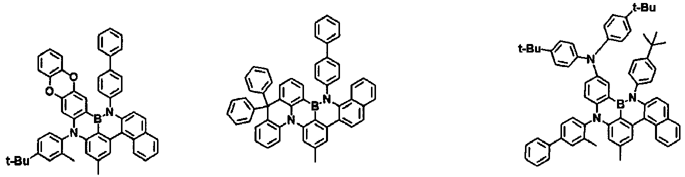 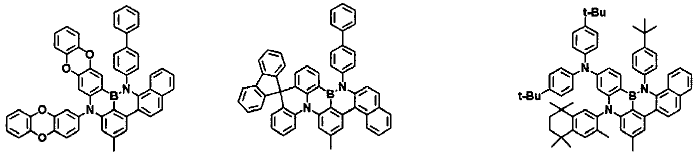 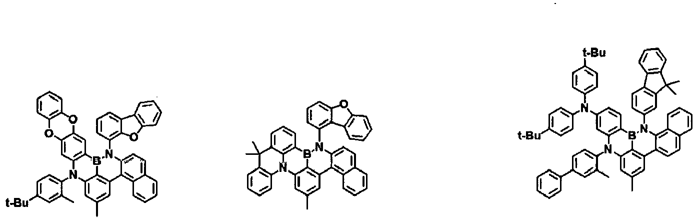 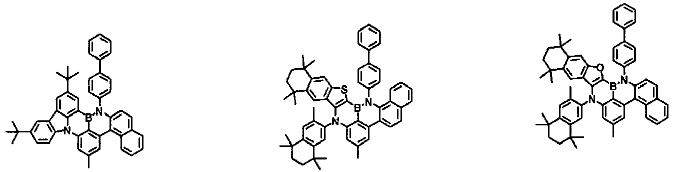 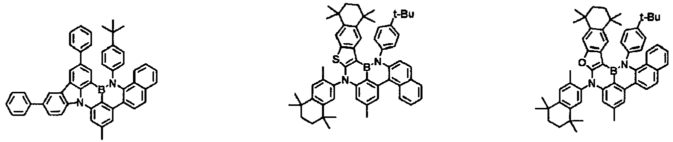 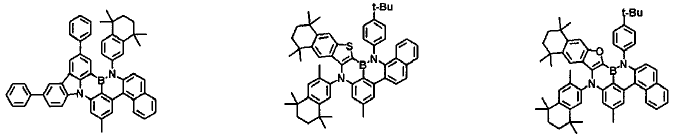 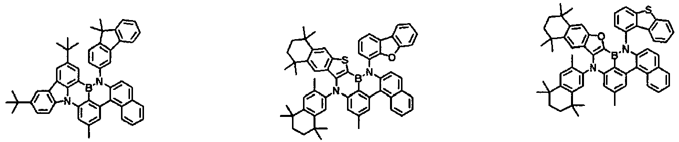 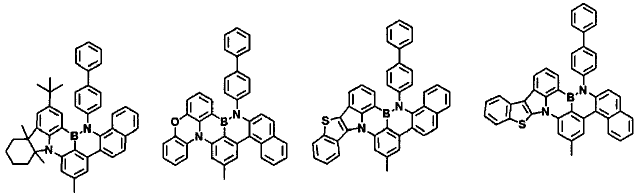 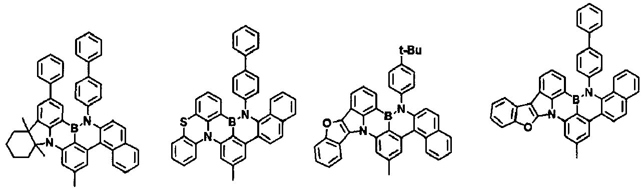 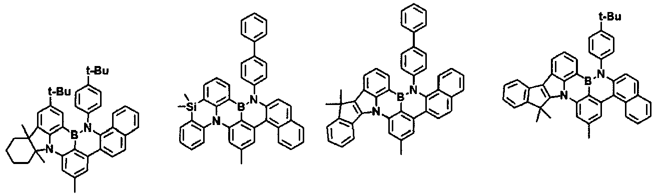 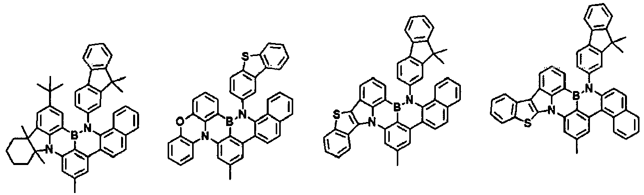 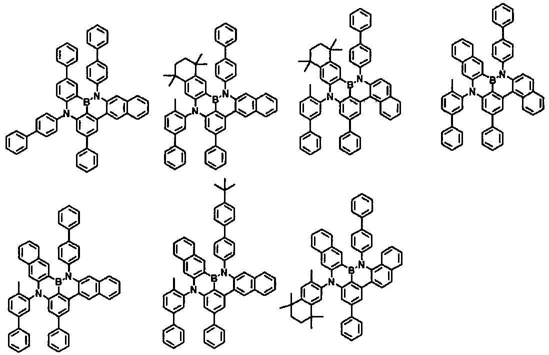 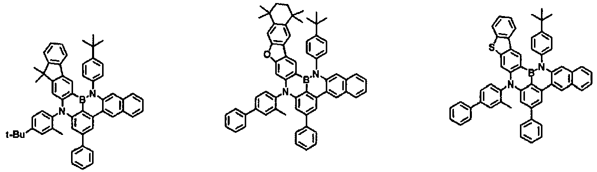 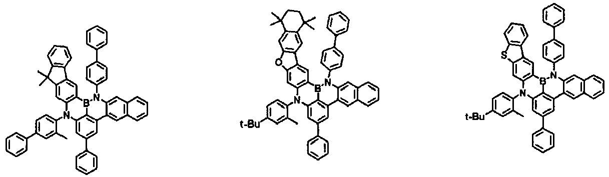 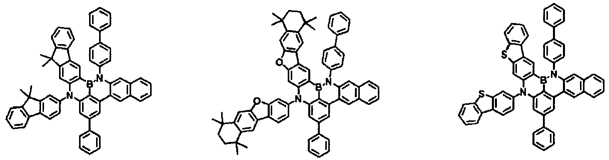 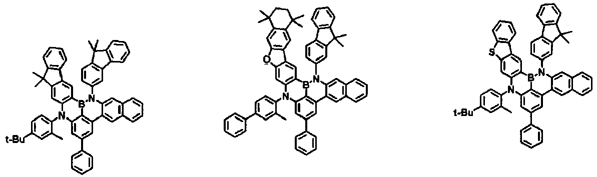 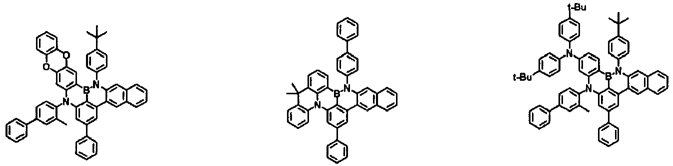 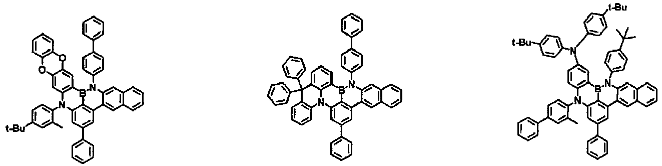 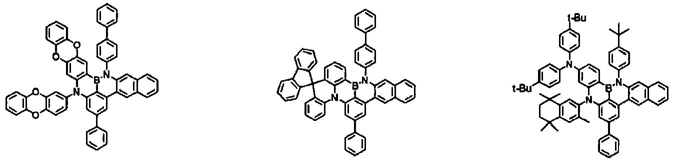 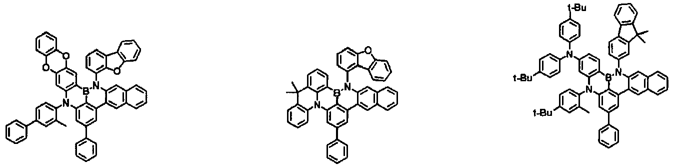 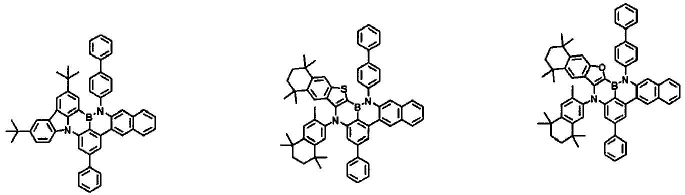 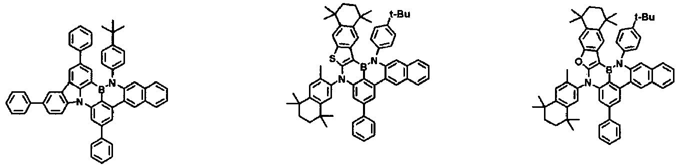 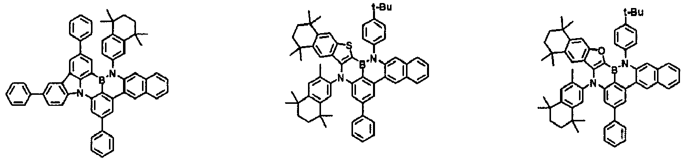 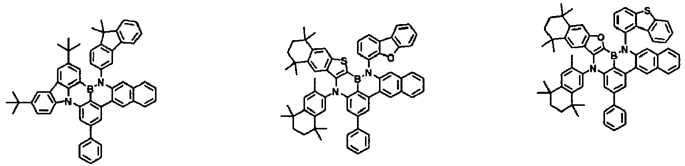 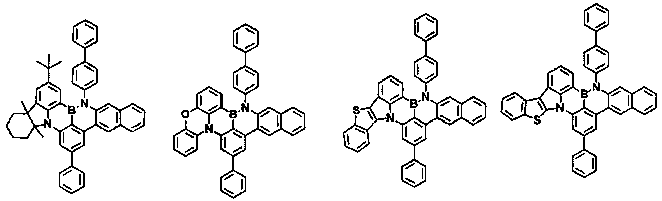 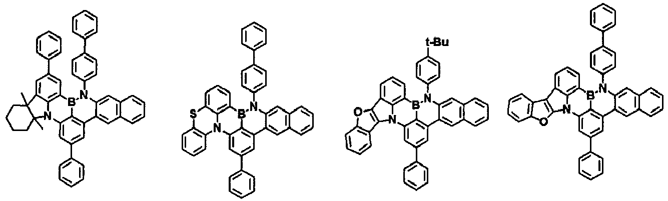 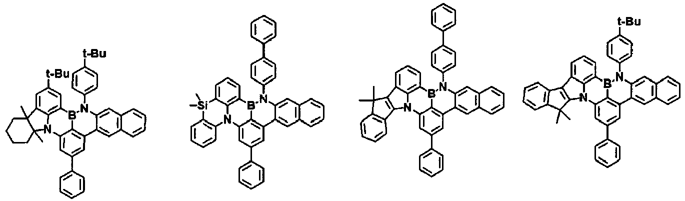 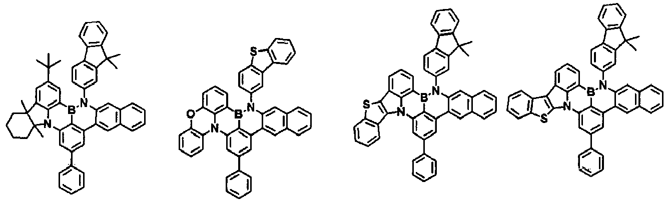 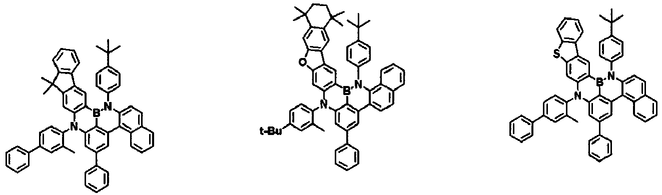 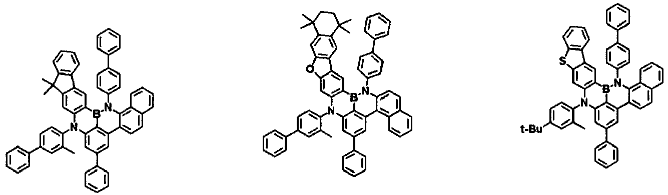 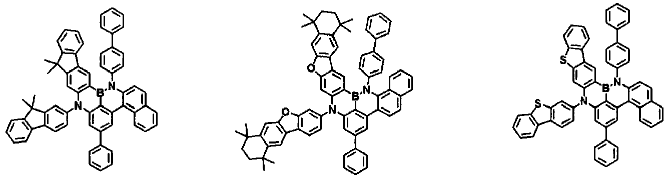 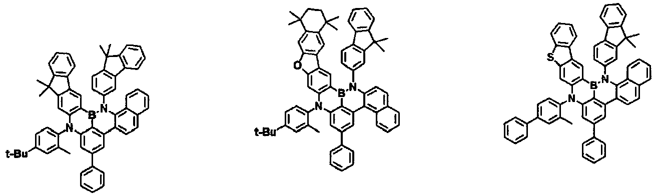 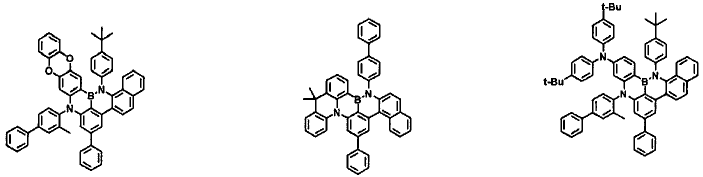 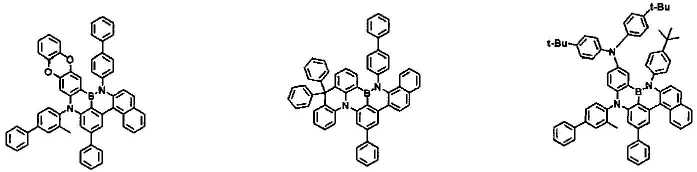 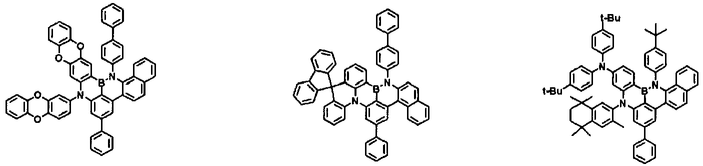 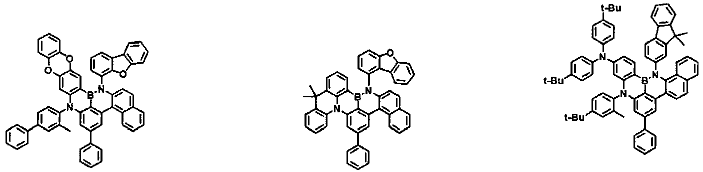 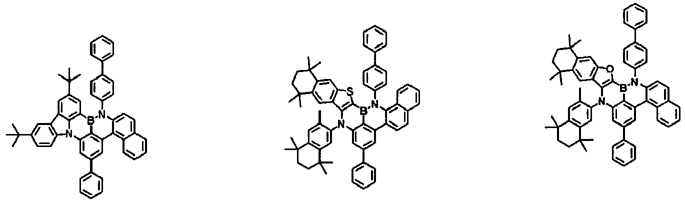 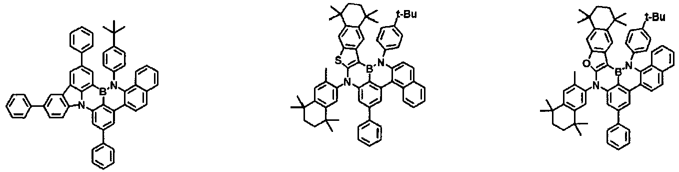 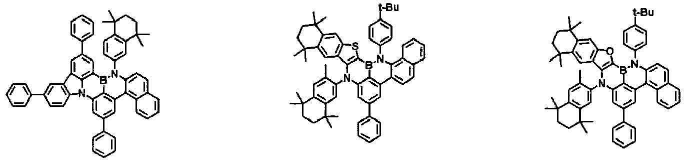 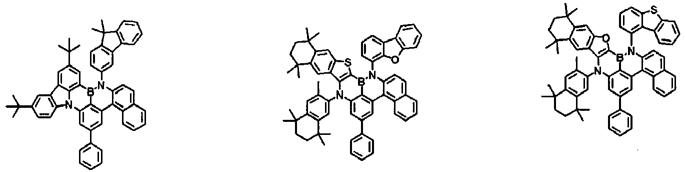 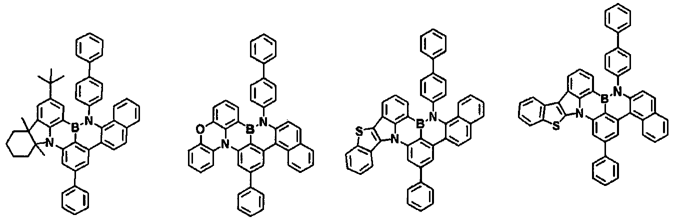 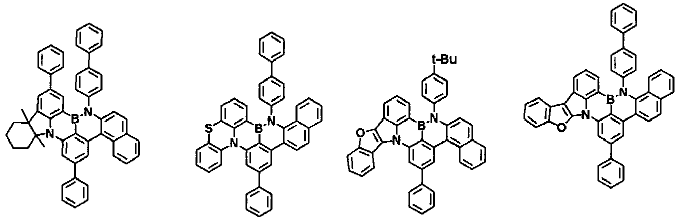 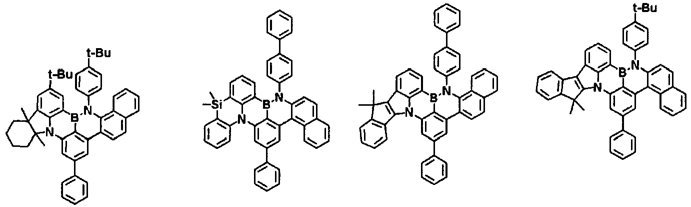 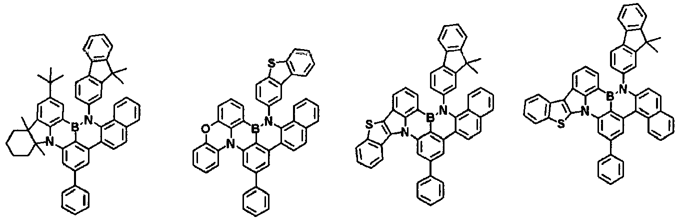 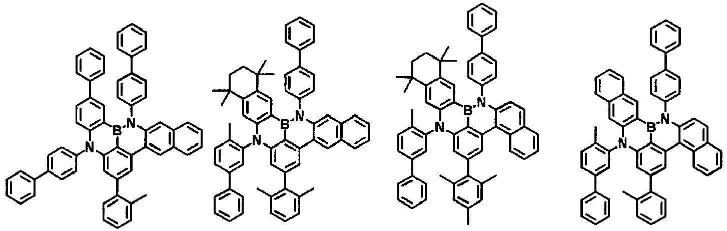 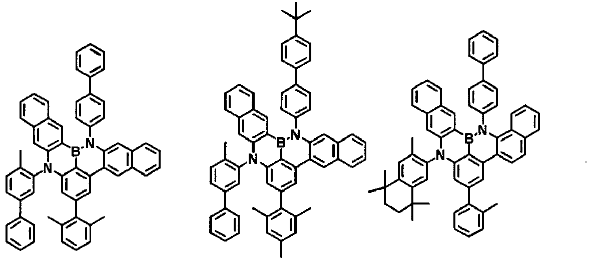 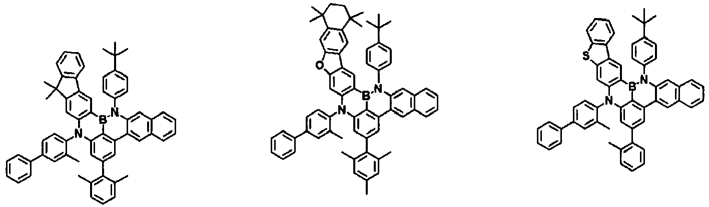 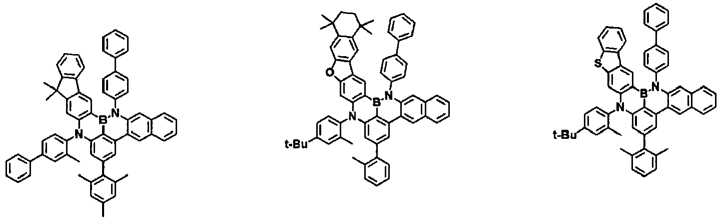 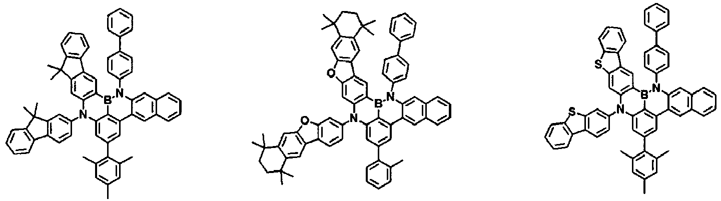 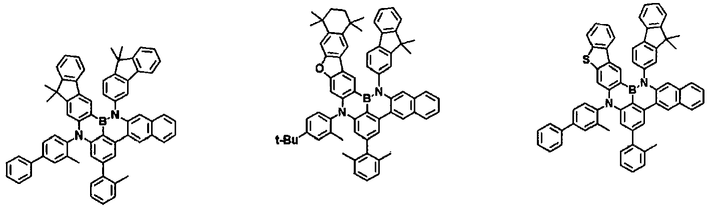 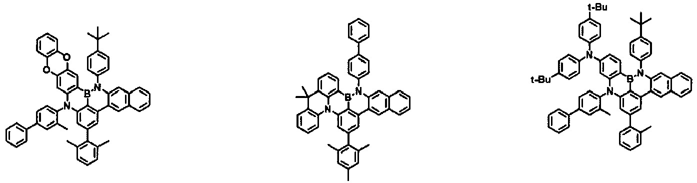 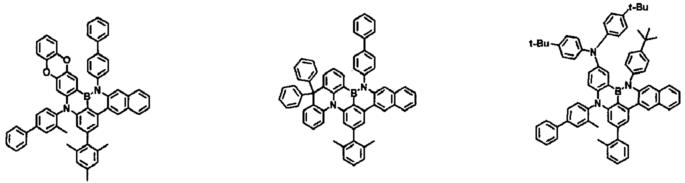 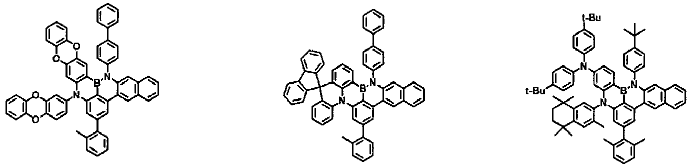 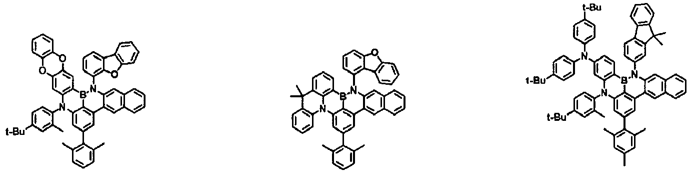 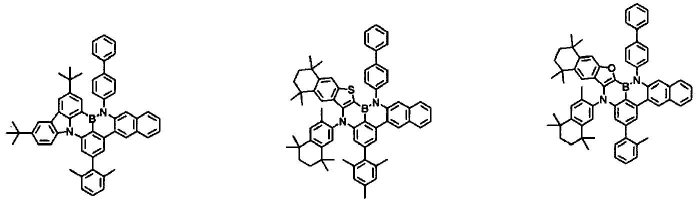 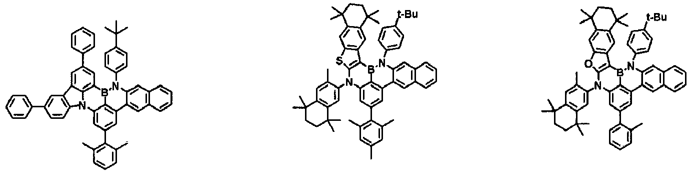 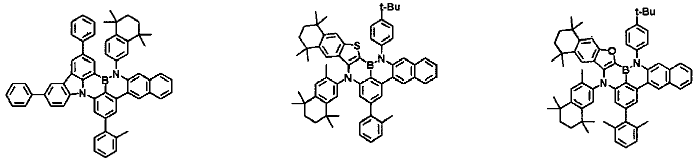 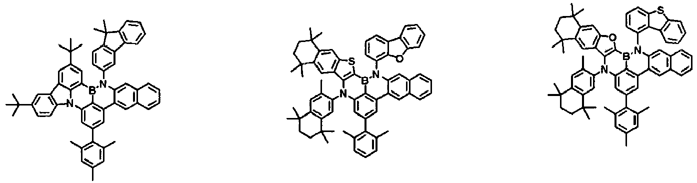 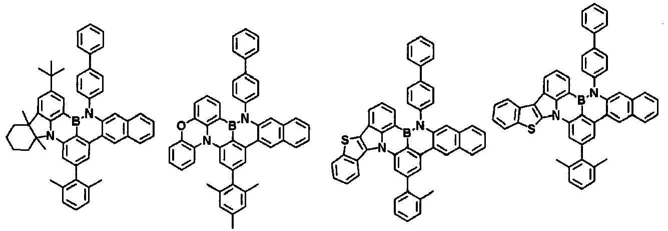 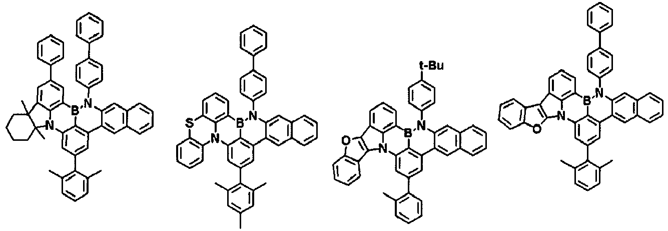 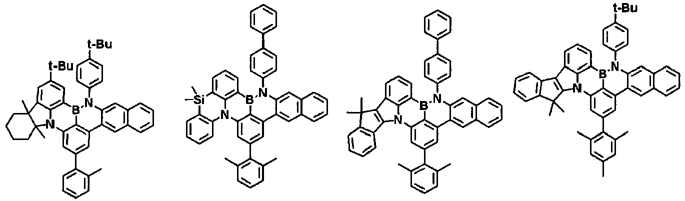 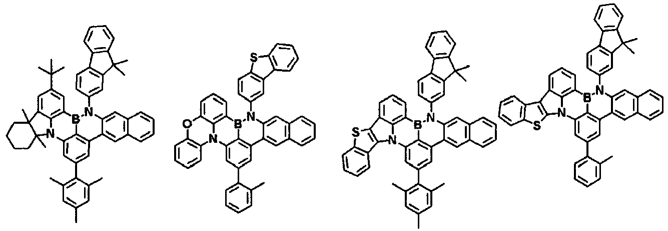 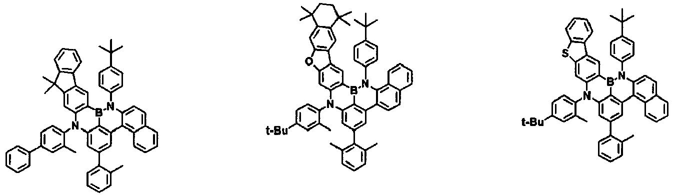 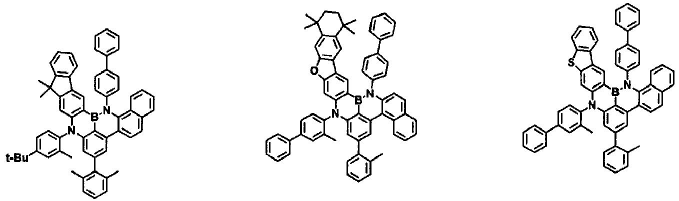 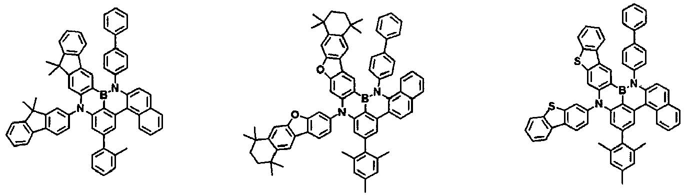 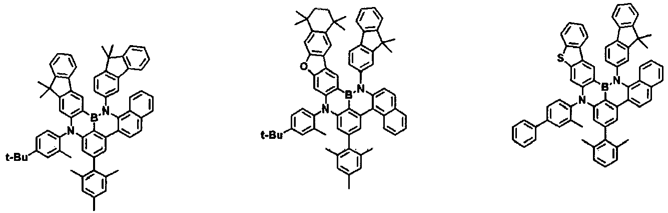 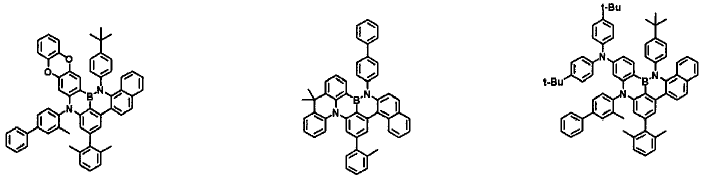 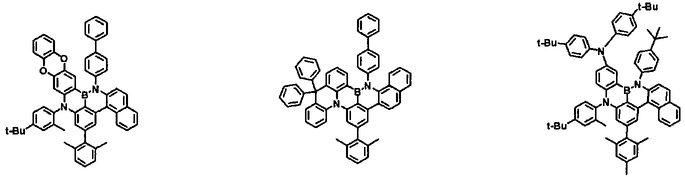 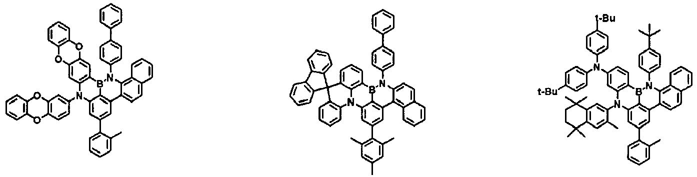 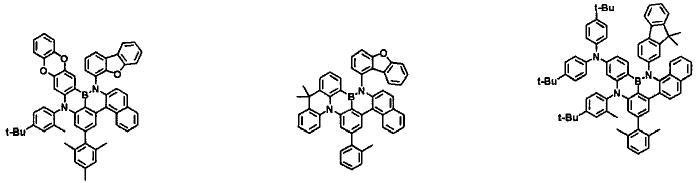 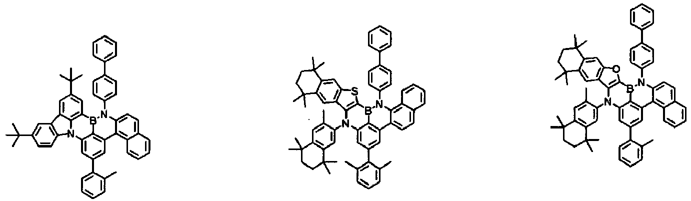 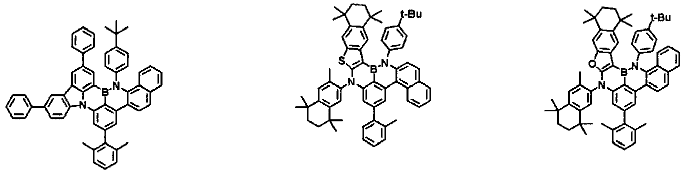 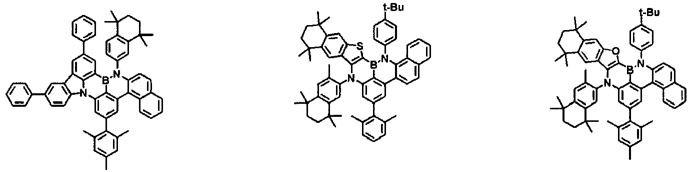 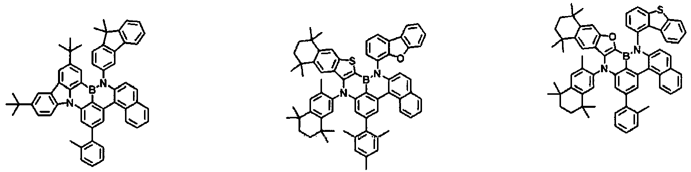 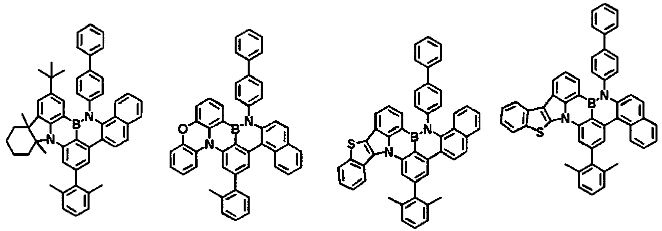 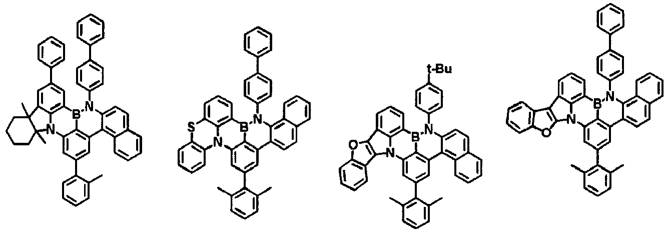 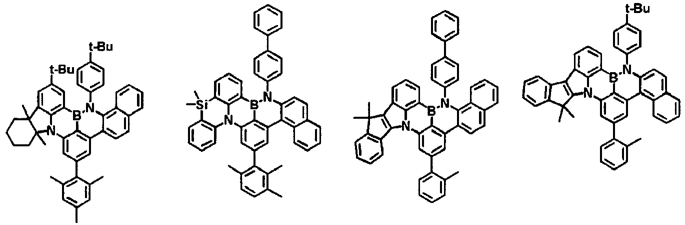 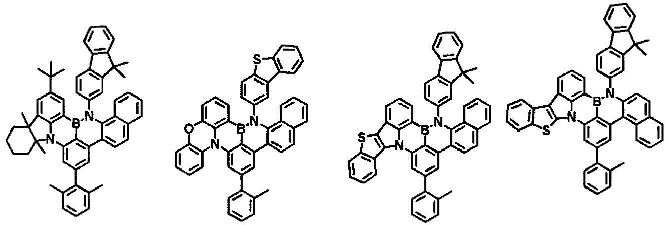 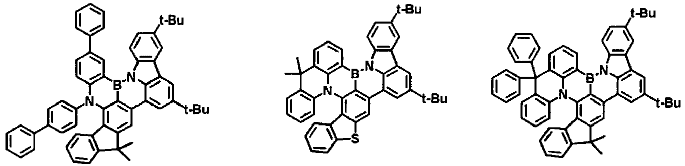 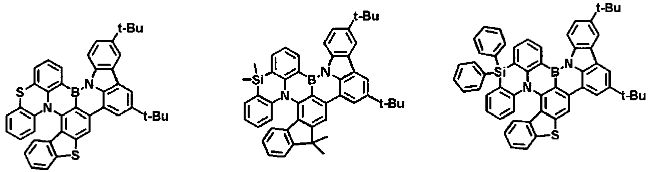 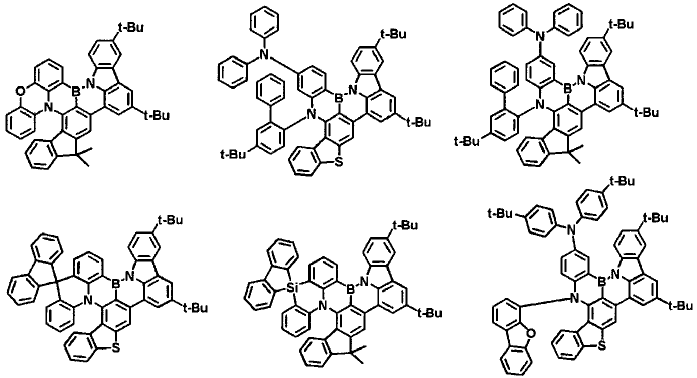 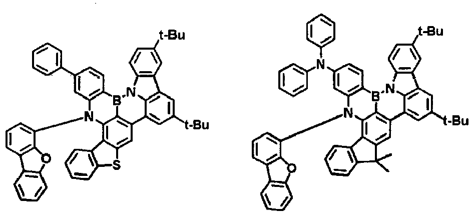 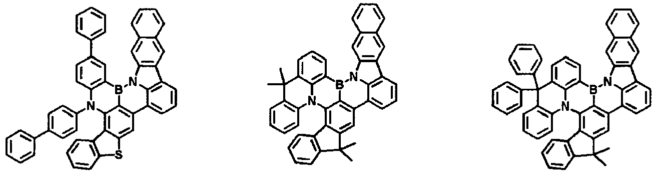 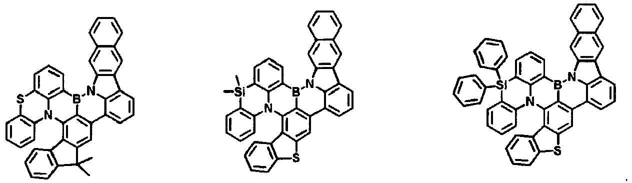 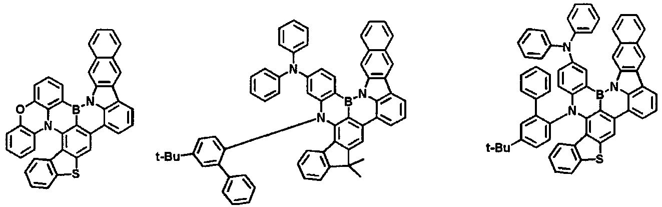 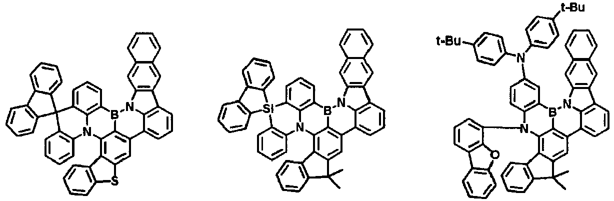 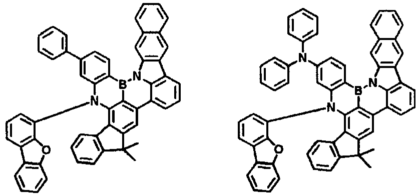 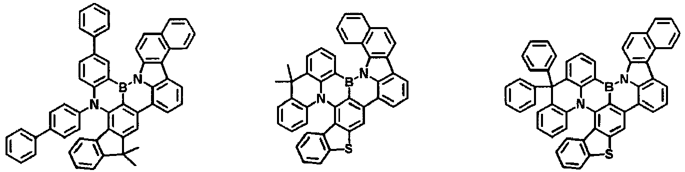 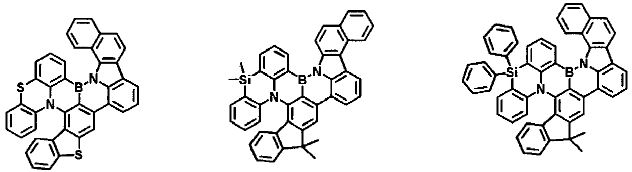 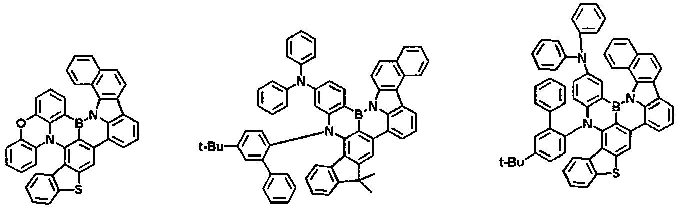 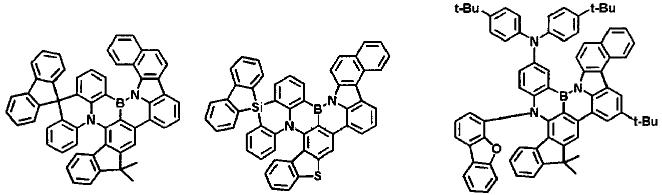 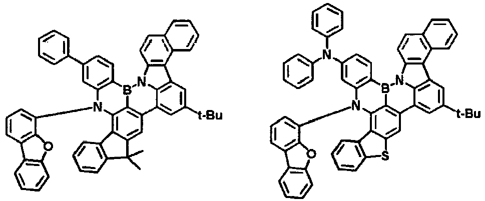 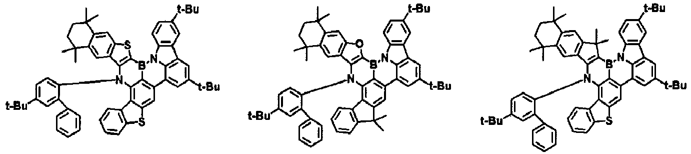 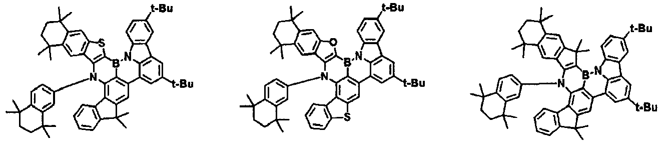 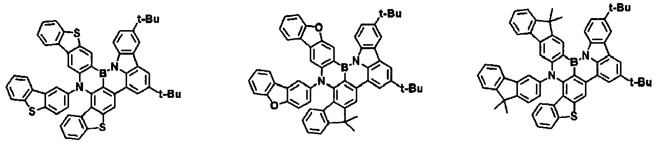 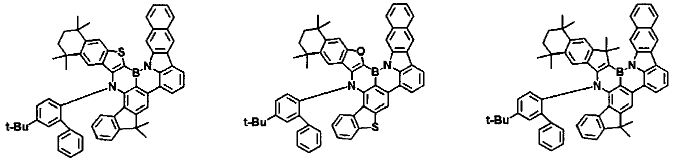 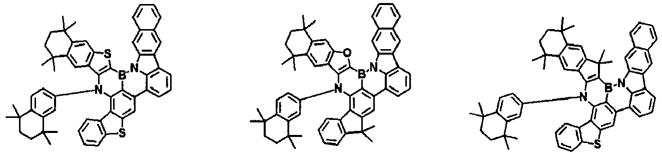 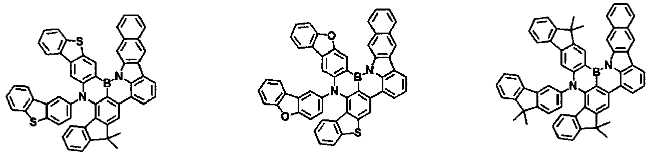 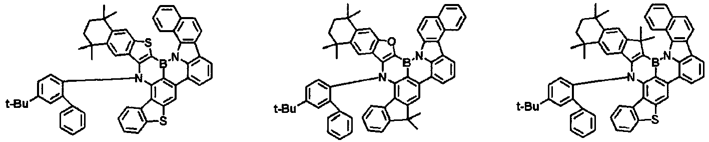 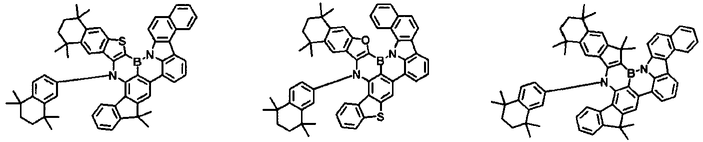 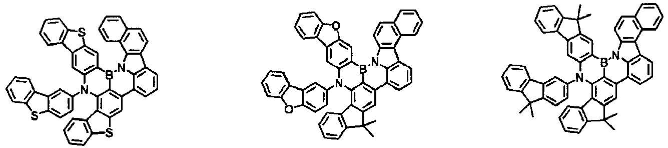 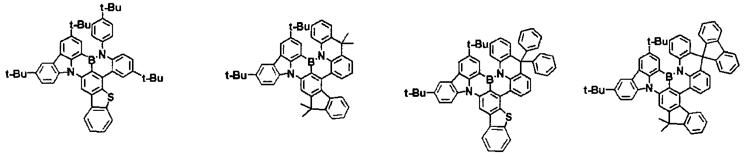 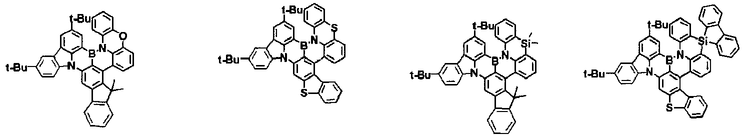 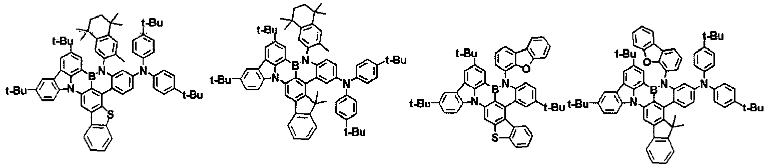 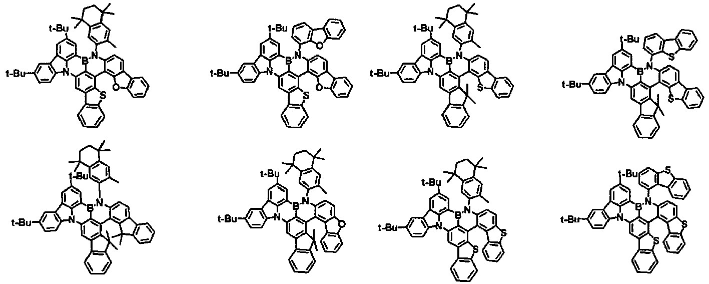 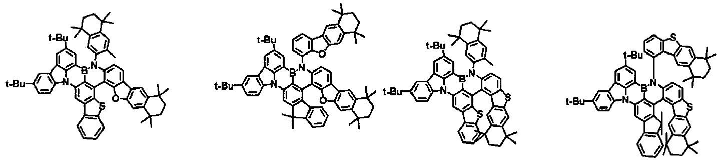 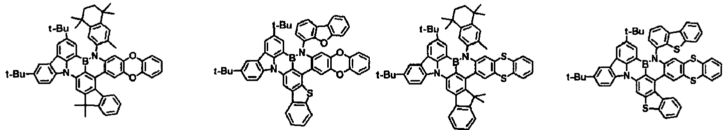 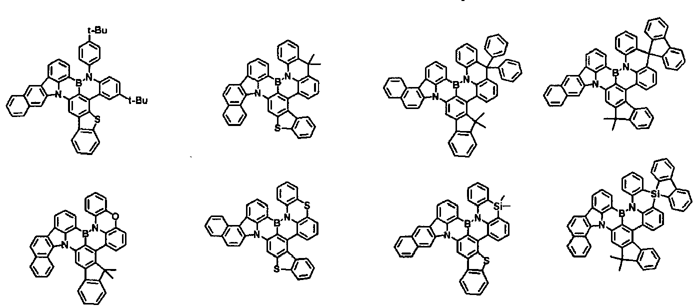 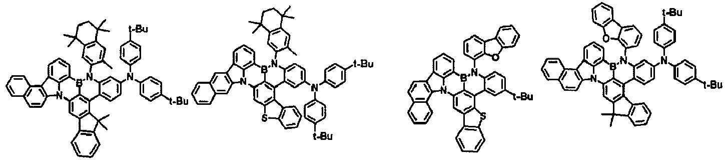 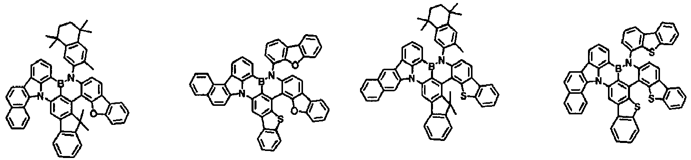 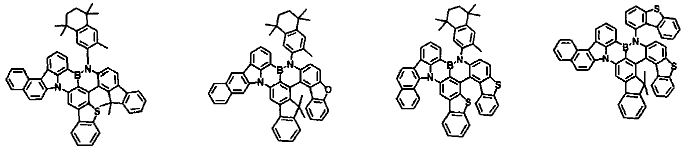 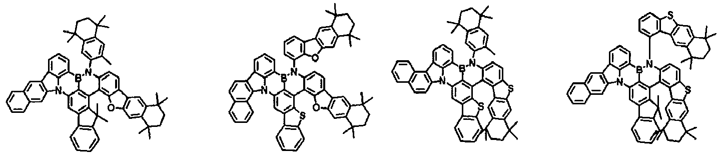 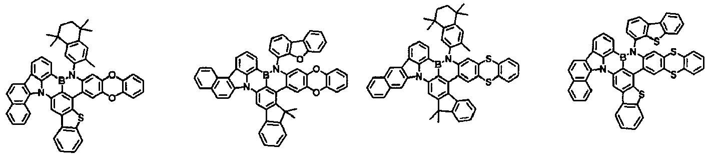 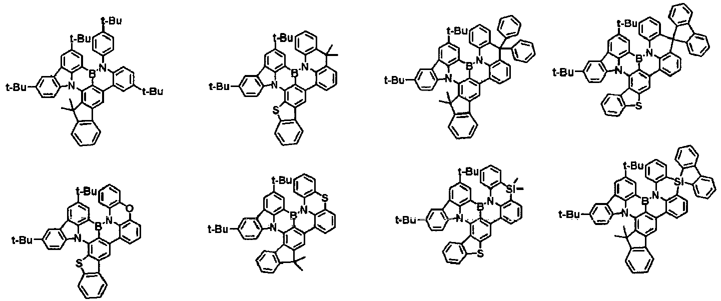 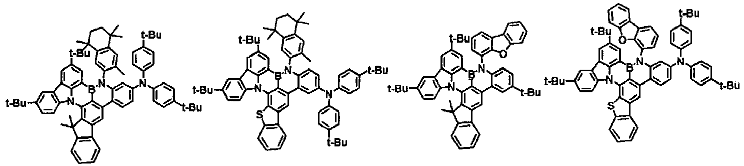 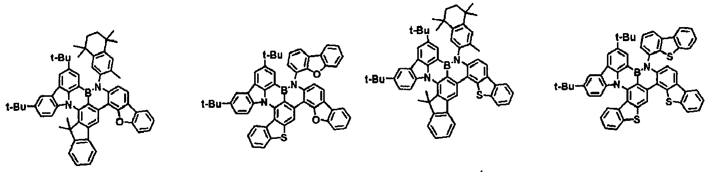 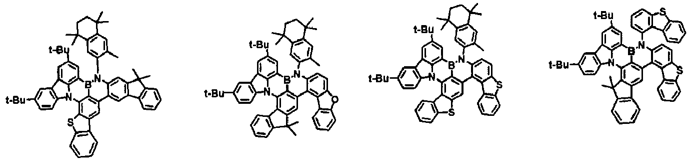 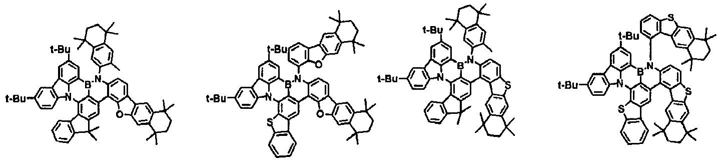 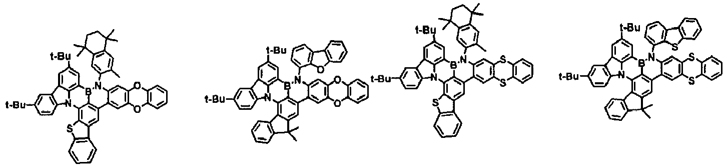 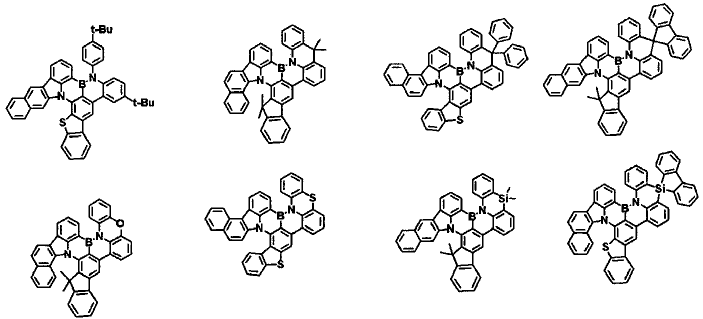 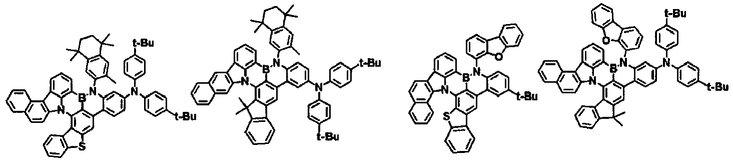 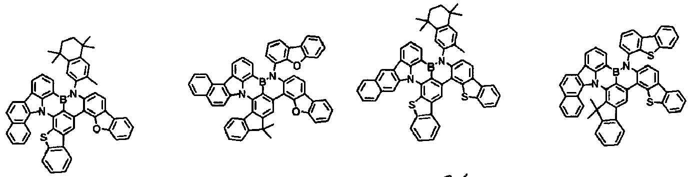 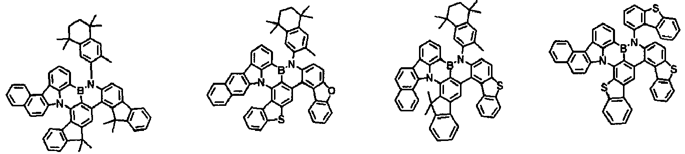 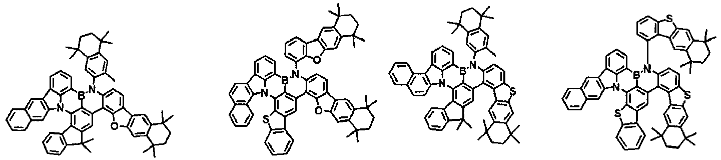 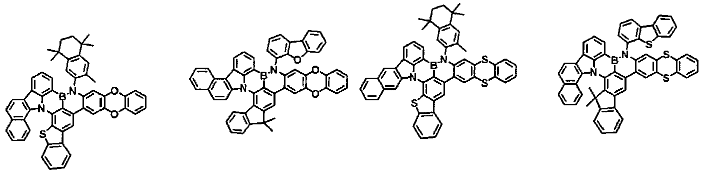 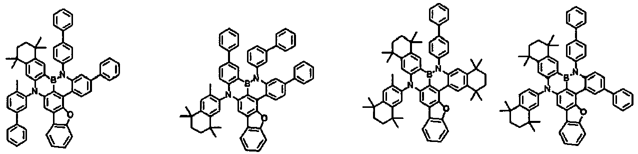 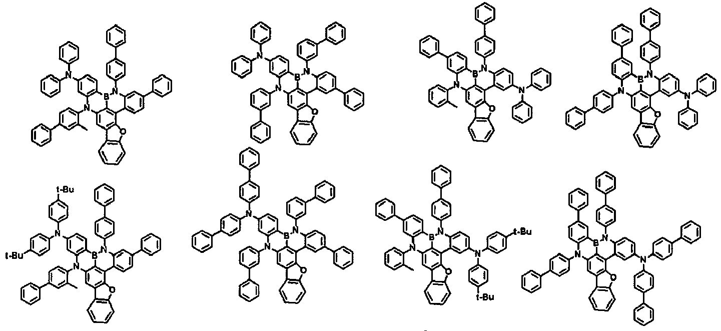 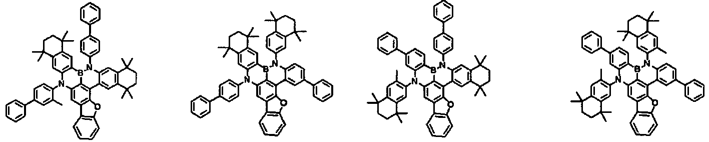 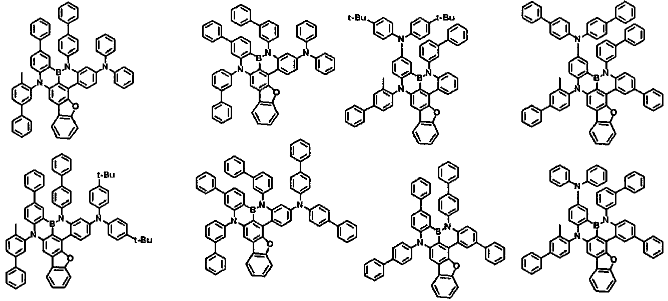 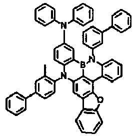 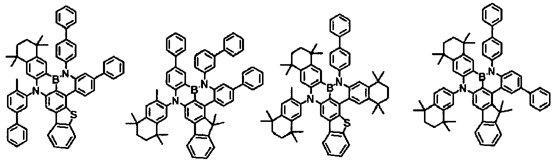 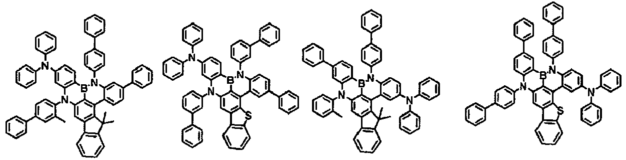 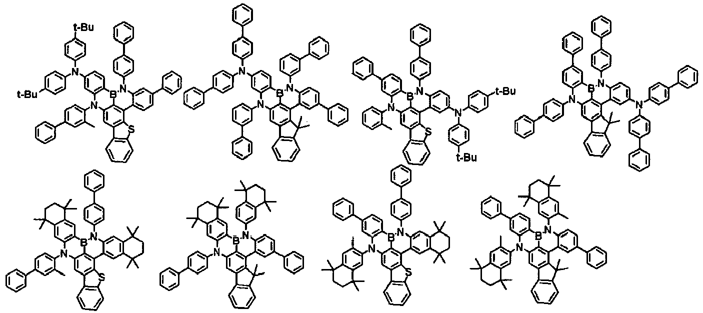 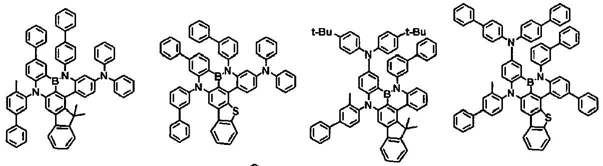 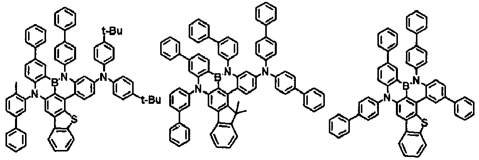 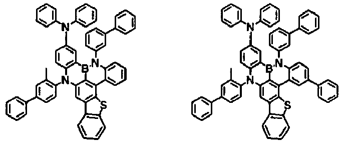 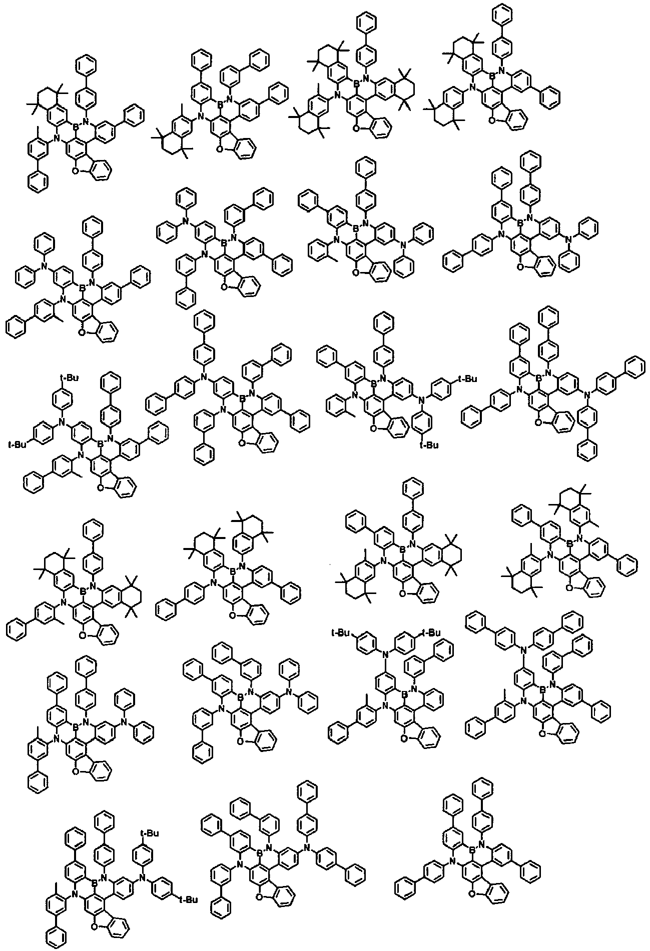 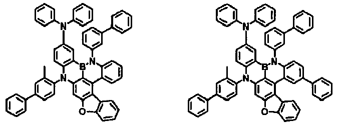 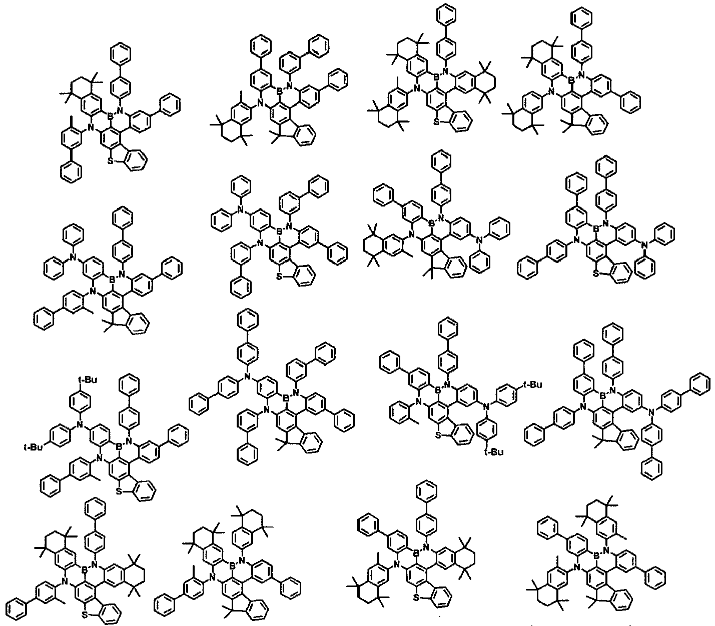 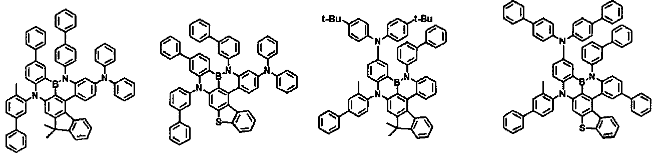 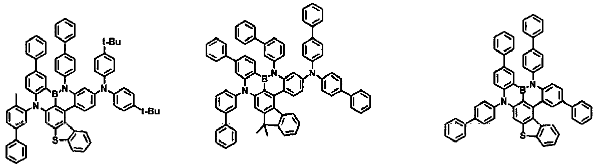 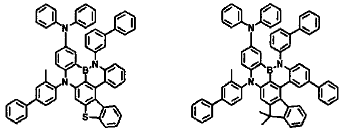 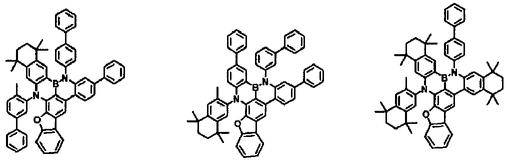 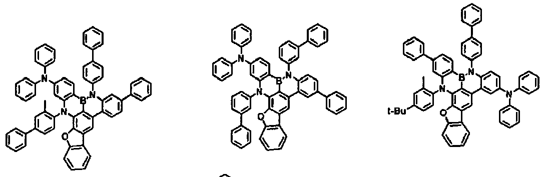 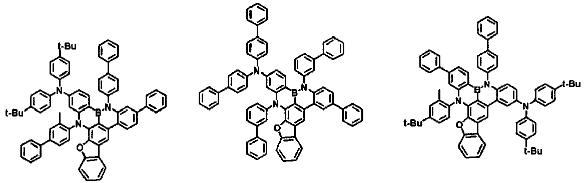 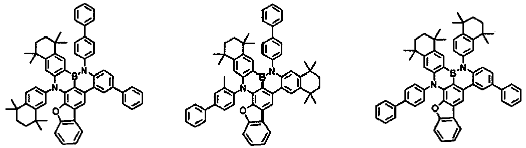 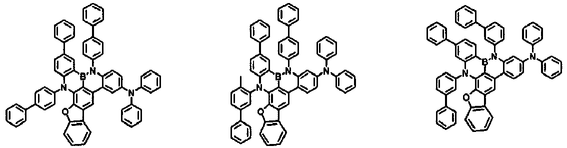 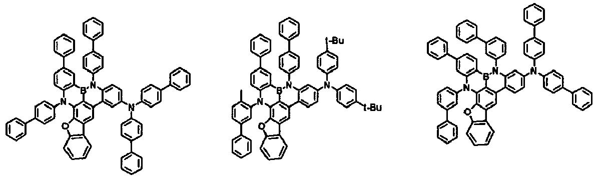 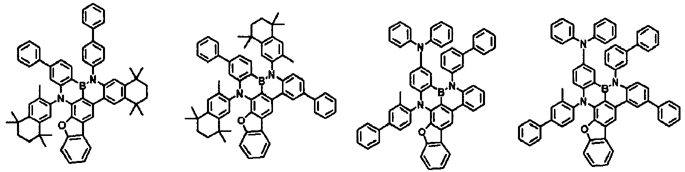 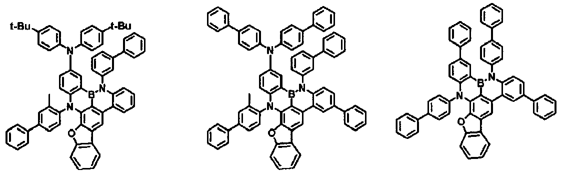 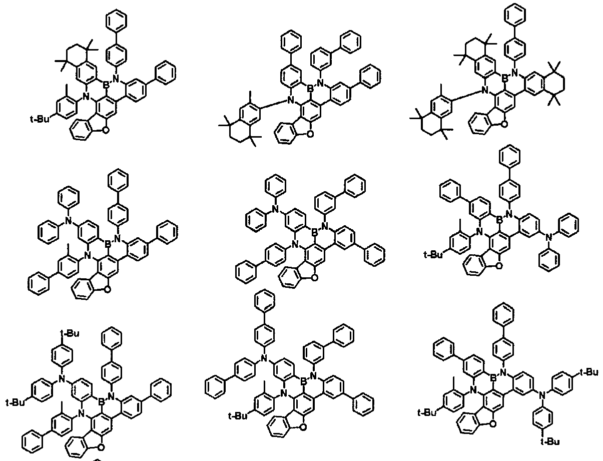 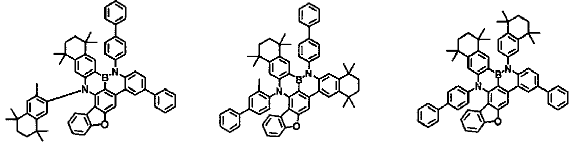 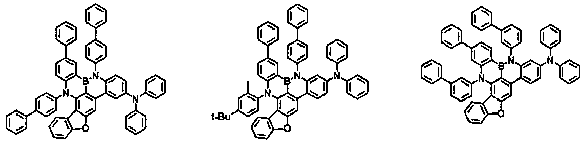 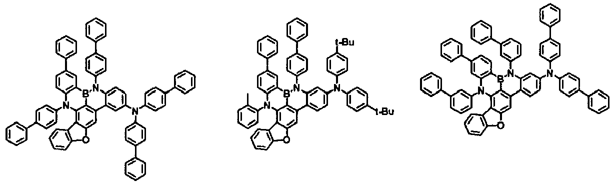 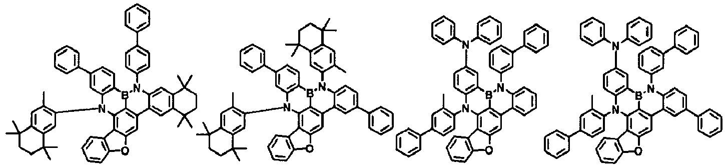 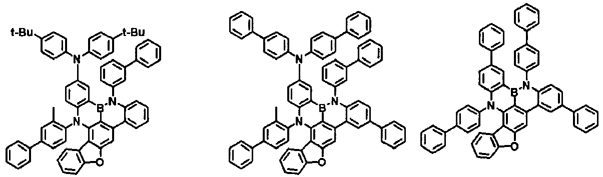 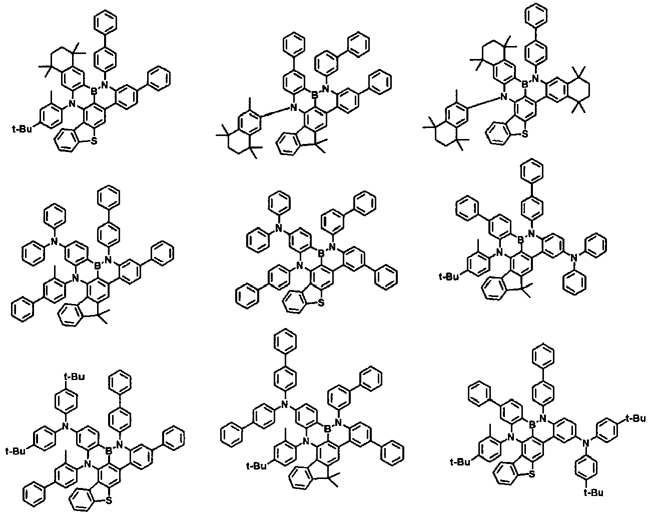 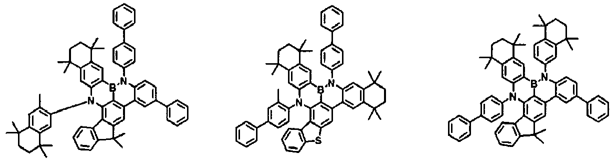 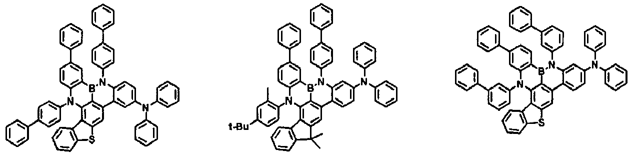 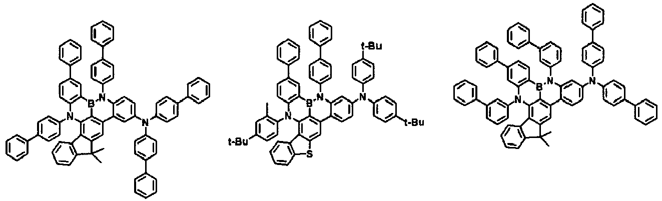 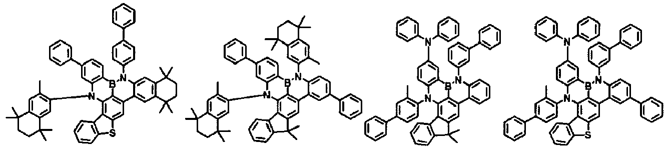 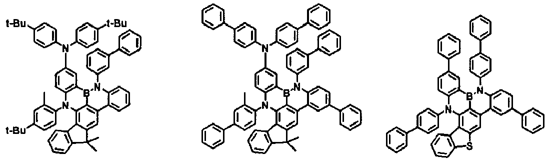 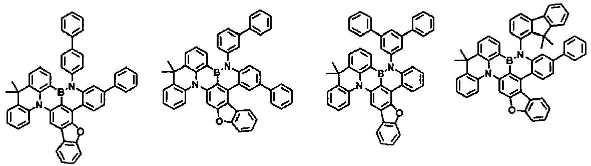 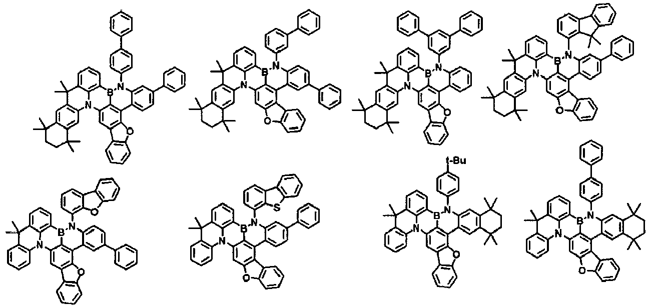 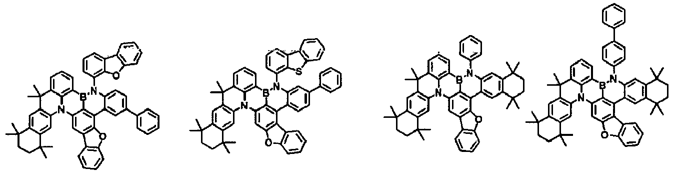 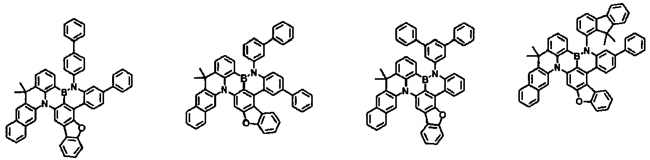 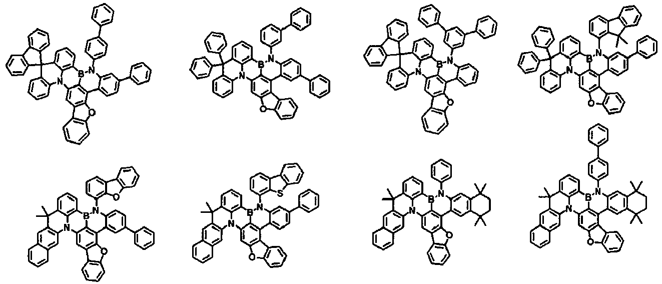 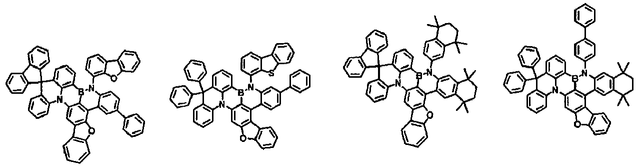 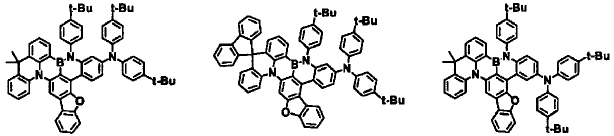 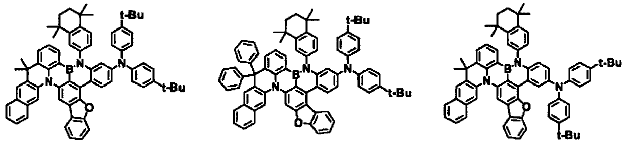 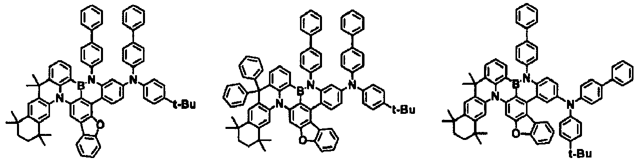 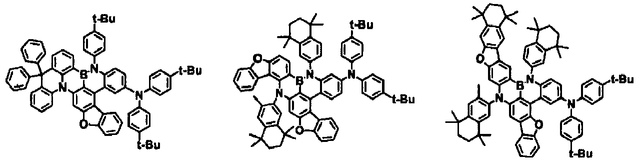 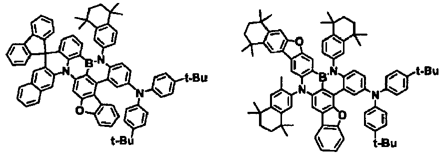 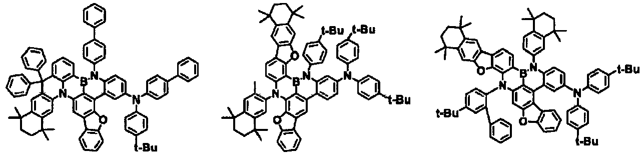 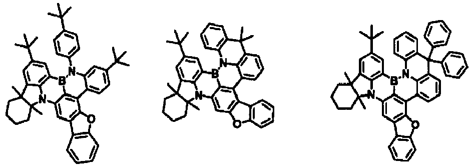 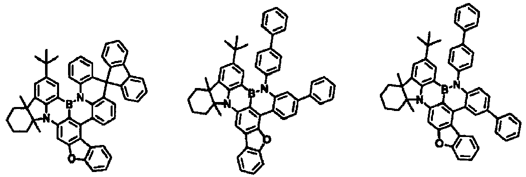 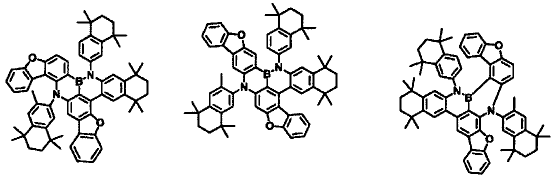 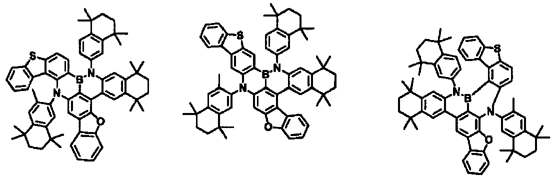 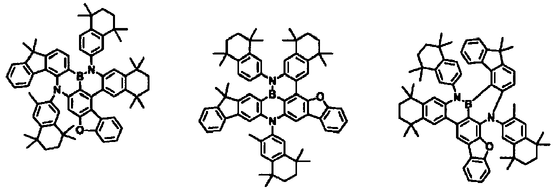 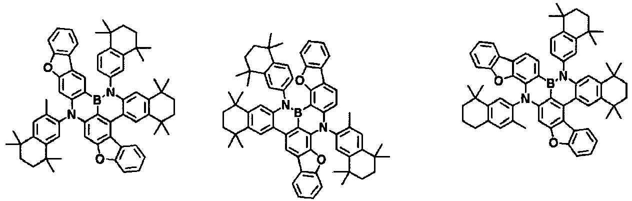 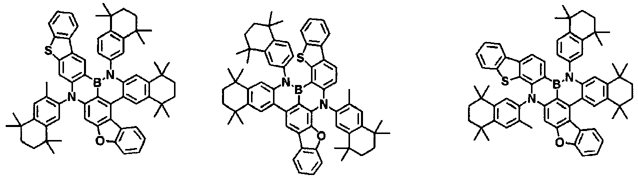 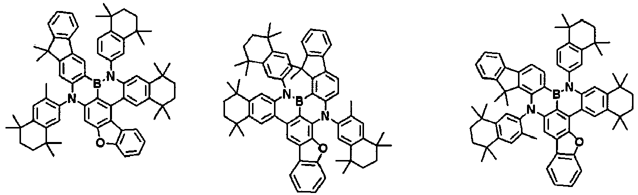 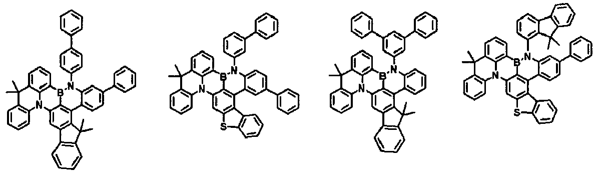 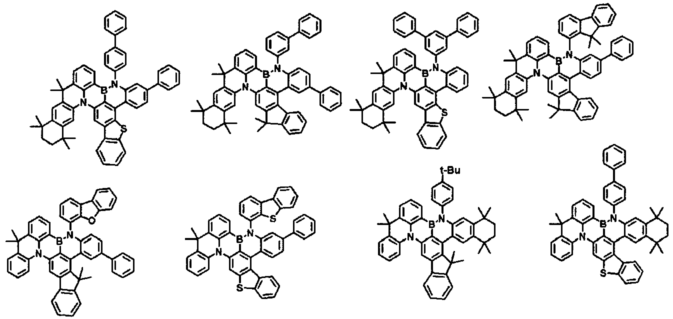 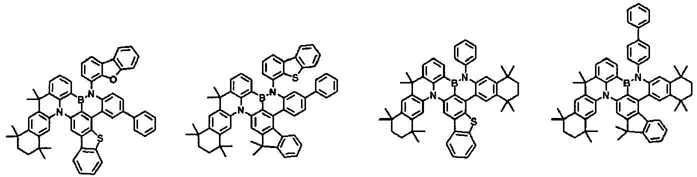 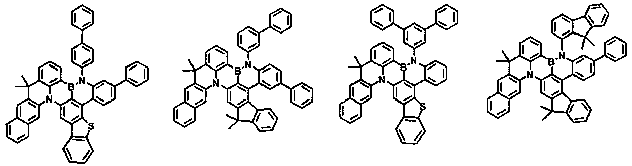 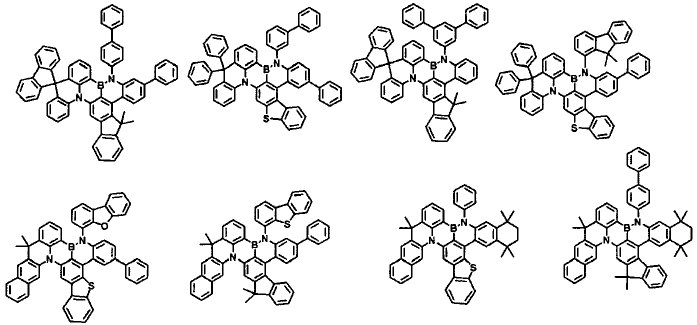 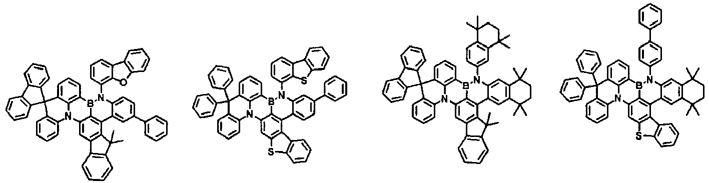 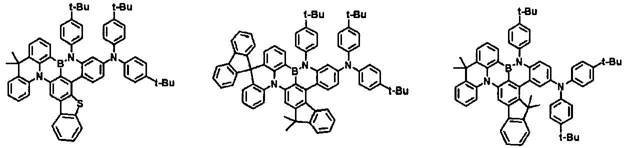 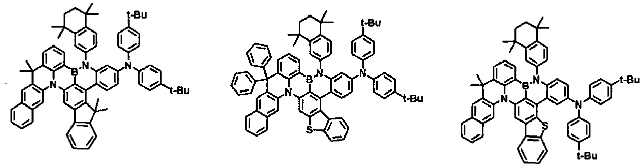 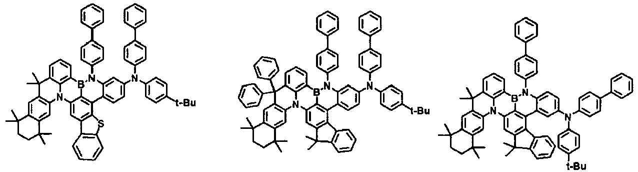 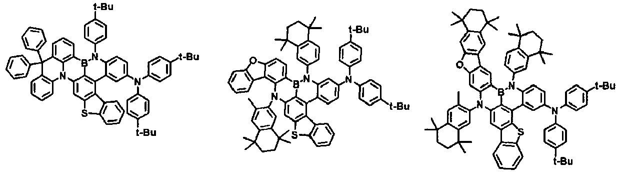 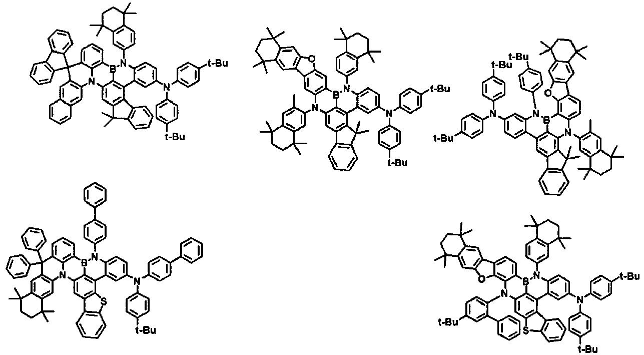 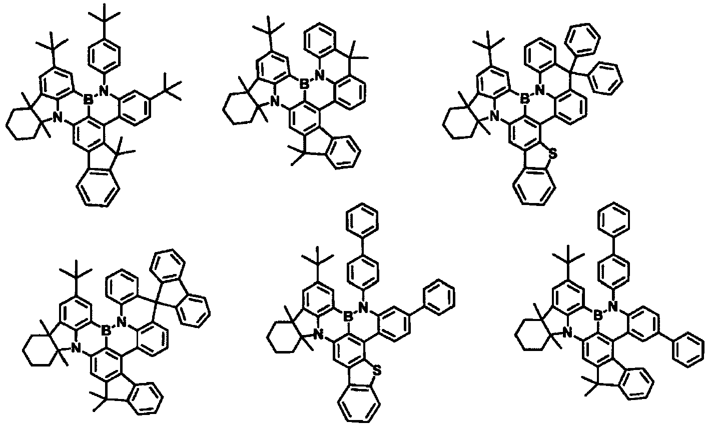 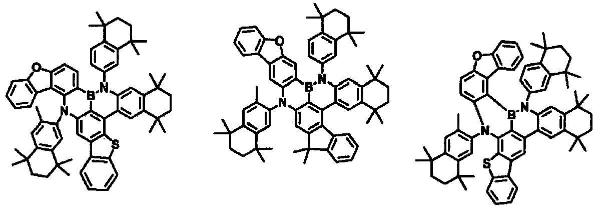 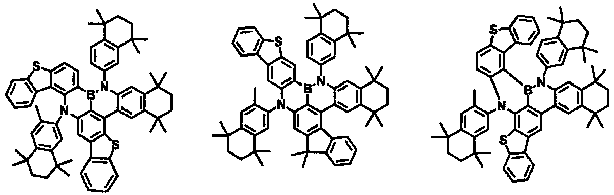 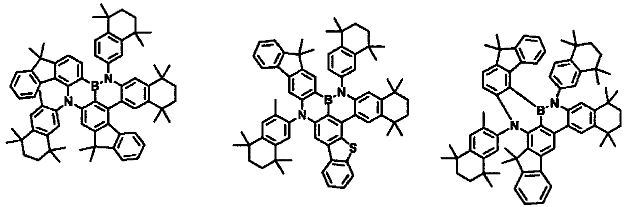 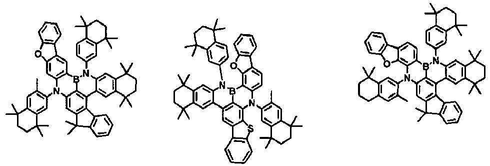 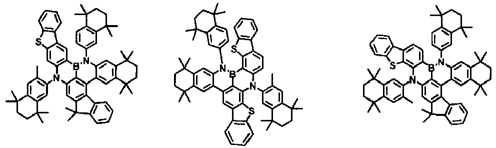 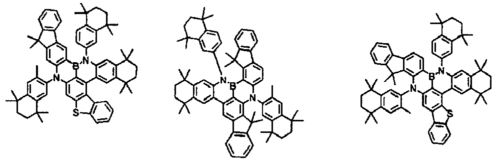 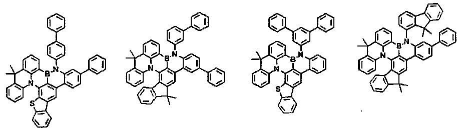 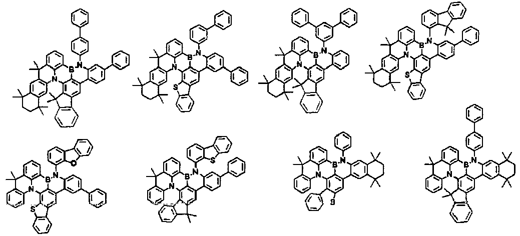 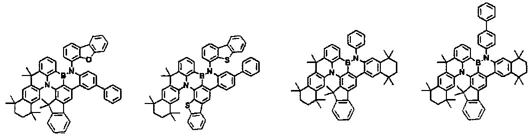 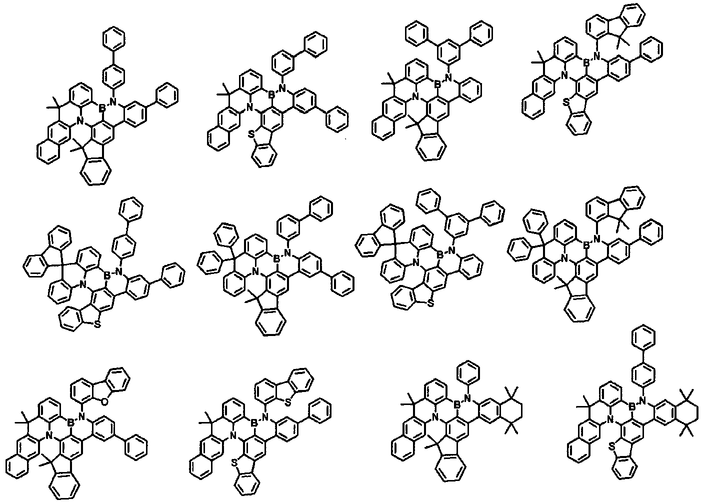 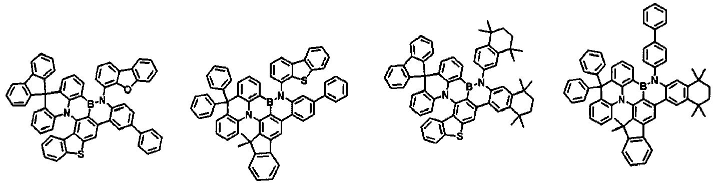 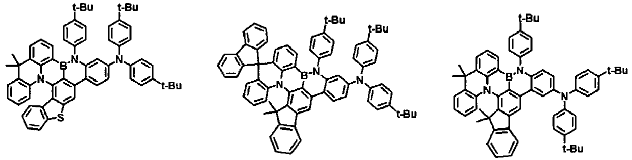 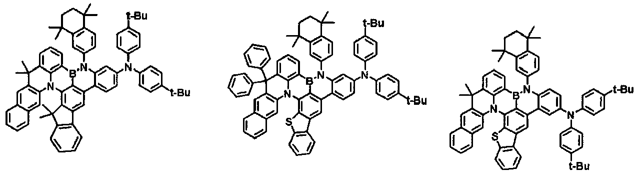 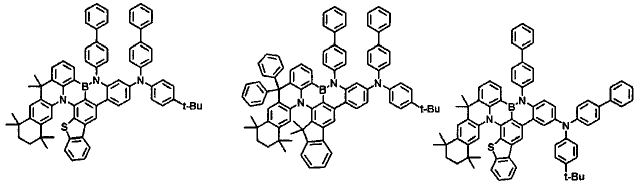 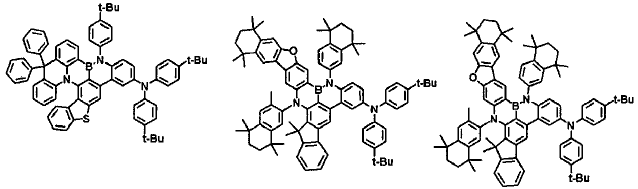 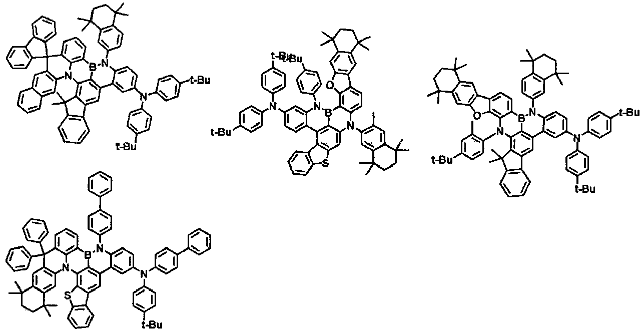 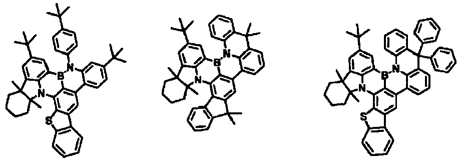 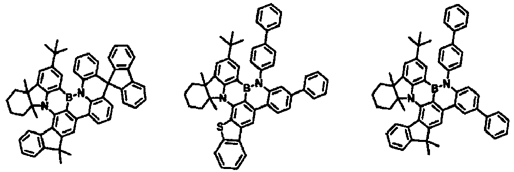 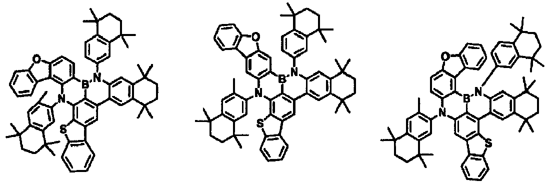 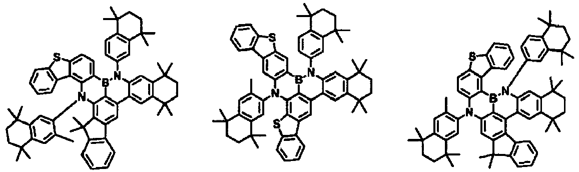 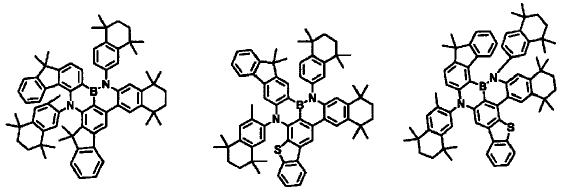 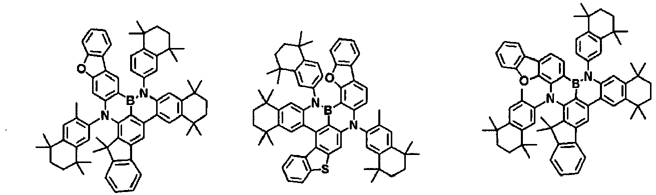 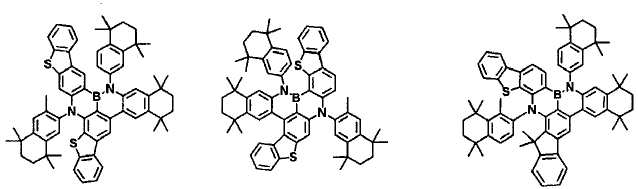 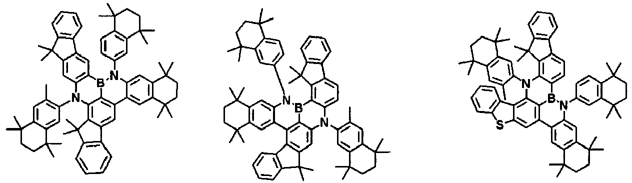 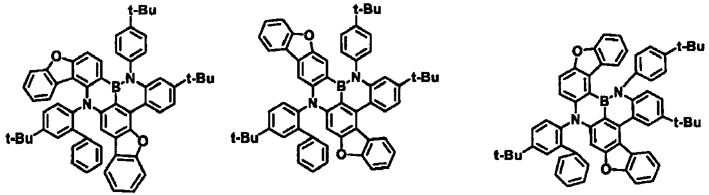 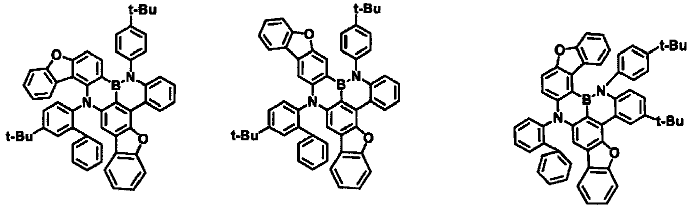 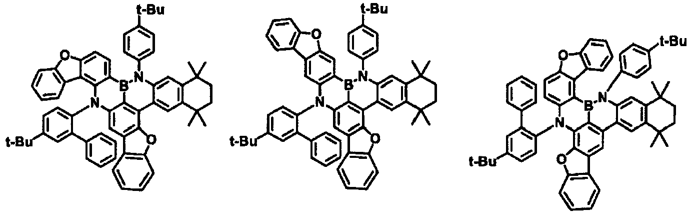 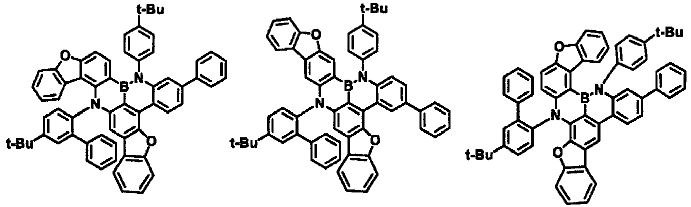 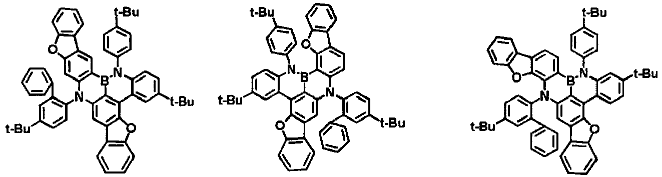 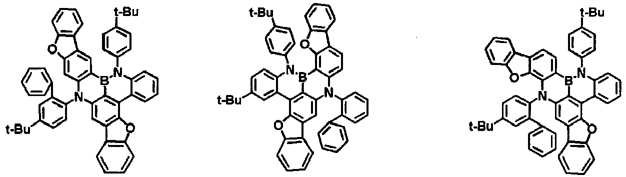 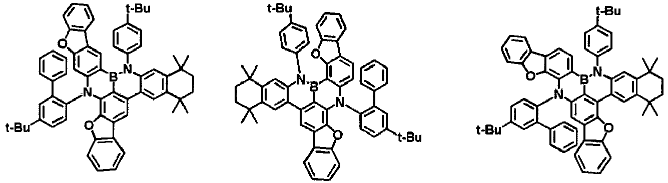 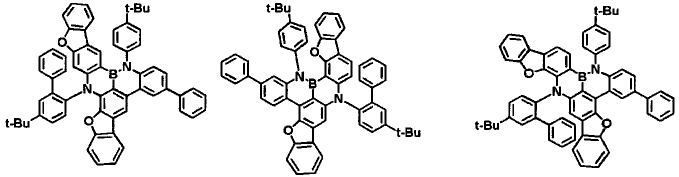 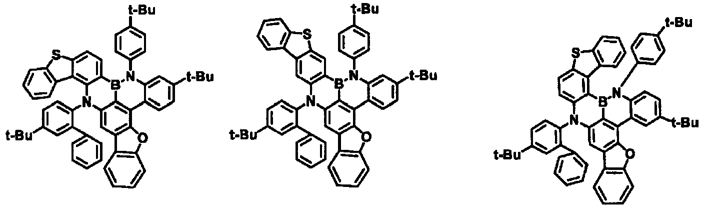 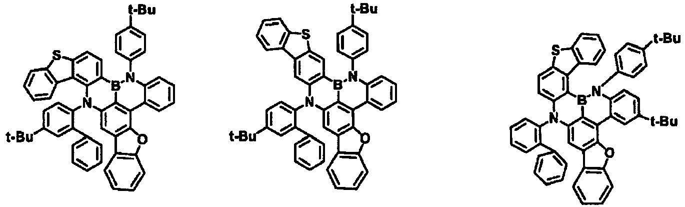 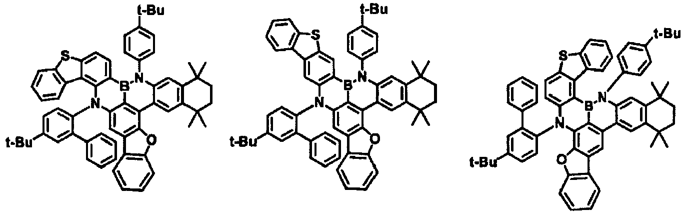 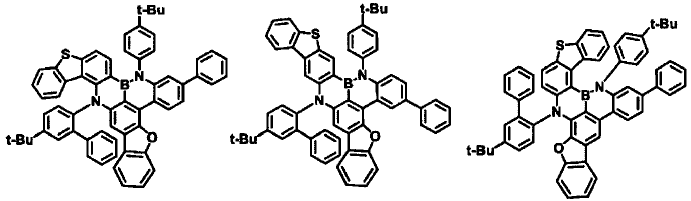 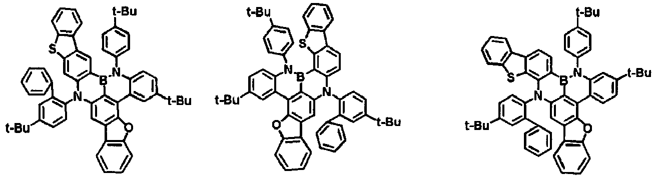 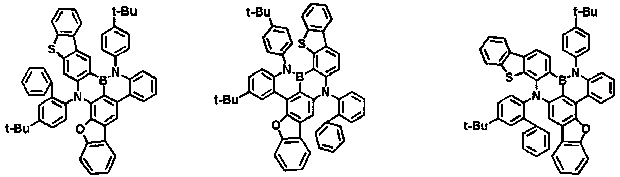 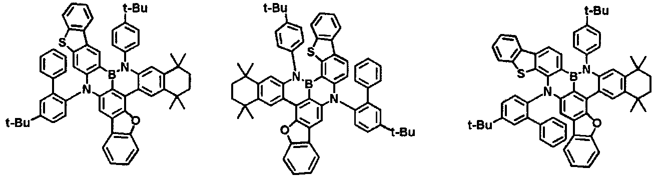 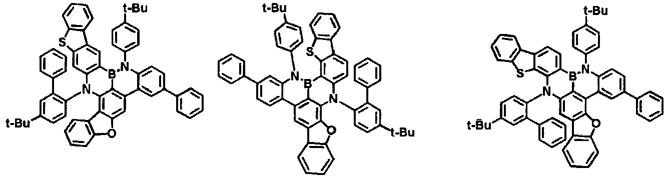 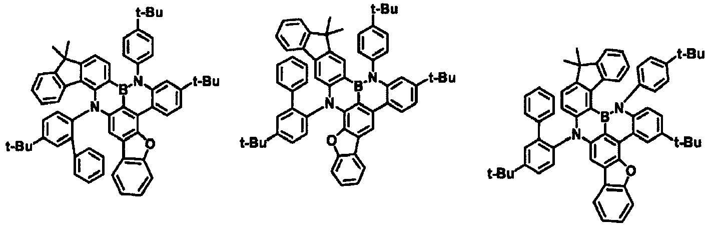 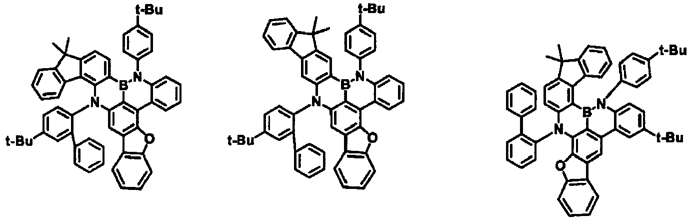 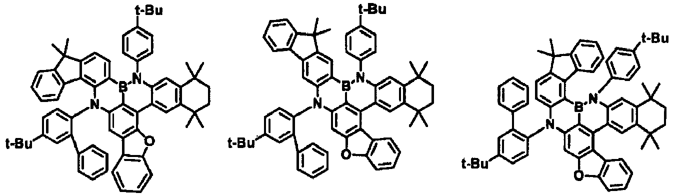 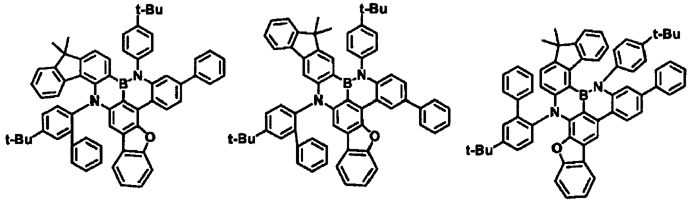 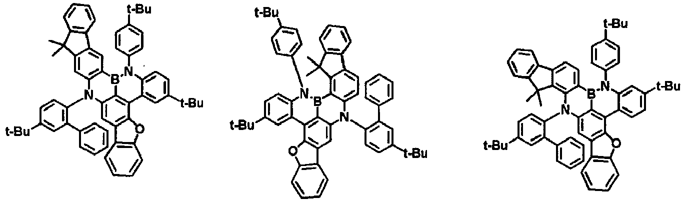 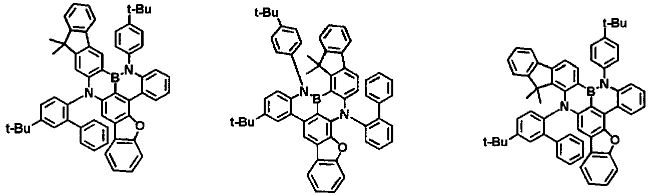 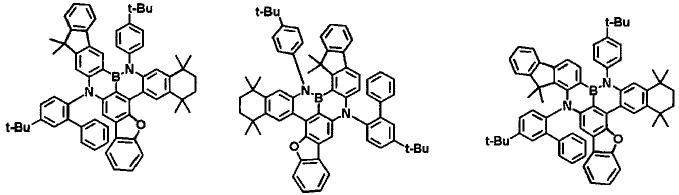 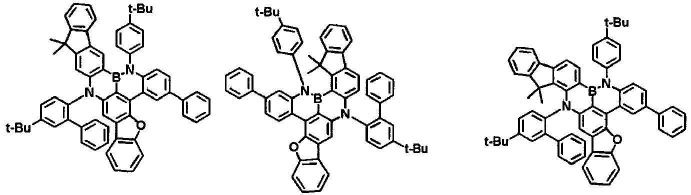 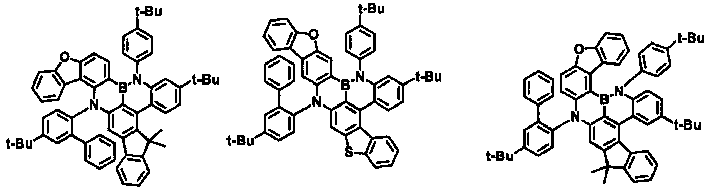 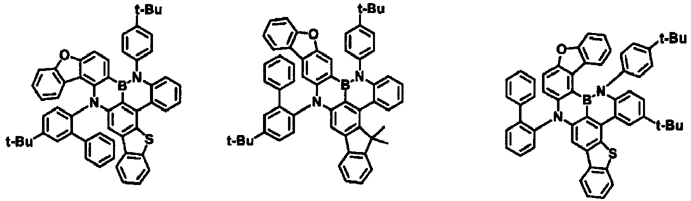 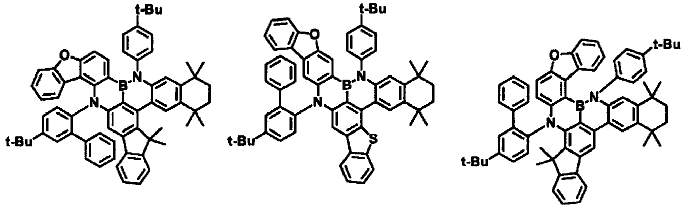 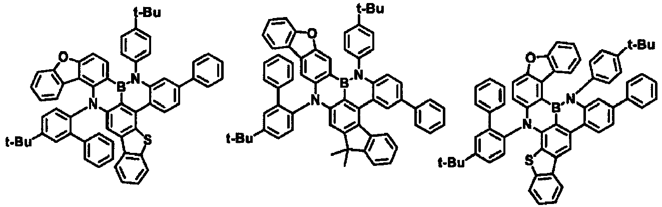 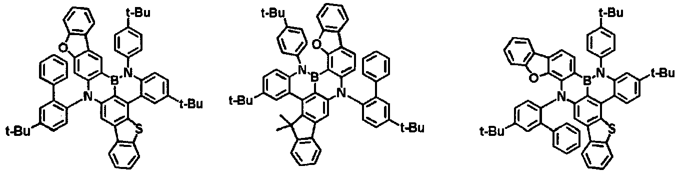 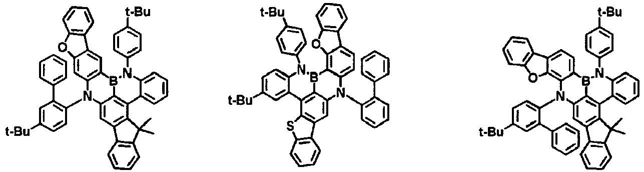 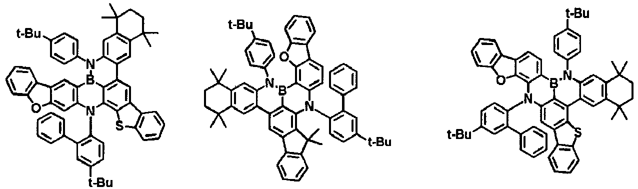 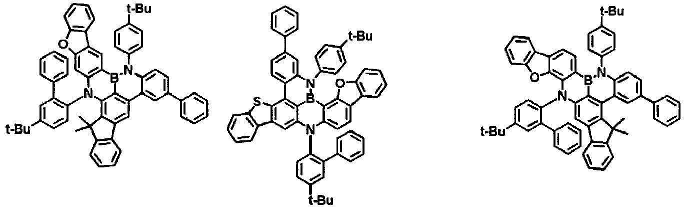 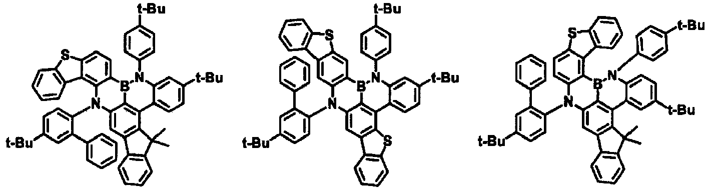 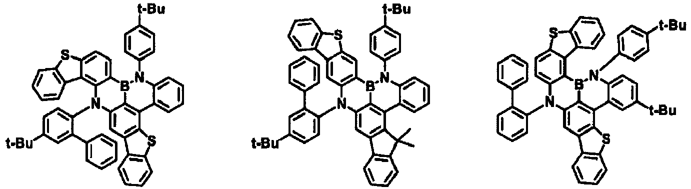 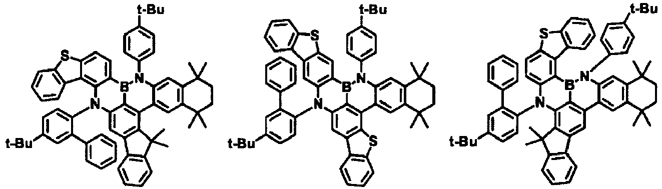 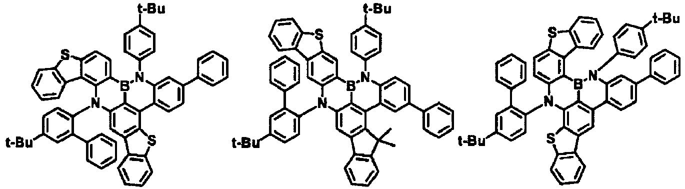 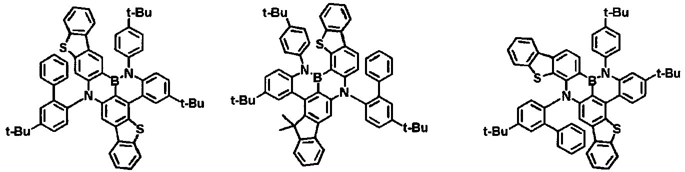 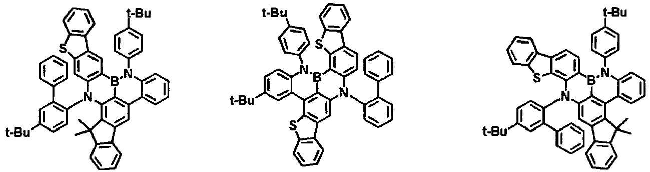 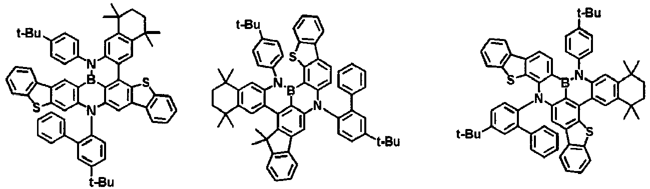 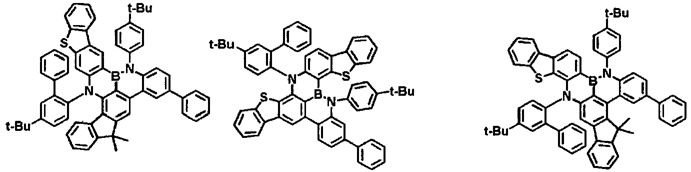 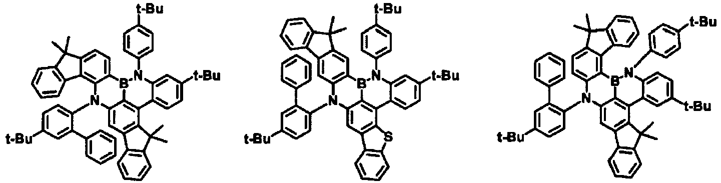 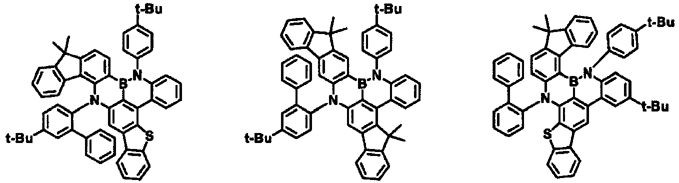 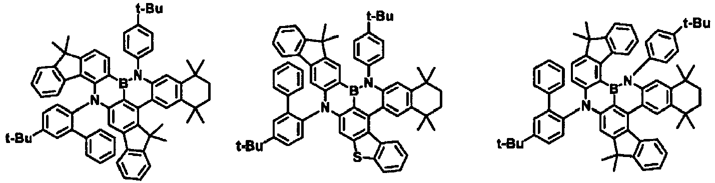 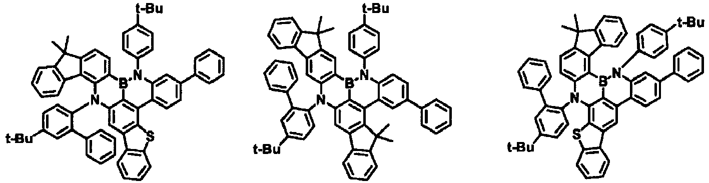 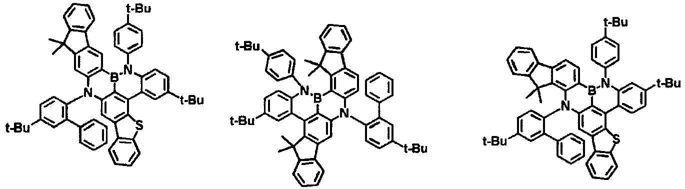 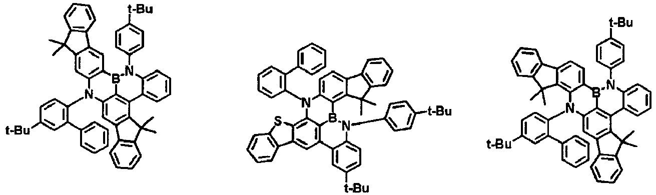 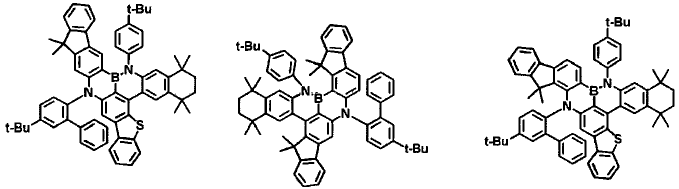 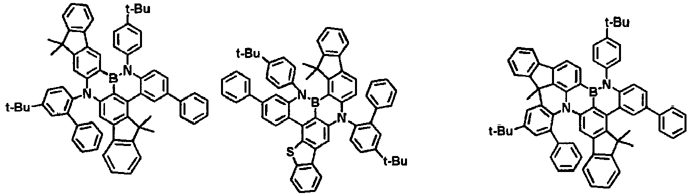 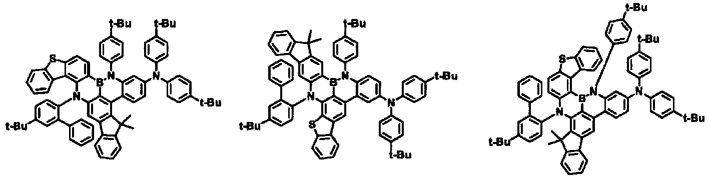 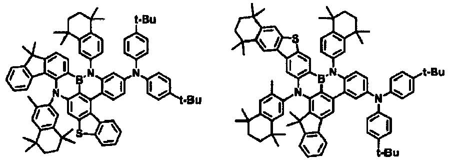 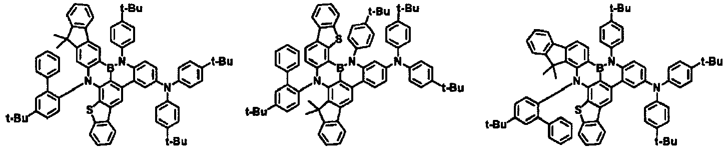 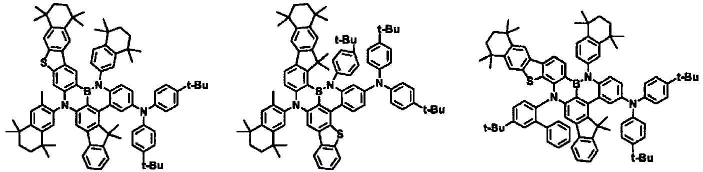 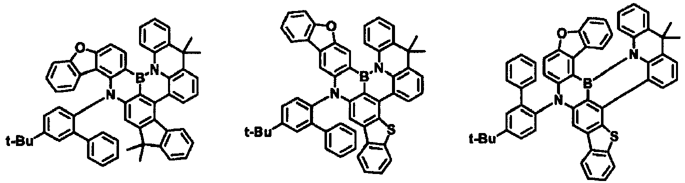 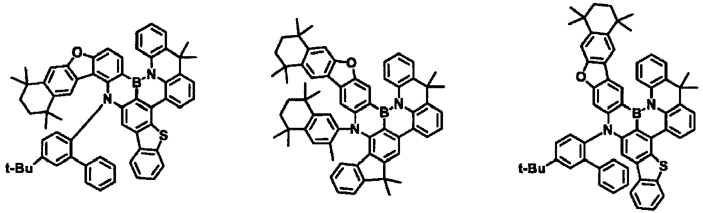 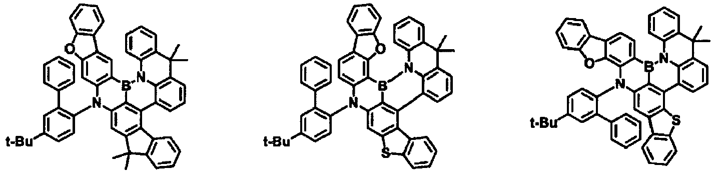 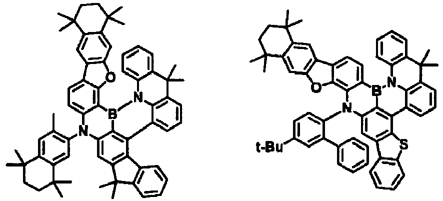 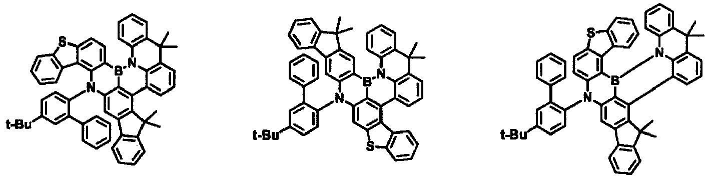 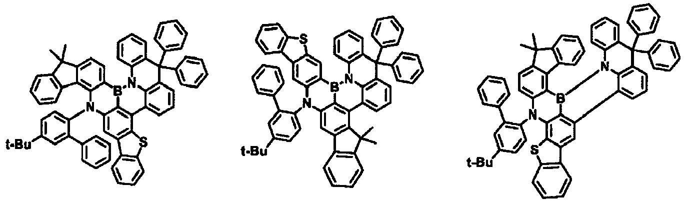 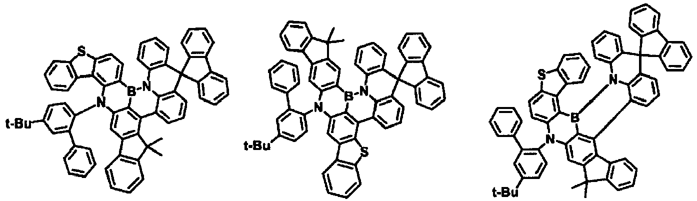 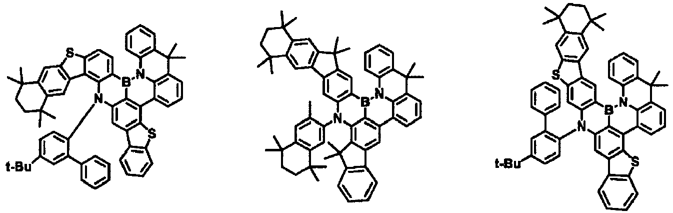 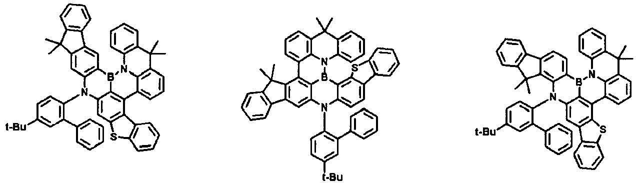 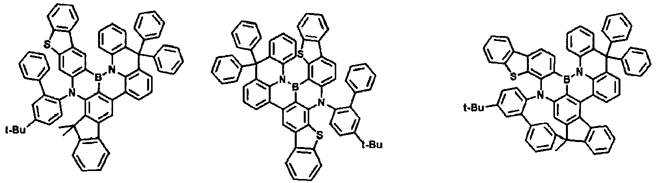 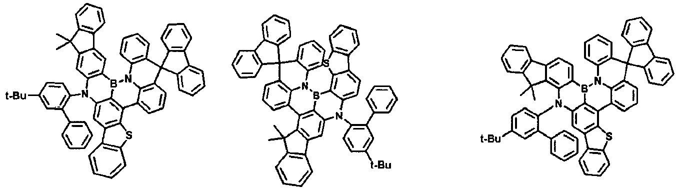 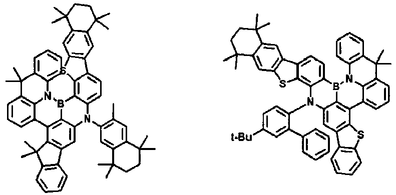 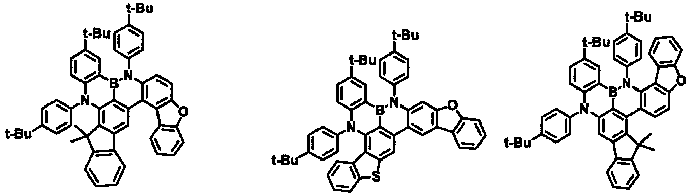 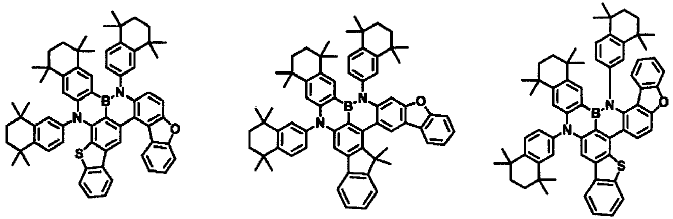 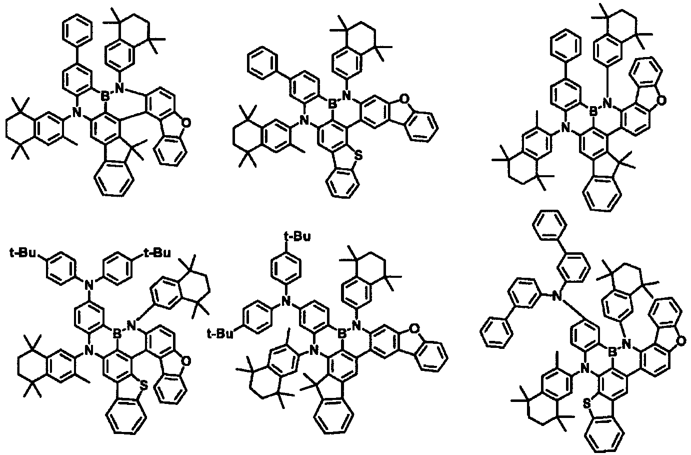 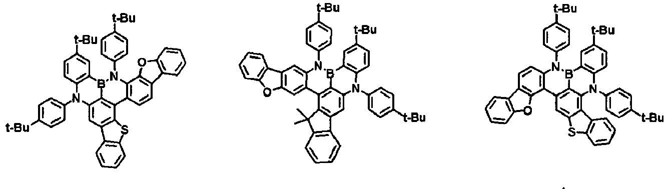 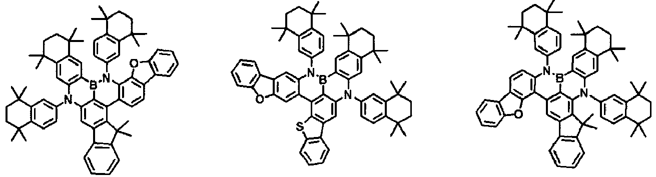 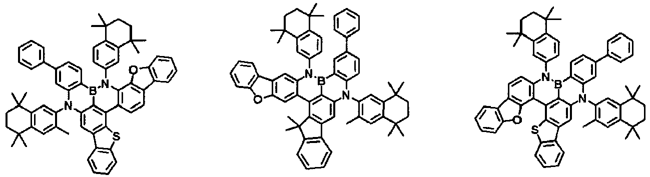 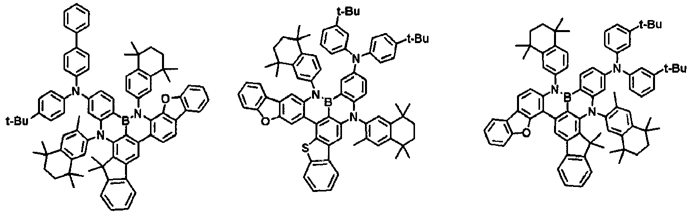 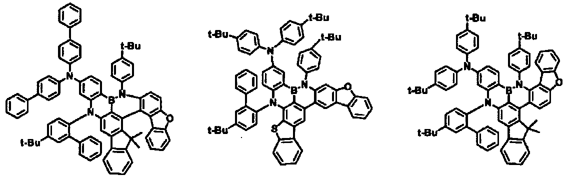 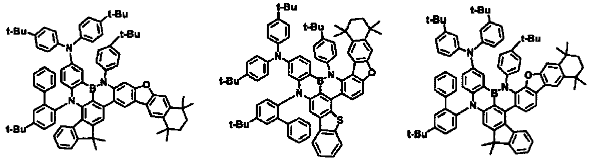 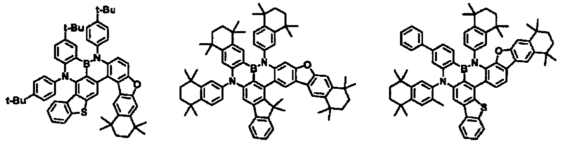 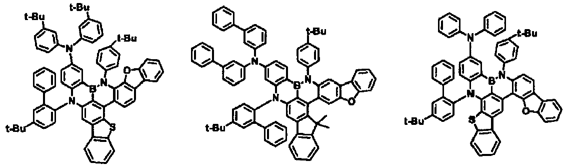 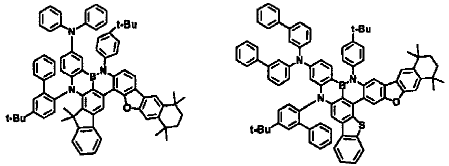 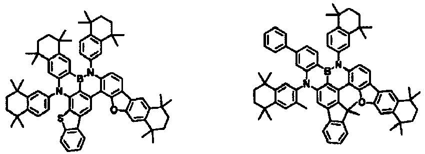 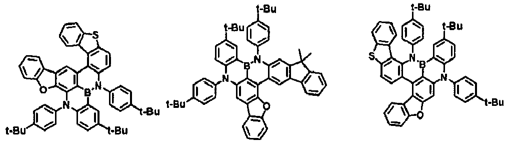 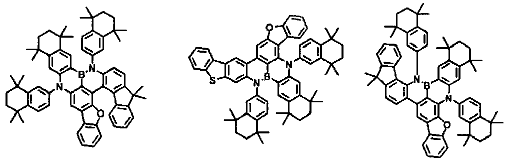 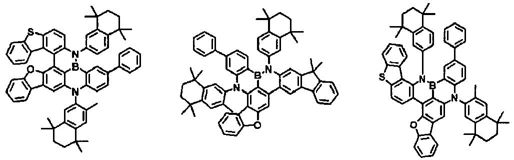 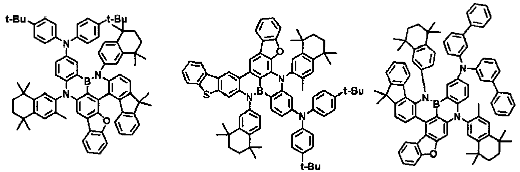 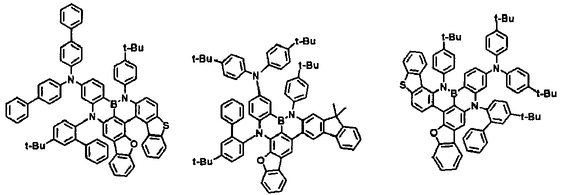 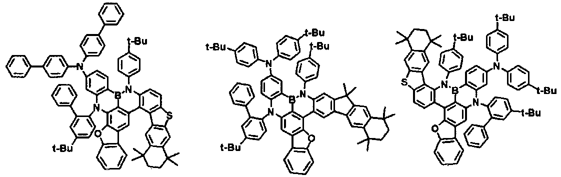 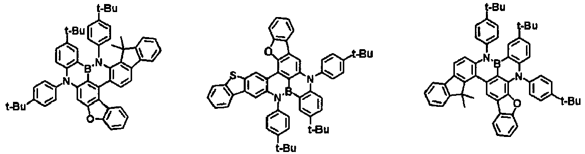 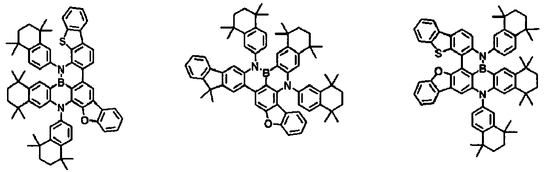 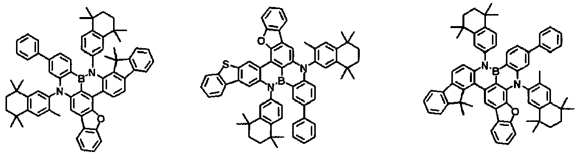 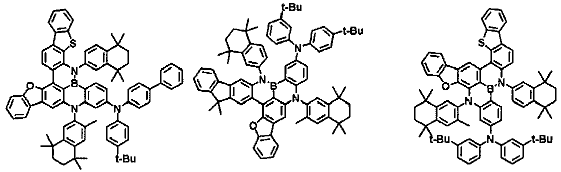 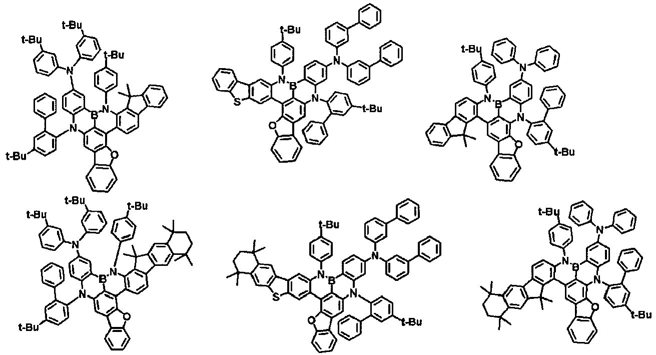 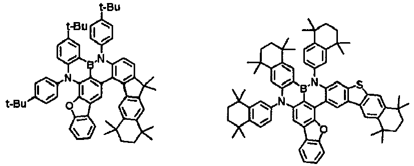 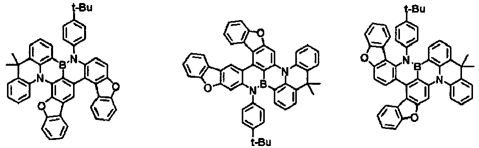 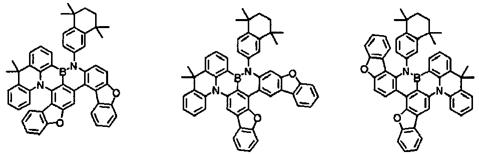 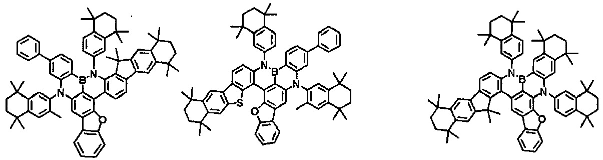 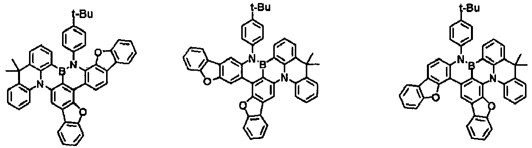 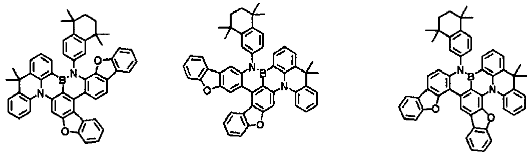 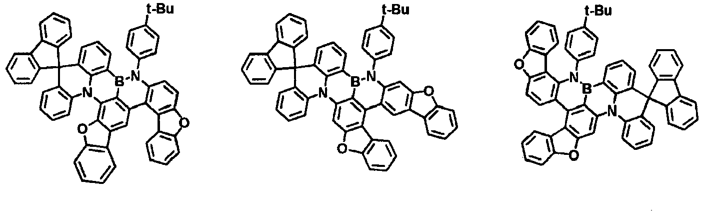 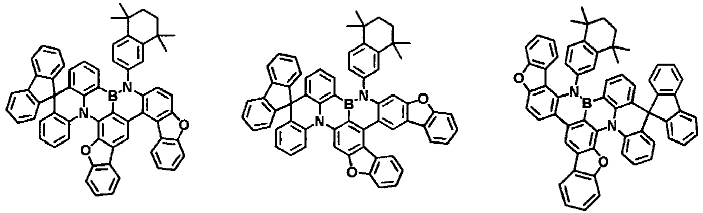 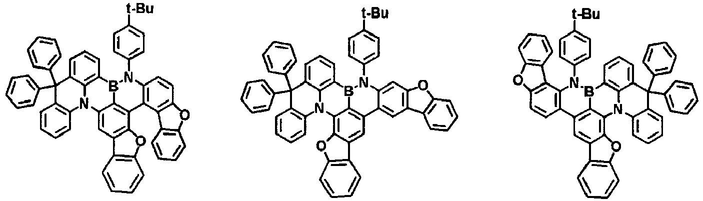 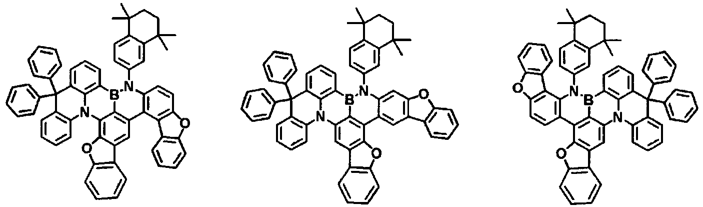 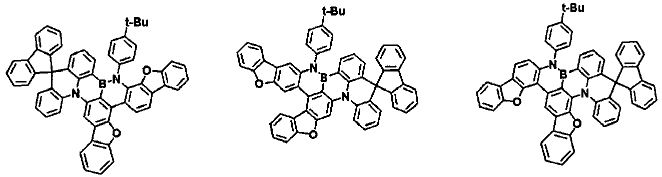 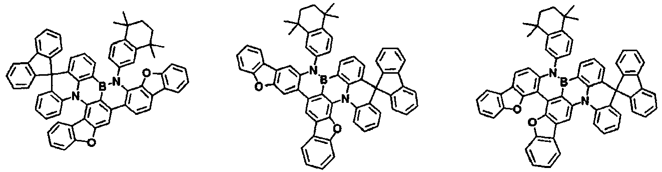 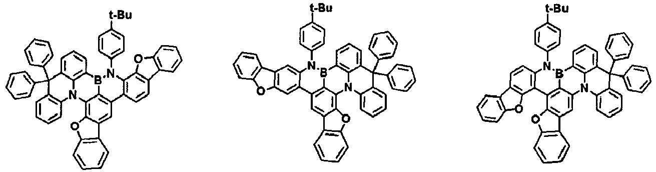 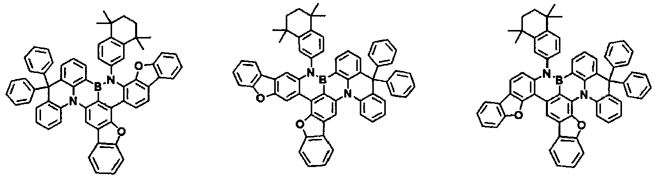 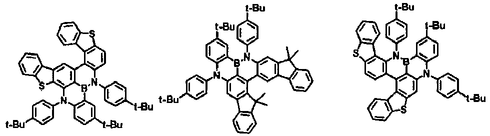 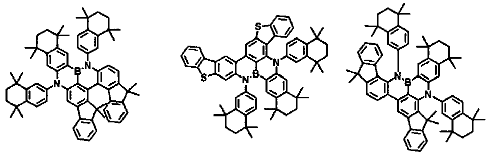 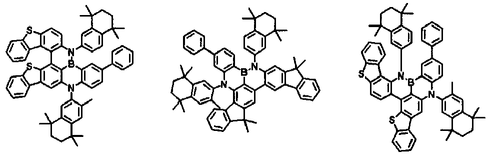 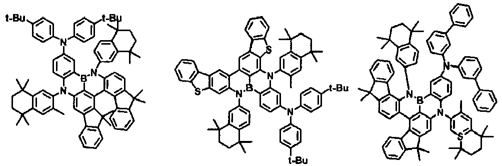 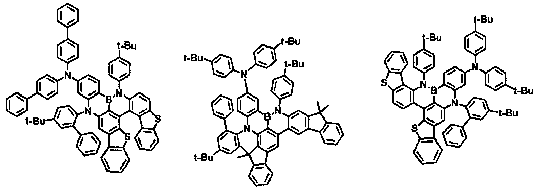 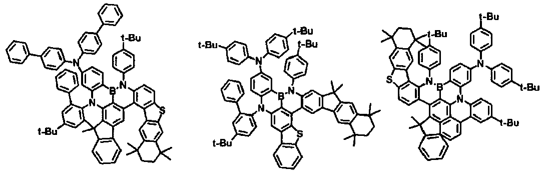 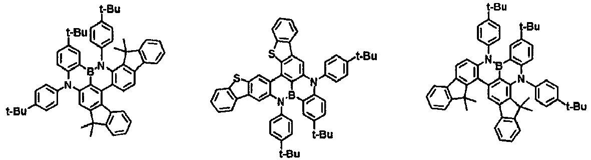 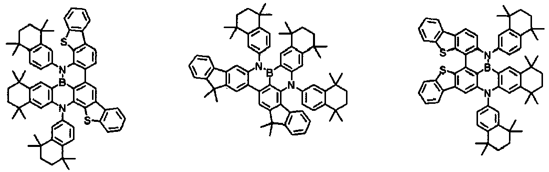 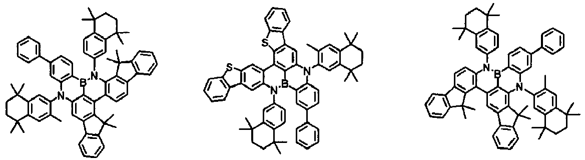 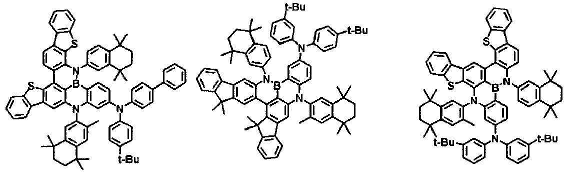 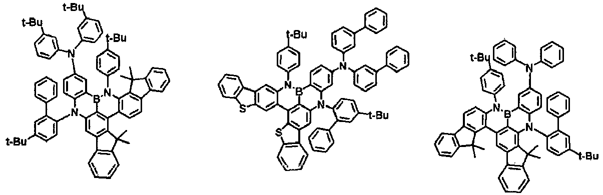 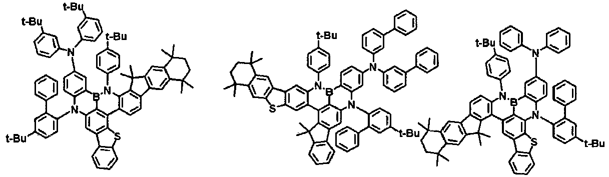 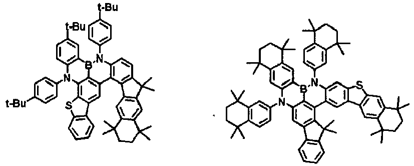 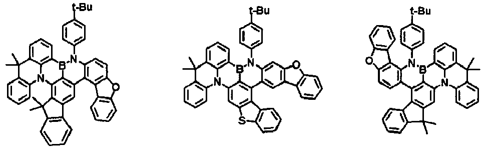 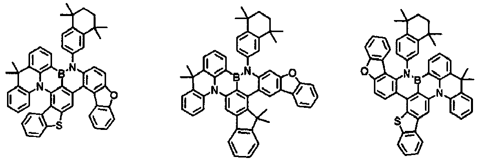 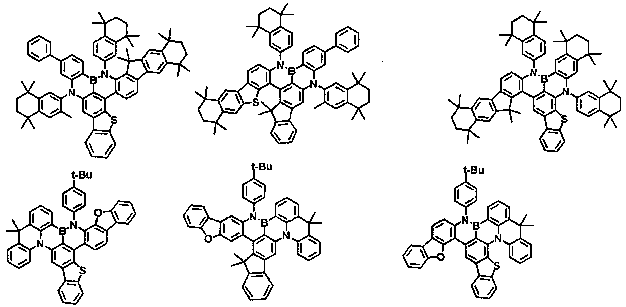 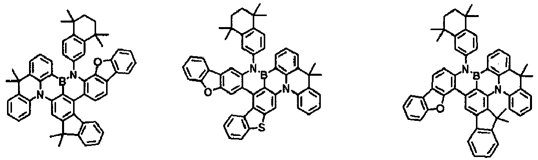 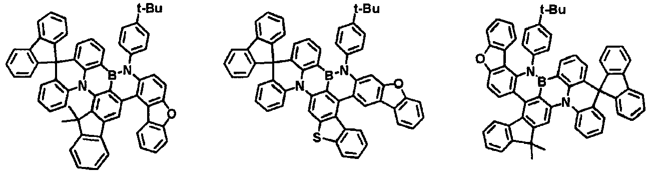 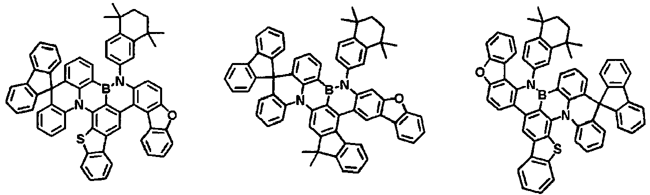 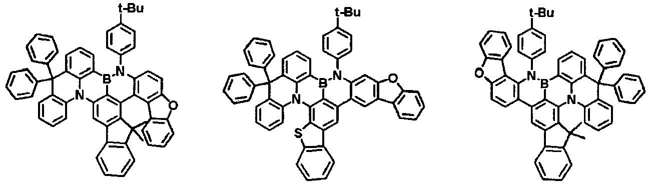 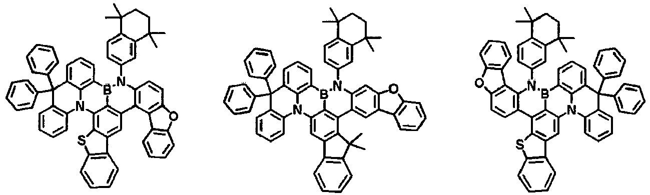 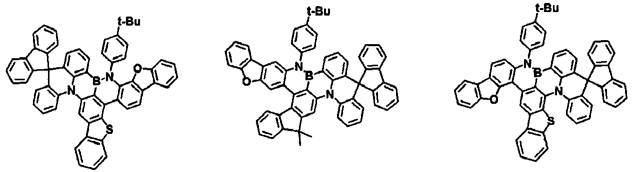 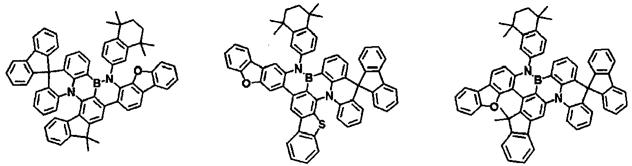 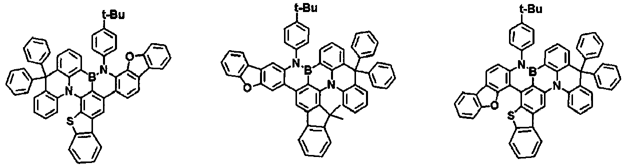 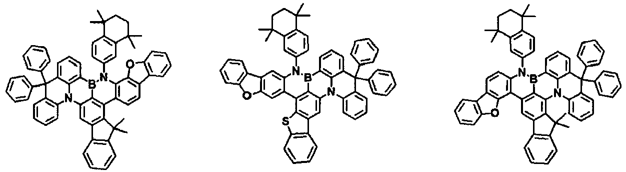 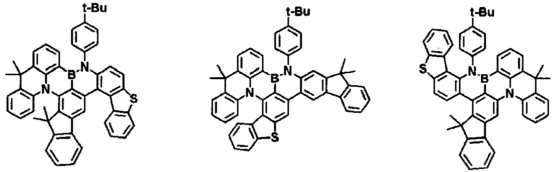 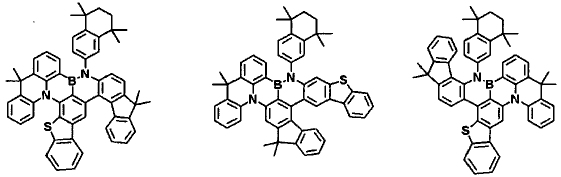 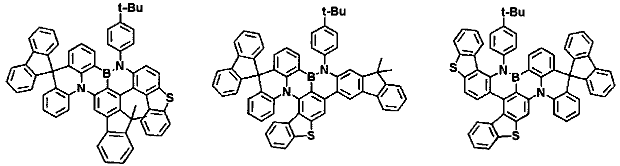 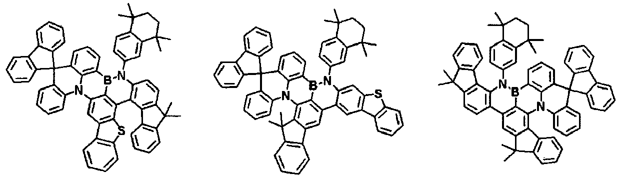 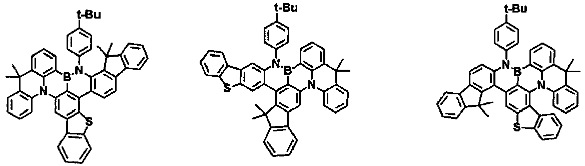 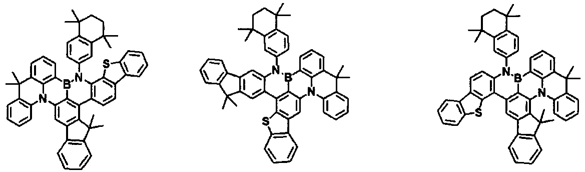 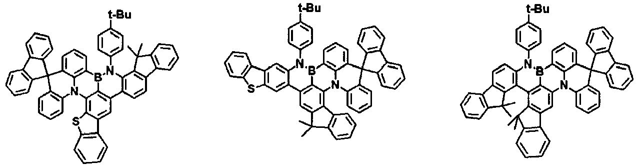 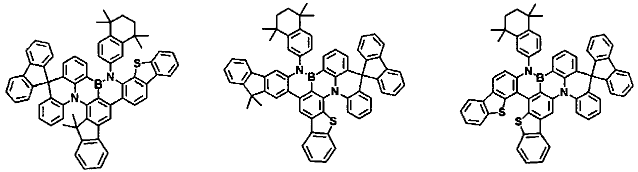 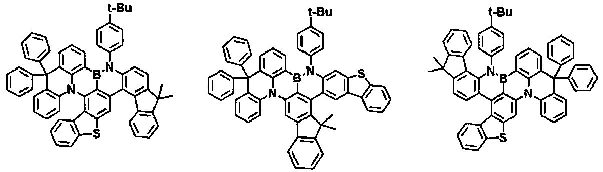 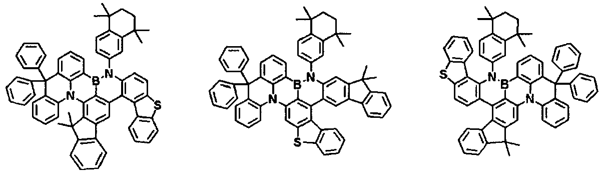 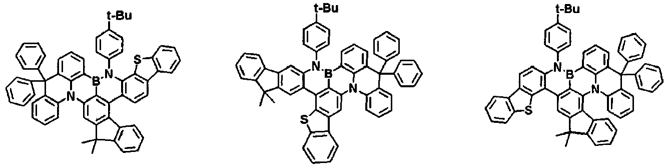 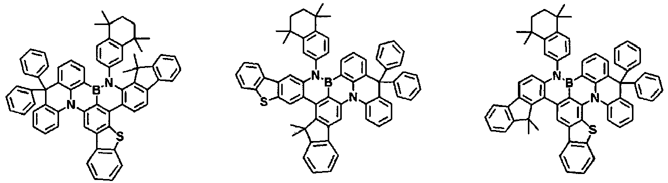 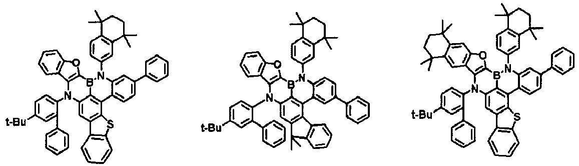 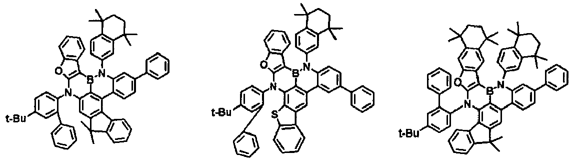 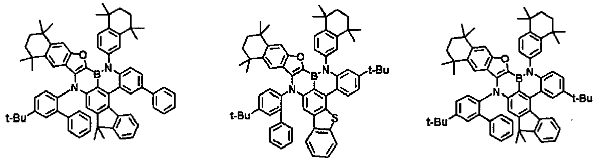 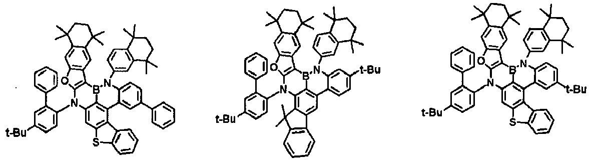 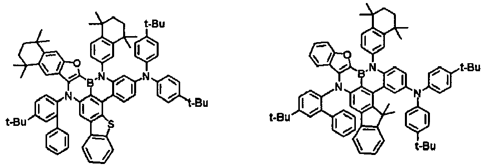 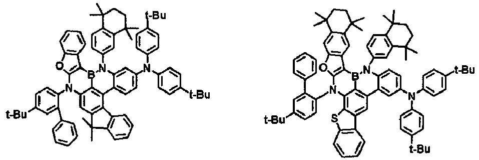 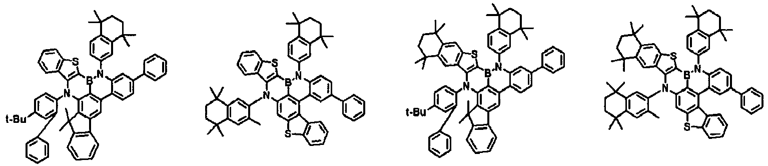 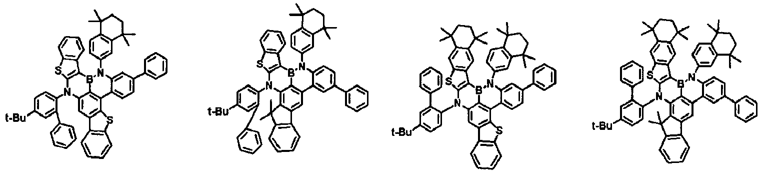 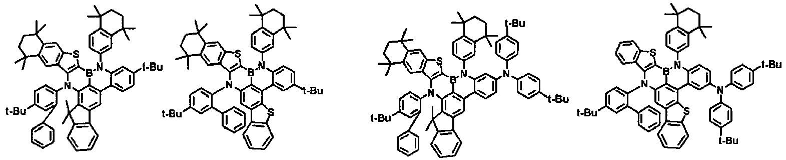 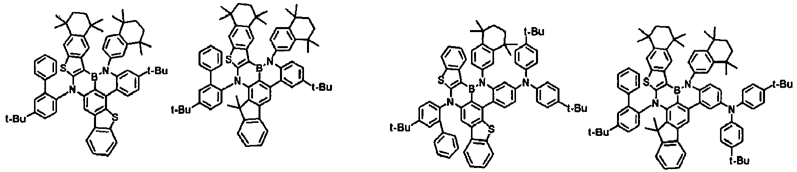 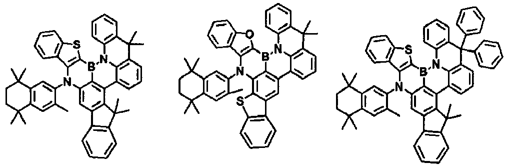 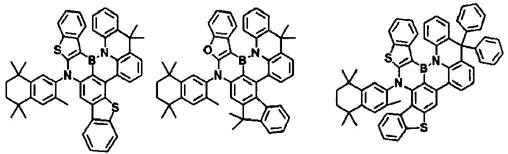 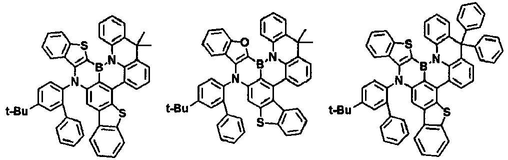 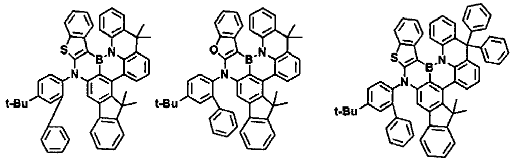 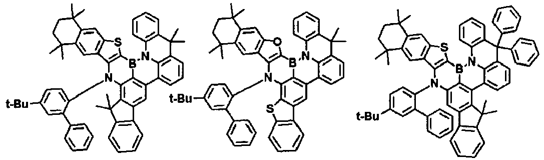 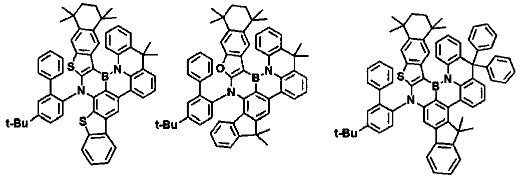 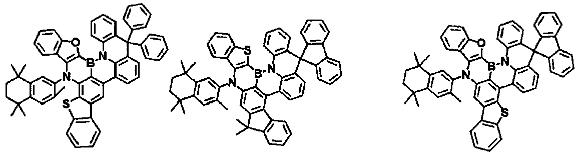 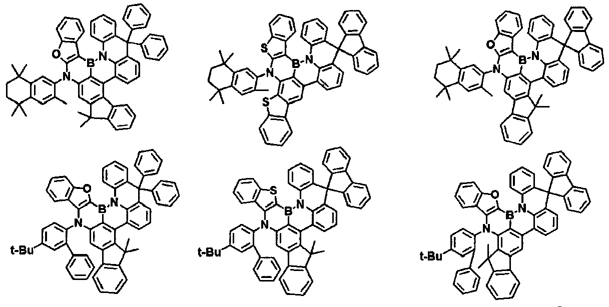 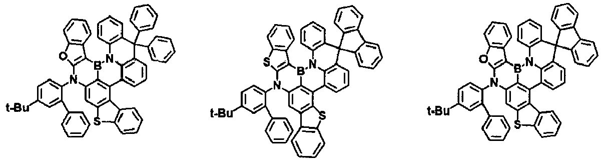 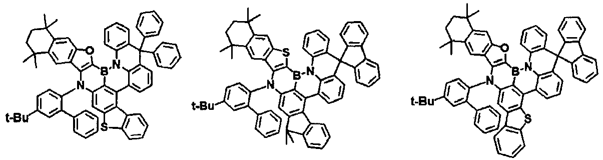 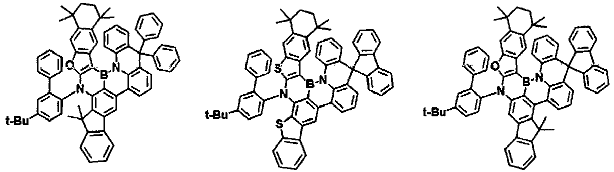 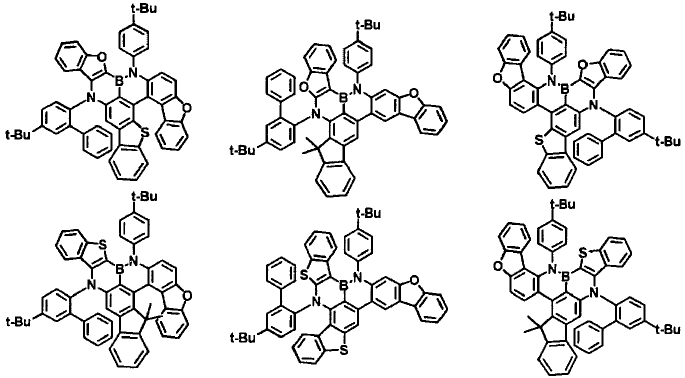 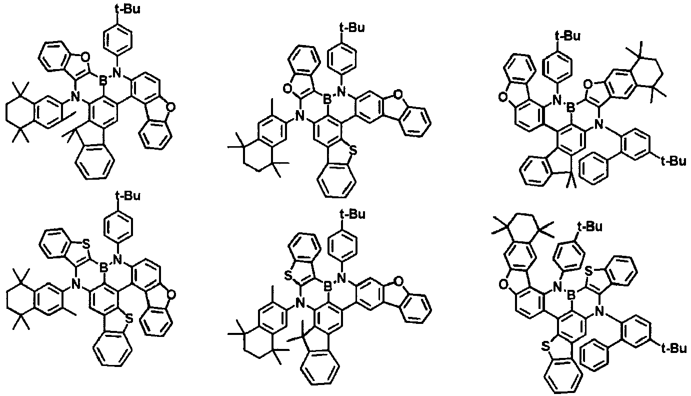 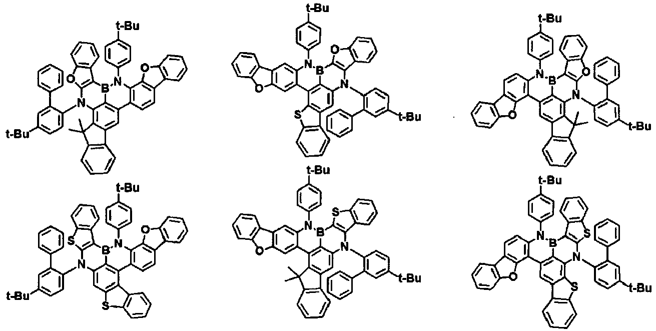 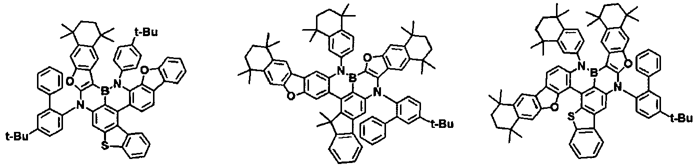 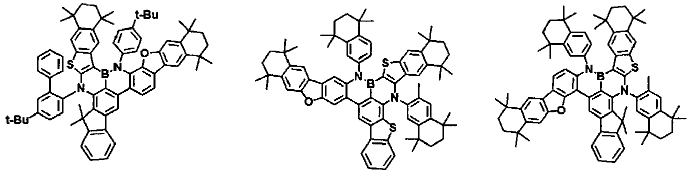 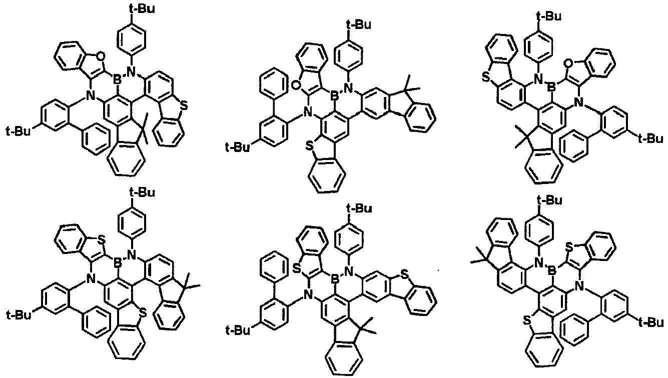 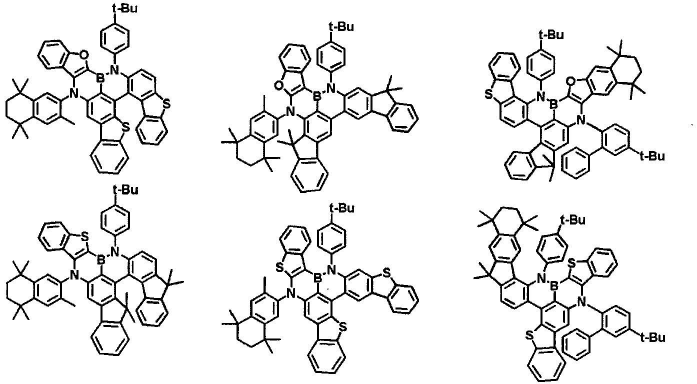 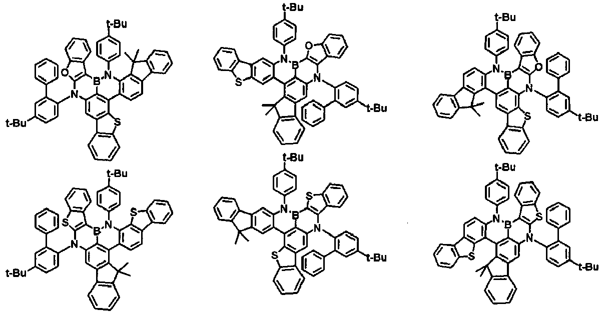 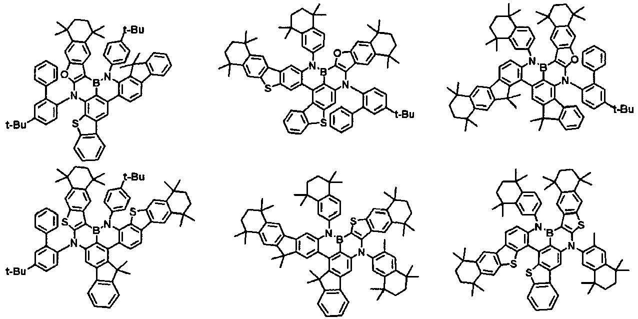 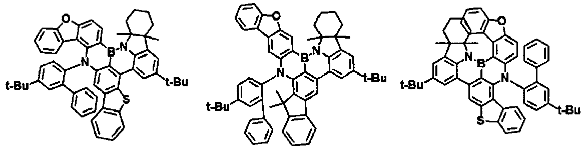 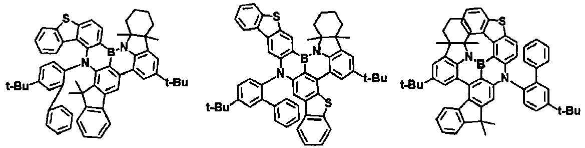 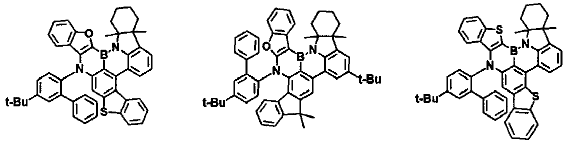 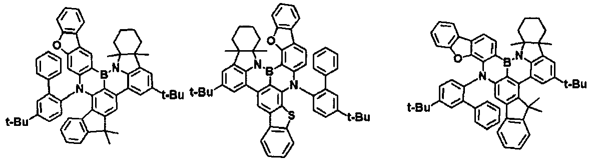 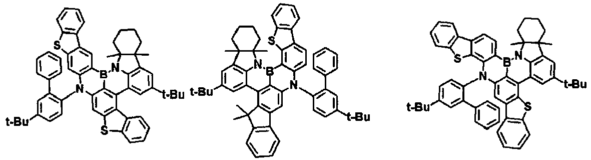 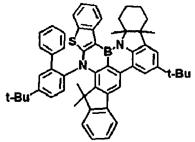 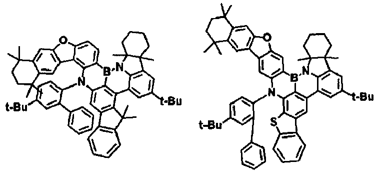 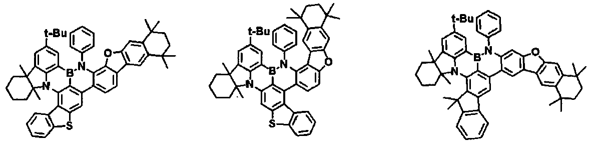 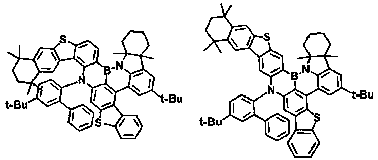 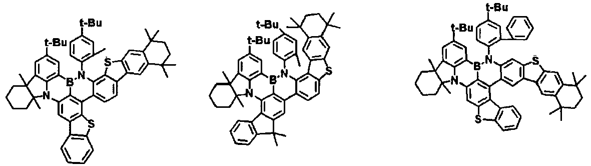 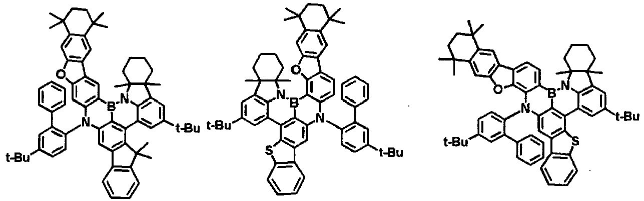 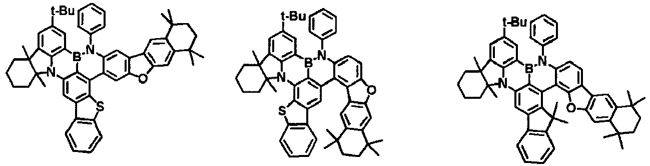 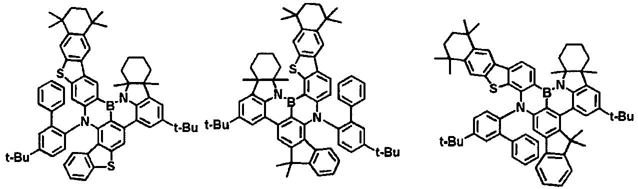 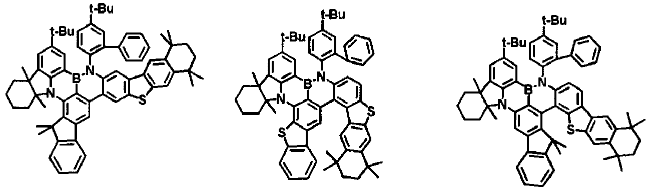 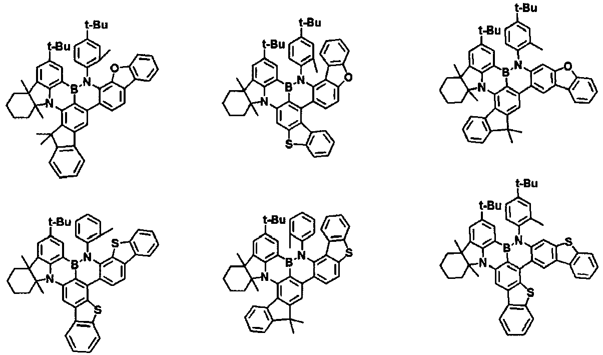 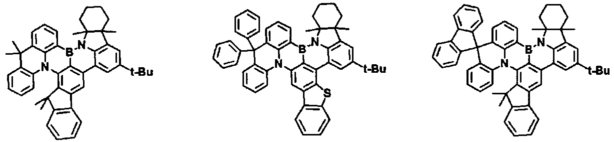 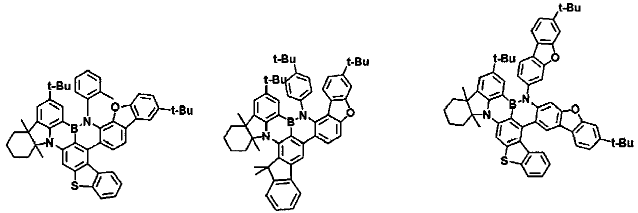 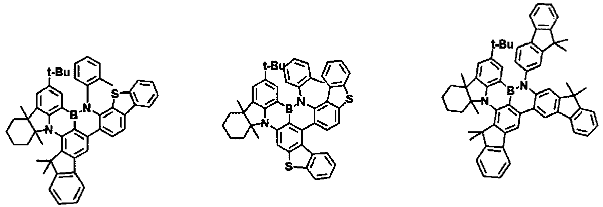 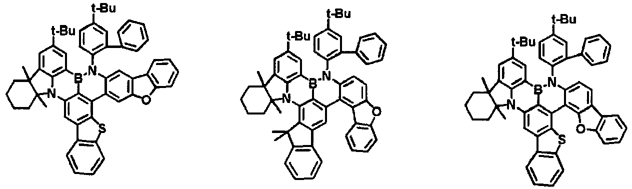 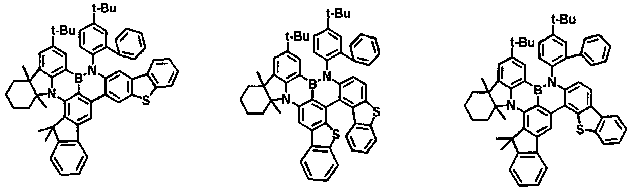 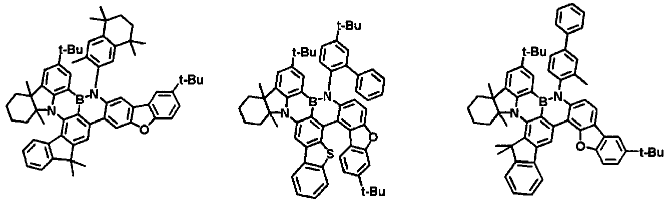 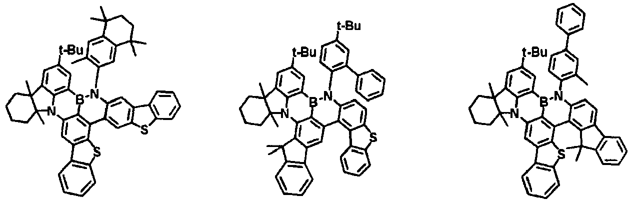 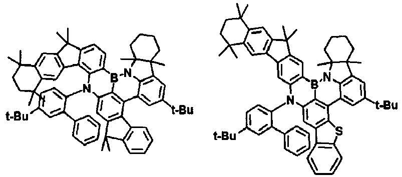 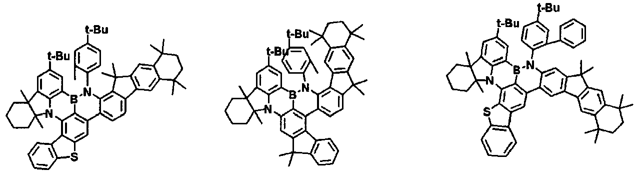 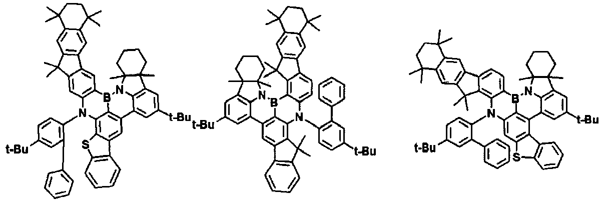 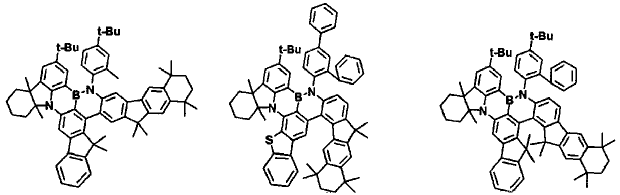 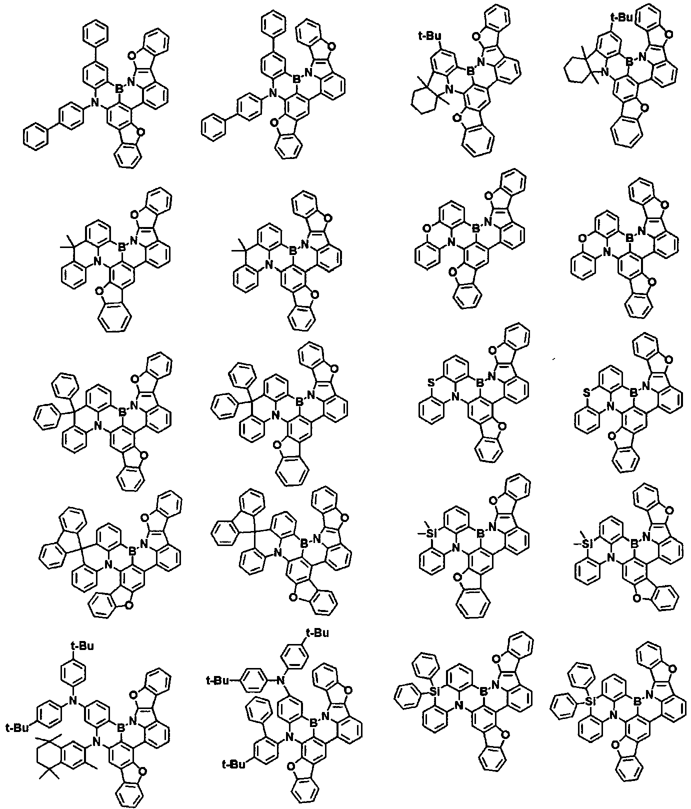 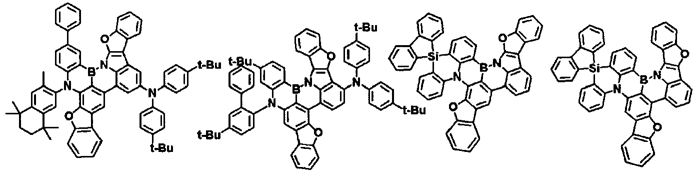 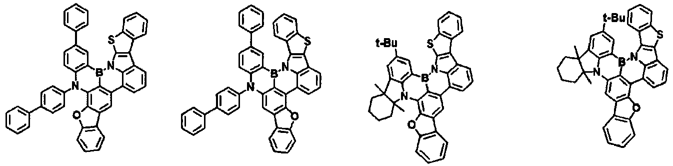 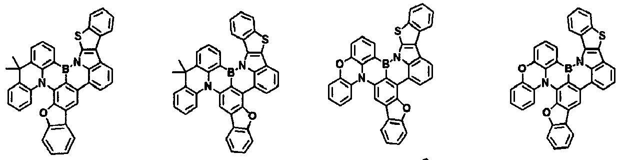 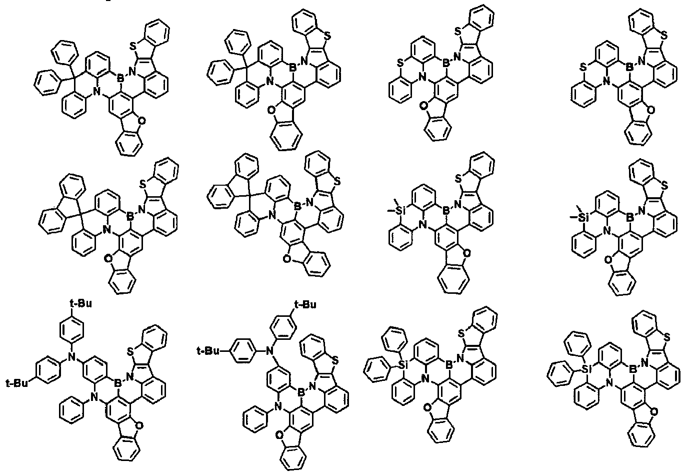 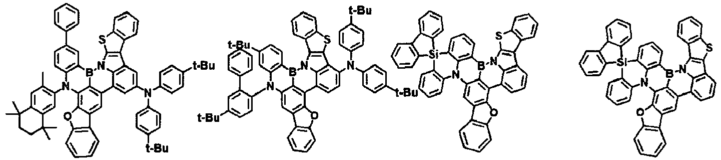 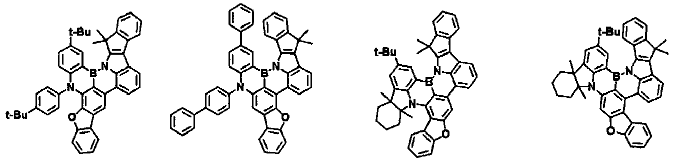 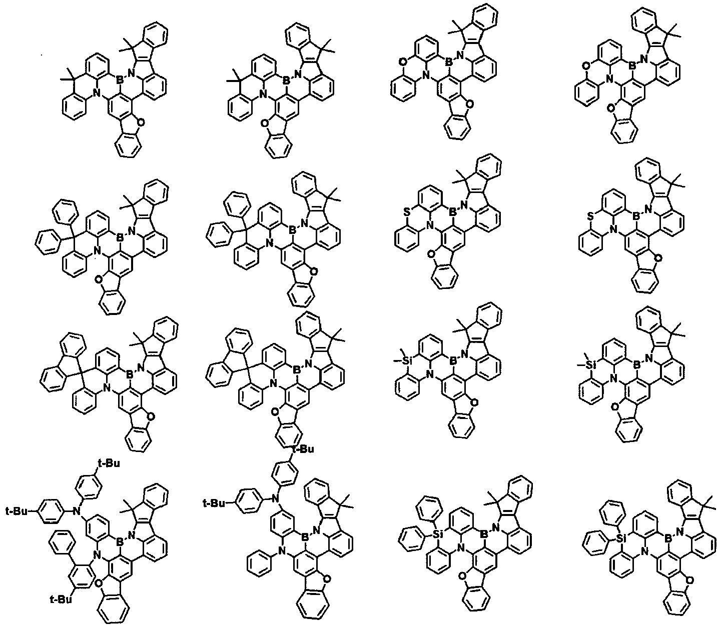 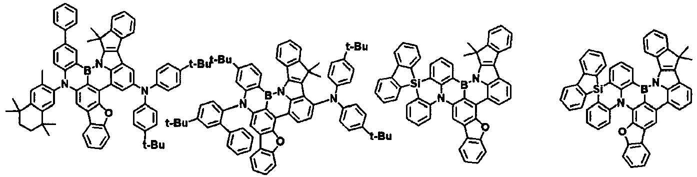 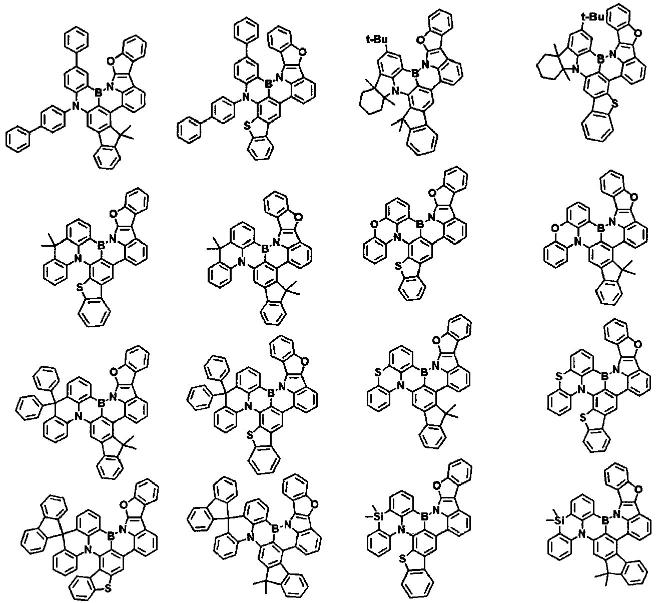 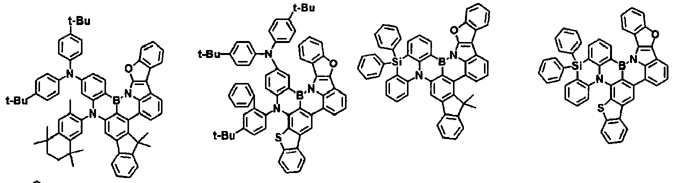 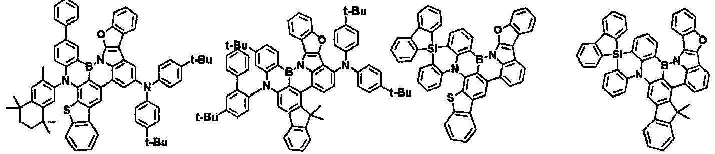 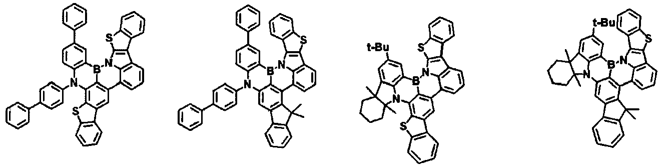 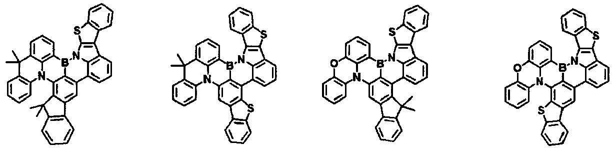 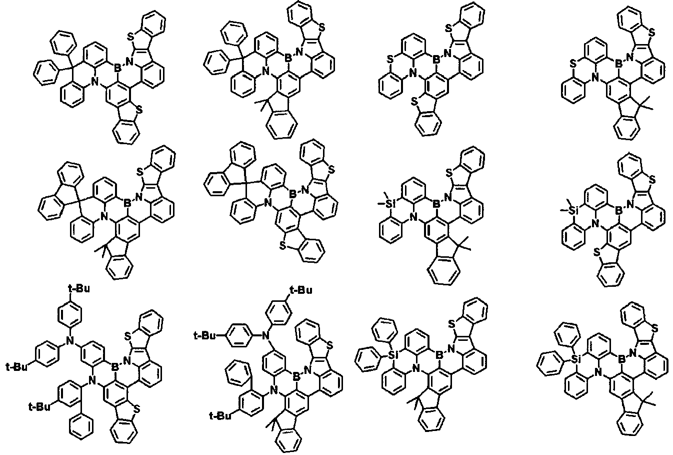 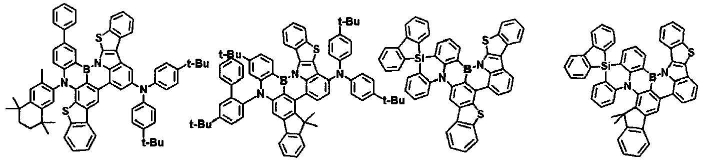 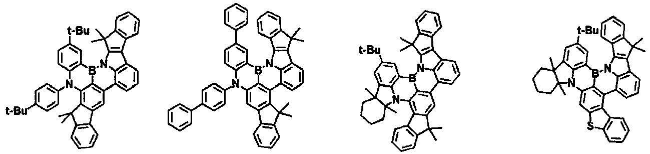 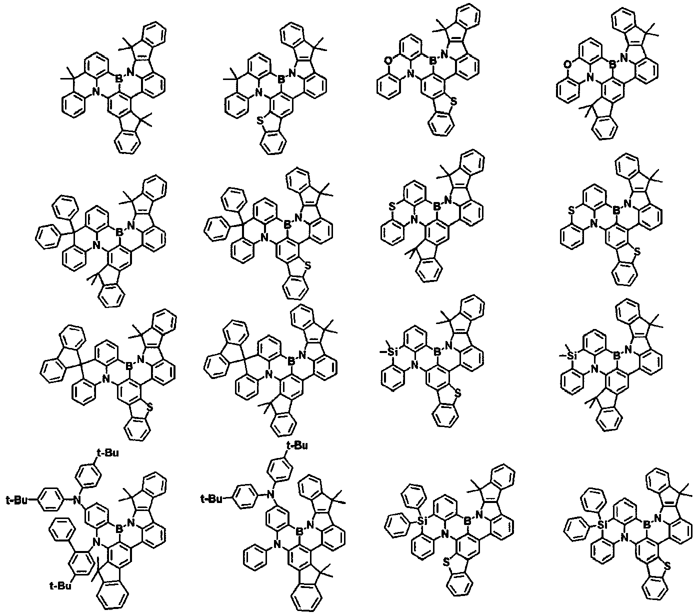 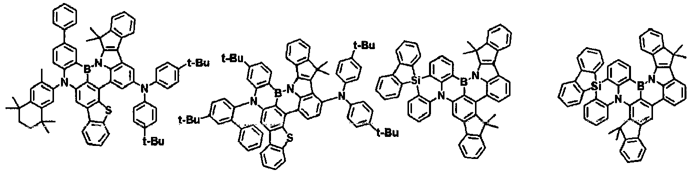 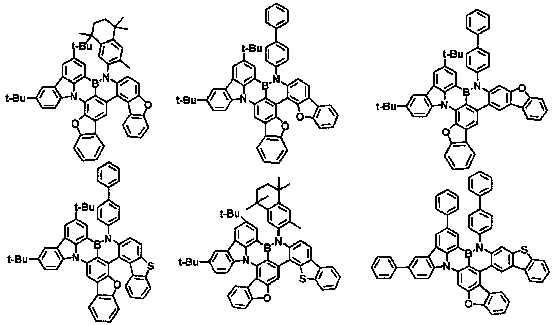 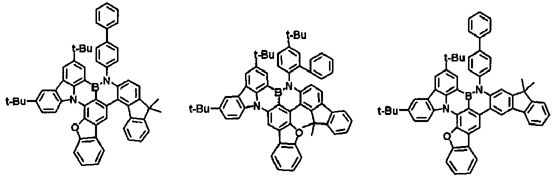 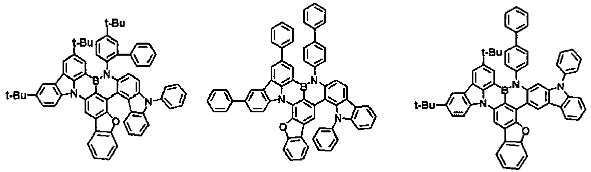 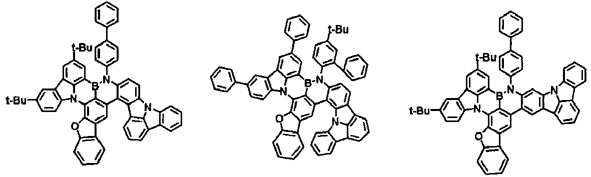 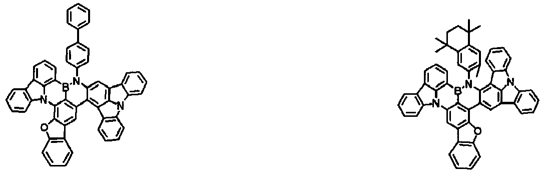 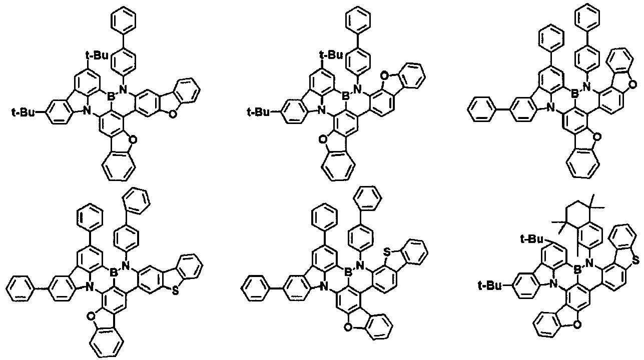 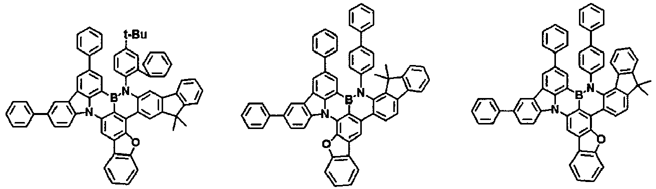 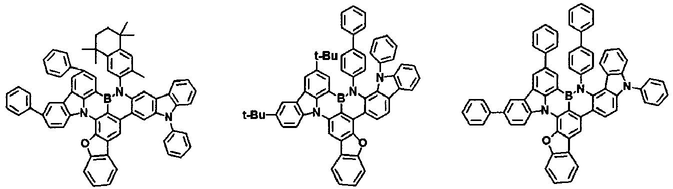 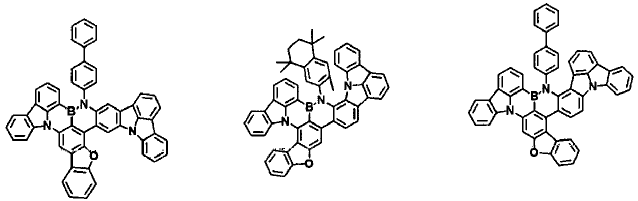 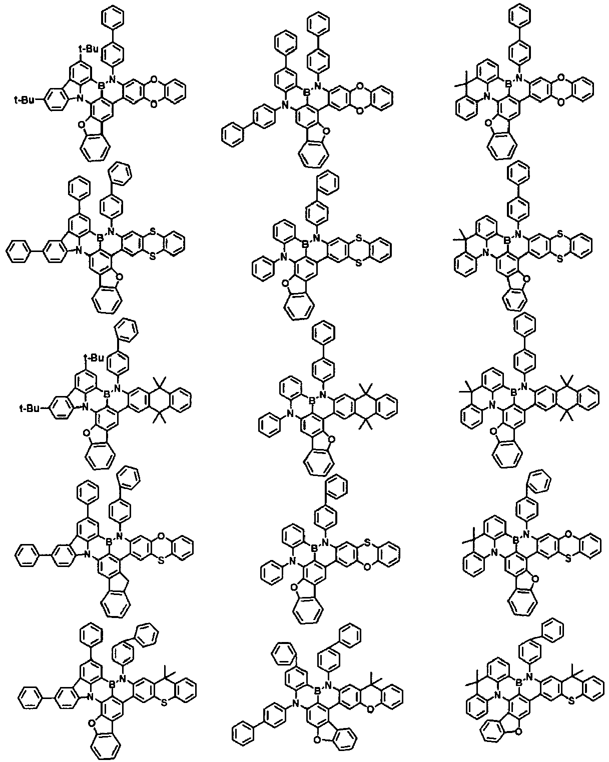 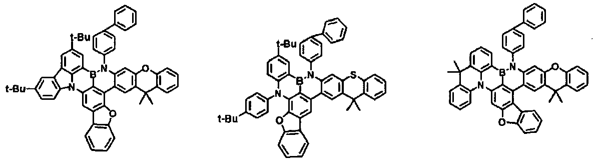 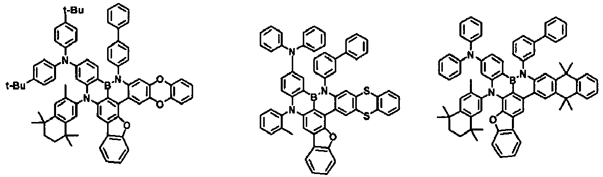 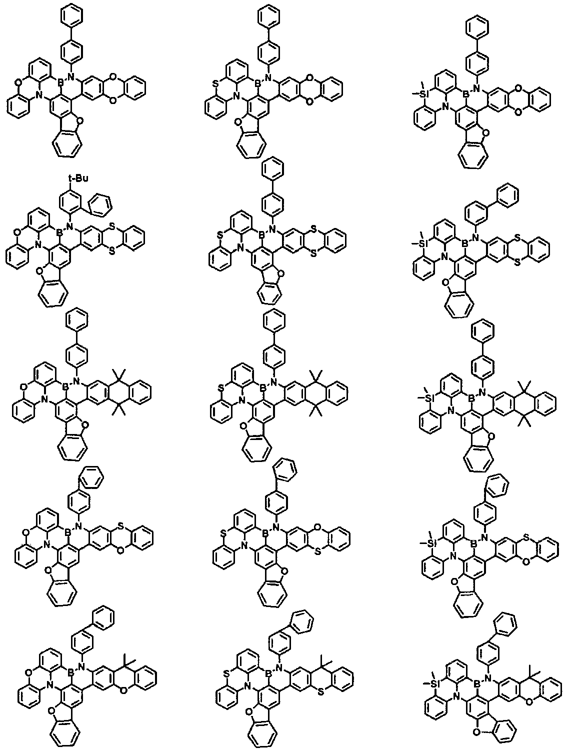 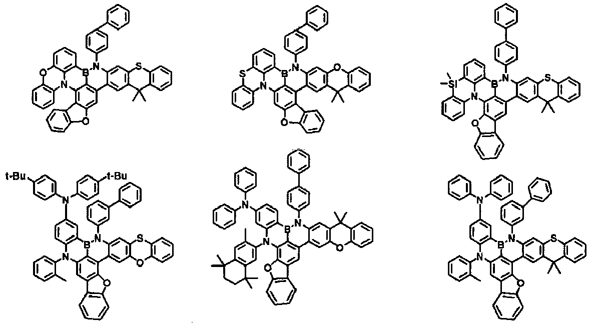 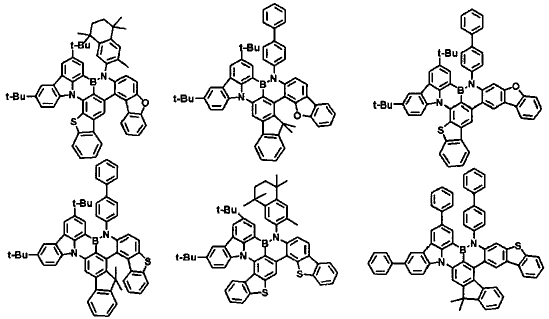 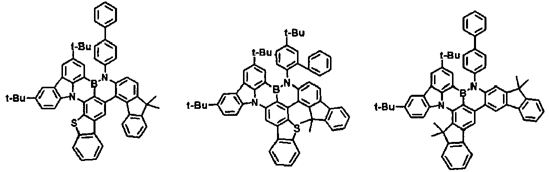 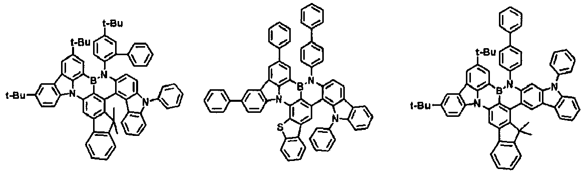 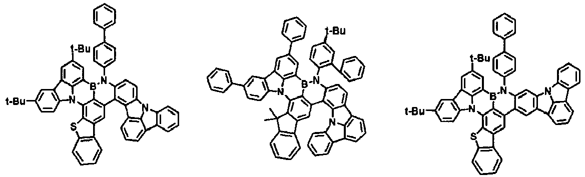 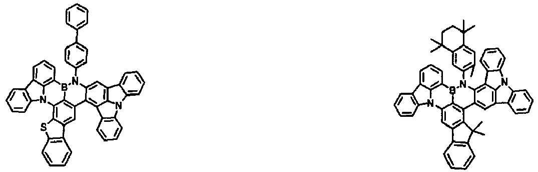 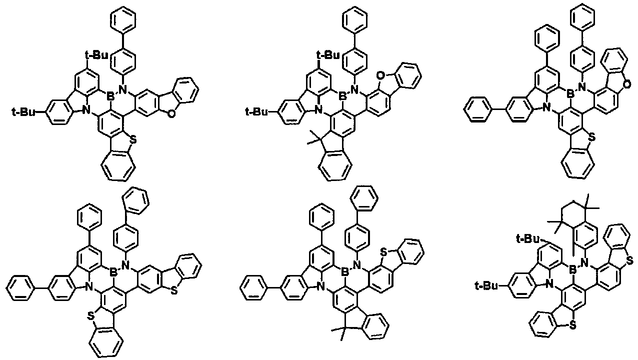 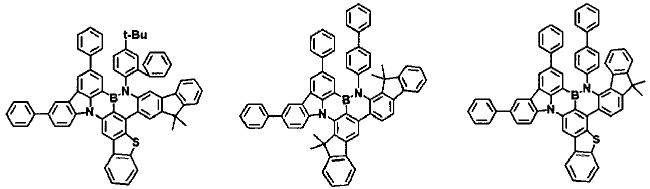 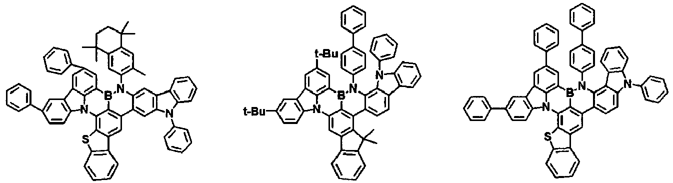 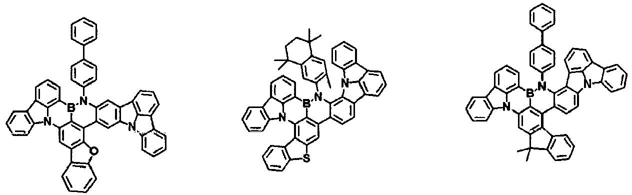 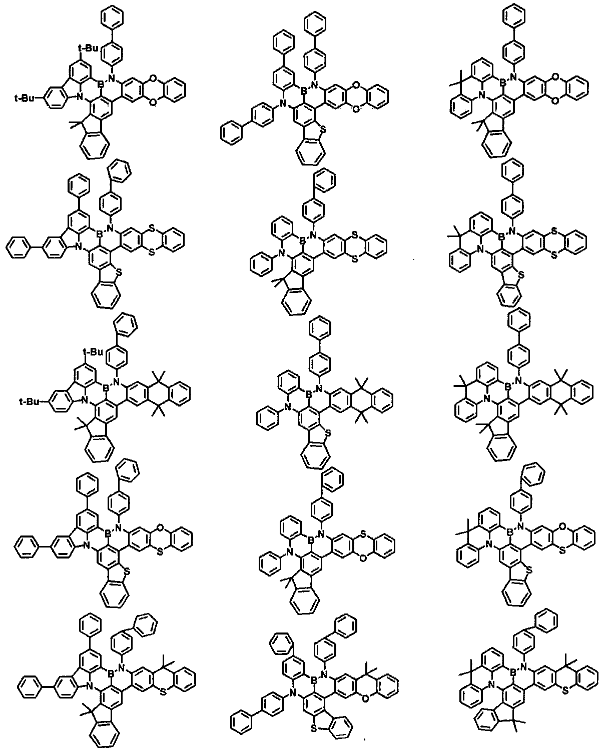 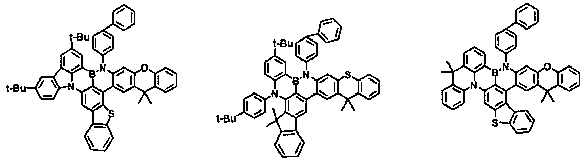 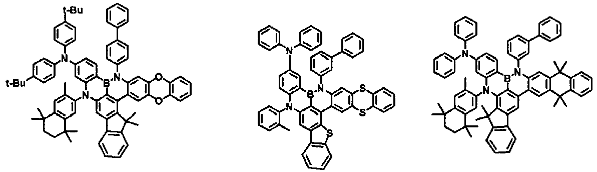 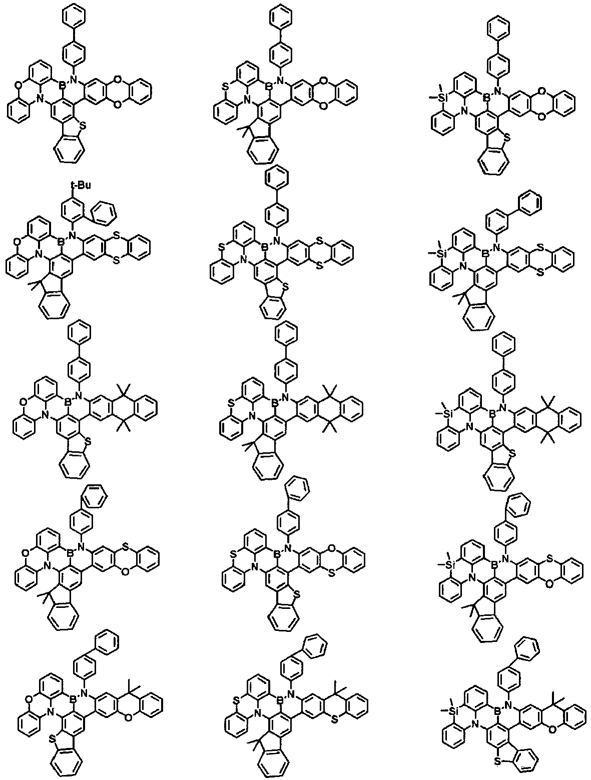 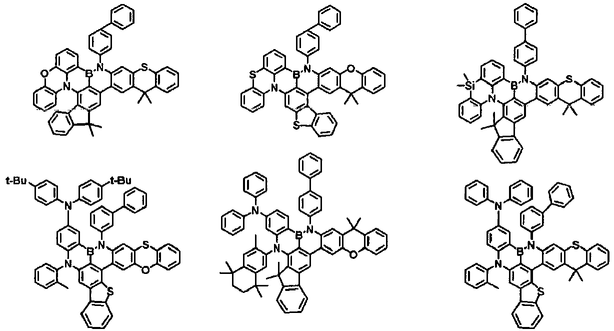 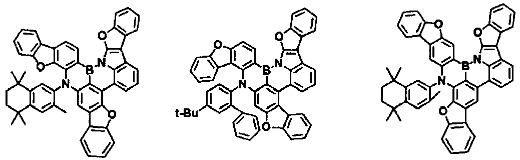 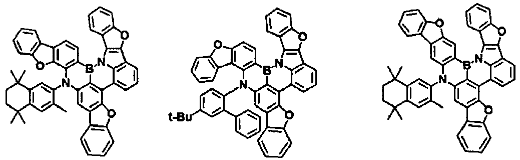 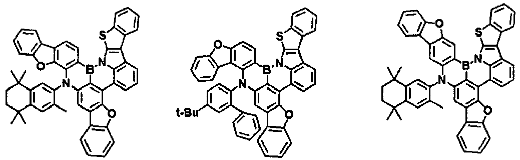 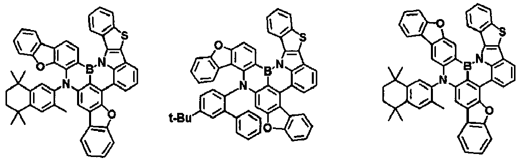 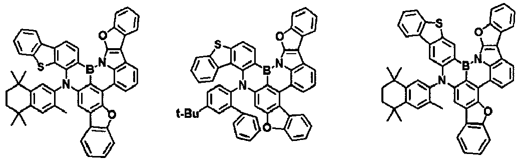 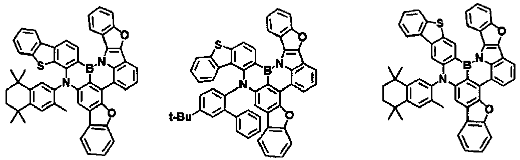 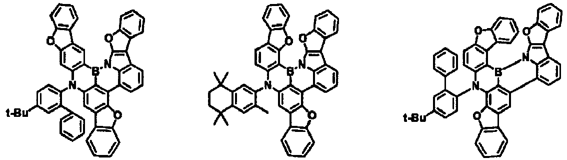 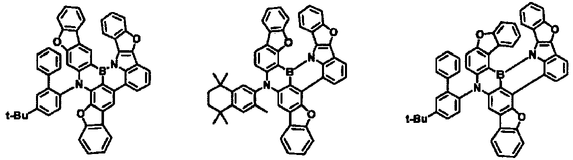 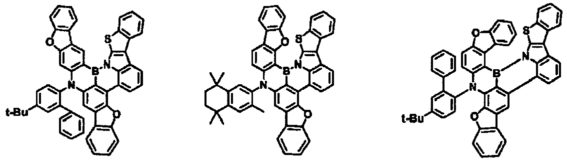 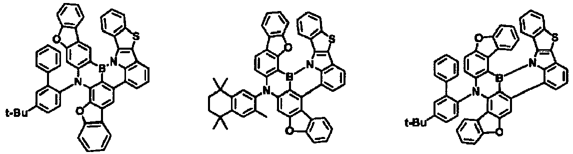 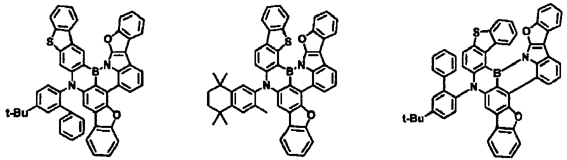 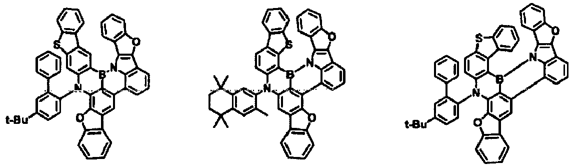 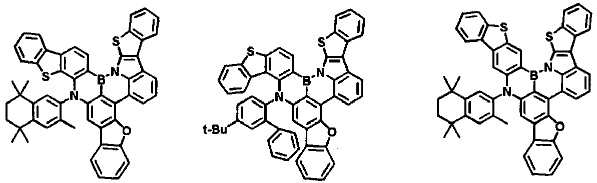 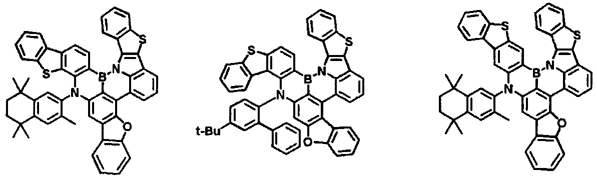 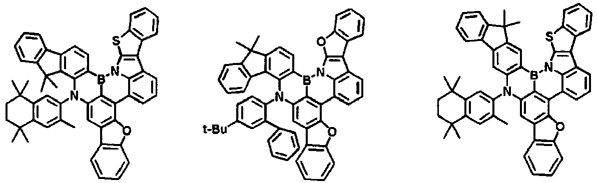 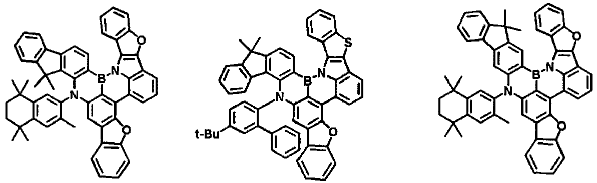 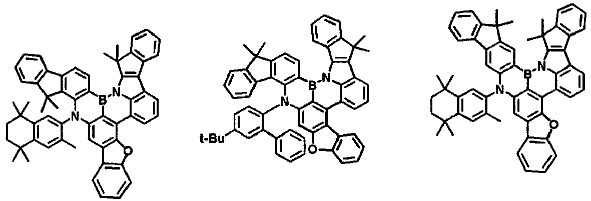 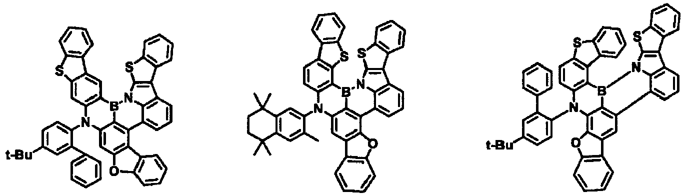 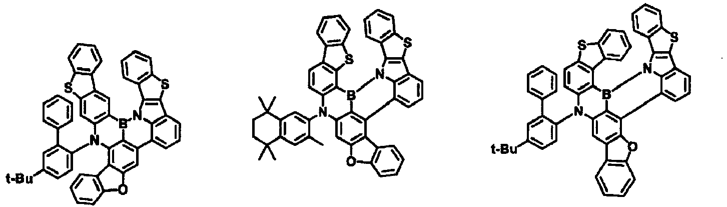 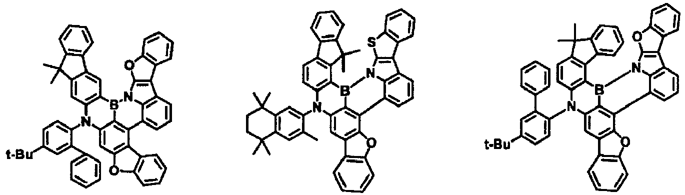 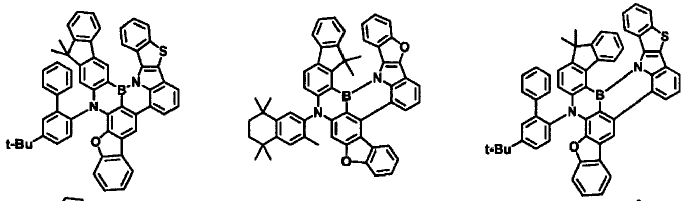 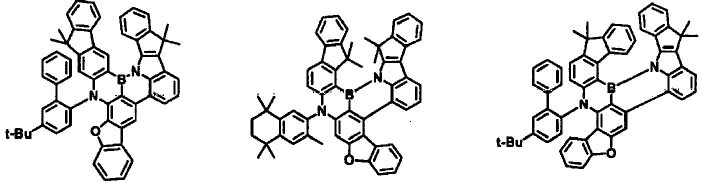 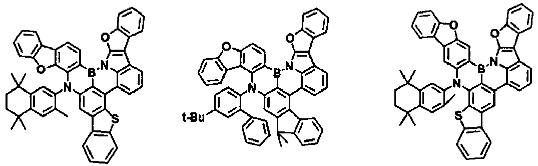 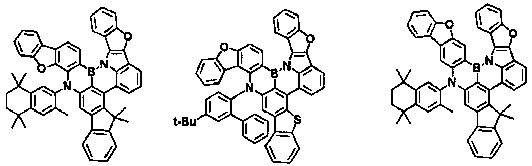 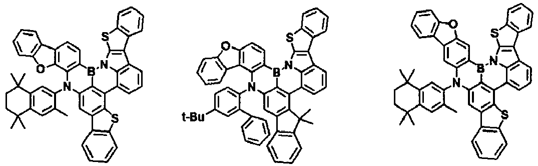 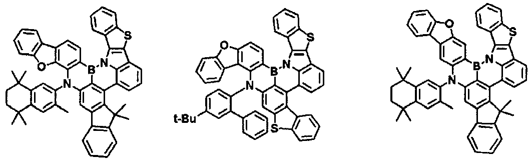 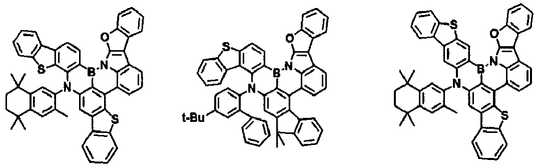 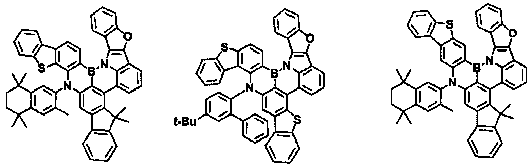 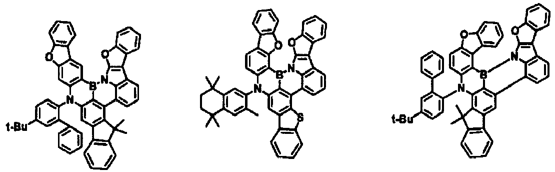 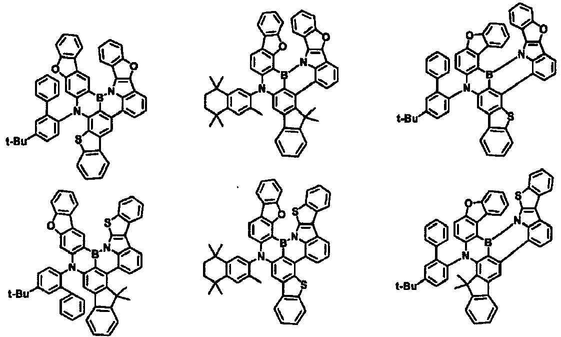 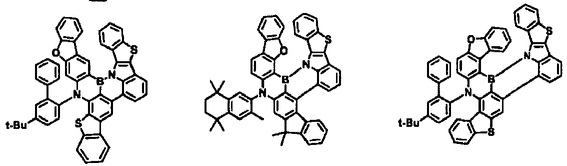 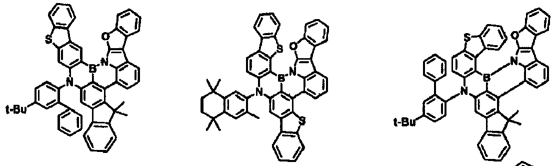 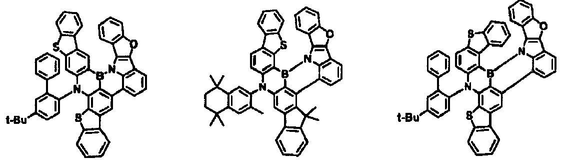 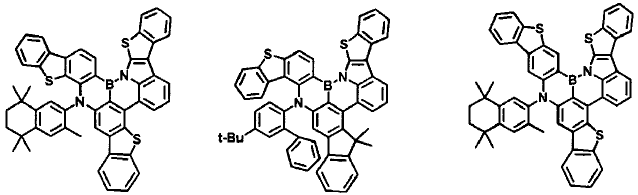 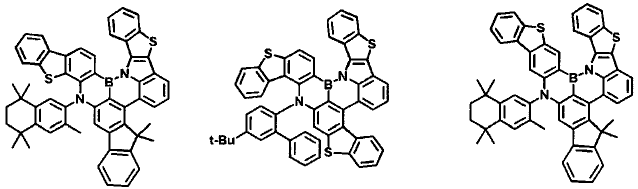 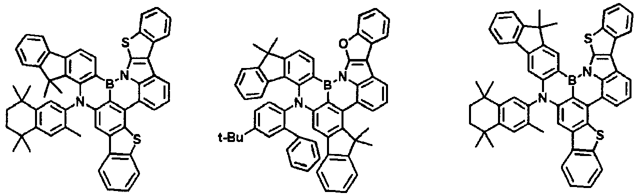 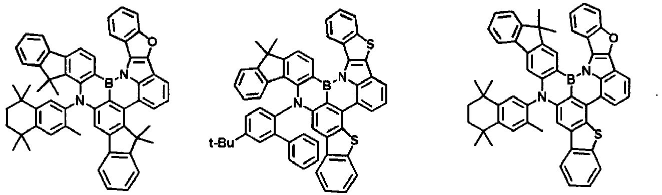 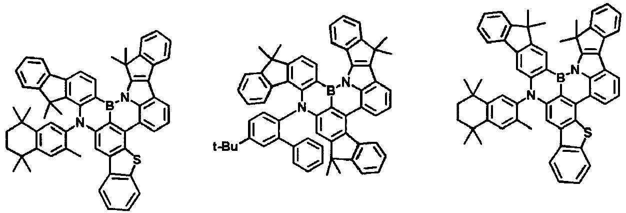 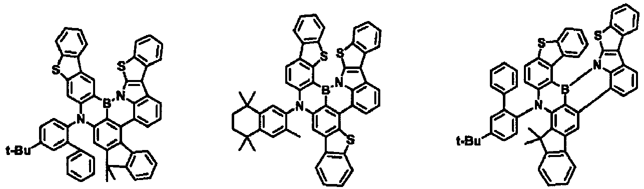 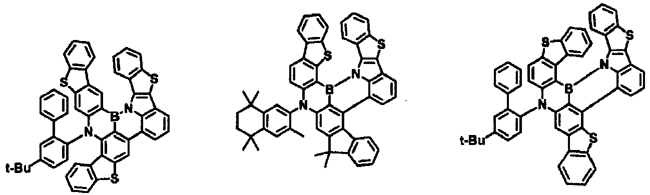 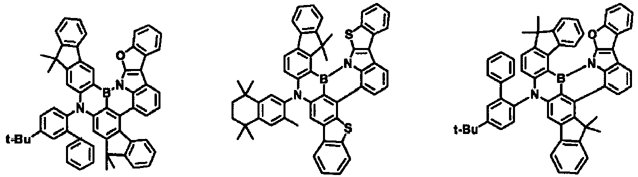 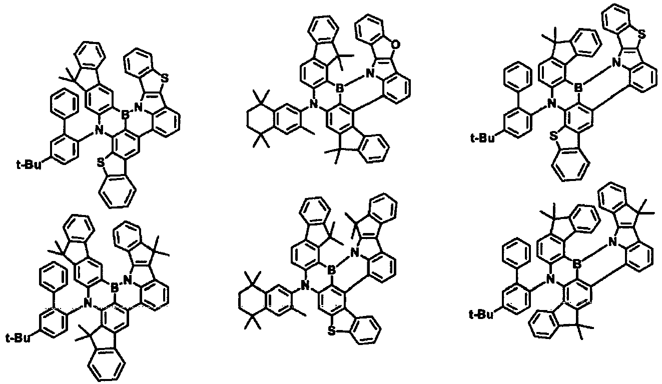 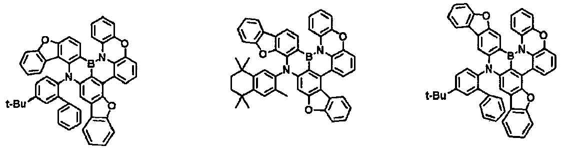 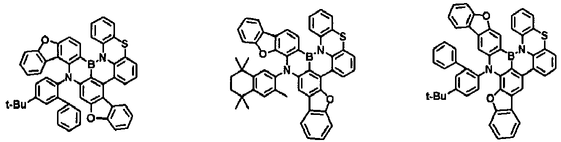 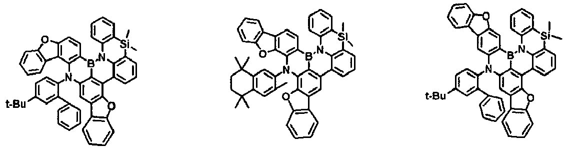 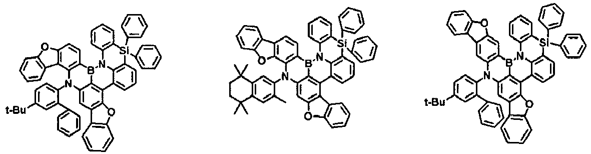 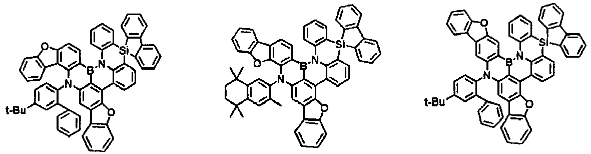 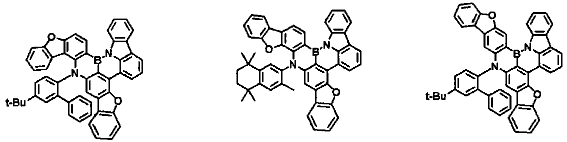 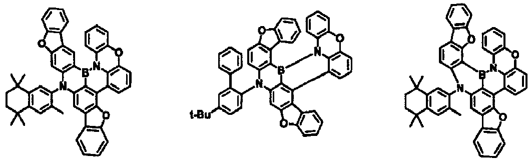 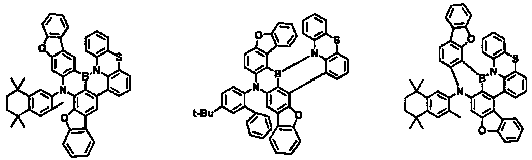 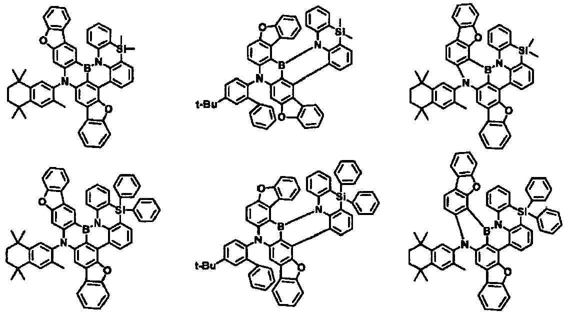 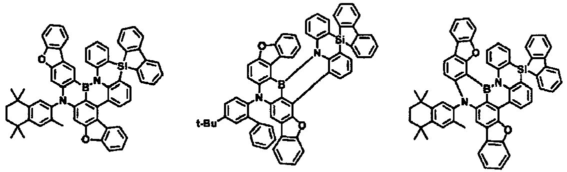 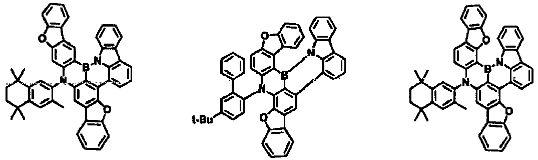 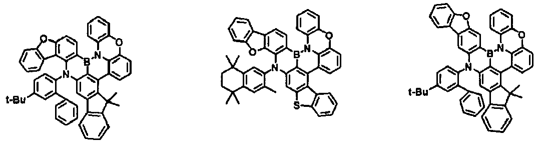 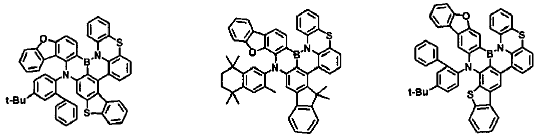 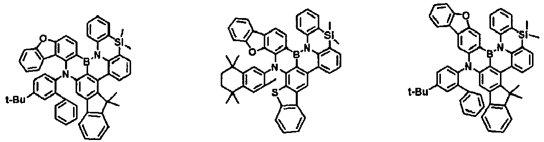 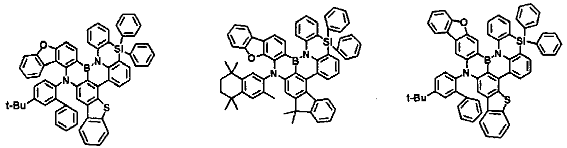 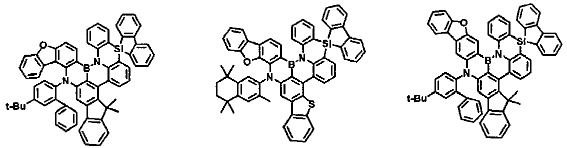 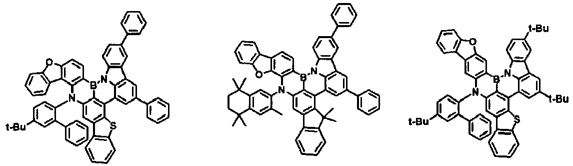 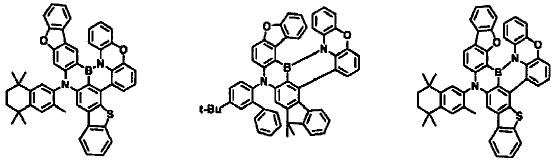 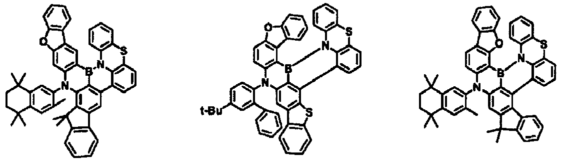 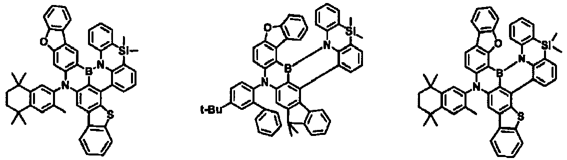 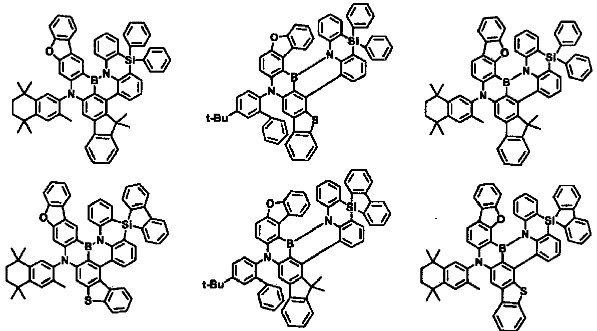 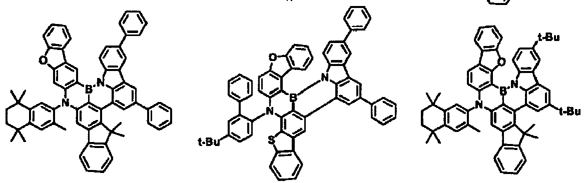 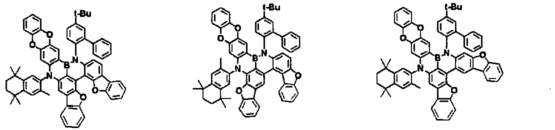 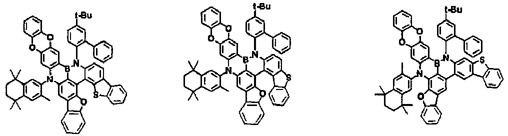 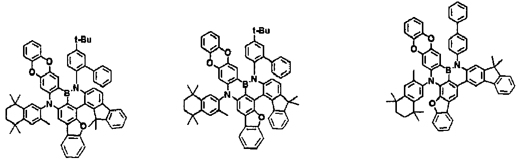 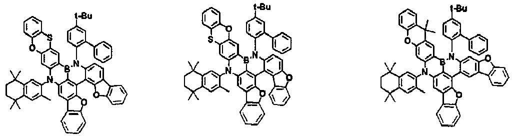 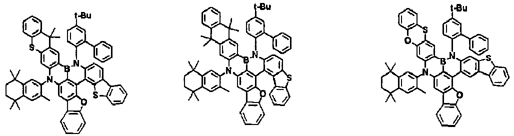 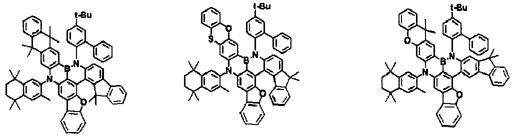 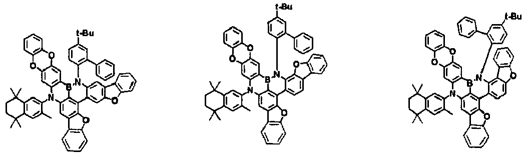 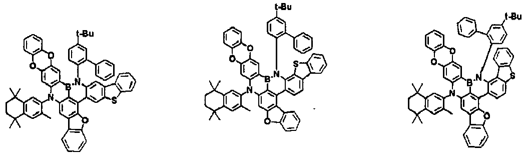 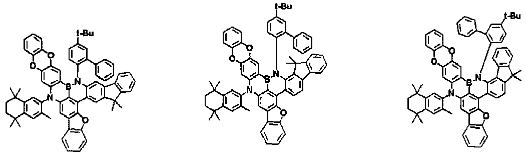 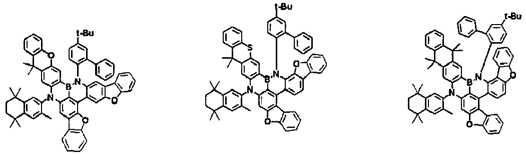 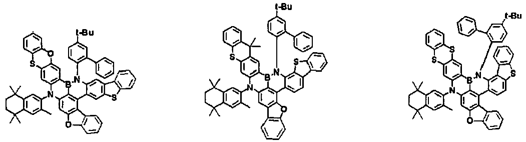 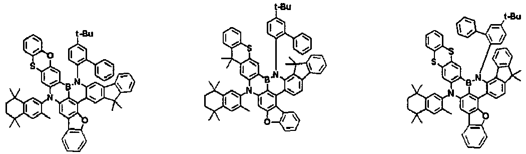 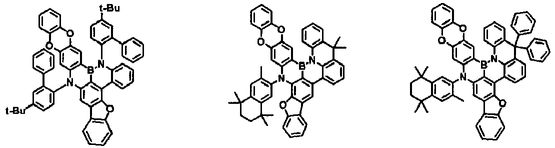 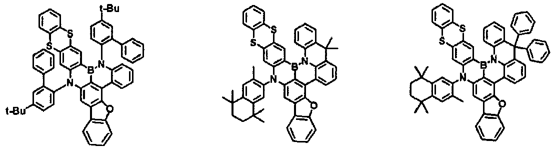 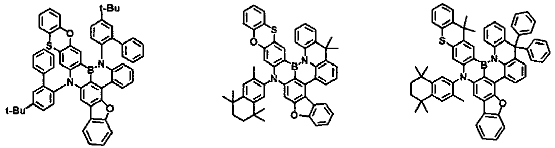 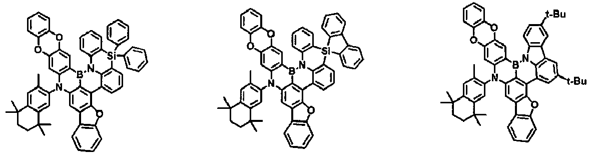 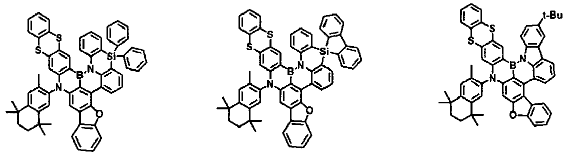 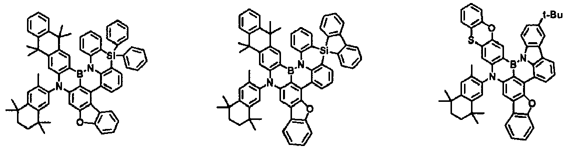 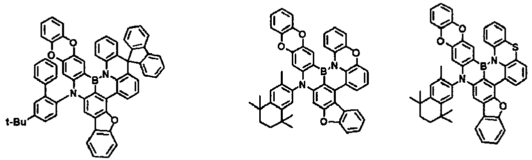 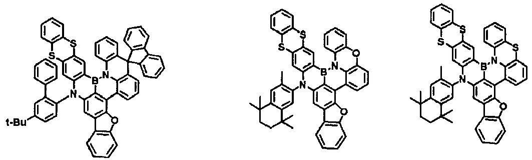 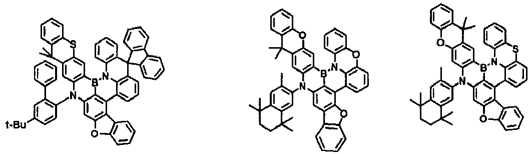 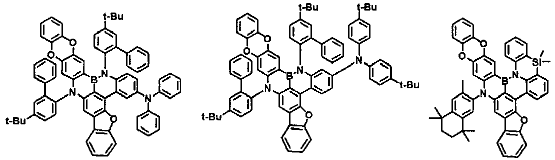 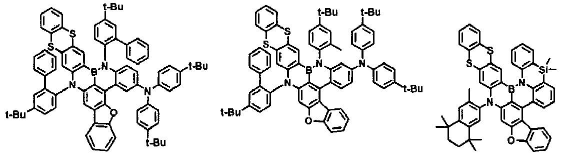 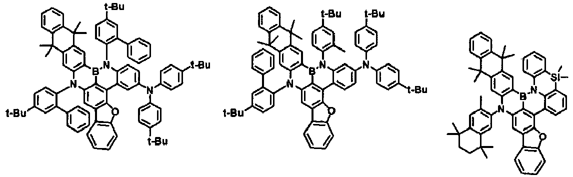 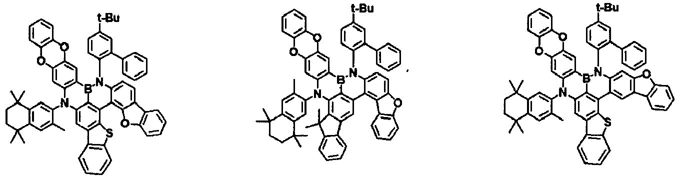 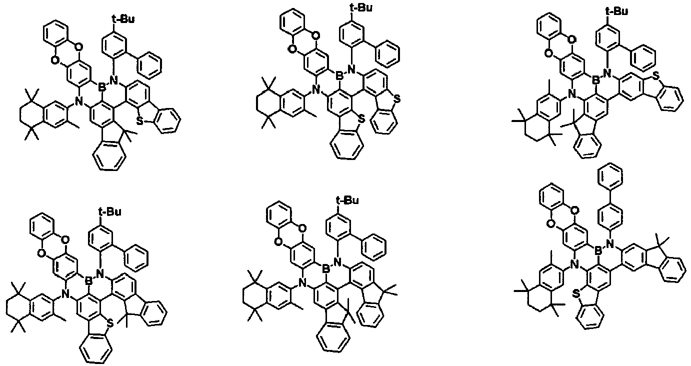 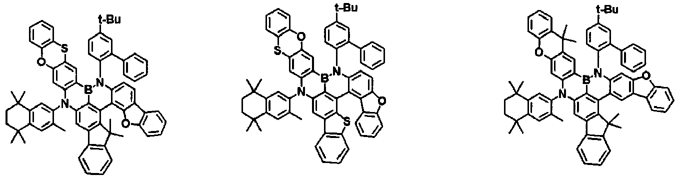 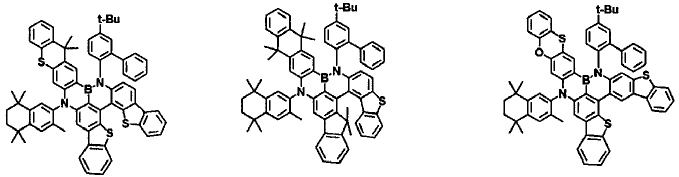 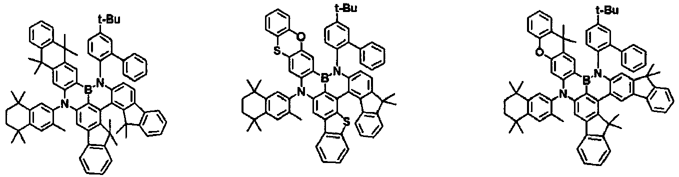 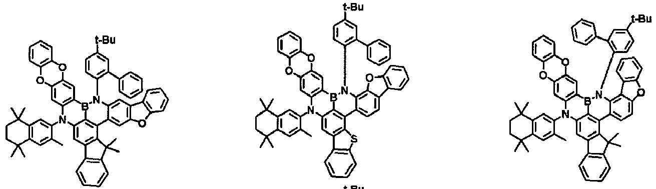 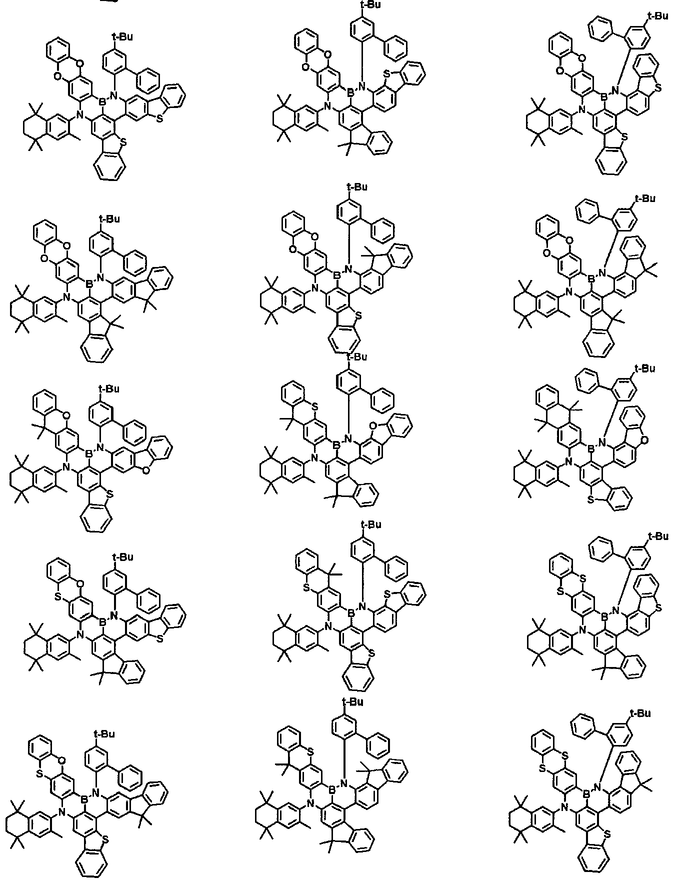 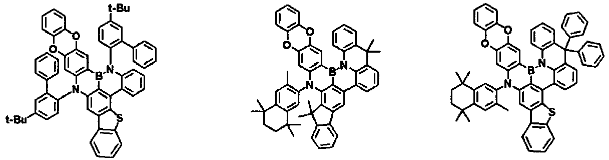 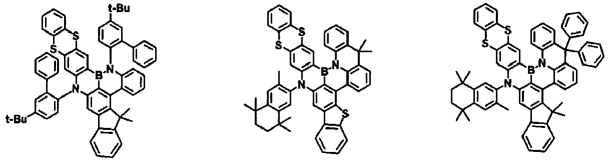 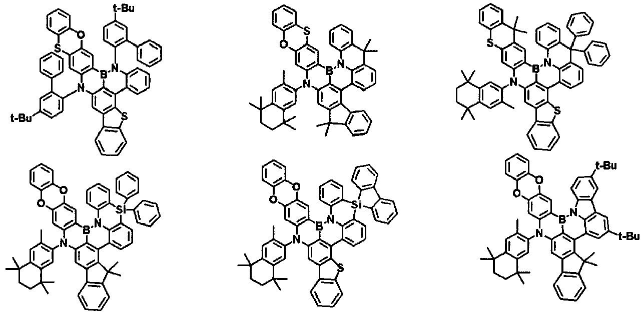 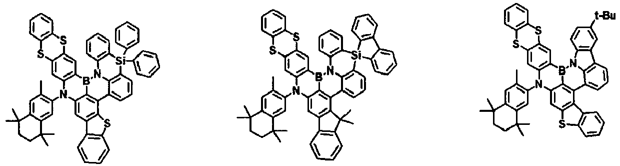 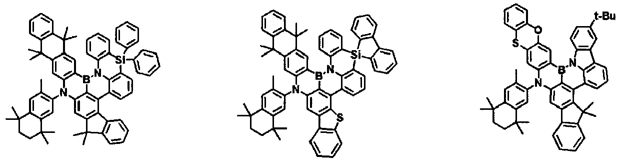 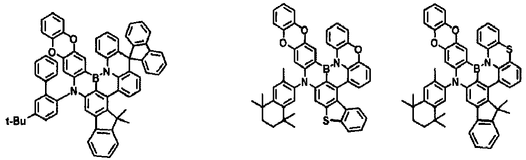 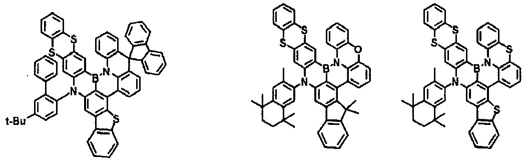 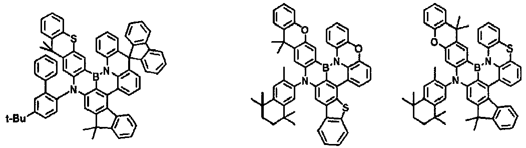 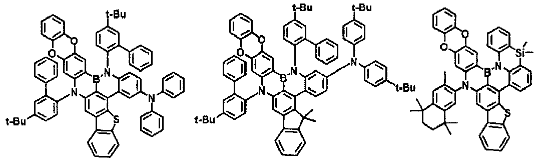 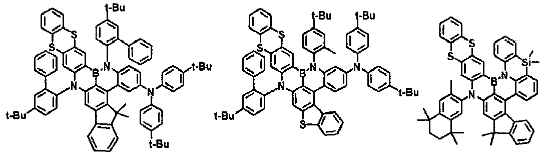 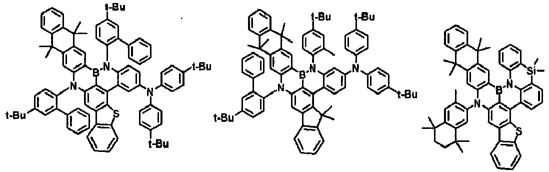 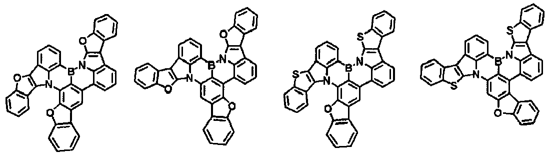 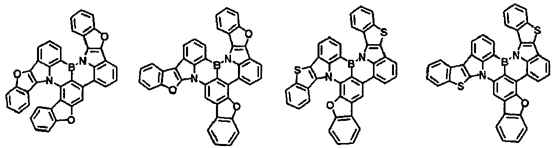 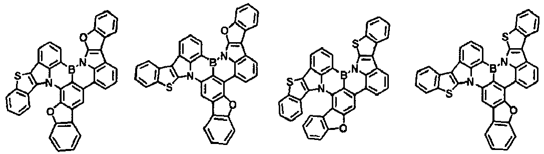 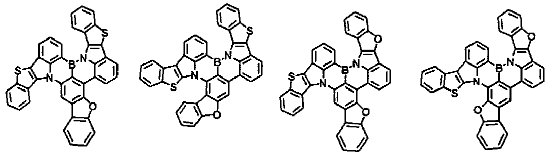 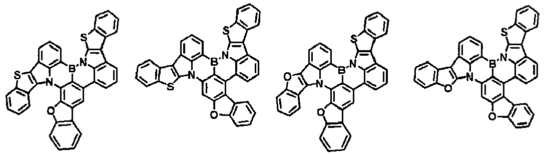 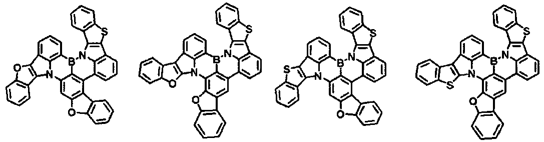 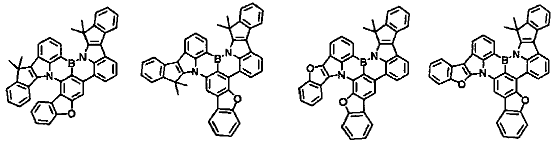 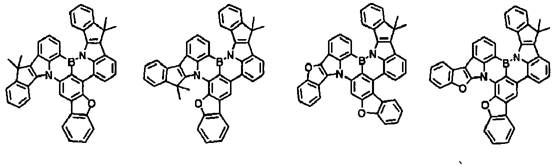 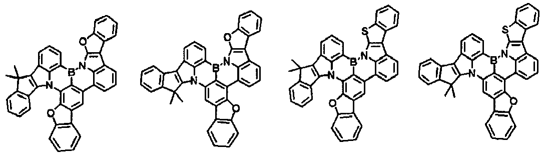 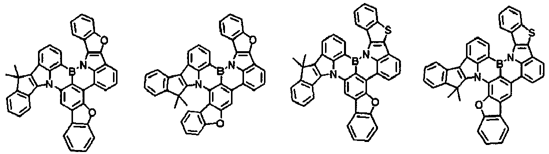 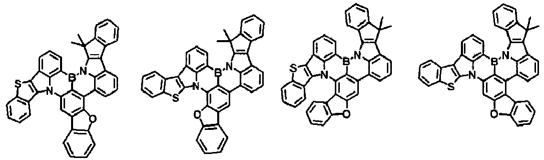 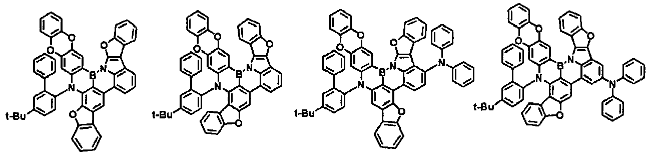 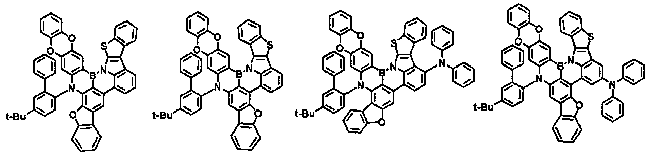 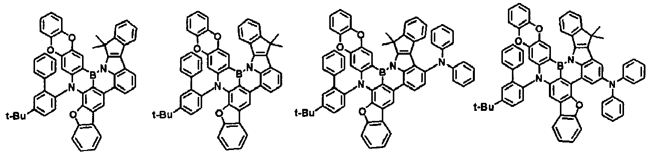 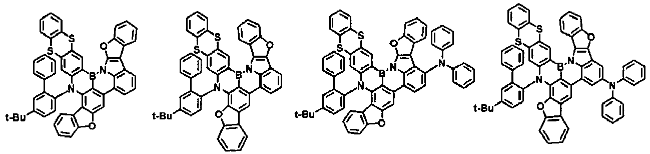 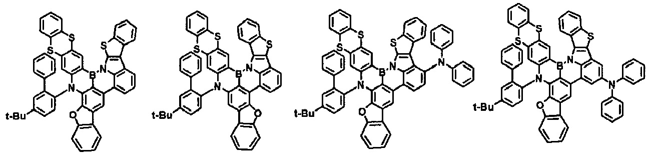 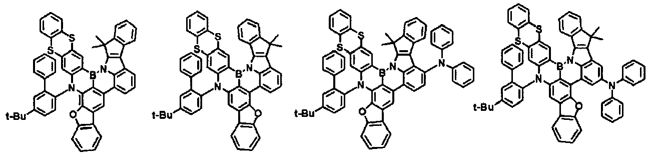 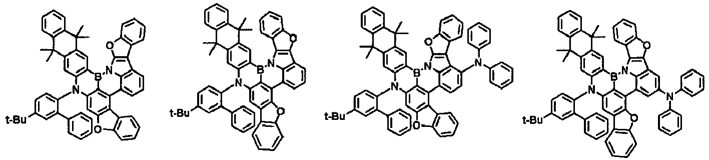 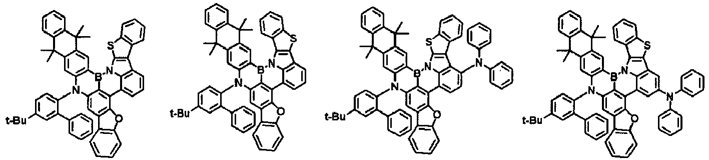 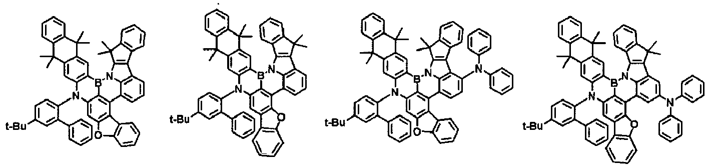 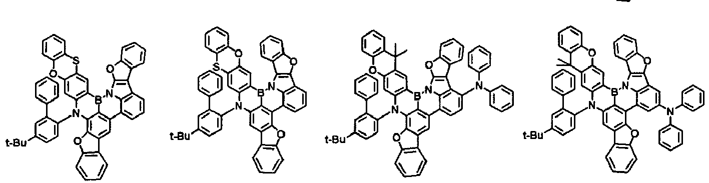 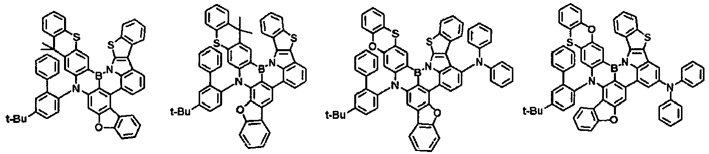 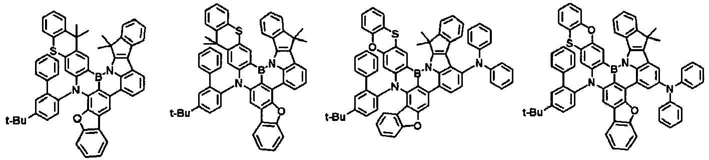 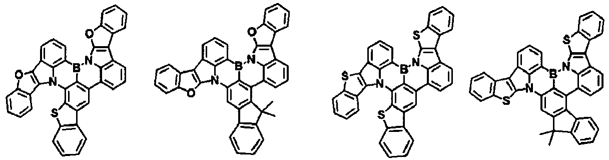 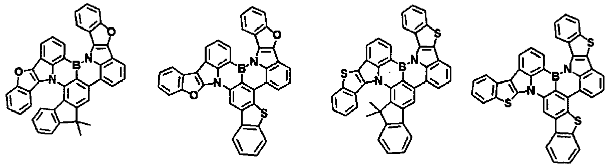 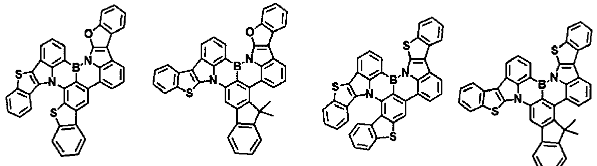 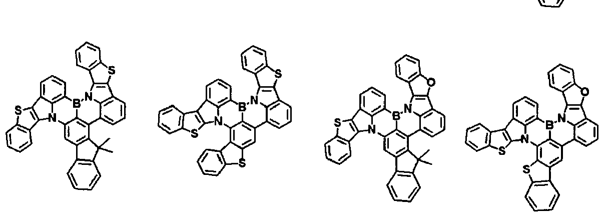 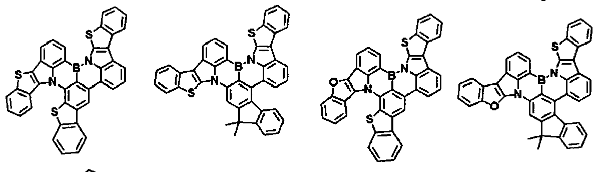 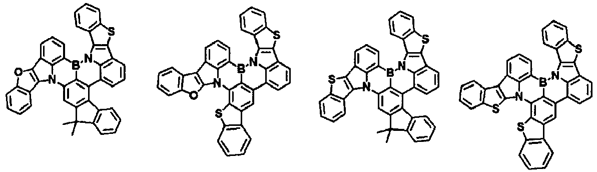 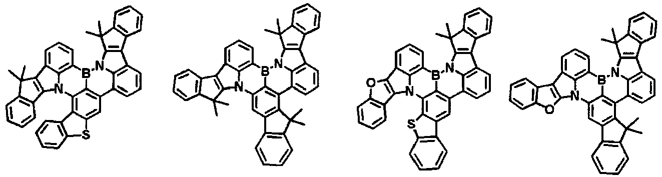 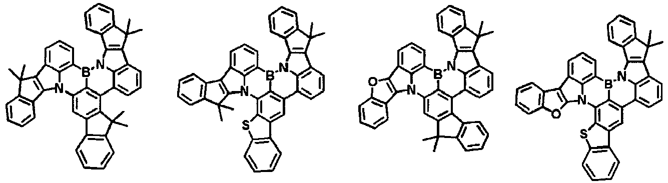 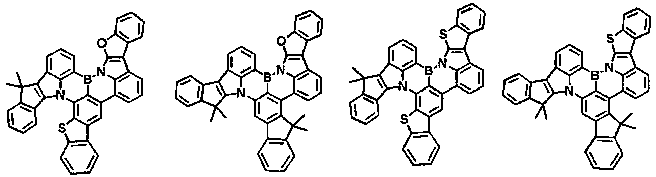 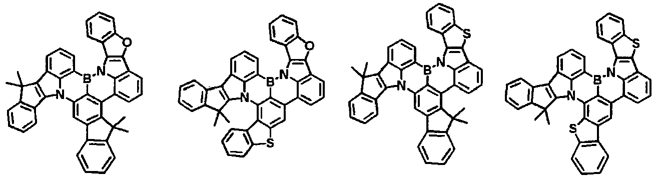 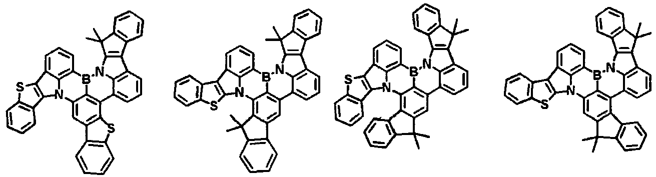 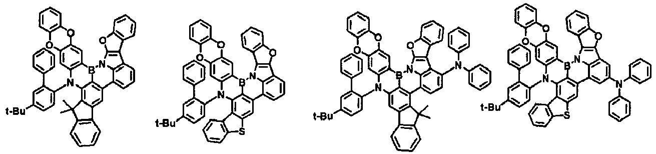 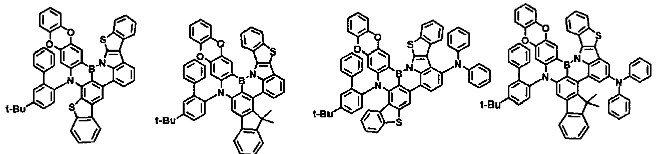 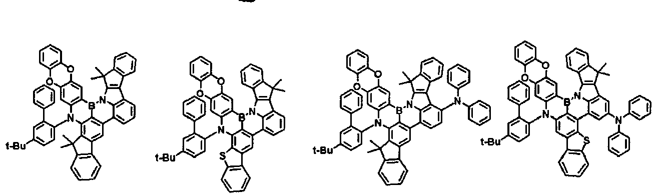 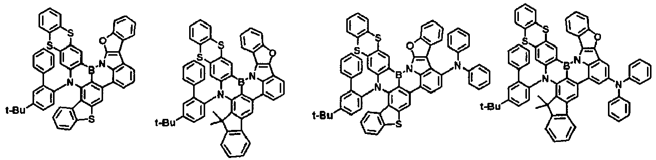 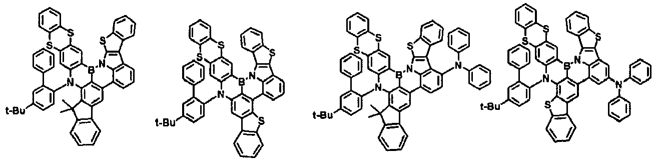 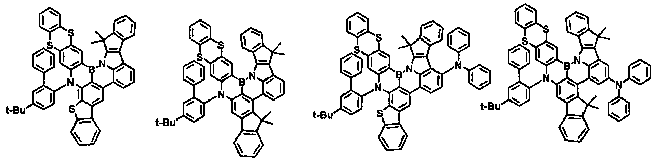 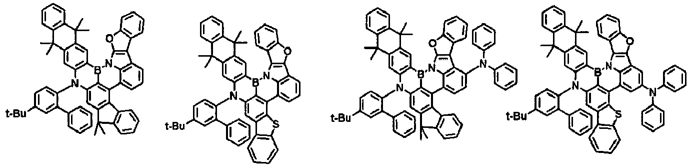 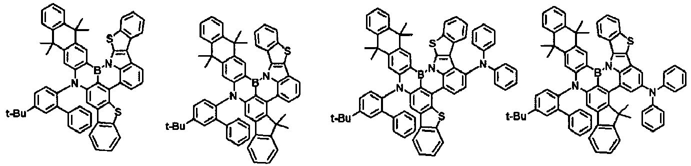 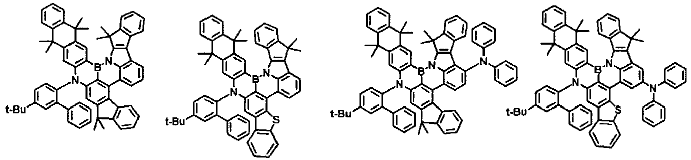 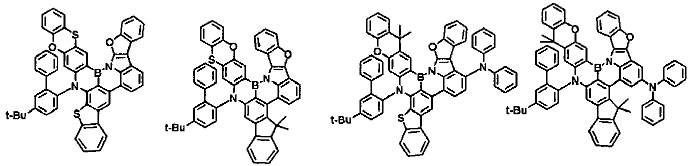 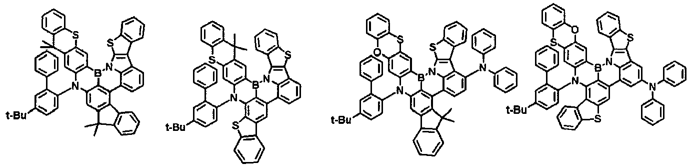 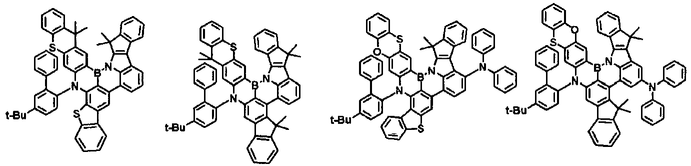 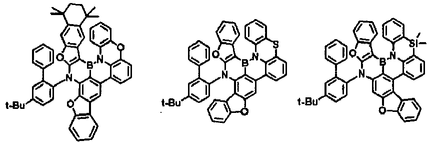 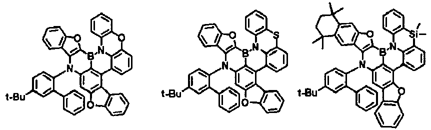 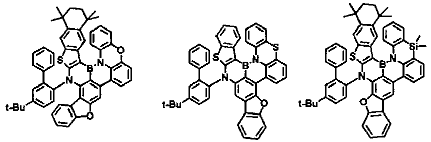 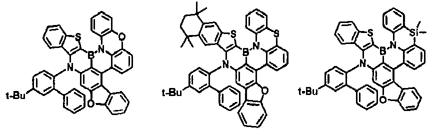 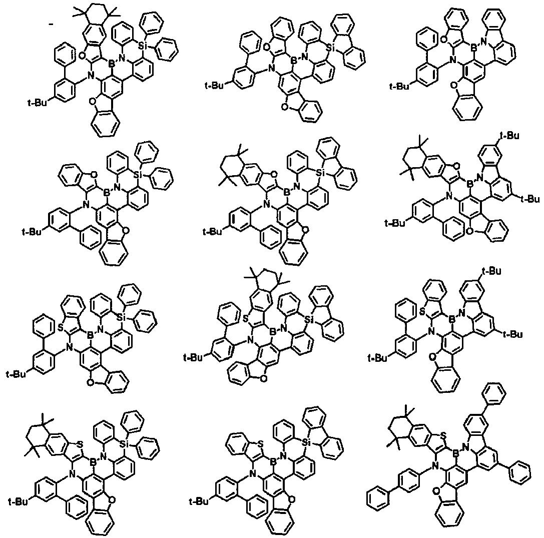 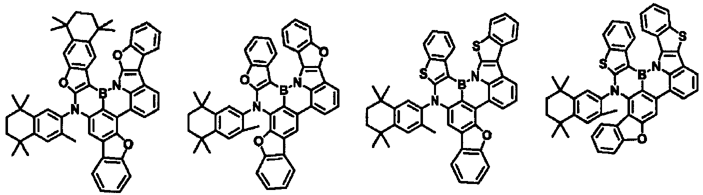 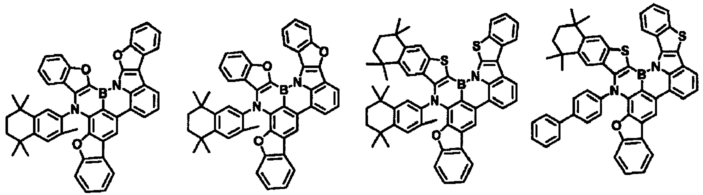 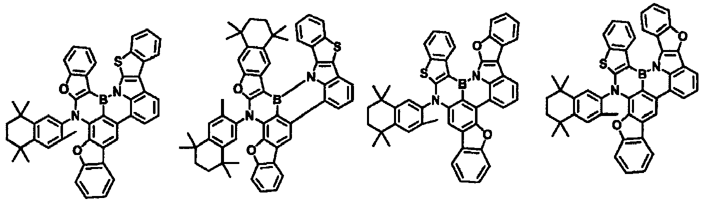 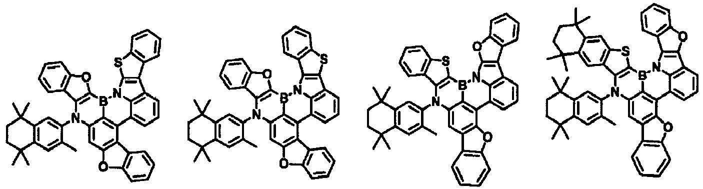 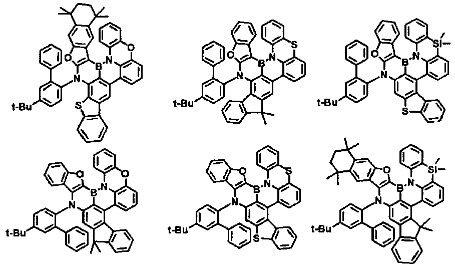 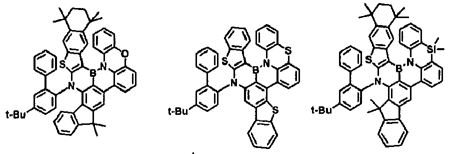 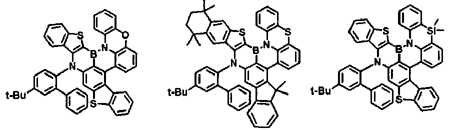 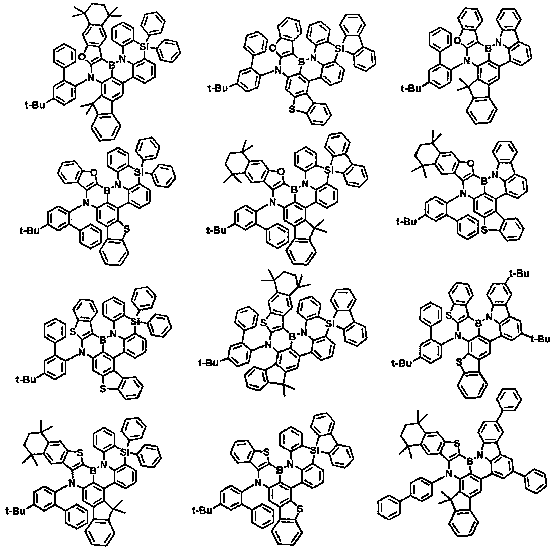 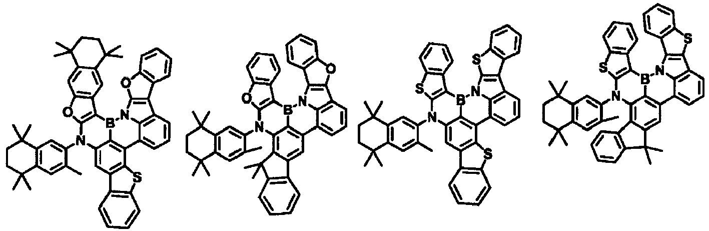 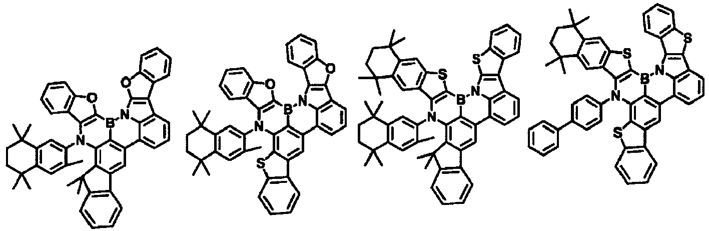 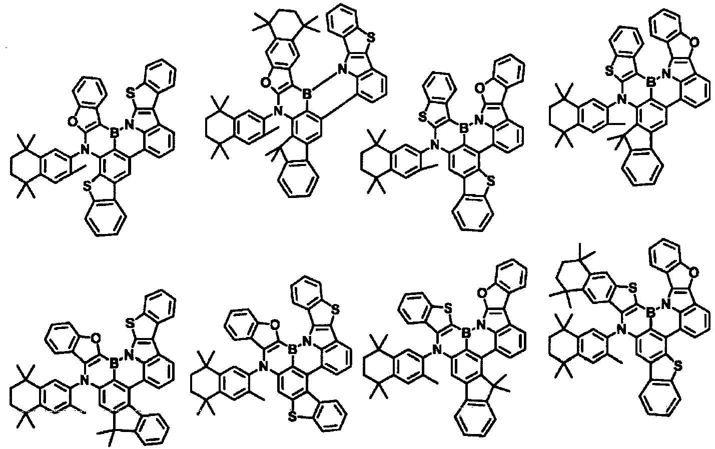 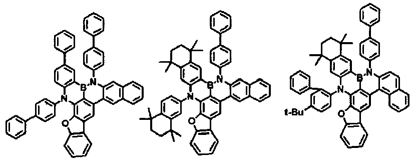 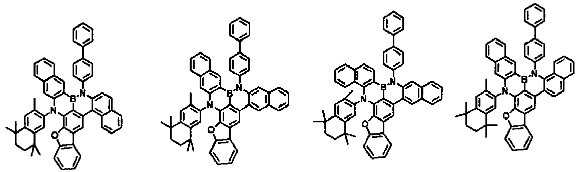 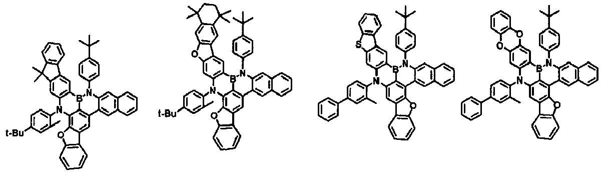 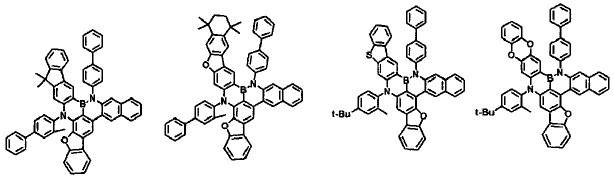 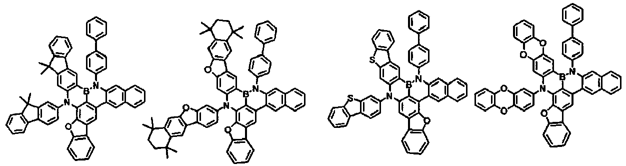 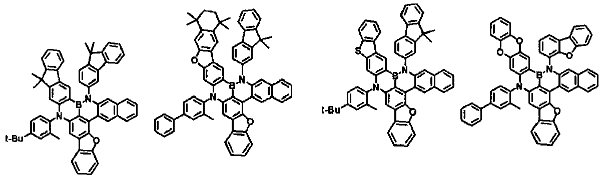 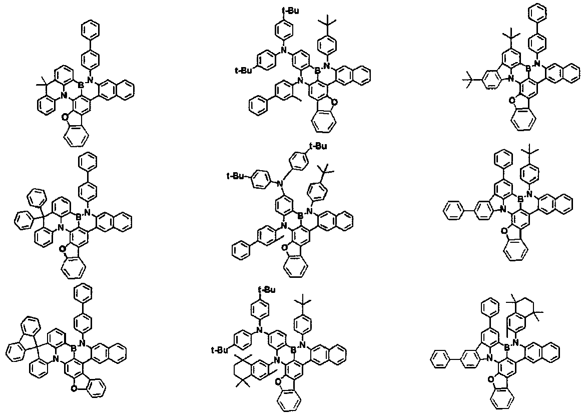 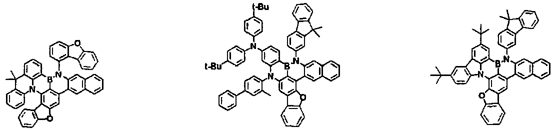 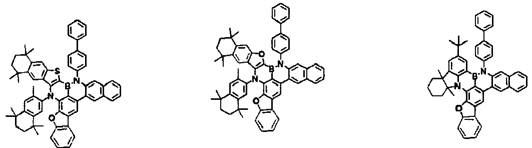 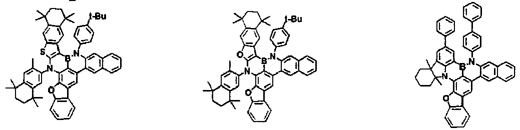 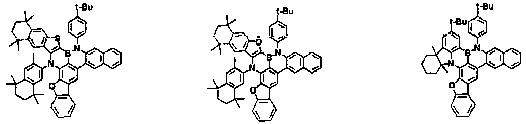 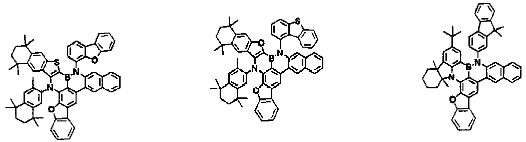 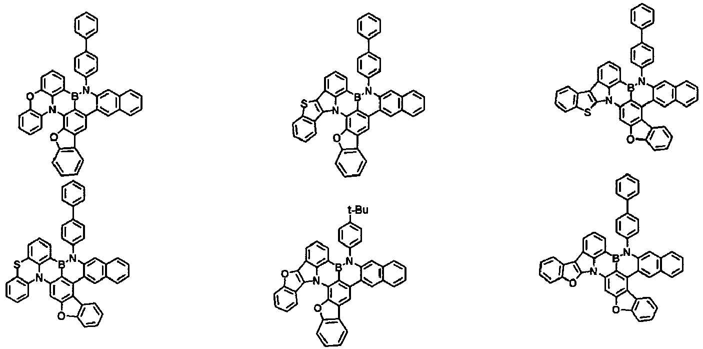 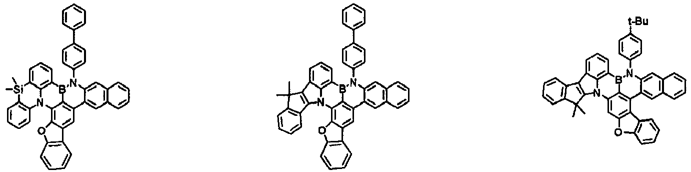 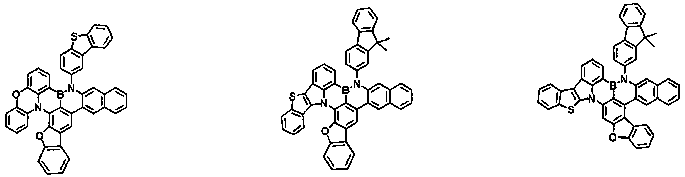 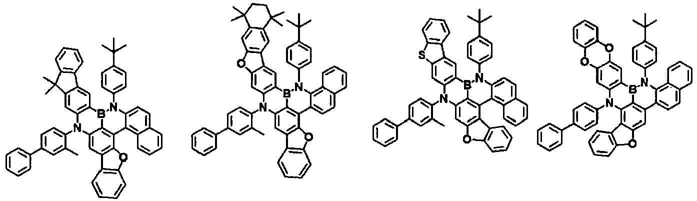 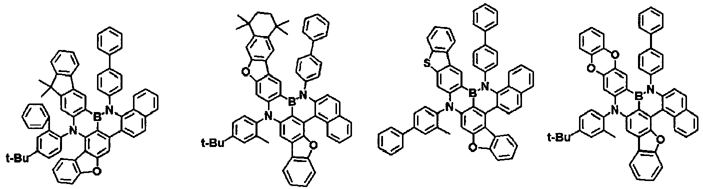 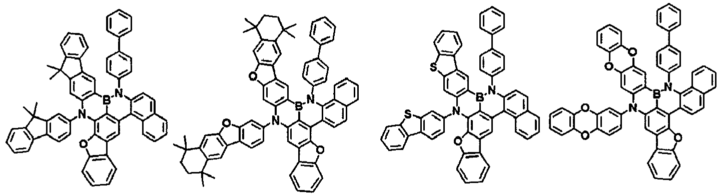 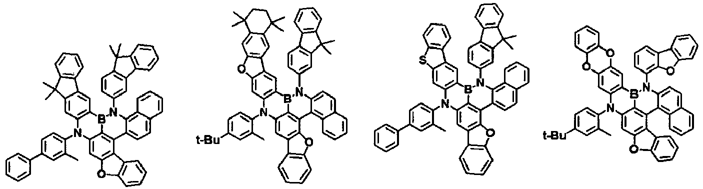 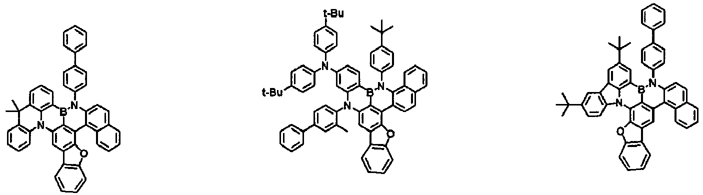 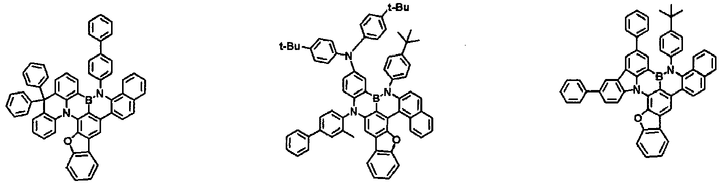 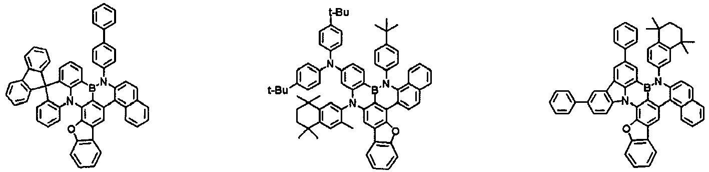 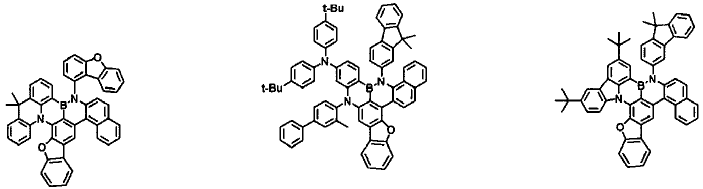 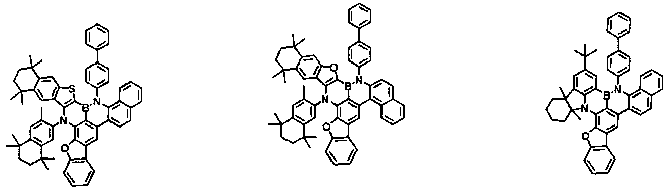 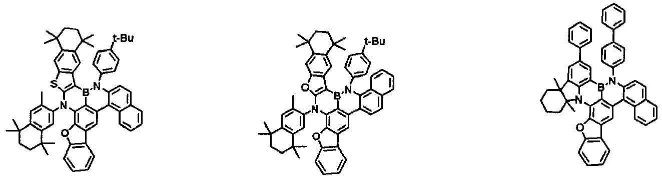 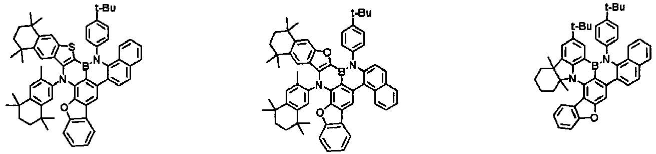 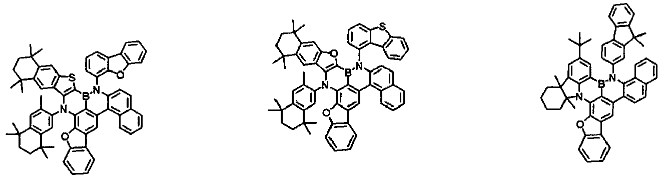 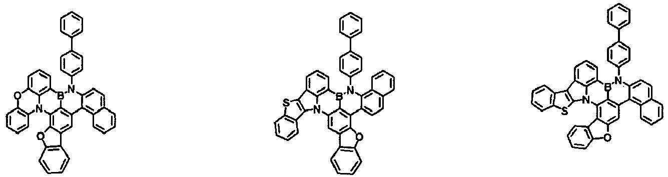 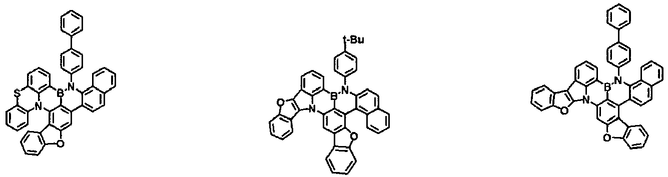 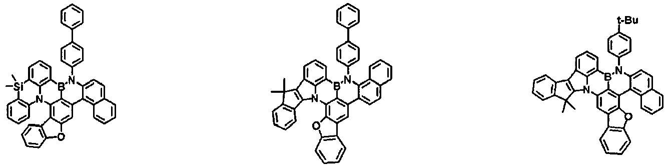 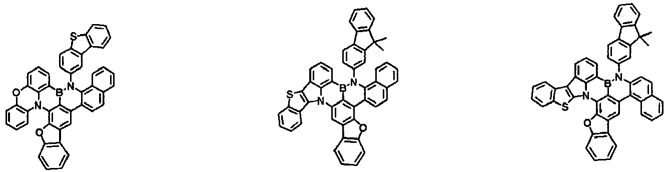 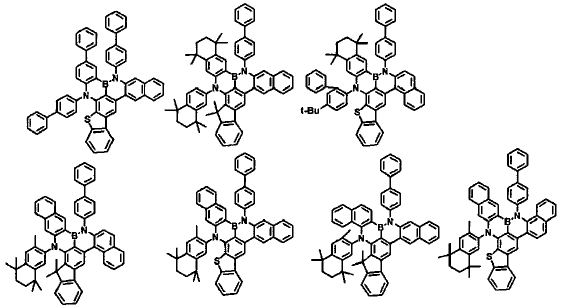 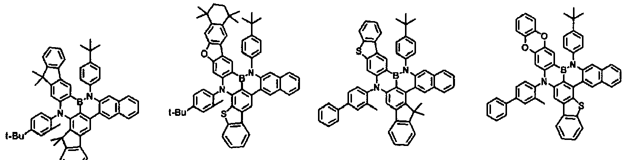 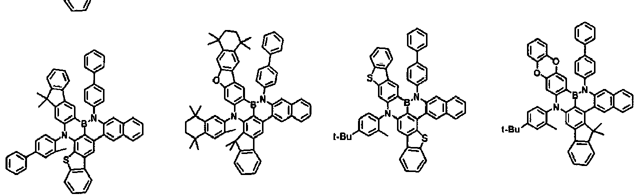 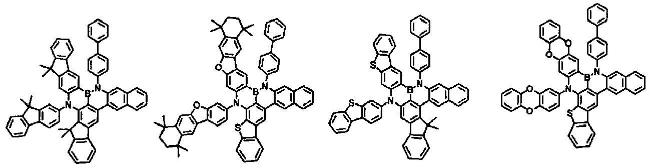 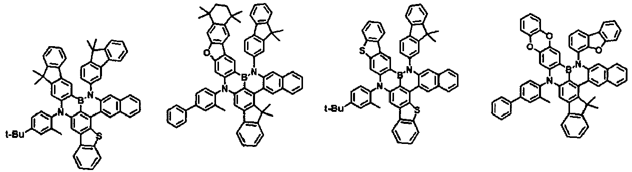 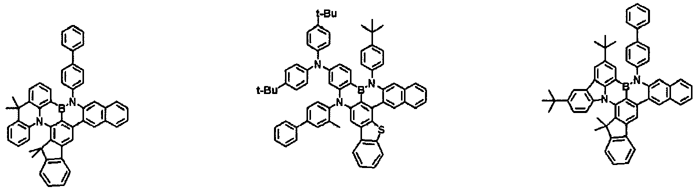 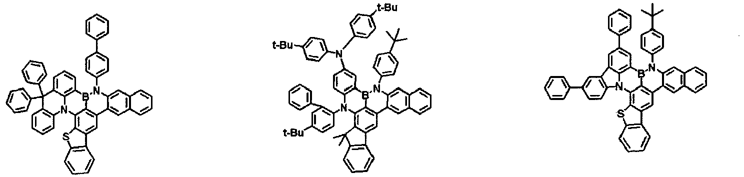 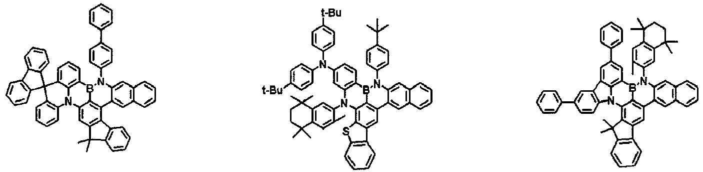 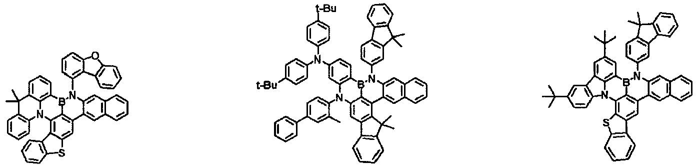 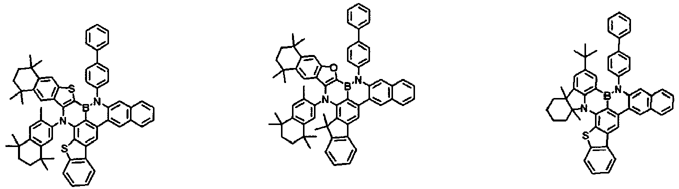 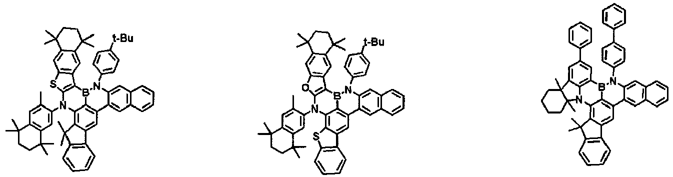 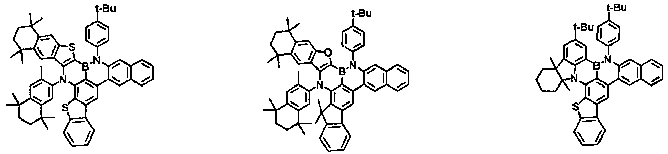 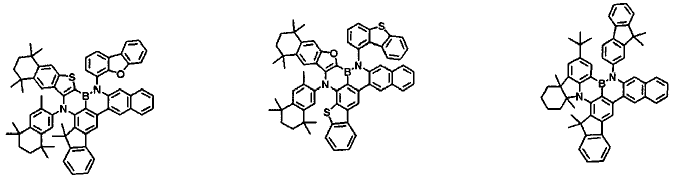 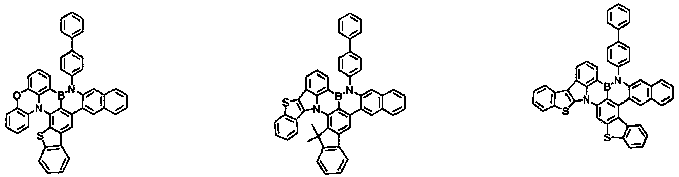 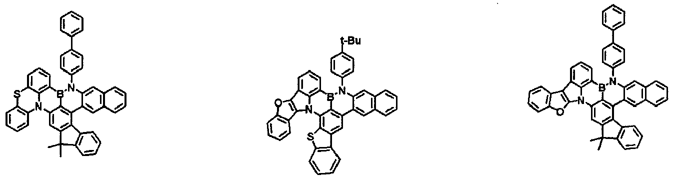 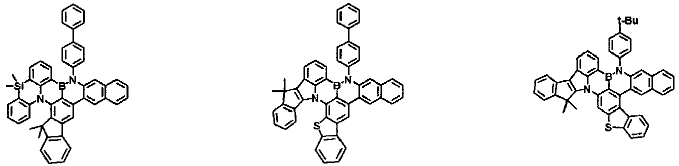 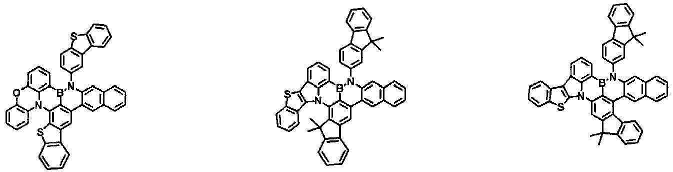 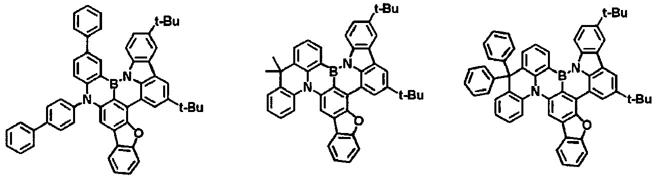 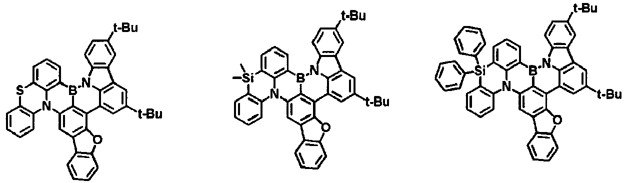 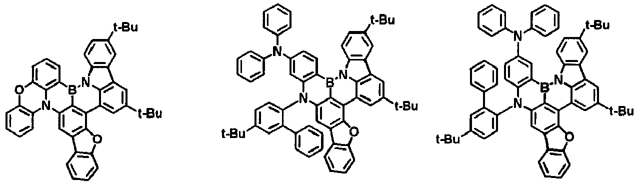 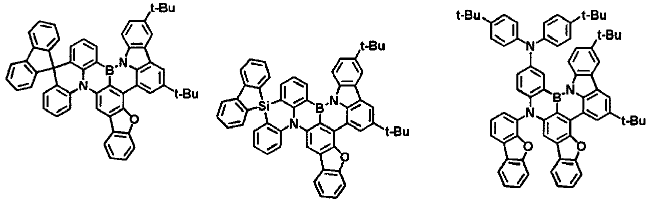 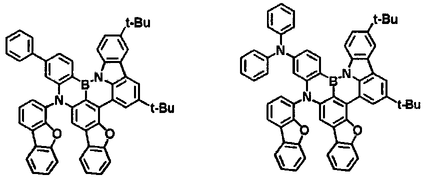 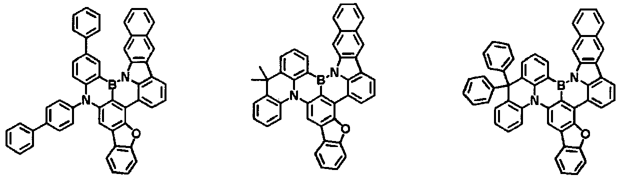 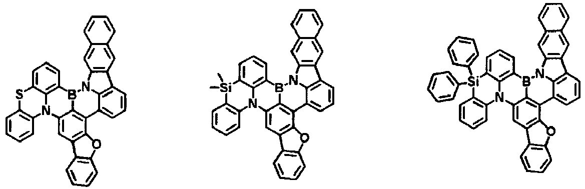 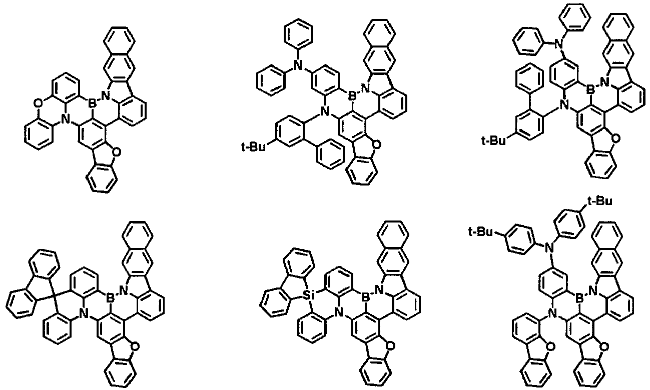 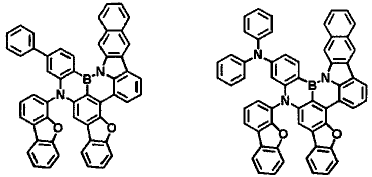 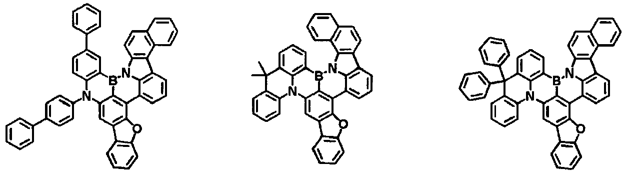 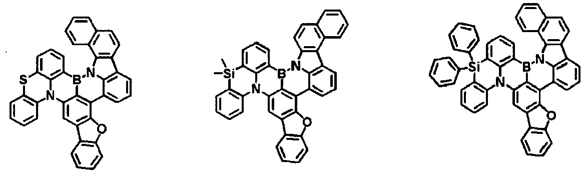 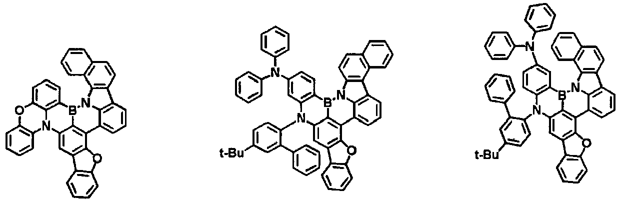 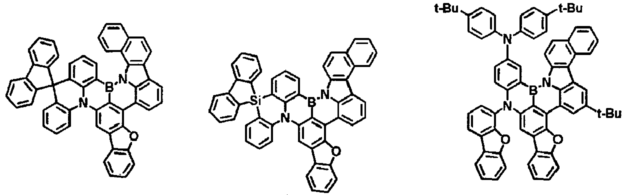 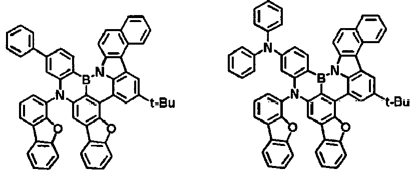 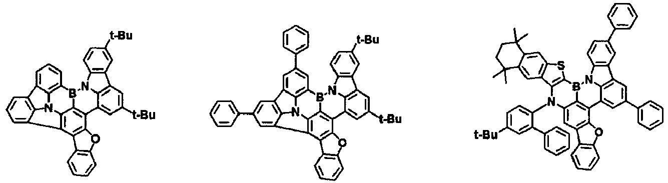 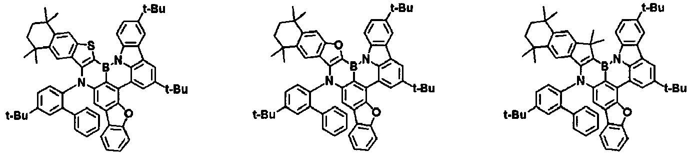 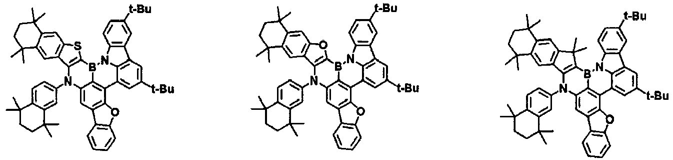 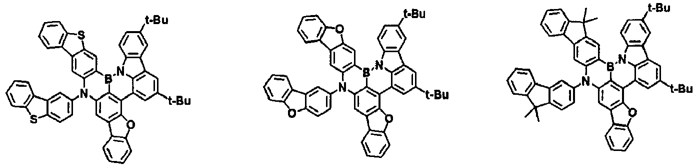 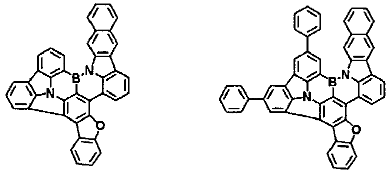 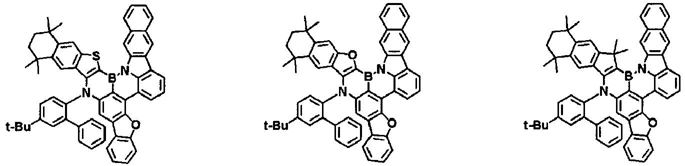 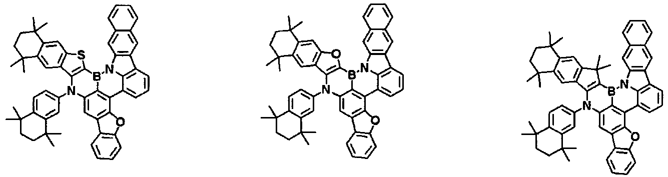 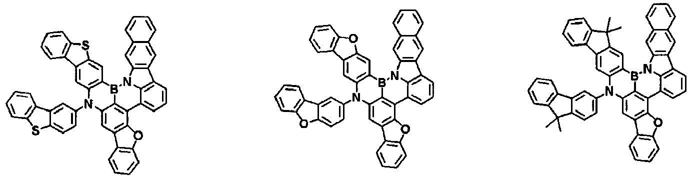 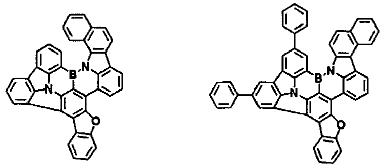 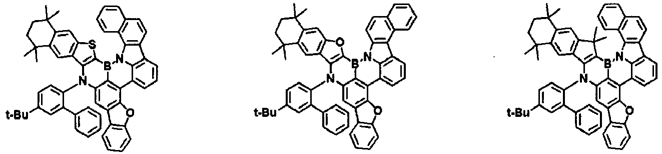 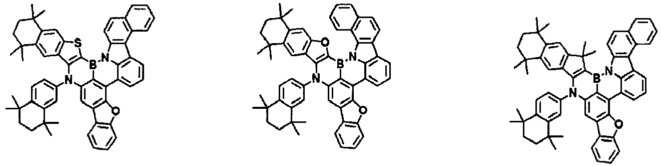 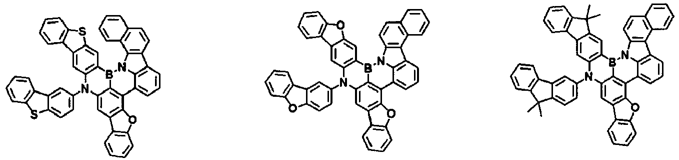 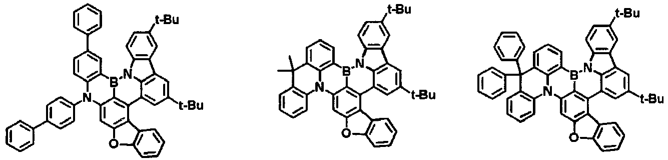 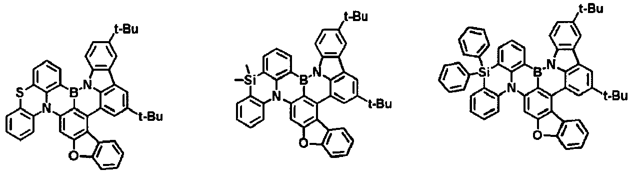 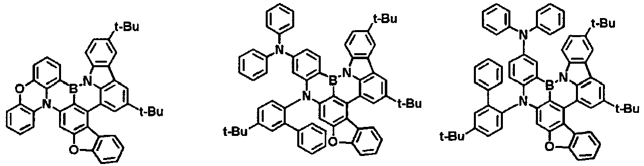 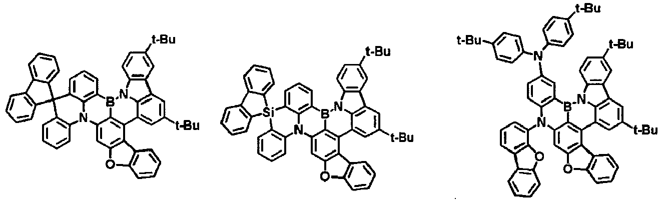 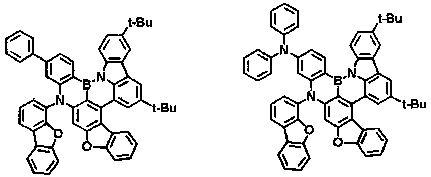 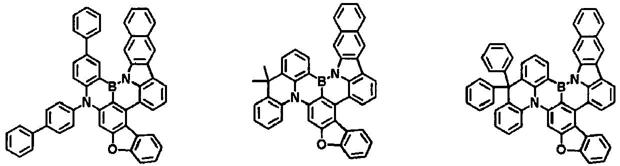 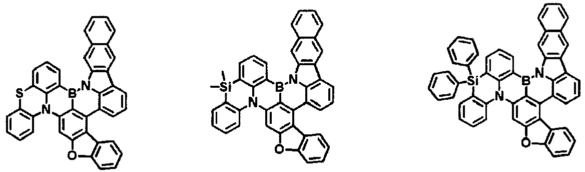 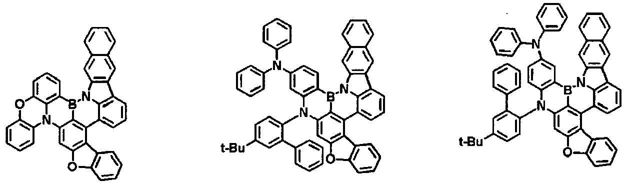 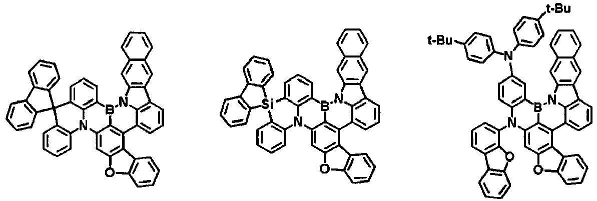 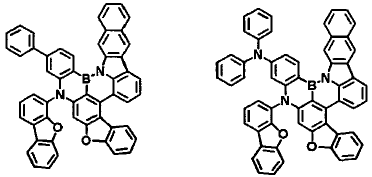 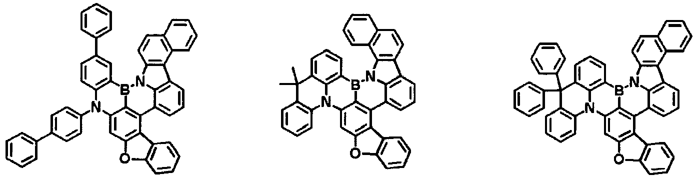 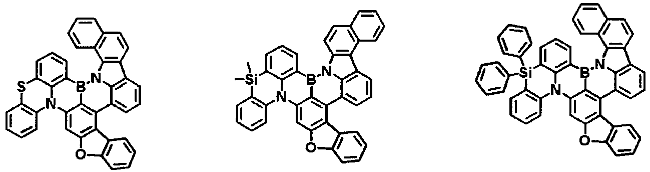 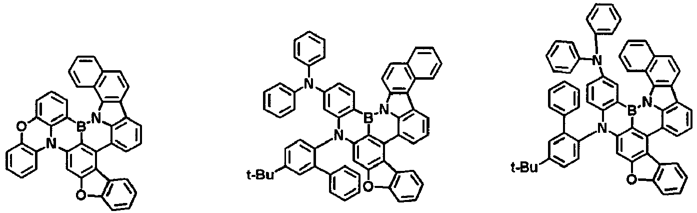 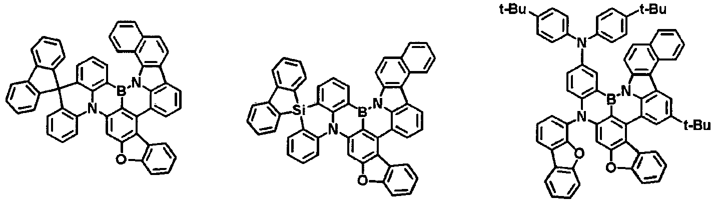 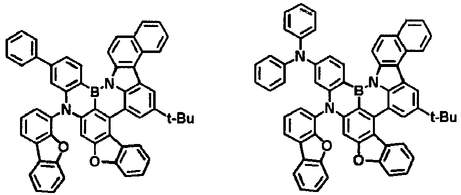 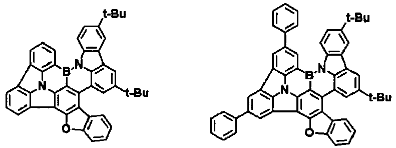 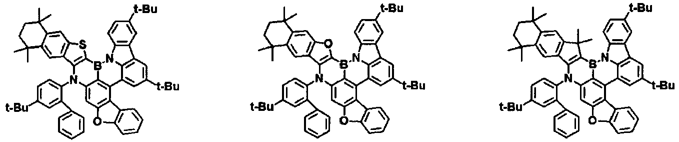 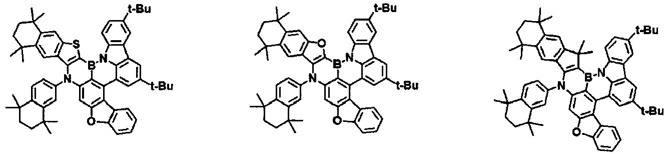 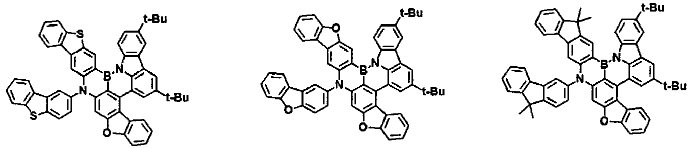 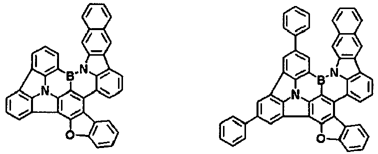 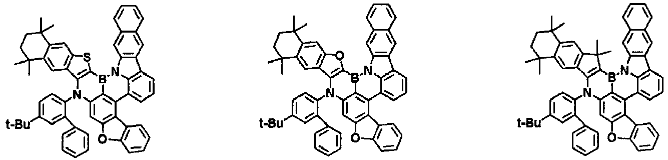 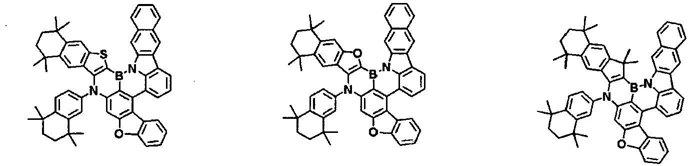 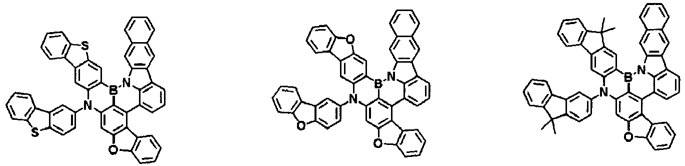 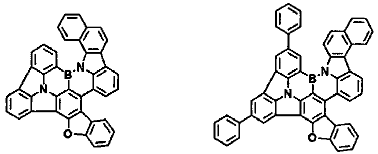 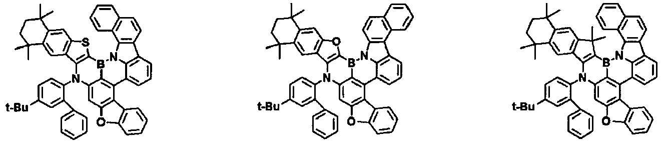 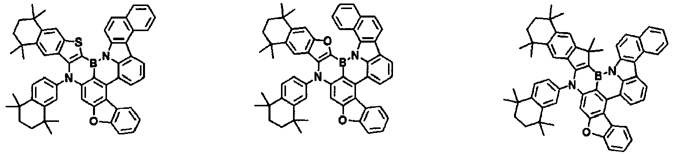 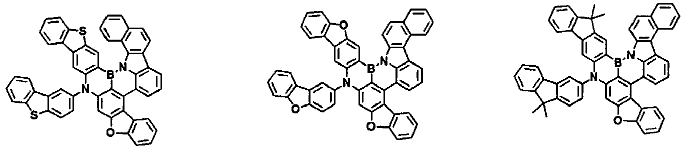 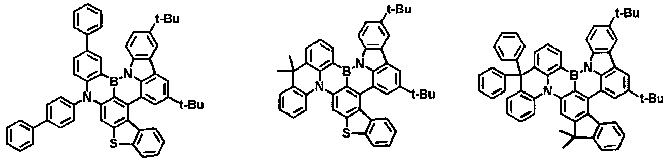 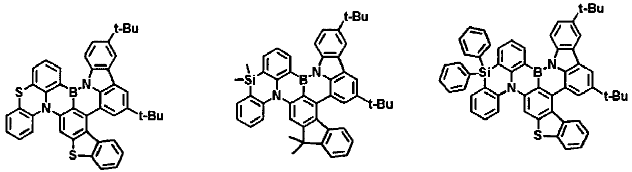 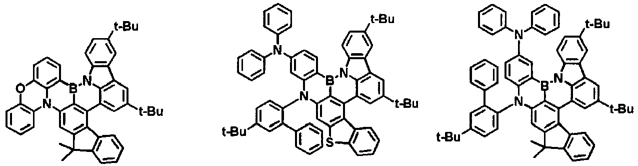 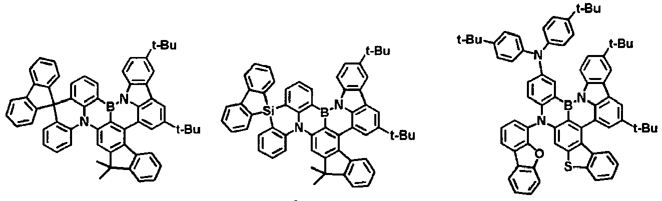 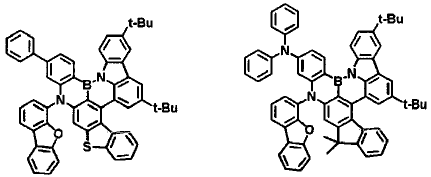 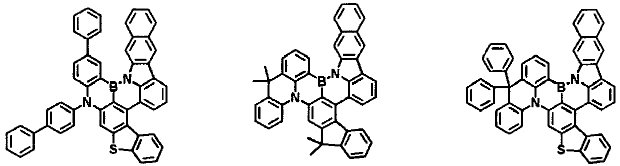 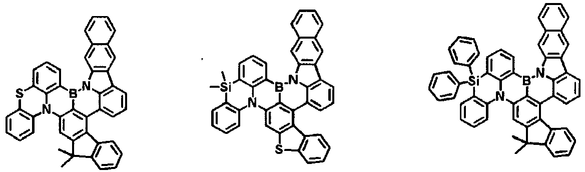 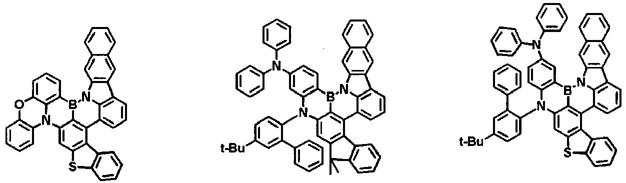 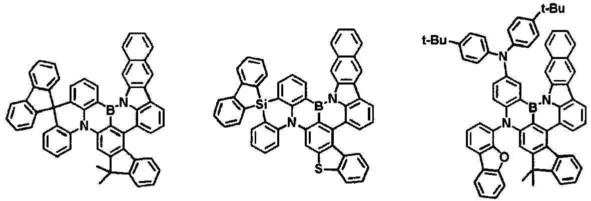 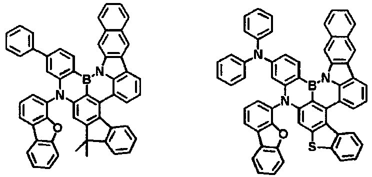 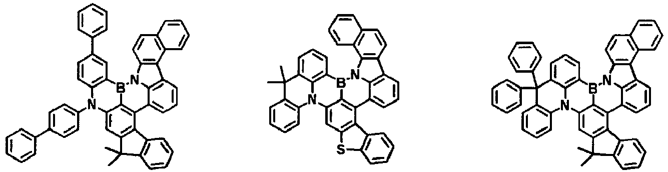 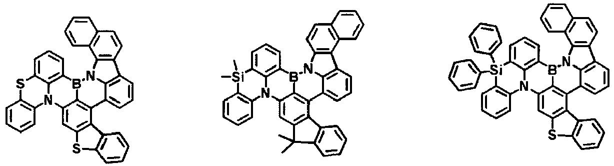 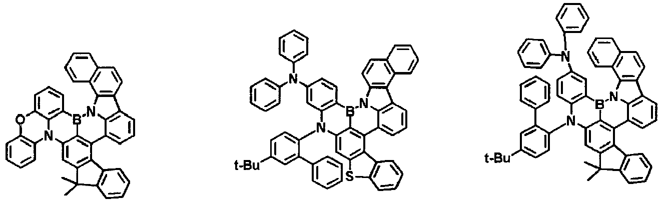 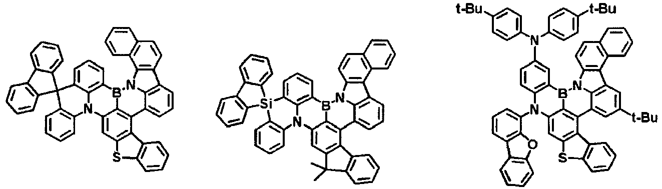 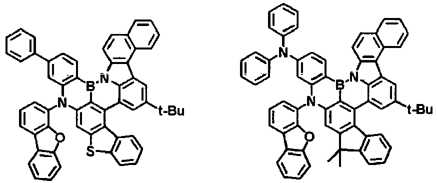 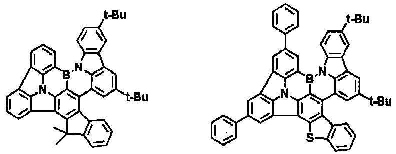 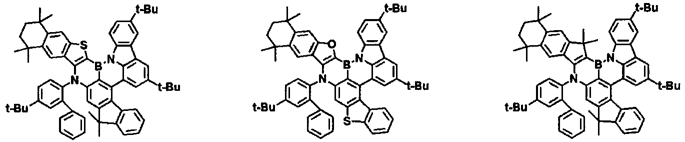 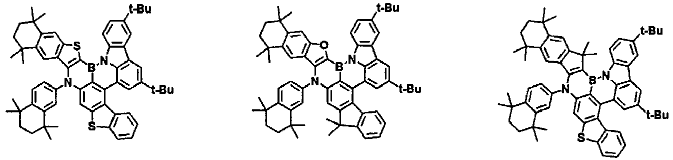 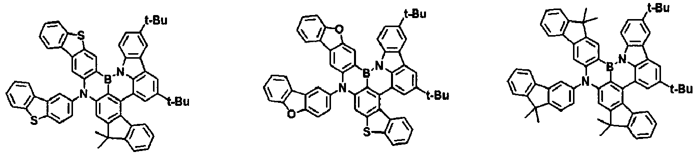 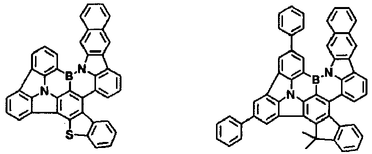 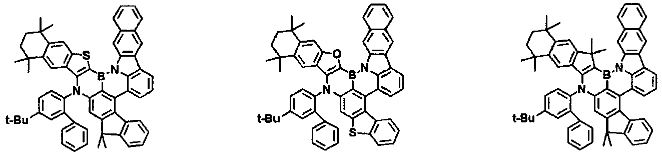 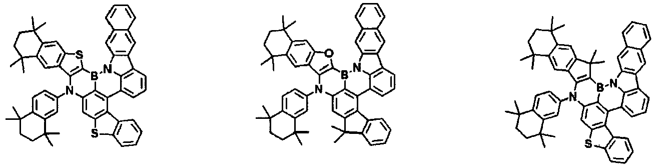 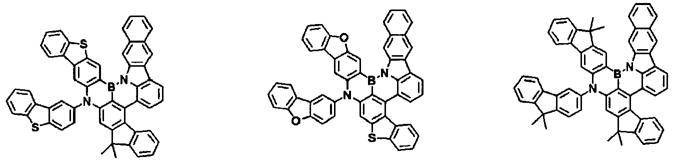 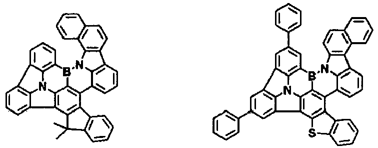 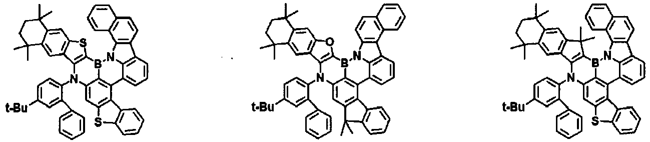 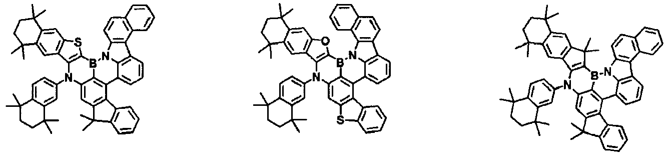 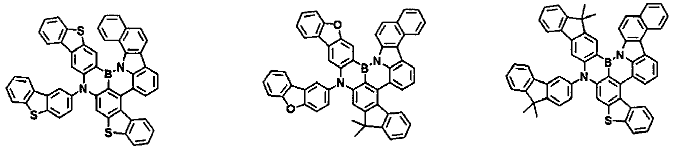 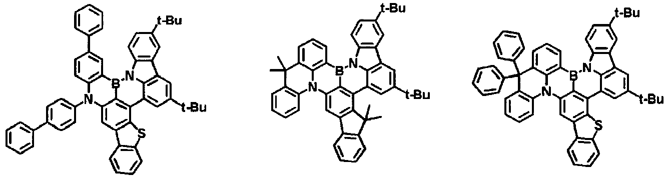 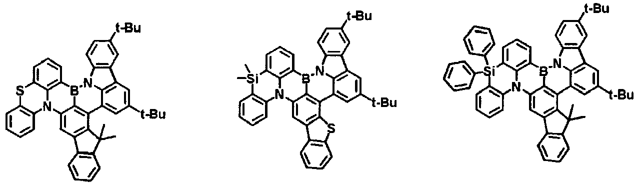 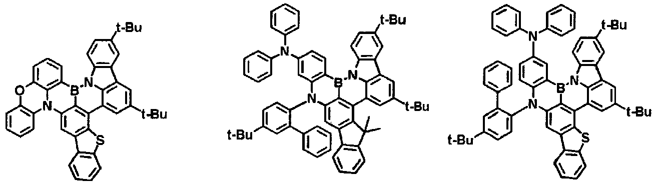 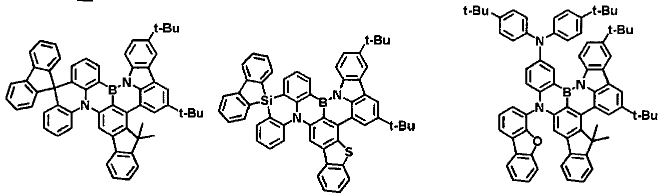 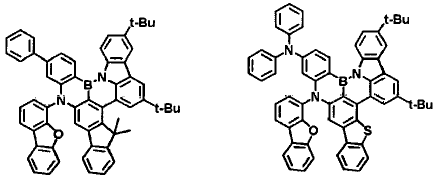 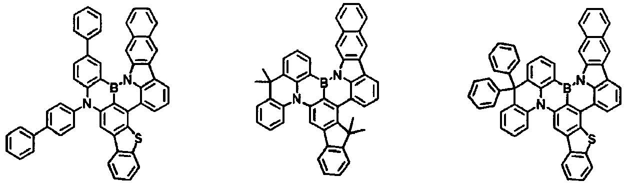 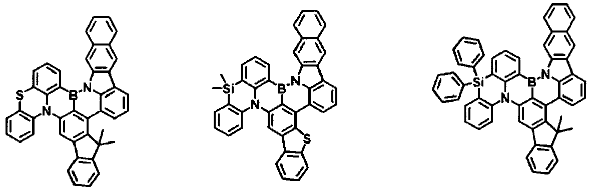 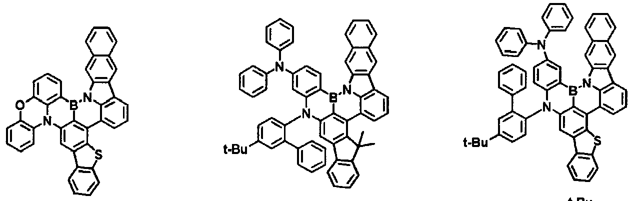 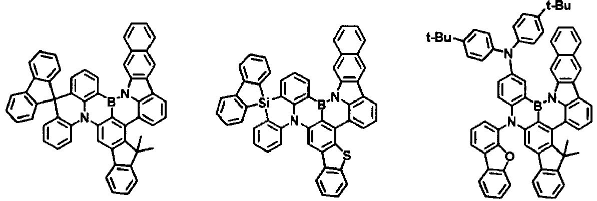 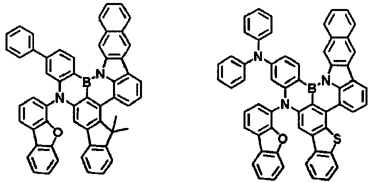 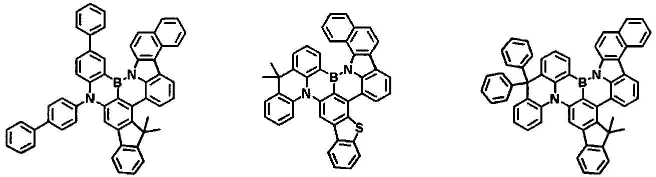 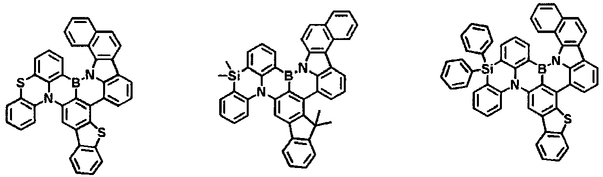 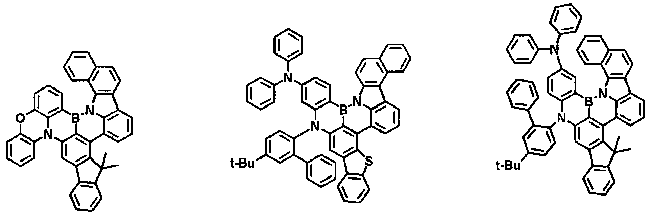 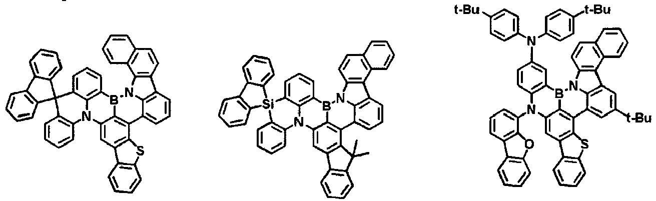 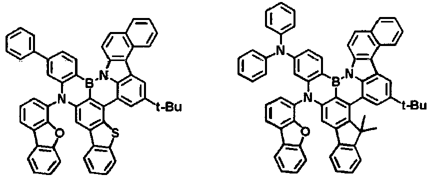 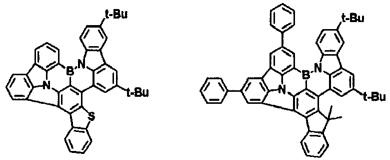 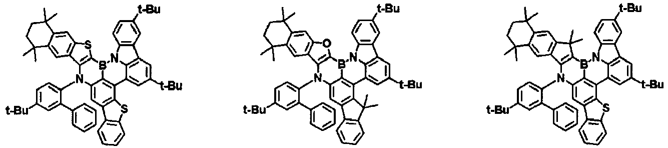 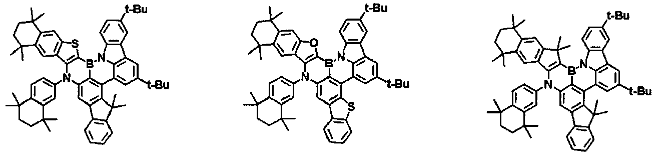 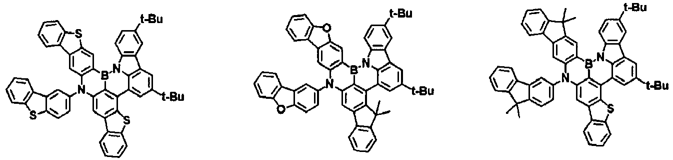 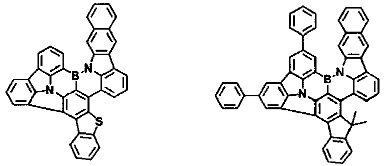 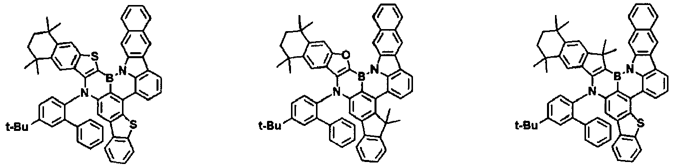 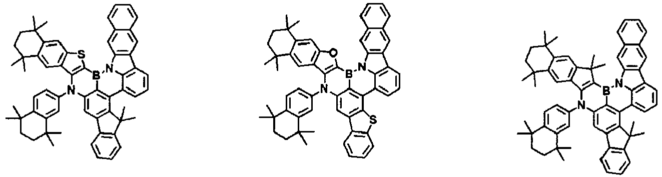 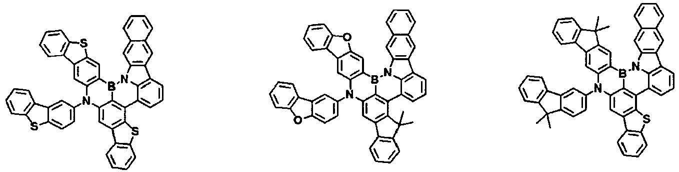 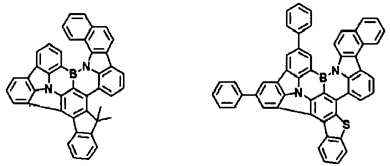 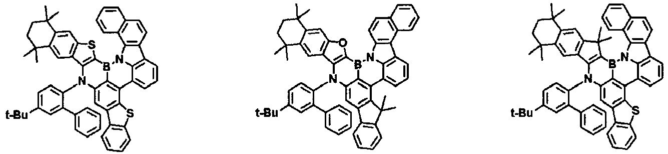 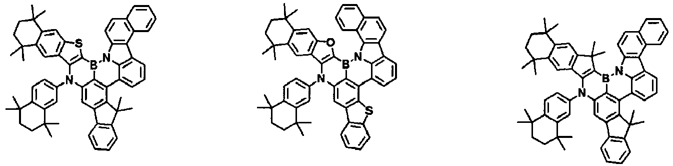 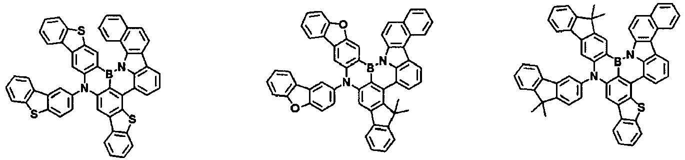 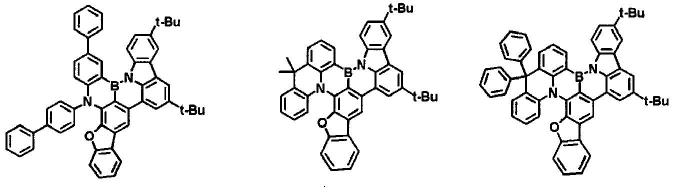 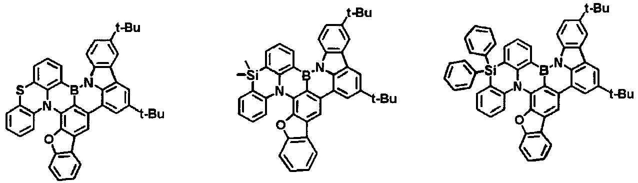 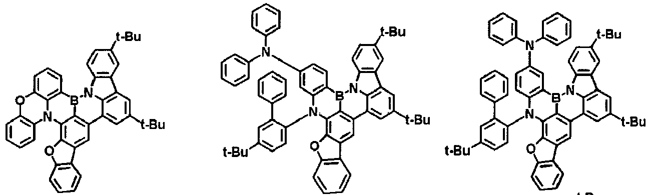 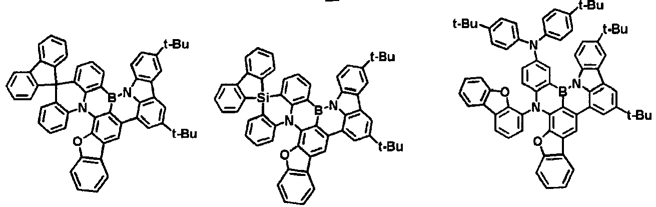 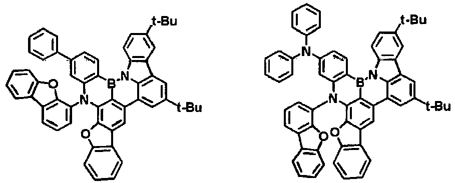 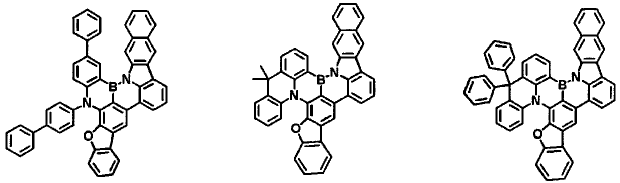 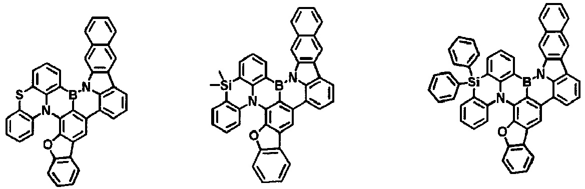 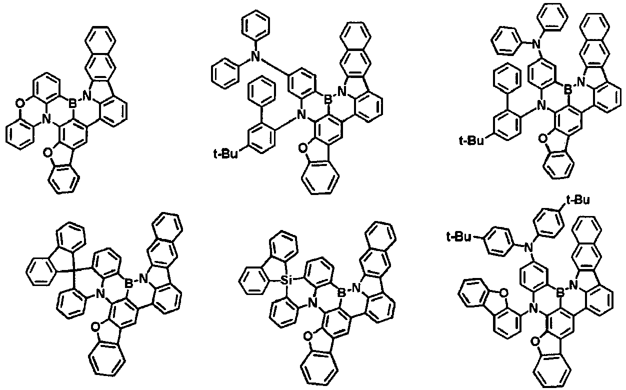 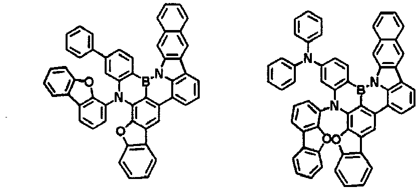 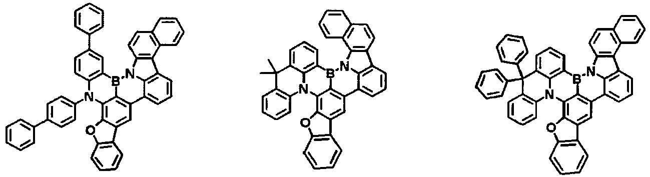 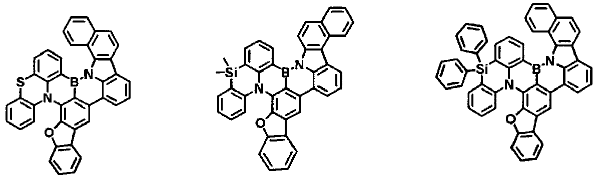 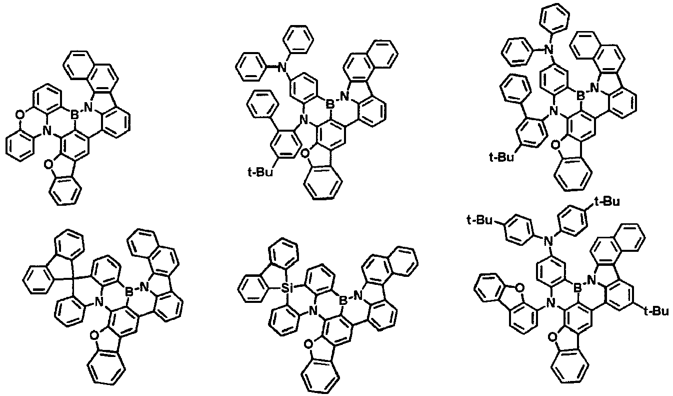 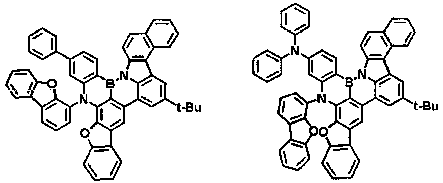 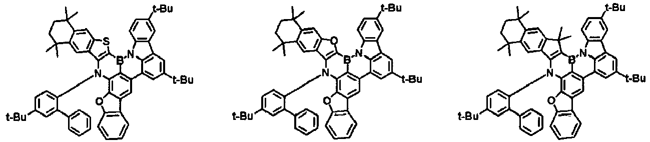 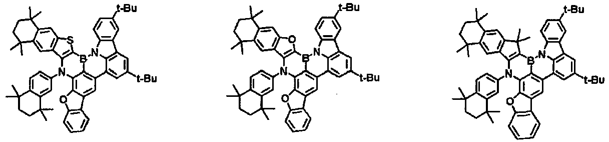 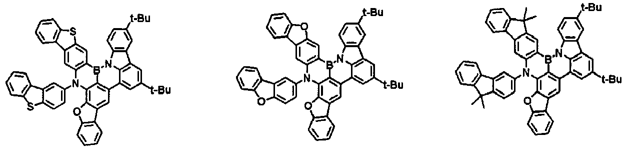 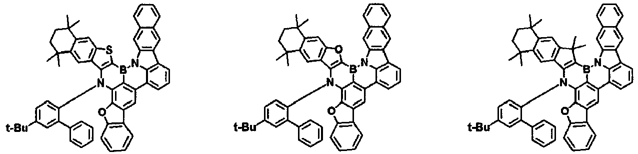 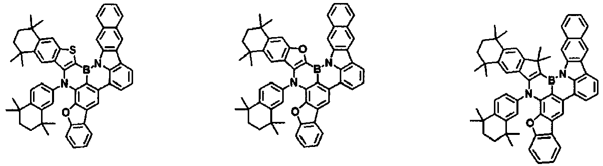 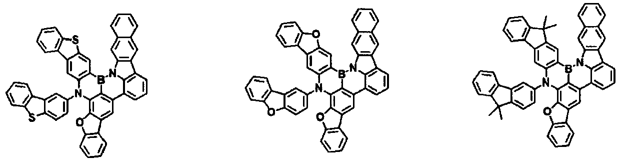 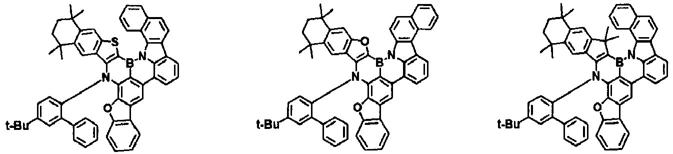 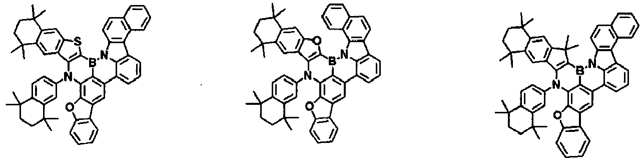 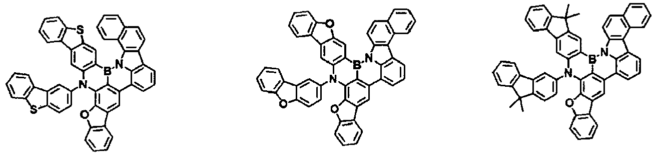 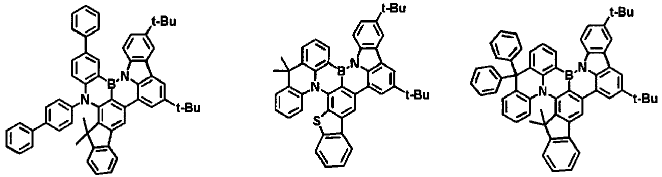 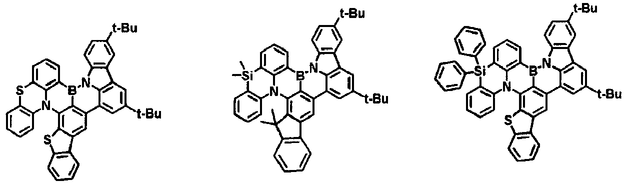 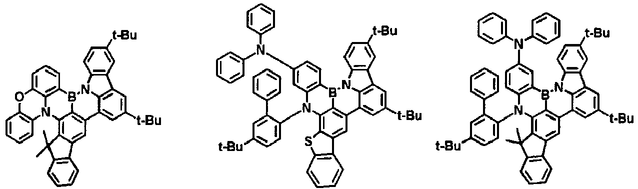 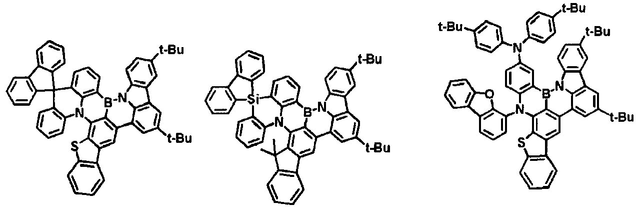 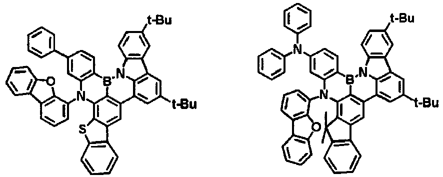 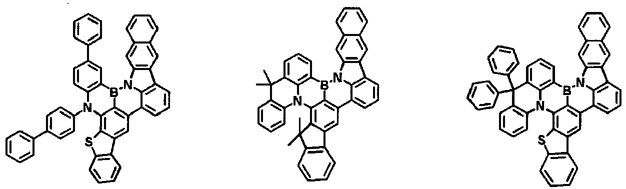 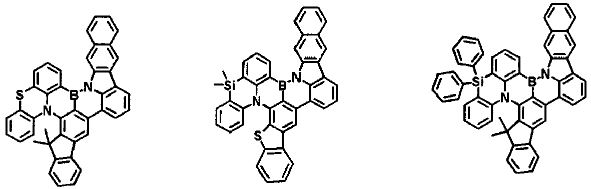 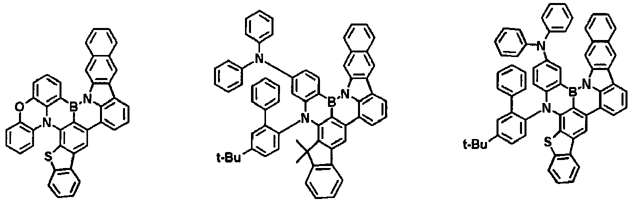 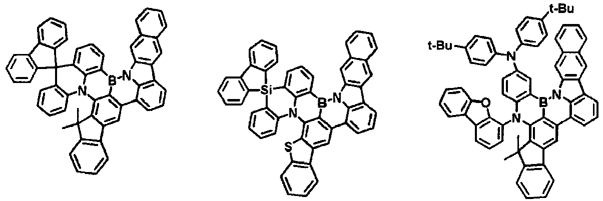 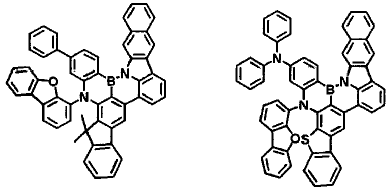 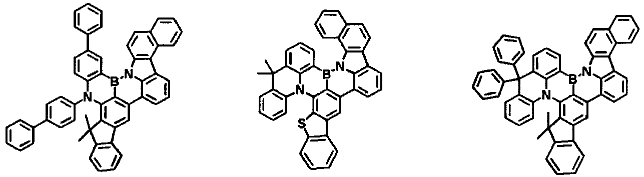 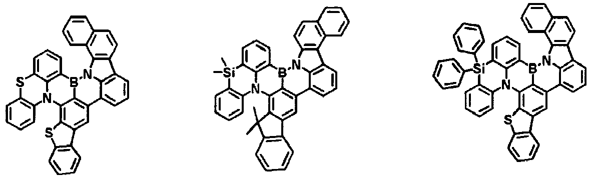 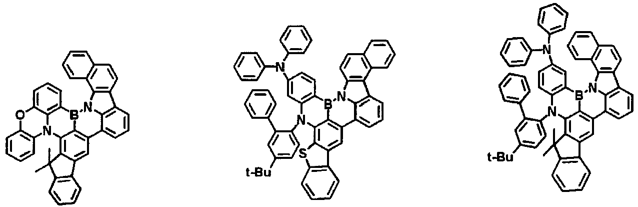 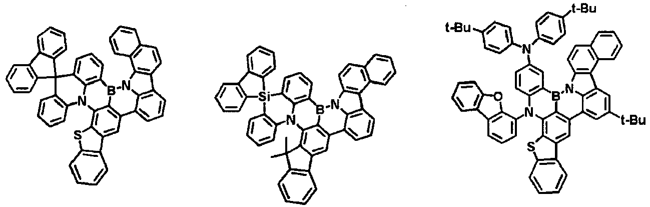 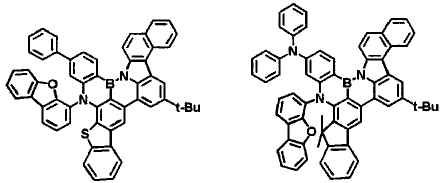 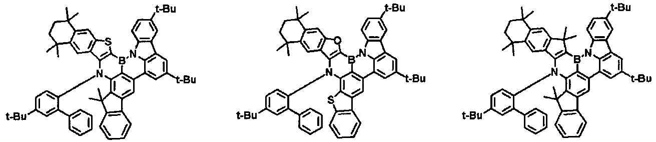 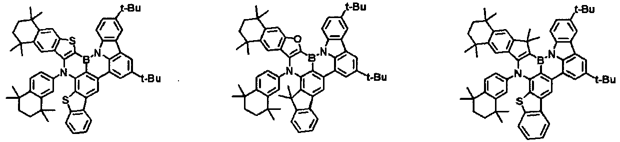 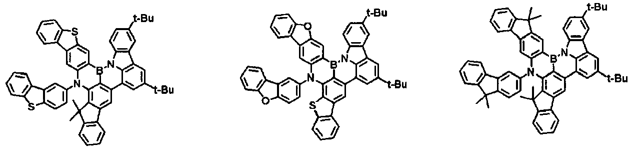 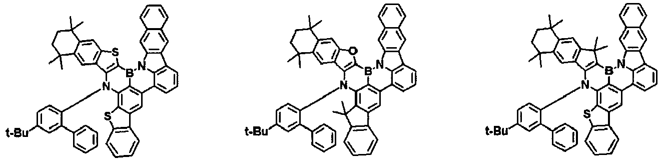 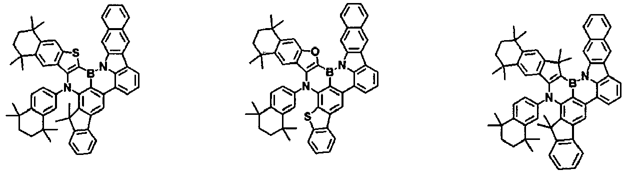 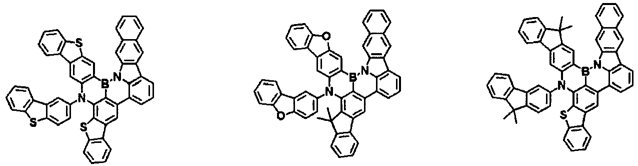 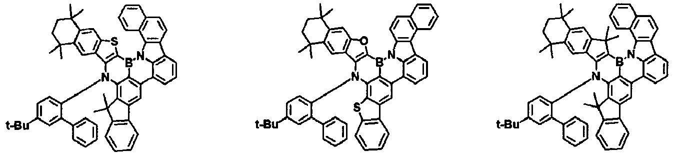 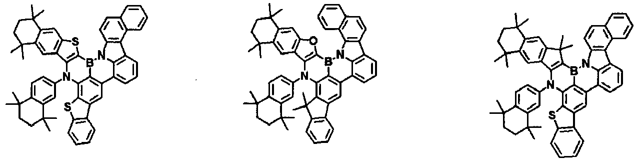 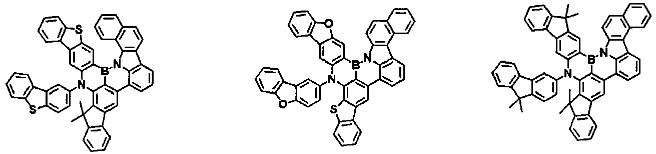 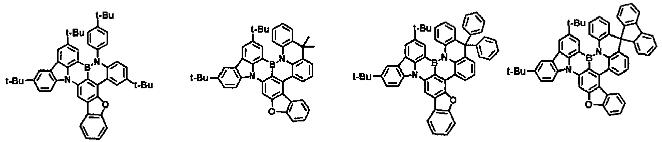 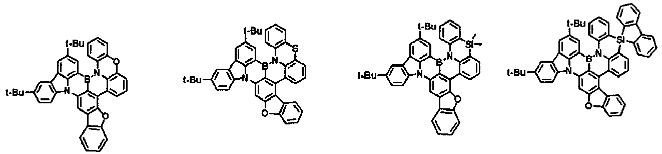 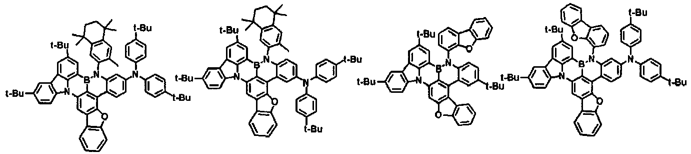 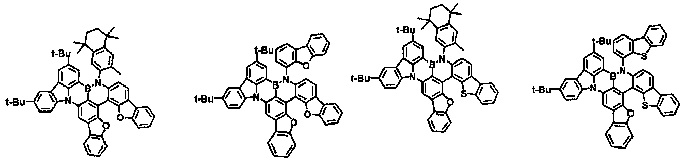 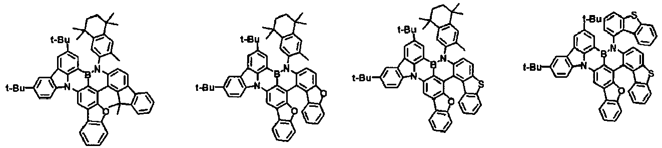 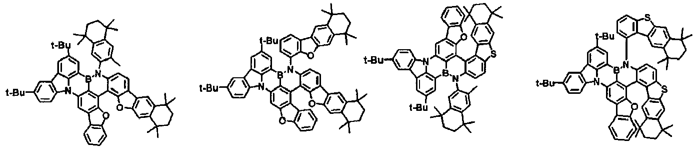 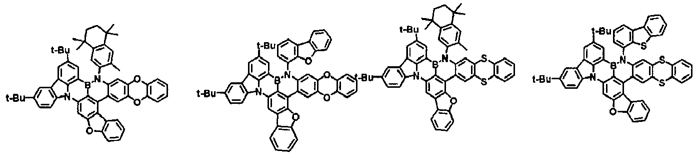 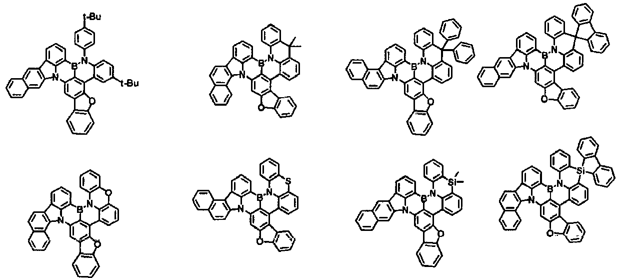 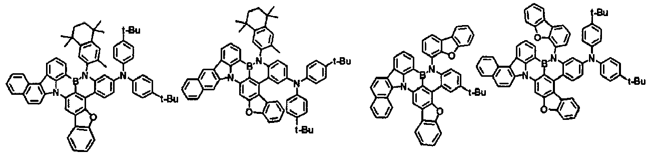 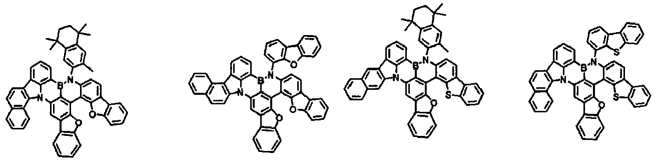 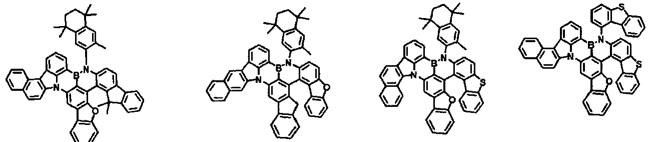 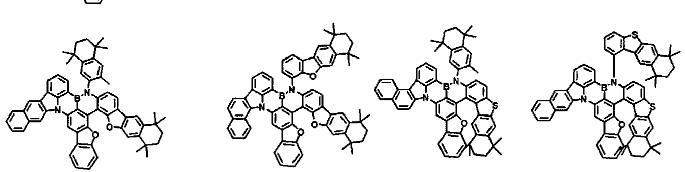 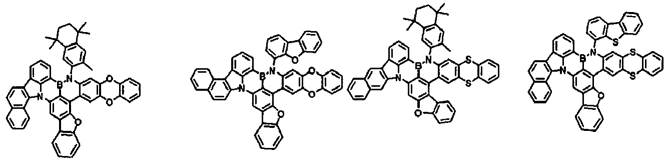 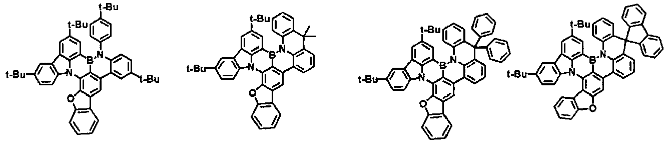 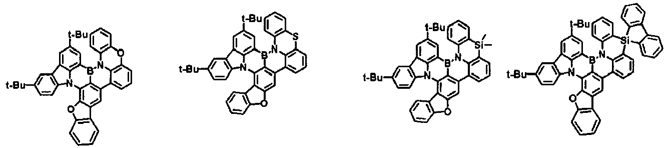 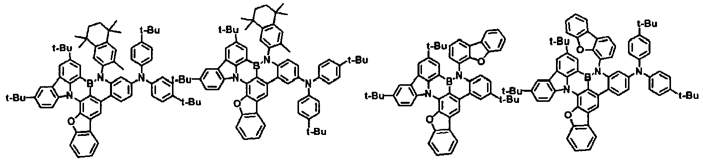 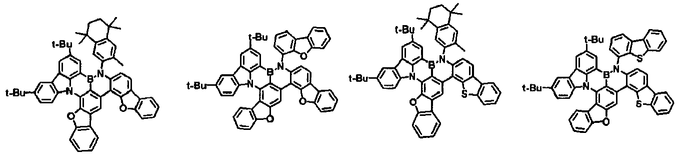 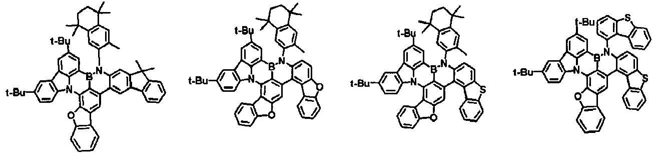 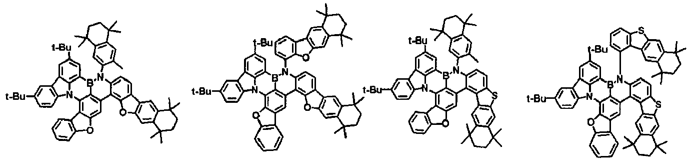 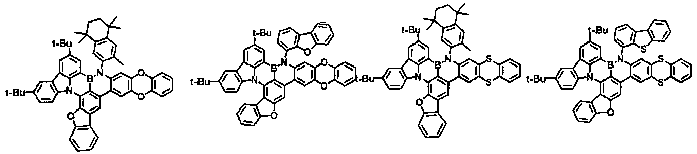 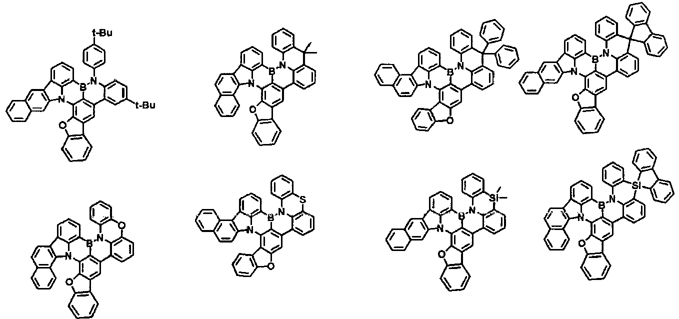 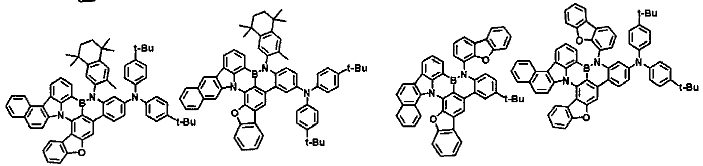 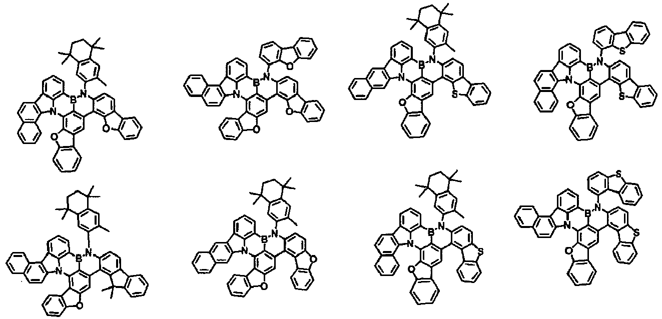 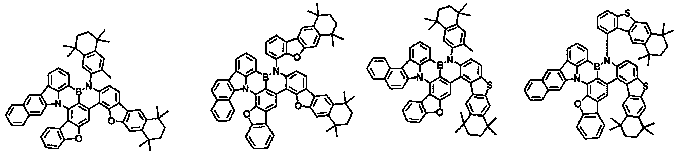 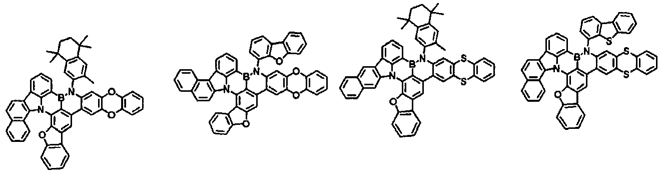 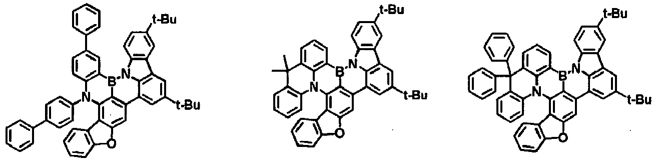 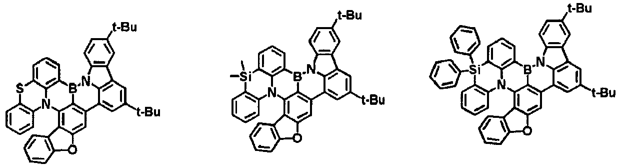 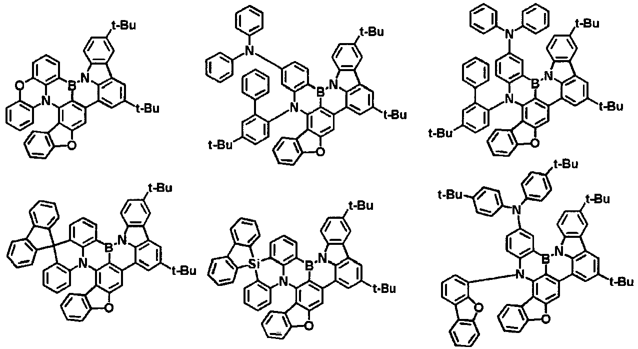 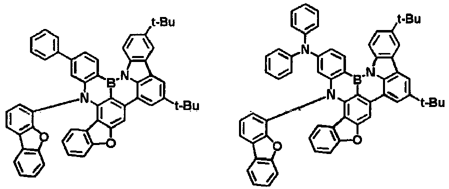 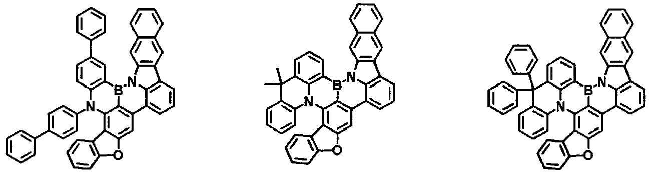 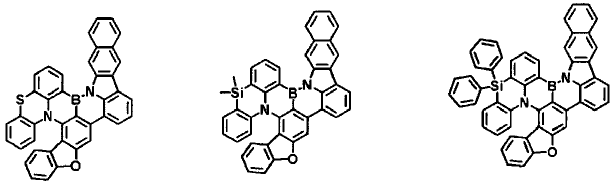 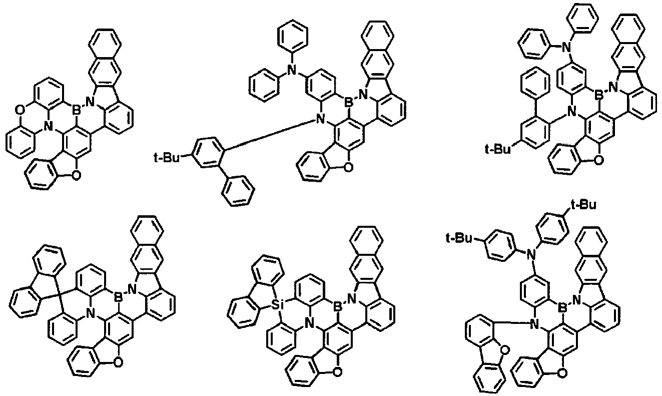 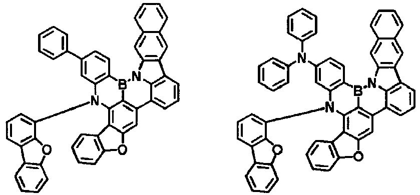 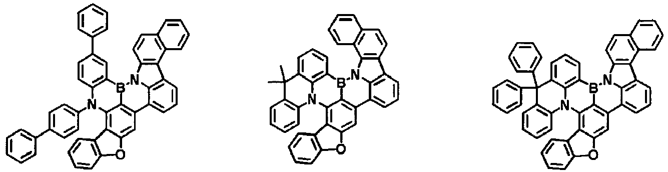 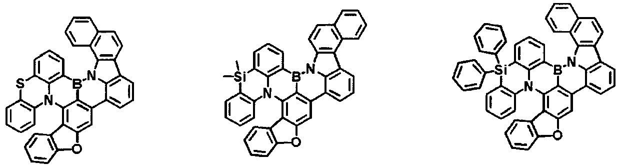 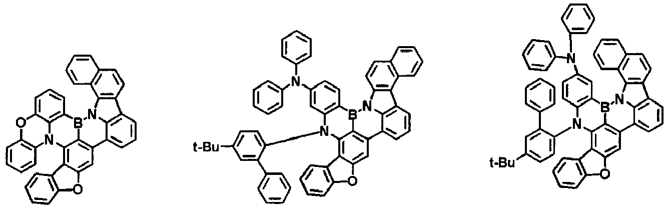 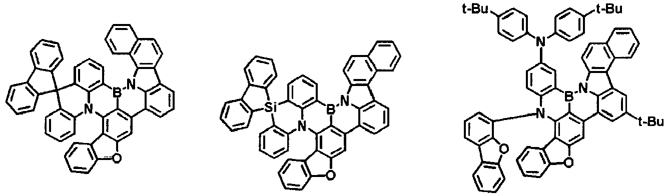 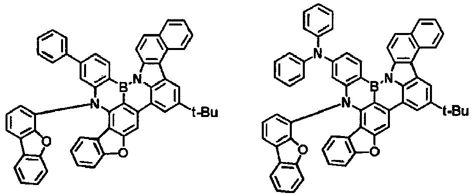 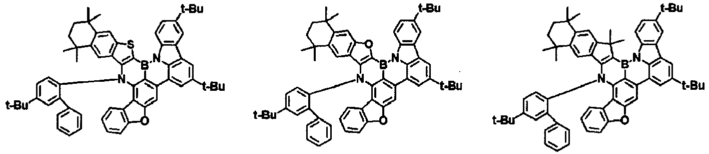 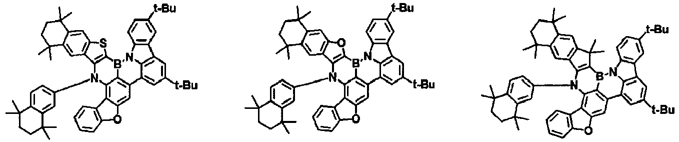 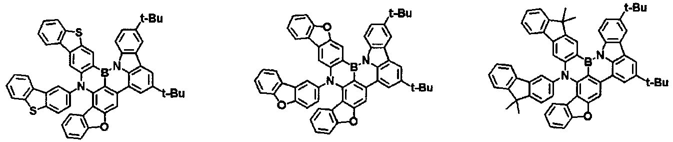 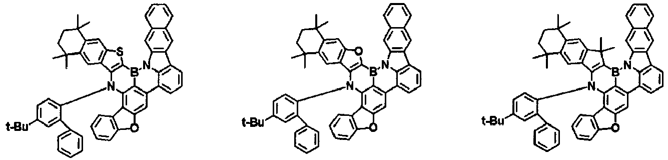 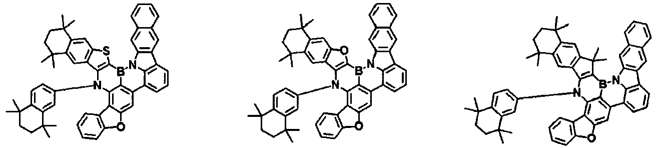 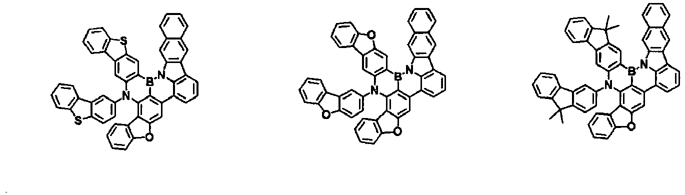 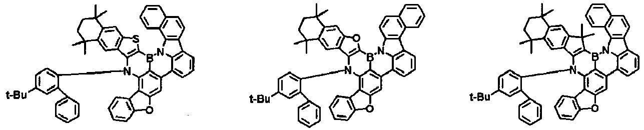 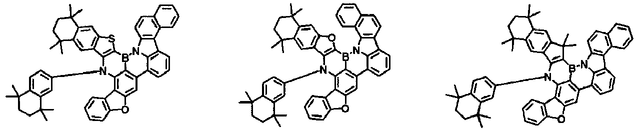 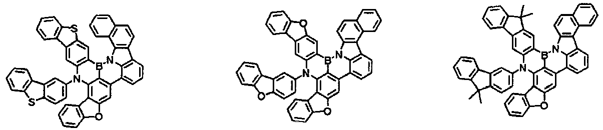 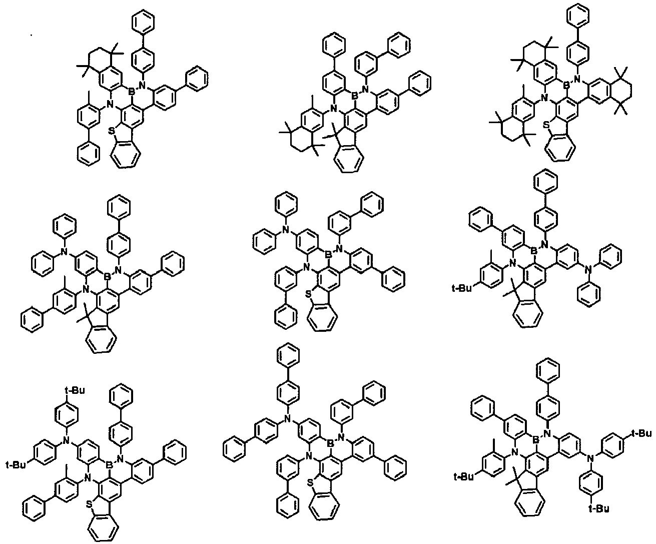 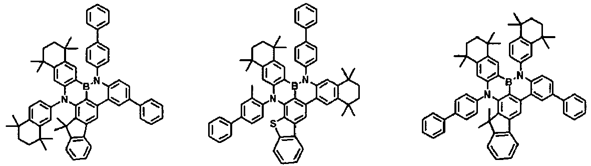 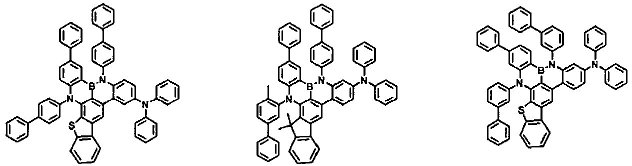 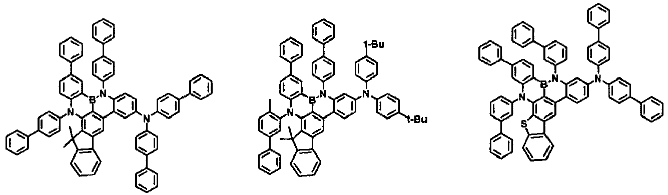 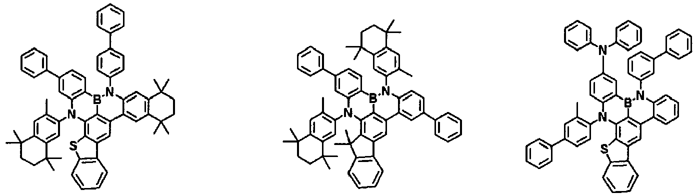 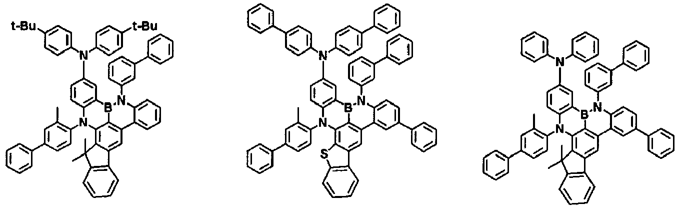 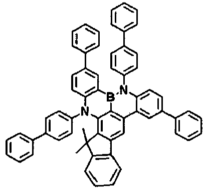 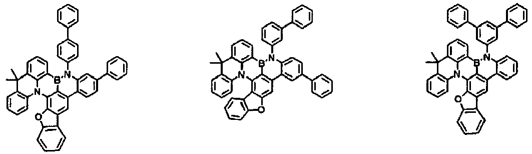 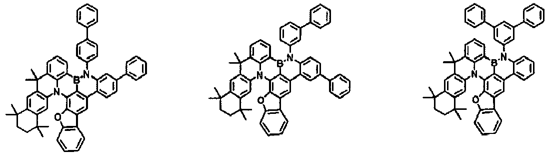 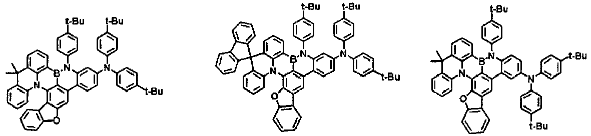 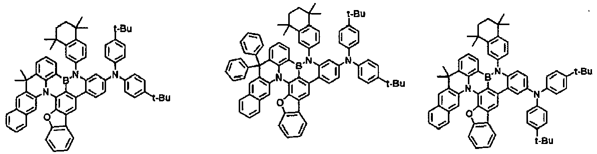 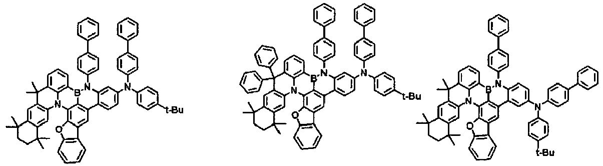 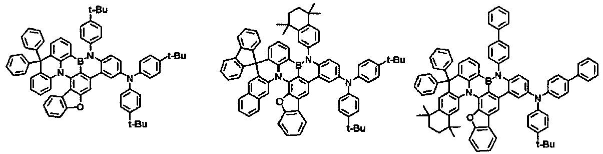 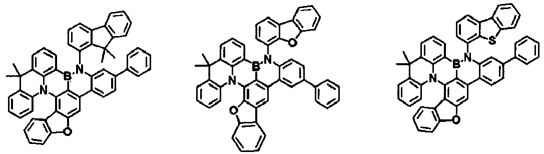 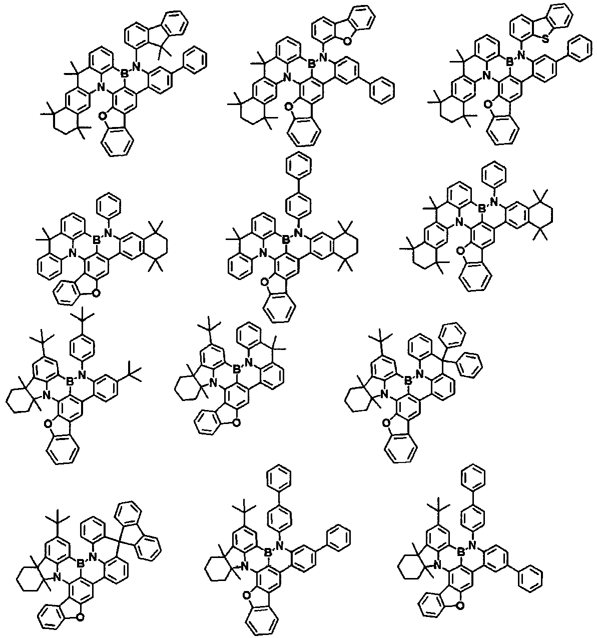 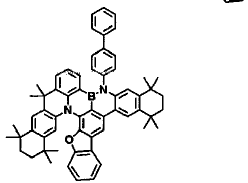 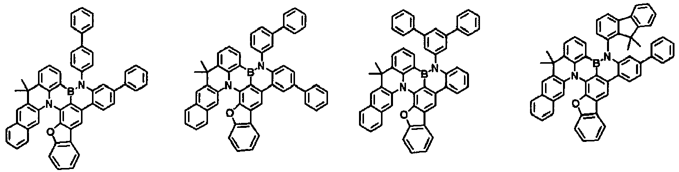 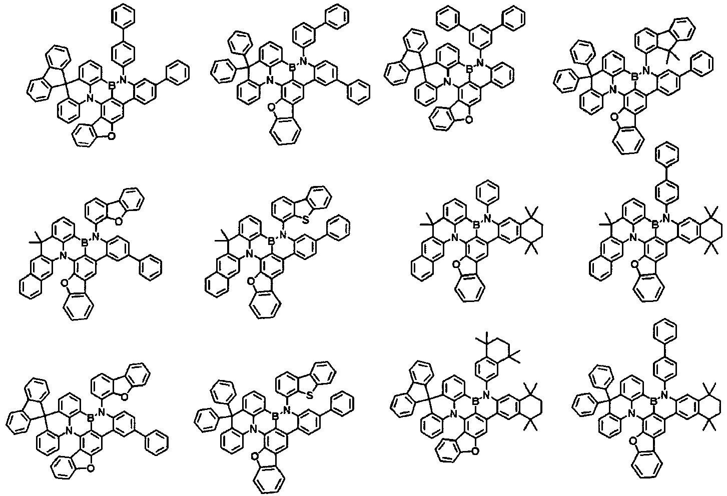 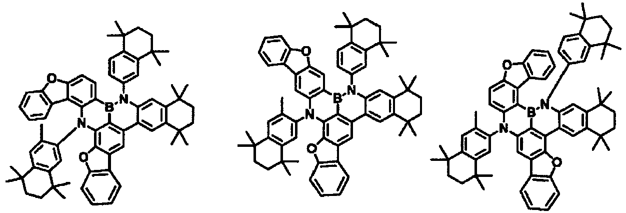 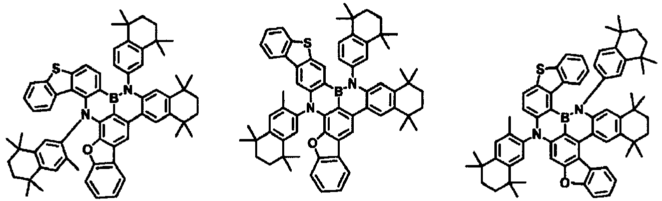 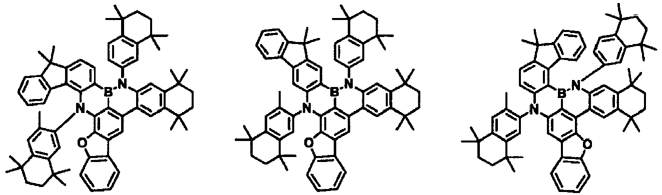 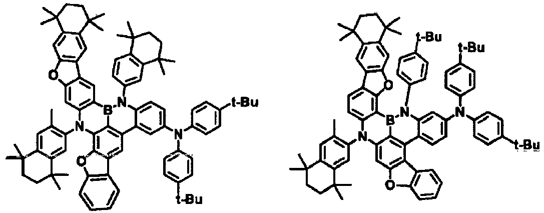 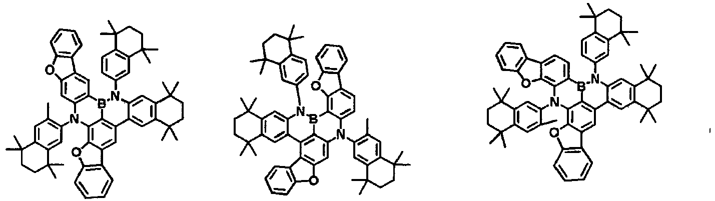 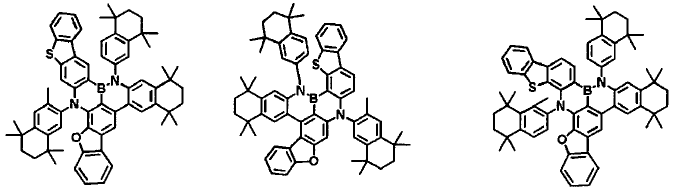 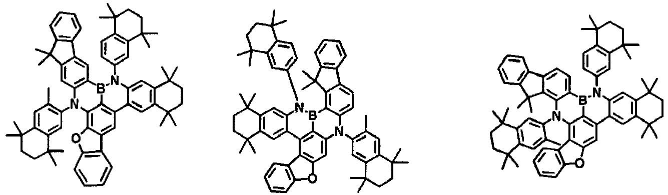 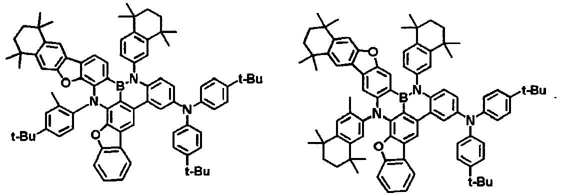 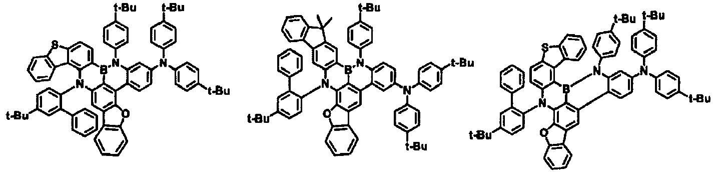 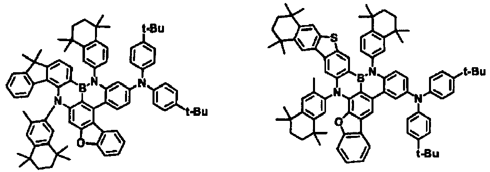 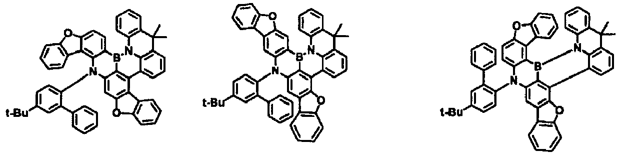 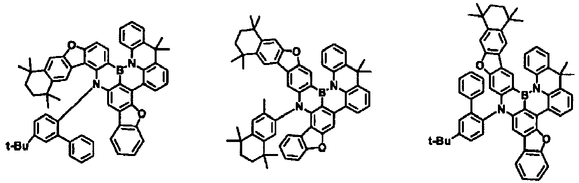 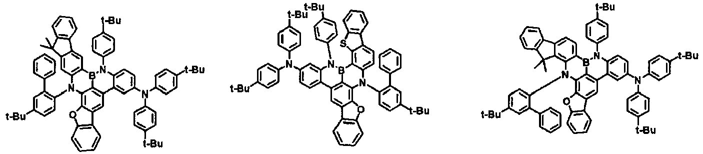 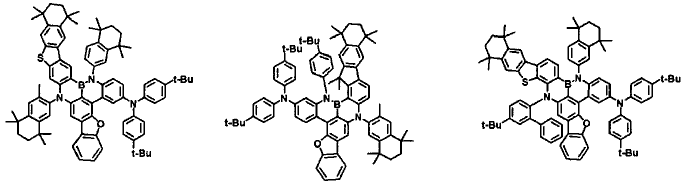 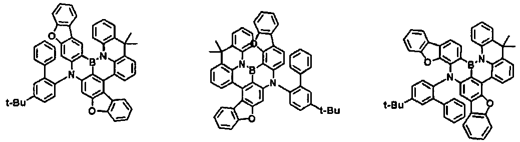 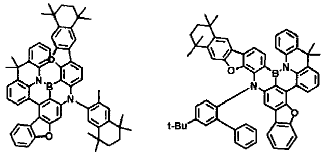 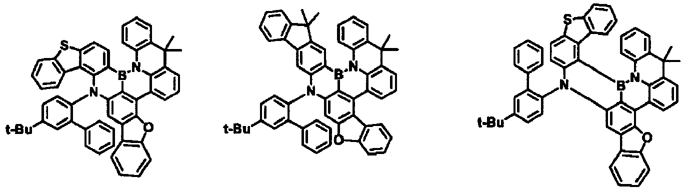 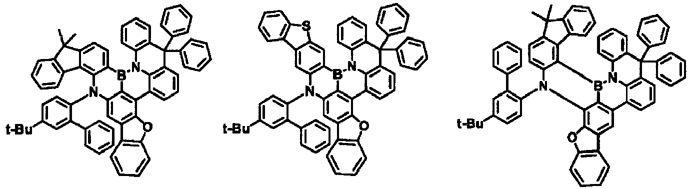 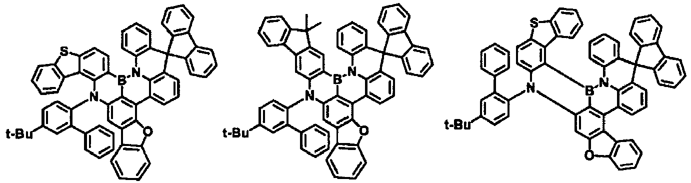 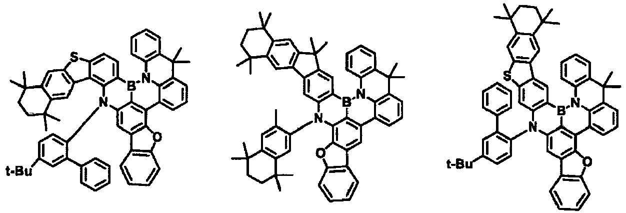 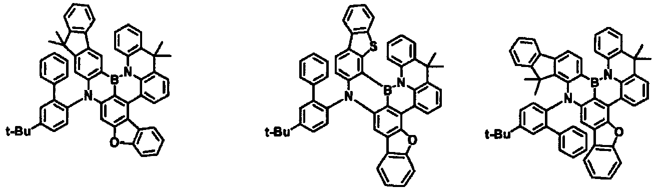 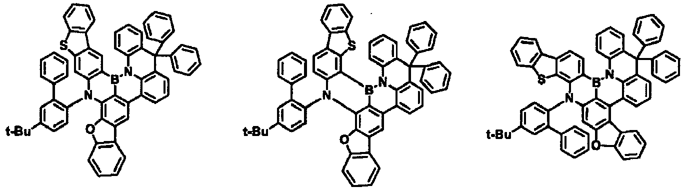 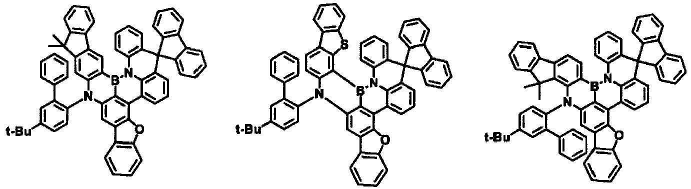 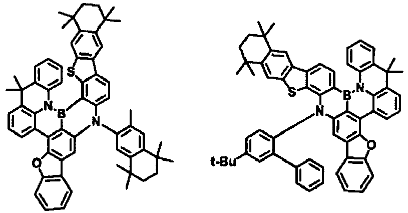 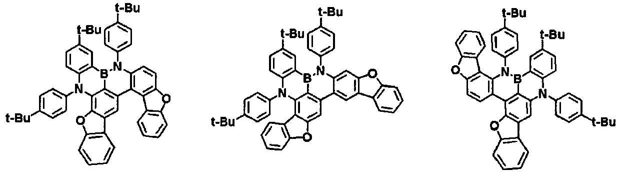 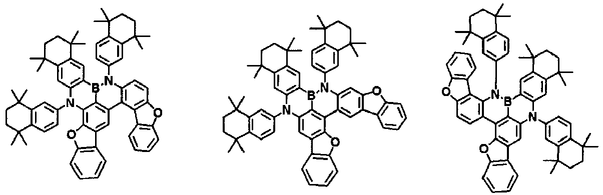 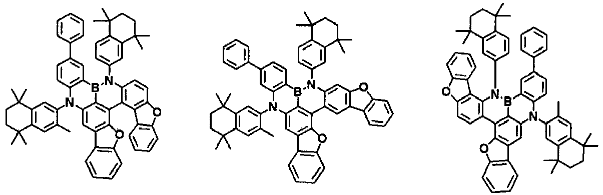 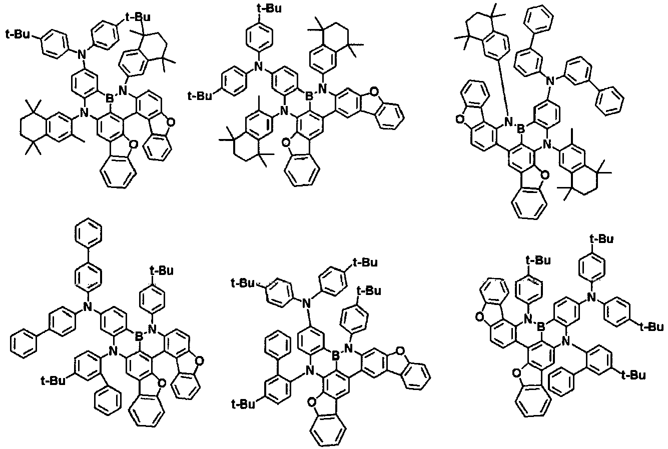 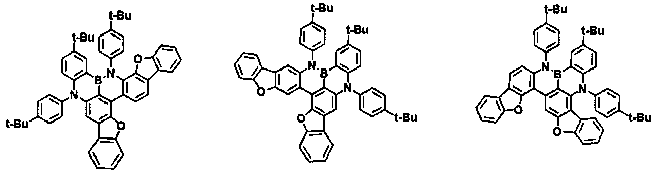 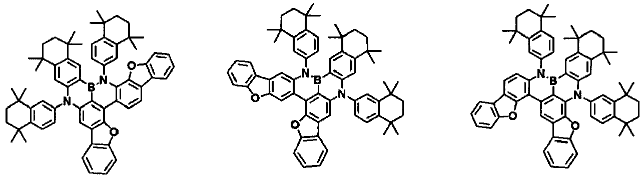 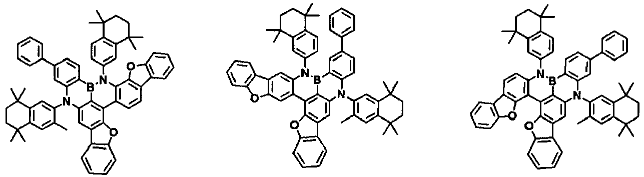 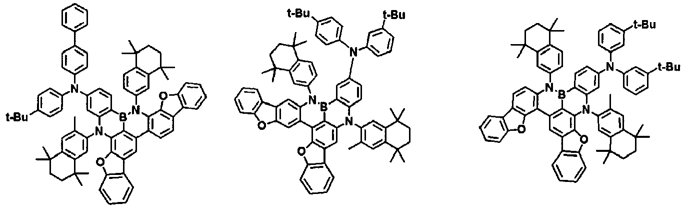 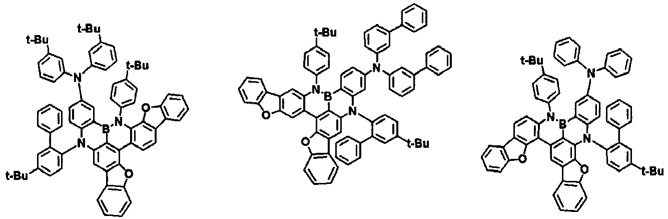 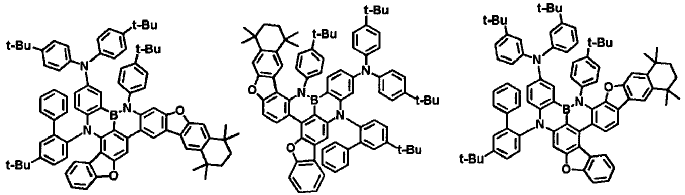 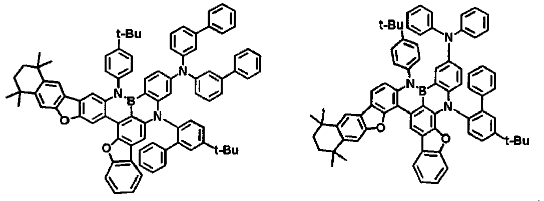 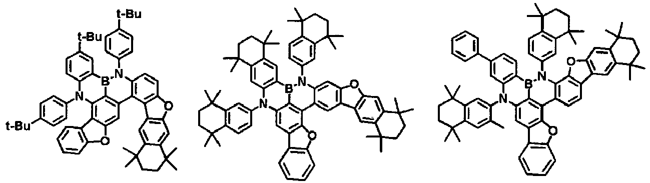 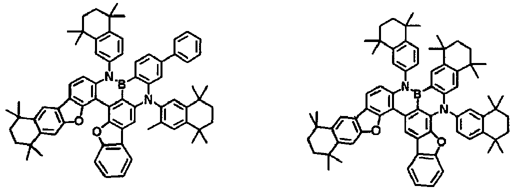 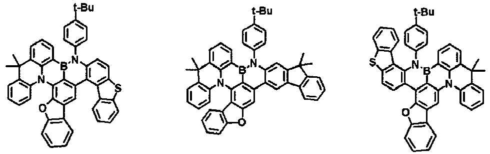 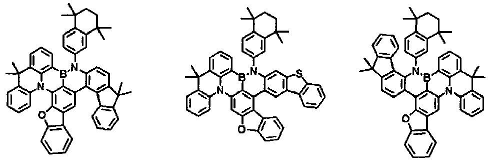 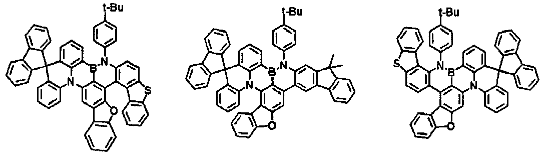 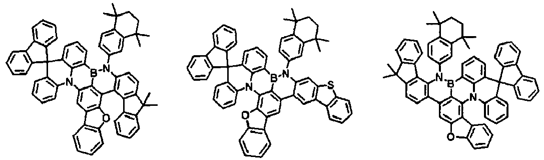 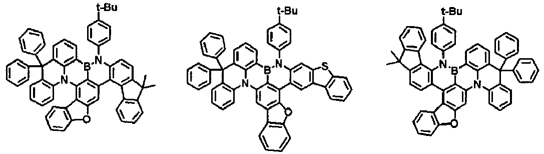 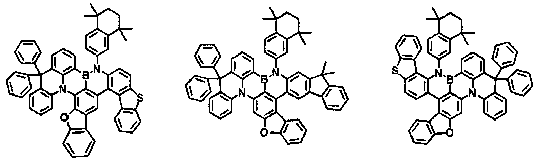 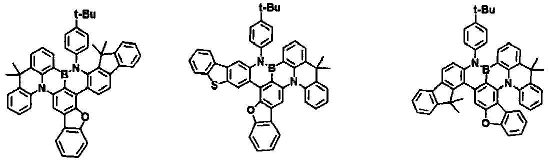 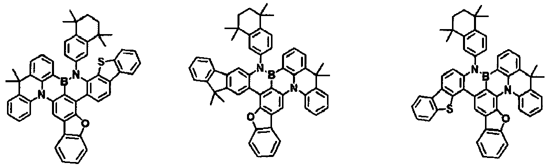 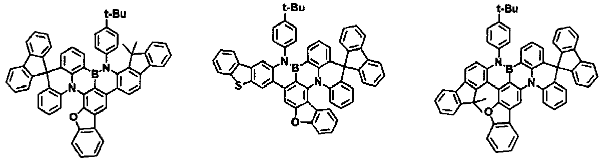 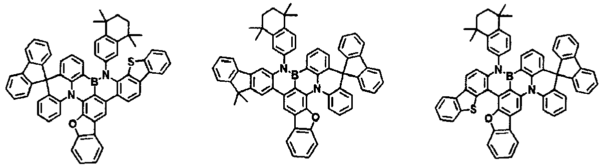 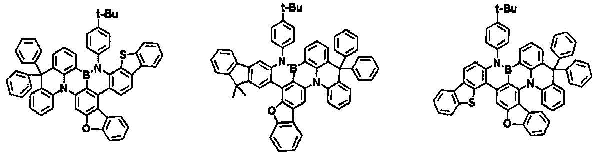 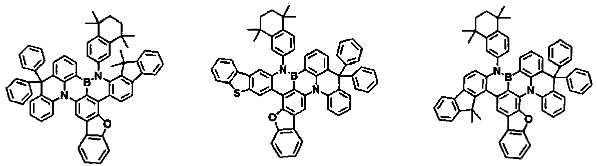 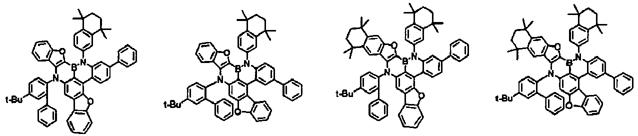 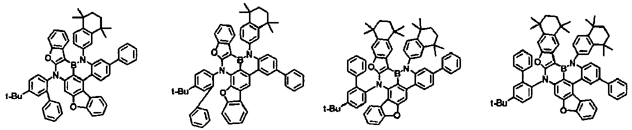 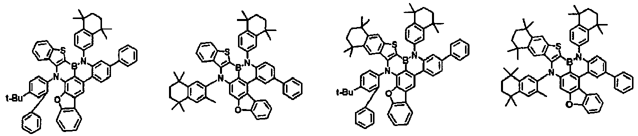 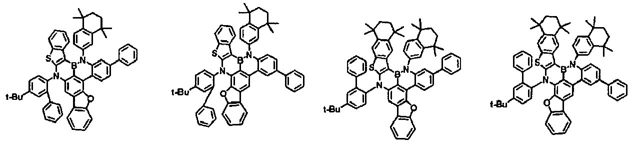 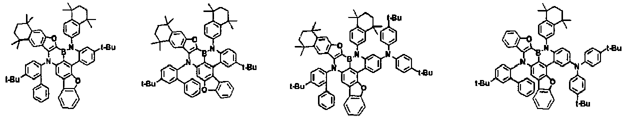 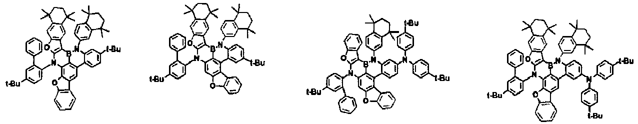 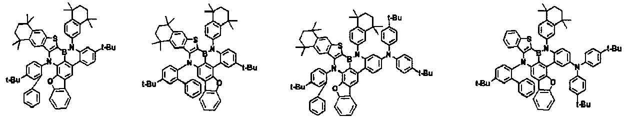 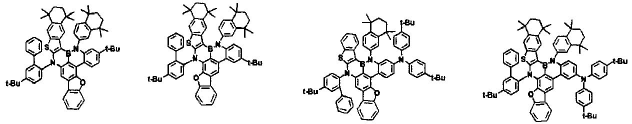 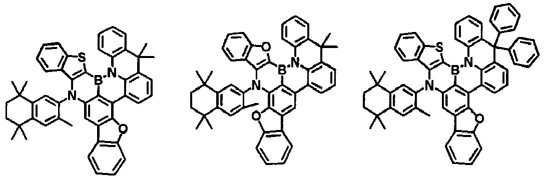 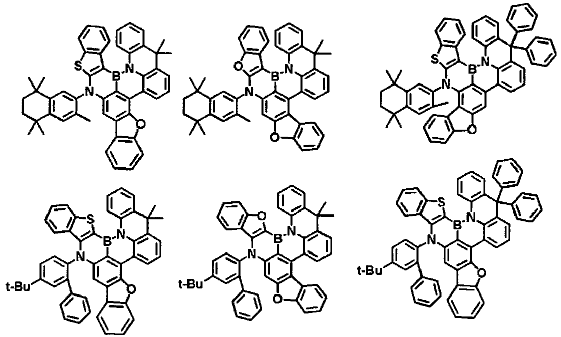 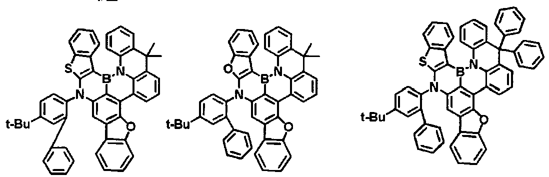 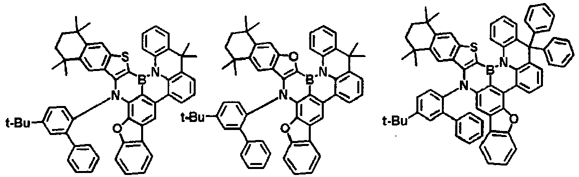 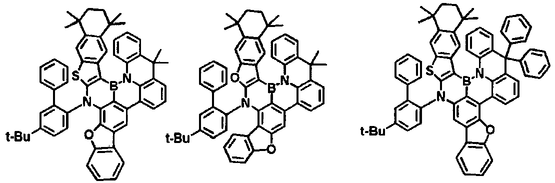 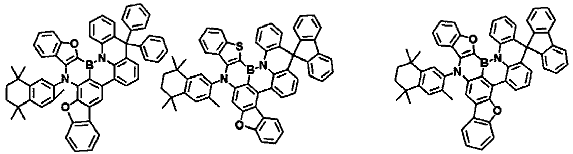 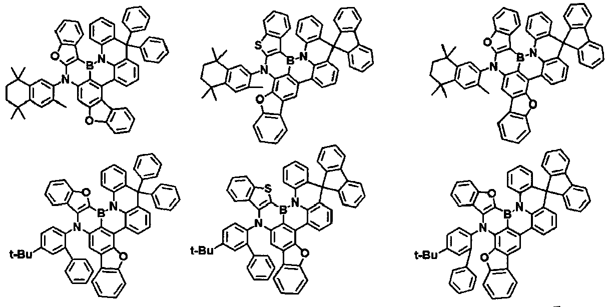 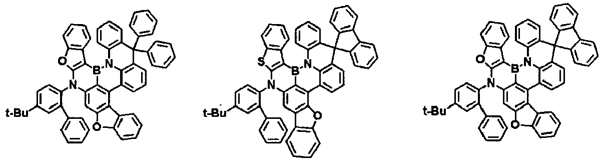 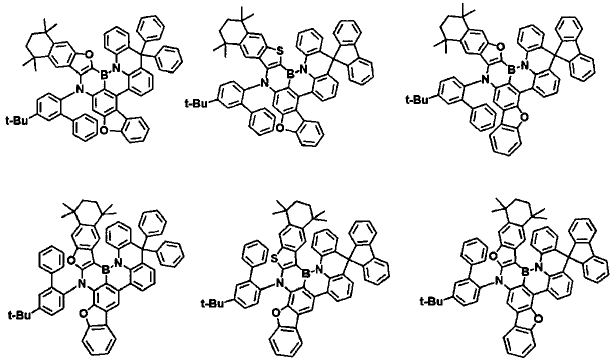 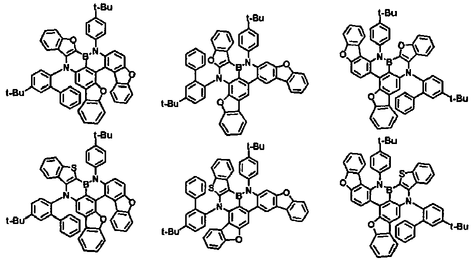 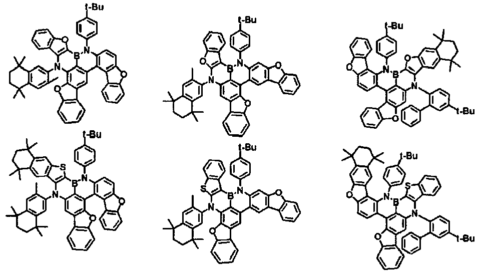 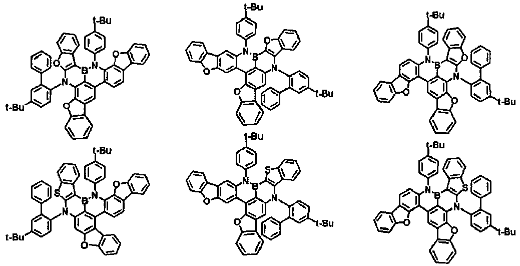 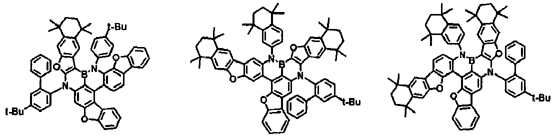 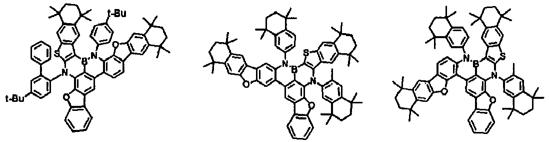 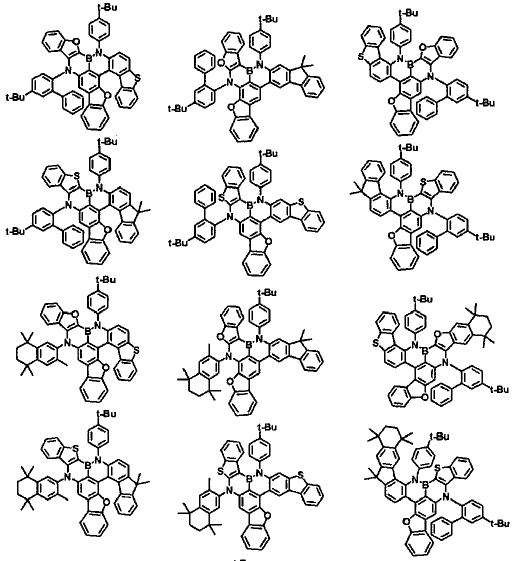 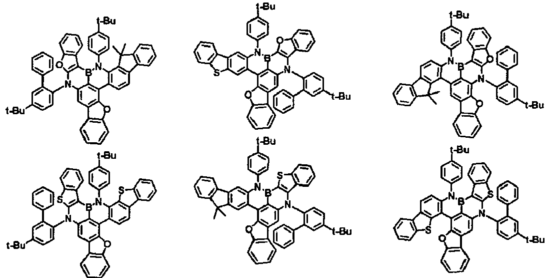 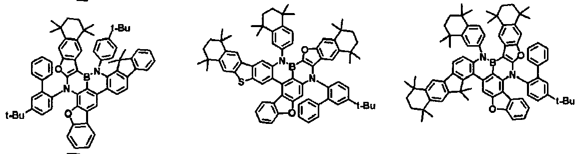 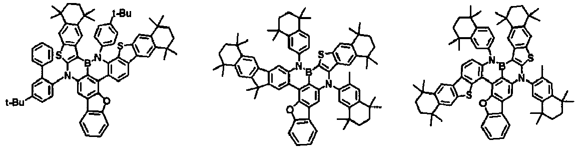 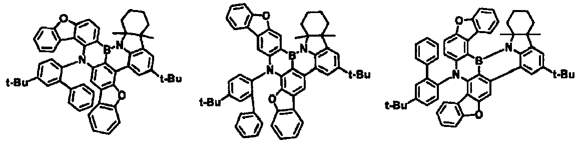 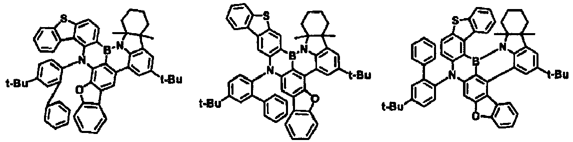 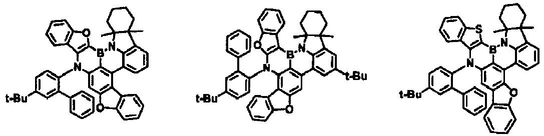 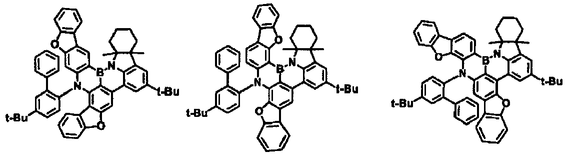 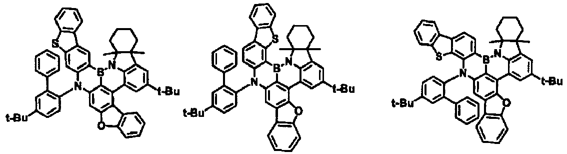 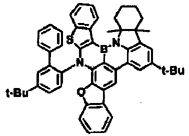 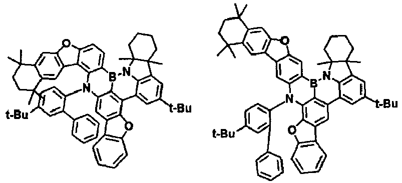 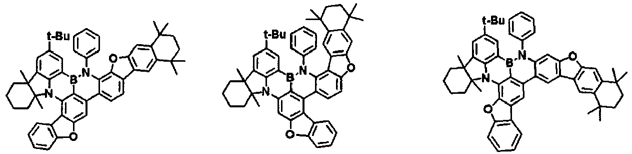 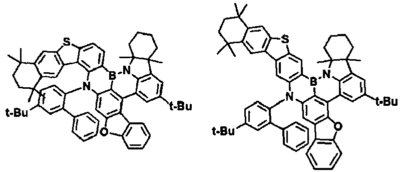 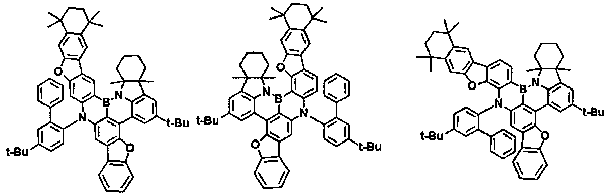 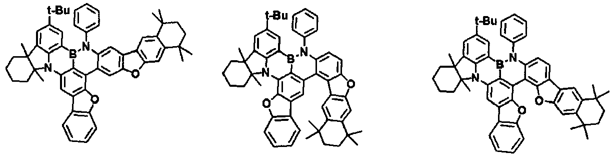 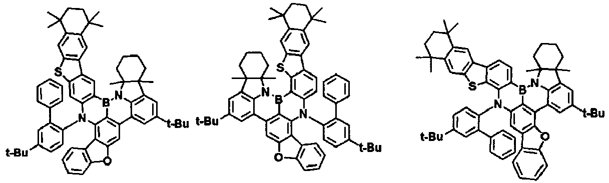 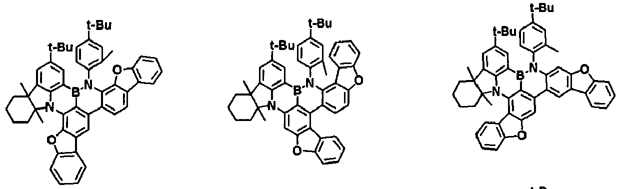 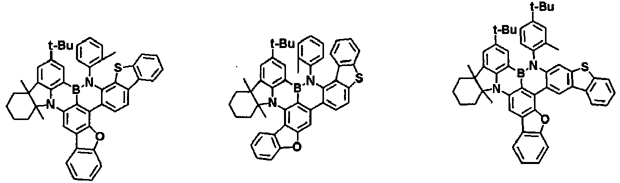 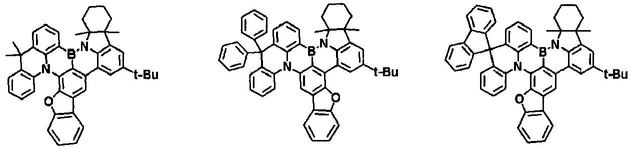 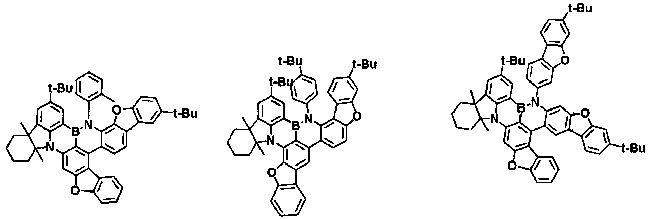 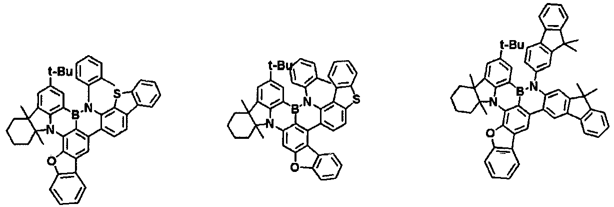 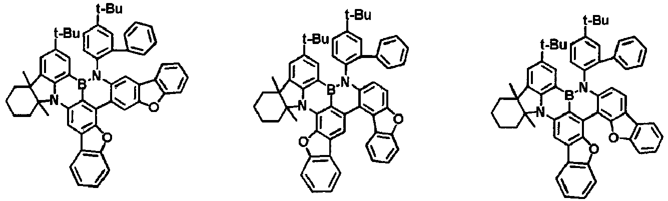 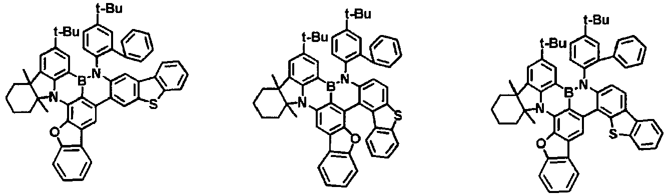 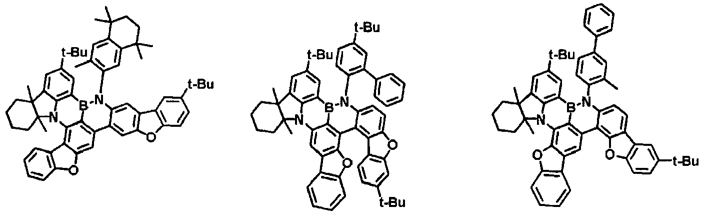 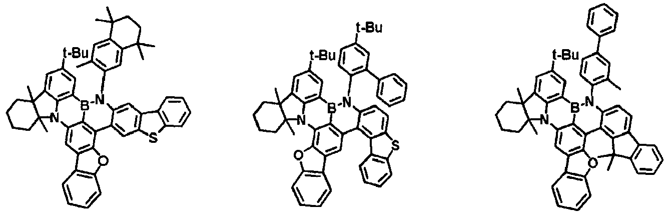 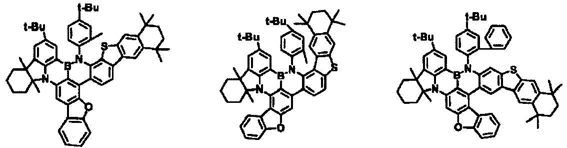 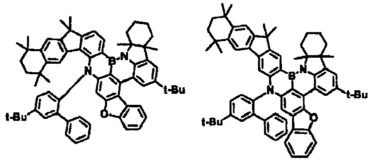 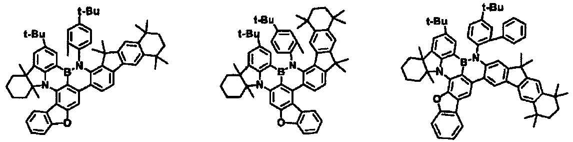 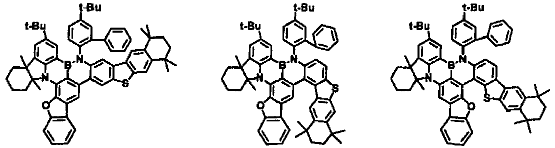 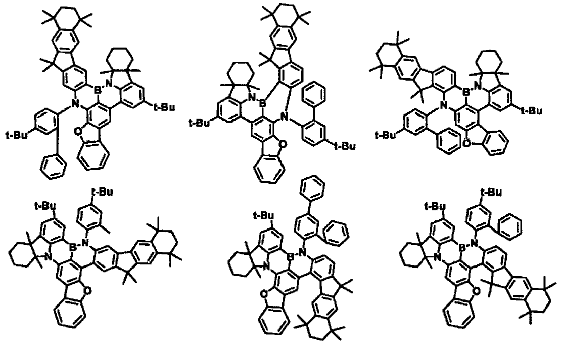 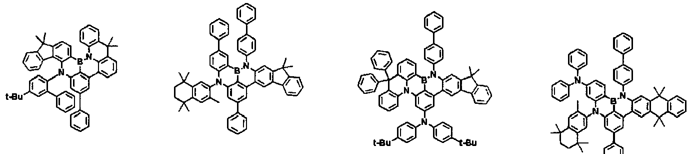 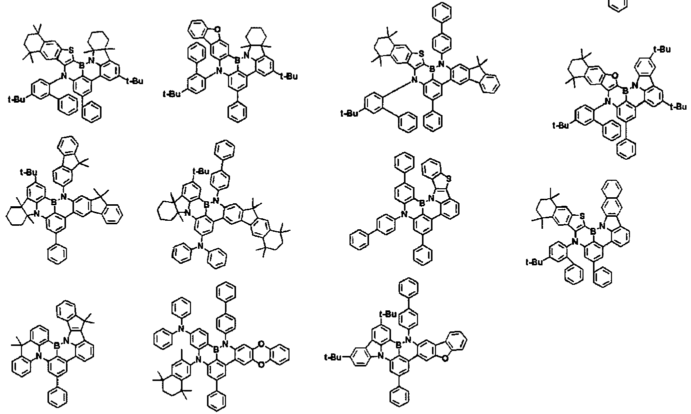 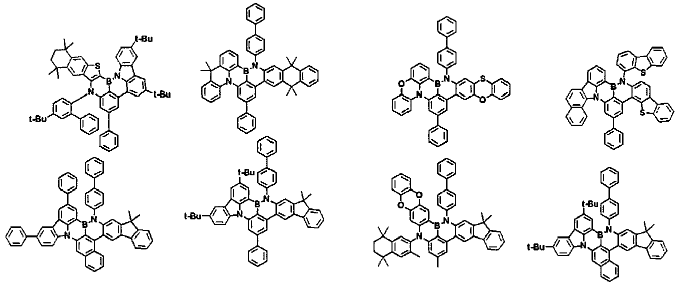 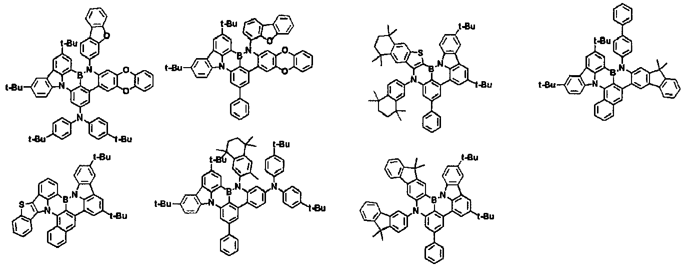 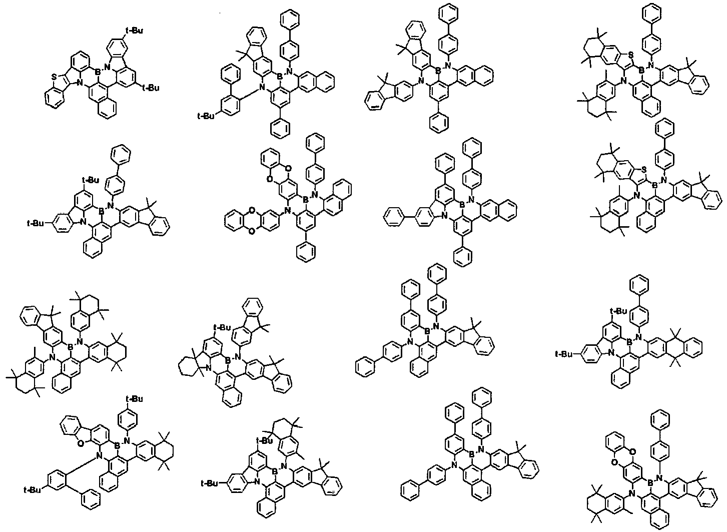 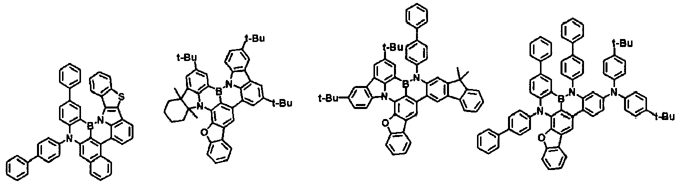 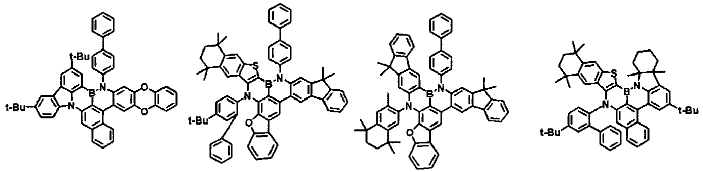 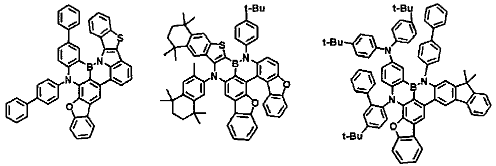 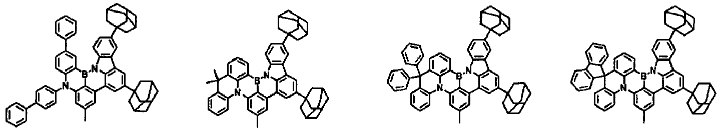 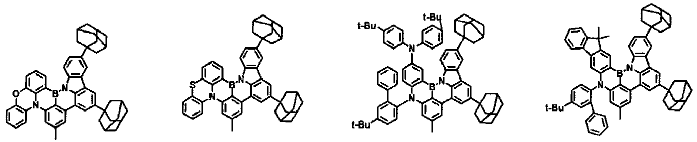 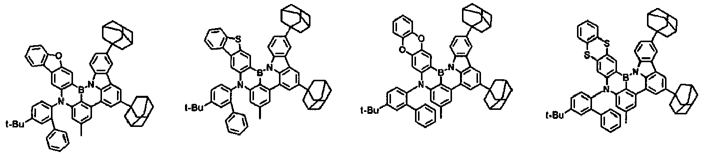 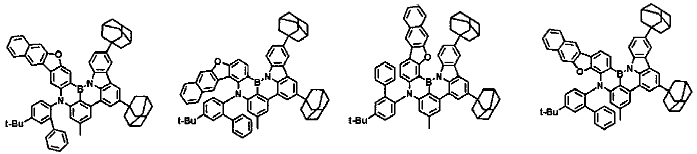 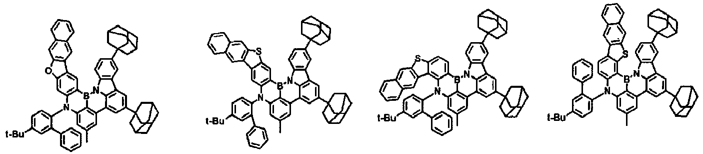 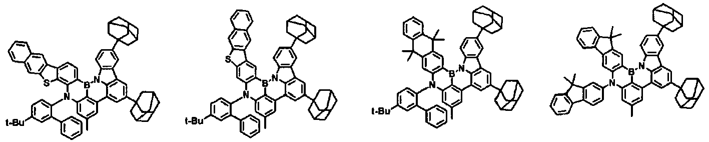 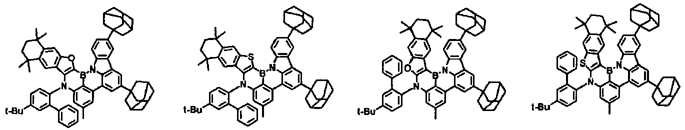 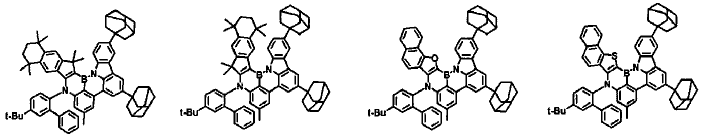 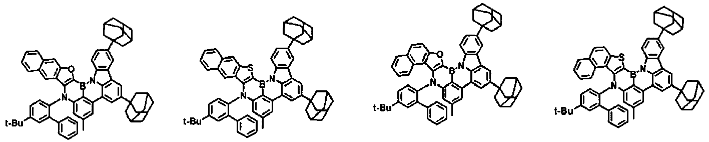 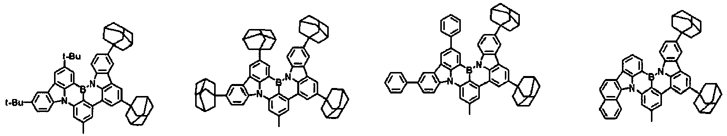 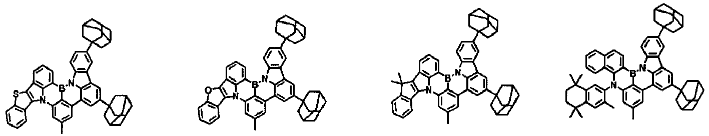 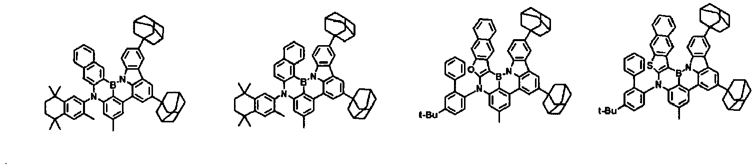 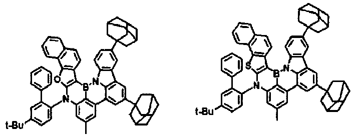 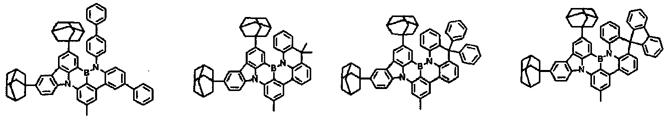 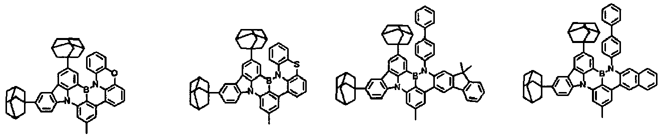 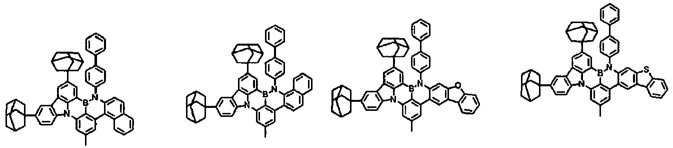 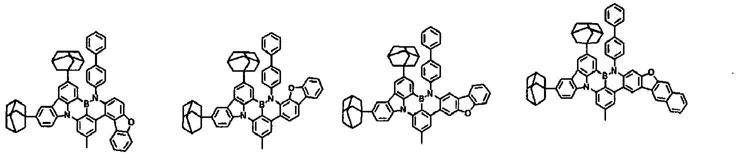 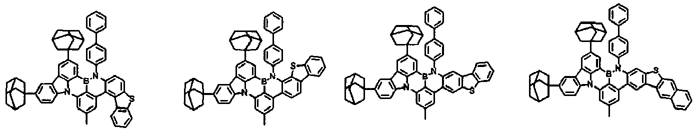 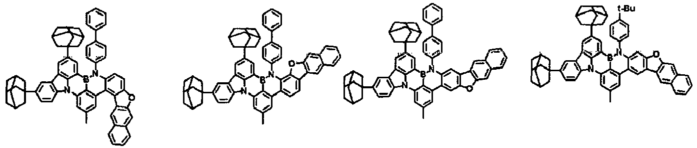 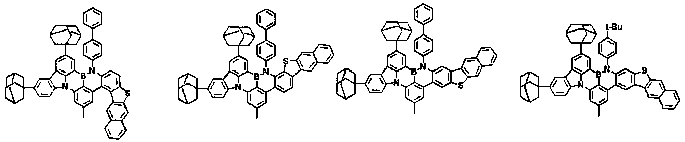 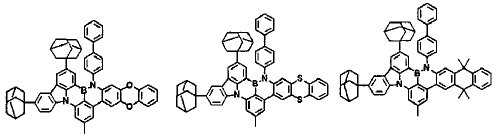 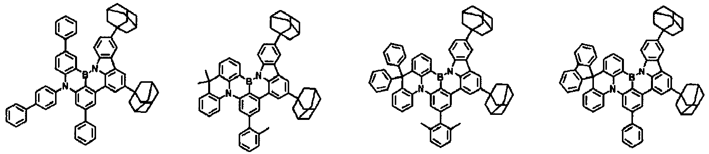 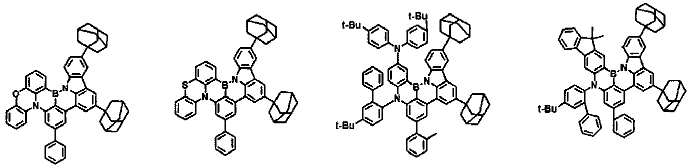 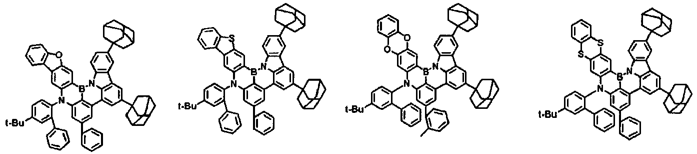 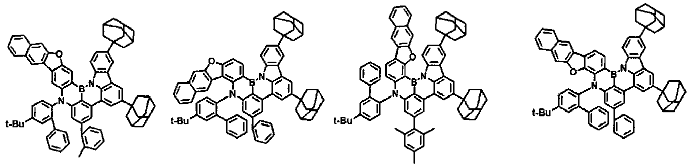 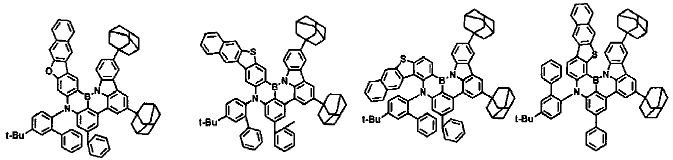 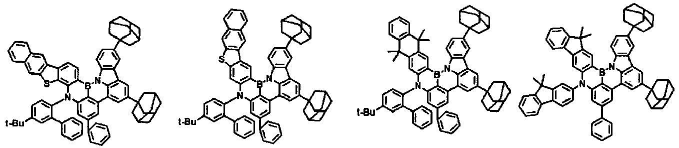 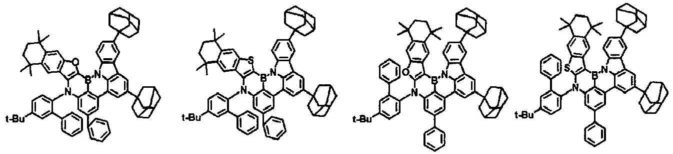 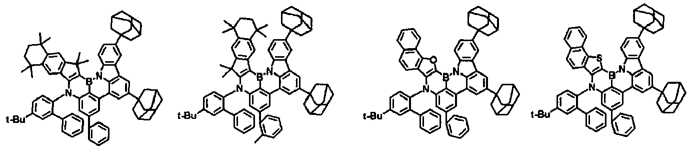 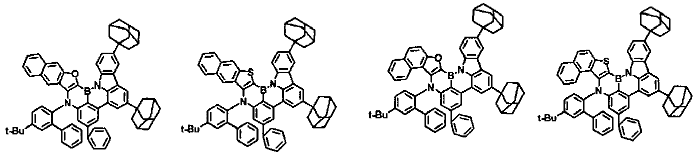 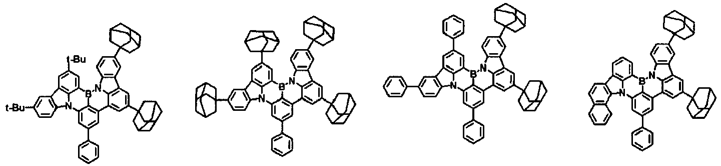 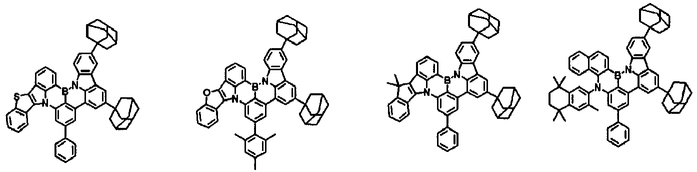 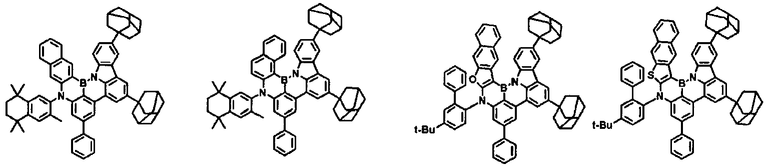 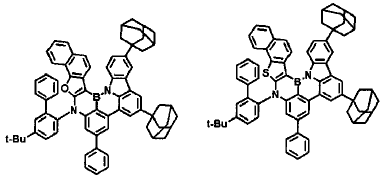 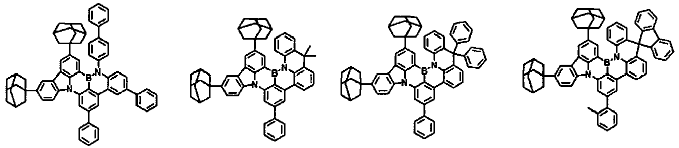 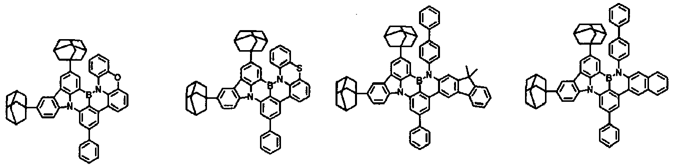 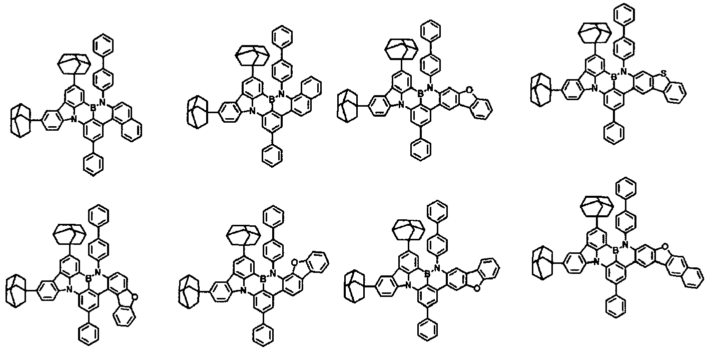 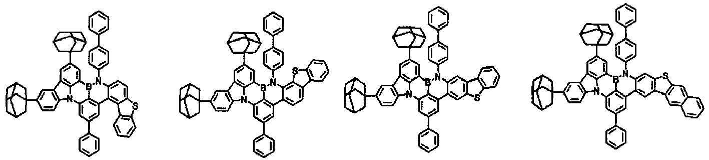 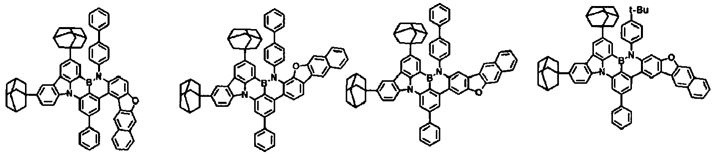 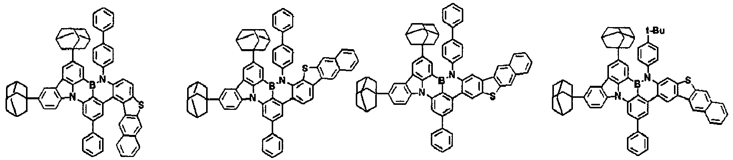 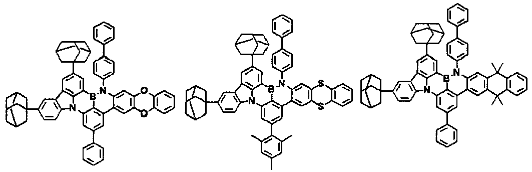 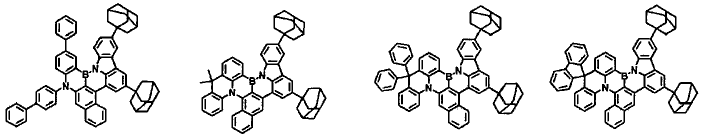 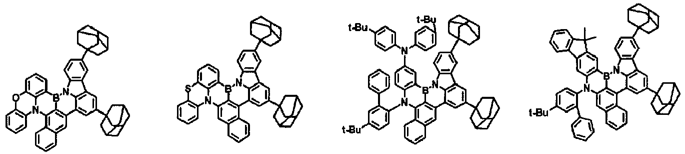 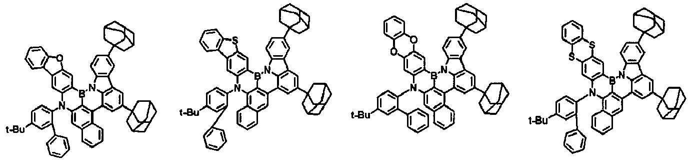 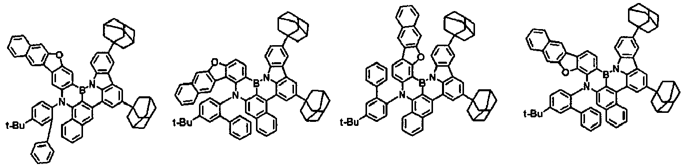 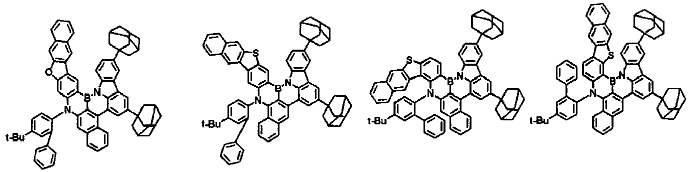 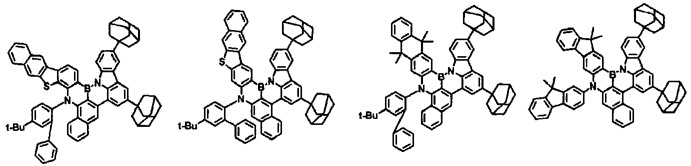 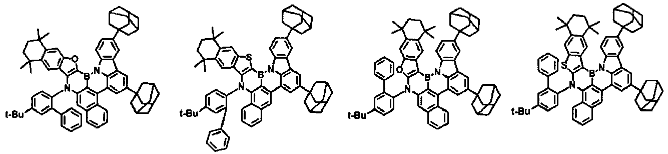 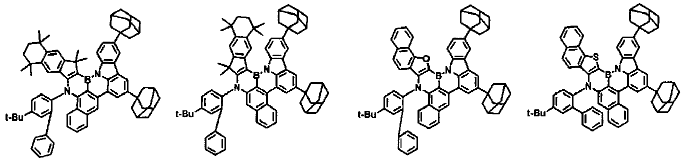 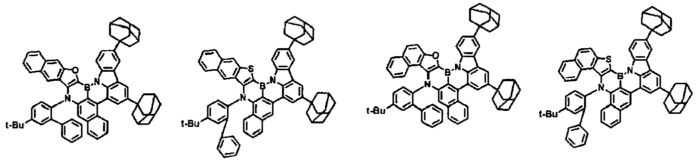 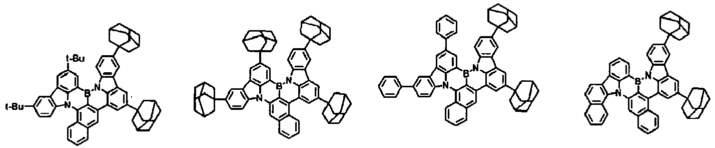 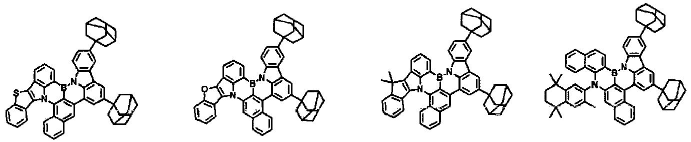 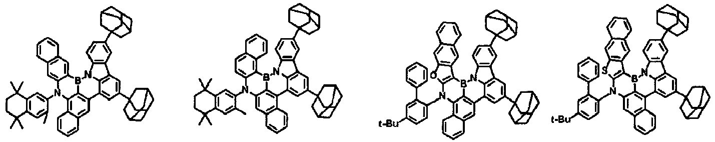 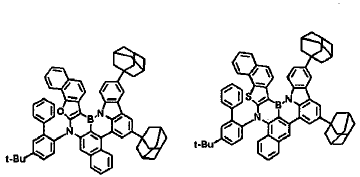 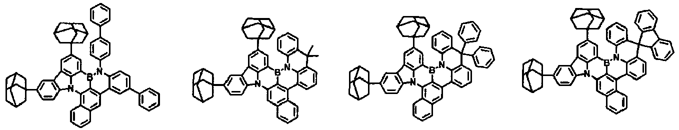 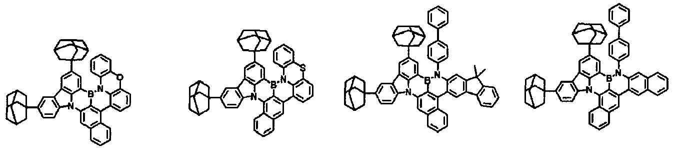 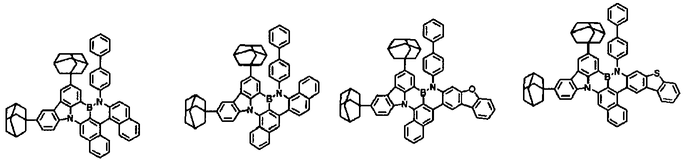 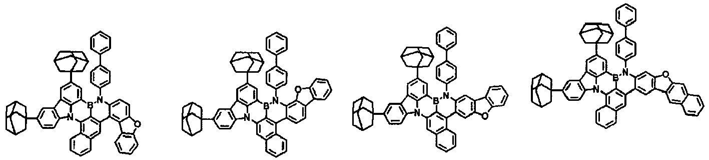 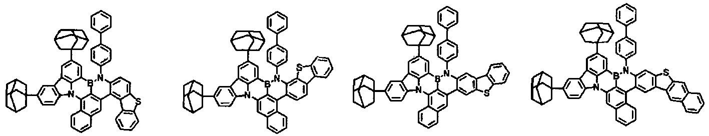 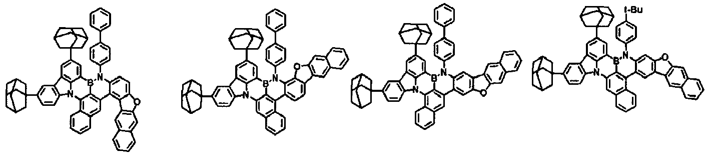 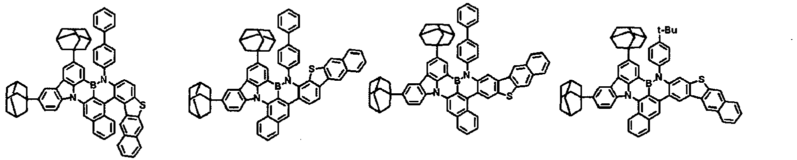 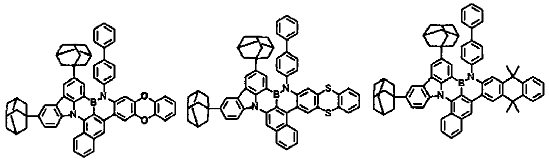 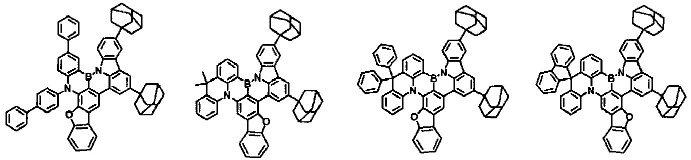 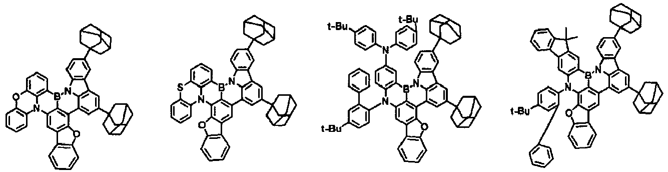 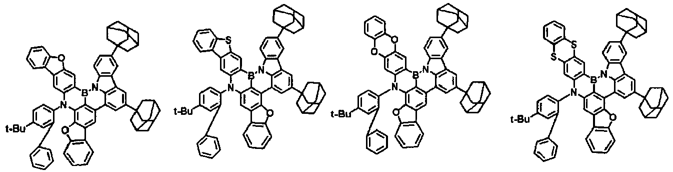 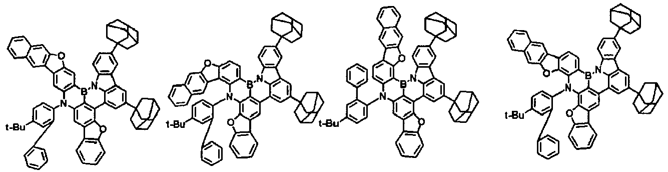 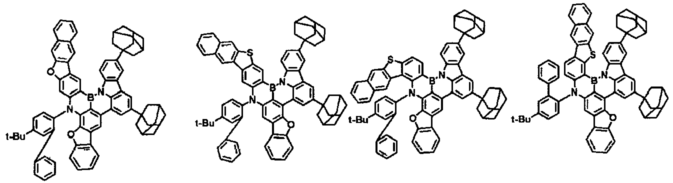 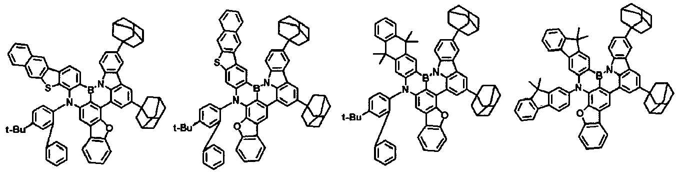 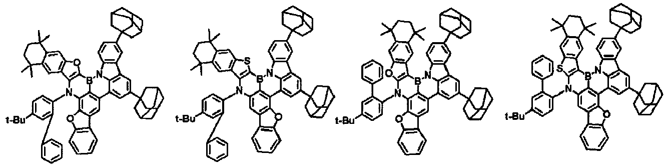 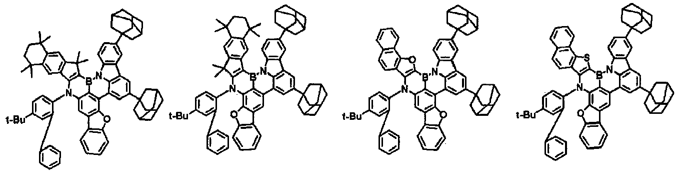 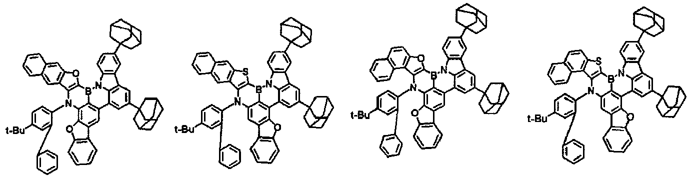 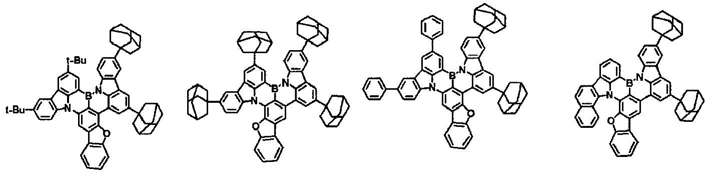 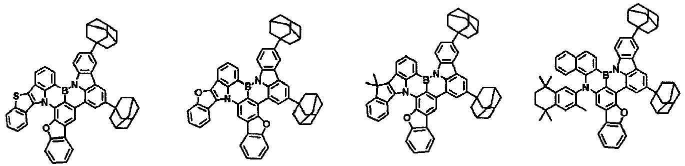 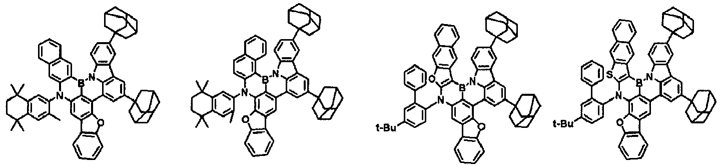 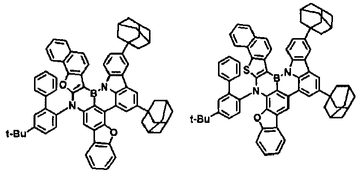 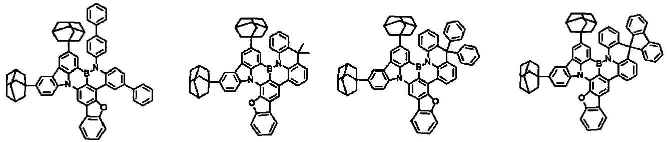 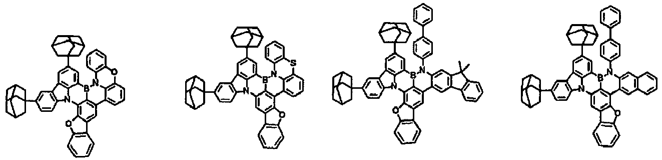 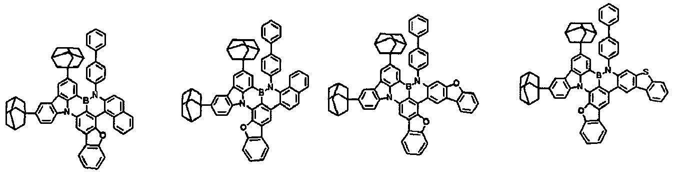 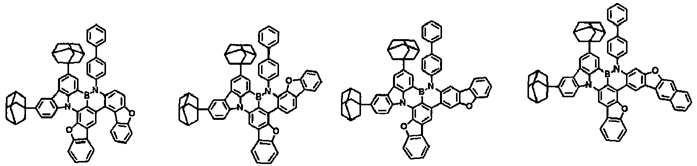 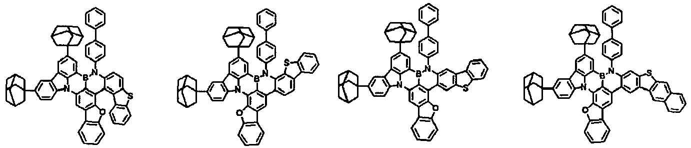 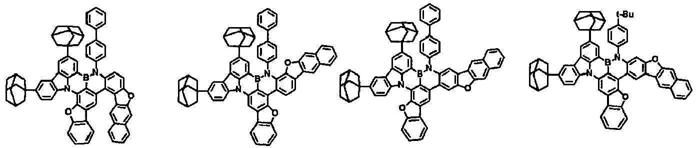 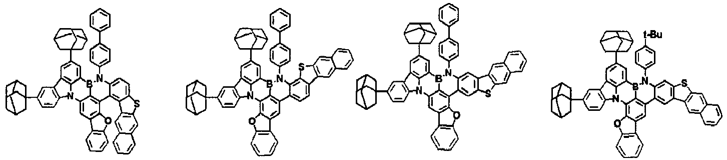 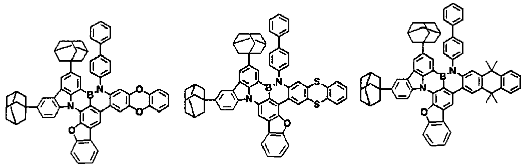 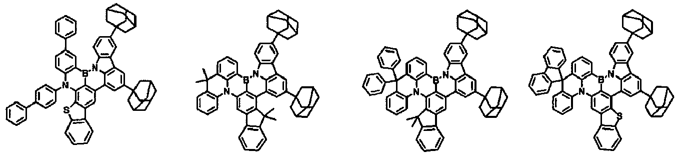 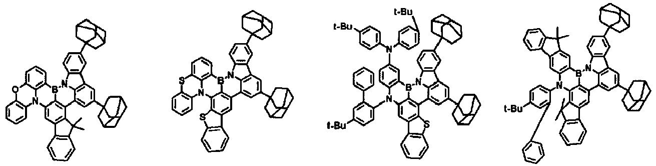 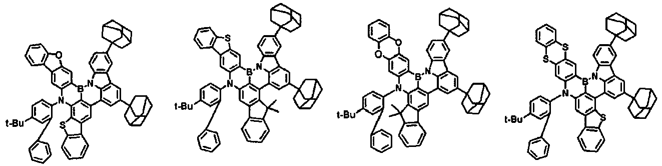 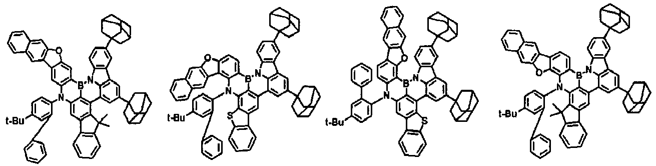 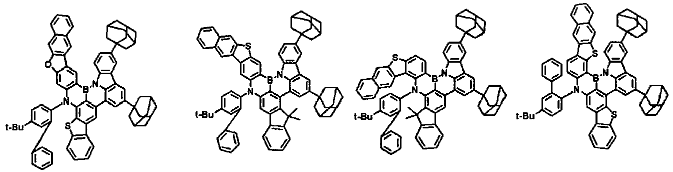 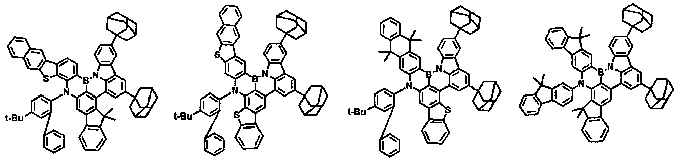 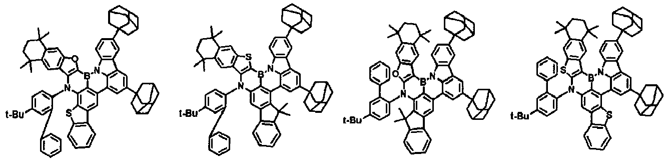 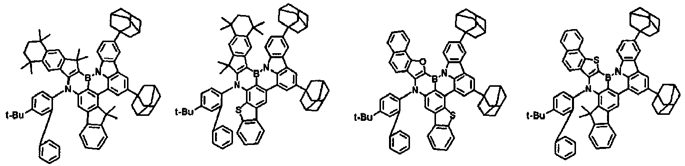 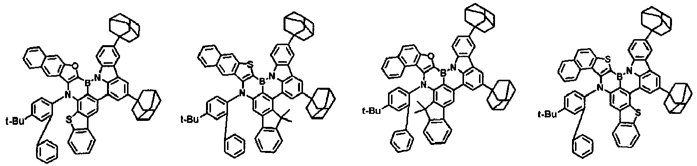 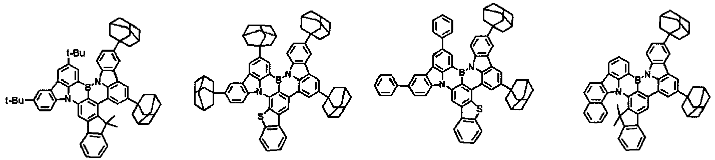 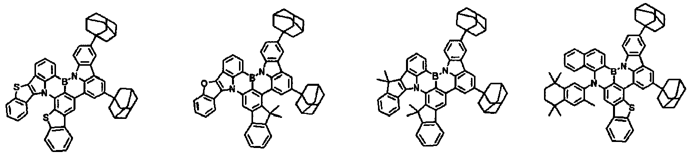 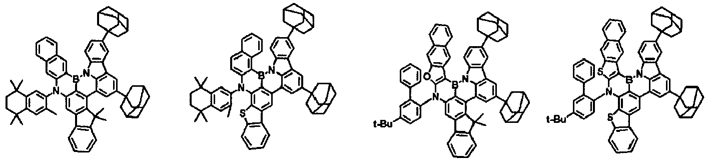 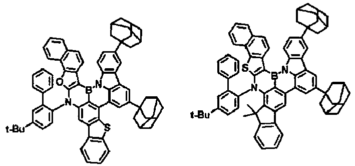 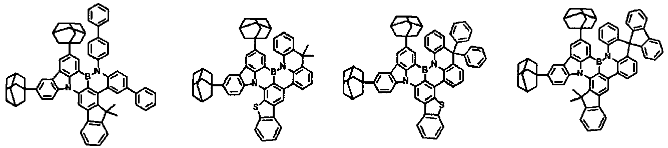 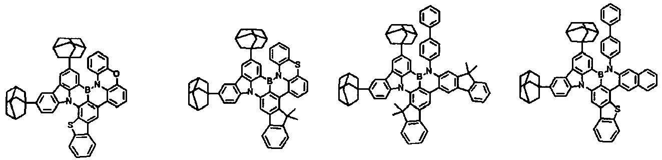 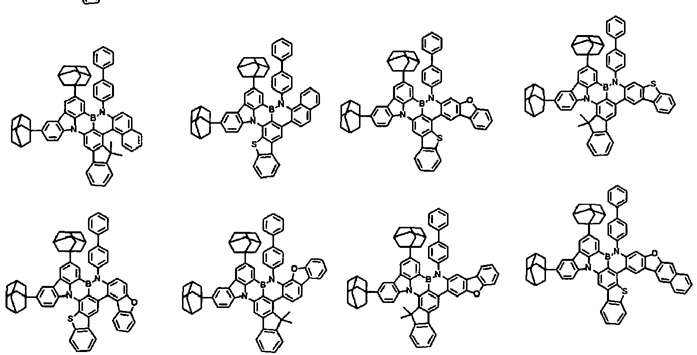 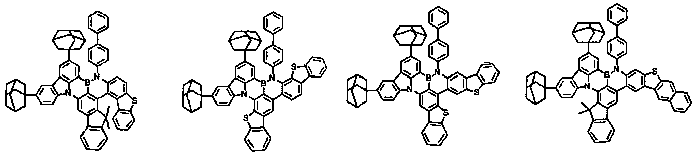 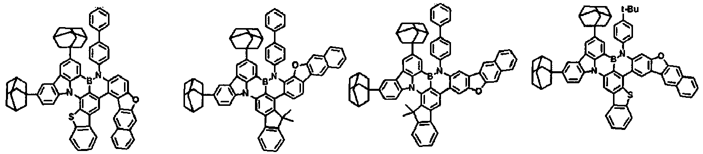 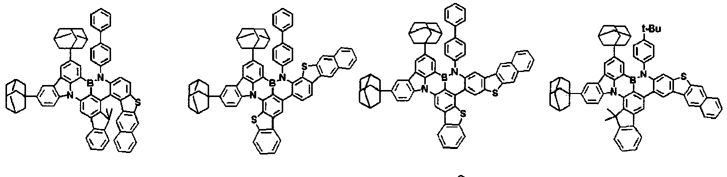 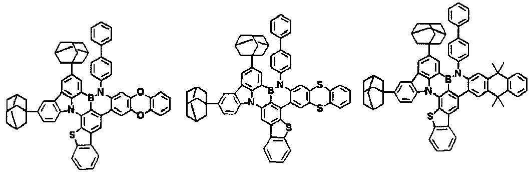 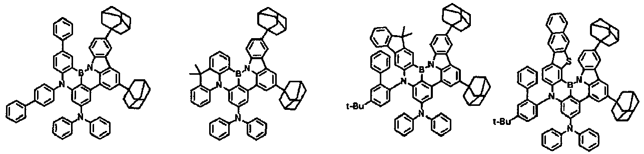 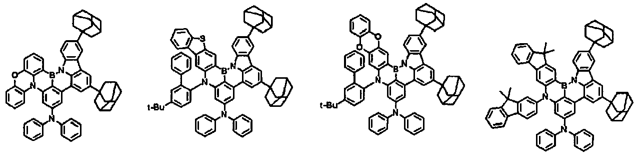 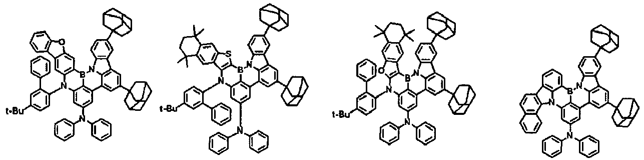 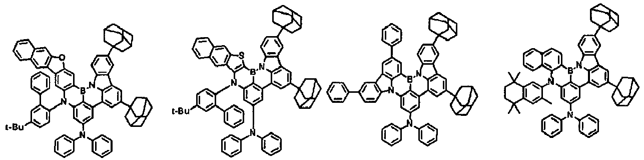 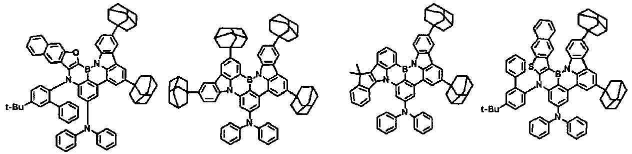 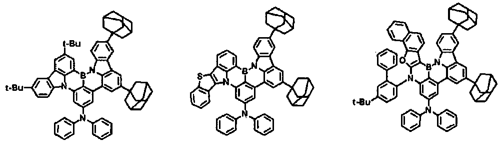 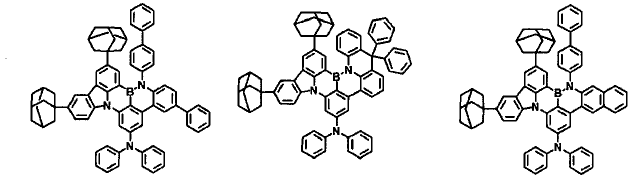 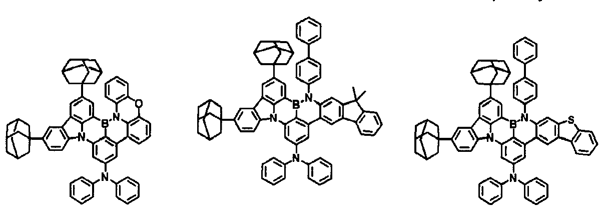 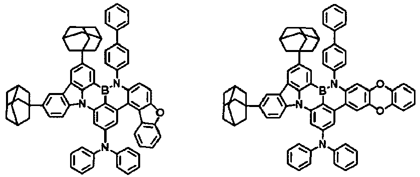 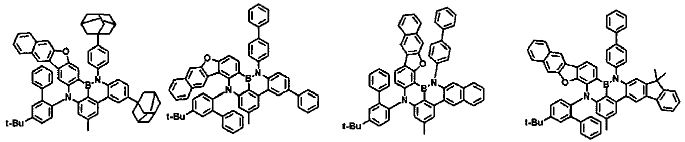 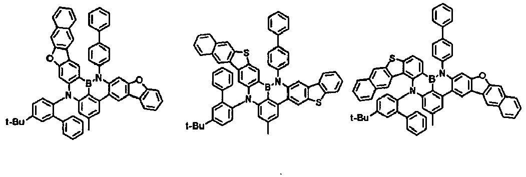 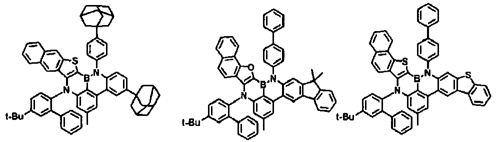 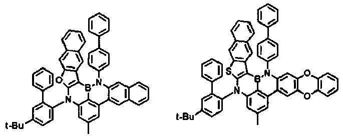 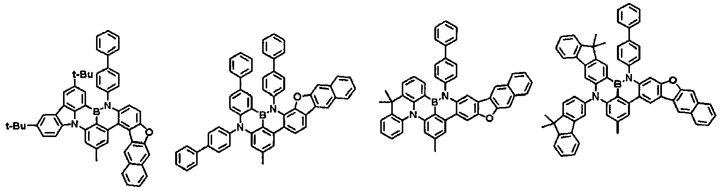 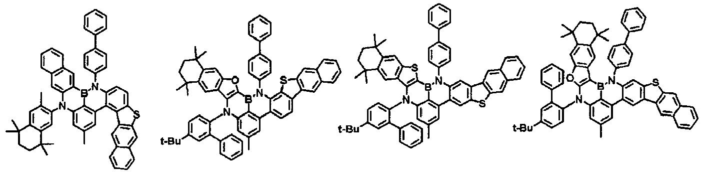 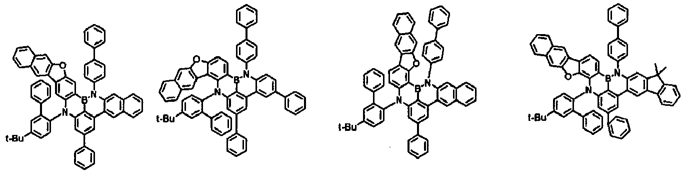 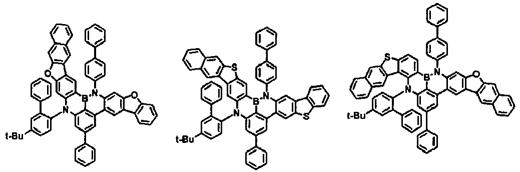 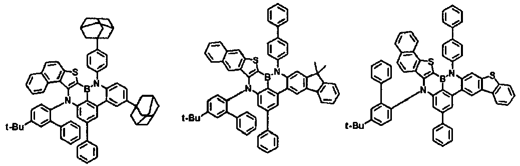 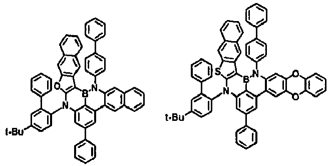 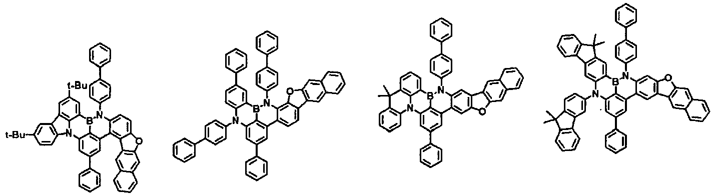 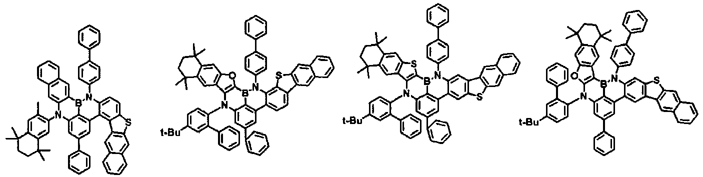 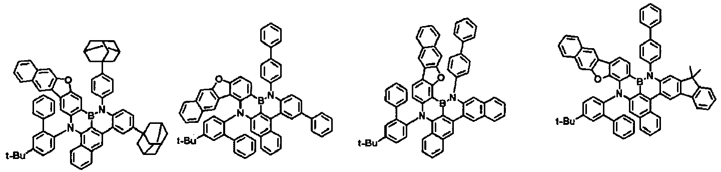 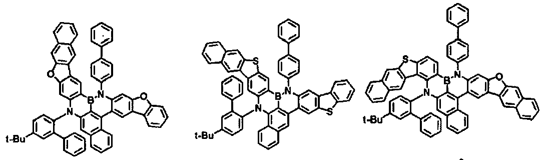 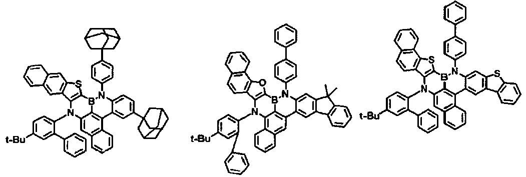 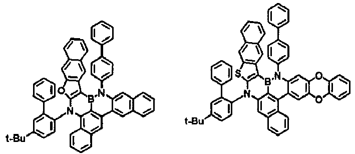 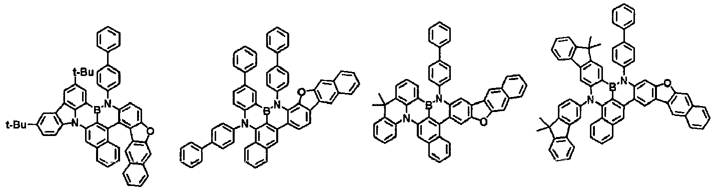 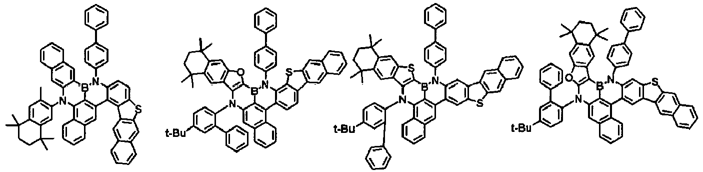 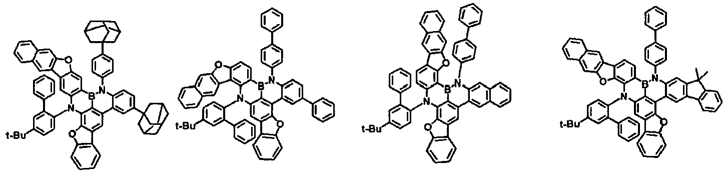 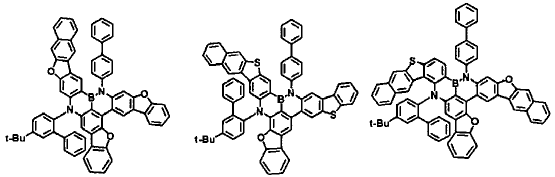 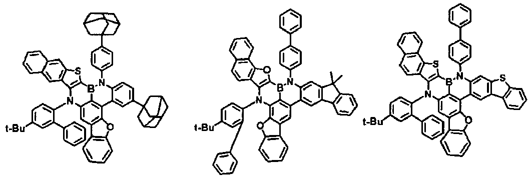 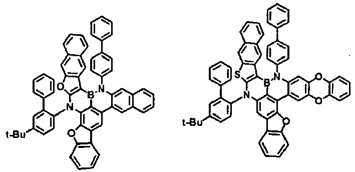 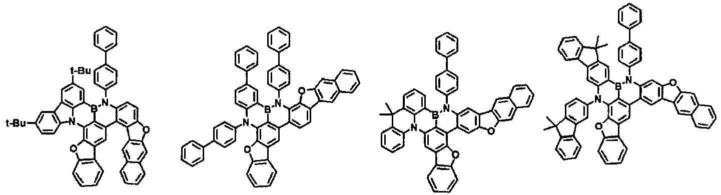 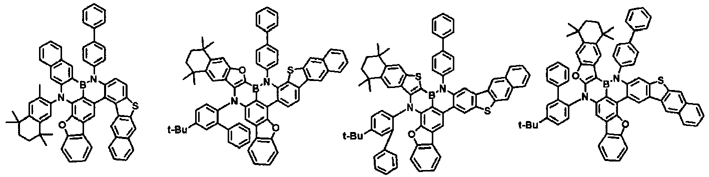 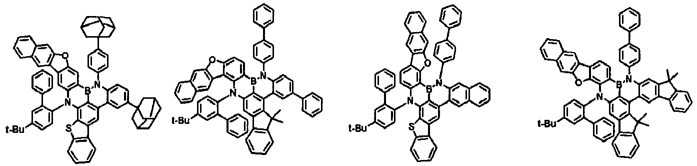 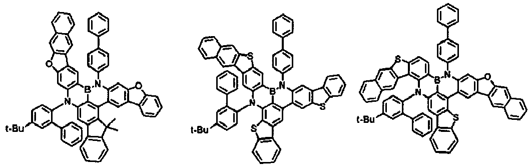 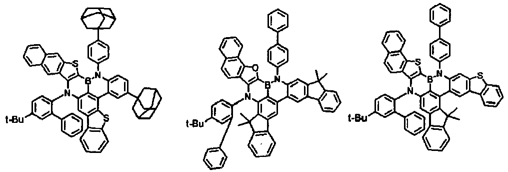 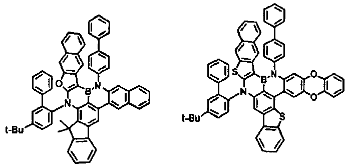 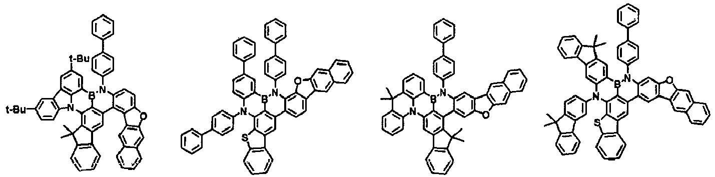 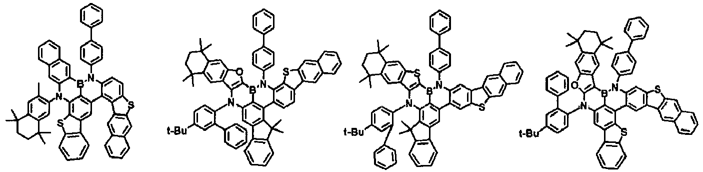 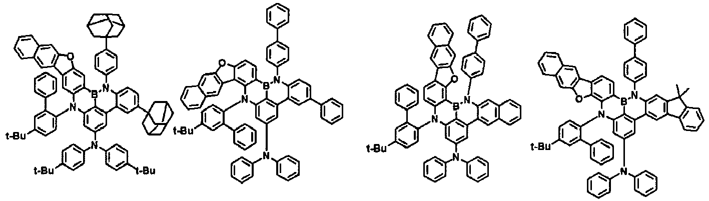 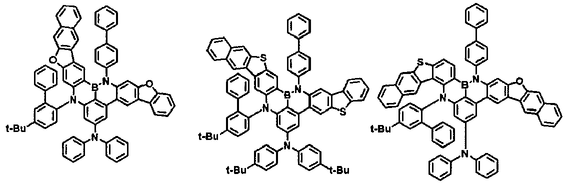 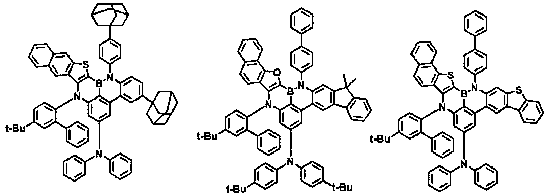 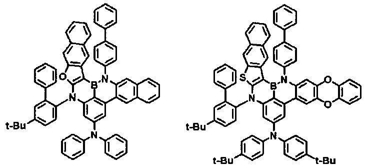 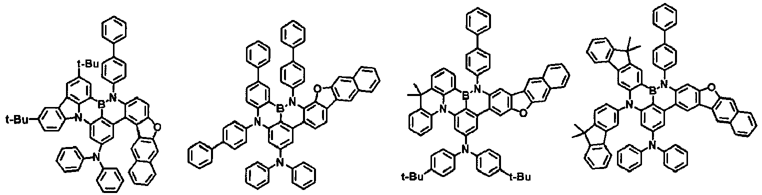 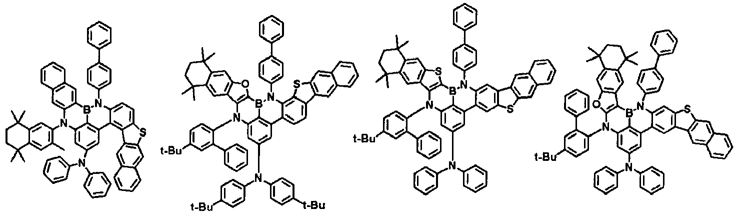 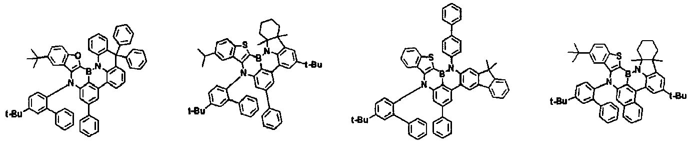 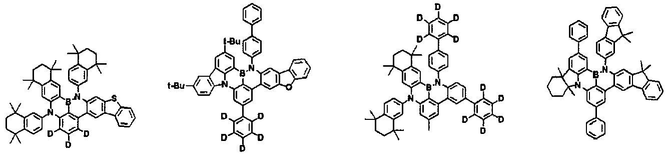 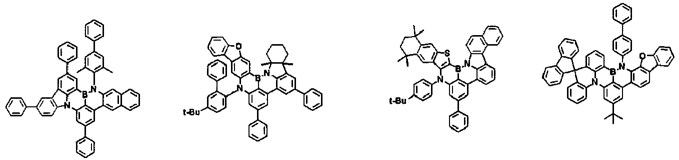 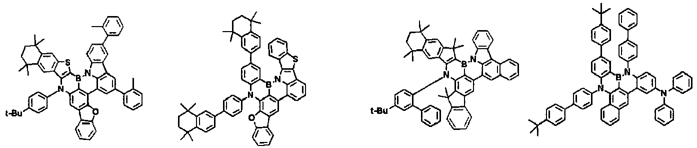 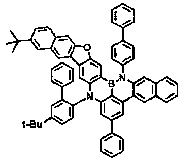 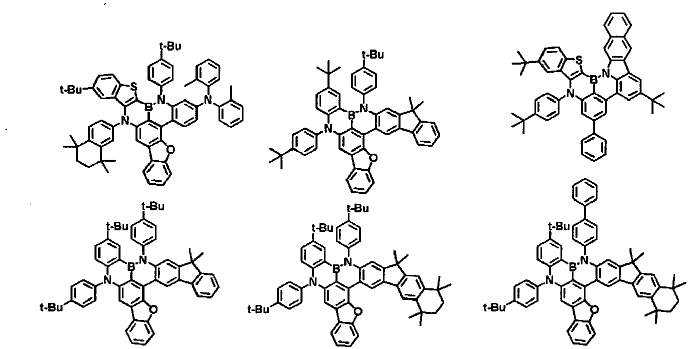 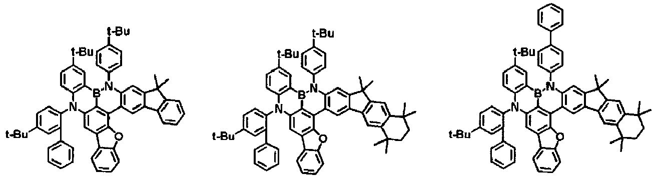 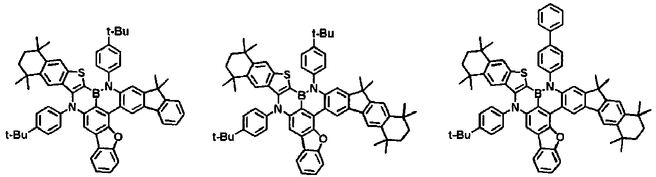 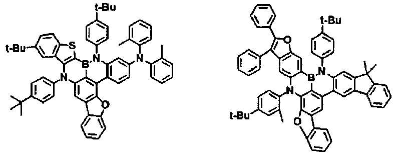 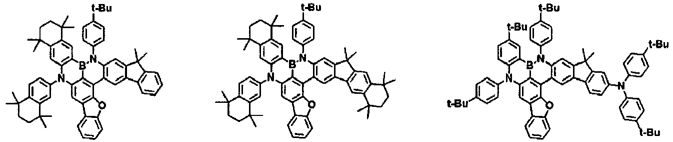 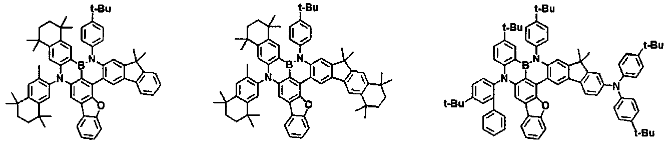 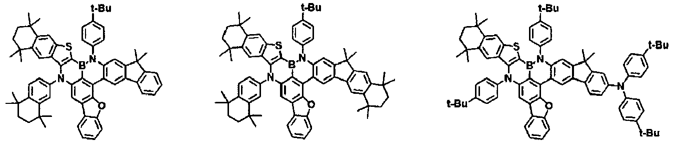 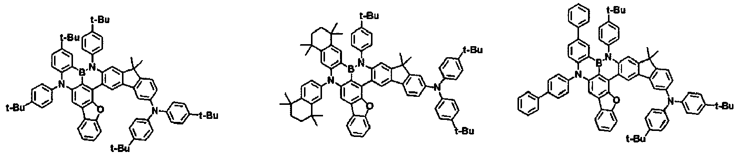 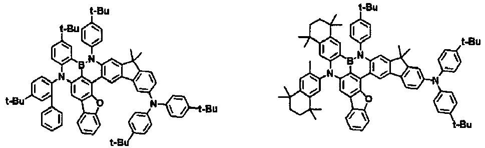 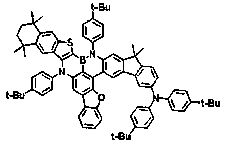 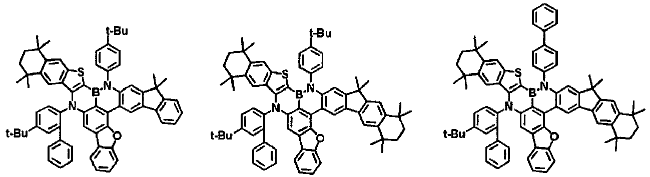 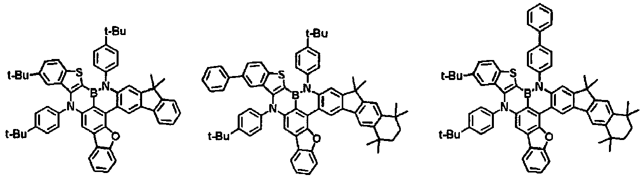 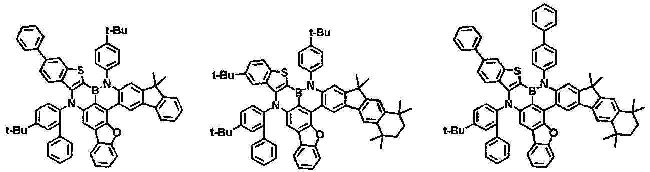 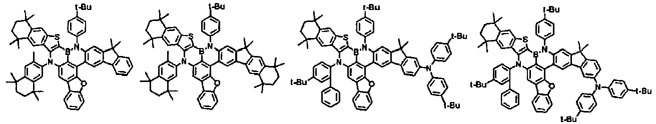 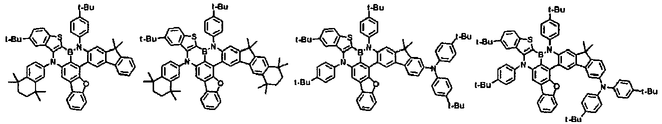 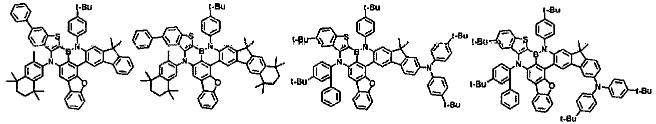 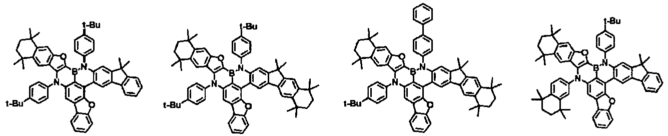 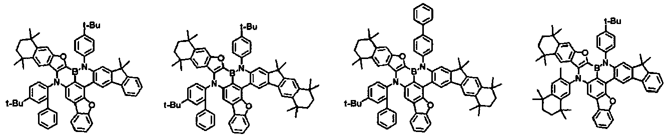 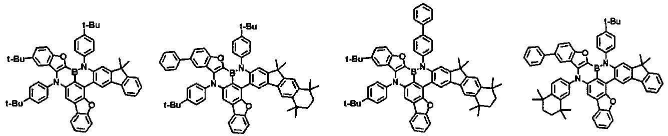 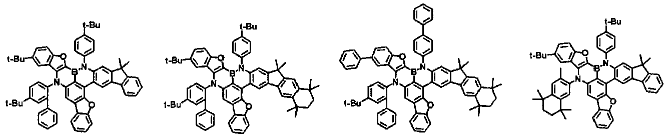 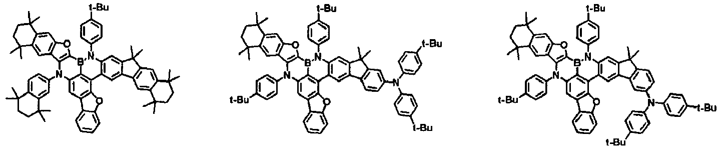 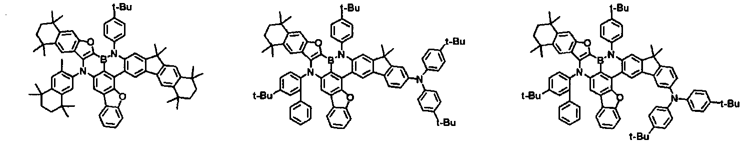 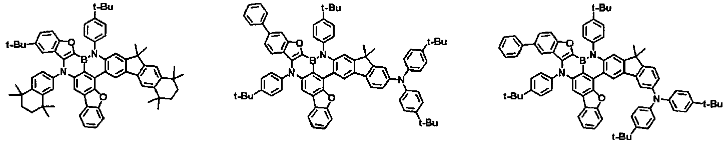 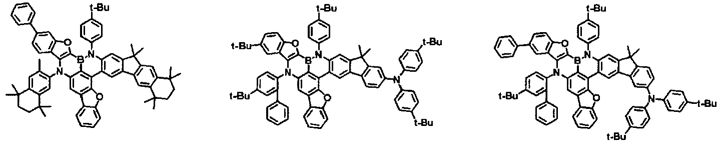 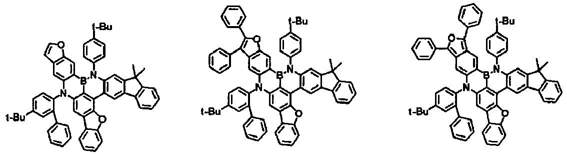 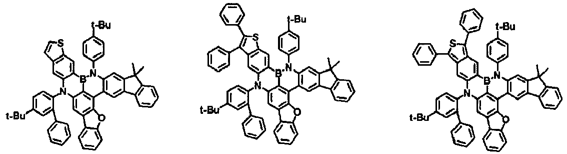 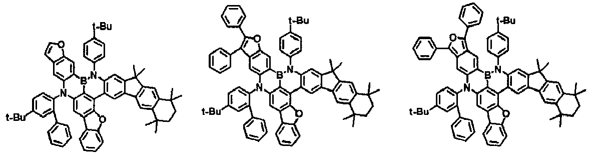 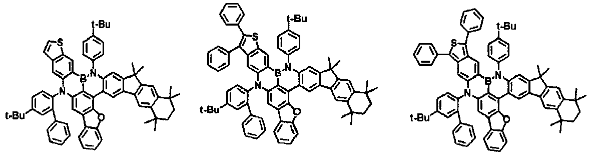 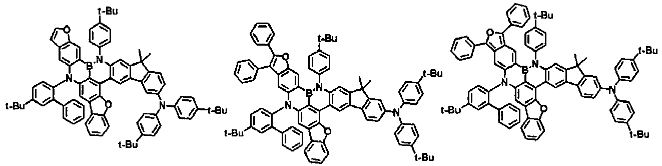 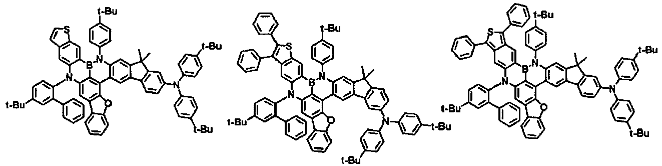 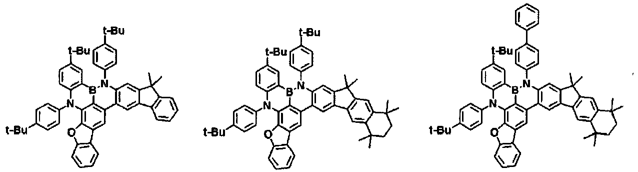 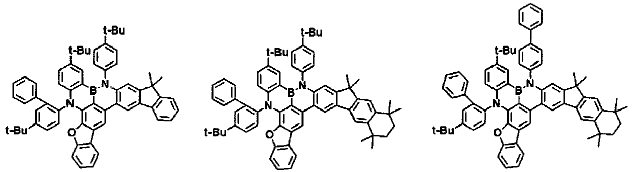 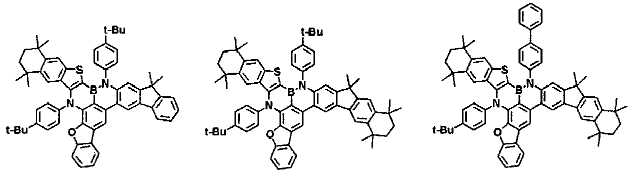 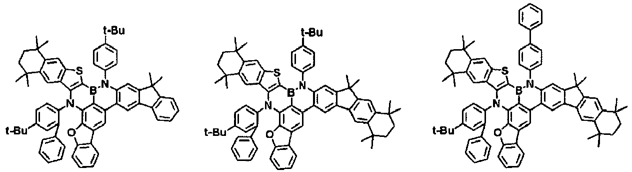 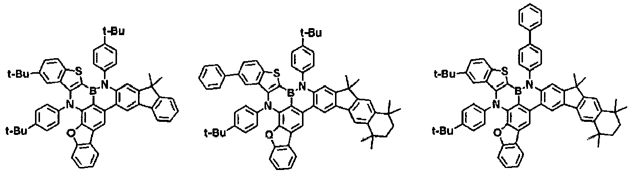 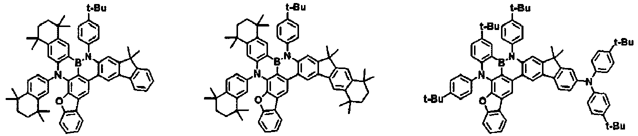 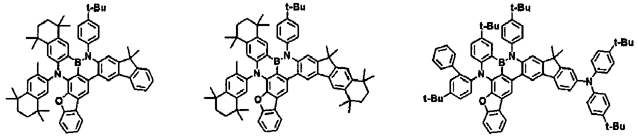 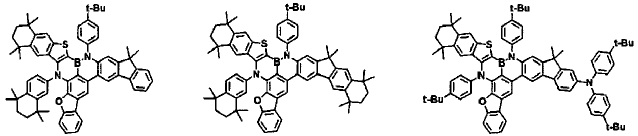 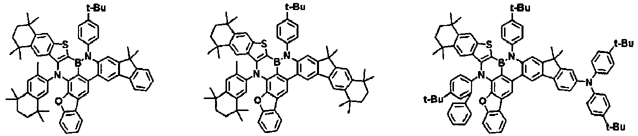 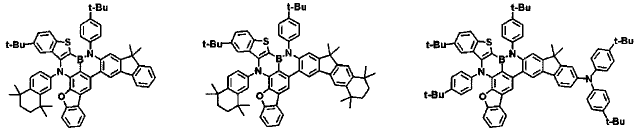 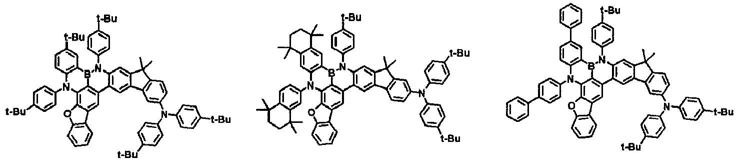 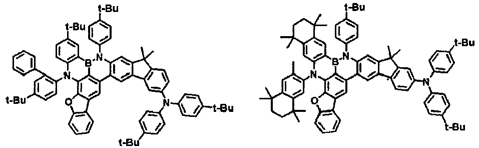 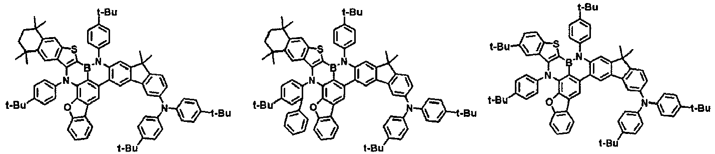 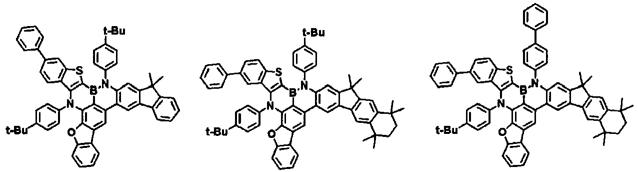 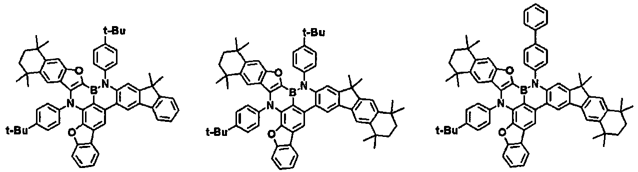 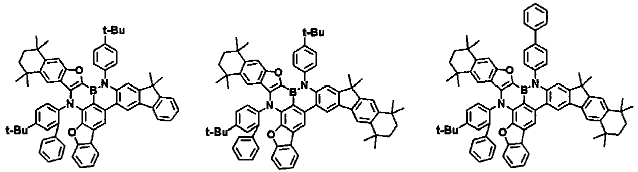 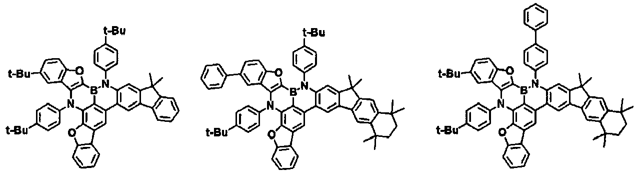 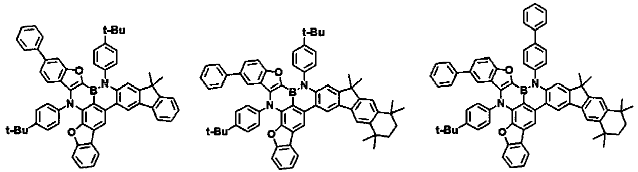 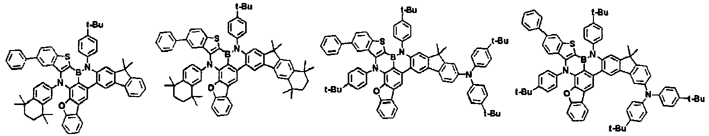 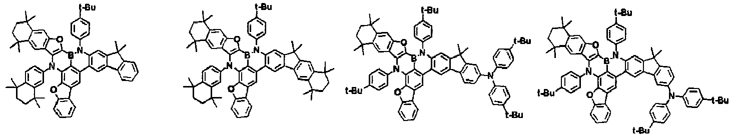 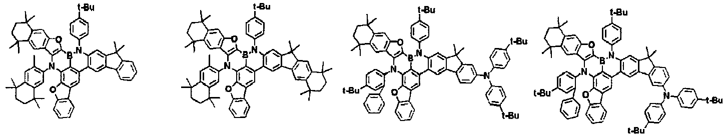 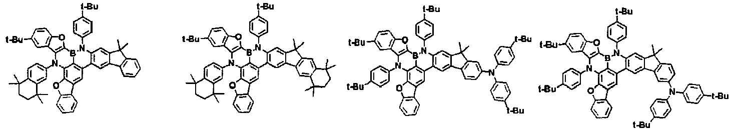 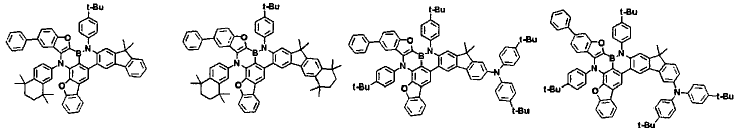 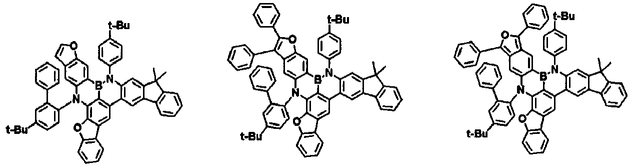 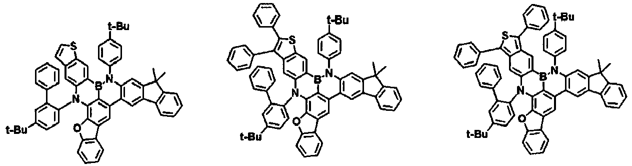 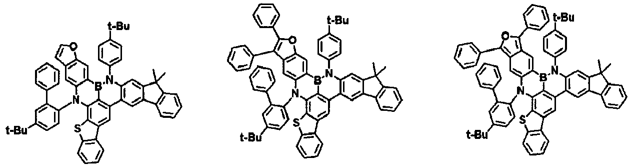 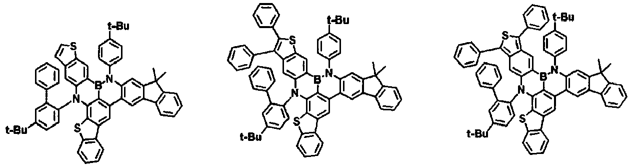 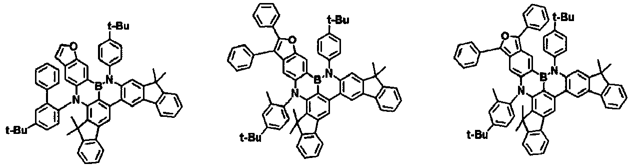 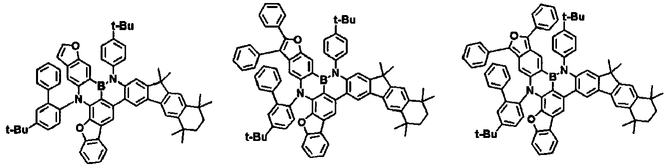 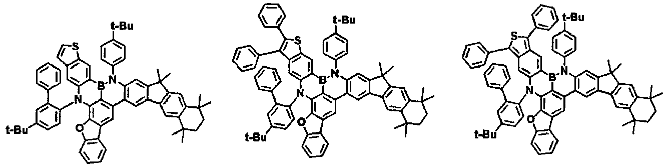 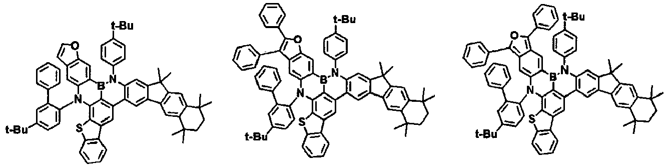 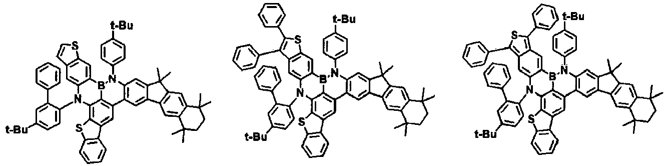 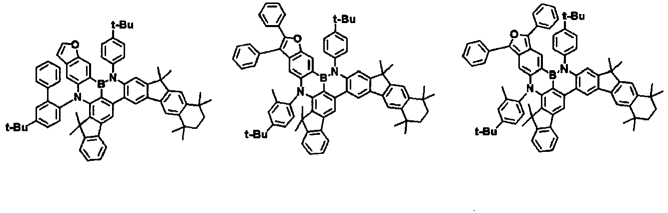 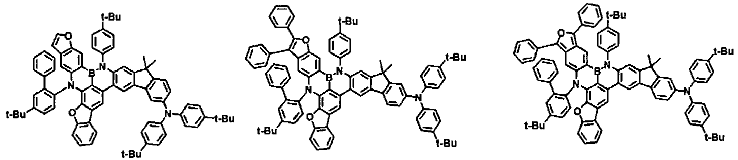 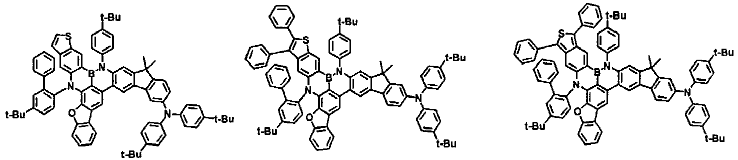 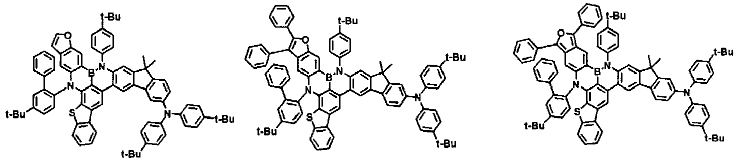 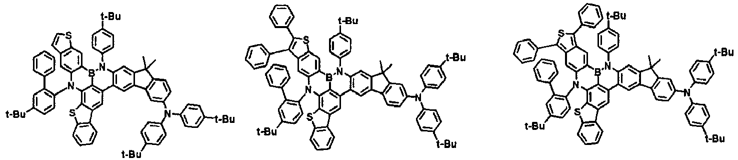 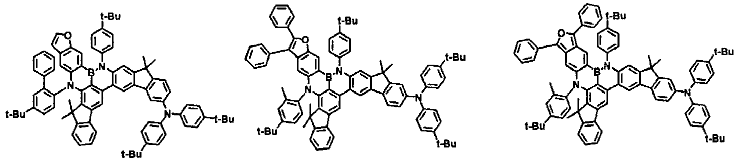 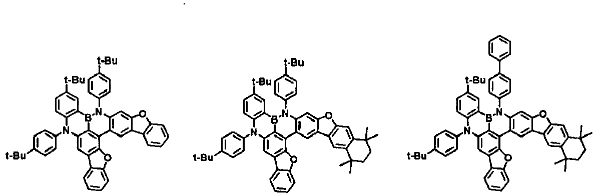 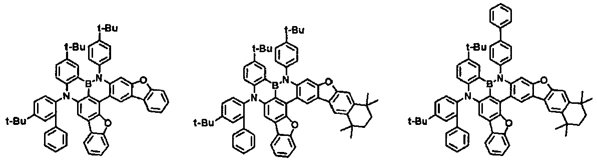 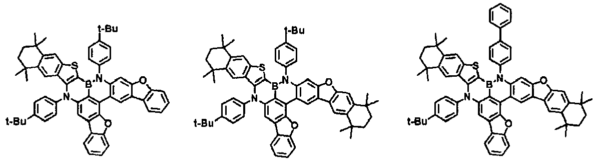 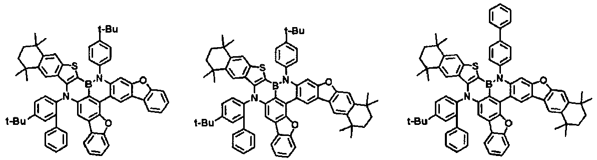 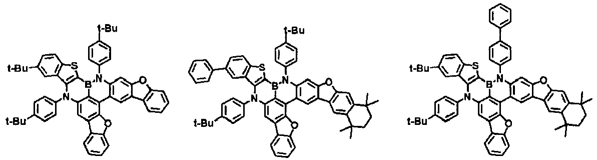 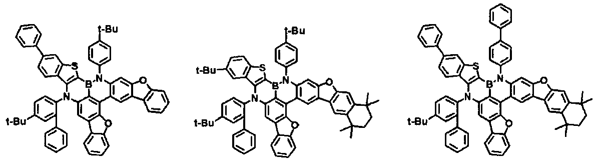 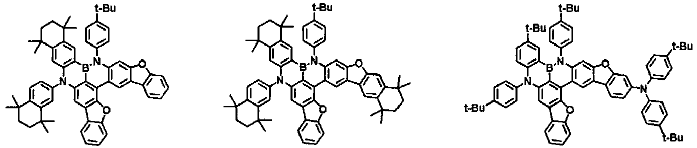 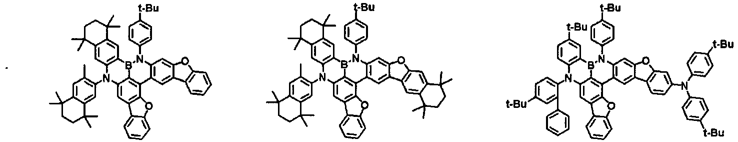 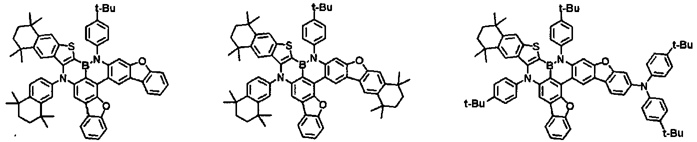 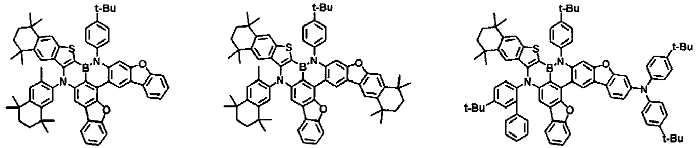 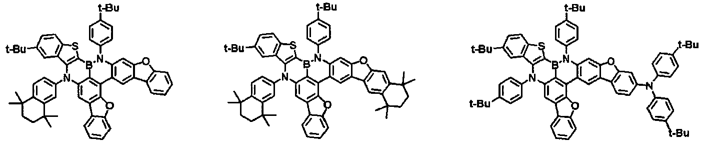 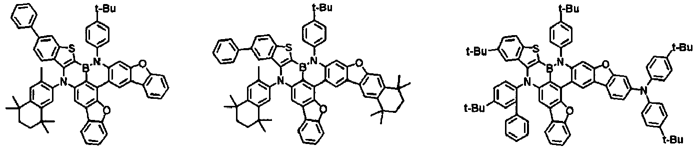 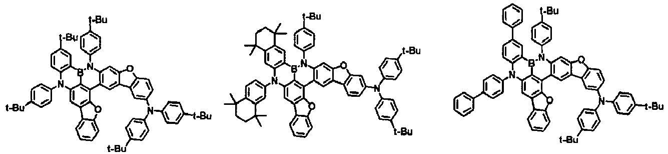 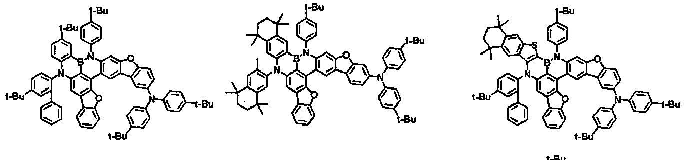 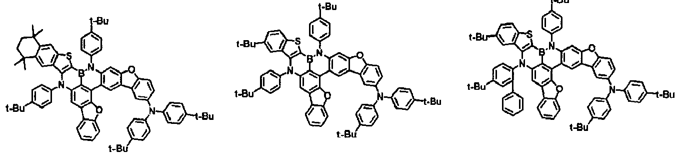 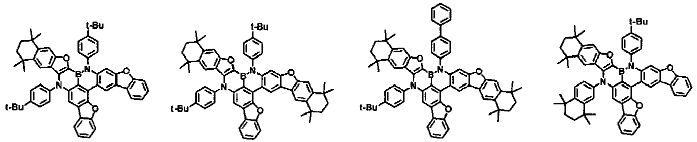 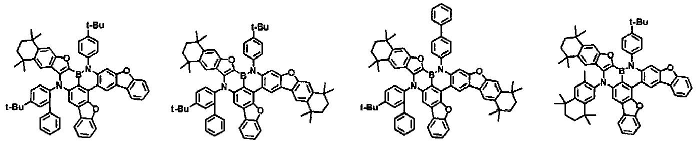 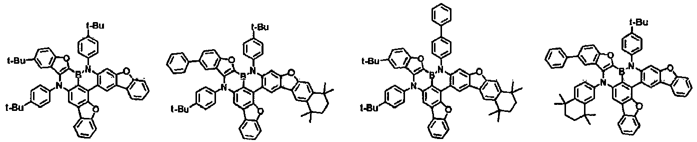 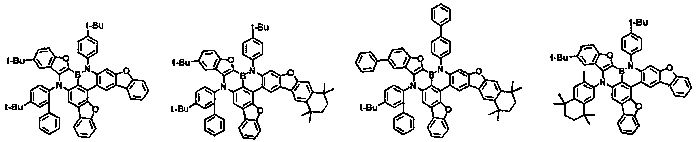 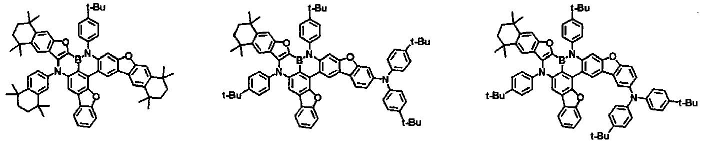 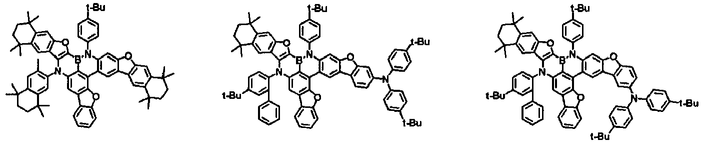 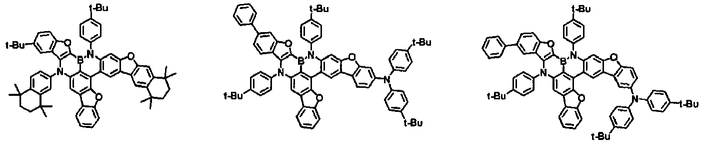 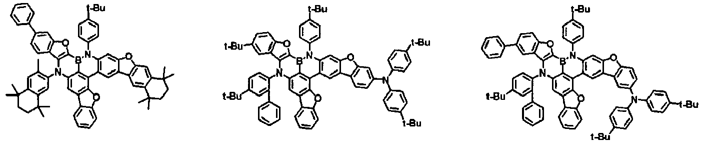 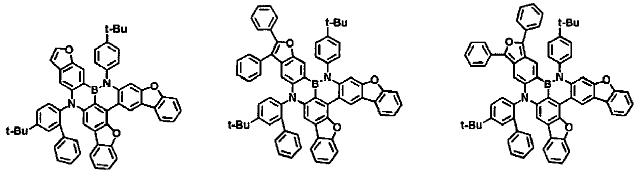 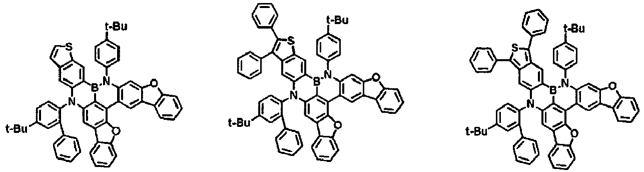 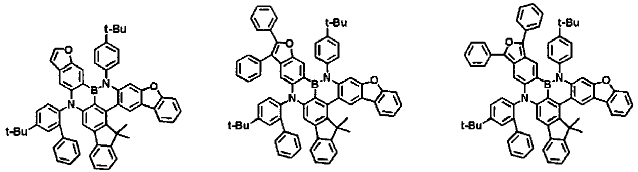 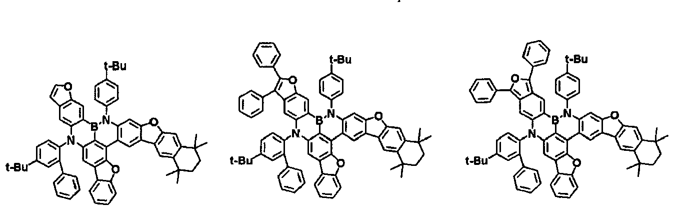 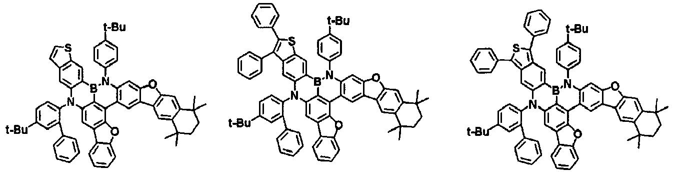 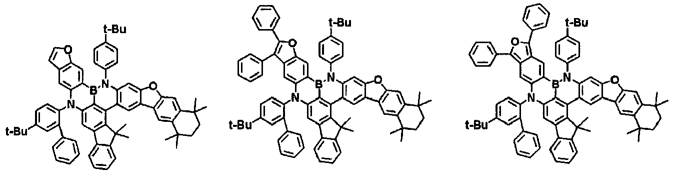 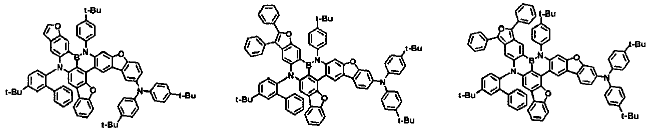 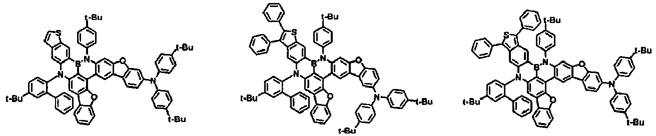 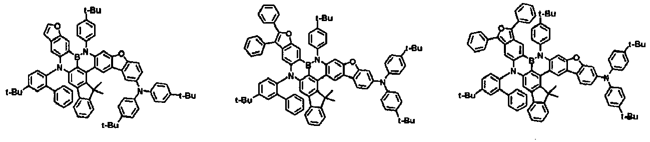 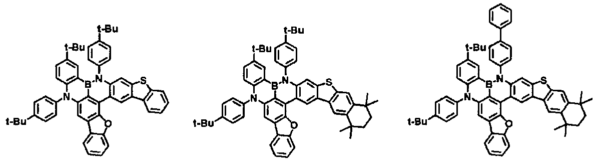 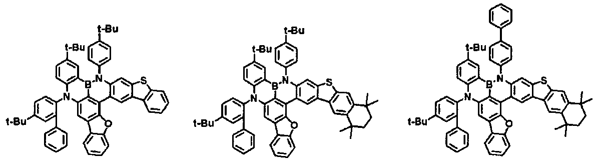 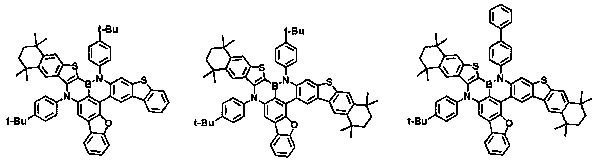 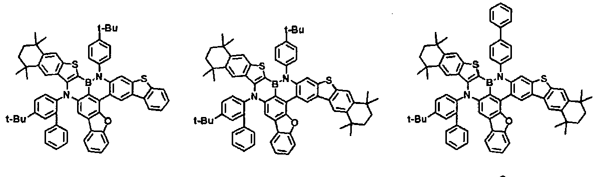 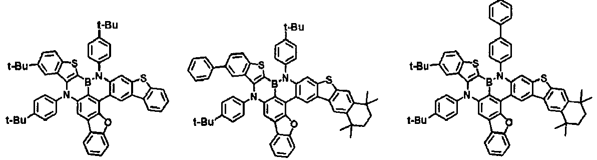 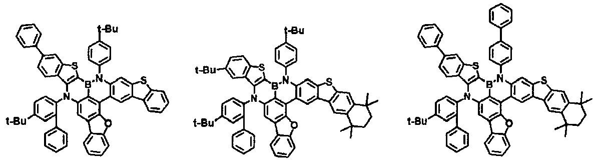 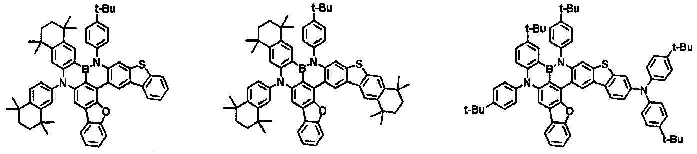 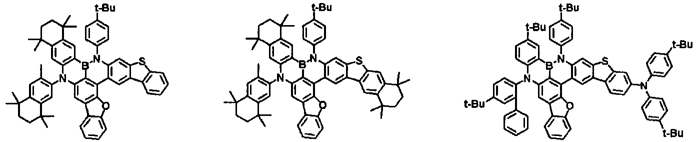 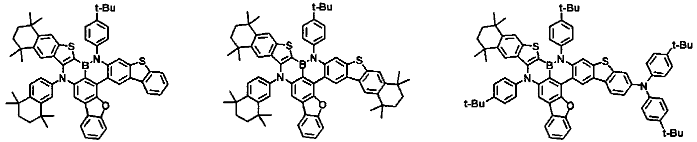 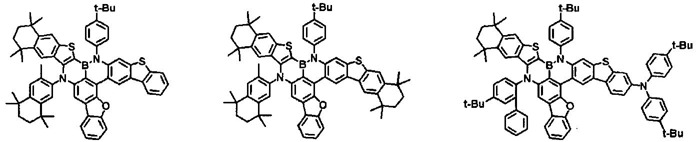 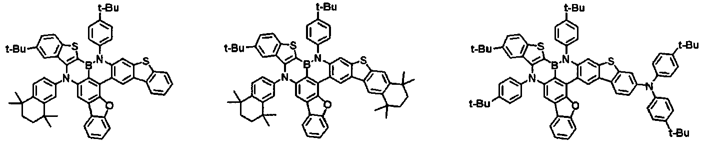 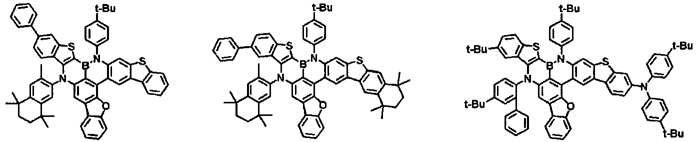 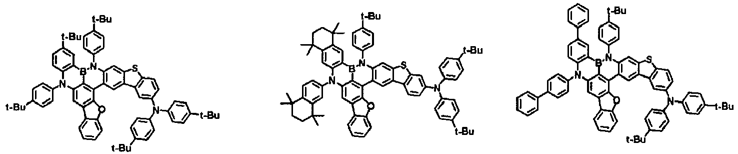 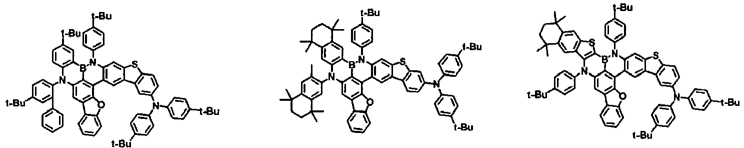 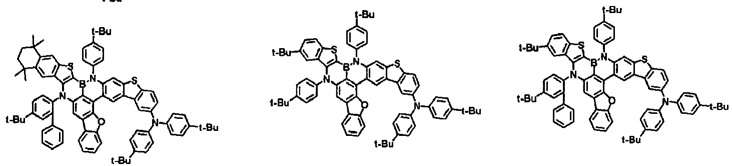 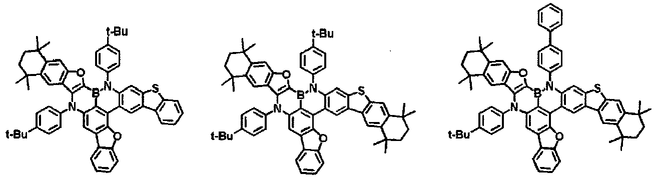 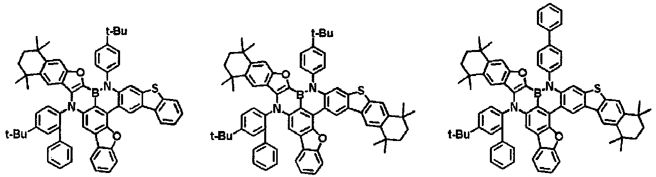 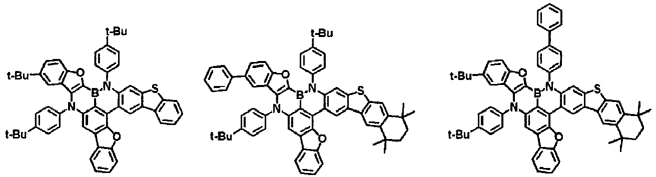 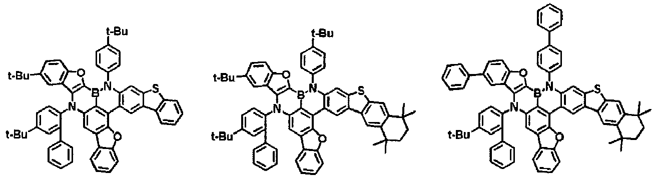 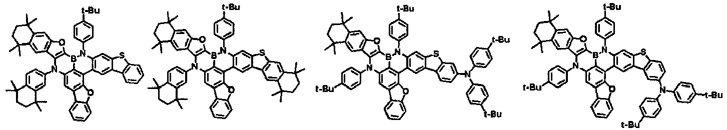 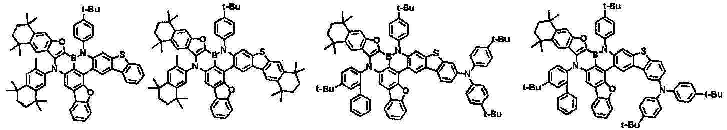 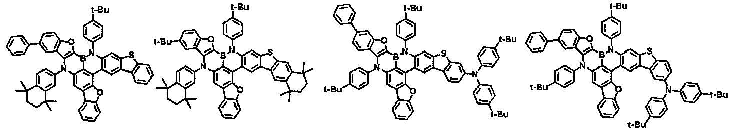 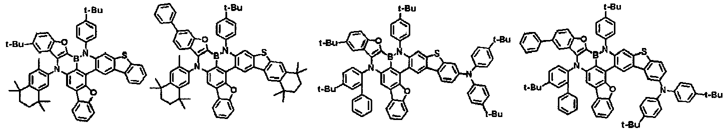 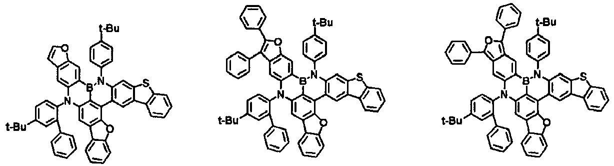 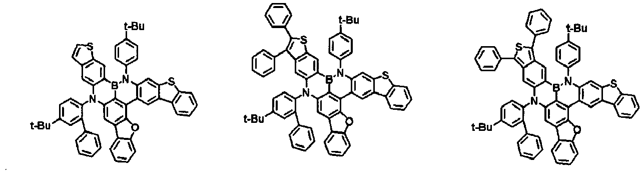 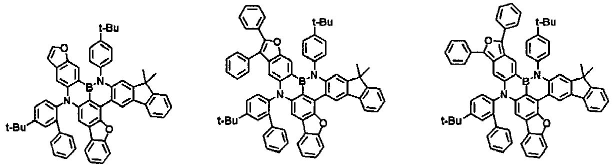 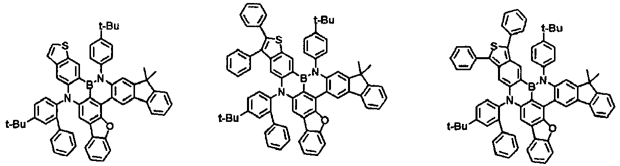 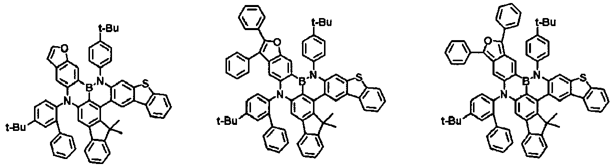 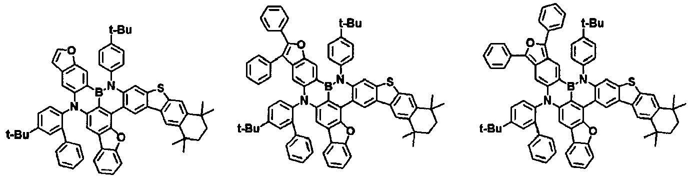 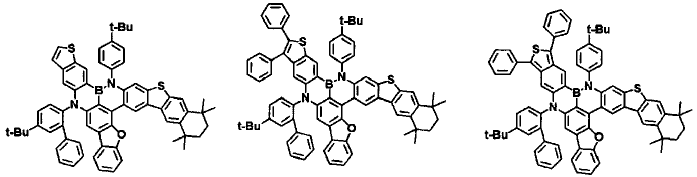 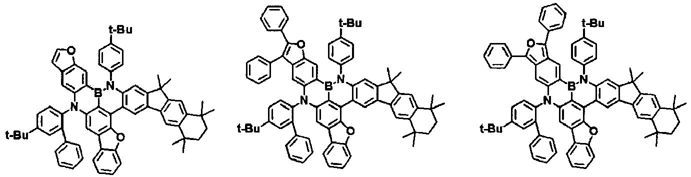 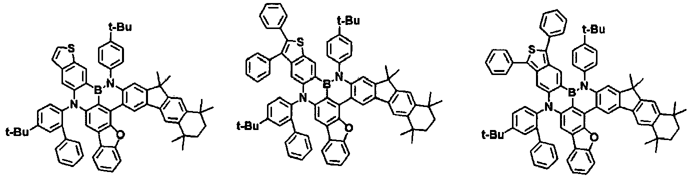 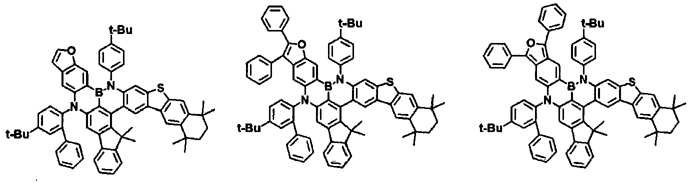 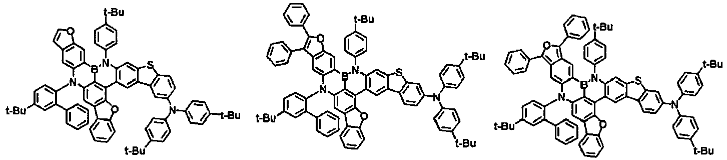 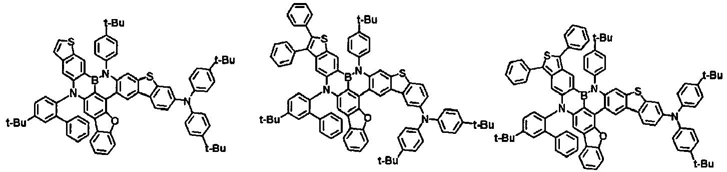 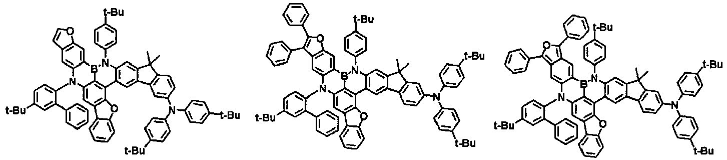 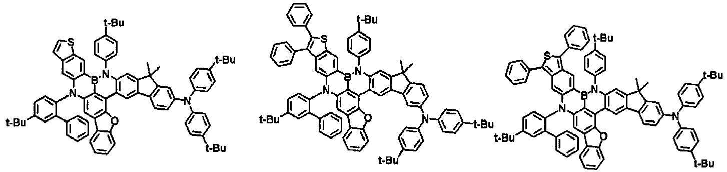 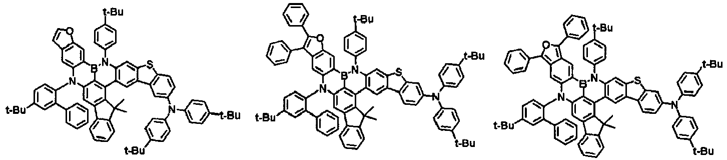 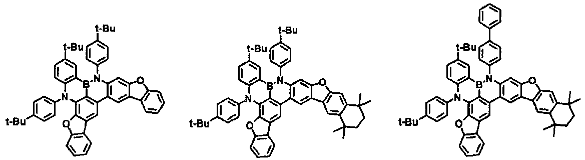 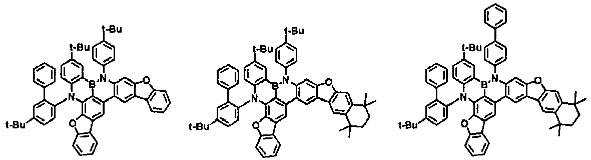 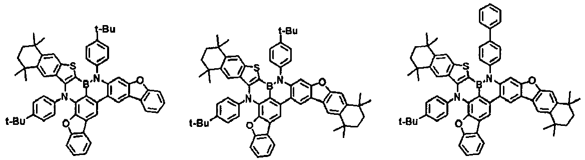 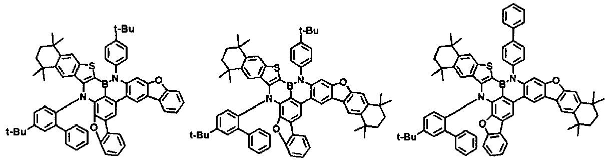 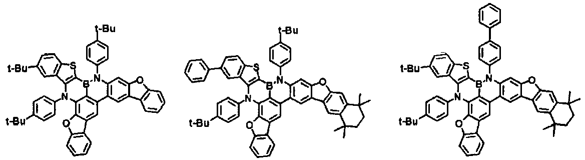 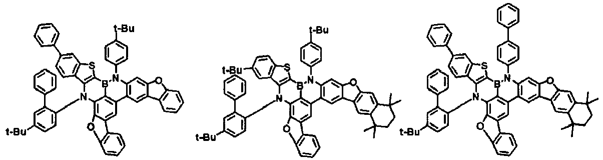 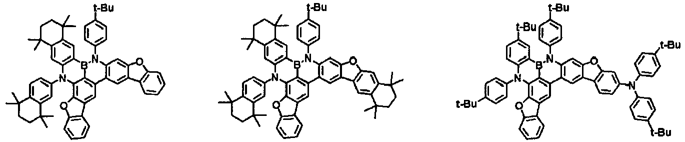 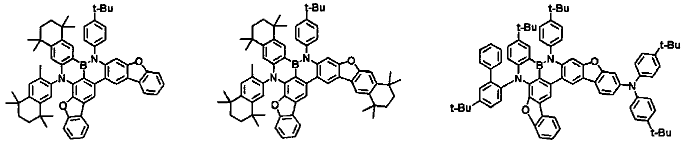 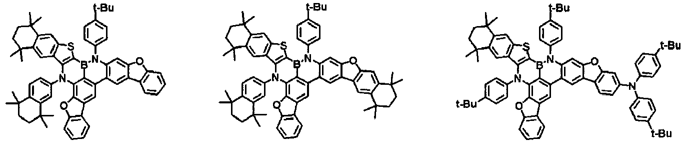 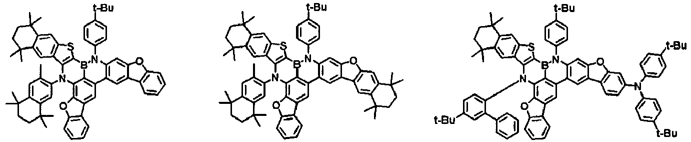 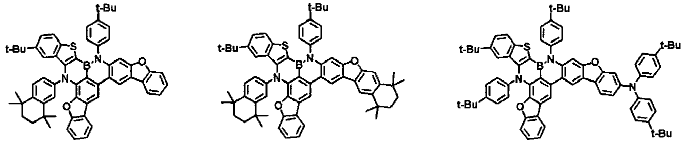 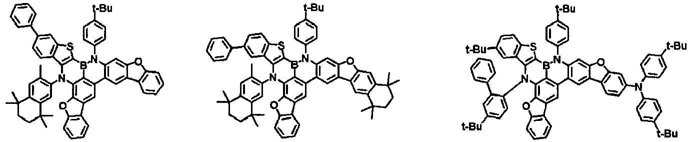 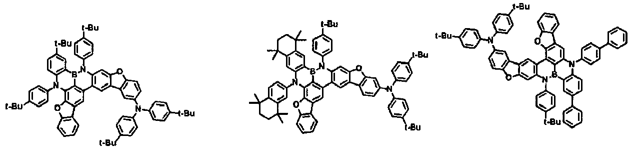 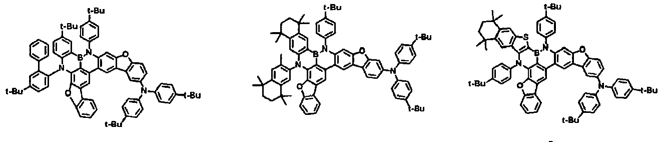 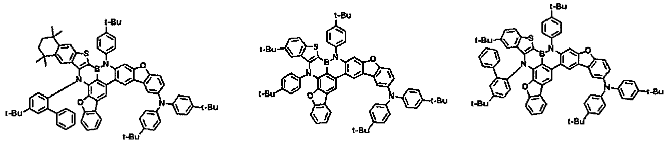 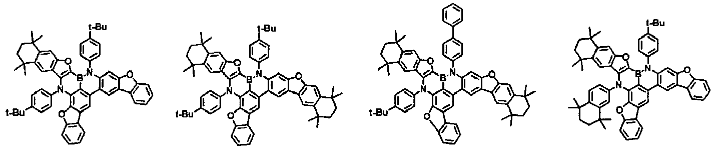 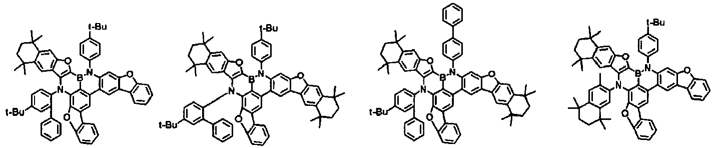 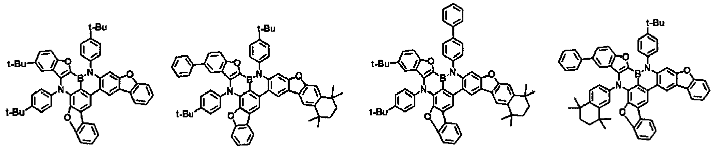 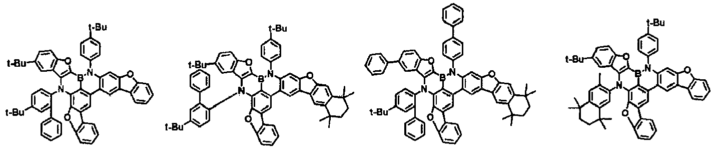 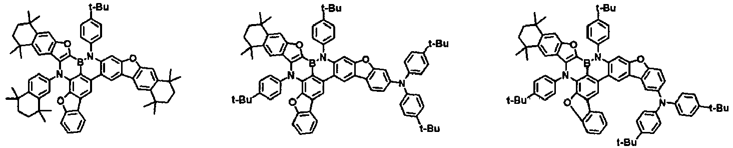 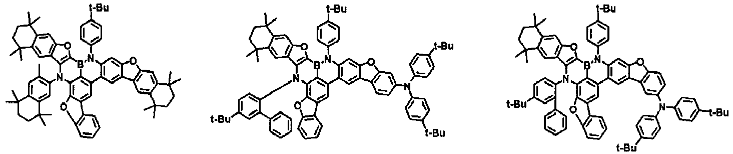 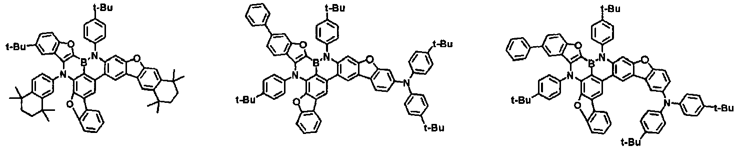 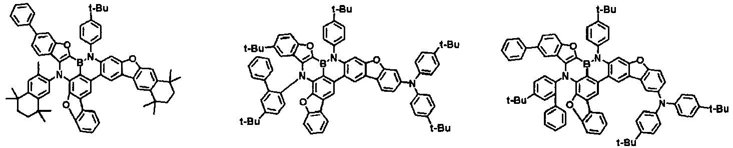 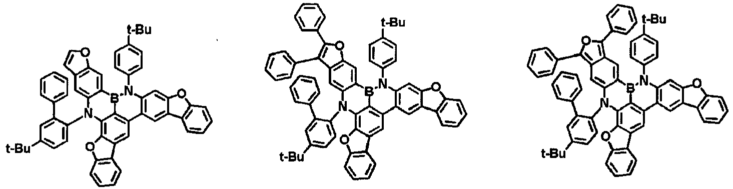 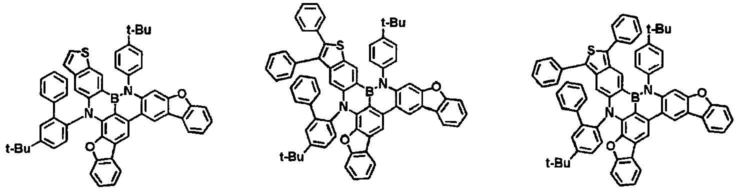 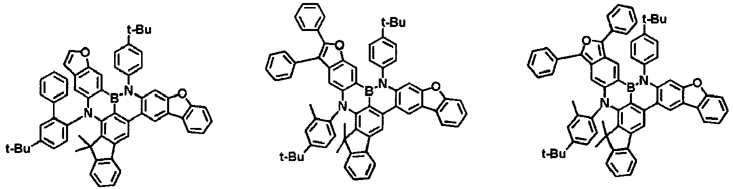 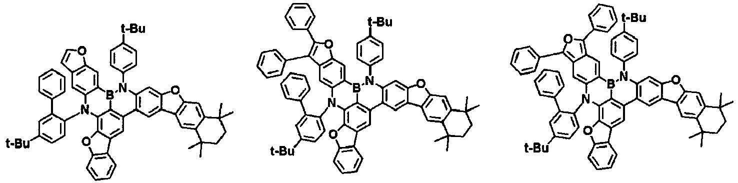 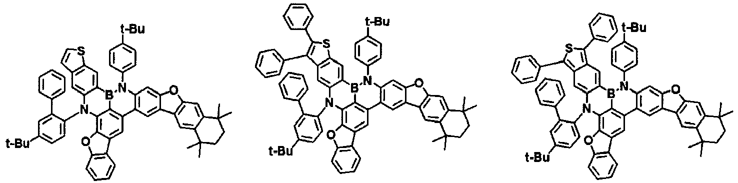 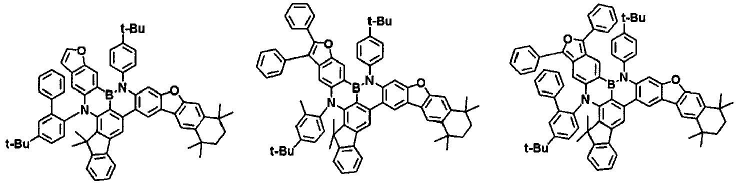 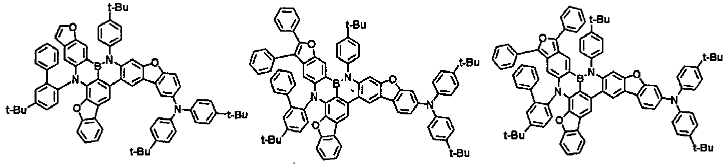 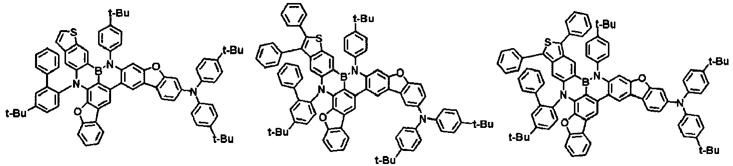 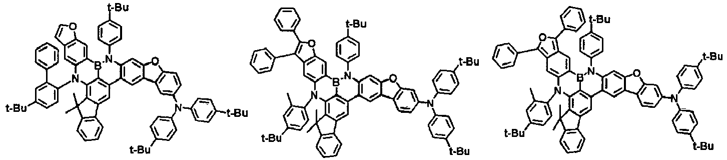 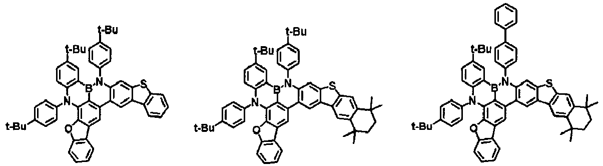 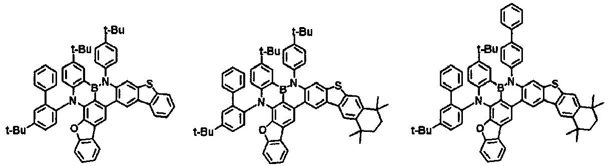 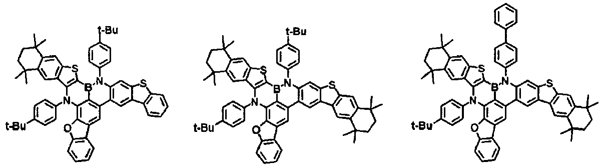 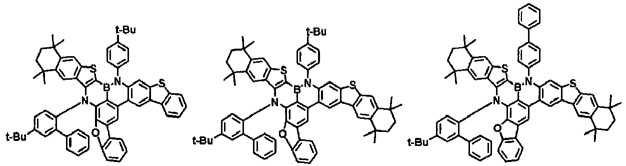 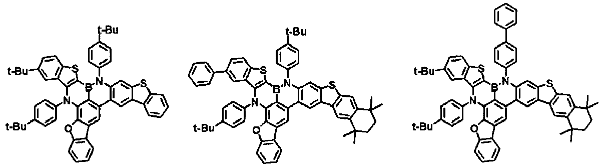 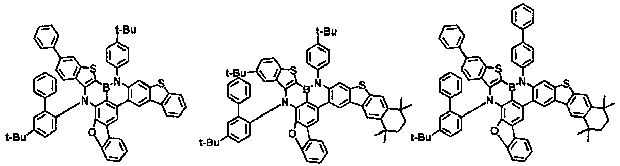 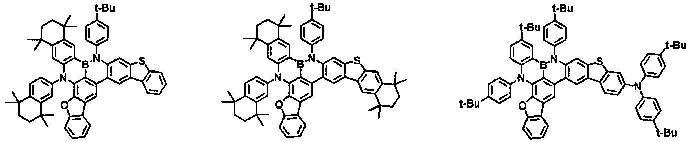 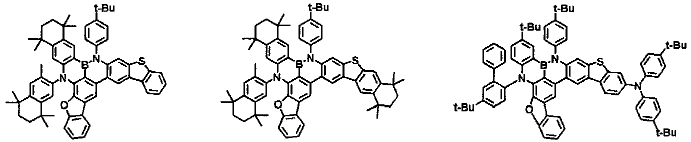 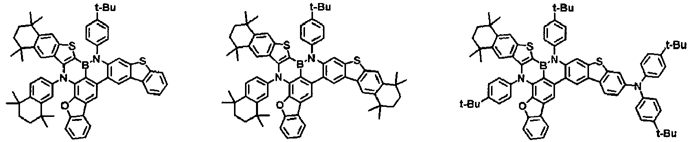 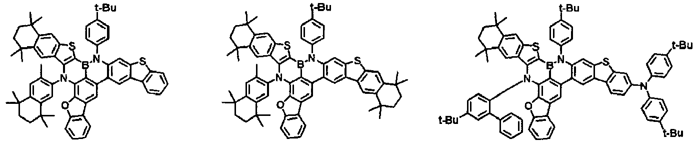 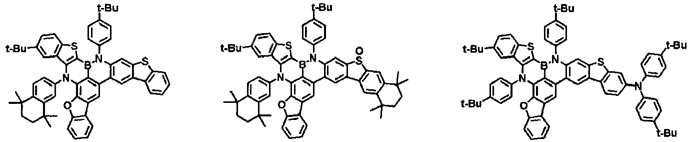 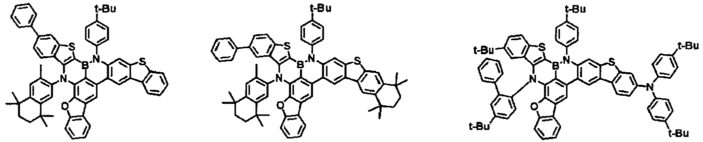 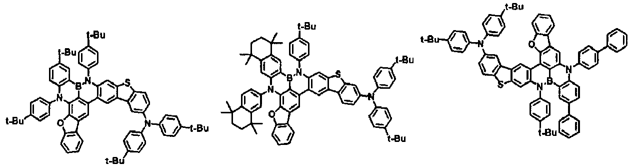 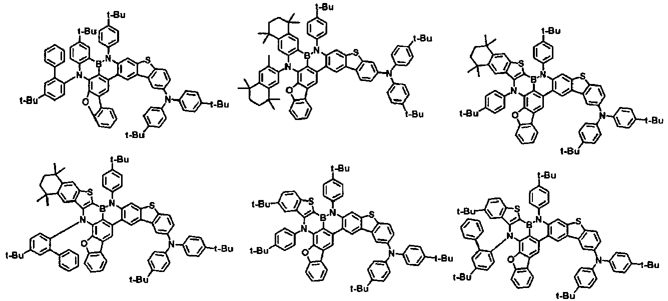 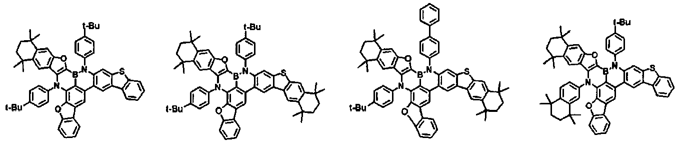 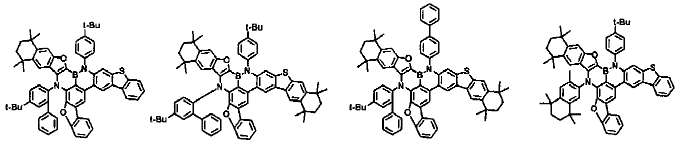 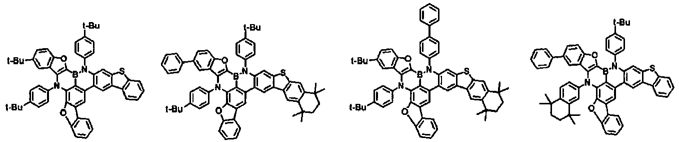 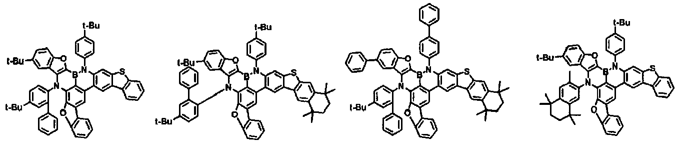 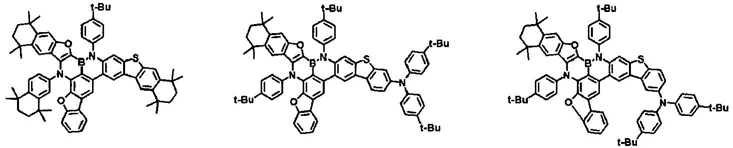 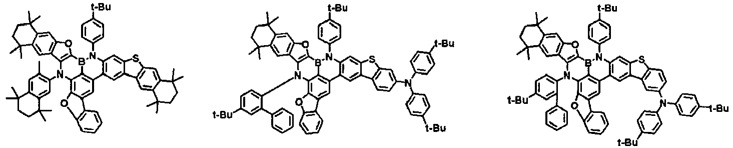 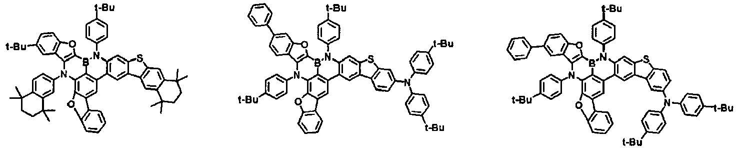 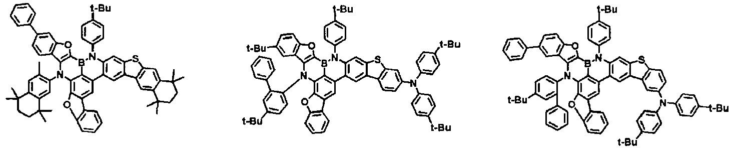 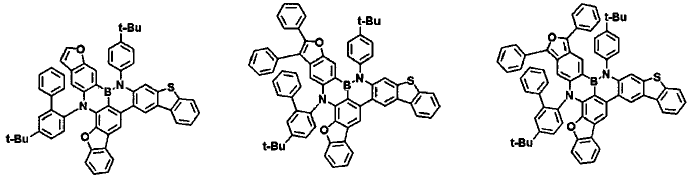 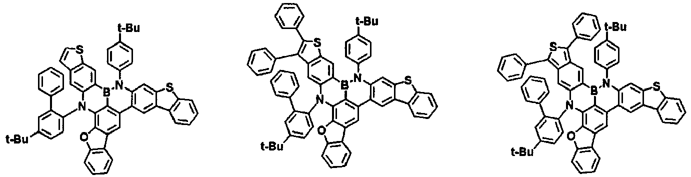 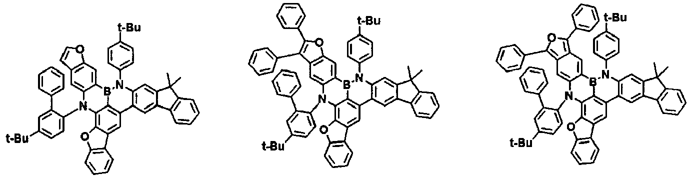 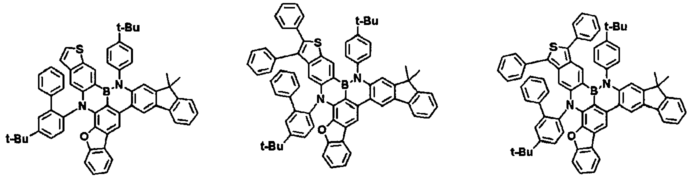 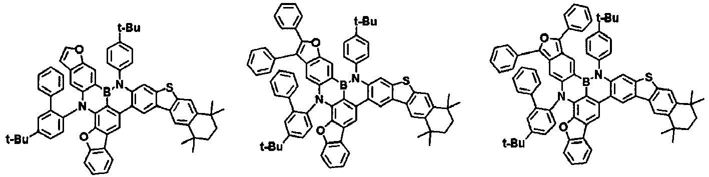 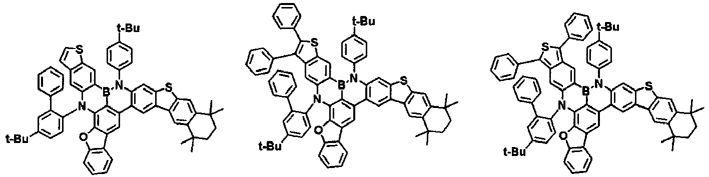 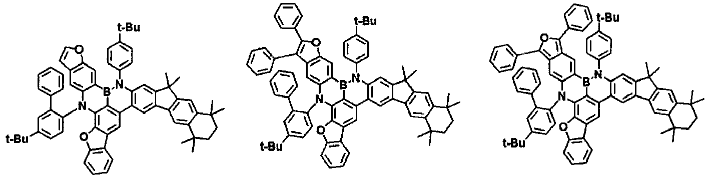 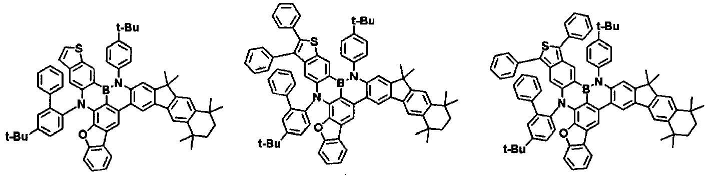 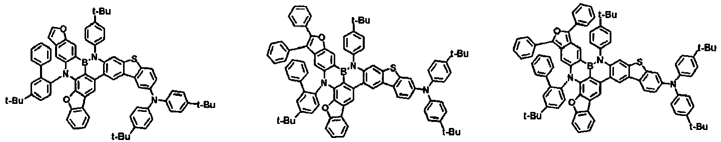 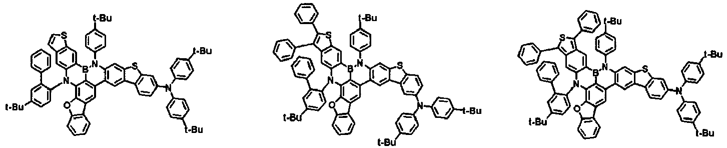 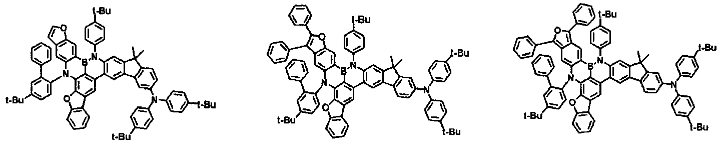 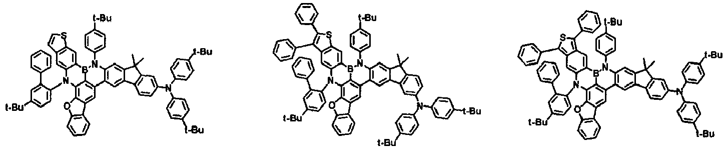 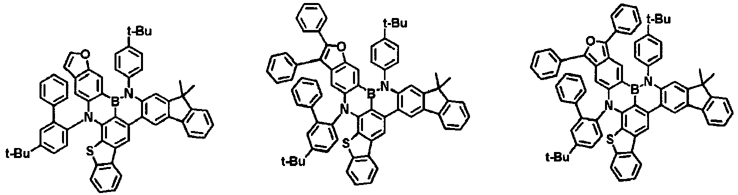 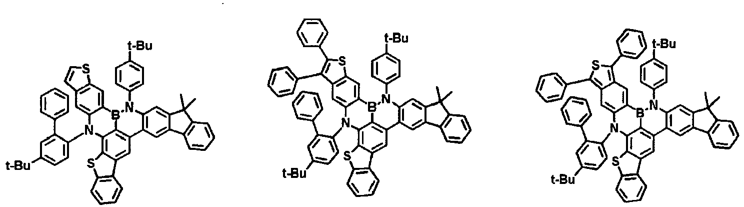 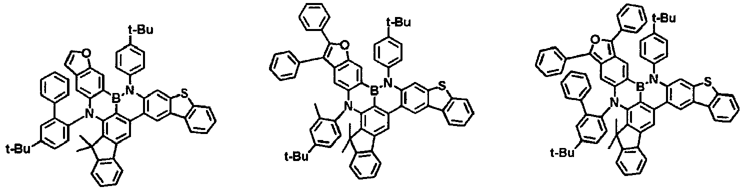 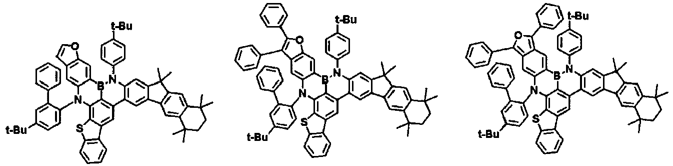 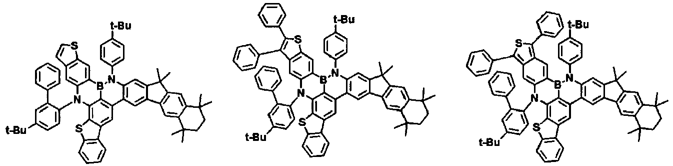 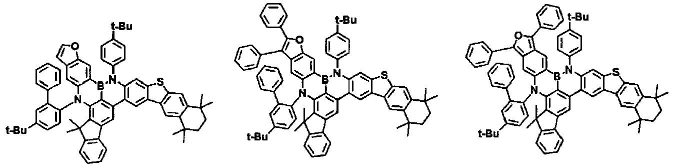 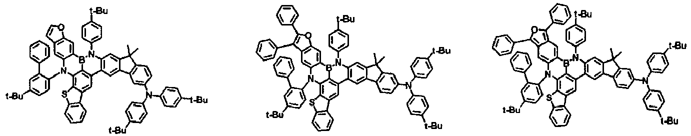 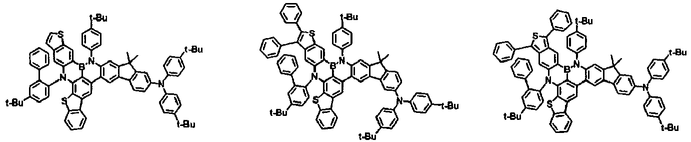 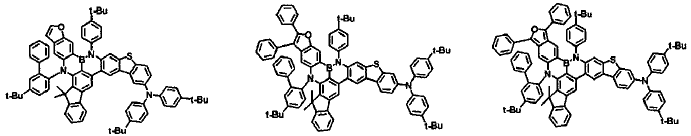 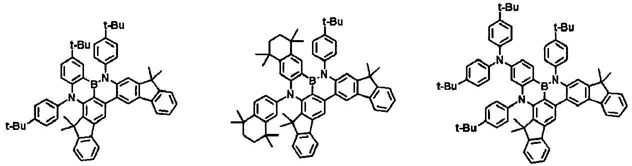 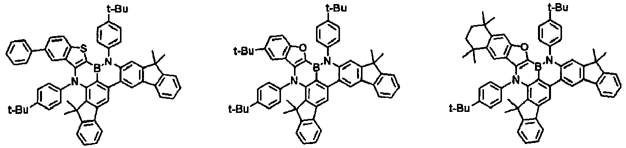 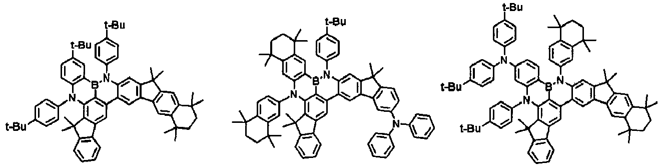 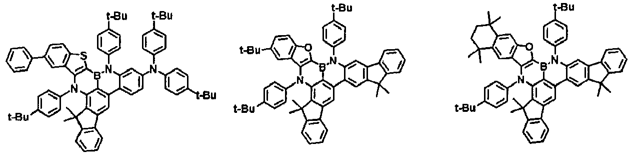 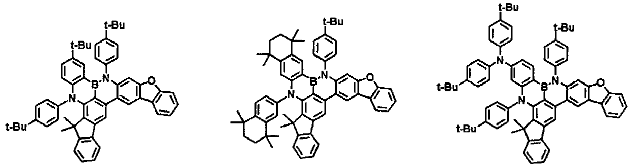 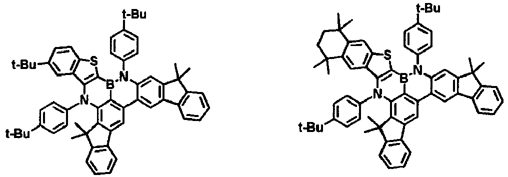 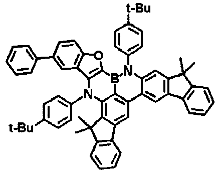 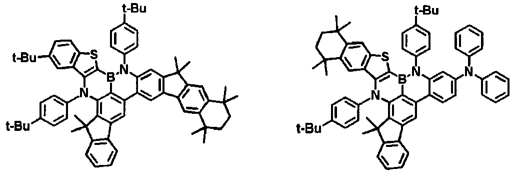 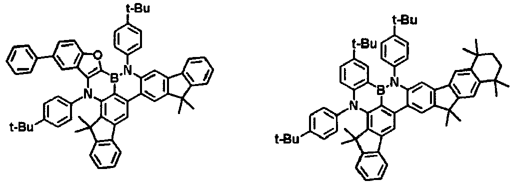 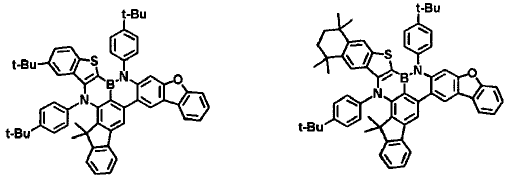 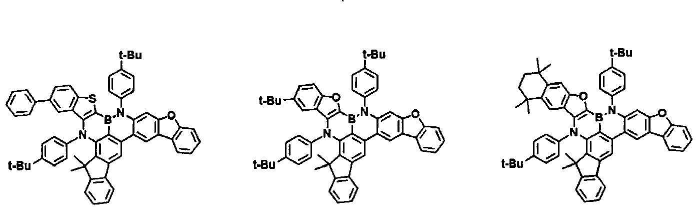 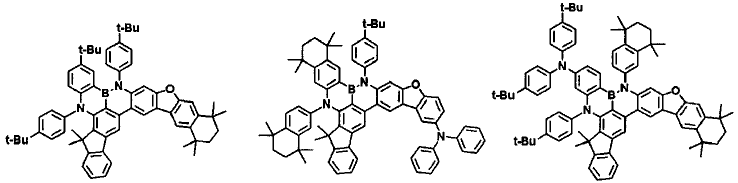 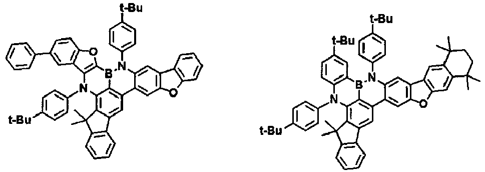 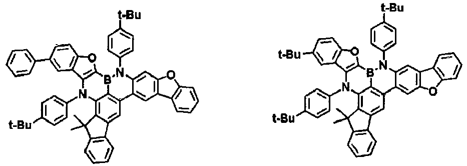 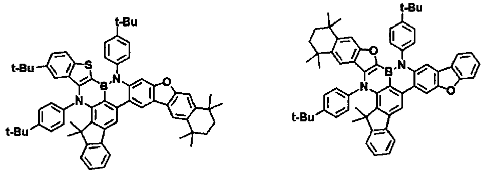 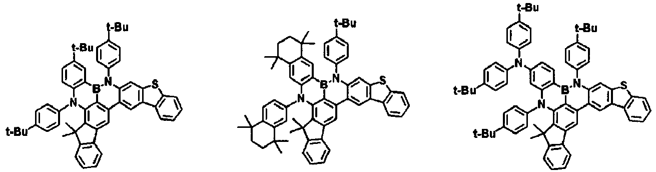 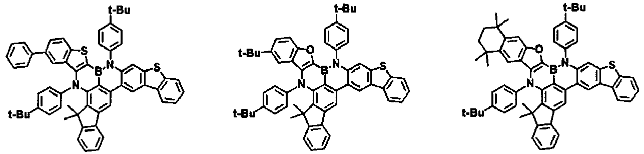 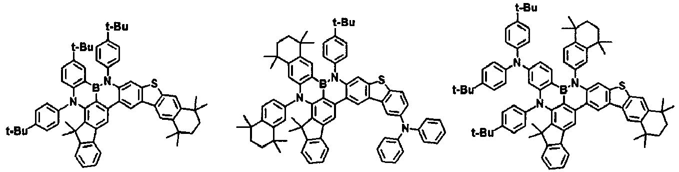 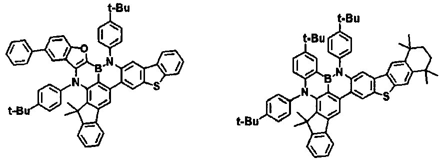 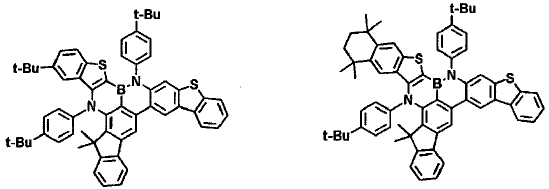 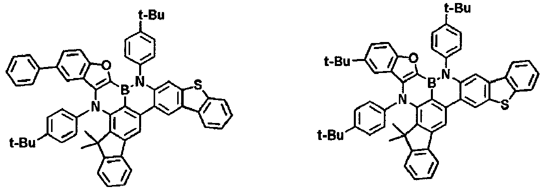 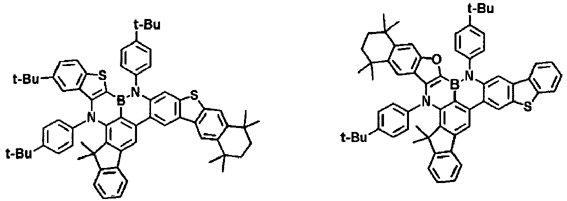 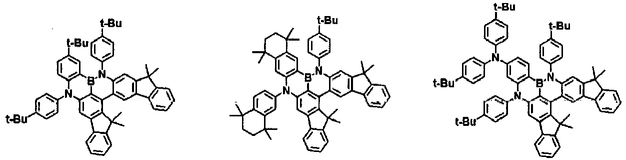 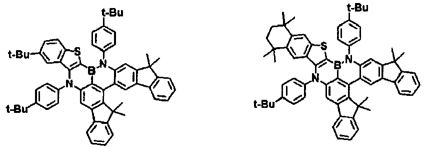 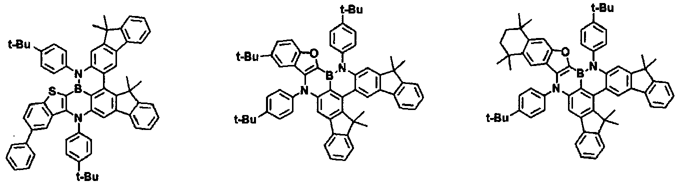 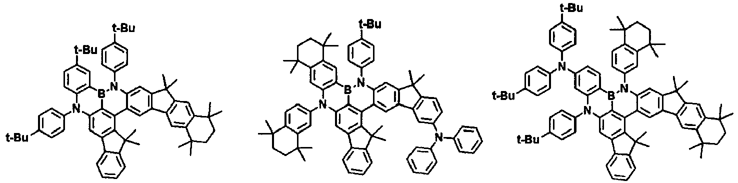 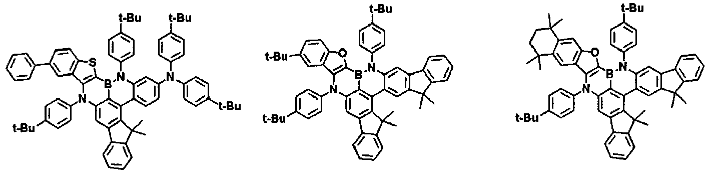 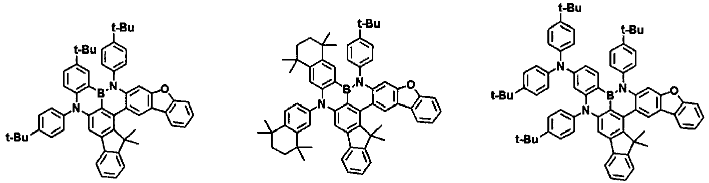 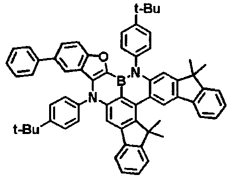 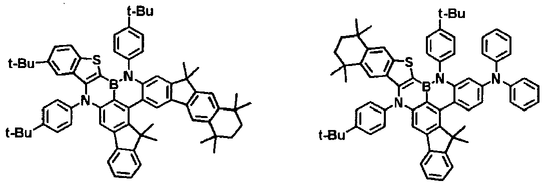 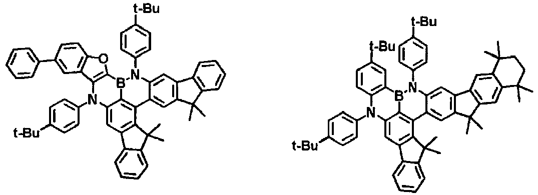 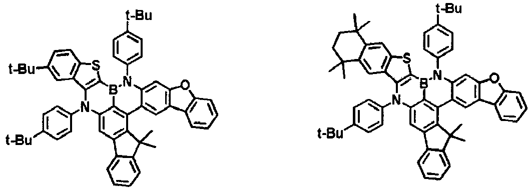 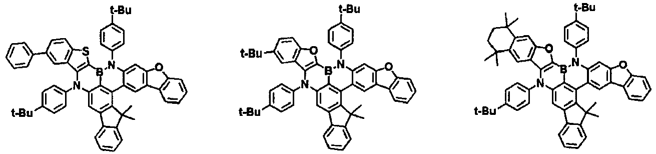 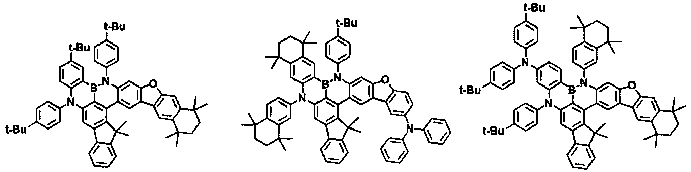 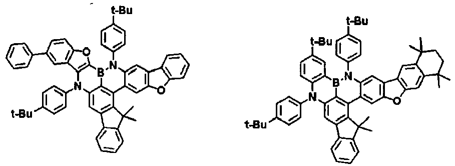 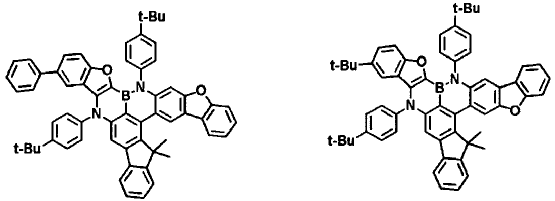 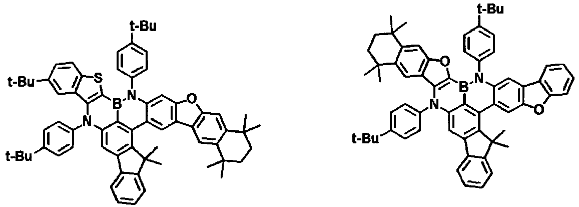 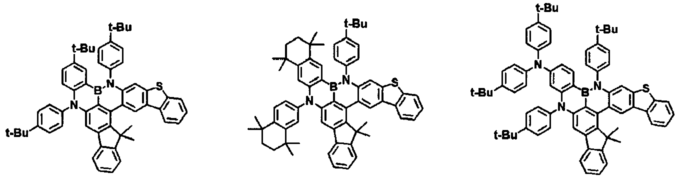 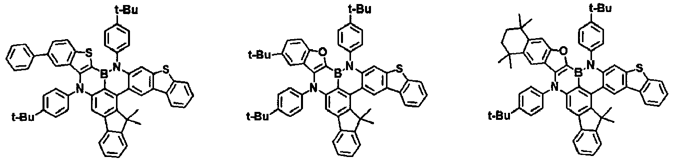 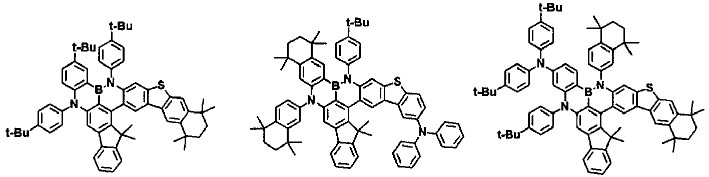 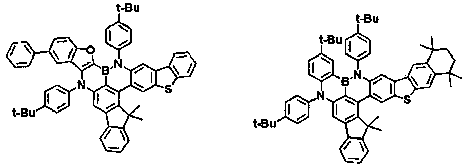 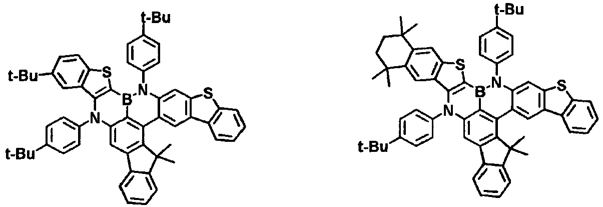 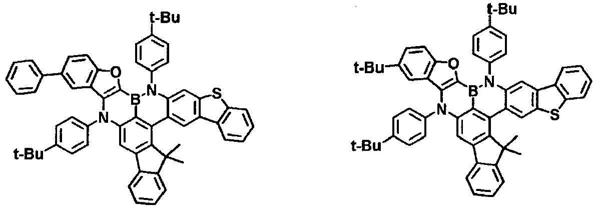 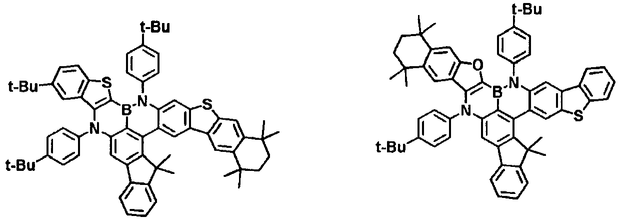 wherein the compound, t-Bu is a tert-butyl group.

10. An organic light emitting device comprising:
a first electrode;
a second electrode; and
an organic material layer comprising one or more layers between the first electrode and the second electrode,
wherein one or more layers of the organic material layer include the compound of any one of Claims 1 to 9.

11. The organic light emitting device of Claim 10, wherein the organic material layer includes a light emitting layer, and the light emitting layer includes the compound.

12. The organic light emitting device of Claim 10, wherein the organic material layer includes a light emitting layer, the light emitting layer includes a dopant material, and the dopant material includes the compound.

13. The organic light emitting device of Claim 10, wherein the organic material layer includes a light emitting layer, and the light emitting layer further includes a compound represented by the following Chemical Formula H: 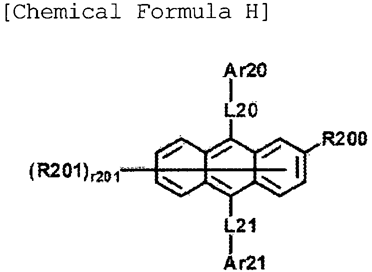 wherein in Chemical Formula H,
L20 and L21 are the same as or different from each other, and each independently a direct bond; a substituted or unsubstituted arylene group; or a substituted or unsubstituted heterocyclic group,
Ar20 and Ar21 are the same as or different from each other, and each independently hydrogen; deuterium; a substituted or unsubstituted aryl group; or a substituted or unsubstituted heterocyclic group,
R200 and R201 are the same as or different from each other, and each independently hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, and
r201 is an integer of 1 to 7, and when r201 is 2 or greater, the two or more R201s are the same as or different from each other.

14. The organic light emitting device of Claim 12, wherein the light emitting layer further includes a host compound, and in the host compound, at least one hydrogen at a substitutable position is substituted with deuterium.

15. The organic light emitting device of Claim 12, wherein the light emitting layer further includes one or more of dopants and hosts.

16. The organic light emitting device of Claim 12, wherein the light emitting layer further includes one or more hosts.

17. The organic light emitting device of Claim 12, wherein the light emitting layer further includes a mixed host of two or more hosts.
